# EUROPEAN PATENT SPECIFICATION

(11) **EP 2 730 583 B1**
(45) Date of publication and mention of the grant of the patent: **13.01.2016**
(21) Application number: 13191819.5
(22) Date of filing: 06.11.2013
(51) Int. Cl.: C07F 15/00, C09K 11/06, H05B 33/00, H01L 51/00, H01L 51/50, H05B 33/14

(54) **Iridium complexes with aza-benzo fused ligands**
Iridiumkomplexe mit aza-benzo-kondensierten Liganden
Complexes d'iridium avec des ligands d'aza-benzo fusionnés

(30) Priority: 09.11.2012 US 201213673338; 27.06.2013 US 201313928456; 16.09.2013 US 201314028499
(43) Date of publication of application: 14.05.2014
(60) Divisional application: 15187731.3
(73) Proprietor: Universal Display Corporation, Ewing, NJ 08618 (US)
(72) Inventor: Beers, Scott, Ewing, NJ 08618 (US); Ma, Bin, Ewing, NJ 08618 (US); Xia, Chuanjun, Ewing, NJ 08618 (US); Wendt, Harvey, Ewing, NJ 08618 (US); Layek, Suman, Ewing, NJ 08618 (US); Barron, Edward, Ewing, NJ 08618 (US); DeAngelis, Alan, Ewing, NJ 08618 (US); Yeager, Walter, Ewing, NJ 08618 (US); Cheon, Kwang-Ohk, Ewing, NJ 08618 (US); Weaver, Michael S., Ewing, NJ 08618 (US); Zeng, Lichang, Ewing, NJ 08618 (US); Adamovich, Vadim, Ewing, NJ 08618 (US)
(74) Representative: Maiwald Patentanwalts GmbH

(56) References cited:
- WO-A1-2010/111175
- DATABASE CA [Online] CHEMICAL ABSTRACTS SERVICE, COLUMBUS, OHIO, US; RAYABARAPU, DINESH ET AL: "Metal complexes and light-emitting devices using them", XP002718489, retrieved from STN Database accession no. 2010:1282120 -& WO 2010/118029 A1 (UNIVERSAL DISPLAY CORP [US]; RAYABARAPU DINESH [US]; XIA CHUANJUN [US]) 14 October 2010 (2010-10-14)

## Description

### JOINT RESEARCH AGREEMENT

The claimed invention was made by, on behalf of, and/or in connection with one or morse of the following parties to a joint university corporation research agreement: Regents of the University of Michigan, Princeton University, The University of Southern California, and the Universal Display Corporation. The agreement was in effect on and before the date the claimed invention was made, and the claimed invention was made as a result of activities undertaken within the scope of the agreement.

### FIELD OF THE INVENTION

The present invention relates to iridium complexes containing aza-benzo fused ligands. In particular, iridium complexes containing both phenylpyridine ligands and aza-benzo fused ligands were found to be useful as phosphorescent emitters when used in OLED devices. Additionally, iridium complexes containing both phenylpyridine ligands and aza-benzo fused ligands where an alkyl group or an aryl group is bonded to the aza-dibenzofuran-pyridine ligand were also found to be useful as phosphorescent emitters.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)₃, which has the following structure:

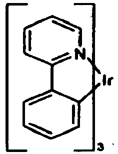

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

WO2010/111175 describes compounds comprising heteroleptic indium complexes. The compounds have a particular combination of ligands which includes a single pyridyl dibenzo-substituted ligand. The compounds may be used in organic light emitting devices, particularly as emitting dopants, to provide devices having improved efficiency, lifetime, and manufacturing.

### DATABASE CA CHEMICAL ABSTRACT SERVICE, COLUMBUS, OHIO, US:

RAYABARAPU, DINESH ET AL: "Metal complexes and light-emitting devices using them", XP002718489 and WO2010/118029 A1, describe iridium complexes and light emitting device using them.

### SUMMARY OF THE INVENTION

A compound having the formula Ir(L_{A})ₙ(L_{B})₃₋ₙ, and having the structure: 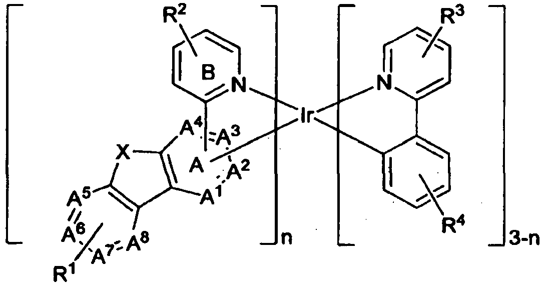 with Formula I is provided. In the compound of Formula I, A¹, A², A³, A⁴, A⁵, A⁶, A⁷, and A⁸ comprise carbon or nitrogen, and at least one of A¹, A², A³, A⁴, A⁵, A⁶, A⁷, and A⁸ is nitrogen. Ring B is bonded to ring A through a C-C bond, the iridium is bonded to ring A through a Ir-C bond. X is O, S, or Se. R¹, R², R³, and R⁴ independently represent mono-, di-, tri-, tetra-substitution, or no substitution, and any adjacent substitutions in R¹, R², R³, and R⁴ are optionally linked together to form a ring. R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and n is an integer from 1 to 3.

In one aspect, n is 1. In one aspect, the compound has the formula:

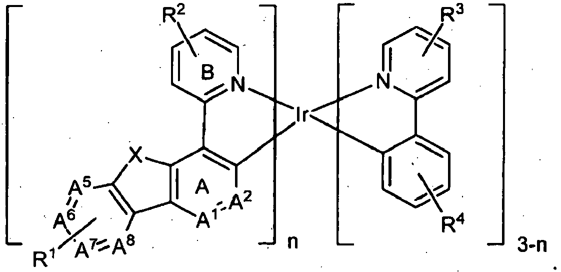

In one aspect, the compound has the formula:

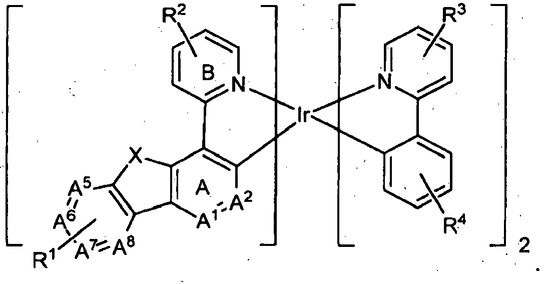

In one aspect, only one of A¹ to A⁸ is nitrogen. In one aspect, only one of A⁵ to A⁸ is nitrogen. In one aspect, X is O.

In one aspect, R¹, R², R³, and R⁴ are independently selected from the group consisting of hydrogen, deuterium, alkyl, and combinations thereof. In one aspect, R² is alkyl. In another aspect, R² is selected from the group consisting of aryl, substituted aryl, heteroaryl, and substituted heteroaryl.

In one aspect, the alkyl is deuterated or partially deuterated. In one aspect, R³ is alkyl.

In one aspect, the alkyl is deuterated or partially deuterated.

In one embodiment, a first device comprising a first organic light emitting device is provided. The first device further comprises an anode, a cathode, and an organic layer, disposed between the anode and the cathode. The organic layer comprises a compound having the formula Ir(L_{A})ₙ(L_{B})₃₋ₙ, having the structure according to Formula I.

The inventors have found that iridium complexes containing aza-benzo fused ligands, I particular iridium complexes containing both phenylpyridine ligands and aza-benzo fused ligands are useful as phosphorescent emitters useful for OLED devices.

According to another aspect of the present disclosure, a compound having the formula Ir(L_{A})ₙ(L_{B})₃₋ₙ, and having the structure:

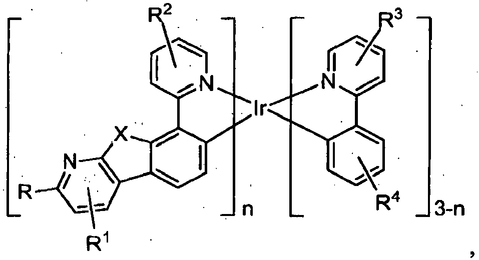

Formula II, is provided. In the compound of Formula II, X is O, S, or Se; R is selected from the group consisting of alkyl, cycloalkyl, and combinations thereof; R¹ represent mono-, di-substitution, or no substitution; R², R³, and R⁴ independently represent mono-, di-, tri-, tetra-substitution, or no substitution; any adjacent substitutions in R¹, R², R³, and R⁴ are optionally linked together to form a ring; R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and n is an integer from 1 to 3. In one aspect, R² is selected from the group consisting of aryl, substituted aryl, heteroaryl, and substituted heteroaryl.

According to an embodiment, a first device comprising a first organic light emitting device, further comprising an anode, a cathode, and an organic layer, disposed between the anode and the cathode, comprising a compound having the formula Ir(L_{A})ₙ(L_{B})₃₋ₙ, and having the structure according to Formula II is disclosed.

The inventors have discovered that addition of an alkyl group to the aza ring of the specific aza-dibenzofuran ring system in the iridium complexes containing aza-benzo fused ligands results in the formation of green phosphorescent compounds with superior device stability.

The inventors have also discovered that addition of an aryl group to the pyridine ring of the specific aza-dibenzofuran-pyridine ligand in the iridium complexes containing aza-benzo fused ligands results in the formation of yellow phosphorescent compounds with superior device efficiency. The inventors have discovered that conjugating the pyridine ring in the L_{A} ligand with aryl rings result in a new class of novel efficient yellow phosphorescent emitters for PHOLEDs.

### BRIEF DESCRIPTION OF THE DRAWINGS

- FIG. 1 shows an organic light emitting device.
- FIG. 2 shows an inverted organic light emitting device that does not have a separate electron transport layer.

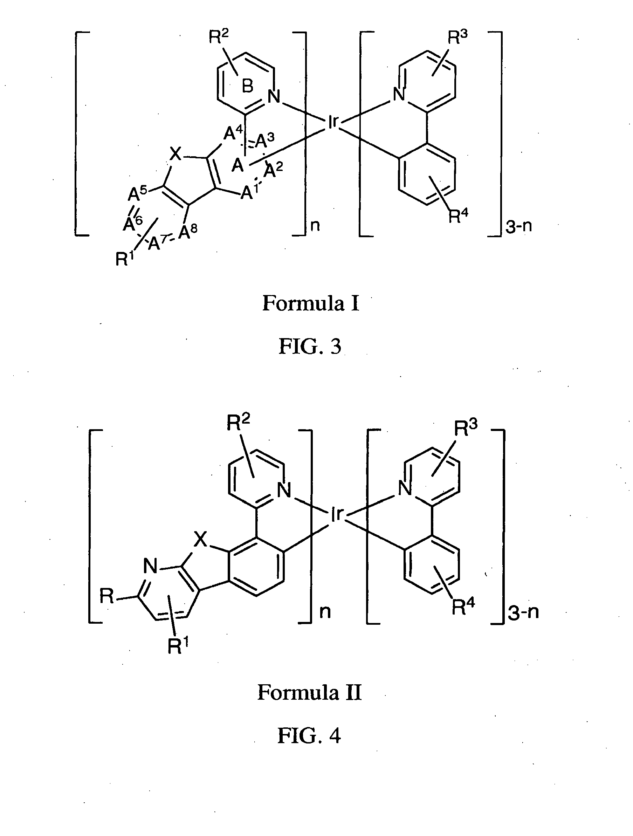

- FIG. 3 show structural Formula I and Formula II.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

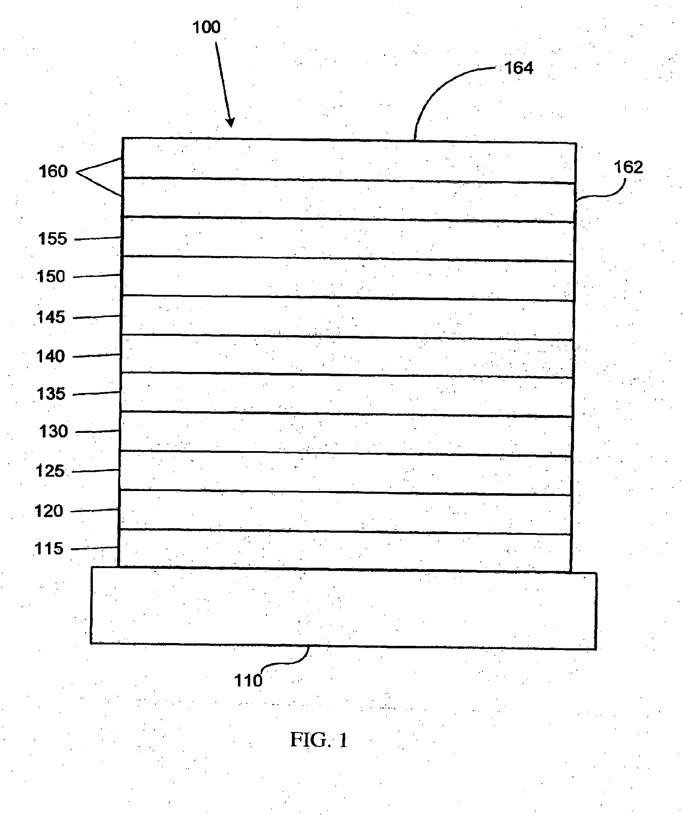

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/023098. U.S. Pat. Nos. 5,703,436 and 5,707,745. disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116, which is incorporated by reference in its entirety. A description of protective layers may be found in U.S. Patent Application Publication No. 2004/0174116.

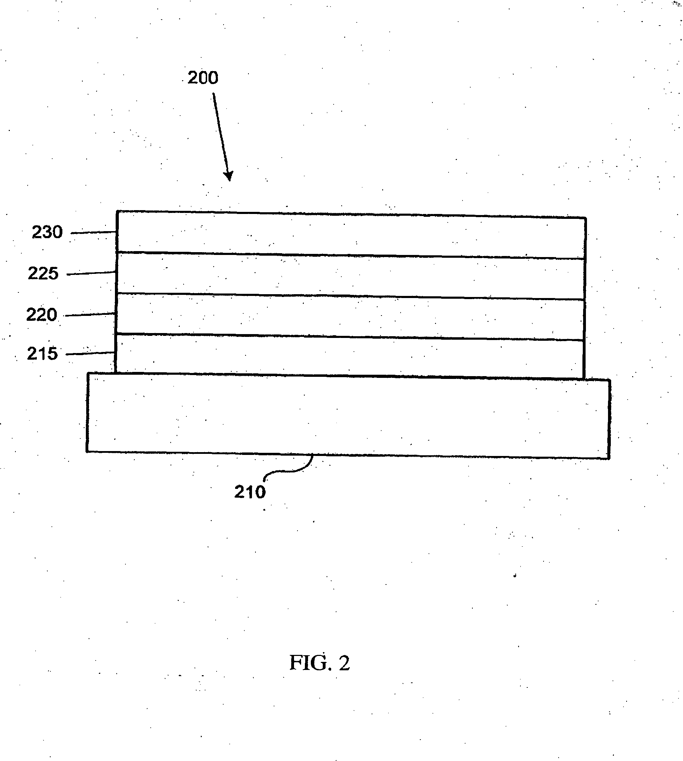

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of nonlimiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al.. By way of further example, OLEDs having a single organic layer may be used. OLEDs may be stacked, for example as described in U.S. Pat. No. 5,707,745 to Forrest et al.. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al..

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al. and deposition by organic vapor jet printing (OVJP), such as described in U.S. patent application U.S. Patent No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819 and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention may be incorporated into a wide variety of consumer products, including flat panel displays, computer monitors, medical monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C.).

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The terms halo, halogen, alkyl, cycloalkyl, alkenyl, alkynyl, arylkyl, heterocyclic group, aryl, aromatic group, and heteroaryl are known to the art, and are defined in US 7,279,704 at cols. 31-32.

A compound having the formula Ir(L_{A})ₙ(L_{B})₃₋ₙ, and having the structure: 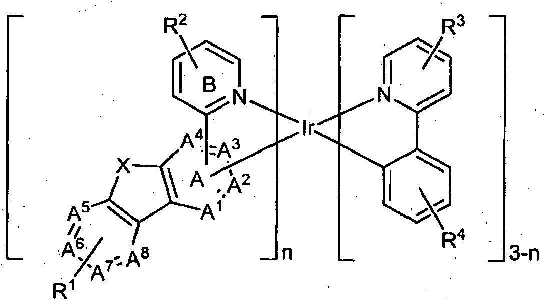 with Formula I is provided. In the compound of Formula I, A¹, A², A³, A⁴, A⁵, A⁶, A⁷, and A⁸ comprise carbon or nitrogen, and at least one of A¹, A², A³, A⁴, A⁵, A⁶, A⁷, and A⁸ is nitrogen. Ring B is bonded to ring A through a C-C bond, the iridium is bonded to ring A through a Ir-C bond. X is O, S, or Se. R¹, R², R³, and R⁴ independently represent mono-, di-, tri-, tetra-substitution, or no substitution, and any adjacent substitutions in R¹, R², R³, and R⁴ are optionally linked together to form a ring. R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and n is an integer from 1 to 3.

Heteroleptic iridium complexes with 2-phenylpyridine and 2-(4-dibenzofuran)-pyridine ligands have been previously disclosed. The dibenzofuran substitution extends the conjugation of the ligand and lowers the LUMO of the complex, resulting in a slight red shifted emission and less saturated green color. For example, Compound A has a λₘₐₓ of 528 nm in 2-methyl-tetrahydrofuran at room temperature, compared to around 516 nm for tris(2-phenylpyridine)iridium. The compounds of Formula I introduce an azadibenzofuran substitution, as in, for example, Compound 1, which further lowers the LUMO of the complex due to the electron deficient nature of the azadibenzofuran group. The reduction potential was measured at -2.55 V versus -2.60 V for Compound A. Based on these results, it was expected that the emission of Compound 1 will be further red shifted. Surprisingly, the PL of compounds of Formula I such as Compound 1, measured under the same condition as Compound A, showed a λₘₐₓ of 523 nm, which is 5 nm blue shifted compared to Compound A. Similarly, the λₘₐₓ of Compound 4 is 524 nm which is 4 nm blue shifted compared to Compound A. The results are summarized in Table 1. Thus, compounds of Formula I unexpectedly have blue shifted emission spectra, which makes compounds of Formula I more suitable for use as a saturated green color in display applications.

**TABLE 1**

| **Compound** | **Structure** | **Redox Potential vs. Fc/Fc⁺** | **PL in 2-methyl-THF** |
|---|---|---|---|
| Ir(PPy)₃ | 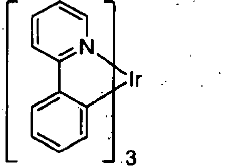 | E_{Red}: -2.70 V | R.T.: 516nm |
| | | E_{Ox}: 0.31 V | 77K: 493nm |
| Compound A | 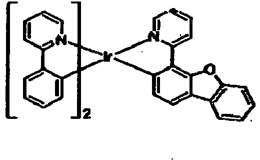 | E_{Red}: -2.60 V | R.T.: 528nm |
| | | E_{Ox}: 0.35 V | 77K: 512nm |
| Compound 1 | 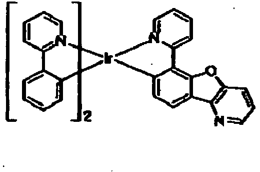 | E_{Red}: -2.55 V | R.T.: 523nm |
| | | E_{Ox}: 0.40 V | 77K: 510nm |
| Compound 4 | 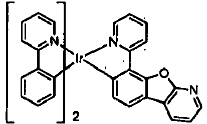 | ERed: -2.55 V Eox: 0.37 V | R.T.:524 nm 77K: 510 |

In one embodiment, n is 1. In one embodiment, the compound has the formula:

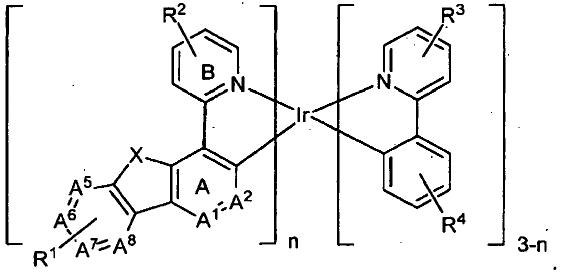

In one embodiment, the compound has the formula:

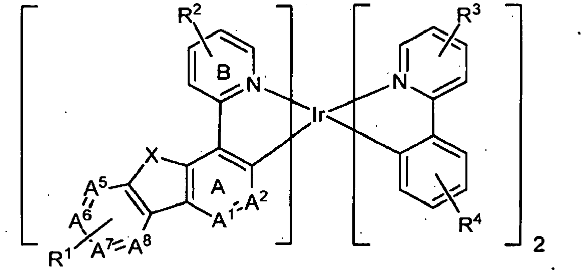

In one embodiment, only one of A¹ to A⁸ is nitrogen. In one embodiment, only one of A⁵ to A⁸ is nitrogen. In one embodiment, X is O.

In one embodiment, R¹, R², R³, and R⁴ are independently selected from the group consisting of hydrogen, deuterium, alkyl, and combinations thereof. In one embodiment, R² is alkyl.

In one embodiment of the compound having the structure of Formula I, R² is selected from the group consisting of aryl, substituted aryl, heteroaryl, and substituted heteroaryl. In one embodiment, R² is phenyl or substituted phenyl. In one embodiment, R² is pyridine or substituted pyridine. In one embodiment, R² represents mono-substitution.

In one embodiment, the alkyl is deuterated or partially deuterated. In one embodiment, R³ is alkyl.

In one embodiment, the alkyl is deuterated or partially deuterated.

In one embodiment, L_{A} is selected from the group consisting of:

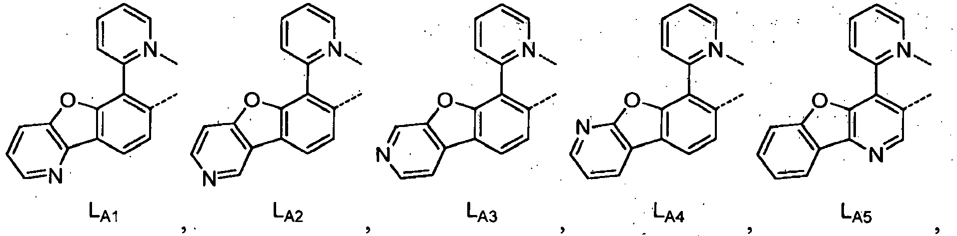

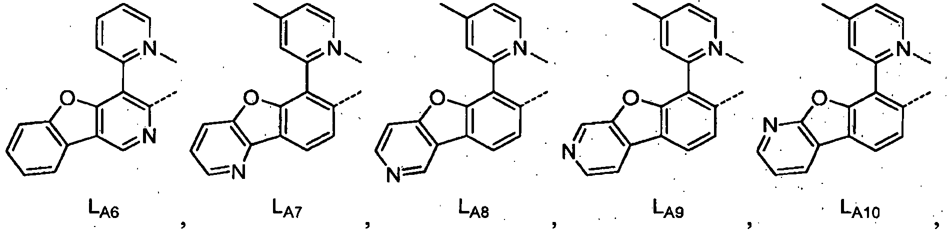

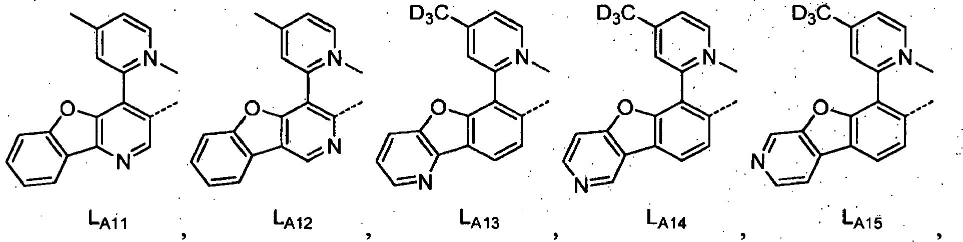

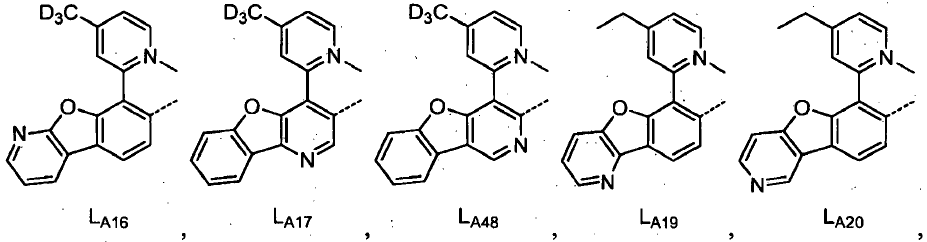

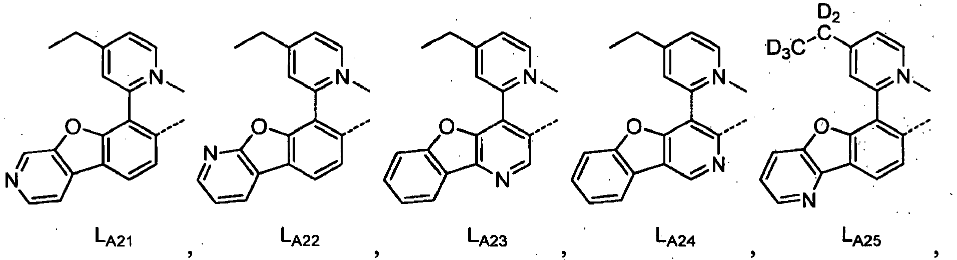

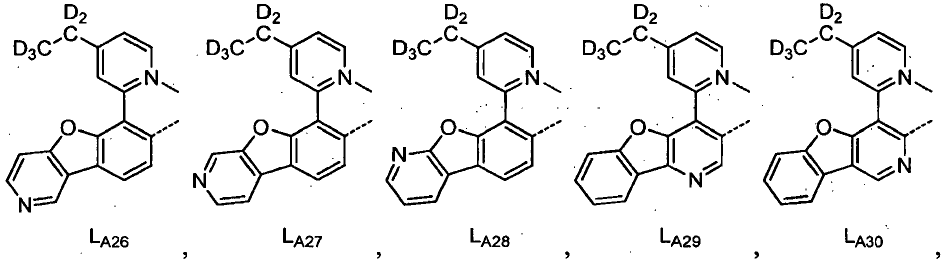

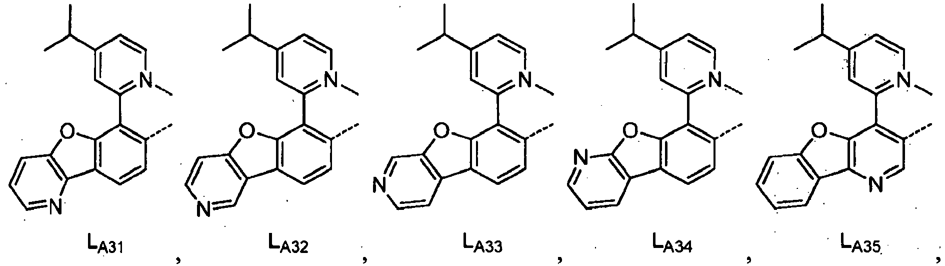

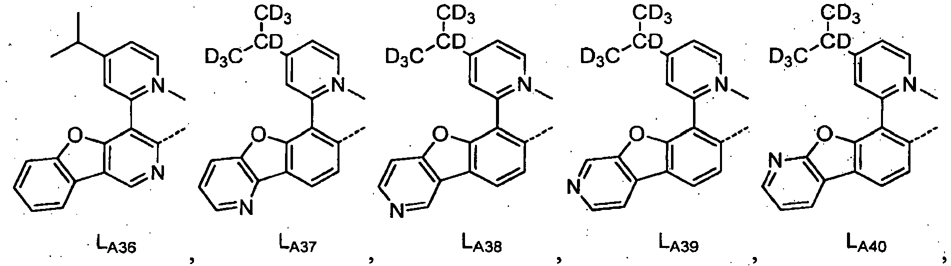

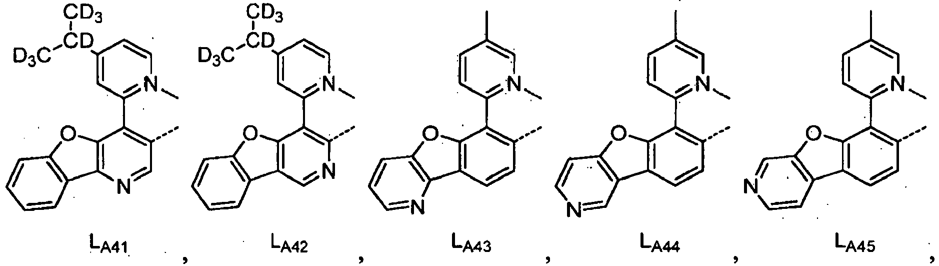

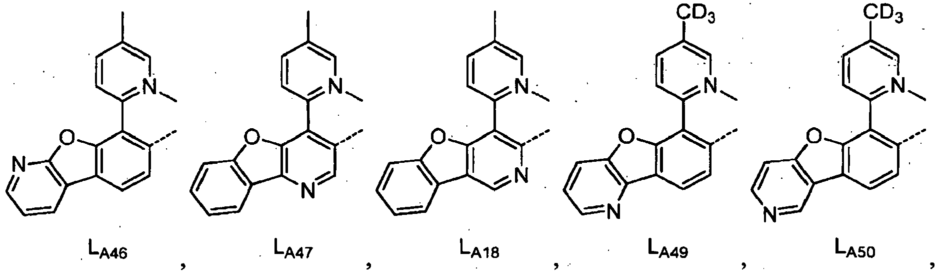

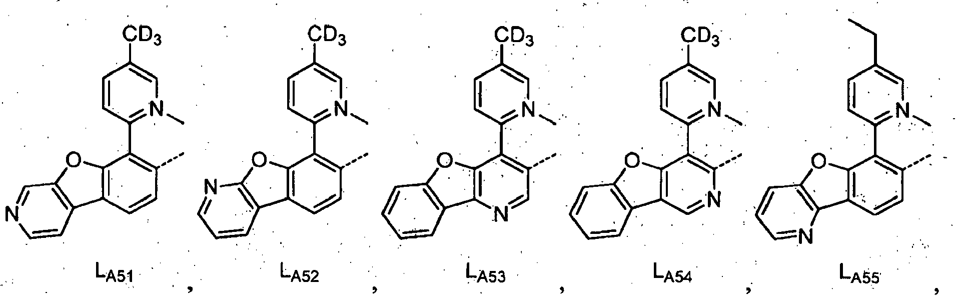

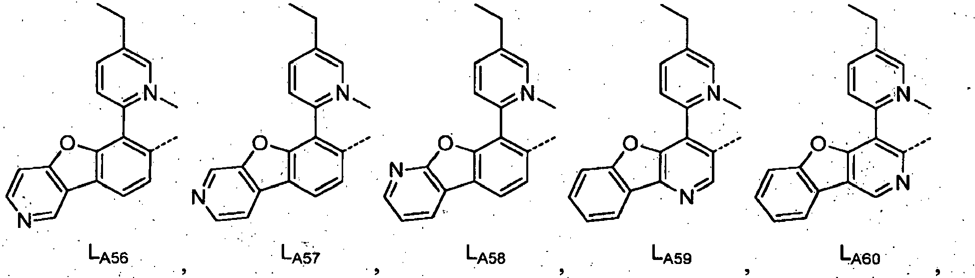

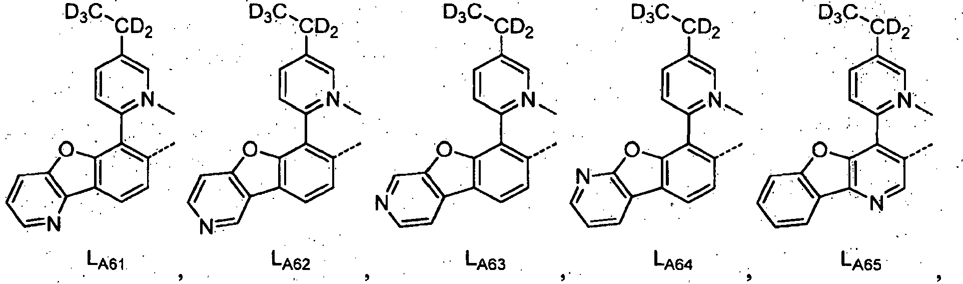

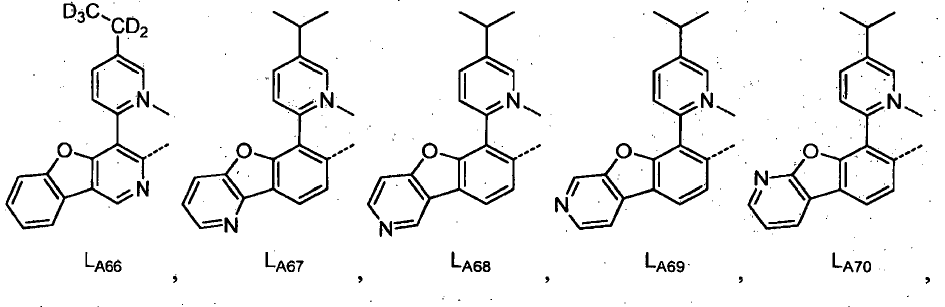

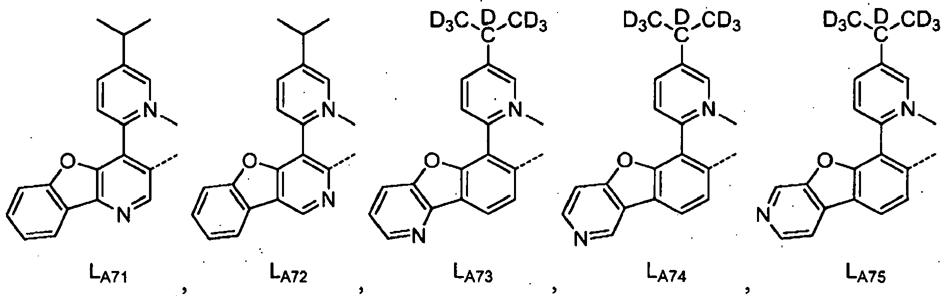

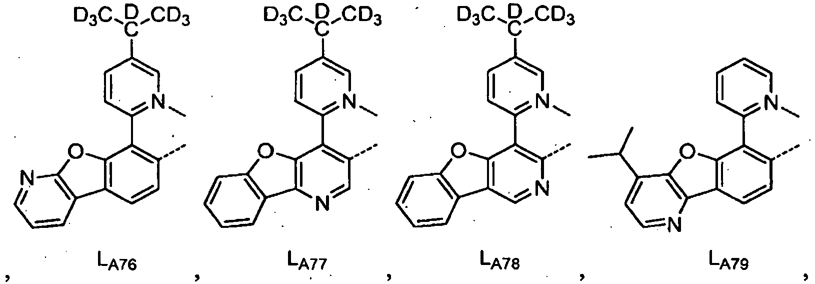

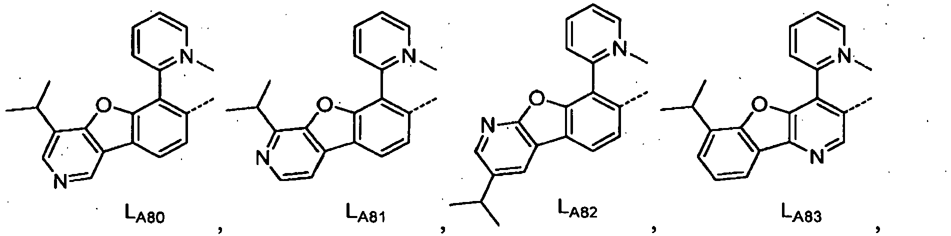

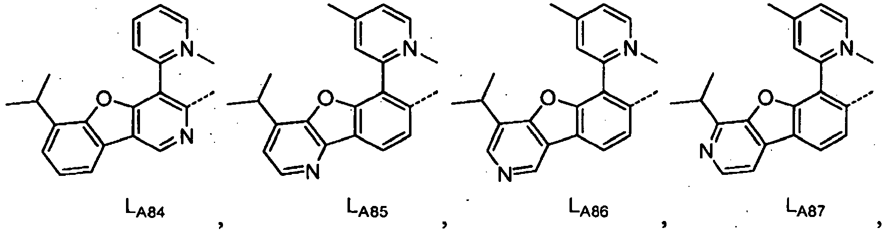

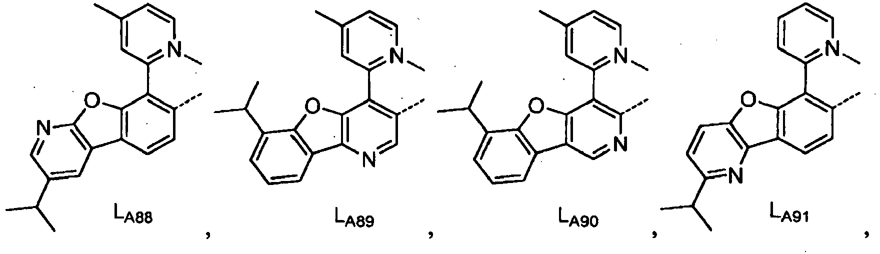

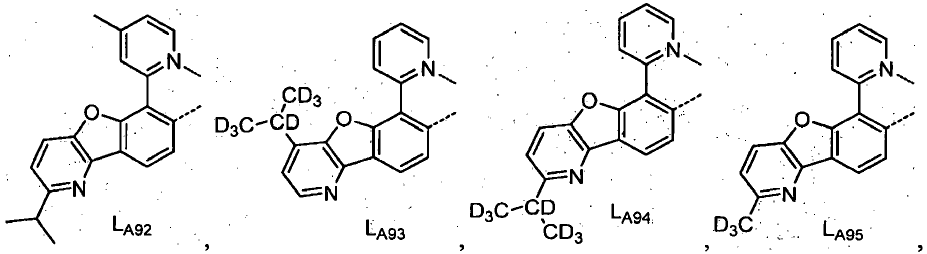

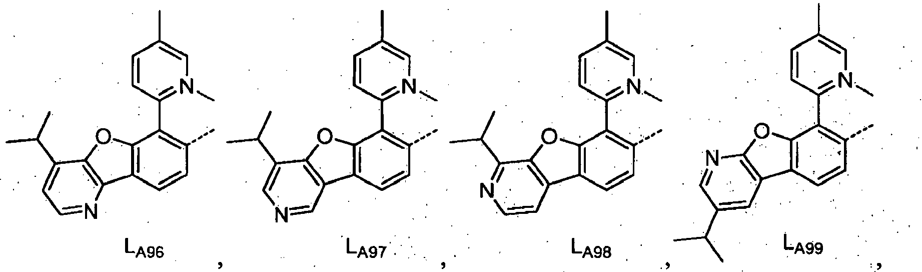

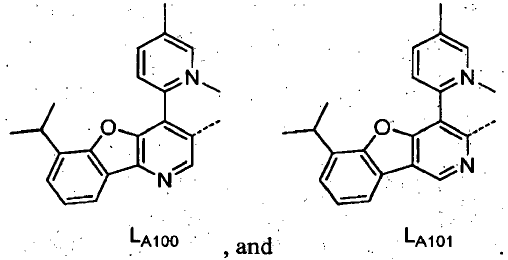

In one embodiment, L_{A} is selected from the group consisting of:

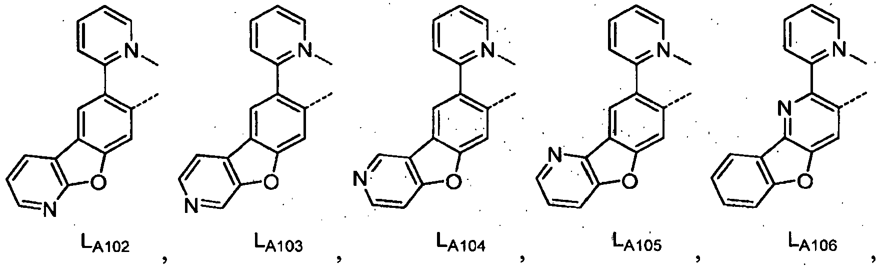

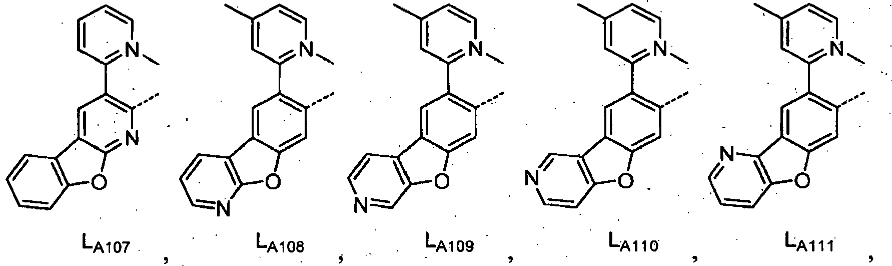

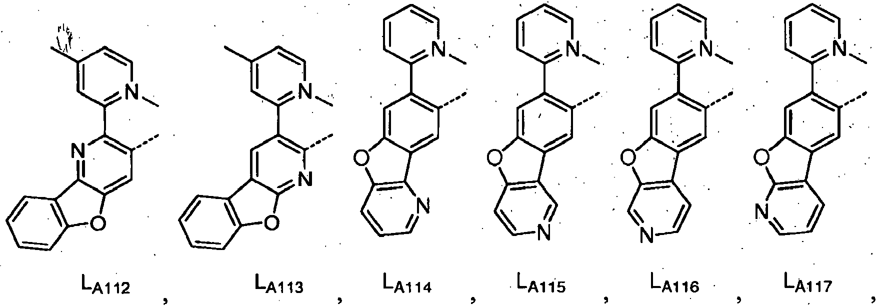

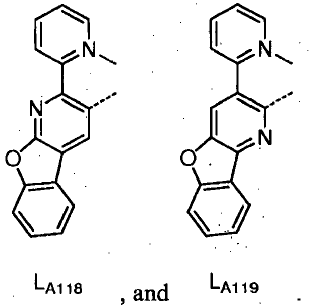

In one embodiment, L_{B} is selected from the group consisting of:

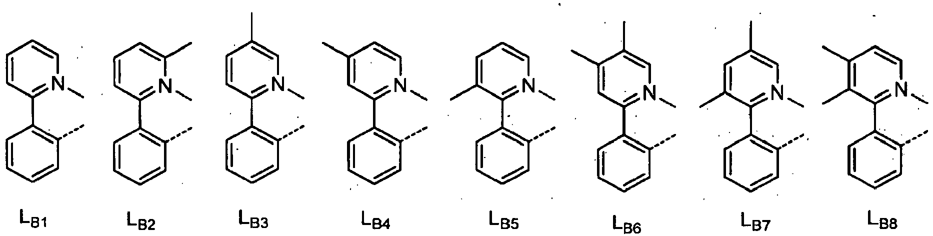

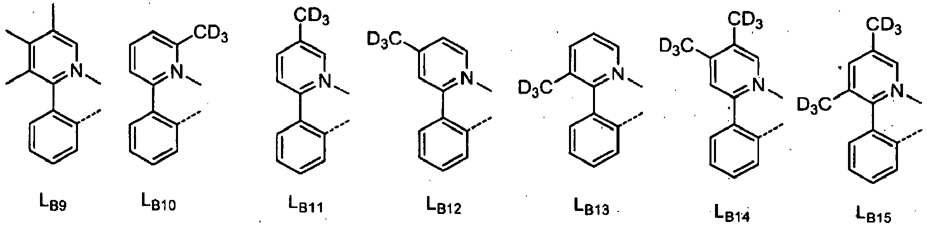

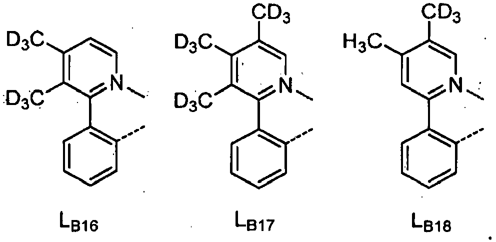

In one embodiment, the compound of formula Ir(L_{A})(L_{B})₂ has one of the the formulas listed in the table below:

| **Compound Number** | **L_{A}** | **L_{B}** | **Compound Number** | **L_{A}** | **L_{B}** | **Compound Number** | **L_{A}** | **L_{B}** |
|---|---|---|---|---|---|---|---|---|
| 1. | L_{A1} | L_{B1} | 715. | L_{A1} | L_{B7} | 1429. | L_{A1} | L_{B13} |
| 2. | L_{A2} | L_{B1} | 716. | L_{A2} | L_{B7} | 1430. | L_{A2} | L_{B13} |
| 3. | L_{A3} | L_{B1} | 717. | L_{A3} | L_{B7} | 1431. | L_{A3} | L_{B13} |
| 4. | L_{A4} | L_{B1} | 718. | L_{A4} | L_{B7} | 1432. | L_{A4} | L_{B13} |
| 5. | L_{A5} | L_{B1} | 719. | L_{A5} | L_{B7} | 1433. | L_{A5} | L_{B13} |
| 6. | L_{A6} | L_{B1} | 720. | L_{A6} | L_{B7} | 1434. | L_{A6} | L_{B13} |
| 7. | L_{A7} | L_{B1} | 721. | L_{A7} | L_{B7} | 1435. | L_{A7} | L_{B13} |
| 8. | L_{AB} | L_{B1} | 722. | L_{A8} | L_{B7} | 1436. | L_{A8} | L_{B13} |
| 9. | L_{A9} | L_{B1} | 723. | L_{A9} | L_{B7} | 1437. | L_{A9} | L_{B13} |
| 10. | L_{A10} | L_{B1} | 724. | L_{A10} | L_{B7} | 1438. | L_{A10} | L_{B13} |
| 11. | L_{A11} | L_{B1} | 725. | L_{A11} | L_{B7} | 1439. | L_{A11} | L_{B13} |
| 12. | L_{A12} | L_{B1} | 726. | L_{A12} | L_{B7} | 1440. | L_{A12} | L_{B13} |
| 13. | L_{A13} | L_{B1} | 727. | L_{A13} | L_{B7} | 1441. | L_{A13} | L_{B13} |
| 14. | L_{A14} | L_{B1} | 728. | L_{A14} | L_{B7} | 1442. | L_{A14} | L_{B13} |
| 15. | L_{A15} | L_{B1} | 729. | L_{A15} | L_{B7} | 1443. | L_{A15} | L_{B13} |
| 16. | L_{A16} | L_{B1} | 730. | L_{A16} | L_{B7} | 1444. | L_{A16} | L_{B13} |
| 17. | L_{A17} | L_{B1} | 731. | L_{A17} | L_{B7} | 1445. | L_{A17} | L_{B13} |
| 18. | L_{A18} | L_{B1} | 732. | L_{A18} | L_{B7} | 1446. | L_{A18} | L_{B13} |
| 19. | L_{A19} | L_{B1} | 733. | L_{A19} | L₈₇ | 1447. | L_{A19} | L_{B13} |
| 20. | L_{A10} | L_{B1} | 734. | L_{A10} | L_{B7} | 1448. | L_{A10} | L_{B13} |
| 21. | L_{A21} | L_{B1} | 735. | L_{A21} | L_{B7} | 1449. | L_{A21} | L_{B13} |
| 22. | L_{A22} | L_{B1} | 736. | L_{A22} | L_{B7} | 1450. | L_{A22} | L_{B13} |
| 23. | L_{A23} | L_{B1} | 737. | L_{A23} | L_{B7} | 1451. | L_{A23} | L_{B13} |
| 24. | L_{A24} | L_{B1} | 738. | L_{A24} | L_{B7} | 1452. | L_{A24} | L_{B13} |
| 25. | L_{A25} | L_{B1} | 739. | L_{A25} | L_{B7} | 1453. | L_{A25} | L_{B13} |
| 26. | L_{A26} | L_{B1} | 740. | L_{A26} | L_{B7} | 1454. | L_{A26} | L_{B13} |
| 27. | L_{A27} | L_{B1} | 741. | L_{A27} | L_{B7} | 1455. | L_{A27} | L_{B13} |
| 28. | L_{A28} | L_{B1} | 742. | L_{A28} | L_{B7} | 1456. | L_{A28} | L_{B13} |
| 29. | L_{A29} | L_{B1} | 743. | L_{A29} | L_{B7} | 1457. | L_{A29} | L_{B13} |
| 30. | L_{A30} | L_{B1} | 744. | L_{A30} | L_{B7} | 1458. | L_{A30} | L_{B13} |
| 31. | L_{A31} | L_{B1} | 745. | L_{A31} | L_{B7} | 1459. | L_{A31} | L_{B13} |
| 32. | L_{A32} | L_{B1} | 746. | L_{A32} | L_{B7} | 1460. | L_{A32} | L_{B13} |
| 33. | L_{A33} | L_{B1} | 747. | L_{A33} | L_{B7} | 1461. | L_{A33} | L_{B13} |
| 34. | L_{A34} | L_{B1} | 748. | L_{A34} | L_{B7} | 1462. | L_{A34} | L_{B13} |
| 35. | L_{A35} | L_{B1} | 749. | L_{A35} | L_{B7} | 1463. | L_{A35} | L_{B13} |
| 36. | L_{A36} | L_{B1} | 750. | L_{A36} | L_{B7} | 1464. | L_{A36} | L_{B13} |
| 37. | L_{A37} | L_{B1} | 751. | L_{A37} | L_{B7} | 1465. | L_{A37} | L_{B13} |
| 38. | L_{A38} | L_{B1} | 752. | L_{A38} | L_{B7} | 1466. | L_{A38} | L_{B13} |
| 39. | L_{A39} | L_{B1} | 753. | L_{A39} | L_{B7} | 1467. | L_{A39} | L_{B13} |
| 40. | L_{A40} | L_{B1} | 754. | L_{A40} | L_{B7} | 1468. | L_{A40} | L_{B13} |
| 41. | L_{A41} | L_{B1} | 755. | L_{A41} | L_{B7} | 1469. | L_{A41} | L_{B13} |
| 42. | L_{A42} | L_{B1} | 756. | L_{AB2} | L_{B7} | 1470. | L_{A42} | L_{B13} |
| 43. | L_{A43} | L_{B1} | 757. | L_{A43} | L_{B7} | 1471. | L_{A43} | L_{B13} |
| 44. | L_{A44} | L_{B1} | 758. | L_{A44} | L_{B7} | 1472. | L_{A44} | L_{B13} |
| 45. | L_{A45} | L_{B1} | 759. | L_{A45} | L_{B7} | 1473. | L_{A45} | L_{B13} |
| 46. | L_{A46} | L_{B1} | 760. | L_{A46} | L_{B7} | 1474. | L_{A46} | L_{B13} |
| 47. | L_{A47} | L_{B1} | 761. | L_{A47} | L_{B7} | 1475. | L_{A47} | L_{B13} |
| 48. | L_{A48} | L_{B1} | 762. | L_{A48} | L_{B7} | 1476. | L_{A48} | L_{B13} |
| 49. | L_{A49} | L_{B1} | 763. | L_{A49} | L_{B7} | 1477. | L_{A49} | L_{B13} |
| 50. | L_{A50} | L_{B1} | 764. | L_{A50} | L_{B7} | 1478. | L_{A50} | L_{B13} |
| 51. | L_{A51} | L_{B1} | 765. | L_{A51} | L_{B7} | 1479. | L_{A51} | L_{B13} |
| 52. | L_{A52} | L_{B1} | 766. | L_{A52} | L_{B7} | 1480. | L_{A52} | L_{B13} |
| 53. | L_{A53} | L_{B1} | 767. | L_{A53} | L_{B7} | 1481. | L_{A53} | L_{B13} |
| 54. | L_{A54} | L_{B1} | 768. | L_{A54} | L_{B7} | 1482. | L_{A54} | L_{B13} |
| 55. | L_{A55} | L_{B1} | 769. | L_{A55} | L_{B7} | 1483. | L_{A55} | L_{B13} |
| 56. | L_{A56} | L_{B1} | 770. | L_{A56} | L_{B7} | 1484. | L_{A56} | L₈₁₃ |
| 57. | L_{A57} | L_{B1} | 771. | L_{A57} | L_{B7} | 1485. | L_{A57} | L_{B13} |
| 58. | L_{A58} | L_{B1} | 772. | L_{A58} | L_{B7} | 1486. | L_{A58} | L_{B13} |
| 59. | L_{A59} | L_{B1} | 773. | L_{A59} | L_{B7} | 1487. | L_{A59} | L_{B13} |
| 60. | L_{A60} | L_{B1} | 774. | L_{A60} | L_{B7} | 1488. | L_{A60} | L_{B13} |
| 61. | L_{A61} | L_{B1} | 775. | L_{A61} | L_{B7} | 1489. | L_{A61} | L_{B13} |
| 62. | L_{A62} | L_{B1} | 776. | L_{A62} | L_{B7} | 1490. | L_{A62} | L_{B13} |
| 63. | L_{A63} | L_{B1} | 777. | L_{A63} | L_{B7} | 1491. | L_{A63} | L_{B13} |
| 64. | L_{A64} | L_{B1} | 778. | L_{A64} | L_{B7} | 1492. | L_{A64} | L_{B13} |
| 65. | L_{A65} | L_{B1} | 779. | L_{A65} | L_{B7} | 1493. | L_{A65} | L_{B13} |
| 66. | L_{A66} | L_{B1} | 780. | L_{A66} | L_{B7} | 1494. | L_{A66} | L_{B13} |
| 67. | L_{A67} | L_{B1} | 781. | L_{A67} | L_{B7} | 1495. | L_{A67} | L_{B13} |
| 68. | L_{A68} | L_{B1} | 782. | L_{A68} | L_{B7} | 1496. | L_{A68} | L_{B13} |
| 69. | L_{A69} | L_{B1} | 783. | L_{A69} | L_{B7} | 1497. | L_{A69} | L_{B13} |
| 70. | L_{A70} | L_{B1} | 784. | L_{A70} | L_{B7} | 1498. | L_{A70} | L_{B13} |
| 71. | L_{A71} | L_{B1} | 785. | L_{A71} | L_{B7} | 1499. | L_{A71} | L_{B13} |
| 72. | L_{A72} | L_{B1} | 786. | L_{A72} | L_{B7} | 1500. | L_{A72} | L_{B13} |
| 73. | L_{A73} | L_{B1} | 787. | L_{A73} | L_{B7} | 1501. | L_{A73} | L_{B13} |
| 74. | L_{A74} | L_{B1} | 788. | L_{A74} | L_{B7} | 1502. | L_{A74} | L_{B13} |
| 75. | L_{A75} | L_{B1} | 789. | L_{A75} | L_{B7} | 1503. | L_{A75} | L_{B13} |
| 76. | L_{A76} | L_{B1} | 790. | L_{A76} | L_{B7} | 1504. | L_{A76} | L_{B13} |
| 77. | L_{A77} | L_{B1} | 791. | L_{A77} | L_{B7} | 1505. | L_{A77} | L_{B13} |
| 78. | L_{A78} | L_{B1} | 792. | L_{A78} | L_{B7} | 1506. | L_{A78} | L_{B13} |
| 79. | L_{A79} | L_{B1} | 793. | L_{A79} | L_{B7} | 1507. | L_{A79} | L_{B13} |
| 80. | L_{A80} | L_{B1} | 794. | L_{A80} | L_{B7} | 1508. | L_{A80} | L_{B13} |
| 81. | L_{A81} | L_{B1} | 795. | L_{AB1} | L_{B7} | 1509. | L_{A81} | L_{B13} |
| 82. | L_{A82} | L_{B1} | 796. | L_{A82} | L_{B7} | 1510. | L_{A82} | L_{B13} |
| 83. | L_{A83} | L_{B1} | 797. | L_{A83} | L_{B7} | 1511. | L_{A83} | L_{B13} |
| 84. | L_{A84} | L_{B1} | 798. | L_{A84} | L_{B7} | 1512. | L_{A84} | L_{B13} |
| 85. | L_{A85} | L_{B1} | 799. | L_{A85} | L_{B7} | 1513. | L_{A85} | L_{B13} |
| 86. | L_{A86} | L_{B1} | 800. | L_{A86} | L_{B7} | 1514. | L_{A86} | L_{B13} |
| 87. | L_{A87} | L_{B1} | 801. | L_{A87} | L₅₇ | 1515. | L_{A87} | L_{B13} |
| 88. | L_{A88} | L_{B1} | 802. | L_{A88} | L_{B7} | 1516. | L_{A88} | L_{B13} |
| 89. | L_{A89} | L_{B1} | 803. | L_{A89} | L_{B7} | 1517. | L_{A89} | L_{B13} |
| 90. | L_{A90} | L_{B1} | 804. | L_{A90} | L_{B7} | 1518. | L_{A90} | L_{B13} |
| 91. | L_{A91} | L_{B1} | 805. | L_{A91} | L_{B7} | 1519. | L_{A91} | L_{B13} |
| 92. | L_{A92} | L_{B1} | 806. | L_{A92} | L_{B7} | 1520. | L_{A92} | L_{B13} |
| 93. | L_{A93} | L_{B1} | 807. | L_{A93} | L_{B7} | 1521. | L_{A93} | L_{B13} |
| 94. | L_{A94} | L_{B1} | 808. | L_{A94} | L_{B7} | 1522. | L_{A94} | L_{B13} |
| 95. | L_{A95} | L_{B1} | 809. | L_{A95} | L_{B7} | 1523. | L_{A95} | L_{B13} |
| 96. | L_{A96} | L_{B1} | 810. | L_{A96} | L_{B7} | 1524. | L_{A96} | L_{B13} |
| 97. | L_{A97} | L_{B1} | 811. | L_{A97} | L_{B7} | 1525. | L_{A97} | L_{B13} |
| 98. | L_{A98} | L_{B1} | 812. | L_{A98} | L_{B7} | 1526. | L_{A98} | L_{B13} |
| 99. | L_{A99} | L_{B1} | 813. | L_{A99} | L_{B7} | 1527. | L_{A99} | L_{B13} |
| 100. | L_{A100} | L_{B1} | 814. | L_{A100} | L_{B7} | 1528. | L_{A100} | L_{B13} |
| 101. | L_{A101} | L_{B1} | 815. | L_{A101} | L_{B7} | 1529. | L_{A101} | L_{B13} |
| 102. | L_{A102} | L_{B1} | 816. | L_{A102} | L_{B7} | 1530. | L_{A102} | L_{B13} |
| 103. | L_{A103} | L_{B1} | 817. | L_{A103} | L_{B7} | 1531. | L_{A103} | L_{B13} |
| 104. | L_{A104} | L_{B1} | 818. | L_{A104} | L_{B7} | 1532. | L_{A104} | L_{B13} |
| 105. | L_{A105} | L_{B1} | 819. | L_{A105} | L_{B7} | 1533. | L_{A105} | L_{B13} |
| 106. | LA₁₀₆ | L_{B1} | 820. | L_{A106} | L_{B7} | 1534. | L_{A106} | L_{B13} |
| 107. | L_{A107} | L_{B1} | 821. | L_{A107} | L_{B7} | 1535. | L_{A107} | L_{B13} |
| 108. | L_{A108} | L_{B1} | 822. | L_{A108} | L_{B7} | 1536. | L_{A108} | L_{B13} |
| 109. | L_{A109} | L_{B1} | 823. | L_{A109} | L_{B7} | 1537. | L_{A109} | L_{B13} |
| 110. | L_{A110} | L_{B1} | 824. | L_{A110} | L_{B7} | 1538. | L_{A110} | L_{B13} |
| 111. | L_{A111} | L_{B1} | 825. | L_{A111} | L_{B7} | 1539. | L_{A111} | L_{B13} |
| 112. | L_{A112} | L_{B1} | 826. | L_{A112} | L_{B7} | 1540. | L_{A112} | L_{B13} |
| 113. | L_{A113} | L_{B1} | 827. | L_{A113} | L_{B7} | 1541. | L_{A113} | L_{B13} |
| 114. | L_{A114} | L_{B1} | 828. | L_{A114} | L_{B7} | 1542. | L_{A114} | L_{B13} |
| 115. | L_{A115} | L_{B1} | 829. | L_{A115} | L_{B7} | 1543. | L_{A115} | L_{B13} |
| 116. | L_{A116} | L_{B1} | 830. | L_{A116} | L_{B7} | 1544. | L_{A116} | L_{B13} |
| 117. | L_{A117} | L_{B1} | 831. | L_{A117} | L_{B7} | 1545. | L_{A117} | L_{B13} |
| 118. | L_{A118} | L_{B1} | 832. | L_{A118} | L_{B7} | 1546. | L_{A118} | L_{B13} |
| 119. | L_{A119} | L_{B1} | 833. | L_{A119} | L_{B7} | 1547. | L_{A119} | L_{B13} |
| 120. | L_{A1} | L_{B2} | 834. | L_{A1} | L_{B8} | 1548. | L_{A1} | L_{B14} |
| 121. | L_{A2} | L_{B2} | 835. | L_{A2} | L_{EB8} | 1549. | L_{A2} | L_{B14} |
| 122. | L_{A3} | L_{B2} | 836. | L_{A3} | L_{B8} | 1550. | L_{A3} | L_{B14} |
| 123. | L_{A4} | L_{B2} | 837. | L_{A4} | L_{B8} | 1551. | L_{A4} | L_{B14} |
| 124. | L_{A5} | L_{B2} | 838. | L_{A5} | L_{B8} | 1552. | L_{A5} | L_{B14} |
| 125. | L_{A6} | L_{B2} | 839. | L_{A6} | L_{B8} | 1553. | L_{A6} | L_{B14} |
| 126. | L_{A7} | L_{B2} | 840. | L_{A7} | L_{B8} | 1554. | L_{A7} | L_{B14} |
| 127. | L_{A8} | L_{B2} | 841. | L_{A8} | L_{B8} | 1555. | L_{A8} | L_{B14} |
| 128. | L_{A9} | L_{B2} | 842. | L_{A9} | L_{B8} | 1556. | L_{A9} | L_{B14} |
| 129. | L_{A10} | L_{B2} | 843. | L_{A10} | L_{B8} | 1557. | L_{A10} | L_{B14} |
| 130. | L_{A11} | L_{B2} | 844. | L_{A11} | L_{B8} | 1558. | L_{A11} | L_{B14} |
| 131. | L_{A12} | L_{B2} | 845. | L_{A12} | L_{B8} | 1559. | L_{A12} | L_{B14} |
| 132. | L_{A13} | L_{B2} | 846. | L_{A13} | L_{B8} | 1560. | L_{A13} | L_{B14} |
| 133. | L_{A14} | L_{B2} | 847. | L_{A14} | L_{B8} | 1561. | L_{A74} | L_{B14} |
| 134. | L_{A15} | L_{B2} | 848. | L_{A15} | L_{B8} | 1562. | L_{A15} | L_{B14} |
| 135. | L_{A16} | L_{B2} | 849. | L_{A16} | L_{B8} | 1563. | L_{A16} | L_{B14} |
| 136. | L_{A17} | L_{B2} | 850. | L_{A17} | L_{B8} | 1564. | L_{A17} | L_{B14} |
| 137. | L_{A18} | L_{B2} | 851. | L_{A18} | L_{B8} | 1565. | L_{A18} | L_{B14} |
| 138. | L_{A19} | L_{B2} | 852. | L_{A19} | L_{B8} | 1566. | L_{A19} | L_{B14} |
| 139. | L_{A10} | L_{B2} | 853. | L_{A10} | L_{B8} | 1567. | L_{A10} | L_{B14} |
| 140. | L_{A21} | L_{B2} | 854. | L_{A21} | L_{B8} | 1568. | L_{A21} | L_{B14} |
| 141. | L_{A22} | L_{B2} | 855. | L_{A22} | L_{B8} | 1569. | L_{A22} | L_{B14} |
| 142. | L_{A23} | L_{B2} | 856. | L_{A23} | L_{B8} | 1570. | L_{A23} | L_{B14} |
| 143. | L_{A24} | L_{B2} | 857. | L_{A24} | L_{B8} | 1571. | L_{A24} | L_{B1} |
| 144. | L_{A25} | L_{B2} | 858. | L_{A25} | L_{B8} | 1572. | L_{A25} | L_{B14} |
| 145. | L_{A26} | L_{B2} | 859. | L_{A26} | L_{B8} | 1573. | L_{A26} | L_{B14} |
| 146. | L_{A27} | L_{B2} | 860. | L_{A27} | L_{B8} | 1574. | L_{A27} | L_{B14} |
| 147. | L_{A28} | L_{B2} | 861. | L_{A28} | L_{B8} | 1575. | L_{A28} | L_{B14} |
| 148. | L_{A29} | L_{B2} | 862. | L_{A29} | L_{B8} | 1576. | L_{A29} | L_{B14} |
| 149. | L_{A30} | L_{B2} | 863. | L_{A30} | L_{B8} | 1577. | L_{A30} | L_{B14} |
| 150. | L_{A31} | L_{B2} | 864. | L_{A31} | L_{B8} | 1578. | L_{A31} | L_{B14} |
| 151. | L_{A32} | LB₂ | 865. | L_{A32} | L_{B8} | 1579. | L_{A32} | L_{B14} |
| 152. | L_{A33} | L_{B2} | 866. | L_{A33} | L_{B8} | 1580. | L_{A33} | LB₁₄ |
| 153. | L_{A34} | L_{B2} | 867. | L_{A34} | L_{B8} | 1581. | L_{A34} | L_{B14} |
| 154. | L_{A35} | L_{B2} | 868. | L_{A35} | L_{B8} | 1582. | L_{A35} | L_{B14} |
| 155. | L_{A36} | L_{B2} | 869. | L_{A36} | L_{B8} | 1583. | L_{A36} | L_{B14} |
| 156. | L_{A37} | L_{B2} | 870. | L_{A37} | L_{B8} | 1584. | L_{A37} | L_{B14} |
| 157. | L_{A38} | L_{B2} | 871. | L_{A38} | L_{B8} | 1585. | L_{A38} | L_{B14} |
| 158. | L_{A39} | L_{B2} | 872. | L_{A39} | L_{B8} | 1586. | L_{A39} | L_{B14} |
| 159. | L_{A40} | L_{B2} | 873. | L_{A40} | L_{B8} | 1587. | L_{A40} | L_{B14} |
| 160. | L_{A41} | L_{B2} | 874. | L_{A41} | L_{B8} | 1588. | L_{A41} | L_{B14} |
| 161. | L_{A42} | L_{B2} | 875. | L_{A42} | L_{B8} | 1589. | L_{A42} | L_{B14} |
| 162. | L_{A43} | L_{B2} | 876. | L_{A43} | L_{B8} | 1590. | L_{A43} | L_{B14} |
| 163. | L_{A44} | L_{B2} | 877. | L_{A44} | L_{B8} | 1591. | L_{A44} | L_{B14} |
| 164. | L_{A45} | L_{B2} | 878. | L_{A45} | L_{B8} | 1592. | L_{A45} | L_{B14} |
| 165. | L_{A46} | L_{B2} | 879. | L_{A46} | L_{B8} | 1593. | L_{A46} | L_{B14} |
| 166. | L_{A47} | L_{B2} | 880. | L_{A47} | L_{B8} | 1594. | L_{A47} | L_{B14} |
| 167. | L_{A48} | L_{B2} | 881. | L_{A48} | L_{B8} | 1595. | L_{A48} | L_{B14} |
| 168. | L_{A49} | L_{B2} | 882. | L_{A49} | L_{B8} | 1596. | L_{A49} | L_{B14} |
| 169. | L_{A50} | L_{B2} | 883. | L_{A50} | L_{B8} | 1597. | L_{A50} | L_{B14} |
| 170. | L_{A51} | L_{B2} | 884. | L_{A51} | L_{B8} | 1598. | L_{A51} | L_{B14} |
| 171. | L_{A52} | L_{B2} | 885. | L_{A52} | L_{B8} | 1599. | L_{A52} | L_{B14} |
| 172. | L_{A53} | L_{B2} | 886. | L_{A53} | L_{B8} | 1600. | L_{A53} | L_{B14} |
| 173. | L_{A54} | L_{B2} | 887. | L_{A54} | L_{B8} | 1601. | L_{A54} | L_{B14} |
| 174. | L_{A55} | L_{B2} | 888. | L_{A55} | L_{B8} | 1602. | L_{A55} | L_{B14} |
| 175. | L_{A56} | L_{B2} | 889. | L_{A56} | L_{B8} | 1603. | L_{A56} | L_{B14} |
| 176. | L_{A57} | L_{B2} | 890. | L_{A57} | L_{B8} | 1604. | L_{A57} | L_{B14} |
| 177. | L_{A58} | L_{B2} | 891. | L_{A58} | L_{B8} | 1605. | L_{A58} | L_{B14} |
| 178. | L_{A59} | L_{B2} | 892. | L_{A59} | L_{B8} | 1606. | L_{A59} | L_{B14} |
| 179. | L_{A60} | L_{B2} | 893. | L_{A60} | L_{B8} | 1607. | L_{A60} | L_{B14} |
| 180. | L_{A61} | L_{B2} | 894. | L_{A61} | L_{B8} | 1608. | L_{A61} | L_{B14} |
| 181. | L_{A62} | L_{B2} | 895. | L_{A62} | L_{B8} | 1609. | L_{A62} | L_{B14} |
| 182. | L_{A63} | L_{B2} | 896. | L_{A63} | L_{B8} | 1610. | L_{A63} | L_{B14} |
| 183. | L_{A64} | L_{B2} | 897. | L_{A64} | L_{B8} | 1611. | L_{A64} | L_{B14} |
| 184. | L_{A65} | L_{B2} | 898. | L_{A65} | L_{B8} | 1612. | L_{A65} | L_{B14} |
| 185. | L_{A66} | L_{B2} | 899. | L_{A66} | L_{B8} | 1613. | L_{A66} | L_{B14} |
| 186. | L_{A67} | L_{B2} | 900. | L_{A67} | L_{B8} | 1614. | L_{A67} | L_{B14} |
| 187. | L_{A6B} | L_{B2} | 901. | L_{A68} | L_{B8} | 1615. | L_{A68} | L_{B14} |
| 188. | L_{A69} | L_{B2} | 902. | L_{A69} | L_{B8} | 1616. | L_{A69} | L_{B14} |
| 189. | L_{A70} | L_{B2} | 903. | L_{A70} | L_{B8} | 1617. | L_{A70} | L_{B14} |
| 190. | L_{A71} | L_{B2} | 904. | L_{A71} | L_{B8} | 1618. | L_{A71} | L_{B14} |
| 191. | L_{A72} | L_{B2} | 905. | L_{A72} | L_{B8} | 1619. | L_{A72} | L_{B14} |
| 192. | L_{A73} | L_{B2} | 906. | L_{A73} | L_{B8} | 1620. | L_{A73} | L_{B14} |
| 193. | L_{A74} | L_{B2} | 907. | L_{A74} | L_{B8} | 1621. | L_{A74} | L_{B14} |
| 194. | L_{A75} | L_{B2} | 908. | L_{A75} | L_{B8} | 1622. | L_{A75} | L_{B14} |
| 195. | L_{A76} | L_{B2} | 909. | L_{A76} | L_{B8} | 1623. | L_{A76} | L_{B14} |
| 196. | L_{A77} | L_{B2} | 910. | L_{A77} | L_{B8} | 1624. | L_{A77} | L_{B14} |
| 197. | L_{A78} | L_{B2} | 911. | L_{A78} | L_{B8} | 1625. | L_{A78} | L_{B14} |
| 198. | L_{A79} | L_{B2} | 912. | L_{A79} | L_{B8} | 1626. | L_{A79} | L_{B14} |
| 199. | L_{A80} | L_{B2} | 913. | L_{A80} | L_{B8} | 1627. | L_{A80} | L_{B14} |
| 200. | L_{A81} | L_{B2} | 914. | L_{A81} | L_{B8} | 1628. | L_{A81} | L_{B14} |
| 201. | L_{A82} | L_{B2} | 915. | L_{A82} | L_{B8} | 1629. | L_{A82} | L_{B14} |
| 202. | L_{A83} | L_{B2} | 916. | L_{A83} | L_{B8} | 1630. | L_{A83} | L_{B14} |
| 203. | L_{A84} | L_{B2} | 917. | L_{A84} | L_{B8} | 1631. | L_{A84} | L_{B14} |
| 204. | L_{A85} | L_{B2} | 918. | L_{A85} | L_{B8} | 1632. | L_{A85} | L_{B14} |
| 205. | L_{A86} | L_{B2} | 919. | L_{A86} | L_{B8} | 1633. | L_{A86} | L_{B14} |
| 206. | L_{A87} | L_{B2} | 920. | L_{A87} | L_{B8} | 1634. | L_{A87} | L_{B14} |
| 207. | L_{A88} | L_{B2} | 921. | L_{A88} | L_{B8} | 1635. | L_{A88} | L_{B14} |
| 208. | L_{A89} | L_{B2} | 922. | L_{A89} | L_{B8} | 1636. | L_{A89} | L_{B14} |
| 209. | L_{A90} | L_{B2} | 923. | L_{A90} | L_{B8} | 1637. | L_{A90} | L_{B14} |
| 210. | L_{A91} | L_{B2} | 924. | L_{A91} | L_{B8} | 1638. | L_{A91} | L_{B14} |
| 211. | L_{A92} | L_{B2} | 925. | L_{A92} | L_{B8} | 1639. | L_{A92} | L_{B14} |
| 212. | L_{A93} | L_{B2} | 926. | L_{A93} | L_{B8} | 1640. | L_{A93} | L_{B14} |
| 213. | L_{A94} | L_{B2} | 927. | L_{A94} | L_{B8} | 1641. | L_{A94} | L_{B14} |
| 214. | L_{A95} | L_{B2} | 928. | L_{A95} | L_{B8} | 1642. | L_{A95} | L_{B14} |
| 215. | L_{A96} | L_{B2} | 929. | L_{A96} | L_{B8} | 1643. | L_{A96} | L_{B14} |
| 216. | L_{A97} | L_{B2} | 930. | L_{A97} | L_{B8} | 1644. | L_{A97} | L_{B14} |
| 217. | L_{A98} | L_{B2} | 931. | L_{A98} | L_{B8} | 1645. | L_{A98} | L_{B14} |
| 218. | L_{A99} | L_{B2} | 932. | L_{A99} | L_{B8} | 1646. | L_{A99} | L_{B14} |
| 219. | L_{A100} | L_{B2} | 933. | L_{A100} | L_{B8} | 1647. | L_{A100} | L_{B14} |
| 220; | L_{A101} | L_{B2} | 934. | L_{A101} | L_{B8} | 1648. | L_{A101} | L_{B14} |
| 221. | L_{A102} | L_{B2} | 935. | L_{A102} | L_{B8} | 1649_{.} | L_{A102} | L_{B14} |
| 222. | L_{A103} | L_{B2} | 936. | L_{A103} | L_{B8} | 1650. | L_{A103} | L_{B14} |
| 223. | L_{A104} | L_{B2} | 937. | L_{A104} | L_{B8} | 1651. | L_{A104} | L_{B14} |
| 224. | L_{A105} | L_{B2} | 938. | L_{A105} | L_{B8} | 1652. | L_{A105} | L_{B14} |
| 225. | L_{A106} | L_{B2} | 939. | L_{A106} | L_{B8} | 1653. | L_{A106} | L_{B14} |
| 2.26. | L_{A107} | L_{B2} | 940. | L_{A107} | L_{B8} | 1654. | L_{A107} | L_{B14} |
| 227. | L_{A108} | L_{B2} | 941. | L_{A108} | L_{B8} | 1655. | L_{A108} | L_{B14} |
| 228. | L_{A109} | L_{B2} | 942. | L_{A109} | L_{B8} | 1656. | L_{A109} | L_{B14} |
| 229. | L_{A110} | L_{B2} | 943. | L_{A110} | L_{B8} | 1657. | L_{A110} | L_{B14} |
| 3230. | L_{A111} | L_{B2} | 944. | L_{A111} | L_{B8} | 1658. | L_{A111} | L_{B14} |
| 231. | L_{A112} | L_{B2} | 945. | L_{A112} | L_{B8} | 1659. | L_{A112} | L_{B14} |
| 232. | L_{A113} | L_{B2} | 946. | L_{A113} | L_{B8} | 1660. | L_{A113} | L_{B14} |
| 233. | L_{A114} | L_{B2} | 947. | L_{A114} | L_{B8} | 1661. | L_{A114} | L_{B14} |
| 234. | L_{A115} | L_{B2} | 948. | L_{A115} | L_{B8} | 1662. | L_{A115} | L_{B14} |
| 235. | L_{A116} | L_{B2} | 949. | L_{A116} | L_{B8} | 1663. | L_{A116} | L_{B14} |
| 236_{.} | L_{A117} | L_{B2} | 950. | L_{A117} | L_{B8} | 1664. | L_{A117} | L_{B14} |
| 237. | L_{A118} | L_{B2} | 951. | L_{A118} | L_{B8} | 1665. | L_{A118} | L_{B14} |
| 238. | L_{A119} | L_{B2} | 952. | L_{A119} | L_{B8} | 1666. | L_{A119} | L_{B14} |
| 239. | L_{A1} | L_{B3} | 953. | L_{A1} | L_{B9} | 1667. | L_{A1} | L_{B15} |
| 240. | L_{A2} | L_{B3} | 954. | L_{A2} | L_{B9} | 1668. | L_{A2} | L_{B15} |
| 241. | L_{A3} | L_{B3} | 955. | L_{A3} | L_{B9} | 1669. | L_{A3} | L_{B15} |
| 242. | L_{A4} | L_{B3} | 956. | L_{A4} | L_{B9} | 1670. | L_{A4} | L_{B15} |
| 243. | L_{A5} | L_{B3} | 957. | L_{A5} | L_{B9} | 1671. | L_{A5} | L_{B15} |
| 244. | L_{A6} | L_{B3} | 958. | L_{A6} | L_{B9} | 1672. | L_{A6} | L_{B15} |
| 245. | L_{A7} | L_{B3} | 959. | L_{A7} | L_{B9} | 1673. | L_{A7} | L_{B15} |
| 246. | L_{A8} | L_{B3} | 960. | L_{A8} | L_{B9} | 1674. | L_{A8} | L_{B15} |
| 247. | L_{A9} | L_{B3} | 961. | L_{A9} | L_{B9} | 1675. | L_{A9} | L_{B15} |
| 248. | L_{A10} | L_{B3} | 962. | L_{A10} | L_{B9} | 1676. | L_{A10} | L_{B15} |
| 249. | L_{A11} | L_{B3} | 963. | L_{A11} | L_{B9} | 1677. | L_{A11} | L_{B15} |
| 250. | L_{A12} | L_{B3} | 964. | L_{A12} | L_{B9} | 1678. | L_{A12} | L_{B15} |
| 251. | L_{A13} | L_{B3} | 965. | L_{A13} | L_{B9} | 1679. | L_{A13} | L_{B15} |
| 252. | L_{A14} | L_{B3} | 966. | L_{A14} | L_{B9} | 1680. | L_{A14} | L_{B15} |
| 253. | L_{A15} | L_{B3} | 967. | L_{A15} | L_{B9} | 1681. | L_{A15} | L_{B15} |
| 254. | L_{A16} | L_{B3} | 968. | L_{A16} | L_{B9} | 1682. | L_{A16} | L_{B15} |
| 255. | L_{A17} | L_{B3} | 969. | L_{A17} | L_{B9} | 1683. | L_{A17} | L_{B15} |
| 256. | L_{A18} | L_{B3} | 970. | L_{A18} | L_{B9} | 1684. | L_{A18} | L_{B15} |
| 257. | L_{A19} | L_{B3} | 971. | L_{A19} | L_{B9} | 1685. | L_{A19} | L_{B15} |
| 258. | L_{A10} | L_{B3} | 972. | L_{A10} | L_{B9} | 1686. | L_{A10} | L_{B15} |
| 259. | L_{A21} | L_{B3} | 973. | L_{A21} | L_{B9} | 1687. | L_{A21} | L_{B15} |
| 260. | L_{A22} | L_{B3} | 974. | L_{A22} | L_{B9} | 1688. | L_{A22} | L_{B15} |
| 261. | L_{A23} | L_{B3} | 975. | L_{A23} | L_{B9} | 1689. | L_{A23} | L_{B15} |
| 262. | L_{A24} | L_{B3} | 976. | L_{A24} | L_{B9} | 1690. | L_{A24} | L_{B15} |
| 263. | L_{A25} | L_{B3} | 977. | L_{A25} | L_{B9} | 1691. | L_{A25} | L_{B15} |
| 264. | L_{A26} | L_{B3} | 978. | L_{A26} | L_{B9} | 1692. | L_{A26} | L_{B15} |
| 265. | L_{A27} | L_{B3} | 979. | L_{A27} | L_{B9} | 1693. | L_{A27} | L_{B15} |
| 266. | L_{A28} | L_{B3} | 980. | L_{A28} | L_{B9} | 1694. | L_{A28} | L_{B15} |
| 267. | L_{A29} | L_{B3} | 981. | L_{A29} | L_{B9} | 1695. | L_{A29} | L_{B15} |
| 268. | L_{A30} | L_{B3} | 982. | L_{A30} | L_{B9} | 1696. | L_{A30} | L_{B15} |
| 269. | L_{A31} | L_{B3} | 983. | L_{A31} | L_{B9} | 1697. | L_{A31} | L_{B15} |
| 270. | L_{A32} | L_{B3} | 984. | L_{A32} | L_{B9} | 1698. | L_{A32} | L_{B15} |
| 271. | L_{A33} | L_{B3} | 985. | L_{A33} | L_{B9} | 1699. | L_{A33} | L_{B15} |
| 272. | L_{A34} | L_{B3} | 986. | L_{A34} | L_{B9} | 1700. | L_{A34} | L_{B15} |
| 273. | L_{A35} | L_{B3} | 987. | L_{A35} | L_{B9} | 1701. | L_{A35} | L_{B15} |
| 274. | L_{A36} | L_{B3} | 988. | L_{A36} | L_{B9} | 1702. | L_{A36} | L_{B15} |
| 275. | L_{A37} | L_{B3} | 989. | L_{A37} | L_{B9} | 1703. | L_{A37} | L_{B15} |
| 276. | L_{A38} | L_{B3} | 990. | L_{A38} | L_{B9} | 1704. | L_{A38} | L_{B15} |
| 277. | L_{A39} | L_{B3} | 991. | L_{A39} | L_{B9} | 1705. | L_{A39} | L_{B15} |
| 278. | L_{A40} | L_{B3} | 992. | L_{A40} | L_{B9} | 1706. | L_{A40} | L_{B15} |
| 279. | L_{A41} | L_{B3} | 993. | L_{A41} | L_{B9} | 1707. | L_{A41} | L_{B15} |
| 280. | L_{A42} | L_{B3} | 994. | L_{A42} | L_{B9} | 1708. | L_{A42} | L_{B15} |
| 281. | L_{A43} | L_{B3} | 995. | L_{A43} | L_{B9} | 1709. | L_{A43} | L_{B15} |
| 282. | L_{A44} | L_{B3} | 996. | L_{A44} | L_{B9} | 1710. | L_{A44} | L_{B15} |
| 283. | L_{A45} | L_{B3} | 997. | L_{A45} | L_{B9} | 1711. | L_{A45} | L_{B15} |
| 284. | L_{A46} | L_{B3} | 998. | L_{A46} | L_{B9} | 1712. | L_{A46} | L_{B15} |
| 285. | L_{A47} | L_{B3} | 999. | L_{A47} | L_{B9} | 1713. | L_{A47} | L_{B15} |
| 286. | L_{A48} | L_{B3} | 1000. | L_{A48} | L_{B9} | 1714. | L_{A48} | L_{B15} |
| 287. | L_{A49} | L_{B3} | 1001. | L_{A49} | L_{B9} | 1715. | L_{A49} | L_{B15} |
| 288. | L_{A50} | L_{B3} | 1002. | L_{A50} | L_{B9} | 1716. | L_{A50} | L_{B15} |
| 289. | L_{A51} | L_{B3} | 1003. | L_{A51} | L_{B9} | 1717. | L_{A51} | L_{B15} |
| 290. | L_{A52} | L_{B3} | 1004. | L_{A52} | L_{B9} | 1718. | L_{A52} | L_{B15} |
| 291. | L_{A53} | L_{B3} | 1005. | L_{A53} | L_{B9} | 1719. | L_{A53} | L_{B15} |
| 292. | L_{A54} | L_{B3} | 1006. | L_{A54} | L_{B9} | 1720. | L_{A54} | L_{B15} |
| 293. | L_{A55} | L_{B3} | 1007. | L_{A55} | L_{B9} | 1721. | L_{A55} | L_{B15} |
| 294. | L_{A56} | L_{B3} | 1008. | L_{A56} | L_{B9} | 1722. | L_{A56} | L_{B15} |
| 295. | L_{A57} | L_{B3} | 1009. | L_{A57} | L_{B9} | 1723. | L_{A57} | L_{B15} |
| 296. | L_{A58} | L_{B3} | 1010. | L_{A58} | L_{B9} | 1724. | L_{A58} | L_{B15} |
| 297. | L_{A59} | L_{B3} | 1011. | L_{A59} | L_{B9} | 1725. | L_{A59} | L_{B15} |
| 298. | L_{A60} | L_{B3} | 1012. | L_{A60} | L_{B9} | 1726. | L_{A60} | L_{B15} |
| 299. | L_{A61} | L_{B3} | 1013. | L_{A61} | L_{B9} | 1727. | L_{A61} | L_{B15} |
| 300. | L_{A62} | L_{B3} | 1014. | L_{A62} | L_{B9} | 1728. | L_{A62} | L_{B15} |
| 301. | L_{A63} | L_{B3} | 1015. | L_{A63} | L_{B9} | 1729. | L_{A63} | L_{B15} |
| 302. | L_{A64} | L_{B3} | 1016. | L_{A64} | L_{B9} | 1730. | L_{A64} | L_{B15} |
| 303. | L_{A65} | L_{B3} | 1017. | L_{A65} | L_{B9} | 1731. | L_{A65} | L_{B15} |
| 304. | L_{A66} | L_{B3} | 1018. | L_{A66} | L_{B9} | 1732. | L_{A66} | L_{B15} |
| 305. | L_{A67} | L_{B3} | 1019. | L_{A67} | L_{B9} | 1733. | L_{A67} | L_{B15} |
| 306. | L_{A68} | L_{B3} | 1020. | L_{A68} | L_{B9} | 1734. | L_{A68} | L_{B15} |
| 307. | L_{A69} | L_{B3} | 1021. | L_{A69} | L_{B9} | 1735. | L_{A69} | L_{B15} |
| 308. | L_{A70} | L_{B3} | 1022. | L_{A70} | L_{B9} | 1736. | L_{A70} | L_{B15} |
| 309. | L_{A71} | L_{B3} | 1023. | L_{A71} | L_{B9} | 1737. | L_{A71} | L_{B15} |
| 310. | L_{A72} | L_{B3} | 1024. | L_{A72} | L_{B9} | 1738. | L_{A72} | L_{B15} |
| 311. | L_{A73} | L_{B3} | 1025. | L_{A73} | L_{B9} | 1739. | L_{A73} | L_{B15} |
| 312. | L_{A74} | L_{B3} | 1026. | L_{A74} | L_{B9} | 1740. | L_{A74} | L_{B15} |
| 313. | L_{A75} | L_{B3} | 1027. | L_{A75} | L_{B9} | 1741. | L_{A75} | L_{B15} |
| 314. | L_{A76} | L_{B3} | 1028. | L_{A76} | L_{B9} | 1742. | L_{A76} | L_{B15} |
| 315. | L_{A77} | L_{B3} | 1029. | L_{A77} | L_{B9} | 1743. | L_{A77} | L_{B15} |
| 316. | L_{A78} | L_{B3} | 1030. | L_{A78} | L_{B9} | 1744. | L_{A78} | L_{B15} |
| 317. | L_{A79} | L_{B3} | 1031. | L_{A79} | L_{B9} | 1745. | L_{A79} | L_{B15} |
| 318. | L_{A80} | L_{B3} | 1032. | L_{A80} | L_{B9} | 1746. | L_{A80} | L_{B15} |
| 319. | L_{A81} | L_{B3} | 1033. | L_{A81} | L_{B9} | 1747. | L_{A81} | L_{B15} |
| 320. | L_{A82} | L_{B3} | 1034. | L_{A82} | L_{B9} | 1748. | L_{A82} | L_{B15} |
| 321. | L_{A83} | L_{B3} | 1035. | L_{A83} | L_{B9} | 1749. | L_{A83} | L_{B15} |
| 322. | L_{A84} | L_{B3} | 1036. | L_{A84} | L_{B9} | 1750. | L_{A84} | L_{B15} |
| 323. | L_{A85} | L_{B3} | 1037. | L_{A85} | L_{B9} | 1751. | L_{A85} | L_{B15} |
| 324. | L_{A86} | L_{B3} | 1038. | L_{A86} | L_{B9} | 1752. | L_{A86} | L_{B15} |
| 325. | L_{A87} | L_{B3} | 1039. | L_{A87} | L_{B9} | 1753. | L_{A87} | L_{B15} |
| 326. | L_{A88} | L_{B3} | 1040. | L_{A88} | L_{B9} | 1754. | L_{A88} | L_{B15} |
| 327. | L_{A89} | L_{B3} | 1041. | L_{A89} | L_{B9} | 1755. | L_{A89} | L_{B15} |
| 328. | L_{A90} | L_{B3} | 1042. | L_{A90} | L_{B9} | 1756. | L_{A90} | L_{B15} |
| 329. | L_{A91} | L_{B3} | 1043. | L_{A91} | L_{B9} | 1757. | L_{A91} | L_{B15} |
| 330. | L_{A92} | L_{B3} | 1044. | L_{A92} | L_{B9} | 1758. | L_{A92} | L_{B15} |
| 331. | L_{A93} | L_{B3} | 1045. | L_{A93} | L_{B9} | 1759. | L_{A93} | L_{B15} |
| 332. | L_{A94} | L_{B3} | 1046. | L_{A94} | L_{B9} | 1760. | L_{A94} | L_{B15} |
| 333 | L_{A95} | L_{B3} | 1047. | L_{A95} | L_{B9} | 1761. | L_{A95} | L_{B15} |
| 334. | L_{A96} | L_{B3} | 1048. | L_{A96} | L_{B9} | 1762. | L_{A96} | L_{B15} |
| 335. | L_{A97} | L_{B3} | 1049. | L_{A97} | L_{B9} | 1763. | L_{A97} | L_{B15} |
| 336. | L_{A98} | L_{B3} | 1050. | L_{A98} | L_{B9} | 1764. | L_{A98} | L_{B15} |
| 337. | L_{A99} | L_{B3} | 1051. | L_{A99} | L_{B9} | 1765. | L_{A99} | L_{B15} |
| 338. | L_{A100} | L_{B3} | 1052. | L_{A100} | L_{B9} | 1766. | L_{A100} | L_{B15} |
| 339. | L_{A101} | L_{B3} | 1053. | L_{A101} | L_{B9} | 1767. | L_{A101} | L_{B15} |
| 340. | L_{A102} | L_{B3} | 1054. | L_{A102} | L_{B9} | 1768. | L_{A102} | L_{B15} |
| 341. | L_{A103} | L_{B3} | 1055. | L_{A103} | L_{B9} | 1769. | L_{A103} | L_{B15} |
| 342. | L_{A104} | L_{B3} | 1056. | L_{A104} | L_{B9} | 1770. | L_{A104} | L_{B15} |
| 343. | L_{A105} | L_{B3} | 1057. | L_{A105} | L_{B9} | 1771. | L_{A105} | L_{B15} |
| 344. | L_{A106} | L_{B3} | 1058. | L_{A106} | L_{B9} | 1772. | L_{A106} | L_{B15} |
| 345. | L_{A107} | L_{B3} | 1059. | L_{A107} | L_{B9} | 1773. | L_{A107} | L_{B15} |
| 346. | L_{A108} | L_{B3} | 1060. | L_{A108} | L_{B9} | 1774. | L_{A108} | L_{B15} |
| 347. | L_{A109} | L_{B3} | 1061. | L_{A109} | L_{B9} | 1775. | L_{A109} | L_{B15} |
| 348. | L_{A110} | L_{B3} | 1062. | L_{A110} | L_{B9} | 1776. | L_{A110} | L_{B15} |
| 349. | L_{A111} | L_{B3} | 1063. | L_{A111} | L_{B9} | 1777. | L_{A111} | L_{B15} |
| 350. | L._{A112} | L_{B3} | 1064. | L_{A112} | L_{B9} | 1778. | L_{A112} | L_{B15} |
| 351. | L_{A113} | L_{B3} | 1065. | L_{A113} | L_{B9} | 1779. | L_{A113} | L_{B15} |
| 352. | L_{A114} | L_{B3} | 1066. | L_{A114} | L_{B9} | 1780. | L_{A114} | L_{B15} |
| 353. | L_{A115} | L_{B3} | 1067. | L_{A115} | L_{B9} | 1781. | L_{A115} | L_{B15} |
| 354. | L_{A116} | L_{B3} | 1068. | L_{A116} | L_{B9} | 1782. | L_{A116} | L_{B15} |
| 355. | L_{A117} | L_{B3} | 1069. | L_{A117} | L_{B9} | 1783. | L_{A117} | L_{B15} |
| 356. | L_{A118} | L_{B3} | 1070. | L_{A118} | L_{B9} | 1784. | L_{A118} | L_{B15} |
| 357. | L_{A119} | L_{B3} | 1071. | L_{A119} | L_{B9} | 1785. | L_{A119} | L_{B15} |
| 358. | L_{A1} | L_{B4} | 1072. | L_{A1} | L_{B10} | 1786. | L_{A1} | L_{B16} |
| 359. | L_{A2} | L_{B4} | 1073. | L_{A2} | L_{B10} | 1787. | L_{A2} | L_{B16} |
| 360. | L_{A3} | L_{B4} | 1074. | L_{A3} | L_{B10} | 1788. | L_{A3} | L_{B16} |
| 361. | L_{A4} | L_{B4} | 1075. | L_{A4} | L_{B10} | 1789. | L_{A4} | L_{B16} |
| 362. | L_{A5} | L_{B4} | 1076. | L_{A5} | L_{B10} | 1790. | L_{A5} | L_{B16} |
| 363. | L_{A6} | L_{B4} | 1077. | L_{A6} | L_{B10} | 1791. | L_{A6} | L_{B16} |
| 364. | L_{A7} | L_{B4} | 1078. | L_{A7} | L_{B10} | 1792. | L_{A7} | L_{B16} |
| 365. | L_{A8} | L_{B4} | 1079. | L_{A8} | L_{B10} | 1793. | L_{A8} | L_{B16} |
| 366. | L_{A9} | L_{B4} | 1080. | L_{A9} | L_{B10} | 1794. | L_{A9} | L_{B16} |
| 367. | L_{A10} | L_{B4} | 1081. | L_{A10} | L_{B10} | 1795. | L_{A10} | L_{B16} |
| 368. | L_{A11} | L_{B4} | 1082. | L_{A11} | L_{B10} | 1796. | L_{A11} | L_{B16} |
| 369. | L_{A12} | L_{B4} | 1083. | L_{A12} | L_{B10} | 1797. | L_{A12} | L_{B16} |
| 370. | L_{A13} | L_{B4} | 1084. | L_{A13} | L_{B10} | 1798. | L_{A13} | L_{B16} |
| 371. | L_{A14} | L_{B4} | 1085. | L_{A14} | L_{B10} | 1799. | L_{A14} | L_{B16} |
| 372. | L_{A15} | L_{B4} | 1086. | L_{A15} | L_{B10} | 1800. | L_{A15} | L_{B16} |
| 373. | L_{A16} | L_{B4} | 1087. | L_{A16} | L_{B10} | 1801. | L_{A16} | L_{B16} |
| 374. | L_{A17} | L_{B4} | 1088. | L_{A17} | L₈₁₀ | 1802. | L_{A17} | L_{B16} |
| 375. | L_{A18} | L_{B4} | 1089. | L_{A18} | L_{B10} | 1803. | L_{A18} | L_{B16} |
| 376. | L_{A19} | L_{B4} | 1090. | L_{A19} | L_{B10} | 1804. | L_{A19} | L_{B16} |
| 377. | L_{A10} | L_{B4} | 1091. | L_{A10} | L_{B10} | 1805. | L_{A10} | L_{B16} |
| 378. | L_{A21} | L_{B4} | 1092. | L_{A21} | L_{B10} | 1806. | L_{A21} | L_{B16} |
| 379. | L_{A22} | L_{B4} | 1093. | L_{A22} | L_{B10} | 1807. | L_{A22} | L_{B16} |
| 380. | L_{A23} | L_{B4} | 1094. | L_{A23} | L_{B10} | 1808. | L_{A23} | L_{B16} |
| 381. | L_{A24} | L_{B4} | 1095. | L_{A24} | L_{B10} | 1809. | L_{A24} | L_{B16} |
| 382. | L_{A25} | L_{B4} | 1096. | L_{A25} | L_{B10} | 1810. | L_{A25} | L_{B16} |
| 383. | L_{A26} | L_{B4} | 1097. | L_{A26} | L_{B10} | 1811. | L_{A26} | L_{B16} |
| 384. | L_{A27} | L_{B4} | 1098. | L_{A27} | L_{B10} | 1812. | L_{A27} | L_{B16} |
| 385. | L_{A28} | L_{B4} | 1099. | L_{A28} | L_{B10} | 1813. | L_{A28} | L_{B16} |
| 386. | L_{A29} | L_{B4} | 1100. | L_{A29} | L_{B10} | 1814. | L_{A29} | L_{B16} |
| 387. | L_{A30} | L_{B4} | 1101. | L_{A30} | L_{B10} | 1815. | L_{A30} | L_{B16} |
| 388. | L_{A31} | L_{B4} | 1102. | L_{A31} | L_{B10} | 1816. | L_{A31} | L_{B16} |
| 389. | L_{A32} | L_{B4} | 1103. | L_{A32} | L_{B10} | 1817. | L_{A32} | L_{B16} |
| 390. | L_{A33} | L_{B4} | 1104. | L_{A33} | L_{B10} | 1818. | L_{A33} | L_{B16} |
| 391. | L_{A34} | L_{B4} | 1105. | L_{A34} | L_{B10} | 1819. | L_{A34} | L_{B16} |
| 392. | L_{A35} | L_{B4} | 1106. | L_{A35} | L_{B10} | 1820. | L_{A35} | L_{B16} |
| 393. | L_{A36} | L_{B4} | 1107. | L_{A36} | L_{B10} | 1821. | L_{A36} | L_{B16} |
| 394. | L_{A37} | L_{B4} | 1108. | L_{A37} | L_{B10} | 1822. | L_{A37} | L_{B16} |
| 395. | L_{A38} | L_{B4} | 1109. | L_{A38} | L_{B10} | 1823. | L_{A38} | L_{B16} |
| 396. | L_{A39} | L_{B4} | 1110. | L_{A39} | L_{B10} | 1824. | L_{A39} | L_{B16} |
| 397. | L_{A40} | L_{B4} | 1111. | L_{A40} | L_{B10} | 1825. | L_{A40} | L_{B16} |
| 398. | L_{A41} | L_{B4} | 1112. | L_{A41} | L_{B10} | 1826. | L_{A41} | L_{B16} |
| 399. | L_{A42} | L_{B4} | 1113. | L_{A42} | L_{B10} | 1827. | L_{A42} | L_{B16} |
| 400. | L_{A43} | L_{B4} | 1114. | L_{A43} | L_{B10} | 1828. | L_{A43} | L_{B16} |
| 401. | L_{A44} | L_{B4} | 1115. | L_{A44} | L_{B10} | 1829. | L_{A44} | L_{B16} |
| 402. | L_{A45} | L_{B4} | 1116. | L_{A45} | L_{B10} | 1830. | L_{A45} | L_{B16} |
| 403. | L_{A46} | L_{B4} | 1117. | L_{A46} | L_{B10} | 1831. | L_{A46} | L_{B16} |
| 404. | L_{A47} | L_{B4} | 1118. | L_{A47} | L_{B10} | 1832. | L_{A47} | L_{B16} |
| 405. | L_{A48} | L_{B4} | 1119. | L_{A48} | L_{B10} | 1833. | L_{A48} | L_{B16} |
| 406. | L_{A49} | L_{B4} | 1120. | L_{A49} | L_{B10} | 1834. | L_{A49} | L_{B16} |
| 407. | L_{A50} | L_{B4} | 1121. | L_{A50} | L_{B10} | 1835. | L_{A50} | L_{B16} |
| 408. | L_{A51} | L_{B4} | 1122. | L_{A51} | L_{B10} | 1836. | L_{A51} | L_{B16}. |
| 409. | L_{A52} | L_{B4} | 1123. | L_{A52} | L_{B10} | 1837. | L_{A52} | L_{B16} |
| 410. | L_{A53} | L_{B4} | 1124. | L_{A53} | L_{B10} | 1838. | L_{A53} | L_{B16} |
| 411. | L_{A54} | L_{B4} | 1125. | L_{A54} | L_{B10} | 1839. | L_{A54} | L_{B16} |
| 412. | L_{A55} | L_{B4} | 1126. | L_{A55} | L_{B10} | 1840. | L_{A55} | L_{B16} |
| 413. | L_{A56} | L_{B4} | 1127. | L_{A56} | L_{B10} | 1841. | L_{A56} | L_{B16} |
| 414. | L_{A57} | L_{B4} | 1128. | L_{A57} | L_{B10} | 1842. | L_{A57} | L_{B16} |
| 415. | L_{A58} | L_{B4} | 1129. | L_{A58} | L_{B10} | 1843. | L_{A58} | L_{B16} |
| 416. | L_{A59} | L_{B4} | 1130. | L_{A59} | L_{B10} | 1844. | L_{A59} | L_{B16} |
| 417. | L_{A60} | L_{B4} | 1131. | L_{A60} | L_{B10} | 1845. | L_{A60} | L_{B16} |
| 418. | L_{A61} | L_{B4} | 1132. | L_{A61} | L_{B10} | 1846. | L_{A61} | L_{B16} |
| 419. | L_{A62} | L_{B4} | 1133. | L_{A62} | L_{B10} | 1847. | L_{A62} | L_{B16} |
| 420. | L_{A63} | L_{B4} | 1134. | L_{A63} | L_{B10} | 1848. | L_{A63} | L_{B16} |
| 421. | L_{A64} | L_{B4} | 1135. | L_{A64} | L_{B10} | 1849. | L_{A64} | L_{B16} |
| 422. | L_{A65} | L_{B4} | 1136. | L_{A65} | L_{B10} | 1850. | L_{A65} | L_{B16} |
| 423. | L_{A66} | L_{B4} | 1137. | L_{A66} | L_{B10} | 1851. | L_{A66} | L_{B16} |
| 424. | L_{A67} | L_{B4} | 1138. | L_{A67} | L_{B10} | 1852. | L_{A67} | L_{B16} |
| 425. | L_{A68} | L_{B4} | 1139. | L_{A68} | L_{B10} | 1853. | L_{A68} | L_{B16} |
| 426. | L_{A69} | L_{B4} | 1140. | L_{A69} | L_{B10} | 1854. | L_{A69} | L_{B16} |
| 427. | L_{A70} | L_{B4} | 1141. | L_{A70} | L_{B10} | 1855. | L_{A70} | L_{B16} |
| 428. | L_{A71} | L_{B4} | 1142. | L_{A71} | L_{B10} | 1856. | L_{A71} | L_{B16} |
| 429. | L_{A72} | L_{B4} | 1143. | L_{A72} | L_{B10} | 1857. | L_{A72} | L_{B16} |
| 430. | L_{A73} | L_{B4} | 1144. | L_{A73} | L_{B10} | 1858. | L_{A73} | L_{B16} |
| 431. | L_{A74} | L_{B4} | 1145. | L_{A74} | L_{B10} | 1859. | L_{A74} | L_{B16} |
| 432. | L_{A75} | L_{B4} | 1146. | L_{A75} | L_{B10} | 1860. | L_{A75} | L_{B16} |
| 433. | L_{A76} | L_{B4} | 1147. | L_{A76} | L_{B10} | 1861. | L_{A76} | L_{B16} |
| 434. | L_{A77} | L_{B4} | 1148. | L_{A77} | L_{B10} | 1862. | L_{A77} | L_{B16} |
| 435. | L_{A78} | L_{B3} | 1149. | L_{A78} | L_{B10} | 1863. | L_{A78} | L_{B16} |
| 436. | L_{A79} | L_{B4} | 1150. | L_{A79} | L_{B10} | 1864. | L_{A79} | L_{B16} |
| 437. | L_{A80} | L_{B4} | 1151. | L_{A80} | L_{B10} | 1865. | L_{A80} | L_{B16} |
| 438. | L_{A81} | L_{B4} | 1152. | L_{A81} | L_{B10} | 1866. | L_{A81} | L_{B16} |
| 439. | L_{A82} | L_{B4} | 1153. | L_{A82} | L_{B10} | 1867. | L_{A82} | L_{B16} |
| 440. | L_{A83} | L_{B4} | 1154. | L_{A83} | L_{B10} | 1868. | L_{A83} | L_{B16} |
| 441. | L_{A84} | L_{B4} | 1155. | L_{A84} | L_{B10} | 1869. | L_{A84} | L_{B16} |
| 442. | L_{A85} | L_{B4} | 1156. | L_{A85} | L_{B10} | 1870. | L_{A85} | L_{B16} |
| 443. | L_{A86} | L_{B4} | 1157. | L_{A86} | L_{B10} | 1871. | L_{A86} | L_{B16} |
| 444. | L_{A87} | L_{B4} | 1158. | L_{A87} | L_{B10} | 1872. | L_{A87} | L_{B16} |
| 445. | L_{A88} | L_{B4} | 1159. | L_{A88} | L_{B10} | 1873. | L_{A88} | L_{B16} |
| 446. | L_{A89} | L_{B4} | 1160. | L_{A89} | L_{B10} | 1874. | L_{A89} | L_{B16} |
| 447. | L_{A90} | L_{B4} | 1161. | L_{A90} | L_{B10} | 1875. | L_{A90} | L_{B16} |
| 448. | L_{A91} | L_{B4} | 1162. | L_{A91} | L_{B10} | 1876. | L_{A91} | L_{B16} |
| 449. | L_{A92} | L_{B4} | 1163. | L_{A92} | L_{B10} | 1877. | L_{A92} | L_{B16} |
| 450. | L_{A93} | L_{B4} | 1164. | L_{A93} | L_{B10} | 1878. | L_{A93} | L_{B16} |
| 451. | L_{A94} | L_{B4} | 1165. | L_{A94} | L_{B10} | 1879. | L_{A94} | L_{B16} |
| 452. | L_{A95} | L_{B4} | 1166. | L_{A95} | L_{B10} | 1880. | L_{A95} | L_{B16} |
| 453. | L_{A96} | L_{B4} | 1167. | L_{A96} | L_{B10} | 1881. | L_{A96} | L_{B16} |
| 454. | L_{A97} | L_{B4} | 1168. | L_{A97} | L_{B10} | 1882. | L_{A97} | L_{B16} |
| 455. | L_{A98} | L_{B4} | 1169. | L_{A98} | L_{B10} | 1883. | L_{A98} | L_{B16} |
| 456. | L_{A99} | L_{B4} | 1170. | L_{A99} | L_{B10} | 1884. | L_{A99} | L_{B16} |
| 457. | L_{A100} | L_{B4} | 1171. | L_{A100} | L_{B10} | 1885. | L_{A100} | L_{B16} |
| 458. | L_{A101} | L_{B4} | 1172. | L_{A101} | L_{B10} | 1886. | L_{A101} | L_{B16} |
| 459. | L_{A102} | L_{B4} | 1173. | L_{A102} | L_{B10} | 1887. | L_{A102} | L_{B16} |
| 460. | L_{A103} | L_{B4} | 1174. | L_{A103} | L_{B10} | 1888. | L_{A103} | L_{B16} |
| 461. | L_{A104} | L_{B4} | 1175. | L_{A104} | L_{B10} | 1889. | L_{A104} | L_{B16} |
| 462. | L_{A105} | L_{B4} | 1176. | L_{A105} | L_{B10} | 1890. | L_{A105} | L_{B16} |
| 463. | L_{A106} | L_{B4} | 1177. | L_{A106} | L_{B10} | 1891. | L_{A106} | L_{B16} |
| 464. | L_{A107} | L_{B4} | 1178. | L_{A107} | L_{B10} | 1892. | L_{A107} | L_{B16} |
| 465. | L_{A108} | L_{B4} | 1179. | L_{A108} | L_{B10} | 1893. | L_{A108} | L_{B16} |
| 466. | L_{A109} | L_{B4} | 1180. | L_{A109} | L_{B10} | 1894. | L_{A109} | L_{B16} |
| 467. | L_{A110} | L_{B4} | 1181. | L_{A110} | L_{B10} | 1895. | L_{A110} | L_{B16} |
| 468. | L_{A111} | L_{B4} | 1182. | L_{A111} | L_{B10} | 1896. | L_{A111} | L_{B16} |
| 469. | L_{A112} | L_{B4} | 1183. | L_{A112} | L_{B10} | 1897. | L_{A112} | L_{B16} |
| 470. | L_{A113} | L_{B4} | 1184. | L_{A113} | L_{B10} | 1898. | L_{A113} | L_{B16} |
| 471. | L_{A114} | L_{B4} | 1185. | L_{A114} | L_{B10} | 1899. | L_{A114} | L_{B16} |
| 472. | L_{A115} | L_{B4} | 1186. | L_{A115} | L_{B10} | 1900. | L_{A115} | L_{B16} |
| 473. | L_{A116} | L_{B4} | 1187. | L_{A116} | L_{B10} | 1901. | L_{A116} | L_{B16} |
| 474. | L_{A117} | L_{B4} | 1188. | L_{A117} | L_{B10} | 1902. | L_{A117} | L_{B16} |
| 475. | L_{A118} | L_{B4} | 1189. | L_{A118} | L_{B10} | 1903. | L_{A118} | L_{B16} |
| 476. | L_{A119} | L_{B4} | 1190. | L_{A119} | L_{B10} | 1904. | L_{A119} | L_{B16} |
| 477. | L_{A1} | L_{B5} | 1191. | L_{A1} | L_{B11} | 1905. | L_{A1} | L_{B17} |
| 478. | L_{A2} | L_{B5} | 1192. | L_{A2} | L_{B11} | 1906. | L_{A2} | L_{B17} |
| 479. | L_{A3} | L_{B5} | 1193. | L_{A3} | L_{B11} | 1907. | L_{A3} | L_{B17} |
| 480. | L_{A4} | L_{B5} | 1194. | L_{A4} | L_{B11} | 1908. | L_{A4} | L_{B17} |
| 481. | L_{A5} | L_{B5} | 1195. | L_{A5} | L_{B11} | 1909. | L_{A5} | L_{B17} |
| 482. | L_{A6} | L_{B5} | 1196. | L_{A6} | L_{B11} | 1910. | L_{A6} | L_{B17} |
| 483. | L_{A7} | L_{B5} | 1197. | L_{A7} | L_{B11} | 1911. | L_{A7} | L_{B17} |
| 484. | L_{A8} | L_{B5} | 1198. | L_{A8} | L_{B11} | 1912. | L_{A8} | L_{B17} |
| 485. | L_{A9} | L_{B5} | 1199. | L_{A9} | L_{B11} | 1913. | L_{A9} | L_{B17} |
| 486. | L_{A10} | L_{B5} | 1200. | L_{A10} | L_{B11} | 1914. | L_{A10} | L_{B17} |
| 487. | L_{A11} | L_{B5} | 1201. | L_{A11} | L_{B11} | 1915. | L_{A11} | L_{B17} |
| 488. | L_{A12} | L_{B5} | 1202. | L_{A12} | L_{B11} | 1916. | L_{A12} | L_{B17} |
| 489. | L_{A13} | L_{B5} | 1203. | L_{A13} | L_{B11} | 1917. | L_{A13} | L_{B17} |
| 490. | L_{A14} | L_{B5} | 1204. | L_{A14} | L_{B11} | 1918. | L_{A14} | L_{B17} |
| 491. | L_{A15} | L_{B5} | 1205. | L_{A15} | L_{B11} | 1919. | L_{A15} | L_{B17} |
| 492. | L_{A16} | L_{B5} | 1206. | L_{A16} | L_{B11} | 1920. | L_{A16} | L_{B17} |
| 493. | L_{A17} | L_{B5} | 1207. | L_{A17} | L_{B11} | 1921. | L_{A17} | L_{B17} |
| 494. | L_{A18} | L_{B5} | 1208. | L_{A18} | L_{B11} | 1922. | L_{A18} | L_{B17} |
| 495. | L_{A19} | L_{B5} | 1209. | L_{A19} | L_{B11} | 1923, | L_{A19} | L_{B17} |
| 496. | L_{A10} | L_{B5} | 1210. | L_{A10} | L_{B11} | 1924. | L_{A10} | L_{B17} |
| 497. | L_{A21} | L_{B5} | 1211. | L_{A21} | L_{B11} | 1925. | L_{A21} | L_{B17} |
| 498. | L_{A22} | L_{B5} | 1212. | L_{A22} | L_{B11} | 1926. | L_{A22} | L_{B17} |
| 499. | L_{A23} | L_{B5} | 1213. | L_{A23} | L_{B11} | 1927. | L_{A23} | L_{B17} |
| 500. | L_{A24} | L_{B5} | 1214. | L_{A24} | L_{B11} | 1928. | L_{A24} | L_{B17} |
| 501. | L_{A25} | L_{B5} | 1215. | L_{A25} | L_{B11} | 1929. | L_{A25} | L_{B17} |
| 502. | L_{A26} | L_{B5} | 1216. | L_{A26} | L_{B11} | 1930. | L_{A26} | L_{B17} |
| 503. | L_{A27} | L_{B5} | 1217. | L_{A27} | L_{B11} | 1931. | L_{A27} | L_{B17} |
| 504. | L_{A28} | L_{B5} | 1218. | L_{A28} | L_{B11} | 1932. | L_{A28} | L_{B17} |
| 505. | L_{A29} | L_{B5} | 1219. | L_{A29} | L_{B11} | 1933. | L_{A29} | L_{B17} |
| 506. | L_{A30} | L_{B5} | 1220. | L_{A30} | L_{B11} | 1934. | L_{A30} | L_{B17} |
| 507. | L_{A31} | L_{B5} | 1221. | L_{A31} | L_{B11} | 1935. | L_{A31} | L_{B17} |
| 508. | L_{A32} | L_{B5} | 1222. | L_{A32} | L_{B11} | 1936. | L_{A32} | L_{B17} |
| 509. | L_{A33} | L_{B5} | 1223. | L_{A33} | L_{B11} | 1937. | L_{A33} | L_{B17} |
| 510. | L_{A34} | L_{B5} | 1224. | L_{A34} | L_{B11} | 1938. | L_{A34} | L_{B17} |
| 511. | L_{A35} | L_{B5} | 1225. | L_{A35} | L_{B11} | 1939. | L_{A35} | L_{B17} |
| 512. | L_{A36} | L_{B5} | 1226. | L_{A36} | L_{B11} | 1940. | L_{A36} | L_{B17} |
| 513. | L_{A37} | L_{B5} | 1227. | L_{A37} | L_{B11} | 1941. | L_{A37} | L_{B17} |
| 514. | L_{A38} | L_{B5} | 1228. | L_{A38} | L_{B11} | 1942. | L_{A38} | L_{B17} |
| 515. | L_{A39} | L_{B5} | 1229. | L_{A39} | L_{B11} | 1943. | L_{A39} | L_{B17} |
| 516. | L_{A40} | L_{B5} | 1230. | L_{A40} | L_{B11} | 1944. | L_{A40} | L_{B17} |
| 517. | L_{A41} | L_{B5} | 1231. | L_{A41} | L_{B11} | 1945. | L_{A41} | L_{B17} |
| 518. | L_{A42} | L_{B5} | 1232. | L_{A42} | L_{B11} | 1946. | L_{A42} | L_{B17} |
| 519. | L_{A43} | L_{B5} | 1233. | L_{A43} | L_{B11} | 1947. | L_{A43} | L_{B17} |
| 520. | L_{A44} | L_{B5} | 1234. | L_{A44} | L_{B11} | 1948. | L_{A44} | L_{B17} |
| 521. | L_{A45} | L_{B5} | 1235. | L_{A45} | L_{B11} | 1949. | L_{A45} | L_{B17} |
| 522. | L_{A46} | L_{B5} | 1236. | L_{A46} | L_{B11} | 1950. | L_{A46} | L_{B17} |
| 523. | L_{A47} | L_{B5} | 1237. | L_{A47} | L_{B11} | 1951. | L_{A47} | L_{B17} |
| 524. | L_{A48} | L_{B5} | 1238. | L_{A48} | L_{B11} | 1952. | L_{A48} | L_{B17} |
| 525. | L_{A49} | L_{B5} | 1239. | L_{A49} | L_{B11} | 1953. | L_{A49} | L_{B17} |
| 526. | L_{A50} | L_{B5} | 1240. | L_{A50} | L_{B11} | 1954. | L_{A50} | L_{B17} |
| 527. | L_{A51} | L_{B5} | 1241. | L_{A51} | L_{B11} | 1955. | L_{A51} | L_{B17} |
| 528. | L_{A52} | L_{B5} | 1242. | L_{A52} | L_{B11} | 1956. | L_{A52} | L_{B17} |
| 529. | L_{A53} | L_{B5} | 1243. | L_{A53} | L_{B11} | 1957. | L_{A53} | L_{B17} |
| 530. | L_{A54} | L_{B5} | 1244. | L_{A54} | L_{B11} | 1958. | L_{A54} | L_{B17} |
| 531. | L_{A55} | L_{B5} | 1245. | L_{A55} | L_{B11} | 1959. | L_{A55} | L_{B17} |
| 532. | L_{A56} | L_{B5} | 1246. | L_{A56} | L_{B11} | 1960. | L_{A56} | L_{B17} |
| 533. | L_{A57} | L_{B5} | 1247. | L_{A57} | L_{B11} | 1961. | L_{A57} | L_{B17} |
| 534. | L_{A58} | L_{B5} | 1248. | L_{A58} | L_{B11} | 1962. | L_{A58} | L_{B17} |
| 535. | L_{A59} | L_{B5} | 1249. | L_{A59} | L_{B11} | 1963. | L_{A59} | L_{B17} |
| 536. | L_{A60} | L_{B5} | 1250. | L_{A60} | L_{B11} | 1964. | L_{A60} | L₈₁₇ |
| 537. | L_{A61} | L_{B5} | 1251. | L_{A61} | L_{B11} | 1965. | L_{A61} | L_{B17} |
| 538. | L_{A62} | L_{B5} | 1252. | L_{A62} | L_{B11} | 1966. | L_{A62} | L_{B17} |
| 539. | L_{A63} | L_{B5} | 1253. | L_{A63} | L_{B11} | 1967. | L_{A63} | L_{B17} |
| 540. | L_{A64} | L_{B5} | 1254. | L_{A64} | L_{B11} | 1968. | L_{A64} | L_{B17} |
| 541. | L_{A65} | L_{B5} | 1255. | L_{A65} | L_{B11} | 1969. | L_{A65} | L_{B17} |
| 542. | L_{A66} | L_{B5} | 1256. | L_{A66} | L_{B11} | 1970. | L_{A66} | L_{B17} |
| 543. | L_{A67} | L_{B5} | 1257. | L_{A67} | L_{B11} | 1971. | L_{A67} | L_{B17} |
| 544. | L_{A68} | L_{B5} | 1258. | L_{A68} | L_{B11} | 1972. | L_{A68} | L_{B17} |
| 545. | L_{A69} | L_{B5} | 1259. | L_{A69} | L_{B11} | 1973. | L_{A69} | L_{B17} |
| 546. | L_{A70} | L_{B5} | 1260. | L_{A70} | L_{B11} | 1974. | L_{A70} | L_{B17} |
| 547. | L_{A71} | L_{B5} | 1261. | L_{A71} | L_{B11} | 1975. | L_{A71} | L_{B17} |
| 548. | L_{A72} | L_{B5} | 1262. | L_{A72} | L_{B11} | 1976. | L_{A72} | L_{B17} |
| 549. | L_{A73} | L_{B5} | 1263. | L_{A73} | L_{B11} | 1977. | L_{A73} | L_{B17} |
| 550. | L_{A74} | L_{B5} | 1264. | L_{A74} | L_{B11} | 1978. | L_{A74} | L_{B17} |
| 551. | L_{A75} | L_{B5} | 1265. | L_{A75} | L_{B11} | 1979. | L_{A75} | L_{B17} |
| 552. | L_{A76} | L_{B5} | 1266. | L_{A76} | L_{B11} | 1980. | L_{A76} | L_{B17} |
| 553. | L_{A77} | L_{B5} | 1267. | L_{A77} | L_{B11} | 1981. | L_{A77} | L_{B17} |
| 554. | L_{A78} | L_{B5} | 1268. | L_{A78} | L_{B11} | 1982. | L_{A78} | L_{B17} |
| 555. | L_{A79} | L_{B5} | 1269. | L_{A79} | L_{B11} | 1983. | L_{A79} | L_{B17} |
| 556. | L_{A80} | L_{B5} | 1270. | L_{A80} | L_{B11} | 1984. | L_{A80} | L_{B17} |
| 557. | L_{A81} | L_{B5} | 1271. | L_{A81} | L_{B11} | 1985. | L_{A81} | L_{B17} |
| 558. | L_{A82} | L_{B5} | 1272. | L_{A82} | L_{B11} | 1986. | L_{A82} | L_{B17} |
| 559. | L_{A83} | L_{B5} | 1273. | L_{A83} | L_{B11} | 1987. | L_{A83} | L_{B17} |
| 560. | L_{A84} | L_{B5} | 1274. | L_{A84} | L_{B11} | 1988. | L_{A84} | L_{B17} |
| 561. | L_{A85} | L_{B5} | 1275. | L_{A85} | L_{B11} | 1989. | L_{A85} | L_{B17} |
| 562. | L_{A86} | L_{B5} | 1276. | L_{A86} | L_{B11} | 1990. | L_{A86} | L_{B17} |
| 563. | L_{A87} | L_{B5} | 1277. | L_{A87} | L_{B11} | 1991. | L_{A87} | L_{B17} |
| 564. | L_{A88} | L_{B5} | 1278. | L_{A88} | L_{B11} | 1992. | L_{A88} | L_{B17} |
| 565. | L_{A89} | L_{B5} | 1279. | L_{A89} | L_{B11} | 1993. | L_{A89} | L_{B17} |
| 566. | L_{A90} | L_{B5} | 1280. | L_{A90} | L_{B11} | 1994. | L_{A90} | L_{B17} |
| 567. | L_{A91} | L_{B5} | 1281. | L_{A91} | L_{B11} | 1995. | L_{A91} | L_{B17} |
| 568. | L_{A92} | L_{B5} | 1282. | L_{A92} | L_{B11} | 1996. | L_{A92} | L_{B17} |
| 569. | L_{A93} | L_{B5} | 1283. | L_{A93} | L_{B11} | 1997. | L_{A93} | L_{B17} |
| 570. | L_{A94} | L_{B5} | 1284. | L_{A94} | L_{B11} | 1998. | L_{A94} | L_{B17} |
| 571. | L_{A95} | L_{B5} | 1285. | L_{A95} | L_{B11} | 1999. | L_{A95} | L_{B17} |
| 572. | L_{A96} | L_{B5} | 1286. | L_{A96} | L_{B11} | 2000. | L_{A96} | L_{B17} |
| 573. | L_{A97} | L_{B5} | 1287. | L_{A97} | L_{B11} | 2001. | L_{A97} | L_{B17} |
| 574. | L_{A98} | L_{B5} | 1288. | L_{A98} | L_{B11} | 2002. | L_{A98} | L_{B17} |
| 575. | L_{A99} | L_{B5} | 1289. | L_{A99} | L_{B11} | 2003. | L_{A99} | L_{B17} |
| 576. | L_{A100} | L_{B5} | 1290. | L_{A100} | L_{B11} | 2004. | L_{A100} | L_{B17} |
| 577. | L_{A101} | L_{B5} | 1291. | L_{A101} | L_{B11} | 2005. | L_{A101} | L_{B17} |
| 578. | L_{A102} | L_{B5} | 1292. | L_{A102} | L_{B11} | 2006. | L_{A102} | L_{B17} |
| 579. | L_{A103} | L_{B5} | 1293. | L_{A103} | L_{B11} | 2007. | L_{A103} | L_{B17} |
| 580. | L_{A104} | L_{B5} | 1294. | L_{A104} | L_{B11} | 2008. | L_{A104} | L_{B17} |
| 581. | L_{A105} | L_{B5} | 1295. | L_{A105} | L_{B11} | 2009. | L_{A105} | L_{B17} |
| 582. | L_{A106} | L_{B5} | 1296. | L_{A106} | L_{B11} | 2010. | L_{A106} | L_{B17} |
| 583. | L_{A107} | L_{B5} | 1297. | L_{A107} | L_{B11} | 2011. | L_{A107} | L_{B17} |
| 584. | L_{A108} | L_{B5} | 1298. | L_{A108} | L_{B11} | 2012. | L_{A108} | L_{B17} |
| 585. | L_{A109} | L_{B5} | 1299. | L_{A109} | L_{B11} | 2013. | L_{A109} | L_{B17} |
| 586. | L_{A110} | L_{B5} | 1300. | L_{A110} | L_{B11} | 2014. | L_{A110} | L_{B17} |
| 587. | L_{A111} | L_{B5} | 1301. | L_{A111} | L_{B11} | 2015. | L_{A111} | L_{B17} |
| 588. | L_{A112} | L_{B5} | 1302. | L_{A112} | L_{B11} | 2016. | L_{A112} | L_{B17} |
| 589. | L_{A113} | L_{B5} | 1303. | L_{A113} | L_{B11} | 2017. | L_{A113} | L_{B17} |
| 590. | L_{A114} | L_{B5} | 1304. | L_{A114} | L_{B11} | 2018. | L_{A114} | L_{B17} |
| 591. | L_{A115} | L_{B5} | 1305. | L_{A115} | L_{B11} | 2019. | L_{A115} | L_{B17} |
| 592. | L_{A116} | L_{B5} | 1306. | L_{A116} | L_{B11} | 2020. | L_{A116} | L_{B17} |
| 593. | L_{A117} | L_{B5} | 1307. | L_{A117} | L_{B11} | 2021. | L_{A117} | L_{B17} |
| 594. | L_{A118} | L_{B5} | 1308. | L_{A118} | L_{B11} | 2022. | L_{A118} | L_{B17} |
| 595. | L_{A119} | L_{B5} | 1309. | L_{A119} | L_{B11} | 2023. | L_{A119} | L_{B17} |
| 596. | L_{A1} | L_{B6} | 1310. | L_{A1} | L_{B12} | 2024. | L_{A1} | L_{B18} |
| 597. | L_{A2} | L_{B6} | 1311. | L_{A2} | L_{B12} | 2025. | L_{A2} | L_{B18} |
| 598. | L_{A3} | L_{B6} | 1312. | L_{A3} | L_{B12} | 2026. | L_{A3} | L_{B18} |
| 599. | L_{A4} | L_{B6} | 1313. | L_{A4} | L_{B12} | 2027. | L_{A4} | L_{B18} |
| 600. | L_{A5} | L_{B6} | 1314. | L_{A5} | L_{B12} | 2028. | L_{A5} | L_{B18} |
| 601. | L_{A6} | L_{B6} | 1315. | L_{A6} | L_{B12} | 2029. | L_{A6} | L_{B18} |
| 602. | L_{A7} | L_{B6} | 1316. | L_{A7} | L_{B12} | 2030. | L_{A7} | L_{B18} |
| 603. | L_{A8} | L_{B6} | 1317. | L_{A8} | L_{B12} | 2031. | L_{A8} | L_{B18} |
| 604. | L_{A9} | L_{B6} | 1318. | L_{A9} | L_{B12} | 2032. | L_{A9} | L_{B18} |
| 605. | L_{A10} | L_{B6} | 1319. | L_{A10} | L_{B12} | 2033. | L_{A10} | L_{B18} |
| 606. | L_{A11} | L_{B6} | 1320. | L_{A11} | L_{B12} | 2034. | L_{A11} | L_{B18} |
| 607. | L_{A12} | L_{B6} | 1321. | L_{A12} | L_{B12} | 2035. | L_{A12} | L_{B18} |
| 608. | L_{A13} | L_{B6} | 1322. | L_{A13} | L_{B12} | 2036. | L_{A13} | L_{B18} |
| 609. | L_{A14} | L_{B6} | 1323. | L_{A14} | L_{B12} | 2037. | L_{A14} | L_{B18} |
| 610. | L_{A15} | L_{B6} | 1324. | L_{A15} | L_{B12} | 2038. | L_{A15} | L_{B18} |
| 611. | L_{A16} | L_{B6} | 1325. | L_{A16} | L_{B12} | 2039. | L_{A16} | L_{B18} |
| 612. | L_{A17} | L_{B6} | 1326. | L_{A17} | L_{B12} | 2040. | L_{A17} | L_{B18} |
| 613. | L_{A18} | L_{B6} | 1327. | L_{A18} | L_{B12} | 2041. | L_{A18} | L_{B18} |
| 614. | L_{A19} | L_{B6} | 1328. | L_{A19} | L_{B12} | 2042. | L_{A19} | L_{B18} |
| 615. | L_{A10} | L_{B6} | 1329. | L_{A10} | L_{B12} | 2043. | L_{A10} | L_{B18} |
| 616. | L_{A21} | L_{B6} | 1330. | L_{A21} | L_{B12} | 2044. | L_{A21} | L_{B18} |
| 617. | L_{A22} | L_{B6} | 1331. | L_{A22} | L_{B12} | 2045. | L_{A22} | L_{B18} |
| 618. | L_{A23} | L_{B6} | 1332. | L_{A23} | L_{B12} | 2046. | L_{A23} | L_{B18} |
| 619. | L_{A24} | L_{B6} | 1333. | L_{A24} | L_{B12} | 2047. | L_{A24} | L_{B18} |
| 620. | L_{A25} | L_{B6} | 1334. | L_{A25} | L_{B12} | 2048. | L_{A25} | L_{B18} |
| 621. | L_{A26} | L_{B6} | 1335. | L_{A26} | L_{B12} | 2049. | L_{A26} | L_{B18} |
| 622. | L_{A27} | L_{B6} | 1336. | L_{A27} | L_{B12} | 2050. | L_{A27} | L_{B18} |
| 623. | L_{A28} | L_{B6} | 1337. | L_{A28} | L_{B12} | 2051. | L_{A28} | L_{B18} |
| 624. | L_{A29} | L_{B6} | 1338. | L_{A29} | L_{B12} | 2052. | L_{A29} | L_{B18} |
| 625. | L_{A30} | L_{B6} | 1339. | L_{A30} | L_{B12} | 2053. | L_{A30} | L_{B18} |
| 626. | L_{A31} | L_{B6} | 1340. | L_{A31} | L_{B12} | 2054. | L_{A31} | L_{B18} |
| 627. | L_{A32} | L_{B6} | 1341. | L_{A32} | L_{B12} | 2055. | L_{A32} | L_{B18} |
| 628. | L_{A33} | L_{B6} | 1342. | L_{A33} | L_{B12} | 2056. | L_{A33} | L_{B18} |
| 629. | L_{A34} | L_{B6} | 1343. | L_{A34} | L_{B12} | 2057. | L_{A34} | L_{B18} |
| 630. | L_{A35} | L_{B6} | 1344. | L_{A35} | L_{B12} | 2058. | L_{A35} | L_{B18} |
| 631. | L_{A36} | L_{B6} | 1345. | L_{A36} | L_{B12} | 2059. | L_{A36} | L_{B18} |
| 632. | L_{A37} | L_{B6} | 1346. | L_{A37} | L_{B12} | 2060. | L_{A37} | L_{B18} |
| 633. | L_{A38} | L_{B6} | 1347. | L_{A38} | L_{B12} | 2061. | L_{A38} | L_{B18} |
| 634. | L_{A39} | L_{B6} | 1348. | L_{A39} | L_{B12} | 2062. | L_{A39} | L_{B18} |
| 635. | L_{A40} | L_{B6} | 1349. | L_{A40} | L_{B12} | 2063. | L_{A40} | L_{B18} |
| 636. | L_{A41} | L_{B6} | 1350. | L_{A41} | L_{B12} | 2064. | L_{A41} | L_{B18} |
| 637. | L_{A42} | L_{B6} | 1351. | L_{A42} | L_{B12} | 2065. | L_{A42} | L_{B18} |
| 638. | L_{A43} | L_{B6} | 1352. | L_{A43} | L_{B12} | 2066. | L_{A43} | L_{B18} |
| 639. | L_{A44} | L_{B6} | 1353. | L_{A44} | L_{B12} | 2067. | L_{A44} | L_{B18} |
| 640. | L_{A45} | L_{B6} | 1354. | L_{A45} | L_{B12} | 2068. | L_{A45} | L_{B18} |
| 641. | L_{A46} | L_{B6} | 1355. | L_{A46} | L_{B12} | 2069. | L_{A46} | L_{B18} |
| 642. | L_{A47} | L_{B6} | 1356. | L_{A47} | L_{B12} | 2070. | L_{A47} | L_{B18} |
| 643. | L_{A48} | L_{B6} | 1357. | L_{A48} | L_{B12} | 2071. | L_{A48} | L_{B18} |
| 644. | L_{A49} | L_{B6} | 1358. | L_{A49} | L_{B12} | 2072. | L_{A49} | L_{B18} |
| 645. | L_{A50} | L_{B6} | 1359. | L_{A50} | L_{B12} | 2073. | L_{A50} | L_{B18} |
| 646. | L_{A51} | L_{B6} | 1360. | L_{A51} | L_{B12} | 2074. | L_{A51} | L_{B18} |
| 647. | L_{A52} | L_{B6} | 1361. | L_{A52} | L_{B12} | 2075. | L_{A52} | L_{B18} |
| 648. | L_{A53} | L_{B6} | 1362. | L_{A53} | L_{B12} | 2076. | L_{A53} | L_{B18} |
| 649. | L_{A54} | L_{B6} | 1363. | L₄₅₄ | L_{B12} | 2077. | L_{A54} | L_{B18} |
| 650. | L_{A55} | L_{B6} | 1364. | L_{A55} | L_{B12} | 2078. | L_{A55} | L_{B18} |
| 651. | L_{A56} | L_{B6} | 1365. | L_{A56} | L_{B12} | 2079. | L_{A56} | L_{B18} |
| 652. | L_{A57} | L_{B6} | 1366. | L_{A57} | L_{B12} | 2080. | L_{A57} | L_{B18} |
| 653. | L_{A58} | L_{B6} | 1367. | L_{A58} | L_{B12} | 2081. | L_{A58} | L_{B18} |
| 654. | L_{A59} | L_{B6} | 1368. | L_{A59} | L_{B12} | 2082. | L_{A59} | L_{B18} |
| 655. | L_{A60} | L_{B6} | 1369. | L_{A60} | L_{B12} | 2083. | L_{A60} | L_{B18} |
| 656. | L_{A61} | L_{B6} | 1370. | L_{A61} | L_{B12} | 2084. | L_{A61} | L_{B18} |
| 657. | L_{A62} | L_{B6} | 1371. | L_{A62} | L_{B12} | 2085. | L_{A62} | L_{B18} |
| 658. | L_{A63} | L_{B6} | 1372. | L_{A63} | L_{B12} | 2086. | L_{A63} | L_{B18} |
| 659. | L_{A64} | L_{B6} | 1373. | L_{A64} | L_{B12} | 2087. | L_{A64} | L_{B18} |
| 660. | L_{A65} | L_{B6} | 1374. | L_{A65} | L_{B12} | 2088. | L_{A65} | L_{B18} |
| 661. | L_{A66} | L_{B6} | 1375. | L_{A66} | L_{B12} | 2089. | L_{A66} | L_{B18} |
| 662. | L_{A67} | L_{B6} | 1376. | L_{A67} | L_{B12} | 2090. | L_{A67} | L_{B18} |
| 663. | L_{A68} | L_{B6} | 1377. | L_{A68} | L_{B12} | 2091. | L_{A68} | L_{B18} |
| 664. | L_{A69} | L_{B6} | 1378. | L_{A69} | L_{B12} | 2092. | L_{A69} | L_{B18} |
| 665. | L_{A70} | L_{B6} | 1379. | L_{A70} | L_{B12} | 2093. | L_{A70} | L_{B18} |
| 666. | L_{A71} | L_{B6} | 1380. | L_{A71} | L_{B12} | 2094. | L_{A71} | L_{B18} |
| 667. | L_{A72} | L_{B6} | 1381. | L_{A72} | L_{B12} | 2095. | L_{A72} | L_{B18} |
| 668. | L_{A73} | L_{B6} | 1382. | L_{A73} | L_{B12} | 2096. | L_{A73} | L_{B18} |
| 669. | L_{A74} | L_{B6} | 1383. | L_{A74} | L_{B12} | 2097. | L_{A74} | L_{B18} |
| 670. | L_{A75} | L_{B6} | 1384. | L_{A75} | L_{B12} | 2098. | L_{A75} | L_{B18} |
| 671. | L_{A76} | L_{B6} | 1385. | L_{A76} | L_{B12} | 2099. | L_{A76} | L_{B18} |
| 672. | L_{A77} | L_{B6} | 1386. | L_{A77} | L_{B12} | 2100. | L_{A77} | L_{B18} |
| 673. | L_{A78} | L_{B6} | 1387. | L_{A78} | L_{B12} | 2101. | L_{A78} | L_{B18} |
| 674. | L_{A79} | L_{B6} | 1388. | L_{A79} | L_{B12} | 2102. | L_{A79} | L_{B18} |
| 675. | L_{A80} | L_{B6} | 1389. | L_{A80} | L_{B12} | 2103. | L_{A80} | L_{B18} |
| 676. | L_{A81} | L_{B6} | 1390. | L_{A81} | L_{B12} | 2104. | L_{A81} | L_{B18} |
| 677. | L_{A82} | L_{B6} | 1391. | L_{A82} | L_{B12} | 2105. | L_{A82} | L_{B18} |
| 678. | L_{A83} | L_{B6} | 1392. | L_{A83} | L_{B12} | 2106. | L_{A83} | L_{B18} |
| 679. | L_{A84} | L_{B6} | 1393. | L_{A84} | L_{B12} | 2107. | L_{A84} | L_{B18} |
| 680. | L_{A85} | L_{B6} | 1394. | L_{A85} | L_{B12} | 2108. | L_{A85} | L_{B18} |
| 681. | L_{A86} | L_{B6} | 1395. | L_{A86} | L_{B12} | 2109. | L_{A86} | L_{B18} |
| 682. | L_{A87} | L_{B6} | 1396. | L_{A87} | L_{B12} | 2110. | L_{A87} | L_{B18} |
| 683. | L_{A88} | L_{B6} | 1397. | L_{A88} | L_{B12} | 2111. | L_{A88} | L_{B18} |
| 684. | L_{A89} | L_{B6} | 1398. | L_{A89} | L_{B12} | 2112. | L_{A89} | L_{B18} |
| 685. | L_{A90} | L_{B6} | 1399. | L_{A90} | L_{B12} | 2113. | L_{A90} | L_{B18} |
| 686. | L_{A91} | L_{B6} | 1400. | L_{A91} | L_{B12} | 2114. | L_{A91} | L_{B18} |
| 687. | L_{A92} | L_{B6} | 1401. | L_{A92} | L_{B12} | 2115. | L_{A92} | L_{B18} |
| 688. | L_{A93} | L_{B6} | 1402. | L_{A93} | L_{B12} | 2116. | L_{A93} | L_{B18} |
| 689. | L_{A94} | L_{B6} | 1403. | L_{A94} | L_{B12} | 2117. | L_{A94} | L_{B18} |
| 690. | L_{A95} | L_{B6} | 1404. | L_{A95} | L_{B12} | 2118. | L_{A95} | L_{B18} |
| 691. | L_{A96} | L_{B6} | 1405. | L_{A96} | L_{B12} | 2119. | L_{A96} | L_{B18} |
| 692. | L_{A97} | L_{B6} | 1406. | L_{A97} | L_{B12} | 2120. | L_{A97} | L_{B18} |
| 693. | L_{A98} | L_{B6} | 1407. | L_{A98} | L_{B12} | 2121. | L_{A98} | L_{B18} |
| 694. | L_{A99} | L_{B6} | 1408. | L_{A99} | L_{B12} | 2122. | L_{A99} | L_{B18} |
| 695. | L_{A100} | L_{B6} | 1409. | L_{A100} | L_{B12} | 2123. | L_{A100} | L_{B18} |
| 696. | L_{A101} | L_{B6} | 1410. | L_{A101} | L_{B12} | 2124. | L_{A101} | L_{B18} |
| 697. | L_{A102} | L_{B6} | 1411. | L_{A102} | L_{B12} | 2125. | L_{A102} | L_{B18} |
| 698. | L_{A103} | L_{B6} | 1412. | L_{A103} | L_{B12} | 2126. | L_{A103} | L₈₁₈ |
| 699. | L_{A104} | L_{B6} | 1413. | L_{A104} | L_{B12} | 2127. | L_{A104} | L_{B18} |
| 700. | L_{A105} | L_{B6} | 1414. | L_{A105} | L_{B12} | 2128. | L_{A105} | L_{B18} |
| 701. | L_{A106} | L_{B6} | 1415. | L_{A106} | L_{B12} | 2129. | L_{A106} | L_{B18} |
| 702. | L_{A107} | L_{B6} | 1416. | L_{A107} | L_{B12} | 2130. | L_{A107} | L_{B18} |
| 703. | L_{A108} | L_{B6} | 1417. | L_{A108} | L_{B12} | 2131. | L_{A108} | L_{B18} |
| 704. | L_{A109} | L_{B6} | 1418. | L_{A109} | L_{B12} | 2132. | L_{A109} | L_{B18} |
| 705. | L_{A110} | L_{B6} | 1419. | L_{A110} | L_{B12} | 2133. | L_{A110} | L_{B18} |
| 706. | L_{A111} | L_{B6} | 1420. | L_{A111} | L_{B12} | 2134. | L_{A111} | L_{B18} |
| 707. | L_{A112} | L_{B6} | 1421. | L_{A112} | L_{B12} | 2135. | L_{A112} | L_{B18} |
| 708. | L_{A113} | L_{B6} | 1422. | L_{A113} | L_{B12} | 2136. | L_{A113} | L_{B18} |
| 709. | L_{A114} | L_{B6} | 1423. | L_{A114} | L_{B12} | 2137. | L_{A114} | L_{B18} |
| 710. | L_{A115} | L_{B6} | 1424. | L_{A115} | L_{B12} | 2138. | L_{A115} | L_{B18} |
| 711. | L_{A116} | L_{B6} | 1425. | L_{A116} | L_{B12} | 2139. | L_{A116} | L_{B18} |
| 712. | L_{A117} | L_{B6} | 1426. | L_{A117} | L_{B12} | 2140. | L_{A117} | L_{B18} |
| 713. | L_{A118} | L_{B6} | 1427. | L_{A118} | L_{B12} | 2141. | L_{A118} | L_{B18} |
| 714. | L_{A119} | L_{B6} | 1428. | L_{A119} | L_{B12} | 2142. | L_{A119} | L_{B18} |

In one embodiment, the compound is selected from the group consisting of:

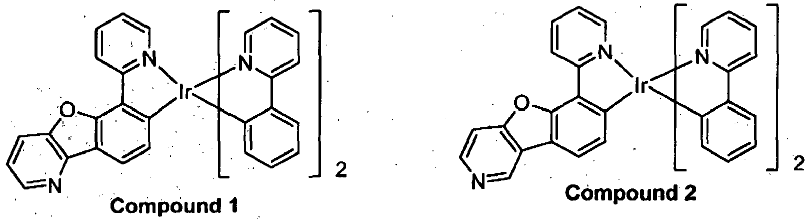

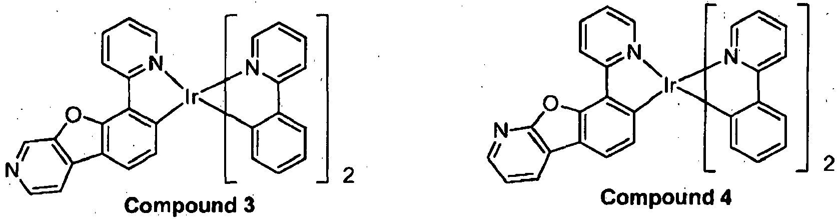

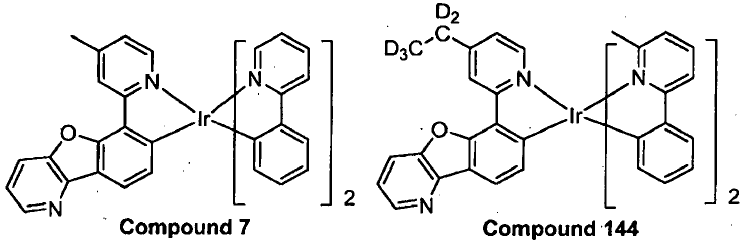

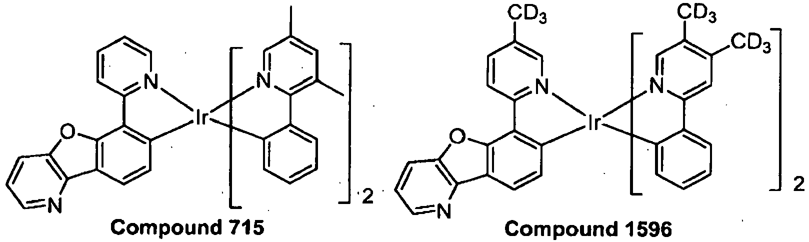

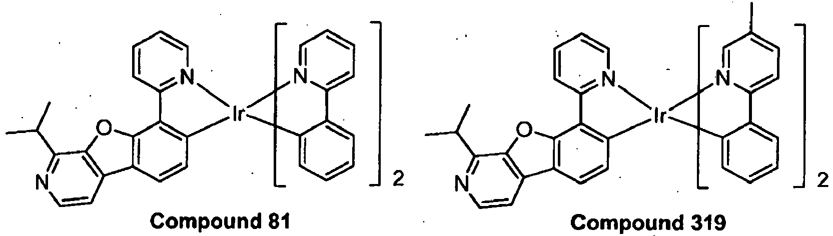

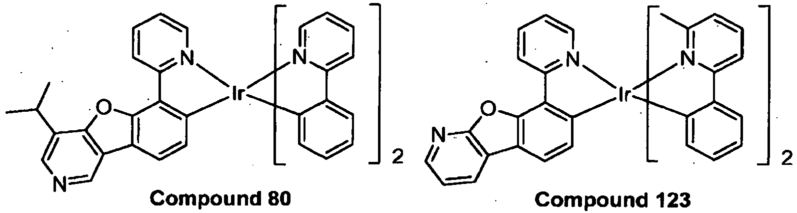

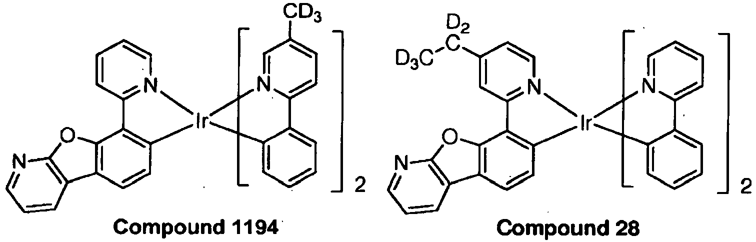

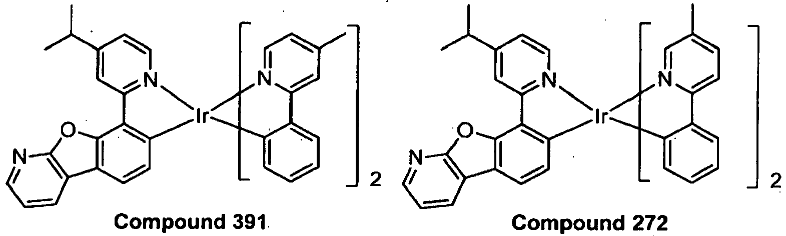

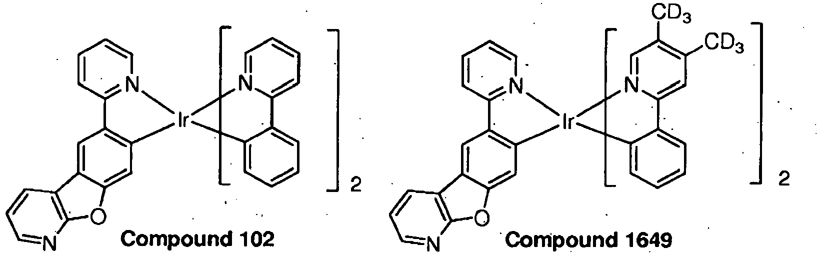

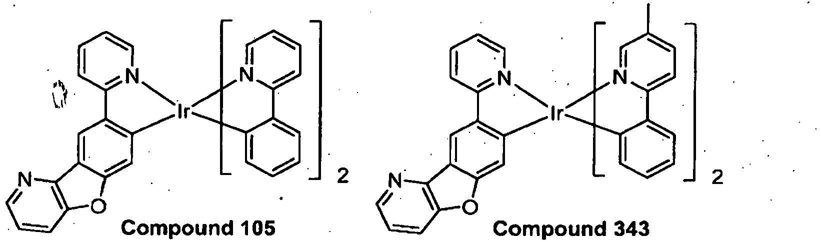

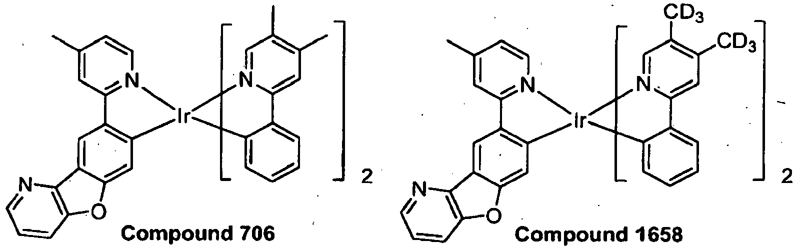

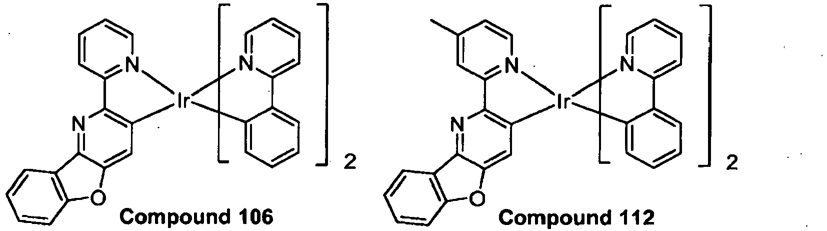

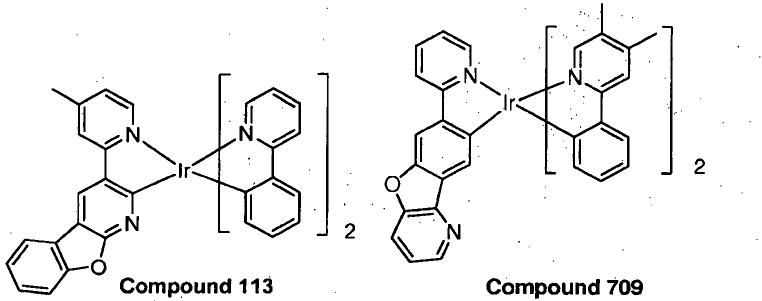

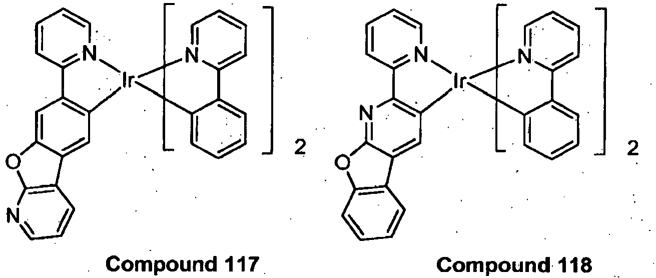

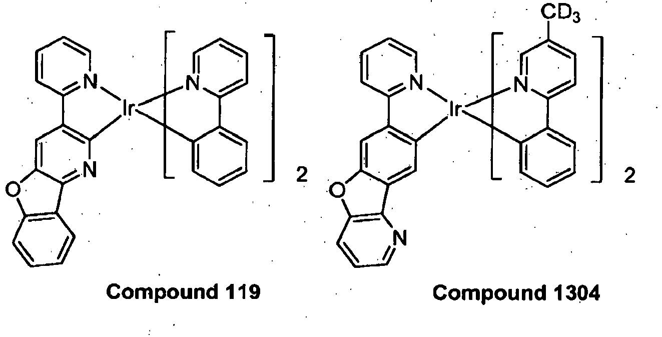

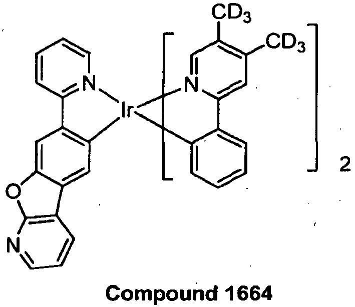

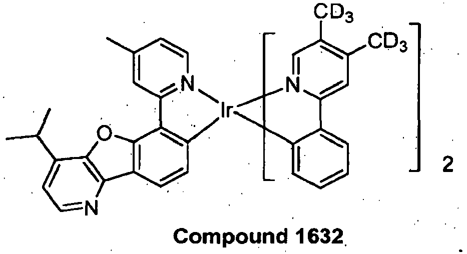

In one embodiment, a first device comprising a first organic light emitting device is disclosed. The first organic lighe emitting device comprises an anode, a cathode, and an organic layer, disposed between the anode and the cathode, comprising a compound having the formula Ir(L_{A})ₙ(L_{B})₃₋ₙ, having the structure according to Formula I 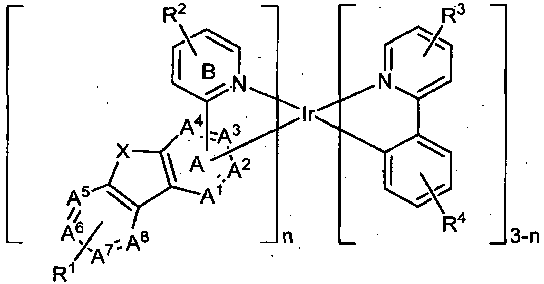 is provided. In the compound of Formula I, A¹, A², A³, A⁴, A⁵, A⁶, A⁷, and A⁸ comprise carbon or nitrogen, and at least one of A¹, A², A³, A⁴, A⁵, A⁶, A⁷, and A⁸ is nitrogen. Ring B is bonded to ring A through a C-C bond, the iridium is bonded to ring A through a Ir-C bond. X is O, S, or Se. R¹, R², R³, and R⁴ independently represent mono-, di-, tri-, tetra-substitution, or no substitution, and any adjacent substitutions in R¹, R², R³, and R⁴ are optionally linked together to form a ring. R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and n is an integer from 1 to 3.

In one embodiment, the first device is a consumer product. In one embodiment, the first device is an organic light-emitting device. In one embodiment, the first device comprises a lighting panel.

In another embodiment, the organic layer in the first organic light emitting device is an emissive layer and the compound is an emissive dopant. In one embodiment, the organic layer is an emissive layer and the compound is a non-emissive dopant.

In one embodiment, the organic layer further comprises a host. In one embodiment, the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution, wherein n is from 1 to 10; and wherein A₁ and Ar₂ are independently selected from the group consisting of benzene, biphenyl, naphthalene, triphenylene, carbazole, and heteroaromatic analogs thereof.

In one embodiment, the host comprises at least one chemical group selected from the group consisting of carbazole, dibenzothiphene, dibenzofuran, dibenzoselenophene, azacarbazole, aza-dibenzothiophene, aza-dibenzofuran, and aza-dibenzoselenophene.

The "aza" designation in the fragments described above, i.e. aza-dibenzofuran, aza-dibenzonethiophene, etc. means that one or more of the C-H groups in the respective fragment can be replaced by a nitrogen atom, for example, and without any limitation, azatriphenylene encompasses both dibenzo[f*,h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

In one embodiment, the host is selected from a group of compounds, the Host Group, consisting of: 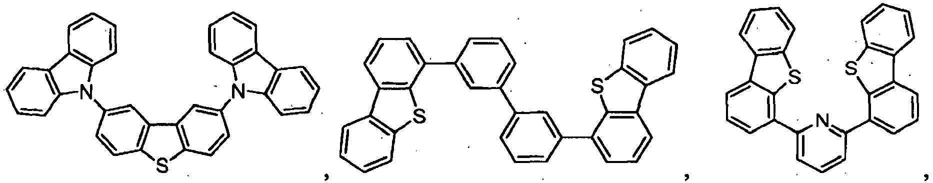 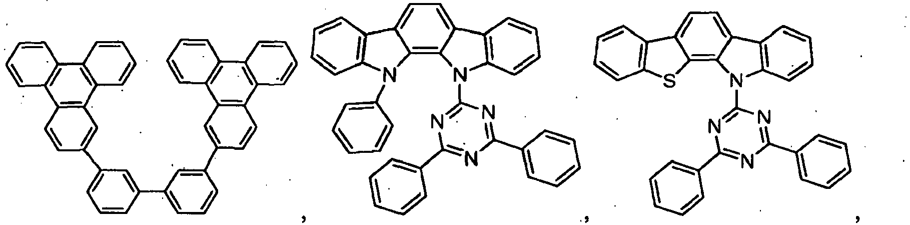 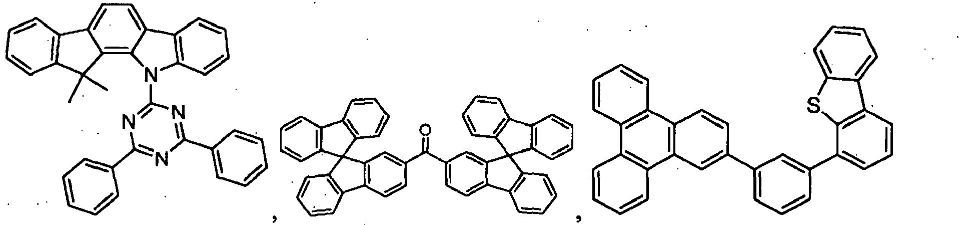 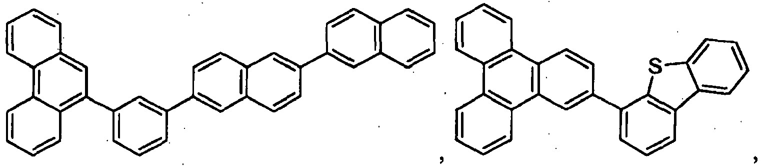 and combinations thereof.

In one embodiment, the host comprises a metal complex.

According to an aspect of the present disclosure, the compound according to Formula I wherein A¹-A⁴ and A⁶-A⁸ are C and A⁵ is N and having a structure according to Formula II 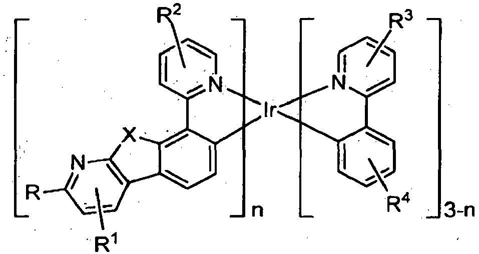 is also provided. In the compound of Formula II, X, R¹, R², R³, and R⁴, and n are as defined for Formula I. R is selected from the group consisting of alkyl, cycloalkyl, and combinations thereof; R¹ represent mono-, di-substitution, or no substitution.

In one embodiment, n in the compound of Formula II is 1. In one embodiment, X is O. In one embodiment, R is alkyl. In one embodiment, R is cycloalkyl. In one embodiment, R is selected from the group consisting of methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, cyclohexyl, partially or fully deuterated variants thereof, and combinations thereof. In one embodiment, R¹, R², R³, and R⁴ can be independently selected from the group consisting of hydrogen, deuterium, alkyl, and combinations thereof. In one embodiment, R² is alkyl, or partially or fully deuterated alkyl. In one embodiment of the compound having the structure of Formula II, R² is selected from the group consisting of aryl, substituted aryl, heteroaryl, and substituted heteroaryl. In one embodiment, R³ is alkyl, or partially or fully deuterated alkyl.

In one embodiment, L_{A} in Formula II is selected from the group consisting of

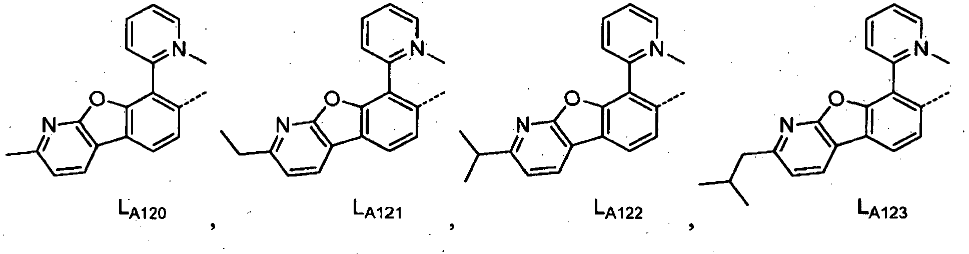

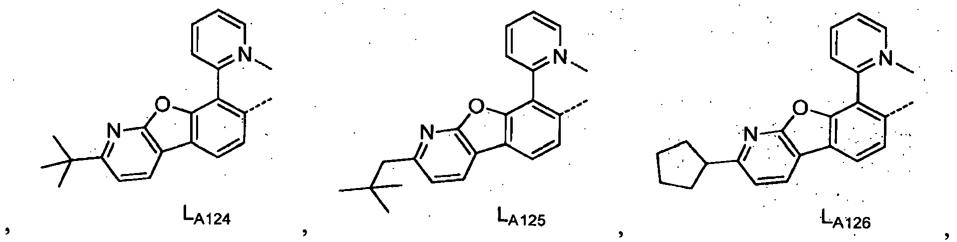

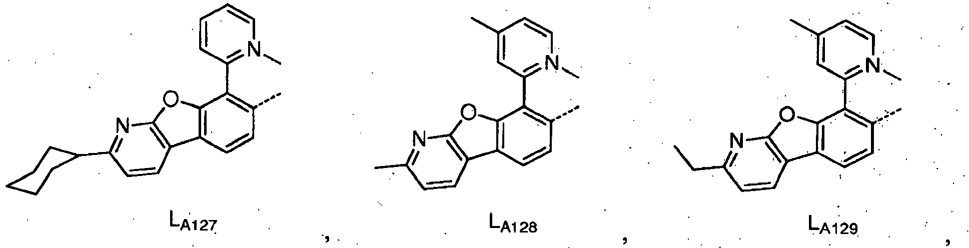

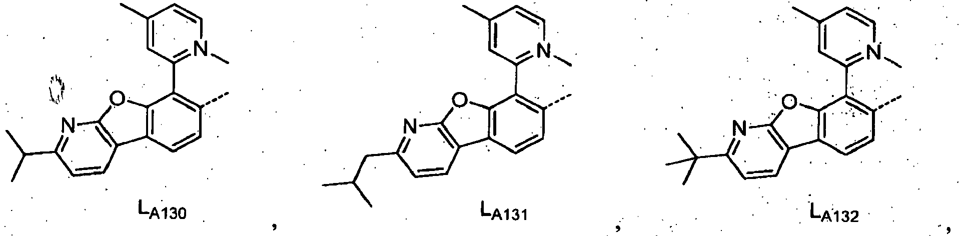

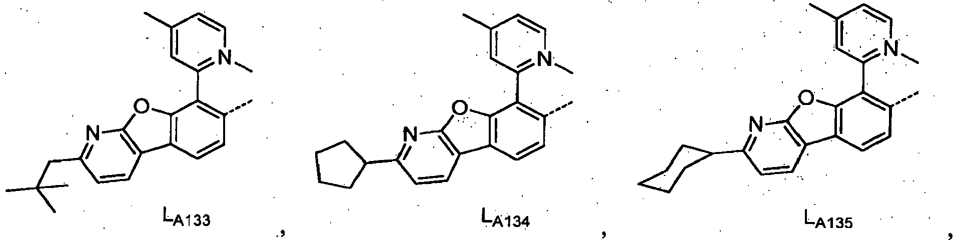

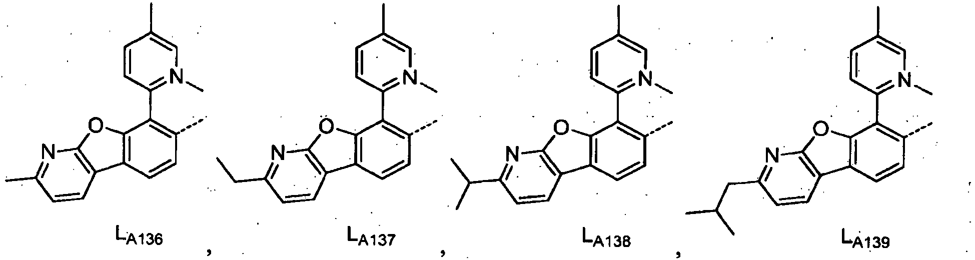

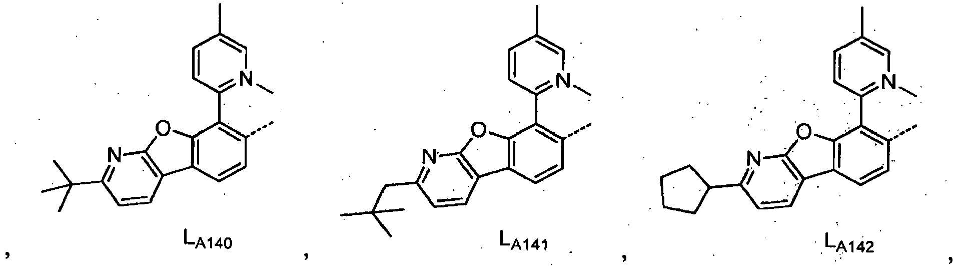

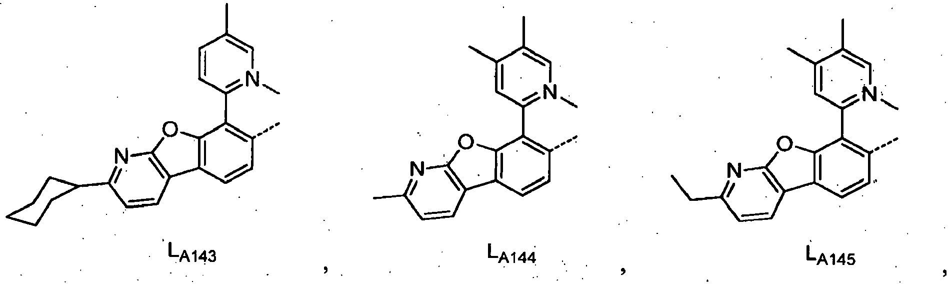

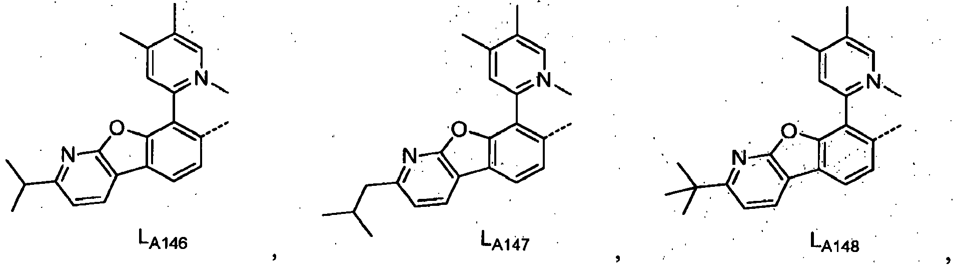

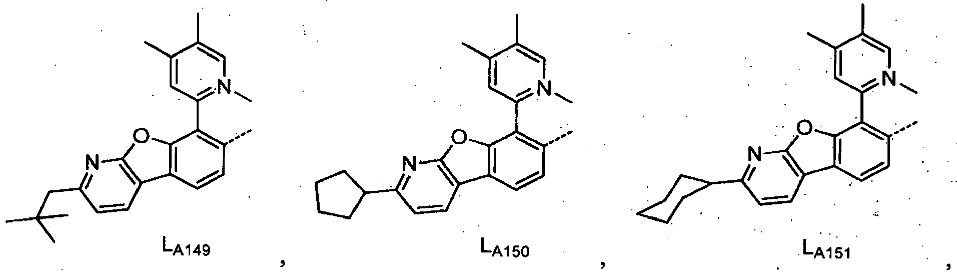

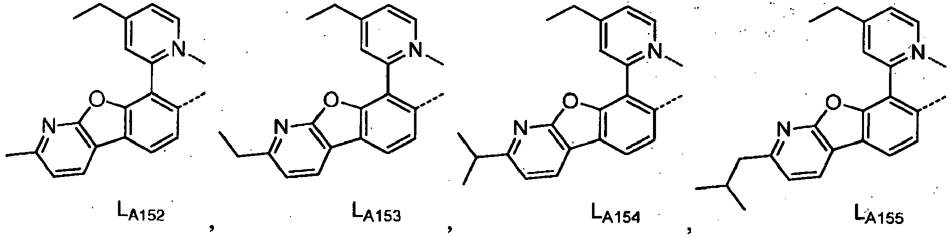

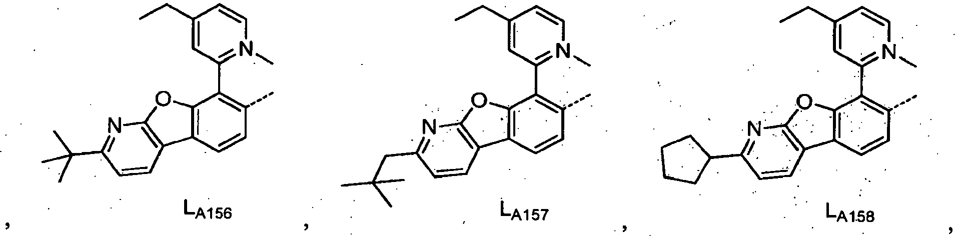

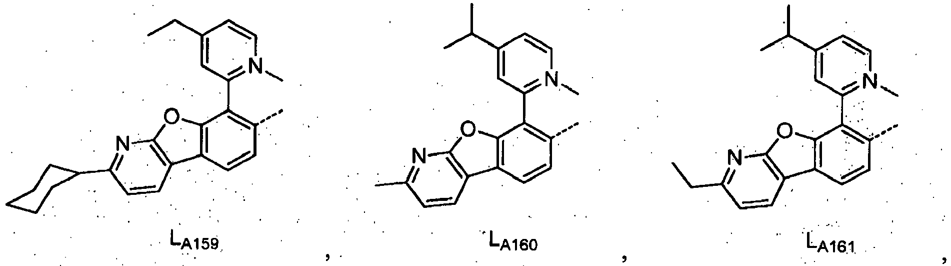

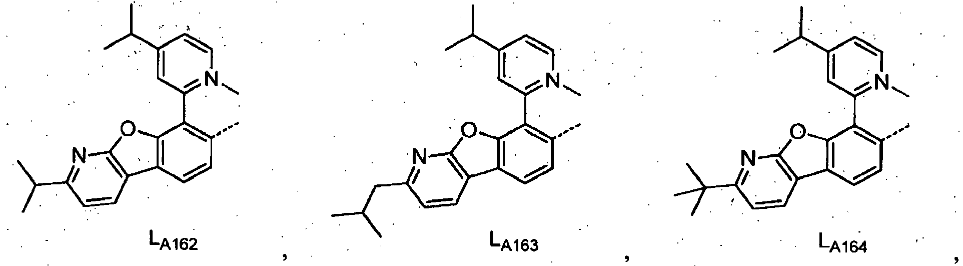

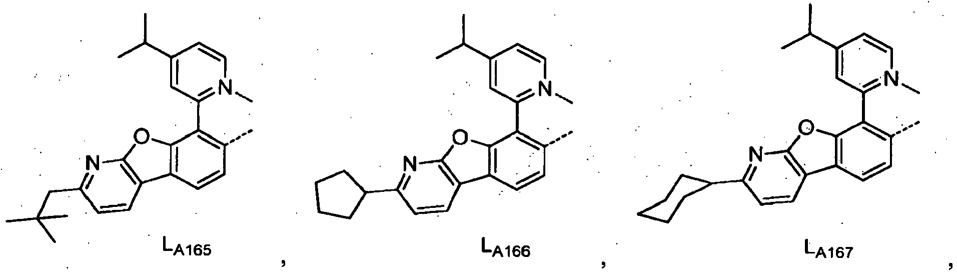

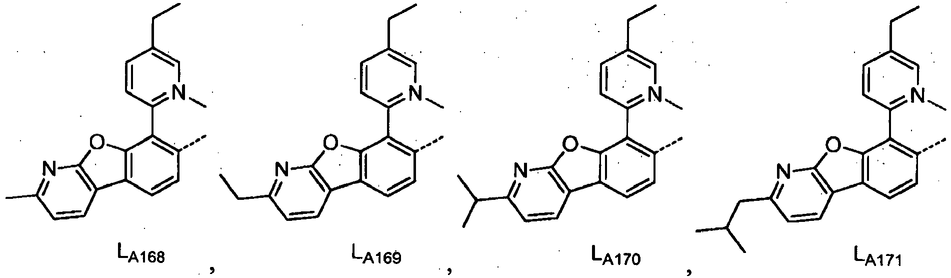

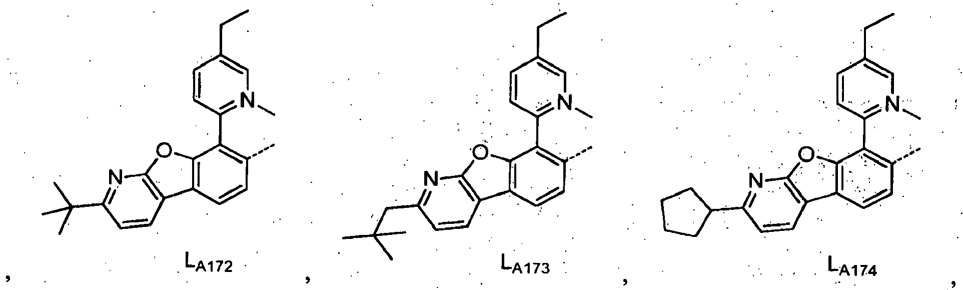

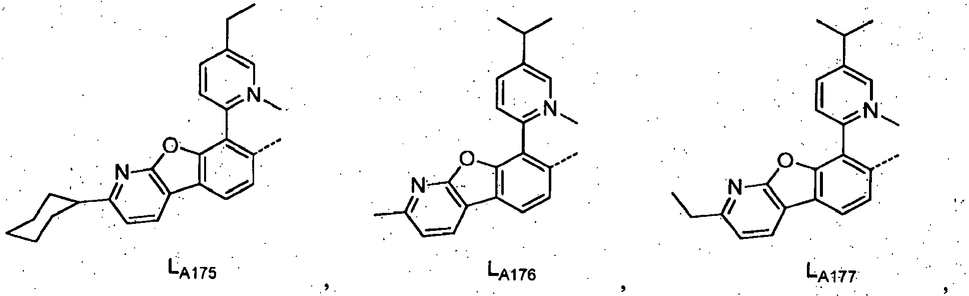

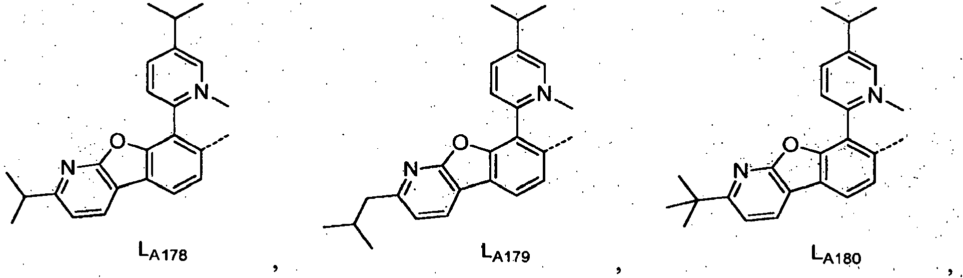

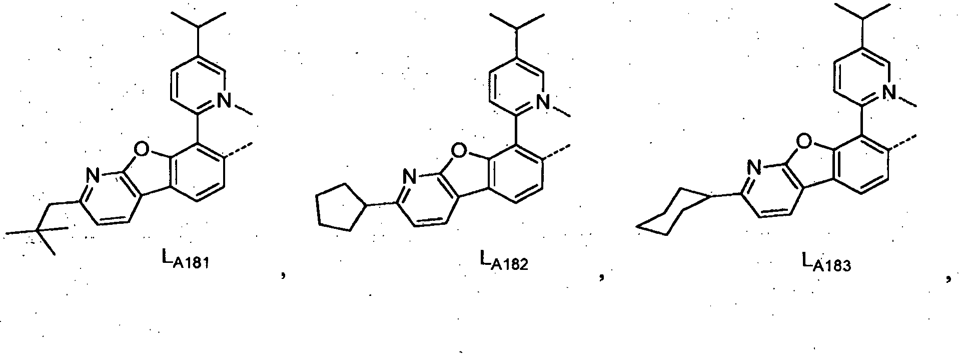

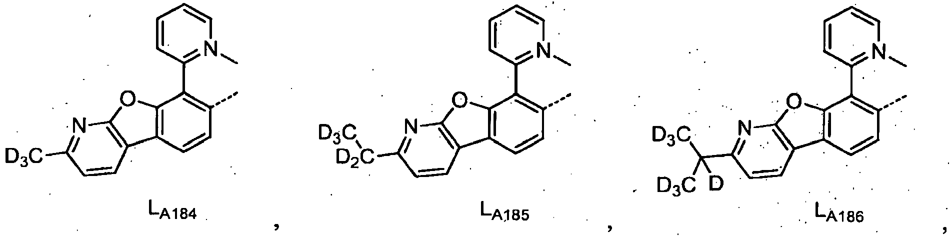

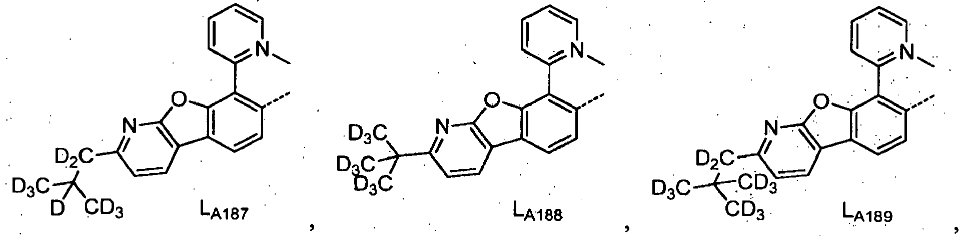

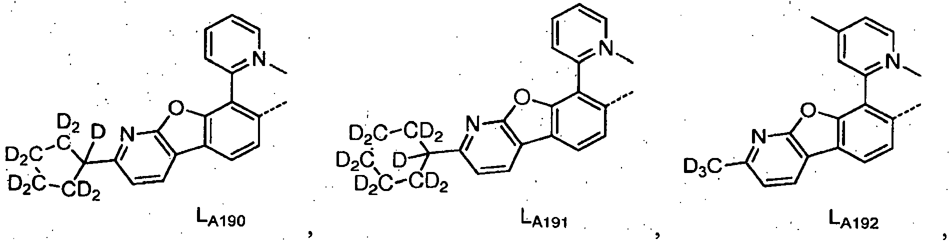

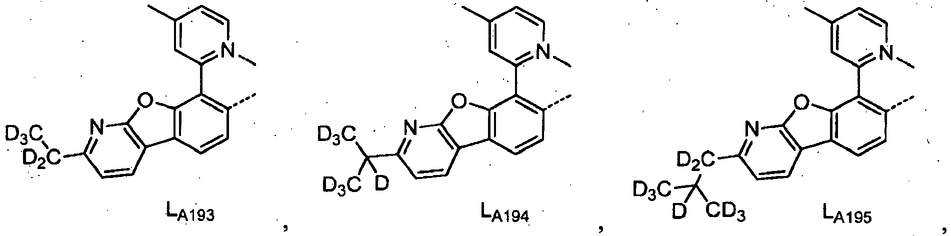

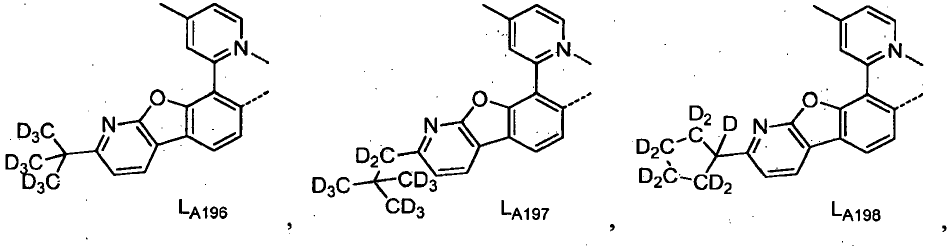

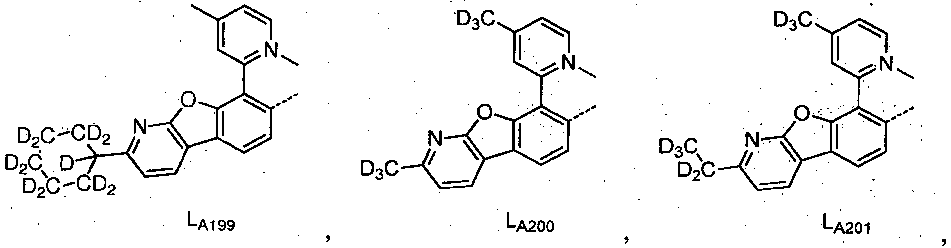

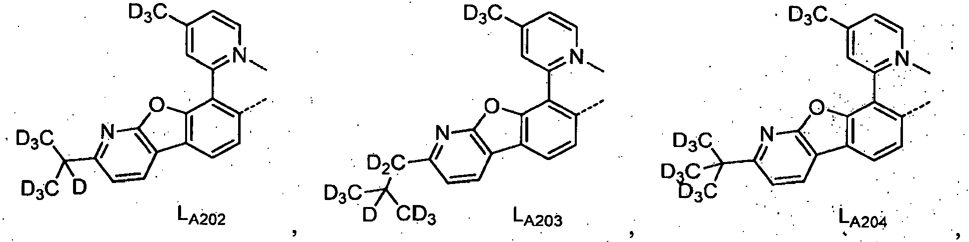

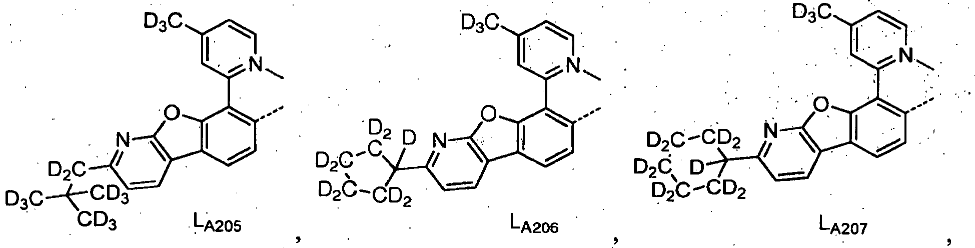

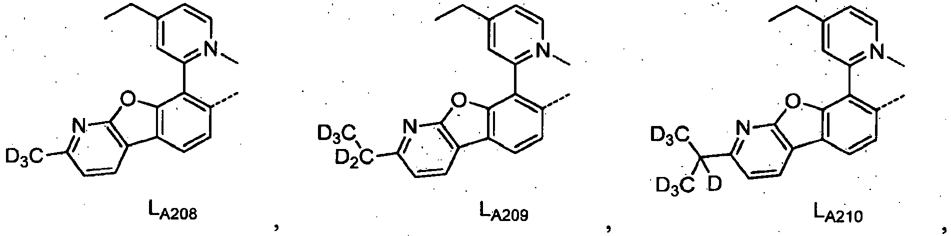

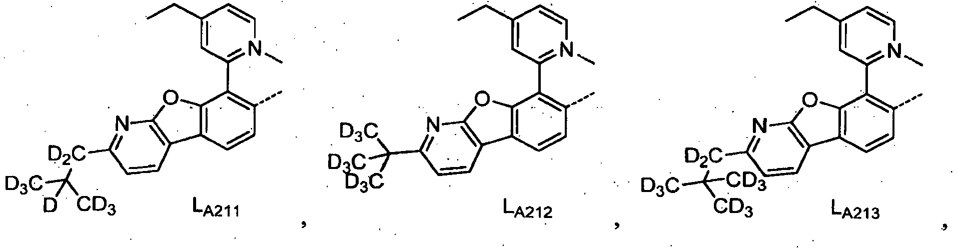

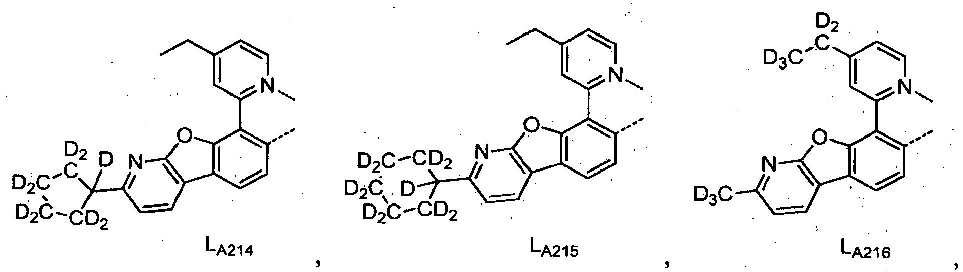

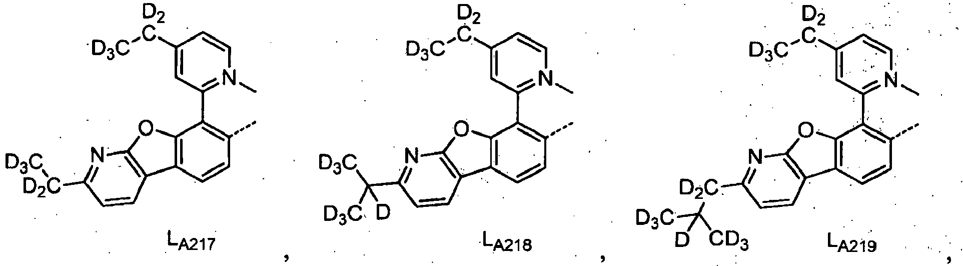

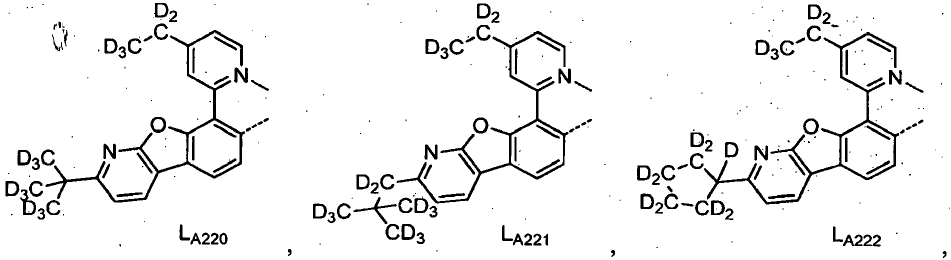

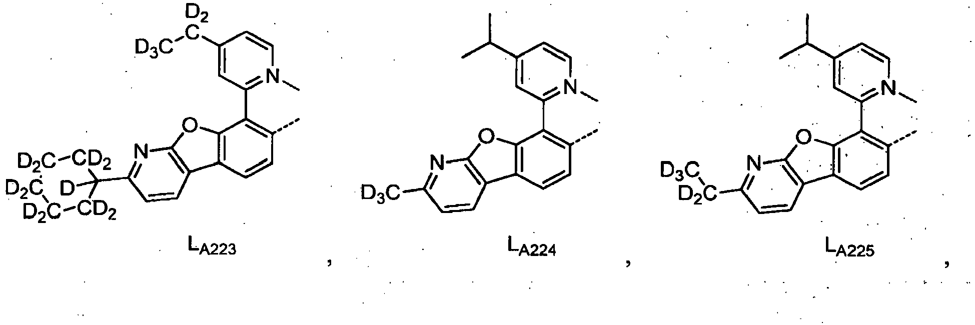

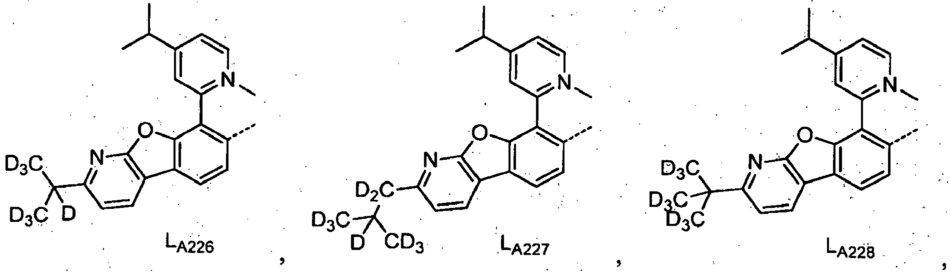

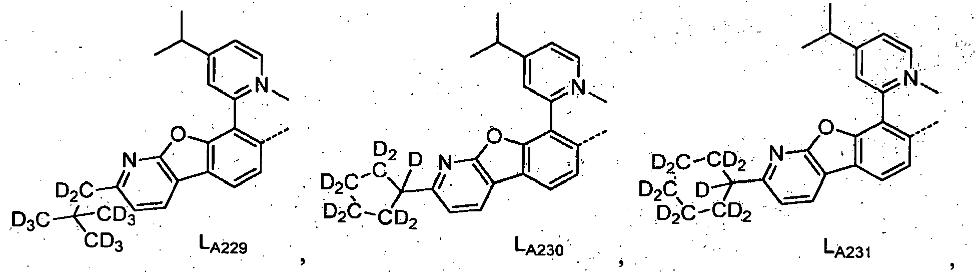

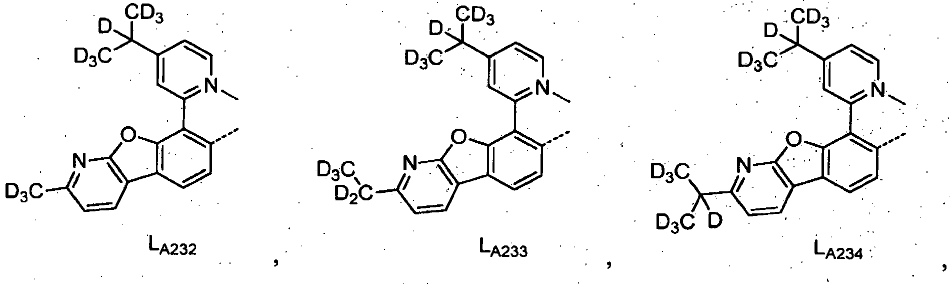

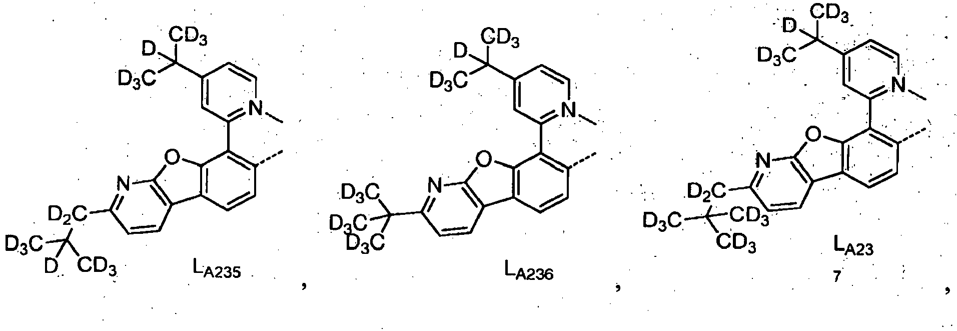

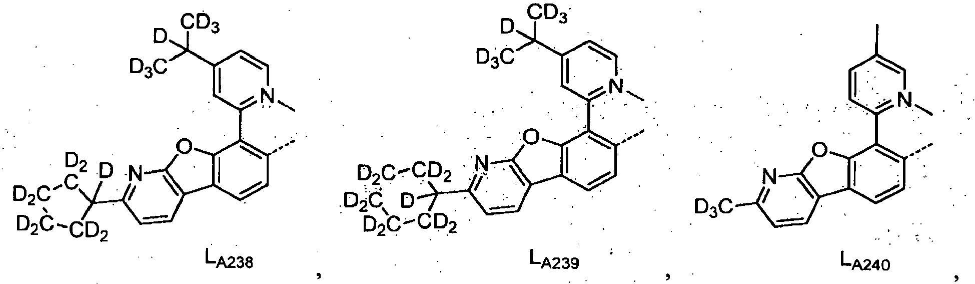

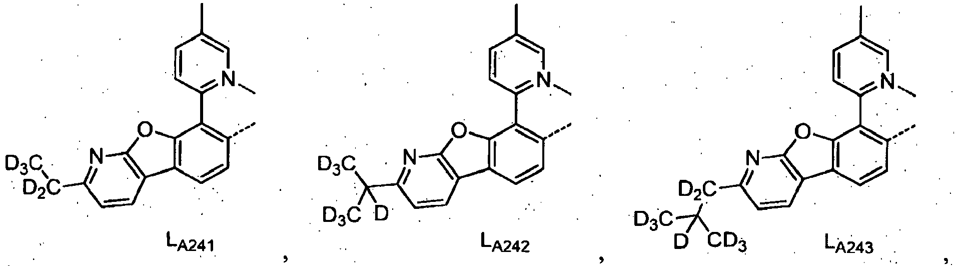

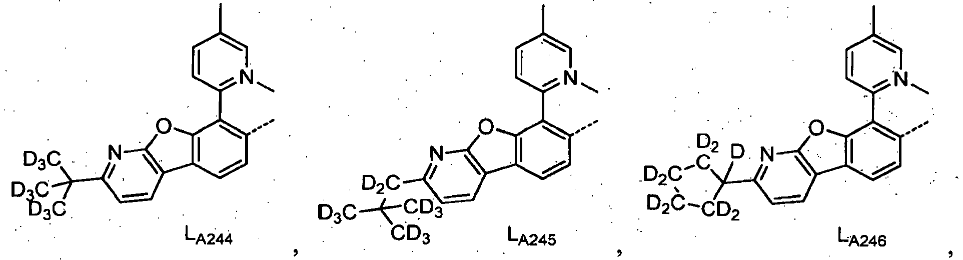

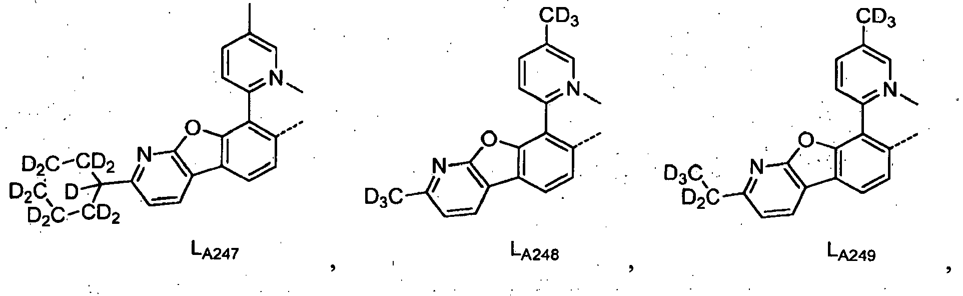

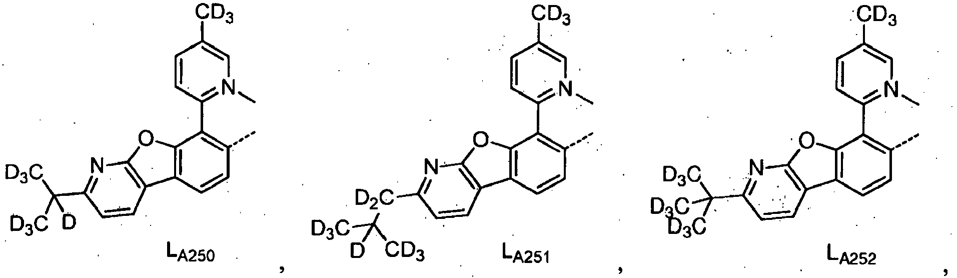

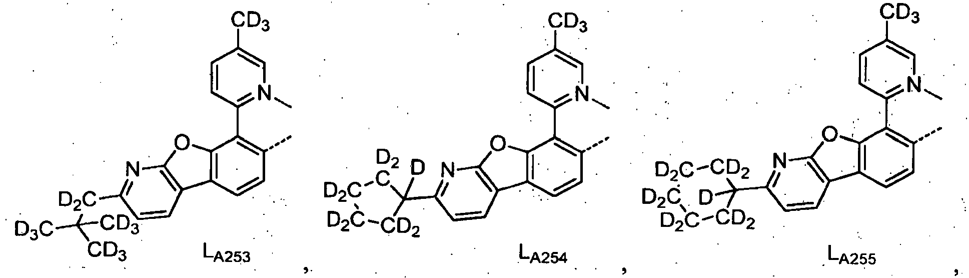

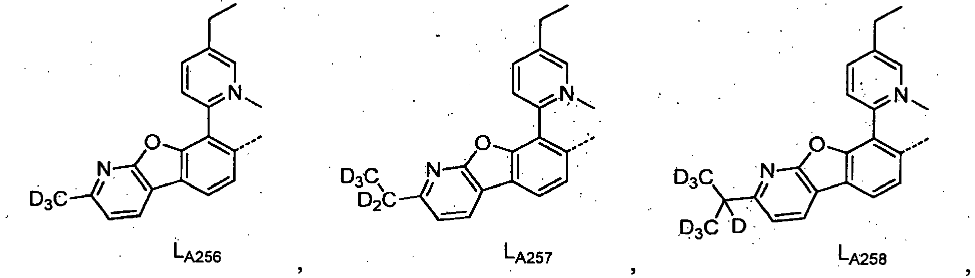

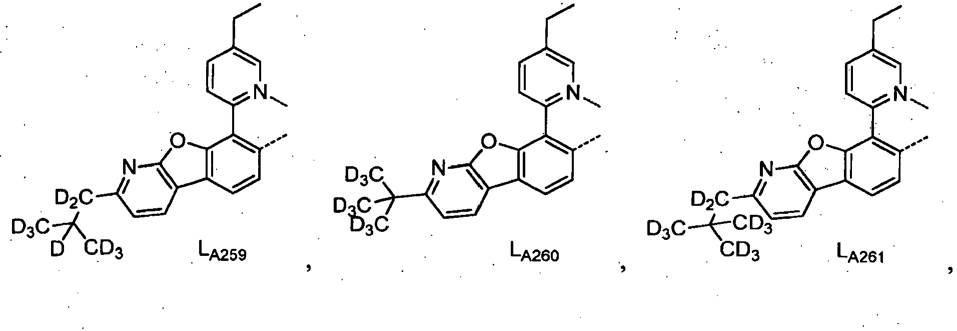

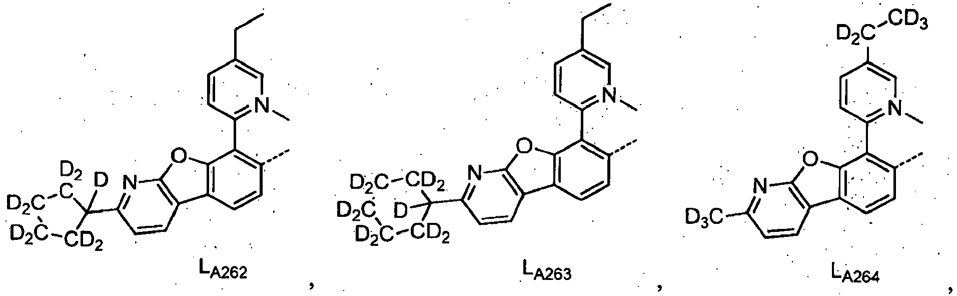

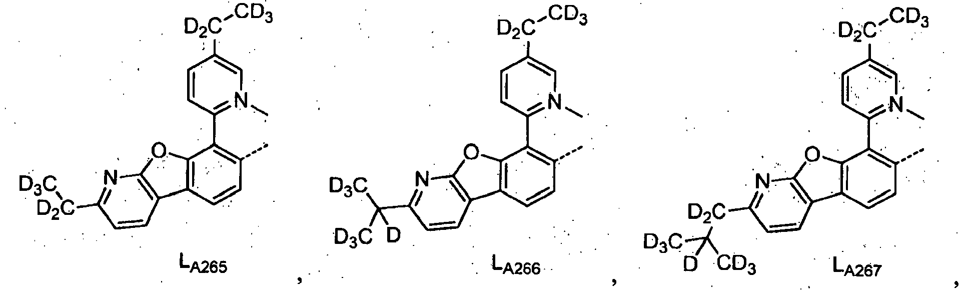

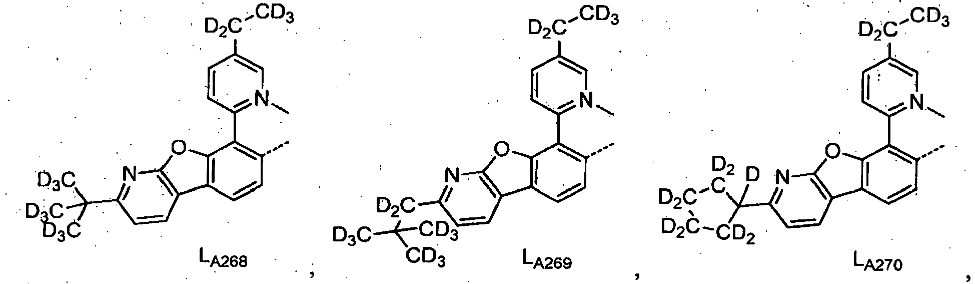

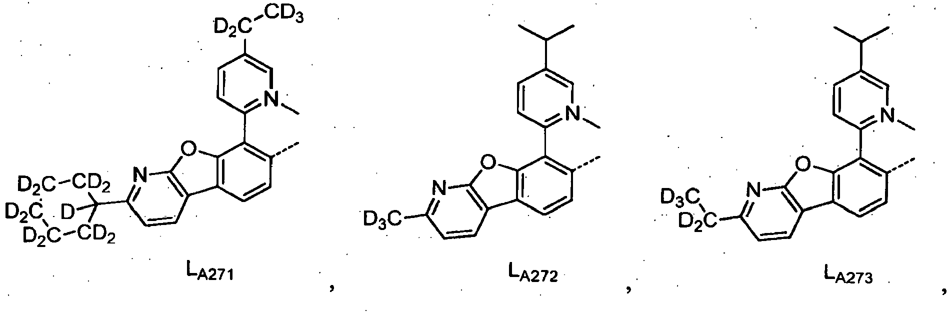

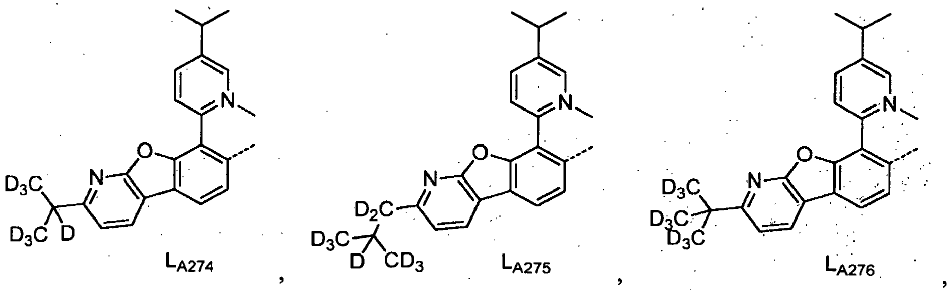

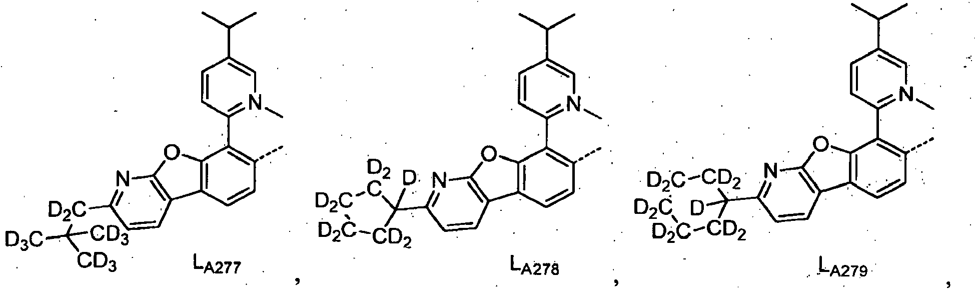

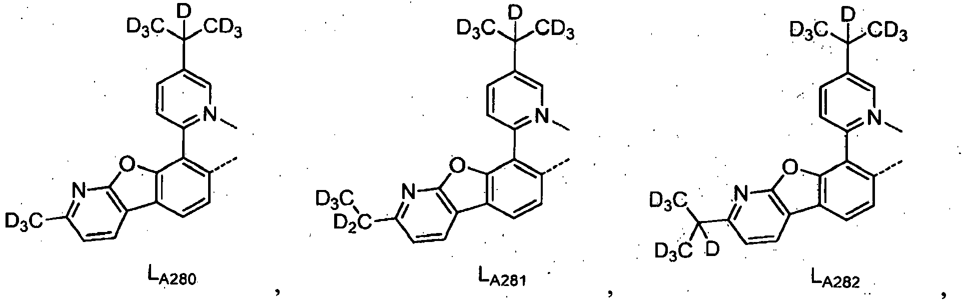

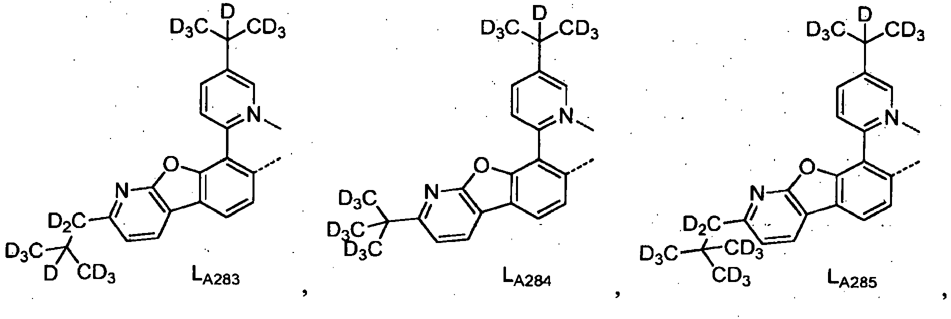

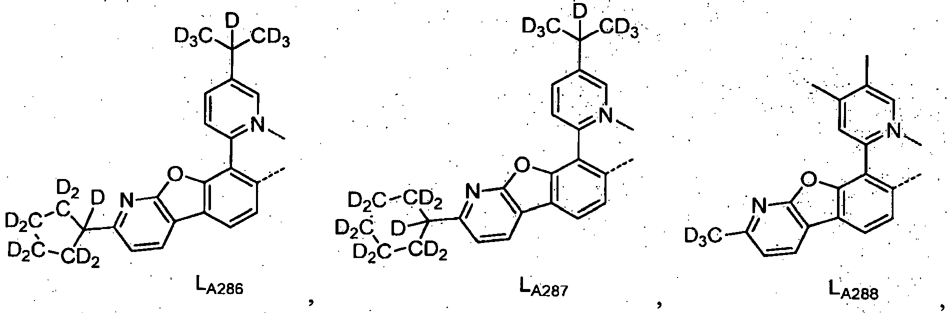

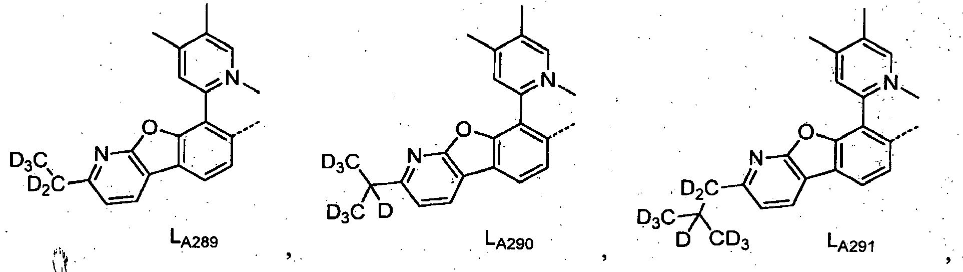

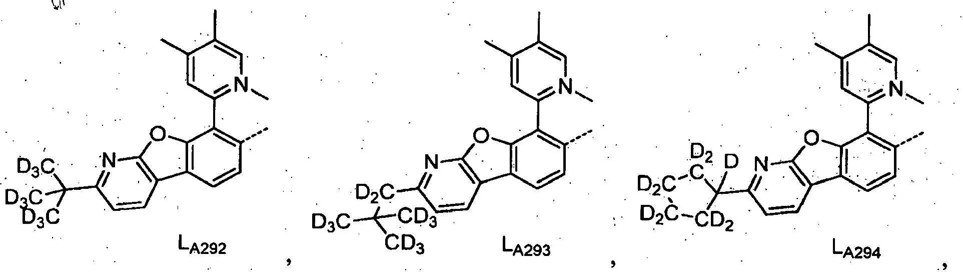

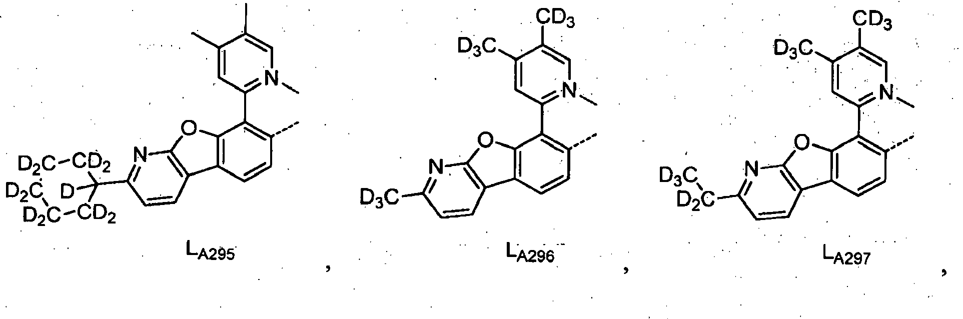

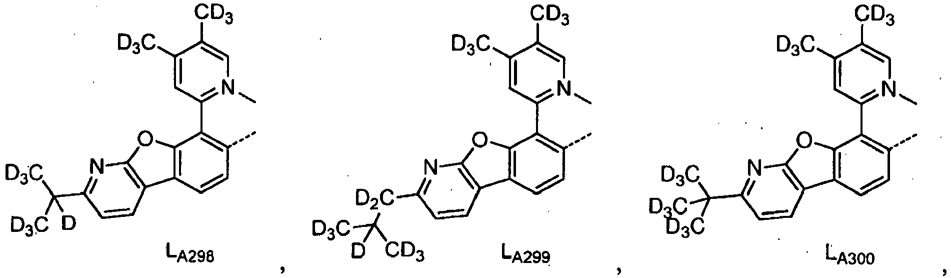

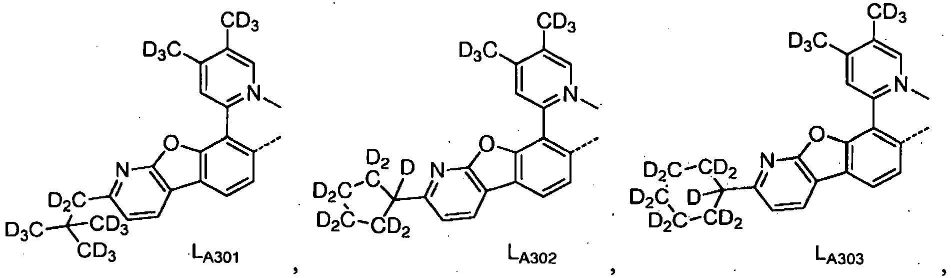

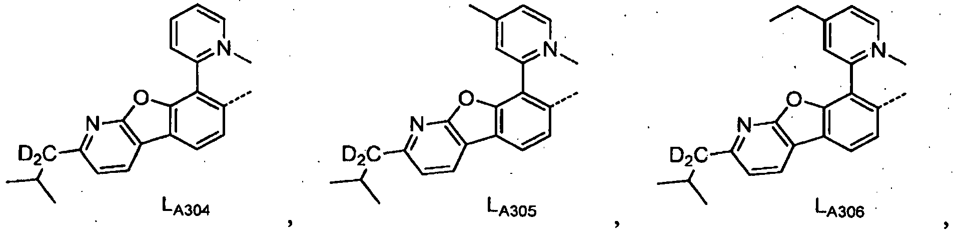

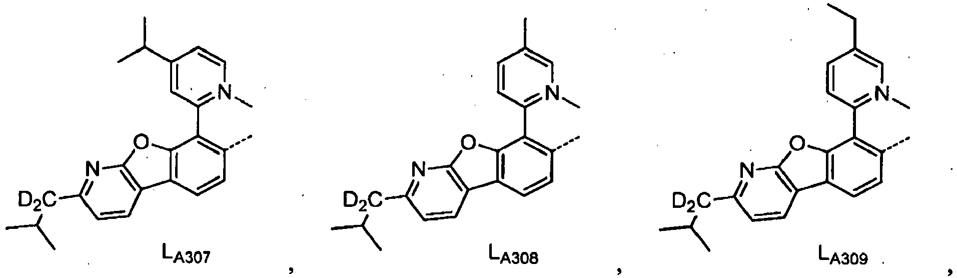

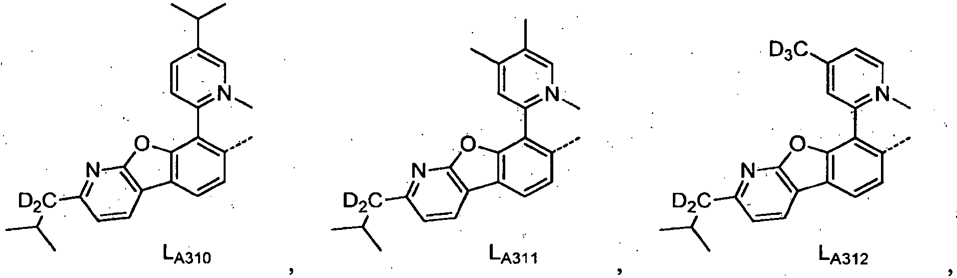

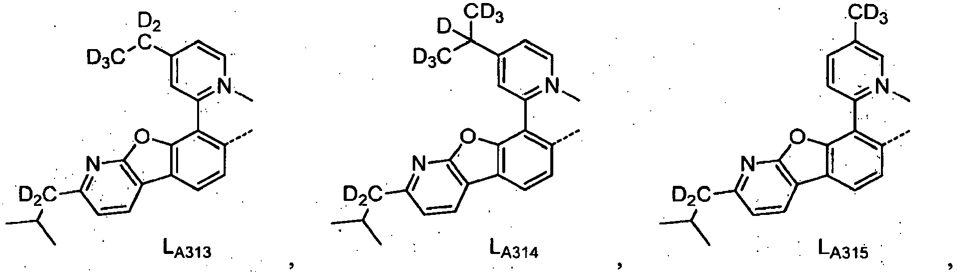

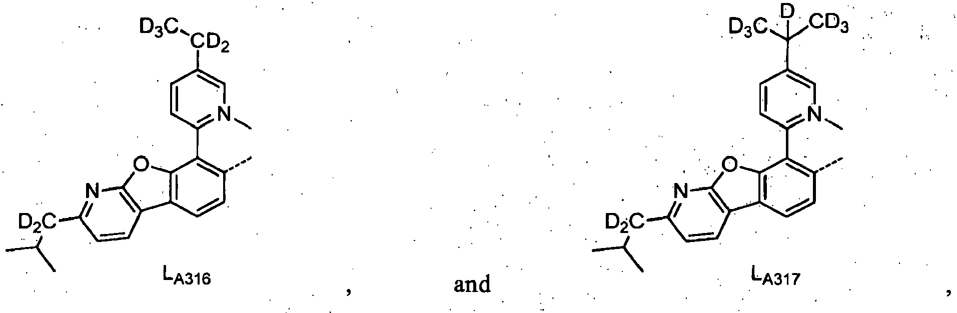

The L_{B} in Formula II is selected from the group consisting of:

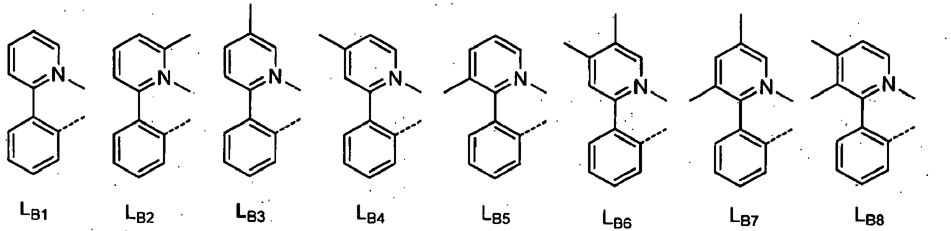

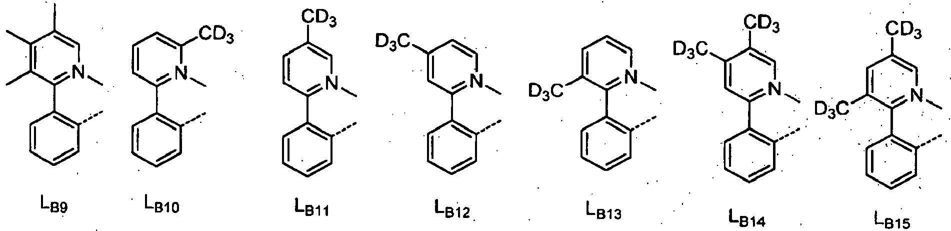

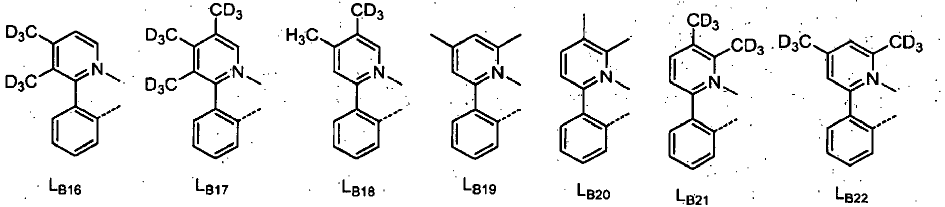

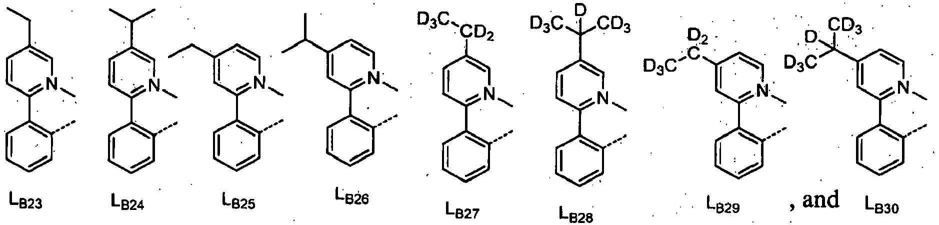

In one embodiment, preferred compounds of Formula II, named as compound II-1 to compound II-459, are identified in the appended claims.

In one enbodiment, in the compound of Formula I, L_{A} is selected from the group consisting of:

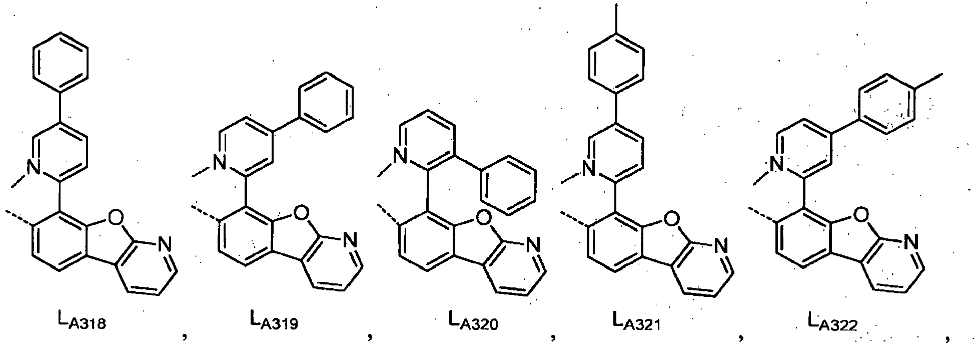

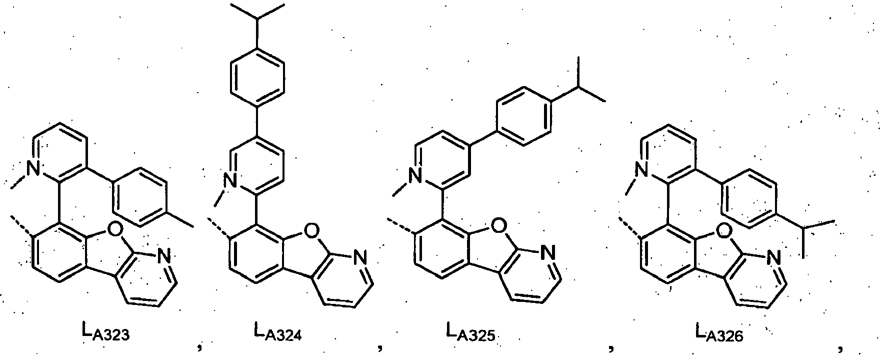

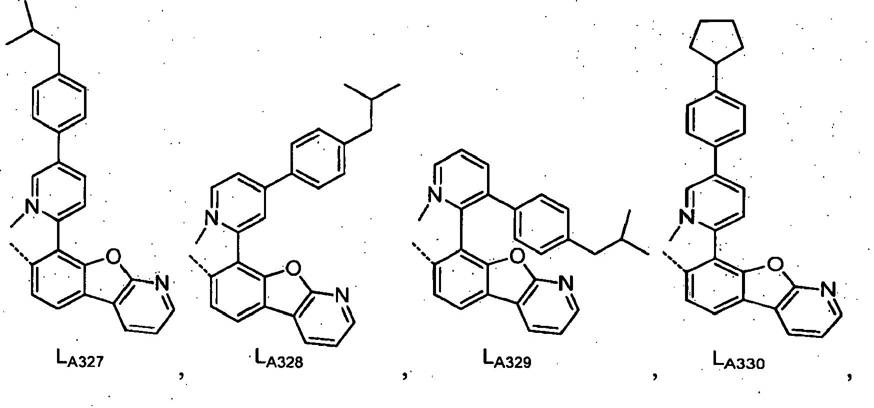

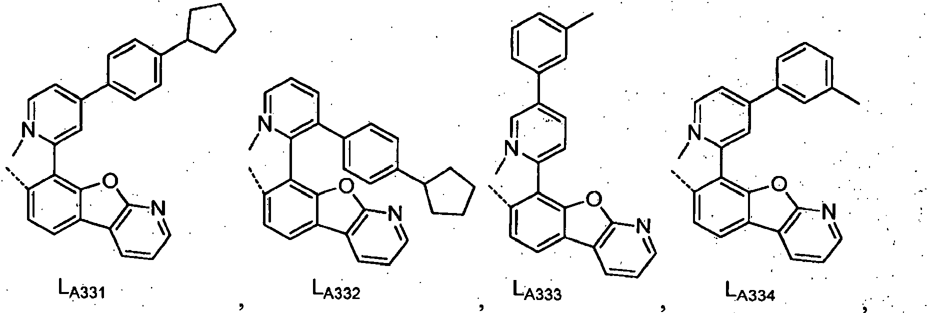

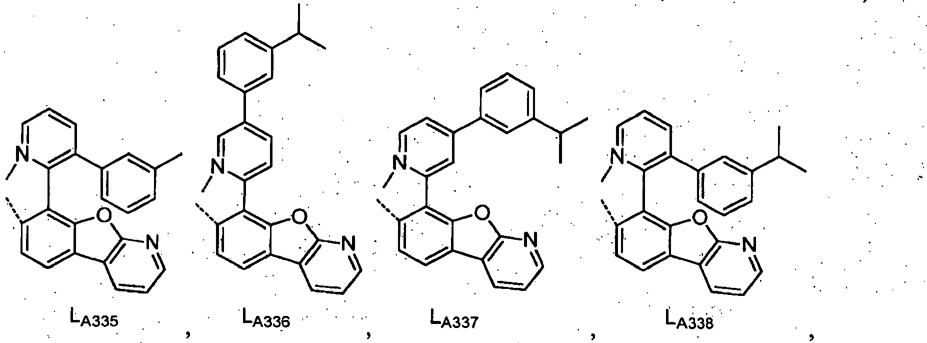

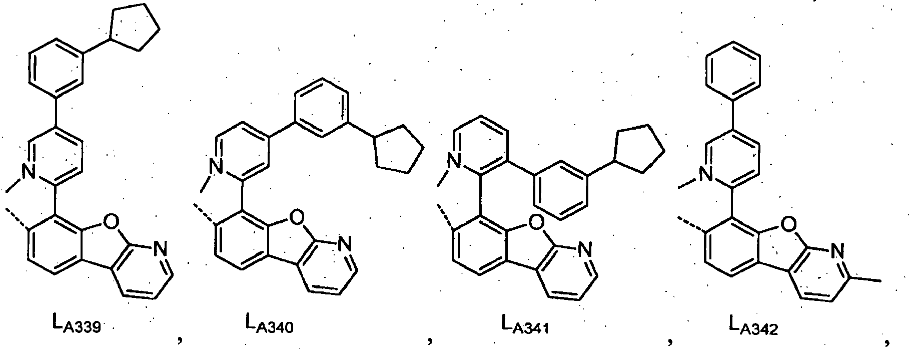

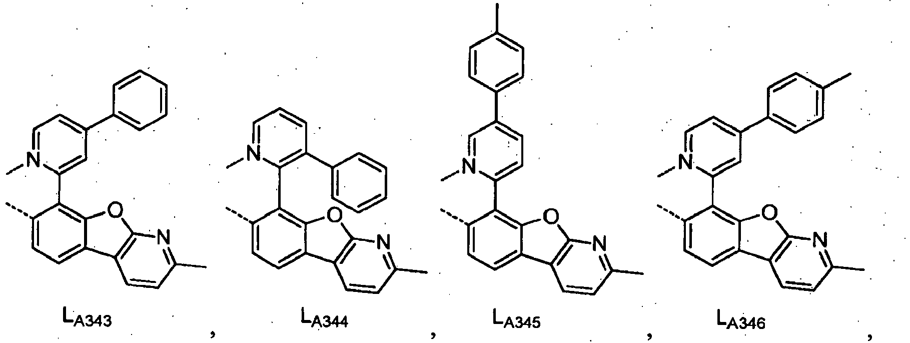

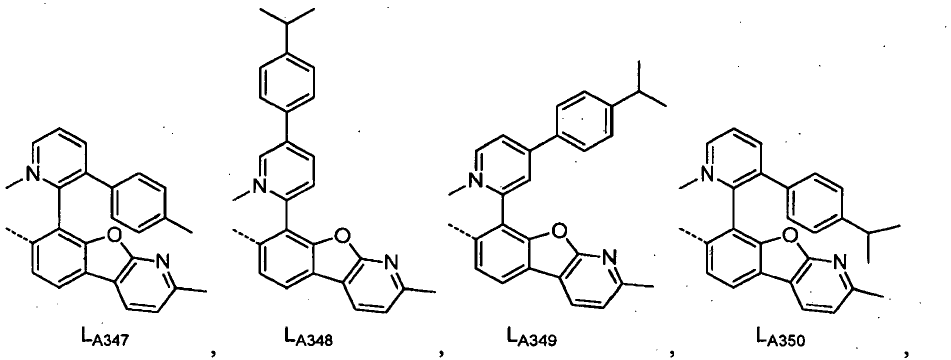

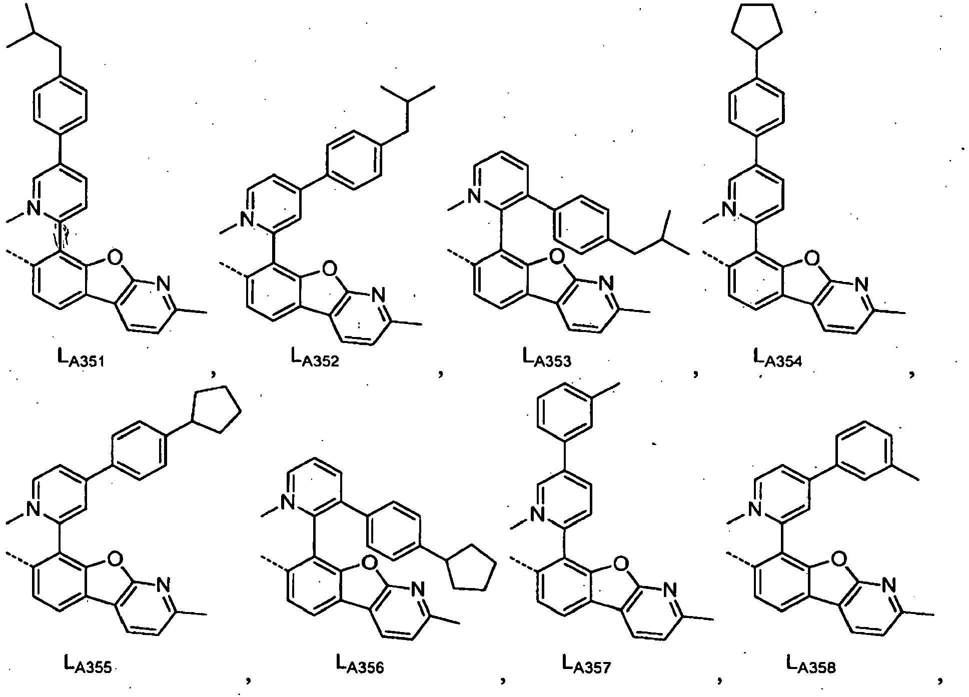

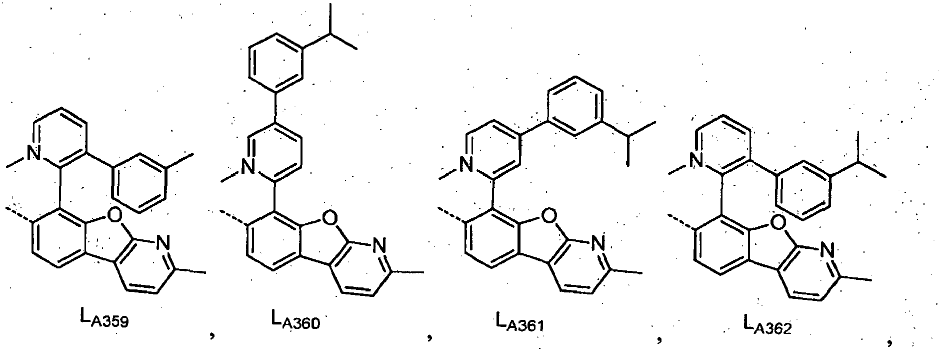

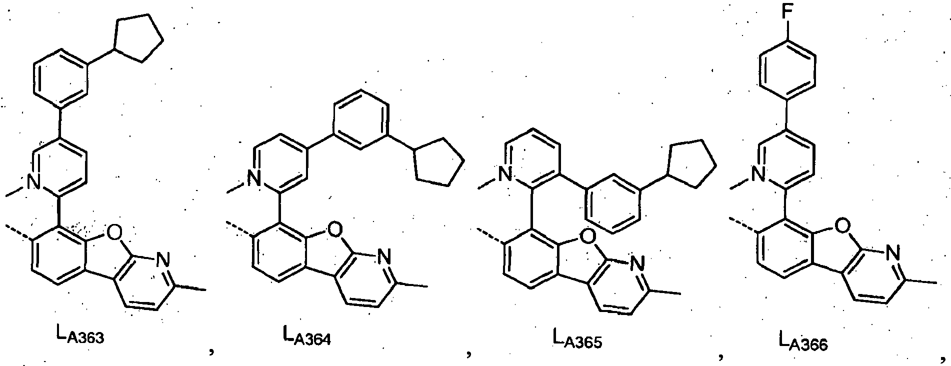

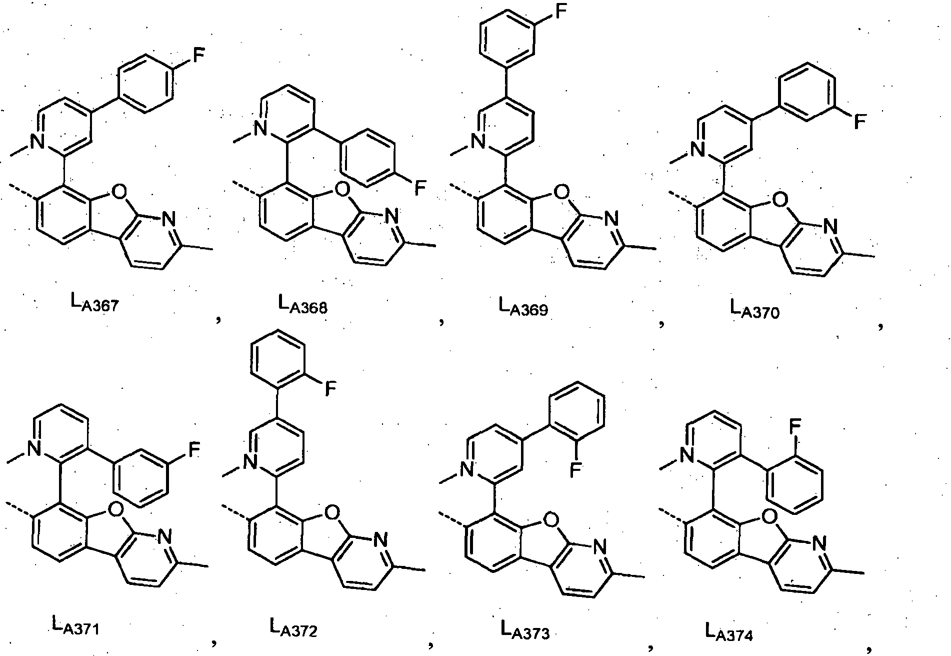

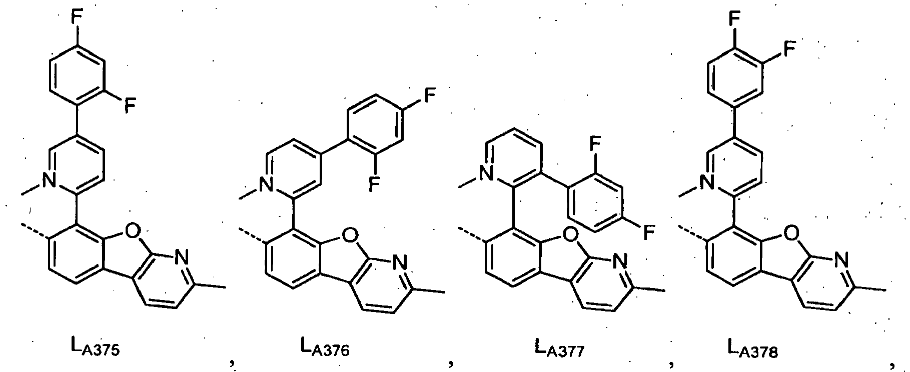

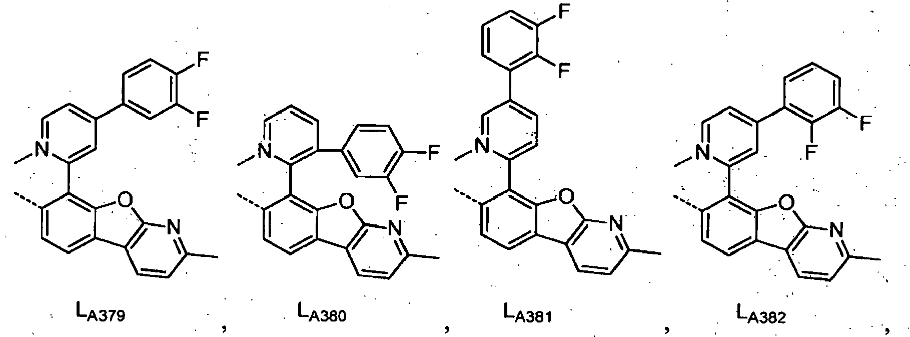

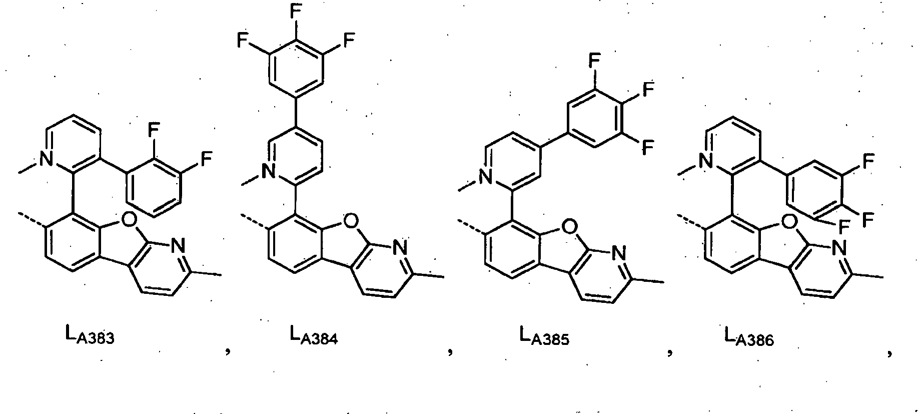

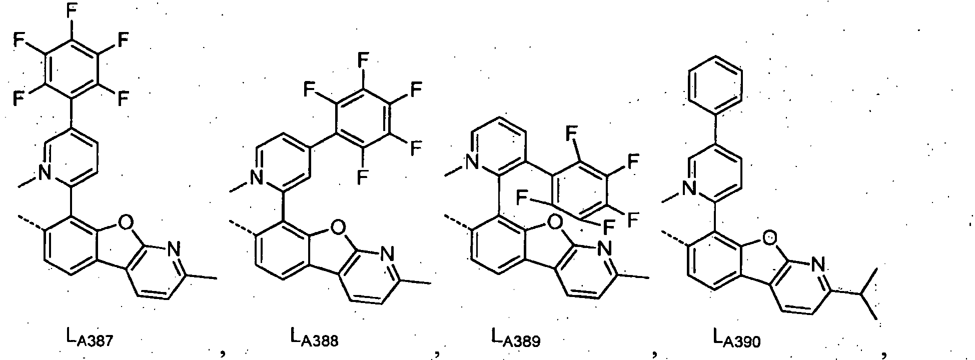

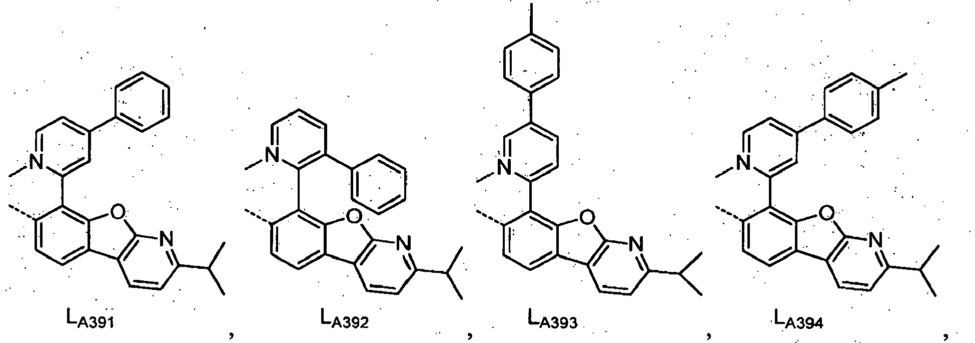

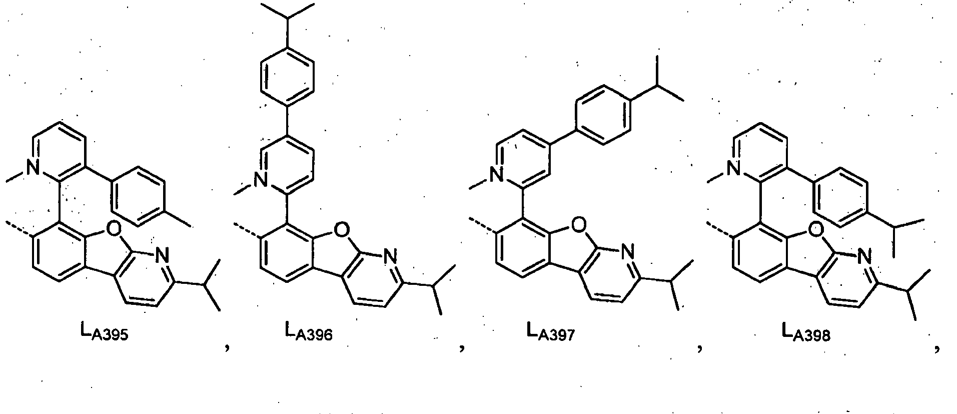

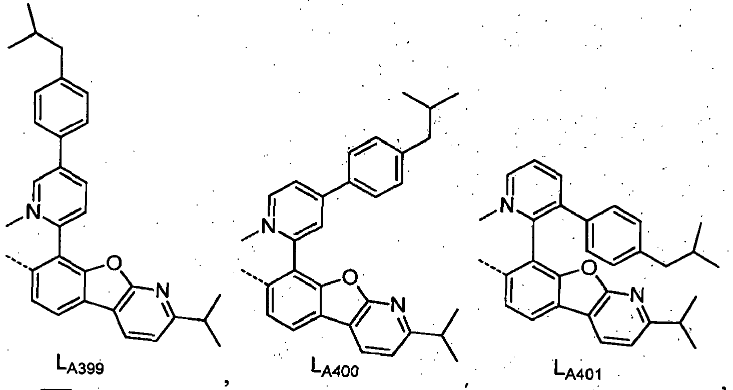

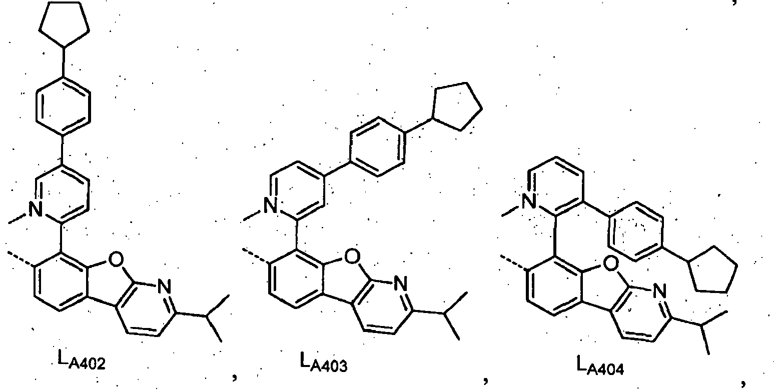

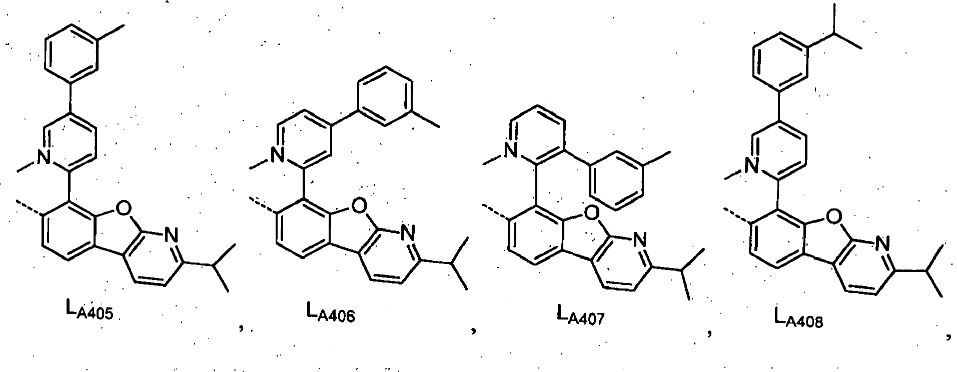

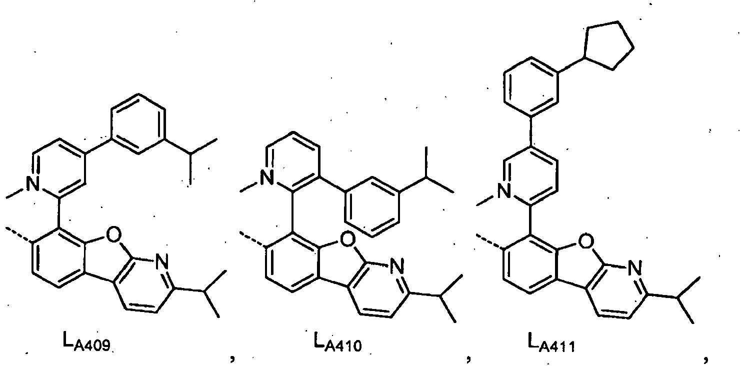

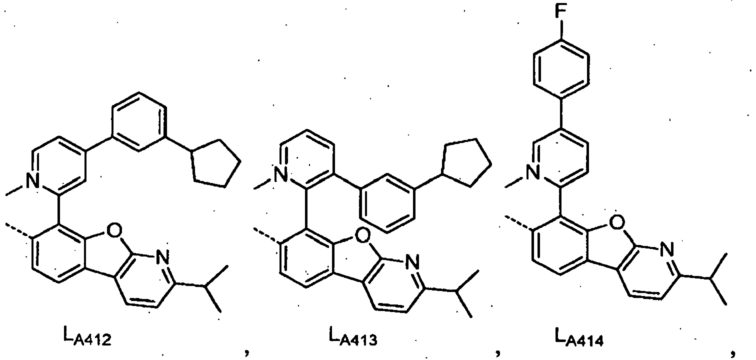

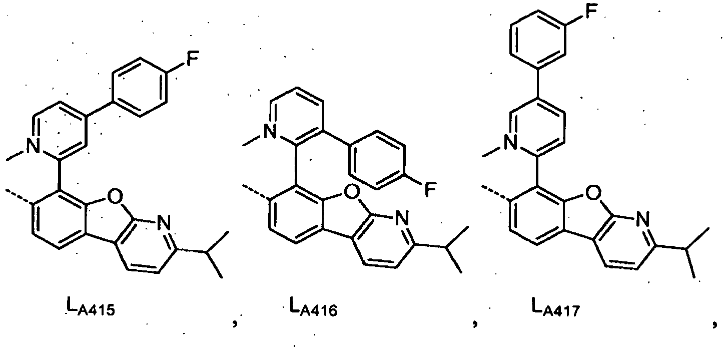

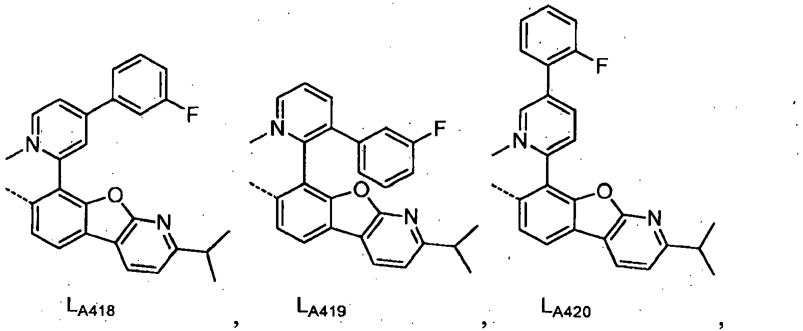

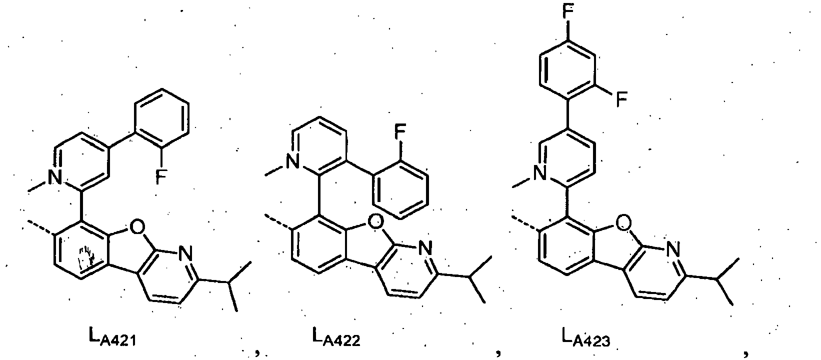

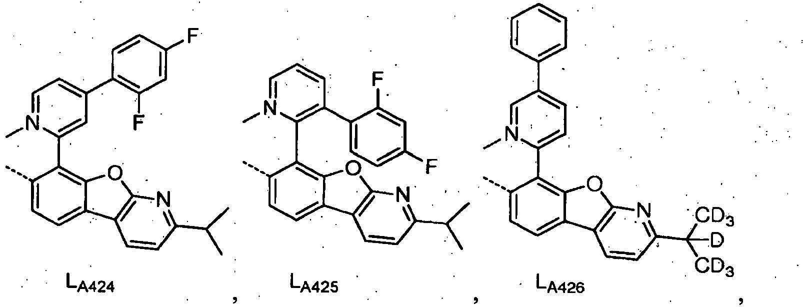

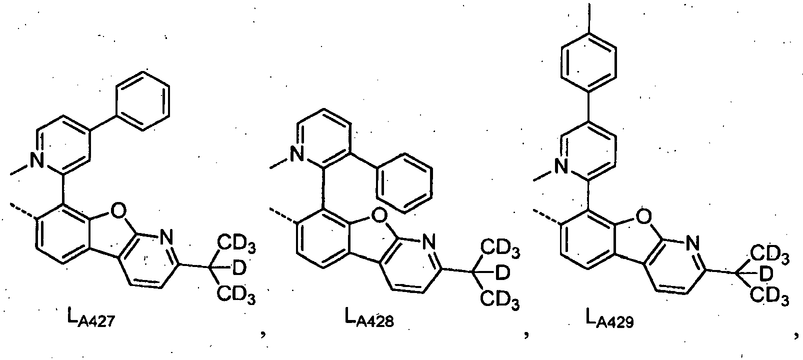

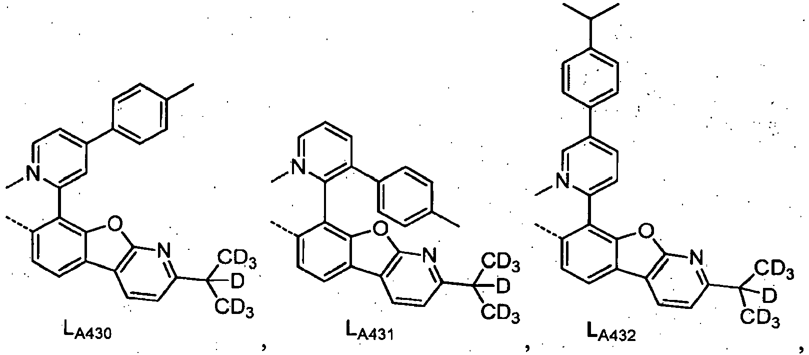

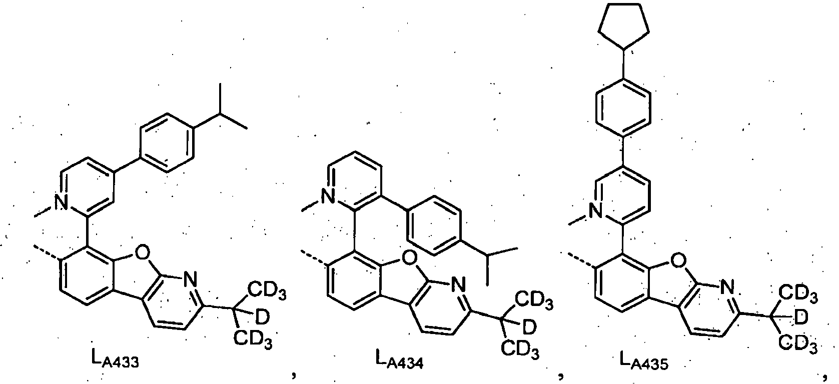

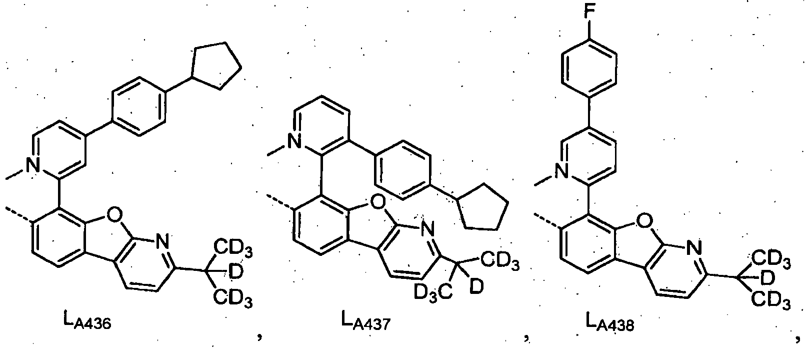

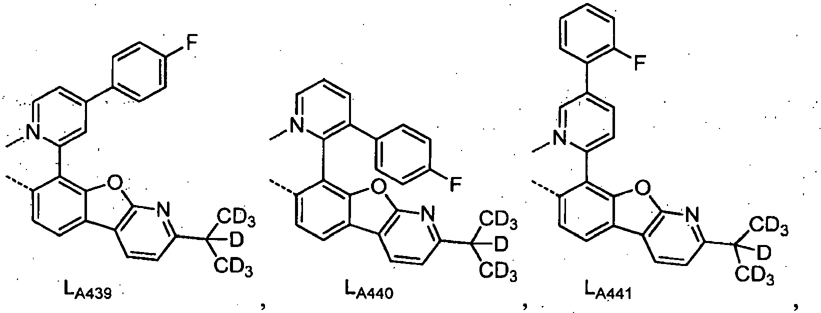

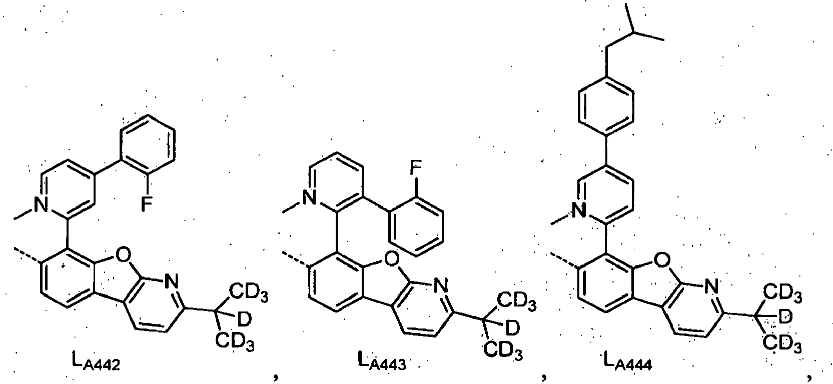

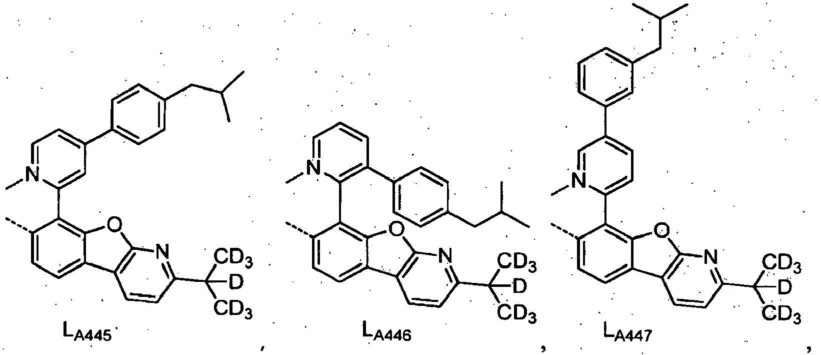

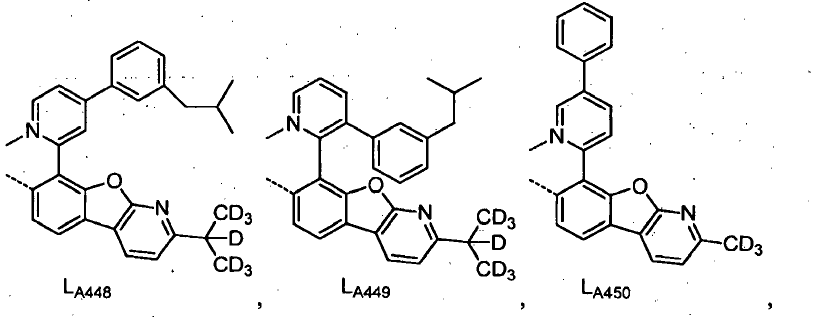

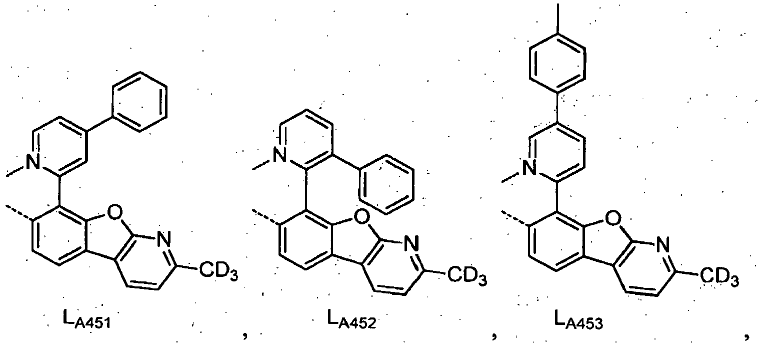

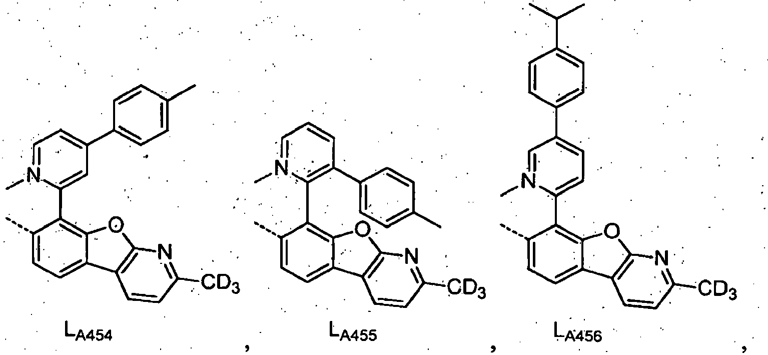

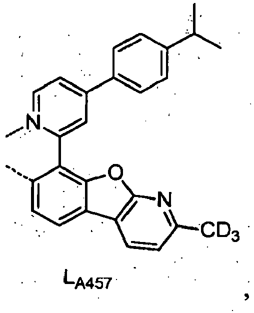

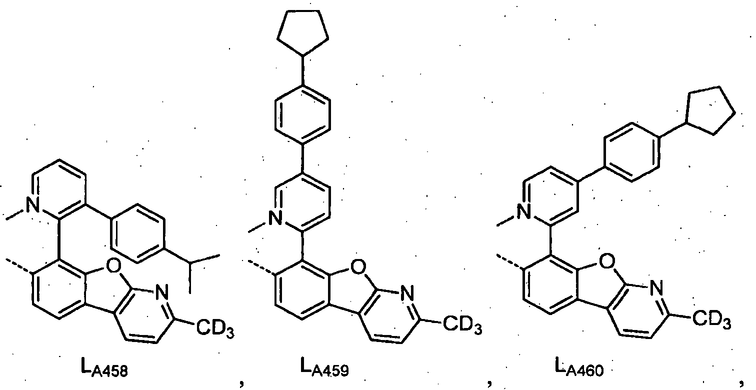

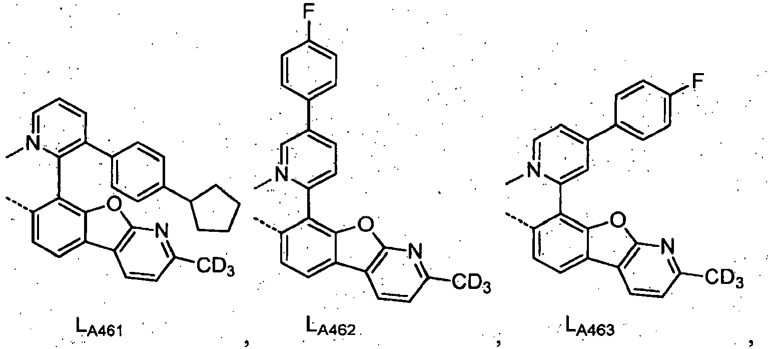

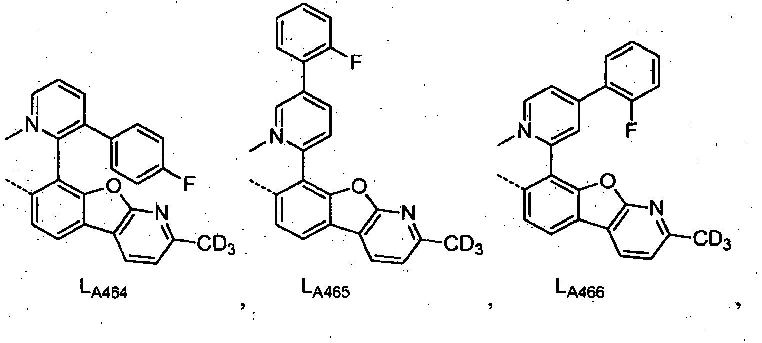

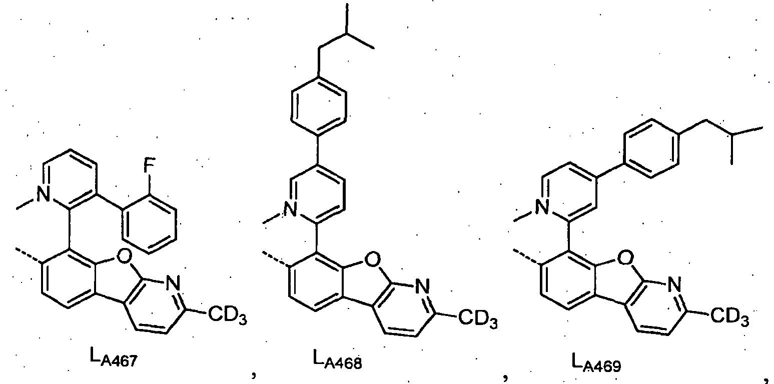

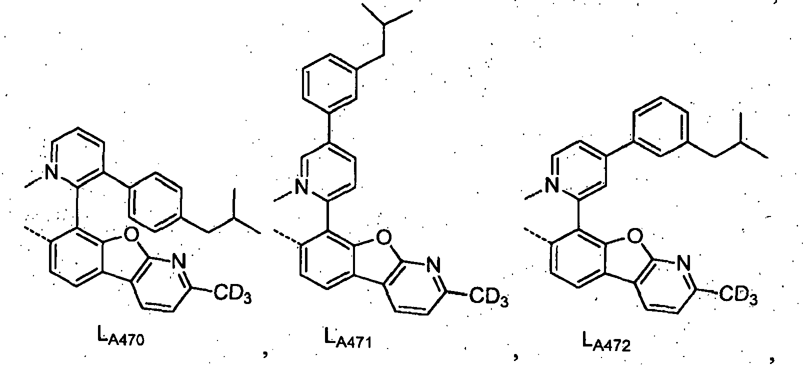

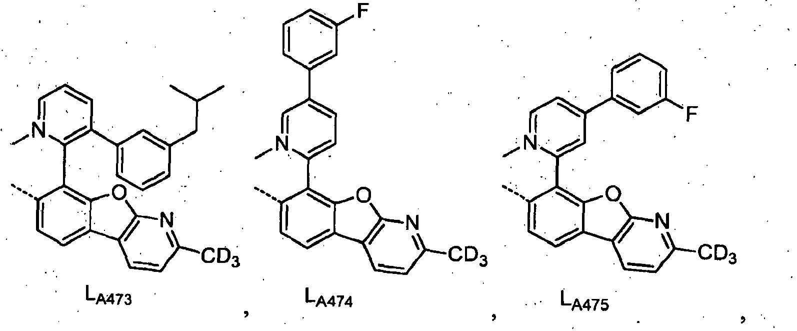

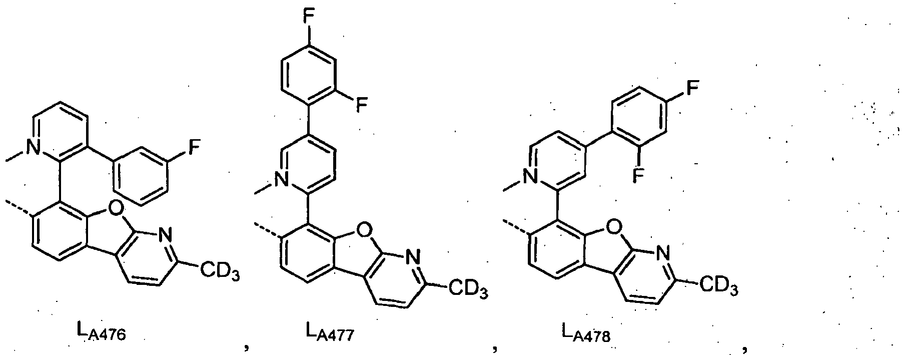

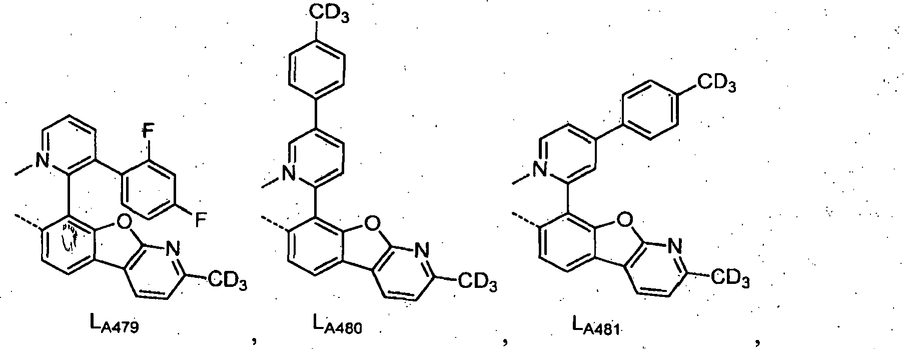

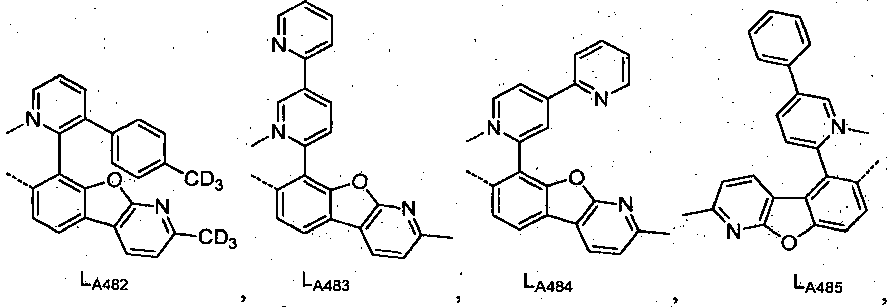

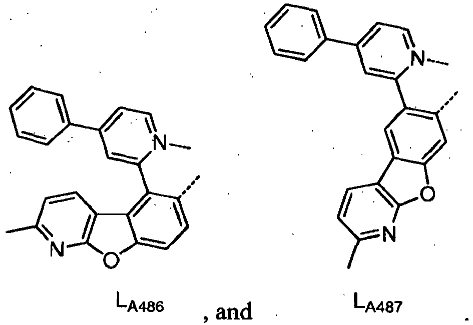

In another enbodiment, in the compound of Formula: I, L_{A} is selected from the group consisting of

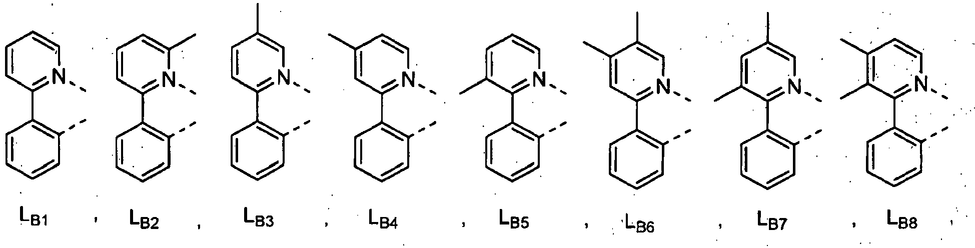

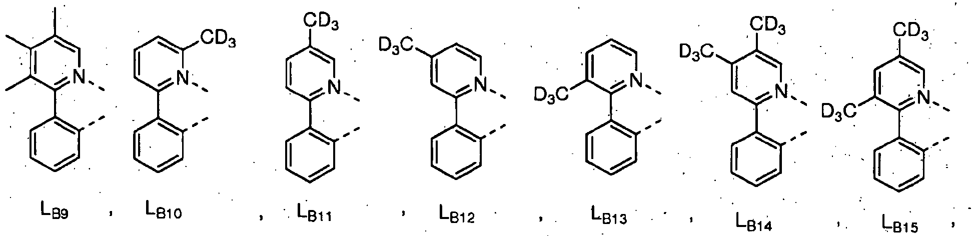

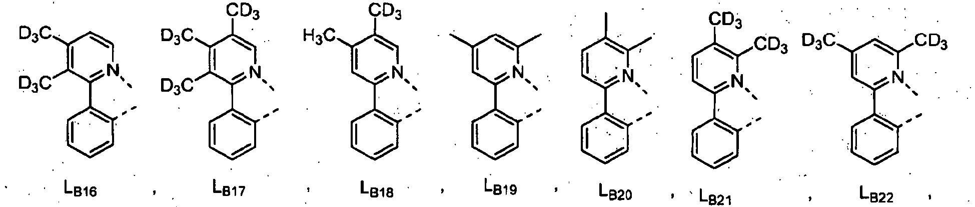

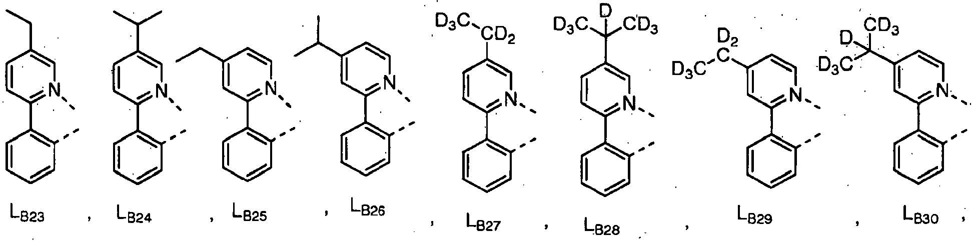

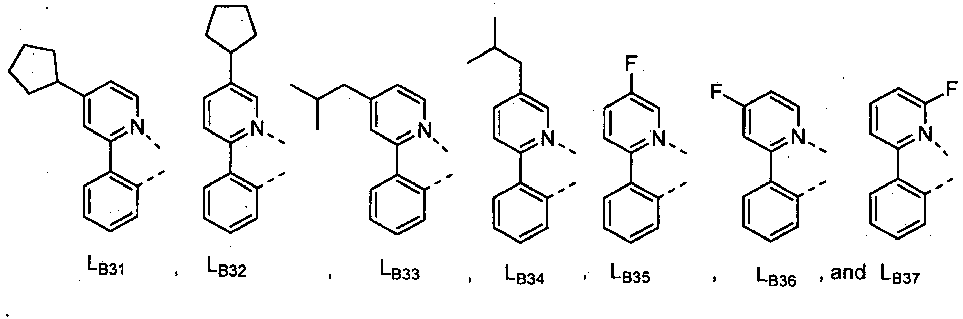

In one embodiment, the compound of formula Ir(L_{A})(L_{B})₂ has one of the the formulas listed in the table below:

| Compound Number | L_{A} | L_{B} | Compound Number | L_{A} | L_{B} | Compound Number | L_{A} | L_{B} | Compound Number | L_{A} | L_{B} |
|---|---|---|---|---|---|---|---|---|---|---|---|
| III-1 | L_{A318} | L_{B1} | III-1574 | L_{A361} | L_{B10} | III-3147 | L_{A404} | L_{B19} | III-4720 | L_{A447} | L_{B28} |
| III-2 | L_{A319} | L_{B1} | III-1575 | L_{A362} | L_{B10} | III-3148 | L_{A405} | L_{B19} | III-4721 | L_{A448} | L_{B28} |
| III-3 | L_{A320} | L_{B1} | III-1576 | L_{A363} | L_{B10} | III-3149 | L_{A406} | L_{B19} | III-4722 | L_{A449} | L_{B28} |
| III-4 | L_{A321} | L_{B1} | III-1577 | L_{A364} | L_{B10} | III-3150 | L_{A407} | L_{B19} | III-4723 | L_{A450} | L_{B28} |
| III-5 | L_{A322} | L_{B1} | III-1578 | L_{A365} | L_{B10} | III-3151 | L_{A408} | L_{B19} | III-4724 | L_{A451} | L_{B28} |
| III-6 | L_{A323} | L_{B1} | III-1579 | L_{A366} | L_{B10} | III-3152 | L_{A409} | L_{B19} | III-4725 | L_{A452} | L_{B28} |
| III-7 | L_{A324} | L_{B1} | III-1580 | L_{A367} | L_{B10} | III-3153 | L_{A420} | L_{B19} | III-4726 | L_{A453} | L_{B28} |
| III-8 | L_{A325} | L_{B1} | III-1581 | L_{A368} | L_{B10} | III-3154 | L_{A411} | L_{B19} | III-4727 | L_{A454} | L_{B28} |
| III-9 | L_{A326} | L_{B1} | III-1582 | L_{A369} | L_{B10} | III-3155 | L_{A412} | L_{B19} | III-4728 | L_{A455} | L_{B28} |
| III-10 | L_{A327} | L_{B1} | III-1583 | L_{A370} | L_{B10} | III-3156 | L_{A413} | L_{B19} | 111-4729 | L_{A456} | L_{B28} |
| III-11 | L_{A328} | L_{B1} | III-1584 | L_{A371} | L_{B10} | III-3157 | L_{A414} | L_{B19} | III-4730 | L_{A457} | L_{B28} |
| III-12 | L_{A329} | L_{B1} | III-1585 | L_{A372} | L_{B10} | III-3158 | L_{A415} | L_{B19} | III-4731 | L_{A458} | L_{B28} |
| III-13 | L_{A330} | L_{B1} | III-1586 | L_{A373} | L_{B10} | III-3159 | L_{A416} | L_{B19} | III-4732 | L_{A459} | L_{B28} |
| III-14 | L_{A331} | L_{B1} | III-1587 | L_{A374} | L_{B10} | III-3160 | L_{A417} | L_{B19} | III-4733 | L_{A460} | L_{B28} |
| III-15 | L_{A332} | L_{B1} | III-1588 | L_{A375} | L_{B10} | III-3161 | L_{A418} | L_{B19} | III-4734 | L_{A461} | L_{B28} |
| III-16 | L_{A333} | L_{B1} | III-1589 | L_{A376} | L_{B10} | III-3162 | L_{A419} | L_{B19} | III-4735 | L_{A462} | L_{B28} |
| III-17 | L_{A334} | L_{B1} | III-1590 | L_{A377} | L_{B10} | III-3163 | L_{A420} | L_{B19} | III-4736 | L_{A463} | L_{B28} |
| III-18 | L_{A335} | L_{B2} | III-1591 | L_{A378} | L_{B10} | III-3164 | L_{A421} | L_{B19} | III-4737 | L_{A464} | L_{B28} |
| III-19 | L_{A336} | L_{B1} | III-1592 | L_{A379} | L_{B10} | III-3165 | L_{A422} | L_{B19} | III-4738 | L_{A465} | L_{B28} |
| III-20 | L_{A3A7} | L_{B1} | III-1593 | L_{A380} | L_{B10} | III-3166 | L_{A423} | L_{B19} | III-4739 | L_{A466} | L_{B28} |
| III-21 | L_{A338} | L_{B1} | III-1594 | L_{A381} | L_{B10} | III-3167 | L_{A424} | L_{B19} | III-4740 | L_{A467} | L_{B28} |
| III-22 | L_{A339} | L_{B1} | III-1595 | L_{A382} | L_{B10} | III-3168 | L_{A425} | L_{B19} | III-4741 | L_{A468} | L₈₂₈ |
| III-23 | L_{A340} | L_{B1} | III-1596 | L_{A383} | L_{B10} | III-3169 | L_{A426} | L_{B19} | III-4742 | L_{A469} | L_{B28} |
| III-24 | L_{A341} | L_{B1} | III-1597 | L_{A384} | L_{B10} | III-3170 | L_{A427} | L_{B19} | III-4743 | L_{A470} | L_{B28} |
| III-25 | L_{A342} | L_{B1} | III-1598 | L_{A385} | L_{B10} | III-3171 | L_{A428} | L_{B19} | III-4744 | L_{A471} | L_{B28} |
| III-26 | L_{A343} | L_{B1} | III-1599 | L_{A386} | L_{B10} | 111-3172 | L_{A429} | L_{B19} | III-4745 | L_{A472} | L_{B28} |
| III-27 | L_{A344} | L_{B1} | III-1600 | L_{A387} | L_{B10} | III-3173 | L_{A430} | L_{B19} | III-4746 | L_{A473} | L_{B28} |
| III-28 | L_{A345} | L_{B1} | III-1601 | L_{A388} | L_{B10} | III-3174 | L_{A431} | L_{B19} | III-4747 | L_{A474} | L_{B28} |
| III-29 | L_{A346} | L_{B1} | III-1602 | L_{A389} | L_{B10} | III-3175 | L_{A432} | L_{B19} | III-4748 | L_{A475} | L_{B28} |
| III-30 | L_{A347} | L_{B1} | III-1603 | L_{A390} | L_{B10} | III-3176 | L_{A433} | L_{B19} | III-4749 | L_{A476} | L_{B28} |
| III-31 | L_{A348} | L_{B1} | III-1604 | L_{A391} | L_{B10} | III-3177 | L_{A434} | L_{B19} | III-4750 | L_{A477} | L_{B28} |
| III-32 | L_{A349} | L_{B1} | III-1605 | L_{A392} | L_{B10} | III-3178 | L_{A435} | L_{B19} | III-4751 | L_{A478} | L_{B28} |
| III-33 | L_{A350} | L_{B1} | III-1606 | L_{A393} | L_{B10} | III-3179 | L_{A436} | L_{B19} | III-4752 | L_{A479} | L_{B28} |
| III-34 | L_{A351} | L_{B1} | III-1607 | L_{A394} | L_{B10} | III-3180 | L_{A437} | L_{B19} | III-4753 | L_{A480} | L_{B28} |
| III-35 | L_{A352} | L_{B3} | III-1608 | L_{A395} | L_{B10} | III-3181 | L_{A438} | L_{B19} | III-4754 | L_{A481} | L_{B28} |
| III-36 | L_{A353} | L_{B1} | III-1609 | L_{A396} | L_{B10} | III-3182 | L_{A439} | L_{B19} | III-4755 | L_{A482} | L_{B28} |
| III-37 | L_{A354} | L_{B1} | III-1610 | L_{A397} | L_{B10} | III-3183 | L_{A440} | L_{B19} | III-4756 | L_{A483} | L_{B28} |
| III-38 | L_{A355} | L_{B1} | III-1611 | L_{A398} | L_{B10} | III-3184 | L_{A441} | L_{B1} | III-4757 | L_{A484} | L_{B28} |
| III-39 | L_{A356} | L_{B1} | III-1612 | L_{A399} | L_{B10} | III-3185 | L_{A442} | L_{B19} | III-4758 | L_{A485} | L_{B28} |
| III-40 | L_{A357} | L_{B1} | III-1613 | L_{A400} | L_{B10} | III-3186 | L_{A443} | L_{B19} | III-4759 | L_{A486} | L_{B28} |
| III-41 | L_{A358} | L_{B1} | III-1614 | L_{A401} | L_{B10} | III-3187 | L_{A444} | L_{B19} | III-4760 | L_{A487} | L_{B28} |
| III-42 | L_{A359} | L_{B1} | III-1615 | L_{A402} | L_{B10} | III-3188 | L_{A445} | L_{B19} | III-4761 | L_{A318} | L_{B29} |
| III-43 | L_{A360} | L_{B1} | III-1616 | L_{A403} | L_{B10} | III-3189 | L_{A446} | L_{B19} | III-4762 | L_{A319} | L_{B29} |
| III-44 | L_{A361} | L_{B1} | III-1617 | L_{A404} | L_{B10} | III-3190 | L_{A447} | L_{B19} | III-4763 | L_{A320} | L_{B29} |
| III-45 | L_{A362} | L_{B1} | III-1618 | L_{A405} | L_{B10} | III-3191 | L_{A448} | L_{B19} | III-4764 | L_{A321} | L_{B29} |
| III-46 | L_{A363} | L_{B1} | III-1619 | L_{A406} | L_{B10} | III-3192 | L_{A449} | L_{B19} | III-4765 | L_{A322} | L_{B29} |
| III-47 | L_{A364} | L_{B1} | III-1620 | L_{A407} | L_{B10} | III-3193 | L_{A450} | L_{B19} | III-4766 | L_{A323} | L_{B29} |
| III-48 | L_{A365} | L_{B1} | III-1621 | L_{A408} | L_{B10} | III-3194 | L_{A451} | L_{B19} | III-4767 | L_{A324} | L_{B29} |
| III-49 | L_{A366} | L_{B1} | III-1622 | L_{A409} | L_{B10} | III-3195 | L_{A452} | L_{B19} | III-4768 | L_{A325} | L_{B29} |
| III-50 | L_{A367} | L_{B1} | III-1623 | L_{A410} | L_{B10} | III-3196 | L_{A453} | L_{B19} | III-4769 | L_{A326} | L_{B29} |
| III-51 | L_{A368} | L_{B1} | III-1624 | L_{A411} | L_{B10} | III-3197 | L_{A454} | L_{B19} | III-4770 | L_{A327} | L_{B29} |
| III-52 | L_{A369} | L_{B1} | III-1625 | L_{A412} | L_{B10} | III-3198 | L_{A455} | L_{B19} | III-4771 | L_{A328} | L_{B29} |
| III-53 | L_{A370} | L_{B1} | III-1626 | L_{A413} | L_{B10} | III-3199 | L_{A456} | L_{B19} | III-4772 | L_{A329} | L_{B29} |
| III-54 | L_{A371} | L_{B1} | III-1627 | L_{A414} | L_{B10} | III-3200 | L_{A457} | L_{B19} | III-4773 | L_{A330} | L_{B29} |
| III-55 | L_{A372} | L_{B1} | III-1628 | L_{A415} | L_{B10} | III-3201 | L_{A458} | L_{B19} | III-4774 | L_{A331} | L_{B29} |
| III-56 | L_{A373} | L_{B1} | III-1629 | L_{A416} | L_{B10} | III-3202 | L_{A459} | L_{B19} | III-4775 | L_{A332} | L_{B29} |
| III-57 | L_{A374} | L_{B1} | III-1630 | L_{A417} | L_{B10} | III-3203 | L_{A460} | L_{B19} | III-4776 | L_{A333} | L_{B29} |
| III-58 | L_{A375} | L_{B1} | III-1631 | L_{A418} | L_{B10} | III-3204 | L_{A461} | L_{B19} | III-4777 | L_{A334} | L_{B29} |
| III-59 | L_{A376} | L_{B1} | III-1632 | L_{A419} | L_{B10} | III-3205 | L_{A462} | L_{B19} | III-4778 | L_{A335} | L_{B29} |
| III-60 | L_{A377} | L_{B1} | III-1633 | L_{A420} | L_{B10} | III-3206 | L_{A463} | L_{B19} | III-4779 | L_{A336} | L_{B29} |
| III-61 | L_{A378} | L_{B2} | III-1634 | L_{A421} | L_{B10} | III-3207 | L_{A464} | L_{B19} | III-4780 | L_{A337} | L_{B29} |
| III-62 | L_{A379} | L_{B1} | III-1635 | L_{A422} | L_{B10} | III-3208 | L_{A465} | L_{B19} | III-4781 | L_{A338} | L_{B29} |
| III-63 | L_{A380} | L_{B1} | III-1636 | L_{A423} | L_{B10} | III-3209 | L_{A466} | L_{B19} | III-4782 | L_{A339} | L_{B29} |
| III-64 | L_{A381} | L_{B2} | III-1637 | L_{A424} | L_{B10} | III-3210 | L_{A467} | L_{B19} | III-4783 | L_{A340} | L_{B29} |
| III-65 | L_{A382} | L_{B1} | III-1638 | L_{A425} | L_{B10} | III-3211 | L_{A468} | L_{B19} | III-4784 | L_{A341} | L_{B29} |
| III-66 | L_{A383} | L_{B1} | III-1639 | L_{A426} | L_{B10} | III-3212 | L_{A469} | L_{B19} | III-4785 | L_{A342} | L_{B29} |
| III-67 | L_{A384} | L_{B1} | III-1640 | L_{A427} | L_{B10} | III-3213 | L_{A470} | L_{B19} | III-4786 | L_{A343} | L_{B29} |
| III-68 | L_{A385} | L_{B1} | III-1641 | L_{A428} | L_{B10} | III-3214 | L_{A471} | L_{B19} | III-4787 | L_{A344} | L_{B29} |
| III-69 | L_{A386} | L_{B1} | III-1642 | L_{A429} | L_{B10} | III-3215 | L_{A472} | L_{B79} | III-4788 | L_{A345} | L_{B29} |
| III-70 | L_{A387} | L_{B1} | III-1643 | L_{A430} | L_{B10} | III-3216 | L_{A473} | L_{B19} | III-4789 | L_{A346} | L_{B29} |
| III-71 | L_{A388} | L_{B1} | III-1644 | L_{A431} | L_{B10} | III-3217 | L_{A474} | L_{B19} | III-4790 | L_{A347} | L_{B29} |
| III-72 | L_{A389} | L_{B1} | III-1645 | L_{A432} | L_{B10} | III-3218 | L_{A475} | L_{B19} | III-4791 | L_{A348} | L_{B29} |
| III-73 | L_{A390} | L_{B1} | III-1646 | L_{A433} | L_{B10} | III-3219 | L_{A476} | L_{B19} | III-4792 | L_{A349} | L_{B29} |
| III-74 | L_{A391} | L_{B1} | III-1647 | L_{A434} | L_{B10} | III-3220 | L_{A477} | L_{B19} | III-4793 | L_{A350} | L_{B29} |
| III-75 | L_{A392} | L_{B1} | III-1648 | L_{A435} | L_{B10} | III-3221 | L_{A478} | L_{B19} | III-4794 | L_{A351} | L_{B29} |
| III-76 | L_{A393} | L_{B1} | III-1649 | L_{A436} | L_{B10} | III-3222 | L_{A479} | L_{B19} | III-4795 | L_{A352} | L_{B29} |
| III-77 | L_{A394} | L_{B1} | III-1650 | L_{A437} | L_{B10} | III-3223 | L_{A480} | L_{B19} | III-4796 | L_{A353} | L_{B29} |
| III-78 | L_{A395} | L_{B1} | III-1651 | L_{A438} | L_{B10} | III-3224 | L_{A481} | L_{B29} | III-4797 | L_{A354} | L_{B29} |
| 111-79 | L_{A396} | L_{B1} | III-1652 | L_{A439} | L_{B10} | III-3225 | L_{A482} | L_{B19} | III-4798 | L_{A355} | L_{B29} |
| III-80 | L_{A397} | L_{B1} | III-1653 | L_{A440} | L_{B10} | I II-3226 | L_{A483} | L_{B19} | III-4799 | L_{A356} | L_{B29} |
| III-81 | L_{A398} | L_{B1} | 111-1654 | L_{A441} | L_{B10} | III-3227 | L_{A484} | L_{B19} | III-4800 | L_{A357} | L_{B29} |
| III-82 | L_{A399} | L_{B1} | III-1655 | L_{A442} | L_{B10} | III-3228 | L_{A485} | L_{B19} | III-4801 | L_{A358} | L_{B29} |
| III-83 | L_{A400} | L_{B1} | III-1656 | L_{A443} | L_{B10} | III-3229 | L_{A486} | L_{B19} | III-4802 | L_{A359} | L_{B29} |
| III-84 | L_{A401} | L_{B1} | III-1657 | L_{A444} | L_{B10} | III-3230 | L_{A487} | L_{B19} | III-4803 | L_{A360} | L_{B29} |
| III-85 | L_{A402} | L_{B1} | III-1658 | L_{A445} | L_{B10} | III-3231 | L_{A318} | L_{B20} | III-4804 | L_{A361} | L_{B29} |
| III-86 | L_{A403} | L_{B1} | III-1659 | L_{A446} | L_{B10} | III-3232 | L_{A319} | L_{B20} | III-4805 | L_{A362} | L_{B29} |
| III-87 | L_{A404} | L_{B1} | III-1660 | L_{A447} | L_{B10} | III-3233 | L_{A320} | L_{B20} | III-4806 | L_{A363} | L_{B29} |
| III-88 | L_{A405} | L_{B1} | III-1661 | L_{A448} | L_{B10} | III-3234 | L_{A321} | L_{B20} | III-4807 | L_{A364} | L_{B29} |
| III-89 | L_{A406} | L_{B1} | III-1662 | L_{A449} | L_{B10} | III-3235 | L_{A322} | L_{B20} | III-4808 | L_{A365} | L_{B29} |
| III-90 | L_{A407} | L_{B1} | III-1663 | L_{A450} | L_{B10} | III-3236 | L_{A323} | L_{B20} | III-4809 | L_{A366} | L_{B29} |
| III-91 | L_{A408} | L_{B1} | III-1664 | L_{A451} | L_{B10} | III-3237 | L_{A324} | L_{B20} | III-4810 | L_{A367} | L_{B29} |
| III-92 | L_{A409} | L_{B1} | III-1665 | L_{A452} | L_{B10} | III-3238 | L_{A325} | L_{B20} | III-4811 | L_{A368} | L_{B29} |
| III-93 | L_{A410} | L_{B1} | III-1666 | L_{A453} | L_{B10} | III-3239 | L_{A326} | L_{B20} | III-4812 | L_{A369} | L_{B29} |
| III-94 | L_{A411} | L_{B1} | III-1667 | L_{A454} | L_{B10} | III-3240 | L_{A327} | L_{B20} | III-4813 | L_{A370} | L_{B29} |
| III-95 | L_{A412} | L_{B1} | III-1668 | L_{A455} | L_{B10} | III-3241 | L_{A328} | L_{B20} | III-4814 | L_{A371} | L_{B29} |
| III-96 | L_{A413} | L_{B1} | III-1669 | L_{A456} | L_{B10} | III-3242 | L_{A329} | L_{B20} | III-4815 | L_{A372} | L_{B29} |
| III-97 | L_{A414} | L_{B1} | III-1670 | L_{A457} | L_{B10} | III-3243 | L_{A330} | L_{B20} | III-4816 | L_{A373} | L_{B29} |
| III-98 | L_{A415} | L_{B1} | III-1671 | L_{A458} | L_{B10} | III-3244 | L_{A331} | L_{B20} | III-4817 | L_{A374} | L_{B29} |
| III-99 | L_{A416} | L_{B1} | III-1672 | L_{A459} | L_{B10} | III-3245 | L_{A332} | L_{B20} | III-4818 | L_{A375} | L_{B29} |
| III-100 | L_{A417} | L_{B1} | III-1673 | L_{A460} | L_{B10} | III-3246 | L_{A333} | L_{B20} | III-4819 | L_{A376} | L_{B29} |
| III-101 | L_{A418} | L_{B1} | III-1674 | L_{A461} | L_{B10} | III-3247 | L_{A334} | L_{B20} | III-4820 | L_{A377} | L_{B29} |
| III-102 | L_{A419} | L_{B1} | III-1675 | L_{A462} | L_{B10} | III-3248 | L_{A335} | L_{B20} | III-4821 | L_{A378} | L_{B29} |
| III-103 | L_{A420} | L_{B1} | III-1676 | L_{A463} | L_{B10} | III-3249 | L_{A336} | L_{B20} | III-4822 | L_{A379} | L_{B29} |
| III-104 | L_{A421} | L_{B1} | III-1677 | L_{A464} | L_{B10} | III-3250 | L_{A337} | L_{B20} | III-4823 | L_{A380} | L_{B29} |
| III-105 | L_{A422} | L_{B1} | III-1678 | L_{A465} | L_{B10} | III-3251 | L_{A338} | L_{B20} | III-4824 | L_{A381} | L_{B29} |
| III-106 | L_{A423} | L_{B1} | III-1679 | L_{A466} | L_{B10} | III-3252 | L_{A339} | L_{B20} | III-4825 | L_{A382} | L_{B29} |
| III-107 | L_{A424} | L_{B1} | III-1680 | L_{A467} | L_{B10} | III-3253 | L_{A340} | L_{B20} | III-4826 | L_{A383} | L_{B29} |
| III-108 | L_{A425} | L_{B1} | III-1681 | L_{A468} | L_{B10} | III-3254 | L_{A341} | L_{B20} | III-4827 | L_{A384} | L_{B29} |
| III-109 | L_{A426} | L_{B1} | III-1682 | L_{A469} | L_{B10} | III-3255 | L_{A342} | L_{B20} | III-4828 | L_{A385} | L_{B29} |
| III-110 | L_{A427} | L_{B1} | III-1683 | L_{A470} | L_{B10} | III-3256 | L_{A343} | L_{B20} | III-4829 | L_{A386} | L_{B29} |
| III-111 | L_{A428} | L_{B1} | III-1684 | L_{A471} | L_{B10} | III-3257 | L_{A344} | L_{B20} | III-4830 | L_{A387} | L_{B29} |
| III-112 | L_{A429} | L_{B1} | III-1685 | L_{A472} | L_{B10} | III-3258 | L_{A345} | L_{B20} | III-4831 | L_{A388} | L_{B29} |
| III-113 | L_{A430} | L_{B1} | III-1686 | L_{A473} | L_{B10} | III-3259 | L_{A346} | L_{B20} | III-4832 | L_{A389} | L_{B29} |
| III-114 | L_{A431} | L_{B1} | III-1687 | L_{A474} | L_{B10} | III-3260 | L_{A347} | L_{B20} | III-4833 | L_{A390} | L_{B29} |
| III-115 | L_{A432} | L_{B1} | III-1688 | L_{A475} | L_{B10} | III-3261 | L_{A384} | L_{B20} | III-4834 | L_{A391} | L_{B29} |
| III-116 | L_{A433} | L_{B1} | III-1689 | L_{A476} | L_{B10} | III-3262 | L_{A349} | L_{B20} | III-4835 | L_{A392} | L_{B29} |
| III-117 | L_{A434} | L_{B1} | III-1690 | L_{A477} | L_{B10} | III-3263 | L_{A350} | L_{B20} | III-4836 | L_{A393} | L_{B29} |
| III-118 | L_{A435} | L_{B1} | III-1691 | L_{A478} | L_{B10} | III-3264 | L_{A351} | L_{B20} | III-4837 | L_{A394} | L_{B29} |
| III-119 | L_{A436} | L_{B1} | III-1692 | L_{A479} | L_{B10} | III-3265 | L_{A352} | L_{B20} | III-4838 | L_{A395} | L_{B29} |
| III-120 | L_{A437} | L_{B1} | III-1693 | L_{A480} | L_{B10} | III-3266 | L_{A353} | L_{B20} | III-4839 | L_{A396} | L_{B29} |
| III-121 | L_{A438} | L_{B1} | III-1694 | L_{A481} | L_{B10} | III-3267 | L_{A354} | L_{B20} | III-4840 | L_{A397} | L_{B29} |
| III-122 | L_{A439} | L_{B1} | III-1695 | L_{A482} | L_{B10} | III-3268 | L_{A355} | L_{B20} | III-4841 | L_{A398} | L_{B29} |
| III-123 | L_{A440} | L_{B1} | III-1696 | L_{A483} | L_{B10} | III-3269 | L_{A356} | L_{B20} | III-4842 | L_{A399} | L_{B29} |
| III-124 | L_{A441} | L_{B1} | III-1697 | L_{A484} | L_{B10} | III-3270 | L_{A357} | L_{B20} | III-4843 | L_{A400} | L_{B29} |
| III-125 | L_{A442} | L_{B1} | III-1698 | L_{A485} | L_{B10} | III-3271 | L_{A358} | L_{B20} | III-4844 | L_{A401} | L_{B29} |
| III-126 | L_{A443} | L_{B1} | III-1699 | L_{A486} | L_{B10} | III-3272 | L_{A359} | L_{B20} | III-4845 | L_{A402} | L_{B29} |
| III-127 | L_{A444} | L_{B1} | III-1700 | L_{A487} | L_{B10} | III-3273 | L_{A360} | L_{B20} | III-4846 | L_{A403} | L_{B29} |
| III-128 | L_{A445} | L_{B1} | III-1701 | L_{A318} | L_{B11} | III-3274 | L_{A361} | L_{B20} | III-4847 | L_{A404} | L_{B29} |
| III-129 | L_{A446} | L_{B1} | III-1702 | L_{A319} | L_{B11} | III-3275 | L_{A362} | L_{B20} | III-4848 | L_{A405} | L_{B29} |
| III-130 | L_{A447} | L_{B1} | III-1703 | L_{A320} | L_{B11} | III-3276 | L_{A363} | L_{B20} | III-4849 | L_{A406} | L_{B29} |
| III-131 | L_{A448} | L_{B1} | III-1704 | L_{A321} | L_{B11} | III-3277 | L_{A364} | L_{B20} | III-4850 | L_{A407} | L_{B29} |
| III-132 | L_{A449} | L_{B1} | III-1705 | L_{A322} | L_{B11} | III-3278 | L_{A365} | L_{B20} | III-4851 | L_{A408} | L_{B29} |
| III-133 | L_{A450} | L_{B1} | III-1706 | L_{A323} | L_{B11} | III-3279 | L_{A366} | L_{B20} | III-4852 | L_{A409} | L_{B29} |
| III-134 | L_{A4S1} | L_{B1} | III-1707 | L_{A324} | L_{B21} | III-3280 | L_{A367} | L_{B20} | III-4853 | L_{A410} | L_{B29} |
| III-135 | L_{A452} | L_{B1} | III-1708 | L_{A325} | L_{B11} | III-3281 | L_{A368} | L_{B20} | III-4854 | L_{A411} | L_{B29} |
| III-136 | L_{A453} | L_{B1} | III-1709 | L_{A326} | L_{B11} | III-3282 | L_{A369} | L_{B20} | III-4855 | L_{A412} | L_{B29} |
| III-137 | L_{A454} | L_{B1} | III-1710 | L_{A327} | L_{B11} | III-3283 | L_{A370} | L_{B20} | III-4856 | L_{A413} | L_{B29} |
| III-138 | L_{A455} | L_{B1} | III-1711 | L_{A328} | L_{B11} | III-3284 | L_{A371} | L_{B20} | III-4857 | L_{A414} | L_{B29} |
| III-139 | L_{A456} | L_{B1} | III-1712 | L_{A329} | L_{B11} | III-3285 | L_{A372} | L_{B20} | III-4858 | L_{A415} | L_{B29} |
| III-140 | L_{A457} | L_{B1} | III-1713 | L_{A330} | L_{B11} | III-3286 | L_{A373} | L_{B20} | III-4859 | L_{A416} | L_{B29} |
| III-141 | L_{A458} | L_{B1} | III-1714 | L_{A331} | L_{B11} | III-3287 | L_{A374} | L₈₂₀ | III-4860 | L_{A417} | L_{B29} |
| III-142 | L_{A459} | L_{B1} | III-1715 | L_{A332} | L_{B11} | III-3288 | L_{A375} | L_{B20} | III-4861 | L_{A418} | L_{B29} |
| III-143 | L_{A460} | L_{B1} | III-1716 | L_{A333} | L_{B11} | III-3289 | L_{A376} | L_{B20} | III-4862 | L_{A419} | L_{B29} |
| III-144 | L_{A461} | L_{B1} | III-1717 | L_{A334} | L_{B11} | III-3290 | L_{A377} | L_{B20} | III-4863 | L_{A420} | L_{B29} |
| III-145 | L_{A462} | L_{B1} | III-1718 | L_{A335} | L_{B11} | III-3291 | L_{A378} | L_{B20} | III-4864 | L_{A421} | L_{B29} |
| III-146 | L_{A463} | L_{B1} | III-1719 | L_{A336} | L_{B11} | III-3292 | L_{A379} | L_{B20} | III-4865 | L_{A422} | L_{B29} |
| III-147 | L_{A464} | L_{B1} | III-1720 | L_{A337} | L_{B11} | III-3293 | L_{A380} | L_{B20} | III-4866 | L_{A423} | L_{B29} |
| III-148 | L_{A465} | L_{B1} | III-1721 | L_{A338} | L_{B11} | III-3294 | L_{A381} | L_{B20} | III-4867 | L_{A424} | L_{B29} |
| III-149 | L_{A466} | L_{B1} | III-1722 | L_{A339} | L_{B11} | III-3295 | L_{A382} | L_{B20} | III-4868 | L_{A425} | L_{B29} |
| III-150 | L_{A467} | L_{B1} | III-1723 | L_{A340} | L_{B11} | III-3296 | L_{A383} | L_{B20} | III-4869 | L_{A426} | L_{B29} |
| III-151 | L_{A468} | L_{B1} | III-1724 | L_{A341} | L_{B11} | III-3297 | L_{A384} | L_{B20} | III-4870 | L_{A427} | L_{B29} |
| III-152 | L_{A469} | L_{B1} | III-1725 | L_{A342} | L_{B11} | III-3298 | L_{A385} | L_{B20} | III-4871 | L_{A428} | L_{B29} |
| III-153 | L_{A470} | L_{B1} | III-1726 | L_{A343} | L_{B11} | III-3299 | L_{A386} | L_{B20} | III-4872 | L_{A429} | L_{B29} |
| III-154 | L_{A471} | L_{B1} | III-1727 | L_{A344} | L_{B11} | III-3300 | L_{A387} | L_{B20} | III-4873 | L_{A430} | L_{B29} |
| III-155 | L_{A472} | L_{B1} | III-1728 | L_{A345} | L_{B11} | III-3301 | L_{A388} | L_{B20} | III-4874 | L_{A431} | L_{B29} |
| III-156 | L_{A473} | L_{B1} | III-1729 | L_{A346} | L_{B11} | III-3302 | L_{A389} | L_{B20} | III-4875 | L_{A432} | L_{B29} |
| III-157 | L_{A474} | L_{B1} | III-1730 | L_{A347} | L_{B11} | III-3303 | L_{A390} | L_{B20} | III-4876 | L_{A433} | L_{B29} |
| III-158 | L_{A475} | L_{B1} | III-1731 | L_{A348} | L_{B11} | III-3304 | L_{A391} | L_{B20} | III-4877 | L_{A434} | L_{B29} |
| III-159 | L_{A476} | L_{B1} | III-1732 | L_{A349} | L_{B11} | III-3305 | L_{A392} | L_{B20} | III-4878 | L_{A435} | L_{B29} |
| III-160 | L_{A477} | L_{B1} | III-1733 | L_{A350} | L_{B11} | III-3306 | L_{A393} | L_{B20} | III-4879 | L_{A436} | L_{B29} |
| III-161 | L_{A478} | L_{B1} | III-1734 | L_{A351} | L_{B11} | III-3307 | L_{A394} | L_{B20} | III-4880 | L_{A437} | L_{B29} |
| III-162 | L_{A479} | L_{B1} | III-1735 | L_{A352} | L_{B11} | III-3308 | L_{A395} | L_{B20} | III-4881 | L_{A438} | L_{B29} |
| III-163 | L_{A480} | L_{B1} | III-1736 | L_{A353} | L_{B11} | III-3309 | L_{A396} | L_{B20} | III-4882 | L_{A439} | L_{B29} |
| III-164 | L_{A481} | L_{B1} | III-1737 | L_{A354} | L_{B11} | III-3310 | L_{A397} | L_{B20} | III-4883 | L_{A440} | L_{B29} |
| III-165 | L_{A482} | L_{B1} | III-1738 | L_{A355} | L_{B11} | III-3311 | L_{A398} | L_{B20} | III-4884 | L_{A441} | L_{B29} |
| III-166 | L_{A483} | L_{B1} | III-1739 | L_{A356} | L_{B11} | III-3312 | L_{A399} | L_{B20} | III-4885 | L_{A442} | L_{B29} |
| III-167 | L_{A484} | L_{B1} | III-1740 | L_{A357} | L_{B11} | III-3313 | L_{A400} | L_{B20} | III-4886 | L_{A443} | L_{B29} |
| III-168 | L_{A485} | L_{B1} | III-1741 | L_{A358} | L_{B11} | III-3314 | L_{A401} | L_{B20} | III-4887 | L_{A444} | L_{B29} |
| III-169 | L_{A486} | L_{B1} | III-1742 | L_{A359} | L_{B11} | III-3315 | L_{A402} | L_{B20} | III-4888 | L_{A445} | L_{B29} |
| III-170 | L_{A487} | L_{B1} | III-1743 | L_{A360} | L_{B11} | III-3316 | L_{A403} | L_{B20} | III-4889 | L_{A446} | L_{B29} |
| III-171 | L_{A318} | L_{B2} | III-1744 | L_{A361} | L_{B11} | III-3317 | L_{A404} | L_{B20} | III-4890 | L_{A447} | L_{B29} |
| III-172 | L_{A319} | L_{B2} | III-1745 | L_{A362} | L_{B11} | III-3318 | L_{A405} | L_{B20} | III-4891 | L_{A448} | L_{B29} |
| III-173 | L_{A320} | L_{B2} | III-1746 | L_{A363} | L_{B11} | III-3319 | L_{A406} | L_{B20} | III-4892 | L_{A449} | L_{B29} |
| III-174 | L_{A321} | L_{B2} | III-1747 | L_{A364} | L_{B11} | III-3320 | L_{A407} | L_{B20} | III-4893 | L_{A450} | L_{B29} |
| III-175 | L_{A322} | L_{B2} | III-1748 | L_{A365} | L_{B11} | III-3321 | L_{A408} | L_{B20} | III-4894 | L_{A451} | L_{B29} |
| III-176 | L_{A323} | L_{B2} | III-1749 | L_{A366} | L_{B11} | III-3322 | L_{A409} | L_{B20} | III-4895 | L_{A452} | L_{B29} |
| III-177 | L_{A324} | L_{B2} | III-1750 | L_{A367} | L_{B11} | III-3323 | L_{A410} | L_{B20} | III-4896 | L_{A453} | L_{B29} |
| III-178 | L_{A325} | L_{B2} | III-1751 | L_{A368} | L_{B11} | III-3324 | L_{A411} | L_{B20} | III-4897 | L_{A454} | L_{B29} |
| III-179 | L_{A326} | L_{B2} | III-1752 | L_{A369} | L_{B11} | III-3325 | L_{A412} | L_{B20} | III-4898 | L_{A455} | L_{B29} |
| III-180 | L_{A327} | L_{B2} | III-1753 | L_{A370} | L_{B11} | III-3326 | L_{A413} | L_{B20} | III-4899 | L_{A456} | L_{B29} |
| III-181 | L_{A328} | L_{B2} | III-1754 | L_{A371} | L_{B11} | III-3327 | L_{A414} | L_{B20} | III-4900 | L_{A457} | L_{B29} |
| III-182 | L_{A329} | L_{B2} | III-1755 | L_{A372} | L_{B11} | III-3328 | L_{A415} | L_{B20} | III-4901 | L_{A458} | L_{B29} |
| III-183 | L_{A330} | L_{B2} | III-1756 | L_{A373} | L_{B11} | III-3329 | L_{A416} | L_{B20} | III-4902 | L_{A459} | L_{B29} |
| III-184 | L_{A331} | L_{B2} | III-1757 | L_{A374} | L_{B11} | III-3330 | L_{A417} | L_{B20} | III-4903 | L_{A460} | L_{B29} |
| III-185 | L_{A332} | L_{B2} | III-1758 | L_{A375} | L_{B11} | III-3331 | L_{A418} | L_{B20} | III-4904 | L_{A461} | L_{B29} |
| III-186 | L_{A333} | L_{B2} | III-1759 | L_{A376} | L_{B11} | III-3332 | L_{A419} | L_{B20} | III-4905 | L_{A462} | L_{B29} |
| III-187 | L_{A334} | L_{B2} | III-1760 | L_{A377} | L_{B11} | III-3333 | L_{A420} | L_{B20} | III-4906 | L_{A463} | L_{B29} |
| III-188 | L_{A335} | L_{B2} | III-1761 | L_{A378} | L_{B11} | III-3334 | L_{A421} | L_{B20} | III-4907 | L_{A464} | L_{B29} |
| III-189 | L_{A336} | L_{B2} | III-1762 | L_{A379} | L_{B11} | III-3335 | L_{A422} | L_{B20} | III-4908 | L_{A465} | L_{B29} |
| III-190 | L_{A337} | L_{B2} | III-1763 | L_{A380} | L_{B11} | III-3336 | L_{A423} | L_{B20} | III-4909 | L_{A466} | L_{B29} |
| III-191 | L_{A338} | L_{B2} | III-1764 | L_{A381} | L_{B11} | III-3337 | L_{A424} | L_{B20} | III-4910 | L_{A467} | L_{B29} |
| III-192 | L_{A339} | L_{B2} | III-1765 | L_{A382} | L_{B11} | III-3338 | L_{A425} | L_{B20} | III-4911 | L_{A468} | L_{B29} |
| III-193 | L_{A340} | L_{B2} | III-1766 | L_{A383} | L_{B11} | III-3339 | L_{A426} | L_{B20} | III-4912 | L_{A469} | L_{B29} |
| III-194 | L_{A341} | L_{B2} | III-1767 | L_{A384} | L_{B11} | III-3340 | L_{A427} | L_{B20} | III-4913 | L_{A470} | L_{B29} |
| III-195 | L_{A342} | L_{B2} | III-1768 | L_{A385} | L_{B11} | III-3341 | L_{A428} | L_{B20} | III-4914 | L_{A471} | L_{B29} |
| III-196 | L_{A343} | L_{B2} | III-1769 | L_{A386} | L_{B11} | III-3342 | L_{A429} | L_{B20} | III-4915 | L_{A472} | L_{B29} |
| III-197 | L_{A344} | L_{B2} | III-1770 | L_{A387} | L_{B11} | III-3343 | L_{A430} | L_{B20} | III-4916 | L_{A473} | L_{B29} |
| III-198 | L_{A345} | L_{B2} | III-1771 | L_{A388} | L_{B11} | III-3344 | L_{A431} | L_{B20} | III-4917 | L_{A474} | L_{B29} |
| III-199 | L_{A346} | L_{B2} | III-1772 | L_{A389} | L_{B11} | III-3345 | L_{A432} | L_{B20} | III-4918 | L_{A475} | L_{B29} |
| III-200 | L_{A347} | L_{B2} | III-1773 | L_{A390} | L_{B11} | III-3346 | L_{A433} | L_{B20} | III-4919 | L_{A476} | L_{B29} |
| III-201 | L_{A348} | L_{B2} | III-1774 | L_{A391} | L_{B11} | III-3347 | L_{A434} | L_{B20} | III-4920 | L_{A477} | L_{B29} |
| III-202 | L_{A349} | L_{B2} | III-1775 | L_{A392} | L_{B11} | III-3348 | L_{A435} | L_{B20} | III-4921 | L_{A478} | L_{B29} |
| III-203 | L_{A350} | L_{B2} | III-1776 | L_{A393} | L_{B11} | III-3349 | L_{A436} | L_{B20} | III-4922 | L_{A479} | L_{B29} |
| III-204 | L_{A351} | L_{B2} | III-1777 | L_{A394} | L_{B11} | III-3350 | L_{A437} | L_{B20} | III-4923 | L_{A480} | L_{B29} |
| III-205 | L_{A352} | L_{B2} | III-1778 | L_{A395} | L_{B11} | III-3351 | L_{A438} | L_{B20} | III-4924 | L_{A481} | L_{B29} |
| III-206 | L_{A353} | L_{B2} | III-1779 | L_{A396} | L_{B11} | III-3352 | L_{A439} | L_{B20} | III-4925 | L_{A482} | L_{B29} |
| III-207 | L_{A354} | L_{B2} | III-1780 | L_{A397} | L_{B11} | III-3353 | L_{A440} | L_{B20} | III-4926 | L_{A483} | L_{B29} |
| III-208 | L_{A355} | L_{B2} | III-1781 | L_{A398} | L_{B11} | III-3354 | L_{A441} | L_{B20} | III-4927 | L_{A484} | L_{B29} |
| III-209 | L_{A356} | L_{B2} | III-1782 | L_{A399} | L_{B11} | III-3355 | L_{A442} | L_{B20} | III-4928 | L_{A485} | L_{B29} |
| III-210 | L_{A357} | L_{B2} | III-1783 | L_{A400} | L_{B11} | III-3356 | L_{A443} | L_{B20} | III-4929 | L_{A486} | L_{B29} |
| III-211 | L_{A358} | L_{B2} | III-1784 | L_{A401} | L_{B11} | III-3357 | L_{A444} | L_{B20} | III-4930 | L_{A487} | L_{B29} |
| III-212 | L_{A359} | L_{B2} | III-1785 | L_{A402} | L_{B11} | III-3358 | L_{A445} | L_{B20} | III-4931 | L_{A318} | L_{B30} |
| III-213 | L_{A360} | L_{B2} | III-1786 | L_{A603} | L_{B11} | III-3359 | L_{A446} | L_{B20} | III-4932 | L_{A319} | L_{B30} |
| III-214 | L_{A361} | L_{B2} | III-1787 | L_{A404} | L_{B11} | III-3360 | L_{A447} | L_{B20} | III-4933 | L_{A320} | L_{B30} |
| III-215 | L_{A362} | L_{B2} | III-1788 | L_{A405} | L_{B11} | III-3361 | L_{A448} | L_{B20} | III-4934 | L_{A321} | L_{B30} |
| III-216 | L_{A363} | L_{B2} | III-1789 | L_{A406} | L_{B11} | III-3362 | L_{A449} | L_{B20} | III-4935 | L_{A322} | L_{B30} |
| III-217 | L_{A364} | L_{B2} | III-1790 | L_{A407} | L_{B11} | III-3363 | L_{A450} | L_{B20} | III-4936 | L_{A323} | L_{B30} |
| III-218 | L_{A365} | L_{B2} | III-1791 | L_{A408} | L_{B11} | III-3364 | L_{A451} | L_{B20} | III-4937 | L_{A324} | L_{B30} |
| III-219 | L_{A366} | L_{B2} | III-1792 | L_{A409} | L_{B11} | III-3365 | L_{A452} | L_{B20} | III-4938 | L_{A325} | L_{B30} |
| III-220 | L_{A367} | L_{B2} | III-1793 | L_{A410} | L_{B11} | III-3366 | L_{A453} | L_{B20} | III-4939 | L_{A326} | L_{B30} |
| III-221 | L_{A368} | L_{B2} | III-1794 | L_{A411} | L_{B11} | III-3367 | L_{A454} | L_{B20} | III-4940 | L_{A327} | L_{B30} |
| III-222 | L_{A369} | L_{B2} | III-1795 | L_{A412} | L_{B11} | III-3368 | L_{A455} | L_{B20} | III-4941 | L_{A328} | L_{B30} |
| III-223 | L_{A370} | L_{B2} | III-1796 | L_{A413} | L_{B11} | III-3369 | L_{A456} | L_{B20} | III-4942 | L_{A329} | L_{B30} |
| III-224 | L_{A371} | L_{B2} | III-1797 | L_{A414} | L_{B11} | III-3370 | L_{A457} | L_{B20} | III-4943 | L_{A330} | L_{B30} |
| III-225 | L_{A372} | L_{B2} | III-1798 | L_{A415} | L_{B11} | III-3371 | L_{A458} | L_{B20} | III-4944 | L_{A331} | L_{B30} |
| III-226 | L_{A373} | L_{B2} | III-1799 | L_{A416} | L_{B11} | III-3372 | L_{A459} | L_{B20} | III-4945 | L_{A332} | L_{B30} |
| III-227 | L_{A374} | L_{B2} | III-1800 | L_{A417} | L_{B11} | III-3373 | L_{A460} | L_{B20} | III-4946 | L_{A333} | L_{B30} |
| III-228 | L_{A375} | L_{B2} | III-1801 | L_{A418} | L_{B11} | III-3374 | L_{A461} | L_{B20} | III-4947 | L_{A334} | L_{B30} |
| III-229 | L_{A376} | L_{B2} | III-1802 | L_{A419} | L_{B11} | III-3375 | L_{A462} | L_{B20} | III-4948 | L_{A335} | L_{B30} |
| III-230 | L_{A377} | L_{B2} | III-1803 | L_{A420} | L_{B11} | III-3376 | L_{A463} | L_{B20} | III-4949 | L_{A336} | L_{B30} |
| III-231 | L_{A378} | L_{B2} | III-1804 | L_{A421} | L_{B11} | III-3377 | L_{A464} | L_{B20} | III-4950 | L_{A337} | L_{B30} |
| III-232 | L_{A379} | L_{B2} | III-1805 | L_{A422} | L_{B11} | III-3378 | L_{A465} | L_{B20} | III-4951 | L_{A338} | L_{B30} |
| III-233 | L_{A380} | L_{B2} | III-1806 | L_{A423} | L_{B11} | III-3379 | L_{A466} | L_{B20} | III-4952 | L_{A339} | L_{B30} |
| III-234 | L_{A381} | L_{B2} | III-1807 | L_{A424} | L_{B11} | III-3380 | L_{A467} | L_{B20} | III-4953 | L_{A340} | L_{B30} |
| III-235 | L_{A382} | L_{B2} | III-1808 | L_{A425} | L_{B11} | III-3381 | L_{A468} | L_{B20} | III-4954 | L_{A341} | L_{B30} |
| III-236 | L_{A383} | L_{B2} | III-1809 | L_{A426} | L_{B11} | III-3382 | L_{A469} | L_{B20} | III-4955 | L_{A342} | L_{B30} |
| III-237 | L_{A384} | L_{B2} | III-1810 | L_{A427} | L_{B11} | III-3383 | L_{A470} | L_{B20} | III-4956 | L_{A343} | L_{B30} |
| III-238 | L_{A385} | L_{B2} | III-1811 | L_{A428} | L_{B11} | III-3384 | L_{A471} | L_{B20} | III-4957 | L_{A344} | L_{B30} |
| III-239 | L_{A336} | L_{B2} | III-1812 | L_{A429} | L_{B11} | III-3385 | L_{A472} | L_{B20} | III-4958 | L_{A345} | L_{B30} |
| III-240 | L_{A387} | L_{B2} | III-1813 | L_{A430} | L_{B11} | III-3386 | L_{A473} | L_{B20} | III-4959 | L_{A346} | L_{B30} |
| III-241 | L_{A388} | L_{B2} | III-1814 | L_{A431} | L_{B11} | III-3387 | L_{A474} | L_{B20} | III-4960 | L_{A347} | L_{B30} |
| III-242 | L_{A389} | L_{B2} | III-1815 | L_{A432} | L_{B11} | III-3388 | L_{A475} | L_{B20} | III-4961 | L_{A348} | L_{B30} |
| III-243 | L_{A390} | L_{B2} | III-1816 | L_{A433} | L_{B11} | III-3389 | L_{A476} | L_{B20} | III-4963 | L_{A349} | L_{B30} |
| III-244 | L_{A391} | L_{B2} | III-1817 | L_{A434} | L_{B11} | III-3390 | L_{A477} | L_{B20} | III-4963 | L_{A350} | L_{B30} |
| III-245 | L_{A392} | L_{B2} | III-1818 | L_{A435} | L_{B11} | III-3391 | L_{A478} | L_{B20} | III-4964 | L_{A351} | L_{B30} |
| III-246 | L_{A393} | L_{B2} | III-1819 | L_{A436} | L_{B11} | III-3392 | L_{A479} | L_{B20} | III-4965 | L_{A352} | L_{B30} |
| III-247 | L_{A394} | L_{B2} | III-1820 | L_{A437} | L_{B11} | III-3393 | L_{A480} | L_{B20} | III-4966 | L_{A353} | L_{B30} |
| III-248 | L_{A395} | L_{B2} | III-1821 | L_{A438} | L_{B11} | III-3394 | L_{A481} | L_{B20} | III-4967 | L_{A354} | L_{B30} |
| III-249 | L_{A396} | L_{B2} | III-1822 | L_{A439} | L_{B11} | III-3395 | L_{A482} | L_{B20} | III-4968 | L_{A355} | L_{B30} |
| III-250 | L_{A397} | L_{B2} | III-1823 | L_{A440} | L_{B11} | III-3396 | L_{A483} | L_{B20} | III-4969 | L_{A356} | L_{B30} |
| III-251 | L_{A398} | L_{B2} | III-1824 | L_{A441} | L_{B11} | III-3397 | L_{A484} | L_{B20} | III-4970 | L_{A357} | L_{B30} |
| III-252 | L_{A399} | L_{B2} | III-1825 | L_{A442} | L_{B11} | III-3398 | L_{A485} | L_{B20} | III-4971 | L_{A358} | L_{B30} |
| III-253 | L_{A400} | L_{B2} | III-1826 | L_{A443} | L_{B11} | III-3399 | L_{A486} | L_{B20} | III-4972 | L_{A359} | L_{B30} |
| III-254 | L_{A401} | L_{B2} | III-1827 | L_{A444} | L_{B11} | III-3400 | L_{A487} | L_{B20} | III-4973 | L_{A360} | L_{B30} |
| III-255 | L_{A402} | L_{B2} | III-1828 | L_{A445} | L_{B11} | III-3401 | L_{A318} | L_{B21} | III-4974 | L_{A361} | L_{B30} |
| III-256 | L_{A403} | L_{B2} | III-1829 | L_{A446} | L_{B11} | III-3402 | L_{A319} | L_{B21} | III-4975 | L_{A362} | L_{B30} |
| III-257 | L_{A404} | L_{B2} | III-1830 | L_{A447} | L_{B11} | III-3403 | L_{A320} | L_{B21} | III-4976 | L_{A363} | L_{B30} |
| III-258 | L_{A405} | L_{B2B} | III-1831 | L_{A448} | L_{B11} | III-3404 | L_{A322} | L_{B21} | III-4977 | L_{A364} | L_{B30} |
| III-259 | L_{A406} | L_{B2} | III-1832 | L_{A449} | L_{B11} | III-3405 | L_{A322} | L_{B21} | III-4978 | L_{A365} | L_{B30} |
| III-260 | L_{A407} | L_{B2} | III-1833 | L_{A450} | L_{B11} | III-3406 | L_{A323} | L_{B21} | III-4979 | L_{A366} | L_{B30} |
| III-261 | L_{A408} | L_{B2} | III-1834 | L_{A451} | L_{B11} | III-3407 | L_{A324} | L_{B21} | III-4980 | L_{A367} | L_{B30} |
| III-262 | L_{A409} | L_{B2} | III-1835 | L_{A452} | L_{B11} | III-3408 | L_{A325} | L_{B21} | III-4981 | L_{A368} | L_{B30} |
| III-263 | L_{A410} | L_{B2} | III-1836 | L_{A453} | L_{B11} | III-3409 | L_{A326} | L_{B21} | III-4982 | L_{A369} | L_{B30} |
| III-264 | L_{A411} | L_{B2} | III-1837 | L_{A454} | L_{B11} | III-3410 | L_{A327} | L_{B21} | III-4983 | L_{A370} | L_{B30} |
| III-265 | L_{A432} | L_{B2} | III-1838 | L_{A455} | L_{B11} | III-3411 | L_{A328} | L_{B21} | III-4984 | L_{A372} | L_{B30} |
| III-266 | L_{A413} | L_{B2} | III-1839 | L_{A456} | L_{B11} | III-3412 | L_{A329} | L_{B21} | III-4985 | L_{A372} | L_{B30} |
| III-267 | L_{A414} | L_{B2} | III-1840 | L_{A457} | L_{B11} | III-3413 | L_{A330} | L_{B21} | III-4986 | L_{A373} | L_{B30} |
| III-268 | L_{A415} | L_{B2} | III-1841 | L_{A458} | L_{B11} | III-3414 | L_{A331} | L_{B21} | III-4987 | L_{A374} | L_{B30} |
| III-269 | L_{A416} | L_{B2} | III-1842 | L_{A459} | L_{B11} | III-3415 | L_{A332} | L_{B21} | III-4988 | L_{A375} | L_{B30} |
| III-270 | L_{A417} | L_{B2} | III-1843 | L_{A460} | L_{B11} | III-3416 | L_{A333} | L_{B21} | III-4989 | L_{A376} | L_{B30} |
| III-271 | L_{A418} | L_{B2} | III-1844 | L_{A461} | L_{B11} | III-3417 | L_{A334} | L_{B21} | III-4990 | L_{A377} | L_{B30} |
| III-272 | L_{A419} | L_{B2} | III-1845 | L_{A462} | L_{B11} | III-3418 | L_{A335} | L_{B21} | III-4991 | L_{A378} | L_{B30} |
| III-273 | L_{A420} | L_{B2} | III-1846 | L_{A463} | L_{B11} | III-3419 | L_{A336} | L_{B21} | III-4992 | L_{A379} | L_{B30} |
| III-274 | L_{A421} | L_{B2} | III-1847 | L_{A464} | L_{B11} | III-3420 | L_{A337} | L_{B21} | III-4993 | L_{A380} | L_{B30} |
| III-275 | L_{A422} | L_{B2} | III-1848 | L_{A465} | L_{B11} | III-3421 | L_{A338} | L_{B21} | III-4994 | L_{A381} | L_{B30} |
| III-276 | L_{A423} | L_{B2} | III-1849 | L_{A466} | L_{B11} | III-3422 | L_{A339} | L_{B21} | III-4995 | L_{A382} | L_{B30} |
| III-277 | L_{A424} | L_{B2} | III-1850 | L_{A467} | L_{B11} | III-3423 | L_{A340} | L_{B21} | III-4996 | L_{A383} | L_{B30} |
| III-278 | L_{A425} | L_{B2} | III-1851 | L_{A468} | L_{B11} | III-3424 | L_{A341} | L_{B21} | III-4997 | L_{A384} | L_{B30} |
| III-279 | L_{A426} | L_{B2} | III-1852 | L_{A469} | L_{B11} | III-3425 | L_{A342} | L_{B21} | III-4998 | L_{A385} | L_{B30} |
| III-280 | L_{A427} | L_{B2} | III-1853 | L_{A470} | L_{B11} | III-3426 | L_{A343} | L_{B21} | III-4999 | L_{A386} | L_{B30} |
| III-281 | L_{A428} | L_{B2} | III-1854 | L_{A471} | L_{B11} | III-3427 | L_{A344} | L_{B21} | III-5000 | L_{A387} | L_{B30} |
| III-282 | L_{A429} | L_{B2} | III-1855 | L_{A472} | L_{B11} | III-3428 | L_{A345} | L_{B21} | III-5001 | L_{A388} | L_{B30} |
| III-283 | L_{A430} | L_{B2} | III-1856 | L_{A473} | L_{B11} | III-3429 | L_{A346} | L_{B21} | III-5002 | L_{A389} | L_{B30} |
| III-284 | L_{A431} | L_{B2} | III-1857 | L_{A474} | L_{B11} | III-3430 | L_{A347} | L_{B21} | III-5003 | L_{A390} | L_{B30} |
| III-285 | L_{A432} | L_{B2} | III-1858 | L_{A475} | L_{B11} | III-3431 | L_{A348} | L_{B21} | III-5004 | L_{A391} | L_{B30} |
| III-286 | L_{A433} | L_{B2} | III-1859 | L_{A476} | L_{B11} | III-3432 | L_{A349} | L_{B21} | III-5005 | L_{A392} | L_{B30} |
| III-287 | L_{A434} | L_{B2} | III-1860 | L_{A477} | L_{B11} | III-3433 | L_{A350} | L_{B21} | III-5006 | L_{A393} | L_{B30} |
| III-288 | L_{A435} | L_{B2} | III-1861 | L_{A478} | L_{B11} | III-3434 | L_{A351} | L_{B21} | III-5007 | L_{A394} | L_{B30} |
| III-289 | L_{A436} | L_{B2} | III-1862 | L_{A479} | L_{B11} | III-3435 | L_{A352} | L_{B21} | III-5008 | L_{A395} | L_{B30} |
| III-290 | L_{A437} | L_{B2} | III-1863 | L_{A480} | L_{B11} | III-3436 | L_{A353} | L_{B21} | III-5009 | L_{A396} | L_{B30} |
| III-291 | L_{A438} | L_{B2} | III-1864 | L_{A481} | L_{B11} | III-3437 | L_{A354} | L_{B21} | III-5010 | L_{A397} | L_{B30} |
| III-292 | L_{A439} | L_{B2} | III-1865 | L_{A482} | L_{B11} | III-3438 | L_{A355} | L_{B21} | III-5011 | L_{A398} | L_{B30} |
| III-293 | L_{A440} | L_{B2} | III-1866 | L_{A483} | L_{B11} | III-3439 | L_{A356} | L_{B21} | III-5012 | L_{A399} | L_{B30} |
| III-294 | L_{A441} | L_{B2} | III-1867 | L_{A484} | L_{B11} | III-3440 | L_{A357} | L_{B21} | III-5013 | L_{A400} | L_{B30} |
| III-295 | L_{A442} | L_{B2} | III-1868 | L_{A485} | L_{B11} | III-3441 | L_{A358} | L_{B21} | III-5014 | L_{A401} | L_{B30} |
| III-296 | L_{A443} | L_{B2} | III-1869 | L_{A486} | L_{B11} | III-3442 | L_{A359} | L_{B21} | III-5015 | L_{A401} | L_{B30} |
| III-297 | L_{A444} | L_{B2} | III-1870 | L_{A487} | L_{B12} | III-3443 | L_{A360} | L_{B21} | III-5016 | L_{A403} | L_{B30} |
| III-298 | L_{A445} | L_{B2} | III-1871 | L_{A318} | L_{B12} | III-3444 | L_{A361} | L_{B21} | III-5017 | L_{A404} | L_{B30} |
| III-299 | L_{A446} | L_{B2} | III-1872 | L_{A319} | L_{B12} | III-3445 | L_{A362} | L_{B21} | III-5018 | L_{A405} | L_{B30} |
| III-300 | L_{A447} | L_{B2} | III-1873 | L_{A320} | L_{B12} | III-3446 | L_{A363} | L_{B21} | III-5019 | L_{A406} | L_{B30} |
| III-301 | L_{A448} | L_{B2} | III-1874 | L_{A321} | L_{B12} | III-3447 | L_{A364} | L_{B21} | III-5020 | L_{A407} | L_{B30} |
| III-302 | L_{A449} | L_{B2} | III-1875 | L_{A322} | L_{B12} | III-3448 | L_{A365} | L_{B21} | III-5021 | L_{A408} | L_{B30} |
| III-303 | L_{A450} | L_{B2} | III-1876 | L_{A323} | L_{B12} | III-3449 | L_{A366} | L_{B21} | III-5022 | L_{A409} | L_{B30} |
| III-304 | L_{A451} | L_{B2} | III-1877 | L_{A324} | L_{B12} | III-3450 | L_{A367} | L_{B21} | III-5023 | L_{A410} | L_{B30} |
| III-305 | L_{A452} | L_{B2} | 111-1878 | L_{A325} | L_{B12} | III-3451 | L_{A368} | L_{B21} | III-5024 | L_{A411} | L_{B30} |
| III-306 | L_{A453} | L_{B2} | III-1879 | L_{A326} | L_{B12} | III-3452 | L_{A369} | L_{B21} | III-5025 | L_{A412} | L_{B30} |
| III-307 | L_{A454} | L_{B2} | III-1880 | L_{A327} | L_{B12} | III-3453 | L_{A370} | L_{B21} | III-5026 | L_{A413} | L_{B30} |
| III-308 | L_{A455} | L_{B2} | III-1881 | L_{A328} | L_{B12} | III-3454 | L_{A371} | L_{B21} | III-5027 | L_{A414} | L_{B30} |
| III-309 | L_{A456} | L_{B2} | III-1882 | L_{A329} | L_{B12} | III-3455 | L_{A372} | L_{B21} | III-5028 | L_{A415} | L_{B30} |
| III-310 | L_{A457} | L_{B2} | III-1883 | L_{A330} | L_{B12} | III-3456 | L_{A373} | L_{B21} | III-5029 | L_{A416} | L_{B30} |
| III-311 | L_{A458} | L_{B2} | III-1884 | L_{A331} | L_{B12} | III-3457 | L_{A374} | L_{B21} | 111-5030 | L_{A417} | L_{B30} |
| III-312 | L_{A459} | L_{B2} | III-1885 | L_{A332} | L_{B12} | III-3458 | L_{A375} | L_{B21} | III-5031 | L_{A418} | L_{B30} |
| III-313 | L_{A460} | L_{B2} | III-1886 | L_{A333} | L_{B12} | III-3459 | L_{A376} | L_{B22} | III-5032 | L_{A419} | L_{B30} |
| III-314 | L_{A461} | L_{B2} | III-1887 | L_{A334} | L_{B12} | III-3460 | L_{A377} | L_{B21} | III-5033 | L_{A420} | L_{B30} |
| III-315 | L_{A462} | L_{B2} | III-1888 | L_{A335} | L_{B12} | III-3461 | L_{A378} | L_{B21} | III-5034 | L_{A421} | L_{B30} |
| III-316 | L_{A463} | L_{B2} | III-1889 | L_{A336} | L_{B12} | III-3462 | L_{A379} | L_{B21} | III-5035 | L_{A422} | L_{B30} |
| III-317 | L_{A464} | L_{B2} | III-1890 | L_{A337} | L_{B12} | III-3463 | L_{A380} | L_{B21} | III-5036 | L_{A423} | L_{B30} |
| III-318 | L_{A465} | L_{B2} | III-1891 | L_{A339} | L_{B12} | III-3464 | L_{A381} | L_{B21} | III-5037 | L_{A424} | L_{B30} |
| III-319 | L_{A466} | L_{B2} | III-1892 | L_{A339} | L_{B12} | III-3465 | L_{A382} | L_{B21} | III-5038 | L_{A425} | L_{B30} |
| III-320 | L_{A467} | L_{B2} | III-1893 | L_{A340} | L_{B12} | III-3466 | L_{A383} | L_{B21} | III-5039 | L_{A426} | L_{B30} |
| III-321 | L_{A468} | L_{B2} | III-1894 | L_{A342} | L_{B12} | III-3467 | L_{A384} | L_{B21} | III-5040 | L_{A427} | L_{B30} |
| III-322 | L_{A469} | L_{B2} | III-1895 | L_{A342} | L_{B12} | III-3468 | L_{A385} | L_{B21} | III-5041 | L_{A428} | L_{B30} |
| III-323 | L_{A470} | L_{B2} | III-1896 | L_{A343} | L_{B12} | III-3469 | L_{A386} | L_{B21} | III-5042 | L_{A429} | L₈₃₀ |
| III-324 | L_{A471} | L_{B2} | III-1897 | L_{A344} | L_{B12} | III-3470 | L_{A387} | L_{B21} | III-5043 | L_{A430} | L_{B30} |
| III-325 | L_{A472} | L_{B2} | III-1898 | L_{A345} | L_{B12} | III-3471 | L_{A388} | L_{B21} | III-5044 | L_{A431} | L_{B30} |
| III-326 | L_{A473} | L_{B2} | III-1899 | L_{A346} | L_{B12} | III-3472 | L_{A389} | L_{B21} | III-5045 | L_{A432} | L_{B30} |
| III-327 | L_{A474} | L_{B2} | III-1900 | L_{A347} | L_{B12} | III-3473 | L_{A390} | L_{B21} | III-5046 | L_{A433} | L_{B30} |
| III-328 | L_{A475} | L_{B2} | III-1901 | L_{A348} | L_{B12} | III-3474 | L_{A391} | L_{B21} | III-5047 | L_{A434} | L_{B30} |
| III-329 | L_{A476} | L_{B2} | III-1902 | L_{A349} | L_{B12} | III-3475 | L_{A392} | L_{B21} | III-5048 | L_{A435} | L_{B30} |
| III-330 | L_{A477} | L_{B2} | III-1903 | L_{A350} | L_{B12} | III-3476 | L_{A393} | L_{B21} | III-5049 | L_{A436} | L_{B30} |
| III-331 | L_{A478} | L_{B2} | III-1904 | L_{A351} | L_{B12} | III-3477 | L_{A394} | L_{B21} | III-5050 | L_{A437} | L_{B30} |
| III-332 | L_{A479} | L_{B2} | III-1905 | L_{A352} | L_{B12} | III-3478 | L_{A395} | L_{B21} | III-5051 | L_{A438} | L_{B30} |
| III-333 | L_{A480} | L_{B2} | III-1906 | L_{A353} | L_{B12} | III-3479 | L_{A396} | L_{B21} | III-5052 | L_{A439} | L_{B30} |
| III-334 | L_{A481} | L_{B2} | III-1907 | L_{A354} | L_{B12} | III-3480 | L_{A397} | L_{B21} | III-5053 | L_{A440} | L_{B30} |
| III-335 | L_{A482} | L_{B2} | III-1908 | L_{A355} | L_{B12} | III-3481 | L_{A398} | L_{B21} | III-5054 | L_{A441} | L_{B30} |
| III-336 | L_{A483} | L_{B2} | III-1909 | L_{A356} | L_{B12} | III-3482 | L_{A399} | L_{B21} | III-5055 | L_{A442} | L_{B30} |
| III-337 | L_{A484} | L_{B2} | III-1910 | L_{A357} | L_{B12} | III-3483 | L_{A400} | L_{B21} | III-5056 | L_{A443} | L_{B30} |
| III-338 | L_{A485} | L_{B2} | III-1911 | L_{A358} | L_{B12} | III-3484 | L_{A401} | L_{B21} | III-5057 | L_{A444} | L_{B30} |
| III-339 | L_{A486} | L_{B2} | III-1912 | L_{A359} | L_{B12} | III-3485 | L_{A402} | L_{B21} | III-5058 | L_{A445} | L_{B30} |
| III-340 | L_{A487} | L_{B2} | III-1913 | L_{A360} | L_{B12} | III-3486 | L_{A403} | L_{B21} | III-5059 | L_{A446} | L_{B30} |
| III-341 | L_{A318} | L_{B3} | III-1914 | L_{A361} | L_{B12} | III-3487 | L_{A404} | L_{B21} | III-5060 | L_{A447} | L_{B30} |
| III-342 | L_{A319} | L_{B2} | III-1915 | L_{A362} | L_{B12} | III-3488 | L_{A405} | L_{B21} | III-5061 | L_{A448} | L_{B30} |
| III-343 | L_{A320} | L_{B3} | III-1916 | L_{A363} | L_{B12} | III-3489 | L_{A406} | L_{B21} | III-5062 | L_{A449} | L_{B30} |
| III-344 | L_{A321} | L_{B3} | III-1917 | L_{A364} | L_{B12} | III-3490 | L_{A407} | L_{B21} | III-5063 | L_{A450} | L_{B30} |
| III-345 | L_{A322} | L_{B3} | III-1918 | L_{A365} | L_{B12} | III-3491 | L_{A408} | L_{B21} | III-5064 | L_{A451} | L_{B30} |
| III-346 | L_{A323} | L_{B3} | III-1919 | L_{A366} | L_{B12} | III-3492 | L_{A409} | L_{B21} | III-5065 | L_{A452} | L_{B30} |
| III-347 | L_{A324} | L_{B3} | III-1920 | L_{A367} | L_{B12} | III-3493 | L_{A410} | L_{B21} | III-5066 | L_{A453} | L_{B30} |
| III-348 | L_{A325} | L_{B3} | III-1921 | L_{A368} | L_{B12} | III-3494 | L_{A411} | L_{B21} | III-5067 | L_{A454} | L_{B30} |
| III-349 | L_{A326} | L_{B3} | III-1922 | L_{A369} | L_{B12} | III-3495 | L_{A412} | L_{B21} | III-5068 | L_{A455} | L_{B30} |
| III-350 | L_{A327} | L_{B3} | III-1923 | L_{A370} | L_{B12} | III-3496 | L_{A413} | L_{B21} | III-5069 | L_{A456} | L_{B30} |
| III-351 | L_{A328} | L_{B3} | III-1924 | L_{A371} | L_{B12} | III-3497 | L_{A414} | L_{B21} | III-5070 | L_{A457} | L_{B30} |
| III-352 | L_{A329} | L_{B3} | III-1925 | L_{A372} | L_{B12} | III-3498 | L_{A415} | L_{B21} | III-5071 | L_{A458} | L_{B30} |
| III-353 | L_{A330} | L_{B3} | III-1926 | L_{A373} | L_{B12} | III-3499 | L_{A416} | L_{B21} | III-5072 | L_{A459} | L_{B30} |
| III-354 | L_{A331} | L_{B3} | III-1927 | L_{A374} | L_{B12} | III-3500 | L_{A417} | L_{B21} | III-5073 | L_{A460} | L_{B30} |
| III-355 | L_{A332} | L_{B3} | III-1928 | L_{A375} | L_{B12} | III-3501 | L_{A418} | L_{B21} | III-5074 | L_{A461} | L_{B30} |
| III-356 | L_{A333} | L_{B3} | III-1929 | L_{A376} | L_{B12} | III-3502 | L_{A419} | L_{B21} | III-5075 | L_{A462} | L_{B30} |
| III-357 | L_{A334} | L_{B3} | III-1930 | L_{A377} | L_{B12} | III-3503 | L_{A420} | L_{B21} | III-5076 | L_{A463} | L_{B30} |
| III-358 | L_{A335} | L_{B3} | III-1931 | L_{A378} | L_{B12} | III-3504 | L_{A421} | L_{B21} | III-5077 | L_{A464} | L_{B30} |
| III-359 | L_{A336} | L_{B3} | III-1932 | L_{A379} | L_{B12} | III-3505 | L_{A422} | L_{B21} | III-5078 | L_{A465} | L_{B30} |
| III-360 | L_{A337} | L_{B3} | III-1933 | L_{A380} | L_{B12} | III-3506 | L_{A423} | L_{B21} | III-5079 | L_{A466} | L_{B30} |
| III-361 | L_{A338} | L_{B3} | III-1934 | L_{A381} | L_{B12} | III-3507 | L_{A424} | L_{B21} | III-5080 | L_{A467} | L_{B30} |
| III-362 | L_{A339} | L_{B3} | III-1935 | L_{A382} | L_{B12} | III-3508 | L_{A425} | L_{B21} | III-5081 | L_{A468} | L_{B30} |
| III-363 | L_{A340} | L_{B3} | III-1936 | L_{A383} | L_{B12} | III-3509 | L_{A426} | L₆₂₁ | III-5082 | L_{A469} | L_{B30} |
| III-364 | L_{A341} | L_{B3} | III-1937 | L_{A384} | L_{B12} | III-3510 | L_{A427} | L_{B21} | III-5083 | L_{A470} | L_{B30} |
| III-365 | L_{A342} | L_{B3} | III-1938 | L_{A385} | L_{B12} | III-3511 | L_{A428} | L_{B21} | III-5084 | L_{A471} | L_{B30} |
| III-366 | L_{A343} | L_{B3} | III-1939 | L_{A386} | L_{B12} | III-3512 | L_{A429} | L_{B21} | III-5085 | L_{A472} | L_{B30} |
| III-367 | L_{A344} | L_{B3} | III-1940 | L_{A387} | L_{B12} | III-3513 | L_{A430} | L_{B21} | III-5086 | L_{A473} | L_{B30} |
| III-368 | L_{A345} | L_{B3} | III-1941 | L_{A388} | L_{B12} | III-3514 | L_{A431} | L_{B21} | III-5087 | L_{A474} | L_{B30} |
| III-369 | L_{A346} | L_{B3} | III-1942 | L_{A389} | L_{B12} | III-3515 | L_{A432} | L_{B21} | III-5088 | L_{A475} | L_{B30} |
| III-370 | L_{A347} | L_{B3} | III-1943 | L_{A390} | L_{B12} | III-3516 | L_{A433} | L_{B21} | III-5089 | L_{A476} | L_{B30} |
| III-371 | L_{A348} | L_{B3} | III-1944 | L_{A391} | L_{B12} | III-3517 | L_{A434} | L_{B21} | III-5090 | L_{A477} | L_{B30} |
| III-372 | L_{A349} | L_{B3} | III-1945 | L_{A392} | L_{B12} | III-3518 | L_{A435} | L_{B21} | III-5091 | L_{A478} | L_{B30} |
| III-373 | L_{A350} | L_{B3} | III-1946 | L_{A393} | L_{B12} | III-3519 | L_{A436} | L_{B21} | III-5092 | L_{A479} | L_{B30} |
| III-374 | L_{A351} | L_{B3} | III-1947 | L_{A394} | L_{B12} | III-3520 | L_{A437} | L_{B21} | III-5093 | L_{A480} | L_{B30} |
| III-375 | L_{A352} | L_{B3} | III-1948 | L_{A395} | L_{B12} | III-3521 | L_{A438} | L_{B21} | III-5094 | L_{A481} | L_{B30} |
| III-376 | L_{A353} | L_{B3} | III-1949 | L_{A396} | L_{B12} | III-3522 | L_{A439} | L_{B21} | III-5095 | L_{A482} | L_{B30} |
| III-377 | L_{A354} | L_{B3} | III-1950 | L_{A397} | L_{B12} | III-3523 | L_{A440} | L_{B21} | III-5096 | L_{A483} | L_{B30} |
| III-378 | L_{A355} | L_{B3} | III-1951 | L_{A398} | L_{B12} | III-3524 | L_{A441} | L_{B21} | III-5097 | L_{A484} | L_{B30} |
| III-379 | L_{A356} | L_{B3} | III-1952 | L_{A399} | L_{B12} | III-3525 | L_{A442} | L_{B21} | III-5098 | L_{A485} | L_{B30} |
| III-380 | L_{A357} | L_{B3} | III-1953 | L_{A400} | L_{B12} | III-3526 | L_{A443} | L_{B21} | III-5099 | L_{A486} | L_{B30} |
| III-381 | L_{A358} | L_{B3} | III-1954 | L_{A401} | L_{B12} | III-3527 | L_{A444} | L_{B21} | III-5100 | L_{A487} | L_{B30} |
| III-382 | L_{A359} | L_{B3} | III-1955 | L_{A402} | L_{B12} | III-3528 | L_{A445} | L_{B21} | III-5101 | L_{A318} | L_{B31} |
| III-383 | L_{A360} | L_{B3} | III-1956 | L_{A403} | L_{B12} | III-3529 | L_{A446} | L_{B21} | III-5102 | L_{A319} | L_{B31} |
| III-384 | L_{A362} | L_{B3} | III-1957 | L_{A404} | L_{B12} | III-3530 | L_{A447} | L_{B21} | III-5103 | L_{A320} | L_{B31} |
| III-385 | L_{A362} | L_{B3} | III-1958 | L_{A405} | L_{B12} | III-3531 | L_{A448} | L_{B21} | III-5104 | L_{A321} | L_{B31} |
| III-386 | L_{A363} | L_{B3} | III-1959 | L_{A406} | L_{B12} | III-3532 | L_{A449} | L_{B21} | III-5105 | L_{A322} | L_{B31} |
| III-387 | L_{A364} | L_{B3} | III-1960 | L_{A407} | L_{B12} | III-3533 | L_{A450} | L_{B22} | III-5106 | L_{A323} | L_{B32} |
| III-388 | L_{A365} | L_{B3} | III-1961 | L_{A408} | L_{B12} | III-3534 | L_{A451} | L_{B21} | III-5107 | L_{A324} | L_{B31} |
| III-389 | L_{A366} | L_{B3} | III-1962 | L_{A409} | L_{B12} | III-3535 | L_{A452} | L_{B22} | III-5108 | L_{A325} | L_{B31} |
| III-390 | L_{A367} | L_{B3} | III-1963 | L_{A410} | L_{B12} | III-3536 | L_{A453} | L_{B21} | III-5109 | L_{A326} | L_{B31} |
| III-391 | L_{A368} | L_{B3} | III-1964 | L_{A411} | L_{B12} | III-3537 | L_{A454} | L_{B21} | III-5110 | L_{A327} | L_{B31} |
| III-392 | L_{A369} | L_{B3} | III-1965 | L_{A412} | L_{B12} | III-3538 | L_{A455} | L_{B21} | III-5111 | L_{A328} | L_{B31} |
| III-393 | L_{A370} | L_{B3} | III-1966 | L_{A413} | L_{B12} | III-3539 | L_{A456} | L_{B21} | III-5112 | L_{A329} | L_{B31} |
| III-394 | L_{A371} | L_{B3} | III-1967 | L_{A414} | L_{B12} | III-3540 | L_{A457} | L_{B22} | III-5113 | L_{A330} | L_{B31} |
| III-395 | L_{A372} | L_{B3} | III-1968 | L_{A415} | L_{B12} | III-3541 | L_{A458} | L_{B21} | III-5114 | L_{A332} | L_{B31} |
| III-396 | L_{A373} | L_{B3} | III-1969 | L_{A416} | L_{B12} | III-3542 | L_{A459} | L_{B21} | III-5115 | L_{A332} | L_{B31} |
| III-397 | L_{A374} | L_{B3} | III-1970 | L_{A417} | L_{B12} | III-3543 | L_{A460} | L_{B21} | III-5116 | L_{A33} | L_{B31} |
| III-398 | L_{A375} | L_{B3} | III-1971 | L_{A418} | L_{B12} | III-3544 | L_{A461} | L_{B21} | III-5117 | L_{A334} | L_{B31} |
| III-399 | L_{A376} | L_{B3} | III-1972 | L_{A419} | L_{B12} | III-3545 | L_{A462} | L_{B21} | III-5118 | L_{A335} | L_{B31} |
| III-400 | L_{A377} | L_{B3} | III-1973 | L_{A420} | L_{B12} | III-3546 | L_{A463} | L_{B21} | III-5119 | L_{A336} | L_{B31} |
| III-401 | L_{A378} | L_{B3} | III-1974 | L_{A421} | L_{B12} | III-3547 | L_{A464} | L_{B21} | III-5120 | L_{A337} | L_{B31} |
| III-402 | L_{A379} | L_{B3} | III-1975 | L_{A422} | L_{B12} | III-3548 | L_{A465} | L_{B21} | III-5121 | L_{A338} | L_{B31} |
| III-403 | L_{A380} | L_{B3} | III-1976 | L_{A423} | L_{B12} | III-3549 | L_{A466} | L_{B21} | III-5122 | L_{A339} | L_{B31} |
| III-404 | L_{A381} | L_{B3} | III-1977 | L_{A424} | L_{B12} | III-3550 | L_{A467} | L_{B21} | III-5123 | L_{A340} | L_{B31} |
| III-405 | L_{A382} | L_{B3} | III-1978 | L_{A425} | L_{B12} | III-3551 | L_{A468} | L_{B21} | III-5124 | L_{A341} | L_{B31} |
| III-406 | L_{A383} | L_{B3} | III-1979 | L_{A426} | L_{B12} | III-3552 | L_{A469} | L_{B21} | III-5125 | L_{A342} | L_{B31} |
| III-407 | L_{A384} | L_{B3} | III-1980 | L_{A427} | L_{B22} | III-3553 | L_{A470} | L_{B23} | III-5126 | L_{A343} | L_{B31} |
| III-408 | L_{A385} | L_{B3} | III-1981 | L_{A428} | L_{B12} | III-3554 | L_{A471} | L_{B21} | III-5127 | L_{A344} | L_{B31} |
| III-409 | L_{A386} | L_{B3} | III-1982 | L_{A429} | L_{B12} | III-3555 | L_{A472} | L_{B21} | III-5128 | L_{A345} | L_{B31} |
| III-410 | L_{A387} | L_{B3} | III-1983 | L_{A430} | L_{B12} | III-3556 | L_{A473} | L_{B21} | III-5129 | L_{A346} | L_{B31} |
| III-411 | L_{A388} | L_{B3} | III-1984 | L_{A431} | L_{B12} | III-3557 | L_{A474} | L_{B21} | III-5130 | L_{A347} | L_{B31} |
| III-412 | L_{A389} | L_{B3} | III-1985 | L_{A432} | L_{B12} | III-3558 | L_{A475} | L_{B21} | III-5131 | L_{A348} | L_{B31} |
| III-413 | L_{A390} | L_{B3} | III-1986 | L_{A433} | L_{B12} | III-3559 | L_{A476} | L_{B21} | III-5132 | L_{A349} | L_{B31} |
| III-414 | L_{A391} | L_{B3} | III-1987 | L_{A434} | L_{B12} | III-3560 | L_{A477} | L_{B21} | III-5133 | L_{A350} | L_{B31} |
| III-415 | L_{A392} | L_{B3} | III-1988 | L_{A435} | L_{B12} | III-3561 | L_{A478} | L_{B21} | III-5134 | L_{A351} | L_{B31} |
| III-416 | L_{A393} | L_{B3} | III-1989 | L_{A436} | L_{B12} | III-3562 | L_{A479} | L_{B21} | III-5135 | L_{A352} | L_{B31} |
| III-417 | L_{A394} | L_{B3} | III-1990 | L_{A437} | L_{B12} | III-3563 | L_{A480} | L_{B21} | III-5136 | L_{A353} | L_{B31} |
| III-418 | L_{A395} | L_{B3} | III-1991 | L_{A438} | L_{B12} | III-3564 | L_{A481} | L_{B21} | III-5137 | L_{A354} | L_{B31} |
| III-419 | L_{A396} | L_{B3} | III-1992 | L_{A439} | L_{B12} | III-3565 | L_{A482} | L_{B21} | III-5138 | L_{A355} | L_{B31} |
| III-420 | L_{A397} | L_{B3} | III-1993 | L_{A440} | L_{B12} | III-3566 | L_{A483} | L_{B21} | III-5139 | L_{A356} | L_{B31} |
| III-421 | L_{A398} | L_{B3} | III-1994 | L_{A441} | L_{B12} | III-3567 | L_{A484} | L_{B21} | III-5140 | L_{A357} | L_{B31} |
| III-422 | L_{A399} | L_{B3} | III-1995 | L_{A442} | L_{B12} | III-3568 | L_{A485} | L_{B21} | III-5141 | L_{A358} | L_{B31} |
| III-423 | L_{A400} | L_{B3} | III-1996 | L_{A443} | L_{B12} | III-3569 | L_{A486} | L_{B21} | III-5142 | L_{A359} | L_{B31} |
| III-424 | L_{A401} | L_{B3} | III-1997 | L_{A444} | L_{B12} | III-3570 | L_{A487} | L_{B21} | III-5143 | L_{A360} | L_{B31} |
| III-425 | L_{A402} | L_{B3} | III-1998 | L_{A445} | L_{B12} | III-3571 | L_{A318} | L_{B22} | III-5144 | L_{A361} | L_{B31} |
| III-426 | L_{A403} | L_{B3} | III-1999 | L_{A446} | L_{B12} | III-3572 | L_{A319} | L_{B22} | III-5145 | L_{A362} | L_{B31} |
| III-427 | L_{A404} | L_{B3} | III-2000 | L_{A447} | L_{B12} | III-3573 | L_{A320} | L_{B22} | III-5146 | L_{A363} | L_{B31} |
| III-428 | L_{A405} | L_{B3} | III-2001 | L_{A448} | L_{B12} | III-3574 | L_{A321} | L_{B22} | III-5147 | L_{A364} | L_{B31} |
| III-429 | L_{A406} | L_{B3} | III-2002 | L_{A449} | L_{B12} | III-3575 | L_{A322} | L_{B22} | III-5148 | L_{A365} | L_{B31} |
| III-430 | L_{A407} | L_{B3} | III-2003 | L_{A450} | L_{B12} | III-3576 | L_{A323} | L_{B22} | III-5149 | L_{A366} | L_{B31} |
| III-431 | L_{A408} | L_{B3} | III-2004 | L_{A451} | L_{B12} | III-3577 | L_{A324} | L_{B22} | III-5150 | L_{A367} | L_{B31} |
| III-432 | L_{A409} | L_{B3} | III-2005 | L_{A452} | L_{B12} | III-3578 | L_{A325} | L_{B22} | III-5151 | L_{A368} | L_{B31} |
| III-433 | L_{A410} | L_{B3} | III-2006 | L_{A453} | L_{B12} | III-3579 | L_{A326} | L_{B22} | III-5152 | L_{A369} | L_{B31} |
| III-434 | L_{A411} | L_{B3} | III-2007 | L_{A454} | L_{B12} | III-3580 | L_{A327} | L_{B22} | III-5153 | L_{A370} | L_{B31} |
| III-435 | L_{A412} | L_{B3} | III-2008 | L_{A455} | L_{B12} | III-3581 | L_{A328} | L_{B22} | III-5154 | L_{A371} | L_{B31} |
| III-436 | L_{A413} | L_{B3} | III-2009 | L_{A456} | L_{B12} | III-3582 | L_{A329} | L_{B22} | III-5155 | L_{A372} | L_{B31} |
| III-437 | L_{A414} | L_{B3} | III-2010 | L_{A457} | L_{B12} | III-3583 | L_{A330} | L_{B22} | III-5156 | L_{A373} | L_{B31} |
| III-438 | L_{A415} | L_{B3} | III-2011 | L_{A458} | L_{B12} | III-3584 | L_{A331} | L_{B22} | III-5157 | L_{A374} | L_{B31} |
| III-439 | L_{A416} | L_{B3} | III-2012 | L_{A459} | L_{B12} | III-3585 | L_{A332} | L_{B22} | III-5158 | L_{A375} | L_{B31} |
| III-440 | L_{A427} | L_{B3} | III-2013 | L_{A460} | L_{B12} | III-3586 | L_{A333} | L_{B22} | III-5159 | L_{A376} | L_{B31} |
| III-441 | L_{A418} | L_{B3} | III-2014 | L_{A461} | L_{B12} | III-3587 | L_{A334} | L_{B22} | III-5160 | L_{A377} | L_{B31} |
| III-442 | L_{A419} | L_{B3} | III-2015 | L_{A462} | L_{B12} | III-3588 | L_{A335} | L_{B22} | III-5161 | L_{A378} | L_{B31} |
| III-443 | L_{A420} | L_{B3} | III-2016 | L_{A463} | L_{B12} | III-3589 | L_{A336} | L_{B22} | III-5162 | L_{A379} | L_{B31} |
| III-444 | L_{A421} | L_{B3} | III-2017 | L_{A464} | L_{B12} | III-3590 | L_{A337} | L_{B22} | III-5163 | L_{A380} | L_{B31} |
| III-445 | L_{A422} | L_{B3} | III-2018 | L_{A465} | L_{B12} | III-3591 | L_{A338} | L_{B22} | III-5164 | L_{A381} | L_{B31} |
| III-446 | L_{A423} | L_{B3} | III-2019 | L_{A466} | L_{B12} | III-3592 | L_{A339} | L_{B22} | III-5165 | L_{A382} | L_{B31} |
| III-447 | L_{A424} | L_{B3} | III-2020 | L_{A467} | L_{B12} | III-3593 | L_{A340} | L_{B22} | III-5166 | L_{A393} | L_{B31} |
| III-448 | L_{A425} | L_{B3} | III-2021 | L_{A468} | L_{B12} | III-3594 | L_{A341} | L_{B22} | III-5167 | L_{A384} | L_{B31} |
| III-449 | L_{A426} | L_{B3} | III-2022 | L_{A469} | L_{B12} | III-3595 | L_{A342} | L_{B22} | III-5168 | L_{A385} | L_{B31} |
| III-450 | L_{A427} | L_{B3} | III-2023 | L_{A470} | L_{B12} | III-3596 | L_{A343} | L_{B22} | III-5169 | L_{A386} | L_{B31} |
| III-451 | L_{A428} | L_{B3} | III-2024 | L_{A471} | L_{B12} | III-3597 | L_{A344} | L_{B22} | III-5170 | L_{A387} | L_{B31} |
| III-452 | L_{A429} | L_{B3} | III-2025 | L_{A472} | L_{B12} | III-3598 | L_{A345} | L_{B22} | III-5171 | L_{A388} | L_{B31} |
| III-453 | L_{A430} | L_{B3} | III-2026 | L_{A473} | L_{B12} | III-3599 | L_{A346} | L_{B22} | III-5172 | L_{A389} | L_{B31} |
| III-454 | L_{A431} | L_{B3} | III-2027 | L_{A474} | L_{B12} | III-3600 | L_{A347} | L_{B22} | III-5173 | L_{A390} | L_{B31} |
| III-455 | L_{A432} | L_{B3} | III-2028 | L_{A475} | L_{B12} | III-3601 | L_{A348} | L_{B22} | III-5174 | L_{A391} | L_{B31} |
| III-456 | L_{A433} | L_{B3} | III-2029 | L_{A476} | L_{B12} | III-3602 | L_{A349} | L_{B22} | III-5175 | L_{A392} | L_{B31} |
| III-457 | L_{A434} | L_{B3} | III-2030 | L_{A477} | L_{B12} | III-3603 | L_{A350} | L_{B22} | III-5176 | L_{A393} | L_{B31} |
| III-458 | L_{A435} | L_{B3} | III-2031 | L_{A478} | L_{B12} | III-3604 | L_{A351} | L_{B22} | III-5177 | L_{A394} | L_{B31} |
| III-459 | L_{A436} | L_{B3} | III-2032 | L_{A479} | L_{B12} | III-3605 | L_{A352} | L_{B22} | III-5178 | L_{A395} | L_{B31} |
| III-460 | L_{A437} | L_{B3} | III-2033 | L_{A480} | L_{B12} | III-3606 | L_{A353} | L_{B22} | III-5179 | L_{A396} | L_{B31} |
| III-461 | L_{A438} | L_{B3} | III-2034 | L_{A481} | L_{B12} | III-3607 | L_{A354} | L_{B22} | III-5180 | L_{A397} | L_{B31} |
| III-462 | L₄₃₉ | L_{B3} | III-2035 | L_{A482} | L_{B12} | III-3608 | L_{A355} | L_{B22} | III-5181 | L_{A398} | L_{B31} |
| III-463 | L_{A440} | L_{B3} | III-2036 | L_{A483} | L_{B12} | III-3609 | L_{A356} | L_{B22} | III-5182 | L_{A399} | L_{B31} |
| III-464 | L_{A441} | L_{B3} | III-2037 | L_{A484} | L_{B12} | III-3610 | L_{A357} | L_{B22} | III-5183 | L_{A400} | L_{B31} |
| III-465 | L_{A442} | L_{B3} | III-2038 | L_{A485} | L_{B12} | III-3611 | L_{A358} | L_{B22} | III-5184 | L_{A401} | L_{B31} |
| III-466 | L_{A443} | L_{B3} | III-2039 | L_{A486} | L_{B12} | III-3612 | L_{A359} | L_{B22} | III-5185 | L_{A402} | L_{B31} |
| III-467 | L_{A444} | L_{B3} | III-2040 | L_{A487} | L_{B12} | III-3613 | L_{A360} | L_{B22} | III-5186 | L_{A403} | L_{B31} |
| III-468 | L_{A445} | L_{B3} | III-2041 | L_{A318} | L_{B13} | III-3614 | L_{A361} | L_{B22} | III-5187 | L_{A404} | L_{B31} |
| III-469 | L_{A446} | L_{B3} | III-2042 | L_{A319} | L_{B13} | III-3615 | L_{A362} | L_{B22} | III-5188 | L_{A405} | L_{B31} |
| III-470 | L_{A447} | L_{B3} | III-2043 | L_{A320} | L_{B13} | III-3616 | L_{A363} | L_{B22} | III-5189 | L_{A406} | L_{B31} |
| III-471 | L_{A448} | L_{B3} | III-2044 | L_{A321} | L_{B13} | III-3617 | L_{A364} | L_{B22} | III-5190 | L_{A407} | L_{B31} |
| III-472 | L_{A449} | L_{B3} | III-2045 | L_{A322} | L_{B13} | III-3618 | L_{A365} | L_{B22} | III-5191 | L_{A408} | L_{B31} |
| III-473 | L_{A450} | L_{B3} | III-2046 | L_{A323} | L_{B13} | III-3619 | L_{A366} | L_{B22} | III-5192 | L_{A409} | L_{B32} |
| III-474 | L_{A451} | L_{B3} | III-2047 | L_{A324} | L_{B13} | III-3620 | L_{A367} | L_{B22} | III-5193 | L_{A410} | L_{B31} |
| III-475 | L_{A452} | L_{B3} | III-2048 | L_{A325} | L_{B13} | III-3621 | L_{A368} | L_{B22} | III-5194 | L_{A411} | L_{B31} |
| III-476 | L_{A453} | L_{B3} | III-2049 | L_{A326} | L_{B13} | III-3622 | L_{A369} | L_{B22} | III-5195 | L_{A412} | L_{B31} |
| III-477 | L_{A454} | L_{B3} | III-2050 | L_{A327} | L_{B13} | III-3623 | L_{A370} | L_{B22} | III-5196 | L_{A413} | L_{B31} |
| III-478 | L_{A455} | L_{B3} | III-2051 | L_{A328} | L_{B13} | III-3624 | L_{A371} | L_{B22} | III-5197 | L_{A414} | L_{B31} |
| III-479 | L_{A456} | L_{B3} | III-2052 | L_{A329} | L_{B23} | III-3625 | L_{A372} | L_{B22} | III-5198 | L_{A415} | L_{B31} |
| III-480 | L_{A457} | L_{B3} | III-2053 | L_{A330} | L_{B13} | III-3626 | L_{A373} | L_{B22} | III-5199 | L_{A416} | L_{B31} |
| III-481 | L_{A458} | L_{B3} | III-2054 | L_{A331} | L_{B13} | III-3627 | L_{A374} | L_{B22} | III-5200 | L_{A417} | L_{B31} |
| III-482 | L_{A459} | L_{B3} | III-2055 | L_{A332} | L_{B13} | III-3628 | L_{A375} | L_{B22} | III-5201 | L_{A418} | L_{B31} |
| III-483 | L_{A460} | L_{B3} | III-2056 | L_{A333} | L_{B13} | III-3629 | L_{A376} | L_{B22} | III-5202 | L_{A419} | L_{B31} |
| III-484 | L_{A461} | L_{B3} | III-2057 | L_{A334} | L_{B13} | III-3630 | L_{A377} | L_{B22} | III-5203 | L_{A420} | L_{B31} |
| III-485 | L_{A462} | L_{B3} | III-2058 | L_{A335} | L_{B23} | III-3631 | L_{A378} | L_{B22} | III-5204 | L_{A421} | L_{B31} |
| III-486 | L_{A463} | L_{B3} | III-2059 | L_{A336} | L_{B13} | III-3632 | L_{A379} | L_{B22} | III-5205 | L_{A422} | L_{B31} |
| III-487 | L_{A464} | L_{B3} | III-2060 | L_{A337} | L_{B13} | III-3633 | L_{A380} | L_{B22} | III-5206 | L_{A423} | L_{B31} |
| III-488 | L_{A465} | L_{B3} | III-2061 | L_{A338} | L_{B13} | III-3634 | L_{A381} | L_{B22} | III-5207 | L_{A424} | L_{B31} |
| III-489 | L_{A466} | L_{B3} | III-2062 | L_{A339} | L_{B13} | III-3635 | L_{A382} | L_{B22} | III-5208 | L_{A425} | L_{B31} |
| III-490 | L_{A467} | L_{B3} | III-2063 | L_{A340} | L_{B13} | III-3636 | L_{A383} | L_{B22} | III-5209 | L_{A426} | L_{B31} |
| III-491 | L_{A468} | L_{B3} | III-2064 | L_{A341} | L_{B13} | III-3637 | L_{A384} | L_{B22} | III-5210 | L_{A427} | L_{B31} |
| III-492 | L_{A469} | L_{B3} | III-2065 | L_{A342} | L_{B13} | III-3638 | L_{A385} | L_{B22} | III-5211 | L_{A428} | L_{B31} |
| III-493 | L_{A470} | L_{B3} | III-2066 | L_{A343} | L_{B13} | III-3639 | L_{A386} | L_{B22} | III-5212 | L_{A429} | L_{B31} |
| III-494 | L_{A471} | L_{B3} | III-2067 | L_{A344} | L_{B23} | III-3640 | L_{A387} | L_{B22} | III-5213 | L_{A430} | L_{B31} |
| III-495 | L_{A472} | L_{B3} | III-2068 | L_{A345} | L_{B13} | III-3641 | L_{A388} | L_{B22} | III-5214 | L_{A431} | L_{B31} |
| III-496 | L_{A473} | L_{B3} | III-2069 | L_{A346} | L_{B13} | III-3642 | L_{A389} | L_{B22} | III-5215 | L_{A432} | L_{B31} |
| III-497 | L_{A474} | L_{B3} | III-2070 | L_{A347} | L_{B13} | III-3643 | L_{A390} | L_{B22} | III-5216 | L_{A433} | L_{B31} |
| III-498 | L_{A475} | L_{B3} | III-2071 | L_{A348} | L_{B13} | III-3644 | L_{A391} | L_{B22} | III-5217 | L_{A434} | L_{B31} |
| III-499 | L_{A476} | L_{B3} | III-2072 | L_{A349} | L_{B13} | III-3645 | L_{A392} | L_{B22} | III-5218 | L_{A435} | L_{B31} |
| III-500 | L_{A477} | L_{B3} | III-2073 | L_{A350} | L_{B13} | III-3646 | L_{A393} | L_{B22} | III-5219 | L_{A436} | L_{B32} |
| III-501 | L_{A478} | L_{B3} | III-2074 | L_{A351} | L_{B13} | III-3647 | L_{A394} | L_{B22} | III-5220 | L_{A437} | L_{B31} |
| III-502 | L_{A479} | L_{B3} | III-2075 | L_{A352} | L₈₁₃ | III-3648 | L_{A395} | L_{B22} | III-5221 | L_{A438} | L_{B31} |
| III-503 | L_{A480} | L_{B3} | III-2076 | L_{A353} | L_{B13} | III-3649 | L_{A396} | L_{B22} | III-5222 | L_{A439} | L_{B31} |
| III-504 | L_{A481} | L_{B3} | III-2077 | L_{A354} | L_{B13} | III-3650 | L_{A397} | L_{B22} | III-5223 | L_{A440} | L_{B31} |
| III-505 | L_{A482} | L_{B3} | III-2078 | L_{A355} | L_{B13} | III-3651 | L_{A398} | L_{B22} | III-5224 | L_{A441} | L_{B31} |
| III-506 | L_{A483} | L_{B3} | III-2079 | L_{A356} | L_{B13} | III-3652 | L_{A399} | L_{B22} | III-5225 | L_{A442} | L_{B31} |
| III-507 | L_{A484} | L_{B3} | III-2080 | L_{A357} | L_{B13} | III-3653 | L_{A400} | L_{B22} | III-5226 | L_{A443} | L_{B31} |
| III-508 | L_{A485} | L_{B3} | III-2081 | L_{A358} | L_{B13} | III-3654 | L_{A401} | L_{B22} | III-5227 | L_{A444} | L_{B31} |
| III-509 | L_{A486} | L_{B3} | III-2082 | L_{A359} | L_{B13} | III-3655 | L_{A402} | L_{B22} | III-5228 | L_{A445} | L_{B31} |
| III-510 | L_{A487} | L_{B3} | III-2083 | L_{A360} | L_{B13} | III-3656 | L_{A403} | L_{B22} | III-5229 | L_{A446} | L_{B31} |
| III-511 | L_{A318} | L_{B4} | III-2084 | L_{A361} | L_{B13} | III-3657 | L_{A404} | L_{B22} | III-5230 | L_{A447} | L_{B31} |
| III-512 | L_{A319} | L_{B4} | III-2085 | L_{A362} | L₈₁₃ | III-3658 | L_{A405} | L_{B22} | III-5231 | L_{A448} | L_{B31} |
| III-513 | L_{A320} | L_{B4} | III-2086 | L_{A363} | L_{B13} | III-3659 | L_{A406} | L_{B22} | III-5232 | L_{A449} | L_{B31} |
| III-514 | L_{A321} | L_{B4} | III-2087 | L_{A364} | L_{B13} | III-3660 | L_{A407} | L_{B22} | III-5233 | L_{A450} | L_{B31} |
| III-515 | L_{A322} | L_{B4} | III-2088 | L_{A365} | L_{B13} | III-3661 | L_{A408} | L_{B22} | III-5234 | L_{A451} | L_{B31} |
| III-516 | L_{A323} | L_{B4} | III-2089 | L_{A366} | L_{B13} | III-3662 | L_{A409} | L_{B22} | III-5235 | L_{A452} | L_{B31} |
| III-517 | L_{A324} | L_{B4} | III-2090 | L_{A367} | L_{B13} | III-3663 | L_{A410} | L_{B22} | III-5236 | L_{A453} | L_{B31} |
| III-518 | L_{A325} | L_{B4} | III-2091 | L_{A368} | L_{B13} | III-3664 | L_{A411} | L_{B22} | III-5237 | L_{A454} | L_{B31} |
| III-519 | L_{A326} | L_{B4} | III-2092 | L_{A369} | L_{B13} | III-3665 | L_{A412} | L_{B22} | III-5238 | L_{A455} | L_{B31} |
| III-520 | L_{A327} | L_{B4} | III-2093 | L_{A370} | L_{B13} | III-3666 | L_{A413} | L_{B22} | III-5239 | L_{A456} | L_{B31} |
| III-521 | L_{A328} | L_{B4} | III-2094 | L_{A371} | L_{B13} | III-3667 | L_{A414} | L_{B22} | III-5240 | L_{A457} | L_{B31} |
| III-522 | L_{A329} | L_{B4} | III-2095 | L_{A372} | L_{B13} | III-3668 | L_{A415} | L_{B22} | III-5241 | L_{A458} | L_{B31} |
| III-523 | L_{A330} | L_{B4} | III-2096 | L_{A373} | L_{B13} | III-3669 | L_{A416} | L_{B22} | III-5242 | L_{A459} | L_{B31} |
| III-524 | L_{A331} | L_{B4} | III-2097 | L_{A374} | L_{B13} | III-3670 | L_{A617} | L_{B22} | III-5243 | L_{A460} | L_{B31} |
| III-525 | L_{A332} | L_{B4} | III-2098 | L_{A375} | L_{B13} | III-3671 | L_{A418} | L_{B22} | III-5244 | L_{A461} | L_{B31} |
| III-526 | L_{A333} | L_{B4} | III-2099 | L_{A376} | L_{B13} | III-3672 | L_{A419} | L_{B22} | III-5245 | L_{A462} | L_{B31} |
| III-527 | L_{A334} | L_{B4} | III-2100 | L_{A377} | L_{B13} | III-3673 | L_{A420} | L_{B22} | III-5246 | L_{A463} | L_{B31} |
| III-528 | L_{A335} | L_{B4} | III-2101 | L_{A378} | L_{B13} | III-3674 | L_{A421} | L_{B22} | III-5247 | L_{A464} | L_{B31} |
| III-529 | L_{A336} | L_{B4} | III-2102 | L_{A379} | L_{B13} | III-3675 | L_{A422} | L_{B22} | III-5248 | L_{A465} | L_{B31} |
| III-530 | L_{A337} | L_{B4} | III-2103 | L_{A380} | L_{B13} | III-3676 | L_{A423} | L_{B22} | III-5249 | L_{A466} | L_{B31} |
| III-531 | L_{A338} | L_{B4} | III-2104 | L_{A381} | L_{B13} | III-3677 | L_{A424} | L_{B22} | III-5250 | L_{A467} | L_{B31} |
| III-532 | L_{A339} | L_{B4} | III-2105 | L_{A382} | L_{B13} | III-3678 | L_{A425} | L_{B22} | III-5251 | L_{A468} | L_{B31} |
| III-533 | L_{A340} | L_{B4} | III-2106 | L_{A383} | L_{B23} | III-3679 | L_{A426} | L_{B22} | III-5252 | L_{A469} | L_{B31} |
| III-534 | L_{A341} | L_{B4} | III-2107 | L_{A384} | L_{B13} | III-3680 | L_{A427} | L_{B22} | III-5253 | L_{A470} | L_{B31} |
| III-535 | L_{A342} | L_{B4} | III-2108 | L_{A385} | L_{B13} | III-3681 | L_{A428} | L_{B22} | III-5254 | L_{A471} | L_{B31} |
| III-536 | L_{A343} | L_{B4} | III-2109 | L_{A386} | L_{B13} | III-3682 | L_{A429} | L_{B22} | III-5255 | L_{A472} | L_{B31} |
| III-537 | L_{A344} | L_{B4} | III-2110 | L_{A387} | L_{B13} | III-3683 | L_{A430} | L_{B22} | III-5256 | L_{A473} | L_{B31} |
| III-538 | L_{A345} | L_{B4} | III-2111 | L_{A388} | L_{B13} | III-3684 | L_{A431} | L_{B22} | III-5257 | L_{A474} | L_{B31} |
| III-539 | L_{A346} | L_{B4} | III-2112 | L_{A389} | L_{B13} | III-3685 | L_{A432} | L_{B22} | III-5258 | L_{A475} | L_{B31} |
| III-540 | L_{A347} | L_{B4} | III-2113 | L_{A390} | L_{B13} | III-3686 | L_{A433} | L_{B22} | III-5259 | L_{A476} | L_{B31} |
| III-541 | L_{A348} | L_{B4} | III-2114 | L_{A391} | L_{B13} | III-3687 | L_{A434} | L_{B22} | III-5260 | L_{A477} | L_{B31} |
| III-542 | L_{A349} | L_{B4} | III-2115 | L_{A392} | L_{B13} | III-3688 | L_{A435} | L_{B22} | III-5261 | L_{A478} | L_{B31} |
| III-543 | L_{A350} | L_{B4} | III-2116 | L_{A393} | L_{B13} | III-3689 | L_{A436} | L_{B22} | III-5262 | L_{A479} | L_{B31} |
| III-544 | L_{A351} | L_{B4} | III-2117 | L_{A394} | L_{B13} | III-3690 | L_{A437} | L_{B22} | III-5263 | L_{A480} | L_{B31} |
| III-545 | L_{A352} | L_{B4} | III-2118 | L_{A395} | L_{B13} | III-3691 | L_{A438} | L_{B22} | III-5264 | L_{A481} | L_{B31} |
| III-546 | L_{A353} | L_{B4} | III-2119 | L_{A396} | L_{B13} | III-3692 | L_{A439} | L_{B22} | III-5265 | L_{A482} | L_{B31} |
| III-547 | L_{A354} | L_{B4} | III-2120 | L_{A397} | L_{B13} | III-3693 | L_{A440} | L_{B22} | III-5266 | L_{A483} | L_{B31} |
| III-548 | L_{A355} | L_{B4} | III-2121 | L_{A398} | L_{B13} | III-3694 | L_{A441} | L_{B22} | III-5267 | L_{A484} | L_{B31} |
| III-549 | L_{A356} | L_{B4} | III-2122 | L_{A399} | L_{B13} | III-3695 | L_{A442} | L_{B22} | III-5268 | L_{A485} | L_{B31} |
| III-550 | L_{A357} | L_{B4} | III-2123 | L_{A400} | L_{B13} | III-3696 | L_{A443} | L_{B22} | III-5269 | L_{A486} | L_{B31} |
| III-551 | L_{A358} | L_{B4} | III-2124 | L_{A401} | L_{B13} | III-3697 | L_{A444} | L_{B22} | III-5270 | L_{A487} | L_{B31} |
| III-552 | L_{A359} | L_{B4} | III-2125 | L_{A402} | L_{B13} | III-3698 | L_{A445} | L_{B22} | III-5271 | L_{A318} | L_{B32} |
| III-553 | L_{A360} | L_{B4} | III-2126 | L_{A403} | L_{B13} | III-3699 | L_{A446} | L_{B22} | III-5272 | L_{A319} | L_{B32} |
| III-554 | L_{A361} | L_{B4} | III-2127 | L_{A404} | L_{B13} | III-3700 | L_{A447} | L_{B22} | III-5273 | L_{A320} | L_{B32} |
| III-555 | L_{A362} | L_{B4} | III-2128 | L_{A405} | L_{B13} | III-3701 | L_{A448} | L_{B22} | III-5274 | L_{A321} | L_{B32} |
| III-556 | L_{A363} | L_{B4} | III-2129 | L_{A406} | L_{B13} | III-3702 | L_{A449} | L_{B22} | III-5275 | L_{A322} | L_{B32} |
| III-557 | L_{A364} | L_{B4} | III-2130 | L_{A407} | L_{B13} | III-3703 | L_{A450} | L_{B22} | III-5276 | L_{A323} | L_{B32} |
| III-558 | L_{A365} | L_{B4} | III-2131 | L_{A408} | L_{B13} | III-3704 | L_{A451} | L_{B22} | III-5277 | L_{A324} | L_{B32} |
| III-559 | L_{A366} | L_{B4} | III-2132 | L_{A409} | L_{B13} | III-3705 | L_{A452} | L_{B22} | III-5278 | L_{A325} | L_{B32} |
| III-560 | L_{A367} | L_{B4} | III-2133 | L_{A410} | L_{B13} | III-3706 | L_{A453} | L_{B22} | III-5279 | L_{A326} | L_{B32} |
| III-561 | L_{A368} | L_{B4} | III-2134 | L_{A411} | L_{B13} | III-3707 | L_{A454} | L_{B22} | III-5280 | L_{A327} | L_{B32} |
| III-562 | L_{A369} | L_{B4} | III-2135 | L_{A412} | L_{B13} | III-3708 | L_{A455} | L_{B22} | III-5281 | L_{A328} | L₈₃₂ |
| III-563 | L_{A370} | L_{B4} | III-2136 | L_{A413} | L_{B13} | III-3709 | L_{A456} | L_{B22} | III-5282 | L_{A329} | L_{B32} |
| III-564 | L_{A371} | L_{B4} | III-2137 | L_{A414} | L_{B13} | III-3710 | L_{A457} | L_{B22} | III-5283 | L_{A330} | L_{B32} |
| III-565 | L_{A372} | L_{B4} | III-2138 | L_{A415} | L_{B13} | III-3711 | L_{A458} | L_{B22} | III-5284 | L_{A331} | L_{B32} |
| III-566 | L_{A373} | L_{B4} | III-2139 | L_{A416} | L_{B13} | III-3712 | L_{A459} | L_{B22} | III-5285 | L_{A332} | L_{B32} |
| III-567 | L_{A374} | L_{B4} | III-2140 | L_{A417} | L_{B13} | III-3713 | L_{A460} | L_{B22} | III-5286 | L_{A333} | L_{B32} |
| III-568 | L_{A375} | L_{B4} | III-2141 | L_{A418} | L_{B13} | III-3714 | L_{A461} | L_{B22} | III-5287 | L_{A334} | L_{B32} |
| III-569 | L_{A376} | L_{B4} | III-2142 | L_{A419} | L_{B13} | III-3715 | L_{A462} | L_{B22} | III-5288 | L_{A335} | L_{B32} |
| III-570 | L_{A377} | L_{B4} | III-2143 | L_{A420} | L_{B13} | III-3716 | L_{A463} | L_{B22} | III-5289 | L_{A336} | L_{B32} |
| III-571 | L_{A378} | L_{B4} | III-2144 | L_{A421} | L_{B13} | III-3717 | L_{A464} | L_{B22} | III-5290 | L_{A337} | L_{B32} |
| III-572 | L_{A379} | L_{B4} | III-2145 | L_{A422} | L_{B13} | III-3718 | L_{A465} | L_{B22} | III-5291 | L_{A338} | L_{B32} |
| III-573 | L_{A380} | L_{B4} | III-2146 | L_{A423} | L_{B13} | III-3719 | L_{A466} | L_{B22} | III-5292 | L_{A339} | L_{B32} |
| III-574 | L_{A381} | L_{B4} | III-2147 | L_{A424} | L_{B13} | III-3720 | L_{A467} | L_{B22} | III-5293 | L_{A340} | L_{B32} |
| III-575 | L_{A382} | L_{B4} | III-2148 | L_{A425} | L_{B13} | III-3721 | L_{A468} | L_{B22} | III-5294 | L_{A341} | L_{B32} |
| III-576 | L_{A383} | L_{B4} | III-2149 | L_{A426} | L_{B13} | III-3722 | L_{A469} | L_{B22} | III-5295 | L_{A342} | L_{B32} |
| III-577 | L_{A384} | L_{B4} | III-2150 | L_{A427} | L_{B13} | III-3723 | L_{A470} | L_{B22} | III-5296 | L_{A343} | L_{B32} |
| III-578 | L_{A385} | L_{B4} | III-2151 | L_{A428} | L_{B13} | III-3724 | L_{A471} | L_{B22} | III-5297 | L_{A344} | L_{B32} |
| III-579 | L_{A386} | L_{B4} | III-2152 | L_{A429} | L_{B13} | III-3725 | L_{A472} | L_{B22} | III-5298 | L_{A345} | L_{B32} |
| III-580 | L_{A387} | L_{B4} | III-2153 | L_{A430} | L_{B13} | III-3726 | L_{A473} | L_{B22} | III-5299 | L_{A346} | L_{B32} |
| III-581 | L_{A388} | L_{B4} | III-2154 | L_{A431} | L_{B13} | III-3727 | L_{A474} | L_{B22} | III-5300 | L_{A347} | L_{B32} |
| III-582 | L_{A389} | L_{B4} | III-2155 | L_{A432} | L_{B13} | III-3728 | L_{A475} | L_{B22} | III-5301 | L_{A348} | L_{B32} |
| III-583 | L_{A390} | L_{B4} | III-2156 | L_{A433} | L_{B13} | III-3729 | L_{A476} | L_{B22} | III-5302 | L_{A349} | L_{B32} |
| III-584 | L_{A391} | L_{B4} | III-2157 | L_{A434} | L_{B13} | III-3730 | L_{A477} | L_{B22} | III-5303 | L_{A350} | L_{B32} |
| III-585 | L_{A392} | L_{B4} | III-2158 | L_{A435} | L_{B13} | III-3731 | L_{A478} | L_{B22} | III-5304 | L_{A352} | L_{B32} |
| III-586 | L_{A393} | L_{B4} | III-2159 | L_{A436} | L_{B13} | III-3732 | L_{A479} | L_{B22} | III-5305 | L_{A352} | L_{B32} |
| III-587 | L_{A394} | L_{B4} | III-2160 | L_{A437} | L_{B13} | III-3733 | L_{A480} | L_{B22} | III-5306 | L_{A353} | L_{B32} |
| III-588 | L_{A395} | L_{B4} | III-2161 | L_{A438} | L_{B13} | III-3734 | L_{A481} | L_{B22} | III-5307 | L_{A354} | L_{B32} |
| III-589 | L_{A396} | L_{B4} | III-2162 | L_{A439} | L_{B13} | III-3735 | L_{A482} | L_{B22} | III-5308 | L_{A355} | L_{B32} |
| III-590 | L_{A397} | L_{B4} | III-2163 | L_{A440} | L_{B13} | III-3736 | L_{A483} | L_{B22} | III-5309 | L_{A356} | L_{B32} |
| III-591 | L_{A398} | L_{B4} | III-2164 | L_{A441} | L_{B13} | III-3737 | L_{A484} | L_{B22} | III-5310 | L_{A357} | L_{B32} |
| III-592 | L_{A399} | L_{B4} | III-2165 | L_{A442} | L_{B13} | III-3738 | L_{A485} | L_{B22} | III-5311 | L_{A358} | L_{B32} |
| III-593 | L_{A400} | L_{B4} | III-2166 | L_{A443} | L_{B13} | III-3739 | L_{A486} | L_{B22} | III-5312 | L_{A359} | L_{B32} |
| III-594 | L_{A401} | L_{B4} | III-2167 | L_{A444} | L_{B13} | III-3740 | L_{A487} | L_{B22} | III-5313 | L_{A360} | L_{B32} |
| III-595 | L_{A402} | L_{B4} | III-2168 | L_{A445} | L_{B13} | III-3741 | L_{A318} | L_{B23} | III-5314 | L_{A361} | L_{B32} |
| III-596 | L_{A403} | L_{B4} | III-2169 | L_{A446} | L_{B13} | III-3742 | L_{A319} | L_{B23} | III-5315 | L_{A362} | L_{B32} |
| III597 | L_{A404} | L_{B4} | III-2170 | L_{A447} | L_{B13} | III-3743 | L_{A320} | L_{B23} | III-5316 | L_{A363} | L_{B32} |
| III-598 | L_{A405} | L_{B4} | III-2171 | L_{A448} | L_{B13} | III-3744 | L_{A321} | L_{B23} | III-5317 | L_{A364} | L_{B32} |
| III-599 | L_{A406} | L_{B4} | III-2172 | L_{A449} | L_{B13} | III-3745 | L_{A322} | L_{B23} | III-5318 | L_{A365} | L_{B32} |
| III-600 | L_{A407} | L_{B4} | III-2173 | L_{A450} | L_{B13} | III-3746 | L_{A323} | L_{B23} | III-5319 | L_{A366} | L_{B32} |
| III-601 | L_{A408} | L_{B4} | III-2174 | L_{A451} | L_{B13} | III-3747 | L_{A324} | L_{B23} | III-5320 | L_{A367} | L_{B32} |
| III-602 | L_{A409} | L_{B4} | III-2175 | L_{A452} | L_{B13} | III-3748 | L_{A325} | L_{B23} | III-5321 | L_{A368} | L_{B32} |
| III-603 | L_{A410} | L_{B4} | III-2176 | L_{A453} | L_{B13} | III-3749 | L_{A326} | L_{B23} | III-5322 | L_{A369} | L_{B32} |
| III-604 | L_{A411} | L_{B4} | III-2177 | L_{A454} | L_{B13} | III-3750 | L_{A327} | L_{B23} | III-5323 | L_{A370} | L_{B32} |
| III-605 | L_{A412} | L_{B4} | III-2178 | L_{A455} | L_{B13} | III-3751 | L_{A328} | L_{B23} | III-5324 | L_{A371} | L_{B32} |
| III-606 | L_{A413} | L_{B4} | III-2179 | L_{A456} | L_{B13} | III-3752 | L_{A329} | L_{B23} | III-5325 | L_{A372} | L_{B32} |
| III-607 | L_{A414} | L_{B4} | III-2180 | L_{A457} | L_{B13} | III-3753 | L_{A330} | L_{B23} | III-5326 | L_{A373} | L_{B32} |
| III-608 | L_{A415} | L_{B4} | III-2181 | L_{A458} | L_{B13} | III-3754 | L_{A331} | L_{B23} | III-5327 | L_{A374} | L_{B32} |
| III-609 | L_{A416} | L_{B4} | III-2182 | L_{A459} | L_{B3} | III-3755 | L_{A332} | L₈₂₃ | III-5328 | L_{A375} | L_{B32} |
| III-610 | L_{A417} | L_{B4} | III-2183 | L_{A460} | L_{B13} | III-3756 | L_{A333} | L_{B23} | III-5329 | L_{A376} | L_{B32} |
| III-611 | L_{A418} | L_{B4} | III-2184 | L_{A461} | L_{B13} | III-3757 | L_{A334} | L_{B23} | III-5330 | L_{A377} | L_{B32} |
| III-612 | L_{A419} | L_{B4} | III-2185 | L_{A462} | L_{B13} | III-3758 | L_{A335} | L_{B23} | III-5331 | L_{A378} | L_{B32} |
| III-613 | L_{A420} | L_{B4} | III-2186 | L_{A463} | L_{B13} | III-3759 | L_{A336} | L_{B23} | III-5332 | L_{A379} | L_{B32} |
| III-614 | L_{A421} | L_{B4} | III-2187 | L_{A464} | L_{B13} | III-3760 | L_{A337} | L_{B23} | III-5333 | L_{A380} | L_{B32} |
| III-615 | L_{A422} | L_{B4} | III-2188 | L_{A465} | L_{B13} | III-3761 | L_{A338} | L_{B23} | III-5334 | L_{A381} | L_{B32} |
| III-616 | L_{A423} | L_{B4} | III-2189 | L_{A466} | L_{B13} | III-3762 | L_{A339} | L_{B23} | III**-**5335 | L_{A382} | L_{B32} |
| III-617 | L_{A424} | L_{B4} | III-2190 | L_{A467} | L_{B13} | III-3763 | L_{A340} | L_{B23} | III-5336 | L_{A383} | L_{B32} |
| III-618 | L_{A425} | L_{B4} | III-2191 | L_{A468} | L_{B13} | III-3764 | L_{A341} | L_{B23} | III-5337 | L_{A384} | L_{B32} |
| III-619 | L_{A426} | L_{B4} | III-2192 | L_{A469} | L_{B13} | III-3765 | L_{A342} | L_{B23} | III-5338 | L_{A385} | L_{B32} |
| III-620 | L_{A427} | L_{B4} | III-2193 | L_{A470} | L_{B13} | III-3766 | L_{A343} | L_{B23} | III-5339 | L_{A386} | L_{B32} |
| III-621 | L_{A428} | L_{B4} | III-2194 | L_{A471} | L_{B13} | III-3767 | L_{A344} | L_{B23} | III-5340 | L_{A387} | L_{B32} |
| III-622 | L_{A429} | L_{B4} | III-2195 | L_{A472} | L_{B13} | III-3768 | L_{A345} | L_{B23} | III-5341 | L_{A388} | L_{B32} |
| III-623 | L_{A430} | L_{B4} | III-2196 | L_{A473} | L_{B23} | III-3769 | L_{A346} | L_{B23} | III-5342 | L_{A389} | L_{B32} |
| III-624 | L_{A431} | L_{B4} | III-2197 | L_{A474} | L_{B13} | III-3770 | L_{A347} | L_{B23} | III-5343 | L_{A390} | L_{B32} |
| III-625 | L_{A432} | L_{B4} | III-2198 | L_{A475} | L_{B13} | III-3771 | L_{A348} | L_{B23} | III-5344 | L_{A391} | L_{B32} |
| III-626 | L_{A433} | L_{B4} | III-2199 | L_{A476} | L_{B13} | III-3772 | L_{A349} | L_{B23} | III-5345 | L_{A392} | L_{B32} |
| III-627 | L_{A434} | L_{B4} | III-2200 | L_{A477} | L_{B13} | III-3773 | L_{A350} | L_{B23} | III-5346 | L_{A393} | L_{B32} |
| III-628 | L_{A435} | L_{B4} | III-2201 | L_{A478} | L_{B13} | III-3774 | L_{A351} | L_{B23} | III-5347 | L_{A394} | L_{B32} |
| III-629 | L_{A436} | L_{B4} | III-2202 | L_{A479} | L_{B13} | III-3775 | L_{A352} | L_{B23} | III-5348 | L_{A395} | L_{B32} |
| III-630 | L_{A437} | L_{B4} | III-2203 | L_{A480} | L_{B13} | III-3776 | L_{A353} | L_{B23} | III-5349 | L_{A396} | L_{B32} |
| III-631 | L_{A438} | L_{B4} | III-2204 | L_{A48}1 | L_{B13} | III-3777 | L_{A354} | L_{B23} | III-5350 | L_{A397} | L_{B32} |
| III-632 | L_{A439} | L_{B4} | III-2205 | L_{A482} | L_{B13} | III-3778 | L_{A355} | L_{B23} | III-5351 | L_{A398} | L_{B32} |
| III-633 | L_{A440} | L_{B4} | III-2206 | L_{A483} | L_{B13} | III-3779 | L_{A356} | L_{B23} | III-5352 | L_{A399} | L_{B32} |
| III-634 | L_{A441} | L_{B4} | III-2207 | L_{A484} | L_{B13} | III-3780 | L_{A357} | L_{B23} | III-5353 | L_{A400} | L_{B32} |
| III-635 | L_{A442} | L_{B4} | III-2208 | L_{A485} | L_{B13} | III-3781 | L_{A358} | L_{B23} | III-5354 | L_{A401} | L_{B32} |
| III-636 | L_{A443} | L_{B4} | III-2209 | L_{A486} | L_{B23} | III-3782 | L_{A359} | L_{B23} | III-5355 | L_{A402} | L_{B32} |
| III-637 | L_{A444} | L_{B4} | III-2210 | L_{A487} | L_{B13} | III-3783 | L_{A360} | L_{B23} | III-5356 | L_{A403} | L_{B32} |
| III-638 | L_{A445} | L_{B4} | III-2211 | L_{A318} | L_{B14} | III-3784 | L_{A361} | L_{B23} | III-5357 | L_{A404} | L_{B32} |
| III-639 | L_{A446} | L_{B4} | III-2212 | L_{A319} | L_{B14} | III-3785 | L_{A362} | L_{B23} | III-5358 | L_{A405} | L_{B32} |
| III-640 | L_{A447} | L_{B4} | III-2213 | L_{A320} | L_{B14} | III-3786 | L_{A363} | L_{B23} | III-5359 | L_{A406} | L_{B32} |
| III-641 | L_{A448} | L_{B4} | III-2214 | L_{A321} | L_{B14} | III-3787 | L_{A364} | L_{B23} | III-5360 | L_{A407} | L_{B32} |
| III-642 | L_{A449} | L_{B4} | III-2215 | L_{A322} | L_{B14} | III-3788 | L_{A365} | L_{B23} | III-5361 | L_{A408} | L_{B32} |
| III-643 | L_{A450} | L_{B4} | III-2216 | L_{A323} | L_{B14} | III-3789 | L_{A366} | L_{B23} | III-5362 | L_{A409} | L_{B32} |
| III-644 | L_{A452} | L_{B4} | III-2217 | L_{A324} | L_{B14} | III-3790 | L_{A367} | L_{B23} | III-5363 | L_{A410} | L_{B32} |
| III-645 | L_{A452} | L_{B4} | III-2218 | L_{A325} | L_{B14} | III-3791 | L_{A368} | L_{B23} | III-5364 | L_{A411} | L_{B32} |
| III-646 | L_{A453} | L_{B4} | III-2219 | L_{A326} | L_{B14} | III-3792 | L_{A369} | L_{B23} | III-5365 | L_{A412} | L_{B32} |
| III-647 | L_{A454} | L_{B4} | III-2220 | L_{A327} | L_{B14} | III-3793 | L_{A370} | L_{B23} | III-5366 | L_{A413} | L_{B32} |
| III-648 | L_{A455} | L_{B4} | III-2221 | L_{A328} | L_{B24} | III-3794 | L_{A371} | L_{B23} | III-5367 | L_{A414} | L_{B32} |
| III-649 | L_{A456} | L_{B4} | III-2222 | L_{A329} | L_{B14} | III-3795 | L_{A372} | L_{B23} | III-5368 | L_{A415} | L_{B32} |
| III-650 | L_{A457} | L_{B4} | III-2223 | L_{A330} | L_{B14} | III-3796 | L_{A373} | L_{B23} | III-5369 | L_{A416} | L_{B32} |
| III-651 | L_{A458} | L_{B4} | III-2224 | L_{A331} | L_{B14} | III-3797 | L_{A374} | L_{B23} | III-5370 | L_{A417} | L_{B32} |
| III-652 | L_{A459} | L_{B4} | III-2225 | L_{A332} | L_{B14} | III-3798 | L_{A375} | L_{B23} | III-5371 | L_{A418} | L_{B32} |
| III-653 | L_{A460} | L_{B4} | III-2226 | L_{A333} | L_{B14} | III-3799 | L_{A376} | L_{B23} | III-5372 | L_{A419} | L_{B32} |
| III-654 | L_{A462} | L_{B4} | III-2227 | L_{A334} | L_{B14} | III-3800 | L_{A377} | L_{B23} | III-5373 | L_{A420} | L_{B32} |
| III-655 | L_{A462} | L_{B4} | III-2228 | L_{A335} | L_{B14} | III-3801 | L_{A378} | L_{B23} | III-5374 | L_{A421} | L_{B32} |
| III-656 | L_{A463} | L_{B4} | III-2229 | L_{A336} | L_{B14} | III-3802 | L_{A379} | L_{B23} | III-5375 | L_{A422} | L_{B32} |
| III-657 | L_{A464} | L_{B4} | III-2230 | L_{A337} | L_{B14} | III-3803 | L_{A380} | L_{B23} | III-5376 | L_{A423} | L_{B32} |
| III-658 | L_{A465} | L_{B4} | III-2231 | L_{A338} | L_{B14} | III-3804 | L_{A381} | L_{B23} | III-5377 | L_{A424} | L_{B32} |
| III-659 | L_{A466} | L_{B4} | III-2232 | L_{A339} | L_{B14} | III-3805 | L_{A382} | L_{B23} | III-5378 | L_{A425} | L_{B32} |
| III-660 | L_{A467} | L_{B4} | III-2233 | L_{A340} | L_{B14} | III-3806 | L_{A383} | L_{B23} | III-5379 | L_{A426} | L_{B32} |
| III-661 | L_{A468} | L_{B4} | III-2234 | L_{A341} | L_{B14} | III-3807 | L_{A384} | L_{B23} | III-5380 | L_{A427} | L_{B32} |
| III-662 | L_{A469} | L_{B4} | III-2235 | L_{A342} | L_{B14} | III-3808 | L_{A385} | L_{B23} | III-5381 | L_{A428} | L_{B32} |
| III-663 | L_{A470} | L_{B4} | III-2236 | L_{A343} | L_{B14} | III-3809 | L_{A386} | L_{B23} | III-5382 | L_{A429} | L_{B32} |
| III-664 | L_{A471} | L_{B4} | III-2237 | L_{A344} | L_{B14} | III-3810 | L_{A387} | L_{B23} | III-5383 | L_{A430} | L_{B32} |
| III-665 | L_{A472} | L_{B4} | III-2238 | L_{A345} | L_{B14} | III-3811 | L_{A388} | L_{B23} | III-5384 | L_{A431} | L_{B32} |
| III-666 | L_{A473} | L_{B4} | III-2239 | L_{A346} | L_{B14} | III-3812 | L_{A389} | L_{B23} | III-5385 | L_{A432} | L_{B32} |
| III-667 | L_{A474} | L_{B4} | III-2240 | L_{A347} | L_{B14} | III-3813 | L_{A390} | L_{B23} | III-5386 | L_{A433} | L_{B32} |
| III-668 | L_{A475} | L_{B4} | III-2241 | L_{A348} | L_{B14} | III-3814 | L_{A391} | L_{B23} | III-5387 | L_{A434} | L_{B32} |
| III-669 | L_{A476} | L_{B4} | III-2242 | L_{A349} | L_{B14} | III-3815 | L_{A392} | L_{B23} | III-5388 | L_{A435} | L_{B32} |
| III-670 | L_{A477} | L_{B4} | III-2243 | L_{A350} | L_{B14} | III-3816 | L_{A393} | L_{B23} | III-5389 | L_{A436} | L_{B32} |
| III-671 | L_{A478} | L_{B4} | III-2244 | L_{A351} | L_{B14} | III-3817 | L_{A394} | L_{B23} | III-5390 | L_{A437} | L_{B32} |
| III-672 | L_{A479} | L_{B4} | III-2245 | L_{A352} | L_{B14} | III-3818 | L_{A395} | L_{B23} | III-5391 | L_{A438} | L_{B32} |
| III-673 | L_{A480} | L_{B4} | III-2246 | L_{A353} | L_{B14} | III-3819 | L_{A396} | L_{B23} | III-5392 | L_{A439} | L_{B32} |
| III-674 | L_{A481} | L_{B4} | III-2247 | L_{A354} | L_{B14} | III-3820 | L_{A397} | L_{B23} | III-5393 | L_{A440} | L_{B32} |
| III-675 | L_{A482} | L_{B4} | III-2248 | L_{A355} | L_{B14} | III-3821 | L_{A398} | L_{B23} | III-5394 | L_{A441} | L_{B32} |
| III-676 | L_{A483} | L_{B4} | III-2249 | L_{A356} | L_{B14} | III-3822 | L_{A399} | L_{B23} | III-5395 | L_{A442} | L_{B32} |
| III-677 | L_{A484} | L_{B4} | III-2250 | L_{A357} | L_{B14} | III-3823 | L_{A400} | L_{B23} | III-5396 | L_{A443} | L_{B32} |
| III-678 | L_{A485} | L_{B4} | III-2251 | L_{A358} | L_{B14} | III-3824 | L_{A401} | L_{B23} | III-5397 | L_{A444} | L_{B32} |
| III-679 | L_{A486} | L_{B4} | III-2252 | L_{A359} | L_{B14} | III-3825 | L_{A402} | L_{B23} | III-5398 | L_{A445} | L_{B32} |
| III-680 | L_{A487} | L_{B4} | III-2253 | L_{A360} | L_{B14} | III-3826 | L_{A403} | L_{B23} | III-5399 | L_{A446} | L_{B32} |
| III-681 | L_{A318} | L_{B5} | III-2254 | L_{A361} | L_{B14} | III-3827 | L_{A404} | L_{B23} | III-5400 | L_{A447} | L_{B32} |
| III-682 | L_{A319} | L_{B5} | III-2255 | L_{A362} | L_{B14} | III-3828 | L_{A405} | L_{B23} | III-5401 | L_{A448} | L_{B2} |
| III-683 | L_{A320} | L_{B5} | III-2256 | L_{A363} | L_{B14} | III-3829 | L_{A406} | L_{B23} | III-5402 | L_{A449} | L_{B32} |
| III-684 | L_{A321} | L_{B5} | III-2257 | L_{A364} | L_{B14} | III-3830 | L_{A407} | L_{B23} | III-5403 | L_{A450} | L_{B32} |
| III-685 | L_{A322} | L_{B5} | III-2258 | L_{A365} | L_{B14} | III-3831 | L_{A408} | L_{B23} | III-5404 | L_{A451} | L_{B32} |
| III-686 | L_{A323} | L_{B5} | III-2259 | L_{A366} | L_{B14} | III-3832 | L_{A409} | L_{B23} | III-5405 | L_{A452} | L_{B32} |
| III-687 | L_{A324} | L_{B5} | III-2260 | L_{A367} | L_{B14} | III-3833 | L_{A410} | L_{B23} | III-5406 | L_{A453} | L_{B32} |
| III-688 | L_{A325} | L_{B5} | III-2261 | L_{A368} | L_{B14} | III-3834 | L_{A411} | L_{B23} | III-5407 | L_{A454} | L_{B32} |
| III-689 | L_{A326} | L_{B5} | III-2262 | L_{A369} | L₈₁₄ | III-3835 | L_{A412} | L_{B23} | III-5408 | L_{A455} | L_{B32} |
| III-690 | L_{A327} | L_{B5} | III-2263 | L_{A370} | L_{B24} | III-3836 | L_{A413} | L_{B23} | III-5409 | L_{A456} | L_{B32} |
| III-691 | L_{A328} | L_{B5} | III-2264 | L_{A371} | L_{B14} | III-3837 | L_{A414} | L_{B23} | III-5410 | L_{A457} | L_{B32} |
| III-692 | L_{A329} | L_{B5} | III-2265 | L_{A372} | L_{B14} | III-3838 | L_{A415} | L_{B23} | III-5411 | L_{A458} | L_{B32} |
| III-693 | L_{A330} | L_{B5} | III-2266 | L_{A373} | L_{B14} | III-3839 | L_{A416} | L_{B23} | III-5412 | L_{A459} | L_{B32} |
| III-694 | L_{A331} | L_{B5} | III-2267 | L_{A374} | L_{B14} | III-3840 | L_{A417} | L_{B23} | III-5413 | L_{A460} | L_{B32} |
| III-695 | L_{A332} | L_{B5} | III-2268 | L_{A375} | L_{B14} | III-3841 | L_{A418} | L_{B23} | III-5414 | L_{A461} | L_{B32} |
| III-696 | L_{A333} | L_{B5} | III-2269 | L_{A376} | L_{B14} | III-3842 | L_{A419} | L_{B23} | III-5415 | L_{A462} | L_{B32} |
| III-697 | L_{A334} | L_{B5} | III-2270 | L_{A377} | L_{B14} | III-3843 | L_{A420} | L_{B23} | III-5416 | L_{A463} | L_{B32} |
| III-698 | L_{A335} | L_{B5} | III-2271 | L_{A378} | L_{B14} | III-3844 | L_{A421} | L_{B23} | III-5417 | L_{A464} | L_{B32} |
| III-699 | L_{A336} | L_{B5} | III-2272 | L_{A379} | L_{B14} | III-3845 | L_{A422} | L_{B23} | III-5418 | L_{A465} | L_{B32} |
| III-700 | L_{A337} | L_{B5} | III-2273 | L_{A380} | L_{B14} | III-3846 | L_{A423} | L_{B23} | III-5419 | L_{A466} | L_{B32} |
| III-701 | L_{A338} | L_{B5} | III-2274 | L_{A381} | L_{B14} | III-3847 | L_{A424} | L_{B23} | III-5420 | L_{A467} | L_{B32} |
| III-702 | L_{A339} | L_{B5} | III-2275 | L_{A382} | L_{B14} | III-3848 | L_{A425} | L_{B23} | III-5421 | L_{A468} | L_{B32} |
| III-703 | L_{A340} | L_{B5} | III-2276 | L_{A383} | L_{B14} | III-3849 | L_{A426} | L_{B23} | III-5422 | L_{A469} | L_{B32} |
| III-704 | L_{A341} | L_{B5} | III-2277 | L_{A384} | L_{B14} | III-3850 | L_{A427} | L_{B23} | III-5423 | L_{A470} | L_{B32} |
| III-705 | L_{A342} | L_{B5} | III-2278 | L_{A385} | L_{B14} | III-3851 | L_{A428} | L_{B23} | III-5424 | L_{A471} | L_{B32} |
| III-706 | L_{A343} | L_{B5} | III-2279 | L_{A386} | L_{B14} | III-3852 | L_{A429} | L_{B23} | III-5425 | L_{A472} | L_{B32} |
| III-707 | L_{A344} | L_{B5} | III-2280 | L_{A387} | L_{B14} | III-3853 | L_{A430} | L_{B23} | III-5426 | L_{A473} | L_{B32} |
| III-708 | L_{A345} | L_{B5} | III-2281 | L_{A388} | L_{B14} | III-3854 | L_{A431} | L_{B23} | III-5427 | L_{A474} | L_{B32} |
| III-709 | L_{A346} | L_{B5} | III-2282 | L_{A389} | L_{B14} | III-3855 | L_{A432} | L_{B23} | III-5428 | L_{A475} | L_{B32} |
| III-710 | L_{A347} | L_{B5} | III-2283 | L_{A390} | L_{B14} | III-3856 | L_{A433} | L_{B23} | III-5429 | L_{A476} | L_{B32} |
| III-711 | L_{A348} | L_{B5} | III-2284 | L_{A391} | L_{B14} | III-3857 | L_{A434} | L_{B23} | III-5430 | L_{A477} | L_{B32} |
| III-712 | L_{A349} | L_{B5} | III-2285 | L_{A392} | L_{B14} | III-3858 | L_{A435} | L_{B23} | III-5431 | L_{A478} | L_{B32} |
| III-713 | L_{A350} | L_{B5} | III-2286 | L_{A393} | L_{B14} | III-3859 | L_{A436} | L_{B23} | III-5432 | L_{A479} | L_{B32} |
| III-714 | L_{A351} | L_{B5} | III-2287 | L_{A394} | L_{B14} | III-3860 | L_{A437} | L_{B23} | III-5433 | L_{A480} | L_{B32} |
| III-715 | L_{A352} | L_{B5} | III-2288 | L_{A395} | L_{B14} | III-3861 | L_{A438} | L_{B23} | III-5434 | L_{A481} | L_{B32} |
| III-716 | L_{A353} | L_{B5} | III-2289 | L_{A396} | L_{B14} | III-3862 | L_{A439} | L_{B23} | III-5435 | L_{A482} | L_{B32} |
| III-717 | L_{A354} | L_{B5} | III-2290 | L_{A397} | L_{B14} | III-3863 | L_{A440} | L_{B23} | III-5436 | L_{A483} | L_{B32} |
| III-718 | L_{A355} | L_{B5} | III-2291 | L_{A398} | L_{B14} | III-3864 | L_{A441} | L_{B23} | III-5437 | L_{A484} | L_{B32} |
| III-719 | L_{A356} | L_{B5} | III-2292 | L_{A399} | L_{B14} | III-3865 | L_{A442} | L_{B23} | III-5438 | L_{A485} | L_{B32} |
| III-720 | L_{A357} | L_{B5} | III-2293 | L_{A400} | L_{B14} | III-3866 | L_{A443} | L_{B23} | III-5439 | L_{A486} | L_{B32} |
| III-721 | L_{A358} | L_{B5} | III-2294 | L_{A401} | L_{B14} | III-3867 | L_{A444} | L_{B23} | III-5440 | L_{A487} | L_{B32} |
| III-722 | L_{A359} | L_{B5} | III-2295 | L_{A402} | L_{B14} | III-3868 | L_{A445} | L_{B23} | III-5441 | L_{A318} | L_{B33} |
| III-723 | L_{A360} | L_{B5} | III-2296 | L_{A403} | L_{B14} | III-3869 | L_{A446} | L_{B23} | III-5442 | L_{A319} | L_{B33} |
| III-724 | L_{A361} | L_{B5} | III-2297 | L_{A404} | L_{B14} | III-3870 | L_{A447} | L_{B23} | III-5443 | L_{A320} | L_{B33} |
| III-725 | L_{A362} | L_{B5} | III-2298 | L_{A405} | L_{B14} | III-3871 | L_{A448} | L_{B23} | III-5444 | L_{A321} | L_{B33} |
| III-726 | L_{A363} | L_{B5} | III-2299 | L_{A406} | L_{B14} | III-3872 | L_{A449} | L_{B23} | III-5445 | L_{A322} | L_{B33} |
| III-727 | L_{A364} | L_{B5} | III-2300 | L_{A407} | L_{B14} | III-3873 | L_{A450} | L_{B23} | III-5446 | L_{A323} | L_{B33} |
| III-728 | L_{A365} | L_{B5} | III-2301 | L_{A408} | L_{B14} | III-3874 | L_{A451} | L_{B23} | III-5447 | L_{A324} | L_{B33} |
| III-729 | L_{A366} | L_{B5} | III-2302 | L_{A409} | L_{B14} | III-3875 | L_{A452} | L_{B23} | III-5448 | L_{A325} | L_{B33} |
| III-730 | L_{A367} | L_{B5} | III-2303 | L_{A410} | L_{B14} | III-3876 | L_{A453} | L_{B23} | III-5449 | L_{A326} | L_{B33} |
| III-731 | L_{A368} | L_{B5} | III-2304 | L_{A411} | L_{B14} | III-3877 | L_{A454} | L_{B23} | III-5450 | L_{A327} | L_{B33} |
| III-732 | L_{A369} | L_{B5} | III-2305 | L_{A412} | L_{B14} | III-3878 | L_{A455} | L_{B23} | III-5451 | L_{A328} | L_{B33} |
| III-733 | L_{A370} | L_{B5} | III-2306 | L_{A413} | L_{B14} | III-3879 | L_{A456} | L_{B23} | III-5452 | L_{A329} | L_{B33} |
| III-734 | L_{A371} | L_{B5} | III-2307 | L_{A414} | L_{B14} | III-3880 | L_{A457} | L_{B23} | III-5453 | L_{A330} | L_{B33} |
| III-735 | L_{A372} | L_{B5} | III-2308 | L_{A415} | L_{B14} | III-3881 | L_{A458} | L_{B23} | III-5454 | L_{A332} | L_{B33} |
| III-736 | L_{A373} | L_{B5} | III-2309 | L_{A416} | L_{B14} | III-3882 | L_{A459} | L_{B23} | III-5455 | L_{A332} | L_{B33} |
| III-737 | L_{A374} | L_{B5} | III-2310 | L_{A417} | L_{B14} | III-3883 | L_{A460} | L_{B23} | III-5456 | L_{A333} | L_{B33} |
| III-738 | L_{A375} | L_{B5} | III-2311 | L_{A428} | L_{B14} | III-3884 | L_{A461} | L_{B23} | III-5457 | L_{A334} | L_{B33} |
| III-739 | L_{A376} | L_{B5} | III-2312 | L_{A419} | L_{B14} | III-3885 | L_{A462} | L_{B23} | III-5458 | L_{A335} | L_{B33} |
| III-740 | L_{A377} | L_{B5} | III-2313 | L_{A420} | L_{B14} | III-3886 | L_{A463} | L_{B23} | III-5459 | L_{A336} | L_{B33} |
| III-741 | L_{A378} | L_{B5} | III-2314 | L_{A421} | L_{B14} | III-3887 | L_{A464} | L_{B23} | III-5460 | L_{A337} | L_{B33} |
| III-742 | L_{A379} | L_{B5} | III-2315 | L_{A422} | L_{B14} | III-3888 | L_{A465} | L_{B23} | III-5461 | L_{A338} | L_{B33} |
| III-743 | L_{A380} | L_{B5} | III-2316 | L_{A423} | L_{B14} | III-3889 | L_{A466} | L_{B23} | III-5462 | L_{A339} | L_{B33} |
| III-744 | L_{A381} | L_{B5} | III-2317 | L_{A424} | L_{B14} | III-3890 | L_{A467} | L_{B23} | III-5463 | L_{A340} | L_{B33} |
| III-745 | L_{A382} | L_{B5} | III-2318 | L_{A425} | L_{B14} | III-3891 | L_{A468} | L_{B23} | III-5464 | L_{A341} | L_{B33} |
| III-746 | L_{A383} | L_{B5} | III-2319 | L_{A426} | L_{B14} | III-3892 | L_{A469} | L_{B23} | III-5465 | L_{A342} | L_{B33} |
| III-747 | L_{A384} | L_{B5} | III-2320 | L_{A427} | L_{B14} | III-3893 | L_{A470} | L_{B23} | III-5466 | L_{A343} | L_{B33} |
| III-748 | L_{A385} | L_{B5} | III-2321 | L_{A428} | L_{B14} | III-3894 | L_{A471} | L_{B23} | III-5467 | L_{A344} | L_{B33} |
| III-749 | L_{A386} | L_{B5} | III-2322 | L_{A429} | L_{B14} | III-3895 | L_{A472} | L_{B23} | III-5468 | L_{A345} | L_{B33} |
| III-750 | L_{A387} | L_{B5} | III-2323 | L_{A430} | L_{B14} | III-3896 | L_{A473} | L_{B23} | III-5469 | L_{A346} | L_{B33} |
| III-751 | L_{A388} | L_{B5} | III-2324 | L_{A431} | L_{B14} | III-3897 | L_{A474} | L_{B23} | III-5470 | L_{A347} | L_{B33} |
| III-752 | L_{A389} | L_{B5} | III-2325 | L_{A432} | L_{B14} | III-3898 | L_{A475} | L_{B23} | III-5471 | L_{A348} | L_{B33} |
| III-753 | L_{A390} | L_{B5} | III-2326 | L_{A433} | L_{B14} | III-3899 | L_{A476} | L_{B23} | III-5472 | L_{A349} | L_{B33} |
| III-754 | L_{A391} | L_{B5} | III-2327 | L_{A434} | L_{B14} | III-3900 | L_{A477} | L_{B23} | III-5473 | L_{A350} | L_{B33} |
| III-755 | L_{A392} | L_{B5} | III-2328 | L_{A435} | L_{B14} | III-3901 | L_{A478} | L_{B23} | III-5474 | L_{A351} | L_{B33} |
| III-756 | L_{A393} | L_{B5} | III-2329 | L_{A436} | L_{B14} | III-3902 | L_{A479} | L_{B23} | III-5475 | L_{A352} | L_{B33} |
| III-757 | L_{A394} | L_{B5} | III-2330 | L_{A437} | L_{B14} | III-3903 | L_{A480} | L_{B23} | III-5476 | L_{A353} | L_{B33} |
| III-758 | L_{A395} | L_{B5} | III-2331 | L_{A438} | L_{B14} | III-3904 | L_{A482} | L_{B23} | III-5477 | L_{A354} | L_{B33} |
| III-759 | L_{A396} | L_{B5} | III-2332 | L_{A439} | L_{B14} | III-3905 | L_{A482} | L_{B23} | III-5478 | L_{A355} | L_{B33} |
| III-760 | L_{A397} | L_{B5} | III-2333 | L_{A440} | L_{B14} | III-3906 | L_{A483} | L_{B23} | III-5479 | L_{A356} | L_{B33} |
| III-761 | L_{A398} | L_{B5} | III-2334 | L_{A441} | L_{B14} | III-3907 | L_{A484} | L_{B23} | III-5480 | L_{A357} | L_{B33} |
| III-762 | L_{A399} | L_{B5} | III-2335 | L_{A442} | L_{B14} | III-3908 | L_{A485} | L_{B23} | III-5481 | L_{A358} | L_{B33} |
| III-763 | L_{A400} | L_{B5} | III-2336 | L_{A443} | L_{B14} | III-3909 | L_{A486} | L_{B23} | III-5482 | L_{A359} | L_{B33} |
| III-764 | L_{A401} | L_{B5} | III-2337 | L_{A444} | L_{B14} | III-3910 | L_{A487} | L_{B23} | III-5483 | L_{A360} | L_{B33} |
| III-765 | L_{A402} | L_{BS} | III-2338 | L_{A445} | L_{B14} | III-3911 | L_{A318} | L_{B24} | III-5484 | L_{A361} | L_{B33} |
| III-766 | L_{A403} | L_{B5} | III-2339 | L_{A446} | L_{B14} | III-3912 | L_{A319} | L_{B24} | III-5485 | L_{A362} | L_{B33} |
| III-767 | L_{A404} | L_{B5} | III-2340 | L_{A447} | L_{B14} | III-3913 | L_{A320} | L_{B24} | III-5486 | L_{A363} | L_{B33} |
| III-768 | L_{A405} | L_{B5} | III-2341 | L_{A448} | L_{B14} | III-3914 | L_{A321} | L_{B24} | III-5487 | L_{A364} | L_{B33} |
| III-769 | L_{A406} | L_{B5} | III-2342 | L_{A449} | L_{B14} | III-3915 | L_{A322} | L_{B24} | III-5488 | L_{A365} | L_{B33} |
| III-770 | L_{A407} | L_{B5} | III-2343 | L_{A450} | L_{B14} | III-3916 | L_{A323} | L_{B24} | III-5489 | L_{A366} | L_{B33} |
| III-771 | L_{A408} | L_{B5} | III-2344 | L_{A451} | L_{B14} | III-3917 | L_{A324} | L_{B24} | III-5490 | L_{A367} | L_{B33} |
| III-772 | L_{A409} | L_{B5} | III-2345 | L_{A452} | L_{B14} | III-3918 | L_{A325} | L_{B24} | III-5491 | L_{A368} | L_{B33} |
| III-773 | L_{A410} | L_{B5} | III-2346 | L_{A453} | L_{B14} | III-3919 | L_{A326} | L_{B24} | III-5492 | L_{A369} | L_{B33} |
| III-774 | L_{A411} | L_{B5} | III-2347 | L_{A454} | L_{B14} | III-3920 | L_{A327} | L_{B24} | III-5493 | L_{A370} | L_{B33} |
| III-775 | L_{A412} | L_{B5} | III-2348 | L_{A455} | L_{B14} | III-3921 | L_{A328} | L_{B24} | III-5494 | L_{A371} | L_{B33} |
| III-776 | L_{A413} | L_{B5} | III-2349 | L_{A456} | L_{B14} | III-3922 | L_{A329} | L_{B24} | III-5495 | L_{A372} | L_{B33} |
| III-777 | L_{A414} | L_{B5} | III-2350 | L_{A457} | L_{B14} | III-3923 | L_{A330} | L_{B24} | III-5496 | L_{A373} | L_{B33} |
| III-778 | L_{A415} | L_{B5} | III-2351 | L_{A458} | L_{B14} | III-3924 | L_{A331} | L_{B24} | III-5497 | L_{A374} | L_{B33} |
| III-779 | L_{A416} | L_{B5} | III-2352 | L_{A459} | L_{B24} | III-3925 | L_{A332} | L_{B24} | III-5498 | L_{A375} | L_{B33} |
| III-780 | L_{A417} | L_{B5} | III-2353 | L_{A460} | L_{B14} | III-3926 | L_{A333} | L_{B24} | III-5499 | L_{A376} | L_{B33} |
| III-781 | L_{A418} | L_{B5} | III-2354 | L_{A461} | L_{B14} | III-3927 | L_{A334} | L_{B24} | III-5500 | L_{A377} | L_{B33} |
| III-782 | L_{A419} | L_{B5} | III-2355 | L_{A462} | L_{B14} | III-3928 | L_{A335} | L_{B24} | III-5501 | L_{A378} | L_{B33} |
| III-783 | L_{A420} | L_{B5} | III-2356 | L_{A463} | L_{B14} | III-3929 | L_{A336} | L_{B24} | III-5502 | L_{A379} | L_{B33} |
| III-784 | L_{A421} | L_{B5} | III-2357 | L_{A464} | L_{B14} | III-3930 | L_{A337} | L_{B24} | III-5503 | L_{A380} | L_{B33} |
| III-785 | L_{A422} | L_{B5} | III-2358 | L_{A465} | L_{B14} | III-3931 | L_{A338} | L_{B24} | III-5504 | L_{A381} | L_{B33} |
| III-786 | L_{A423} | L_{B5} | III-2359 | L_{A466} | L_{B14} | III-3932 | L_{A339} | L_{B24} | III-5505 | L_{A382} | L_{B33} |
| III-787 | L_{A424} | L_{B5} | III-2360 | L_{A467} | L_{B14} | III-3933 | L_{A340} | L_{B24} | III-5506 | L_{A383} | L_{B33} |
| III-788 | L_{A425} | L_{B5} | III-2361 | L_{A468} | L_{B14} | III-3934 | L_{A342} | L_{B24} | III-5507 | L_{A384} | L_{B33} |
| III-789 | L_{A426} | L_{B5} | III-2362 | L_{A469} | L_{B14} | III-3935 | L_{A342} | L_{B24} | III-5508 | L_{A385} | L_{B33} |
| III-790 | L_{A427} | L_{B5} | III-2363 | L_{A470} | L_{B14} | III-3936 | L_{A343} | L_{B24} | III-5509 | L_{A386} | L_{B33} |
| III-791 | L_{A428} | L_{B5} | III-2364 | L_{A471} | L_{B14} | III-3937 | L_{A344} | L_{B24} | III-5510 | L_{A387} | L_{B33} |
| III-792 | L_{A429} | L_{B5} | III-2365 | L_{A472} | L_{B14} | III-3938 | L_{A345} | L_{B24} | III-5511 | L_{A388} | L_{B33} |
| III-793 | L_{A430} | L_{B5} | III-2366 | L_{A473} | L_{B14} | III-3939 | L_{A346} | L_{B24} | III-5512 | L_{A389} | L_{B33} |
| III-794 | L_{A431} | L_{B5} | III-2367 | L_{A474} | L_{B14} | III-3940 | L_{A347} | L_{B24} | III-5513 | L_{A390} | L_{B33} |
| III-795 | L_{A432} | L_{B5} | III-2368 | L_{A475} | L_{B14} | III-3941 | L_{A348} | L_{B24} | III-5514 | L_{A391} | L_{B33} |
| III-796 | L_{A433} | L_{B5} | III-2369 | L_{A476} | L_{B24} | III-3942 | L_{A349} | L_{B24} | III-5515 | L_{A392} | L_{B33} |
| III-797 | L_{A434} | L_{B5} | III-2370 | L_{A477} | L_{B14} | III-3943 | L_{A350} | L_{B24} | III-5516 | L_{A393} | L_{B33} |
| III-798 | L_{A435} | L_{B5} | III-2371 | L_{A478} | L_{B14} | III-3944 | L_{A351} | L_{B24} | III-5517 | L_{A394} | L_{B33} |
| III-799 | L_{A436} | L_{B5} | III-2372 | L_{A479} | L_{B14} | III-3945 | L_{A352} | L_{B24} | III-5518 | L_{A395} | L_{B33} |
| III-800 | L_{A437} | L_{B5} | III-2373 | L_{A480} | L_{B14} | III-3946 | L_{A353} | L_{B24} | III-5519 | L_{A396} | L_{B33} |
| III-801 | L_{A438} | L_{B5} | III-2374 | L_{A481} | L_{B14} | III-3947 | L_{A354} | L_{B24} | III-5520 | L_{A397} | L_{B33} |
| III-802 | L_{A439} | L_{B5} | III-2375 | L_{A482} | L_{B14} | III-3948 | L_{A355} | L_{B24} | III-5521 | L_{A398} | L_{B33} |
| III-803 | L_{A440} | L_{B5} | III-2376 | L_{A483} | L_{B14} | III-3949 | L_{A356} | L_{B24} | III-5522 | L_{A399} | L_{B33} |
| III-804 | L_{A441} | L_{B5} | III-2377 | L_{A484} | L_{B14} | III-3950 | L_{A357} | L_{B24} | III-5523 | L_{A400} | L_{B33} |
| III-805 | L_{A442} | L_{B5} | III-2378 | L_{A485} | L_{B14} | III-3951 | L_{A358} | L_{B24} | III-5524 | L_{A401} | L_{B33} |
| III-806 | L_{A443} | L_{B5} | III-2379 | L_{A486} | L_{B14} | III-3952 | L_{A359} | L_{B24} | III-5525 | L_{A402} | L_{B33} |
| III-807 | L_{A444} | L_{B5} | III-2380 | L_{A487} | L_{B14} | III-3953 | L_{A360} | L_{B24} | III-5526 | L_{A403} | L_{B33} |
| III-808 | L_{A445} | L_{B5} | III-2381 | L_{A318} | L_{B15} | III-3954 | L_{A361} | L_{B24} | III-5527 | L_{A404} | L_{B33} |
| III-809 | L_{A446} | L_{B5} | III-2382 | L_{A319} | L_{B15} | III-3955 | L_{A362} | L_{B24} | III-5528 | L_{A405} | L_{B33} |
| III-810 | L_{A447} | L_{B5} | III-2383 | L_{A320} | L_{B15} | III-3956 | L_{A363} | L_{B24} | III-5529 | L_{A406} | L_{B33} |
| III-811 | L_{A448} | L_{B5} | III-2384 | L_{A321} | L_{B15} | III-3957 | L_{A364} | L_{B24} | III-5530 | L_{A407} | L_{B33} |
| III-812 | L_{A449} | L_{B5} | III-2385 | L_{A322} | L_{B15} | III-3958 | L_{A365} | L_{B24} | III-5531 | L_{A408} | L_{B33} |
| III-813 | L_{A450} | L_{B5} | III-2386 | L_{A323} | L_{B15} | III-3959 | L_{A366} | L₈₂₄ | III-5532 | L_{A409} | L_{B33} |
| III-814 | L_{A451} | L_{B5} | III-2387 | L_{A324} | L_{B15} | III-3960 | L_{A367} | L_{B24} | III-5533 | L_{A410} | L_{B33} |
| III-815 | L_{A452} | L_{B5} | III-2388 | L_{A325} | L_{B15} | III-3961 | L_{A368} | L_{B24} | III-5534 | L_{A411} | L_{B33} |
| III-816 | L_{A453} | L_{B5} | III-2389 | L_{A326} | L_{B15} | III-3962 | L_{A369} | L_{B24} | III-5535 | L_{A412} | L_{B33} |
| III-817 | L_{A454} | L_{B5} | III-2390 | L_{A327} | L_{B15} | III-3963 | L_{A370} | L_{B24} | III-5536 | L_{A413} | L_{B33} |
| III-818 | L_{A455} | L_{B5} | III-2391 | L_{A328} | L_{B15} | III-3964 | L_{A371} | L_{B24} | III-5537 | L_{A414} | L_{B33} |
| III-819 | L_{A456} | L_{B5} | III-2392 | L_{A329} | L_{B15} | III-3965 | L_{A372} | L_{B24} | III-5538 | L_{A415} | L_{B33} |
| III-820 | L_{A457} | L_{B5} | III-2393 | L_{A330} | L_{B15} | III-3966 | L_{A373} | L_{B24} | III-5539 | L_{A416} | L_{B33} |
| III-821 | L_{A458} | L_{B5} | III-2394 | L_{A332} | L_{B15} | III-3967 | L_{A374} | L_{B24} | III-5540 | L_{A417} | L_{B33} |
| III-822 | L_{A459} | L_{B5} | III-2395 | L_{A332} | L_{B15} | III-3968 | L_{A375} | L_{B24} | III-5541 | L_{A418} | L_{B33} |
| III-823 | L_{A460} | L_{B5} | III-2396 | L_{A333} | L_{B15} | III-3969 | L_{A376} | L_{B24} | III-5542 | L_{A419} | L_{B33} |
| III-824 | L_{A461} | L_{B5} | III-2397 | L_{A334} | L_{B15} | III-3970 | L_{A377} | L_{B24} | III-5543 | L_{A420} | L_{B33} |
| III-825 | L_{A462} | L_{B5} | III-2398 | L_{A335} | L_{B25} | III-3971 | L_{A378} | L_{B24} | III-5544 | L_{A421} | L_{B33} |
| III-826 | L_{A463} | L_{B5} | III-2399 | L_{A336} | L_{B15} | III-3972 | L_{A379} | L_{B24} | III-5545 | L_{A422} | L_{B33} |
| III-827 | L_{A464} | L_{B5} | III-2400 | L_{A337} | L_{B15} | III-3973 | L_{A380} | L_{B24} | III-5546 | L_{A423} | L_{B33} |
| III-828 | L_{A465} | L_{B5} | III-2401 | L_{A338} | L_{B15} | III-3974 | L_{A381} | L_{B24} | III-5547 | L_{A424} | L_{B33} |
| III-829 | L_{A466} | L_{B5} | III-2402 | L_{A339} | L_{B15} | III-3975 | L_{A382} | L_{B24} | III-5548 | L_{A425} | L_{B33} |
| III-830 | L_{A467} | L_{B5} | III-2403 | L_{A340} | L_{B15} | III-3976 | L_{A383} | L_{B24} | III-5549 | L_{A426} | L_{B33} |
| III-831 | L_{A468} | L_{B5} | III-2404 | L_{A341} | L_{B15} | III-3977 | L_{A384} | L_{B24} | III-5550 | L_{A427} | L_{B33} |
| III-832 | L_{A469} | L_{B5} | III-2405 | L_{A342} | L_{B15} | III-3978 | L_{B85} | L_{B24} | III-5551 | L_{A428} | L_{B33} |
| III-833 | L_{A470} | L_{B5} | III-2406 | L_{A343} | L_{B15} | III-3979 | L_{B86} | L_{B24} | III-5552 | L_{A429} | L_{B33} |
| III-834 | L_{A471} | L_{B5} | III-2407 | L_{A344} | L_{B15} | III-3980 | L_{A387} | L_{B24} | III-5553 | L_{A430} | L_{B33} |
| III-835 | L_{A472} | L_{B5} | III-2408 | L_{A345} | L_{B15} | III-3981 | L_{A388} | L_{B24} | III-5554 | L_{A431} | L_{B33} |
| III-836 | L_{A473} | L_{B5} | III-2409 | L_{A346} | L_{B15} | III-3982 | L_{A389} | L_{B24} | III-5555 | L_{A432} | L_{B33} |
| III-837 | L_{A474} | L_{B5} | III-2410 | L_{A347} | L_{B15} | III-3983 | L_{A390} | L_{B24} | III-5556 | L_{A433} | L_{B33} |
| III-838 | L_{A475} | L_{B5} | III-2411 | L_{A348} | L_{B15} | III-3984 | L_{A391} | L_{B24} | III-5557 | L_{A434} | L_{B33} |
| III-839 | L_{A476} | L_{B5} | III-2412 | L_{A349} | L_{B15} | III-3985 | L_{A392} | L_{B24} | III-5558 | L_{A435} | L_{B33} |
| III-840 | L_{A477} | L_{B5} | III-2413 | L_{A350} | L_{B15} | III-3986 | L_{A393} | L_{B24} | III-5559 | L_{A436} | L_{B33} |
| III-841 | L_{A478} | L_{B5} | III-2414 | L_{A351} | L_{B15} | III-3987 | L_{A394} | L_{B24} | III-5560 | L_{A437} | L_{B33} |
| III-842 | L_{A479} | L_{B5} | III-2415 | L_{A352} | L_{B15} | III-3988 | L_{A395} | L_{B24} | III-5561 | L_{A438} | L_{B33} |
| III-843 | L_{A480} | L_{B5} | III-2416 | L_{A353} | L_{B15} | III-3989 | L_{A396} | L_{B24} | III-5562 | L_{A439} | L_{B33} |
| III-844 | L_{A482} | L_{B5} | III-2417 | L_{A354} | L_{B15} | III-3990 | L_{A397} | L_{B24} | III-5563 | L_{A440} | L_{B33} |
| III-845 | L_{A482} | L_{B5} | III-2418 | L_{A355} | L_{B15} | III-3991 | L_{A398} | L_{B24} | III-5564 | L_{A441} | L_{B33} |
| III-846 | L_{A483} | L_{B5} | III-2419 | L_{A356} | L_{B15} | III-3992 | L_{A399} | L_{B24} | III-5565 | L_{A442} | L_{B33} |
| III-847 | L_{A484} | L_{B5} | III-2420 | L_{A357} | L_{B15} | III-3993 | L_{A400} | L_{B24} | III-5566 | L_{A443} | L_{B33} |
| III-848 | L_{A485} | L_{B5} | III-2421 | L_{A358} | L_{B15} | III-3994 | L_{A401} | L_{B24} | III-5567 | L_{A444} | L_{B33} |
| III-849 | L_{A486} | L_{B5} | III-2422 | L_{A359} | L_{B15} | III-3995 | L_{A402} | L_{B24} | III-5568 | L_{A445} | L_{B33} |
| III-850 | L_{A487} | L_{B5} | III-2423 | L_{A360} | L_{B15} | III-3996 | L_{A403} | L_{B24} | III-5569 | L_{A446} | L_{B33} |
| III-851 | L_{A318} | L_{B6} | III-2424 | L_{A361} | L_{B15} | III-3997 | L_{A404} | L_{B24} | III-5570 | L_{A447} | L_{B33} |
| III-852 | L_{A319} | L_{B6} | III-2425 | L_{A362} | L_{B15} | III-3998 | L_{A405} | L_{B24} | III-5571 | L_{A448} | L_{B33} |
| III-853 | L_{A320} | L_{B6} | III-2426 | L_{A363} | L_{B15} | III-3999 | L_{A406} | L_{B24} | III-5572 | L_{A449} | L_{B33} |
| III-854 | L_{A321} | L_{B6} | III-2427 | L_{A364} | L_{B15} | III-4000 | L_{A407} | L_{B24} | III-5573 | L_{A450} | L_{B33} |
| III-855 | L_{A322} | L_{B6} | III-2428 | L_{A365} | L_{B15} | III-4001 | L_{A408} | L_{B24} | III-5574 | L_{A451} | L_{B33} |
| III-856 | L_{A323} | L_{B6} | III-2429 | L_{A366} | L_{B15} | III-4002 | L_{A409} | L_{B24} | III-5575 | L_{A452} | L_{B33} |
| III-857 | L_{A324} | L_{B6} | III-2430 | L_{A367} | L_{B15} | III-4003 | L_{A410} | L_{B24} | III-5576 | L_{A453} | L_{B33} |
| III-858 | L_{A325} | L_{B6} | III-2431 | L_{A368} | L_{B15} | III-4004 | L_{A411} | L_{B24} | III-5577 | L_{A454} | L_{B33} |
| III-859 | L_{A326} | L_{B6} | III-2432 | L_{A369} | L_{B15} | III-4005 | L_{A412} | L_{B24} | III-5578 | L_{A455} | L_{B33} |
| III-860 | L_{A327} | L_{B6} | III-2433 | L_{A370} | L_{B15} | III-4006 | L_{A413} | L_{B24} | III-5579 | L_{A456} | L_{B33} |
| III-861 | L_{A328} | L_{B6} | III-2434 | L_{A371} | L_{B15} | III-4007 | L_{A414} | L_{B24} | III-5580 | L_{A457} | L_{B33} |
| III-862 | L_{A329} | L_{B6} | III-2435 | L_{A372} | L_{B15} | III-4008 | L_{A415} | L_{B24} | III-5581 | L_{A458} | L_{B33} |
| III-863 | L_{A330} | L_{B6} | III-2436 | L_{A373} | L_{B15} | III-4009 | L_{A416} | L_{B24} | III-5582 | L_{A459} | L_{B33} |
| III-864 | L_{A331} | L_{B6} | III-2437 | L_{A374} | L_{B15} | III-4010 | L_{A417} | L_{B24} | III-5583 | L_{A460} | L_{B33} |
| III-865 | L_{A332} | L_{B6} | III-2438 | L_{A375} | L_{B15} | III-4011 | L_{A418} | L_{B24} | III-5584 | L_{A461} | L_{B33} |
| III-866 | L_{A333} | L_{B6} | III-2439 | L_{A376} | L_{B15} | III-4012 | L_{A419} | L_{B24} | III-5585 | L_{A462} | L_{B33} |
| III-867 | L_{A334} | L_{B6} | III-2440 | L_{A377} | L_{B15} | III-4013 | L_{A420} | L_{B24} | III-5586 | L_{A463} | L_{B33} |
| III-868 | L_{A335} | L_{B6} | III-2441 | L_{A378} | L_{B15} | III-4014 | L_{A421} | L_{B24} | III-5587 | L_{A464} | L_{B33} |
| III-869 | L_{A336} | L_{B6} | III-2442 | L_{A379} | L_{B15} | III-4015 | L_{A422} | L_{B24} | III-5588 | L_{A465} | L_{B33} |
| III-870 | L_{A337} | L_{B6} | III-2443 | L_{A380} | L_{B15} | III-4016 | L_{A423} | L_{B24} | III-5589 | L_{A466} | L_{B33} |
| III-871 | L_{A338} | L_{B6} | III-2444 | L_{A381} | L_{B15} | III-4017 | L_{A424} | L_{B24} | III-5590 | L_{A467} | L_{B33} |
| III-872 | L_{A339} | L_{B6} | III-2445 | L_{A382} | L_{B15} | III-4018 | L_{A425} | L_{B24} | III-5591 | L_{A468} | L_{B33} |
| III-873 | L_{A340} | L_{B6} | III-2446 | L_{A383} | L_{B15} | III-4019 | L_{A426} | L_{B24} | III-5592 | L_{A469} | L_{B33} |
| III-874 | L_{A341} | L_{B6} | III-2447 | L_{A384} | L_{B15} | III-4020 | L_{A427} | L_{B24} | III-5593 | L_{A470} | L_{B33} |
| III-875 | L_{A342} | L_{B6} | III-2448 | L_{A385} | L_{B15} | III-4021 | L_{A428} | L_{B24} | III-5594 | L_{A471} | L_{B33} |
| III-876 | L_{A343} | L_{B6} | III-2449 | L_{A386} | L_{B15} | III-4022 | L_{A429} | L_{B24} | III-5595 | L_{A472} | L_{B33} |
| III-877 | L_{A344} | L_{B6} | III-2450 | L_{A387} | L_{B15} | III-4023 | L_{A430} | L_{B24} | III-5596 | L_{A473} | L_{B33} |
| III-878 | L_{A345} | L_{B6} | III-2451 | L_{A388} | L_{B15} | III-4024 | L_{A431} | L_{B24} | III-5597 | L_{A474} | L_{B33} |
| III-879 | L_{A346} | L_{B6} | III-2452 | L_{A389} | L_{B15} | III-4025 | L_{A432} | L_{B24} | III-5598 | L_{A475} | L_{B33} |
| III-880 | L_{A347} | L_{B6} | III-2453 | L_{A390} | L_{B15} | III-4026 | L_{A433} | L_{B24} | III-5599 | L_{A476} | L_{B33} |
| III-881 | L_{A348} | L_{B6} | III-2454 | L_{A391} | L_{B15} | III-4027 | L_{A434} | L_{B24} | III-5600 | L_{A477} | L_{B33} |
| III-882 | L_{A349} | L_{B6} | III-2455 | L_{A392} | L_{B15} | III-4028 | L_{A435} | L_{B24} | III-5601 | L_{A478} | L_{B33} |
| III-883 | L_{A350} | L_{B6} | III-2456 | L_{A393} | L_{B15} | III-4029 | L_{A436} | L_{B24} | III-5602 | L_{A479} | L_{B33} |
| III-884 | L_{A351} | L_{B6} | III-2457 | L_{A394} | L_{B15} | III-4030 | L_{A437} | L_{B24} | III-5603 | L_{A480} | L_{B33} |
| III-885 | L_{A352} | L_{B6} | III-2458 | L_{A395} | L_{B15} | III-4031 | L_{A438} | L_{B24} | III-5604 | L_{A481} | L_{B33} |
| III-886 | L_{A353} | L_{B6} | III-2459 | L_{A396} | L_{B15} | III-4032 | L_{A439} | L_{B24} | III-5605 | L_{A482} | L_{B33} |
| III-887 | L_{A354} | L_{B6} | III-2460 | L_{A397} | L_{B15} | III-4033 | L_{A440} | L_{B24} | III-5606 | L_{A483} | L_{B33} |
| III-888 | L_{A355} | L_{B6} | III-2461 | L_{A398} | L_{B15} | III-4034 | L_{A441} | L_{B24} | III-5607 | L_{A484} | L_{B33} |
| III-889 | L_{A356} | L_{B6} | III-2462 | L_{A399} | L_{B15} | III-4035 | L_{A442} | L_{B24} | III-5608 | L_{A485} | L_{B33} |
| III-890 | L_{A357} | L_{B6} | III-2463 | L_{A400} | L_{B15} | III-4036 | L_{A443} | L_{B24} | III-5609 | L_{A486} | L_{B33} |
| III-891 | L_{A358} | L_{B6} | III-2464 | L_{A401} | L_{B25} | III-4037 | L_{A444} | L_{B24} | III-5610 | L_{A487} | L_{B33} |
| III-892 | L_{A359} | L_{B6} | III-2465 | L_{A402} | L_{B15} | III-4038 | L_{A445} | L_{B24} | III-5611 | L_{A318} | L_{B34} |
| III-893 | L_{A360} | L_{B6} | III-2466 | L_{A403} | L_{B15} | III-4039 | L_{A446} | L_{B24} | III-5612 | L_{A319} | L_{B34} |
| III-894 | L_{A361} | L_{B6} | III-2467 | L_{A404} | L_{B15} | III-4040 | L_{A447} | L_{B24} | III-5613 | L_{A320} | L_{B34} |
| III-895 | L_{A362} | L_{B6} | III-2468 | L_{A405} | L_{B15} | III-4041 | L_{A448} | L_{B24} | III-5614 | L_{A321} | L_{B34} |
| III-896 | L_{A363} | L_{B6} | III-2469 | L_{A406} | L_{B15} | III-4042 | L_{A449} | L_{B24} | III-5615 | L_{A322} | L_{B34} |
| III-897 | L_{A364} | L_{B6} | III-2470 | L_{A407} | L_{B15} | III-4043 | L_{A450} | L_{B24} | III-5616 | L_{A323} | L_{B34} |
| III-898 | L_{A365} | L_{B6} | III-2471 | L_{A408} | L_{B15} | III-4044 | L_{A452} | L_{B24} | III-5617 | L_{A324} | L_{B34} |
| III-899 | L_{A366} | L_{B6} | III-2472 | L_{A409} | L_{B15} | III-4045 | L_{A452} | L_{B24} | III-5618 | L_{A325} | L_{B34} |
| III-900 | L_{A367} | L_{B6} | III-2473 | L_{A410} | L_{B15} | III-4046 | L_{A453} | L_{B24} | III-5619 | L_{A326} | L_{B34} |
| III-901 | L_{A368} | L_{B6} | III-2474 | L_{A411} | L_{B15} | III-4047 | L_{A454} | L_{B24} | III-5620 | L_{A327} | L_{B34} |
| III-902 | L_{A369} | L_{B6} | III-2475 | L_{A412} | L_{B15} | III-4048 | L_{A455} | L_{B24} | III-5621 | L_{A328} | L_{B34} |
| III-903 | L_{A370} | L_{B6} | III-2476 | L_{A413} | L_{B15} | III-4049 | L_{A456} | L_{B24} | III-5622 | L_{A329} | L_{B34} |
| III-904 | L_{A371} | L_{B6} | III-2477 | L_{A414} | L_{B15} | III-4050 | L_{A457} | L_{B24} | III-5623 | L_{A330} | L_{B34} |
| III-905 | L_{A372} | L_{B6} | III-2478 | L_{A415} | L_{B15} | III-4051 | L_{A458} | L_{B24} | III-5624 | L_{A331} | L_{B34} |
| III-906 | L_{A373} | L_{B6} | III-2479 | L_{A416} | L_{B15} | III-4052 | L_{A459} | L_{B24} | III-5625 | L_{A332} | L_{B34} |
| III-907 | L_{A374} | L_{B6} | III-2480 | L_{A417} | L_{B15} | III-4053 | L_{A460} | L_{B24} | III-5626 | L_{A333} | L_{B34} |
| III-908 | L_{A375} | L_{B6} | III-2481 | L_{A418} | L_{B15} | III-4054 | L_{A461} | L_{B24} | III-5627 | L_{A334} | L_{B34} |
| III-909 | L_{A376} | L_{B6} | III-2482 | L_{A419} | L_{B15} | III-4055 | L_{A462} | L_{B24} | III-5628 | L_{A335} | L_{B34} |
| III-910 | L_{A377} | L_{B6} | III-2483 | L_{A420} | L_{B15} | III-4056 | L_{A463} | L_{B24} | III-5629 | L_{A336} | L_{B34} |
| III-911 | L_{A378} | L_{B6} | III-2484 | L_{A421} | L_{B15} | III-4057 | L_{A464} | L_{B24} | III-5630 | L_{A337} | L_{B34} |
| III-912 | L_{A379} | L_{B6} | III-2485 | L_{A422} | L_{B15} | III-4058 | L_{A465} | L_{B24} | III-5631 | L_{A338} | L_{B34} |
| III-913 | L_{A380} | L_{B6} | III-2486 | L_{A423} | L_{B15} | III-4059 | L_{A466} | L_{B24} | III-5632 | L_{A339} | L_{B34} |
| III-914 | L_{A381} | L_{B6} | III-2487 | L_{A424} | L_{B15} | III-4060 | L_{A467} | L_{B24} | III-5633 | L_{A340} | L_{B34} |
| III-915 | L_{A382} | L_{B6} | III-2488 | L_{A425} | L_{B15} | III-4061 | L_{A468} | L_{B24} | III-5634 | L_{A341} | L_{B34} |
| III-916 | L_{A383} | L_{B6} | III-2489 | L_{A426} | L_{B15} | III-4062 | L_{A469} | L_{B24} | III-5635 | L_{A342} | L_{B34} |
| III-917 | L_{A384} | L_{B6} | III-2490 | L_{A427} | L_{B15} | III-4063 | L_{A470} | L_{B24} | III-5636 | L_{A343} | L_{B34} |
| III-918 | L_{A385} | L_{B6} | III-2491 | L_{A428} | L_{B15} | III-4064 | L_{A471} | L_{B24} | III-5637 | L_{A344} | L₈₃₄ |
| III-919 | L_{A386} | L_{B6} | III-2492 | L_{A429} | L_{B15} | III-4065 | L_{A472} | L_{B24} | III-5638 | L_{A345} | L_{B34} |
| III-920 | L_{A387} | L₈₆ | III-2493 | L_{A430} | L_{B15} | III-4066 | L_{A473} | L_{B24} | III-5639 | L_{A346} | L_{B34} |
| III-921 | L_{A388} | L_{B6} | III-2494 | L_{A431} | L_{B15} | III-4067 | L_{A474} | L_{B24} | III-5640 | L_{A347} | L_{B34} |
| III-922 | L_{A389} | L_{B6} | III-2495 | L_{A432} | L_{B15} | III-4068 | L_{A475} | L_{B24} | III-5641 | L_{A348} | L_{B34} |
| III-923 | L_{A390} | L_{B6} | III-2496 | L_{A433} | L_{B15} | III-4069 | L_{A476} | L_{B24} | III-5642 | L_{A349} | L_{B34} |
| III-924 | L_{A391} | L_{B6} | III-2497 | L_{A434} | L_{B15} | III-4070 | L_{A477} | L_{B24} | III-5643 | L_{A350} | L_{B34} |
| III-925 | L_{A392} | L_{B6} | III-2498 | L_{A435} | L_{B15} | III-4071 | L_{A478} | L_{B24} | III-5644 | L_{A351} | L_{B34} |
| III-926 | L_{A393} | L_{B6} | III-2499 | L_{A436} | L_{B15} | III-4072 | L_{A479} | L_{B24} | III-5645 | L_{A352} | L_{B34} |
| III-927 | L_{A394} | L_{B6} | III-2500 | L_{A437} | L_{B15} | III-4073 | L_{A480} | L_{B24} | III-5646 | L_{A353} | L_{B34} |
| III-928 | L_{A395} | L_{B6} | III-2501 | L_{A438} | L_{B15} | III-4074 | L_{A481} | L_{B24} | III-5647 | L_{A354} | L_{B34} |
| III-929 | L_{A396} | L_{B6} | III-2502 | L_{A439} | L_{B15} | III-4075 | L_{A482} | L_{B24} | III-5648 | L_{A355} | L_{B34} |
| III-930 | L_{A397} | L_{B6} | III-2503 | L_{A440} | L_{B15} | III-4076 | L_{A483} | L_{B24} | III-5649 | L_{A356} | L_{B34} |
| III-931 | L_{A398} | L_{B6} | III-2504 | L_{A441} | L_{B15} | III-4077 | L_{A484} | L_{B24} | III-5650 | L_{A357} | L_{B34} |
| III-932 | L_{A399} | L_{B6} | III-2505 | L_{A442} | L_{B15} | III-4078 | L_{A485} | L_{B24} | III-5651 | L_{A358} | L_{B34} |
| III-933 | L_{A400} | L_{B6} | III-2506 | L_{A443} | L_{B15} | III-4079 | L_{A486} | L_{B24} | III-5652 | L_{A359} | L_{B34} |
| III-934 | L_{A401} | L_{B6} | III-2507 | L_{A444} | L_{B15} | III-4080 | L_{A487} | L_{B24} | III-5653 | L_{A360} | L_{B34} |
| III-935 | L_{A402} | L_{B6} | III-2508 | L_{A445} | L_{B15} | III-4081 | L_{A318} | L_{B25} | III-5654 | L_{A361} | L_{B34} |
| III-936 | L_{A403} | L_{B6} | III-2509 | L_{A446} | L_{B15} | III-4082 | L_{A319} | L_{B25} | III-5655 | L_{A362} | L_{B34} |
| III-937 | L_{A404} | L_{B6} | III-2510 | L_{A447} | L_{B25} | III-4083 | L_{A320} | L_{B25} | III-5656 | L_{A363} | L_{B34} |
| III-938 | L_{A405} | L_{B6} | III-2511 | L_{A448} | L_{B15} | III-4084 | L_{A321} | L_{B25} | III-5657 | L_{A364} | L_{B34} |
| III-939 | L_{A406} | L_{B6} | III-2512 | L_{A449} | L_{B15} | III-4085 | L_{A322} | L_{B25} | III-5658 | L_{A365} | L_{B34} |
| III-940 | L_{A407} | L_{B6} | III-2513 | L_{A450} | L_{B15} | III-4086 | L_{A323} | L_{B25} | III-5659 | L_{A366} | L_{B34} |
| III-941 | L_{A408} | L_{B36} | III-2514 | L_{A451} | L_{B15} | III-4087 | L_{A324} | L_{B25} | III-5660 | L_{A367} | L_{B34} |
| III-942 | L_{A409} | L_{B6} | III-2515 | L_{A452} | L_{B15} | III-4088 | L_{A325} | L_{B25} | III-5661 | L_{A368} | L_{B34} |
| III-943 | L_{A410} | L_{B6} | III-2516 | L_{A453} | L_{B15} | III-4089 | L_{A326} | L_{B25} | III-5662 | L_{A369} | L_{B34} |
| III-944 | L_{A411} | L_{B6} | III-2517 | L_{A454} | L_{B15} | III-4090 | L_{A327} | L_{B25} | III-5663 | L_{A370} | L_{B34} |
| III-945 | L_{A412} | L_{B6} | III-2518 | L_{A455} | L_{B15} | III-4091 | L_{A328} | L_{B25} | III-5664 | L_{A371} | L_{B34} |
| III-946 | L_{A413} | L_{B6} | III-2519 | L_{A456} | L_{B25} | III-4092 | L_{A329} | L_{B25} | III-5665 | L_{A372} | L_{B34} |
| III-947 | L_{A414} | L_{B6} | III-2520 | L_{A457} | L_{B15} | III-4093 | L_{A330} | L_{B25} | III-5666 | L_{A373} | L_{B34} |
| III-948 | L_{A415} | L_{B6} | III-2521 | L_{A458} | L_{B15} | III-4094 | L_{A331} | L_{B25} | III-5667 | L_{A374} | L_{B34} |
| III-949 | L_{A416} | L_{B6} | III-2522 | L_{A459} | L_{B15} | III-4095 | L_{A332} | L_{B25} | III-5668 | L_{A375} | L_{B34} |
| III-950 | L_{A417} | L_{B6} | III-2523 | L_{A460} | L_{B15} | III-4096 | L_{A333} | L_{B25} | III-5669 | L_{A376} | L_{B34} |
| III-951 | L_{A418} | L_{B6} | III-2524 | L_{A461} | L_{B25} | III-4097 | L_{A334} | L_{B25} | III-5670 | L_{A377} | L_{B34} |
| III-952 | L_{A419} | L_{B6} | III-2525 | L_{A462} | L_{B15} | III-4098 | L_{A335} | L_{B25} | III-5671 | L_{A378} | L_{B34} |
| III-953 | L_{A420} | L_{B6} | III-2526 | L_{A463} | L_{B15} | III-4099 | L_{A336} | L_{B25} | III-5672 | L_{A379} | L_{B34} |
| III-954 | L_{A421} | L_{B6} | III-2527 | L_{A464} | L_{B15} | III-4100 | L_{A337} | L_{B25} | III-5673 | L_{A380} | L_{B34} |
| III-955 | L_{A422} | L_{B6} | III-2528 | L_{A465} | L_{B15} | III-4101 | L_{A338} | L_{B25} | III-5674 | L_{A381} | L_{B34} |
| III-956 | L_{A423} | L_{B6} | III-2529 | L_{A466} | L_{B15} | III-4102 | L_{A339} | L_{B25} | III-5675 | L_{A382} | L_{B34} |
| III-957 | L_{A424} | L_{B6} | III-2530 | L_{A467} | L_{B15} | III-4103 | L_{A340} | L_{B25} | III-5676 | L_{A383} | L_{B34} |
| III-958 | L_{A425} | L_{B6} | III-2531 | L_{A468} | L_{B15} | III-4104 | L_{A341} | L_{B25} | III-5677 | L_{A384} | L_{B34} |
| III-959 | L_{A426} | L_{B6} | III-2532 | L_{A469} | L_{B15} | III-4105 | L_{A342} | L_{B25} | III-5678 | L_{A385} | L_{B34} |
| III-960 | L_{A427} | L_{B6} | III-2533 | L_{A470} | L_{B15} | III-4106 | L_{A343} | L_{B25} | III-5679 | L_{A386} | L_{B34} |
| III-961 | L_{A428} | L_{B6} | III-2534 | L_{A471} | L_{B15} | III-4107 | L_{A344} | L_{B25} | III-5680 | L_{A387} | L_{B34} |
| III-962 | L_{A429} | L_{B6} | III-2535 | L_{A472} | L_{B15} | III-4108 | L_{A345} | L_{B25} | III-5681 | L_{A388} | L_{B34} |
| III-963 | L_{A430} | L_{B6} | III-2536 | L_{A473} | L_{B15} | III-4109 | L_{A346} | L_{B25} | III-5682 | L_{A389} | L_{B34} |
| III-964 | L_{A431} | L_{B6} | III-2537 | L_{A474} | L_{B15} | III-4110 | L_{A347} | L_{B25} | III-5683 | L_{A390} | L_{B34} |
| III-965 | L_{A432} | L_{B6} | III-2538 | L_{A475} | L_{B15} | III-4111 | L_{A348} | L_{B25} | III-5684 | L_{A391} | L_{B34} |
| III-966 | L_{A433} | L_{B6} | III-2539 | L_{A476} | L_{B15} | III-4112 | L_{A349} | L_{B25} | III-5685 | L_{A392} | L_{B34} |
| III-967 | L_{A434} | L_{B6} | III-2540 | L_{A477} | L_{B15} | III-4113 | L_{A350} | L_{B25} | III-5686 | L_{A393} | L_{B34} |
| III-968 | L_{A435} | L_{B6} | III-2541 | L_{A478} | L_{B15} | III-4114 | L_{A351} | L_{B25} | III-5687 | L_{A394} | L_{B34} |
| III-969 | L_{A436} | L_{B6} | III-2542 | L_{A479} | L_{B15} | III-4115 | L_{A352} | L_{B25} | III-5688 | L_{A395} | L_{B34} |
| III-970 | L_{A437} | L_{B6} | III-2543 | L_{A480} | L_{B15} | III-4116 | L_{A353} | L_{B25} | III-5689 | L_{A396} | L_{B34} |
| III-971 | L_{A438} | L_{B6} | III-2544 | L_{A481} | L_{B15} | III-4117 | L_{A354} | L_{B25} | III-5690 | L_{A397} | L_{B34} |
| III-972 | L_{A439} | L_{B6} | III-2545 | L_{A482} | L_{B15} | III-4118 | L_{A355} | L_{B25} | III-5691 | L_{A398} | L_{B34} |
| III-973 | L_{A440} | L_{B6} | III-2546 | L_{A483} | L_{B15} | III-4119 | L_{A356} | L_{B25} | III-5692 | L_{A399} | L_{B34} |
| III-974 | L_{A441} | L_{B6} | III-2547 | L_{A484} | L_{B15} | III-4120 | L_{A357} | L_{B25} | III-5693 | L_{A400} | L_{B34} |
| III-975 | L_{A442} | L_{B6} | III-2548 | L_{A485} | L_{B15} | III-4121 | L_{A358} | L_{B25} | III-5694 | L_{A401} | L_{B34} |
| III-976 | L_{A443} | L_{B6} | III-2549 | L_{A486} | L_{B15} | III-4122 | L_{A359} | L_{B25} | III-5695 | L_{A402} | L_{B34} |
| III-977 | L_{A444} | L_{B6} | III-2550 | L_{A487} | L_{B15} | III-4123 | L_{A360} | L_{B25} | III-5696 | L_{A403} | L_{B34} |
| III-978 | L_{A445} | L_{B6} | III-2551 | L_{A318} | L_{B16} | III-4124 | L_{A361} | L_{B25} | III-5697 | L_{A404} | L_{B34} |
| III-979 | L_{A446} | L_{B6} | III-2552 | L_{A319} | L_{B16} | III-4125 | L_{A362} | L_{B25} | III-5698 | L_{A405} | L_{B34} |
| III-980 | L_{A447} | L_{B6} | III-2553 | L_{A320} | L_{B16} | III-4126 | L_{A363} | L_{B25} | III-5699 | L_{A406} | L_{B34} |
| III-981 | L_{A448} | L_{B6} | III-2554 | L_{A321} | L_{B16} | III-4127 | L_{A364} | L_{B25} | III-5700 | L_{A407} | L_{B34} |
| III-982 | L_{A449} | L_{B6} | III-2555 | L_{A322} | L_{B16} | III-4128 | L_{A365} | L_{B25} | III-5701 | L_{A408} | L_{B34} |
| III-983 | L_{A450} | L_{B6} | III-2556 | L_{A323} | L_{B6} | III-4129 | L_{A366} | L_{B25} | III-5702 | L_{A409} | L_{B34} |
| III-984 | L_{A451} | L_{B6} | III-2557 | L_{A324} | L_{B26} | III-4130 | L_{A367} | L_{B25} | III-5703 | L_{A410} | L_{B34} |
| III-985 | L_{A452} | L_{B6} | III-2558 | L_{A325} | L_{B16} | III-4131 | L_{A368} | L_{B25} | III-5704 | L_{A411} | L_{B34} |
| III-986 | L_{A453} | L_{B6} | III-2559 | L_{A326} | L_{B6} | III-4132 | L_{A369} | L_{B25} | III-5705 | L_{A412} | L_{B34} |
| III-987 | L_{A454} | L_{B6} | III-2560 | L_{A327} | L_{B26} | III-4133 | L_{A370} | L_{B25} | III-5706 | L_{A413} | L_{B34} |
| III-988 | L_{A455} | L_{B6} | III-2561 | L_{A328} | L_{B16} | III-4134 | L_{A371} | L_{B25} | III-5707 | L_{A414} | L_{B34} |
| III-989 | L_{A456} | L_{B6} | III-2562 | L_{A329} | L_{B16} | III-4135 | L_{A372} | L_{B25} | III-5708 | L_{A415} | L_{B34} |
| III-990 | L_{A457} | L_{B6} | III-2563 | L_{A330} | L_{B16} | III-4136 | L_{A373} | L_{B25} | III-5709 | L_{A416} | L_{B34} |
| III-991 | L_{A458} | L_{B6} | III-2564 | L_{A331} | L_{B16} | III-4137 | L_{A374} | L_{B25} | III-5710 | L_{A417} | L_{B34} |
| III-992 | L_{A459} | L_{B6} | III-2565 | L_{A332} | L_{B16} | III-4138 | L_{A375} | L_{B25} | III-5711 | L_{A418} | L_{B34} |
| III-993 | L_{A460} | L_{B6} | III-2566 | L_{A333} | L_{B16} | III-4139 | L_{A376} | L_{B25} | III-5712 | L_{A419} | L_{B34} |
| III-994 | L_{A461} | L_{B6} | III-2567 | L_{A334} | L_{B16} | III-4140 | L_{A377} | L_{B25} | III-5713 | L_{A420} | L_{B34} |
| III-995 | L_{A462} | L_{B6} | III-2568 | L_{A335} | L_{B16} | III-4141 | L_{A378} | L_{B25} | III-5714 | L_{A421} | L_{B34} |
| III-996 | L_{A463} | L_{B6} | III-2569 | L_{A336} | L_{B16} | III-4142 | L_{A379} | L_{B25} | III-5715 | L_{A422} | L_{B34} |
| III-997 | L_{A464} | L_{B6} | III-2570 | L_{A337} | L_{B26} | III-4143 | L_{A380} | L_{B25} | III-5716 | L_{A423} | L_{B34} |
| III-998 | L_{A465} | L_{B6} | III-2571 | L_{A338} | L_{B16} | III-4144 | L_{A381} | L_{B25} | III-5717 | L_{A424} | L_{B34} |
| III-999 | L_{A466} | L_{B6} | III-2572 | L_{A339} | L_{B16} | III-4145 | L_{A382} | L_{B25} | III-5718 | L_{A425} | L_{B34} |
| III-1000 | L_{A467} | L_{B6} | III-2573 | L_{A340} | L_{B16} | III-4146 | L_{A383} | L_{B25} | III-5719 | L_{A426} | L_{B34} |
| III-1001 | L_{A468} | L_{B6} | III-2574 | L_{A341} | L_{B16} | III-4147 | L_{A384} | L_{B25} | III-5720 | L_{A427} | L_{B34} |
| III-1002 | L_{A469} | L_{B6} | III-2575 | L_{A342} | L_{B16} | III-4148 | L_{A385} | L_{B25} | III-5721 | L_{A428} | L_{B34} |
| III-1003 | L_{A470} | L_{B6} | III-2576 | L_{A343} | L_{B16} | III-4149 | L_{A386} | L_{B25} | III-5722 | L_{A429} | L_{B34} |
| III-1004 | L_{A471} | L_{B6} | III-2577 | L_{A344} | L_{B16} | III-4150 | L_{A387} | L_{B25} | III-5723 | L_{A430} | L_{B34} |
| III-1005 | L_{A472} | L_{B6} | III-2578 | L_{A345} | L_{B16} | III-4151 | L_{A388} | L_{B25} | III-5724 | L_{A431} | L_{B34} |
| III-1006 | L_{A473} | L_{B6} | III-2579 | L_{A346} | L_{B26} | III-4152 | L_{A389} | L_{B25} | III-5725 | L_{A432} | L_{B34} |
| III-1007 | L_{A474} | L_{B6} | III-2580 | L_{A347} | L_{B16} | III-4153 | L_{A390} | L_{B25} | III-5726 | L_{A433} | L_{B34} |
| III-1008 | L_{A475} | L_{B6} | III-2581 | L_{A348} | L_{B16} | III-4154 | L_{A391} | L_{B25} | III-5727 | L_{A434} | L_{B34} |
| III-1009 | L_{A476} | L_{B6} | III-2582 | L_{A349} | L_{B16} | III-4155 | L_{A392} | L_{B25} | III-5728 | L_{A435} | L_{B34} |
| III-1010 | L_{A477} | L_{B6} | III-2583 | L_{A350} | L_{B16} | III-4156 | L_{A393} | L_{B25} | III-5729 | L_{A436} | L_{B34} |
| III-1011 | L_{A478} | L_{B6} | III-2584 | L_{A351} | L_{B16} | III-4157 | L_{A394} | L_{B25} | III-5730 | L_{A437} | L_{B34} |
| III-1012 | L_{A479} | L_{B6} | III-2585 | L_{A352} | L_{B16} | III-4158 | L_{A395} | L_{B25} | III-5731 | L_{A438} | L_{B34} |
| III-1013 | L_{A480} | L_{B6} | III-2586 | L_{A353} | L_{B16} | III-4159 | L_{A396} | L_{B25} | III-5732 | L_{A439} | L_{B34} |
| III-1014 | L_{A481} | L_{B6} | III-2587 | L_{A354} | L_{B16} | III-4160 | L_{A397} | L_{B25} | III-5733 | L_{A440} | L_{B34} |
| III-1015 | L_{A482} | L_{B6} | III-2588 | L_{A355} | L_{B6} | III-4161 | L_{A398} | L_{B25} | III-5734 | L_{A441} | L_{B34} |
| III-1016 | L_{A483} | L_{B6} | III-2589 | L_{A356} | L_{B16} | III-4162 | L_{A399} | L_{B25} | III-5735 | L_{A442} | L_{B34} |
| III-1017 | L_{A484} | L_{B6} | III-2590 | L_{A357} | L_{B16} | III-4163 | L_{A400} | L_{B25} | III-5736 | L_{A443} | L_{B34} |
| III-1018 | L_{A485} | L_{B6} | III-2591 | L_{A358} | L_{B16} | III-4164 | L_{A401} | L_{B25} | III-5737 | L_{A444} | L_{B34} |
| III-1019 | L_{A486} | L_{B6} | III-2592 | L_{A359} | L_{B16} | III-4165 | L_{A402} | L_{B25} | III-5738 | L_{A445} | L_{B34} |
| III-1020 | L_{A487} | L_{B6} | III-2593 | L_{A360} | L_{B16} | III-4166 | L_{A403} | L_{B25} | III-5739 | L_{A446} | L_{B34} |
| III-1021 | L_{A318} | L₈₇ | III-2594 | L_{A361} | L_{B16} | III-4167 | L_{A404} | L_{B25} | III-5740 | L_{A447} | L_{B34} |
| III-1022 | L_{A319} | L_{B7} | III-2595 | L_{A362} | L_{B16} | III-4168 | L_{A405} | L_{B25} | III-5741 | L_{A448} | L_{B34} |
| III-1023 | L_{A320} | L_{B7} | III-2596 | L_{A363} | L_{B16} | III-4169 | L_{A406} | L_{B25} | III-5742 | L_{A449} | L_{B34} |
| III-1024 | L_{A321} | L_{B7} | III-2597 | L_{A364} | L_{B16} | III-4170 | L_{A407} | L_{B25} | III-5743 | L_{A450} | L_{B34} |
| III-1025 | L_{A322} | L_{B7} | III-2598 | L_{A365} | L_{B16} | III-4171 | L_{A408} | L_{B25} | III-5744 | L_{A451} | L_{B34} |
| III-1026 | L_{A323} | L_{B7} | III-2599 | L_{A366} | L_{B16} | III-4172 | L_{A409} | L_{B25} | III-5745 | L_{A452} | L_{B34} |
| III-1027 | L_{A324} | L_{B7} | III-2600 | L_{A367} | L_{B16} | III-4173 | L_{A410} | L_{B25} | III-5746 | L_{A453} | L_{B34} |
| III-1028 | L_{A325} | L_{B7} | III-2601 | L_{A368} | L_{B16} | III-4174 | L_{A411} | L_{B25} | III-5747 | L_{A454} | L_{B34} |
| III-1029 | L_{A326} | L_{B7} | III-2602 | L_{A369} | L_{B16} | III-4175 | L_{A412} | L_{B25} | III-5748 | L_{A455} | L_{B34} |
| III-1030 | L_{A327} | L_{B7} | III-2603 | L_{A370} | L_{B16} | III-4176 | L_{A413} | L_{B25} | III-5749 | L_{A456} | L_{B34} |
| III-1031 | L_{A328} | L_{B7} | III-2604 | L_{A371} | L_{B16} | III-4177 | L_{A414} | L_{B25} | III-5750 | L_{A457} | L_{B34} |
| III-1032 | L_{A329} | L_{B7} | III-2605 | L_{A372} | L_{B16} | III-4178 | L_{A415} | L_{B25} | III-5751 | L_{A458} | L_{B34} |
| III-1033 | L_{A330} | L_{B7} | III-2606 | L_{A373} | L_{B16} | III-4179 | L_{A416} | L_{B25} | III-5752 | L_{A459} | L_{B34} |
| III-1034 | L_{A331} | L_{B7} | III-2607 | L_{A374} | L_{B16} | III-4180 | L_{A417} | L_{B25} | III-5753 | L_{A460} | L_{B34} |
| III-1035 | L_{A332} | L_{B7} | III-2608 | L_{A375} | L_{B16} | III-4181 | L_{A418} | L_{B25} | III-5754 | L_{A461} | L_{B34} |
| III-1036 | L_{A333} | L_{B7} | III-2609 | L_{A376} | L_{B16} | III-4182 | L_{A419} | L_{B25} | III-5755 | L_{A462} | L_{B34} |
| III-1037 | L_{A334} | L_{B7} | III-2610 | L_{A377} | L_{B16} | III-4183 | L_{A420} | L_{B25} | III-5756 | L_{A463} | L_{B34} |
| III-1038 | L_{A335} | L_{B7} | III-2611 | L_{A378} | L_{B16} | III-4184 | L_{A422} | L_{B25} | III-5757 | L_{A464} | L_{B34} |
| III-1039 | L_{A336} | L_{B7} | III-2612 | L_{A379} | L_{B16} | III-4185 | L_{A422} | L_{B25} | III-5758 | L_{A465} | L_{B34} |
| III-1040 | L_{A337} | L_{B7} | III-2613 | L_{A380} | L_{B16} | III-4186 | L_{A423} | L_{B25} | III-5759 | L_{A466} | L_{B34} |
| III-1041 | L_{A338} | L_{B7} | III-2614 | L_{A381} | L_{B16} | III-4187 | L_{A424} | L_{B25} | III-5760 | L_{A467} | L_{B34} |
| III-1042 | L_{A339} | L_{B7} | III-2615 | L_{A382} | L_{B16} | III-4188 | L_{A425} | L_{B25} | III-5761 | L_{A468} | L_{B34} |
| III-1043 | L_{A340} | L_{B7} | III-2616 | L_{A383} | L_{B16} | III-4189 | L_{A426} | L_{B25} | III-5762 | L_{A469} | L_{B34} |
| III-1044 | L_{A341} | L_{B7} | III-2617 | L_{A384} | L_{B16} | III-4190 | L_{A427} | L_{B25} | III-5763 | L_{A470} | L_{B34} |
| III-1045 | L_{A342} | L_{B7} | III-2618 | L_{A385} | L_{B16} | III-4191 | L_{A428} | L_{B25} | III-5764 | L_{A471} | L_{B34} |
| III-1046 | L_{A343} | L_{B7} | III-2619 | L_{A386} | L_{B16} | III-4192 | L_{A429} | L_{B25} | III-5765 | L_{A472} | L_{B34} |
| III-1047 | L_{A344} | L_{B7} | III-2620 | L_{A387} | L_{B16} | III-4193 | L_{A430} | L_{B25} | III-5766 | L_{A473} | L_{B34} |
| III-1048 | L_{A345} | L_{B7} | III-2621 | L_{A388} | L_{B16} | III-4194 | L_{A431} | L_{B25} | III-5767 | L_{A474} | L_{B34} |
| III-1049 | L_{A346} | L_{B7} | III-2622 | L_{A389} | L_{B16} | III-4195 | L_{A432} | L_{B25} | III-5768 | L_{A475} | L_{B34} |
| III-1050 | L_{A347} | L_{B7} | III-2623 | L_{A390} | L_{B16} | III-4196 | L_{A433} | L_{B25} | III-5769 | L_{A476} | L_{B34} |
| III-1051 | L_{A348} | L_{B7} | III-2624 | L_{A391} | L_{B16} | III-4197 | L_{A434} | L_{B25} | III-5770 | L_{A477} | L_{B34} |
| III-1052 | L_{A349} | L_{B7} | III-2625 | L_{A392} | L_{B16} | III-4198 | L_{A435} | L_{B25} | III-5771 | L_{A478} | L_{B34} |
| III-1053 | L_{A350} | L_{B7} | III-2626 | L_{A393} | L_{B16} | III-4199 | L_{A436} | L_{B25} | III-5772 | L_{A479} | L_{B34} |
| III-1054 | L_{A351} | L_{B7} | III-2627 | L_{A394} | L_{B16} | III-4200 | L_{A437} | L_{B25} | III-5773 | L_{A480} | L_{B34} |
| III-1055 | L_{A352} | L_{B7} | III-2628 | L_{A395} | L_{B16} | III-4201 | L_{A438} | L_{B25} | III-5774 | L_{A481} | L_{B34} |
| III-1056 | _{LA353} | L_{B7} | III-2629 | L_{A396} | L_{B16} | III-4202 | L_{A439} | L_{B25} | III-5775 | L_{A482} | L_{B34} |
| III-1057 | L_{A354} | L_{B7} | III-2630 | L_{A397} | L_{B16} | III-4203 | L_{A440} | L_{B25} | III-5776 | L_{A483} | L_{B34} |
| III-1058 | L_{A355} | L_{B7} | III-2631 | L_{A398} | L_{B16} | III-4204 | L_{A441} | L_{B25} | III-5777 | L_{A484} | L_{B34} |
| III-1059 | L_{A356} | L_{B7} | III-2632 | L_{A399} | L_{B16} | III-4205 | L_{A442} | L_{B25} | III-5778 | L_{A485} | L_{B34} |
| III-1060 | L_{A357} | L_{B7} | III-2633 | L_{A400} | L_{B16} | III-4206 | L_{A443} | L_{B25} | III-5779 | L_{A486} | L_{B34} |
| III-1061 | L_{A358} | L_{B7} | III-2634 | L_{A401} | L_{B16} | III-4207 | L_{A444} | L_{B25} | III-5780 | L_{A487} | L_{B34} |
| III-1062 | L_{A359} | L_{B7} | III-2635 | L_{A402} | L_{B16} | III-4208 | L_{A445} | L_{B25} | III-5781 | L_{A318} | L_{B35} |
| III-1063 | L_{A360} | L_{B7} | III-2636 | L_{A403} | L_{B16} | III-4209 | L_{A446} | L_{B25} | III-5782 | L_{A319} | L_{B35} |
| III-1064 | L_{A361} | L_{B7} | III-2637 | L_{A404} | L_{B16} | III-4210 | L_{A447} | L_{B25} | III-5783 | L_{A320} | L_{B35} |
| III-1065 | L_{A362} | L_{B7} | III-2638 | L_{A405} | L_{B16} | III-4211 | L_{A448} | L_{B25} | III-5784 | L_{A321} | L_{B35} |
| III-1066 | L_{A363} | L_{B7} | III-2639 | L_{A406} | L_{B16} | III-4212 | L_{A449} | L_{B25} | III-5785 | L_{A322} | L_{B35} |
| III-1067 | L_{A364} | L_{B7} | III-2640 | L_{A407} | L_{B16} | III-4213 | L_{A450} | L_{B25} | III-5786 | L_{A323} | L_{B35} |
| III-1068 | L_{A365} | L_{B7} | III-2641 | L_{A408} | L_{B16} | III-4214 | L_{A451} | L_{B25} | III-5787 | L_{A324} | L_{B35} |
| III-1069 | L_{A366} | L_{B7} | III-2642 | L_{A409} | L_{B16} | III-4215 | L_{A452} | L_{B25} | III-5788 | L_{A325} | L_{B35} |
| III-1070 | L_{A367} | L_{B7} | III-2643 | L_{A410} | L_{B16} | III-4216 | L_{A453} | L_{B25} | III-5789 | L_{A326} | L_{B35} |
| III-1071 | L_{A368} | L_{B7} | III-2644 | L_{A411} | L_{B16} | III-4217 | L_{A454} | L_{B25} | III-5790 | L_{A327} | L_{B35} |
| III-1072 | L_{A369} | L_{B7} | III-2645 | L_{A412} | L_{B16} | III-4218 | L_{A455} | L_{B25} | III-5791 | L_{A328} | L_{B35} |
| III-1073 | L_{A370} | L_{B7} | III-2646 | L_{A413} | L_{B16} | III-4219 | L_{A456} | L_{B25} | III-5792 | L_{A329} | L_{B35} |
| III-1074 | L_{A371} | L_{B7} | III-2647 | L_{A414} | L_{B16} | III-4220 | L_{A457} | L_{B25} | III-5793 | L_{A330} | L_{B35} |
| III-1075 | L_{A372} | L_{B7} | III-2648 | L_{A415} | L_{B16} | III-4221 | L_{A458} | L_{B25} | III-5794 | L_{A331} | L_{B35} |
| III-1076 | L_{A373} | L_{B7} | III-2649 | L_{A416} | L_{B16} | III-4222 | L_{A459} | L_{B25} | III-5795 | L_{A332} | L_{B35} |
| III-1077 | L_{A374} | L_{B7} | III-2650 | L_{A417} | L_{B16} | III-4223 | L_{A460} | L_{B25} | III-5796 | L_{A333} | L_{B35} |
| III-1078 | L_{A375} | L_{B7} | III-2651 | L_{A418} | L_{B16} | III-4224 | L_{A461} | L_{B25} | III-5797 | L_{A334} | L_{B35} |
| III-1079 | L_{A376} | L_{B7} | III-2652 | L_{A419} | L_{B16} | III-4225 | L_{A462} | L_{B25} | III-5798 | L_{A335} | L_{B35} |
| III-1080 | L_{A377} | L_{B7} | III-2653 | L_{A420} | L_{B16} | III-4226 | L_{A463} | L_{B25} | III-5799 | L_{A336} | L_{B35} |
| III-1081 | L_{A378} | L_{B7} | III-2654 | L_{A421} | L_{B16} | III-4227 | L_{A464} | L_{B25} | III-5800 | L_{A337} | L_{B35} |
| III-1082 | L_{A379} | L_{B7} | III-2655 | L_{A422} | L_{B16} | III-4228 | L_{A465} | L_{B25} | III-5801 | L_{A338} | L_{B35} |
| III-1083 | L_{A380} | L_{B7} | III-2656 | L_{A423} | L_{B16} | III-4229 | L_{A466} | L_{B25} | III-5802 | L_{A3A9} | L_{B35} |
| III-1084 | L_{A381} | L_{B7} | III-2657 | L_{A424} | L_{B16} | III-4230 | L_{A467} | L_{B25} | III-5803 | L_{A340} | L_{B35} |
| III-1085 | L_{A382} | L_{B7} | III-2658 | L_{A425} | L_{B16} | III-4231 | L_{A468} | L_{B25} | III-5804 | L_{A341} | L_{B35} |
| III-1086 | L_{A383} | L_{B7} | III-2659 | L_{A426} | L_{B16} | III-4232 | L_{A469} | L_{B25} | III-5805 | L_{A342} | L_{B35} |
| III-1087 | L_{A384} | L_{B7} | III-2660 | L_{A427} | L_{B16} | III-4233 | L_{A470} | L_{B25} | III-5806 | L_{A343} | L_{B35} |
| III-1088 | L_{A385} | L_{B7} | III-2661 | L_{A428} | L_{B16} | III-4234 | L_{A471} | L_{B25} | III-5807 | L_{A344} | L_{B35} |
| III-1089 | L_{A386} | L_{B7} | III-2662 | L_{A429} | L_{B16} | III-4235 | L_{A472} | L_{B25} | III-5808 | L_{A345} | L_{B35} |
| III-1090 | L_{A387} | L_{B7} | III-2663 | L_{A430} | L_{B16} | III-4236 | L_{A473} | L_{B25} | III-5809 | L_{A346} | L_{B35} |
| III-1091 | L_{A388} | L_{B7} | III-2664 | L_{A431} | L_{B16} | III-4237 | L_{A474} | L_{B25} | III-5810 | L_{A347} | L_{B35} |
| III-1092 | L_{A389} | L_{B7} | III-2665 | L_{A432} | L_{B16} | III-4238 | L_{A475} | L_{B25} | III-5811 | L_{A348} | L_{B35} |
| III-1093 | L_{A390} | L_{B7} | III-2666 | L_{A433} | L_{B16} | III-4239 | L_{A476} | L_{B25} | III-5812 | L_{A349} | L_{B35} |
| III-1094 | L_{A391} | L_{B7} | III-2667 | L_{A434} | L₈₁₆ | III-4240 | L_{A477} | L_{B25} | III-5813 | L_{A350} | L_{B35} |
| III-1095 | L_{A392} | L_{B7} | III-2668 | L_{A435} | L_{B16} | III-4241 | L_{A478} | L_{B25} | III-5814 | L_{A351} | L_{B35} |
| III-1096 | L_{A393} | L_{B7} | III-2669 | L_{A436} | L_{B16} | III-4242 | L_{A479} | L_{B25} | III-5815 | L_{A352} | L_{B35} |
| III-1097 | L_{A394} | L_{B7} | III-2670 | L_{A437} | L_{B16} | III-4243 | L_{A480} | L_{B25} | III-5816 | L_{A353} | L_{B35} |
| III-1098 | L_{A395} | L_{B7} | III-2671 | L_{A438} | L_{B16} | III-4244 | L_{A481} | L_{B25} | III-5817 | L_{A354} | L_{B35} |
| III-1099 | L_{A396} | L_{B7} | III-2672 | L_{A439} | L_{B16} | III-4245 | L_{A482} | L_{B25} | III-5818 | L_{A355} | L_{B35} |
| III-1100 | L_{A397} | L_{B7} | III-2673 | L_{A440} | L_{B16} | III-4246 | L_{A483} | L_{B25} | III-5819 | L_{A336} | L_{B35} |
| III-1101 | L_{A398} | L_{B7} | III-2674 | L_{A441} | L_{B16} | III-4247 | L_{A484} | L_{B25} | III-5820 | L_{A357} | L_{B35} |
| III-1102 | L_{A399} | L_{B7} | III-2675 | L_{A442} | L_{B16} | III-4248 | L_{A485} | L_{B25} | III-5821 | L_{A358} | L_{B35} |
| III-1103 | L_{A400} | L_{B7} | III-2676 | L_{A443} | L_{B16} | III-4249 | L_{A486} | L_{B25} | III-5822 | L_{A359} | L_{B35} |
| III-1104 | L_{A401} | L_{B7} | III-2677 | L_{A444} | L_{B16} | III-4250 | L_{A487} | L_{B25} | III-5823 | L_{A360} | L_{B35} |
| III-1105 | L_{A402} | L_{B7} | III-2678 | L_{A445} | L_{B16} | III-4251 | L_{A318} | L_{B26} | III-5824 | L_{A361} | L_{B35} |
| III-1106 | L_{A403} | L_{B7} | III-2679 | L_{A446} | L_{B16} | III-4252 | L_{A319} | L_{B26} | III-5825 | L_{A362} | L_{B35} |
| III-1107 | L_{A404} | L_{B7} | III-2680 | L_{A447} | L_{B16} | III-4253 | L_{A320} | L_{B26} | III-5826 | L_{A363} | L_{B35} |
| III-1108 | L_{A405} | L_{B7} | III-2681 | L_{A448} | L_{B16} | III-4254 | L_{A322} | L_{B26} | III-5827 | L_{A364} | L_{B35} |
| III-1109 | L_{A406} | L_{B7} | III-2682 | L_{A449} | L_{B16} | III-4255 | L_{A322} | L_{B26} | III-5828 | L_{A36s} | L_{B35} |
| III-1110 | L_{A407} | L_{B7} | III-2683 | L_{A450} | L_{B16} | III-4256 | L_{A323} | L_{B26} | III-5829 | L_{A366} | L_{B35} |
| III-1111 | L_{A408} | L_{B7} | III-2684 | L_{A451} | L_{B16} | III-4257 | L_{A324} | L_{B26} | III-5830 | L_{A367} | L_{B35} |
| III-1112 | L_{A409} | L_{B7} | III-2685 | L_{A452} | L_{B16} | III-4258 | L_{A325} | L_{B26} | III-5831 | L_{A368} | L_{B35} |
| III-1113 | L_{A410} | L_{B7} | III-2686 | L_{A453} | L_{B16} | III-4259 | L_{A326} | L_{B26} | III-5832 | L_{A369} | L_{B35} |
| III-1114 | L_{A411} | L_{B7} | III-2687 | L_{A454} | L_{B16} | III-4260 | L_{A327} | L_{B26} | III-5833 | L_{A370} | L_{B35} |
| III-1115 | L_{A412} | L_{B7} | III-2688 | L_{A455} | L_{B16} | III-4261 | L_{A328} | L_{B26} | III-5834 | L_{A371} | L_{B35} |
| III-1116 | L_{A413} | L_{B7} | III-2689 | L_{A456} | L_{B16} | III-4262 | L_{A329} | L_{B26} | III-5835 | L_{A372} | L_{B35} |
| III-1117 | L_{A414} | L_{B7} | III-2690 | L_{A457} | L_{B16} | III-4263 | L_{A330} | L_{B26} | III-5836 | L_{A373} | L_{B35} |
| III-1118 | L_{A415} | L_{B7} | III-2691 | L_{A458} | L_{B16} | III-4264 | L_{A331} | L_{B26} | III-5837 | L_{A374} | L_{B35} |
| III-1119 | L_{A416} | L_{B7} | III-2692 | L_{A459} | L_{B16} | III-4265 | L_{A332} | L_{B26} | III-5838 | L_{A375} | L_{B35} |
| III-1120 | L_{A417} | L_{B7} | III-2693 | L_{A460} | L_{B16} | III-4266 | L_{A333} | L_{B26} | III-5839 | L_{A376} | L_{B35} |
| III-1121 | L_{A418} | L_{B7} | III-2694 | L_{A461} | L_{B16} | III-4267 | L_{A334} | L_{B26} | III-5840 | L_{A377} | L_{B35} |
| III-1122 | L_{A419} | L_{B7} | III-2695 | L_{A462} | L_{B16} | III-4268 | L_{A335} | L_{B26} | III-5841 | L_{A378} | L_{B35} |
| III-1123 | L_{A420} | L_{B7} | III-2696 | L_{A463} | L_{B16} | III-4269 | L_{A336} | L_{B26} | III-5842 | L_{A379} | L_{B35} |
| III-1124 | L_{A421} | L_{B7} | III-2697 | L_{A464} | L_{B16} | III-4270 | L_{A337} | L_{B26} | III-5843 | L_{A380} | L_{B35} |
| III-1125 | L_{A422} | L_{B7} | III-2698 | L_{A465} | L_{B16} | III-4271 | L_{A338} | L_{B26} | III-5844 | L_{A381} | L_{B35} |
| III-1126 | L_{A423} | L_{B7} | III-2699 | L_{A466} | L_{B16} | III-4272 | L_{A339} | L_{B26} | III-5845 | L_{A382} | L_{B35} |
| III-1127 | L_{A424} | L_{B7} | III-2700 | L_{A467} | L_{B16} | III-4273 | L_{A340} | L_{B26} | III-5846 | L_{A383} | L_{B35} |
| III-1128 | L_{A425} | L_{B7} | III-2701 | L_{A468} | L_{B16} | III-4274 | L_{A341} | L_{B26} | III-5847 | L_{A384} | L_{B35} |
| III-1129 | L_{A426} | L_{B7} | III-2702 | L_{A469} | L_{B16} | III-4275 | L_{A342} | L_{B26} | III-5848 | L_{A385} | L_{B35} |
| III-1130 | L_{A427} | L_{B7} | III-2703 | L_{A470} | L_{B16} | III-4276 | L_{A343} | L_{B26} | III-5849 | L_{A386} | L_{B35} |
| III-1131 | L_{A428} | L_{B7} | III-2704 | L_{A471} | L_{B16} | III-4277 | L_{A344} | L_{B26} | III-5850 | L_{A387} | L_{B35} |
| III-1132 | L_{A429} | L_{B7} | III-2705 | L_{A472} | L_{B26} | III-4278 | L_{A345} | L_{B26} | III-5851 | L_{A388} | L_{B35} |
| III-1133 | L_{A430} | L_{B7} | III-2706 | L_{A473} | L_{B16} | III-4279 | L_{A346} | L_{B26} | III-5852 | L_{A389} | L_{B35} |
| III-1134 | L_{A431} | L_{B7} | III-2707 | L_{A474} | L_{B16} | III-4280 | L_{A347} | L_{B26} | III-5853 | L_{A390} | L_{B35} |
| III-1135 | L_{A432} | L_{B7} | III-2708 | L_{A475} | L₈₁₆ | III-4281 | L_{A348} | L_{B26} | III-5854 | L_{A391} | L_{B35} |
| III-1136 | L_{A433} | L_{B7} | III-2709 | L_{A476} | L_{B16} | III-4282 | L_{A349} | L_{B26} | III-5855 | L_{A392} | L_{B35} |
| III-1137 | L_{A434} | L_{B7} | III-2710 | L_{A477} | L_{B16} | III-4283 | L_{A350} | L_{B26} | III-5856 | L_{A393} | L_{B35} |
| III-1138 | L_{A435} | L_{B7} | III-2711 | L_{A478} | L_{B16} | III-4284 | L_{A351} | L_{B26} | III-5857 | L_{A394} | L_{B35} |
| III-1139 | L_{A436} | L_{B7} | III-2712 | L_{A479} | L_{B16} | III-4285 | L_{A352} | L_{B26} | III-5858 | L_{A395} | L_{B35} |
| III-1140 | L_{A437} | L_{B7} | III-2713 | L_{A480} | L_{B16} | III-4286 | L_{A353} | L_{B26} | III-5859 | L_{A396} | L_{B35} |
| III-1141 | L_{A438} | L_{B7} | III-2714 | L_{A481} | L_{B16} | III-4287 | L_{A354} | L_{B26} | III-5860 | L_{A397} | L_{B35} |
| III-1142 | L_{A439} | L_{B7} | III-2715 | L_{A482} | L_{B16} | III-4288 | L_{A355} | L_{B26} | III-5861 | L_{A398} | L_{B35} |
| III-1143 | L_{A440} | L_{B7} | III-2716 | L_{A483} | L_{B16} | III-4289 | L_{A356} | L_{B26} | III-5862 | L_{A399} | L_{B35} |
| III-1144 | L_{A441} | L_{B7} | III-2717 | L_{A484} | L_{B16} | III-4290 | L_{A357} | L_{B26} | III-5863 | L_{A400} | L_{B35} |
| III-1145 | L_{A442} | L_{B7} | III-2718 | L_{A485} | L_{B16} | III-4291 | L_{A358} | L_{B26} | III-5864 | L_{A401} | L_{B35} |
| III-1146 | L_{A443} | L_{B7} | III-2719 | L_{A486} | L_{B16} | III-4292 | L_{A359} | L_{B26} | III-5865 | L_{A402} | L_{B35} |
| III-1147 | L_{A444} | L_{B7} | III-2720 | L_{A487} | L_{B16} | III-4293 | L_{A360} | L_{B26} | III-5866 | L_{A403} | L_{B35} |
| III-1148 | L_{A445} | L_{B7} | III-2721 | L_{A318} | L_{B17} | III-4294 | L_{A361} | L_{B26} | III-5867 | L_{A404} | L_{B35} |
| III-1149 | L_{A446} | L_{B7} | III-2722 | L_{A319} | L_{B17} | III-4295 | L_{A362} | L_{B26} | III-5868 | L_{A405} | L_{B35} |
| III-1150 | L_{A447} | L_{B7} | III-2723 | L_{A320} | L_{B17} | III-4296 | L_{A363} | L_{B26} | III-5869 | L_{A406} | L_{B35} |
| III-1151 | L_{A448} | L_{B7} | III-2724 | L_{A321} | L_{B17} | III-4297 | L_{A364} | L_{B26} | III-5870 | L_{A407} | L_{B35} |
| III-1152 | L_{A449} | L_{B7} | III-2725 | L_{A322} | L_{B27} | III-4298 | L_{A365} | L_{B26} | III-5871 | L_{A408} | L_{B35} |
| III-1153 | L_{A450} | L_{B7} | III-2726 | L_{A323} | L_{B17} | III-4299 | L_{A366} | L_{B26} | III-5872 | L_{A409} | L_{B35} |
| III-1154 | L_{A451} | L_{B7} | III-2727 | L_{A324} | L_{B17} | III-4300 | L_{A367} | L_{B26} | III-5873 | L_{A410} | L_{B35} |
| III-1155 | L_{A452} | L_{B7} | III-2728 | L_{A325} | L_{B17} | III-4301 | L_{A368} | L_{B26} | III-5874 | L_{A411} | L_{B35} |
| III-1156 | L_{A453} | L_{B7} | III-2729 | L_{A326} | L_{B17} | III-4302 | L_{A369} | L_{B26} | III-5875 | L_{A412} | L_{B35} |
| III-1157 | L_{A454} | L_{B7} | III-2730 | L_{A327} | L_{B17} | III-4303 | L_{A370} | L_{B26} | III-5876 | L_{A413} | L_{B35} |
| III-1158 | L_{A455} | L_{B7} | III-2731 | L_{A328} | L_{B17} | III-4304 | L_{A371} | L_{B26} | III-5877 | L_{A414} | L_{B35} |
| III-1159 | L_{A456} | L_{B7} | III-2732 | L_{A329} | L_{B17} | III-4305 | L_{A372} | L_{B26} | III-5878 | L_{A415} | L_{B35} |
| III-1160 | L_{A457} | L_{B7} | III-2733 | L_{A330} | L_{B17} | III-4306 | L_{A373} | L_{B26} | III-5879 | L_{A416} | L_{B35} |
| III-1161 | L_{A458} | L_{B7} | III-2734 | L_{A331} | L_{B17} | III-4307 | L_{A374} | L_{B26} | III-5880 | L_{A417} | L_{B35} |
| III-1162 | L_{A459} | L_{B7} | III-2735 | L_{A332} | L_{B17} | III-4308 | L_{A375} | L_{B26} | III-5881 | L_{A418} | L_{B35} |
| III-1163 | L_{A460} | L_{B7} | III-2736 | L_{A333} | L_{B17} | III-4309 | L_{A376} | L_{B26} | III-5882 | L_{A419} | L_{B35} |
| III-1164 | L_{A461} | L_{B7} | III-2737 | L_{A334} | L_{B17} | III-4310 | L_{A377} | L_{B26} | III-5883 | L_{A420} | L_{B35} |
| III-1165 | L_{A462} | L_{B7} | III-2738 | L_{A335} | L_{B17} | III-4311 | L_{A378} | L_{B26} | III-5884 | L_{A421} | L_{B35} |
| III-1166 | L_{A463} | L_{B7} | III-2739 | L_{A336} | L_{B17} | III-4312 | L_{A379} | L_{B26} | III-5885 | L_{A422} | L_{B35} |
| III-1167 | L_{A464} | L_{B7} | III-2740 | L_{A337} | L_{B17} | III-4313 | L_{A380} | L_{B26} | III-5886 | L_{A423} | L_{B35} |
| III-1168 | L_{A465} | L_{B7} | III-2741 | L_{A338} | L_{B17} | III-4314 | L_{A381} | L_{B26} | III-5887 | L_{A424} | L_{B35} |
| III-1169 | L_{A466} | L_{B7} | III-2742 | L_{A339} | L_{B17} | III-4315 | L_{A382} | L_{B26} | III-5888 | L_{A425} | L_{B35} |
| III-1170 | L_{A467} | L_{B7} | III-2743 | L_{A340} | L_{B17} | III-4316 | L_{A383} | L_{B26} | III-5889 | L_{A426} | L_{B35} |
| III-1171 | L_{A468} | L_{B7} | III-2744 | L_{A341} | L_{B17} | III-4317 | L_{A384} | L_{B26} | III-5890 | L_{A427} | L_{B35} |
| III-1172 | L_{A469} | L_{B7} | III-2745 | L_{A342} | L_{B17} | III-4318 | L_{A385} | L_{B26} | III-5891 | L_{A428} | L_{B35} |
| III-1173 | L_{A470} | L_{B7} | III-2746 | L_{A343} | L_{B17} | III-4319 | L_{A386} | L_{B26} | III-5892 | L_{A429} | L_{B35} |
| III-1174 | L_{A471} | L_{B7} | III-2747 | L_{A344} | L_{B17} | III-4320 | L_{A387} | L_{B26} | III-5893 | L_{A430} | L_{B35} |
| III-1175 | L_{A472} | L_{B7} | III-2748 | L_{A345} | L_{B17} | III-4321 | L_{A388} | L_{B26} | III-5894 | L_{A431} | L_{B35} |
| III-1176 | L_{A473} | L_{B7} | III-2749 | L_{A346} | L_{B17} | III-4322 | L_{A389} | L_{B26} | III-5895 | L_{A432} | L_{B35} |
| III-1177 | L_{A474} | L_{B7} | III-2750 | L_{A347} | L_{B17} | III-4323 | L_{A390} | L_{B26} | III-5896 | L_{A433} | L_{B35} |
| III-1178 | L_{A475} | L_{B7} | III-2751 | L_{A348} | L_{B17} | III-4324 | L_{A391} | L_{B26} | III-5897 | L_{A434} | L_{B35} |
| III-1179 | L_{A476} | L_{B7} | III-2752 | L_{A349} | L_{B17} | III-4325 | L_{A392} | L_{B26} | III-5898 | L_{A435} | L_{B35} |
| III-1180 | L_{A477} | L_{B7} | III-2753 | L_{A350} | L_{B17} | III-4326 | L_{A393} | L_{B26} | III-5899 | L_{A436} | L_{B35} |
| III-1181 | L_{A478} | L_{B7} | III-2754 | L_{A351} | L_{B17} | III-4327 | L_{A394} | L_{B26} | III-5900 | L_{A437} | L_{B35} |
| III-1182 | L_{A479} | L_{B7} | III-2755 | L_{A352} | L_{B17} | III-4328 | L_{A395} | L_{B26} | III-5901 | L_{A438} | L_{B35} |
| III-1183 | L_{A480} | L_{B7} | III-2756 | L_{A353} | L_{B17} | III-4329 | L_{A396} | L_{B26} | III-5902 | L_{A439} | L_{B35} |
| III-1184 | L_{A481} | L_{B7} | III-2757 | L_{A354} | L_{B17} | III-4330 | L_{A397} | L_{B26} | III-5903 | L_{A440} | L_{B35} |
| III-1185 | L_{A482} | L_{B7} | III-2758 | L_{A355} | L_{B17} | III-4331 | L_{A398} | L_{B26} | III-5904 | L_{A441} | L_{B35} |
| III-1186 | L_{A483} | L_{B7} | III-2759 | L_{A356} | L_{B17} | III-4332 | L_{A399} | L_{B26} | III-5905 | L_{A442} | L_{B35} |
| III-1187 | L_{A484} | L_{B7} | III-2760 | L_{A357} | L_{B17} | III-4333 | L_{A400} | L_{B26} | III-5906 | L_{A443} | L_{B35} |
| III-1188 | L_{A485} | L_{B7} | III-2761 | L_{A358} | L_{B17} | III-4334 | L_{A401} | L_{B26} | III-5907 | L_{A444} | L_{B35} |
| III-1189 | L_{A486} | L_{B7} | III-2762 | L_{A359} | L_{B17} | III-4335 | L_{A402} | L_{B26} | III-5908 | L_{A445} | L_{B35} |
| III-1190 | L_{A487} | L_{B7} | III-2763 | L_{A360} | L_{B17} | III-4336 | L_{A403} | L_{B26} | III-5909 | L_{A446} | L_{B35} |
| III-1191 | L_{A318} | L_{B8} | III-2764 | L_{A361} | L_{B27} | III-4337 | L_{A404} | L_{B26} | III-5910 | L_{A447} | L_{B35} |
| III-1192 | L_{A319} | L_{B8} | III-2765 | L_{A362} | L_{B17} | III-4338 | L_{A405} | L_{B26} | III-5911 | L_{A448} | L_{B35} |
| III-1193 | L_{A320} | L_{B8} | III-2766 | L_{A363} | L_{B17} | III-4339 | L_{A406} | L_{B26} | III-5912 | L_{A449} | L_{B35} |
| III-1194 | L_{A321} | L_{B8} | III-2767 | L_{A364} | L_{B17} | III-4340 | L_{A407} | L_{B26} | III-5913 | L_{A450} | L_{B35} |
| III-1195 | L_{A322} | L_{B8} | III-2768 | L_{A365} | L_{B17} | III-4341 | L_{A408} | L_{B26} | III-5914 | L_{A451} | L_{B35} |
| III-1196 | L_{A323} | L_{B8} | III-2769 | L_{A366} | L_{B17} | III-4342 | L_{A409} | L_{B26} | III-5915 | L_{A452} | L_{B35} |
| III-1197 | L_{A324} | L_{B8} | III-2770 | L_{A367} | L_{B17} | III-4343 | L_{A410} | L_{B26} | III-5916 | L_{A453} | L_{B35} |
| III-1198 | L_{A325} | L_{B8} | III-2771 | L_{A368} | L_{B17} | III-4344 | L_{A411} | L_{B26} | III-5917 | L_{A454} | L_{B35} |
| III-1199 | L_{A326} | L_{B8} | III-2772 | L_{A369} | L_{B17} | III-4345 | L_{A412} | L_{B26} | III-5918 | L_{A455} | L_{B35} |
| III-1200 | L_{A327} | L_{B8} | III-2773 | L_{A370} | L_{B17} | III-4346 | L_{A413} | L_{B26} | III-5919 | L_{A456} | L_{B35} |
| III-1201 | L_{A328} | L_{B8} | III-2774 | L_{A371} | L_{B17} | III-4347 | L_{A414} | L_{B26} | III-5920 | L_{A457} | L_{B35} |
| III-1202 | L_{A329} | L_{B8} | III-2775 | L_{A372} | L_{B17} | III-4348 | L_{A415} | L_{B26} | III-5921 | L_{A458} | L_{B35} |
| III-1203 | L_{A330} | L_{B8} | III-2776 | L_{A373} | L_{B17} | III-4349 | L_{A416} | L_{B26} | III-5922 | L_{A459} | L_{B35} |
| III-1204 | L_{A331} | L_{B8} | III-2777 | L_{A374} | L_{B17} | III-4350 | L_{A427} | L_{B26} | III-5923 | L_{A460} | L_{B35} |
| III-1205 | L_{A332} | L_{B8} | III-2778 | L_{A375} | L_{B17} | III-4351 | L_{A418} | L_{B26} | III-5924 | L_{A461} | L_{B35} |
| III-1206 | L_{A333} | L_{B8} | III-2779 | L_{A376} | L_{B17} | III-4352 | L_{A419} | L_{B26} | III-5925 | L_{A462} | L_{B35} |
| III-1207 | L_{A334} | L_{B8} | III-2780 | L_{A377} | L_{B17} | III-4353 | L_{A420} | L_{B26} | III-5926 | L_{A463} | L_{B35} |
| III-1208 | L_{A335} | L_{B8} | III-2781 | L_{A378} | L_{B17} | III-4354 | L_{A421} | L_{B26} | III-5927 | L_{A464} | L_{B35} |
| III-1209 | L_{A336} | L_{B8} | III-2782 | L_{A379} | L_{B17} | III-4355 | L_{A422} | L_{B26} | III-5928 | L_{A465} | L_{B35} |
| III-1210 | L_{A337} | L_{B8} | III-2783 | L_{A380} | L_{B17} | III-4356 | L_{A423} | L_{B26} | III-5929 | L_{A466} | L_{B35} |
| III-1211 | L_{A338} | L_{B8} | III-2784 | L_{A381} | L_{B17} | III-4357 | L_{A424} | L_{B26} | III-5930 | L_{A467} | L_{B35} |
| III-1212 | L_{A339} | L_{B8} | III-2785 | L_{A382} | L_{B17} | III-4358 | L_{A425} | L_{B26} | III-5931 | L_{A468} | L_{B35} |
| III-1213 | L_{A340} | L_{B8} | III-2786 | L_{A393} | L_{B17} | III-4359 | L_{A426} | L_{B26} | III-5932 | L_{A469} | L_{B35} |
| III-1214 | L_{A341} | L_{B8} | III-2787 | L_{A384} | L_{B17} | III-4360 | L_{A427} | L_{B26} | III-5933 | L_{A470} | L_{B35} |
| III-1215 | L_{A342} | L_{B8} | III-2788 | L_{A385} | L_{B17} | III-4361 | L_{A428} | L_{B26} | III-5934 | L_{A471} | L_{B35} |
| III-1216 | L_{A343} | L_{B8} | III-2789 | L_{A386} | L_{B17} | III-4362 | L_{A429} | L_{B26} | III-5935 | L_{A472} | L_{B35} |
| III-1217 | L_{A344} | L_{B8} | III-2790 | L_{A387} | L_{B17} | III-4363 | L_{A430} | L_{B26} | III-5936 | L_{A473} | L_{B35} |
| III-1218 | L_{A345} | L_{B8} | III-2791 | L_{A388} | L_{B17} | III-4364 | L_{A431} | L_{B26} | III-5937 | L_{A474} | L_{B35} |
| III-1219 | L_{A346} | L_{B8} | III-2792 | L_{A389} | L_{B17} | III-4365 | L_{A432} | L_{B26} | III-5938 | L_{A475} | L_{B35} |
| III-1220 | L_{A347} | L_{B8} | III-2793 | L_{A390} | L_{B17} | III-4366 | L_{A433} | L_{B26} | III-5939 | L_{A476} | L_{B35} |
| III-1221 | L_{A348} | L_{B8} | III-2794 | L_{A391} | L_{B17} | III-4367 | L_{A434} | L_{B26} | III-5940 | L_{A477} | L_{B35} |
| III-1222 | L_{A349} | L_{B8} | III-2795 | L_{A392} | L_{B17} | III-4368 | L_{A435} | L_{B26} | III-5941 | L_{A478} | L_{B35} |
| III-1223 | L_{A350} | L_{B8} | III-2796 | L_{A393} | L_{B17} | III-4369 | L_{A436} | L_{B26} | III-5942 | L_{A479} | L_{B35} |
| III-1224 | L_{A351} | L_{B8} | III-2797 | L_{A394} | L_{B17} | III-4370 | L_{A437} | L_{B26} | III-5943 | L_{A480} | L_{B35} |
| III-1225 | L_{A352} | L_{B8} | III-2798 | L_{A395} | L_{B17} | III-4371 | L_{A438} | L_{B26} | III-5944 | L_{A481} | L_{B35} |
| III-1226 | L_{A353} | L_{B8} | III-2799 | L_{A396} | L_{B17} | III-4372 | L_{A439} | L_{B26} | III-5945 | L_{A482} | L_{B35} |
| III-1227 | L_{A354} | L_{B8} | III-2800 | L_{A397} | L_{B17} | III-4373 | L_{A440} | L_{B26} | III-5946 | L_{A483} | L_{B35} |
| III-1228 | L_{A355} | L_{B8} | III-2801 | L_{A398} | L_{B17} | III-4374 | L_{A441} | L_{B26} | III-5947 | _{LA484} | L_{B35} |
| III-1229 | L_{A356} | L_{B8} | III-2802 | L_{A399} | L_{B17} | III-4375 | L_{A442} | L_{B26} | III-5948 | L_{A485} | L_{B35} |
| III-1230 | L_{A357} | L_{B8} | III-2803 | L_{A400} | L_{B17} | III-4376 | L_{A443} | L_{B26} | III-5949 | L_{A486} | L_{B35} |
| III-1231 | L_{A358} | L_{B8} | III-2804 | L_{A401} | L_{B17} | III-4377 | L_{A444} | L_{B26} | III-5950 | L_{A487} | L_{B35} |
| III-1232 | L_{A359} | L_{B8} | III-2805 | L_{A402} | L_{B17} | III-4378 | L_{A445} | L_{B26} | III-5951 | L_{A318} | L_{B36} |
| III-1233 | L_{A360} | L_{B8} | III-2806 | L_{A403} | L_{B17} | III-4379 | L_{A446} | L_{B26} | III-5952 | L_{A319} | L_{B36} |
| III-1234 | L_{A361} | L_{B8} | III-2807 | L_{A404} | L_{B17} | III-4380 | L_{A447} | L_{B26} | III-5953 | L_{A320} | L_{B36} |
| III-1235 | L_{A362} | L_{B8} | III-2808 | L_{A405} | L_{B17} | III-4381 | L_{A448} | L_{B26} | III-5954 | L_{A321} | L_{B36} |
| III-1236 | L_{A363} | L_{B8} | III-2809 | L_{A406} | L_{B17} | III-4382 | L_{A449} | L_{B26} | III-5955 | L_{A322} | L_{B36} |
| III-1237 | L_{A364} | L_{B8} | III-2810 | L_{A407} | L_{B17} | III-4383 | L_{A450} | L_{B26} | III-5956 | L_{A323} | L_{B36} |
| III-1238 | L_{A365} | L_{B8} | III-2811 | L_{A408} | L_{B17} | III-4384 | L_{A451} | L_{B26} | III-5957 | L_{A324} | L_{B36} |
| III-1239 | L_{A366} | L_{B8} | III-2812 | L_{A409} | L_{B17} | III-4385 | L_{A452} | L_{B26} | III-5958 | L_{A325} | L_{B36} |
| III-1240 | L_{A367} | L_{B8} | III-2813 | L_{A410} | L_{B17} | III-4386 | L_{A453} | L_{B26} | III-5959 | L_{A326} | L_{B36} |
| III-1241 | L_{A368} | L_{B8} | III-2814 | L_{A411} | L_{B17} | III-4387 | L_{A454} | L_{B26} | III-5960 | L_{A327} | L_{B36} |
| III-1242 | L_{A369} | L_{B8} | III-2815 | L_{A412} | L_{B17} | III-4388 | L_{A455} | L_{B26} | III-5961 | L_{A328} | L_{B36} |
| III-1243 | L_{A370} | L_{B8} | III-2816 | L_{A413} | L_{B17} | III-4389 | L_{A456} | L_{B26} | III-5962 | L_{A329} | L_{B36} |
| III-1244 | L_{A371} | L_{B8} | III-2817 | L_{A414} | L_{B17} | III-4390 | L_{A457} | L_{B26} | III-5963 | L_{A330} | L_{B36} |
| III-1245 | L_{A372} | L_{B8} | III-2818 | L_{A415} | L_{B17} | III-4391 | L_{A458} | L_{B26} | III-5964 | L_{A331} | L_{B36} |
| III-1246 | L_{A373} | L_{B8} | III-2819 | L_{A416} | L_{B17} | III-4392 | L_{A459} | L_{B26} | III-5965 | L_{A332} | L_{B36} |
| III-1247 | L_{A374} | L_{B8} | III-2820 | L_{A417} | L_{B17} | III-4393 | L_{A460} | L_{B26} | III-5966 | L_{A333} | L_{B36} |
| III-1248 | L_{A375} | L_{B8} | III-2821 | L_{A418} | L_{B17} | III-4394 | L_{A461} | L_{B26} | III-5967 | L_{A334} | L_{B36} |
| III-1249 | L_{A376} | L_{B8} | III-2822 | L_{A419} | L_{B17} | III-4395 | L_{A462} | L_{B26} | III-5968 | L_{A335} | L_{B36} |
| III-1250 | L_{A377} | L_{B8} | III-2823 | L_{A420} | L_{B17} | III-4396 | L_{A463} | L_{B26} | III-5969 | L_{A336} | L_{B36} |
| III-1251 | L_{A378} | L_{B8} | III-2824 | L_{A421} | L_{B17} | III-4397 | L_{A464} | L_{B26} | III-5970 | L_{A337} | L_{B36} |
| III-1252 | L_{A379} | L_{B8} | III-2825 | L_{A422} | L_{B17} | III-4398 | L_{A465} | L_{B26} | 111-5971 | L_{A338} | L_{B36} |
| III-1253 | L_{A380} | L_{B8} | III-2826 | L_{A423} | L_{B17} | III-4399 | L_{A466} | L_{B26} | III-5972 | L_{A339} | L_{B36} |
| III-1254 | L_{A381} | L_{B8} | III-2827 | L_{A424} | L_{B17} | III-4400 | L_{A467} | L_{B26} | III-5973 | L_{A340} | L_{B36} |
| III-1255 | L_{A382} | L_{B8} | III-2828 | L_{A425} | L_{B17} | III-4401 | L_{A468} | L_{B26} | III-5974 | L_{A341} | L_{B36} |
| III-1256 | L_{A383} | L_{B8} | III-2829 | L_{A426} | L_{B17} | III-4402 | L_{A469} | L_{B26} | III-5975 | L_{A342} | L_{B36} |
| III-1257 | L_{A384} | L_{B8} | III-2830 | L_{A427} | L_{B17} | III-4403 | L_{A470} | L_{B26} | III-5976 | L_{A343} | L_{B36} |
| III-1258 | L_{A385} | L_{B8} | III-2831 | L_{A428} | L_{B17} | 111-4404 | L_{A471} | L_{B26} | III-5977 | L_{A344} | L_{B36} |
| III-1259 | L_{A386} | L_{B8} | III-2832 | L_{A429} | L_{B17} | III-4405 | L_{A472} | L_{B26} | III-5978 | L_{A345} | L_{B36} |
| III-1260 | L_{A387} | L_{B8} | III-2833 | L_{A430} | L_{B17} | III-4406 | L_{A473} | L_{B26} | III-5979 | L_{A346} | L_{B36} |
| III-1261 | L_{A388} | L_{B8} | III-2834 | L_{A431} | L_{B17} | III-4407 | L_{A474} | L_{B26} | III-5980 | L_{A347} | L_{B36} |
| III-1262 | L_{A389} | L_{B8} | III-2835 | L_{A432} | L_{B17} | III-4408 | L_{A475} | L_{B26} | III-5981 | L_{A348} | L_{B36} |
| III-1263 | L_{A390} | L_{B8} | III-2836 | L_{A433} | L_{B17} | III-4409 | L_{A476} | L_{B26} | III-5982 | L_{A349} | L_{B36} |
| III-1264 | L_{A391} | L_{B8} | III-2837 | L_{A434} | L_{B17} | III-4410 | L_{A477} | L_{B26} | III-5983 | L_{A350} | L_{B36} |
| III-1265 | L_{A392} | L_{B8} | III-2838 | L_{A435} | L_{B17} | III-4411 | L_{A478} | L_{B26} | III-5984 | L_{A351} | L_{B36} |
| III-1266 | L_{A393} | L_{B8} | III-2839 | L_{A436} | L_{B17} | III-4412 | L_{A479} | L_{B26} | III-5985 | L_{A352} | L_{B36} |
| III-1267 | L_{A394} | L_{B8} | III-2840 | L_{A437} | L_{B17} | III-4413 | L_{A480} | L_{B26} | III-5986 | L_{A353} | L_{B36} |
| III-1268 | L_{A395} | L_{B8} | III-2841 | L_{A438} | L_{B17} | III-4414 | L_{A481} | L_{B26} | III-5987 | L_{A354} | L_{B36} |
| III-1269 | L_{A396} | L_{B8} | III-2842 | L_{A439} | L_{B17} | III-4415 | L_{A482} | L_{B26} | III-5988 | L_{A355} | L_{B36} |
| III-1270 | L_{A397} | L_{B8} | III-2843 | L_{A440} | L_{B17} | III-4416 | L_{A483} | L_{B26} | III-5989 | L_{A356} | L_{B36} |
| III-1271 | L_{A398} | L_{B8} | III-2844 | L_{A441} | L_{B17} | III-4417 | L_{A484} | L_{B26} | III-5990 | L_{A357} | L_{B36} |
| III-1272 | L_{A399} | L_{B8} | III-2845 | L_{A442} | L_{B17} | III-4418 | L_{A485} | L_{B26} | III-5991 | L_{A358} | L_{B36} |
| III-1273 | L_{A400} | L_{B8} | III-2846 | L_{A443} | L_{B17} | III-4419 | L_{A486} | L_{B26} | III-5992 | L_{A359} | L_{B36} |
| III-1274 | L_{A401} | L_{B8} | III-2847 | L_{A444} | L_{B17} | 111-4420 | L_{A487} | L_{B26} | III-5993 | L_{A360} | L_{B36} |
| III-1275 | L_{A402} | L_{B8} | III-2848 | L_{A445} | L_{B17} | III-4421 | L_{A318} | L_{B27} | III-5994 | L_{A361} | L_{B36} |
| III-1276 | L_{A403} | L_{B8} | III-2849 | L_{A446} | L_{B17} | III-4422 | L_{A319} | L_{B27} | III-5995 | L_{A362} | L_{B36} |
| III-1277 | L_{A404} | L_{B8} | III-2850 | L_{A447} | L_{B17} | III-4423 | L_{A320} | L_{B27} | III-5996 | L_{A363} | L_{B36} |
| III-1278 | L_{A405} | L_{B8} | III-2851 | L_{A448} | L_{B1}7 | III-4424 | L_{A321} | L_{B27} | III-5997 | L_{A364} | L_{B36} |
| III-1279 | L_{A406} | L_{B8} | III-2852 | L_{A449} | L_{B17} | III-4425 | L_{A322} | L_{B27} | III-5998 | L_{A365} | L_{B36} |
| III-1280 | L_{A407} | L_{B8} | III-2853 | L_{A450} | L_{B17} | III-4426 | L_{A323} | L_{B27} | III-5999 | L_{A366} | L_{B36} |
| III-1281 | L_{A408} | L_{B8} | III-2854 | L_{A451} | L_{B17} | III-4427 | L_{A324} | L_{B27} | III-6000 | L_{A367} | L_{B36} |
| III-1282 | L_{A409} | L_{B8} | III-2855 | L_{A452} | L_{B17} | III-4428 | L_{A325} | L_{B27} | III-6001 | L_{A368} | L_{B36} |
| III-1283 | L_{A410} | L_{B8} | III-2856 | L_{A453} | L_{B17} | III-4429 | L_{A326} | L_{B27} | III-6002 | L_{A369} | L_{B36} |
| III-1284 | L_{A411} | L_{B8} | III-2857 | L_{A454} | L_{B17} | III-4430 | L_{A327} | L_{B27} | III-6003 | L_{A370} | L_{B36} |
| III-1285 | L_{A412} | L_{B8} | III-2858 | L_{A455} | L_{B17} | III-4431 | L_{A328} | L_{B27} | III-6004 | L_{A371} | L_{B36} |
| III-1286 | L_{A413} | L_{B8} | III-2859 | L_{A456} | L_{B17} | III-4432 | L_{A329} | L_{B27} | III-6005 | L_{A372} | L_{B36} |
| III-1287 | L_{A414} | L_{B8} | III-2860 | L_{A457} | L_{B17} | III-4433 | L_{A330} | L_{B27} | III-6006 | L_{A373} | L_{B36} |
| III-1288 | L_{A415} | L_{B8} | III-2861 | L_{A458} | L_{B17} | III-4434 | L_{A332} | L_{B27} | III-6007 | L_{A374} | L_{B36} |
| III-1289 | L_{A416} | L_{B8} | III-2862 | L_{A459} | L_{B17} | III-4435 | L_{A332} | L_{B27} | III-6008 | L_{A375} | L_{B36} |
| III-1290 | L_{A417} | L_{B8} | III-2863 | L_{A460} | L_{B17} | III-4436 | L_{A333} | L_{B27} | III-6009 | L_{A376} | L_{B36} |
| III-1291 | L_{A418} | L_{B8} | III-2864 | L_{A461} | L_{B17} | III-4437 | L_{A334} | L_{B27} | III-6010 | L_{A377} | L_{B36} |
| III-1292 | L_{A419} | L_{B8} | III-2865 | L_{A462} | L_{B17} | III-4438 | L_{A335} | L_{B27} | III-6011 | L_{A378} | L_{B36} |
| III-1293 | L_{A420} | L_{B8} | III-2866 | L_{A463} | L_{B17} | III-4439 | L_{A336} | L_{B27} | III-6012 | L_{A379} | L_{B36} |
| III-1294 | L_{A421} | L_{B8} | III-2867 | L_{A464} | L_{B17} | III-4440 | L_{A337} | L_{B27} | III-6013 | L_{A380} | L_{B36} |
| III-1295 | L_{A422} | L_{B8} | III-2868 | L_{A465} | L_{B17} | III-4441 | L_{A338} | L_{B27} | III-6014 | L_{A381} | L_{B36} |
| III-1296 | L_{A423} | L_{B8} | III-2869 | L_{A466} | L_{B17} | III-4442 | L_{A339} | L_{B27} | III-6015 | L_{A382} | L_{B36} |
| III-1297 | L_{A424} | L_{B8} | III-2870 | L_{A467} | L_{B17} | III-4443 | L_{A340} | L_{B27} | III-6016 | L_{A383} | L_{B36} |
| III-1298 | L_{A425} | L_{B8} | III-2871 | L_{A468} | L_{B17} | III-4444 | L_{A341} | L_{B27} | III-6017 | L_{A384} | L_{B36} |
| III-1299 | L_{A426} | L_{B8} | III-2872 | L_{A469} | L_{B17} | III-4445 | L_{A342} | L_{B27} | III-6018 | L_{A385} | L_{B36} |
| III-1300 | L_{A427} | L_{B8} | III-2873 | L_{A470} | L_{B17} | III-4446 | L_{A343} | L_{B27} | III-6019 | L_{A386} | L_{B36} |
| III-1301 | L_{A428} | L_{B8} | III-2874 | L_{A471} | L_{B17} | III-4447 | L_{A344} | L_{B27} | III-6020 | L_{A387} | L_{B36} |
| III-1302 | L_{A429} | L_{B8} | III-2875 | L_{A472} | L_{B17} | III-4448 | L_{A345} | L_{B27} | III-6021 | L_{A388} | L_{B36} |
| III-1303 | L_{A430} | L_{B8} | III-2876 | L_{A473} | L_{B17} | III-4449 | L_{A346} | L_{B27} | III-6022 | L_{A389} | L_{B36} |
| III-1304 | L_{A431} | L_{B8} | III-2877 | L_{A474} | L_{B17} | III-4450 | L_{A347} | L_{B27} | III-6023 | L_{A390} | L_{B36} |
| III-1305 | L_{A432} | L_{B8} | III-2878 | L_{A475} | L_{B17} | III-4451 | L_{A348} | L_{B27} | III-6024 | L_{A391} | L_{B36} |
| III-1306 | L_{A433} | L_{B8} | III-2879 | L_{A476} | L_{B17} | III-4452 | L_{A349} | L_{B27} | III-6025 | L_{A392} | L_{B36} |
| III-1307 | L_{A434} | L_{B8} | III-2880 | L_{A477} | L_{B17} | III-4453 | L_{A350} | L_{B27} | III-6026 | L_{A393} | L_{B36} |
| III-1308 | L_{A435} | L_{B8} | III-2881 | L_{A478} | L_{B17} | III-4454 | L_{A351} | L_{B27} | III-6027 | L_{A394} | L_{B36} |
| III-1309 | L_{A436} | L_{B8} | III-2882 | L_{A479} | L_{B17} | III-4455 | L_{A352} | L_{B27} | III-6028 | L_{A395} | L_{B36} |
| III-1310 | L_{A437} | L_{B8} | III-2883 | L_{A480} | L_{B17} | III-4456 | L_{A353} | L_{B27} | III-6029 | L_{A396} | L_{B36} |
| III-1311 | L_{A438} | L_{B8} | III-2884 | L_{A481} | L_{B17} | III-4457 | L_{A354} | L_{B27} | III-6030 | L_{A397} | L_{B36} |
| III-1312 | L_{A439} | L_{B8} | III-2885 | L_{A482} | L_{B17} | III-4458 | L_{A355} | L_{B27} | III-6031 | L_{A398} | L_{B36} |
| III-1313 | L_{A440} | L_{B8} | III-2886 | L_{A483} | L_{B17} | III-4459 | L_{A356} | L_{B27} | III-6032 | L_{A399} | L_{B36} |
| III-1314 | L_{A441} | L_{B8} | III-2887 | L_{A484} | L_{B17} | III-4460 | L_{A357} | L_{B27} | III-6033 | L_{A400} | L_{B36} |
| III-1315 | L_{A442} | L_{B8} | III-2888 | L_{A485} | L_{B17} | III-4461 | L_{A358} | L_{B27} | III-6034 | L_{A401} | L_{B36} |
| III-1316 | L_{A443} | L_{B8} | III-2889 | L_{A486} | L_{B27} | III-4462 | L_{A359} | L_{B27} | III-6035 | L_{A402} | L_{B36} |
| III-1317 | L_{A444} | L_{B8} | III-2890 | L_{A487} | L_{B17} | III-4463 | L_{A360} | L_{B27} | III-6036 | L_{A403} | L_{B36} |
| III-1318 | L_{A445} | L_{B8} | III-2891 | L_{A318} | L_{B18} | III-4464 | L_{A361} | L_{B27} | III-6037 | L_{A404} | L_{B36} |
| III-1319 | L_{A446} | L_{B8} | III-2892 | L_{A319} | L_{B18} | III-4465 | L_{A362} | L_{B27} | III-6038 | L_{A405} | L_{B36} |
| III-1320 | L_{A447} | L_{B8} | III-2893 | L_{A320} | L_{B18} | III-4466 | L_{A363} | L_{B27} | III-6039 | L_{A406} | L_{B36} |
| III-1321 | L_{A448} | L_{B8} | III-2894 | L_{A321} | L_{B18} | III-4467 | L_{A364} | L_{B27} | III-6040 | L_{A407} | L_{B36} |
| III-1322 | L_{A449} | L_{B8} | III-2895 | L_{A322} | L_{B18} | III-4468 | L_{A365} | L_{B27} | III-6041 | L_{A408} | L_{B36} |
| III-1323 | L_{A450} | L_{B8} | III-2896 | L_{A323} | L_{B18} | III-4469 | L_{A366} | L_{B27} | III-6042 | L_{A409} | L_{B36} |
| III-1324 | L_{A451} | L_{B8} | III-2897 | L_{A324} | L_{B8} | III-4470 | L_{A367} | L_{B27} | III-6043 | L_{A410} | L_{B36} |
| III-1325 | L_{A452} | L_{B8} | III-2898 | L_{A325} | L_{B18} | III-4471 | L_{A368} | L_{B27} | III-6044 | L_{A411} | L_{B36} |
| III-1326 | L_{A453} | L_{B8} | III-2899 | L_{A326} | L_{B18} | III-4472 | L_{A369} | L_{B27} | III-6045 | L_{A412} | L_{B36} |
| III-1327 | L_{A454} | L_{B8} | III-2900 | L_{A327} | L_{B18} | III-4473 | L_{A370} | L_{B27} | III-6046 | L_{A413} | L_{B36} |
| III-1328 | L_{A455} | L_{B8} | III-2901 | L_{A328} | L_{B18} | III-4474 | L_{A371} | L_{B27} | III-6047 | L_{A414} | L_{B36} |
| III-1329 | L_{A456} | L_{B8} | III-2902 | L_{A329} | L_{B18} | III-4475 | L_{A372} | L_{B27} | III-6048 | L_{A415} | L_{B36} |
| III-1330 | L_{A457} | L_{B8} | III-2903 | L_{A330} | L_{B18} | III-4476 | L_{A373} | L_{B27} | III-6049 | L_{A416} | L_{B36} |
| III-1331 | L_{A458} | L_{B8} | III-2904 | L_{A331} | L_{B18} | III-4477 | L_{A374} | L_{B27} | III-6050 | L_{A417} | L_{B36} |
| III-1332 | L_{A459} | L_{B8} | III-2905 | L_{A332} | L_{B18} | III-4478 | L_{A375} | L_{B27} | III-6051 | L_{A418} | L_{B36} |
| III-1333 | L_{A460} | L_{B8} | III-2906 | L_{A333} | L_{B18} | III-4479 | L_{A376} | L_{B27} | III-6052 | L_{A419} | L_{B36} |
| III-1334 | L_{A461} | L_{B8} | III-2907 | L_{A334} | L_{B18} | III-4480 | L_{A377} | L_{B27} | III-6053 | L_{A420} | L_{B36} |
| III-1335 | L_{A462} | L_{B8} | III-2908 | L_{A335} | L_{B18} | III-4481 | L_{A378} | L_{B27} | III-6054 | L_{A421} | L_{B36} |
| III-1336 | L_{A463} | L_{B8} | III-2909 | L_{A336} | L_{B18} | III-4482 | L_{A379} | L_{B27} | III-6055 | L_{A422} | L_{B36} |
| III-1337 | L_{A464} | L_{B8} | III-2910 | L_{A337} | L_{B18} | III-4483 | L_{A380} | L_{B27} | III-6056 | L_{A423} | L_{B36} |
| III-1338 | L_{A465} | L_{B8} | III-2911 | L_{A338} | L_{B18} | III-4484 | L_{A381} | L_{B27} | III-6057 | L_{A424} | L_{B36} |
| III-1339 | L_{A466} | L_{B8} | III-2912 | L_{A339} | L_{B18} | III-4485 | L_{A382} | L_{B27} | III-6058 | L_{A425} | L_{B36} |
| III-1340 | L_{A467} | L_{B8} | III-2913 | L_{A340} | L_{B18} | III-4486 | L_{A383} | L_{B27} | III-6059 | L_{A426} | L_{B36} |
| III-1341 | L_{A468} | L_{B8} | III-2914 | L_{A341} | L_{B18} | III-4487 | L_{A384} | L_{B27} | III-6060 | L_{A427} | L_{B36} |
| III-1342 | L_{A469} | L_{B8} | III-2915 | L_{A342} | L_{B18} | III-4488 | L_{A385} | L_{B27} | III-6061 | L_{A428} | L_{B36} |
| III-1343 | L_{A470} | L_{B8} | III-2916 | L_{A343} | L_{B18} | III-4489 | L_{A386} | L_{B27} | III-6062 | L_{A429} | L_{B36} |
| III-1344 | L_{A471} | L_{B8} | III-2917 | L_{A344} | L_{B18} | III-4490 | L_{A387} | L_{B27} | III-6063 | L_{A430} | L_{B36} |
| III-1345 | L_{A472} | L_{B8} | III-2918 | L_{A345} | L_{B18} | III-4491 | L_{A388} | L_{B27} | III-6064 | L_{A431} | L_{B36} |
| III-1346 | L_{A473} | L_{B8} | III-2919 | L_{A346} | L_{B18} | III-4492 | L_{A389} | L_{B27} | III-6065 | L_{A432} | L_{B36} |
| III-1347 | L_{A474} | L_{B8} | III-2920 | L_{A347} | L_{B18} | III-4493 | L_{A390} | L_{B27} | III-6066 | L_{A433} | L_{B36} |
| III-1348 | L_{A475} | L_{B8} | III-2921 | L_{A348} | L_{B18} | III-4494 | L_{A391} | L_{B27} | III-6067 | L_{A434} | L₈₃₆ |
| III-1349 | L_{A476} | L_{B8} | III-2922 | L_{A349} | L_{B18} | III-4495 | L_{A392} | L_{B27} | III-6068 | L_{A435} | L_{B36} |
| III-1350 | L_{A477} | L_{B8} | III-2923 | L_{A350} | L_{B18} | III-4496 | L_{A393} | L_{B27} | III-6069 | L_{A436} | L_{B36} |
| III-1351 | L_{A478} | L_{B8} | III-2924 | L_{A351} | L_{B18} | III-4497 | L_{A394} | L_{B27} | III-6070 | L_{A437} | L_{B36} |
| III-1352 | L_{A479} | L_{B8} | III-2925 | L_{A352} | L_{B18} | III-4498 | L_{A395} | L_{B27} | III-6071 | L_{A438} | L_{B36} |
| III-1353 | L_{A480} | L_{B8} | III-2926 | L_{A353} | L_{B18} | III-4499 | L_{A396} | L_{B27} | III-6072 | L_{A439} | L_{B36} |
| III-1354 | L_{A481} | L_{B8} | III-2927 | L_{A354} | L_{B18} | III-4500 | L_{A397} | L_{B27} | III-6073 | L_{A440} | L_{B36} |
| III-1355 | L_{A482} | L_{B8} | III-2928 | L_{A355} | L_{B18} | III-4501 | L_{A398} | L_{B27} | III-6074 | L_{A441} | L_{B36} |
| III-1356 | L_{A483} | L_{B8} | III-2929 | L_{A356} | L_{B18} | III-4502 | L_{A399} | L_{B27} | III-6075 | L_{A442} | L_{B36} |
| III-1357 | L_{A484} | L_{B8} | III-2930 | L_{A357} | L_{B18} | III-4503 | L_{A400} | L_{B27} | III-6076 | L_{A443} | L_{B36} |
| III-1358 | L_{A485} | L_{B8} | III-2931 | L_{A358} | L_{B18} | III-4504 | L_{A401} | L_{B27} | III-6077 | L_{A444} | L_{B36} |
| III-1359 | L_{A486} | L_{B8} | III-2932 | L_{A359} | L_{B18} | III-4505 | L_{A402} | L_{B27} | III-6078 | L_{A445} | L_{B36} |
| III-1360 | L_{A487} | L_{B8} | III-2933 | L_{A360} | L_{B18} | III-4506 | L_{A403} | L_{B27} | III-6079 | L_{A446} | L_{B36} |
| III-1361 | L_{A318} | L_{B9} | III-2934 | L_{A361} | L_{B18} | III-4507 | L_{A404} | L_{B27} | III-6080 | L_{A447} | L_{B36} |
| III-1362 | L_{A319} | L_{B9} | III-2935 | L_{A362} | L_{B18} | III-4508 | L_{A405} | L_{B27} | III-6081 | L_{A448} | L_{B36} |
| III-1363 | L_{A320} | L_{B9} | III-2936 | L_{A363} | L_{B18} | III-4509 | L_{A406} | L_{B27} | III-6082 | L_{A449} | L_{B36} |
| III-1364 | L_{A321} | L_{B9} | III-2937 | L_{A364} | L_{B18} | III-4510 | L_{A407} | L₈₂₇ | III-6083 | L_{A450} | L_{B36} |
| III-1365 | L_{A322} | L_{B9} | III-2938 | L_{A365} | L_{B18} | III-4511 | L_{A408} | L_{B27} | III-6084 | L_{A451} | L_{B36} |
| III-1366 | L_{A323} | L_{B9} | III-2939 | L_{A366} | L_{B18} | III-4512 | L_{A409} | L_{B27} | III-6085 | L_{A452} | L_{B36} |
| III-1367 | L_{A324} | L_{B9} | III-2940 | L_{A367} | L_{B18} | III-4513 | L_{A410} | L_{B27} | III-6086 | L_{A453} | L_{B36} |
| III-1368 | L_{A325} | L_{B9} | III-2941 | L_{A368} | L_{B18} | III-4514 | L_{A411} | L_{B27} | III-6087 | L_{A454} | L_{B36} |
| III-1369 | L_{A326} | L_{B9} | III-2942 | L_{A369} | L_{B18} | III-4515 | L_{A412} | L_{B27} | III-6088 | L_{A455} | L_{B36} |
| III-1370 | L_{A327} | L_{B9} | III-2943 | L_{A370} | L_{B18} | III-4516 | L_{A413} | L_{B27} | III-6089 | L_{A456} | L_{B36} |
| III-1371 | L_{A328} | L_{B9} | III-2944 | L_{A371} | L_{B18} | III-4517 | L_{A424} | L_{B27} | III-6090 | L_{A457} | L_{B36} |
| III-1372 | L_{A329} | L_{B9} | III-2945 | L_{A372} | L_{B18} | III-4518 | L_{A415} | L_{B27} | III-6091 | L_{A458} | L_{B36} |
| III-1373 | L_{A330} | L_{B9} | III-2946 | L_{A373} | L_{B18} | III-4519 | L_{A416} | L_{B27} | III-6092 | L_{A459} | L_{B36} |
| III-1374 | L_{A331} | L_{B9} | III-2947 | L_{A374} | L_{B18} | III-4520 | L_{A417} | L_{B27} | III-6093 | L_{A460} | L_{B36} |
| III-1375 | L_{A332} | L_{B9} | III-2948 | L_{A375} | L_{B18} | III-4521 | L_{A418} | L_{B27} | III-6094 | L_{A461} | L_{B36} |
| III-1376 | L_{A333} | L_{B9} | III-2949 | L_{A376} | L_{B18} | III-4522 | L_{A419} | L_{B27} | III-6095 | L_{A462} | L_{B36} |
| III-1377 | L_{A334} | L_{B9} | III-2950 | L_{A377} | L_{B18} | III-4523 | L_{A420} | L_{B27} | III-6096 | L_{A463} | L_{B36} |
| III-1378 | L_{A335} | L_{B9} | III-2951 | L_{A378} | L_{B18} | III-4524 | L_{A421} | L_{B27} | III-6097 | L_{A464} | L_{B36} |
| III-1379 | L_{A336} | L_{B9} | III-2952 | L_{A379} | L_{B18} | III-4525 | L_{A422} | L_{B27} | III-6098 | L_{A465} | L_{B36} |
| III-1380 | L_{A337} | L_{B9} | III-2953 | L_{A380} | L_{B18} | III-4526 | L_{A423} | L_{B27} | III-6099 | L_{A466} | L_{B36} |
| III-1381 | L_{A338} | L_{B9} | III-2954 | L_{A381} | L_{B18} | III-4527 | L_{A424} | L_{B27} | III-6100 | L_{A467} | L_{B36} |
| III-1382 | L_{A339} | L_{B9} | III-2955 | L_{A382} | L_{B18} | III-4528 | L_{A425} | L_{B27} | III-6101 | L_{A468} | L_{B36} |
| III-1383 | L_{A340} | L_{B9} | III-2956 | L_{A383} | L_{B18} | III-4529 | L_{A426} | L_{B27} | III-6102 | L_{A469} | L_{B36} |
| III-1384 | L_{A341} | L_{B9} | III-2957 | L_{A384} | L_{B18} | III-4530 | L_{A427} | L_{B27} | III-6103 | L_{A470} | L_{B36} |
| III-1385 | L_{A342} | L_{B9} | III-2958 | L_{A385} | L_{B18} | III-4531 | L_{A428} | L_{B27} | III-6104 | L_{A471} | L_{B36} |
| III-1386 | L_{A343} | L_{B9} | III-2959 | L_{A386} | L_{B18} | III-4532 | L_{A429} | L_{B27} | III-6105 | L_{A472} | L_{B36} |
| III-1387 | L_{A344} | L_{B9} | III-2960 | L_{A387} | L_{B18} | III-4533 | L_{A430} | L_{B27} | III-6106 | L_{A473} | L_{B36} |
| III-1388 | L_{A345} | L_{B9} | III-2961 | L_{A388} | L_{B18} | III-4534 | L_{A431} | L_{B27} | III-6107 | L_{A474} | L_{B36} |
| III-1389 | L_{A346} | L_{B9} | III-2962 | L_{A389} | L_{B18} | III-4535 | L_{A432} | L_{B27} | III-6108 | L_{A475} | L_{B36} |
| III-1390 | L_{A347} | L_{B9} | III-2963 | L_{A390} | L_{B18} | III-4536 | L_{A433} | L_{B27} | III-6109 | L_{A476} | L_{B36} |
| III-1391 | L_{A348} | L_{B9} | III-2964 | L_{A391} | L_{B18} | III-4537 | L_{A434} | L_{B27} | III-6110 | L_{A477} | L_{B36} |
| III-1392 | L_{A349} | L_{B9} | III-2965 | L_{A392} | L_{B18} | III-4538 | L_{A435} | L_{B27} | III-6111 | L_{A478} | L_{B36} |
| III-1393 | L_{A350} | L_{B9} | III-2966 | L_{A393} | L_{B18} | III-4539 | L_{A436} | L_{B27} | III-6112 | L_{A479} | L_{B36} |
| III-1394 | L_{A351} | L_{B9} | III-2967 | L_{A394} | L_{B18} | III-4540 | L_{A437} | L_{B27} | III-6113 | L_{A480} | L_{B36} |
| III-1395 | L_{A352} | L_{B9} | III-2968 | L_{A395} | L_{B18} | III-4541 | L_{A438} | L_{B27} | III-6114 | L_{A481} | L_{B36} |
| III-1396 | L_{A353} | L_{B9} | III-2969 | L_{A396} | L_{B18} | III-4542 | L_{A439} | L_{B27} | III-6115 | L_{A482} | L_{B36} |
| III-1397 | L_{A354} | L_{B9} | III-2970 | L_{A397} | L_{B18} | III-4543 | L_{A440} | L_{B27} | III-6116 | L_{A483} | L_{B36} |
| III-1398 | L_{A355} | L_{B9} | III-2971 | L_{A398} | L_{B18} | III-4544 | L_{A441} | L_{B27} | III-6117 | L_{A484} | L_{B36} |
| III-1399 | L_{A356} | L_{B9} | III-2972 | L_{A399} | L_{B18} | III-4545 | L_{A442} | L_{B27} | III-6118 | L_{A485} | L_{B36} |
| III-1400 | L_{A357} | L_{B9} | III-2973 | L_{A400} | L_{B18} | III-4546 | L_{A443} | L_{B27} | III-6119 | L_{A486} | L_{B36} |
| III-1401 | L_{A358} | L_{B9} | III-2974 | L_{A401} | L_{B18} | III-4547 | L_{A444} | L_{B27} | III-6120 | L_{A487} | L_{B36} |
| III-1402 | L_{A359} | L_{B9} | III-2975 | L_{A402} | L_{B18} | III-4548 | L_{A445} | L_{B27} | III-6121 | L_{A318} | L_{B37} |
| III-1403 | L_{A360} | L_{B9} | III-2976 | L_{A403} | L_{B18} | III-4549 | L_{A446} | L_{B27} | III-6122 | L_{A319} | L_{B37} |
| III-1404 | L_{A361} | L_{B9} | III-2977 | L_{A404} | L_{B18} | III-4550 | L_{A447} | L_{B27} | III-6123 | L_{A320} | L_{B37} |
| III-1405 | L_{A362} | L_{B9} | III-2978 | L_{A405} | L_{B18} | III-4551 | L_{A448} | L_{B27} | III-6124 | L_{A321} | L_{B37} |
| III-1406 | L_{A363} | L_{B9} | III-2979 | L_{A406} | L_{B18} | III-4552 | L_{A449} | L_{B27} | III-6125 | L_{A322} | L_{B37} |
| III-1407 | L_{A364} | L_{B9} | III-2980 | L_{A407} | L_{B18} | III-4553 | L_{A450} | L_{B27} | III-6126 | L_{A323} | L_{B37} |
| III-1408 | L_{A365} | L_{B9} | III-2981 | L_{A408} | L_{B18} | III-4554 | L_{A451} | L_{B27} | III-6127 | L_{A324} | L_{B37} |
| III-1409 | L_{A366} | L_{B9} | III-2982 | L_{A409} | L_{B18} | III-4555 | L_{A452} | L_{B27} | III-6128 | L_{A325} | L_{B37} |
| III-1410 | L_{A367} | L_{B9} | III-2983 | L_{A410} | L_{B18} | III-4556 | L_{A453} | L_{B27} | III-6129 | L_{A326} | L_{B37} |
| III-1411 | L_{A368} | L_{B9} | III-2984 | L_{A411} | L_{B18} | III-4557 | L_{A454} | L_{B27} | III-6130 | L_{A327} | L_{B37} |
| III-1412 | L_{A369} | L_{B9} | III-2985 | L_{A412} | L_{B18} | III-4558 | L_{A455} | L_{B27} | III-6131 | L_{A328} | L_{B37} |
| III-1413 | L_{A370} | L_{B9} | III-2986 | L_{A413} | L_{B18} | III-4559 | L_{A456} | L_{B27} | III-6132 | L_{A329} | L_{B37} |
| III-1414 | L_{A371} | L_{B9} | III-2987 | L_{A414} | L_{B18} | III-4560 | L_{A457} | L_{B27} | III-6133 | L_{A330} | L_{B37} |
| III-1415 | L_{A372} | L_{B9} | III-2988 | L_{A415} | L_{B18} | III-4561 | L_{A458} | L_{B27} | III-6134 | L_{A331} | L_{B37} |
| III-1416 | L_{A373} | L_{B9} | III-2989 | L_{A416} | L_{B18} | III-4562 | L_{A459} | L_{B27} | III-6135 | L_{A332} | L_{B37} |
| III-1417 | L_{A374} | L_{B9} | III-2990 | L_{A417} | L_{B18} | III-4563 | L_{A460} | L_{B27} | III-6136 | L_{A333} | L_{B37} |
| III-1418 | L_{A375} | L_{B9} | III-2991 | L_{A418} | L_{B18} | III-4564 | L_{A461} | L_{B27} | III-6137 | L_{A334} | L_{B37} |
| III-1419 | L_{A375} | L_{B9} | III-2992 | L_{A419} | L_{B18} | III-4565 | L_{A462} | L_{B27} | III-6138 | L_{A335} | L_{B37} |
| III-1420 | L_{A377} | L_{B9} | III-2993 | L_{A420} | L_{B18} | III-4566 | L_{A463} | L_{B27} | III-6139 | L_{A336} | L_{B37} |
| III-1421 | L_{A378} | L_{B9} | III-2994 | L_{A421} | L_{B18} | III-4567 | L_{A464} | L_{B27} | III-6140 | L_{A337} | L_{B37} |
| III-1422 | L_{A379} | L_{B9} | III-2995 | L_{A422} | L_{B18} | III-4568 | L_{A465} | L_{B27} | III-6141 | L_{A338} | L_{B37} |
| III-1423 | L_{A380} | L_{B9} | III-2996 | L_{A423} | L_{B18} | III-4569 | L_{A466} | L_{B27} | III-6142 | L_{A339} | L_{B37} |
| III-1424 | L_{A381} | L_{B9} | III-2997 | L_{A424} | L_{B18} | III-4570 | L_{A467} | L_{B27} | III-6143 | L_{A340} | L_{B37} |
| III-1425 | L_{A382} | L_{B9} | III-2998 | L_{A425} | L_{B18} | III-4571 | L_{A468} | L_{B27} | III-6144 | L_{A342} | L_{B37} |
| III-1426 | L_{A383} | L_{B9} | III-2999 | L_{A426} | L_{B18} | III-4572 | L_{A469} | L_{B27} | III-6145 | L_{A342} | L_{B37} |
| III-1427 | L_{A384} | L_{B9} | III-3000 | L_{A427} | L_{B18} | III-4573 | L_{A470} | L_{B27} | III-6146 | L_{A343} | L_{B37} |
| III-1428 | L_{A385} | L_{B9} | III-3001 | L_{A428} | L_{B18} | III-4574 | L_{A471} | L_{B27} | III-6147 | L_{A344} | L_{B37} |
| III-1429 | L_{A386} | L_{B9} | III-3002 | L_{A429} | L_{B18} | III-4575 | L_{A472} | L_{B27} | III-6148 | L_{A345} | L_{B37} |
| III-1430 | L_{A387} | L_{B9} | III-3003 | L_{A430} | L_{B18} | III-4576 | L_{A473} | L_{B27} | III-6149 | L_{A346} | L_{B37} |
| III-1431 | L_{A388} | L_{B9} | III-3004 | L_{A431} | L_{B18} | III-4577 | L_{A474} | L_{B27} | III-6150 | L_{A347} | L_{B37} |
| III-1432 | L_{A389} | L_{B9} | III-3005 | L_{A432} | L_{B18} | III-4578 | L_{A475} | L_{B27} | III-6151 | L_{A348} | L_{B37} |
| III-1433 | L_{A390} | L_{B9} | III-3006 | L_{A433} | L_{B18} | III-4579 | L_{A476} | L_{B27} | III-6152 | L_{A349} | L_{B37} |
| III-1434 | L_{A391} | L_{B9} | III-3007 | L_{A434} | L_{B18} | III-4580 | L_{A477} | L_{B27} | III-6153 | L_{A350} | L_{B37} |
| III-1435 | L_{A392} | L_{B9} | III-3008 | L_{A435} | L_{B18} | III-4581 | L_{A478} | L_{B27} | III-6154 | L_{A351} | L_{B37} |
| III-1436 | L_{A393} | L_{B9} | III-3009 | L_{A436} | L_{B18} | III-4582 | L_{A479} | L_{B27} | III-6155 | L_{A352} | L_{B37} |
| III-1437 | L_{A394} | L_{B9} | III-3010 | L_{A437} | L_{B18} | III-4583 | L_{A480} | L_{B27} | III-6156 | L_{A353} | L_{B37} |
| III-1438 | L_{A395} | L_{B9} | III-3011 | L_{A438} | L_{B18} | III-4584 | L_{A481} | L_{B27} | III-6157 | L_{A354} | L_{B37} |
| III-1439 | L_{A396} | L_{B9} | III-3012 | L_{A439} | L_{B18} | III-4585 | L_{A482} | L_{B27} | III-6158 | L_{A355} | L_{B37} |
| III-1440 | L_{A397} | L_{B9} | III-3013 | L_{A440} | L_{B18} | III-4586 | L_{A483} | L_{B27} | III-6159 | L_{A356} | L_{B37} |
| III-1441 | L_{A398} | L_{B9} | III-3014 | L_{A441} | L_{B18} | III-4587 | L_{A484} | L₈₂₇ | III-6160 | L_{A357} | L_{B37} |
| III-1442 | L_{A399} | L_{B9} | III-3015 | L_{A442} | L_{B1B} | III-4588 | L_{A485} | L_{B27} | III-6161 | L_{A358} | L_{B37} |
| III-1443 | L_{A400} | L_{B9} | III-3016 | L_{A443} | L_{BI8} | III-4589 | L_{A486} | L_{B27} | III-6162 | L_{A359} | L_{B37} |
| III-1444 | L_{A401} | L₈₉ | III-3017 | L_{A444} | L_{B18} | III-4590 | L_{A487} | L_{B27} | III-6163 | L_{A360} | L_{B37} |
| III-1445 | L_{A402} | L₈₉ | III-3018 | L_{A445} | L_{B18} | III-4591 | L_{A318} | L_{B28} | III-6164 | L_{A361} | L_{B37} |
| III-1446 | L_{A403} | L_{B9} | III-3019 | L_{A446} | L_{B18} | III-4592 | L_{A319} | L_{B28} | III-6165 | L_{A362} | L_{B37} |
| III-1447 | L_{A404} | L_{B9} | III-3020 | L_{A447} | L₈₁₈ | III-4593 | L_{A320} | L_{B28} | III-6166 | L_{A363} | L_{B37} |
| III-1448 | L_{A405} | L_{B9} | III-3021 | L_{A448} | L_{B18} | III-4594 | L_{A321} | L_{B28} | III-6167 | L_{A364} | L_{B37} |
| III-1449 | L_{A406} | L_{B9} | III-3022 | L_{A449} | L_{B18} | III-4595 | L_{A322} | L₈₂₈ | III-6168 | L_{A365} | L_{B37} |
| III-1450 | L_{A407} | L_{B9} | III-3023 | L_{A450} | L_{B18} | III-4596 | L_{A323} | L_{B28} | III-6169 | L_{A366} | L_{B37} |
| III-1451 | L_{A408} | L_{B9} | III-3024 | L_{A451} | L_{B18} | III-4597 | L_{A324} | L_{B28} | III-6170 | L_{A367} | L_{B37} |
| III-1452 | L_{A409} | L_{B9} | III-3025 | L_{A452} | L_{B18} | III-4598 | L_{A325} | L₈₂₈ | III-6171 | L_{A368} | L_{B37} |
| III-1453 | L_{A410} | L_{B9} | III-3026 | L_{A453} | L_{B18} | III-4599 | L_{A326} | L_{B28} | III-6172 | L_{A369} | L_{B37} |
| III-1454 | L_{A411} | L_{B9} | III-3027 | L_{A454} | L_{B18} | III-4600 | L_{A327} | L₈₂₈ | III-6173 | L_{A370} | L_{B37} |
| III-1455 | L_{A412} | L_{B9} | III-3028 | L_{A455} | L_{B18} | III-4601 | L_{A328} | L_{B18} | III-6174 | L_{A371} | L_{B37} |
| III-1456 | L_{A413} | L_{B9} | III-3029 | L_{A456} | L_{B18} | III-4602 | L_{A329} | L_{B28} | III-6175 | L_{A372} | L_{B37} |
| III-1457 | L₄₁₄ | L_{B9} | III-3030 | L_{A457} | L_{B18} | III-4603 | L_{A330} | L_{B28} | III-6176 | L_{A373} | L_{B37} |
| III-1458 | L_{A415} | L_{B9} | III-3031 | L_{A458} | L_{B18} | III-4604 | L_{A331} | L_{B28} | III-6177 | L_{A374} | L_{B37} |
| III-1459 | L_{A416} | L_{B9} | III-3032 | L_{A459} | L_{B18} | III-4605 | L_{A332} | L_{B28} | III-6178 | L_{A375} | L_{B37} |
| III-1460 | L_{A417} | L_{B9} | III-3033 | L_{A460} | L_{B18} | III-4606 | L_{A333} | L_{B28} | III-6179 | L_{A376} | L_{B37} |
| III-1461 | L_{A418} | L_{B9} | III-3034 | L_{A461} | L_{B18} | III-4607 | L_{A334} | L_{B28} | III-6180 | L_{A377} | L_{B37} |
| III-1462 | L_{A419} | L_{B9} | III-3035 | L_{A462} | L_{B18} | III-4608 | L_{A335} | L_{B28} | III-6181 | L_{A378} | L_{B37} |
| III-1463 | L_{A420} | L_{B9} | III-3036 | L_{A463} | L_{B18} | III-4609 | L_{A336} | L_{B28} | III-6182 | L_{A379} | L_{B37} |
| III-1464 | L_{A421} | L_{B9} | III-3037 | L_{A464} | L_{B18} | III-4610 | L_{A337} | L_{B28} | III-6183 | L_{A380} | L_{B37} |
| III-1465 | L_{A422} | L₈₉ | III-3038 | L_{A465} | L_{B18} | III-4611 | L_{A338} | L_{B28} | III-6184 | L_{A381} | L_{B37} |
| III-1466 | L_{A423} | L_{B9} | III-3039 | L_{A466} | L_{B18} | III-4612 | L_{A339} | L_{B28} | III-6185 | L_{A382} | L_{B37} |
| III-1467 | L_{A424} | L_{B9} | III-3040 | L_{A467} | L_{B18} | III-4613 | L_{A340} | L_{B28} | III-6186 | L_{A383} | L_{B37} |
| III-1468 | L_{A425} | L_{B9} | III-3041 | L_{A468} | L_{B18} | III-4614 | L_{A341} | L_{B28} | III-6187 | L_{A384} | L_{B37} |
| III-1469 | L_{A426} | L_{B9} | III-3042 | L_{A469} | L_{B18} | III-4615 | L_{A342} | L_{B28} | III-6188 | L_{A385} | L_{B37} |
| III-1470 | L_{A427} | L_{B9} | III-3043 | L_{A470} | L_{B18} | III-4616 | L_{A343} | L_{B28} | III-6189 | L_{A386} | L_{B37} |
| III-1471 | L_{A428} | L_{B9} | III-3044 | L_{A471} | L_{B18} | III-4617 | L_{A344} | L_{B28} | III-6190 | L_{A387} | L_{B37} |
| III-1472 | L_{A429} | L_{B9} | III-3045 | L_{A472} | L_{B18} | III-4618 | L_{A345} | L_{B28} | III-6191 | L_{A388} | L_{B37} |
| III-1473 | L_{A430} | L_{B9} | III-3046 | L_{A473} | L_{B18} | III-4619 | L_{A346} | L_{B28} | III-6192 | L_{A389} | L_{B37} |
| III-1474 | L_{A431} | L_{B9} | III-3047 | L_{A474} | L_{B18} | III-4620 | L_{A347} | L_{B28} | III-6193 | L_{A390} | L_{B37} |
| III-1475 | L_{A432} | L_{B9} | III-3048 | L_{A475} | L_{B18} | III-4621 | L_{A348} | L_{B28} | III-6194 | L_{A391} | L_{B37} |
| III-1476 | L_{A433} | L_{B9} | III-3049 | L_{A476} | L_{B18} | III-4622 | L_{A349} | L_{B28} | III-6195 | L_{A392} | L_{B37} |
| III-1477 | L_{A434} | L_{B9} | III-3050 | L_{A477} | L_{B18} | III-4623 | L_{A350} | L₈₂₈ | III-6196 | L_{A393} | L_{B37} |
| III-1478 | L_{A435} | L_{B9} | III-3051 | L_{A478} | L_{B18} | III-4624 | L_{A351} | L_{B28} | III-6197 | L_{A394} | L_{B37} |
| III-1479 | L_{A436} | L_{B9} | III-3052 | L_{A479} | L_{B18} | III-4625 | L_{A352} | L_{B28} | III-6198 | L_{A395} | L_{B37} |
| III-1480 | L_{A437} | L_{B9} | III-3053 | L_{A480} | L_{B18} | III-4626 | L_{A353} | L_{B28} | III-6199 | L_{A396} | L_{B37} |
| III-1481 | L_{A438} | L_{B9} | III-3054 | L_{A481} | L_{B18} | III-4627 | L_{A354} | L_{B28} | III-6200 | L_{A397} | L_{B37} |
| III-1482 | L_{A439} | L₈₉ | III-3055 | L_{A482} | L_{B28} | III-4628 | L_{A355} | L_{B28} | III-6201 | L_{A398} | L_{B37} |
| III-1483 | L_{A440} | L_{B8} | III-3056 | L_{A483} | L_{B18} | III-4629 | L_{A356} | L_{B28} | III-6202 | L_{A399} | L_{B37} |
| III-1484 | L_{A441} | L_{B9} | III-3057 | L_{A484} | L_{B28} | III-4630 | L_{A357} | L_{B28} | III-6203 | L_{A400} | L_{B37} |
| III-1485 | L_{A442} | L_{B9} | III-3058 | L_{A485} | L_{B18} | III-4631 | L_{A358} | L_{B28} | III-6204 | L_{A401} | L_{B37} |
| III-1486 | L_{A443} | L_{B9} | III-3059 | L_{A486} | L_{B18} | III-4632 | L_{A359} | L_{B28} | III-6205 | L_{A402} | L_{B37} |
| III-1487 | L_{A444} | L_{B9} | III-3060 | L_{A487} | L_{B18} | III-4633 | L_{A360} | L_{B28} | III-6206 | L_{A403} | L_{B37} |
| III-1488 | L_{A445} | L_{B9} | III-3061 | L_{A318} | L_{B19} | III-4634 | L_{A361} | L_{B28} | III-6207 | L_{A404} | L_{B37} |
| III-1489 | L_{A446} | L_{B9} | III-3062 | L_{A319} | L_{B29} | III-4635 | L_{A362} | L_{B28} | III-6208 | L_{A405} | L_{B37} |
| III-1490 | L_{A447} | L_{B9} | III-3063 | L_{A320} | L_{B19} | III-4636 | L_{A363} | L_{B28} | III-6209 | L_{A406} | L_{B37} |
| III-1491 | L_{A448} | L_{B9} | III-3064 | L_{A321} | L_{B19} | III-4637 | L_{A364} | L_{B28} | III-6210 | L_{A407} | L_{B37} |
| III-1492 | L_{A449} | L_{B9} | III-3065 | L_{A322} | L_{B19} | III-4638 | L_{A365} | L_{B28} | III-6211 | L_{A408} | L_{B37} |
| III-1493 | L_{A450} | L_{B9} | III-3066 | L_{A323} | L_{B19} | III-4639 | L_{A366} | L_{B28} | III-6212 | L_{A409} | L_{B37} |
| III-1494 | L_{A451} | L_{B9} | III-3067 | L_{A324} | L_{B19} | III-4640 | L_{A367} | L_{B28} | III-6213 | L_{A410} | L_{B37} |
| III-1495 | L_{A452} | L_{B9} | III-3068 | L_{A325} | L_{B19} | III-4641 | L_{A368} | L_{B28} | III-6214 | L_{A411} | L_{B37} |
| III-1496 | L_{A453} | L_{B9} | III-3069 | L_{A326} | L_{B19} | III-4642 | L_{A369} | L_{B28} | III-6215 | L_{A412} | L_{B37} |
| III-1497 | L_{A454} | L_{B9} | III-3070 | L_{A327} | L_{B19} | III-4643 | L_{A370} | L_{B28} | III-6216 | L_{A413} | L_{B37} |
| III-1498 | L_{A455} | L_{B9} | III-3071 | L_{A328} | L_{B19} | III-4644 | L_{A371} | L_{B28} | III-6217 | L_{A414} | L_{B37} |
| III-1499 | L_{A456} | L_{B9} | III-3072 | L_{A329} | L_{B19} | III-4645 | L_{A372} | L_{B28} | III-6218 | L_{A415} | L_{B37} |
| III-1500 | L_{A457} | L_{B9} | III-3073 | L_{A330} | L_{B19} | III-4646 | L_{A373} | L_{B28} | III-6219 | L_{A416} | L_{B37} |
| III-1501 | L_{A458} | L_{B9} | III-3074 | L_{A331} | L_{B19} | III-4647 | L_{A374} | L_{B28} | III-6220 | L_{A427} | L_{B37} |
| III-1502 | L_{A459} | L_{B9} | III-3075 | L_{A332} | L_{B19} | III-4648 | L_{A375} | L_{B28} | III-6221 | L_{A418} | L_{B37} |
| III-1503 | L_{A450} | L_{B9} | III-3076 | L_{A333} | L_{B19} | III-4649 | L_{A376} | L_{B28} | III-6222 | L_{A419} | L_{B37} |
| III-1504 | L_{A461} | L_{B9} | III-3077 | L_{A334} | L_{B19} | III-4650 | L_{A377} | L_{B28} | III-6223 | L_{A420} | L_{B37} |
| III-1505 | L_{A462} | L_{B9} | III-3078 | L_{A335} | L_{B29} | III-4651 | L_{A378} | L_{B28} | III-6224 | L_{A421} | L_{B37} |
| III-1506 | L_{A463} | L_{B9} | III-3079 | L_{A336} | L_{B19} | III-4652 | L_{A379} | L_{B28} | III-6225 | L_{A422} | L_{B37} |
| III-1507 | L_{A464} | L_{B9} | III-3080 | L_{A337} | L_{B19} | III-4653 | L_{A380} | L_{B28} | III-6226 | L_{A423} | L_{B37} |
| III-1508 | L_{A465} | L_{B9} | III-3081 | L_{A338} | L_{B19} | III-4654 | L_{A382} | L_{B28} | III-6227 | L_{A424} | L_{B37} |
| III-1509 | L_{A466} | L_{B9} | III-3082 | L_{A339} | L_{B19} | III-4655 | L_{A382} | L_{B28} | III-6228 | L_{A425} | L_{B37} |
| III-1510 | L_{A467} | L_{B9} | III-3083 | L_{A340} | L_{B19} | III-4656 | L_{A383} | L_{B28} | III-6229 | L_{A426} | L_{B37} |
| III-1511 | L_{A468} | L_{B9} | III-3084 | L_{A341} | L_{B19} | III-4657 | L_{A384} | L_{B28} | III-6230 | L_{A427} | L_{B37} |
| III-1512 | L_{A469} | L_{B9} | III-3085 | L_{A342} | L_{B19} | III-4658 | L_{A385} | L_{B28} | III-6231 | L_{A428} | L_{B37} |
| III-1513 | L_{A470} | L_{B9} | III-3086 | L_{A343} | L_{B19} | III-4659 | L_{A386} | L_{B28} | III-6232 | L_{A429} | L_{B37} |
| III-1514 | L_{A471} | L_{B9} | III-3087 | L_{A344} | L_{B19} | III-4660 | L_{A387} | L_{B28} | III-6233 | L_{A430} | L_{B37} |
| III-1515 | L_{A472} | L_{B9} | III-3088 | L_{A345} | L_{B19} | III-4661 | L_{A388} | L_{B28} | III-6234 | L_{A431} | L_{B37} |
| III-1516 | L_{A473} | L_{B9} | III-3089 | L_{A346} | L_{B19} | III-4662 | L_{A389} | L_{B28} | III-6235 | L_{A432} | L_{B37} |
| III-1517 | L_{A474} | L_{B9} | III-3090 | L_{A347} | L_{B19} | III-4663 | L_{A390} | L_{B28} | III-6236 | L_{A433} | L_{B37} |
| III-1518 | L_{A475} | L_{B9} | III-3091 | L_{A348} | L_{B19} | III-4664 | L_{A391} | L_{B28} | III-6237 | L_{A434} | L_{B37} |
| III-1519 | L_{A476} | L_{B9} | III-3092 | L_{A349} | L_{B19} | III-4665 | L_{A392} | L_{B28} | III-6238 | L_{A435} | L_{B37} |
| III-1520 | L_{A477} | L_{B9} | III-3093 | L_{A350} | L_{B19} | III-4666 | L_{A393} | L_{B28} | III-6239 | L_{A436} | L_{B37} |
| III-1521 | L_{A478} | L_{B9} | III-3094 | L_{A351} | L_{B19} | III-4667 | L_{A394} | L_{B28} | III-6240 | L_{A437} | L_{B37} |
| III-1522 | L_{A479} | L_{B9} | III-3095 | L_{A352} | L_{B19} | III-4668 | L_{A395} | L_{B28} | III-6241 | L_{A438} | L_{B37} |
| III-1523 | L_{A480} | L_{B9} | III-3096 | L_{A353} | L_{B19} | III-4669 | L_{A396} | L_{B28} | III-6242 | L_{A439} | L_{B37} |
| III-1524 | L_{A481} | L_{B9} | III-3097 | L_{A354} | L_{B19} | III-4670 | L_{A397} | L_{B28} | III-6243 | L_{A440} | L_{B37} |
| III-1525 | L_{A482} | L_{B9} | III-3098 | L_{A355} | L_{B19} | III-4671 | L_{A398} | L_{B28} | III-6244 | L_{A441} | L_{B37} |
| III-1526 | L_{A483} | L_{B9} | III-3099 | L_{A356} | L_{B19} | III-4672 | L_{A399} | L_{B28} | III-6245 | L_{A442} | L_{B37} |
| III-1527 | L_{A484} | L_{B9} | III-3100 | L_{A357} | L_{B19} | III-4673 | L_{A400} | L_{B28} | III-6246 | L_{A443} | L_{B37} |
| III-1528 | L_{A485} | L_{B9} | III-3101 | L_{A358} | L_{B19} | III-4674 | L_{A401} | L_{B28} | III-6247 | L_{A444} | L_{B37} |
| III-1529 | L_{A486} | L_{B9} | III-3102 | L_{A359} | L_{B19} | III-4675 | L_{A402} | L_{B28} | III-6248 | L_{A445} | L_{B37} |
| III-1530 | L_{A487} | L_{B9} | III-3103 | L_{A360} | L_{B19} | III-4676 | L_{A403} | L_{B28} | III-6249 | L_{A446} | L_{B37} |
| III-1531 | L_{A318} | L_{B10} | III-3104 | L_{A361} | L_{B19} | III-4677 | L_{A404} | L_{B28} | III-6250 | L_{A447} | L_{B37} |
| III-1532 | L_{A319} | L_{B10} | III-3105 | L_{A362} | L_{B19} | III-4678 | L_{A405} | L_{B28} | III-6251 | L_{A448} | L_{B37} |
| III-1533 | L_{A320} | L_{B10} | III-3106 | L_{A363} | L_{B19} | III-4679 | L_{A406} | L_{B28} | III-6252 | L_{A449} | L_{B37} |
| III-1534 | L_{A321} | L_{B10} | III-3107 | L_{A364} | L_{B19} | III-4680 | L_{A407} | L_{B28} | III-6253 | L_{A450} | L_{B37} |
| III-1535 | L_{A322} | L_{B10} | III-3108 | L_{A365} | L_{B19} | III-4681 | L_{A408} | L_{B28} | III-6254 | L_{A451} | L_{B37} |
| III-1536 | L_{A323} | L_{B10} | III-3109 | L_{A366} | L_{B19} | III-4682 | L_{A409} | L_{B28} | III-6255 | L_{A452} | L_{B37} |
| III-1537 | L_{A324} | L_{B10} | III-3110 | L_{A367} | L_{B19} | III-4683 | L_{A410} | L_{B28} | III-6256 | L_{A453} | L_{B37} |
| III-1538 | L_{A325} | L_{B20} | III-3111 | L_{A358} | L_{B19} | III-4684 | L_{A411} | L_{B28} | III-6257 | L_{A454} | L_{B37} |
| III-1539 | L_{A326} | L_{B10} | III-3112 | L_{A369} | L_{B19} | III-4685 | L_{A412} | L_{B28} | III-6258 | L_{A455} | L_{B37} |
| III-1540 | L_{A327} | L_{B10} | III-3113 | L_{A370} | L_{B19} | III-4686 | L_{A413} | L_{B28} | III-6259 | L_{A456} | L_{B37} |
| III-1541 | L_{A328} | L_{B10} | III-3114 | L_{A371} | L_{B19} | III-4687 | L_{A414} | L_{B28} | III-6260 | L_{A457} | L_{B37} |
| III-1 | L_{A328} | L_{B10} | III-1574 | L_{A371} | L_{B19} | III-3147 | L_{A414} | L_{B28} | III-4720 | L_{A457} | L_{B37} |
| III-2 | L_{A329} | L_{B10} | III-1575 | L_{A372} | L_{B19} | III-3148 | L_{A415} | L_{B28} | III-4721 | _{LA458} | L_{B37} |
| III-3 | L_{A330} | L_{B10} | III-1576 | L_{A373} | L_{B19} | III-3149 | L_{A416} | L_{B28} | III-4722 | L_{A459} | L_{B37} |
| III-4 | L_{A331} | L_{B10} | III-1577 | L_{A374} | L_{B19} | III-3150 | L_{A417} | L_{B28} | III-4723 | L_{A450} | L_{B37} |
| III-5 | L_{A332} | L_{B10} | III-1578 | L_{A375} | L_{B19} | III-3151 | L_{A418} | L_{B28} | III-4724 | L_{A461} | L_{B37} |
| III-6 | L_{A333} | L_{B10} | III-1579 | L_{A376} | L_{B19} | III-3152 | L_{A419} | L_{B28} | III-4725 | L_{A462} | L_{B37} |
| III-7 | L_{A334} | L_{B10} | III-1580 | L_{A377} | L_{B19} | III-3153 | L_{A420} | L_{B28} | III-4726 | L_{A463} | L_{B37} |
| III-8 | L_{A335} | L_{B10} | III-1581 | L_{A378} | L_{B19} | III-3154 | L_{A421} | L_{B28} | III-4727 | L_{A464} | L_{B37} |
| III-9 | L_{A336} | L_{B10} | III-1582 | L_{A379} | L_{B19} | III-3155 | L_{A422} | L_{B28} | III-4728 | L_{A465} | L_{B37} |
| III-10 | L_{A337} | L_{B10} | III-1583 | L_{A380} | L_{B19} | III-3156 | L_{A423} | L_{B29} | III-4729 | L_{A466} | L_{B37} |
| III-11 | L_{A338} | L_{B10} | III-1584 | L_{A381} | L_{B19} | III-3157 | L_{A424} | L_{B28} | III-4730 | L_{A467} | L_{B37} |
| III-12 | L_{A339} | L_{B10} | III-1595 | L_{A392} | L_{B19} | III-3158 | L_{A425} | L_{B28} | III-4731 | L_{A468} | L_{B37} |
| III-13 | L_{A340} | L_{B10} | III-1586 | L_{A383} | L_{B19} | III-3159 | L_{A456} | L_{B29} | III-4732 | L_{A469} | L_{B37} |
| III-14 | L_{A341} | L_{B10} | III-1587 | L_{A384} | L_{B19} | III-3160 | L_{A127} | L_{B28} | III-4733 | L_{A470} | L_{B37} |
| III-15 | L_{A342} | L_{B10} | III-1588 | L_{A385} | L_{B19} | III-3161 | L_{A428} | L_{B28} | III-4734 | L_{A471} | L_{B37} |
| III-16 | L_{A343} | L_{B10} | III-1589 | L_{A386} | L_{B19} | III-3162 | L_{A479} | L_{B28} | III-4735 | L_{A472} | L_{B37} |
| III-17 | L_{A344} | L_{B10} | III-1590 | L_{A387} | L_{B19} | III-3163 | L_{A430} | L_{B28} | III-4736 | L_{A473} | L_{B37} |
| III-18 | L_{A345} | L_{B10} | III-1591 | L_{A388} | L_{B19} | II-3164 | L_{A431} | L_{B28} | III-4737 | L_{A474} | L_{B37} |
| III-19 | L_{A346} | L_{B10} | III-1592 | L_{A389} | L_{B19} | III-3165 | L_{A432} | L_{B28} | III-4738 | L_{A475} | L_{B37} |
| III-20 | L_{A347} | L_{B10} | III-1593 | L_{A390} | L_{B19} | III-3166 | L_{A433} | L_{B28} | III-4739 | L_{A476} | L_{B37} |
| III-21 | L_{A348} | L_{B10} | III-1594 | L_{A391} | L_{B19} | III-3167 | L_{A434} | L_{B23} | III-4740 | L_{A477} | L_{B37} |
| III-22 | L_{A349} | L_{B10} | III-1595 | L_{A392} | L_{B19} | III-3168 | L_{A435} | L_{B28} | III-4741 | L_{A478} | L_{B37} |
| III-23 | L_{A350} | L_{B10} | III-1596 | L_{A393} | L_{B19} | III-3169 | L_{A436} | L_{B28} | III-4742 | L_{A479} | L_{B37} |
| III-24 | L_{A351} | L_{B10} | III-1597 | L_{A394} | L_{B19} | III-3170 | L_{A437} | L_{B28} | III-4743 | L_{A480} | L_{B37} |
| III-25 | L_{A352} | L_{B10} | III-1598 | L_{A395} | L_{B19} | III-3171 | L_{A438} | L_{B28} | III-4744 | L_{A481} | L_{B37} |
| III-26 | L_{A353} | L_{B10} | III-1599 | L_{A396} | L_{B19} | III-3172 | L_{A439} | L_{B28} | III-4745 | L_{A482} | L_{B37} |
| III-27 | L_{A354} | L_{B10} | III-1600 | L_{A397} | L_{B19} | III-3173 | L_{A440} | L_{B28} | III-4746 | L_{A483} | L_{B37} |
| III-28 | L_{A355} | L_{B10} | III-1601 | L_{A398} | L_{B19} | III-3174 | L_{A441} | L_{B28} | III-4747 | L_{A484} | L_{B37} |
| III-29 | L_{A356} | L_{B10} | III-1602 | L_{A399} | L_{B19} | III-3175 | L_{A442} | L_{B29} | III-4748 | L_{A485} | L_{B37} |
| III-30 | L_{A357} | L_{B10} | III-1603 | L_{A400} | L_{B19} | III-3176 | L_{A443} | L_{B28} | III-4749 | L_{A486} | L_{B37} |
| III-31 | L_{A358} | L_{B10} | III-1604 | L_{A401} | L_{B19} | III-3177 | L_{A444} | L_{B28} | III-4750 | L_{A487} | L_{B37} |
| III-32 | L_{A359} | L_{B10} | III-1605 | L_{A402} | L_{B19} | III-3178 | L_{A445} | L_{B28} | | | |
| III-33 | L_{A360} | L_{B10} | III-1606 | L_{A403} | L_{B19} | III-3179 | L_{A446} | L_{B28} | | | |

According to another aspect, the organic layer in the first device described above can comprise a compound having the formula Ir(L_{A})ₙ(L_{B})₃₋ₙ, having the structure according Formula II as defined above.

According to another aspect, a formulation comprising the compound of Formula I and/or Formula II is also within the scope of the present disclosure.

### DEVICE EXAMPLES

All example devices were fabricated by high vacuum (<133.32.10⁻⁷ Pascal (410⁻⁷ Torr)) thermal evaporation. The anode electrode is 1200 Å of indium tin oxide (ITO). The cathode consisted of 10 Å of

LiF followed by 1,000 Å of Al. All devices are encapsulated with a glass lid sealed with an epoxy resin in a nitrogen glove box (< 1 ppm of H₂O and O₂) immediately after fabrication, and a moisture getter was incorporated inside the package.

The organic stack of the device examples consisted of sequentially, from the ITO surface, 100 Å of Compound B as the hole injection layer (HIL), 300 Å of 4,4'-bis[N-(1-naphthyl)-N-phenylamino]biphenyl (α-NPD) as the hole transporting layer (HTL), 300 Å of the compound of Formula I doped in with Compound C as host, with 7 - 15 wt % of the iridium phosphorescent compound as the emissive layer (EML), 50 Ǻ of Compound C as a blocking layer (BL), 450 Å of tris-8-hydroxyquinoline aluminum (Alq) as the ETL. The comparative Example with Compound A was fabricated similarly to the Device Examples except that Compound A was used as the emitter in the EML.

The device results and data comparing the compounds of Formula I to the comparative compounds are summarized in Tables 2 and 3. The device results and data comparing the compounds of Formula II to the comparative compounds are summarized in Tables 4 and 5. The device results and data comparing the compounds of Formula I with R² is aryl, substituted aryl, heteroaryl or substituted heteroary to the comparative compounds are summarized in Tables 6 and 7. As used herein, NPD, Alq, and comparative Compounds A to D have the following structures:

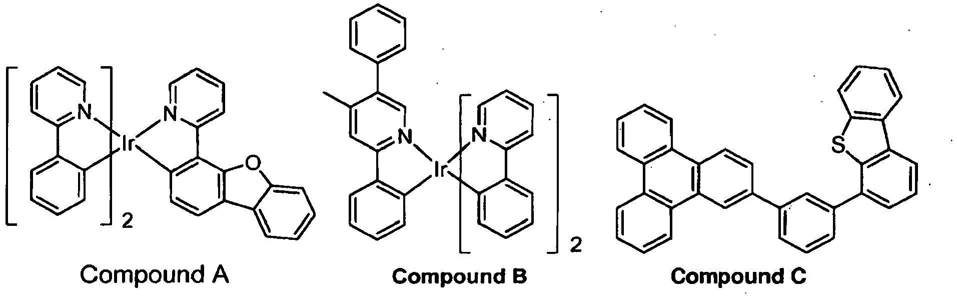

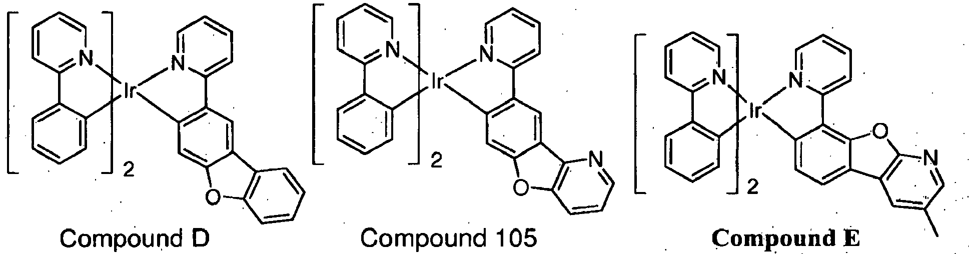

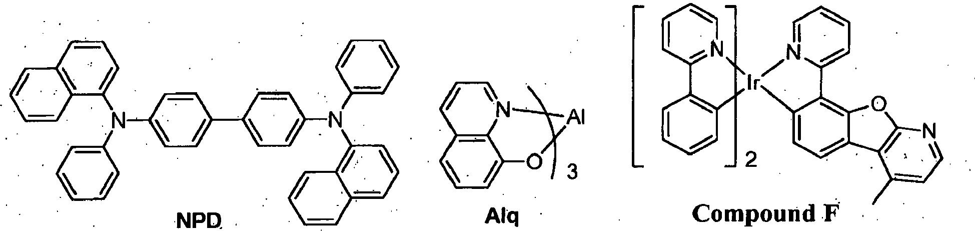

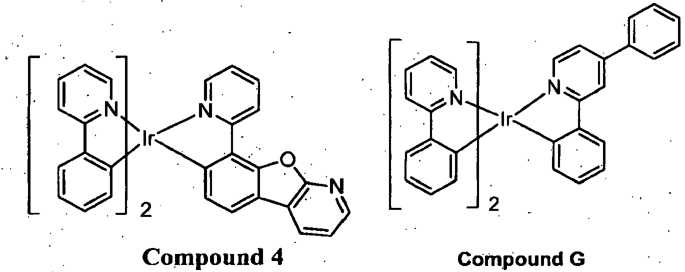

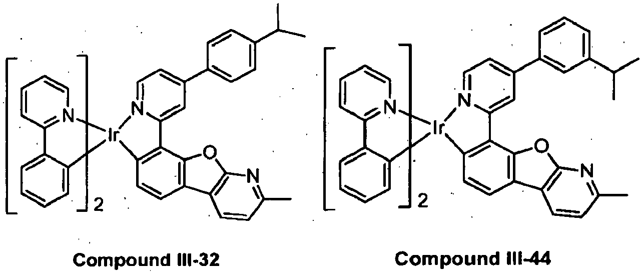

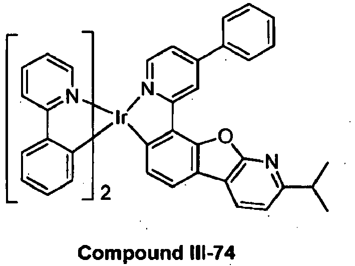

**Table 2 device Structures of Inventive Compound and Comparative Compound**

| **Example** | **HIL** (100 Å) | **HTL** (300 Å) | **EML** (300 Å, doping %) | | **BL** (50 Å) | **ETL** (450 Å) |
|---|---|---|---|---|---|---|
| **Comparative Example 1** | Compound B | NPD | Compound C | Compound **A** 10% | Compound C | Alq |
| **Inventive Example 1** | Compound B | NPD | Compound C | Compound **1** 10% | Compound C | Alq |
| **Comparative Example 2** | Compound B | NPD | Compound C | Compound **D** 10% | Compound C | Alq |
| **Inventive Example 2** | Compound B | NPD | Compound C | Compound **105** 10% | Compound C | Alq |
| **Inventive Example 3** | Compound B | NPD | Compound C | Compound **4** 10% | Compound C | Alq |

**Table 3 VTE Device Results**

| **Example** | **1931 CIE** | | **At 1000 nits** | | | | | | **At 40 mA/cm²** | |
|---|---|---|---|---|---|---|---|---|---|---|
| | **x** | **y** | **λₘₐₓ (nm)** | **FWHM (nm)** | **Voltage (V)** | **LE (Cd/A)** | **EQE (%)** | **PE (Im/W)** | **L₀ (nits)** | **LT₈₀ (h)** |
| **Comparative Example 1** | 0.350 | 0.619 | 530 | 62 | 6.2 | 64.8 | 17.2 | 33 | 18,482 | 121 |
| **Inventive Example 1** | 0.340 | 0.625 | 526 | 60 | 5.9 | 61.9 | 16.5 | 32.9 | 18,466 | 184 |
| **Comparative Example 2** | 0.319 | 0.618 | 520 | 74 | 6.2 | 51 | 1.4.4 | 25.9 | 15,504 | 65 |
| **Inventive Example 2** | 0.298 | 0.621 | 514 | 72 | 6.5 | 39.9 | 11.5 | 19.9 | 12,605 | 41 |
| **Inventive Example 3** | 0.343 | 0.623 | 528 | 62 | 6.8 | 47.1 | 12.5 | 21.8 | 13,471 | 370 |

Table 3 summarizes the performance of the devices. The driving voltage (V), luminous efficiency (LE), external quantum efficiency (EQE) and power efficiency (PE) are shown at 1000 nits. LT₈₀ was measured under a constant current density of 40 mA/cm² at the initial luminance (Lo).

As can be seen from the table, the EL peak of Compound 1 was at 526 nm, which is 4 nm blue shifted compared to that of Compound A. This is also consistent with the PL spectra. Both compounds showed very narrow FWHMs (full width at half maximum) at 60 and 62 nm, respectively. Both compounds showed high EQE in the same structure. The driving voltage of Compound 1 at 1000 nits is slightly lower than that of compound A, 5.9 V vs. 6.2 V. Devices incorporating compounds of Formula I, such as Compound 1, also had longer device lifetimes than devices that used Compound A (184 h vs. 121 h). Compound 4 also displayed a 2 nm blue shift relative to Compound A (528 vs. 530 nm). Additionally the LT₈₀ of Compound 4 is significantly longer than that of Compound A (370 vs. 121 h). Compound 105 was also blue shifted compared to Comparative Compound D (514 nm vs. 520 nm). The color of Compound 105 was also more saturated. Compounds of Formula I have unexpected and desirable properties for use as saturated green emitters in OLEDs.

Device data for compounds of Formula II: The organic stack of the device examples consisted of sequentially, from the ITO surface, 100 Å of Compound B as the hole injection layer (HIL), 300 Å of 4,4'-bis[N-(1-naphthyl)-N-phenylamino]biphenyl (NPD) as the hole transporting layer (HTL), 300 Å of the invention compound doped in Compound C as host with as the emissive layer (EML), 50 Å of Compound C as blocking layer, 450 Å of tris-8-hydroxyquinoline aluminum (Alq) as the ETL. In order to show Comparative Example using a compound having Formula I, Compound 4, was fabricated similarly to the Device Examples except that the Compound 4 was used as the emitter in the EML.

The device results and data are summarized in Tables 4 and 5 below.

**Table 4 device Structures of Inventive Compound and Comparative Compound. The thickness of each layer is provided.**

| **Example** | **HIL (100 Å)** | **HTL (300 Å)** | **EML (300 Å, doping %)** | | **BL (50 Å)** | **ETL (450 Å)** |
|---|---|---|---|---|---|---|
| **Comparative Example 3** | Compound B | NPD | Compound C | Compound 4 7% | Compound C | Alq |
| **Inventive Example 4** | Compound B | NPD | Compound C | Compound II-1 7% | Compound C | Alq |
| **Inventive Example 5** | Compound B | NPD | Compound C | Compound II-49 7% | Compound C | Alq |
| **Inventive Example 6** | Compound B | NPD | Compound C | Compound II-355 7% | Compound C | Alq |
| **Comparative Example 4** | Compound B | NPD | Compound C | Compound E 7% | Compound C | Alq |
| **Comparative Example 5** | Compound B | NPD | Compound C | Compound F | Compound C | Alq |

**Table 5 VTE Device Results**

| | **1931 CIE** | | | | **At 1,000 nits** | | | | **40mA/cm²** | |
|---|---|---|---|---|---|---|---|---|---|---|
| **Example** | **x** | **y** | **λ max** | **FWHM** | **Voltage** | **LE** | **EQE** | **PE** | **Lo** | **LT_{80%}** |
| | | | **[nm]** | **[nm]** | **relative** | **relative** | **relative** | **relative** | **[nits]** | **relative** |
| **Comparative Example** | 0.342 | 0.623 | 526 | 60 | 1 | 1 | 1 | 1 | 16,133 | 1 |
| **Inventive Example 4** | 0.362 | 0.611 | 530 | 66 | 0.98 | 1.14 | 1.13 | 1.15 | 18,749 | 1.2 |
| **Inventive Example 5** | 0.352 | 0.616 | 528 | 62 | 0.97 | 1.03 | 1.03 | 1.05 | 16,537 | 1.64 |
| **Inventive Example 6** | 0.365 | 0.609 | 530 | 64 | 0.95 | 1.28 | 1.28 | 1.34 | 17,522 | 1.53 |
| **Comparative Example 4** | 0.351 | 0.62 | 528 | 62 | 0.97 | 0.86 | 0.85 | 0.88 | 15,467 | 0.6 |
| **Comparative Example 5** | 0.344 | 0.621 | 526 | 64 | 0.98 | 0.79 | 0.78 | 0.79 | 13,896 | 1.16 |

Table 5 summarizes the performance of the devices. The driving voltage (V), luminous efficiency (LE), external quantum efficiency (EQE) and power efficiency (PE) are shown at 1000 nits, while the lifetime (LT_{80%}) was defined as the time required for the device to decay to 80% of its initial luminance (L₀) under a constant current density of 40 mA/cm². All measured values are listed as relative to the comparative example which is denoted as 1. As shown in Table 5 all three inventive compounds required slightly less driving voltage (0.98, 0.97 and 0.95) relative to the comparative compound (1.0). The inventive compounds demonstrated superior efficiency in all three categories also: the relative LE values were 1.14,1.03 and 1.28 for the Inventive Examples 4, 5 and 6, respectively, compared to 1.0 for Comparative Example 3 and 0.86 and 0.79 for Comparative Examples 4 and 5, respectively. The relative EQE of values were 1.13,1.03 and 1.28 for Inventive Examples 4, 5 and 6, respectively, compared to 1.0 for Comparative Example 3 and 0.85 and 0.78 for Comparative Examples 4 and 5, respectively. The relative PE values were 1.15,1.05, 1.34 for the Inventive Examples 4, 5 and 6, respectively, compared to 1.0 for the Comparative Example 3 and 0.88 and 0.79 for Comparative Examples 4 and 5, respectively. Finally the superior device stability of the inventive compounds were shown by the relative LT₈₀ values of 1.20,1.64,1.53 for the Inventive Examples 4, 5, and 6, respectively compared to 1.0 for the Comparative Example 3 and 0.6 for Comparative Example 4.

**Table 6: Device Structures of Inventive Compound and Comparative Compound When R² is Aryl, Substituted Aryl, Heteroaryl or Substituted Heteroaryl.**

| **Devices** | **HIL** | **HTL** | **EML (300 Å, doping %)** | | **BL** | **ETL** |
|---|---|---|---|---|---|---|
| Comparative Example 6 | Compound B 100 Å | NPD 300Å | Compound C | Compound G 7% | Compound C 50 Å | Alq 450Å |
| Inventive Example 7 | Compound B 100 Å | NPD 300Å | Compound C | **Compound III-32 7%** | Compound C 50Å | Alq 450Å |
| Inventive Example 8 | Compound B 100 Å | NPD 300Å | Compound C | **Compound III-44, 7%** | Compound C 50Å | Alq 450Å |
| Inventive Example 9 | Compound B 100 Å | NPD 300Å | Compound C | **Compound III-74 7%** | Compound C 50Å | Alq 450Å |

**Table 7 Device Results of Inventive Compound and Comparative Compound When R² is Aryl, Substituted Aryl, Heteroaryl or Substituted Heteroaryl.**

| | At 10 mA/cm² | | | |
|---|---|---|---|---|
| Devices | CIE (x,y) | V | LE (cd/A) | EQE (%) |
| Comparative Example 6 | (0.43, 0.55) | 8.3 | 54.2 | 20.6 |
| Inventive Example 7 | (0.42, 0.57) | 8.3 | 73.6 | 27.7 |
| Inventive Example 8 | (0.43, 0.57) | 8.2 | 67.6 | |
| Inventive Example 9 | (0.43, 0.56) | 8.5 | 63.4 | 23.3 |

Table 7 summarizes the performance of the devices. The CIE color coordinate, driving voltage (V), luminous efficiency (LE) were measured at a fixed current density, 10 mA/cm². According to the CIE color coordinate, all example devices were yellow emitting but the inventive device Examples 7, 8, and 9 exhibited better efficiencies than the comparative device Example 6 in term of LE (63.4~73.6 cd/A vs 54.2 cd/A) and EQE (23.3~ 27.7% vs 20.6 %).

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### HIL/HTL:

A hole injecting/transporting material to be used in the present invention is not particularly limited, and any compound may be used as long as the compound is typically used as a hole injecting/transporting material. Examples of the material include, but not limit to: a phthalocyanine or porphryin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and sliane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to he following general structures:

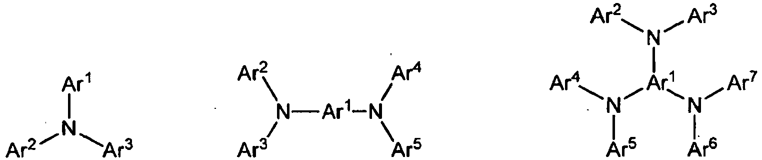

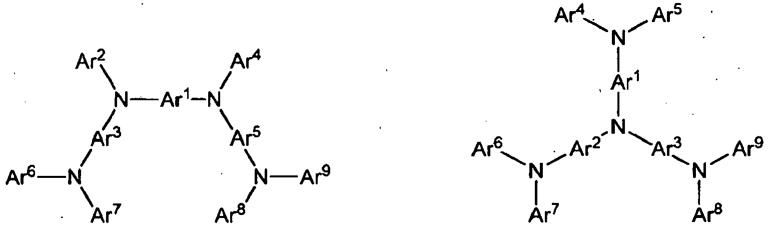

Each of Ar¹ to Ar⁹ is selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each Ar is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 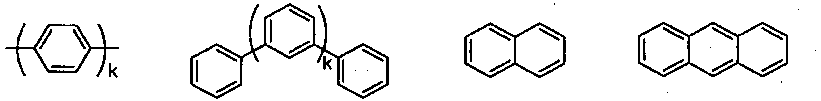 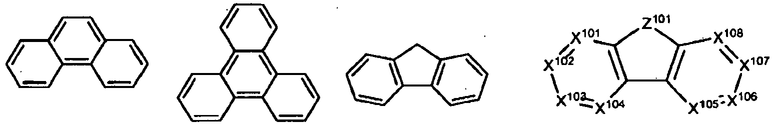 k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but not limit to the following general formula:

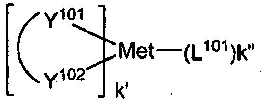

Met is a metal; (Y¹⁰¹-Y¹⁰²) is a bidentate ligand, Y¹⁰¹ and Y¹⁰² are independently selected from C, N, O, P, and S; L¹⁰¹ is another ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative.

In another aspect, (Y¹⁰¹-Y¹⁰²) is a carbene ligand.

In another aspect, Met is selected from Ir, Pt, Os, and Zn.

In a further aspect, the metal complex has a smallest oxidation potential in solution vs. Fc⁺/Fc couple less than about 0.6 V.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. While the Table below categorizes host materials as preferred for devices that emit various colors, any host material may be used with any dopant so long as the triplet criteria is satisfied.

Examples of metal complexes used as host are preferred to have the following general formula:

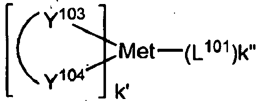

Met is a metal; (Y¹⁰³-Y¹⁰⁴) is a bidentate ligand, Y¹⁰³ and Y¹⁰⁴ are independently selected from C, N, O, P, and S; L¹⁰¹ is another ligand; k' is an integer value from 1 to the maximum number of ligands that may be attached to the metal; and k'+k" is the maximum number of ligands that may be attached to the metal.

In one aspect, the metal complexes are: 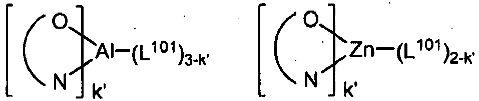 (O-N) is a bidentate ligand, having metal coordinated to atoms O and N.

In another aspect, Met is selected from Ir and Pt.

In a further aspect, (Y¹⁰³-Y¹⁰⁴) is a carbene ligand.

Examples of organic compounds used as host are selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofizran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atome, sulfur atom, silicon atom, phosphorus atom, boron atom, chain structural unit and the aliphatic cyclic group. Wherein each group is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, host compound contains at least one of the following groups in the molecule:

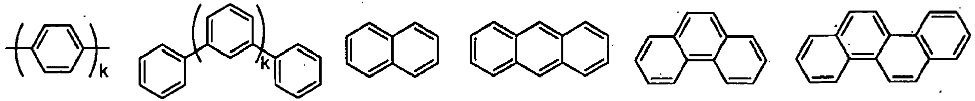

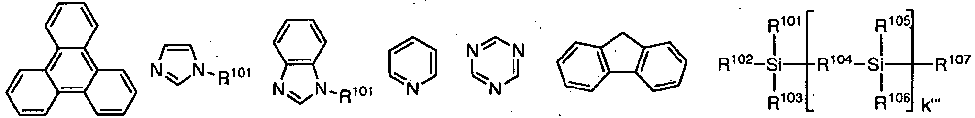

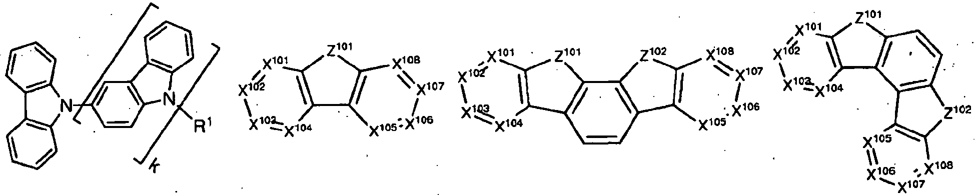

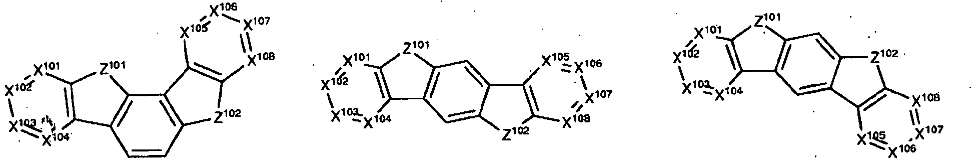

R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

k is an integer from 1 to 20; k'" is an integer from 0 to 20.

X¹⁰¹ to X¹⁰⁸ is selected from C (including CH) or N.
Z¹⁰¹ and Z¹⁰² is selected from NR¹⁰¹, O, or S.

### HBL:

A hole blocking layer (HBL) may be used to reduce the number of holes and/or excitons that leave the emissive layer. The presence of such a blocking layer in a device may result in substantially higher efficiencies as compared to a similar device lacking a blocking layer. Also, a blocking layer may be used to confine emission to a desired region of an OLED.

In one aspect, compound used in HBL contains the same molecule or the same functional groups used as host described above.

In another aspect, compound used in HBL contains at least one of the following groups in the molecule: 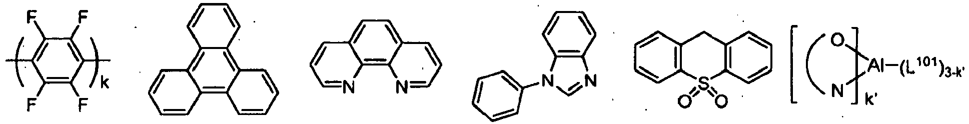 k is an integer from 1 to 20; L¹⁰¹ is another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule:

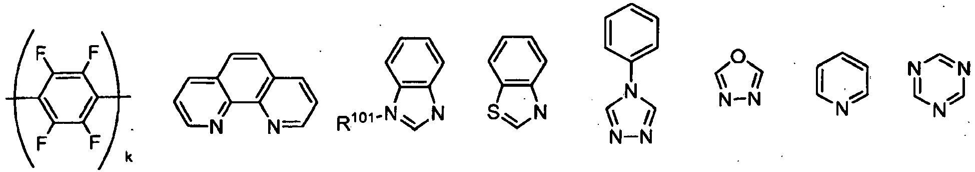

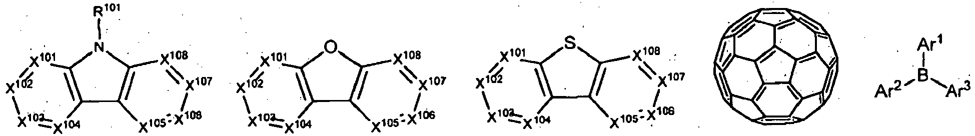

R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

Ar¹ to Ar³ has the similar definition as Ar's mentioned above.

k is an integer from 1 to 20.

X¹⁰¹ to X¹⁰⁸ is selected from C (including CH) or N.

In another aspect, the metal complexes used in ETL contains, but not limit to the following general formula: 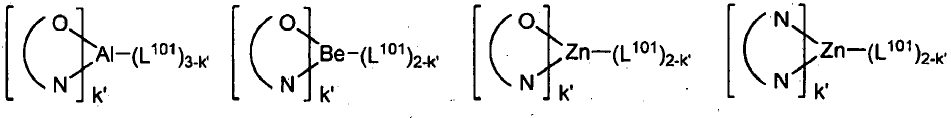 (O-N) or (N-N) is a bidentate ligand, having metal coordinated to atoms O, N or N, N; L¹⁰¹ is another ligand; k' is an integer value from 1 to the maximum number of ligands that may be attached to the metal.

In any above-mentioned compounds used in each layer of the OLED device, the hydrogen atoms can be partially or fully deuterated. Thus, any specifically listed substituent, such as, without limitation, methyl, phenyl, pyridyl, etc: encompasses undeuterated, partially deuterated, and fully deuterated versions thereof. Similarly, classes of substituents such as, without limitation, alkyl, aryl, cycloalkyl, Heteroaryl, etc. also encompass undeuterated, partially deuterated, and fully deuterated versions thereof.

In addition to and / or in combination with the materials disclosed herein, many hole injection materials, hole transporting materials, host materials, dopant materials, exciton/hole blocking layer materials, electron transporting and electron injecting materials may be used in an OLED. Non-limiting examples of the materials that may be used in an OLED in combination with materials disclosed herein are listed in Table 8 below. Table 8 lists non-limiting classes of materials, non-limiting examples of compounds for each class, and references that disclose the materials.

**TABLE 8**

| **MATERIAL** | **EXAMPLES OF MATERIAL** | **PUBLICATIONS** |
|---|---|---|
| **Hole injection materials** | | |
| Phthalocyanine and porphryin compounds | 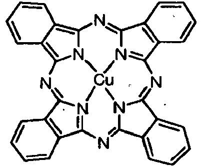 | Appl. Phys. Lett. 69, 2160 (1996) |
| Starburst triarylamines | 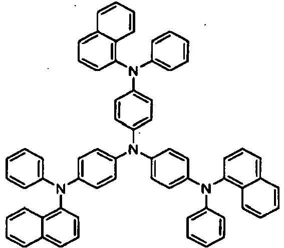 | J. Lumin. 72-74, 985 (1997) |
| CFₓ Fluorohydrocarbon polymer | 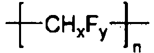 | Appl. Phys. Lett. 78, 673 (2001) |
| Conducting polymers (e.g., PEDOT:PSS, polyaniline, polypthiophene) | 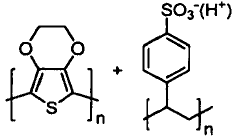 | Synth. Met. 87, 171 (1997) WO2007002683 |
| Phosphonic acid and sliane SAMs | 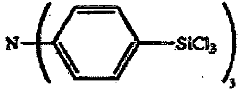 | US20030162053 |
| Triarylamine or polythiophene polymers with conductivity dopants | 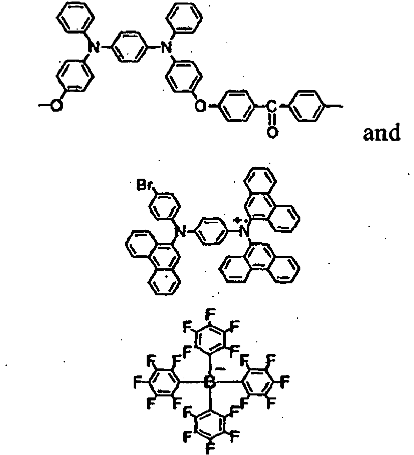 | EP1725079A1 |
| Organic compounds with conductive inorganic compounds, such as molybdenum and tungsten oxides | 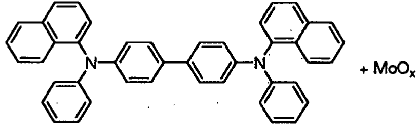 | US20050123751 SID Symposium Digest, 37, 923 (2006) WO2009018009 |
| n-type semiconducting organic complexes | 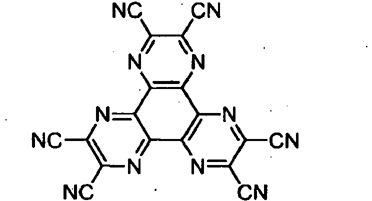 | US20020158242 |
| Metal organometallic complexes | 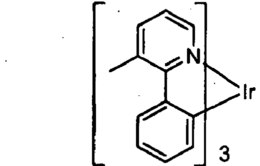 | US20060240279 |
| Cross-linkable compounds | 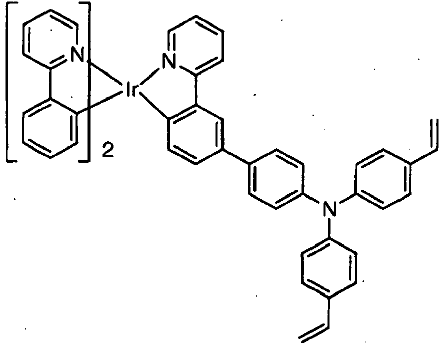 | US20080220265 |
| Polythiophene based polymers and copolymers | 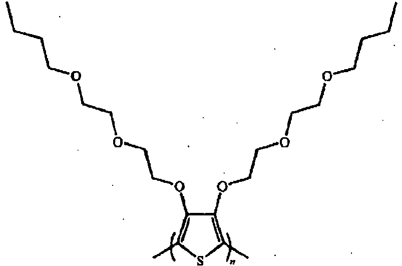 | WO 2011075644 EP2350216 |

| **Hole transporting materials** | | |
|---|---|---|
| Triarylamines (e.g., TPD, α-NPD) | 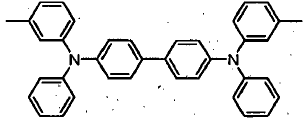 | Appl. Phys. Lett. 51, 913 (1987) |
| | 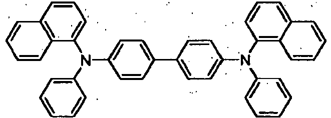 | US5061569 |
| | 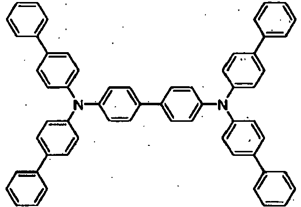 | EP650955 |
| | 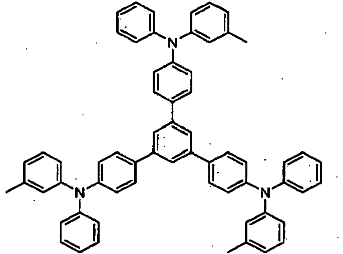 | J. Mater. Chem. 3, 319 (1993) |
| | 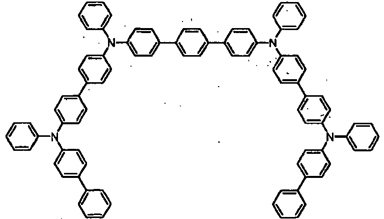 | Appl. Phys. Lett. 90, 183503 (2007) |
| | 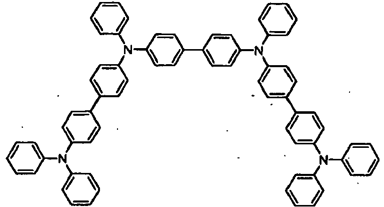 | Appl. Phys. Lett. 90, 183503 (2007) |
| Triaylamine on spirofluorene core | 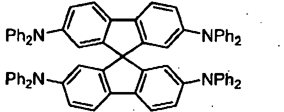 | Synth. Met. 91, 209 (1997) |
| Arylamine carbazole compounds | 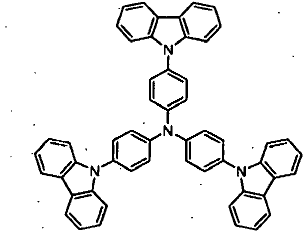 | Adv. Mater. 6, 677 (1994), US20080124572 |
| Triarylamine with (di)benzothiophene/(di)ben zofuran | 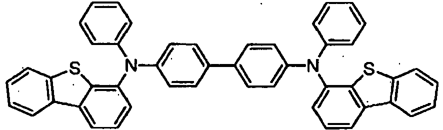 | US20070278938, US20080106190 US20110163302 |
| Indolocarbazoles | 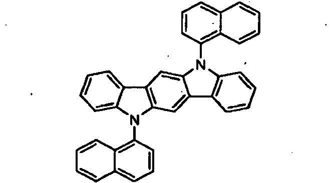 | Synth. Met. 111, 421 (2000) |
| Isoindole compounds | 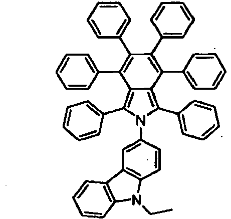 | Chem. Mater. 15,3148 (2003) |
| Metal carbene complexes | 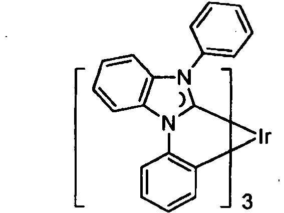 | US20080018221 |

| **Phosphorescent OLED host materials** | | |
|---|---|---|
| **Red hosts** | | |
| Arylcarbazoles | 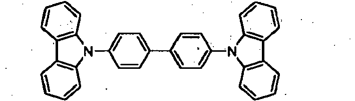 | Appl. Phys. Lett. 78, 1622 (2001) |
| Metal 8-hydroxyquinolates (e.g., Alq₃, BAlq) | 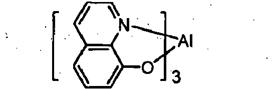 | Nature 395, 151 (1998) |
| | 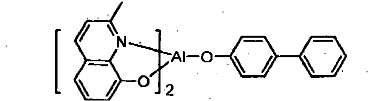 | US20060202194 |
| | 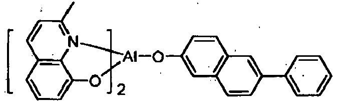 | WO2005014551 |
| | 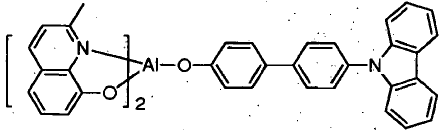 | WO2006072002 |
| Metal phenoxybenzothiazole compounds | 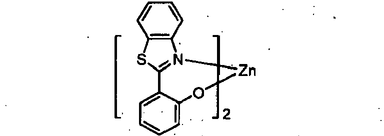 | Appl. Phys. Lett., 90, 123509 (2007) |
| Conjugated oligomers and polymers (e.g., polyfluorene) | 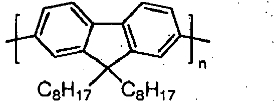 | Org. Electron. 1, 15 (2000) |
| Aromatic fused rings | 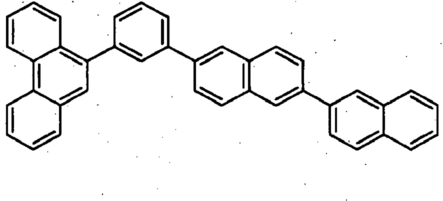 | WO2009066779, WO2009066778, WO2009063833, US20090045731, US20090045730, WO2009008311 US20090008605, US20090009065 |
| Zinc complexes | 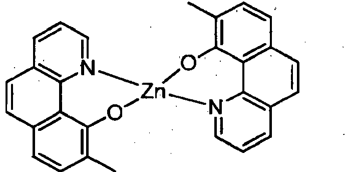 | WO2010056066 |
| Chrysene based compounds | 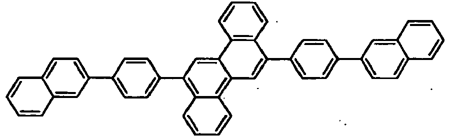 | WO2011086863 |

| **Green hosts** | | |
|---|---|---|
| Arylcarbazoles | 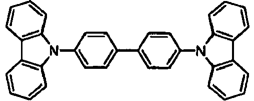 | Appl. Phys. Lett. 78, 1622 (2001) |
| | 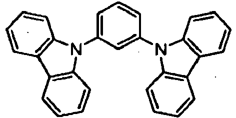 | US20030175553 |
| | 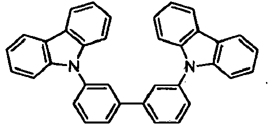 | WO2001039234 |
| Aryltriphenylene compounds | 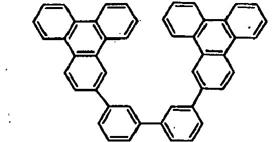 | US20060280965 |
| | 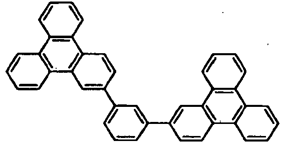 | US20060280965 |
| | 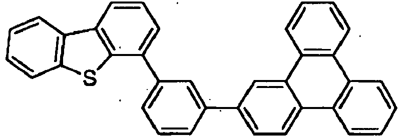 | WO2009021126 |
| Poly-fused heteroaryl compounds | 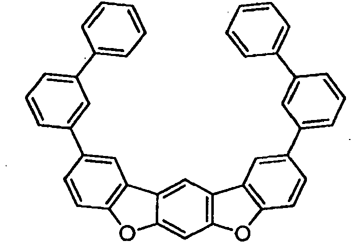 | US20090309488 US20090302743 US20100012931 |
| Donor acceptor type molecules | 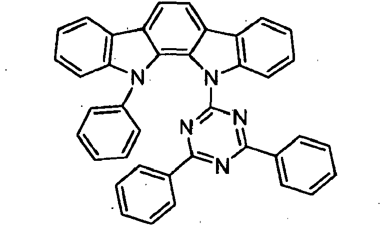 | WO2008056746 |
| | 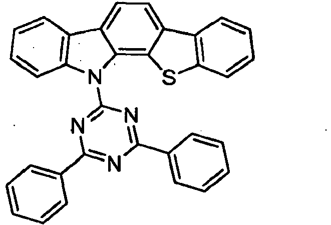 | WO2010107244 |
| Aza-carbazole/DBT/DBF | 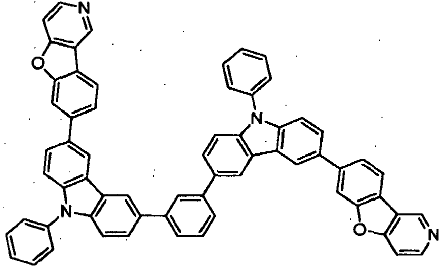 | JP2008074939 |
| | 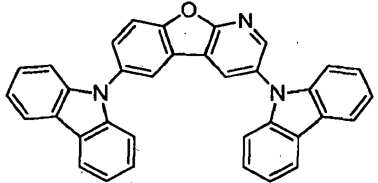 | US20100187984 |
| Polymers (e.g., PVK) | 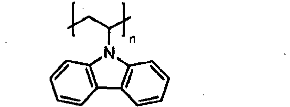 | Appl. Phys. Lett. 77, 2280 (2000) |
| Spirofluorene compounds | 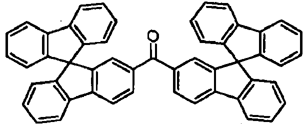 | WO2004093207 |
| Metal phenoxybenzooxazole compounds | 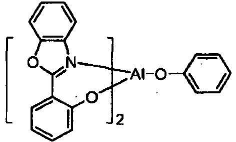 | WO2005089025 |
| | 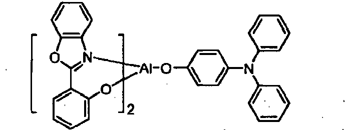 | WO2006132173 |
| | 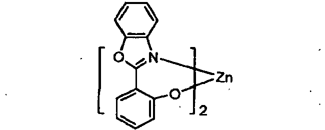 | JP200511610 |
| Spirofluorene-carbazole compounds | 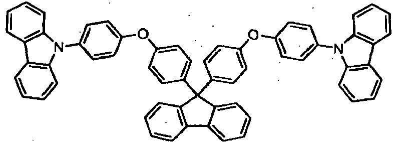 | JP2007254297 |
| | 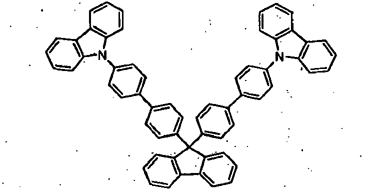 | JP2007254297 |
| Indolocabazoles | 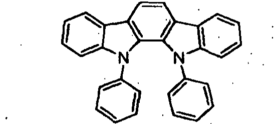 | WO2007063796 |
| | 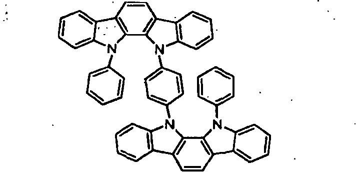 | WO2007063754 |
| 5-member ring electron deficient heterocycles (e.g., triazole, oxadiazole) | 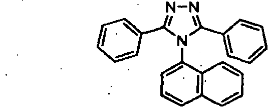 | J. Appl. Phys. 90, 5048 (2001) |
| | 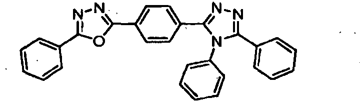 | WO2004107822 |
| Tetraphenylene complexes | 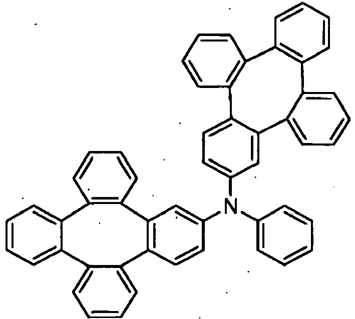 | US20050112407 |
| Metal phenoxypyridine compounds | 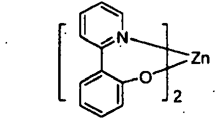 | WO2005030900 |
| Metal coordination complexes (e.g., Zn, Al with N^N ligands) | 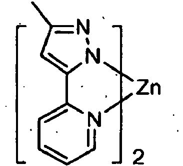 | US20040137268, US20040137267 |

| **Blue hosts** | | |
|---|---|---|
| Arylcarbazoles | 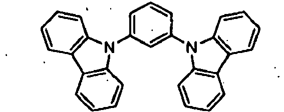 | Appl. Phys. Lett, 82, 2422 (2003) |
| | 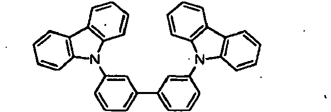 | US20070190359 |
| Dibenzothiophene/Dibenz ofuran-carbazole compounds | 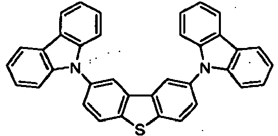 | WO2006114966, US20090167162 |
| | 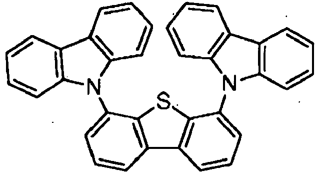 | US20090167162 |
| | 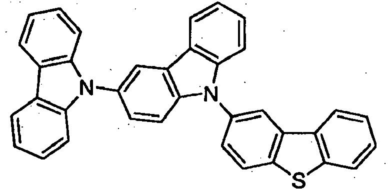 | WO2009086028 |
| | 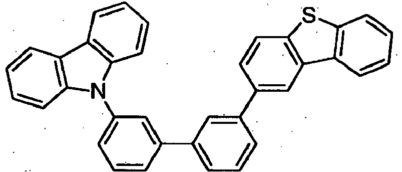 | US20090030202, US20090017330 |
| | 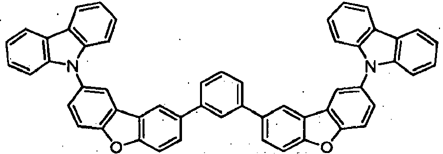 | US20100084966 |
| Silicon aryl compounds | 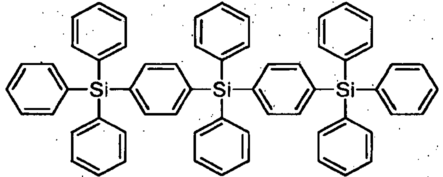 | US20050238919 |
| | 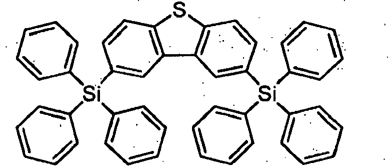 | WO2009003898 |
| Silicon/Germanium aryl compounds | 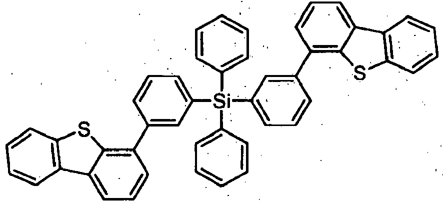 | EP2034538A |
| Aryl benzoyl ester | 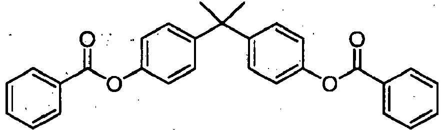 | WO2006100298 |
| Carbazole linked by non-conjugated groups | 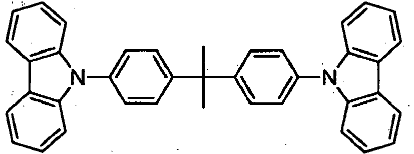 | US200401115476 |
| Aza-carbazoles | 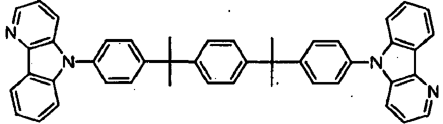 | US20060121308 |
| High triplet metal organometallic complex | 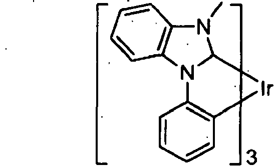 | US7154114 |

| **Phosphorescent dopants** | | |
|---|---|---|
| **Red dopants** | | |
| Heavy metal porphyrins (e.g., PtOEP) | 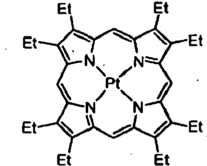 | Nature 395, 151 (1998) |
| Iridium(III) organometallic complexes | 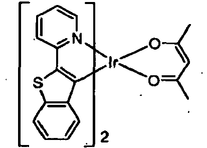 | Appl. Phys. Lett. 78, 1622 (2001) |
| | 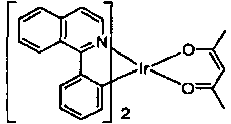 | US2006835469 |
| | 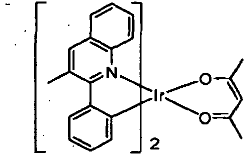 | US2006835469 |
| | 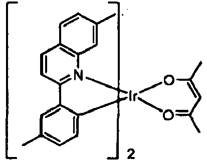 | US20060202194 |
| | 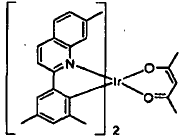 | US20060202194 |
| | 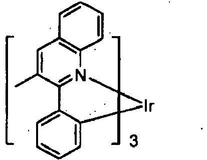 | US20070087321 |
| | 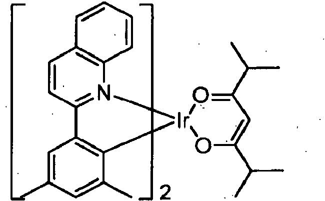 | US20080261076 US20100090591 |
| | 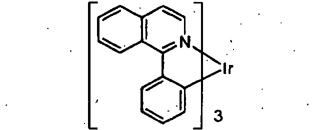 | US20070087321 |
| | 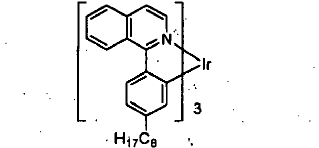 | Adv. Mater. 19, 739 (2007) |
| | 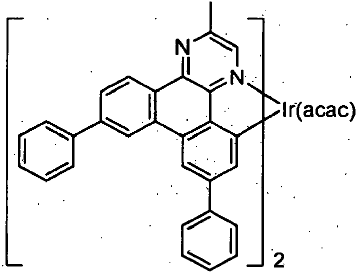 | WO200910991 |
| | 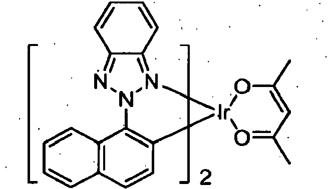 | WO2008101842 |
| | 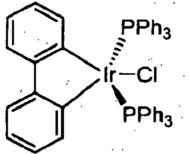 | US7232618 |
| Platinum(II) organometallic complexes | 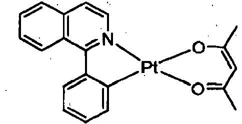 | WO2003040257 |
| | 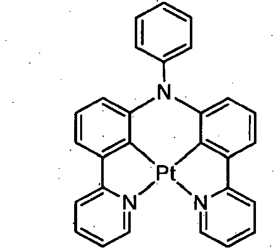 | US20070103060 |
| Osminum(III) complexes | 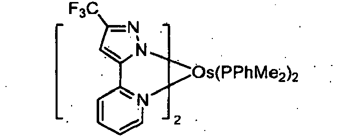 | Chem. Mater. 17, 3532 (2005) |
| Ruthenium (II) complexes | 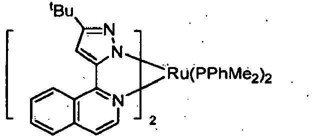 | Adv. Mater. 17, 1059 (2005) |
| Rhenium (I), (II), and (III) complexes | 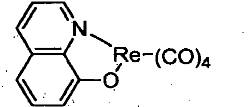 | US20050244673 |

| **Green dopants** | | |
|---|---|---|
| Iridium*(III) organometallic complexes | 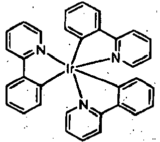 | Inorg. Chem. 40, 1704 (2001) |
| | and its derivatives | |
| | 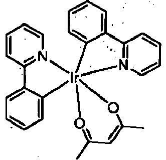 | US20020034656 |
| | 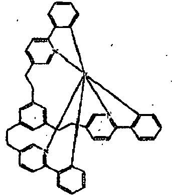 | US7332232 |
| | 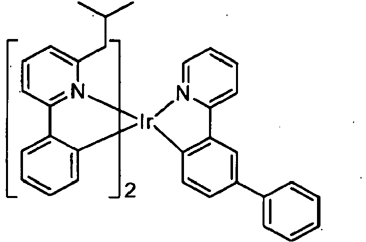 | US20090108737 |
| | 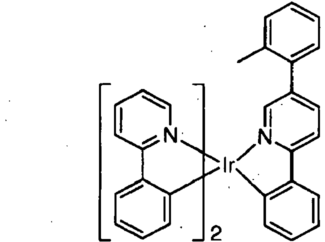 | WO2010028151 |
| | 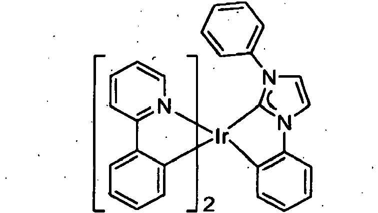 | EP1841834B |
| | 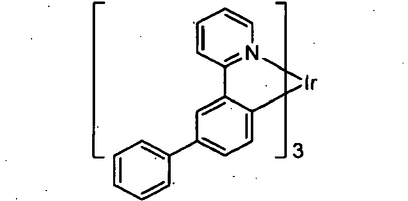 | US20060127696 |
| | 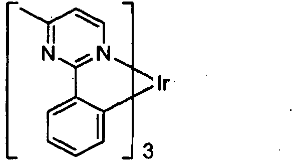 | US20090039776 |
| | 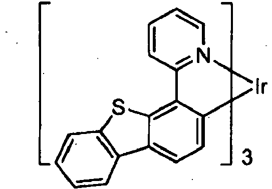 | US6921915 |
| | 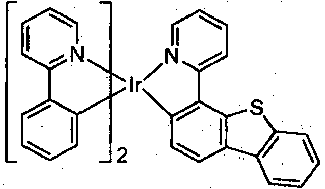 | US20100244004 |
| | 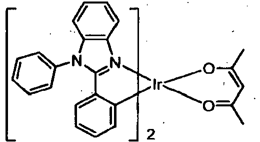 | US6687266 |
| | 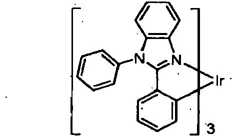 | Chem. Mater. 16, 2480 (2004) |
| | 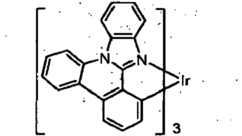 | US20070190359 |
| | 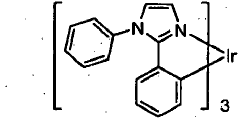 | US 20060008670 JP2007123392 |
| | 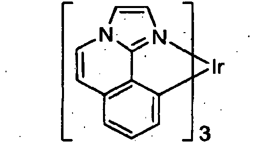 | WO2010086089, WO20110449888 |
| | 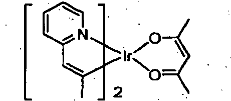 | Adv. Mater. 16, 2003 (2004) |
| | 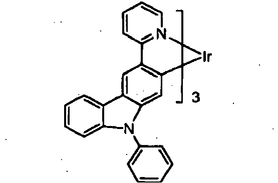 | Angew. Chem. Int. Ed. 2006,45,7800 |
| | 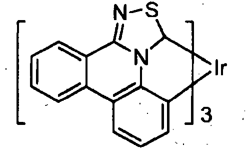 | WO2009050290 |
| | 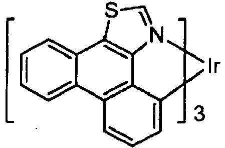 | US20090165846 |
| | 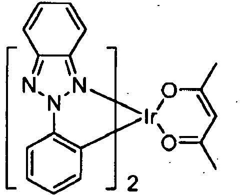 | US20080015355 |
| | 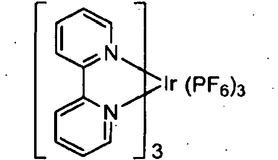 | US20010015432 |
| | 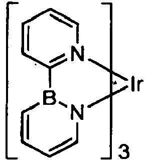 | US20100295032 |
| Monomer for polymeric metal organometallic compounds | 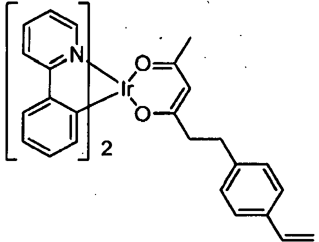 | US7250226, US7396598 |
| Pt(II) organometallic complexes, including polydentated ligands | 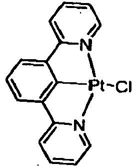 | Appl. Phys. Lett. 86, 153505 (2005) |
| | 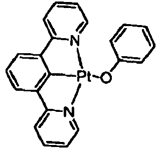 | Appl. Phys. Lett. 86, 153505 (2005) |
| | 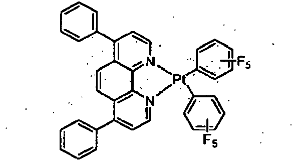 | Chem. Lett. 34, 592 (2005) |
| | 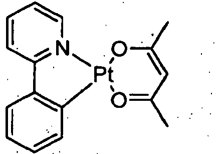 | WO2002015645 |
| | 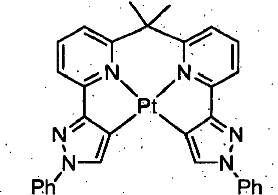 | US20060263635 |
| | 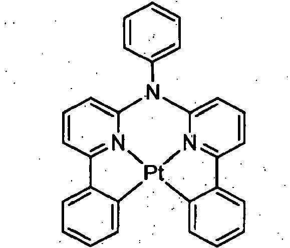 | US20060182992 US20070103060 |
| Cu complexes | 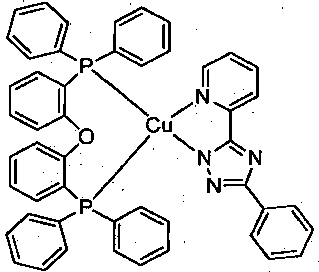 | WO2009000673 |
| | 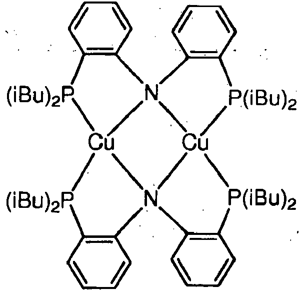 | US20070111026 |
| Gold complexes | 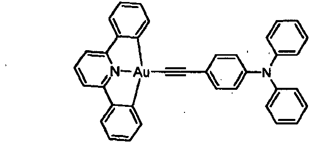 | Chem. Commun. 2906 (2005) |
| Rhenium(III) complexes | 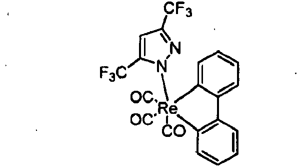 | Inorg. Chem. 42, 1248 (2003) |
| Osmium(II) complexes | 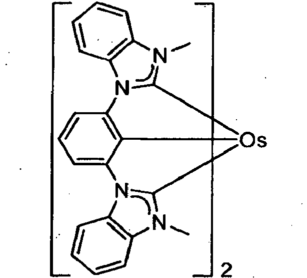 | US7279704 |
| Deuterated organometallic complexes | 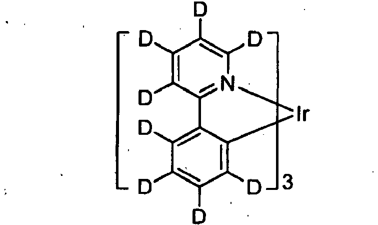 | US20030138657 |
| Organometallic complexes with two or more metal centers | 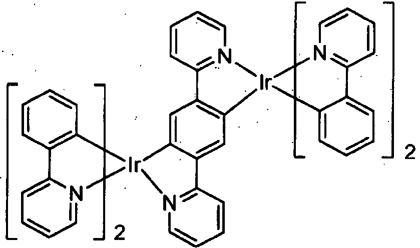 | US20030152802 |
| | 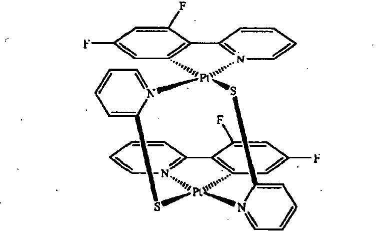 | US7090928 |

| **Blue dopants** | | |
|---|---|---|
| | | |
| Iridium(III) organometallic complexes | 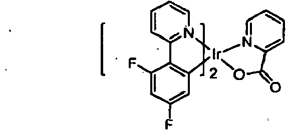 | WO2002002714 |
| | 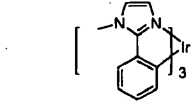 | WO2006009024 |
| | 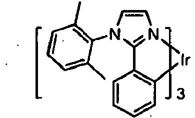 | US20060251923 US20110057559 US20110204333 |
| | 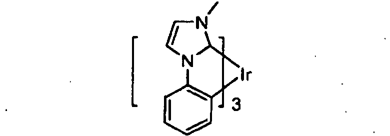 | US7393599, WO2006056418, US20050260441, WO2005019373 |
| | 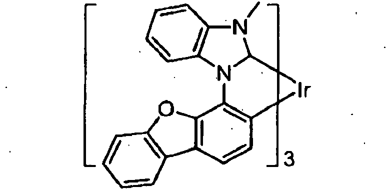 | US7534505 |
| | 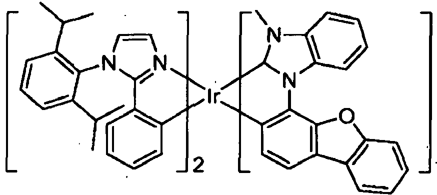 | WO201105140 |
| | 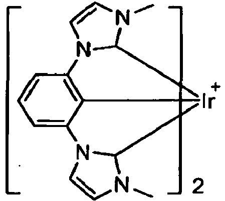 | US7445855 |
| | 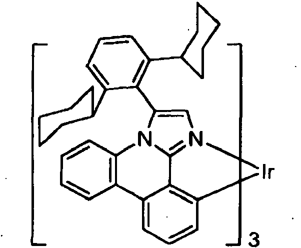 | US20070190359, US20080297033 US20100148663 |
| | 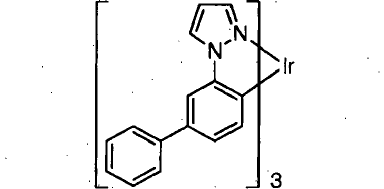 | US7338722 |
| | 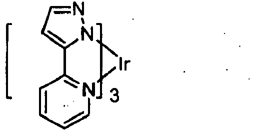 | US20020134984 |
| | 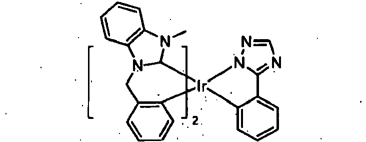 | Angew. Chem. Int. Ed. 47,1 (2008) |
| | 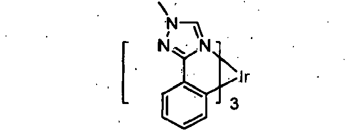 | Chem. Mater. 18, 5119 (2006) |
| | 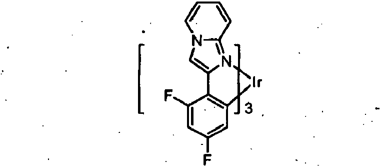 | Inorg. Chem. 46, 4308 (2007) |
| | 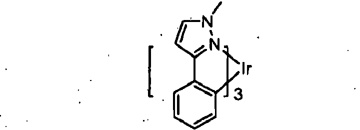 | WO2005123873 |
| | 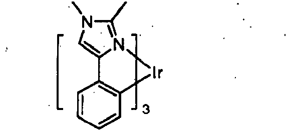 | WO2005123873 |
| | 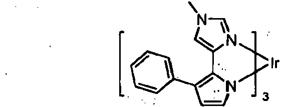 | WO2007004380 |
| | 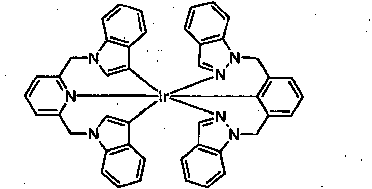 | WO2006082742 |
| Osmium(II) complexes | 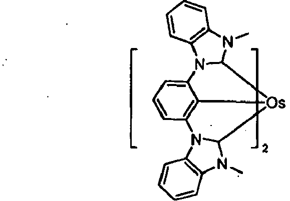 | US7279704 |
| | 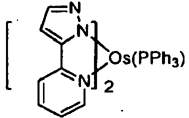 | Organometallics 23, 3745 (2004) |
| Gold complexes | 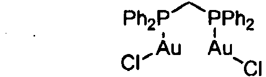 | Appl. Phys. Lett.74,1361 (1999) |
| Platinum(II) complexes | 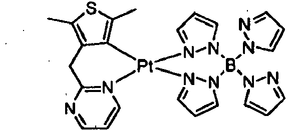 | WO2006098120, WO2006103874 |
| Pt tetradentate complexes with at least one metal-carbene bond | 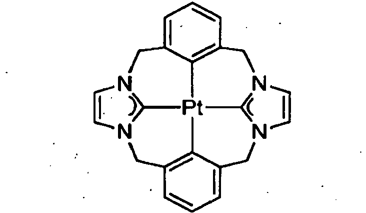 | US7655323 |

| **Exciton/hole blocking layer materials** | | |
|---|---|---|
| Bathocuprine compounds (e.g., BCP, BPhen) | 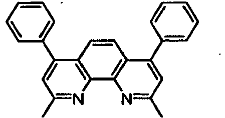 | Appl. Phys. Lett. 75, 4 (1999) |
| | 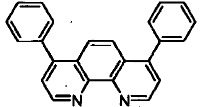 | Appl. Phys. Lett. 79, 449 (2001) |
| Metal 8-hydroxyquinolates (e.g., BAlq) | 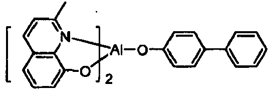 | Appl. Phys. Lett. 81, 162(2002) |
| 5-member ring electron deficient heterocycles such as triazole, oxadiazole, imidazole, benzoimidazole | 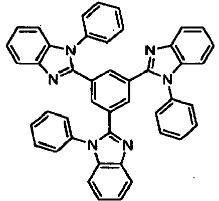 | Appl. Phys. Lett. 81, 162 (2002) |
| Triphenylene compounds | 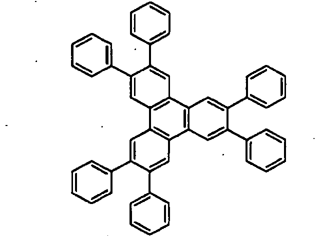 | US20050025993 |
| Fluorinated aromatic compounds | 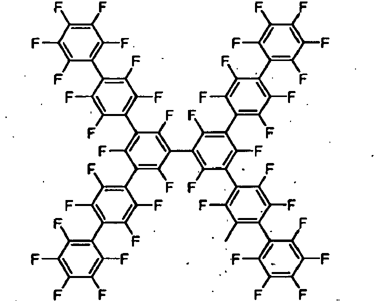 | Appl. Phys. Lett. 79, 156 (2001) |
| Phenothiazine-S-oxide | 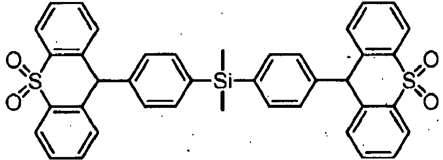 | WO2008132085 |
| Silylated five-membered nitrogen, oxygen, sulfur or phosphorus dibenzoheterocycles | 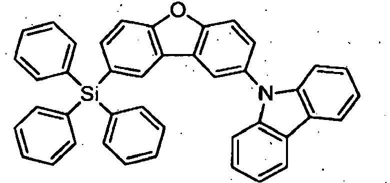 | WO2010079051 |
| Aza-carbazoles | 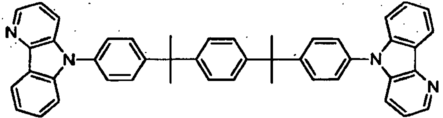 | US20060121308 |

| **Electron transporting materials** | | |
|---|---|---|
| Anthracene-benzoimidazole compounds | 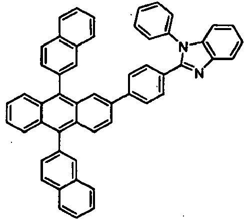 | WO2003060956 |
| | 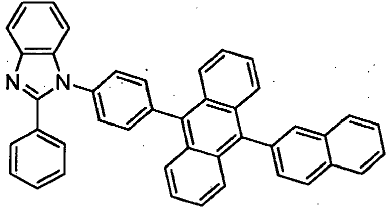 | US20090179554 |
| Aza triphenylene derivatives | 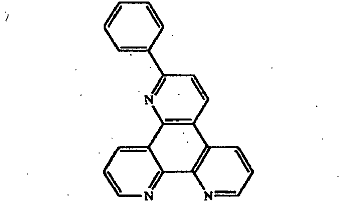 | US20090115316 |
| Anthracene-benzothiazole compounds | 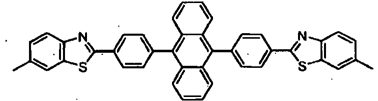 | Appl. Phys. Lett. 89, 063504 (2006) |
| Metal 8-hydroxyquinolates (e.g., Alq₃, Zrq₄) | 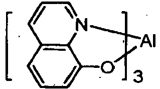 | Appl: Phys: Lett. 51, 913 (1987) US7230107 |
| Metal hydroxybenoquinolates | 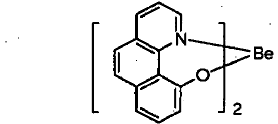 | Chem. Lett. 5, 905 (1993) |
| Bathocuprine compounds such as BCP, BPhen, etc | 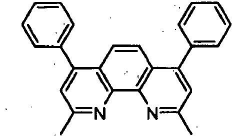 | Appl. Phys. Lett. 91, 263503 (2007) |
| | 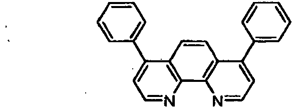 | Appl. Phys. Lett. 79, 449 (2001) |
| 5-member ring electron deficient heterocycles (e.g.,triazole, oxadiazole, imidazole, benzoimidazole) | 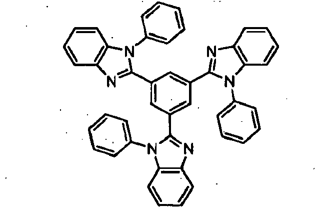 | Appl. Phys. Lett. 74, 865 (1999) |
| | 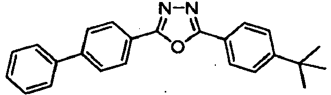 | Appl. Phys. Lett. 55, 1489 (1989) |
| | 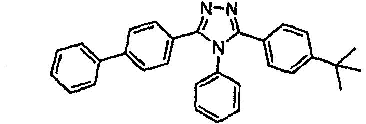 | Jpn. J. Apply. Phys. 32, L917 (1993) |
| Silole compounds | 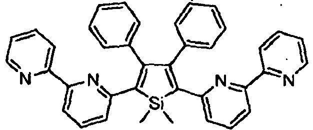 | Org. Electron. 4,113 (2003) |
| Arylborane compounds | 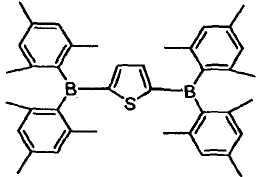 | J. Am. Chem. Soc. 120, 9714 (1998) |
| Fluorinated aromatic compounds | 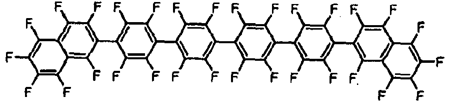 | J. Am. Chem. Soc. 122, 1832 (2000) |
| Fullerene (e.g., C60) | 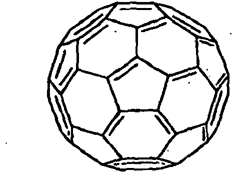 | US20090101870 |
| Triazine complexes | 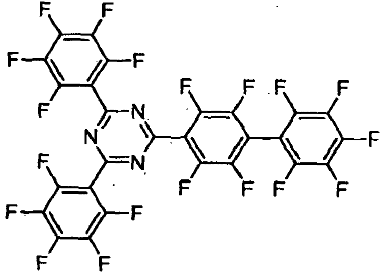 | US20040036077 |
| Zn (N^N) complexes | 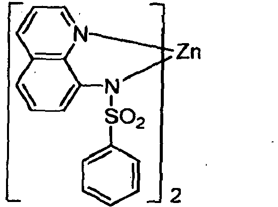 | US6528187 |

### EXPERIMENTAL

Chemical abbreviations used throughout the text are as follows: DME is dimethoxyethane, THF is tetrahydrofuran, DCM is dichloromethane, DMSO is dimethyl sulfoxide, dba is dibenzylidineacetone.

### Synthesis of Compound 1

### Preparation of 2-(3-bromopyridin-2-yl)-6-chlorophenol

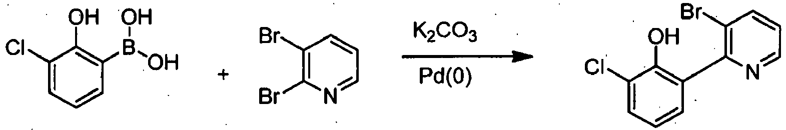

(3-Chloro-2-hydroxyphenyl)boronic acid (5.0 g, 29.0 mmol) and 2,3-dibromopyridine (6.87 g, 29.0 mmol) were added to a 500 mL 2-necked flask. The reaction mixture was diluted with DME (120 mL) and water (90 mL) with the potassium carbonate (8.02 grams, 58.0 mmol) dissolved in it. This mixture was degassed for 10 minutes before addition of Pd(PPh₃)₄ (1.00 grams, 3 mol %). The reaction mixture was then stirred at gentle reflux four 5 hours. The reaction mixture was then diluted with ethyl acetate and brine. The organic layer was washed with brine and dried over sodium sulfate. The product was purified using silica gel column chromatography using a mobile phase gradient of 5-10% ethyl acetate in hexane to obtain 2.8 grams (34%) of a white solid.

### Preparation of 6-chlorobenzofuro[3,2-b]pyridine:

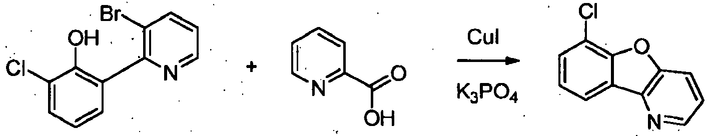

Into a 500 mL round-bottomed flask was placed 2-(3-bromopyridin-2-yl)-6-chlorophenol (4.5 g, 15.82 mmol), copper(I) iodide (0.602 g, 3.16 mmol), picolinic acid (0.779 g, 6.33 mmol) and potassium phosphate (6.71 g, 31.6 mmol) and DMSO (150 mL). This mixture was stirred in an oil bath at 125 °C for 5 hours. The heat was removed and the mixture was diluted with ethyl acetate and filtered through Celite®. The filtrate was washed with brine twice then with water. The organic layer was adsorbed onto Celite® and chromatographed eluting with 40-100% dichloromethane in hexane to obtain 2.45 grams (76%) of the desired product as a white solid.

### Preparation of 6-(pyridin-2-yl)benzofuro[3,2-b]pyridine:

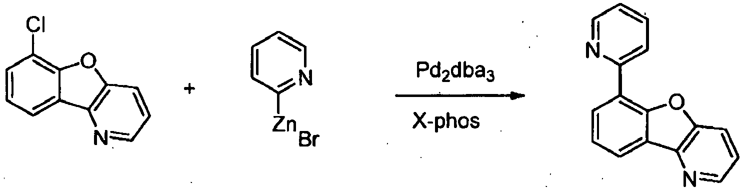

2-Dicyclohexylphosphino-2',4',6'-triisopropylbiphenyl (1.12 g, 2.36 mmol), 6-chlorobenzofuro[3,2-b]pyridine (3.0 g, 14.73 mmol), and Pd₂dba₃ (0.54 g, 0.59 mmol) were added to a 250 mL 3-necked flask. The atmosphere in the flask was evacuated and backfilled with nitrogen. THF (15 mL) was added by syringe to the reaction flask. Pyridin-2-yl zinc(II) bromide (44.2 mL, 22.10 mmol) was then added and the flask was stirred in in an oil bath at 75 °C. After 2 hours, the reaction mixture was cooled and diluted with aqueous sodium bicarbonate and ethyl acetate. The aqueous layer was extracted with ethyl acetate and the combined organic layers were dried with sodium sulfate. The crude product was purified using silica gel column chromatography eluted with 0-5% methanol in DCM to give 3.2 g (88%) of desired product. This product was further purified by column chromatography over silica gel using DCM followed by up to 40% ethyl acetate/DCM mixture as eluent to obtain 2.8 g (77%) 6-(pyridin-2-yl)benzofuro[3,2-b]pyridine as a white solid.

### Preparation of Compound 1:

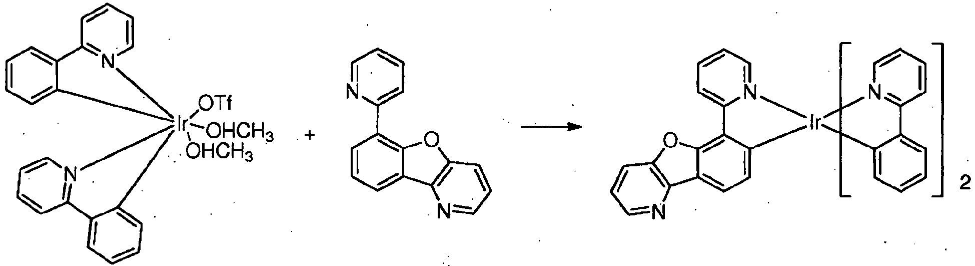

6-(Pyridin-2-yl)benzofuro[3,2-b]pyridine (2.71 g, 11.00 mmol) and iridium complex (1.964 g, 2.75 mmol) were added to ethanol (90 mL) and degassed for 15 minutes with nitrogen. The reaction mixture was heated to reflux until the iridium triflate intermediate disappeared. The reaction mixture was cooled to room temperature and filtered through a Celite® plug and washed with ethanol and hexanes. The yellow color precipitate was dissolved in DCM. Solvents were removed under reduced pressure from the DCM solution to give 1.65 g of crude material which was purified by silica gel column chromatography using 1:1 DCM/hexanes (v/v) followed by 95:5 DCM/methanol (v/v) as eluent. The isolated material was further purified by reversed phase column chromatography over C18 stationary phase using 95:5 % acetonitrile/water as eluent to give 0.7 g (34%) of Compound 1.

### Synthesis of Compound 4

### Preparation of 3-(2,3-dimethoxyphenyl)pyridin-2-amine:

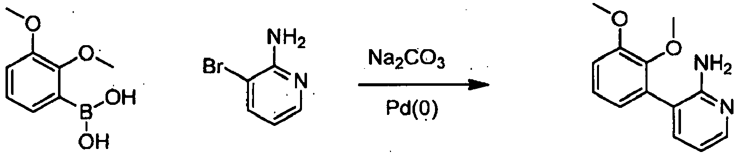

3-Bromopyridin-2-amine (23.77 g, 137 mmol), (2,3-dimethoxyphenyl)boronic acid (25 g, 137 mmol), and Pd(Ph₃P)₄ (4.76 g, 4.12 mmol) were added to a 2 L 2-necked flask. The reaction mixture was diluted with THF (600 mL). A solution of water (300 mL) with sodium carbonate (14.56 g, 137 mmol) dissolved in it was then added. This mixture was degassed and stirred at reflux for 20 hours. The mixture was then diluted with ethyl acetate and brine. The organic layer was washed with water and dried over sodium sulfate. The product was chromatographed on a silica gel column eluted with 0-50% ethyl acetate in DCM to obtain 28.9 g (91%) of the desired material.

### Preparation of 8-methoxybenzofuro[2,3-b]pyridine:

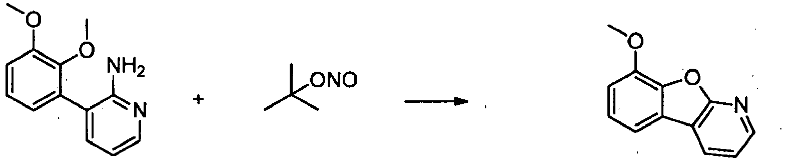

3-(2,3-Dimethoxyphenyl)pyridin-2-amine (14 g, 60.8 mmol) was added to a 500 mL round bottom flask. Acetic acid (220 mL) and THF (74 mL) were added. This mixture was stirred in a salt water ice bath. t-Butyl nitrite (14.5 mL, 109 mmol) was added drop-wise. The reaction mixture was stirred in the bath for 3 hours and then was allowed to warm ambient temperature with stirring. This mixture was evaporated *in vacuo* and partitioned between ethyl acetate and aqueous sodium bicarbonate. The product was chromatographed on silica gel. Elution with 25% ethyl acetate in hexane gave 6.61 g (54.6%) of 8-methoxybenzofuro[2,3-b]pyridine as a white solid.

### Preparation of benzofuro[2,3-b]pyridin-8-ol:

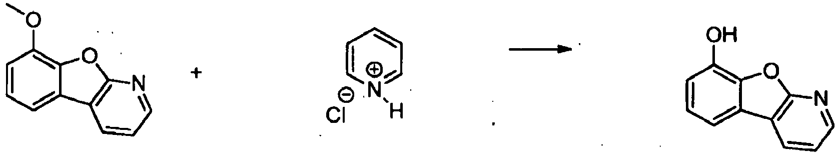

8-Methoxybenzofuro[2,3-b]pyridine (6.6 g, 33.1 mmol) was added along with pyridine HCl (25 g) to a 250 mL round bottom flask. This mixture was stirred in an oil bath at 200 °C for 10 hous. Aqueous sodium bicarbonate and DCM were added to the mixture. The organic layer was dried and evaporated to a brown solid to obtain 5.07 g (83%) of the desired product.

### Preparation of benzofuro[2,3-b]pyridin-8-yl trifluoromethanesulfonate:

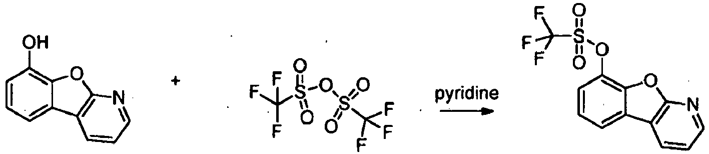

Benzofuro[2,3-b]pyridin-8-ol (5.5 g, 29.7 mmol) was added to a 500 mL round bottom flask and DCM (250 mL) was added. Pyridine (6.01 mL, 74.3 mmol) was added and the flask was placed in an ice bath. Triflic anhydride (7.5 mL, 44.6 mmol) was dissolved in DCM (30 mL) and added drop-wise over 10 min. The bath was removed and the reaction was allowed to warm to ambient temperature and stirred overnight. The solution was washed with saturated sodium bicarbonate solution then water. The product was chromatographed on a silica gel column, which was eluted with DCM to obtain 8.1 g (86%) of the desired product as a white solid was obtained.

### Preparation of 8-(pyridin-2-yl)benzofuro[2,3-b]pyridine:

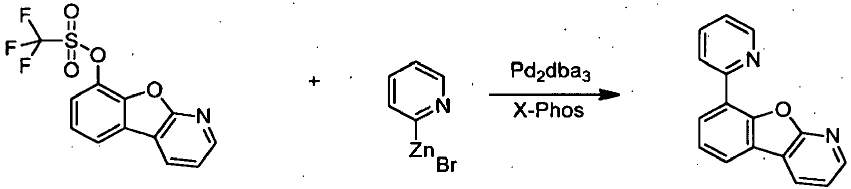

Benzofuro[2,3-b]pyridin-8-yl trifluoromethanesulfonate (4 g, 12.61 mmol), X-Phos (0.481 g, 1.009 mmol) and Pd₂dba₃ (0.231 g, 0.252 mmol) were added to a 250 mL 3-necked flask. The atmosphere in the flask was evacuated and backfilled with nitrogen. THF (40 mL) and pyridin-2-yl zinc(II). bromide (37.8 mL, 18.91 mmol) were added. This mixture was stirred in an oil bath at 70 °C for 4 hours. The mixture was filtered through Celite®, and the filter cake was washed with ethyl acetate. The crude material was adsorbed on to Celite® and chromatographed on a silica gel column eluted with 25-50% ethyl acetate in hexane to obtain 2.7 g (87%) of the desired product as a white solid.

### Preparation of Compound 4:

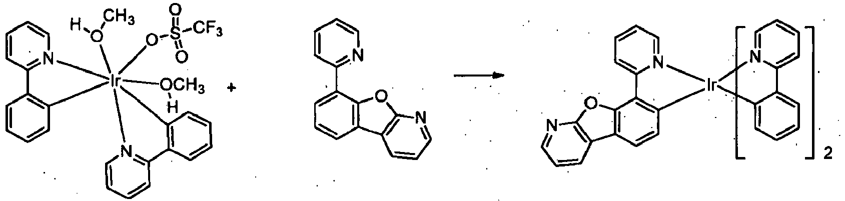

8-(Pyridin-2-yl)benzofuro[2,3-b]pyridine (3.8 g, 15.4 mmol) and iridium complex (3.67 g, 5.10 mmol) were combined in a 500 mL round bottom flask. 2-Ethoxyethanol (125 mL) and dimethylformamide (125 mL) were each added and the mixture was stirred in an oil bath at 135 °C for 18 hours. The mixture was concentrated first on a rotary evaporator then on a Kugelrohr apparatus. The residue was purified on a silica gel column eluted with 0-3% ethyl acetate in dichloromethane to afford 2.48 g (65%) of the desired product as yellow solid.

### Synthesis of Compound 105

### Preparation of 2-(5-chloro-2-methoxyphenyl)pyridin-3-amine:

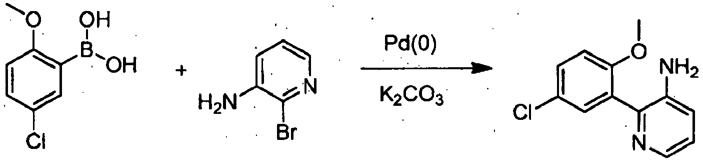

(5-Chloro-2-methoxyphenyl)boronic acid (12 g, 64.4 mmol), 2-bromopyridin-3-amine (11.14 g, 64.4 mmol) potassium carbonate (17.79 g, 129 mmol) and Pd(Ph₃P)₄ (3.72 g, 3.22 mmol) were added to a 1 L 3- necked flask. The reaction mixture was diluted with DME (300 mL) and water (150 mL). This mixture was stirred at reflux for 3 hours. The mixture was filtered through Celite® and the filter cake was washed with ethyl acetate. Water was added and the layers were separated. The organic layer was chromatographed on a silica gel column which was eluted with 0-10% ethyl acetate in DCM to give 10.9 g (72%) of the desired compound.

### Preparation of 8-chlorobenzofuro[3,2-b]pyridine:

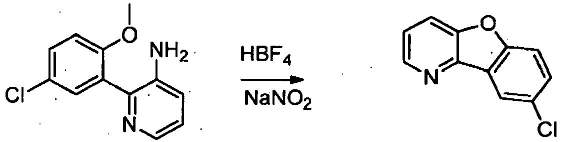

In a 1L round-bottomed flask was placed 2-(5-chloro-2-methoxyphenyl)pyridin-3-amine (10.9 g, 46.4 mmol) and THF (85 mL). Tetrafluoroboric acid (85 mL, 678 mmol) was added along with water (50 mL). The flask was placed in an ethylene glycol-dry ice bath. Sodium nitrite (6.73 g, 98 mmol) was dissolved water (30 mL) and added drop-wise to the flask. The solution turned from yellow to orange with evolution of gas. This reaction mixture was stirred in the bath for 4 hours, and allowed to warm to ambient temperature. Aqueous saturated sodium bicarbonate (500 mL) was added. The product was extracted with DCM and chromatographed on a 200 gram silica gel column eluted with 20-40% ethyl acetate in hexane to obtain 3.26 g (34.5%) of the desired product as a white solid.

### Preparation of 8-(pyridin-2-yl)benzofuro[3,2-b]pyridine:

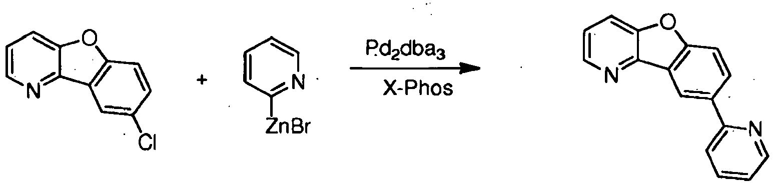

8-Chlorobenzofuro[3,2-b]pyridine (3.2 g, 15.72 mmol) and Pd₂dba₃ (0.288 g, 0.314 mmol) and X-Phos (0.599 g, 1.257 mmol) were added to a 250 mL 3-necked flask. The atmosphere in the flask was evacuated and backfilled with nitrogen. THF (40 mL) was added. Next, pyridin-2-yl zinc(II) bromide (47.1 mL, 23.57 mmol) was added. This mixture was stirred in an oil bath at 70 °C for 4 hours. The mixture was then diluted with aqueous sodium bicarbonate and ethyl acetate. This mixture was filtered through Celite®, and the organic and aqueous layers were separated. The aqueous layer was extracted once more with ethyl acetate. The combined organic layers were chromatographed on a 150 gram silica gel column eluted first with 20% ethyl acetate in hexane then 10% ethyl acetate in DCM and finally 2.5% methanol in DCM. The eluent triturated in hexane and filtered giving 3.2 g (83%) of the desired product as a beige powder.

### Preparation of Compound 105

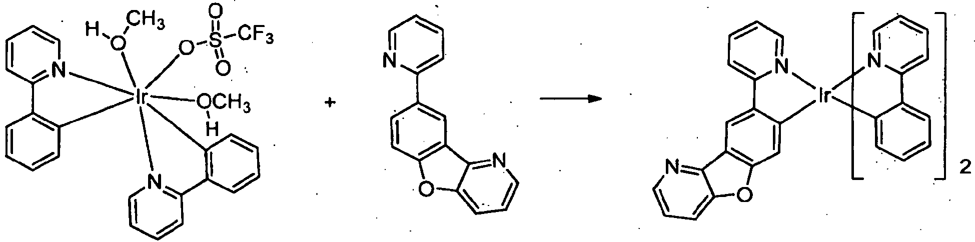

Iridium complex (2.99 g, 4.20 mmol) and 8-(pyridin-2-yl)benzofuro[3,2-b]pyridine (3.1 g, 12.59 mmol) were each added to a 250 mL round bottom flask. 2-Ethoxyethanol (50 mL) and dimethylformamide (50 mL) were added and this was stirred in an oil bath at 150 °C for 18 hours. The flask was placed on a Kugelrohr apparatus and the solvents were removed. The crude material was chromatographed on a silica gel column eluted with 0-10% ethyl acetate in DCM to obtain 2.07 g (66%) of the desired compound.

### Synthesis of Compound II-1

### Preparation of 3-(2,3-dimethoxyphenyl)-6-methylpyridin-2-amine:

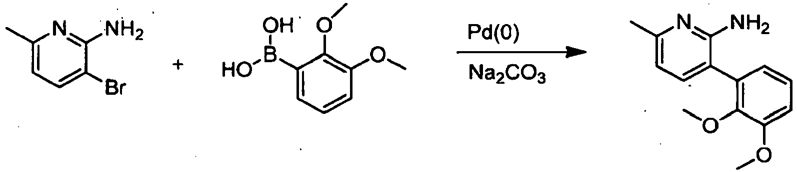

A solution of 3-bromo-6-methylpyridin-2-amine (12.33 g, 65.9 mmol) and (2,3-dimethoxyphenyl)boronic acid (12.0 g, 65.9 mmol), Pd(PPh₃)₄, (2.286 g, 1.978 mmol) and sodium carbonate (6.99 g, 65.9 mmol) in DME (250 ml) and water (125 ml) was stirred at reflux for 5 h. The crude mix was filtered through celite and the solid was washed with ethyl acetate. The filtrate was washed with brine and the solvent was evaporated. The crude product was purified by column chromatography on silica gel with 0-5% methanol in DCM as eluent to obtain 14.5 grams (90%) of the desired product as a cream colored solid.

### Preparation of 8-methoxy-2-methylbenzofuro[2,3-b]pyridine:

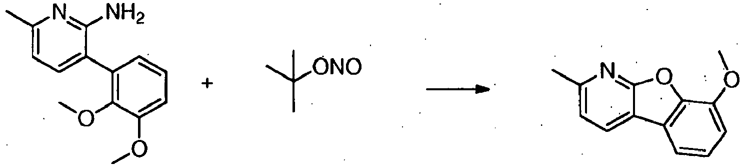

Into a solution of 3-(2,3-dimethoxyphenyl)-6-methylpyridin-2-amine (14.5 g; 59.4 mmol) in acetic acid (200 ml) and THF (67 ml) was added dropwise tert-butylnitrite (14.1 ml, 106.9 mmol) at 0 °C. After stirring at this temperature for 2 h, the reaction mixture was allowed to warm to room temperature. Upon evaporation off the solvent, the residue was partitioned between ethyl acetate and water. The organic phas was isolated, washed with aqueous sodium bicarbonate and brine, dried over sodium sulfate. Unpon evaporation off the solvent, the residue was purified by column chromatography on silica gel with 25% ethyl acetate in hexane to obtain 7.65 g (60.4%) of desired product as a pale yellow solid.

### Preparation of 2-methylbenzofuro[2,3-b]pyridin-8-ol:

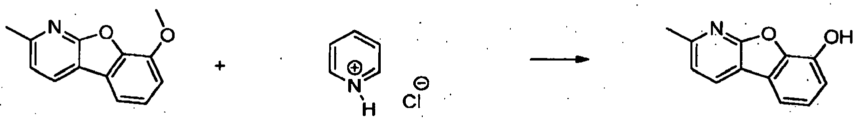

A mixture of 8-methoxy-2-methylbenzofuro[2,3-b]pyridine (7.6 g, 35.6 mmol) and pyridine hydrochloride (25 g, 216 mmol) was heated at 200 °C for 15 h. After cooling to room temperature, the solid was sonicated with aquous sodium bicarbonate solution. The solid was isolated by filtration to yield 6.72 g (95%) of desired product as a brown powder.

### Preparation of 2-methylbenzofuro[2,3-b]pyridin-8-yl trifluoromethanesulfonate:

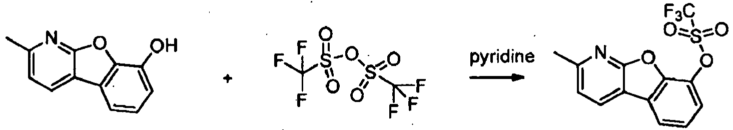

Into a suspension of 2-methylbenzofuro[2,3-b]pyridin-8-ol (6.7 g, 33.6 mmol) in dichloromethane (300 ml) was added dropwise a solution of trifluoromethanesulfonic anhydride (8.47 ml, 50.5 mmol) in dichloromethane (30 ml) at 0 °C. After stirring overnight, the reaction was quenched with saturated sodium bicarbonate. The organic phase was isolated, washed with brine and dried over sodium sulfate. Upon evaporation off the solvent, the crude product was purified by column chromatography on silica gel with dichloromethane as eluent to obtain 8.95 g (80%) of desired product as a pale yellow solid.

### Preparation of 2-methyl-8-(pyridin-2-yl)benzofuro[2,3-b]pyridine:

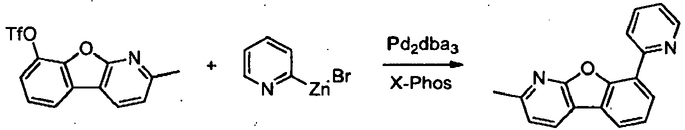

Into a solution of 2-methylbenzofuro[2,3-b]pyridin-8-yl trifluoromethanesulfonate (4 g, 12.07 mmol), Pd₂dba₃ (0.221 g, 0.241 mmol) and 2-dicyclohexylphosphino-2',4',6'-triisopropylbiphenyl (0.230 g, 0.483 mmol) in THF (80 ml) was added a solution of pyridin-2-ylzinc(II) bromide (36.2 ml, 0.5 *M,* 18.11 mmol) in THF at 60 °C. It was stirred at 65 °C for 12 h and quenched with saturated ammonium chloride solution. The organic phase was isolated, diluated with ethyl acetate, washed with brine, and dried over magnesium sulfate. Upon evaporation off the solvent, the residue was purified by column chromatography on silica gel with 5-20% ethyl acetate in dichlomethane as eluent to yield 2.05 g (65%) of desired product as a white solid.

### Preparation of Compound II-1

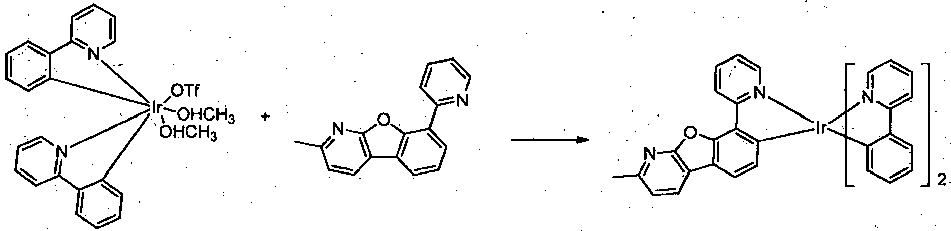

Iridium complex (1.828 g, 2.56 mmol) and 2-methyl-8-(pyridin-2-yl)benzofuro[2,3-b]pyridine (2 g, 7.68 mmol) were added to 85 mL ethanol and the reaction mixture was heated to reflux for 20 h. The reaction mixture was cooled, filtered through a Celite^{®} pad and the filtrate was discarded. Collected precipitate was washed with ethanol, dried and purified by column chromatography on silica gel with dichloromethane as eluent to yield 0.9 g (46%) of **Compound II-1** as a yellow solid.

### Synthesis of Compound II-49

### Preparation of 2-d₃-methyl-8-(pyridin-2-yl)benzofuro[2,3-b]pyridine:

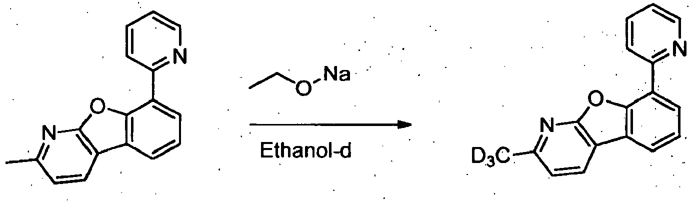

A solution of 2-methyl-8-(pyridin-2-yl)benzofuro[2,3-b]pyridine (6.3 g, 24.20 mmol) and sodium ethoxide (3.29 grams, 48.4 mmol) in ethanol-D (100 ml) was refluxed for 72 h. The solvent was evaporated and the residue was partitioned between ethyl acetate and water. The organic phase was isolated, dried over sodium sulfate and evaporated. Upon evaporation of the solvent, the residue was purified by column chromatography on silica gel with 0-15% ethyl acetate in dichloromethane to yield 5.1 g (80%) of desired compound as a white solid.

### Preparation of Compound II-49:

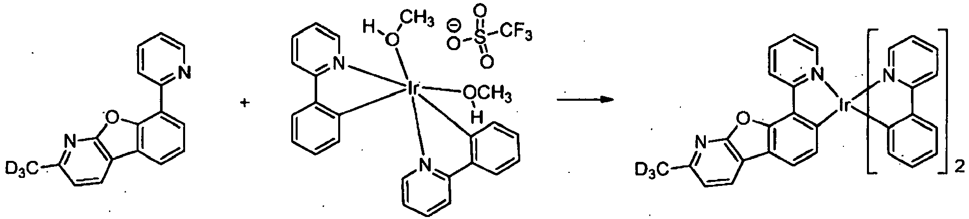

A solutionof 2-d₃-methyl-8-(pyridin-2-yl)benzofuro[2,3-b]pyridine (3.8 grams, 14.4 mmol) and iridium complex (3.43 grams, 4.81 mmol) in DMF (100 ml) and 2-ethoxyethanol (100 ml) were heated at 130 °C for 18 h. Upon evaporation off the solvent, the crude product was purified by column chromatography on silica gel with 65-100% dichloromethane in hexane to yield 2.77 g (75 %) of Compound II-49 as a yellow solid.

### Preparation of Compound II-355:

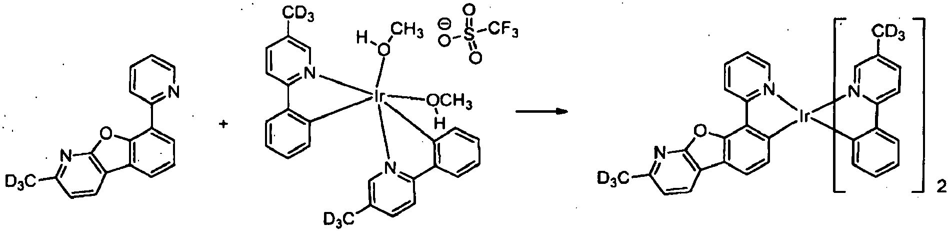

A solutionof 2-d₃-methyl-8-(pyridin-2-yl)benzofuro[2,3-b]pyridine (4.45 g, 16.90 mmol) and iridium complex (4.21 g, 5.63 mmol) in DMF (100 ml) and 2-ethoxyethanol (100 ml) was heated at 130 °C under nitrogen for 18 h. Upon evaporation off the solvent, the crude product was purified by column chromatography on silica gel with 70-100% dichloromethane in hexane to yield 3.30 g (74 %) of **Compound II**-**355** as a yellow solid.

### Synthesis of Compound II-7

### Preparation of 2-methyl-8-(4-methylpyridin-2-yl)benzofuro[2,3-b]pyridine:

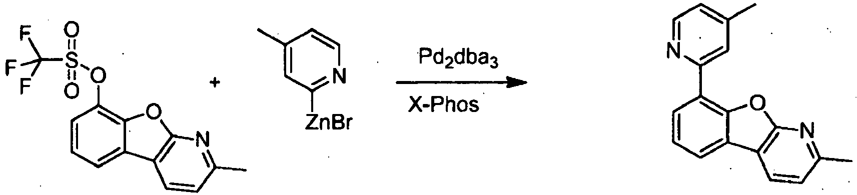

Into a solution of 2-methylbenzofuro[2,3-b]pyridin-8-yl trifluoromethanesulfonate (4.45 g, 13.43 mmol), dicyclohexyl(2',4',6'-triisopropyl-[1,1'-biphenyl]-2-yl)phosphine (0.512 g, 1.075 mmol) and Pd₂dba₃ (0.246 g, 0.269 mmol) in THF 50 ml was added a solution of 4-methyl-2-pyridylzinc bromide solution (50 ml, 0.5 *M,* 25 mmol). The reaction mixture was heated at 60-65 °C under nitrogen for 12 h and quenched with saturated sodium bicarbonate solution. The suspension was filtered through a short plug of Celite^{®}. The filtrate was washed with brine and dried over magnesium sulfate. Unpon evaporation off the solvent, the residue was purified by column chromatography on silica gel with 25-50% ethyl acetate in dichlomethane as eluent to yield 3.02 g (82%) of desired product as a white solid.

### Preparation of Compound II-7:

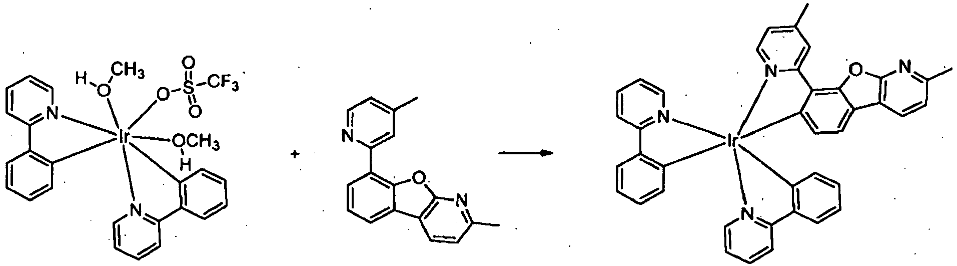

A solution of iridium complex (2.60 g, 3.65 mmol) and 2-methyl-8-(4-methylpyridin-2-yl)benzofuro[2,3-b]pyridine (3.0 g, 10.94 mmol) in ethanol (120 ml) was refuxed for 24 h. After cooling to room temperature, the solic was collected by filtration and purified by column chromatography on silica gel with 65-100% DCM in hexane to yield 1.5 g (53%) of **Compound 7** as a yellow solid.

### Synthesis of Compound III-32

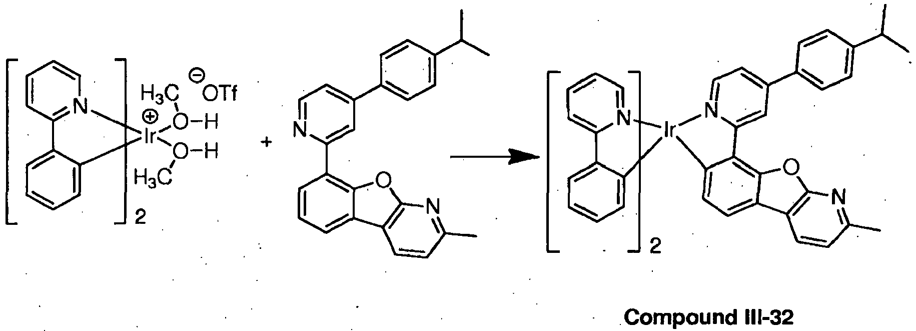

A mixture of phenylpyridine iridium complex (2.1 g, 2.94 mmol), 8-(4-(4-isopropylphenyl)pyridin-2-yl)-2-methylbenzofuro[2,3-b]pyridine (2.23 g, 5.88 mmol), 2-ethoxyethanol (60 mL) and DMF (60 mL) was heated at 130 °C overnight. The solvent mixture was evaporated under vacuum. The residue was run through a short silica plug with dichloromethane (DCM). The reaction mixture was further purified by silica gel column with DCM/heptane as elute to obtain 1.3 g desired product (50.3% yield) which was confirmed by LC-MS.

### Synthesis of Compound III-44

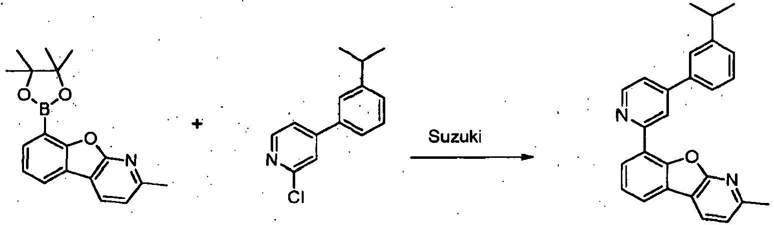

**Synthesis of 8-(4-(3-isopropylphenyl)pyridine-2-yl)-2-methylbenzofuro[2,3-b]pyridine.** A mixture of 2-methyl-8-(4,4,5,5-tetramethyl-1,3,2-dioxaborolan-2-yl)benzofuro[2,3-b]pyridine (3.15g, 10.2 mmol), 2-chloro-4-(3-isopropylphenyl)pyridine (2.60 g, 11.2 mmol), Pd₂(dba)₃ (0.187 g 0.204 mmol), dicyclohexyl(2',6'-dimethoxy-[1,1'-biphenyl]-2-yl)phosphine (0.335 g, 0.815 mmol), potassium phosphate (7.57 g, 35.7 mmol), toluene (90 mL) and water (9 mL) was degassed with nitrogen and then refluxed overnight. The toluene layer was dried on Na₂SO₄ and then further purified by column chromatography using dichloromethane in hexanes and then vacuum distilled to give 8-(4-(3-Isopropylphenyl)pyridine-2-yl)-2-methylbenzofuro[2,3-b]pyridine (2.2 g, 57 % yield).

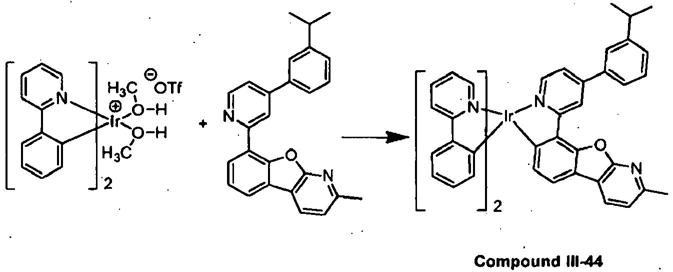

A mixture of iridium complex (2.0 g, 2.80 mmol), 8-(4-(3-isopropylphenyl)pyridine-2-yl)-2methylbenzofuro[2,3-b]pyridine (2.2 g, 5.81 mmol), 2-ethoxyethanol (60 mL) and DMF (60 mL) was heated at 130 °C overnight. The reaction mixture was concentrated to remove solvents and filtered through a small plug of silica gel and further chromatographed to give 1.08 g desired product (44% yield).

### Synthesis of Compound III-74

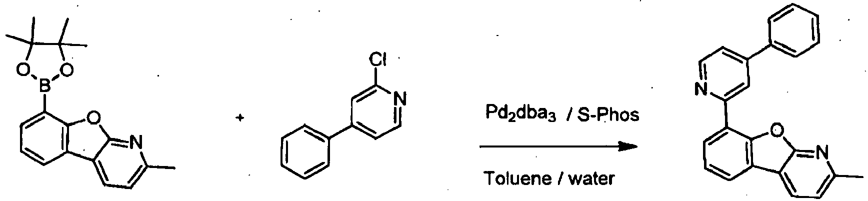

**Synthesis of 2-methyl-8-(4-phenylpyridin-2-yl)benzofuro[2,3-b]pyridine:** 2-methyl-8-(4,4,5,5-tetramethyl-1,3,2-dioxaborolan-2-yl)benzofuro[2,3-b]pyridine (5.96 g, 19.28 mmol), 2-chloro-4-phenylpyridine (4.39 g, 23.13 mmol), tris(dibenzylideneacetone)palladium(0) (0.353 g, 0.386 mmol) and 2-Dicyclohexylphosphino-2',6'-dimethoxybiphenyl (.8 g, 1.951 mmol) were charged into a 500 mL 2-neck flask. Potassium phosphate tribasic (12.26 g, 57.8 mmol) was then dissolved in 45 mL of water. This solution was charged into the reaction mixture. The reaction mixture was degassed with nitrogen then was heated to reflux overnight. The reaction mixture was cooled to room temperature. The toluene layer was separated and was dried over magnesium sulfate. These organics were filtered and concentrated under vacuum. The crude product was passed through a silica gel column using 70-99% toluene/ heptanes followed by 5-15% ethyl acetate/ toluene. Some of the impure product fractions were columned on silica gel using 5-15% ethyl acetate/ DCM. All the clean product fractions were combined yielding 2-methyl-8-(4-phenylpyridin-2-yl)benzofuro[2,3-b]pyridine (5.3 g, 15.76 mmol, 82 % yield).

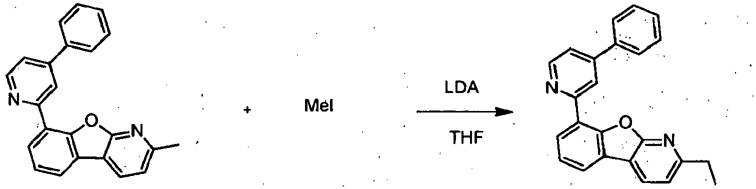

**Synthesis of 2-ethyl-8-(4-phenylpyridin-2-yl)benzofuro[2,3-b]pyridine:** 2-methyl-8-(4-phenylpyridin-2-yl)benzofuro[2,3-b]pyridine (5.3 g, 15.76 mmol) was dissolved in 130 mL of THF. This solution was cooled in a dry ice bath to -78 °C. Lithium diisopropylamide in THF (9.85 mL, 19.69 mmol) was added dropwise to the reaction mixture over a 10 minute period maintaining the temperature below -73 °C. The reaction mixture was stirred at -78 °C for 2 hours. Iodomethane (3.35 g, 23.63 mmol) was dissolved in 20 mL of THF then was added dropwise via syringe to the cold reaction mixture. Stirring was continued as the reaction mixture gradually warmed to room temperature overnight. The reaction mixture was quenched with aqueous ammonium chloride then was extracted 2 X 300 mL ethyl acetate. The organics were combined, were washed with aqueous LiCl then were dried over magnesium sulfate. These organics were then filtered and concentrated under vacuum. The crude residue was dissolved in DCM and was loaded onto a silica gel column. The column was eluted with 5-8% ethyl acetate/ DCM. The main set of product fractions were combined and concentrated under vacuum yielding 2-ethyl-8-(4-phenylpyridin-2-yl)benzofuro[2,3-b]pyridine (5.15 g, 14.70 mmol, 93 % yield)

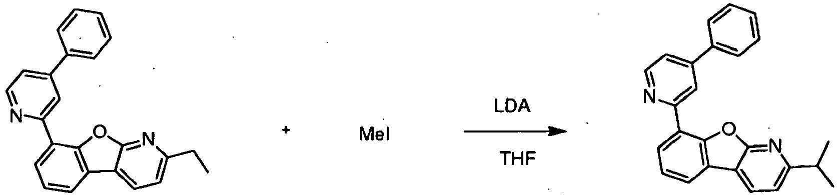

**Synthesis of 2-isopropyl-8-(4-phenylpyridin-2-yl)benzofuro[2,3-b]pyridine:** 2-ethyl-8-(4-phenylpyridin-2-yl)benzofuro[2,3-b]pyridine (5.15 g, 14.70 mmol) was charged into the reaction mixture with 120 mL of THF. This mixture was cooled to -78 °C. Lithium diisopropylamide in THF (9.19 mL, 18.37 mmol) was added dropwise to the cooled reaction mixture over a 10 minute period. The reaction mixture was then stirred for 2 hours at -78 °C. Iodomethane (3.13 g, 22.05 mmol) was then dissolved in 10 mL of THF. This solution was then added via syringe to the cold reaction mixture. Stirring was continued as the reaction mixture was allowed to gradually warm to room temperature overnight. The reaction mixture was quenched with aqueous ammonium chloride then was extracted 2 X 300 mL ethyl acetate. The organics were combined, were washed with aqueous LiCl then were dried over magnesium sulfate. These organics were then filtered and concentrated under vacuum. The crude residue was dissolved in DCM and was loaded onto a silica gel column. The column was eluted with 3-4% ethyl acetate/ DCM. Clean product fractions were combined and solvents were evaporated yielding 2-isopropyl-8-(4-phenylpyridin-2-yl)benzofuro[2,3-b]pyridine (4.1 g, 11.25 mmol, 77 % yield).

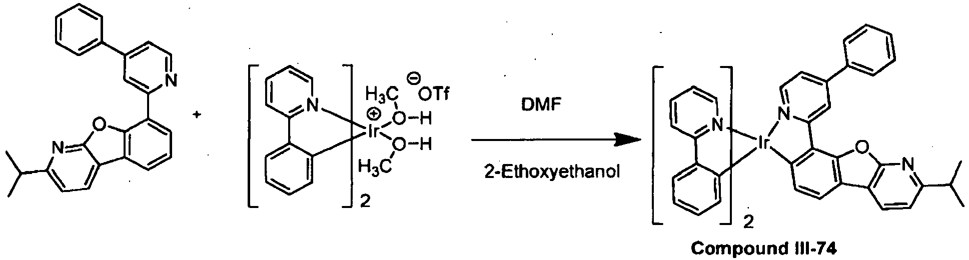

2-isopropyl-8-(4-phenylpyridin-2-yl)benzofuro[2,3-b]pyridine (2.2 g, 6.04 mmol) and iridium complex (2.1 g, 2.94 mmol) were combined with 60 mL of DMF and 60 mL of 2-ethoxyethanol. This heterogeneous mixture was placed under a nitrogen atmosphere then was heated to reflux overnight. The reaction mixture was cooled to room temperature. The solvents were removed under vacuum. The crude residue was dissolved in 300 mL of DCM. This mixture was passed through a short silica gel plug. The plug was rinsed with 500 mL of DCM. The DCM filtrate was evaporated under vacuum then was loaded onto a silica gel column. The column was 1st eluted with 60% DCM/ heptanes then 50% DCM/ heptanes. The eluant was gradually increased to 57% DCM/ heptanes. Clean product fractions yielded the desired product (1.4 g, 1.972 mmol, 67.0 % yield).

### Synthesis of Compound III-1604

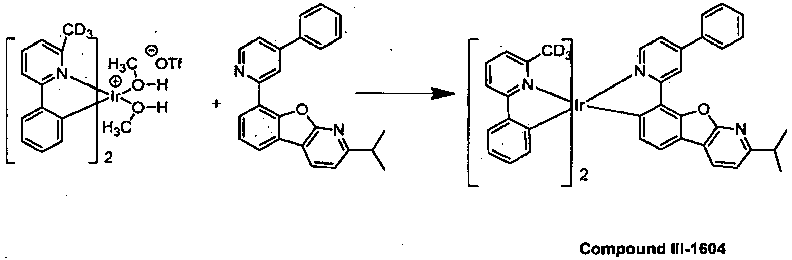

A mixture of iridium complex (1.3 g, 1.67 mmol), 2-isopropyl-8-(4-phenylpyridin-2-yl)benzofuro[2,3-b]pyridine (1.22 g, 3.35 mmol), 2-ethoxyethanol (35 mL) and DMF (35 mL) was heated at 130 °C overnight. The solvent mixture was evaporated under vacuum. The residue was run through a short silica plug. The mixture was further purified by silica gel column with DCM/heptane as elute to obtain 1.25 g desired product (83% yield).

### Synthesis of Compound III-35

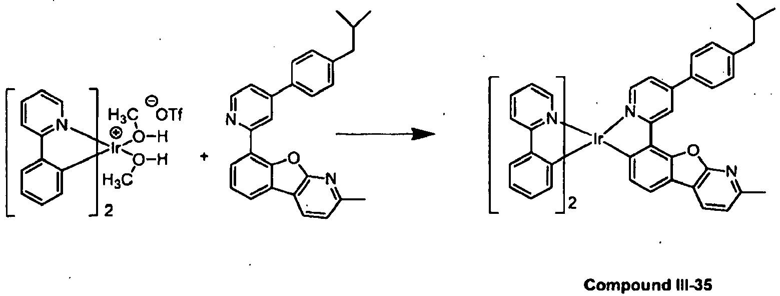

A mixture of iridium complex (2.3 g, 3.22 mmol), 8-(4-(4-isobutylphenyl)pyridin-2-yl)-2-methylbenzofuro[2,3-b]pyridine (2.53 g, 6.44 mmol), 2-ethoxyethanol (60 mL) and DMF (60 mL) was heated at 130 °C overnight. The solvent mixture was evaporated under vacuum. The residue was run through a short silica plug. The reaction mixture was further purified by silica gel column with DCM/heptane as elute to obtain 1.8 g desired product (62.6% yield).

### Synthesis of Compound III-50

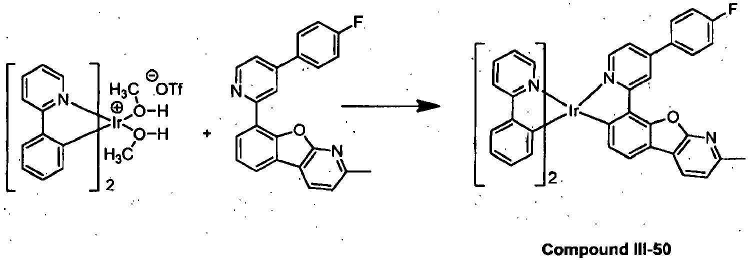

A mixture of iridium complex (2.3 g, 3.22 mmol), 8-(4-(4-fluorolphenyl)pyridin-2-yl)-2-methylbenzofuro[2,3-b]pyridine (2.28 g, 6.44 mmol), 2-ethoxyethanol (60 mL) and DMF (60 mL) was heated at 130 °C overnight. The solvent mixture was evaporated under vacuum. The residue was run through a short silica plug. The reaction mixture was further purified by silica gel column with DCM/heptane as elute to obtain 1.6 g desired product (56.1% yield) which was confirmed by LC-MS.

### Synthesis of Compound III-38

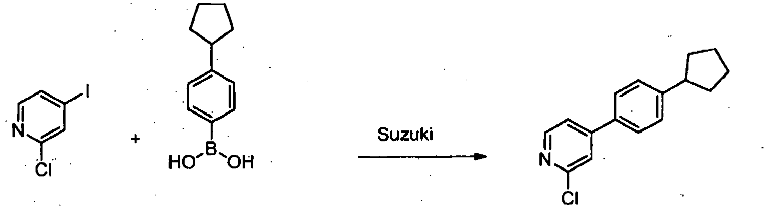

**Synthesis of 2-Chloro-4-(4**-**cyclopentylphenyl**)**pyridine.** A mixture of 2-chloro-4-iodopyridine (6.43 g, 26.3 mmol), (4-cyclopentylphenyl)boronic acid (5.0 g, 26.3 mmol), Pd(Ph₃P)₄ (0.0.91 g 0.79 mmol), sodium carbonate (8.37 g, 79 mmol), DME (257 mL) and water (64 mL) was degassed with nitrogen and then refluxed overnight. The reaction mixture was concentrated and extracted with ethyl acetate.The the ethyl acetat layer was dried on Na₂SO₄ and then further purified by column chromatography using dichloromethane in hexanes and then vacuum distilled to give 2-Chloro-4-(4-cyclopentylphenyl)pyridine (4.6 g, 68 % yield).

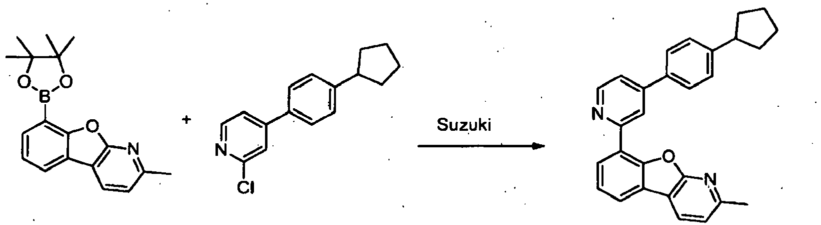

**Synthesis of 8-(4-(4-cyclopentylphenyl)pyridine-2-yl)-2-methylbenzofuro[2,3-b]pyridine.** A mixture of 2-methyl-8-(4,4,5,5-tetramethyl-1,3,2-dioxaborolan-2-yl)benzofuro[2,3-b]pyridine (2.5 g, 8.09 mmol), 2-chloro-4-(4-cyclopentylphenyl)pyridine (2.29 g, 8.89 mmol), Pd₂(dba)₃ (0.148 g 0.162 mmol), dicyclohexyl(2',6'-dimethoxy-[1,1'-biphenyl]-2-yl)phosphine (0.266 g, 0.647 mmol), potassium phosphate (6.01 g, 28.3 mmol), DME (70 mL) and water (7 mL) was degassed with nitrogen and then refluxed overnight. The mixture was concentrated and extracted with ethyl acetate. The ethyl acetate layer was dried on Na₂SO₄ and then further purified by column chromatography using ethyl acetate in hexanes to give 8-(4-(4-cyclopentylphenyl)pyridine-2-yl)-2-methylbenzofuro[2,3-b]pyridine (2.4 g, 73 % yield).

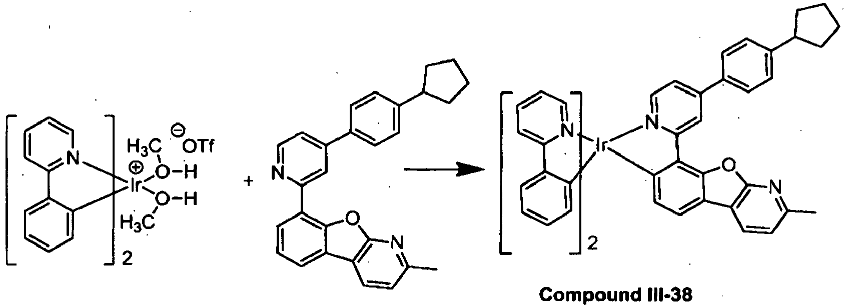

A mixture of iridium complex (1.2 g, 1.68 mmol), 8-(4-(4-cyclopentylphenyl)pyridine-2-yl)-2methylbenzofuro[2,3-b]pyridine (1.36 g, 3.36 mmol), ethoxyethanol (40 mL) and DMF (40 mL) was heated at 130 °C overnight. The reaction mixture was concentrated to remove solvents and filtered through a small plug of silica gel and further chromatographed to give 0.60 g product. After sublimation, it yielded the product (0.4 g, 27% yield).

### Synthesis of Compound III-1738

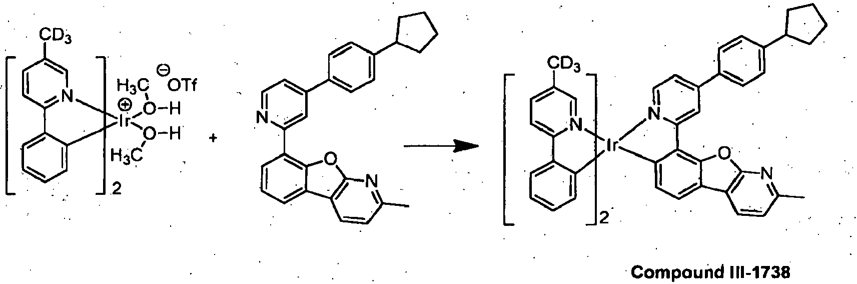

A mixture of iridium complex (1.257 g, 1.68 mmol), 8-(4-(4-cyclopentylphenyl)pyridine-2-yl)-2methylbenzofuro[2,3-b]pyridine (1.36 g, 3.36 mmol), ethoxyethanol (40 mL) and DMF (40 mL) was heated at 130 °C overnight. The reaction was concentrated to remove solvents and filtered through a small plug of silica gel and further chromatographed. After sublimation, it gave the product (0.45 g, 29% yield).

### Synthesis of Compound III-5979

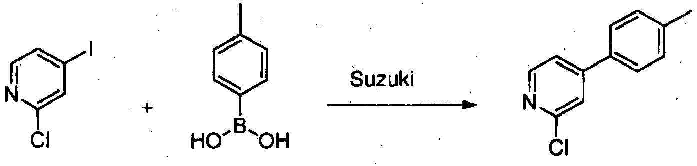

**Synthesis of 2-Chloro-4-(p-tolyl)pyridine.** A mixture of 2-chloro-4-iodopyridine (10.0 g, 41.8 mmol), p-tolylphenylboronic acid (5.68 g, 41.8 mmol), Pd(Ph₃P)₄ (1.45 g 1.25 mmol), sodium carbonate (13.3 g, 125 mmol), DME (300 mL) and water (75 mL) was degassed with nitrogen and then refluxed overnight. The mixture was concentrated and the extracted with ethyl acetate. The the ethyl acetate layer was dried on Na₂SO₄, vacuum distilled and recrystalized to give 2-chloro-4-(p-tolyl)pyridine (3.75 g, 18.4 mmol, 44 % yield).

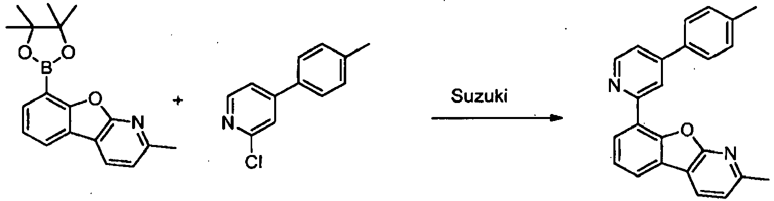

**Synthesis of 2-methyl-8-(4-(p-tolyl)(pyridin-2-yl)benzofuro[2,3-b]pyridine.** A mixture of 2-methyl-8-(4,4,5,5-tetramethyl-1,3,2-dioxaborolan-2-yl)benzofuro[2,3-b]pyridine (2.5 g, 8.03 mmol), 2-chloro-4-(p-tolyl)pyridine (1.80 g, 8.83 mmol), Pd₂(dba)₃ (0.147 g 0.161 mmol), dicyclohexyl(2',6'-dimethoxy-[1,1'-biphenyl]-2-yl)phosphine (0.264 g, 0.642 mmol), potassium phosphate (5.96 g, 28.1 mmol), toluene (100 mL) and water (10 mL) was degassed with nitrogen and then refluxed overnight. The mixture was concentrated and extracted with ethyl acetate. The ethyl acetate layer was dried on Na₂SO₄ and then further purified by column chromatography using ethyl acetate in hexanes and washed with methanol to give 2-methyl-8-(4-(p-tolyl)pyridin-2-yl)benzofuro[2,3-b]pyridine (2.0 g, 5.71 mmol, 71 % yield).

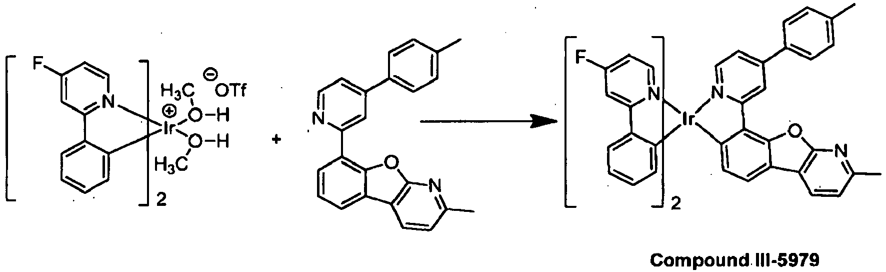

To a 250 mL flask, the two starting materials, solvents 2-ethoxyethanol 50 mL and DMF 50 mL were charged. The reaction mixture was heated up to 130 °C under N₂ for 27 hours. The reaction was cooled down and solvents were evoparted and run silica gel column with DCM/heptane to obtain about 0.68 g desired product which is confirmed by LC-MS and sublimed to get 0.38 g.

### Synthesis of Compound III-53

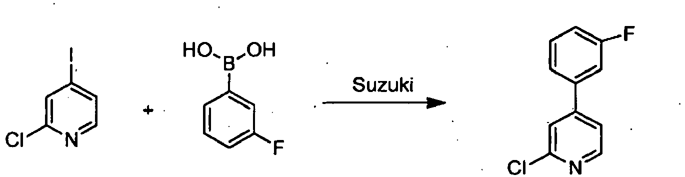

To a 1 liter,3-necked flask added sodium carbonate (18.18 g, 172 mmol), 2-chloro-4-iodopyridine (13.69 g, 57.2 mmol), (3-fluorophenyl)boronic acid (8 g, 57.2 mmol), DME (400 mL), water (100 mL). The reaction was degassed with N₂ for 30 minutes and added with palladiumtetrakistriphenylphosphine (1.982 g, 1.715 mmol) and again degassed with N₂. The reaction was heated at reflux under N₂ overnigh and worked up with silica gel chromatographed using 50-65% DCM/heptane and got about 11.09 g product (93% yield).

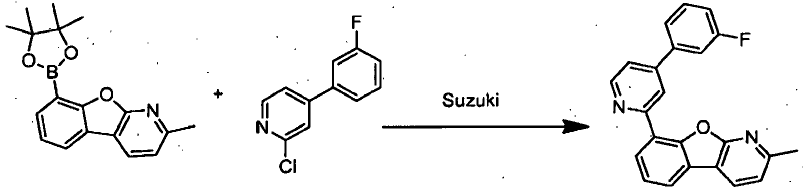

To a 250 mL flask added 2-methyl-8-(4,4,5,5-tetramethyl-1,3,2-dioxaborolan-2-yl)benzofuro[2,3-b]pyridine (3.0 g, 9.70 mmol), 2-chloro-4-(3-fluorophenyl)pyridine (2.216 g, 10.67 mmol), dicyclohexyl(2',6'-dimethoxy-[1,1'-biphenyl]-2-yl)phosphine (0.319 g, 0.776 mmol), Pd₂ (dba)₃ (0.178 g, 0.194 mmol), potassium phosphate (7.21 g, 34.0 mmol) and followed by water 7 mL) and toluene (70 mL) and degassed with N₂ and heated at reflux under N₂ overnight. Reaction was worked up with silica gel column to obtain a white solid 2.15 g (63% yield) product.

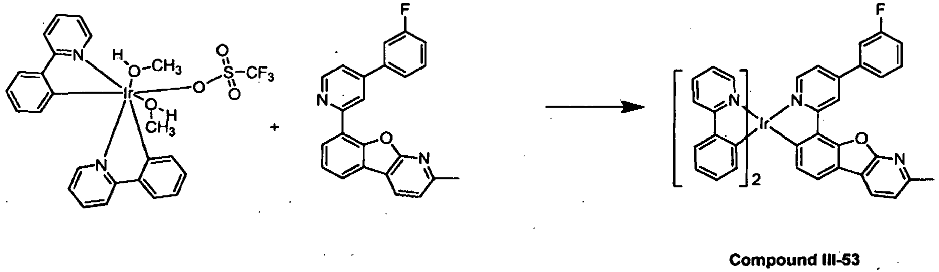

To a 250 mL flask added iridium complex (2.16 g, 3.03 mmol) and 8-(4-(3-fluorophenyl)pyridin-2-yl)-2-methylbenzofuro[2,3-b]pyridine (2.15 g, 6.07 mmol) and followed by 2-ethoxyethanol (50 mL) and DMF (50 mL). The reaction was heated at 130 °C overnight. An aliquot by HPLC showed completion. The reaction was worked up with silica gel column with 50% DCM in heptane as elute then followed by 100% DCM to get 1.45 g (67% yield) orange solid which LC/MS showed desired MS.

### Synthesis of Compound III-25

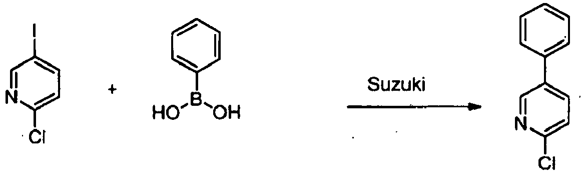

**Synthesis of 2-Chloro-5-phenylpyridine.** A mixture of 2-chloro-5-iodopyridine (5.0 g, 20.9 mmol), phenylboronic acid (2.6 g, 20.9 mmol), Pd(Ph₃P)₄ (1.45 g 1.25 mmol), sodium carbonate (6.64 g, 62.6 mmol), DME (20 mL) and water (5 mL) was degassed with nitrogen and then refluxed overnight. The mixture was concentrated and extracted with ethyl acetate. The ethyl acetate layer was dried on Na₂SO₄ and then vacuum distilled to give 2-chloro-5-phenylpyridine (2.79 g, 14.71 mmol (70.5 % yield).

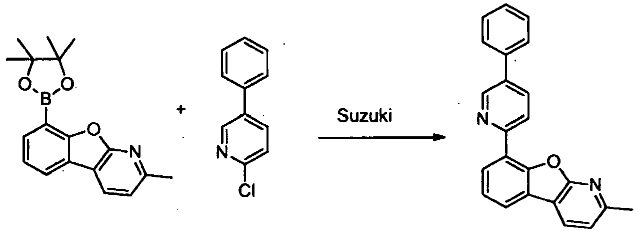

**Synthesis of 2-methyl-8-(5-phenylpyridin-2-yl)benzofuro[2,3-b]pyridine.** A mixture of 2-methyl-8-(4,4,5,5-tetramethyl-1,3,2-dioxaborolan-2-yl)benzofuro[2,3-b]pyridine (3.0 g, 9.70 mmol), 2-chloro-5-phenylpyridine (2.024 g, 10.67 mmol), Pd₂(dba)₃ (0.178 g 0.192 mmol), dicyclohexyl(2',6'-dimethoxy-[1,1'-biphenyl]-2-yl)phosphine (0.319 g, 0.776 mmol), potassium phosphate (7.21 g, 34.0 mmol), toluene (70 mL) and water (7 mL) was degassed with nitrogen and then refluxed overnight. It was concentrated and extracted with ethyl acetate. The ethyl acetate layer was dried on Na₂SO₄ and then further purified by column chromatography using ethyl acetate in hexanes to give 2-methyl-8-(5-phenylpyridin-2-yl)benzofuro[2,3-b]pyridine (1.38 g, 4.10 mmol, 42.3 % yield).

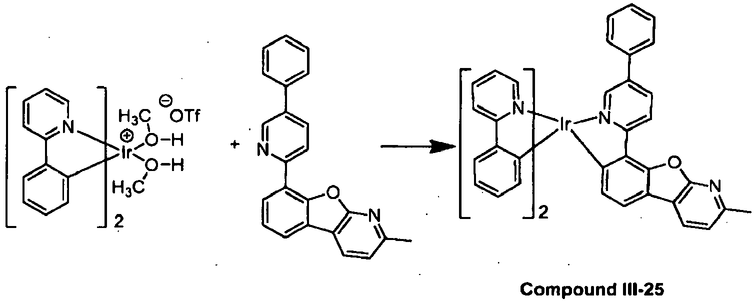

A mixture of iridium complex (1.6 g, 2.28 mmol),1 2-methyl-8-(5-phenylpyridin-2-yl)benzofuro[2,3-b]pyridine (1.38g, 4.10 mmol),),2-ethoxyethanol (40 mL) and DMF (40 mL) was heated at 130 °C overnight. The reaction mixture was concentrated to remove solvents and filtered through a small plug of silica gel and further chromatographed (1:1 heptane:DCM) to give 0.60 g and sublimed to give the desired product (0.41 g, 21.5% yield).

### Synthesis of Compound III-62

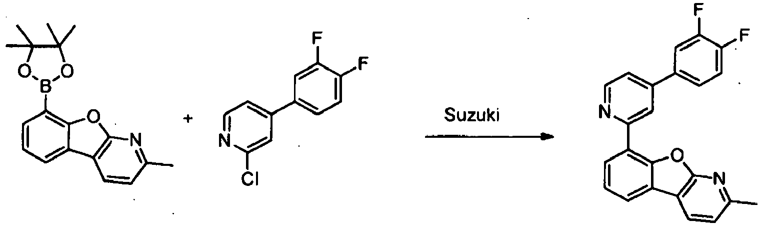

**Synthesis of 8-(4-(3,4-difluorophenyl)pyridin-2-yl)-2-methylbenzofuro[2,3-b]pyridine.** A mixture of 2-methyl-8-(4,4,5,5-tetramethyl-1,3,2-dioxaborolan-2-yl)benzofuro[2,3-b]pyridine (3.0 g, 9.70 mmol), 2-chloro-4-(3,4-difluorophenyl)pyridine (2.41 g, 10.67 mmol)" Pd₂(dba)₃ (0.178 g 0.194 mmol), dicyclohexyl(2',6'-dimethoxy-[1,1'-biphenyl]-2-yl)phosphine (0.319 g, 0.776 mmol), potassium phosphate (7.21 g, 34.0 mmol), toluene (70 mL) and water (7 mL) was degassed with nitrogen and then refluxed overnight. The mixture was concentrated and extracted with ethyl acetate. The ethyl acetate layer was dried on Na₂SO₄ and then further purified by column chromatography using ethyl acetate in dichloromethane to give 8-(4-(3,4-difluorophenyl)pyridin-2-yl)-2-methylbenzofuro[2,3-b]pyridine (2.36 g, 6.34 mmol), 65.3% yield).

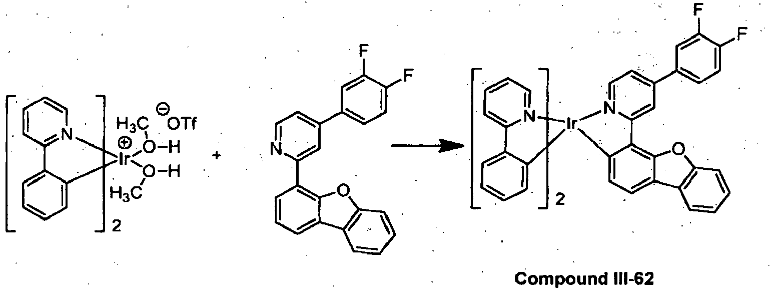

A mixture of iridium complex (2.26 g, 3.17 mmol), 8 8-(4-(3,4-difluorophenyl)pyridin-2-yl)-2-methylbenzofuro[2,3-b]pyridine (2.36g, 6.34 mmol), 2-ethoxyethanol (70 mL) and DMF (70 mL) was heated at 130 °C overnight. It was concentrated to remove solvents and filtered through a small plug of silica gel and further chromatographed (1:1 heptane:DCM) to give 0.9 g and sublimed to give the desired product (0.75 g, 27% yield).

### Synthesis of Compound III-68

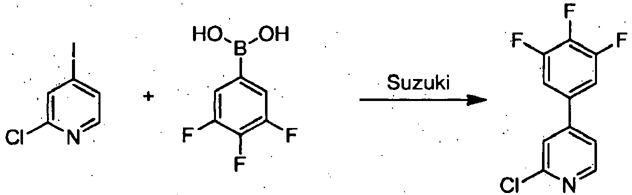

To a 1 liter 3-necked flask added sodium carbonate (10.62 g, 100 mmol), 2-chloro-4-iodopyridine (8.0 g, 33.4 mmol), (3,4,5-trifluorophenyl)boronic acid (5.88 g, 33.4 mmol), DME (300 mL), water (75 mL). The mixture was degassed with N₂ for 30 minutes and added palladiumtetrakistriphenylphosphine (1.158 g, 1.002 mmol) and again degassed with N₂. Then the reaction was heated at reflux under N₂ overnight and cooled down to workup to give 4.5 g (55% yield) light yellow solid after column.

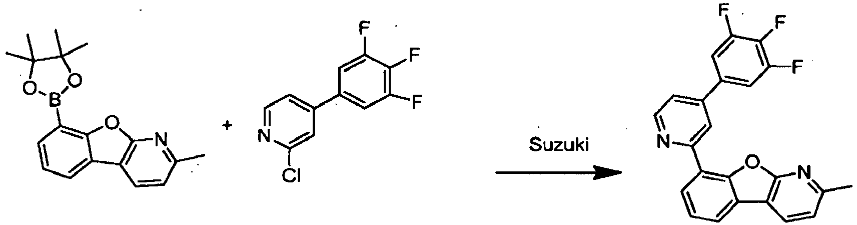

To a 250ml flask added 2-methyl-8-(4,4,5,5-tetramethyl-1,3,2-dioxaborolan-2-yl)benzofuro[2,3-b]pyridine (3.0 g, 9.70 mmol), 2-chloro-4-(3,4,5-trifluorophenyl)pyridine (2.60 g, 10.67 mmol), dicyclohexyl(2',6'-dimethoxy-[1,1'-biphenyl]-2-yl)phosphine (0.319 g, 0.776 mmol), Pd₂ (dba)3 (0.178 g, 0.194 mmol), potassium phosphate (7.21 g, 34.0 mmol) followed by water (7 mL) and toluene (70 mL). The reaction was degassed with N₂ and heated at reflux under N₂ overnight. An aliquot by GC shows completion. The reaction mixture was worked up to give 2.35 g white solid (62% yield) product.

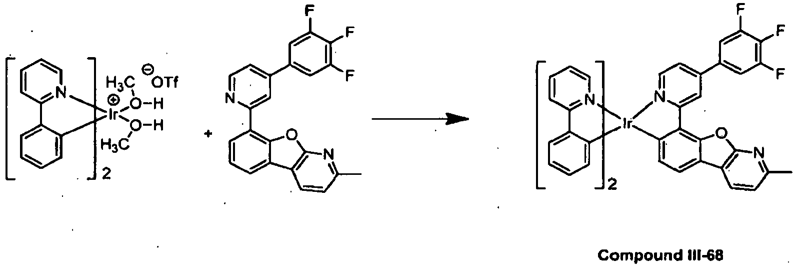

To a 250 mL flask added iridium complex (2.148 g, 3.01 mmol) and 2-methyl-8-(4-(3,4,5-trifluorophenyl)pyridin-2-yl)benzofuro[2,3-b]pyridine (2.35 g, 6.02 mmol) followed by 2-ethoxyethanol (50 mL)and DMF (50 mL) and heated at 130 °C overnight. The reaction was allowed to cool down and evaporated the solvents. It was dissolved in DCM and passed through a short silica gel plug eluted with DCM and then run a silica gel column to give a 1.25 g (47% yield) orange solid which LC/MS shows desired mass.

### Synthesis of Compound III-4640

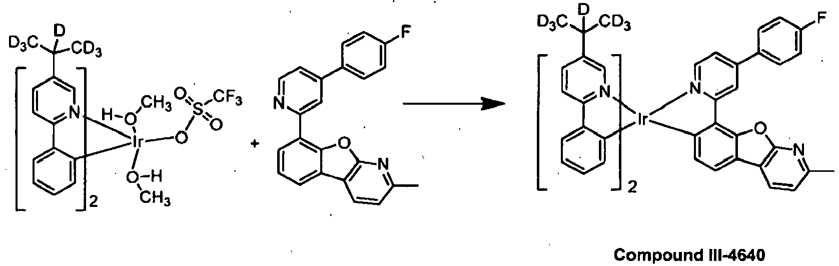

A mixture of iridium complex (2.7 g, 3.33 mmol), 8-(4-(4-fluorolphenyl)pyridin-2-yl)-2-methylbenzofuro[2,3-b]pyridine (2.35 g, 6.65 mmol), 2-ethoxyethanol (50 mL) and DMF (50 mL) was heated at 130 °C overnight. The solvent mixture was evaporated under vacuum. The residue was run through a short silica plug. The reaction mixture was further purified by silica gel column with DCM/heptane as elute to obtain 2.3 g desired product (73% yield) which was confirmed by LC-MS.

### Synthesis of Compound III-4622

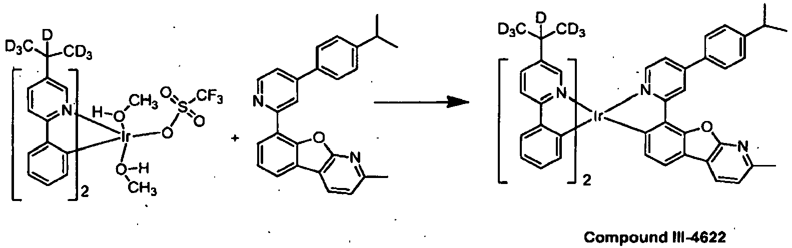

A mixture of phenylpyridine iridium complex (2.4 g, 2.96 mmol), 8-(4-(4-isopropylphenyl)pyridin-2-yl)-2-methylbenzofuro[2,3-b]pyridine (2.237 g, 5.91 mmol), 2-ethoxyethanol (50 mL) and DMF (50 mL) was heated at 130 °C overnight. The solvent mixture was evaporated under vacuum. The residue was run through a short silica plug with dichloromethane (DCM). The reaction mixture was further purified by silica gel column with DCM/heptane as elute to obtain 2.4 g desired product (83% yield), which was confirmed by LC-MS.

### Synthesis of Compound III-56

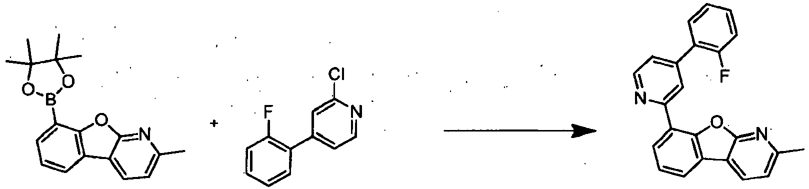

**Synthesis of 8-(4-(2-fluorophenyl)pyridin-2-yl)-2-methylbenzofuro[2,3-b]pyridine:** 2-methyl-8-(4,4,5,5-tetramethyl-1,3,2-dioxaborolan-2-yl)benzofuro[2,3-b]pyridine (2.8 g, 9.06 mmol), 2-chloro-4-(2-fluorophenyl)pyridine (2.25 g, 10.84 mmol), tris(dibenzylideneacetone) palladium(0) (0.166 g, 0.181 mmol) and 2-Dicyclohexylphosphino-2',6'-dimethoxybiphenyl (0.297 g, 0.725 mmol) were charged into the reaction vessel with 200mL of toluene. Potassium phosphate tribasic (6 g, 28.3 mmol) was then dissolved in 25mL of water and was added to the reaction mixture. The reaction mixture was degassed with nitrogen then was heated to reflux overnight. The reaction mixture was cooled to room temperature. The toluene layer was separated and was dried over magnesium sulfate. This mixture was filtered and concentrated under vacuum. The crude residue was passed through a silica gel column using 15-22.5% ethyl acetate/ heptanes. The clean product fractions were evaporated under reduced pressure yielding 8-(4-(2-fluorophenyl)pyridin-2-yl)-2-methylbenzofuro[2,3-b]pyridine (2.247 g, 6.34 mmol, 70 % yield) as a white solid.

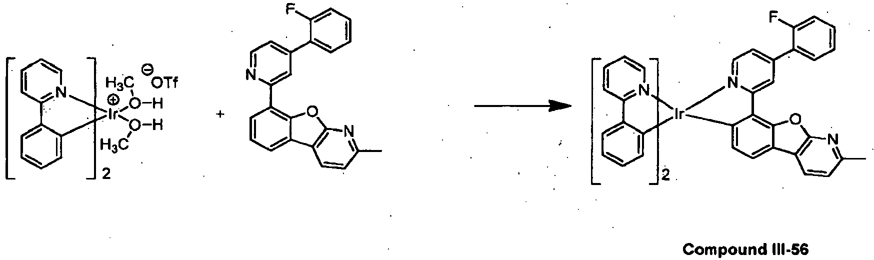

8-(4-(2-fluorophenyl)pyridin-2-yl)-2-methylbenzofuro[2,3-b]pyridine (1.9 g, 5.36 mmol) and Iridium complex (1.913 g, 2.68 mmol) were charged into the reaction mixture with 50 mL of DMF and 50 mL of 2-ethoxyethanol. This reaction mixture was degassed with nitrogen then was heated at an oil bath temperature of 13.0 °C for 18 hours. The reaction mixture was cooled to room temperature then was evaporated under reduced pressure. The crude product was dissolved in 300 mL of DCM then was passed through a silica gel plug eluting the plug with 1.5 L of DCM. This DCM filtrated was evaporated and the crude product was passed through a silica gel column eluting the column with 55-65% DCM/ heptanes. Clean product fractions yielded 1.2 g (32% yield) of the desired product.

### Synthesis of Compound III-59

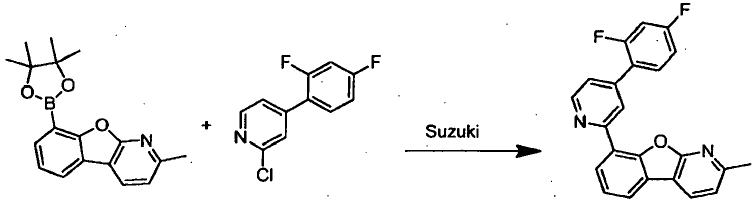

To a 250 mL flask added 2-methyl-8-(4,4,5,5-tetramethyl-1,3,2-dioxaborolan-2-yl) benzofuro[2,3-b]pyridine (3.0 g, 9.70 mmol), 2-chloro-4-(2,4-difluorophenyl)pyridine (2.63 g, 11.64 mmol), dicyclohexyl(2',6'-dimethoxy-[1,1'-biphenyl]-2-yl)phosphine (0.319 g, 0.776 mmol), Pd₂(dba)₃ (0.178 g, 0.194 mmol), potassium phosphate (7.21 g, 34.0 mmol) followed by water (7 mL) and toluene (volume: 70 mL). The reaction was degassed with N₂ and heated at reflux under N₂. overnight. The reaction was worked up with silica gel column to give 2.45 g (6.8%) clean product.

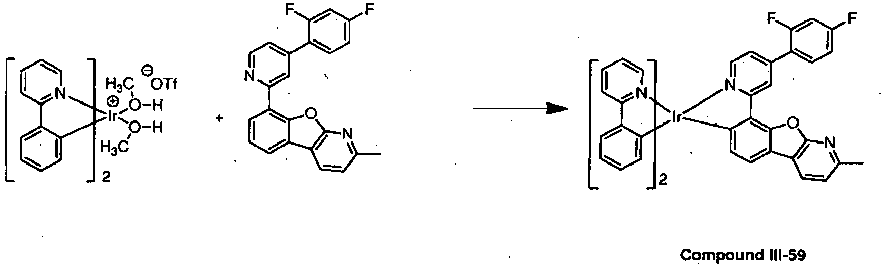

To a 250 mL flask added iridium complex (2.348 g, 3.29 mmol), 8-(4-(2,4-difluorophenyl)pyridin-2-yl)-2-methylbenzofuro[2,3-b]pyridine (2.45 g, 6.58 mmol), 2-ethoxyethanol (60 mL), DMF (60 mL). The mixture was heated in an oil bath at 130 °C overnight under N₂ and allowed to cool and evaporated the solvents to leave a red/orange solid which was further purified by silica gel column to give orange solid 1.7 g (61% yield) desired product which was confirmed by LC-MS.

### Synthesis of Compound III-65

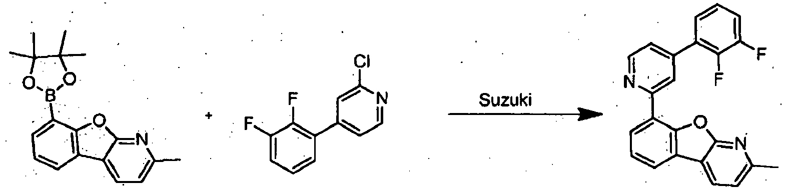

### Synthesis of: 8-(4-(2,3-difluorophenyl)pyridin-2-yl)-2-methylbenzofuro[2,3-b]Pyridine

2-methyl-8-(4,4,5,5-tetramethyl-1,3,2-dioxaborolan-2-yl)benzofuro[2,3-b]pyridine (2.8 g, 9.06 mmol), 2-chloro-4-(2,3-difluorophenyl)pyridine (2.452 g, 10.87 mmol), tris(dibenzylideneacetone)palladium(0) (0.166 g, 0.181 mmol) and 2-dicyclohexylphosphino-2',6'-dimethoxybiphenyl (0.297 g, 0.725 mmol) were charged into the reaction mixture with 200 mL of toluene. Potassium phosphate tribasic (5.76 g, 27.2 mmol) was dissolved in 25 mL of water then was charged into the reaction mixture. This mixture was degassed then heated to reflux for 18 hours. The reaction mixture was cooled to room temperature. The toluene layer was separated and was dried over magnesium sulfate. This mixture was filtered and concentrated under vacuum. The crude residue was passed through a silica gel column using 15-22.5% ethyl acetate/ heptanes. The clean product fractions were evaporated under reduced pressure yielding 8-(4-(2,3-difluorophenyl)pyridin-2-yl)-2-methylbenzofuro[2,3-b]pyridine (1.2 g, 3.22 mmol, 35.6 % yield) as a white solid.

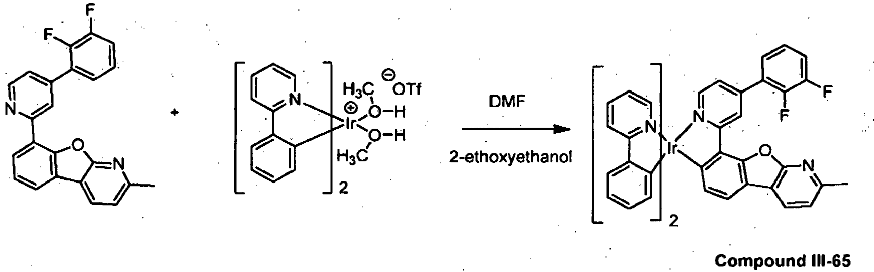

8-(4-(2,3-difluorophenyl)pyridin-2-yl)-2-methylbenzofuro[2,3-b]pyridine (1.2 g, 3.22 mmol) and iridium complex (2.30 g, 3.22 mmol) were charged into the reaction mixture with 30 mL of DMF and 30 mL of 2-ethoxyethanol. This reaction mixture was degassed with nitrogen then was heated at an oil bath temperature of 130 °C for 18 hours. The reaction mixture was cooled to room temperature then was evaporated under reduced pressure. The crude product was dissolved in 300 mL of DCM then was passed through a silica gel plug eluting the plug with 1.5 L of DCM. This DCM filtrated was evaporated and the crude product was passed through a silica gel column eluting the column with 55-65% DCM/ heptanes. Clean product fractions yielded 0.69 g (30% yield) of the desired product.

### Synthesis of Compound III-1750

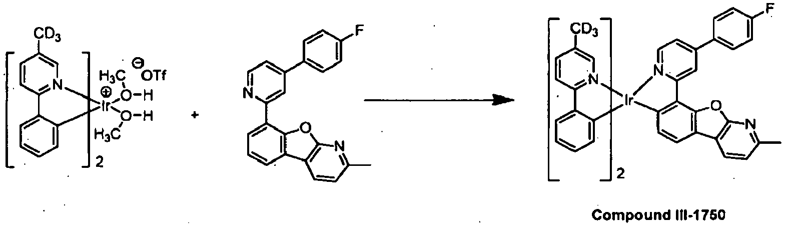

A mixture of iridium complex (2.1 g, 2.81 mmol), 8-(4-(4-fluorolphenyl)pyridin-2-yl)-2-methylbenzofuro[2,3-b]pyridine (1.99 g, 5.62 mmol), 2-ethoxyethanol (50 mL) and DMF (50 mL) was heated at 130 °C overnight under nitrogen. The solvent mixture was evaporated under vacuum. The residue was run through a short silica plug. The reaction mixture was further purified by silica gel column with DCM/heptane as elute to obtain 2.1 g desired product (84% yield) which was confirmed by LC-MS.

### Synthesis of Compound III-1559

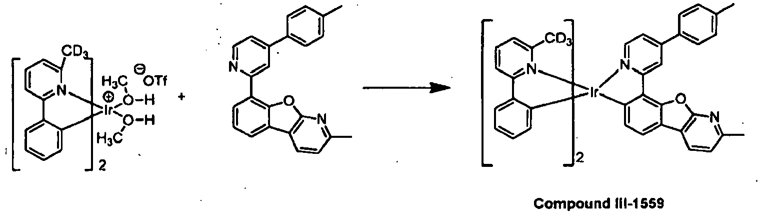

A mixture of iridium complex (2.214 g, 2.58 mmol), 8-(4-(4-methylphenyl)pyridin-2-yl)-2-methylbenzofuro[2,3-b]pyridine (1.8 g, 5.14 mmol), 2-ethoxyethanol (50 mL) and DMF (50 mL) was heated at 130 °C overnight. The solvent mixture was evaporated under vacuum. The residue was run through a short silica plug. The reaction mixture was further purified by silica gel column to give 1.8 g (71% yield) desired product which was confirmed by LC-MS.

### Synthesis of Compound III-26

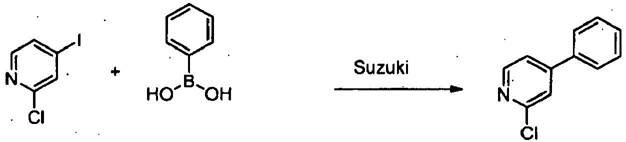

**Synthesis of 2-Chloro-4-phenylpyridine.** A mixture of 2-chloro-4-iodopyridine (20.0 g, 82 mmol), phenylboronic acid (10.2 g, 82 mmol), Pd(Ph₃P)₄ (2.84 g 2.46 mmol), sodium carbonate (26.0 g, 246 mmol), DME (600 mL) and water (150 mL) was degassed with nitrogen and then refluxed overnight. The reaction was concentrated and the extracted with ethyl acetate. The ethyl acetate layer was dried on Na₂SO₄ and then vacuum distilled to give 2-chloro-4-phenylpyridine (2.79 g, 12.7 mmol, 82 % yield).

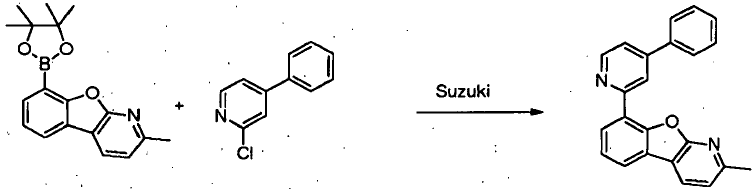

**Synthesis of 2-methyl-8-(4-phenylpyridin-2-yl)benzofuro[2,3-b]pyridine.** A mixture of 2-methyl-8-(4,4,5,5-tetramethyl-1,3,2-dioxaborolan-2-yl)benzofuro[2,3-b]pyridine (4.34 g, 14.03 mmol), 2-chloro-4-phenylpyridine (2.66 g, 14.03 mmol), Pd₂(dba)₃ (0.257 g 0.281 mmol), dicyclohexyl(2',6'-dimethoxy-[1,1'-biphenyl]-2-yl)phosphine (0.582 g, 1.42 mmol), potassium phosphate (8.93 g, 42.1 mmol), toluene (180 mL) and water (28 mL) was degassed with nitrogen and then refluxed overnight. The mixture was concentrated and extracted with ethyl acetate. The ethyl acetate layer was dried on Na₂SO₄ and then further purified by column chromatography using ethyl acetate in hexanes to give 2-methyl-8-(4-phenylpyridin-2-yl)benzofuro[2,3-b]pyridine (3.66 g, 10.88 mmol, 78 % yield).

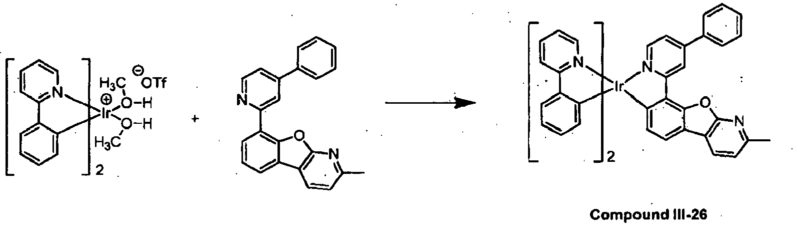

A mixture of iridium complex (2 g, 2.8 mmol),1 2-methyl-8-(4-phenylpyridin-2-yl)benzofuro[2,3-b]pyridine (1.89 g, 5.60 mmol),), ethoxyethanol (40 ml) and DMF (40 mL) was heated at 130 °C overnight. The reaction mixture was concentrated to remove solvents and filtered through a small plug of silica gel and further chromatographed to give 0.98 g product. After sublimation, it gave the desired product (0.85 g, 36.3% yield).

### Synthesis of Compound III-196

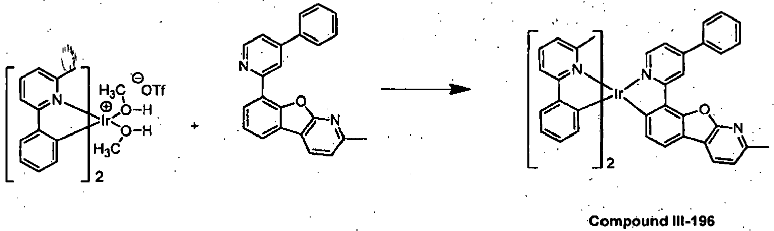

A mixture of iridium complex (2.0 g, 2.69 mmol),), 2-methyl-8-(4-phenylpyridin-2-yl)benzofuro[2,3-b]pyridine (1.807 g, 5.37 mmol), 2-ethoxyethanol (50 mL) and DMF (50 mL) was heated at 130 °C overnight under nitrogen. The solvent mixture was evaporated under vacuum. The residue was run through a short silica plug with DCM as elute. The reaction mixture was further purified by silica gel column with DCM/heptane as elute to obtain 1.1 g desired product (47% yield) which was confirmed by LC-MS.

### Synthesis of Compound III-220

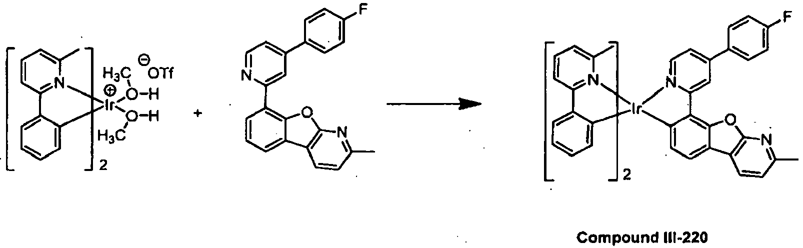

A mixture of iridium complex (2.0 g, 2.70 mmol), 8-(4-(4-fluorolphenyl)pyridin-2-yl)-2-methylbenzofuro[2,3-b]pyridine (1.911 g, 5.39 mmol), 2-ethoxyethanol 60 mL was heated at 130 °C overnight under nitrogen. The reaction was cooled down and filtered and washed with methanol. The obtained crud product was purified by silica gel column with DCM/heptane as elute to obtain 1.6 g desired product (67%, yield) which was confirmed by LC-MS.

### Synthesis of Compound III-29

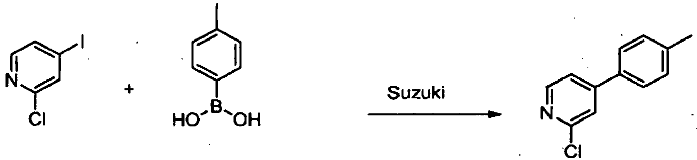

**Synthesis of 2-Chloro-4-(p-tolyl)pyridine.** A mixture of 2-chloro-4-iodopyridine (10.0 g, 41.8 mmol), p-tolylphenylboronic acid (5.68 g, 41.8 mmol), Pd(Ph₃P)₄ (1.45 g 1.25 mmol), sodium carbonate (13.3 g, 125 mmol), DME (300 mL) and water (75 mL) was degassed with nitrogen and then refluxed overnight. The reaction mixture was concentrated and extracted with ethyl acetate. The ethyl acetate layer was dried on Na₂SO₄ and vacuum distilled and recrystallized to give 2-chloro-4-(p-tolyl)pyridine (3.75 g, 18.4 mmol, 44 % yield).

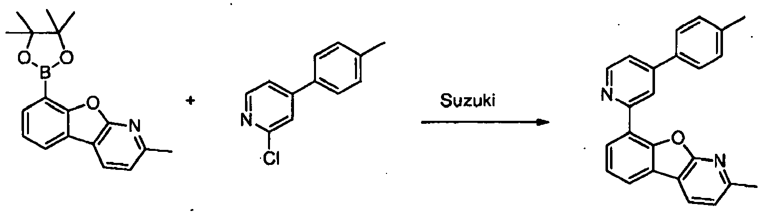

**Synthesis of 2-methyl-8-(4-(p-tolyl)(pyridin-2-yl)benzofuro[2,3-b]pyridine.** A mixture of 2-methyl-8-(4,4,5,5-tetramethyl-1,3,2-dioxaborolan-2-yl)benzofuro[2,3-b]pyridine (2.5 g, 8.03 mmol), 2-chloro-4-(p-tolyl)pyridine (1.80 g, 8.83 mmol), Pd₂(dba)₃ (0.147 g 0.161 mmol), dicyclohexyl(2',6'-dimethoxy-[1,1'-biphenyl]-2-yl)phosphine (0.264 g, 0.642 mmol), potassium phosphate (5.96 g, 28.1 mmol), toluene (100 mL) and water (10 mL) was degassed with nitrogen and then refluxed overnight. The reaction mixture was concentrated and extracted with ethyl acetate. The ethyl acetate layer was dried on Na₂SO₄ and then further purified by column chromatography using ethyl acetate in hexanes to give 2-methyl-8-(4-(p-tolyl)pyridin-2-yl)benzofuro[2,3-b]pyridine (2.0 g, 5.71 mmol, 71 % yield).

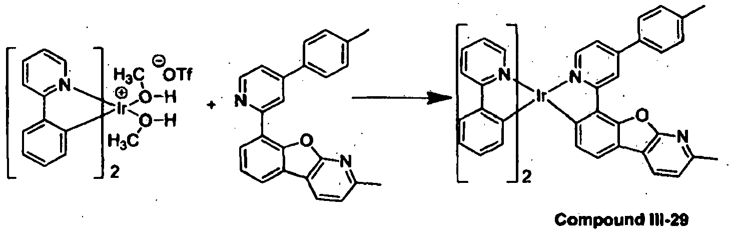

A mixture of iridium complex (2.26 g, 3.17 mmol),1 2-methyl-8-(4-(p-tolyl)pyridin-2-yl)benzofuro[2,3-b]pyridine (2.0 g, 5.71 mmol),), 2-ethoxyethanol (45 mL) and DMF (45 mL) was heated at 130 °C overnight. The reaction mixture was concentrated to remove solvents and filtered through a small plug of silica gel with DCM and further chromatographed to give 1.54 g product. After sublimation, it yielded 1.0 g (37% yield) desired product which was confirmed by LC-MS.

It is understood that the various embodiments described herein are by way of example only, and are not intended to limit the scope of the invention as defined by the appended claims. For example, many of the materials and structures described herein may be substituted with other materials and structures without deviating from the scope of the claims. The present invention as claimed may therefore include variations from the particular examples and preferred embodiments described herein, as will be apparent to one of skill in the art. It is understood that various theories as to why the invention works are not intended to be limiting.

## Claims

1. A compound having the formula Ir(L_{A})ₙ(L_{B})₃₋ₙ, having the structure: 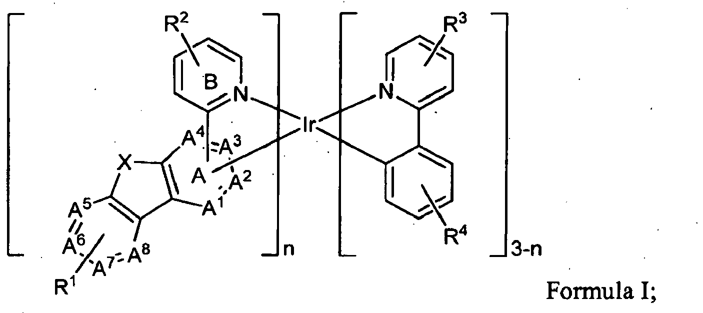 wherein A¹, A², A³, A⁴, A⁵, A⁶, A⁷, and A⁸ comprise carbon or nitrogen;
wherein at least one of A¹, A², A³, A⁴, A⁵, A⁶, A⁷, and A⁸ is nitrogen;
wherein ring B is bonded to ring A through a C-C bond;
wherein the iridium is bonded to ring A through a Ir-C bond;
wherein X is O, S, or Se;
wherein R¹, R², R³, and R⁴ independently represent mono-, di-, tri-, tetra-substitution, or no substitution;
wherein any adjacent substitutions in R¹, R², R³, and R⁴ are optionally linked together to form a ring;
wherein R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is an integer from 1 to 3.

2. The compound of claim 1, wherein the compound has the formula:

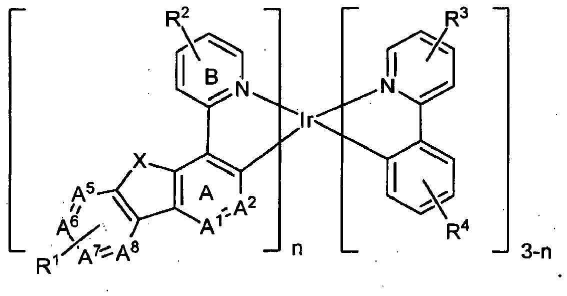

3. The compound of claim 1 or 2, wherein n is 1.

4. The compound of any of claims 1 to 3, wherein only one of A¹ to A⁸ is nitrogen.

5. The compound of any of claims 1 to 4, wherein X is O.

6. The compound of any of claims 1 to 5, wherein R¹, R², R³, and R⁴ are independently selected from the group consisting of hydrogen, deuterium, alkyl, and combinations thereof.

7. The compound of any of claims 1 to 6, wherein R² is alkyl.

8. The compound of any of claims 1 to 6, wherein R² is selected from the group consisting of aryl, substituted aryl, heteroaryl, and substituted heteroaryl.

9. The compound of any of claims 1 to 8, wherein R³ is alkyl.

10. The compound of claim 1, wherein L_{A} is selected from the group consisting of:

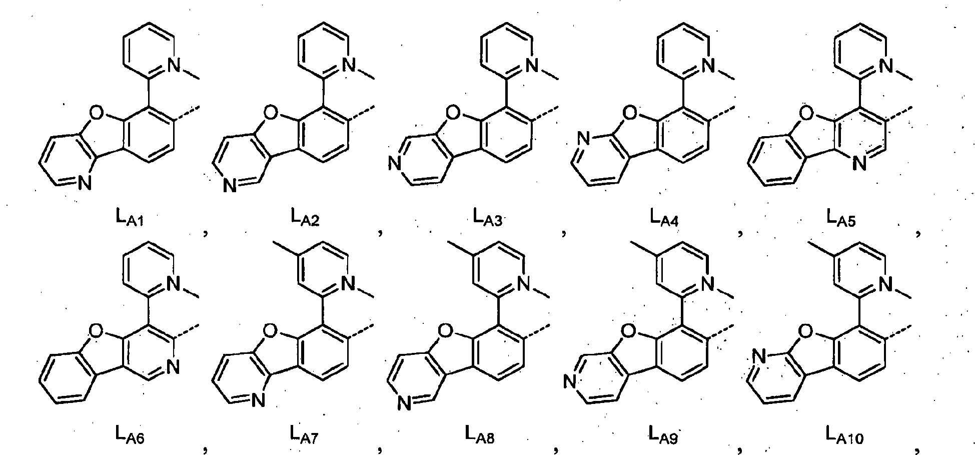

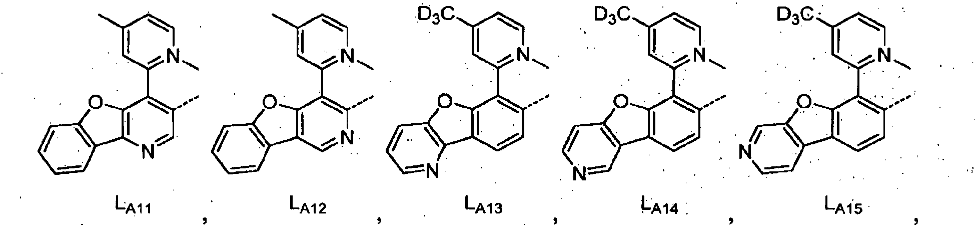

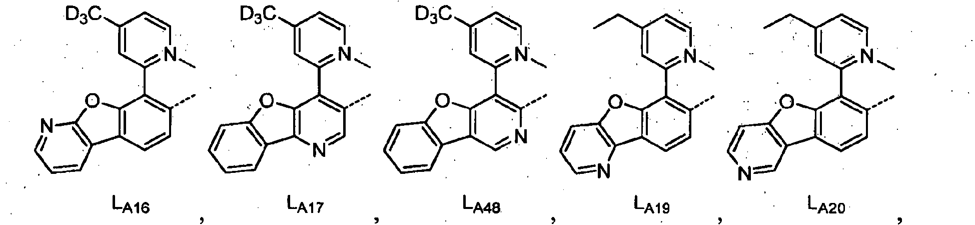

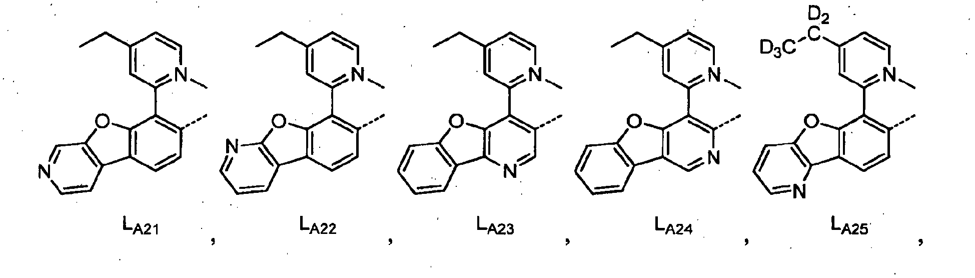

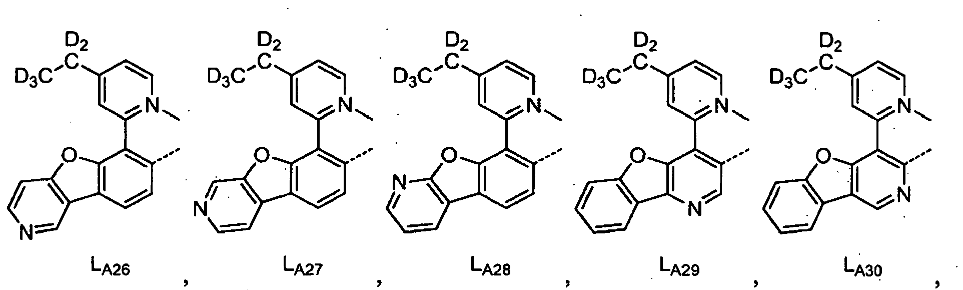

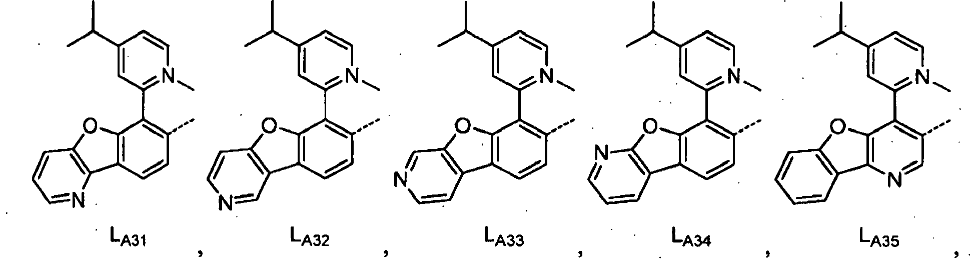

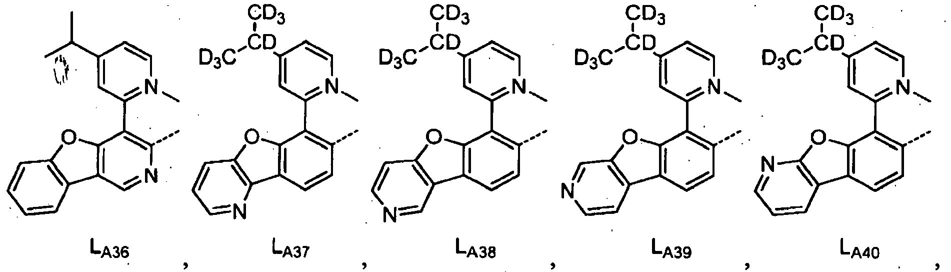

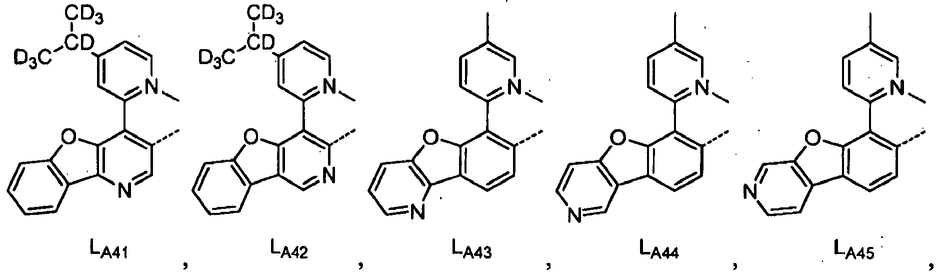

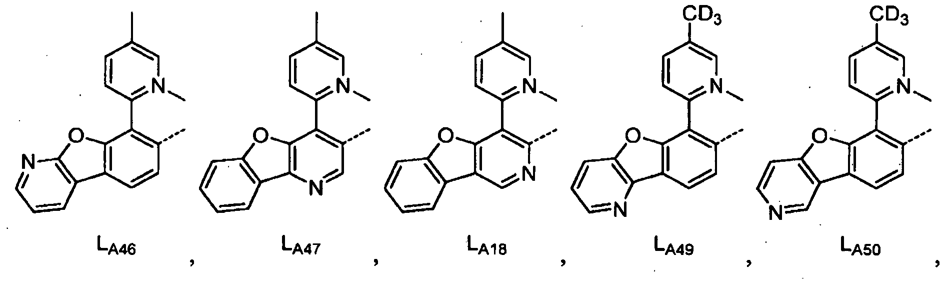

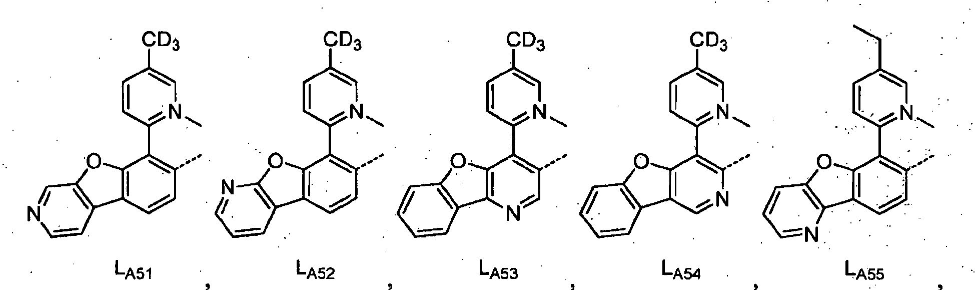

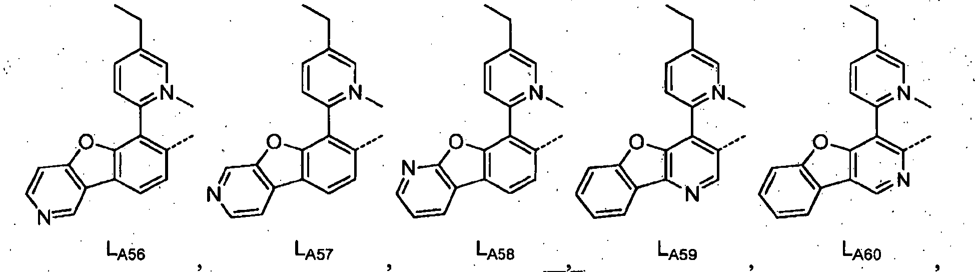

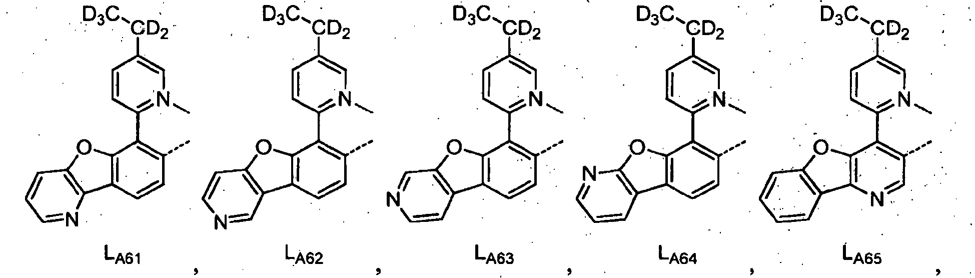

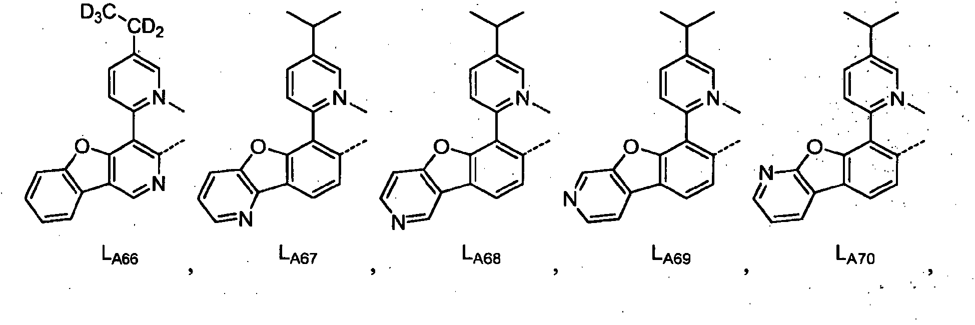

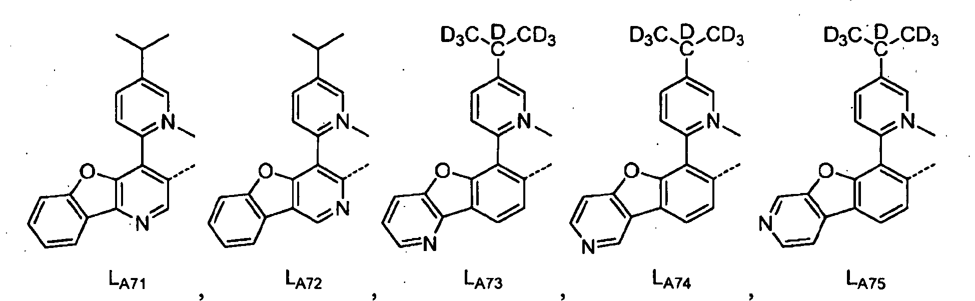

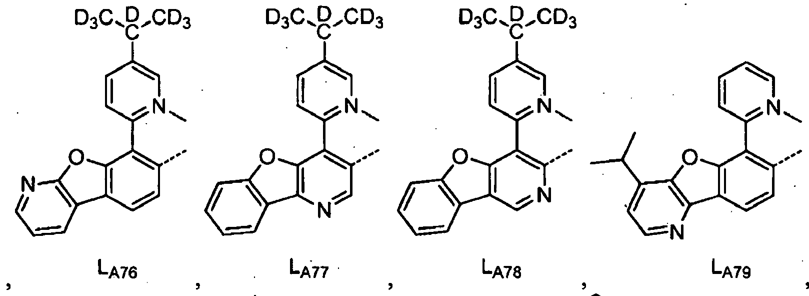

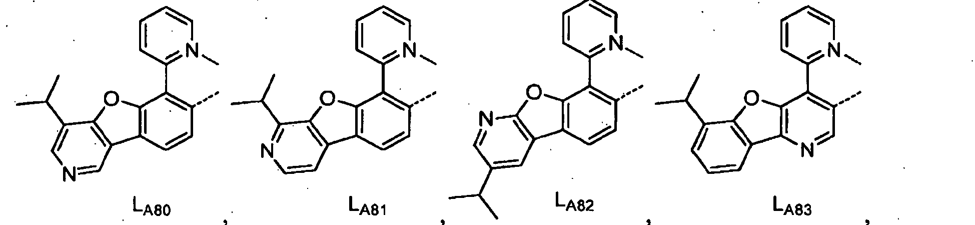

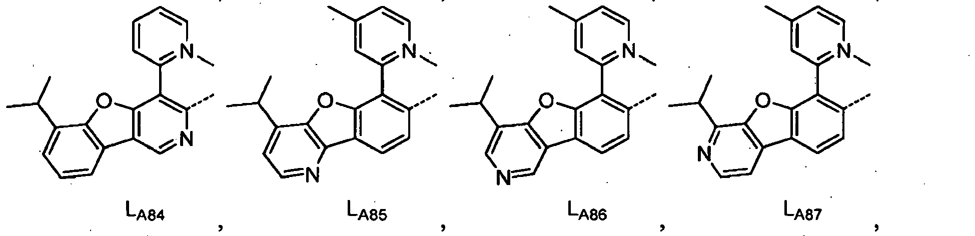

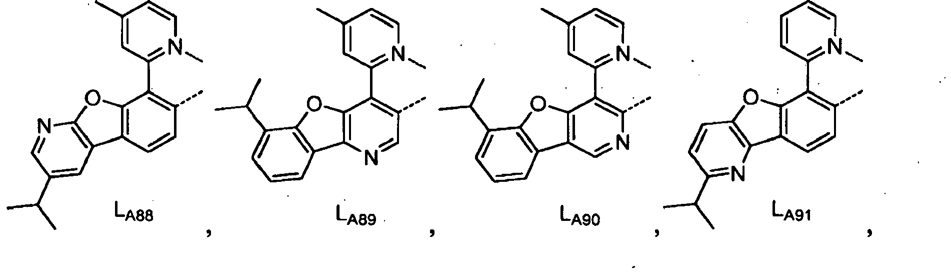

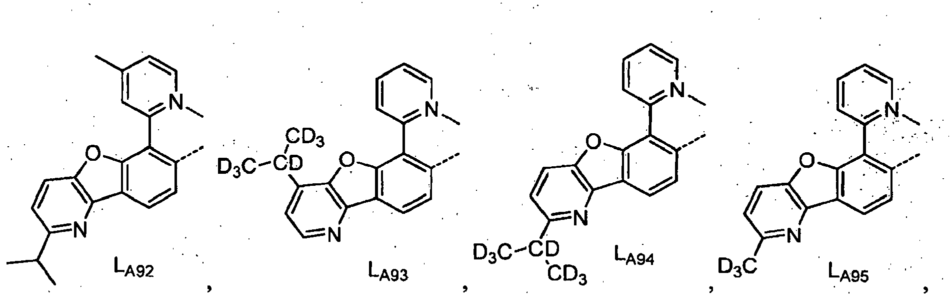

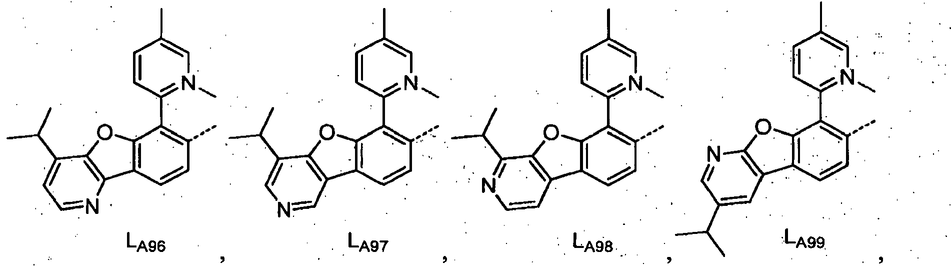

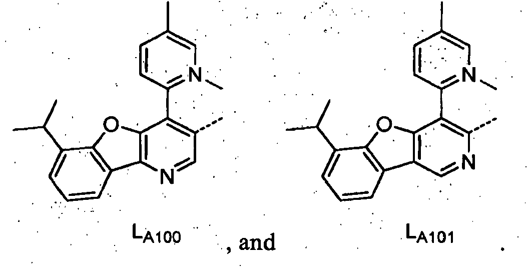

11. The compound of claim 1, wherein L_{A} is selected from the group consisting of:

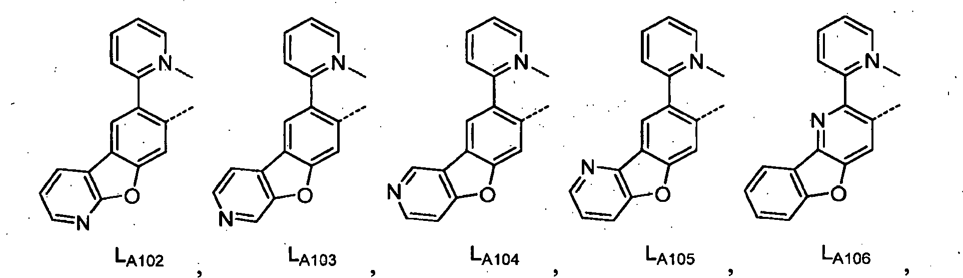

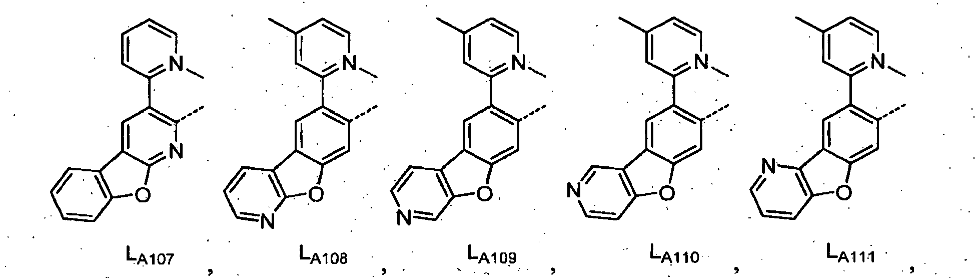

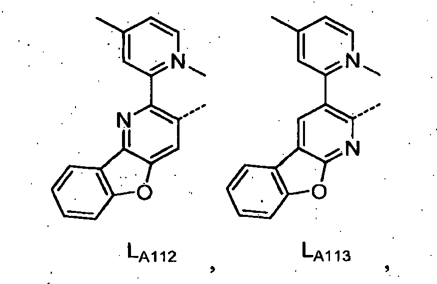

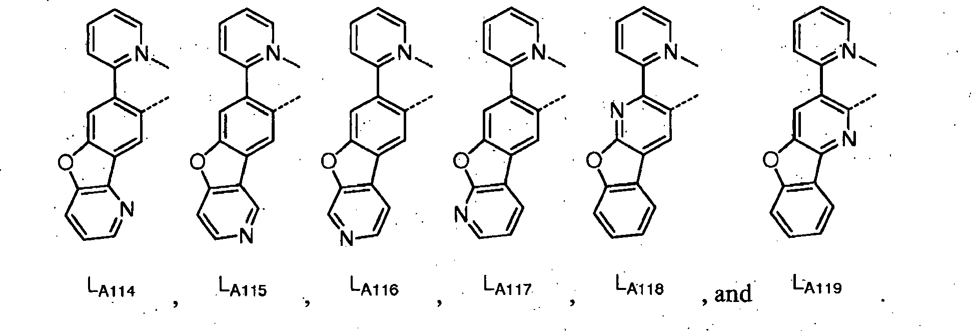

12. The compound of claim 1, wherein L_{B} is selected from the group consisting of:

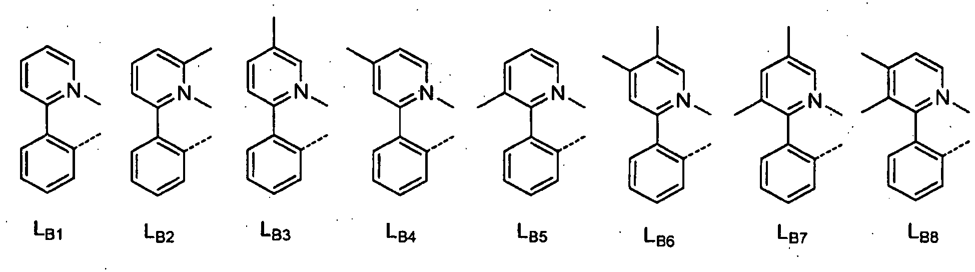

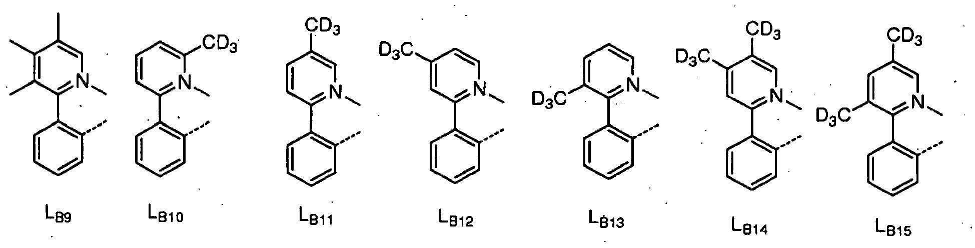

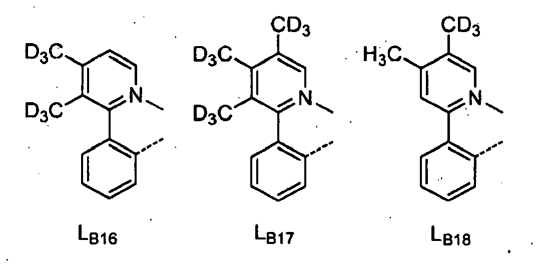

13. The compound of claim 1, wherein the compound is selected from the group consisting of:

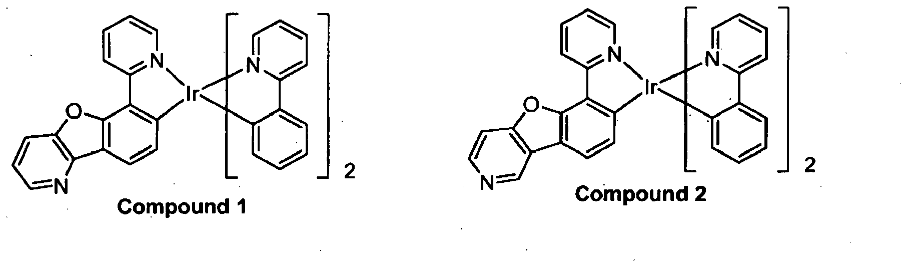

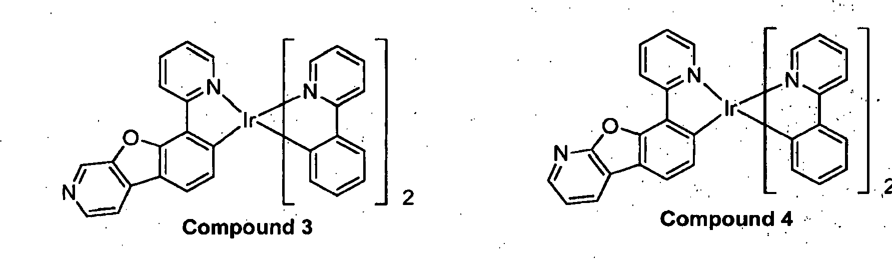

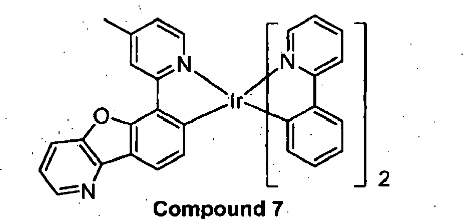

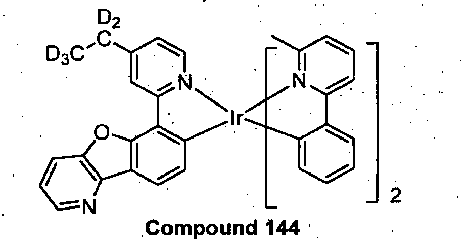

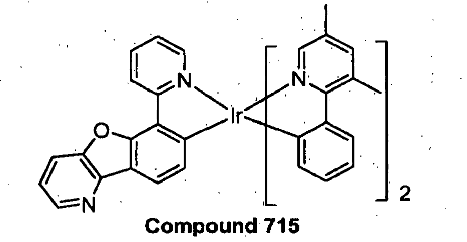

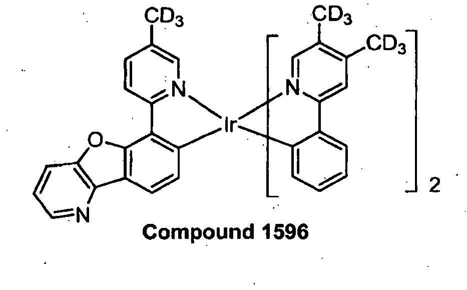

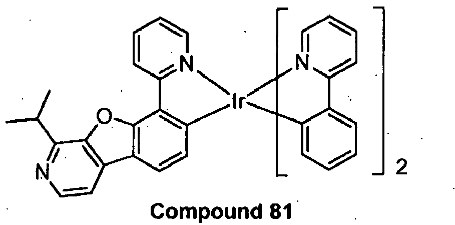

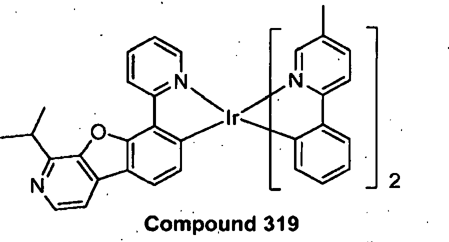

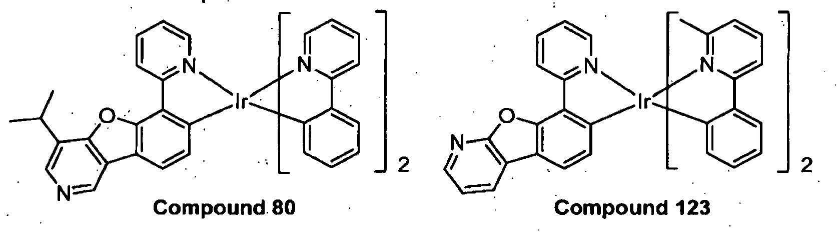

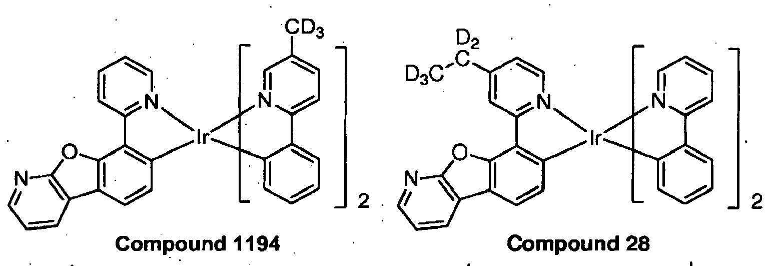

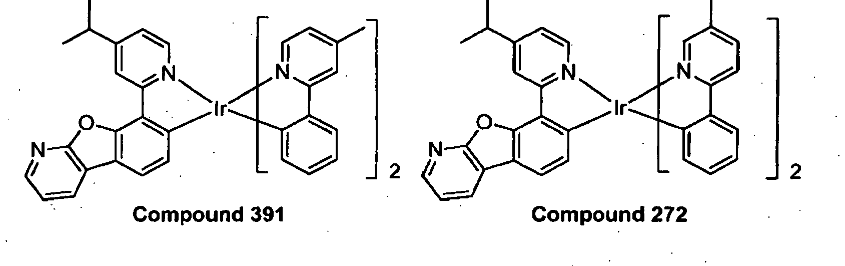

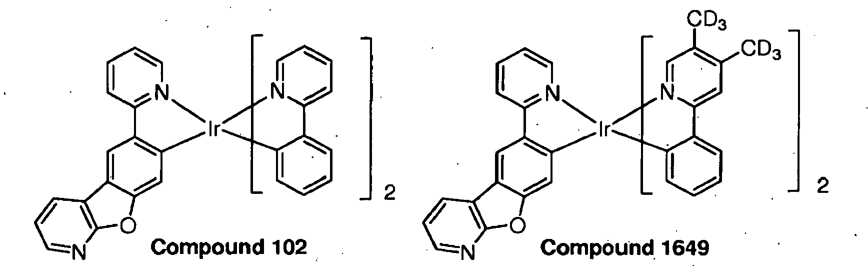

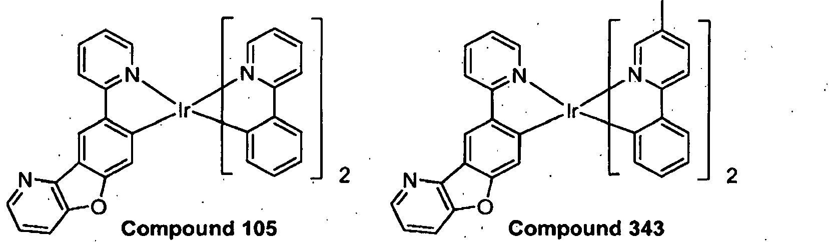

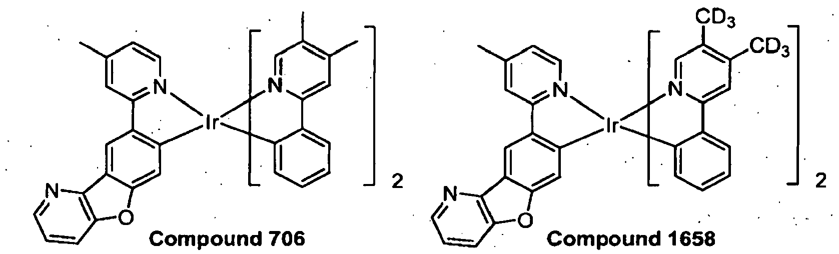

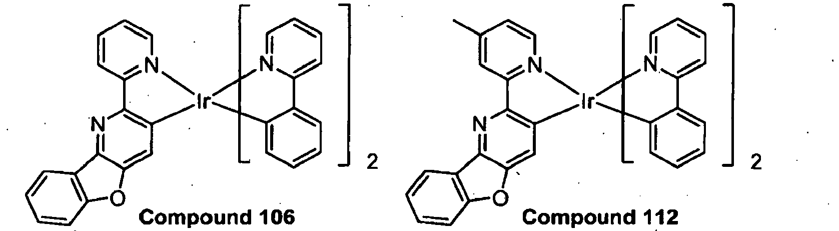

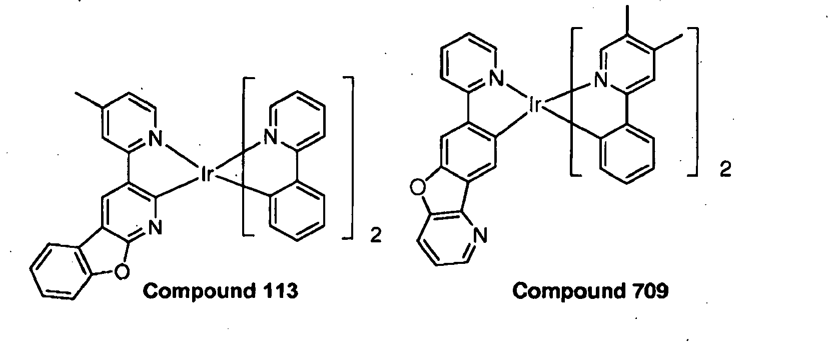

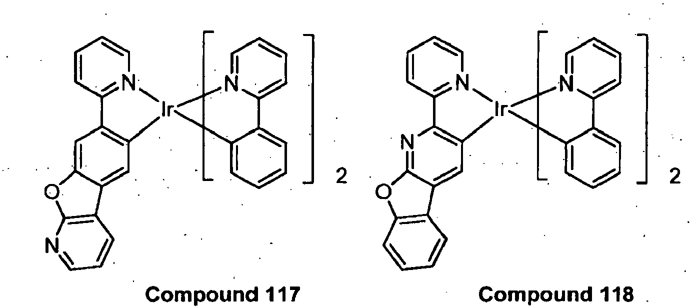

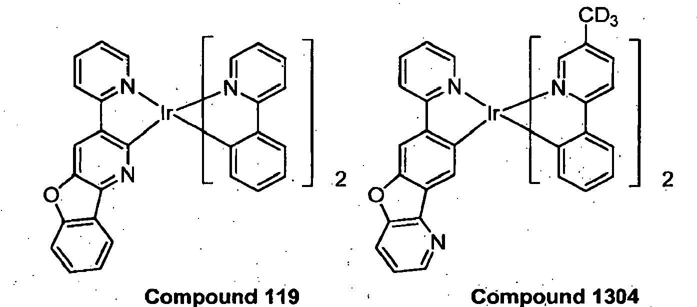

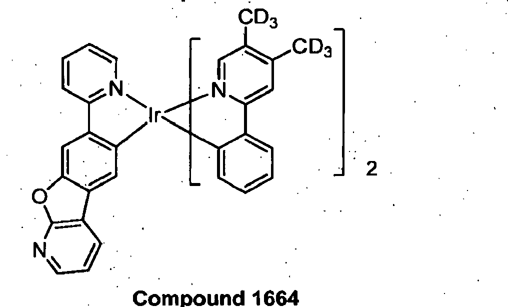

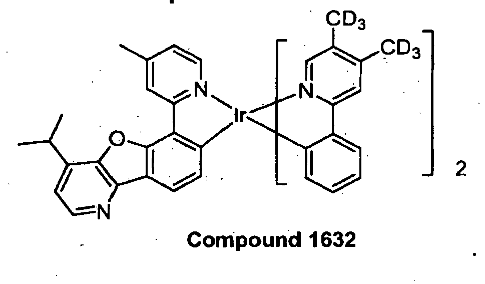

14. The compound of claim 1, wherein A¹-A⁴ and A⁶-A⁸ are C;
A⁵ is N; and
said compound having a structure according to Formula II 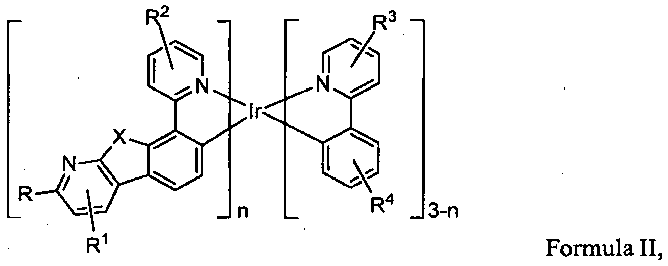 wherein R is selected from the group consisting of alkyl, cycloalkyl, and combinations thereof.

15. The compound of claim 14, wherein R² is selected from the group consisting of aryl, substituted aryl, heteroaryl, amd substituted heteroaryl.

16. The compound of claim 14, wherein L_{A} is selected from the group consisting of:

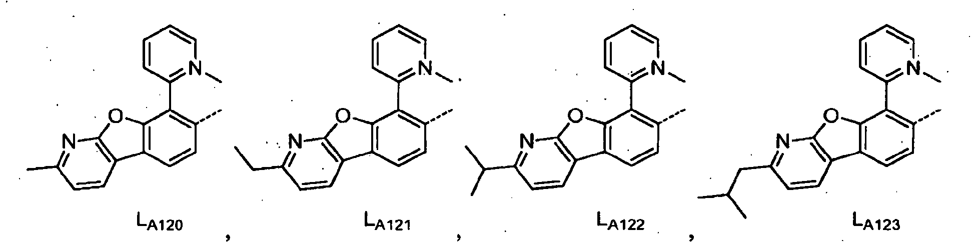

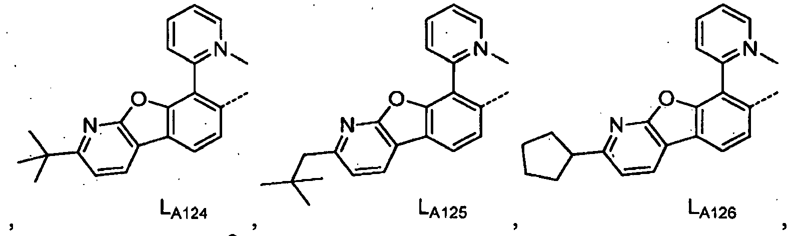

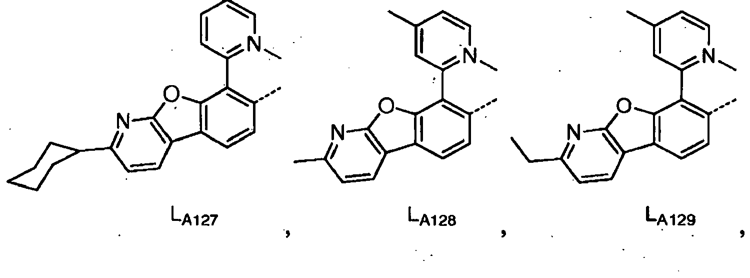

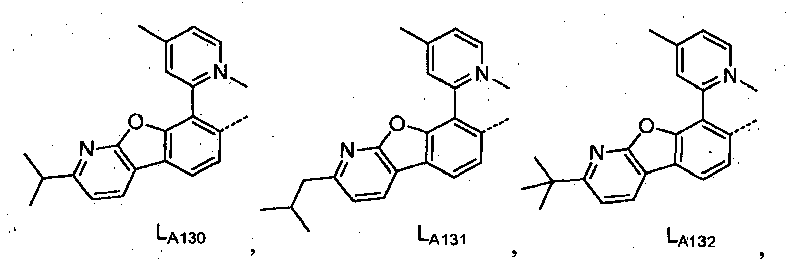

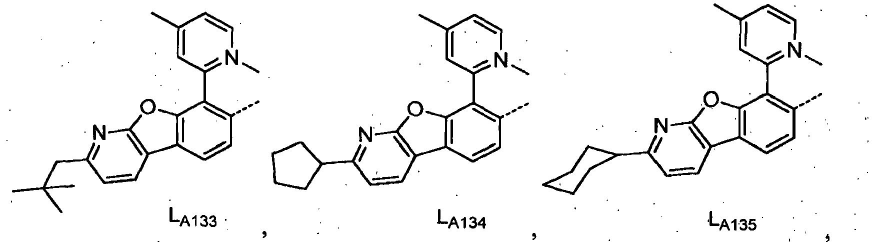

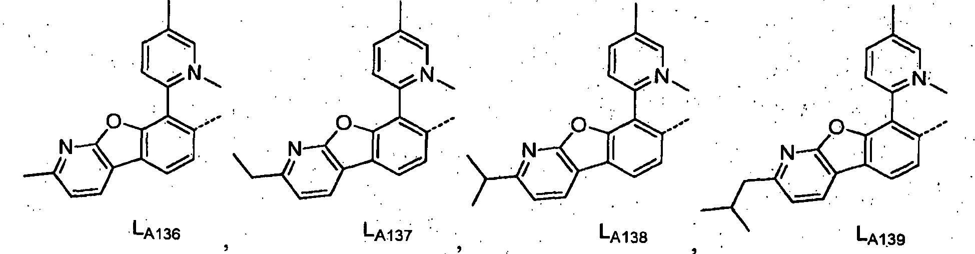

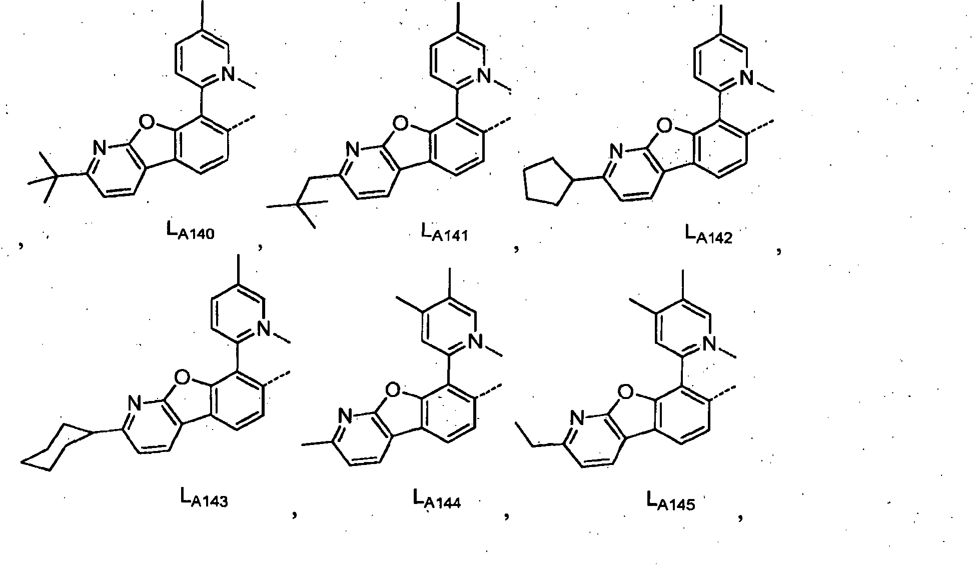

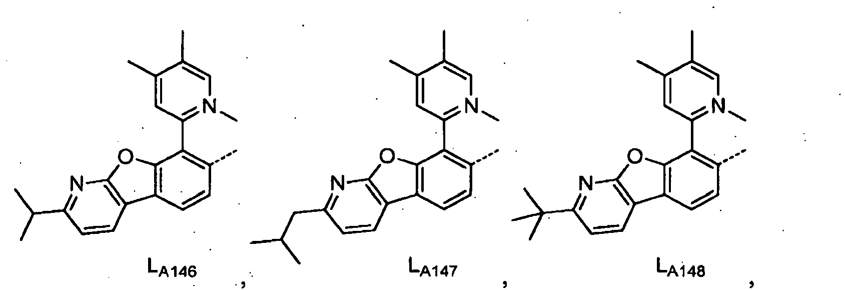

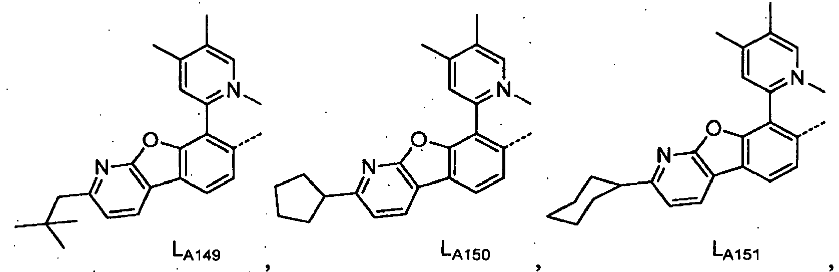

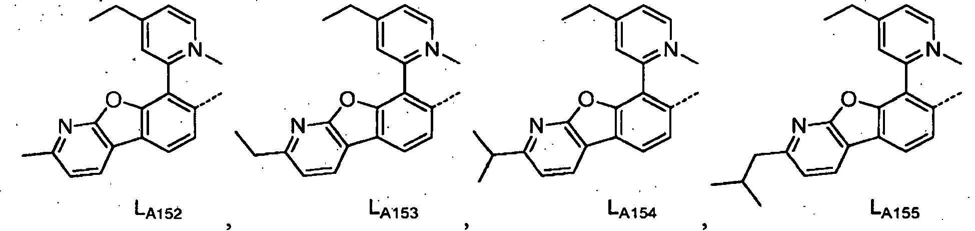

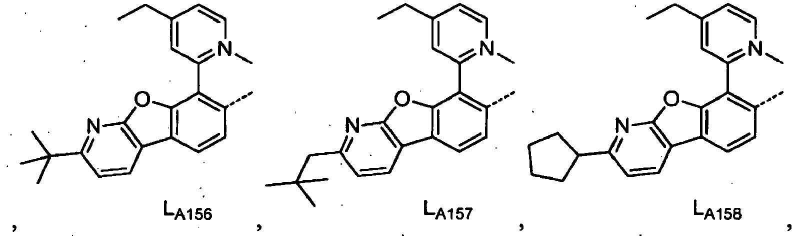

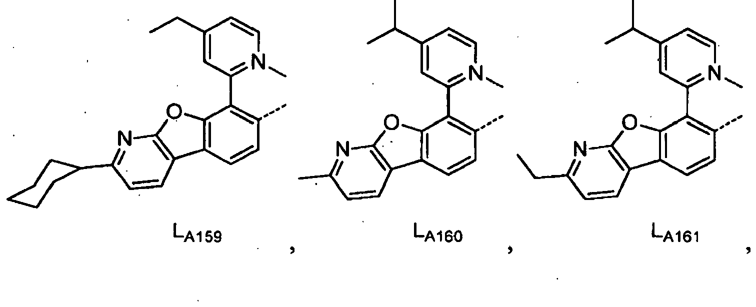

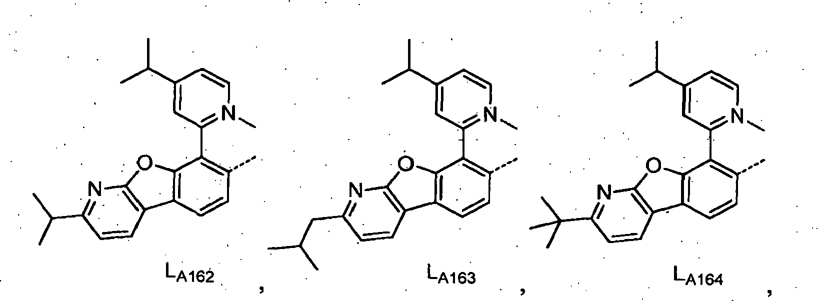

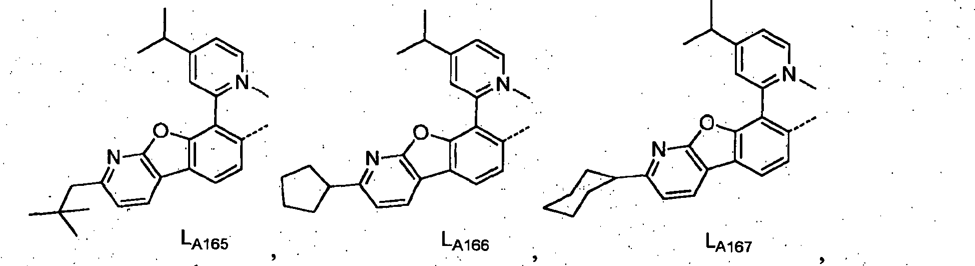

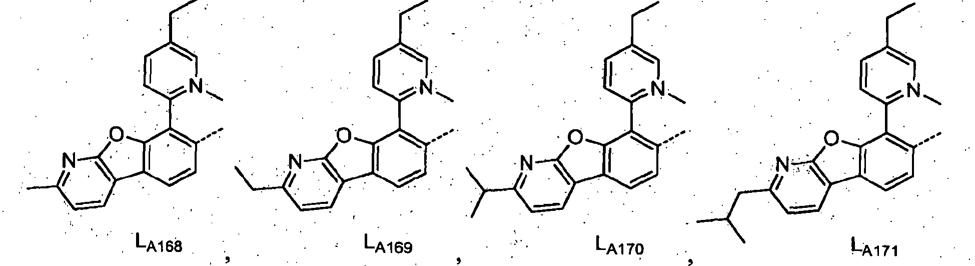

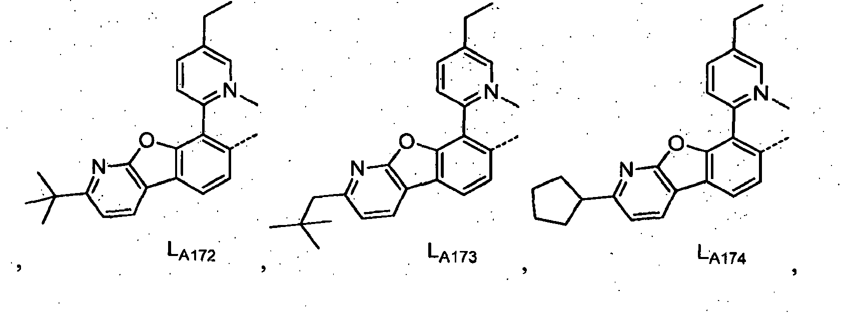

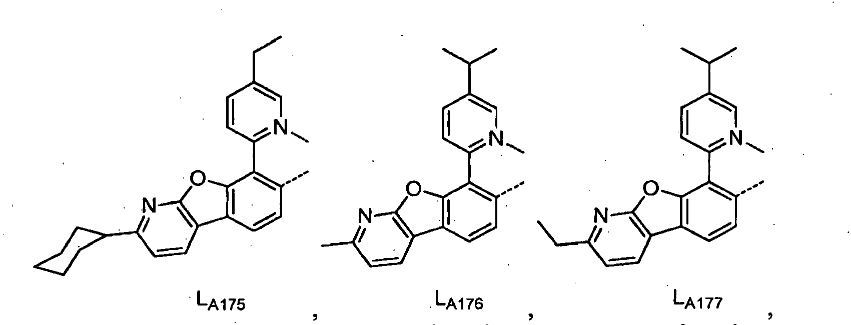

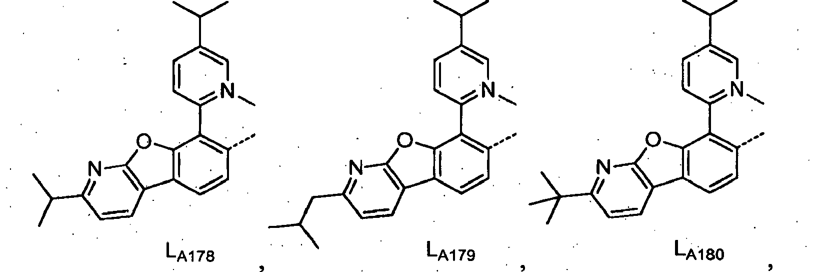

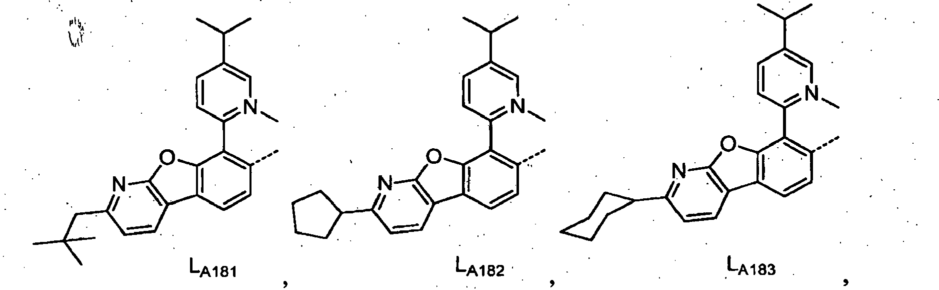

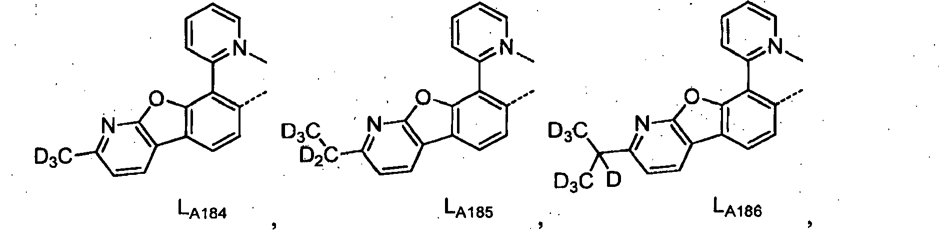

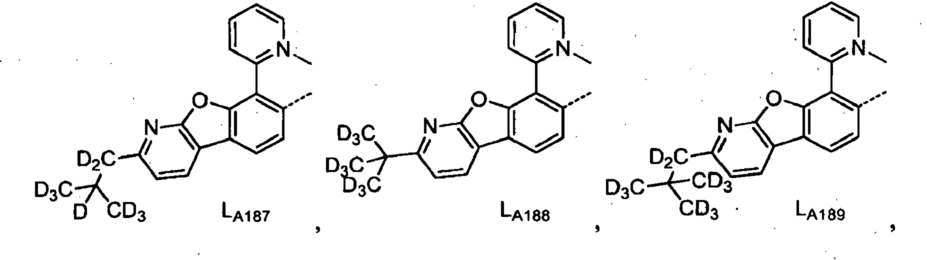

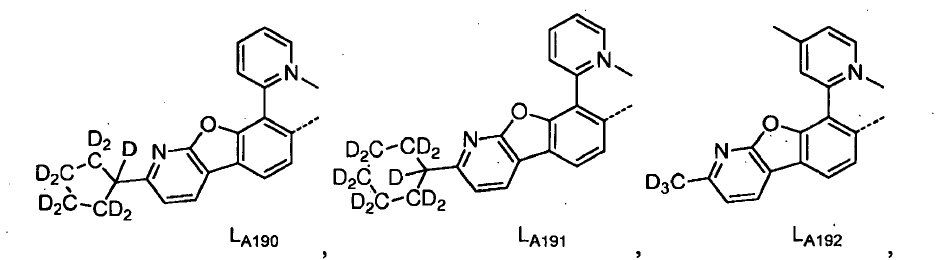

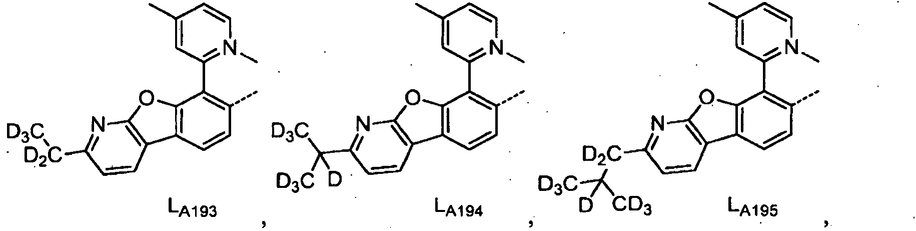

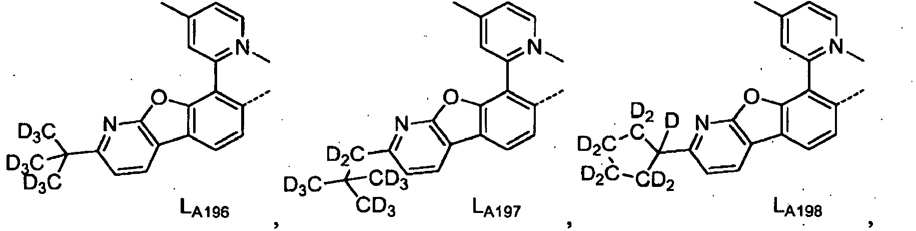

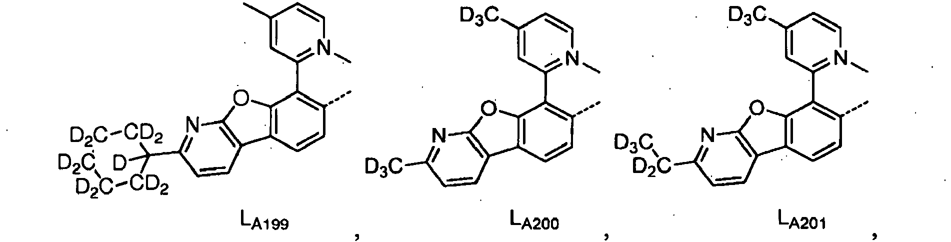

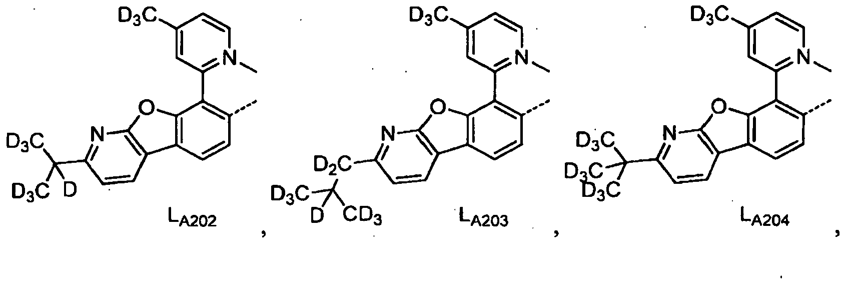

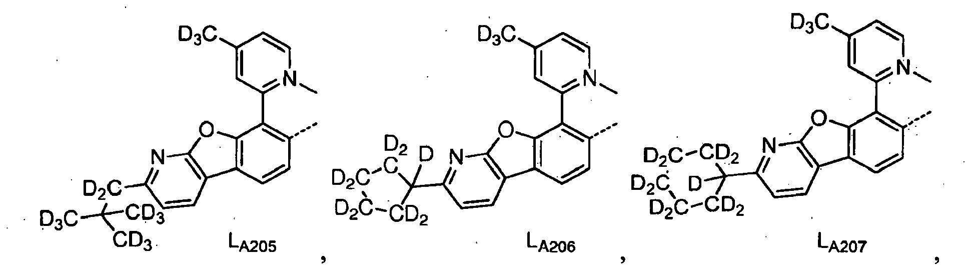

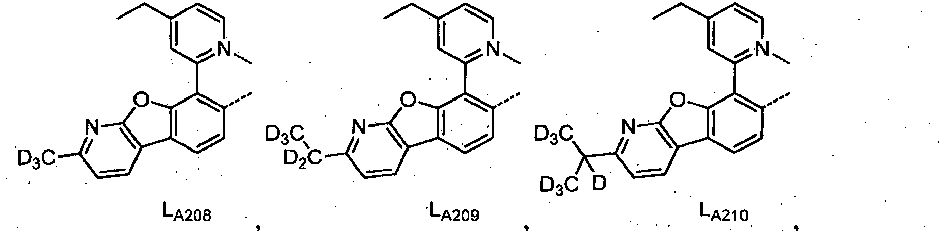

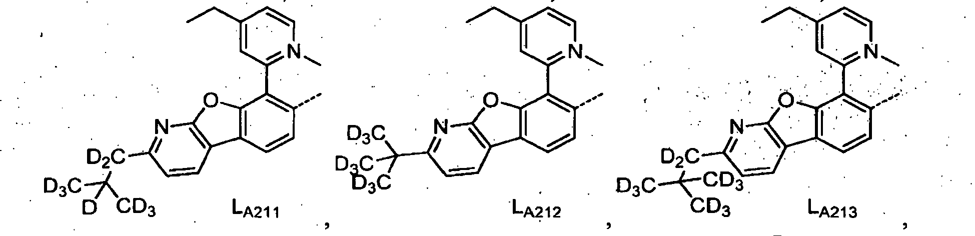

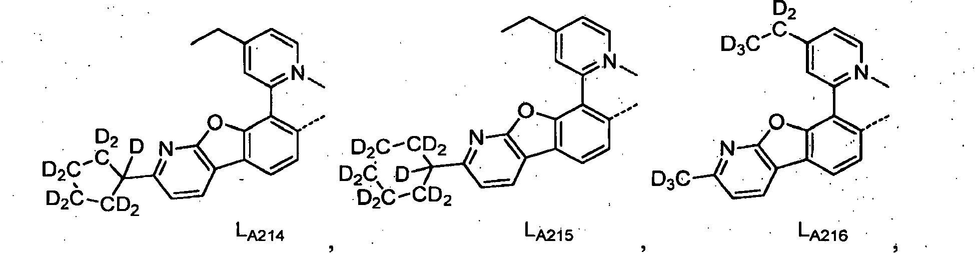

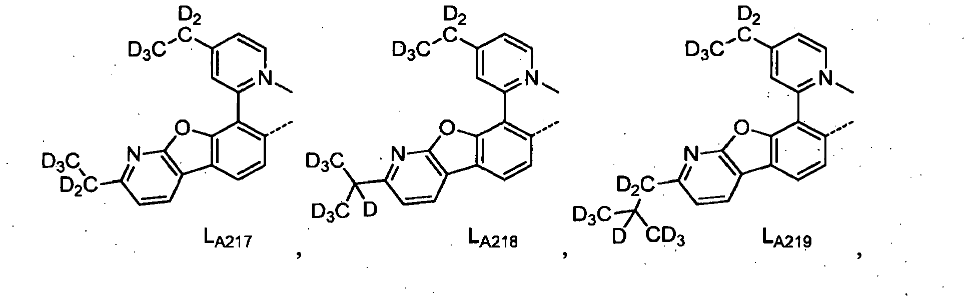

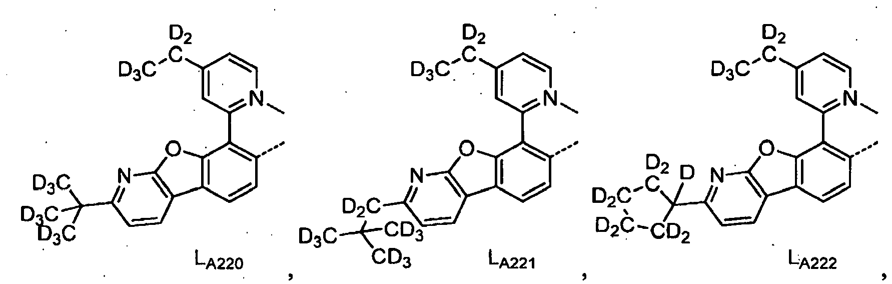

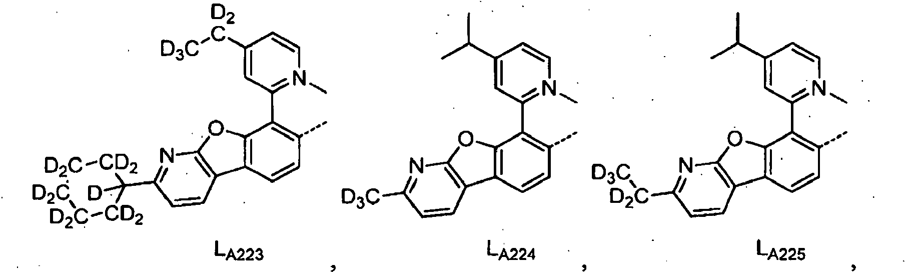

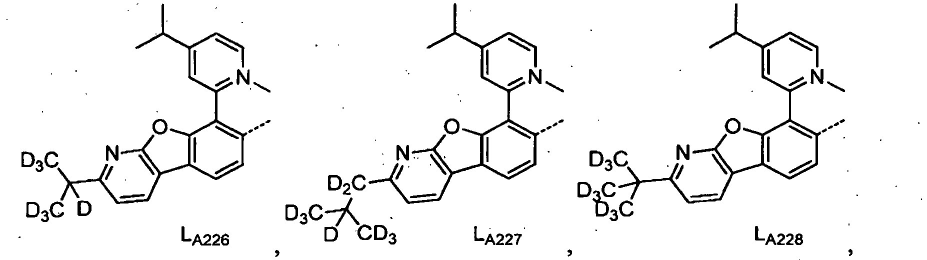

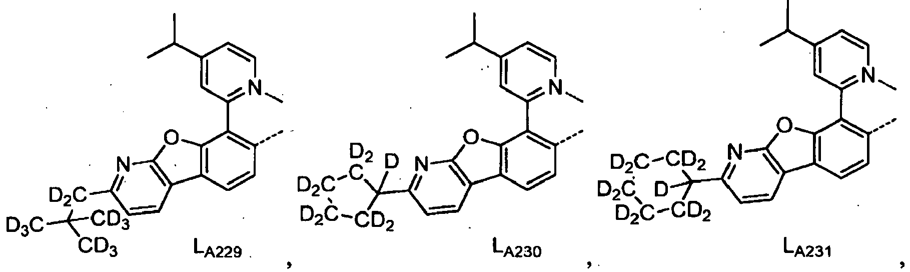

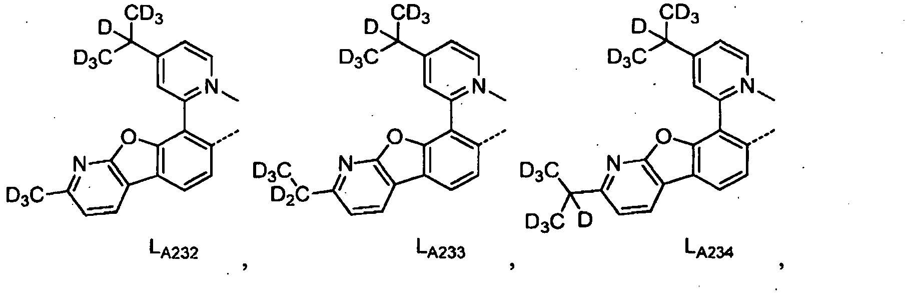

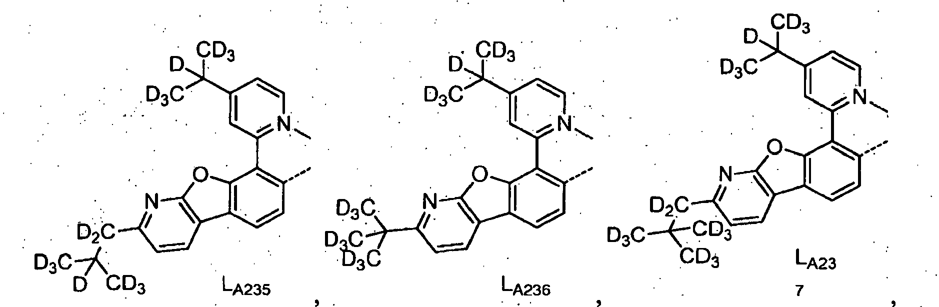

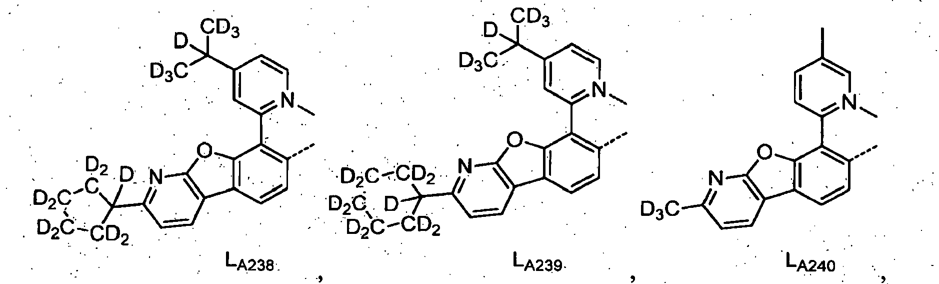

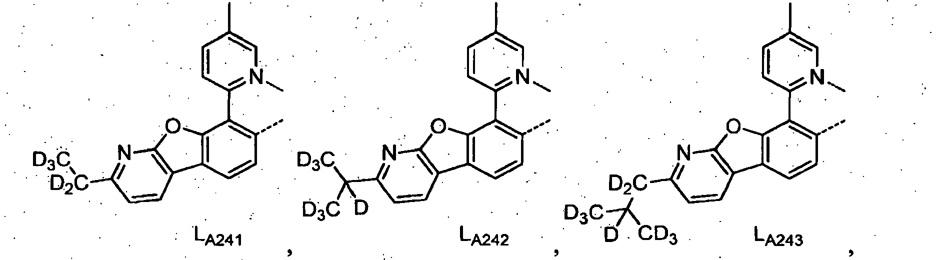

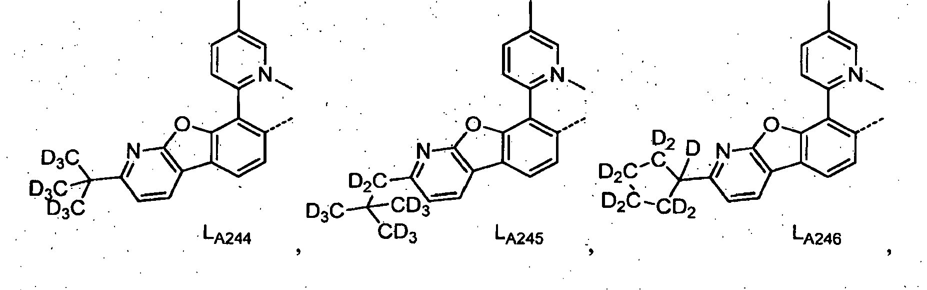

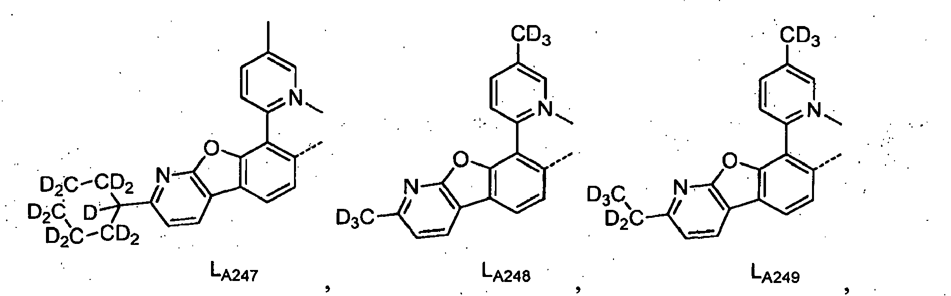

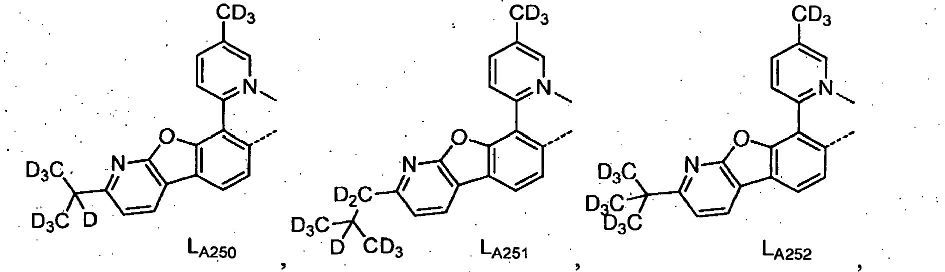

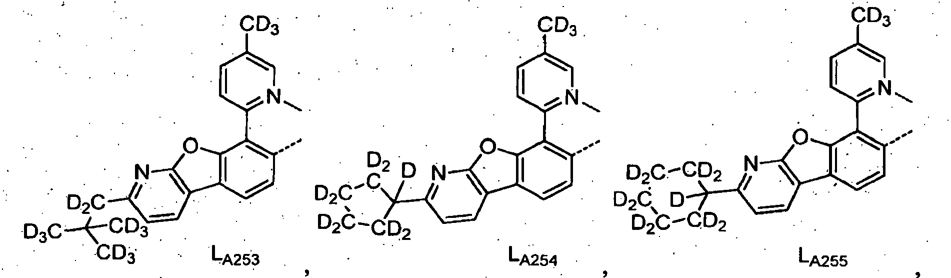

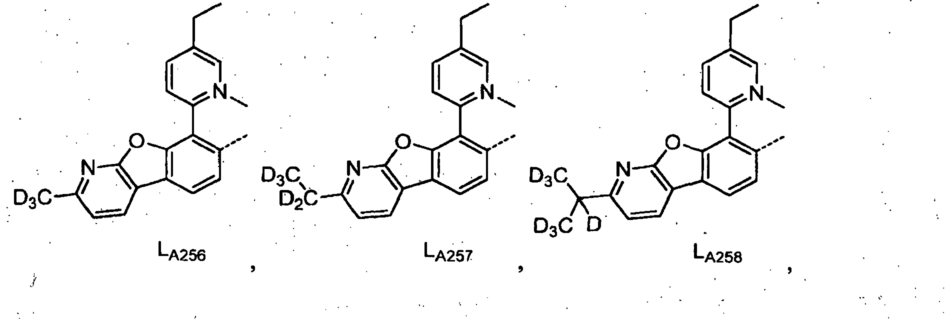

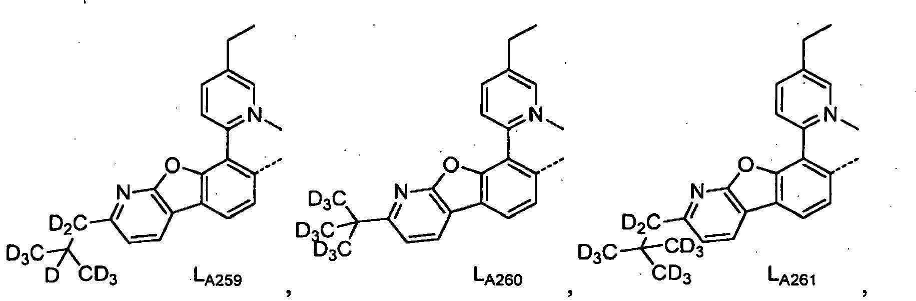

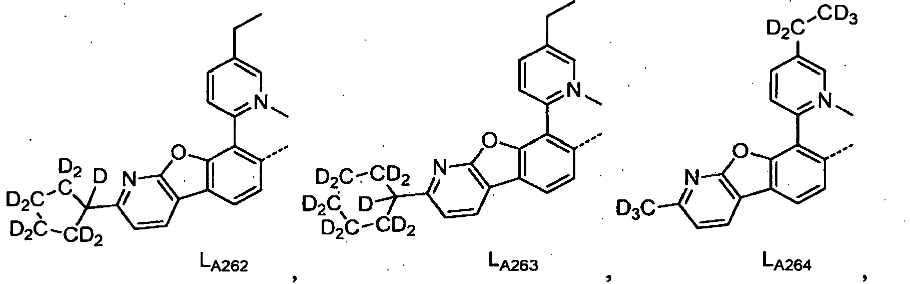

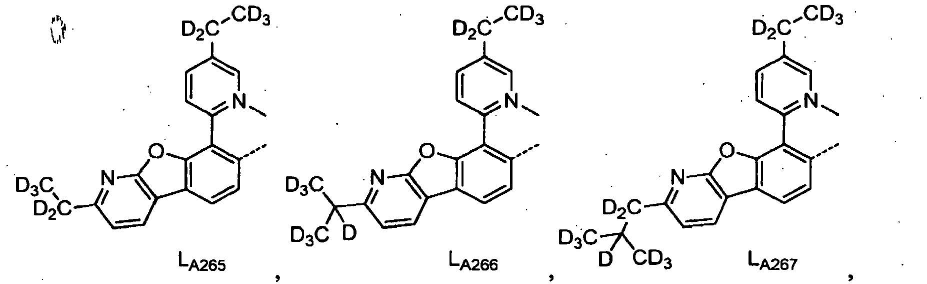

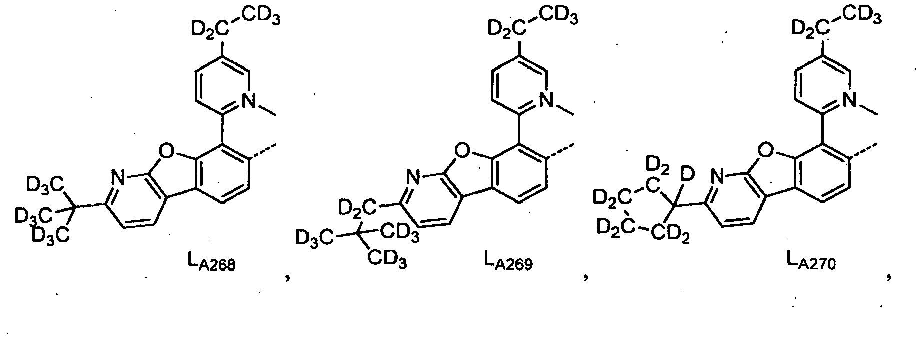

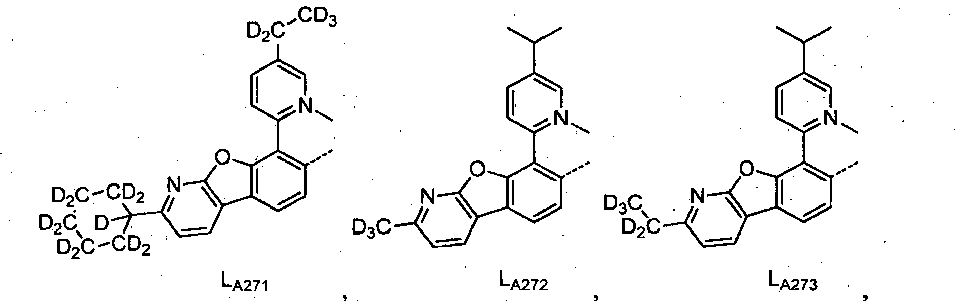

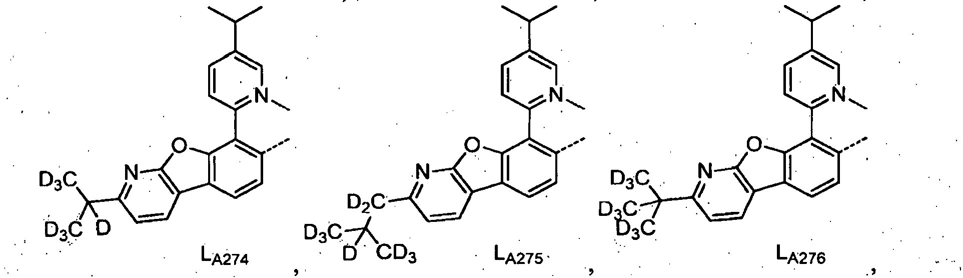

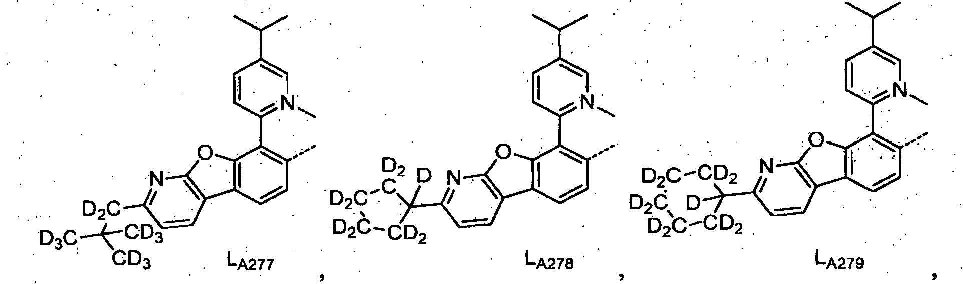

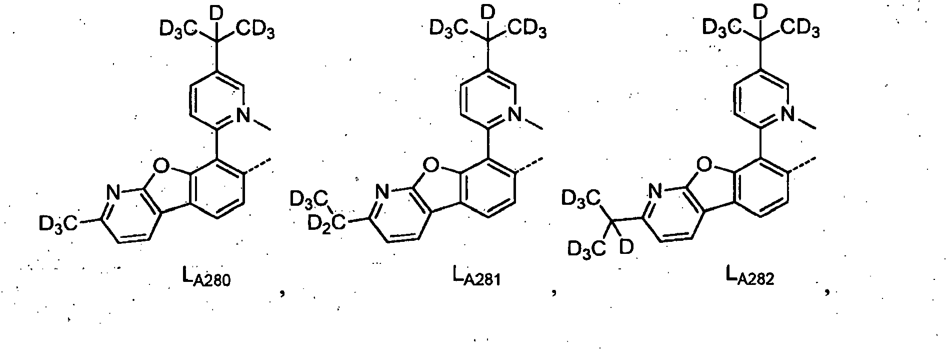

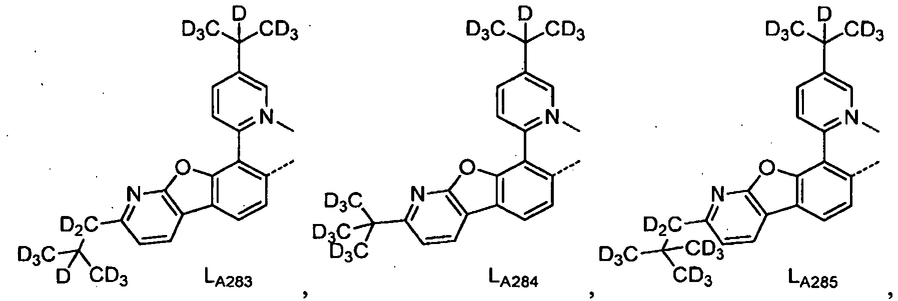

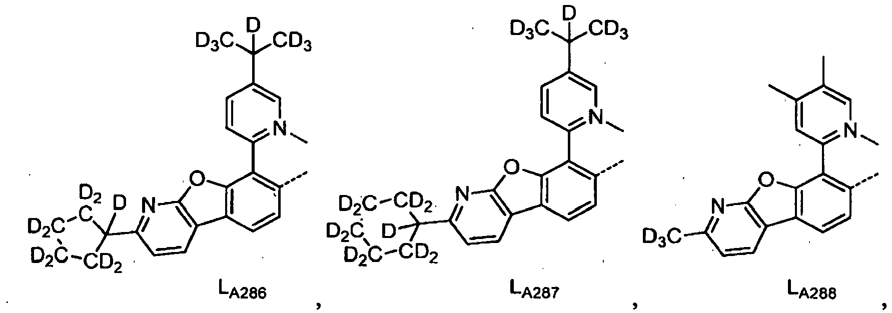

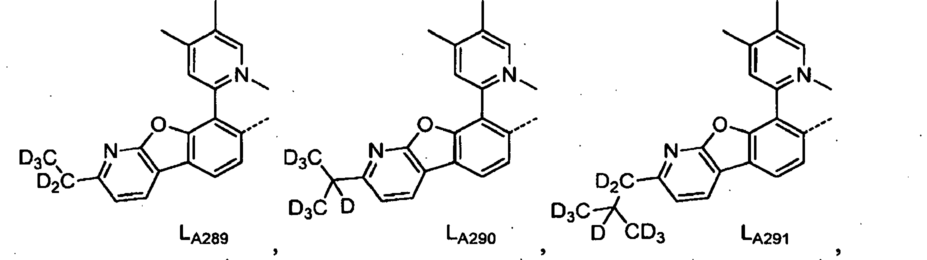

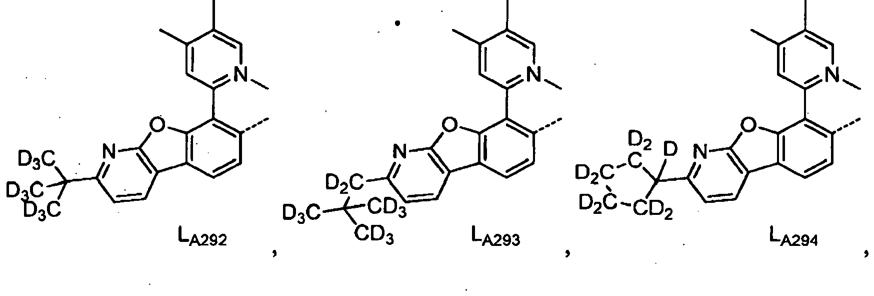

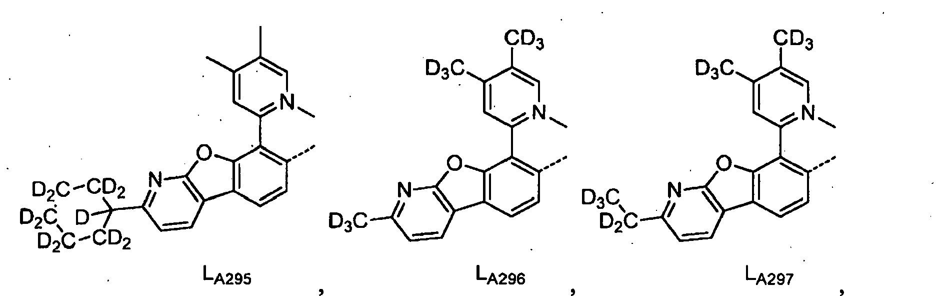

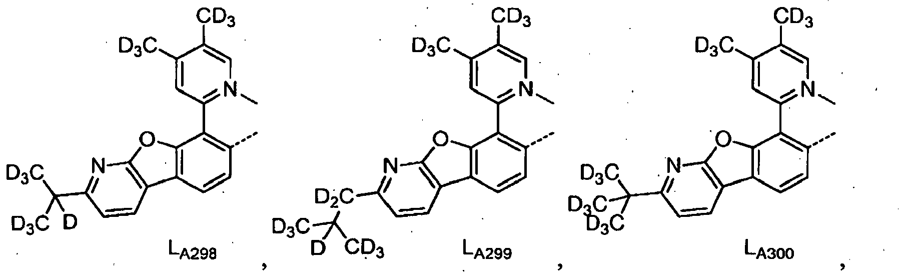

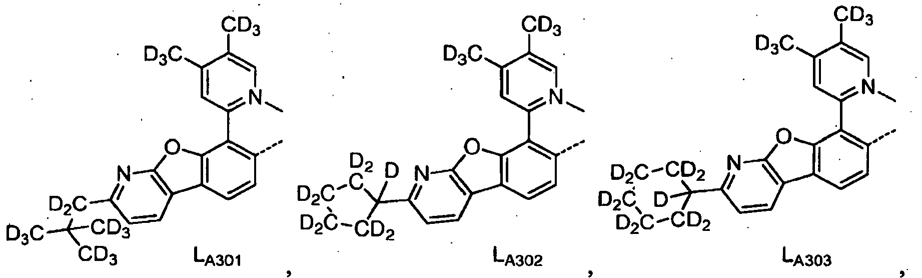

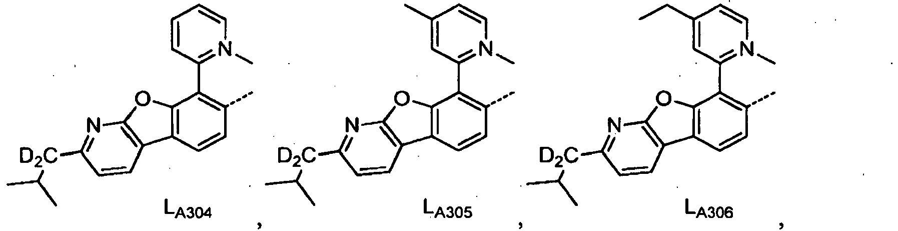

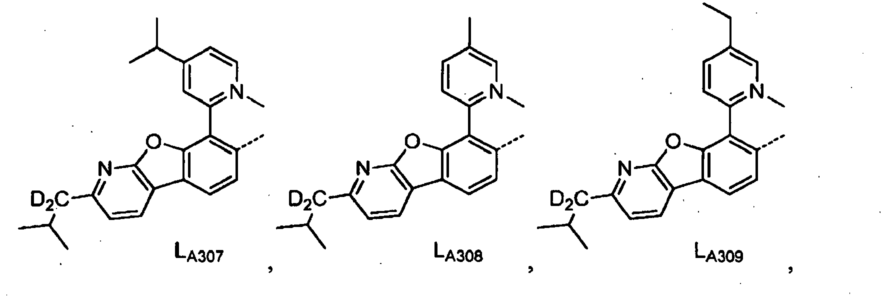

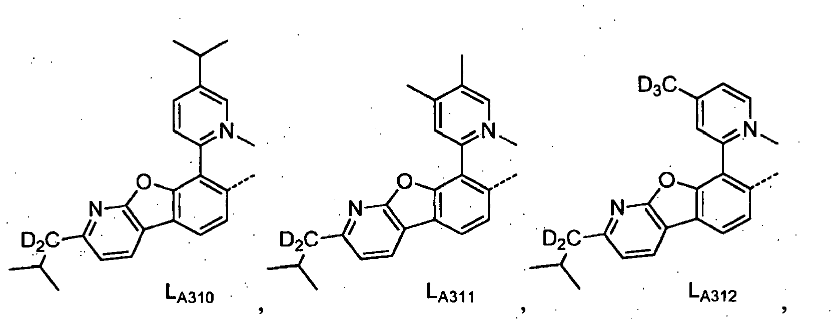

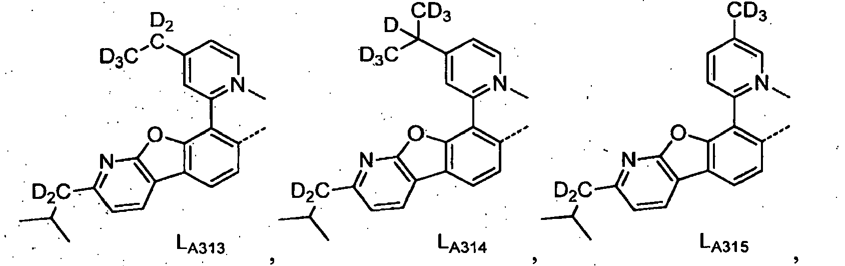

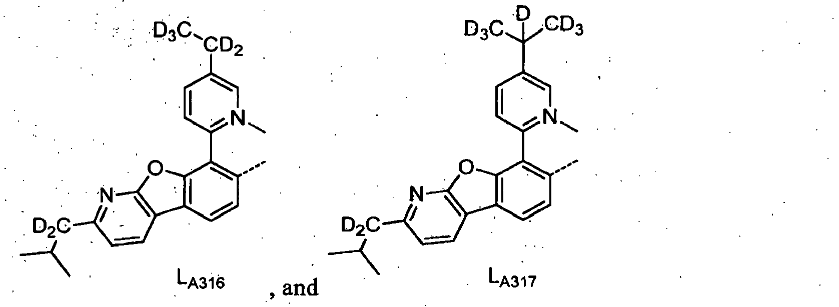

17. The compound of claim 14, wherein L_{B} is selected from the group consisting of:

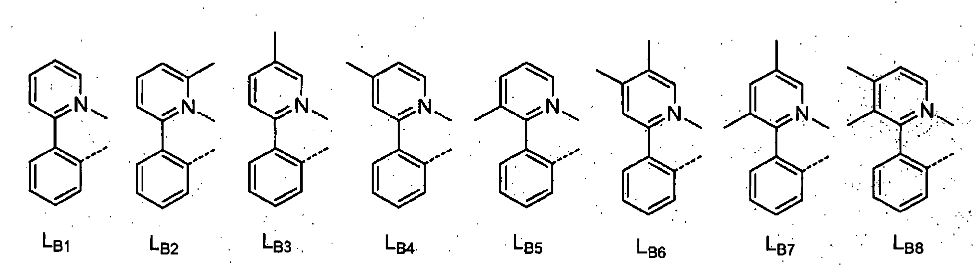

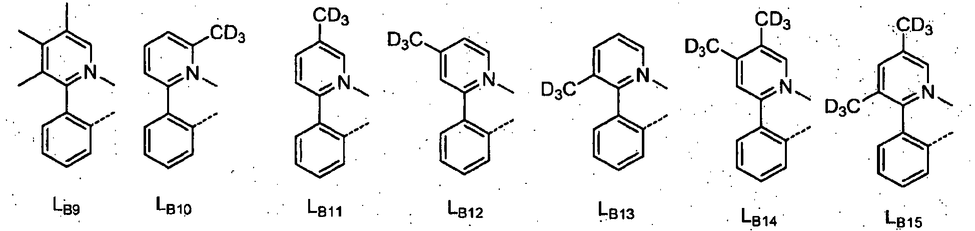

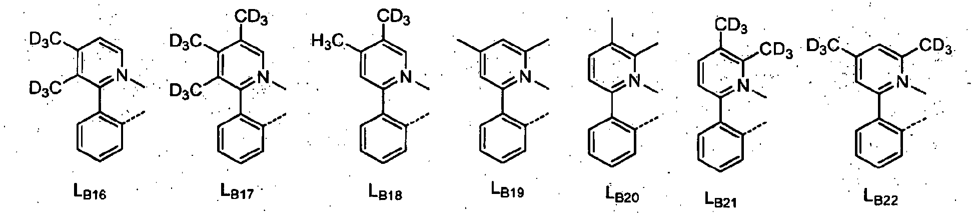

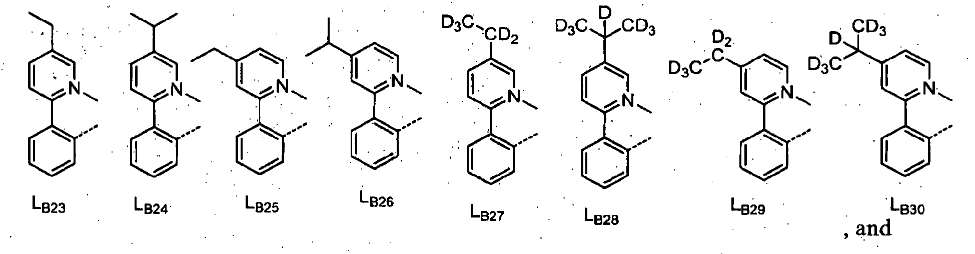

18. The compound of claim 14, wherein the compound is selected from the group consisting of: 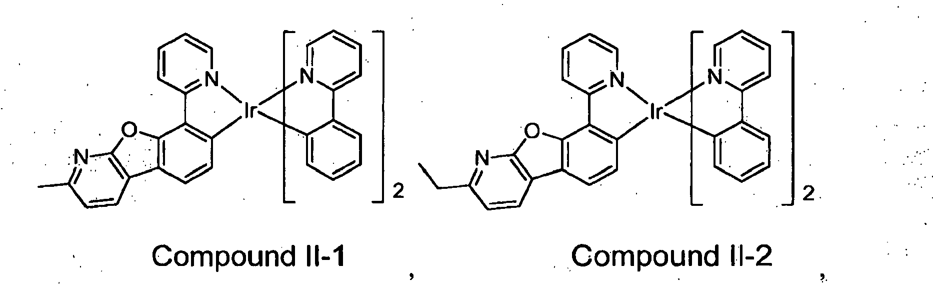 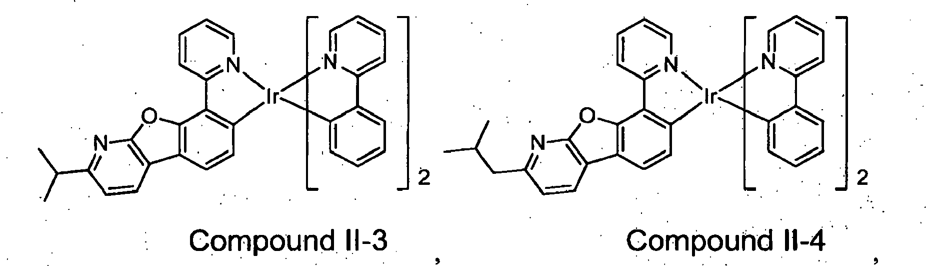 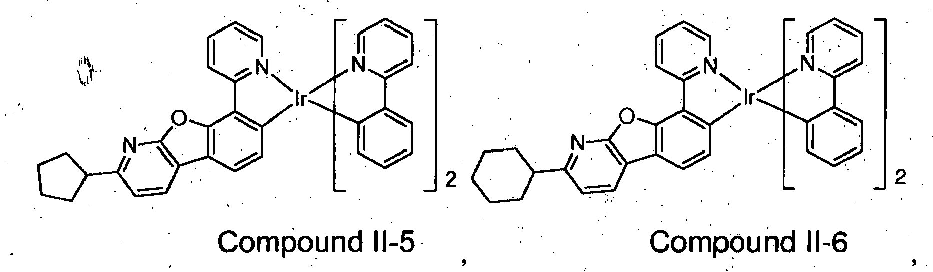 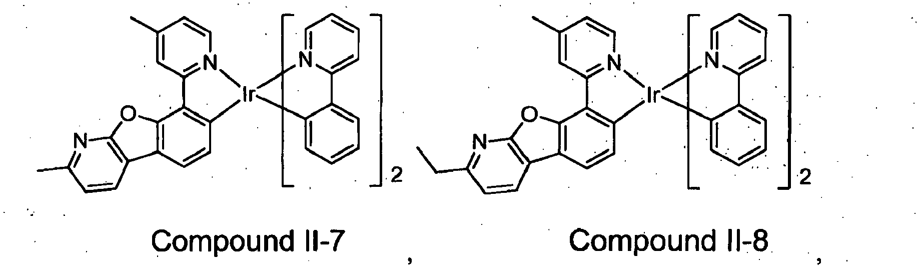 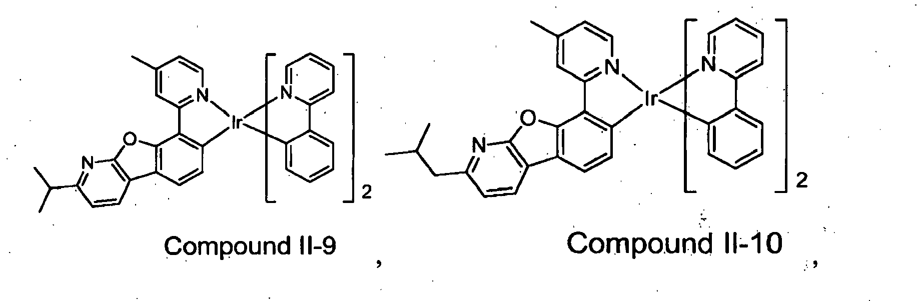 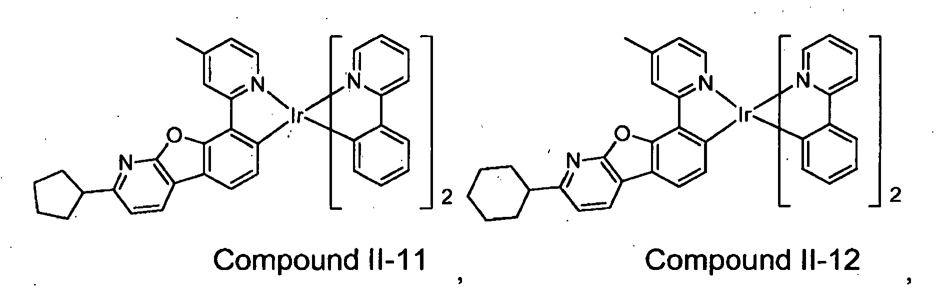 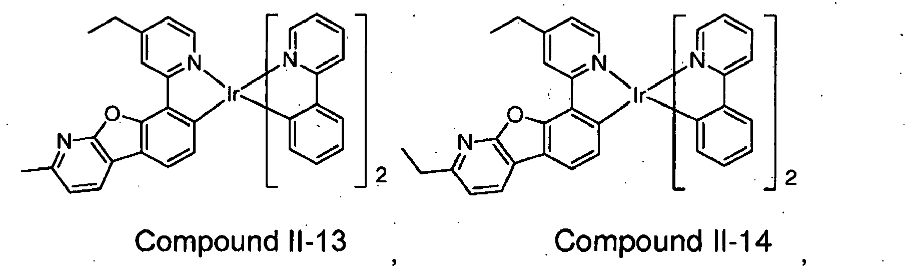 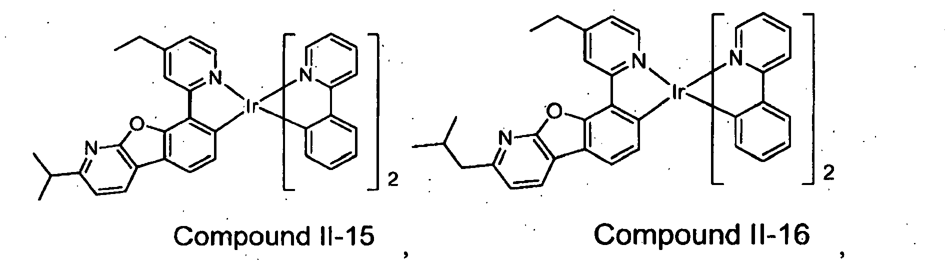 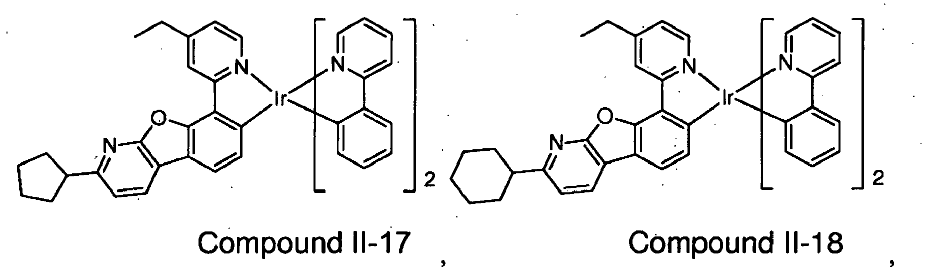 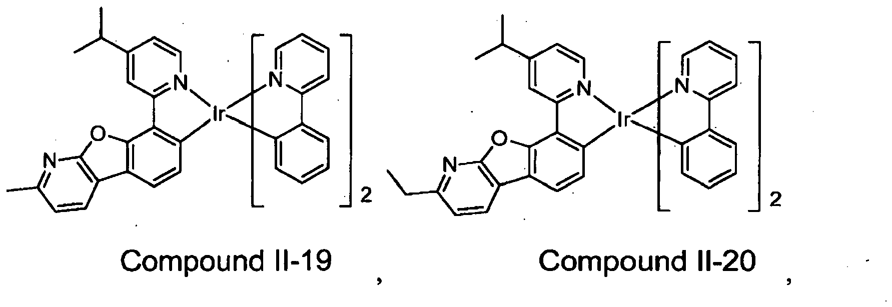 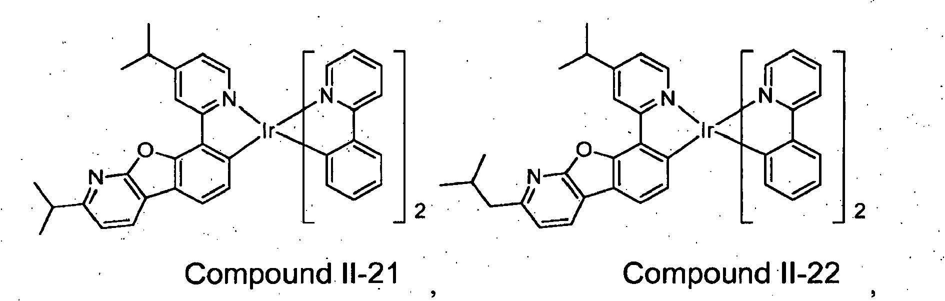 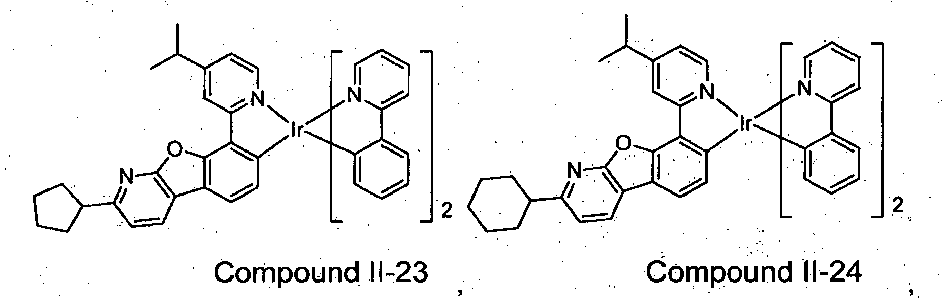 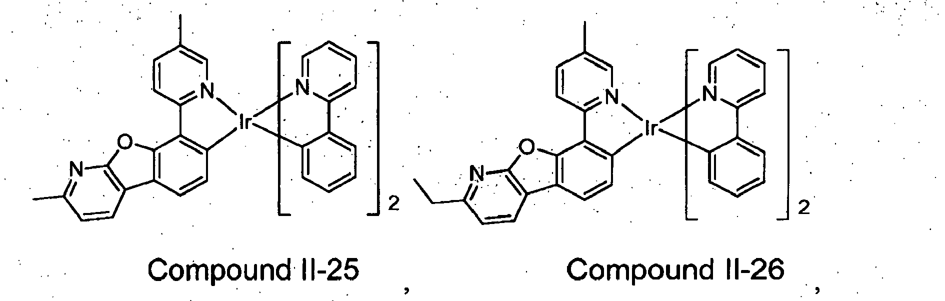 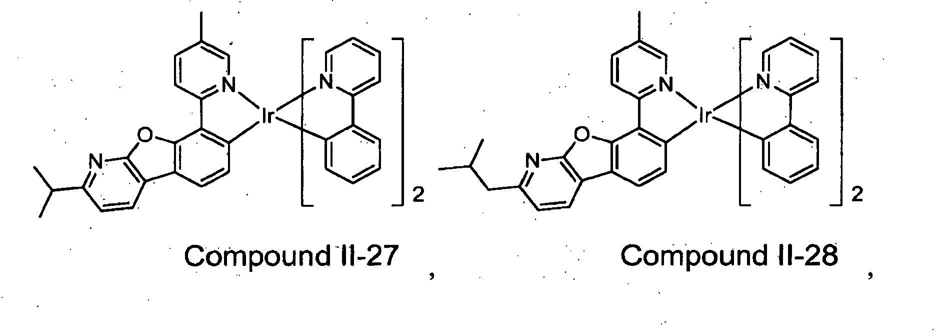 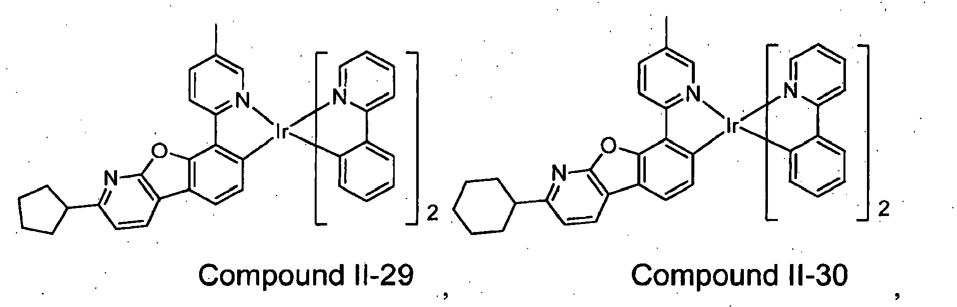 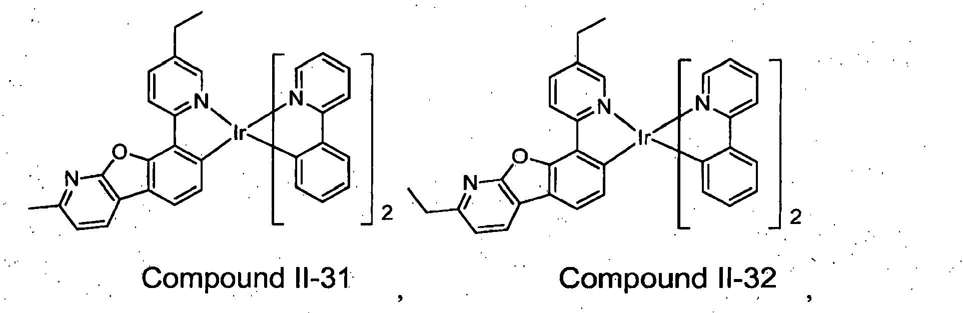 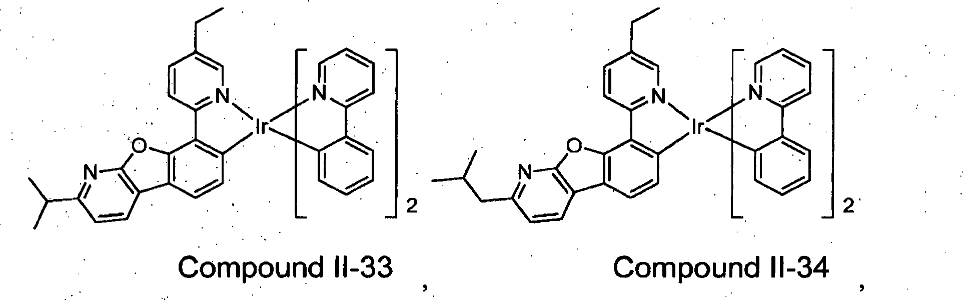 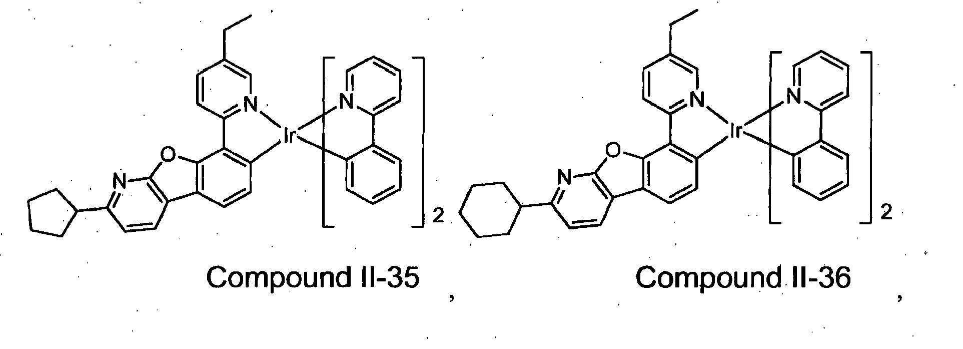 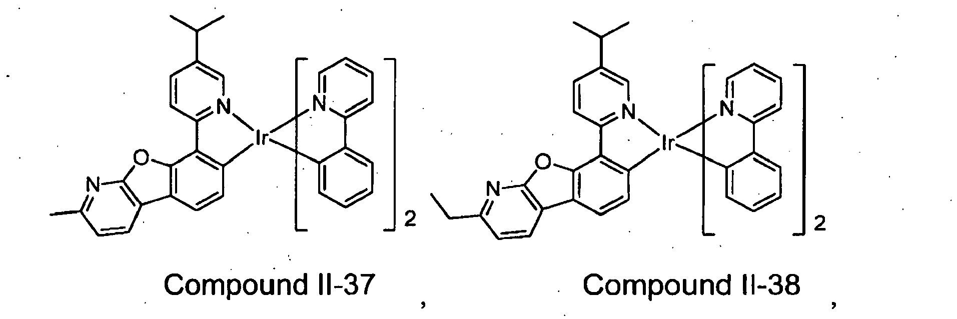 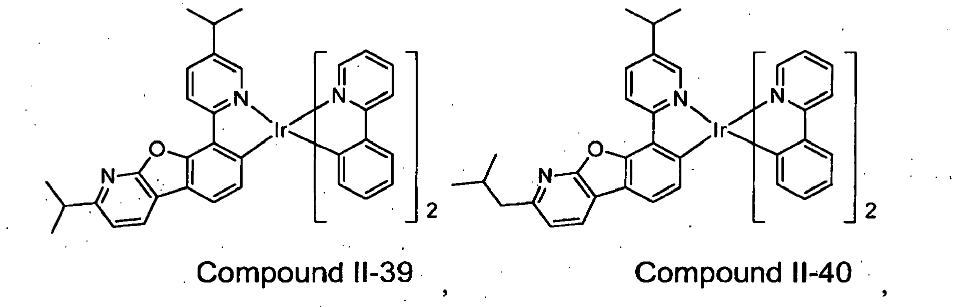 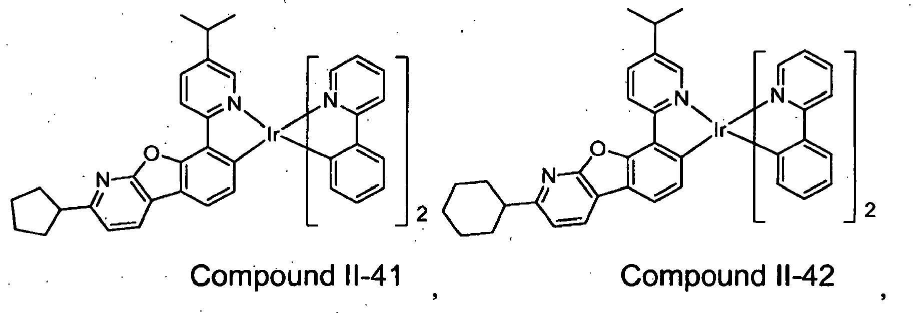 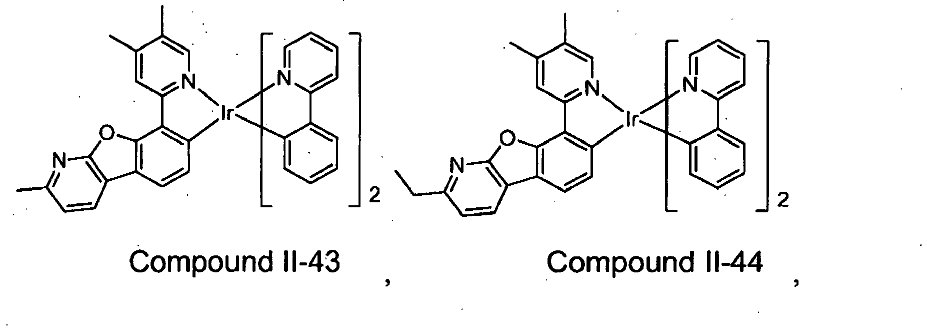 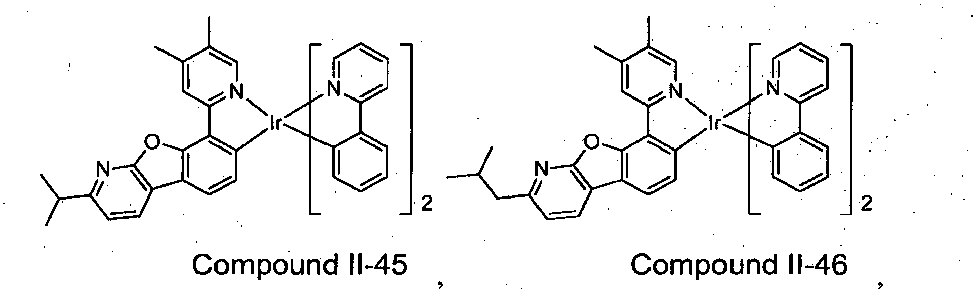 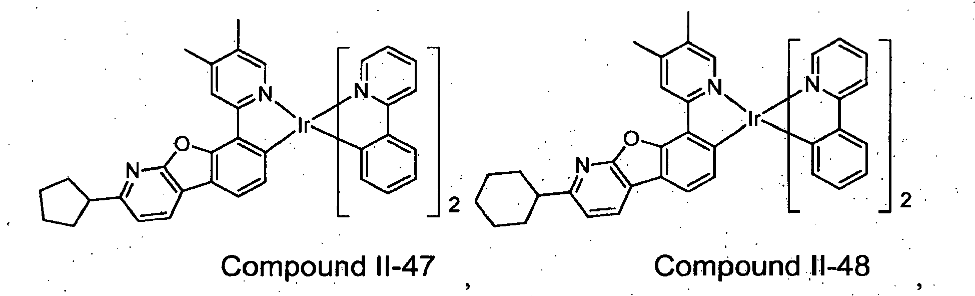 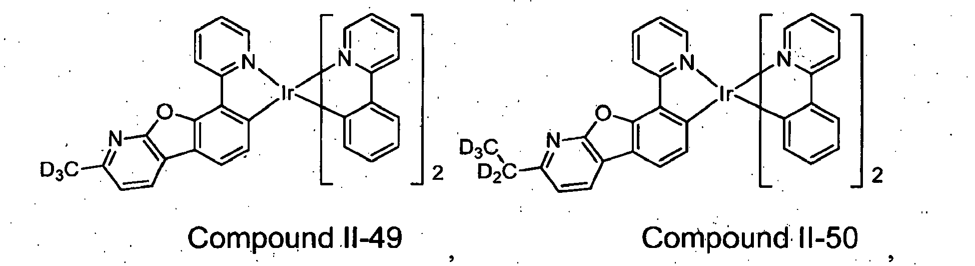 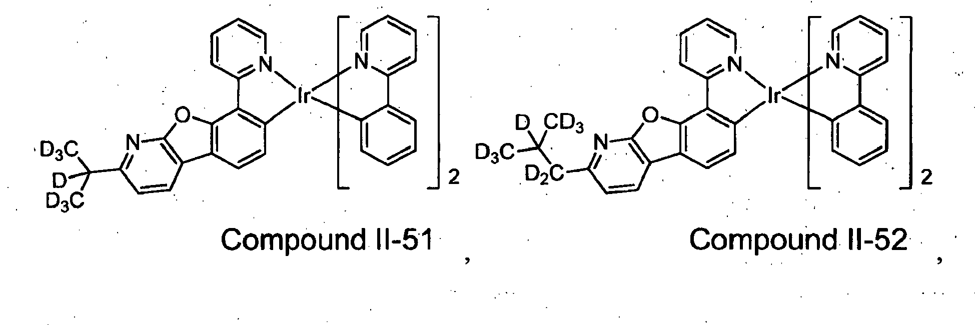 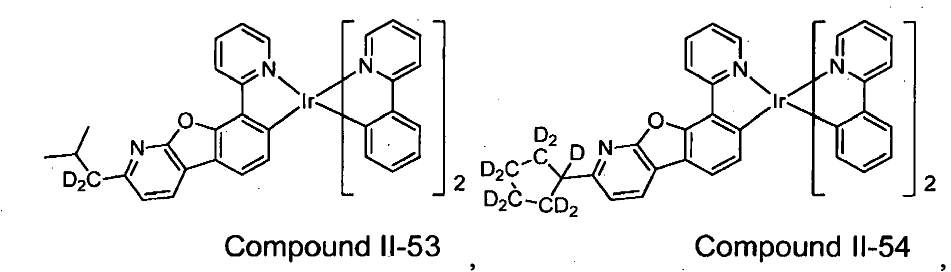 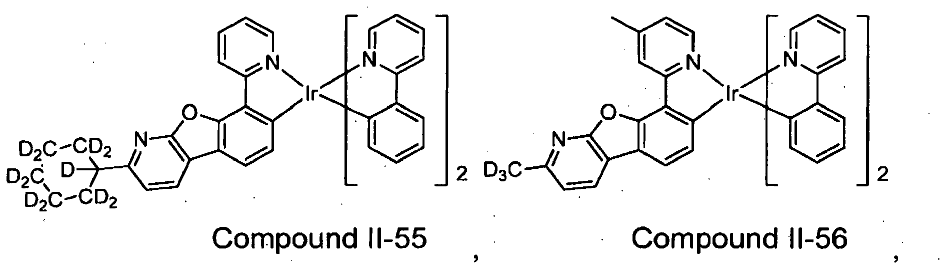 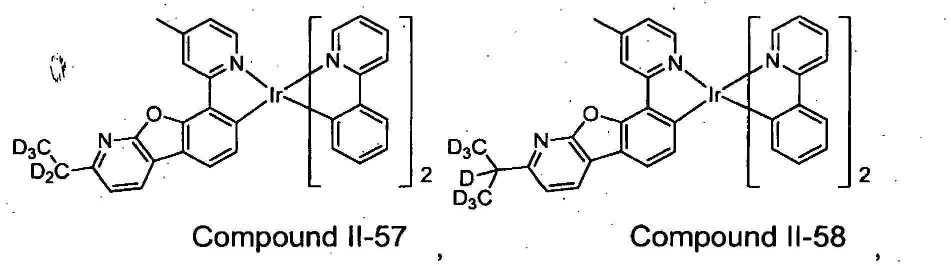 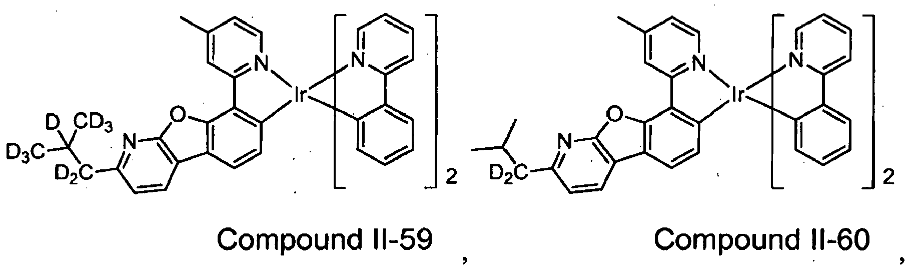 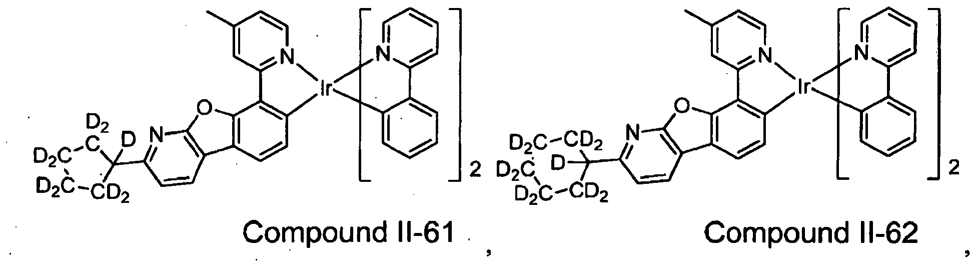 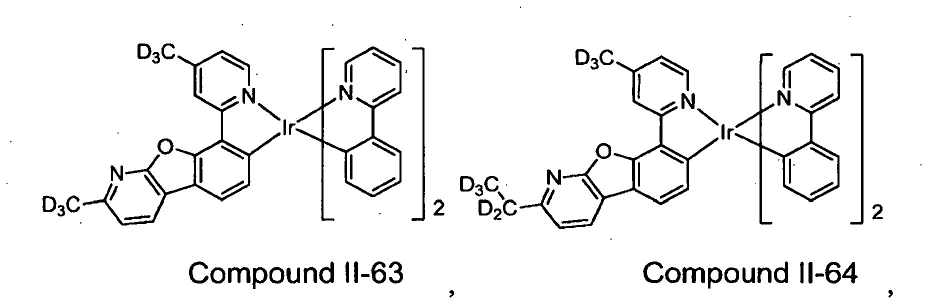 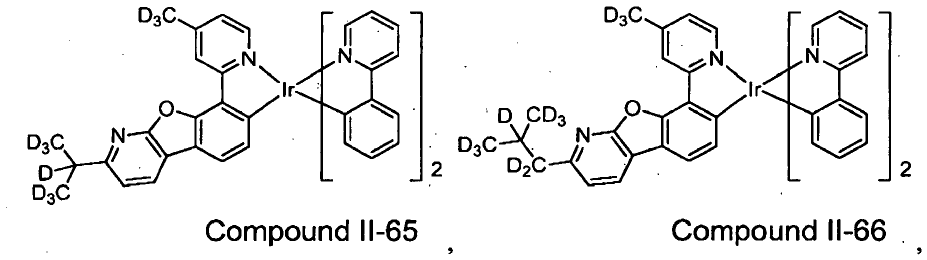 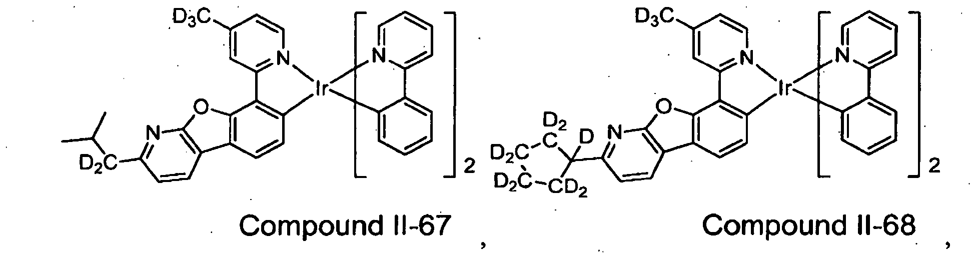 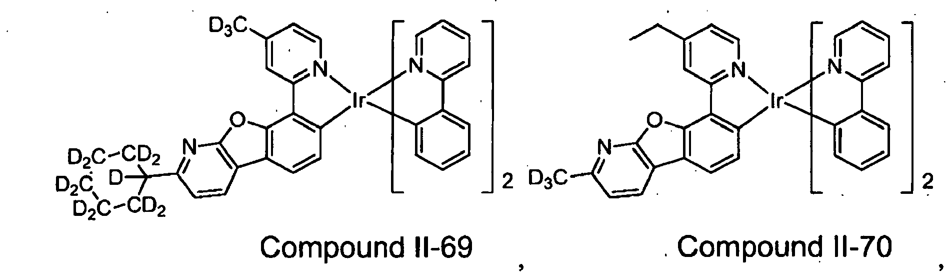 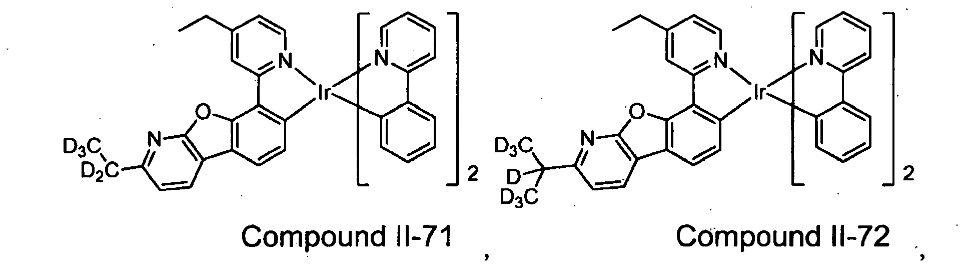 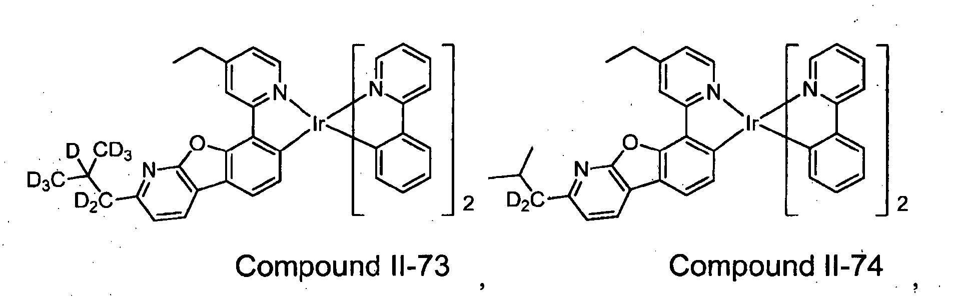 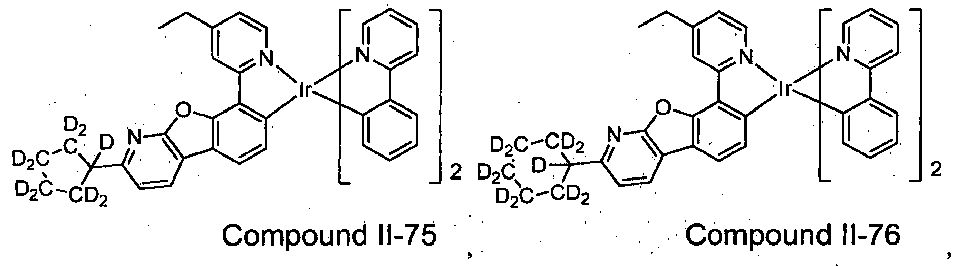 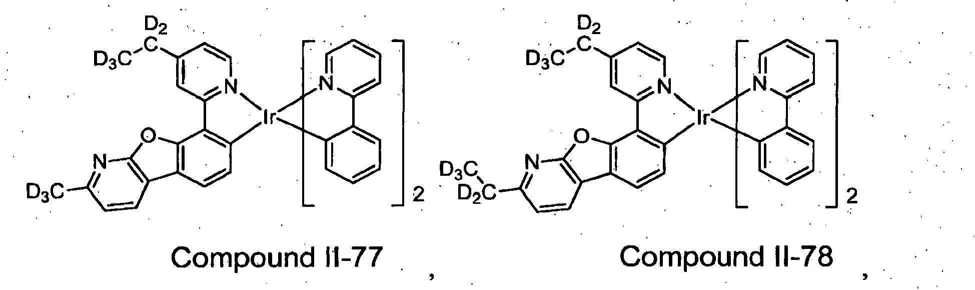 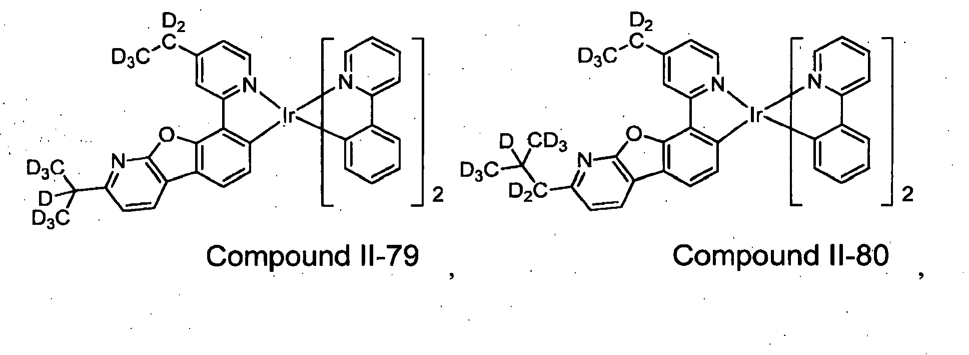 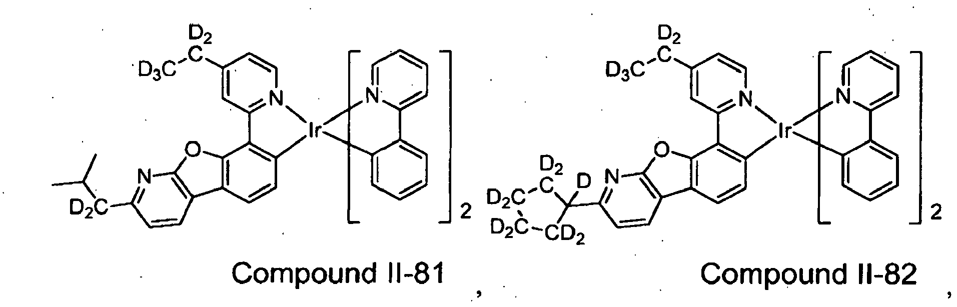 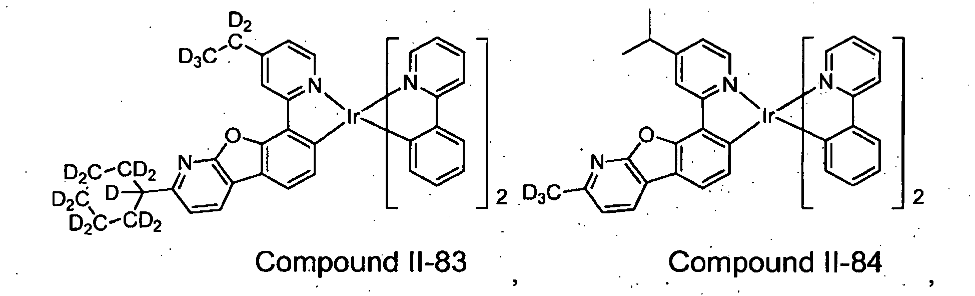 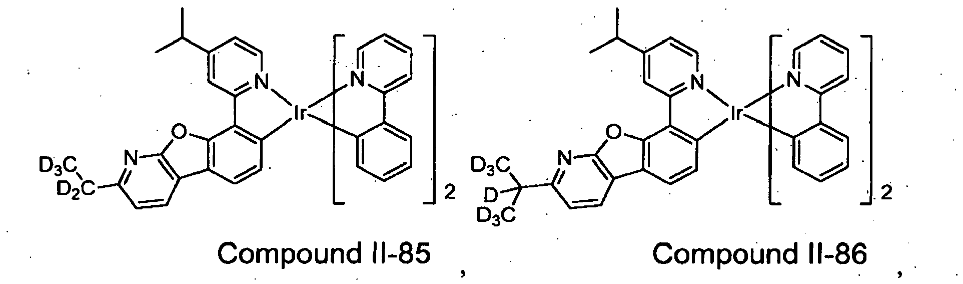 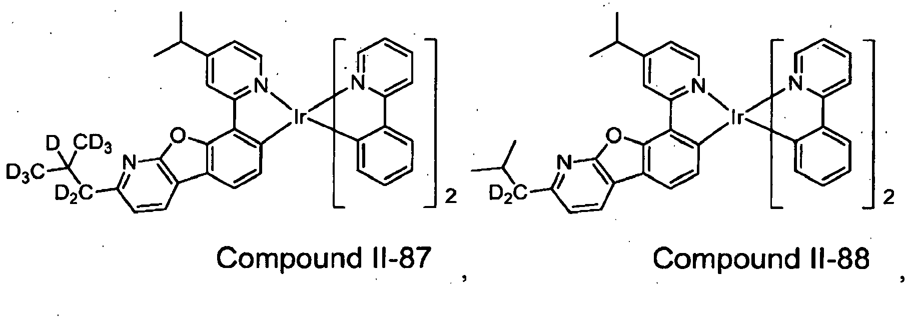 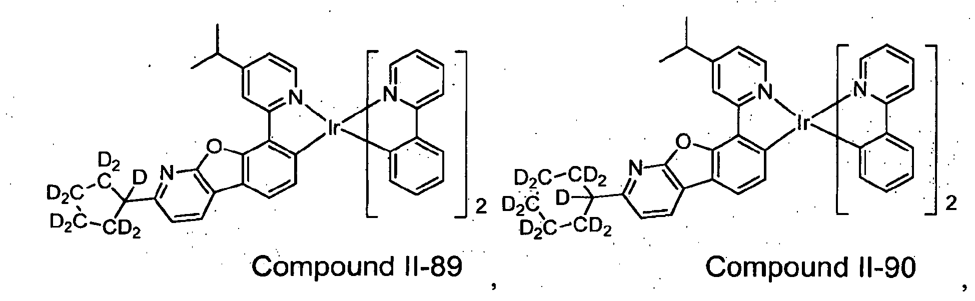 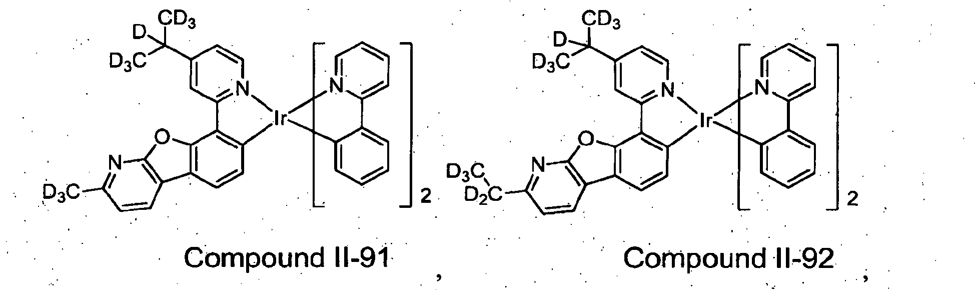 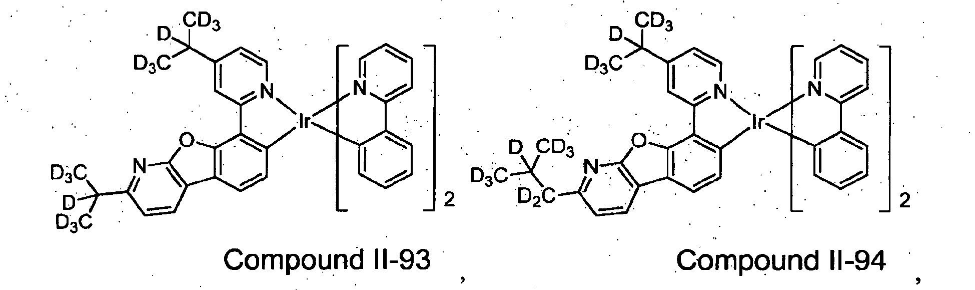 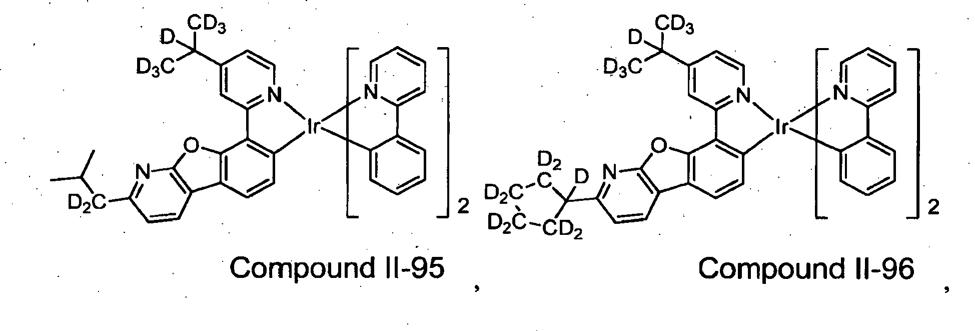 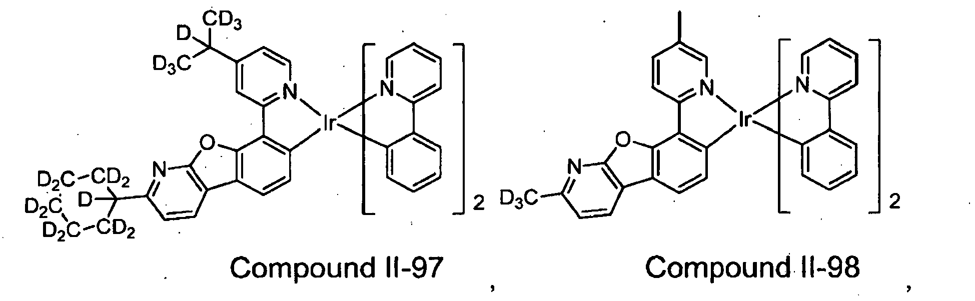 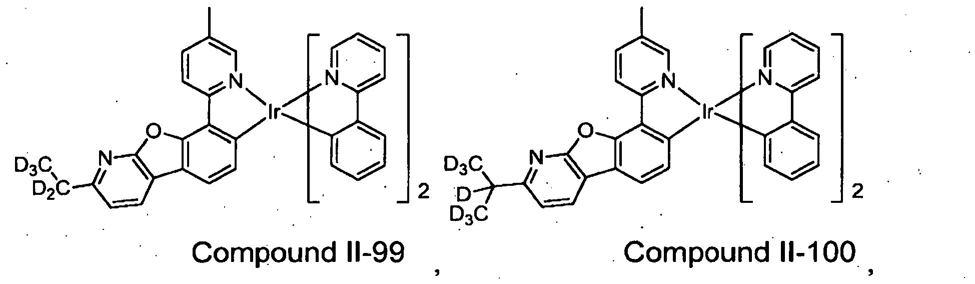 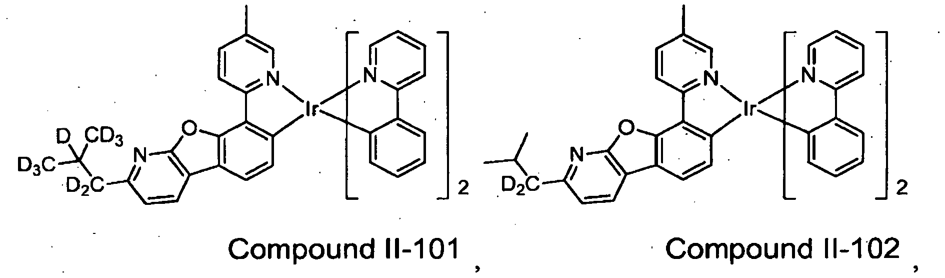 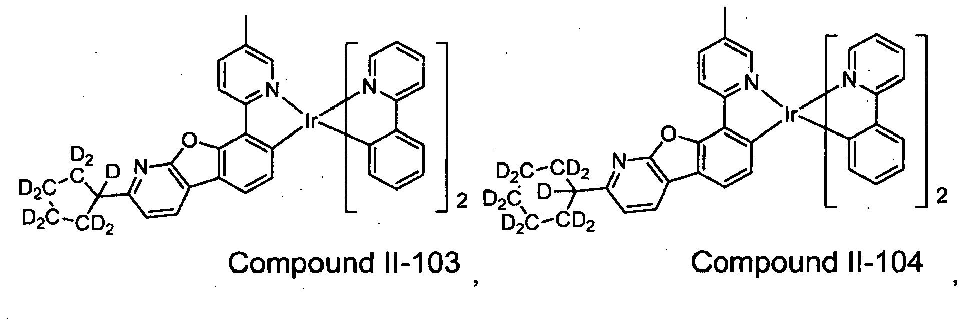 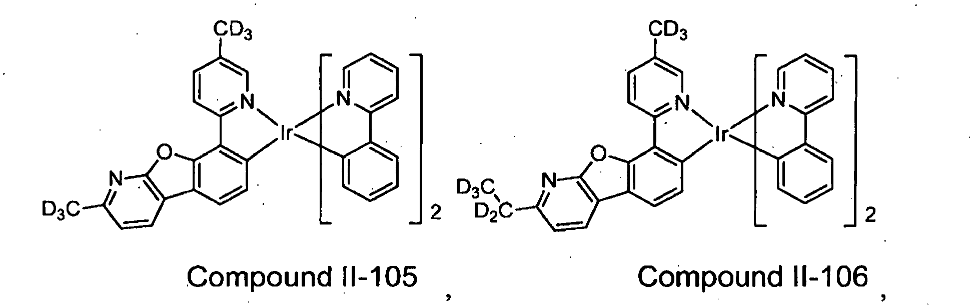 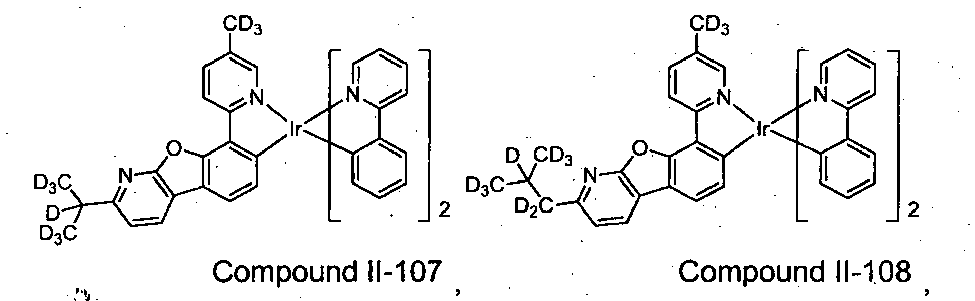 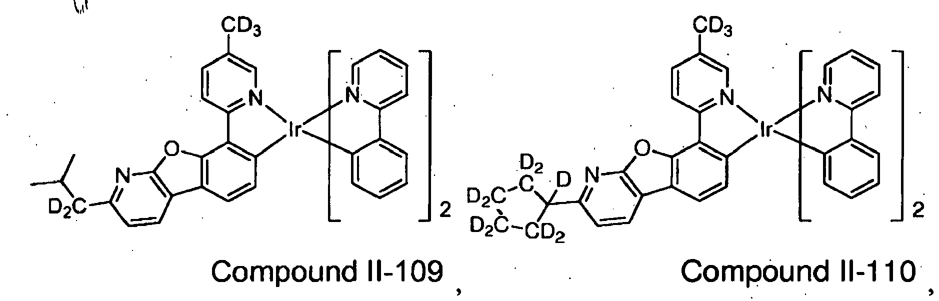 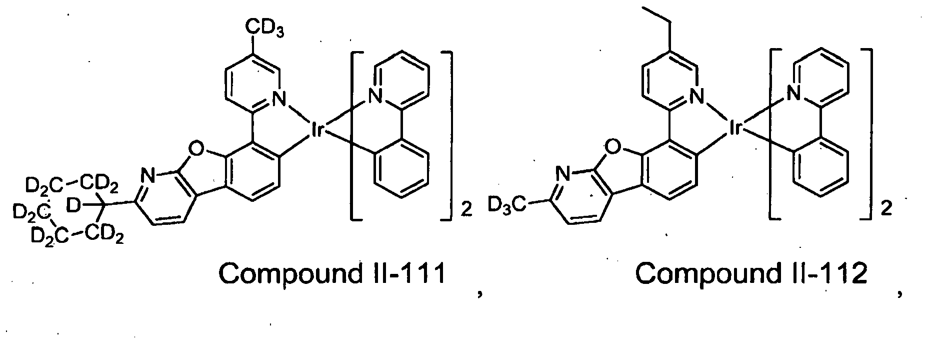 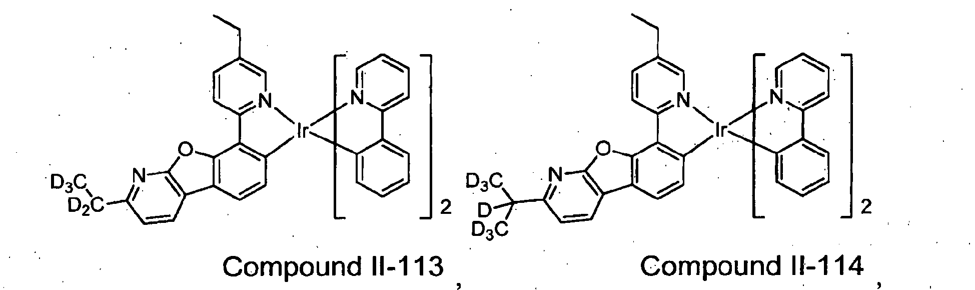 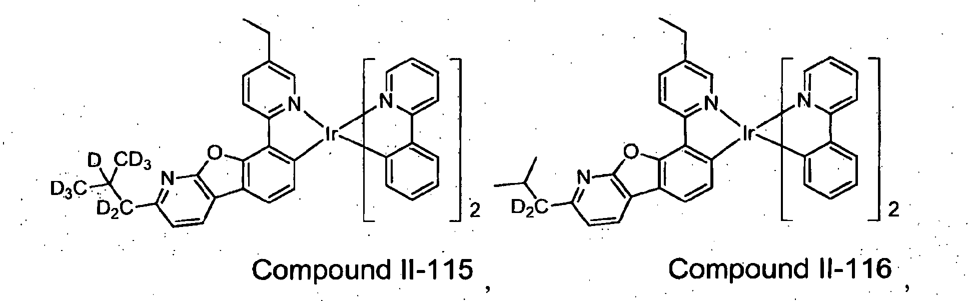 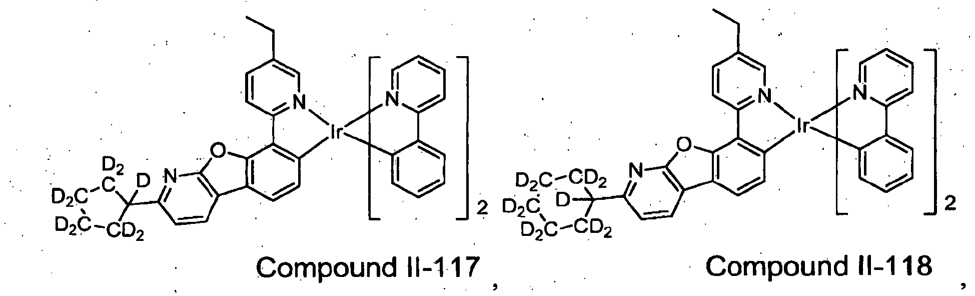 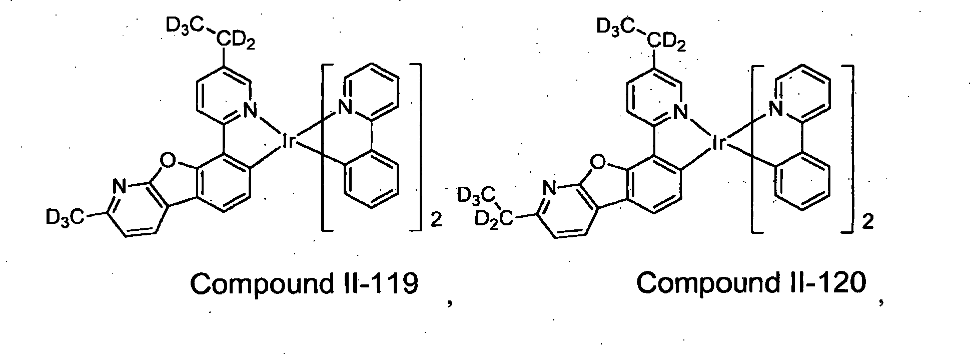 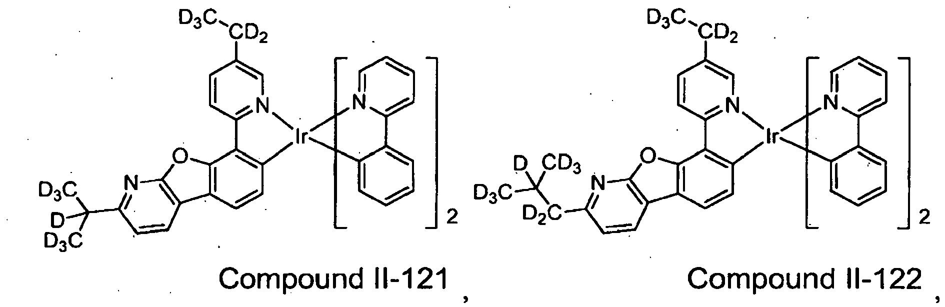 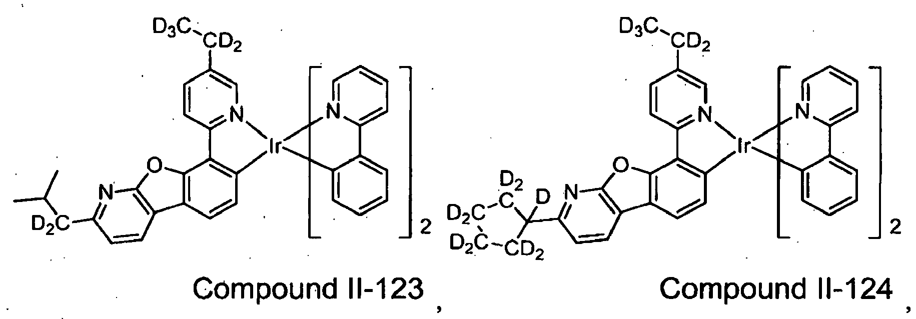 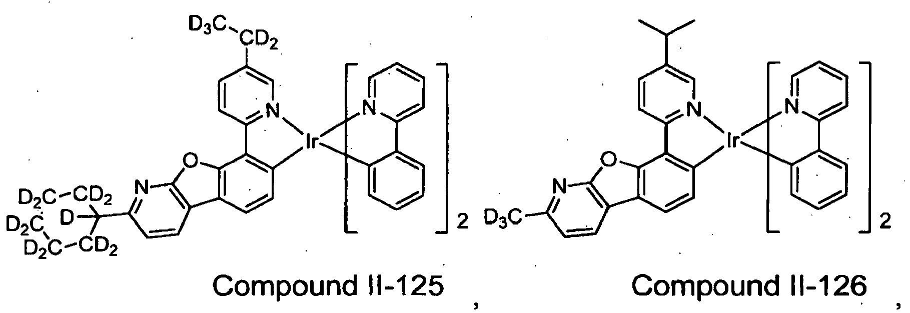 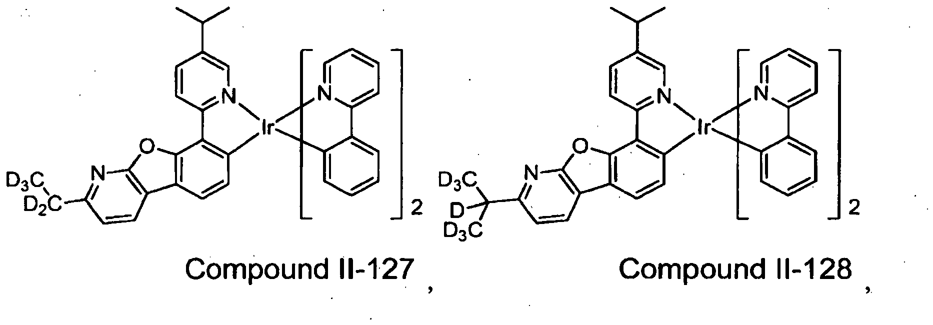 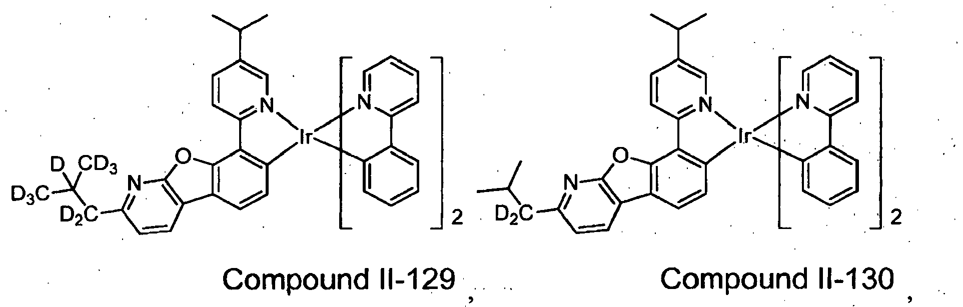 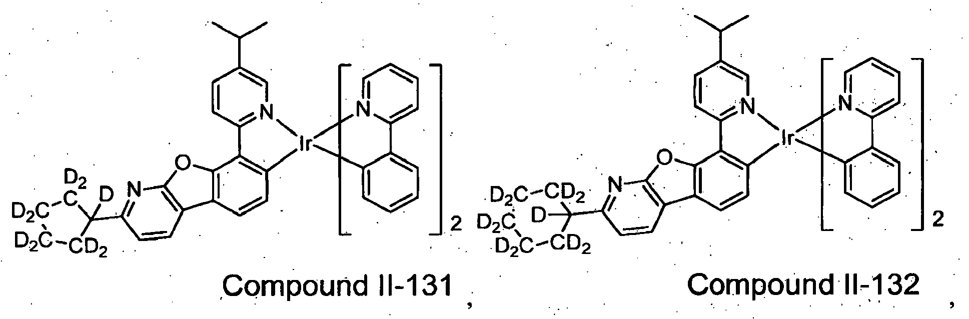 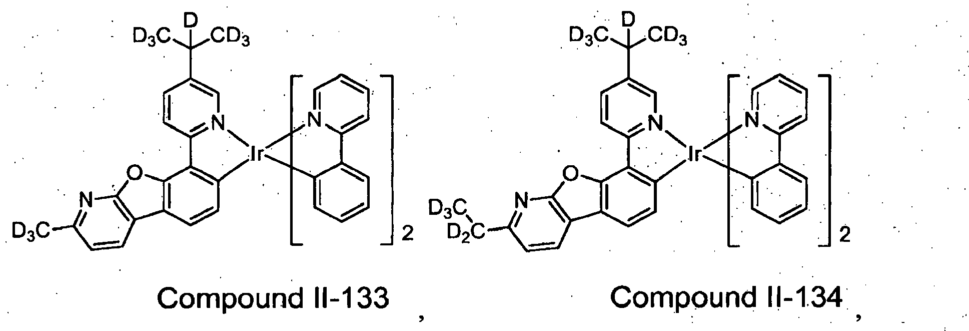 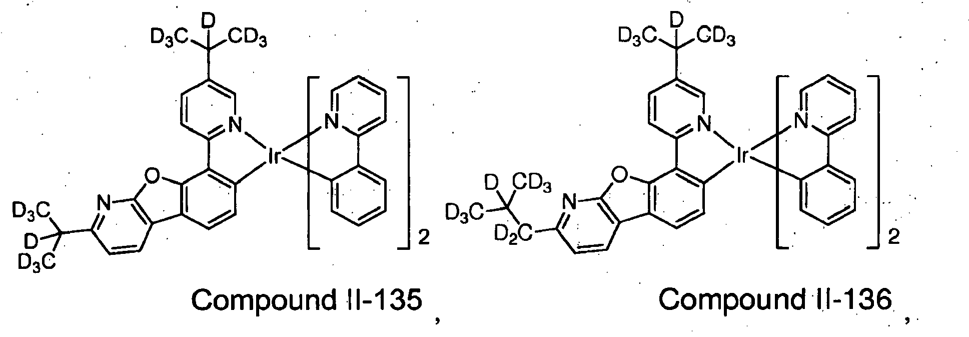 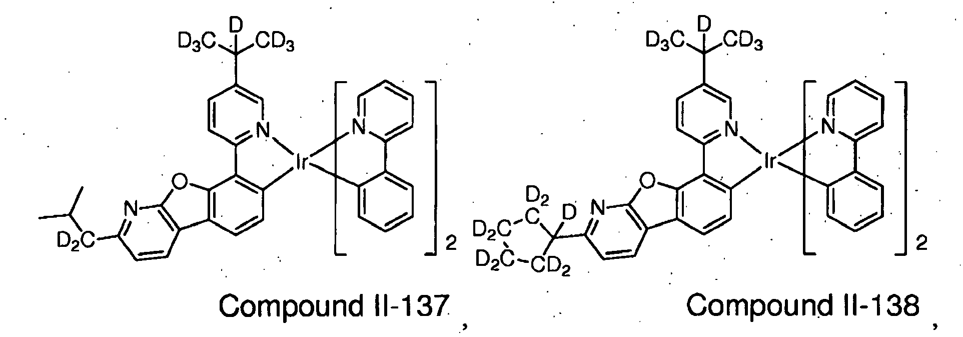 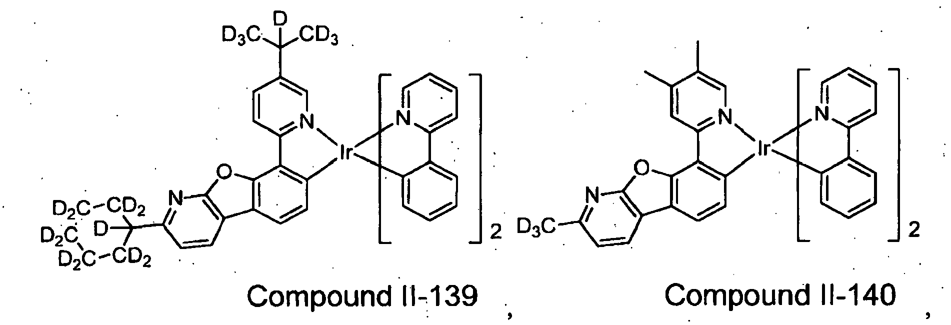 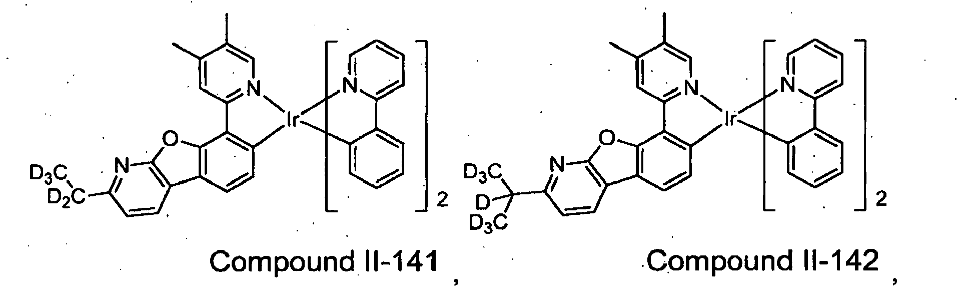 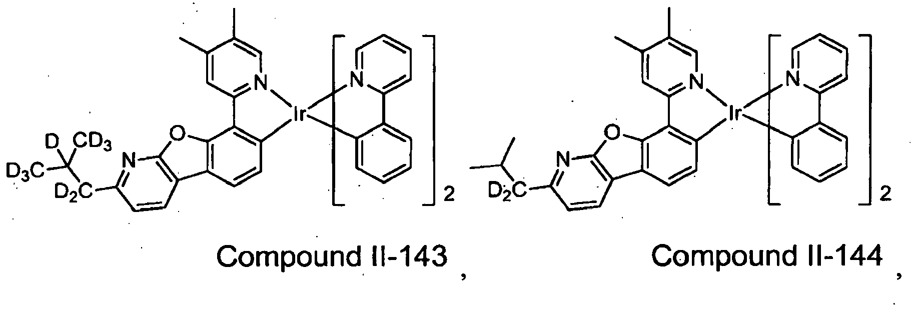 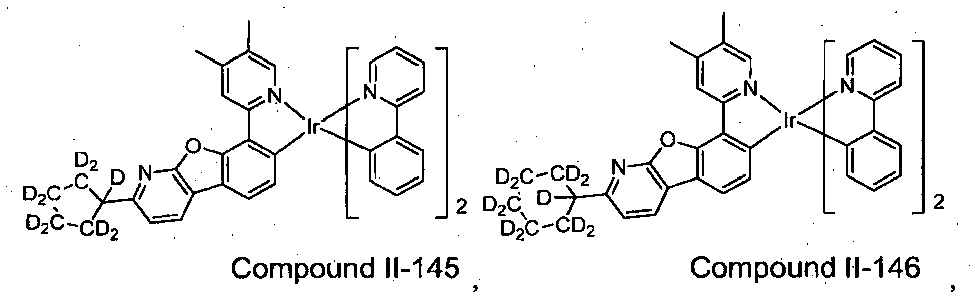 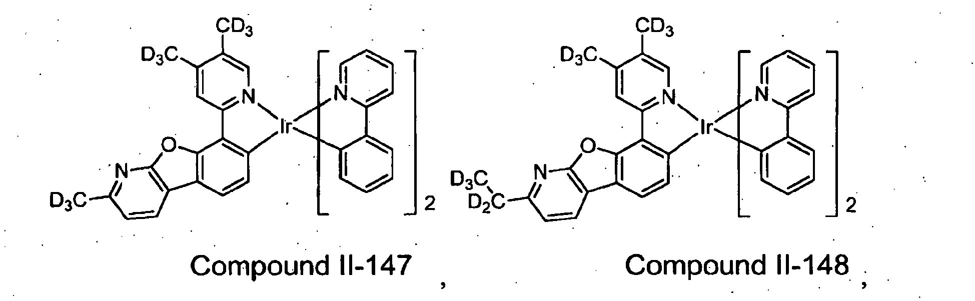 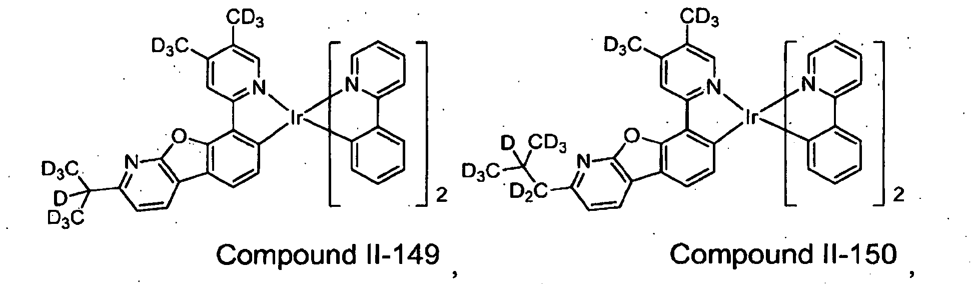 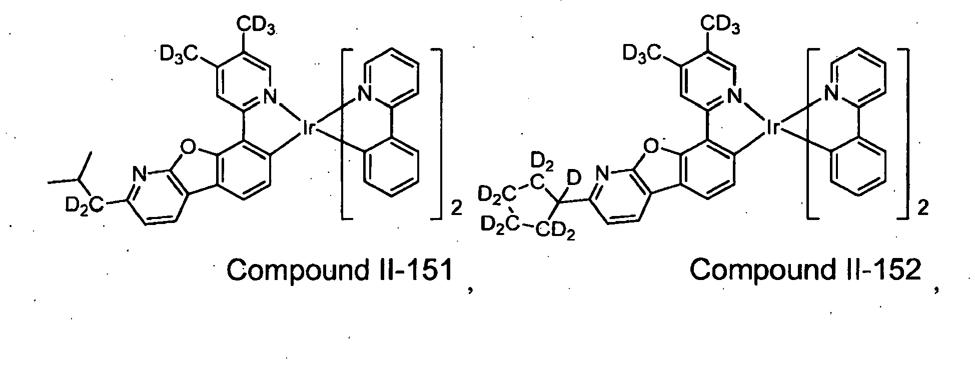 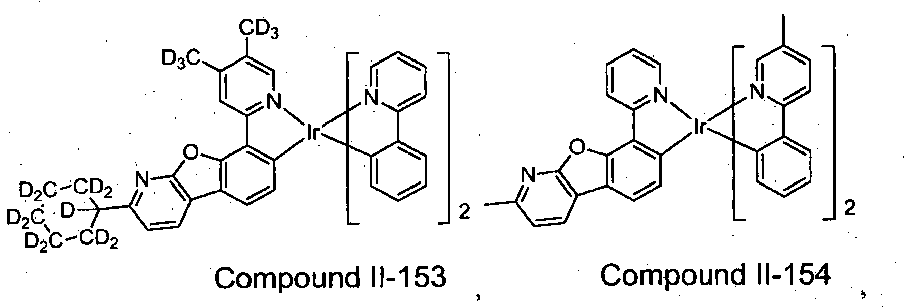 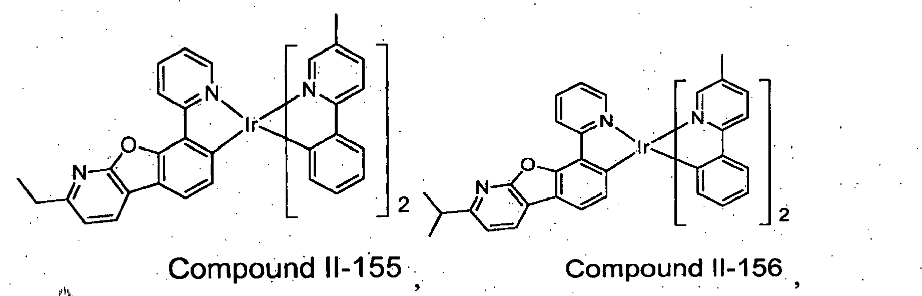 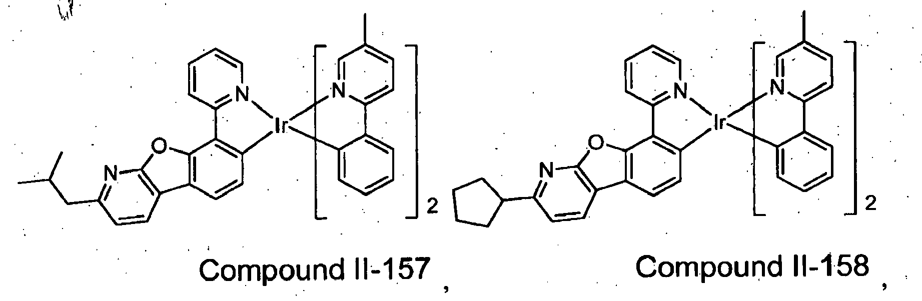 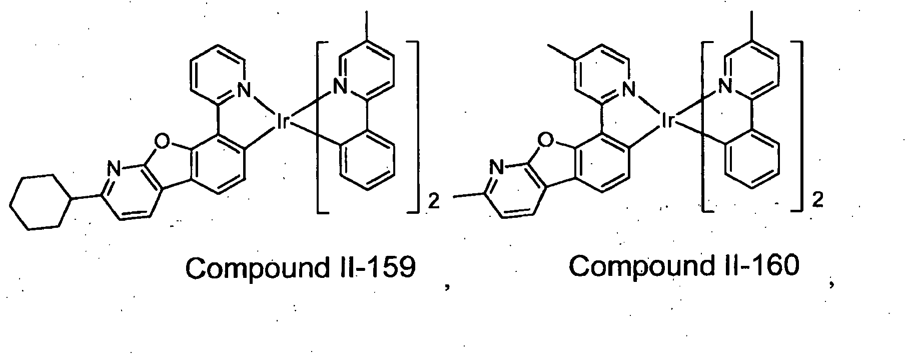 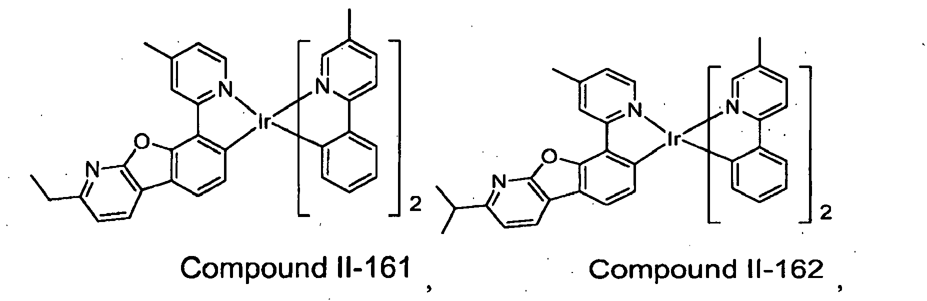 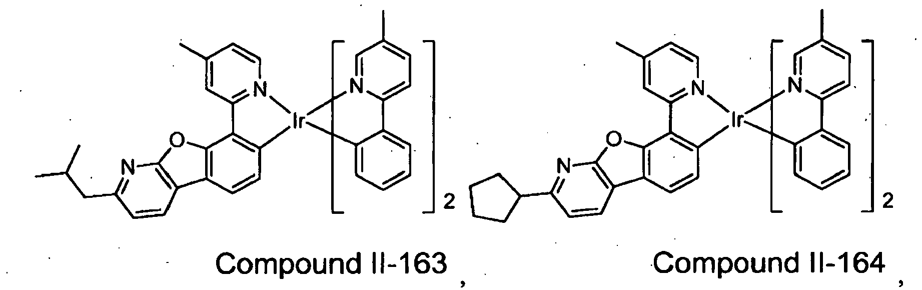 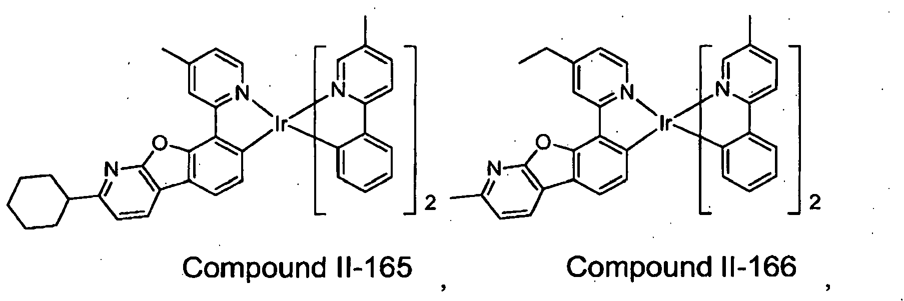 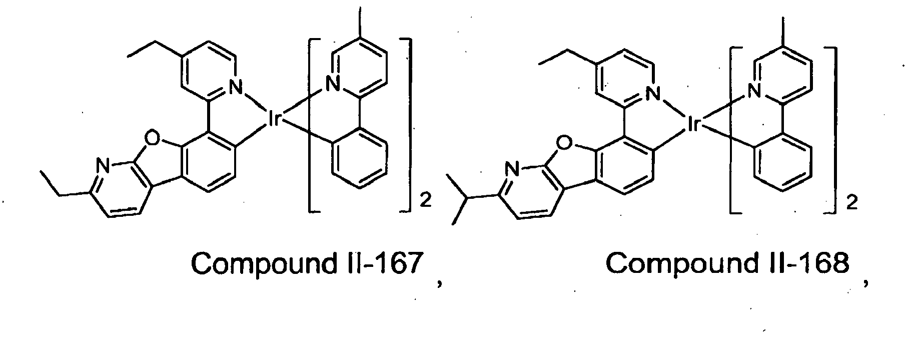 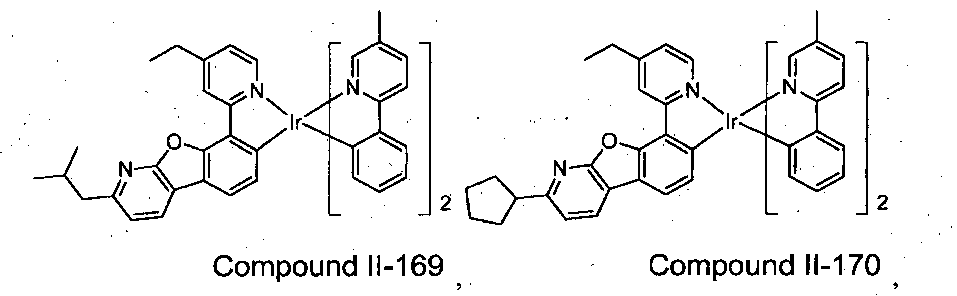 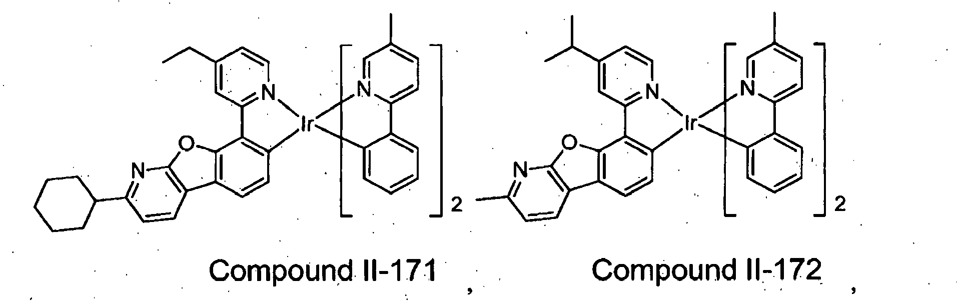 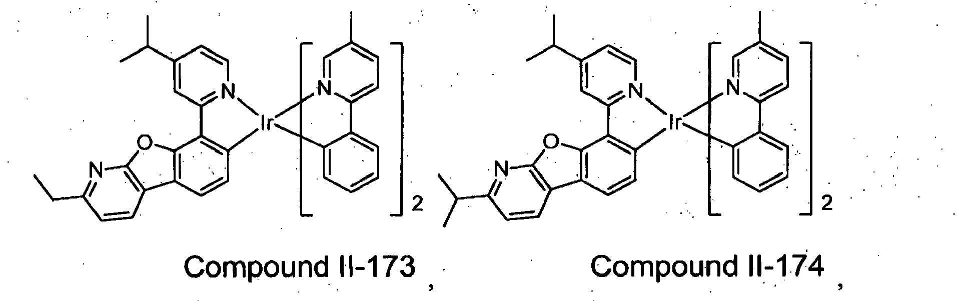 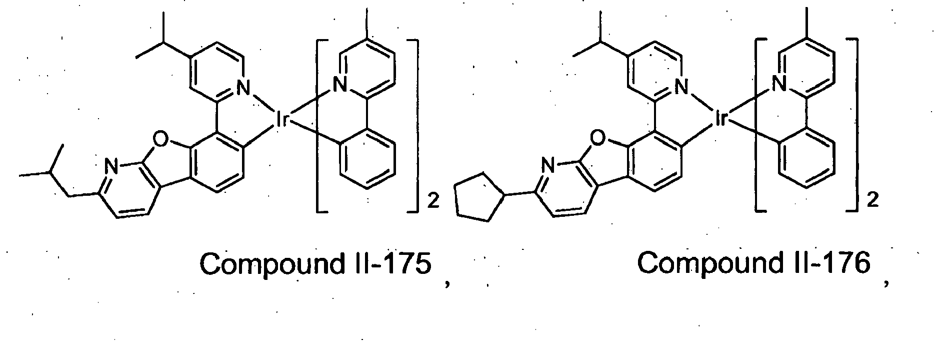 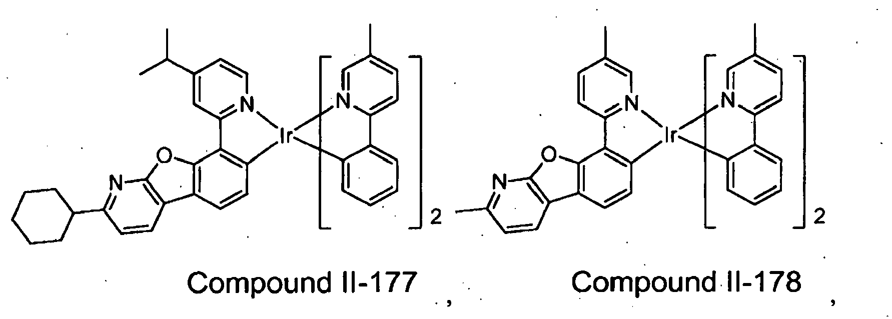 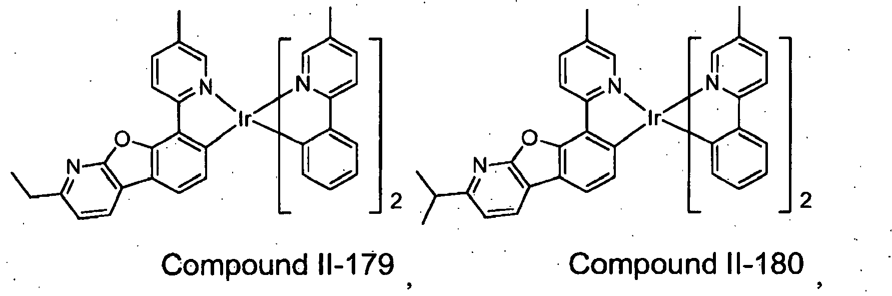 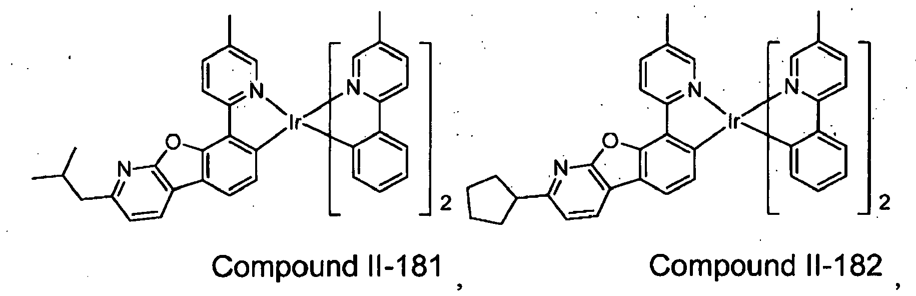 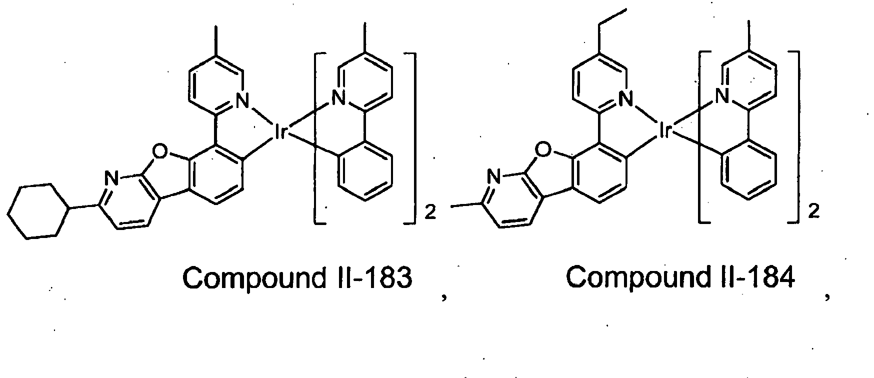 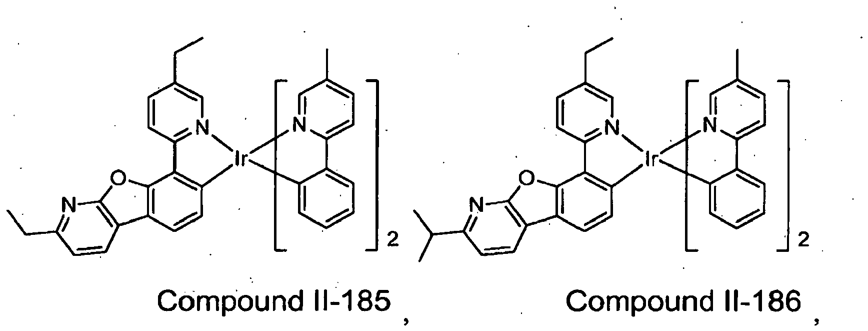 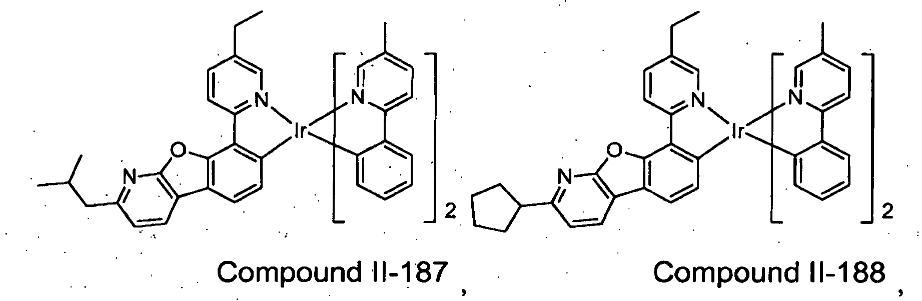 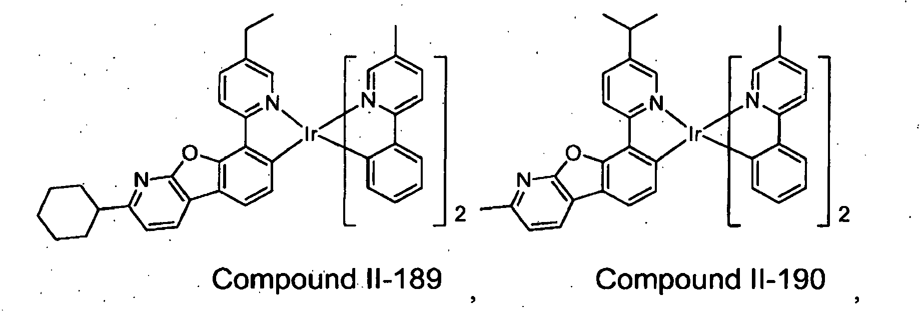 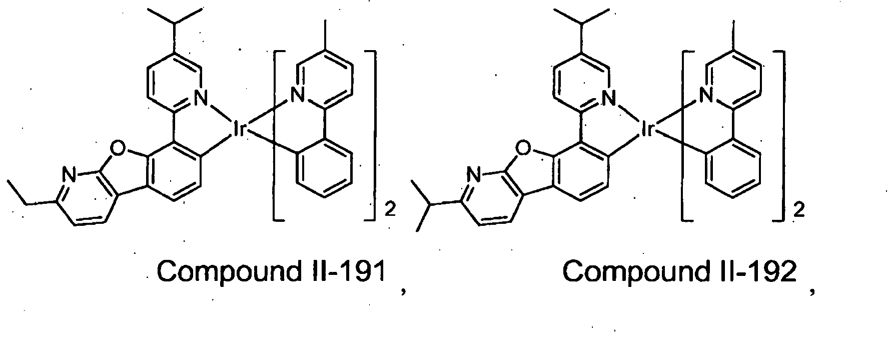 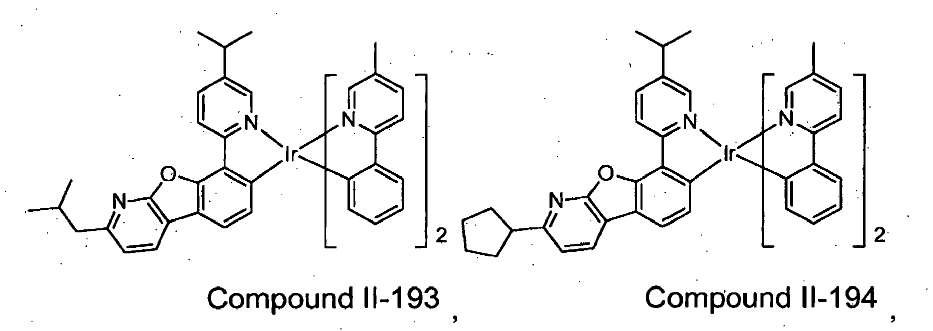 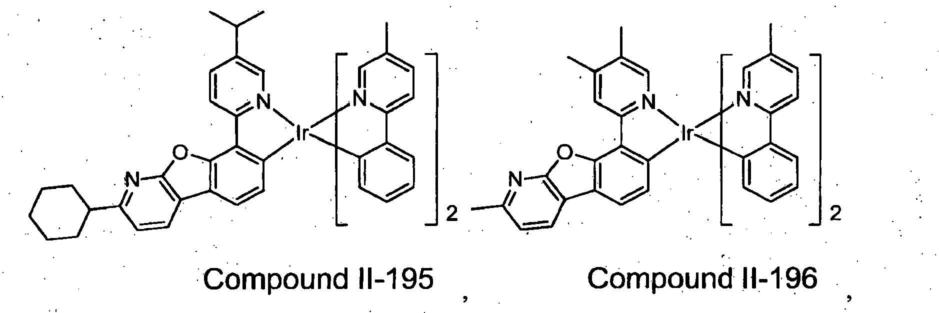 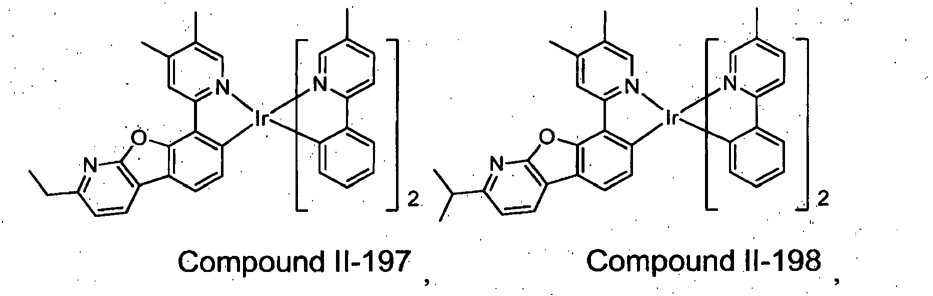 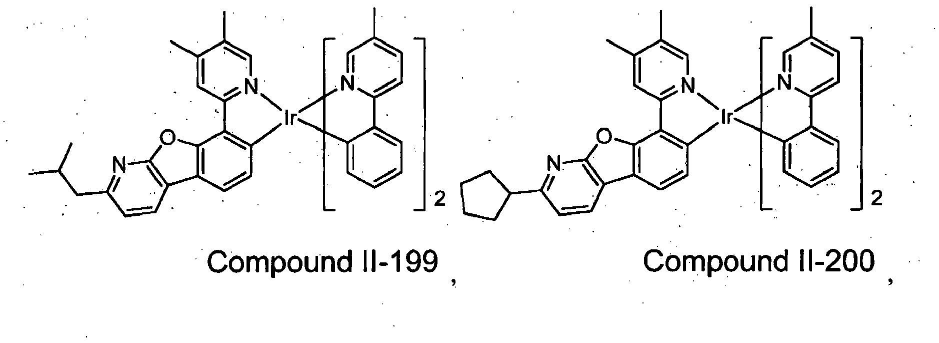 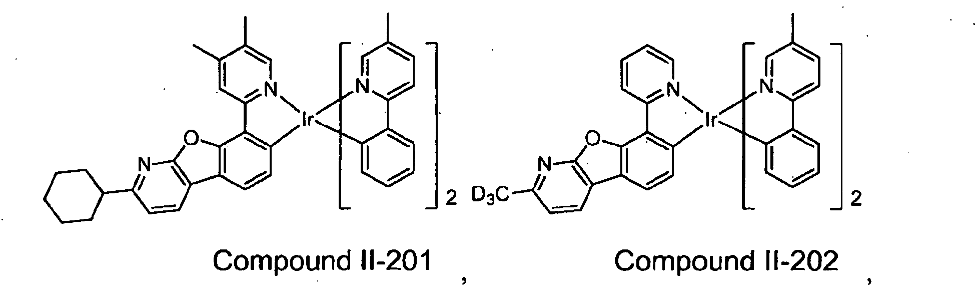 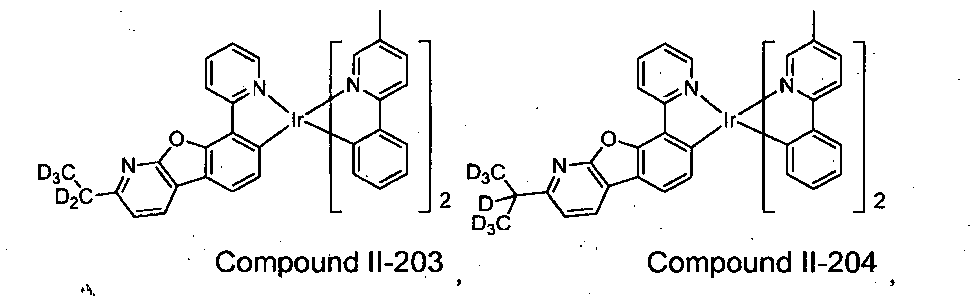 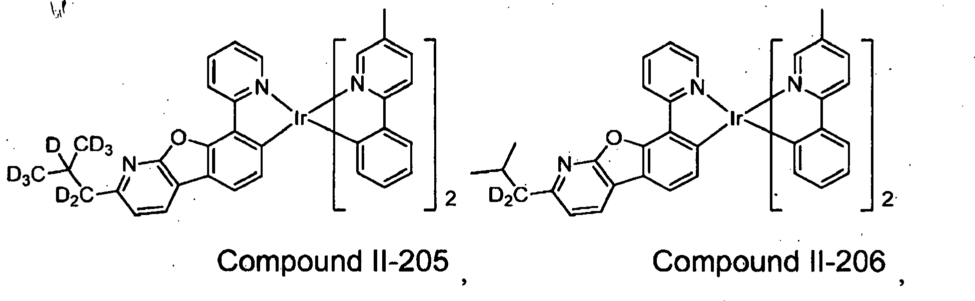 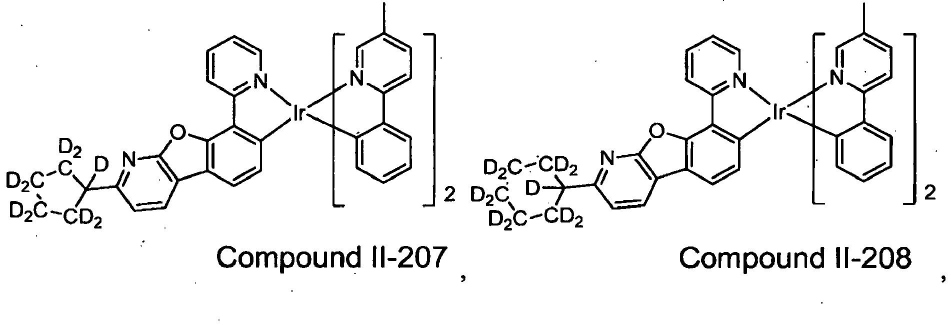 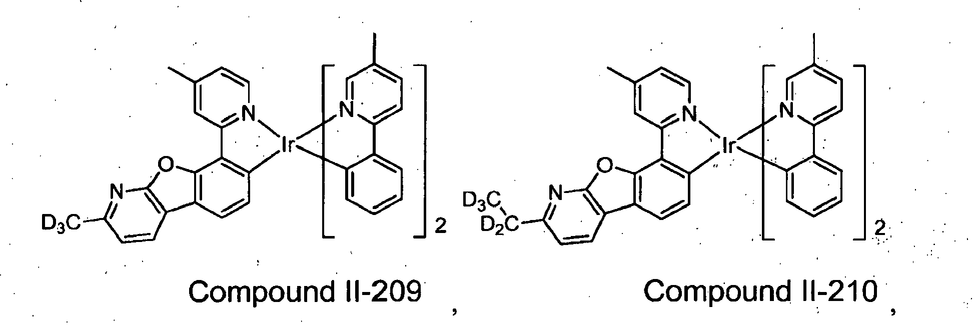 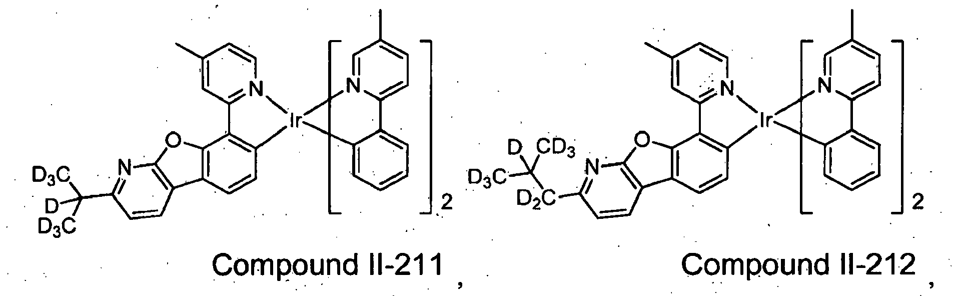 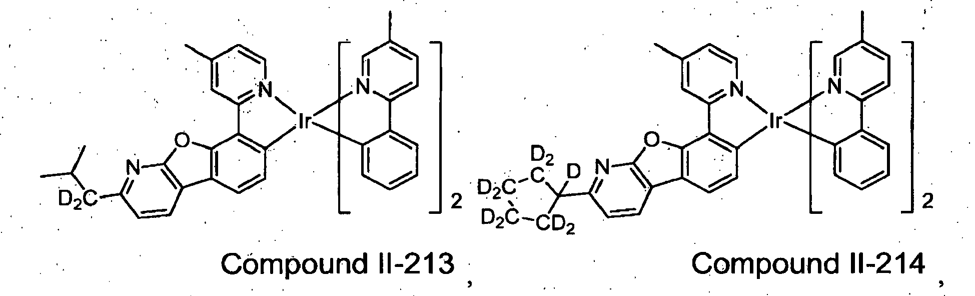 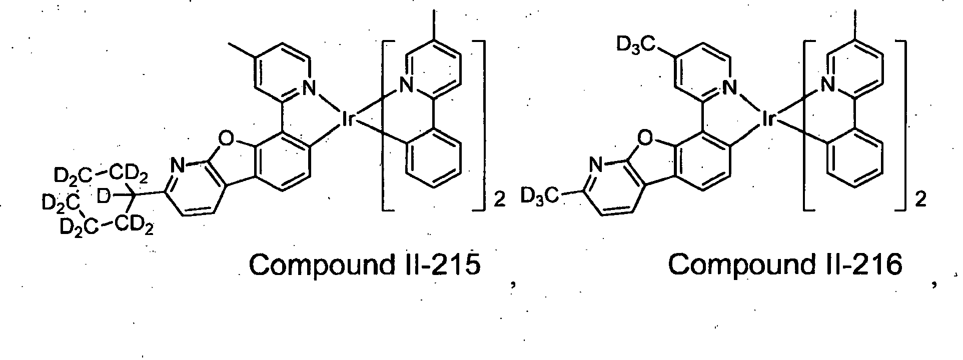 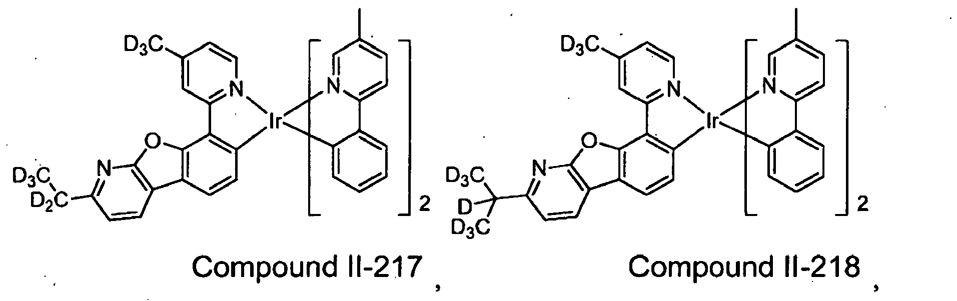 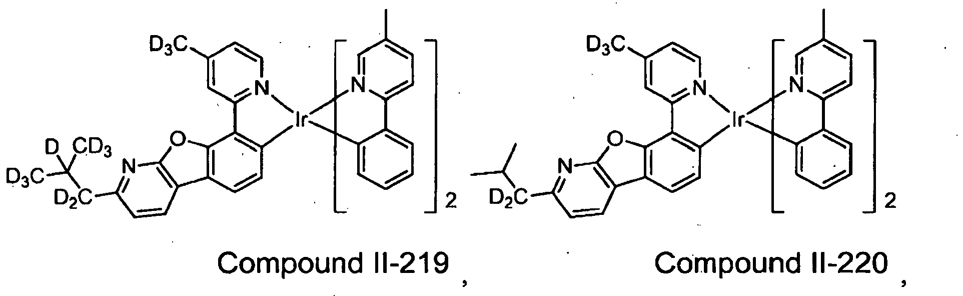 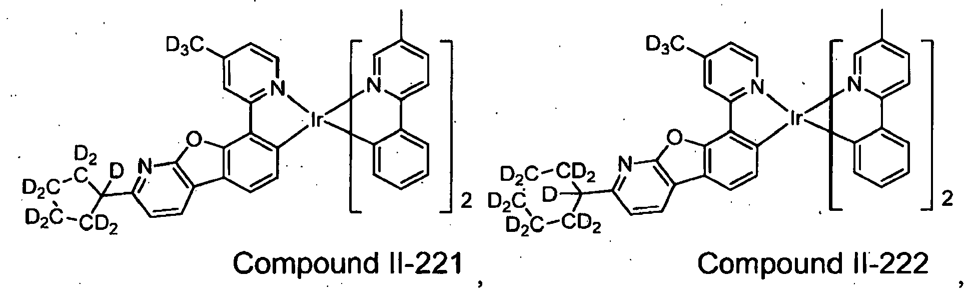 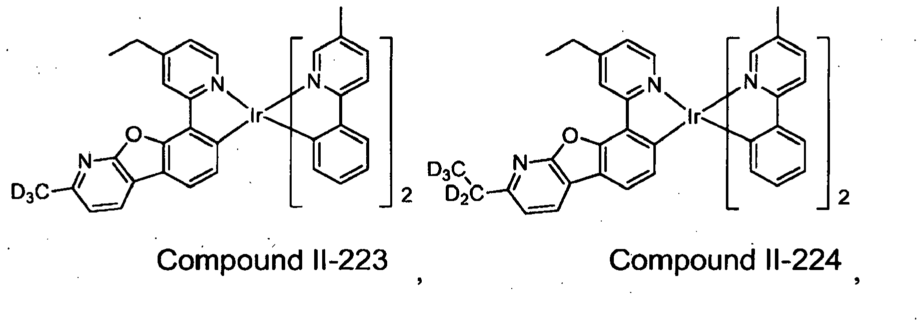 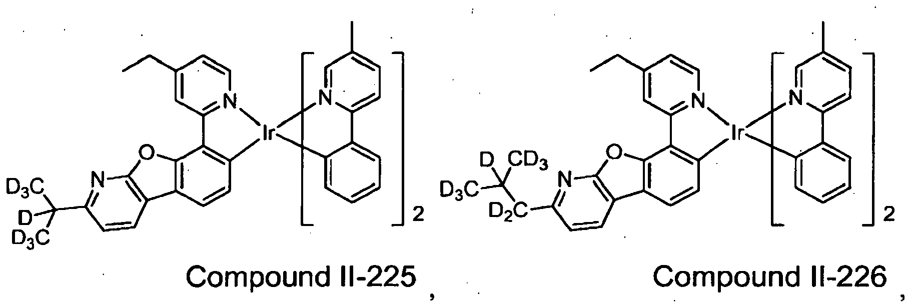 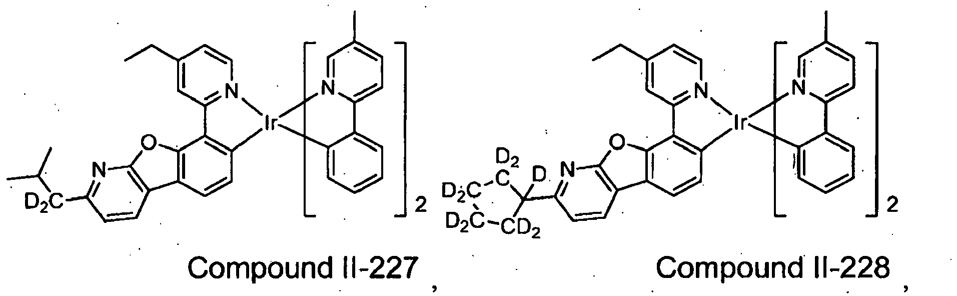 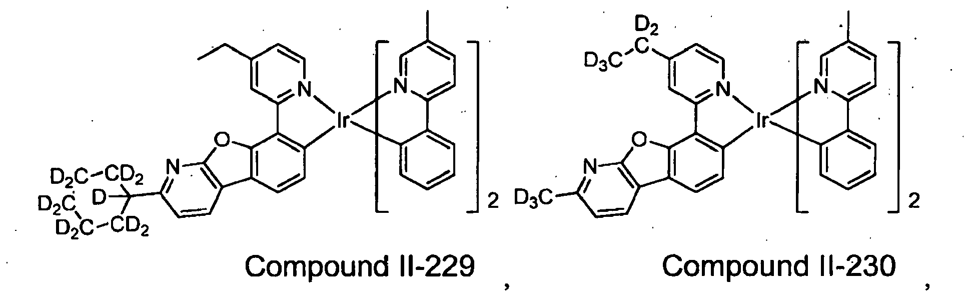 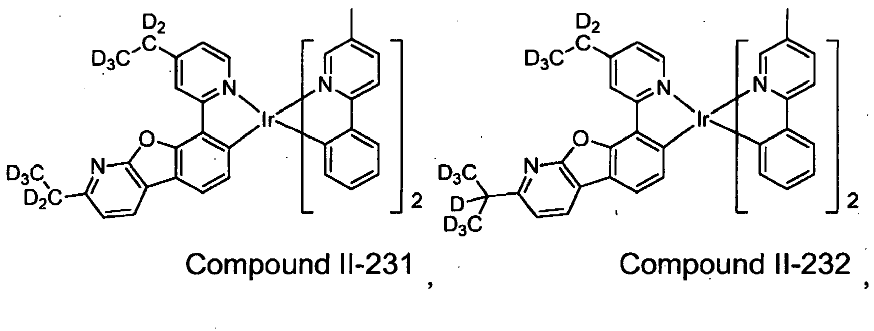 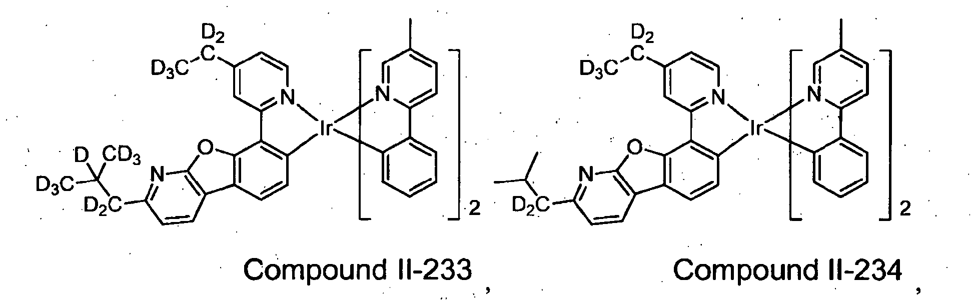 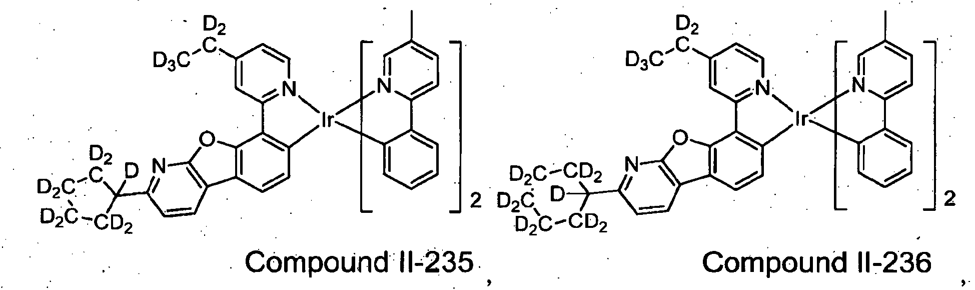 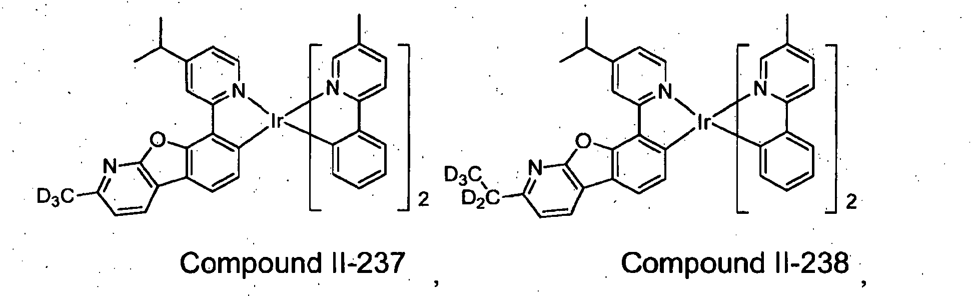 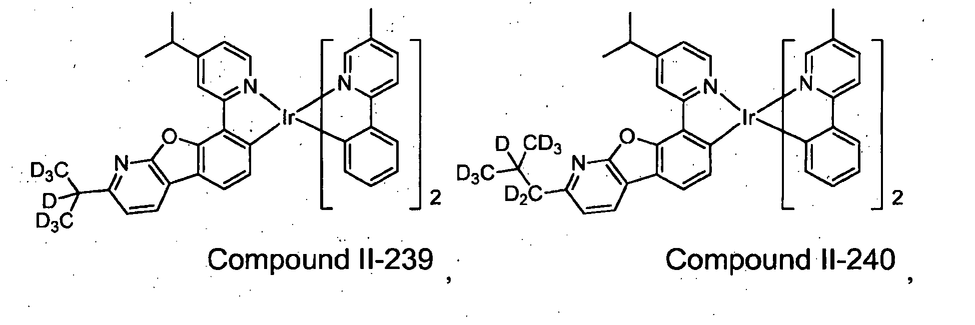 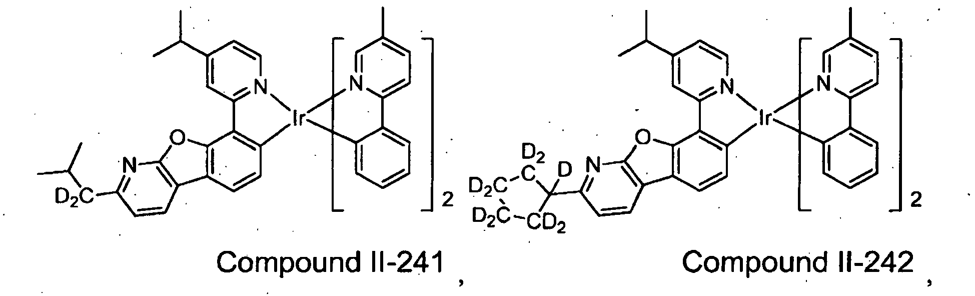 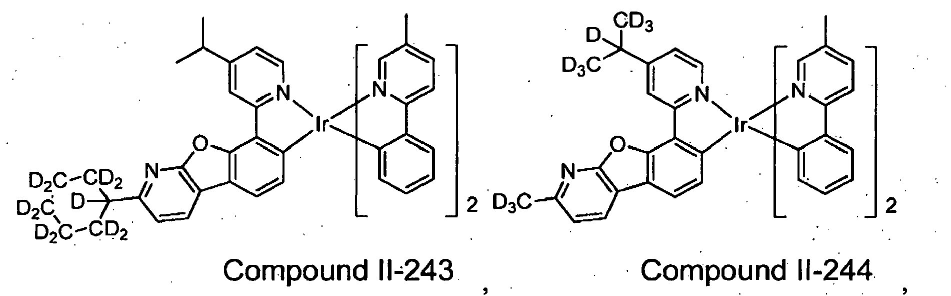 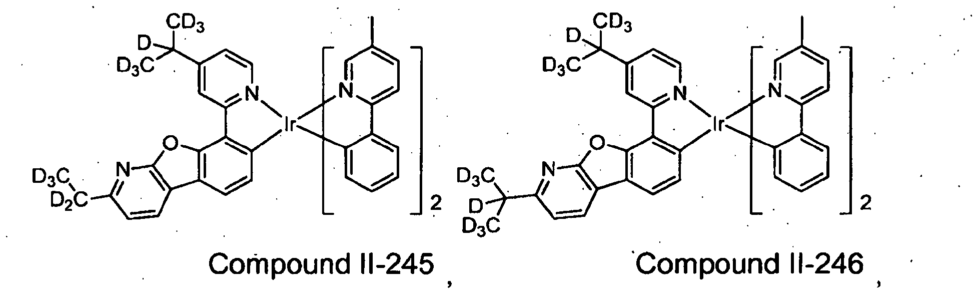 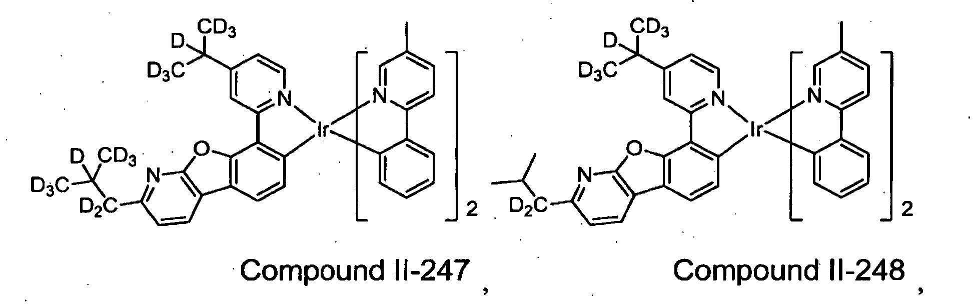 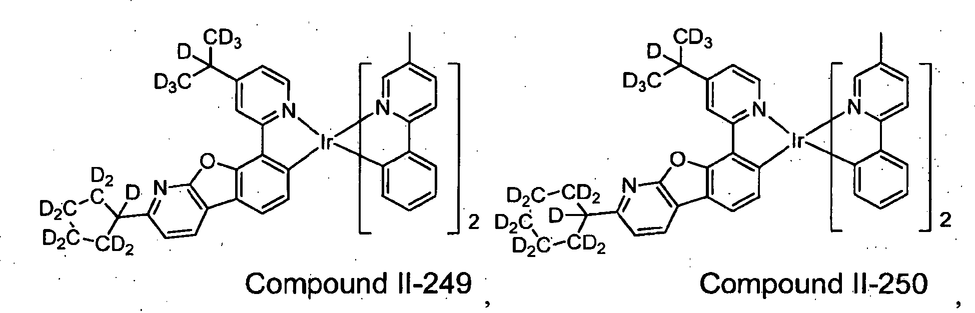 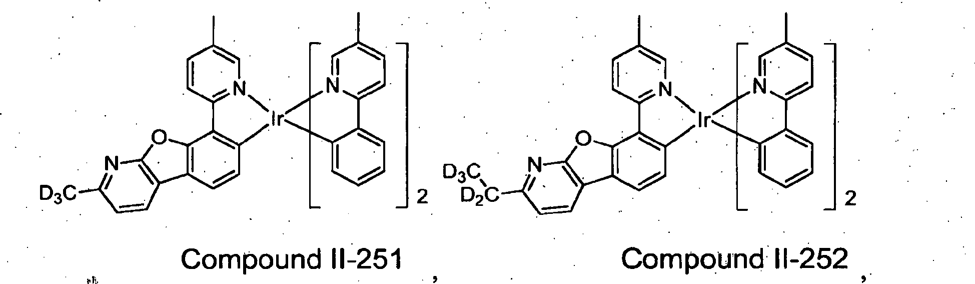 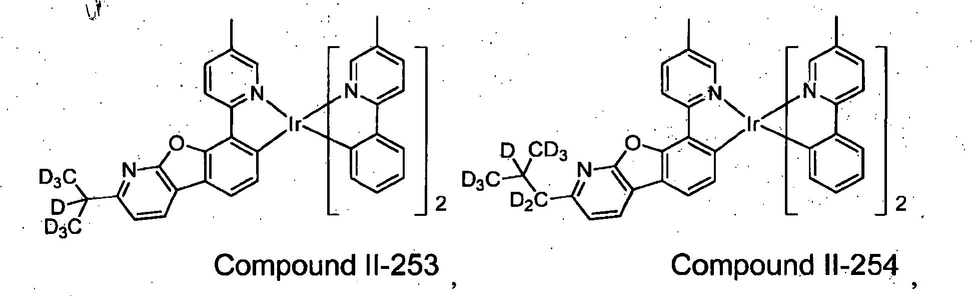 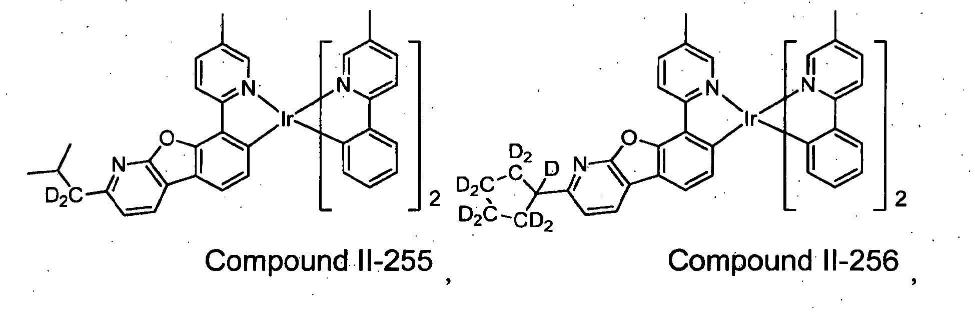 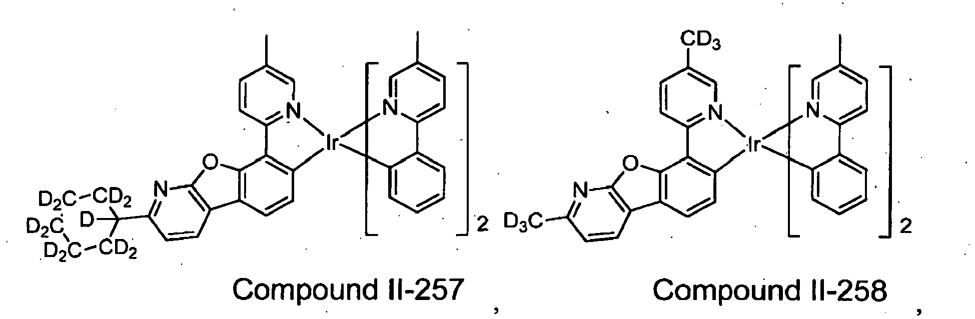 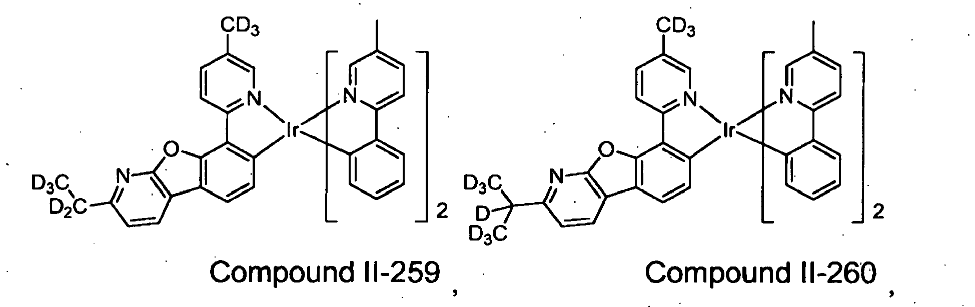 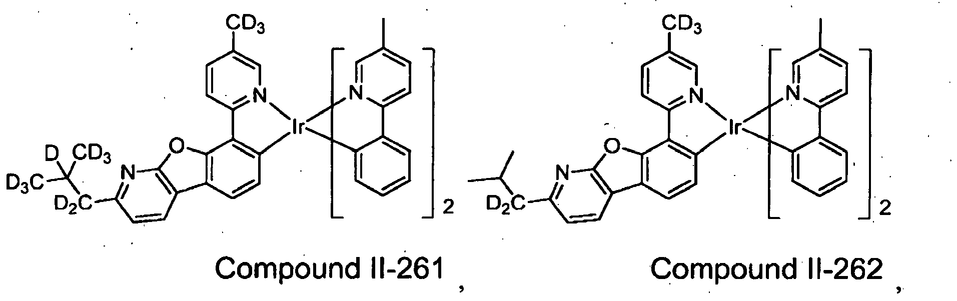 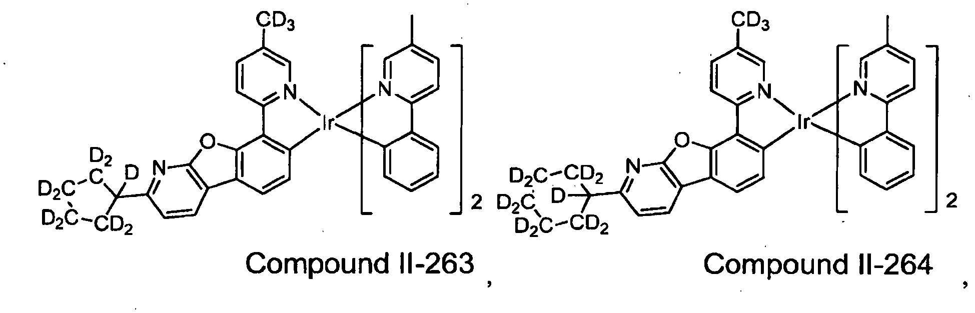 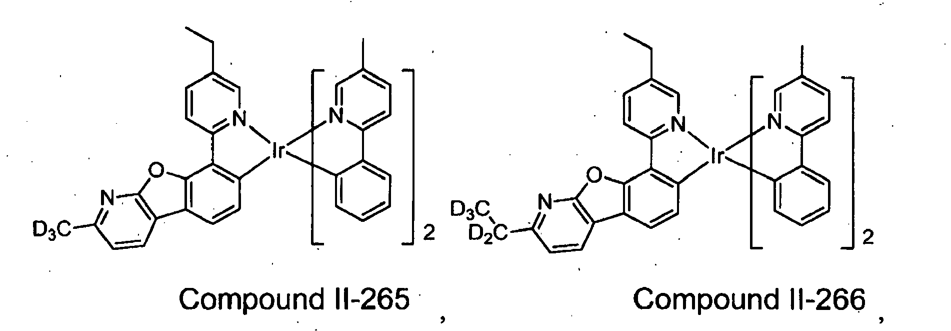 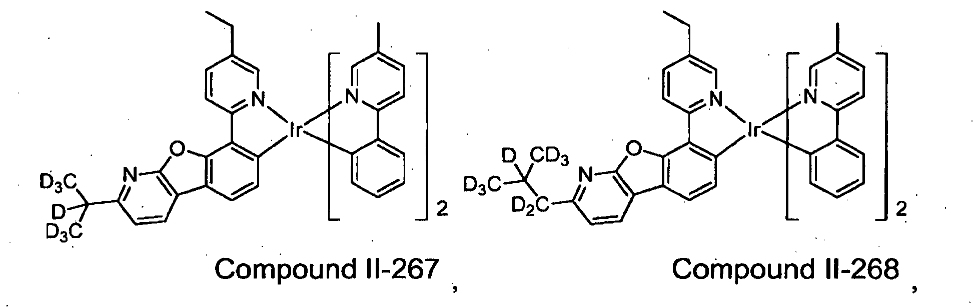 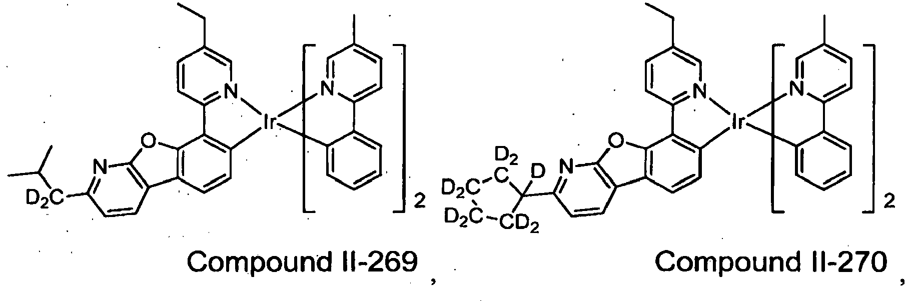 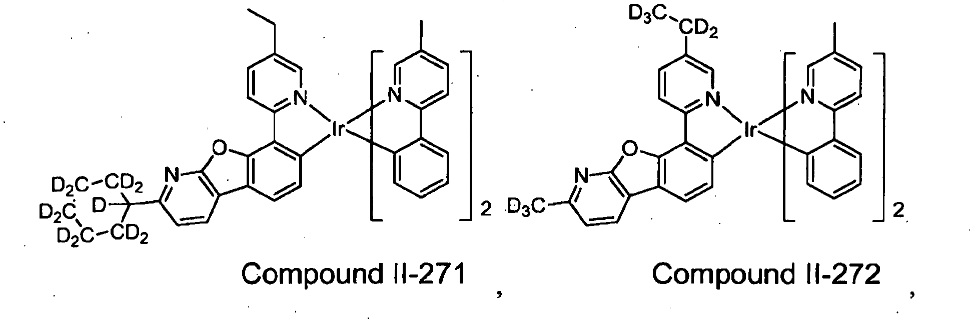 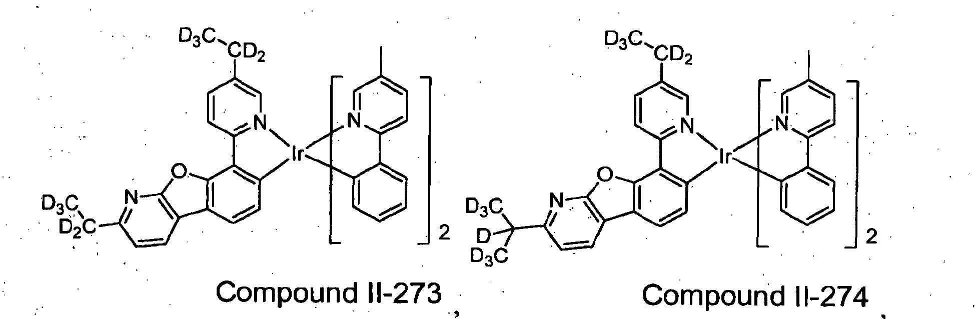 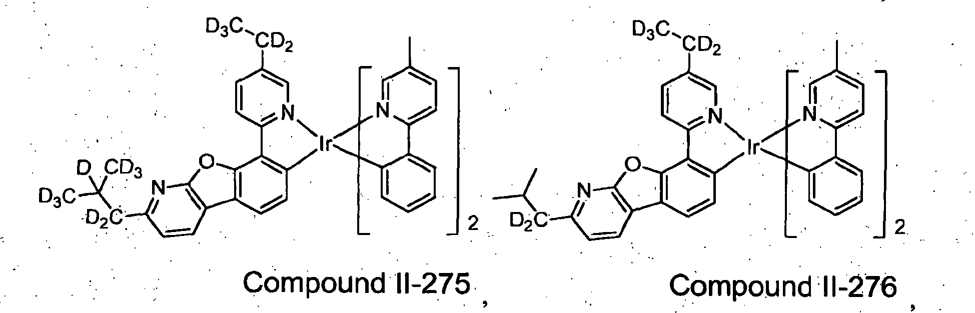 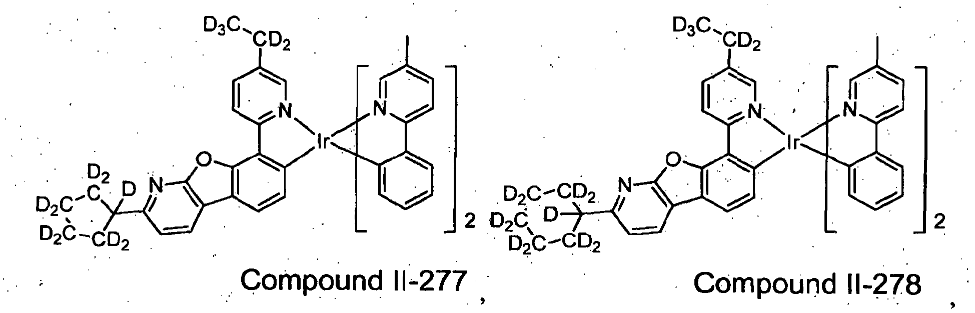 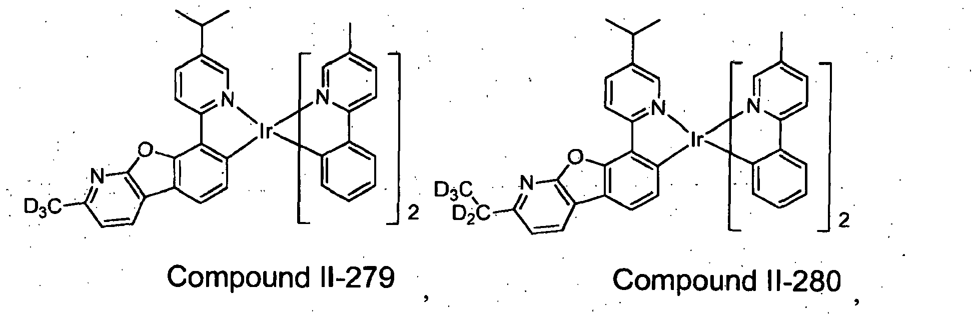 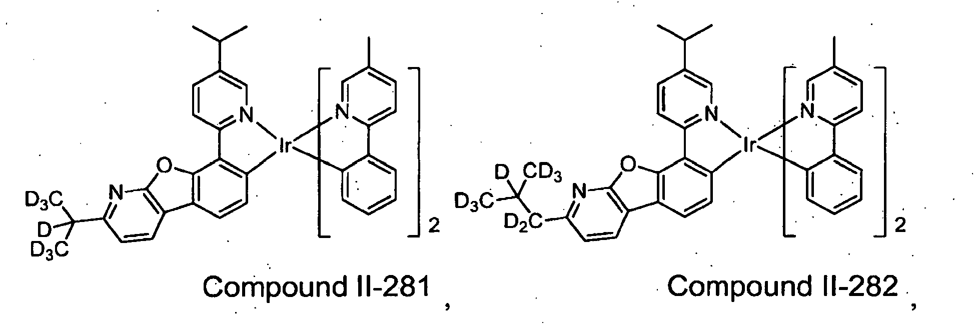 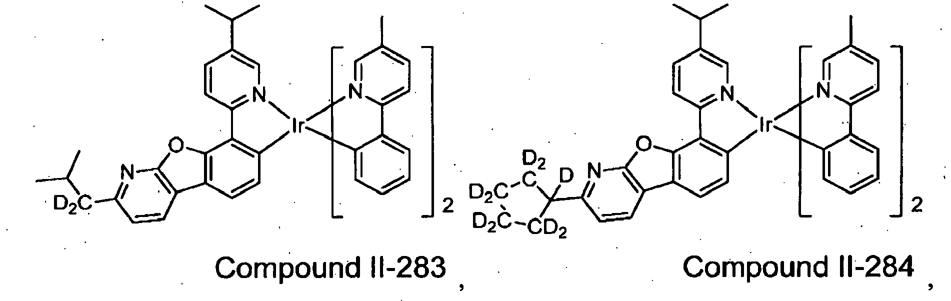 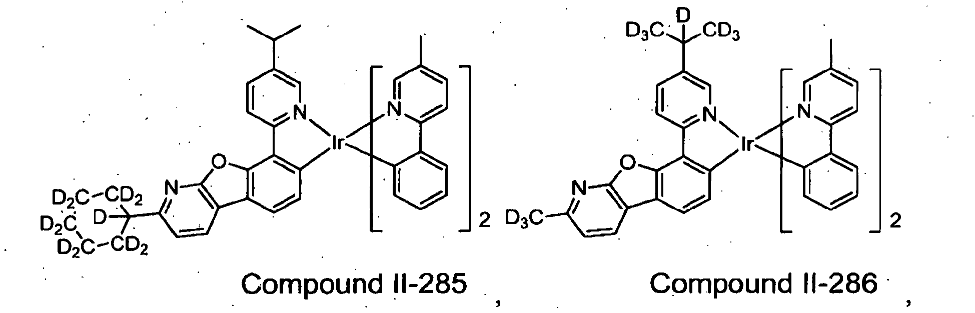 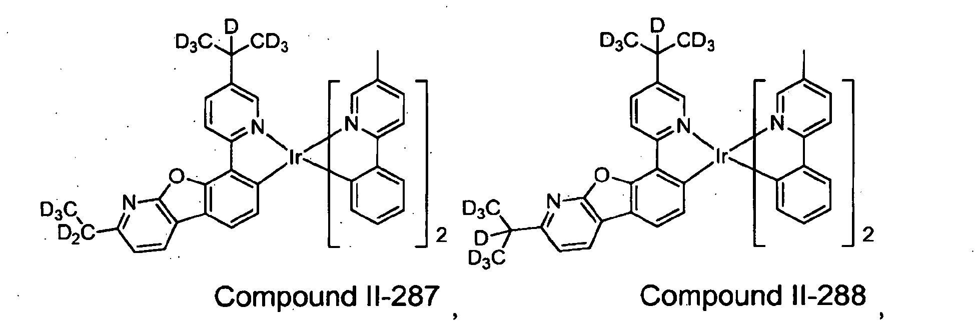 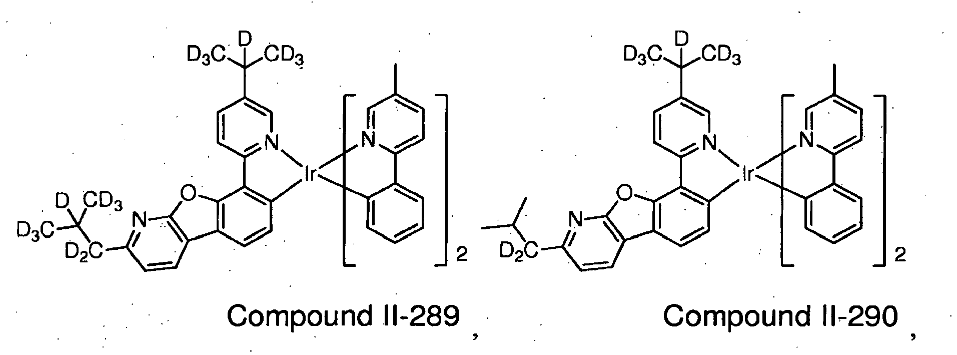 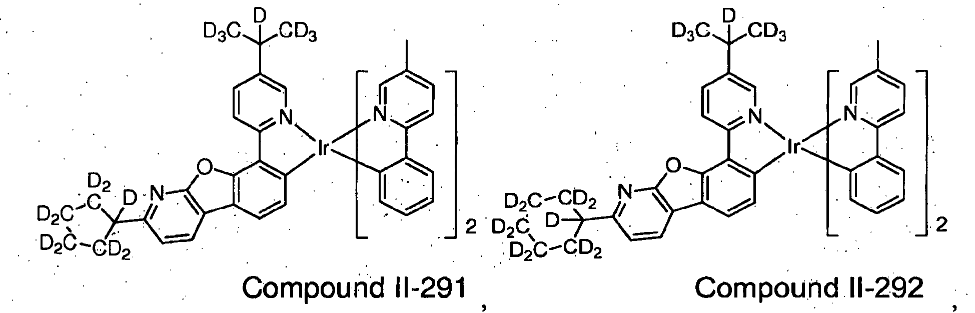 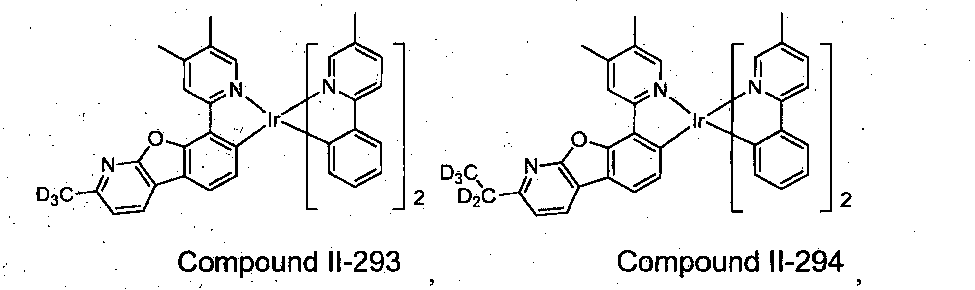 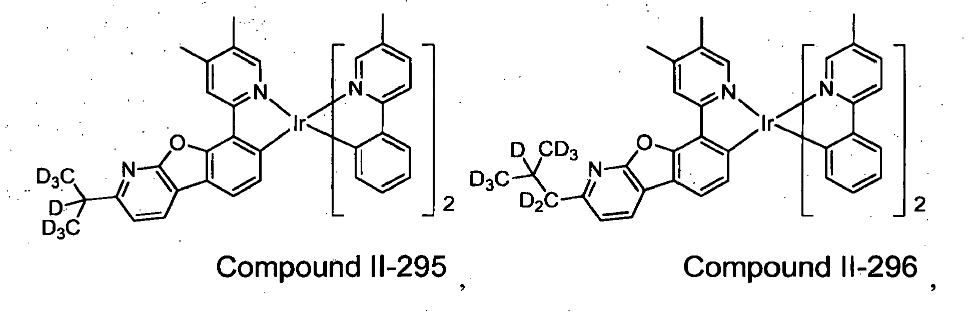 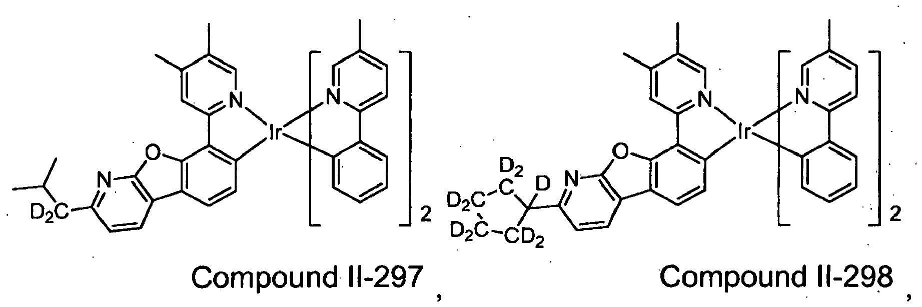 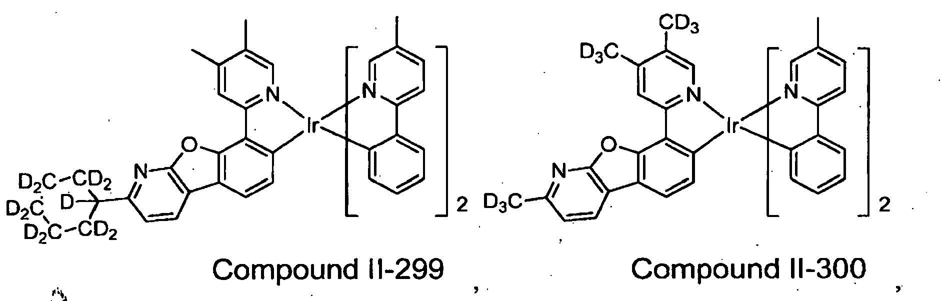 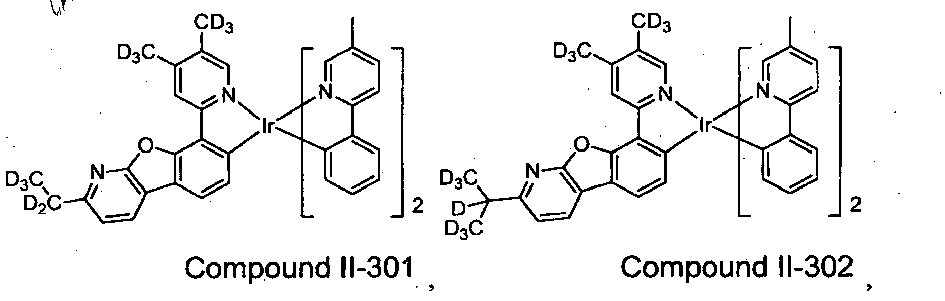 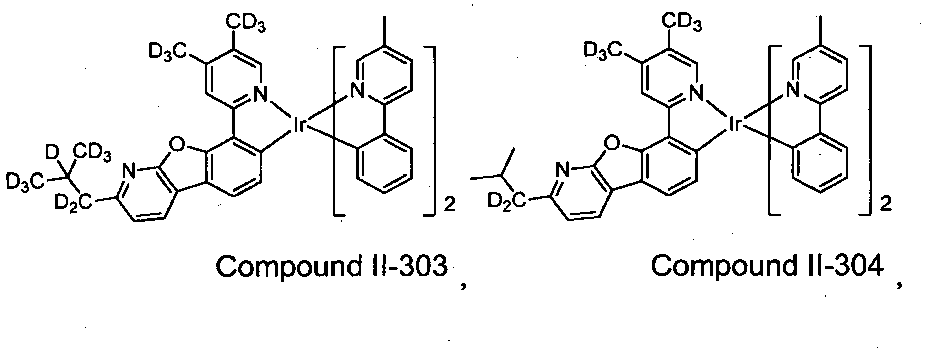 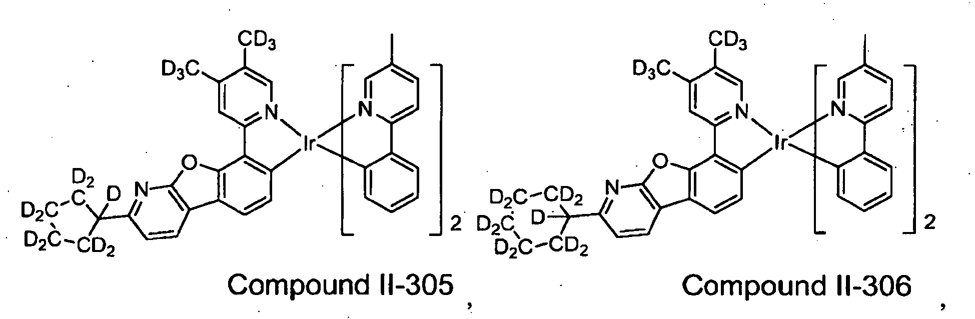 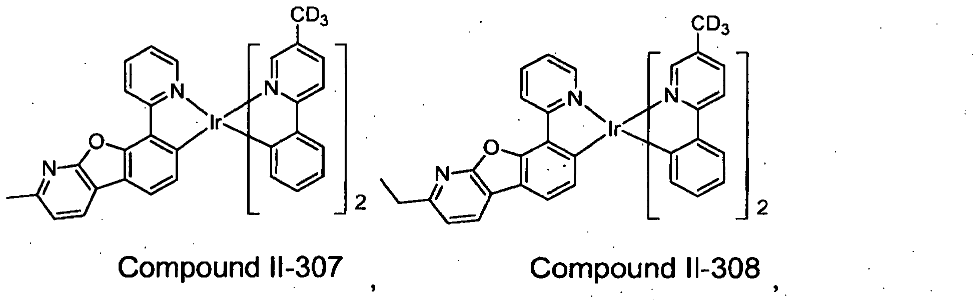 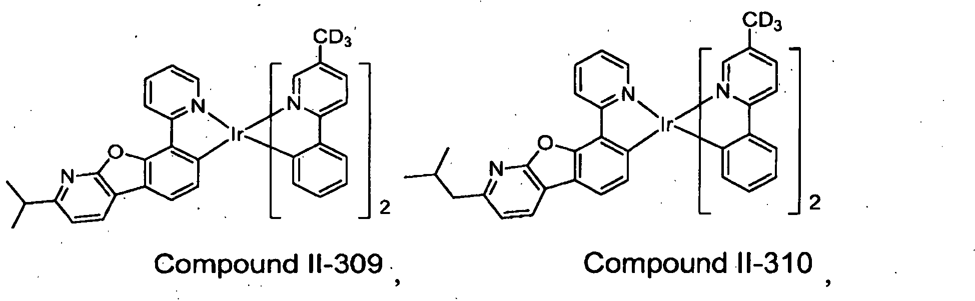 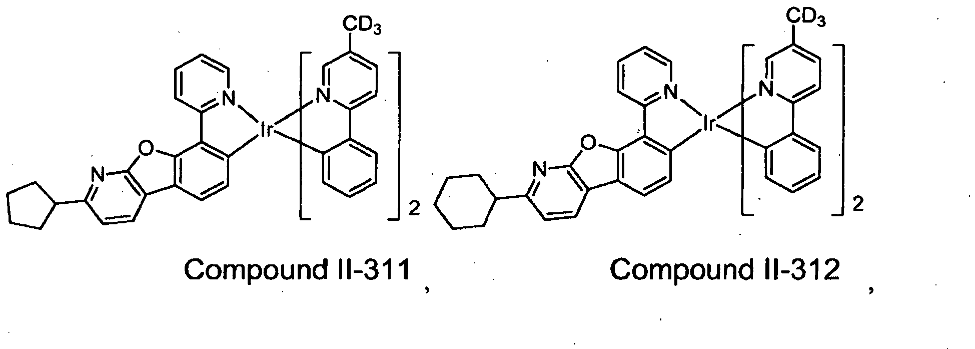 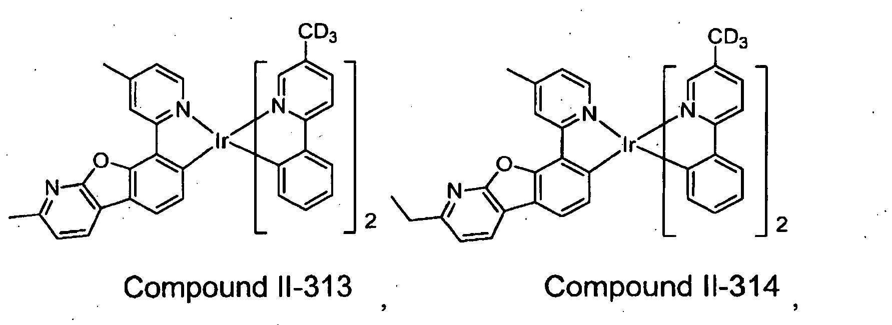 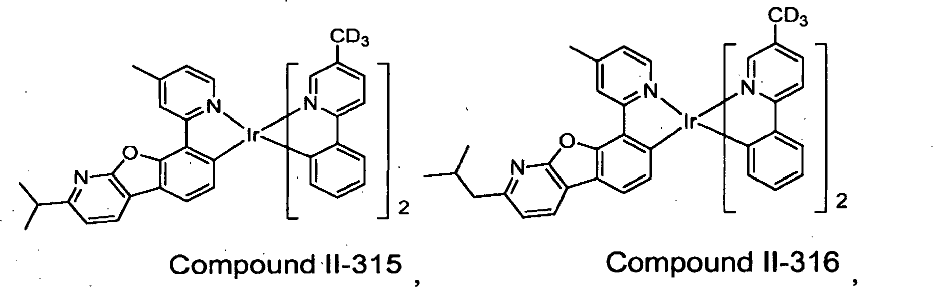 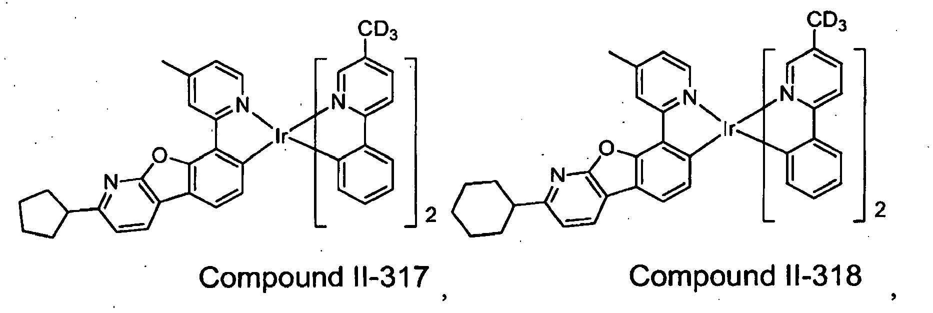 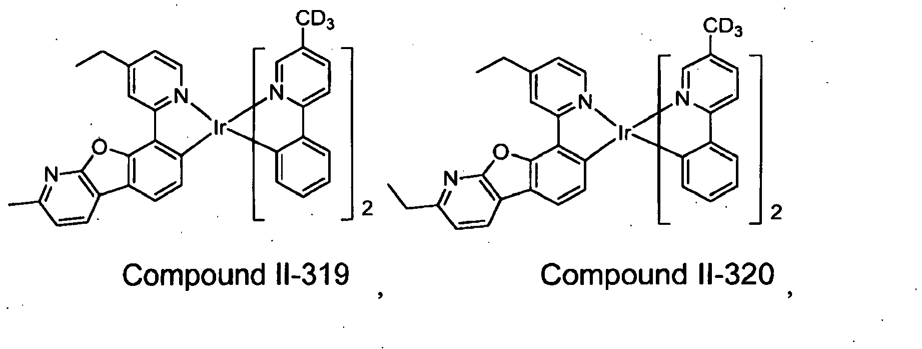 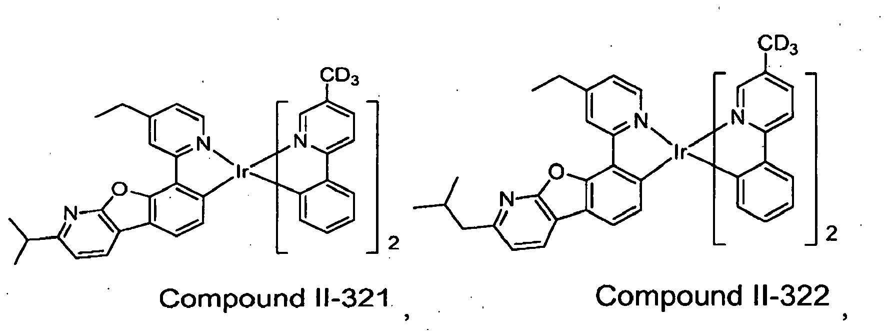 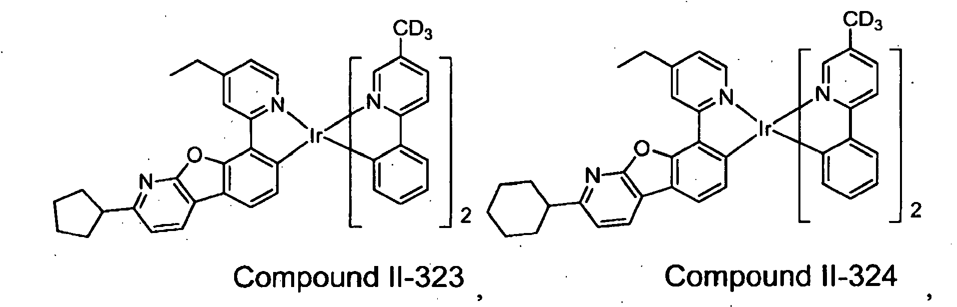 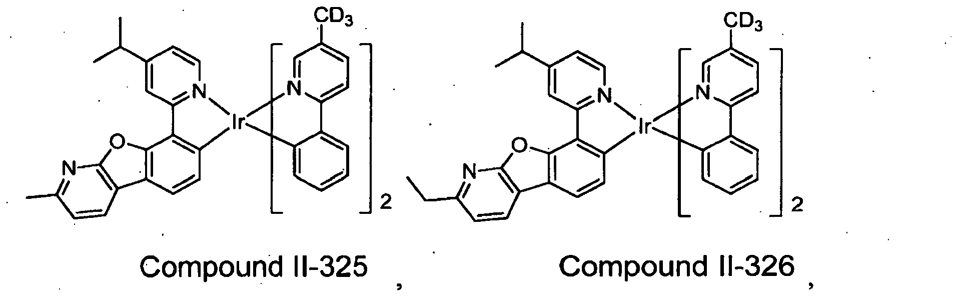 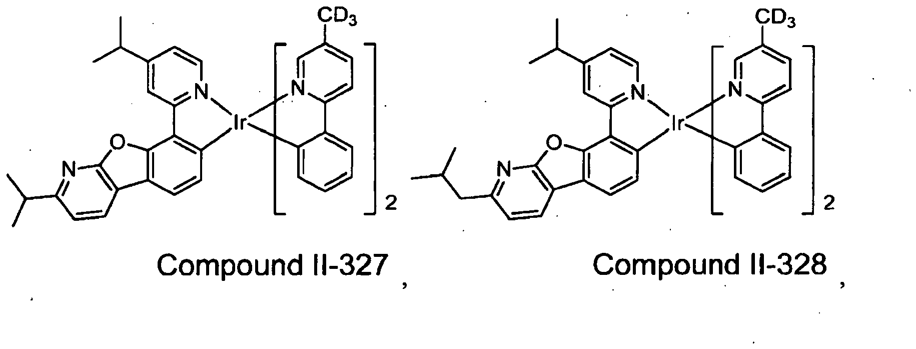 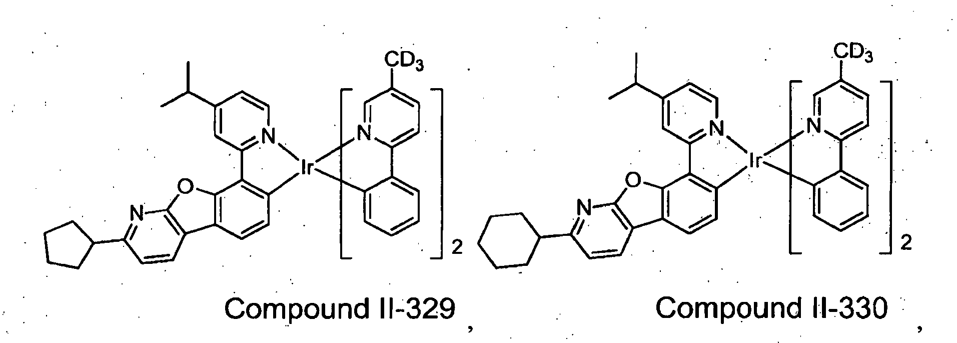 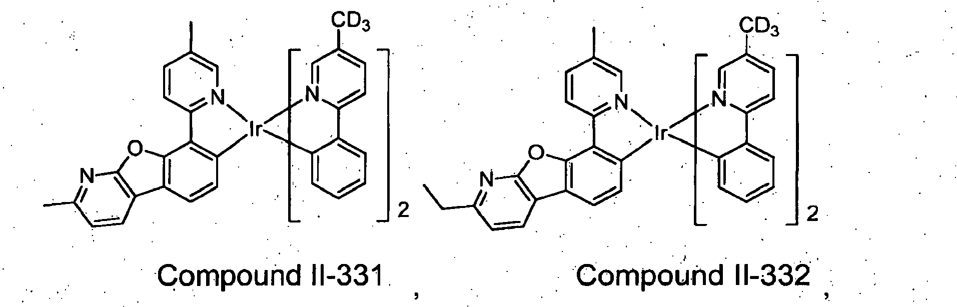 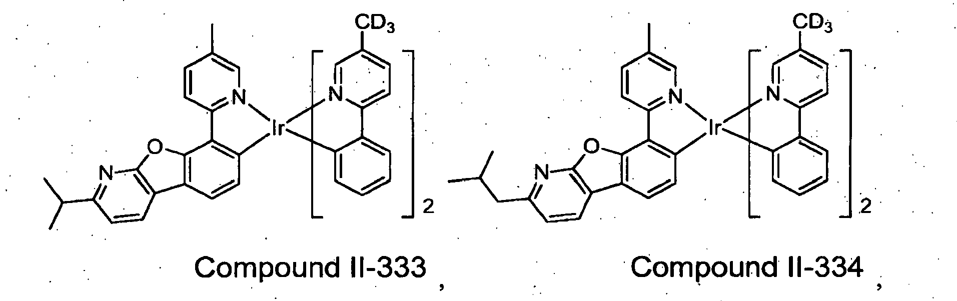 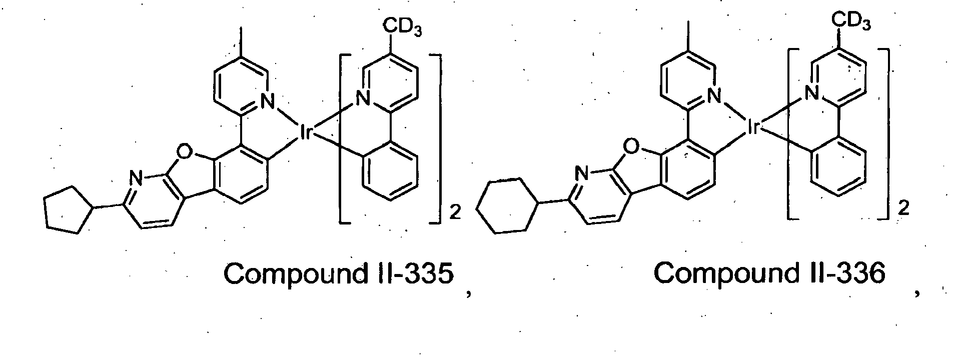 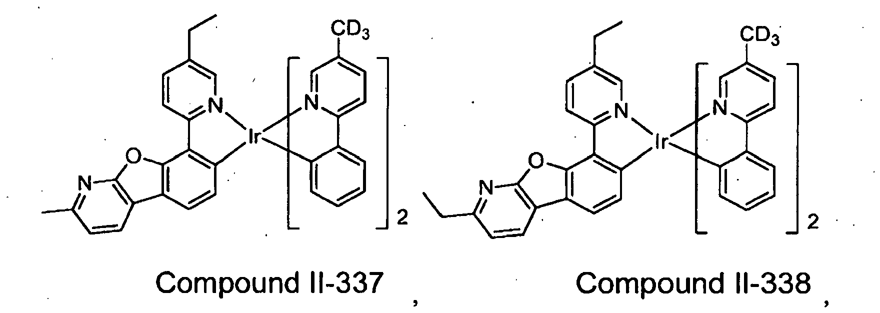 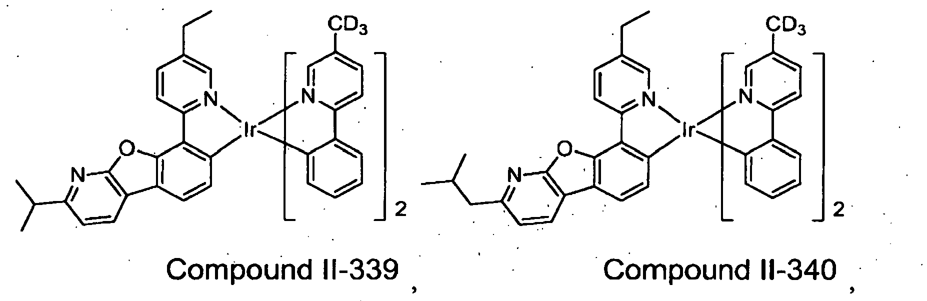 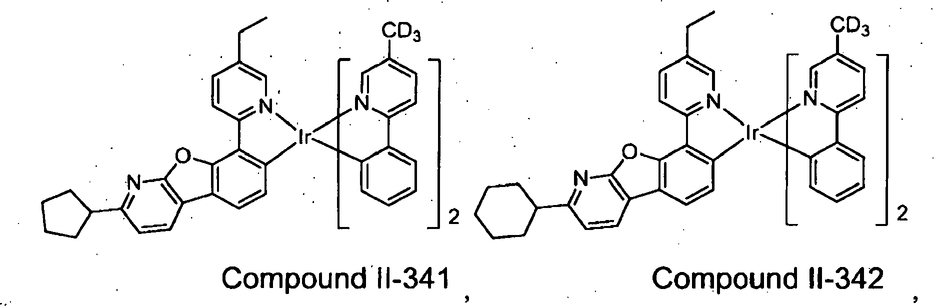 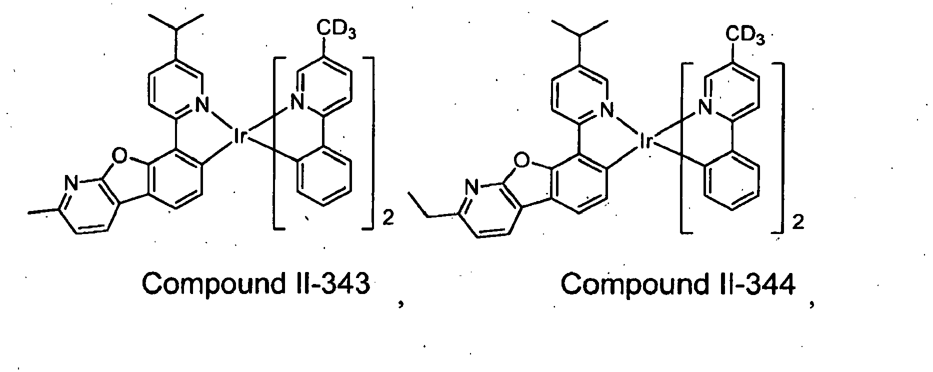 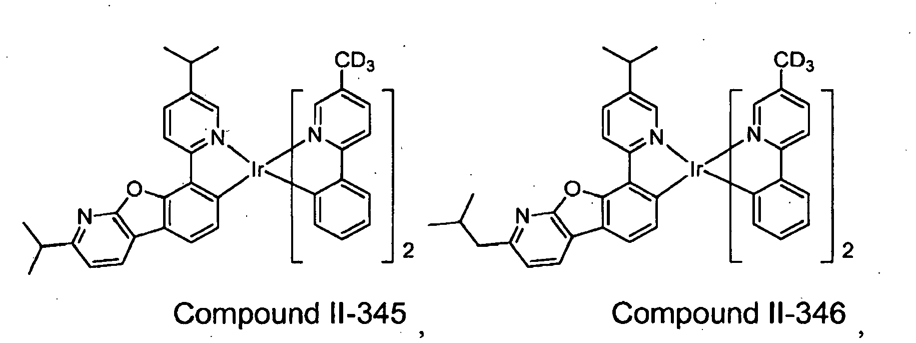 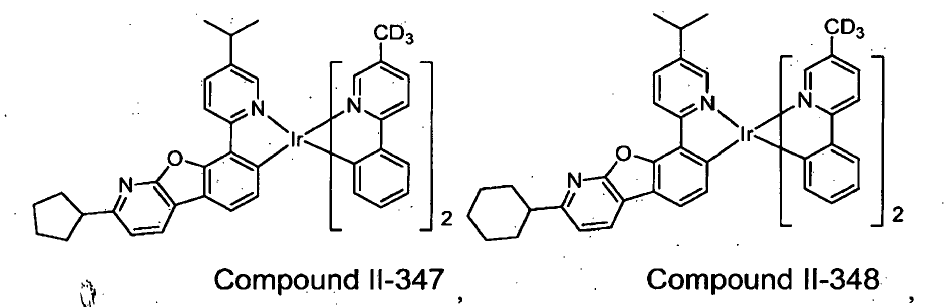 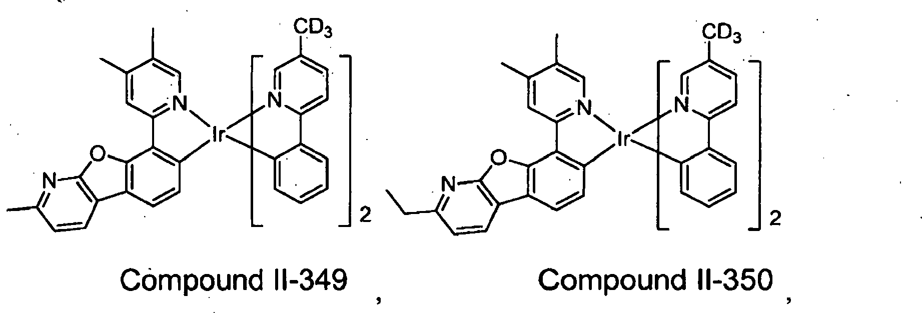 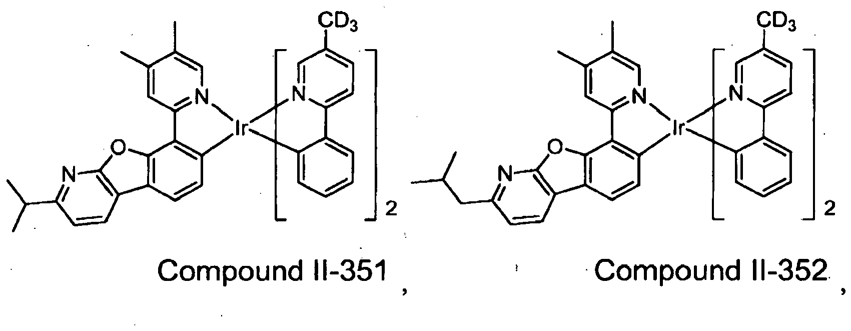 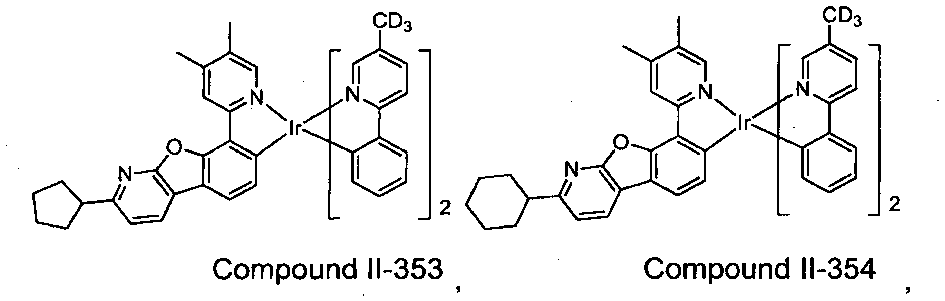 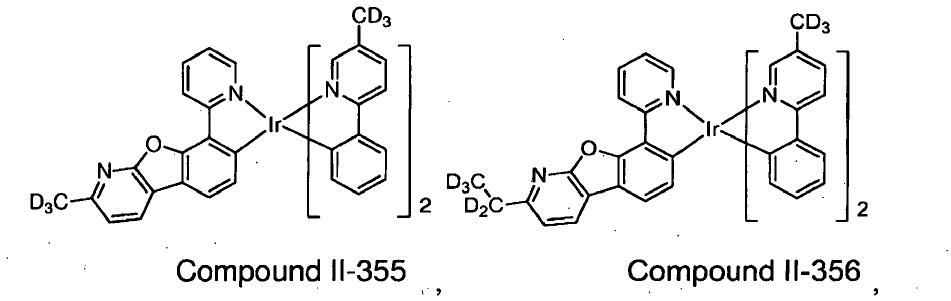 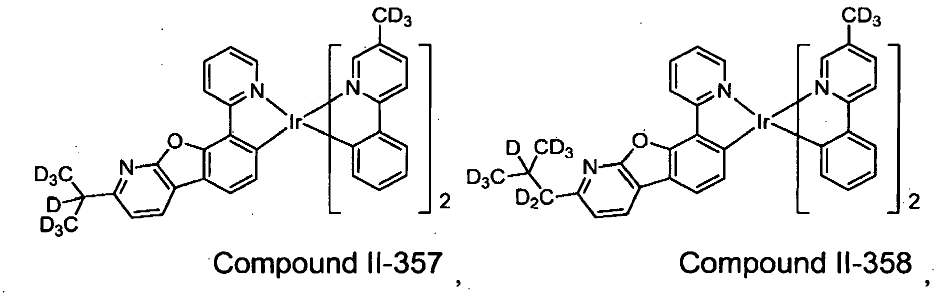 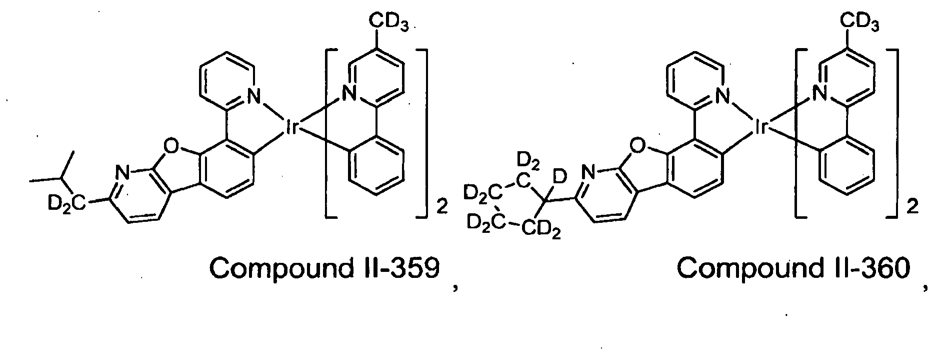 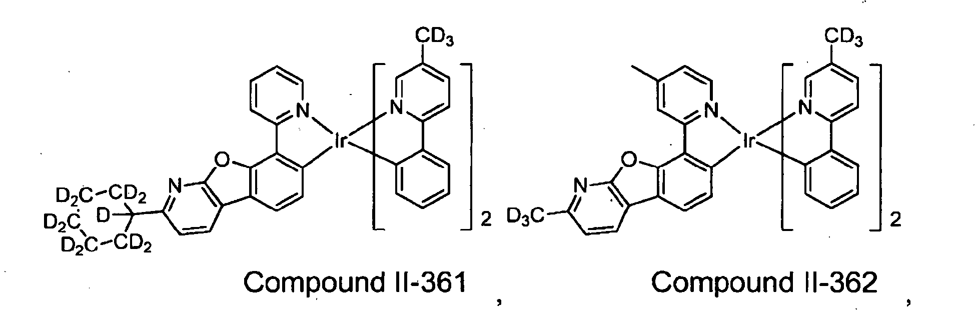 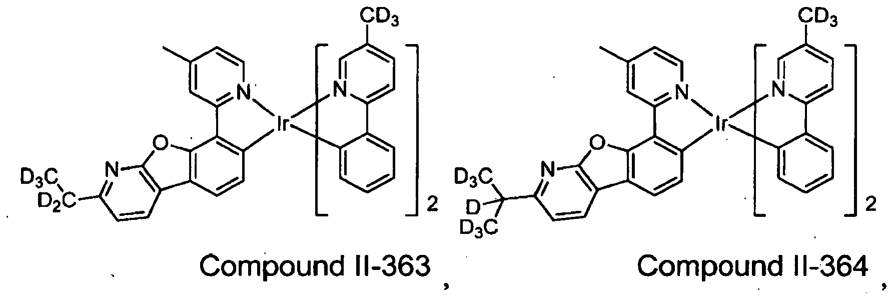 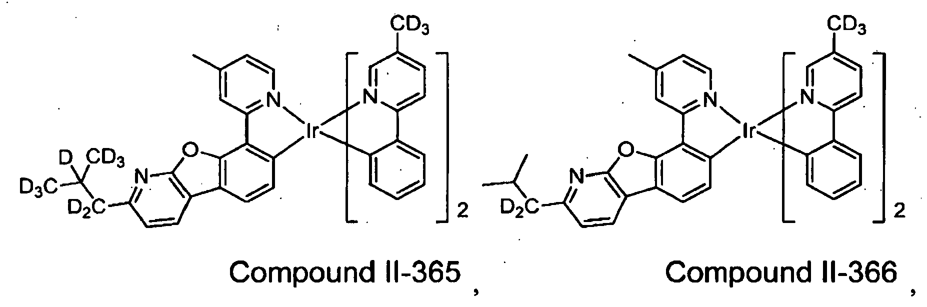 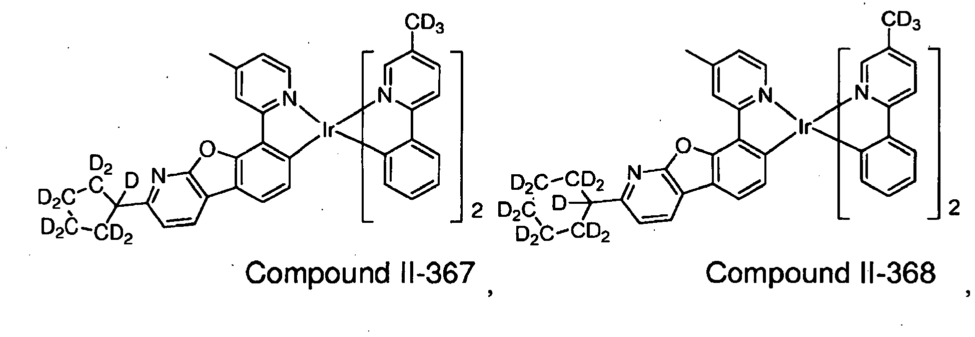 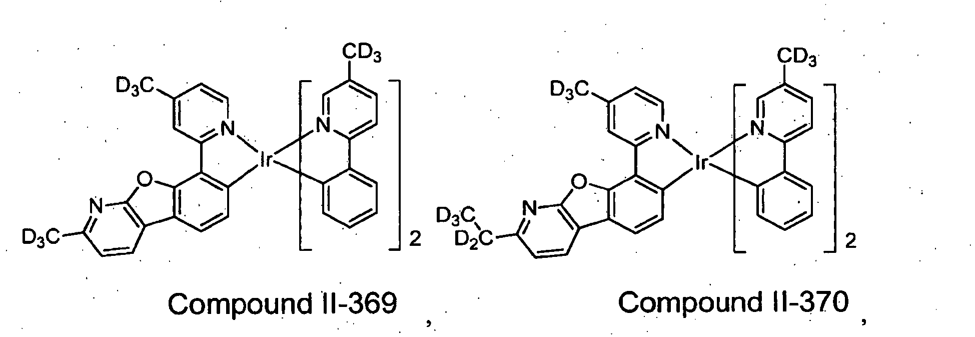 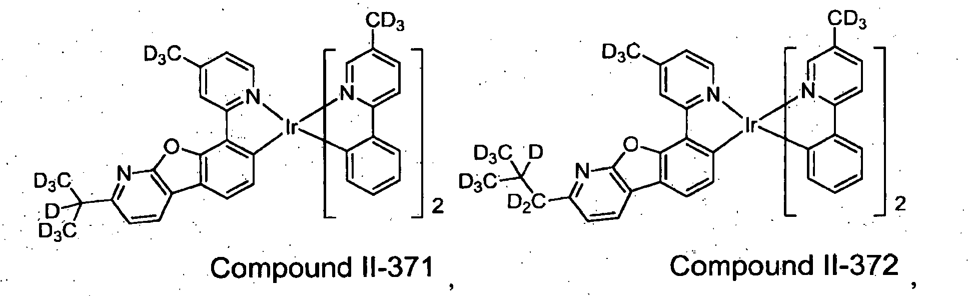 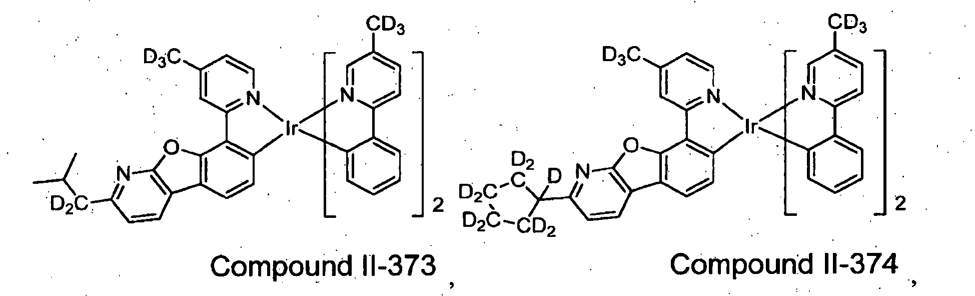 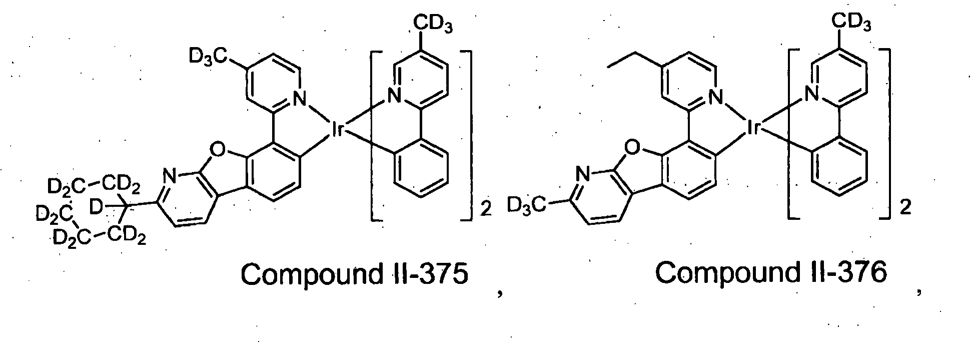 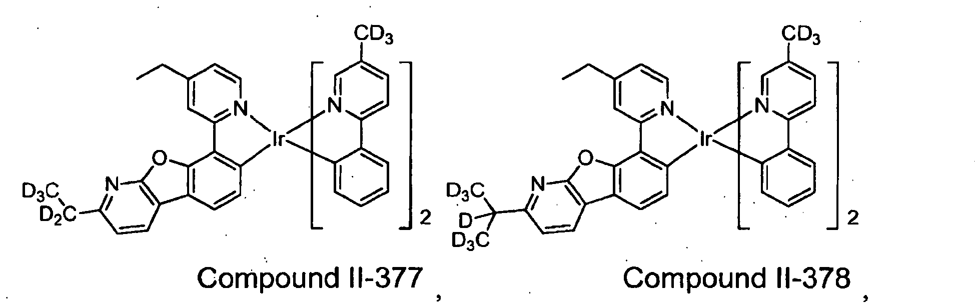 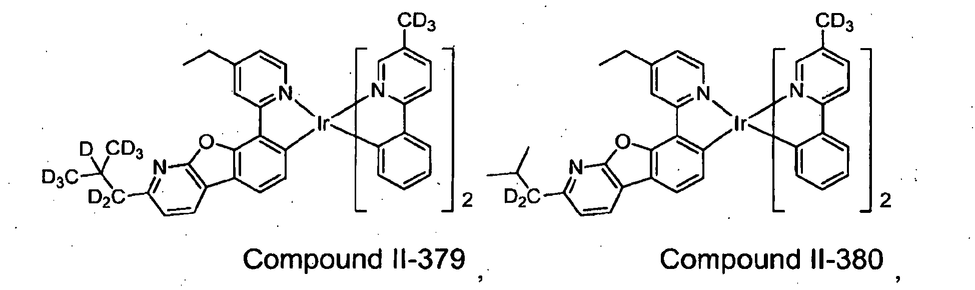 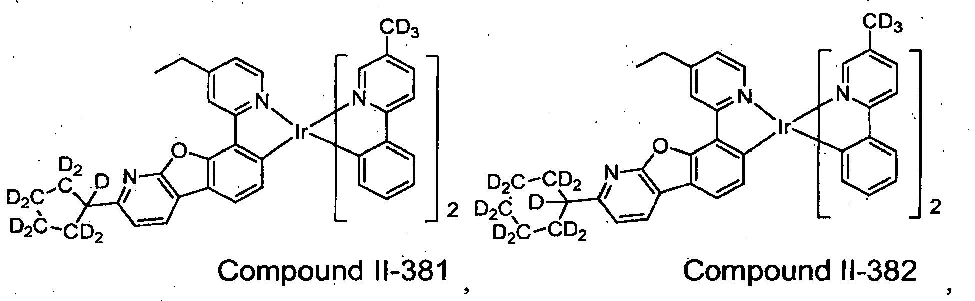 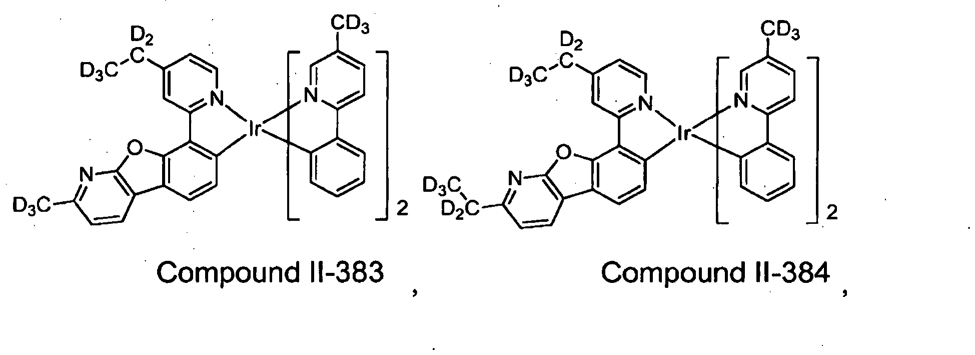 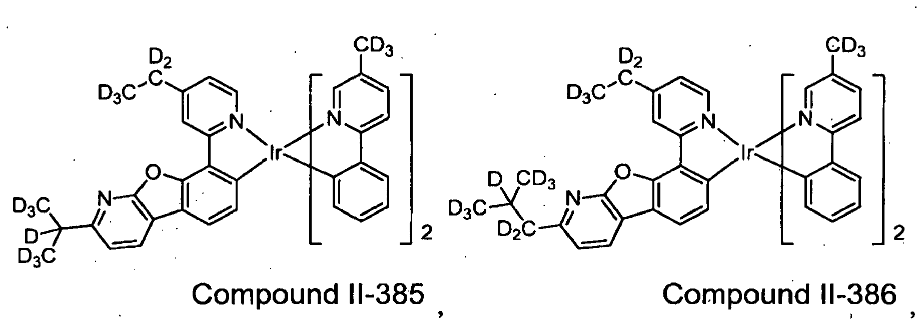 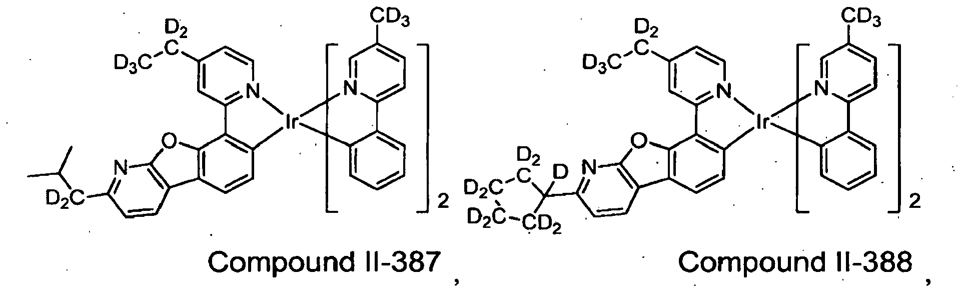 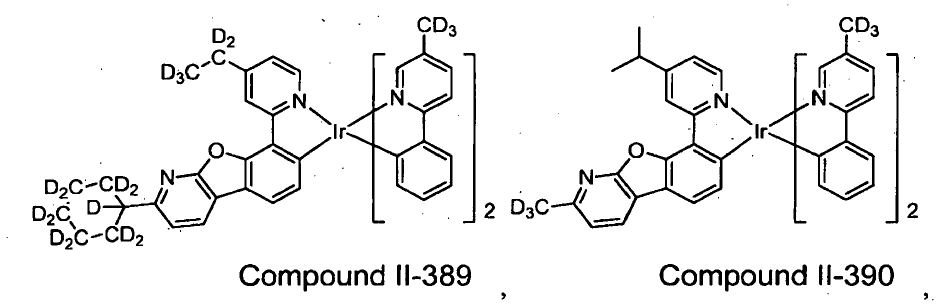 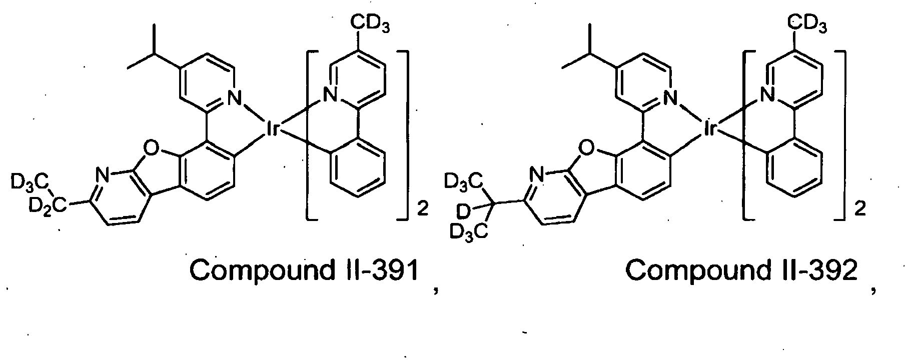 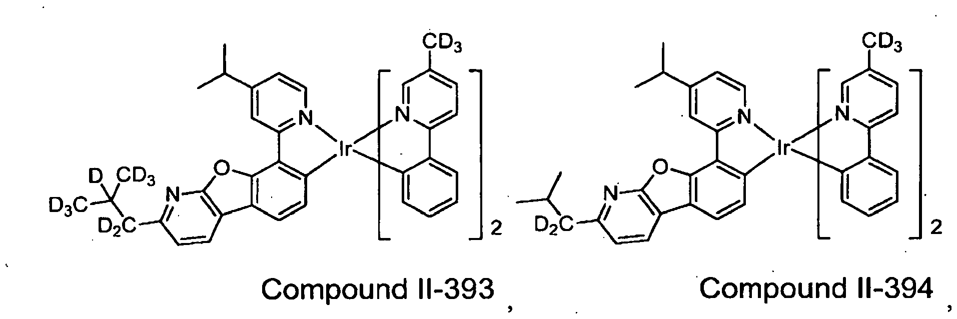 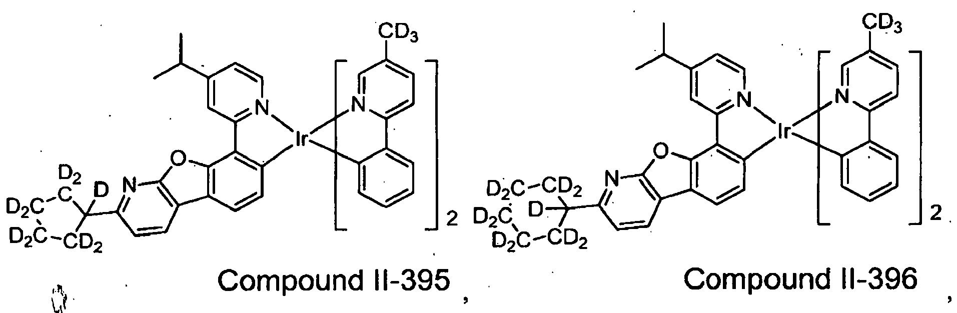 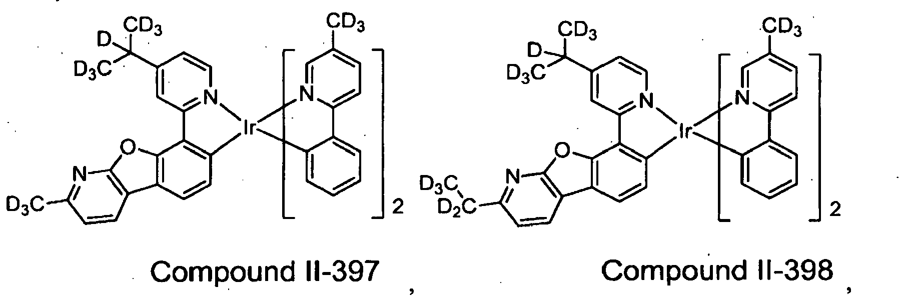 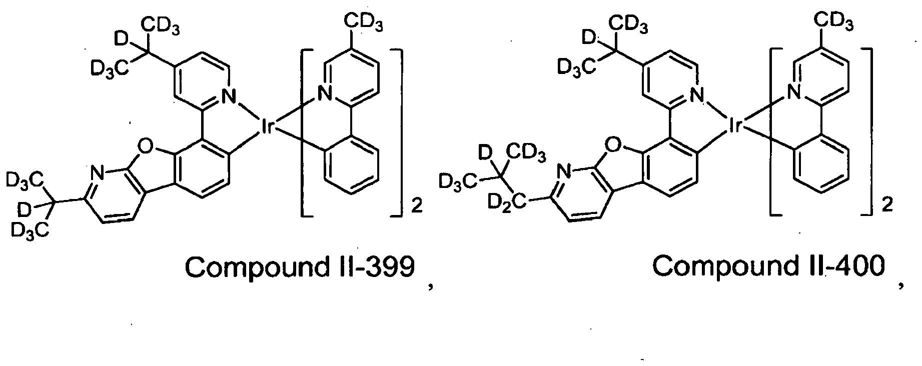 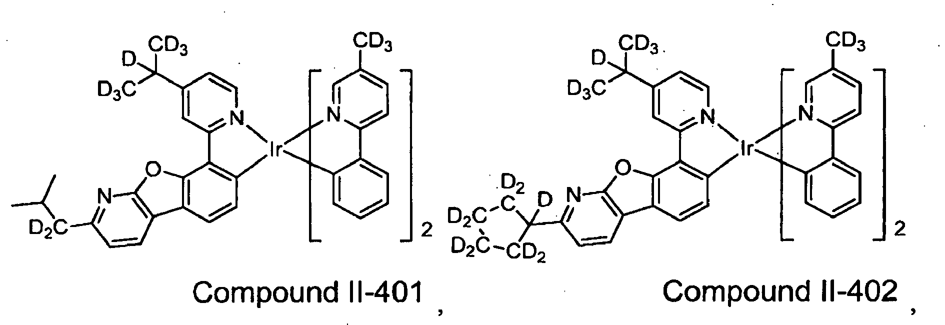 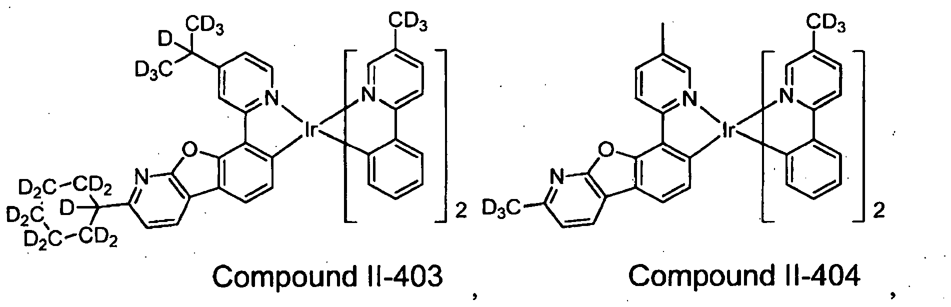 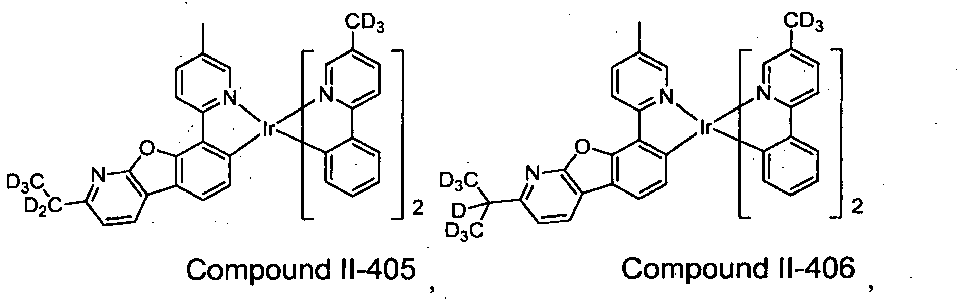 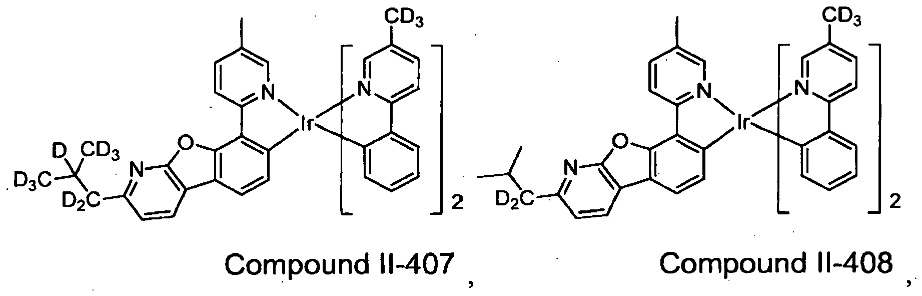 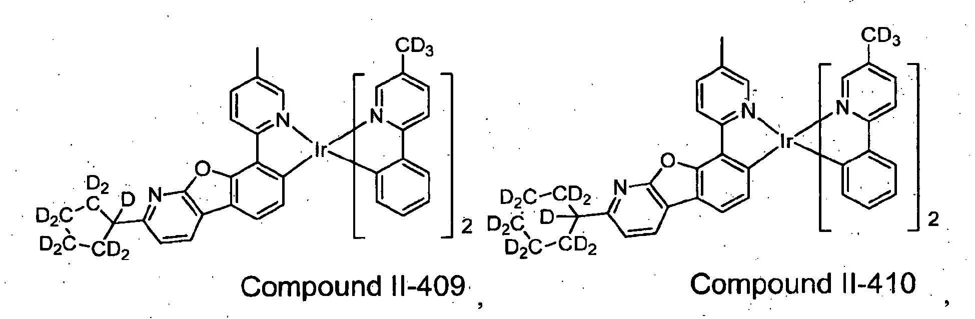 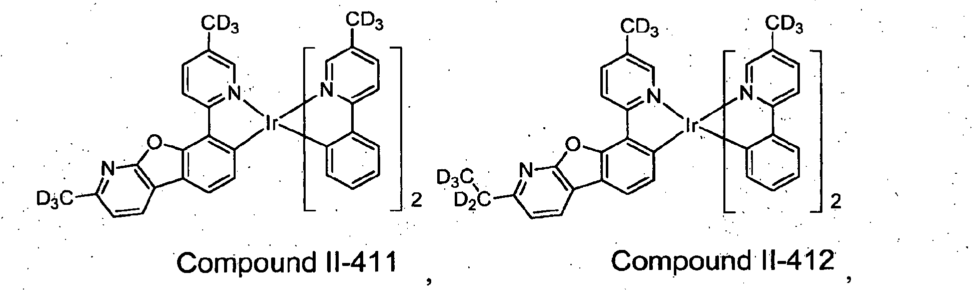 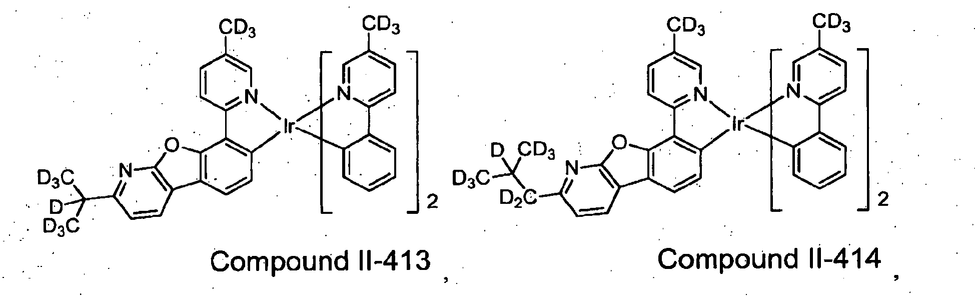 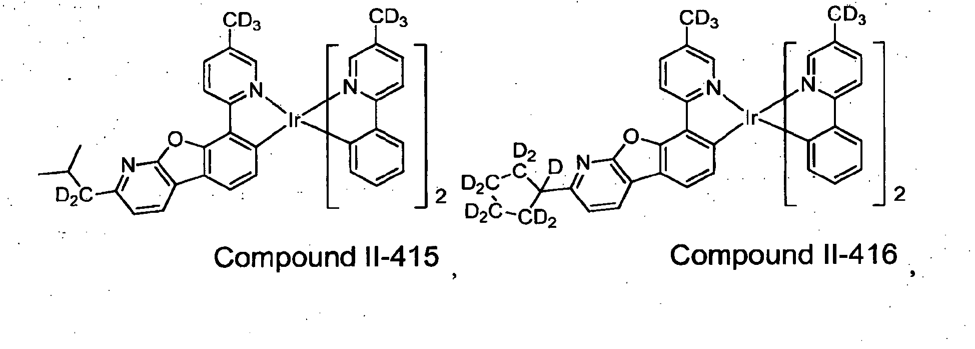 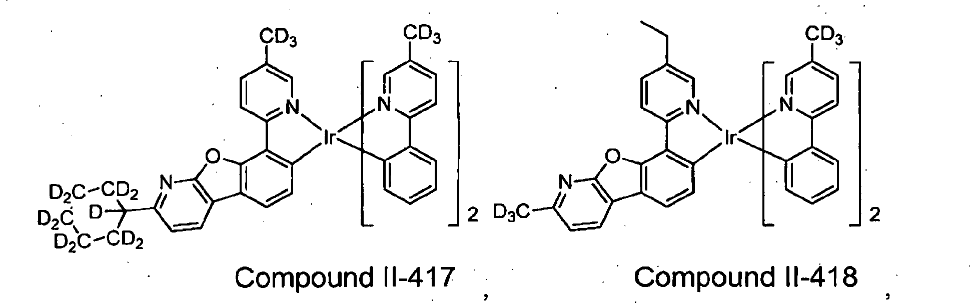 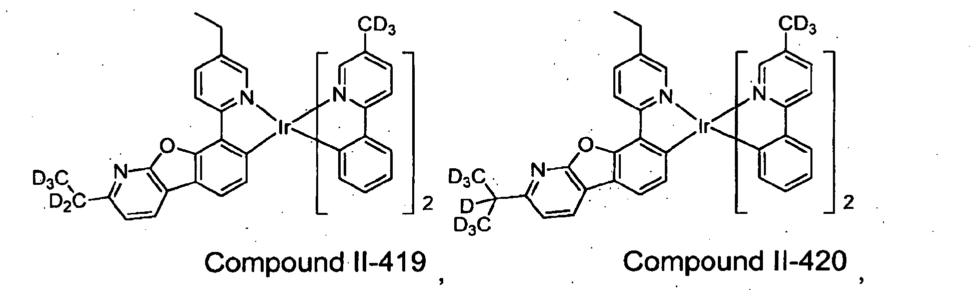 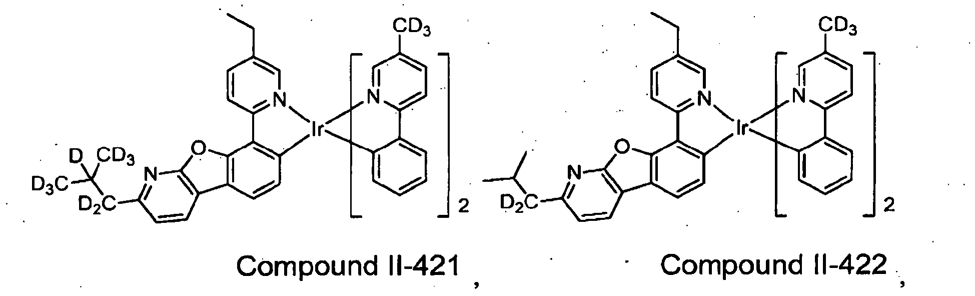 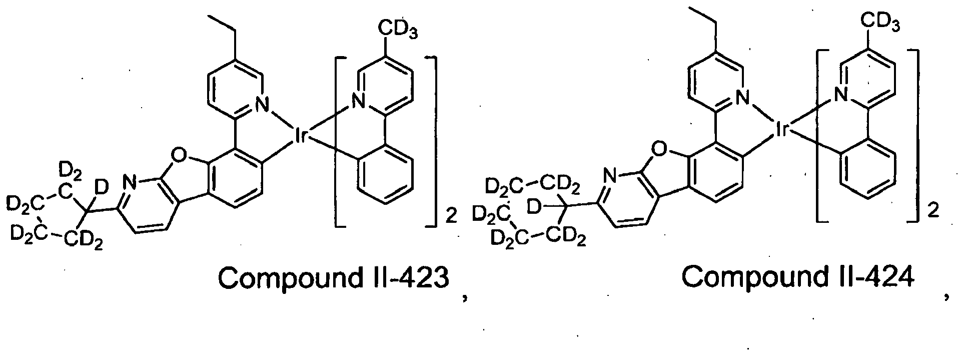 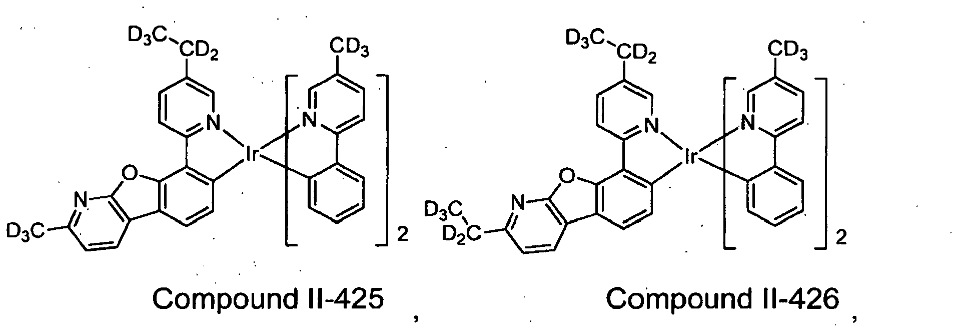 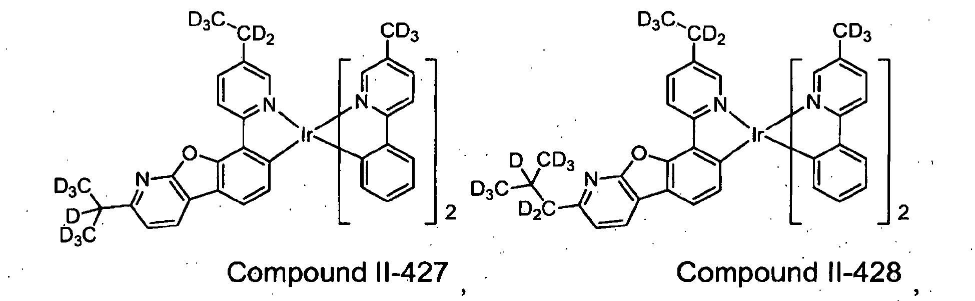 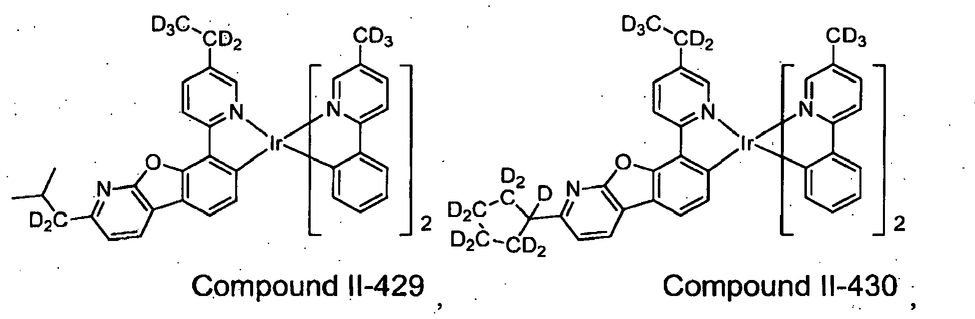 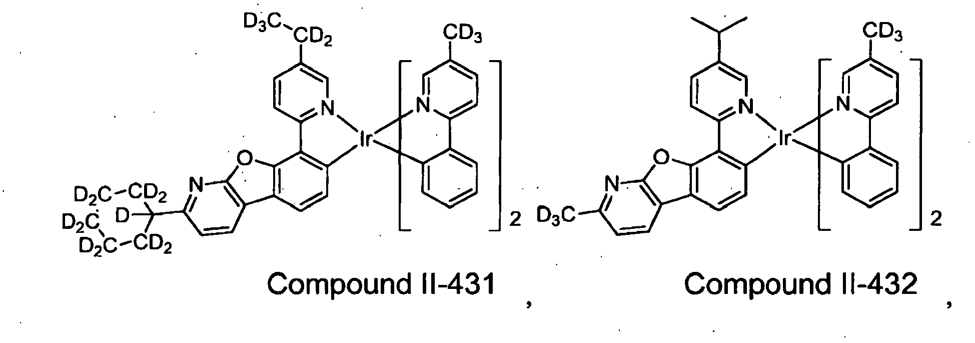 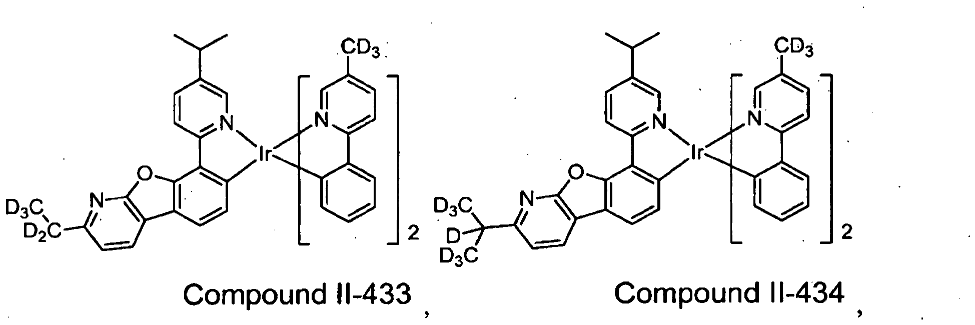 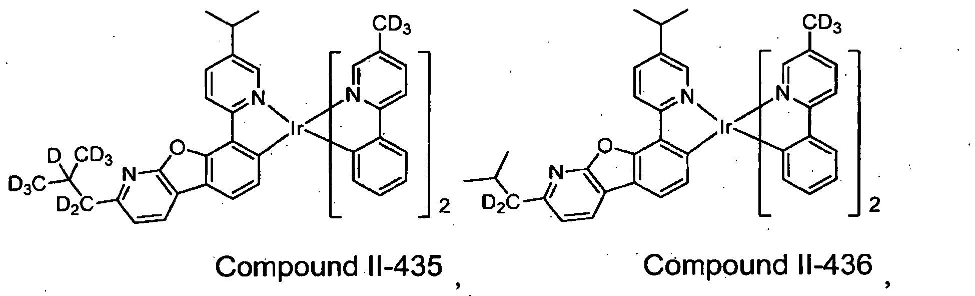 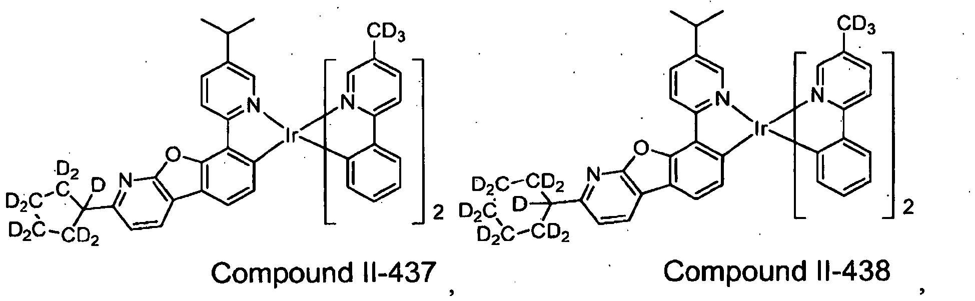 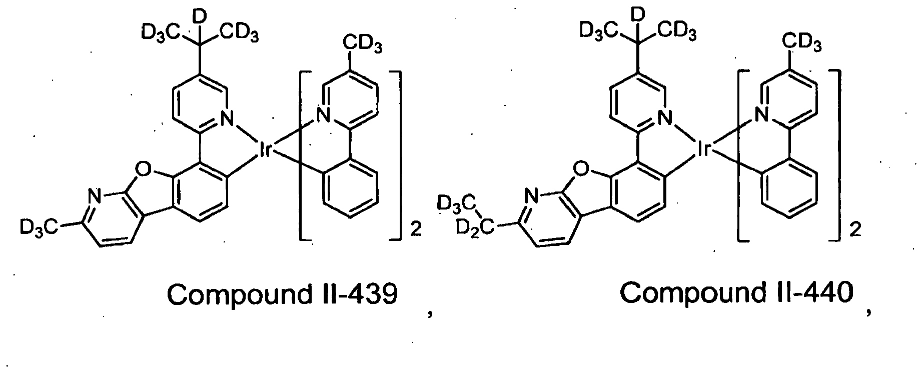 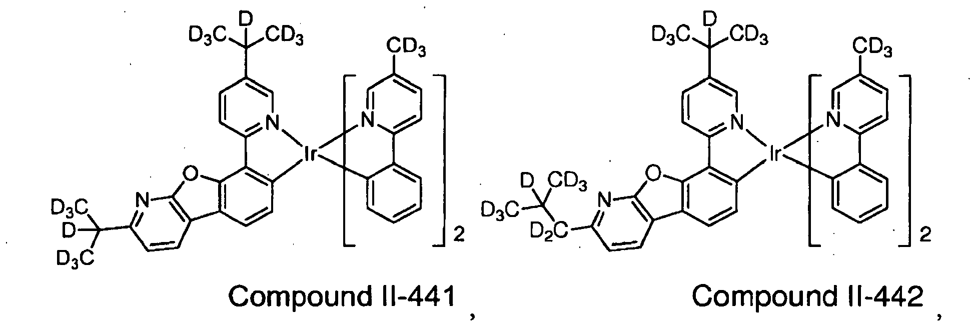 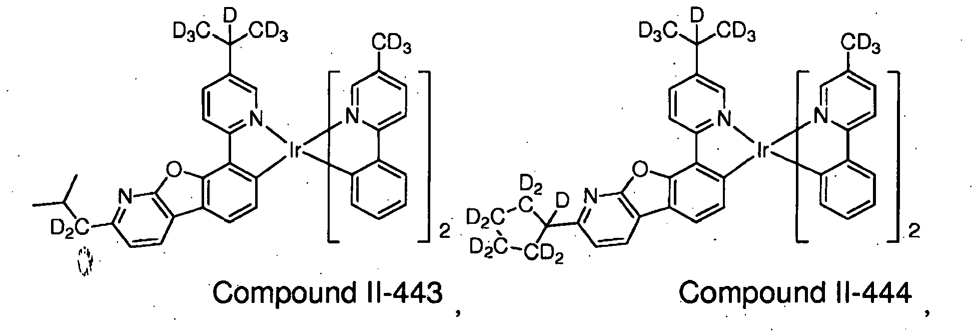 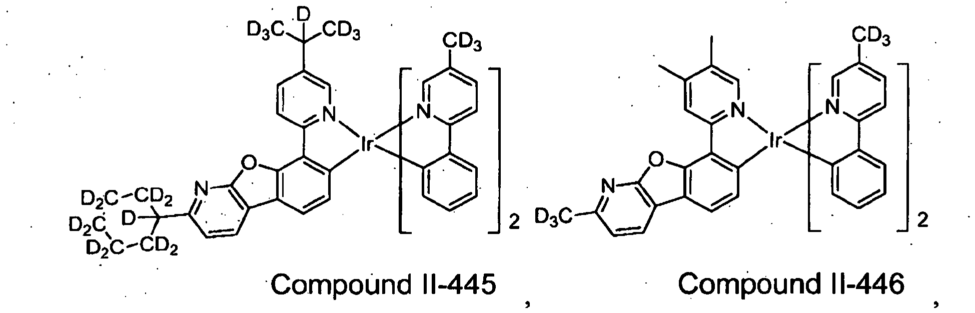 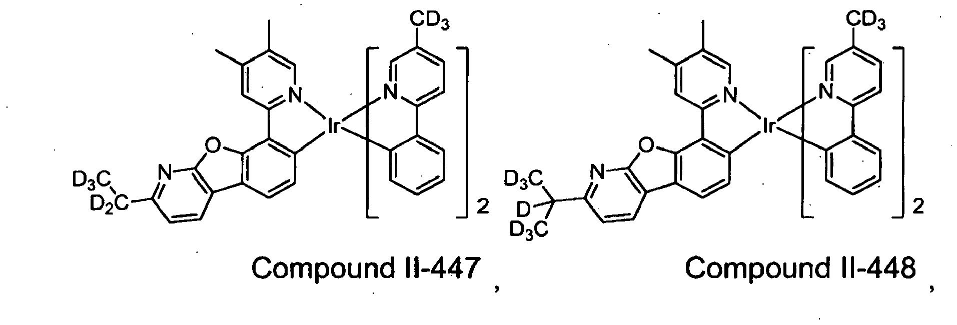 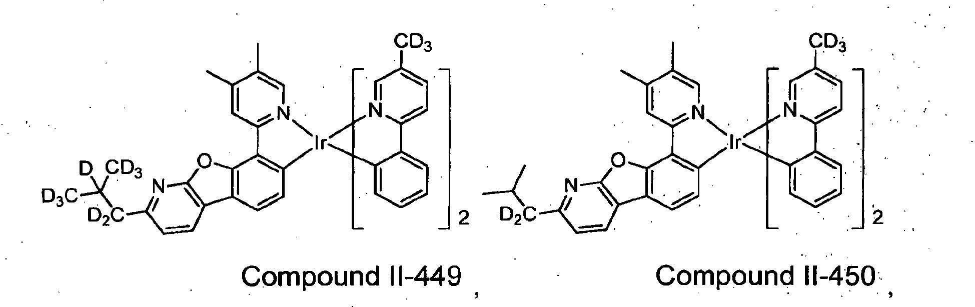 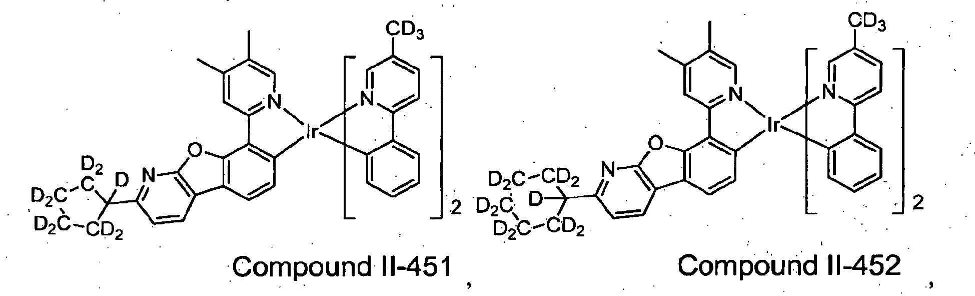 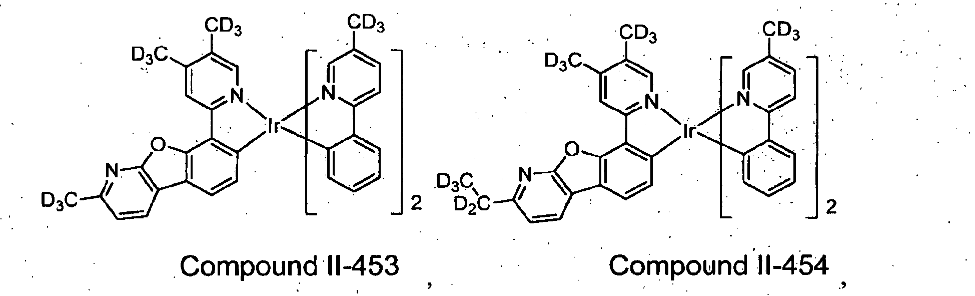 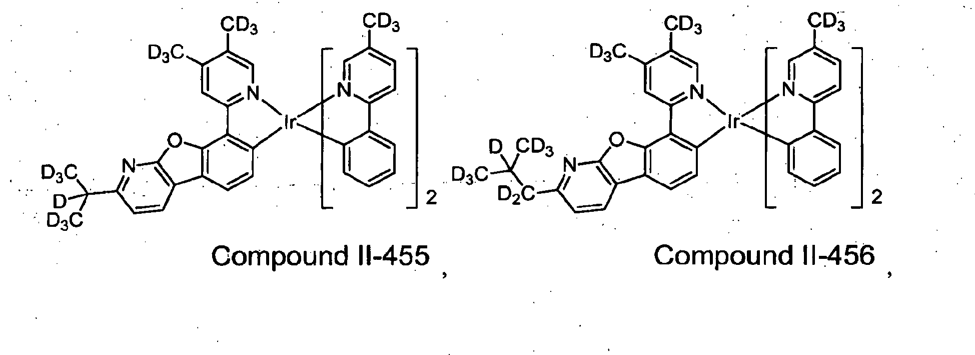 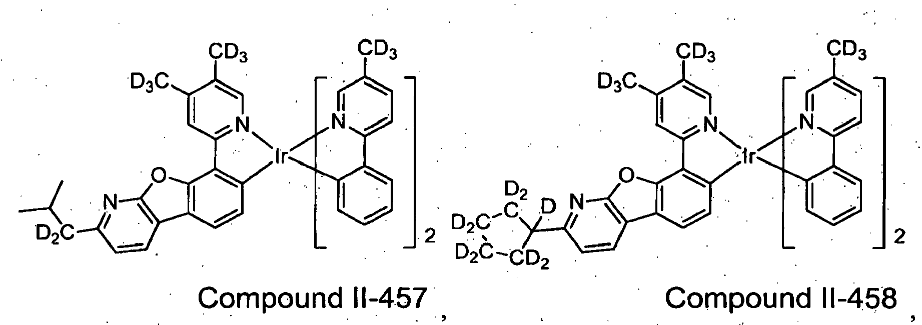 and

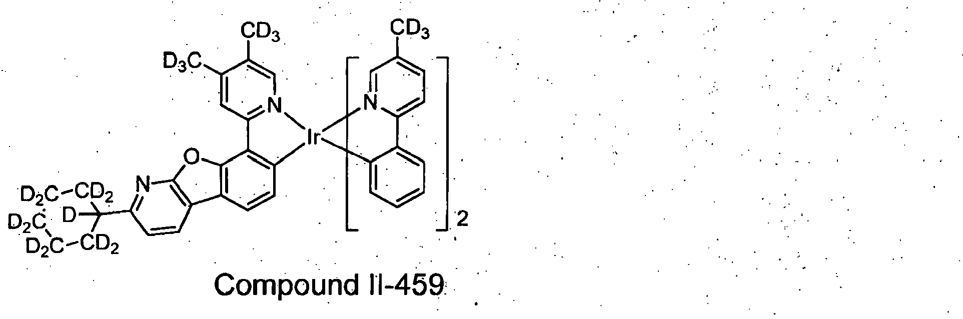

19. The compound of claim 8, wherein L_{A} is selected from the group consisting of:

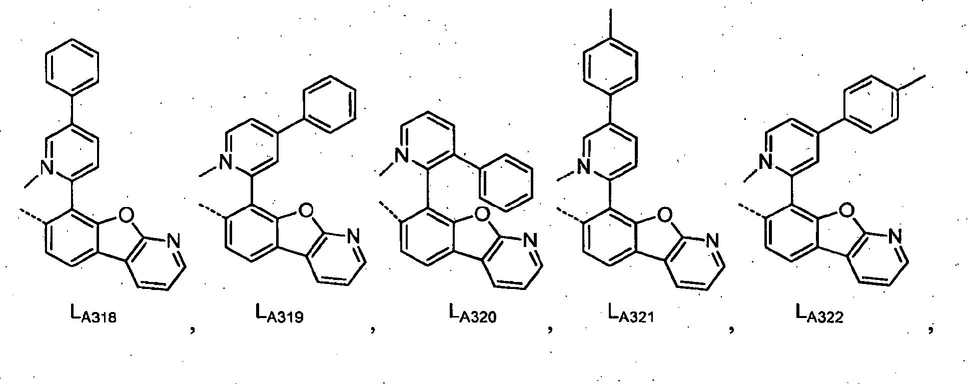

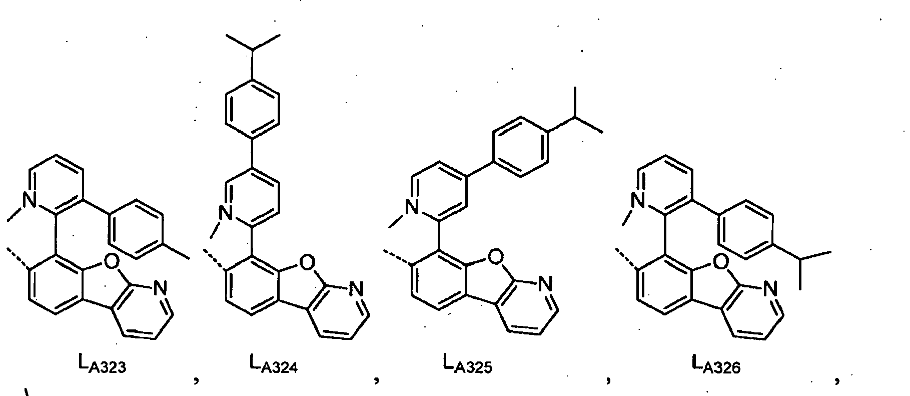

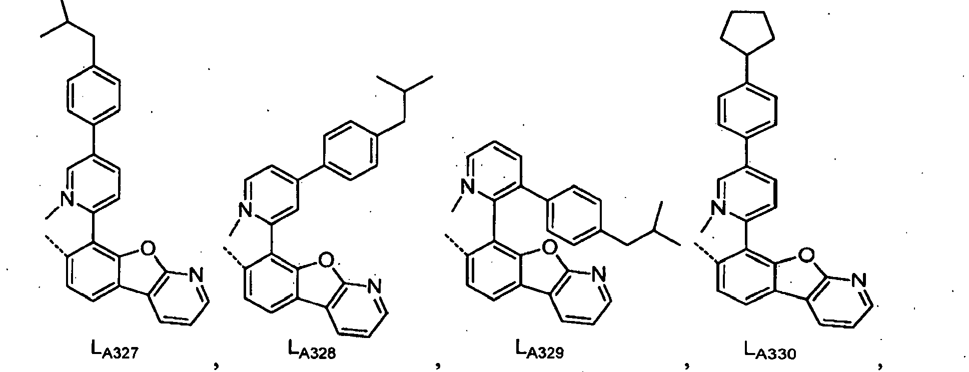

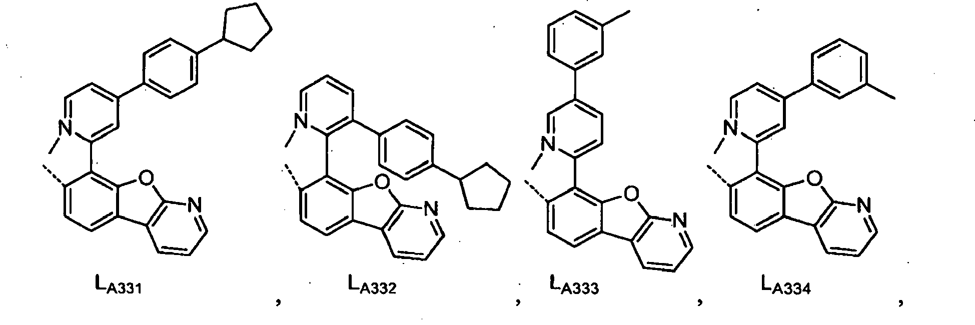

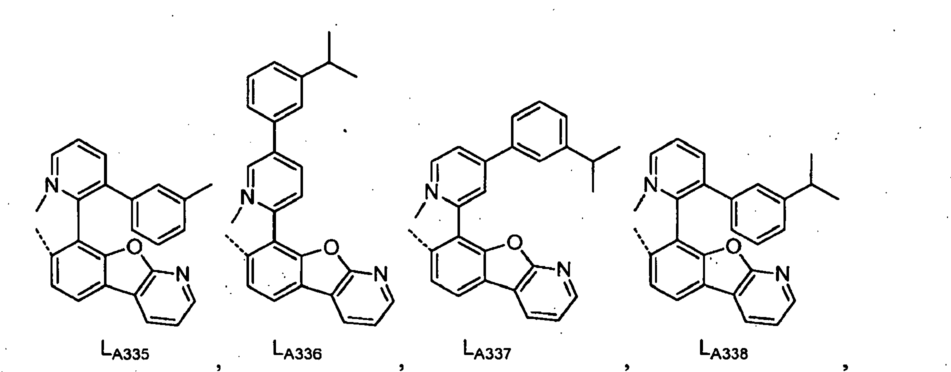

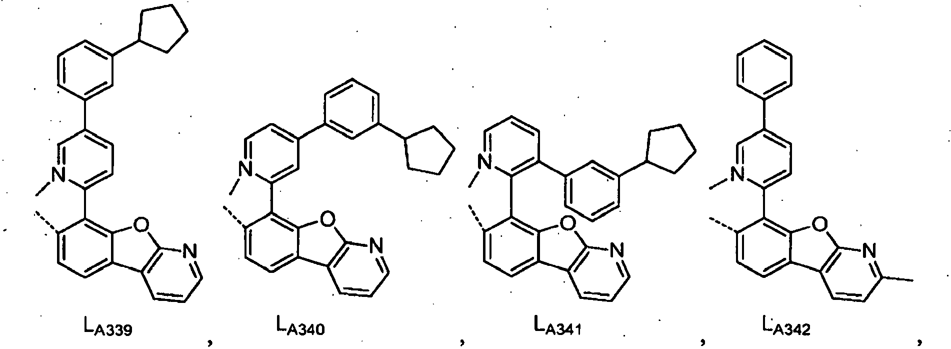

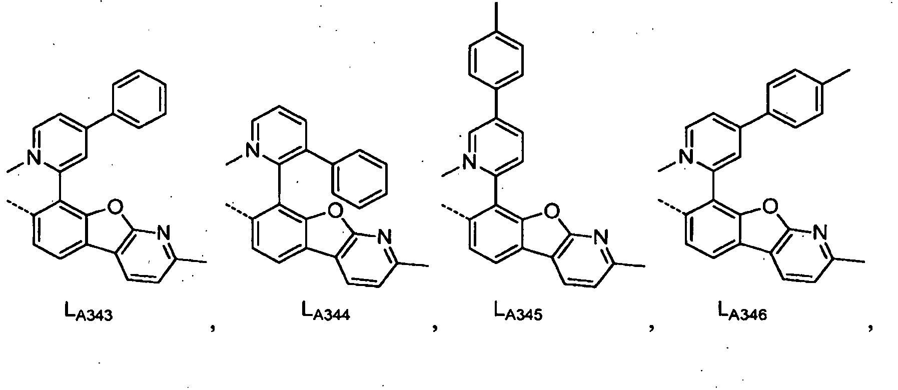

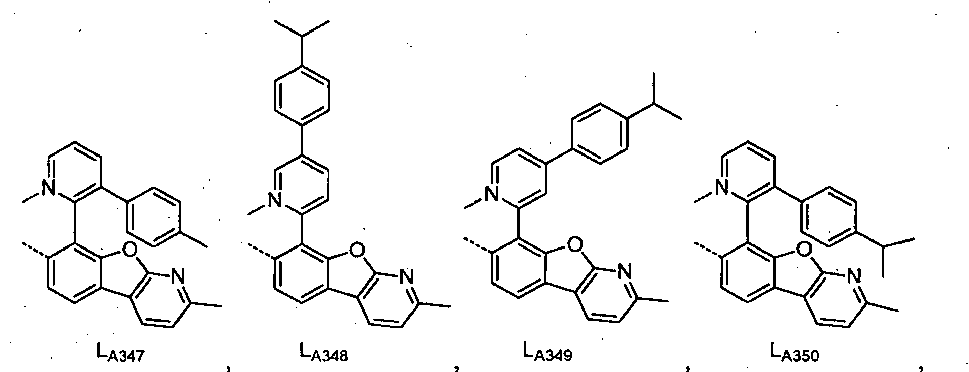

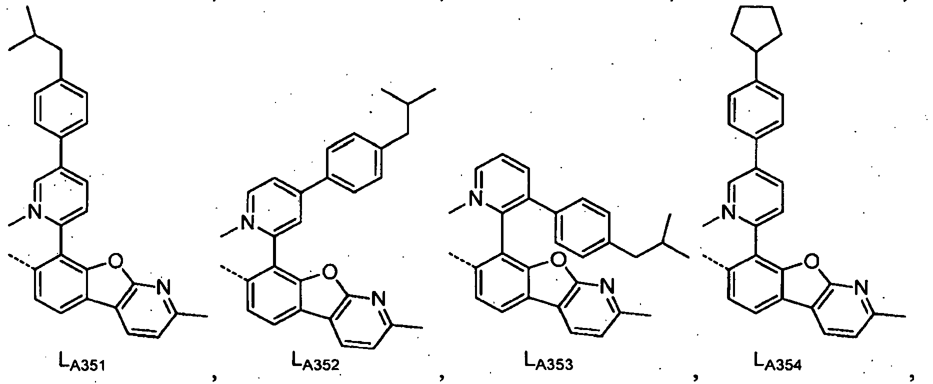

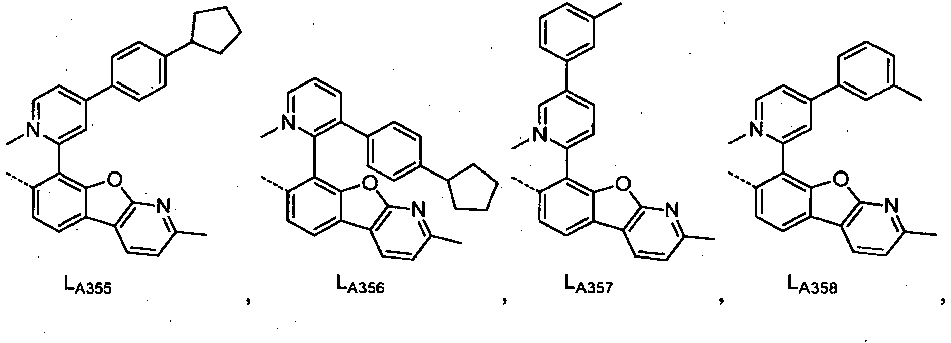

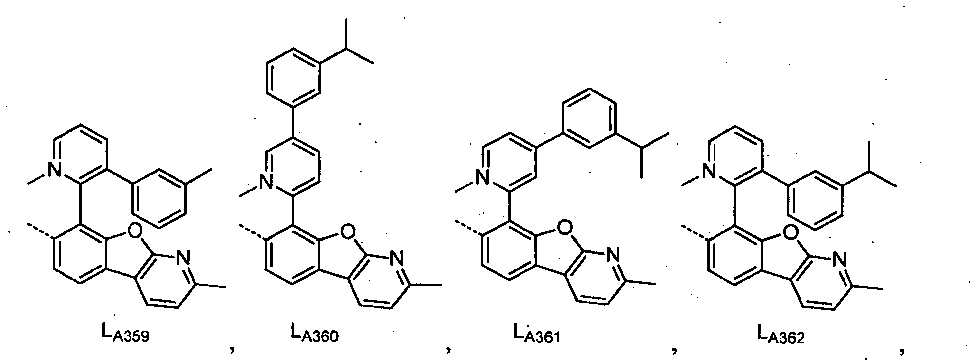

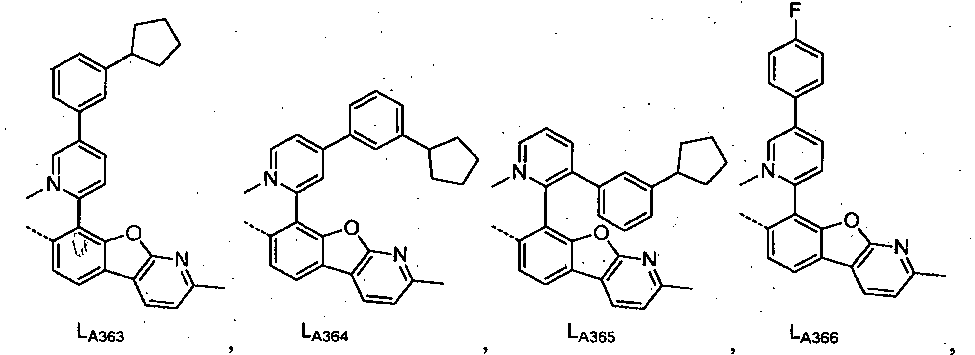

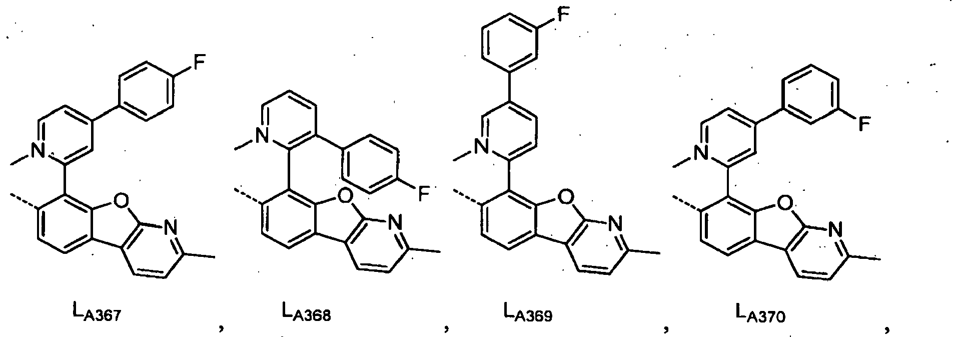

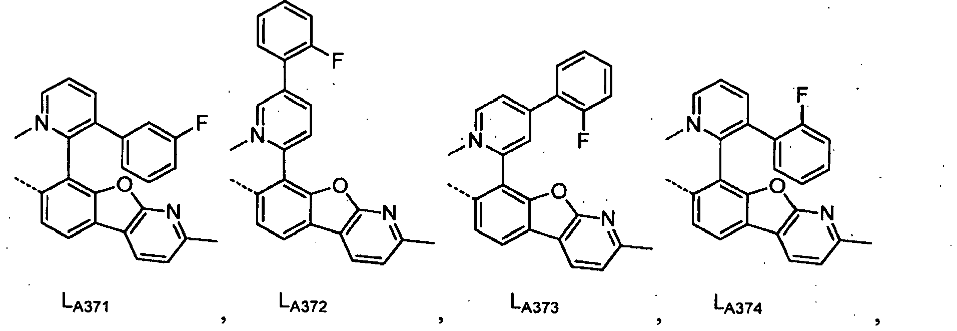

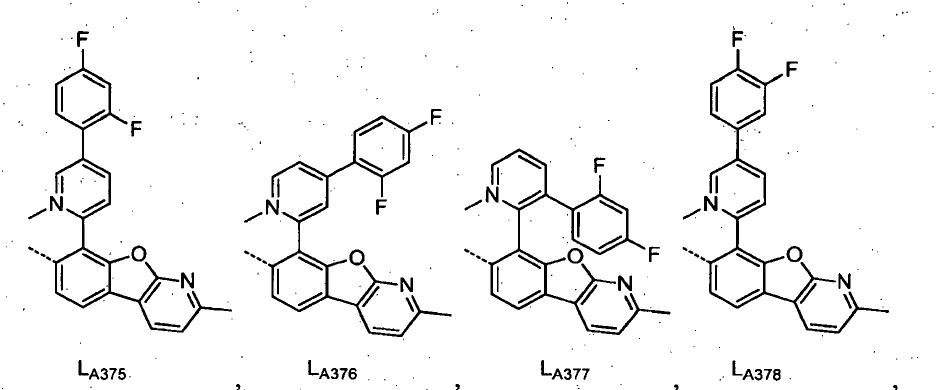

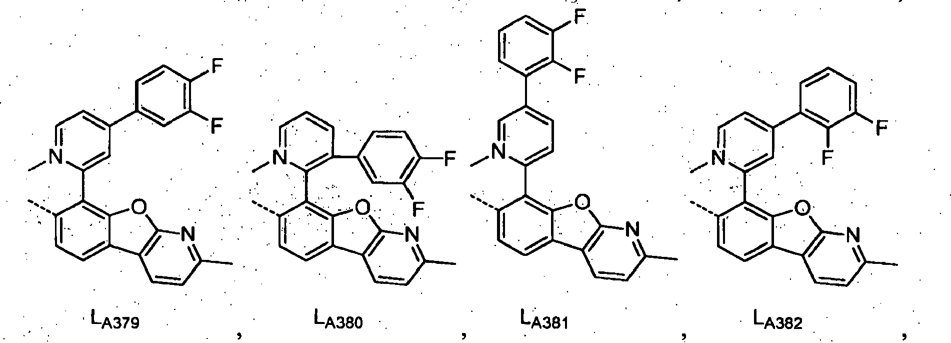

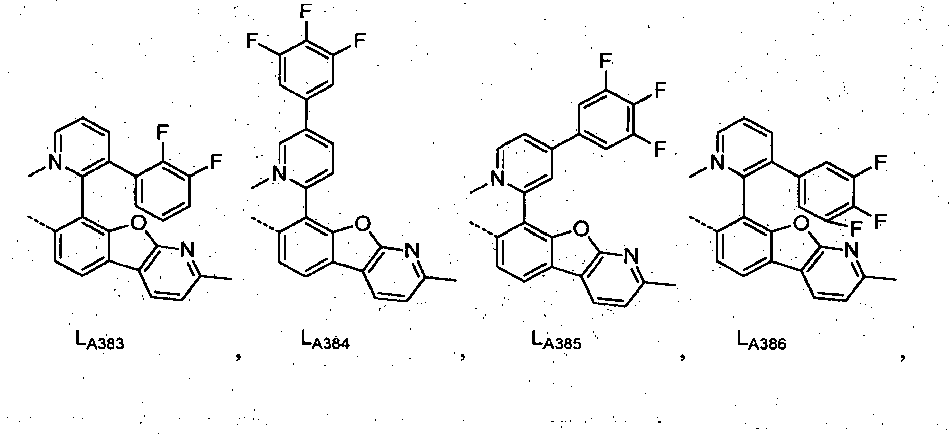

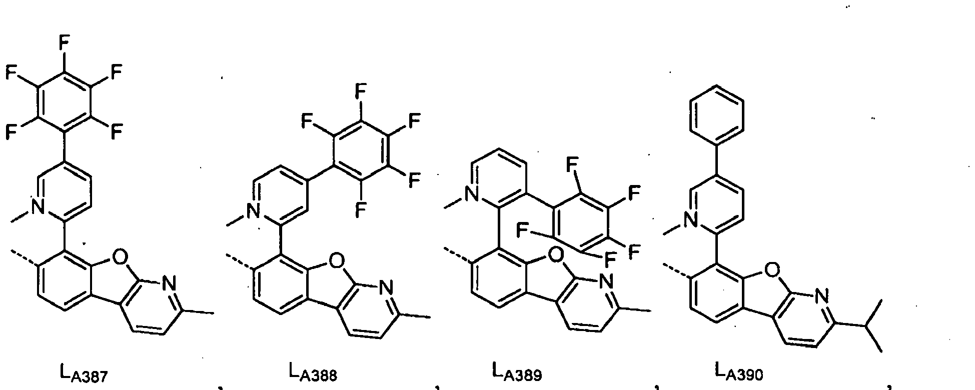

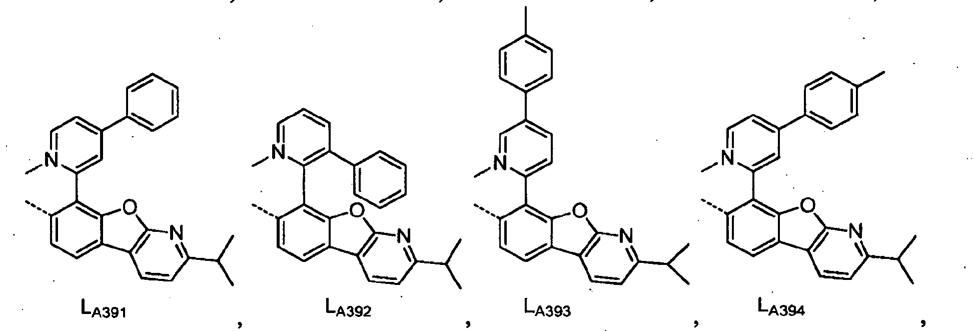

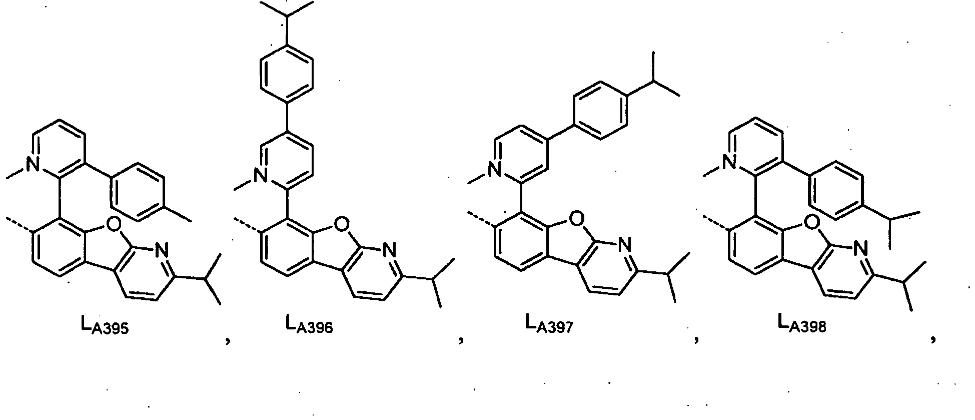

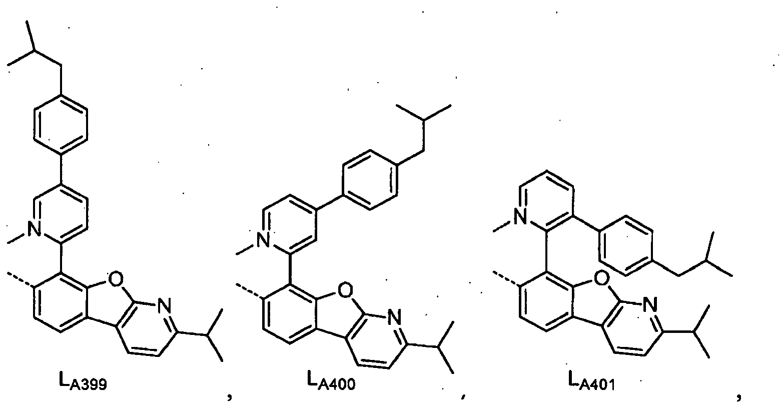

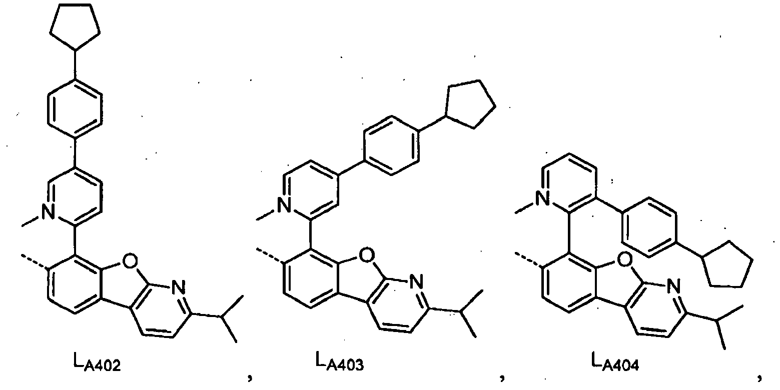

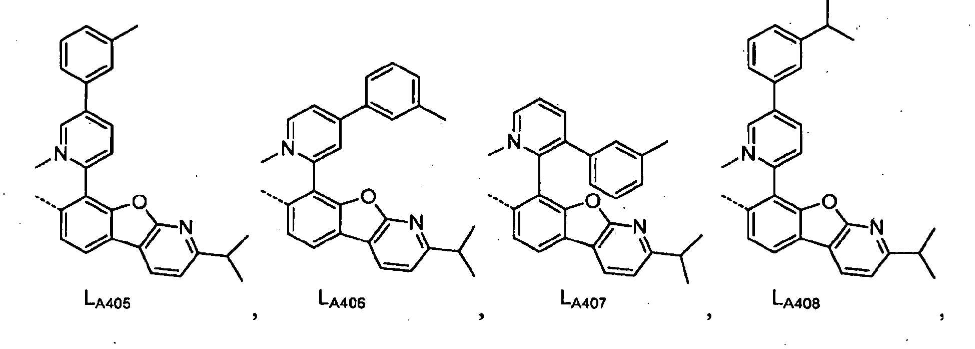

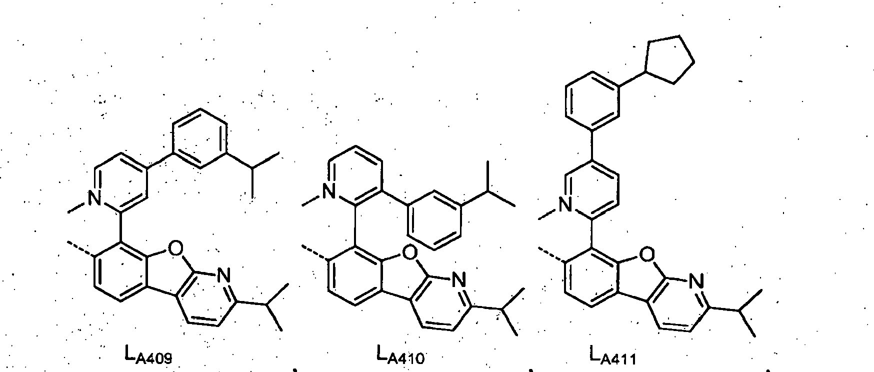

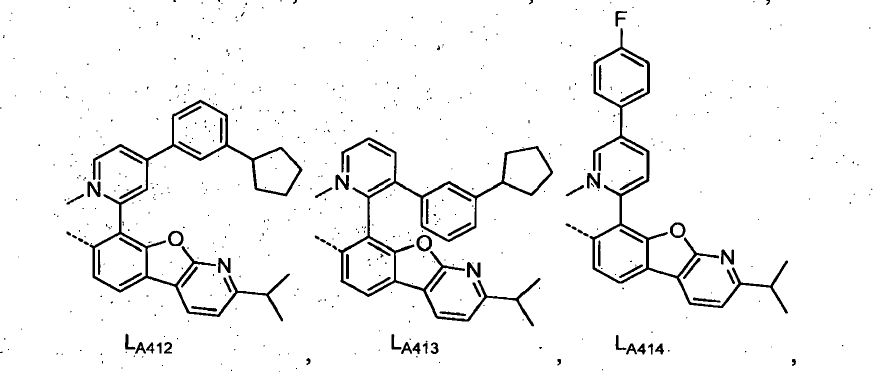

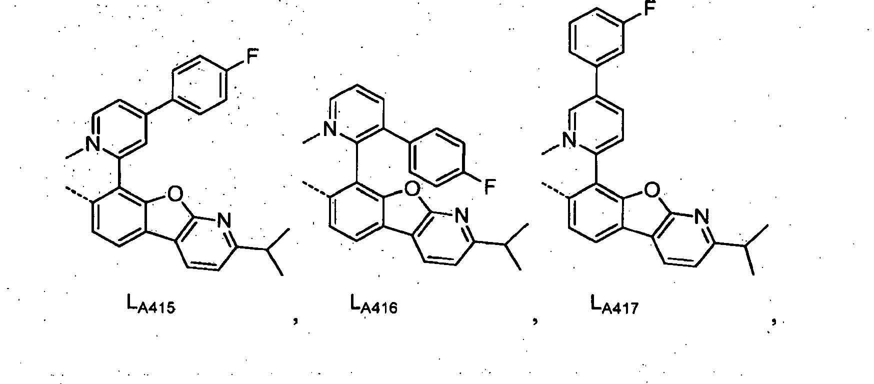

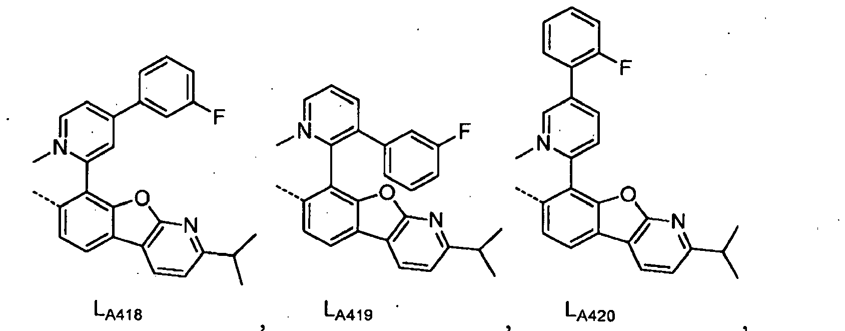

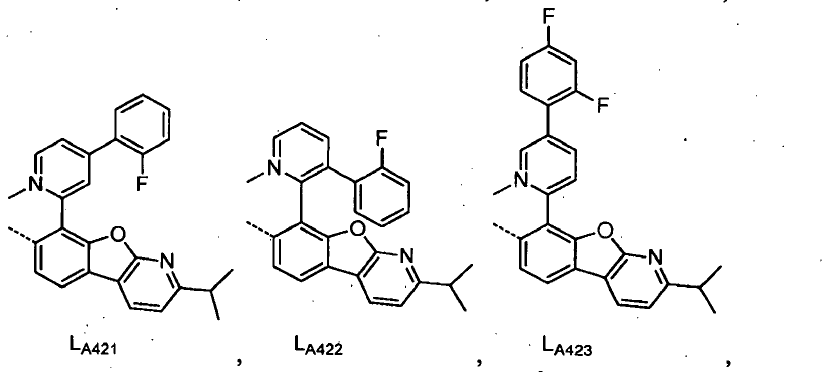

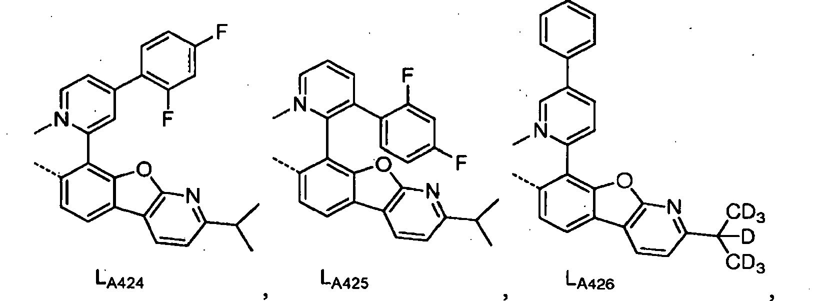

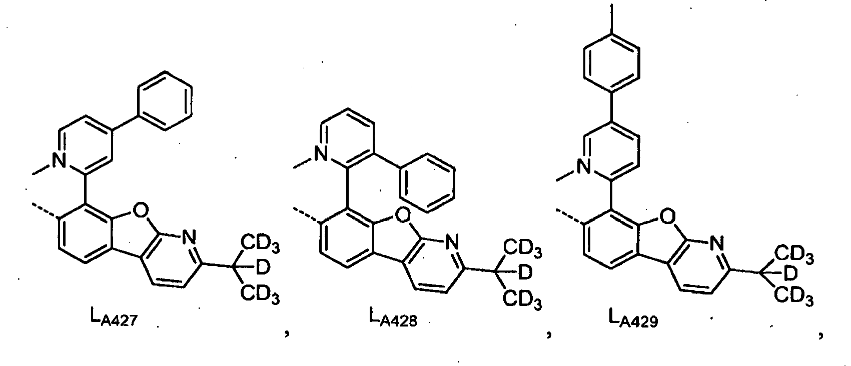

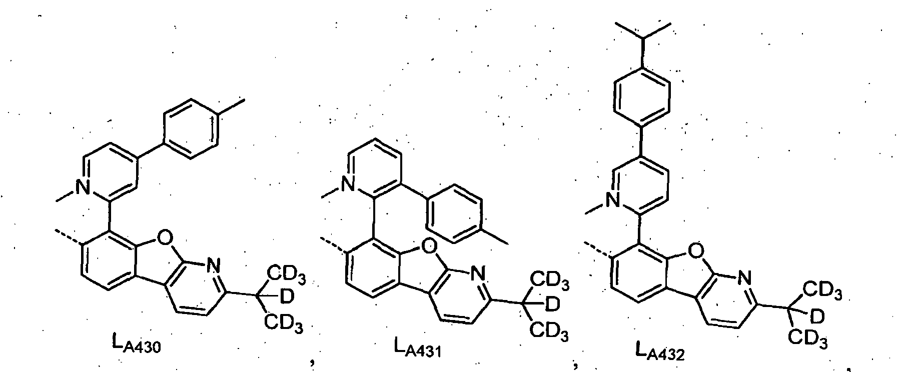

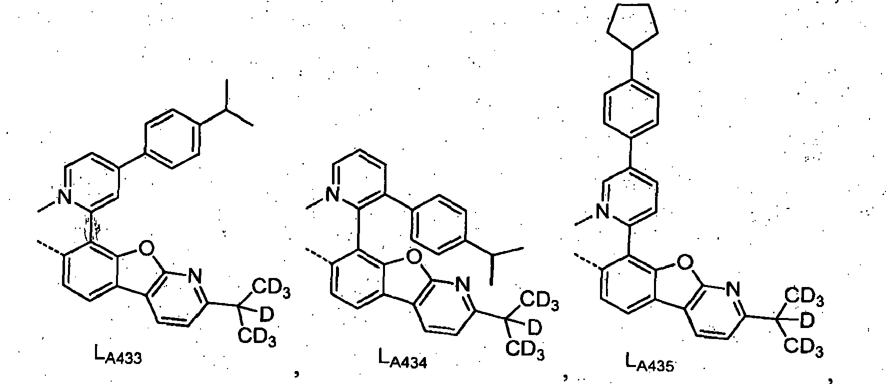

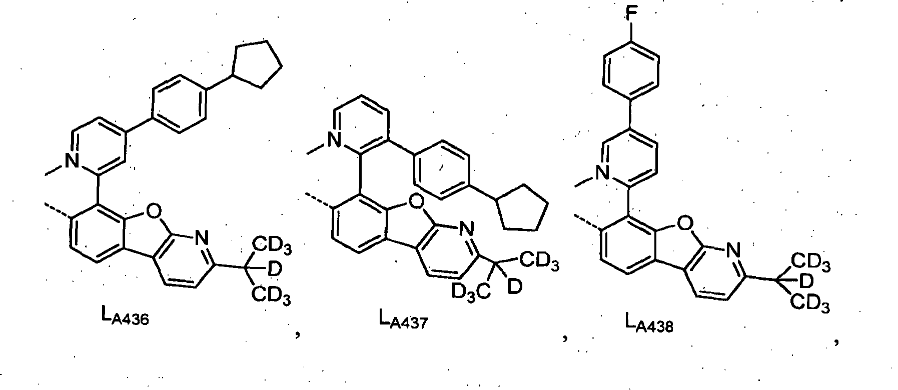

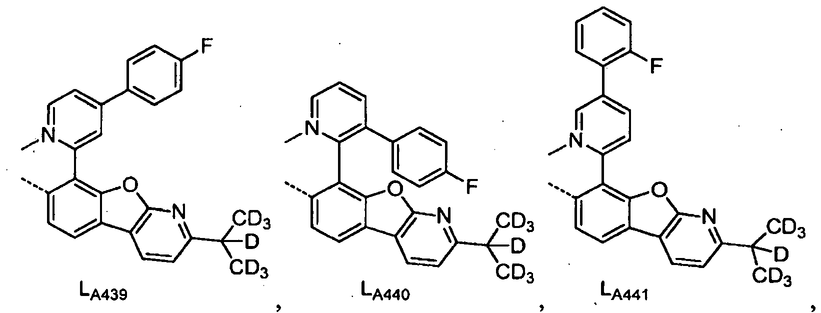

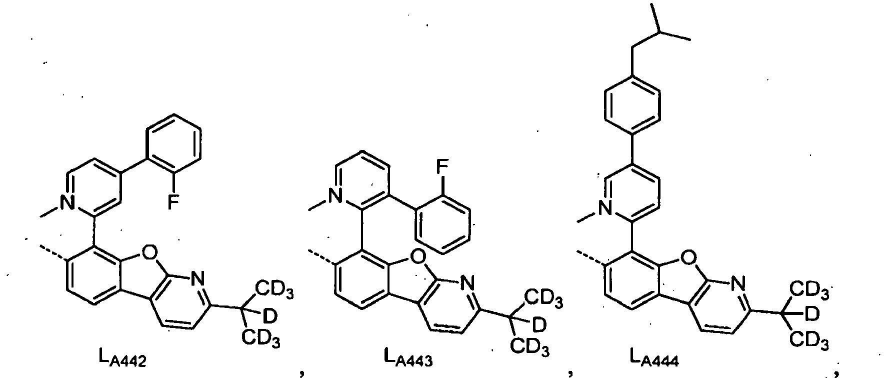

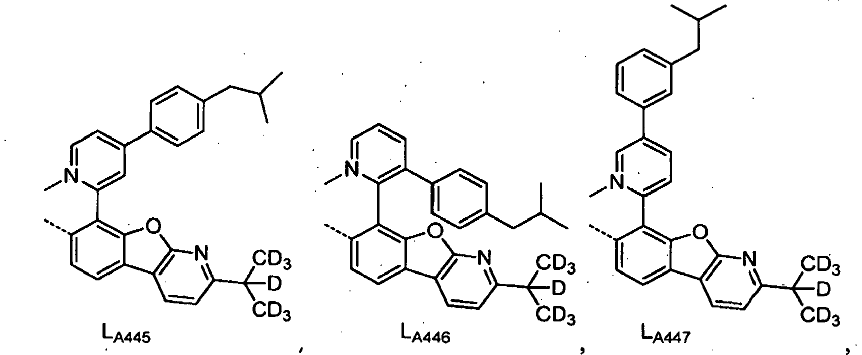

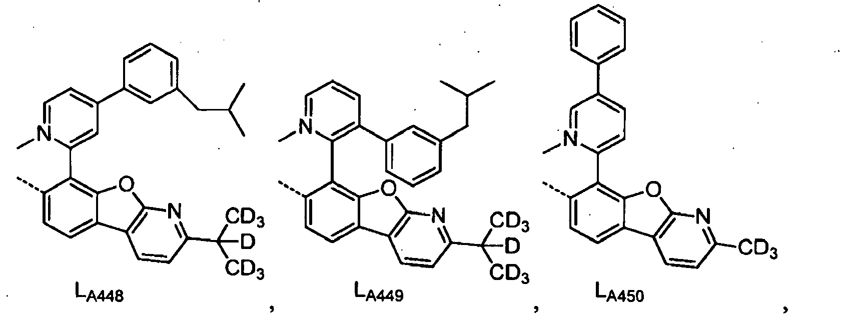

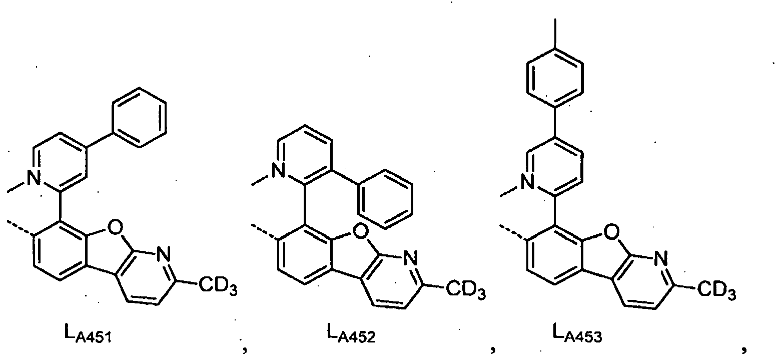

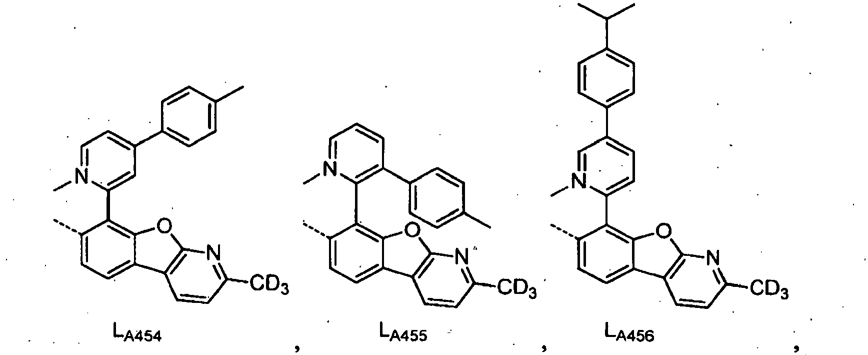

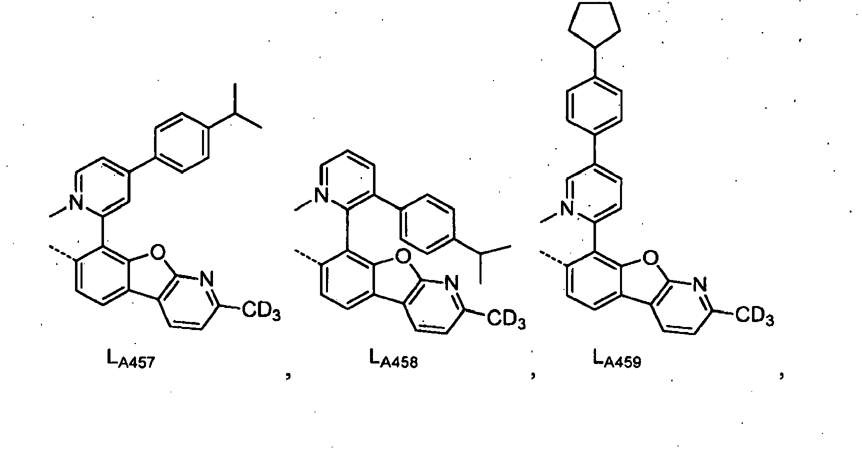

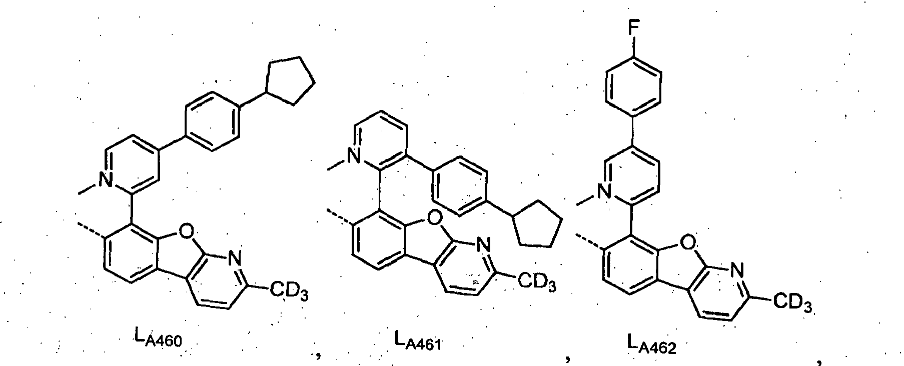

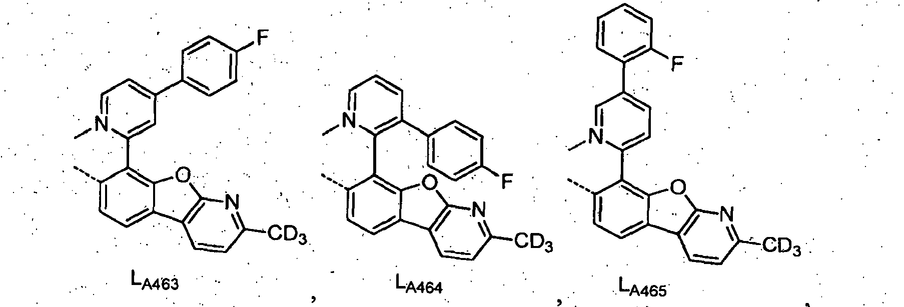

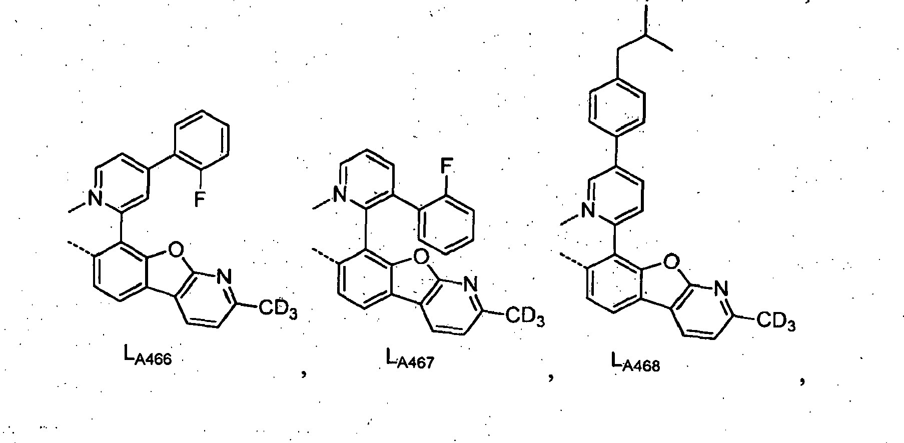

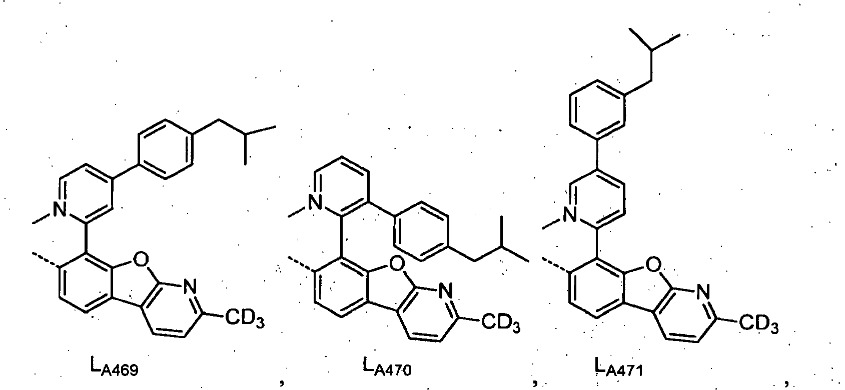

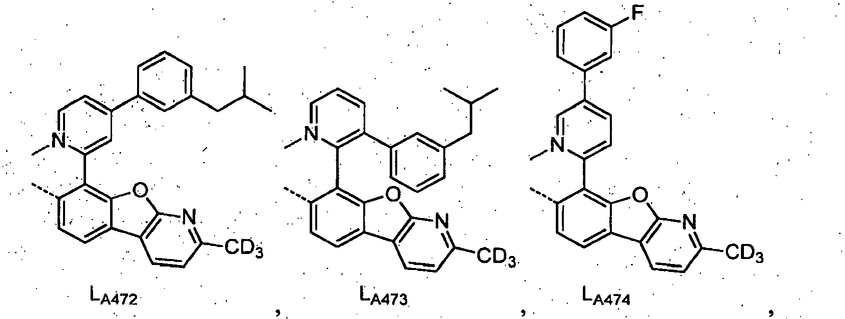

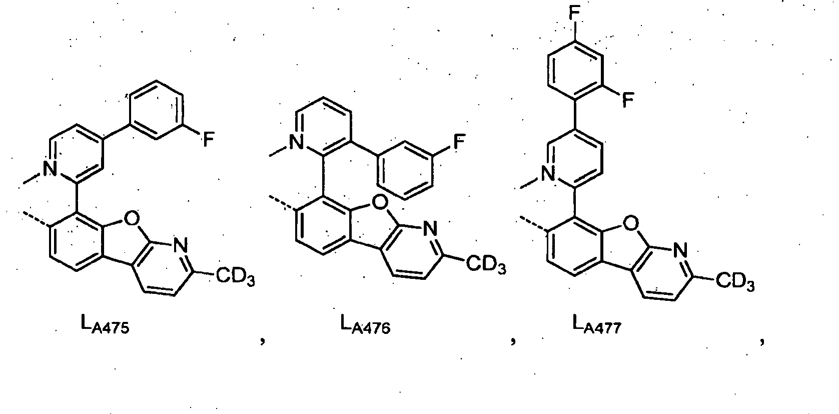

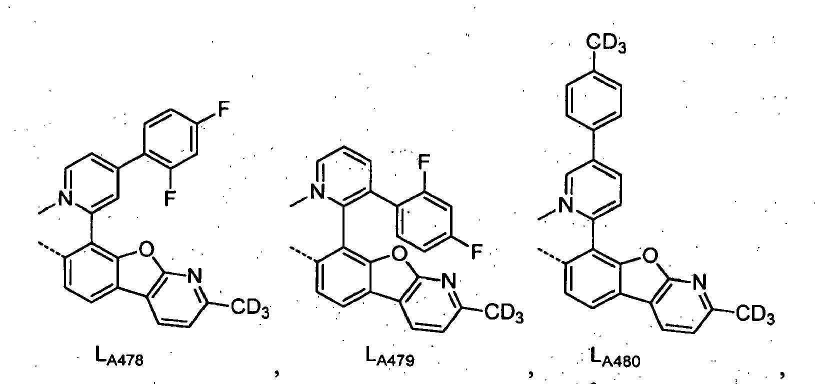

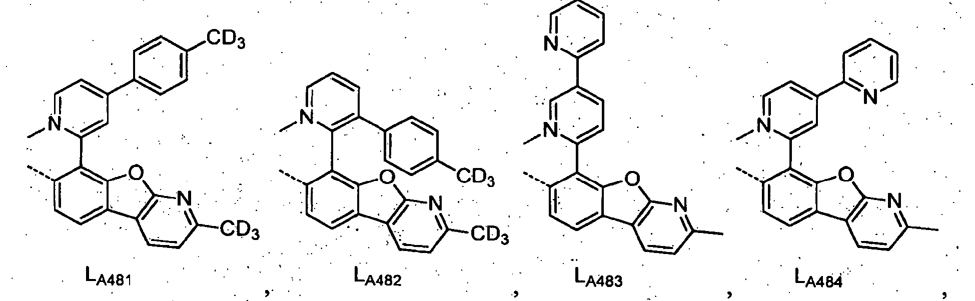

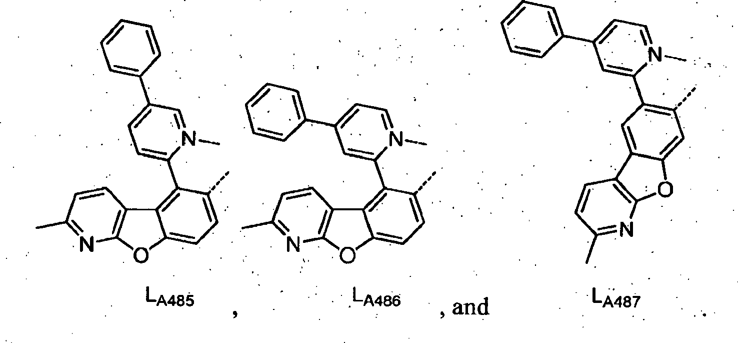

20. The compound of claim 19, wherein L_{B} is selected from the group consisting of:

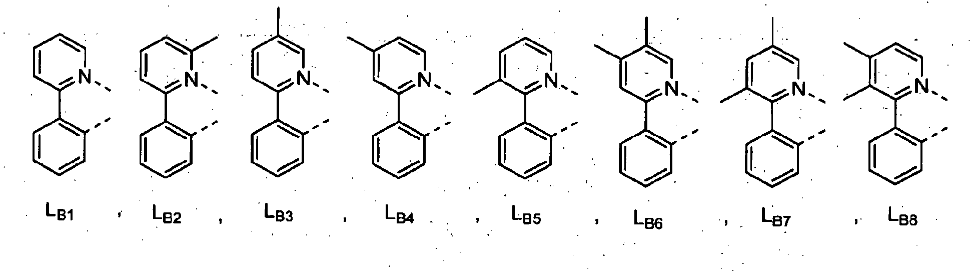

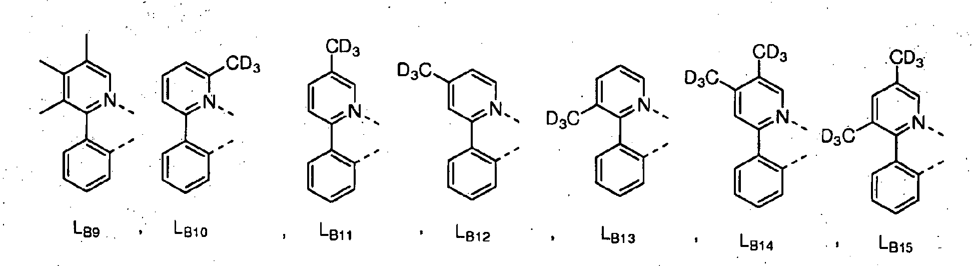

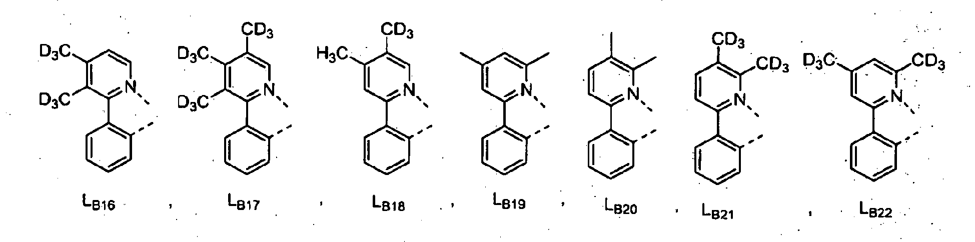

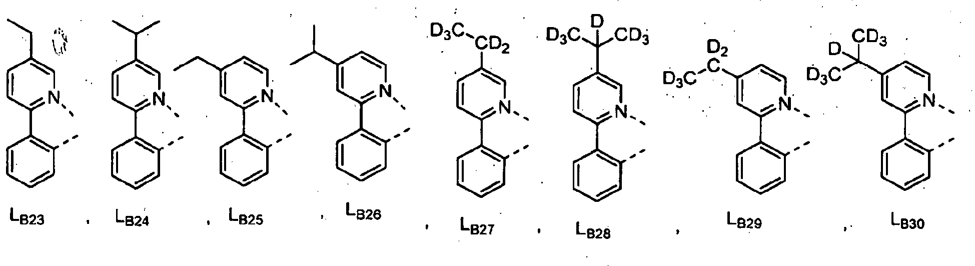

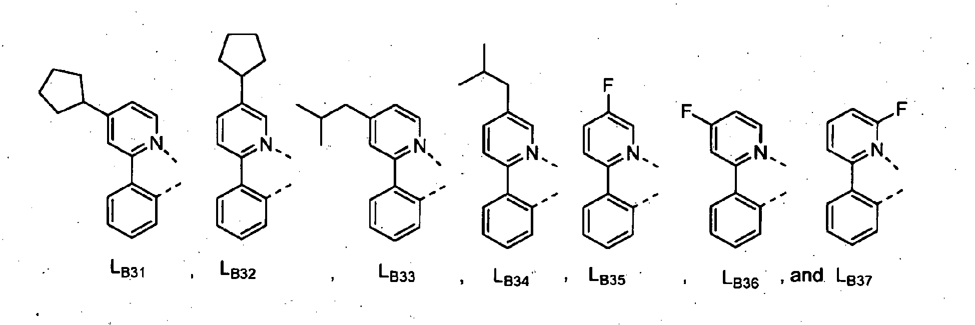

21. The compound of claim 20, wherein the compound is selected from the group consisting of: Ir(L_{A318})(L_{B1})₂ (Compound III-1), Ir(L_{A319})(L_{B1})₂ (Compound III-2), IIr(L_{A320})(L_{B1})₂ (Compound III-3), Ir(L_{A322})(L_{B1})₂ (Compound III-5), Ir(L_{A325})(L_{B1})₂ (Compound III-8), Ir(L_{A328})(L_{B1})₂ (Compound III-11), Ir(L_{A331})(L_{B1})₂ (Compound III-14), Ir(L_{A342})(L_{B1})₂ (Compound III-25), Ir(L_{A343})(L_{B1})₂ (Compound III-26), Ir(L_{A344})(L_{B1})₂ (Compound III-27), Ir(L_{A346})(L_{B1})₂ (Compound III-29), Ir(L_{A349})(L_{B1})₂ (Compound III-32), Ir(L_{A351})(L_{B1})₂ (Compound III-34), Ir(L_{A352})(L_{B1})₂ (Compound III-35), Ir(L_{A354})(L_{B1})₂ (Compound III-37), Ir(L_{A355})(L_{B1})₂ (Compound III-38), Ir(L_{A361})(L_{B1})₂ (Compound III-44), Ir(L_{A363})(L_{B1})₂ (Compound III-46), Ir(L_{A364})(L_{B1})₂ (Compound III-47), Ir(L_{A366})(L_{B1})₂ (Compound III-49), Ir(L_{A367})(L_{B1})₂ (Compound III-50), Ir(L_{A370})(L_{B1})₂ (Compound III-53), Ir(L_{A373})(L_{B1})₂ (Compound III-56), Ir(L_{A376})(L_{B1})₂ (Compound III-59), Ir(L_{A379})(L_{B1})₂ (Compound III-62), Ir(L_{A382})(L_{B1})₂ (Compound III-65), Ir(L_{A385})(L_{B1})₂ (Compound III-68), Ir(L_{A388})(L_{B1})₂ (Compound III-71), Ir(L_{A390})(L_{B1})₂ (Compound III-73), Ir(L_{A391})(L_{B1})₂ (Compound III-74), Ir(L_{A399})(L_{B1})₂ (Compound III-82), Ir(L_{A415})(L_{B1})₂ (Compound III-98), Ir(L_{A414})(L_{B1})₂ (Compound III-97), Ir(L_{A427})(L_{B1})₂ (Compound III-110), Ir(L_{A439})(L_{B1})₂ (Compound III-122), Ir(L_{A450})(L_{B1})₂ (Compound III-133), Ir(L_{A451})(L_{B1})₂ (Compound III-134), Ir(L_{A454})(L_{B1})₂ (Compound III-137), Ir(LA₄₆₀)(L_{B1})₂ (Compound III-143), Ir(L_{A462})(L_{B1})₂ (Compound III-145), Ir(L_{A463})(L_{B1})₂ (Compound III-146), Ir(L_{A468})(L_{B1})₂ (Compound III-151), Ir(L_{A469})(L_{B1})₂ (Compound III-152), Ir(L_{A480})(L_{B1})₂ (Compound III-163), Ir(L_{A481})(L_{B1})₂ (Compound III-164), Ir(L_{A343})(L_{B1})₂ (Compound III-196), Ir(L_{A367})(L_{B1})₂ (Compound III-220), Ir(L_{A346})(L_{B10})₂ (Compound III-1559), Ir(L_{A391})(L_{B10})₂ (Compound III-1604), Ir(L_{A355})(L_{B11})₂ (Compound III-1738), Ir(L_{A367})(L_{B11})₂ (Compound III-1750), Ir(L_{A352})(L_{B26})₂ (Compound III-4285), Ir(L_{A367})(L_{B26})₂ (Compound III-4300), Ir(L_{A367})(L_{B27})₂ (Compound III-4470), Ir(L_{A349})(L_{B28})₂ (Compound III-4622), Ir(L_{A367})(L_{B28})₂ (Compound III-4640), Ir(L_{A418})(L_{B27})₂ (Compound III-4690), Ir(L_{A463})(L_{B28})₂ (Compound III-4736), Ir(L_{A464})(L_{B29})₂ (Compound III-4907), Ir(L_{A463})(L_{B30})₂ (Compound III-5076), Ir(L_{A346})(L_{B36})₂ (Compound III-5979), Ir(L_{A336})(L_{B37})₂ (Compound III-6139), Ir(L_{A367})(L_{B29})₂ (Compound III-4810), Ir(L_{A367})(L_{B30})₂ (Compound III-4980), Ir(L_{A367})(L_{B31})₂ (Compound III-5150), Ir(L_{A367})(L_{B32})₂ (Compound III-5320), Ir(L_{A352})(L_{B33})₂ (Compound III-5475), Ir(L_{A367})(L_{B33})₂ (Compound III-5490), and Ir(L_{A367})(L_{B34})₂ (Compound III-5660).

22. A first device comprising a first organic light emitting device, further comprising:
an anode;
a cathode; and
an organic layer, disposed between the anode and the cathode, comprising a compound having the formula Ir(L_{A})ₙ(L_{B})₃₋ₙ, having the structure: 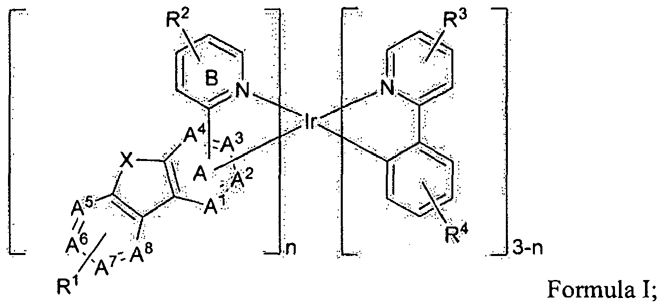 wherein A¹, A², A³, A⁴, A⁵, A⁶, A⁷, and A⁸ comprise carbon or nitrogen;
wherein at least one of A¹, A², A³, A⁴, A⁵, A⁶, A⁷, and A⁸ is nitrogen;
wherein ring B is bonded to ring A through a C-C bond;
wherein the iridium is bonded to ring A through a Ir-C bond;
wherein X is O, S, or Se;
wherein R¹, R², R³, and R⁴ independently represent mono-, di-, tri-, tetra-substitution, or no substitution;
wherein any adjacent substitutions in R¹, R², R³, and R⁴ are optionally linked together to form a ring;
wherein R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is an integer from 1 to 3.

23. A formulation comprising a compound having the formula Ir(L_{A})ₙ(L_{B})₃₋ₙ, having the structure: 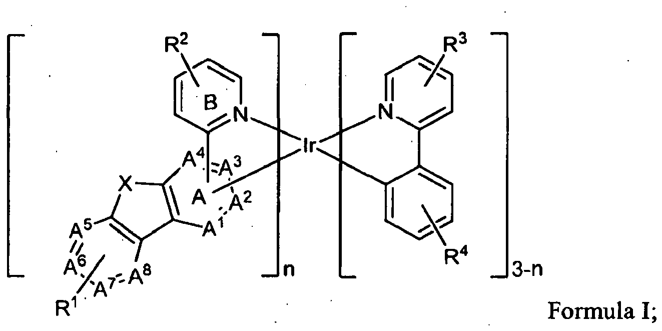 wherein A¹, A², A³, A⁴, A⁵, A⁶, A⁷, and A⁸ comprise carbon or nitrogen;
wherein at least one of A¹, A², A³, A⁴, A⁵, A⁶, A⁷, and A⁸ is nitrogen;
wherein ring B is bonded to ring A through a C-C bond;
wherein the iridium is bonded to ring A through a Ir-C bond;
wherein X is O, S, or Se;
wherein R¹, R², R³, and R⁴ independently represent mono-, di-, tri-, tetra-substitution, or no substitution;
wherein any adjacent substitutions in R¹, R², R³, and R⁴ are optionally linked together to form a ring;
wherein R¹, R², R³, and R⁴ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is an integer from 1 to 3.

## Patentansprüche

1. Eine Verbindung mit der Formel Ir(L_{A})ₙ(Lₐ)₃₋ₙ, mit der folgenden Struktur: 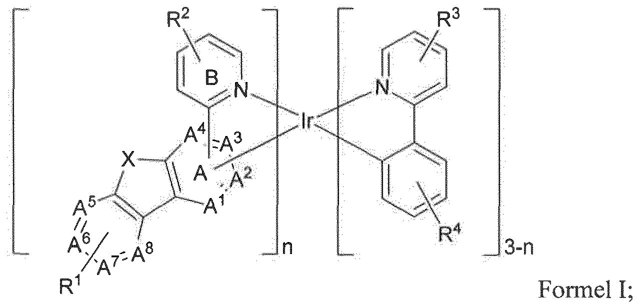 wobei A¹, A², A³, A⁴, A⁵, A⁶, A⁷, und A⁸ Kohlenstoff oder Stickstoff umfassen;
wobei mindestens einer von A¹, A², A³, A⁴, A⁵, A⁶, A⁷, und A⁸ Stickstoff ist;
wobei Ring B mittels einer C-C Bindung an Ring A gebunden ist;
wobei das Iridium mittels einer Ir-C Bindung an Ring A gebunden ist;
wobei X für O, S, oder Se steht;
wobei R¹, R², R³, und R⁴ unabhängig voneinander für mono-, di-, tri-, tetra-Substitutionen, oder keine Substitution stehen;
wobei beliebige benachbarte Substitutionen von R¹, R², R³, und R⁴ gegebenenfalls miteinander verknüpft sind um einen Ring zu bilden;
wobei R¹, R², R³, und R⁴ unabhängig voneinander ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitrile, Isonitrile, Sulfanyl, Sulfinyl, Sulfonyl, Phosphino, und deren Kombinationen; und
wobei n eine ganze Zahl von 1 to 3 ist.

2. Verbindung nach Anspruch 1, wobei die Verbindung die folgende Formul aufweist:

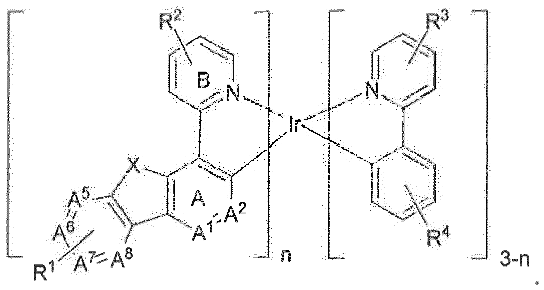

3. Verbindung nach Anspruch 1 oder 2, wobei n gleich 1 ist.

4. Verbindung nach einem der Ansprüche 1 bis 3, wobei nur einer aus A¹ bis A⁸ Stickstoff ist.

5. Verbindung nach einem der Ansprüche 1 bis 4, wobei X für O steht.

6. Verbindung nach einem der Ansprüche 1 bis 5, wobei R¹, R², R³, und R⁴ unabhängig voneinander ausgewählt sind aus der Gruppe bestehend aus Wasserstoff, Deuterium, Alkyl, und deren Kombinationen.

7. Verbindung nach einem der Ansprüche 1 bis 6, wobei R² Alkyl ist.

8. Verbindung nach einem der Ansprüche 1 bis 6, wobei R² ausgewählt ist aus der Gruppe bestehend aus Aryl, substituiertes Aryl, Heteroaryl, und substituiertes Heteroaryl.

9. Verbindung nach einem der Ansprüche 1 bis 8, wobei R³ Alkyl ist.

10. Verbindung nach Anspruch 1, wobei L_{A} ausgewählt ist aus der Gruppe bestehend aus:

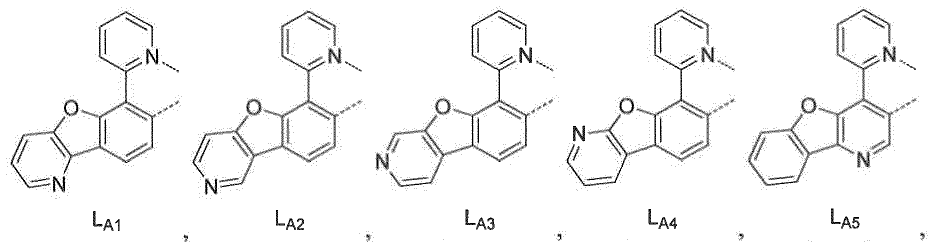

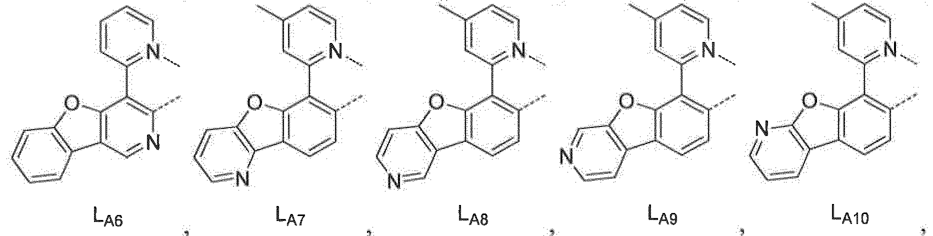

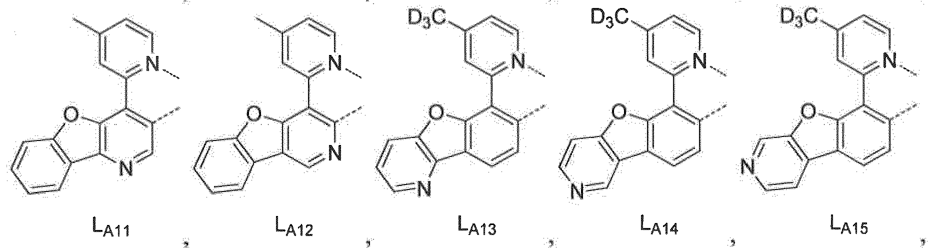

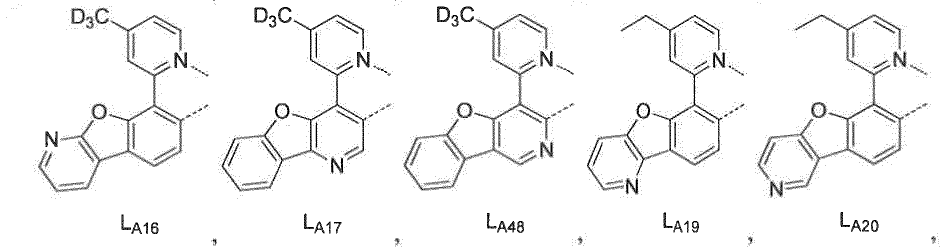

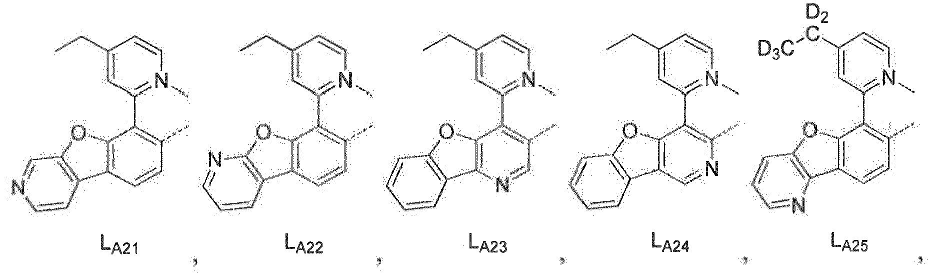

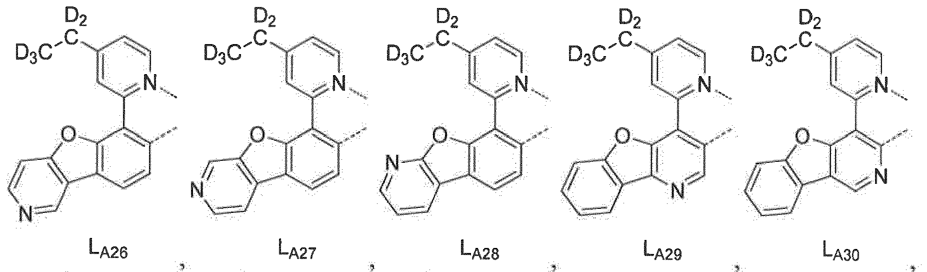

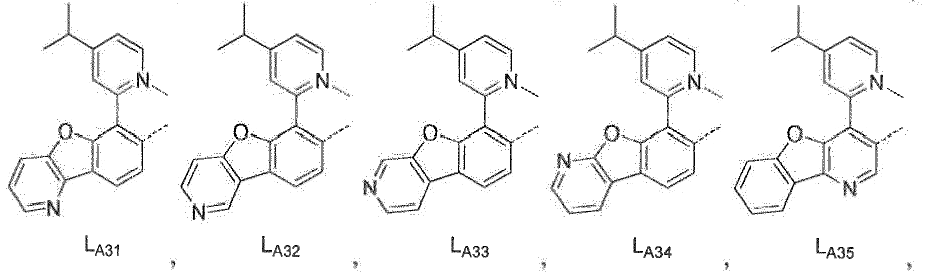

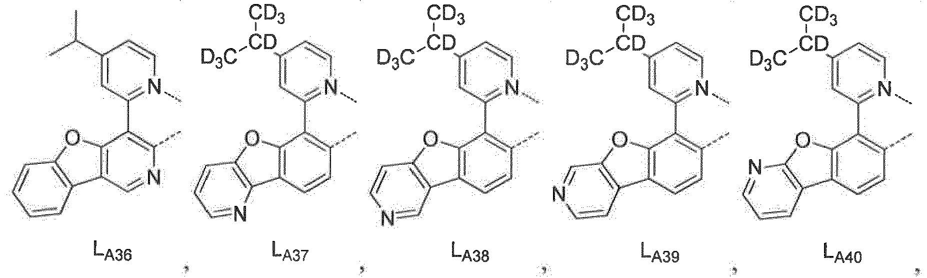

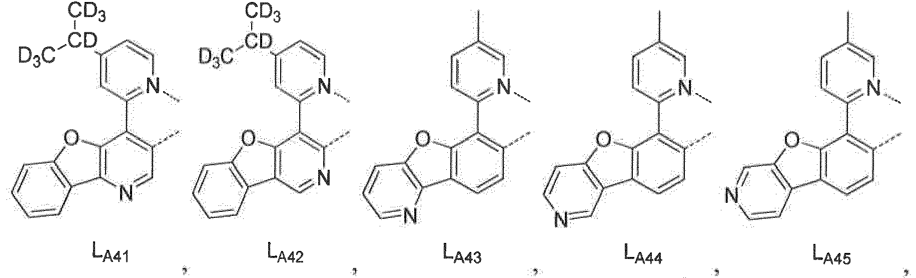

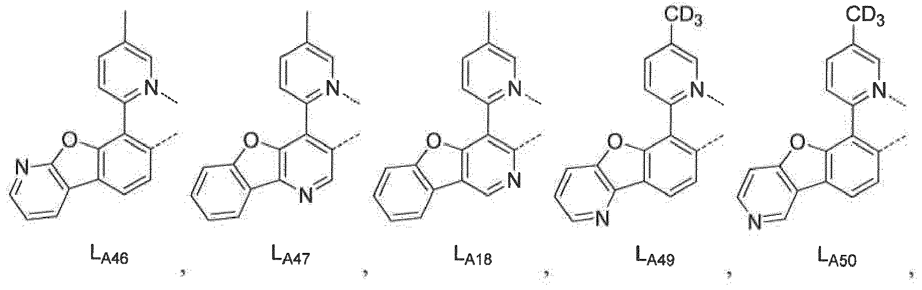

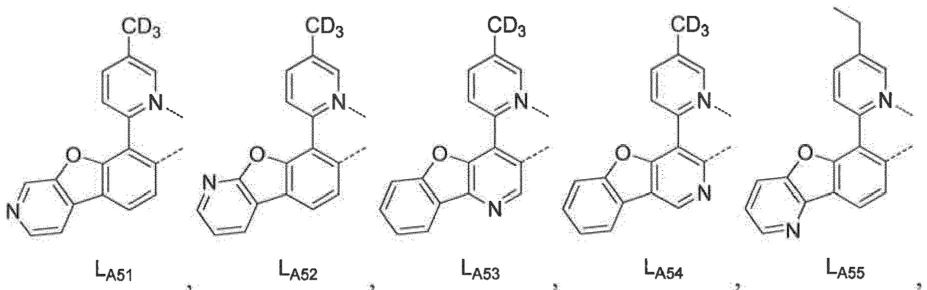

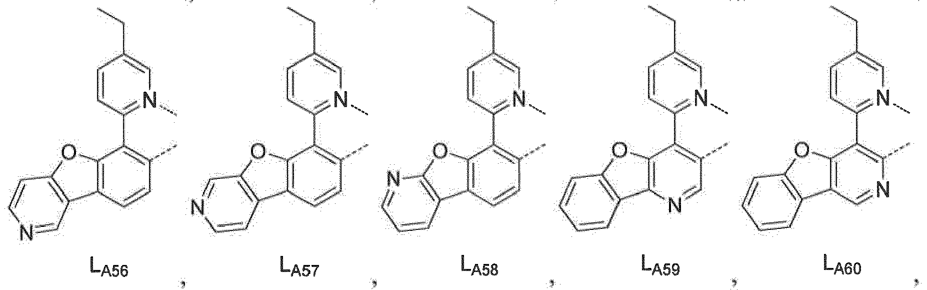

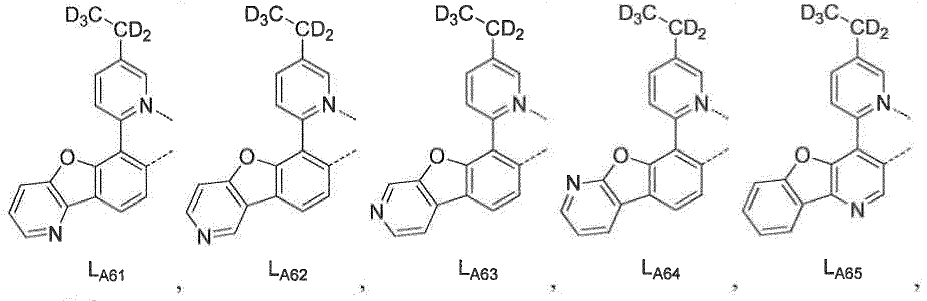

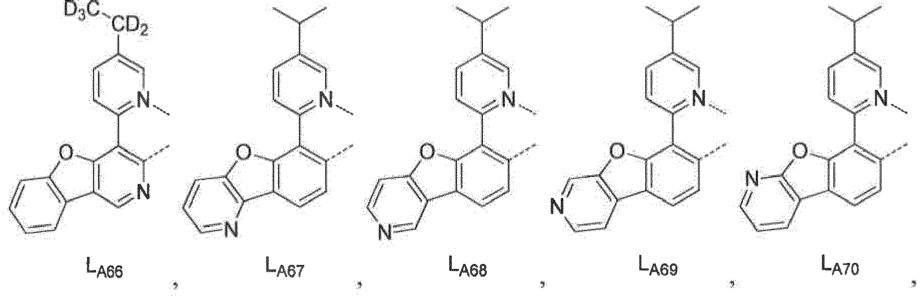

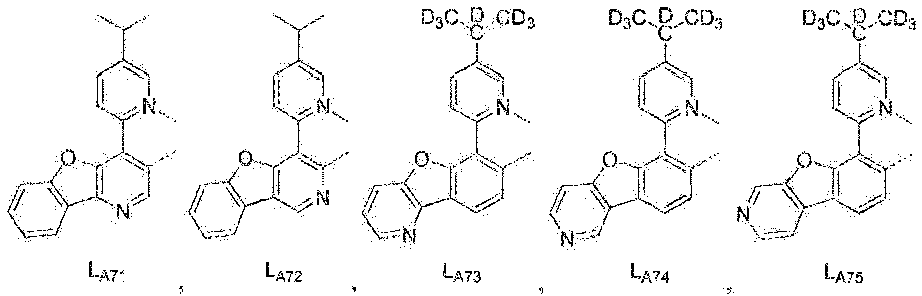

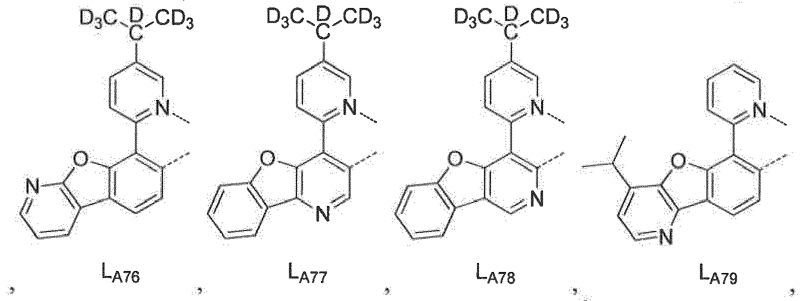

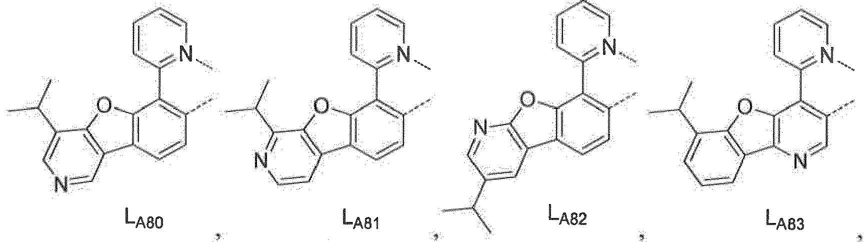

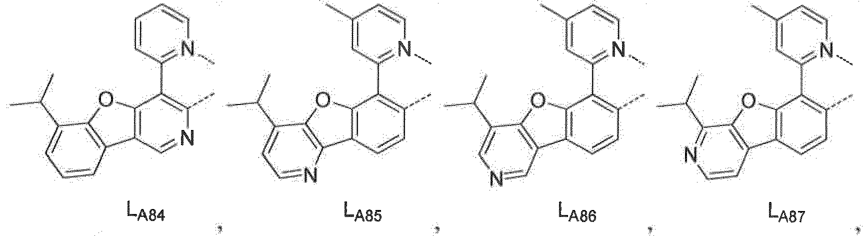

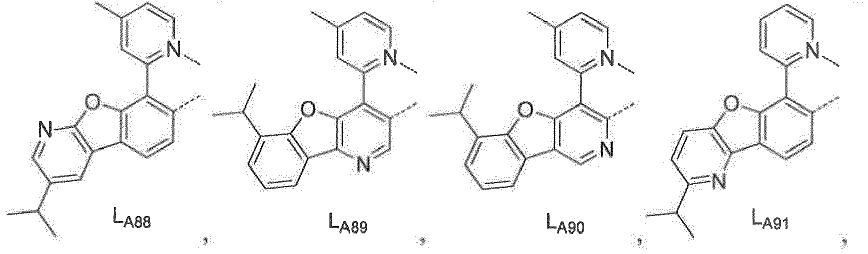

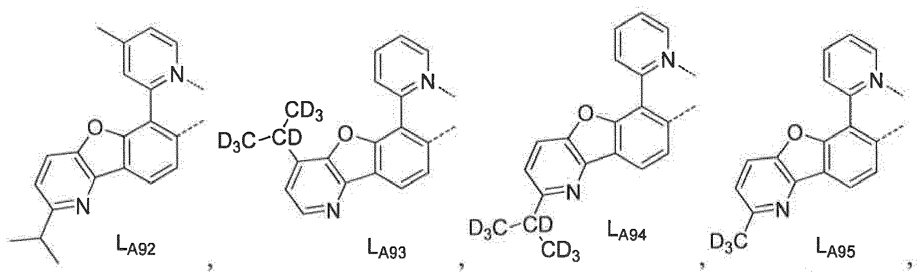

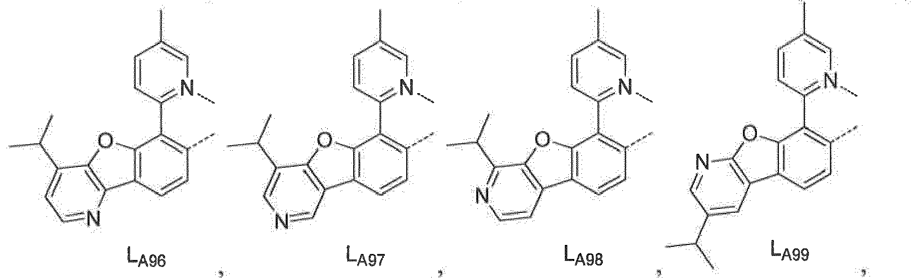

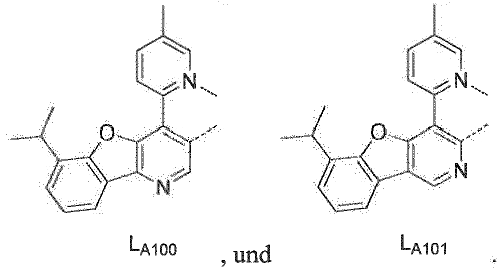

11. Verbindung nach Anspruch 1, wobei L_{A} ausgewählt ist aus der Gruppe bestehend aus:

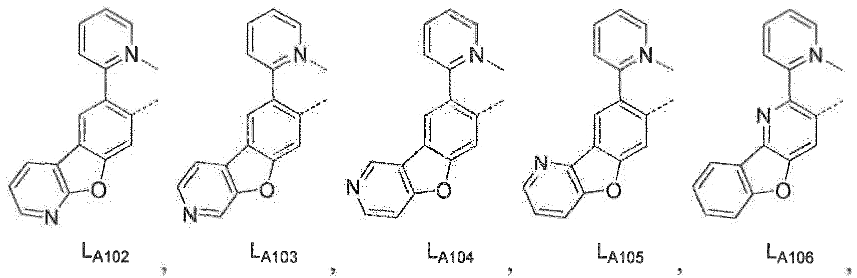

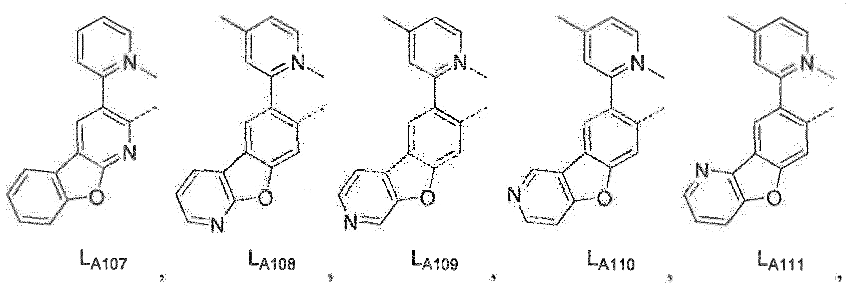

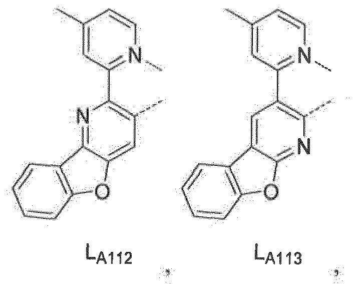

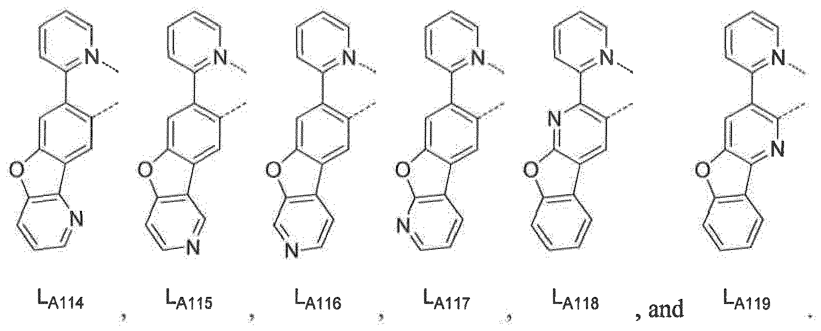

12. Verbindung nach Anspruch 1, wobei L_{B} ausgewählt ist aus der Gruppe bestehend aus:

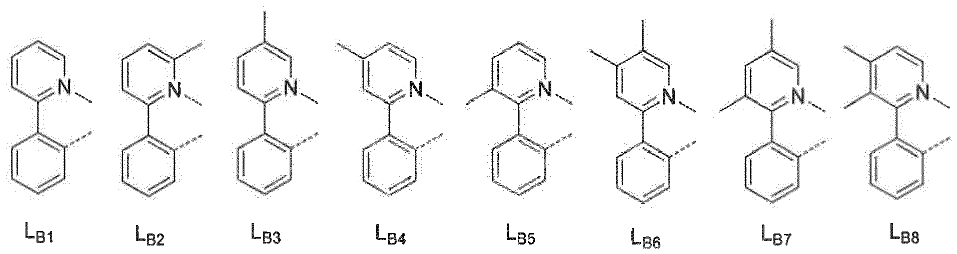

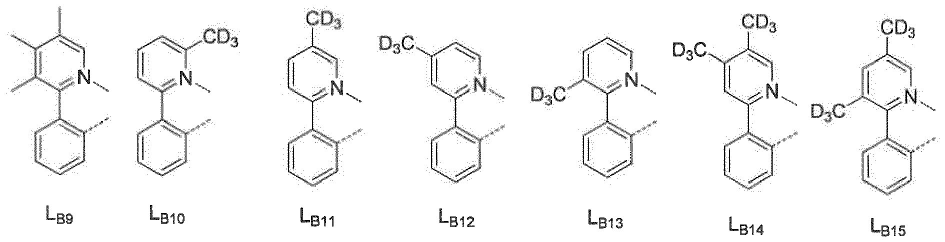

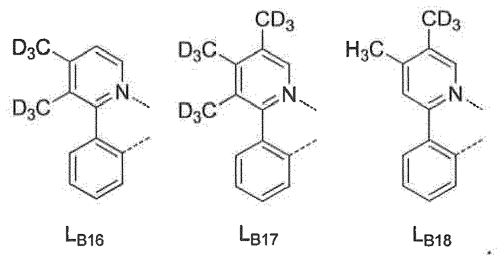

13. Verbindung nach Anspruch 1, wobei die Verbindung ausgewählt ist aus der Gruppe bestehend aus:

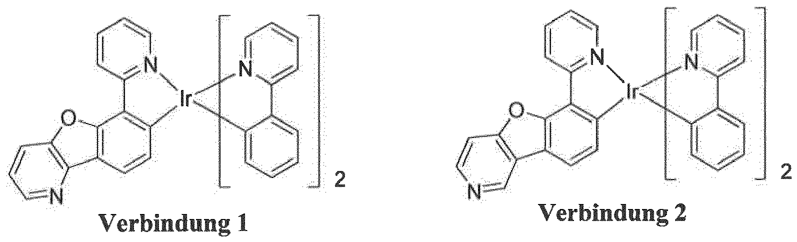

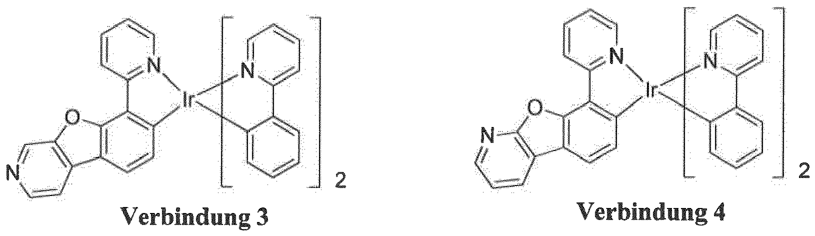

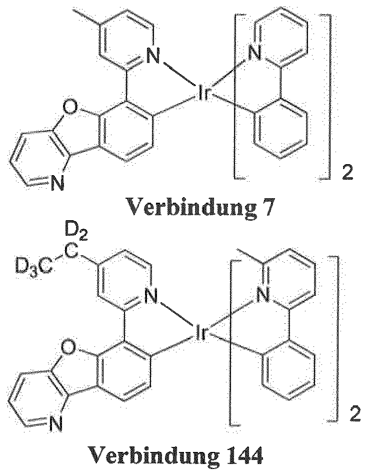

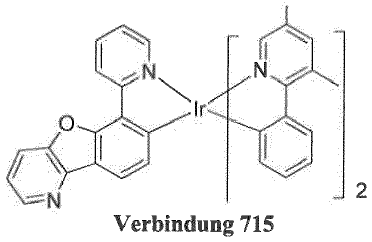

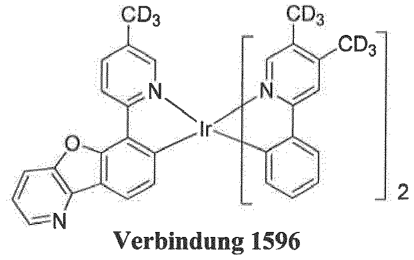

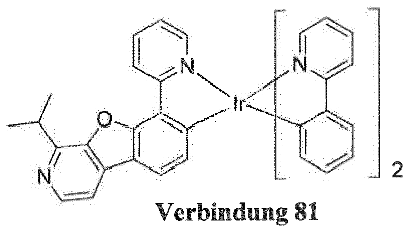

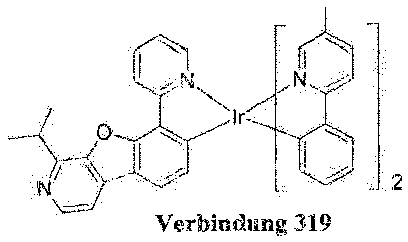

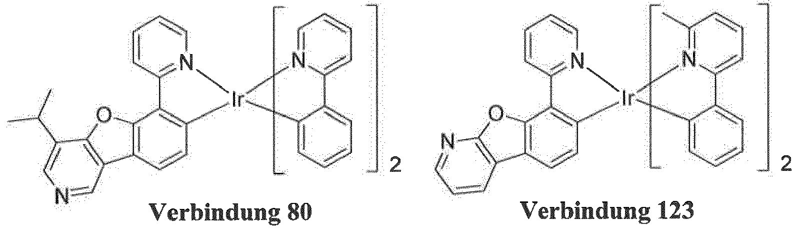

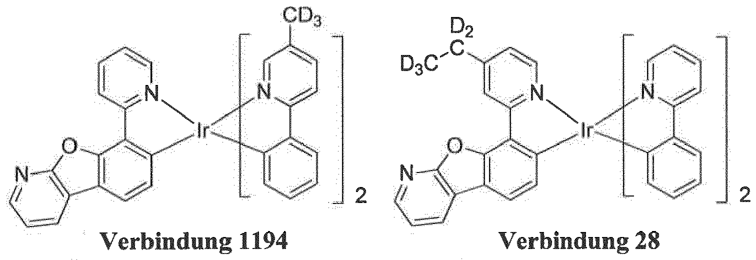

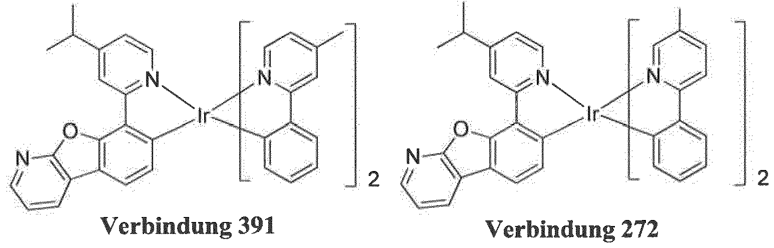

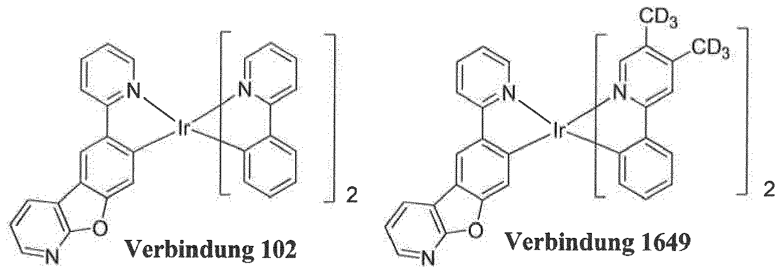

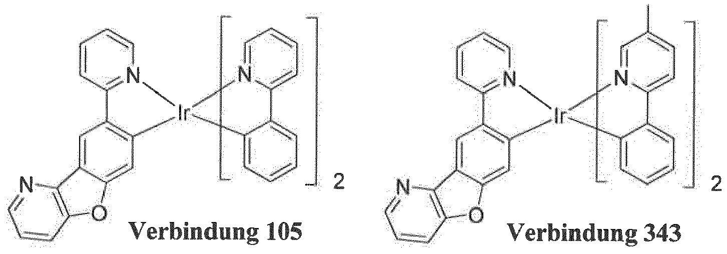

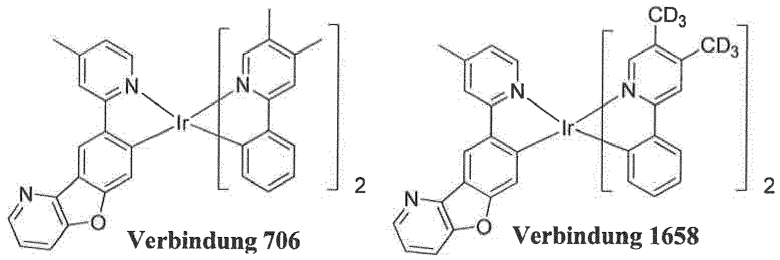

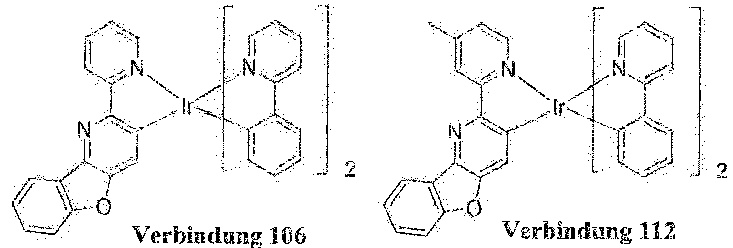

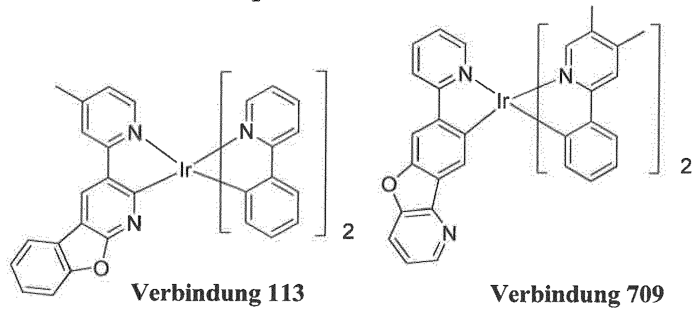

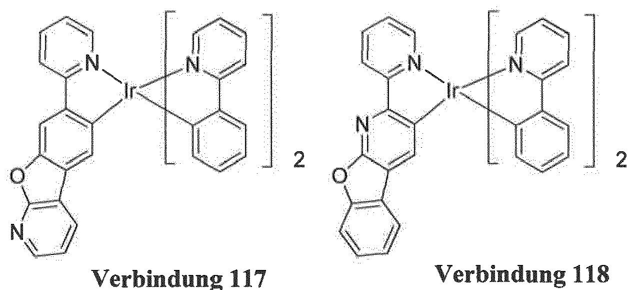

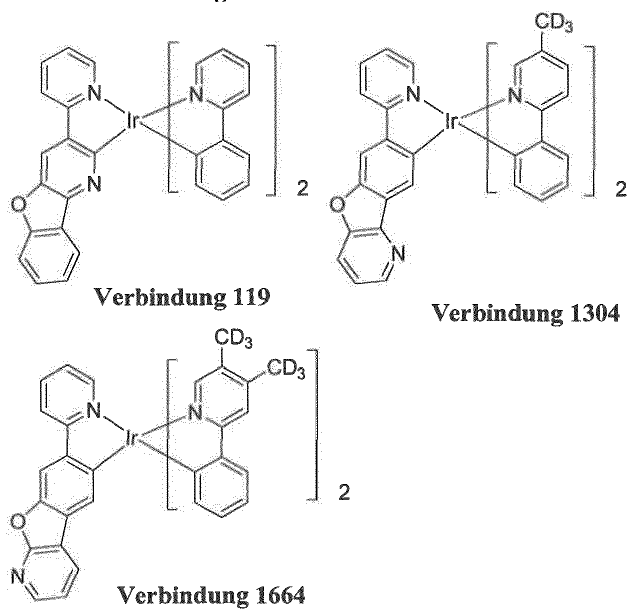

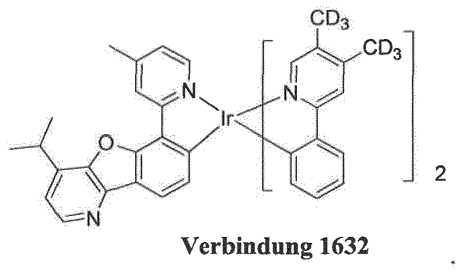

14. Verbindung nach Anspruch 1, wobei A¹-A⁴ und A⁶-A⁸ C sind und A⁵ N ist; und
die Verbindung eine Struktur gemäß Formula II aufweist 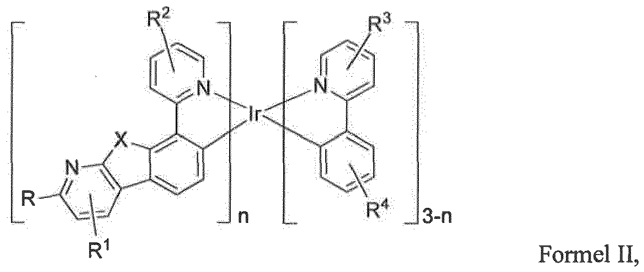 wobei R ausgewählt ist aus der Gruppe bestehend aus Alkyl, Cycloalkyl, und deren Kombinationen.

15. Verbindung nach Anspruch 14, wobei R² ausgewählt ist aus der Gruppe bestehend aus Aryl, substitutiertes Aryl, Heteroaryl, und substituiertes Heteroaryl.

16. Verbindung nach Anspruch 14, wobei L_{A} ausgewählt ist aus der Gruppe bestehend aus:

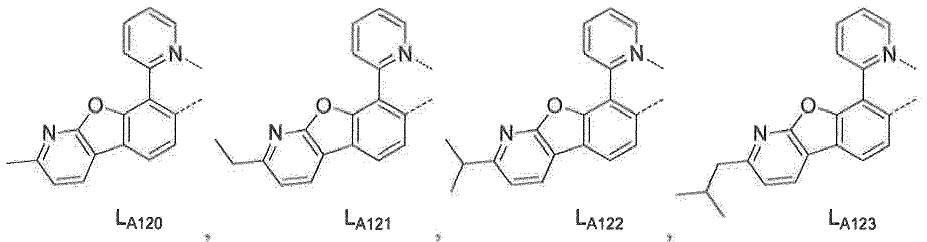

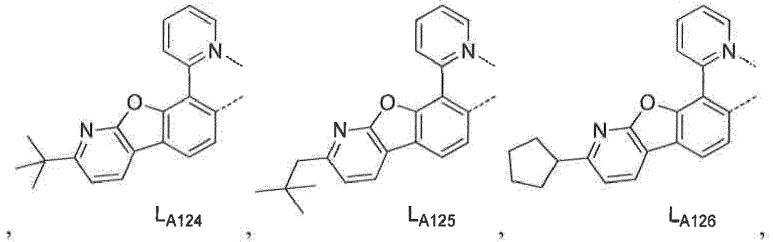

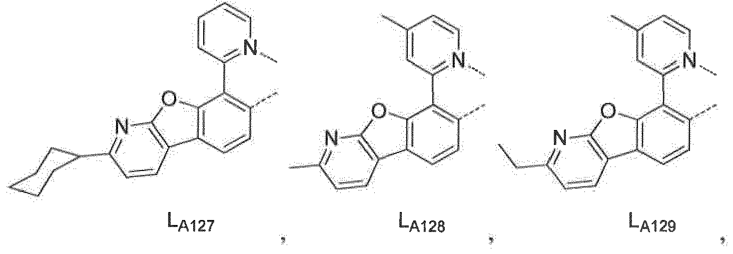

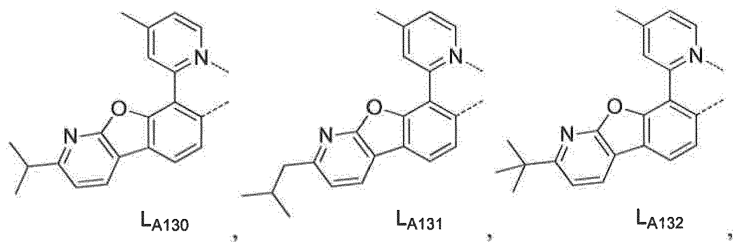

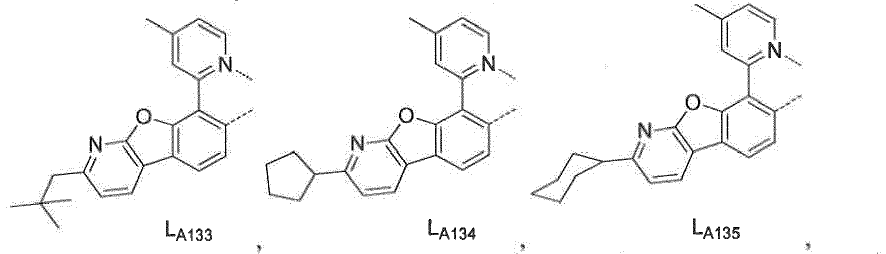

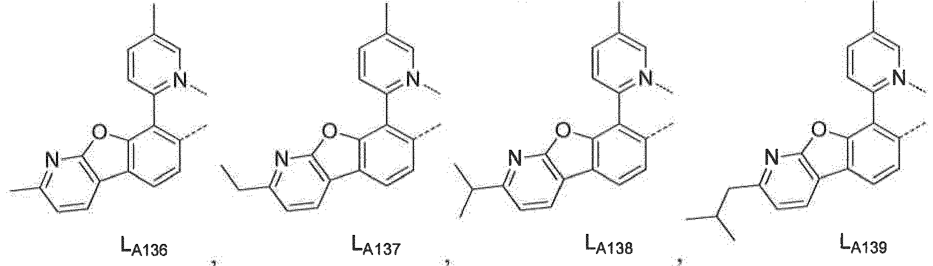

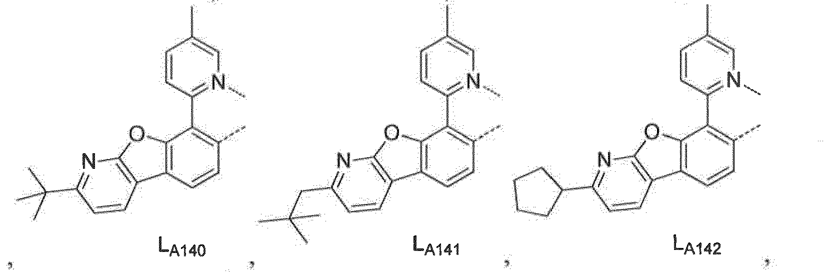

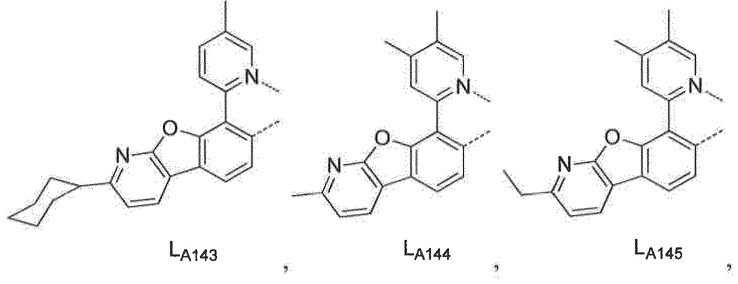

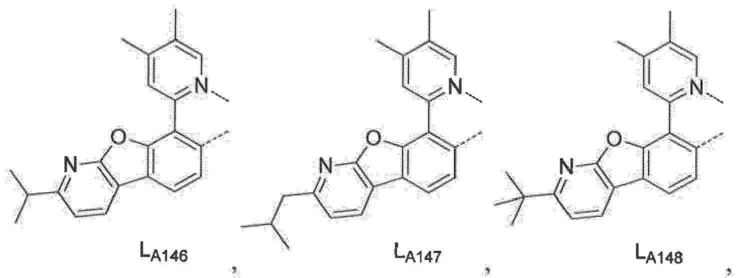

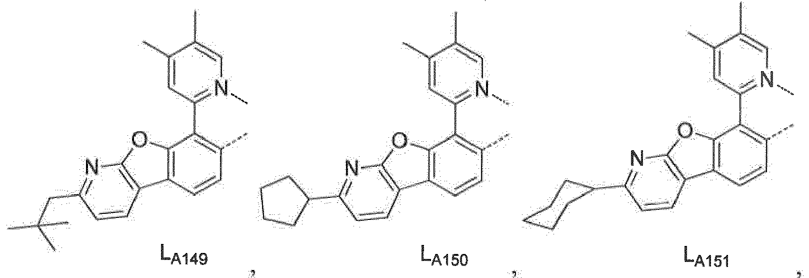

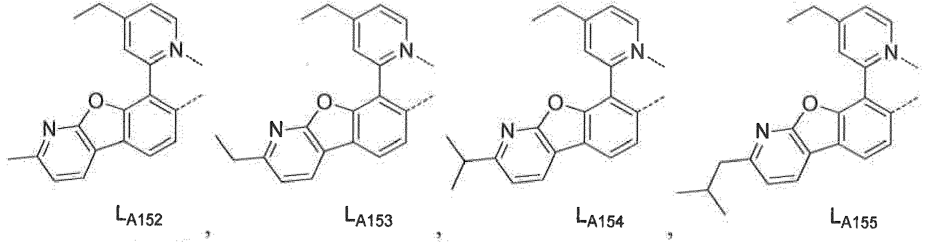

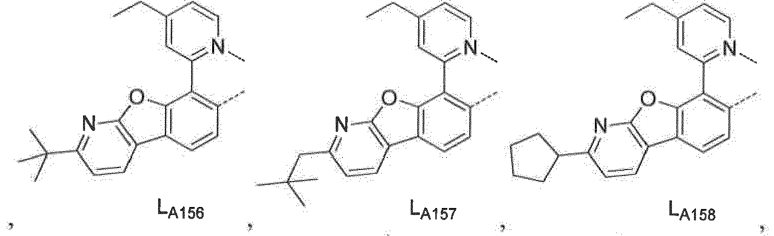

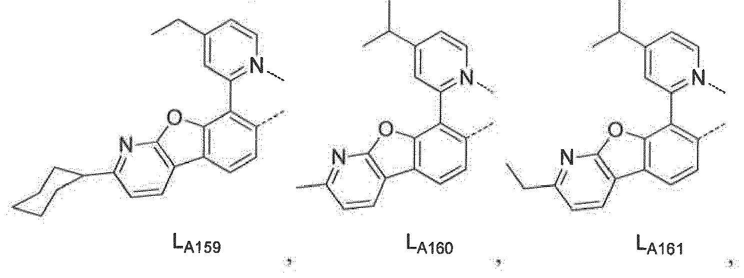

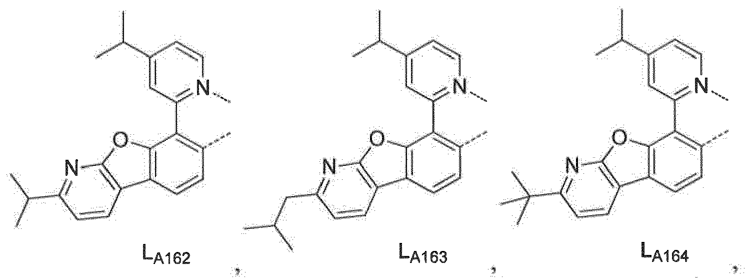

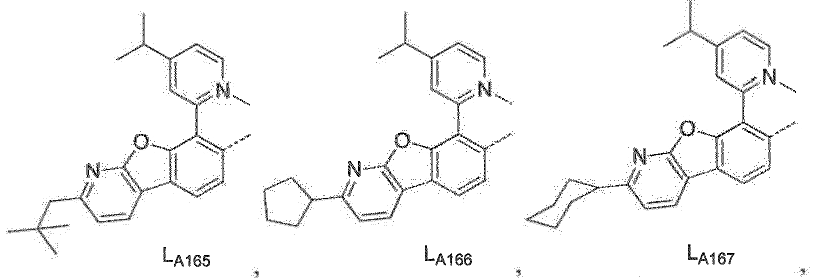

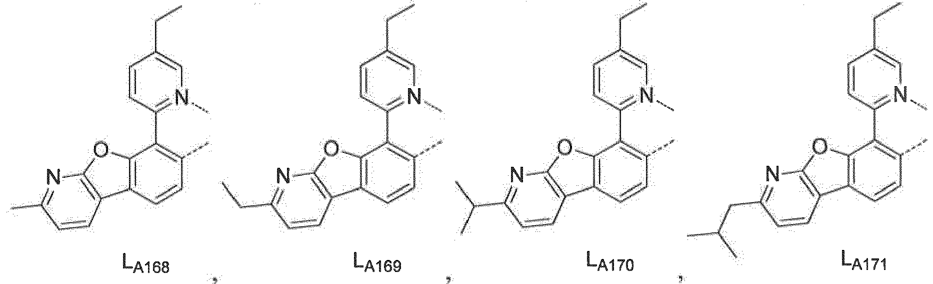

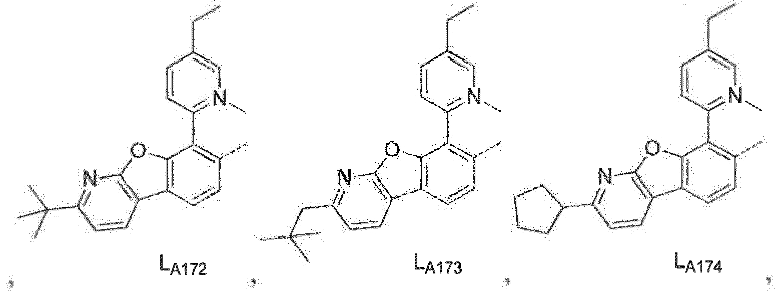

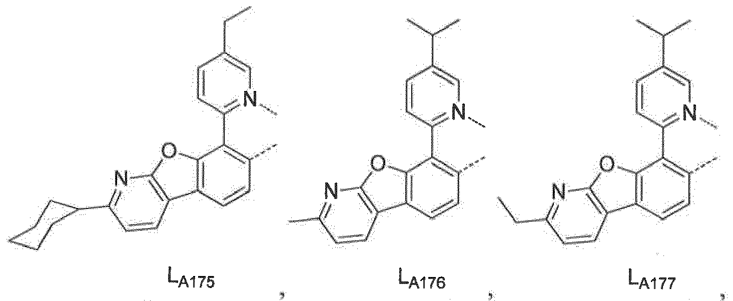

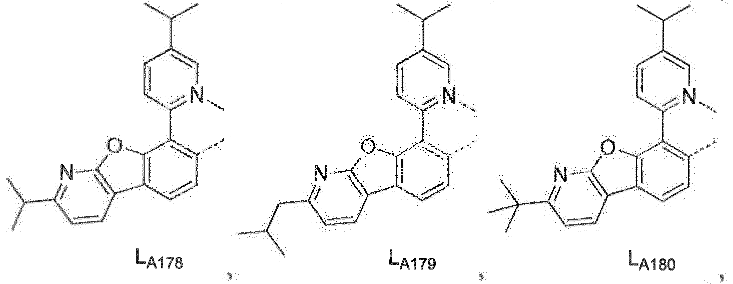

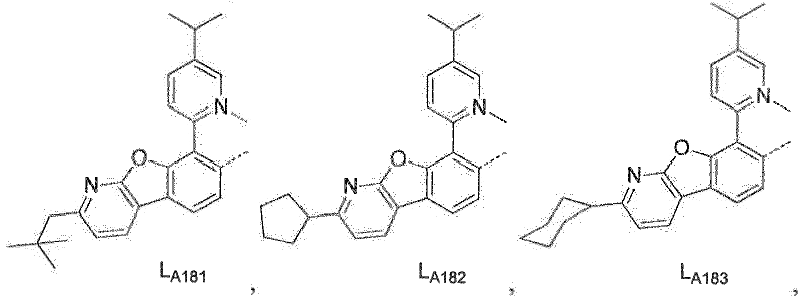

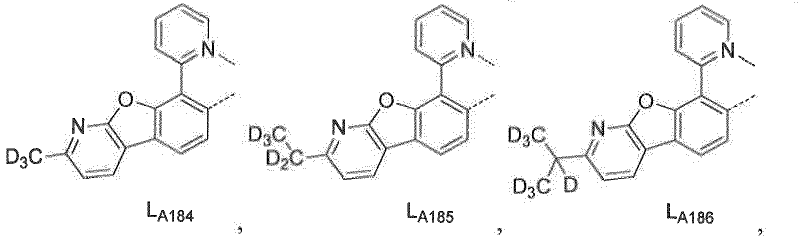

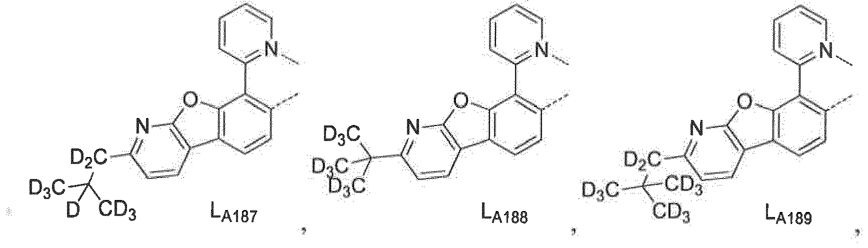

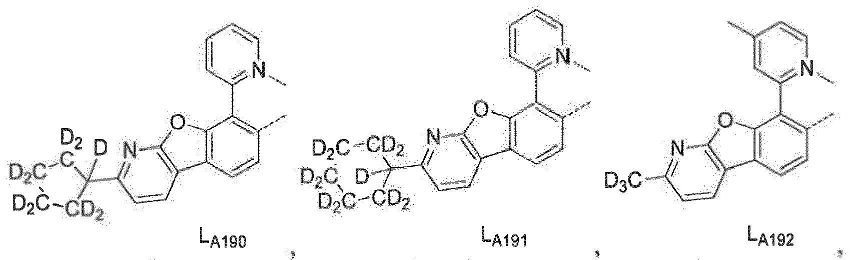

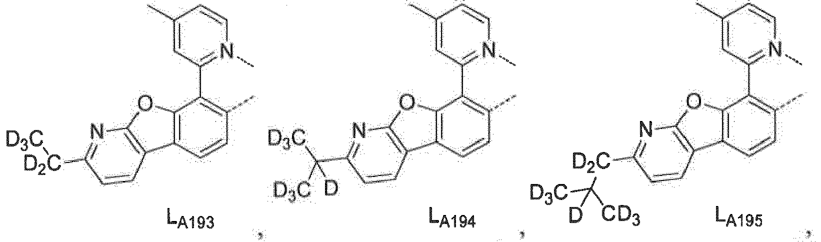

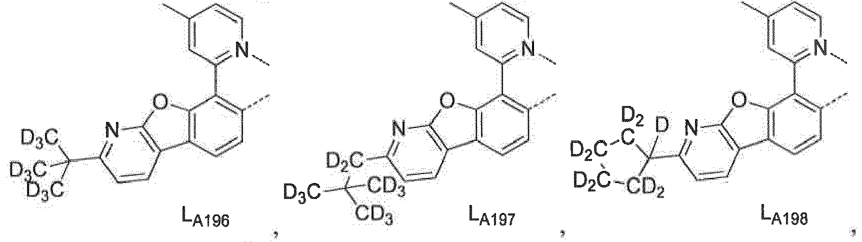

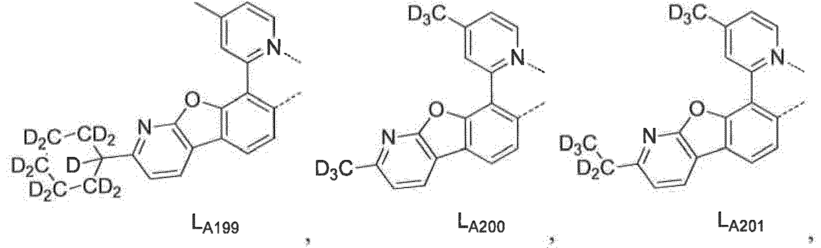

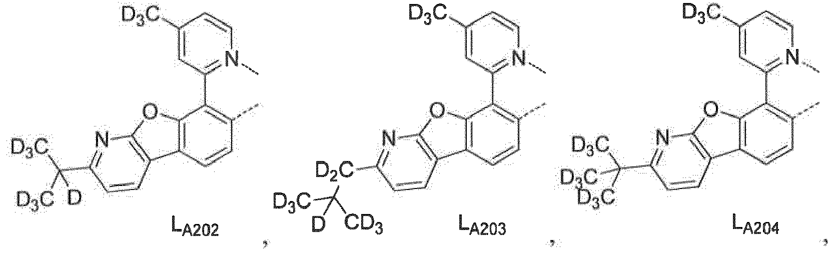

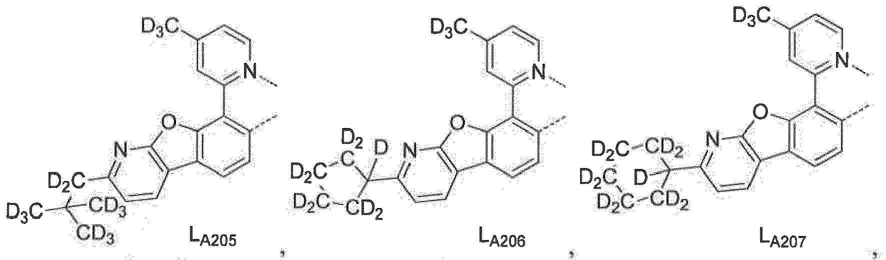

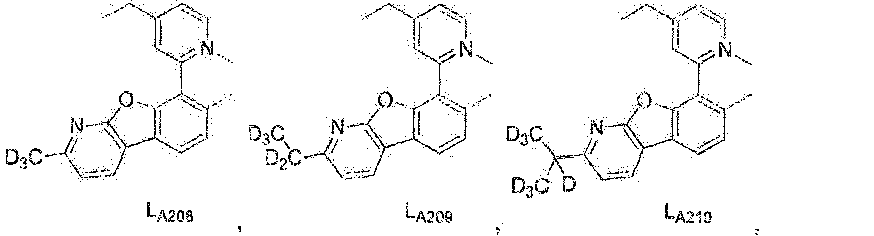

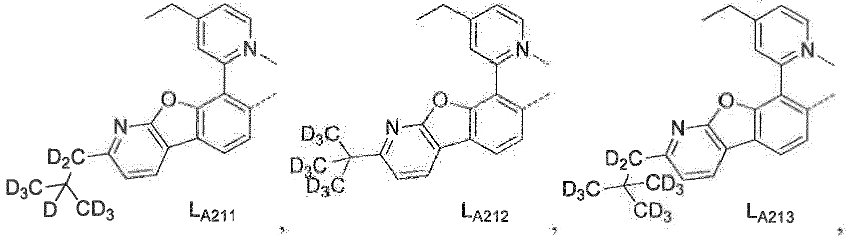

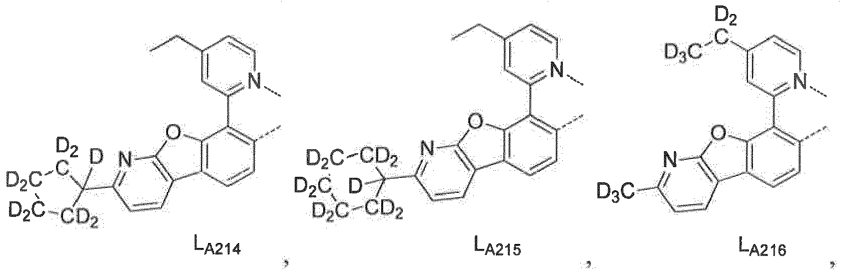

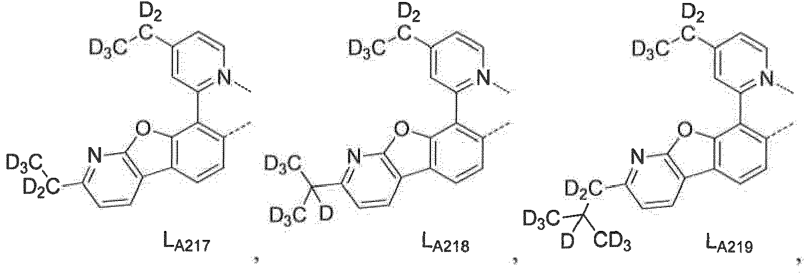

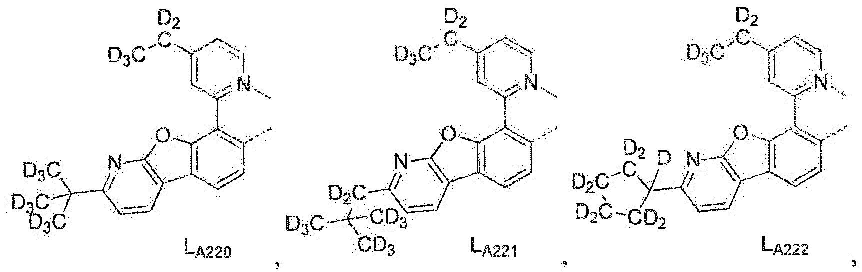

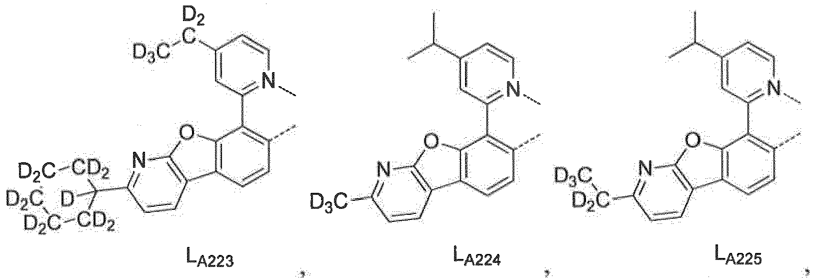

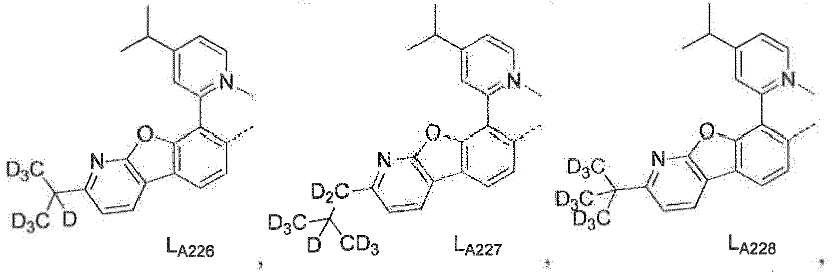

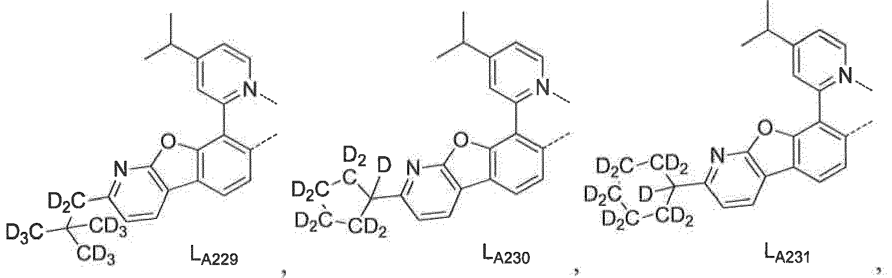

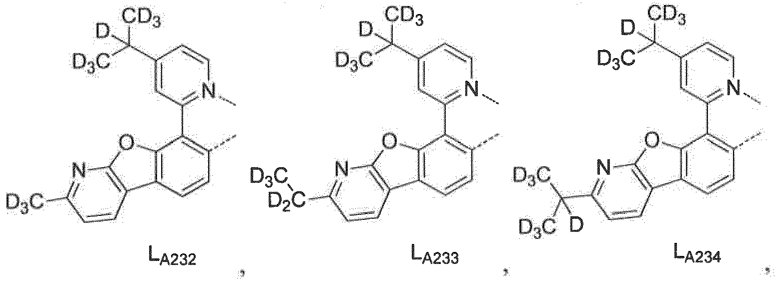

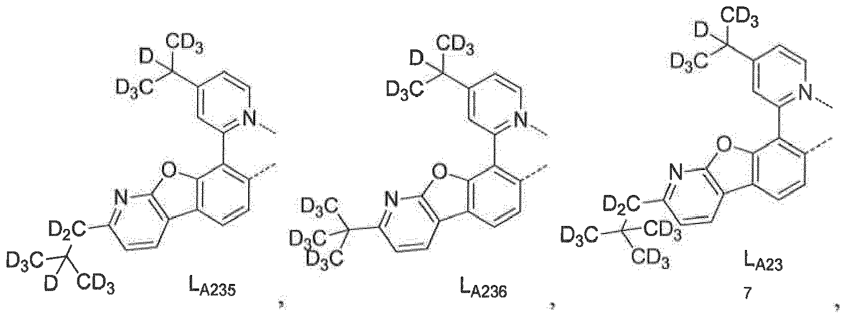

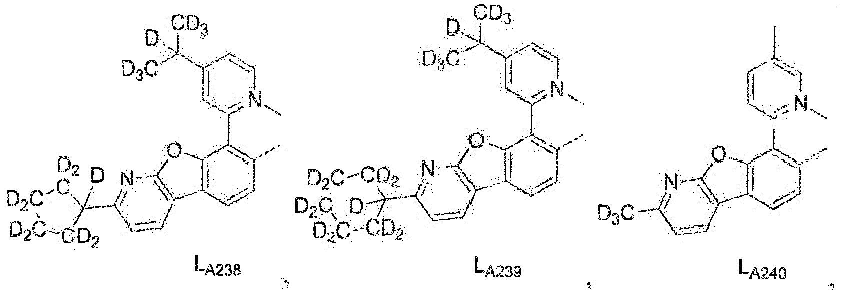

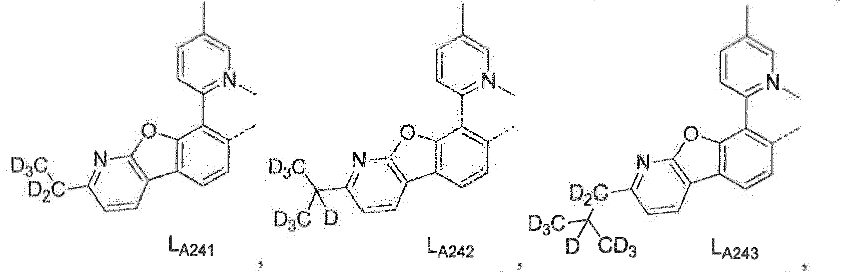

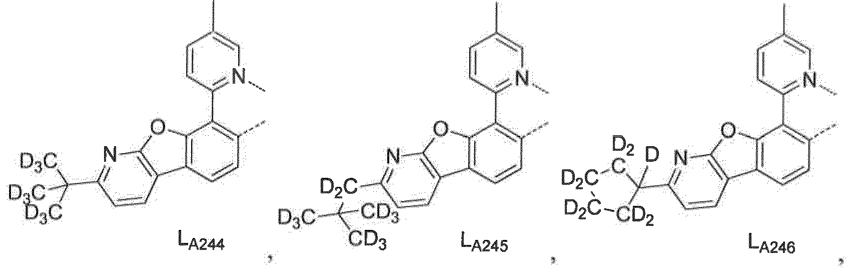

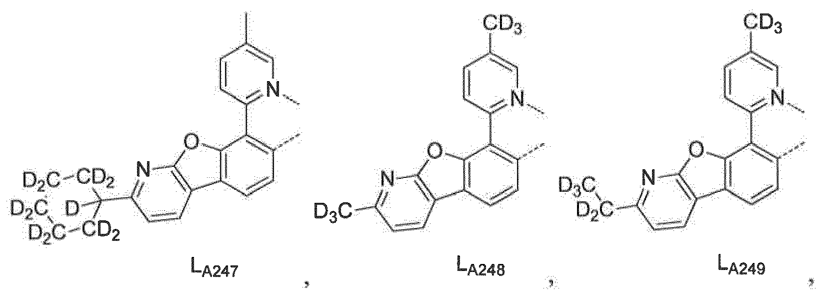

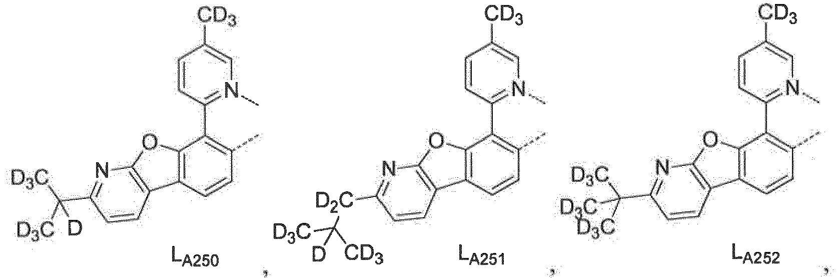

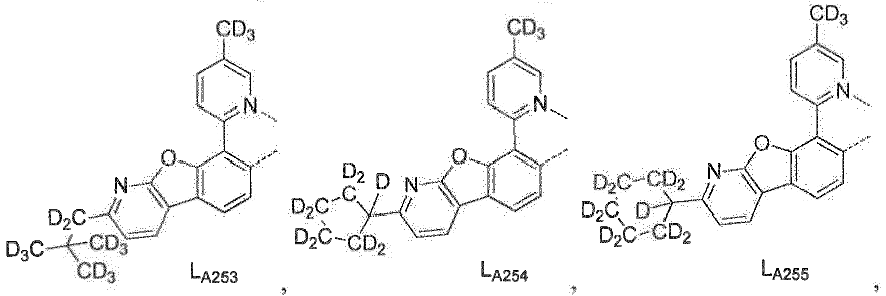

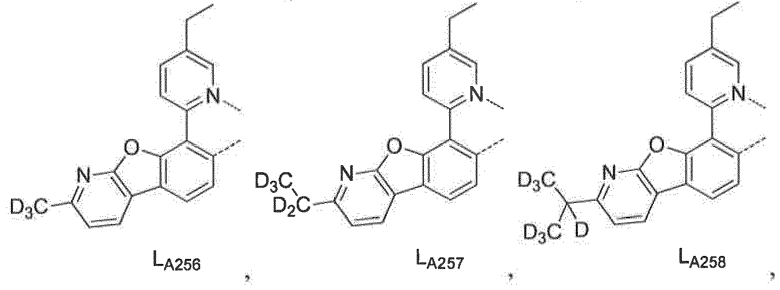

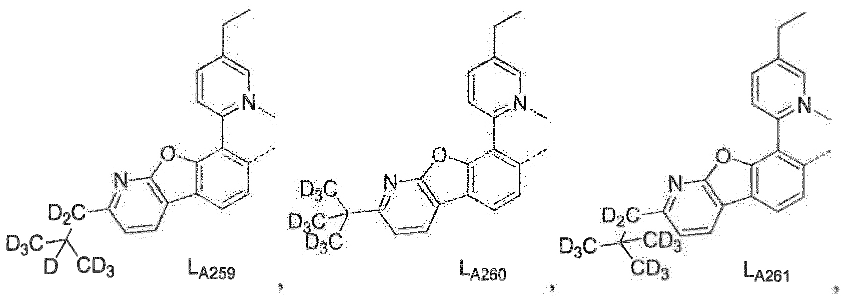

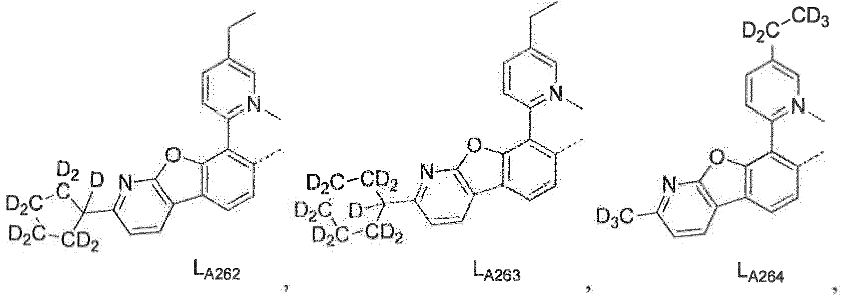

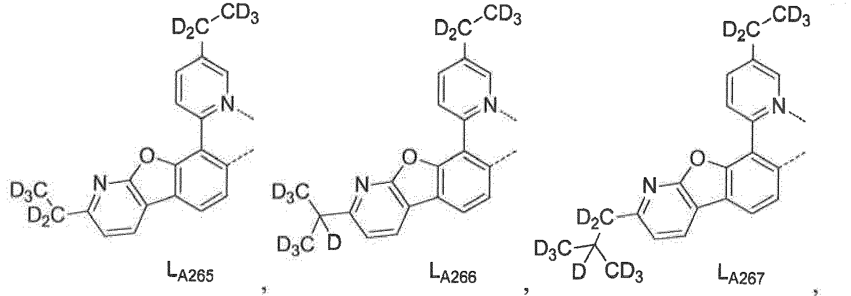

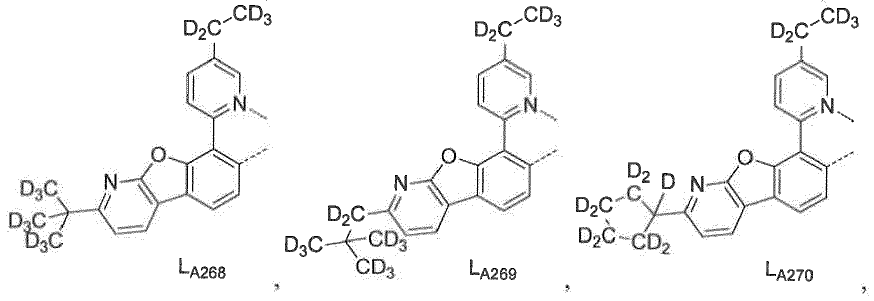

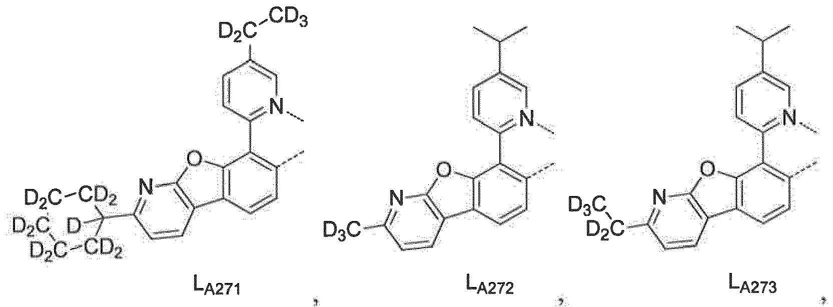

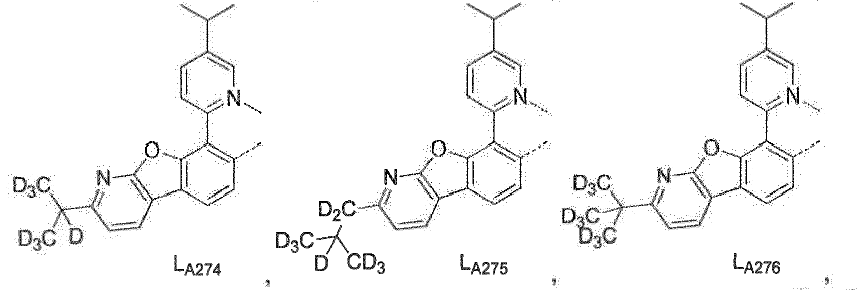

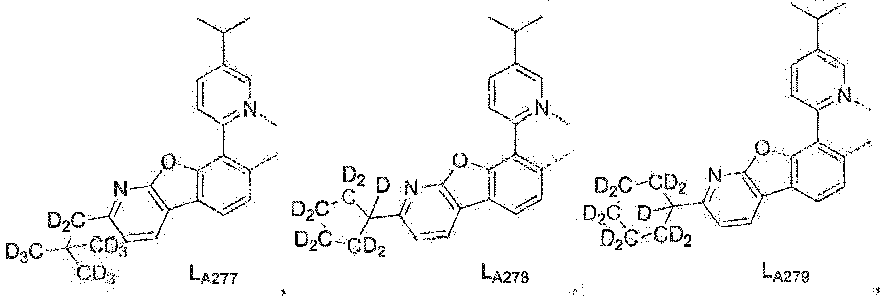

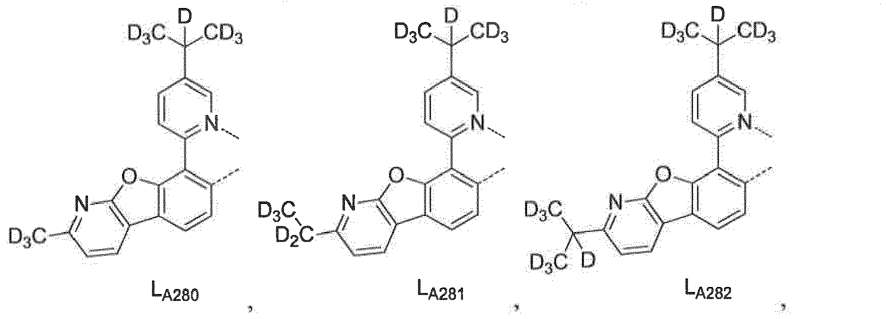

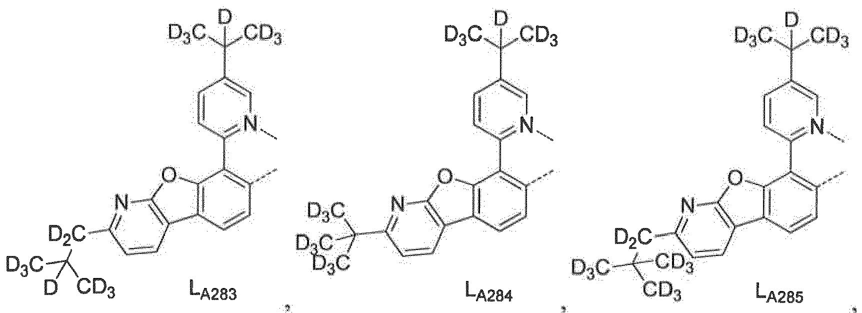

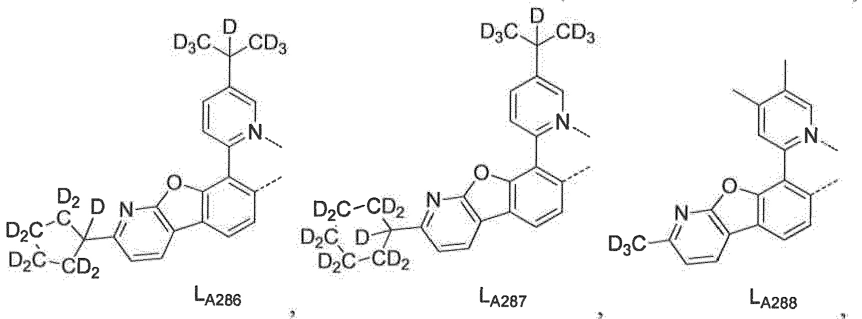

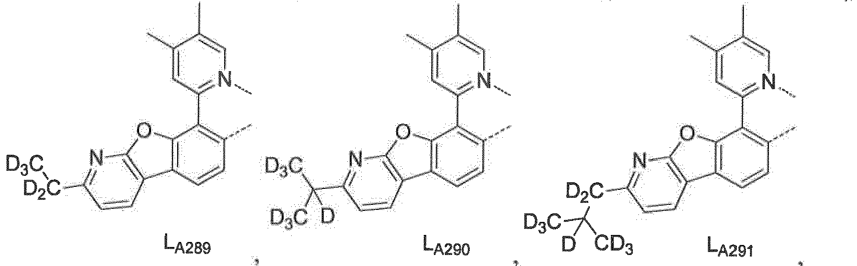

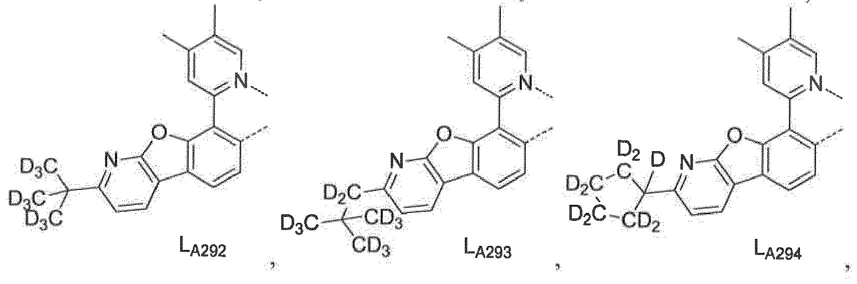

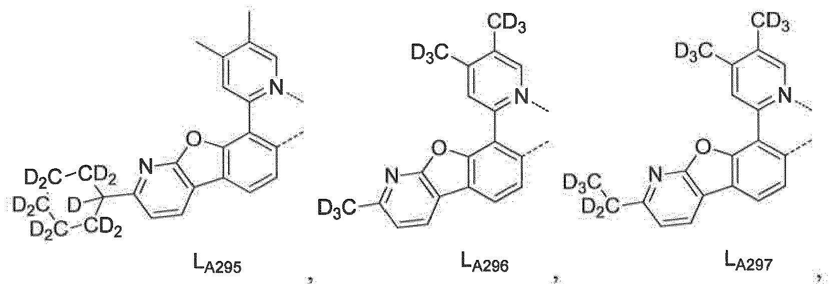

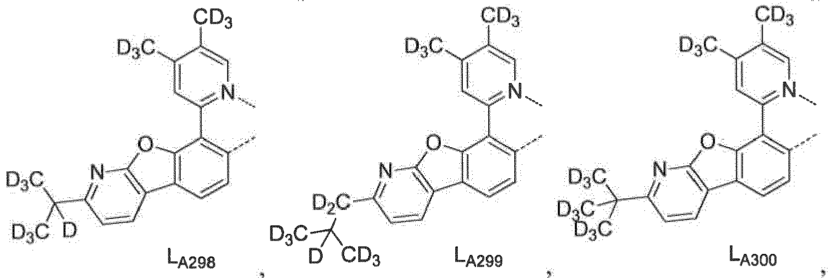

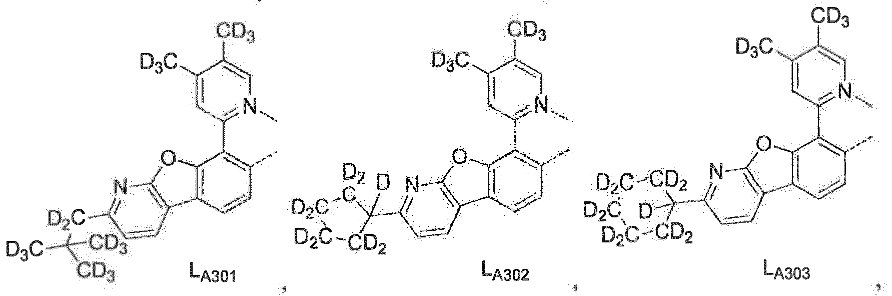

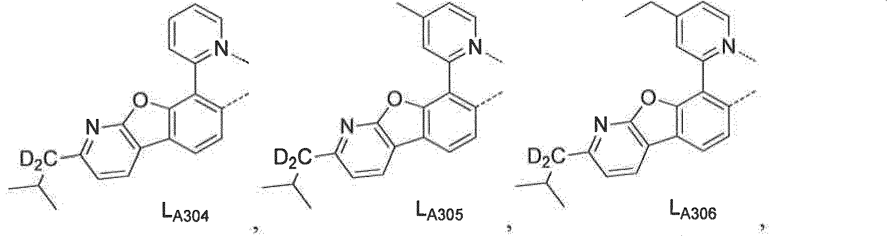

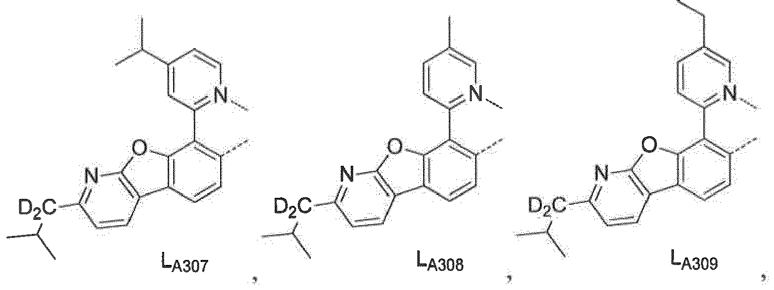

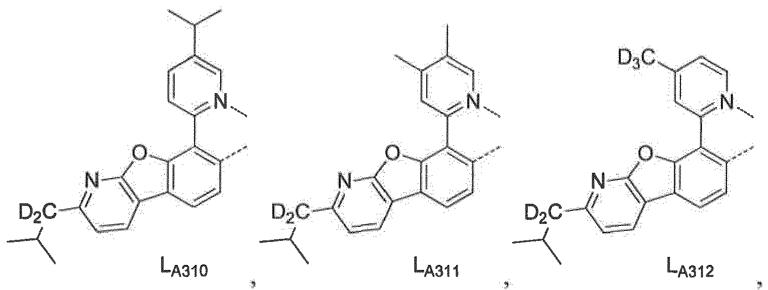

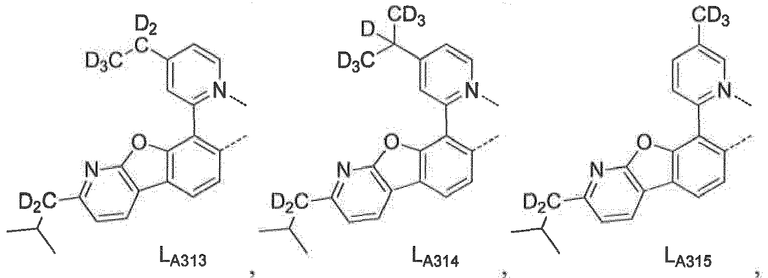

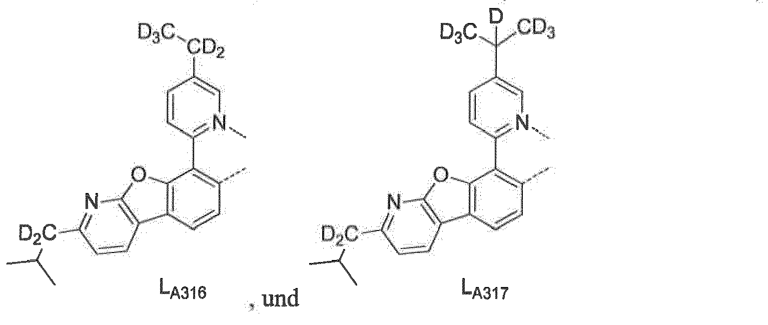

17. Verbindung nach Anspruch 14, wobei L_{B} ausgewählt ist aus der Gruppe bestehend aus:

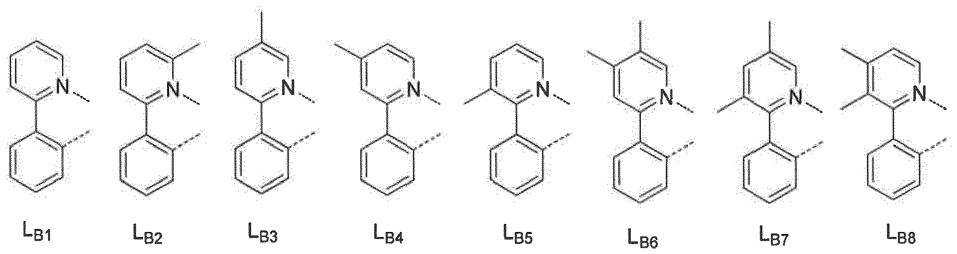

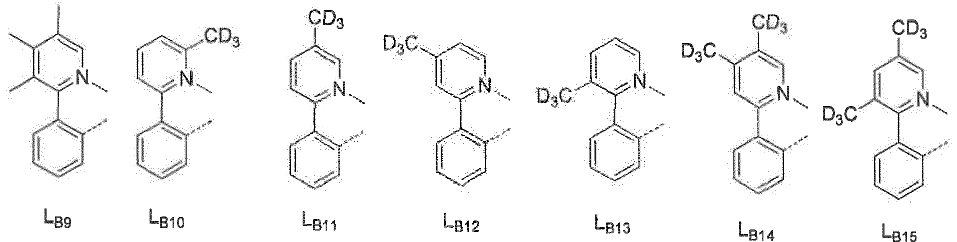

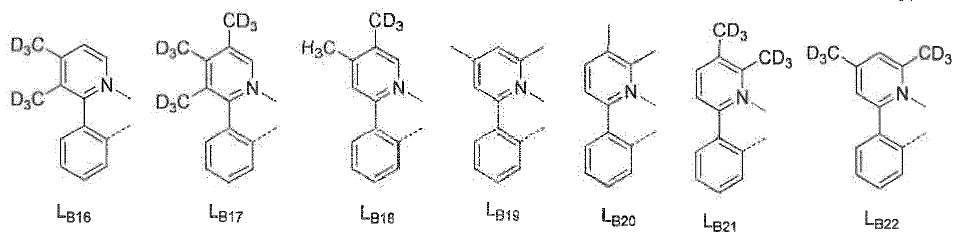

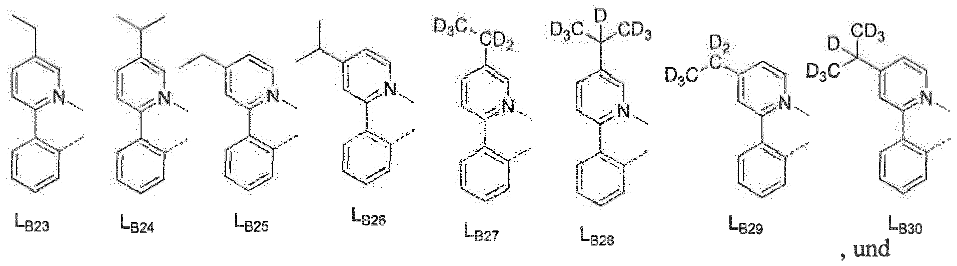

18. Verbindung nach Anspruch 14, wobei die Verbindung ausgewählt ist aus der Gruppe bestehend aus: 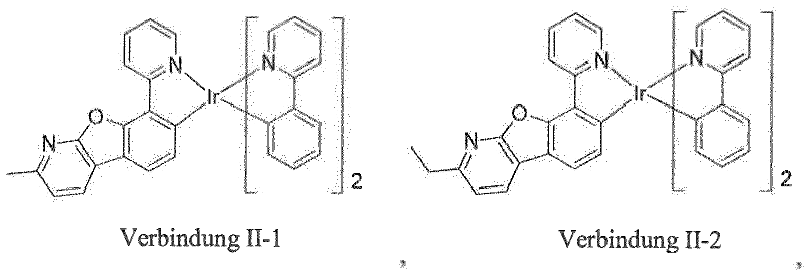 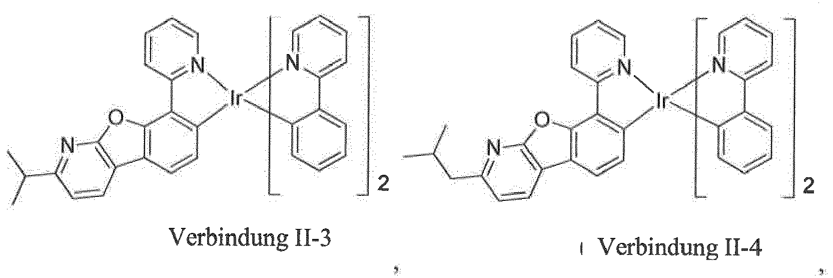 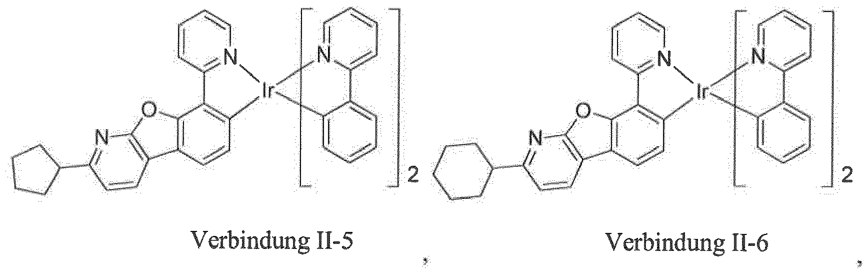 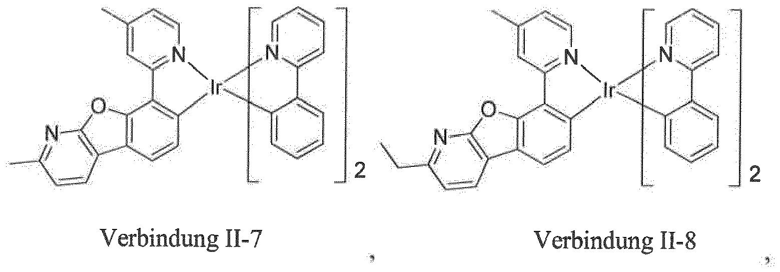 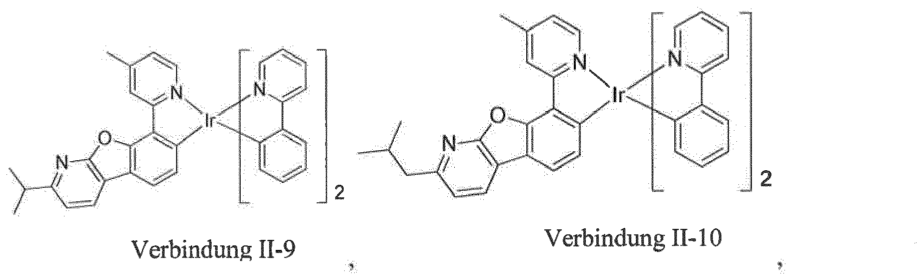 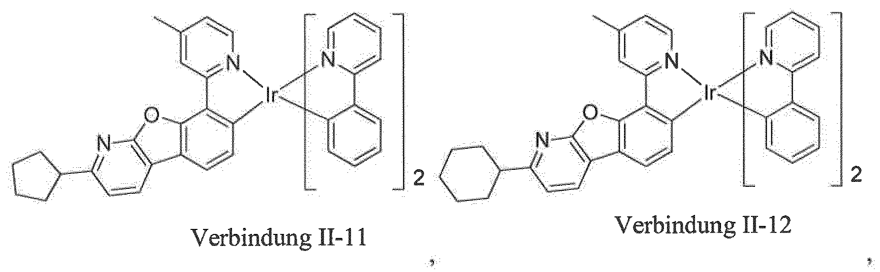 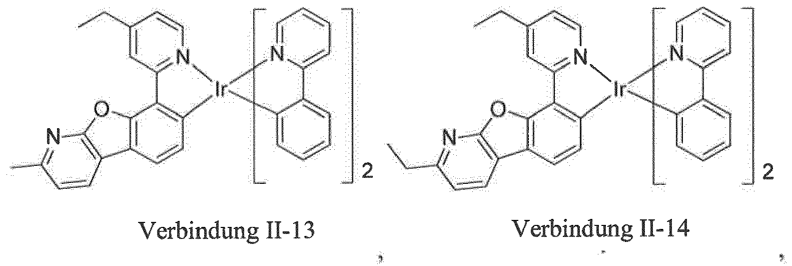 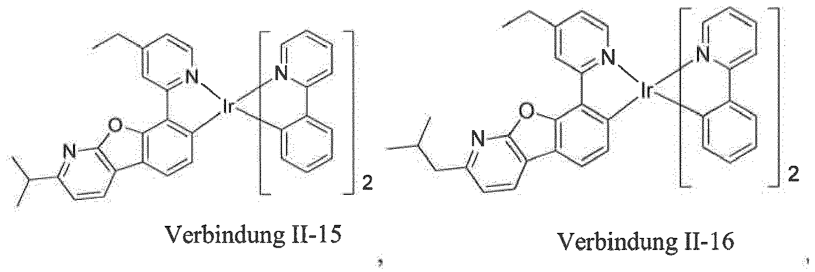 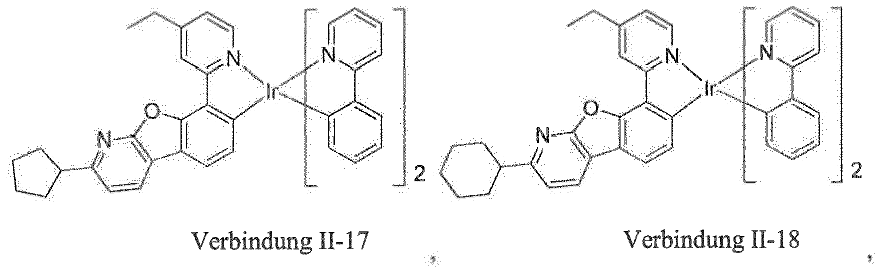 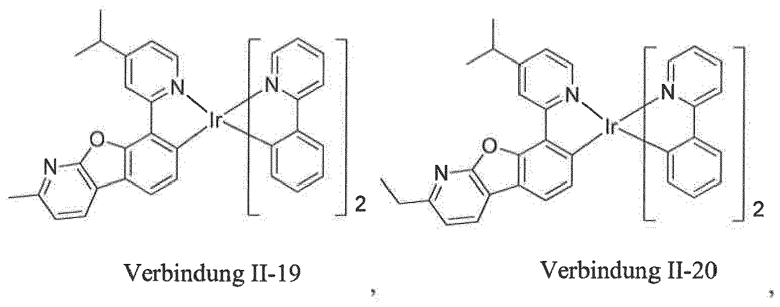 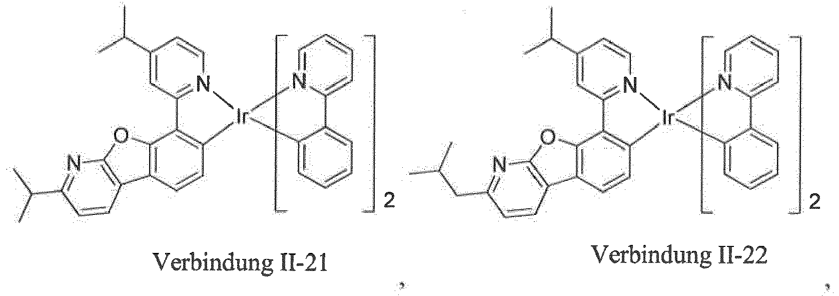 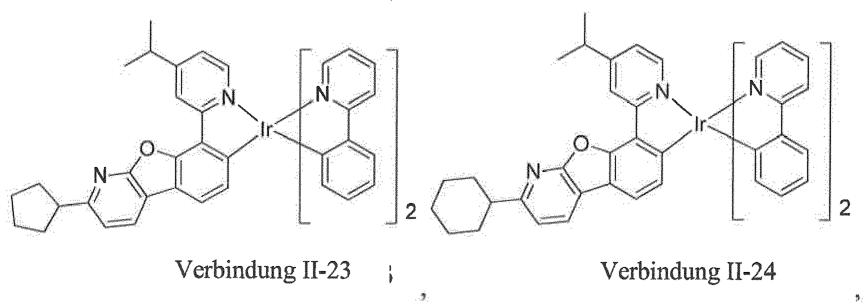 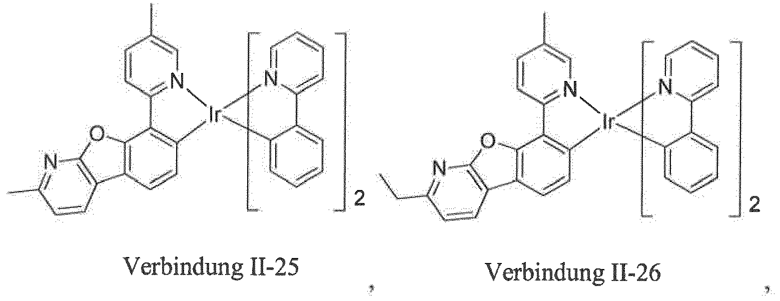 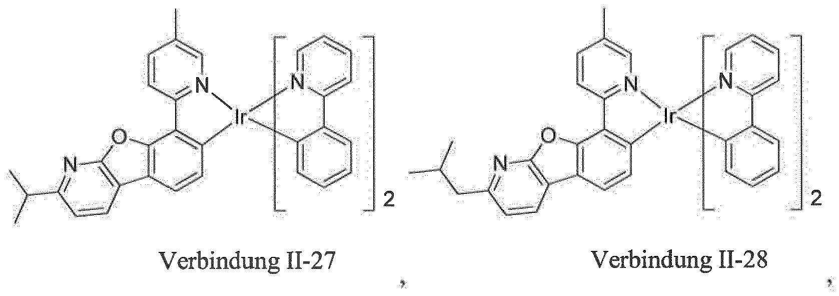 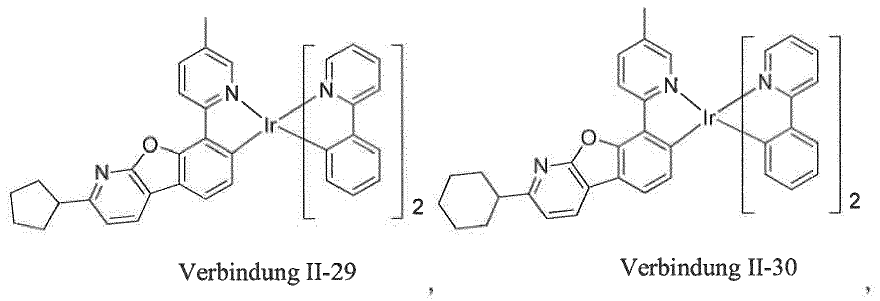 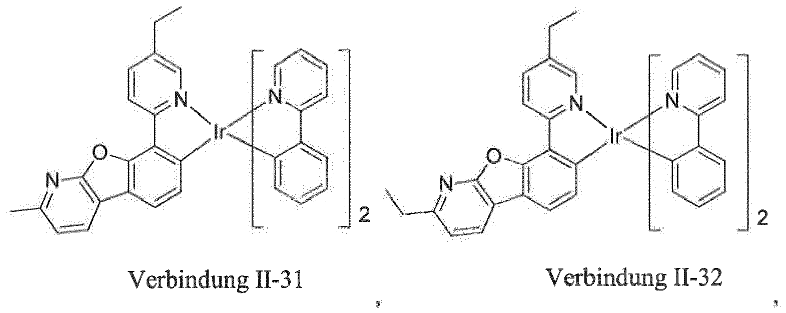 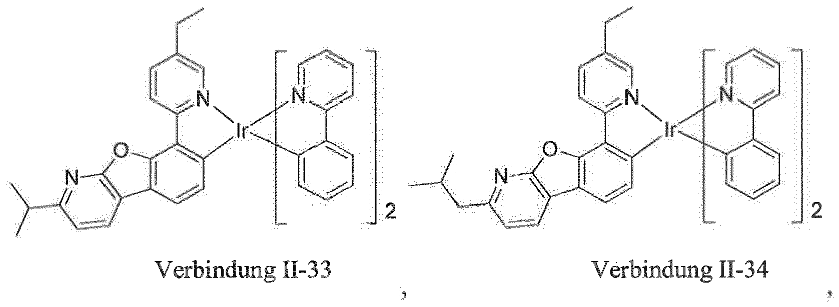 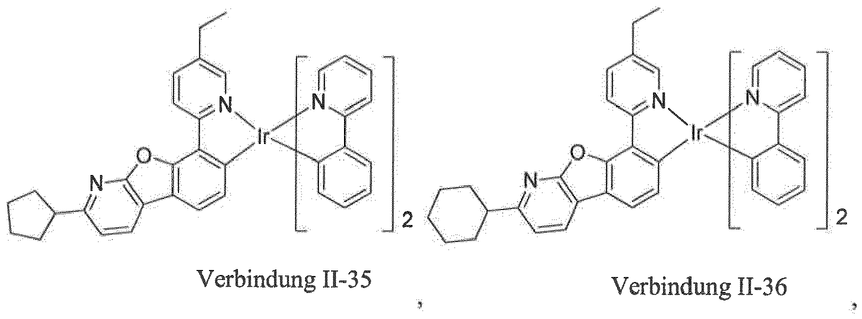 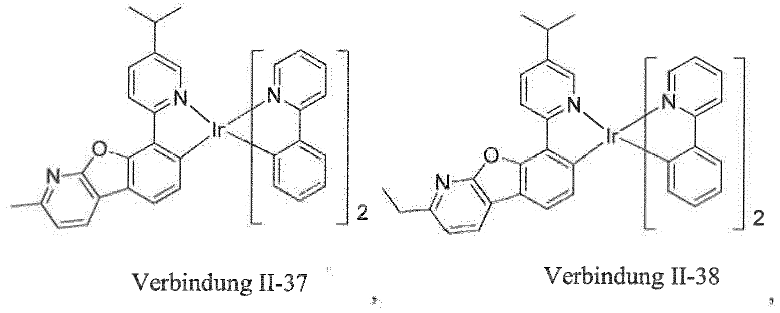 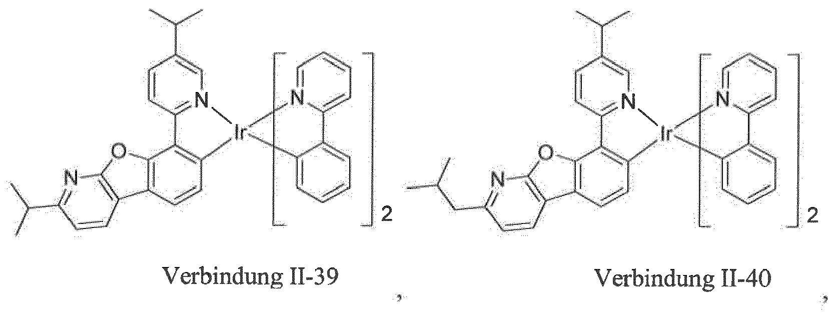 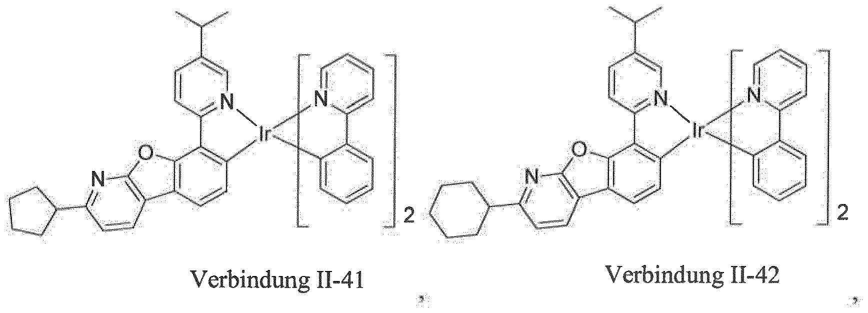 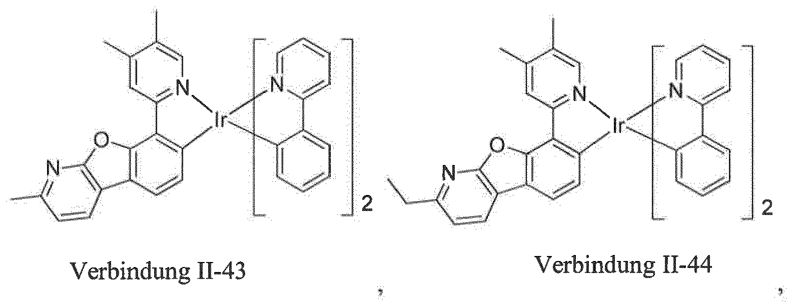 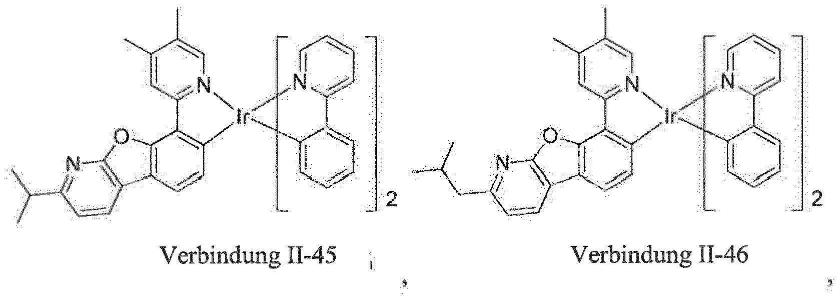 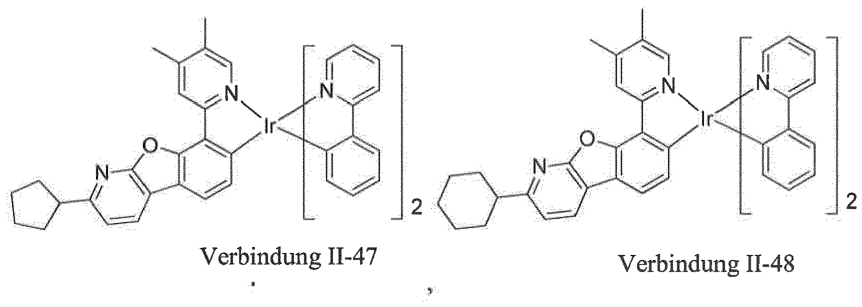 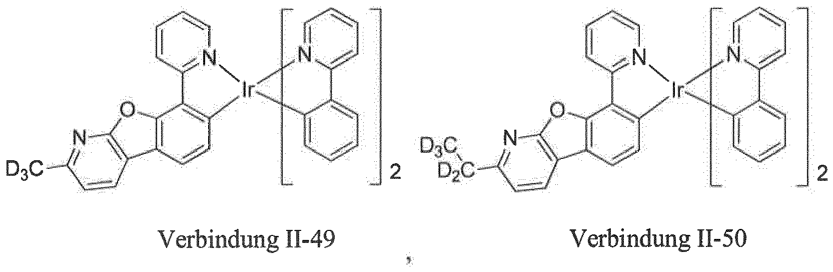 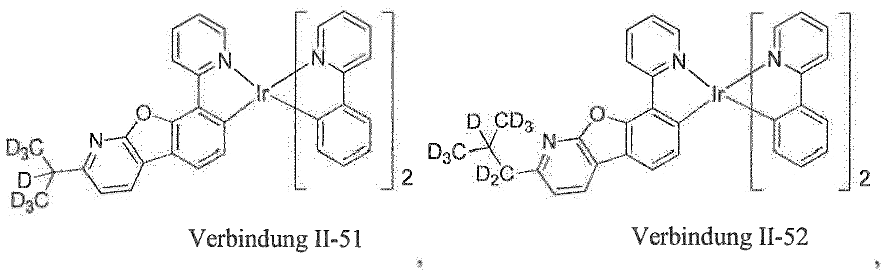 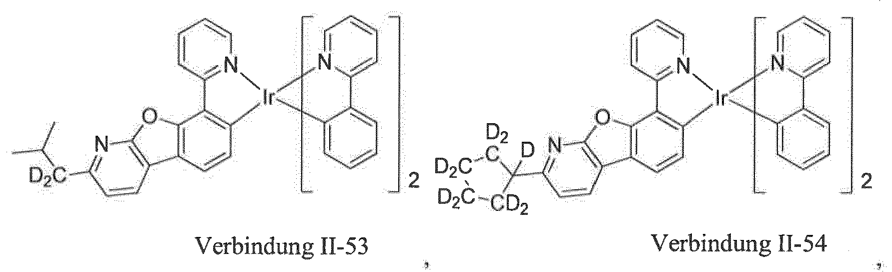 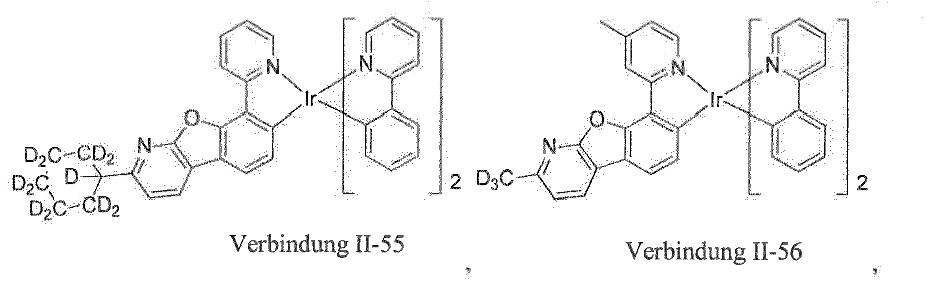 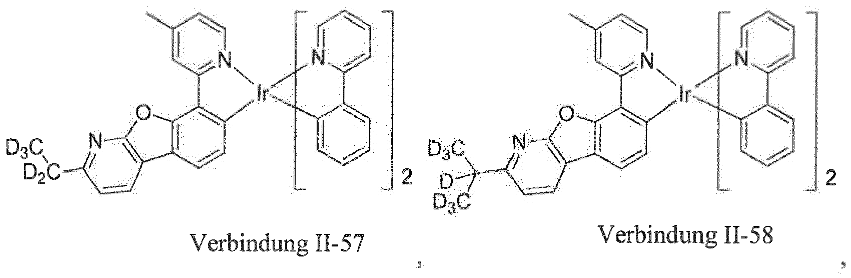 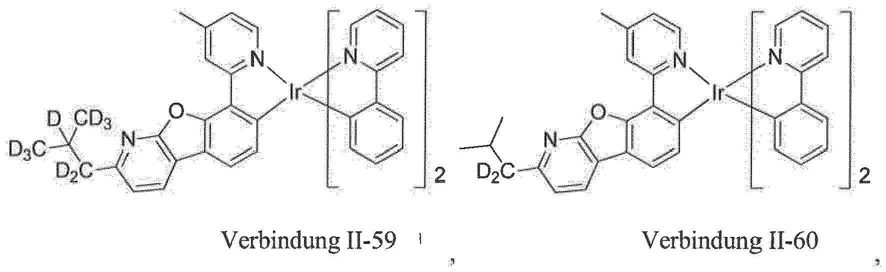 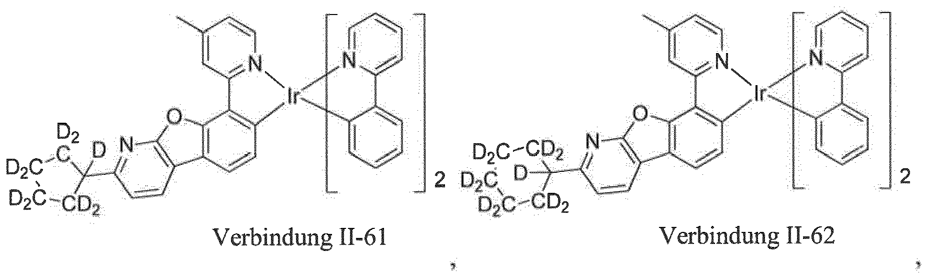 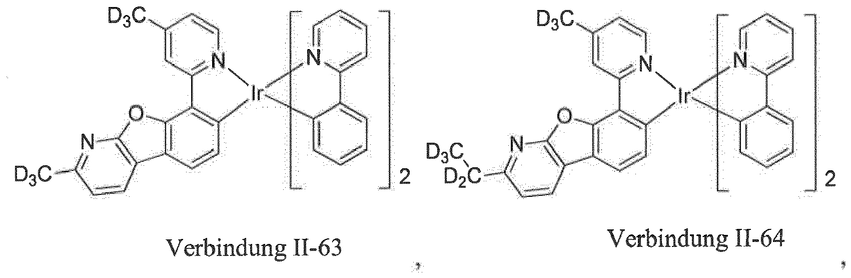 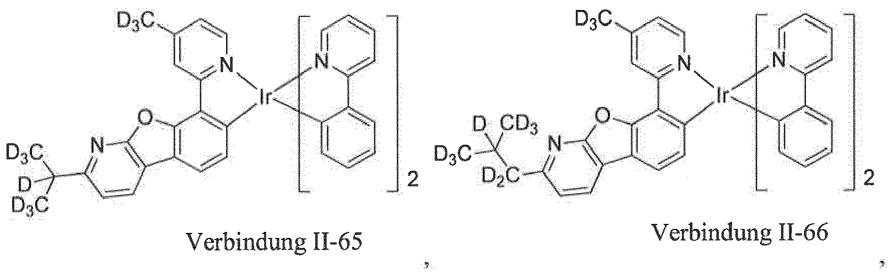 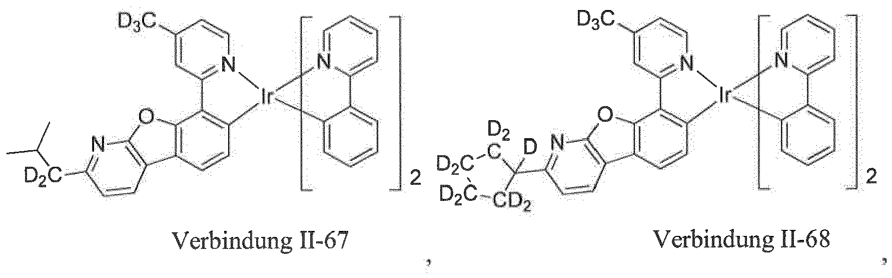 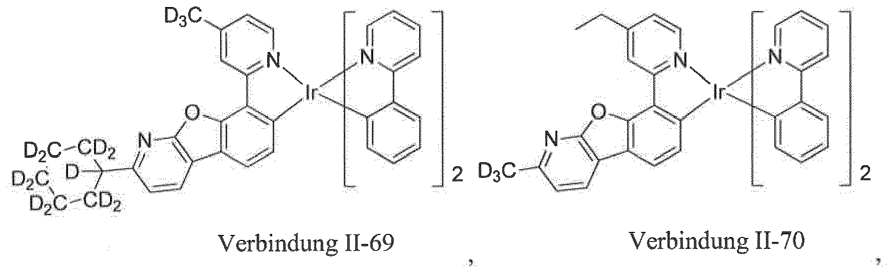 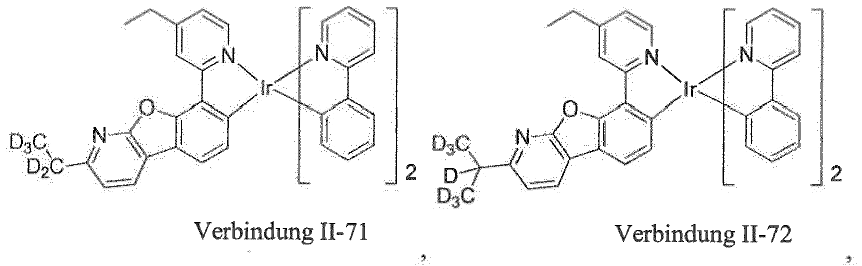 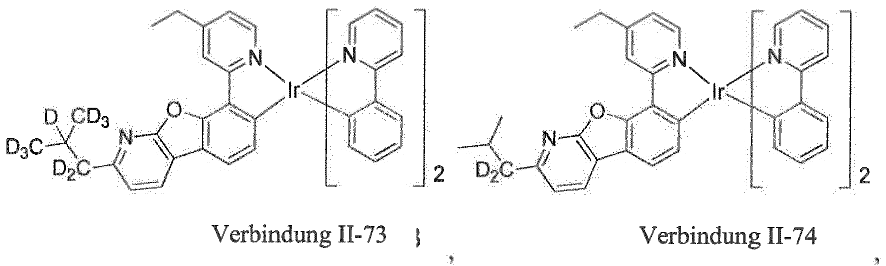 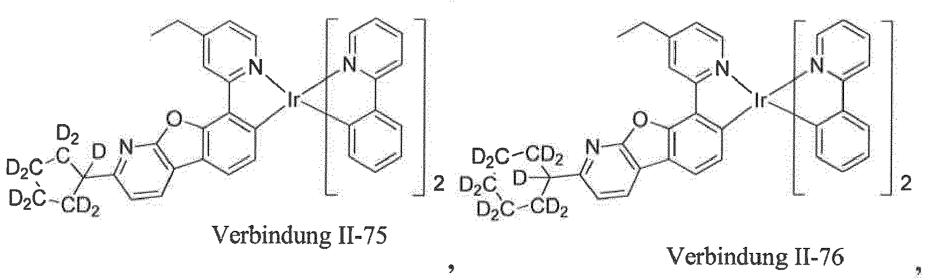 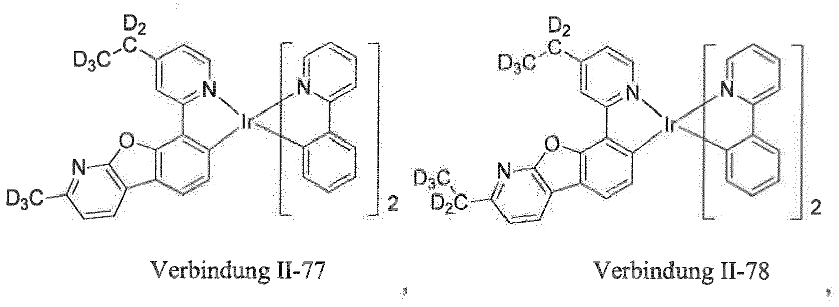 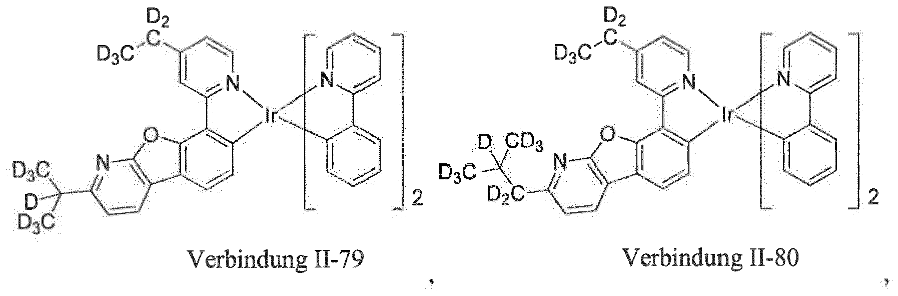 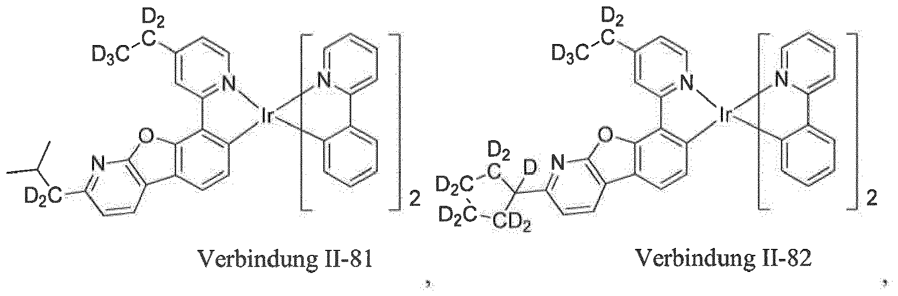 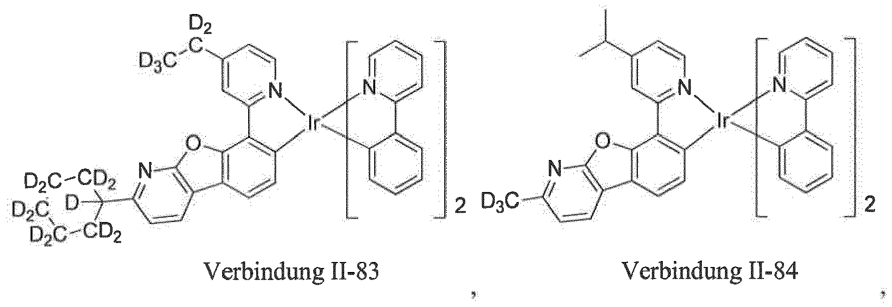 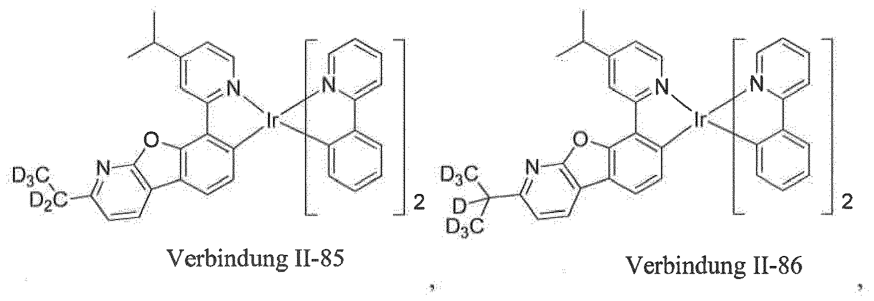 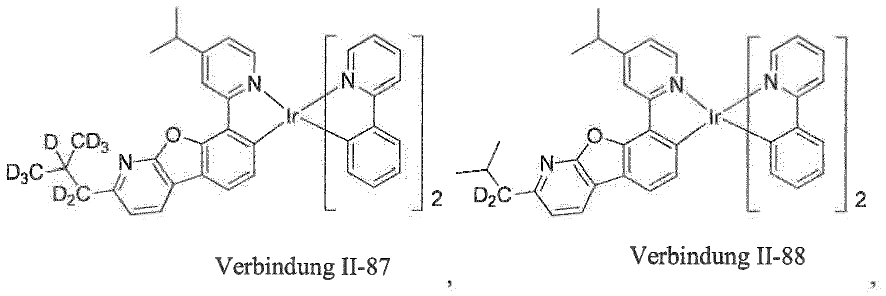 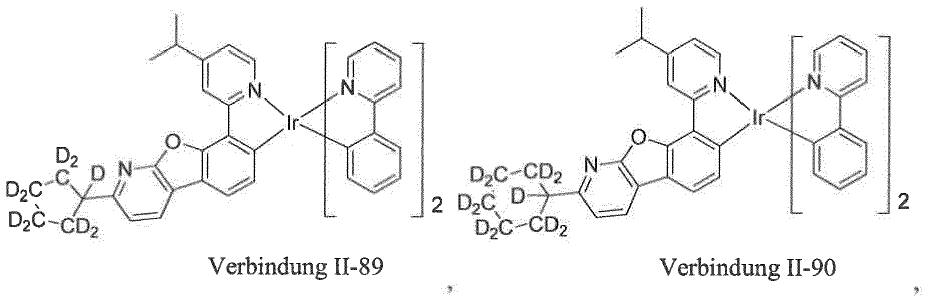 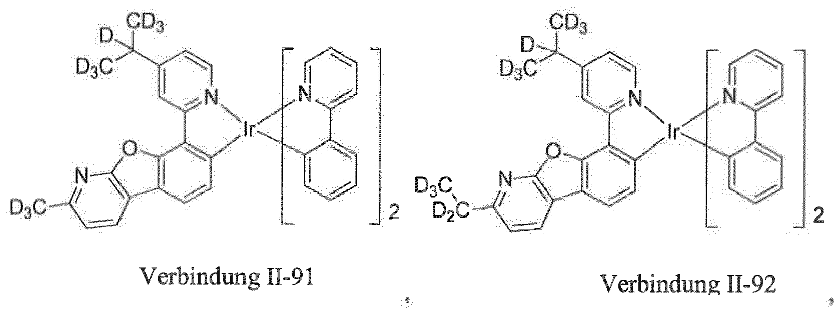 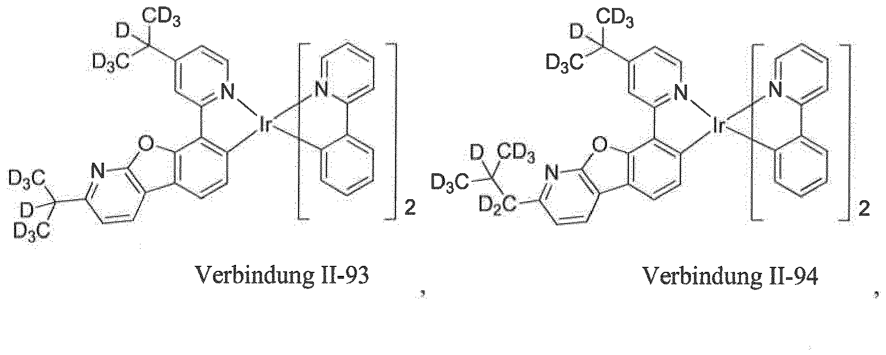 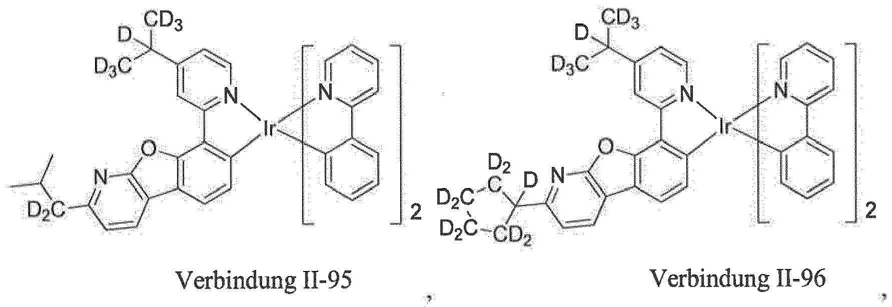 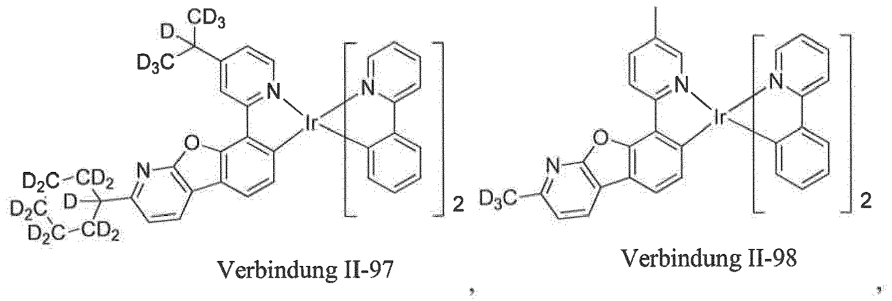 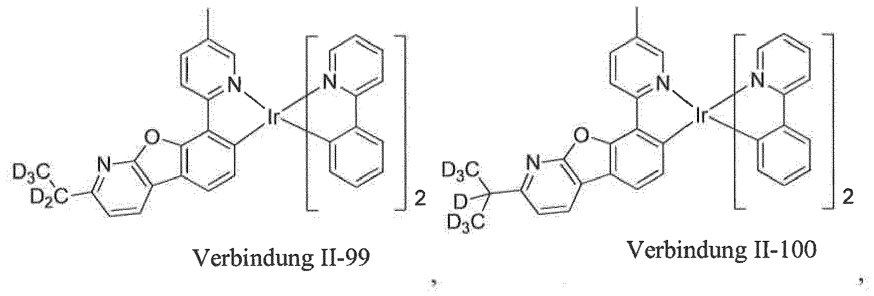 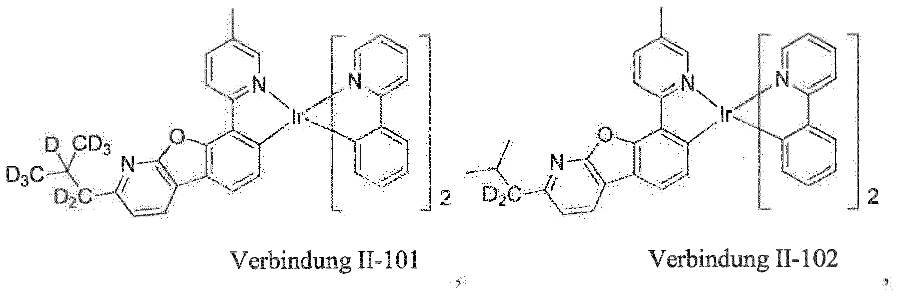 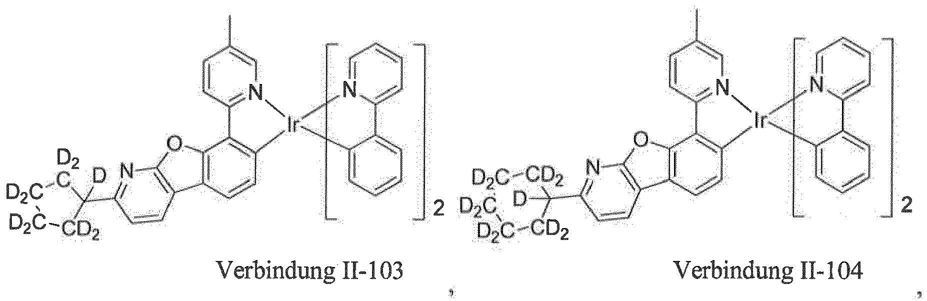 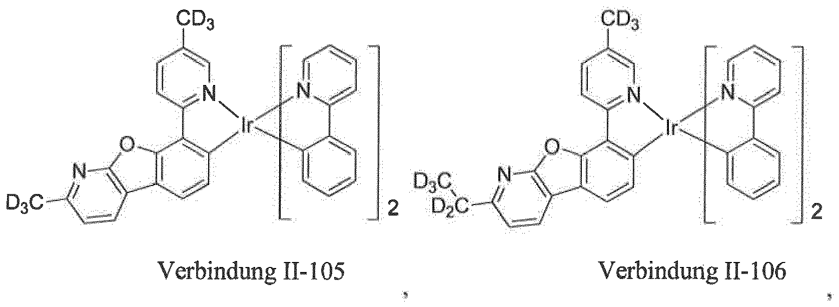 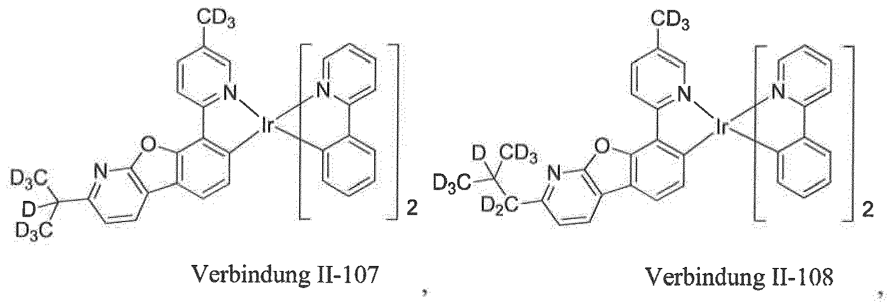 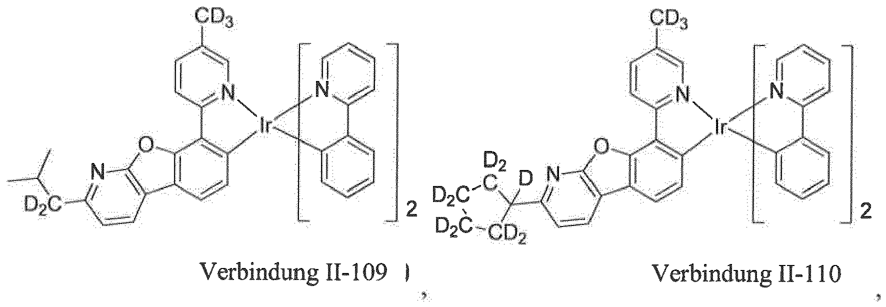 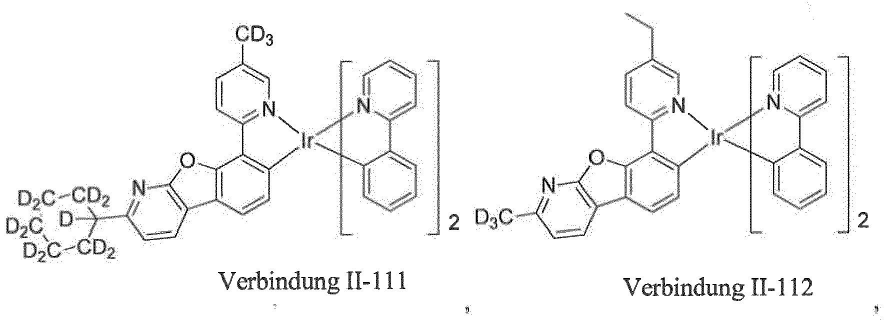 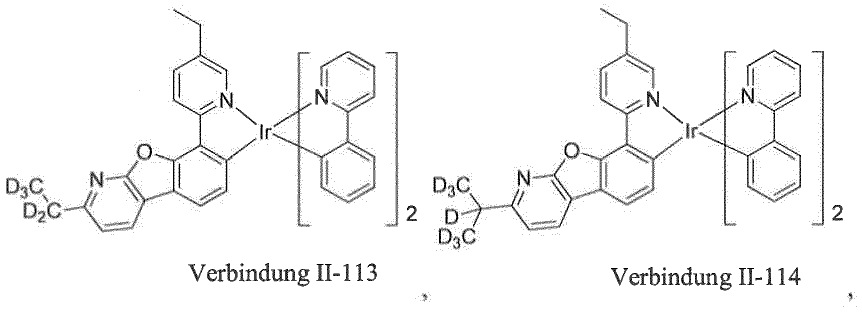 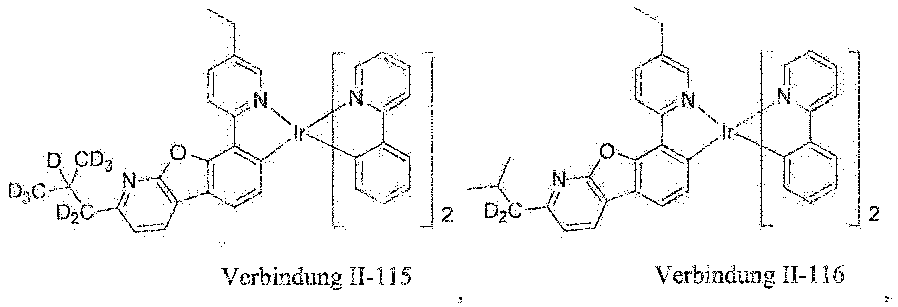 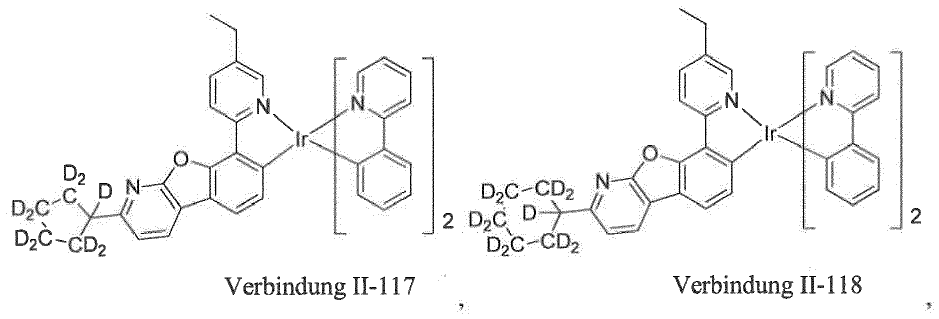 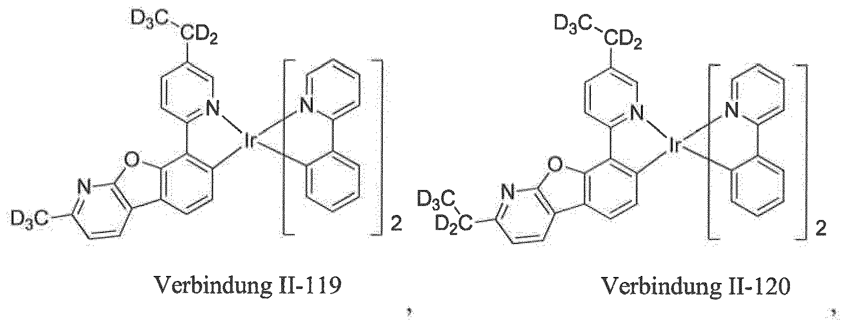 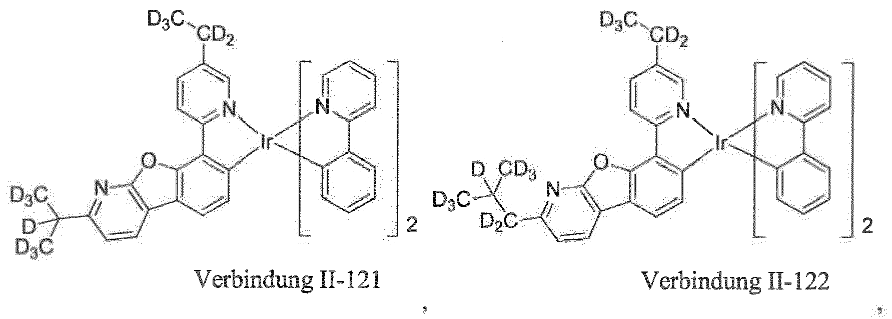 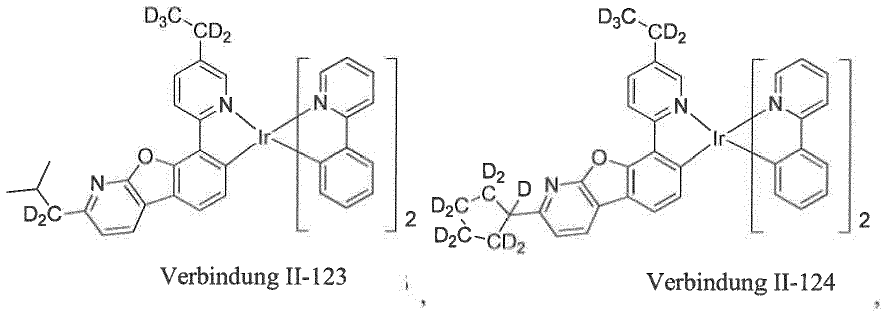 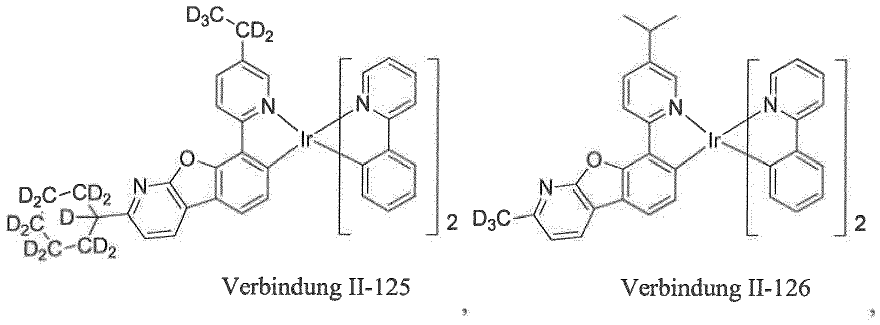 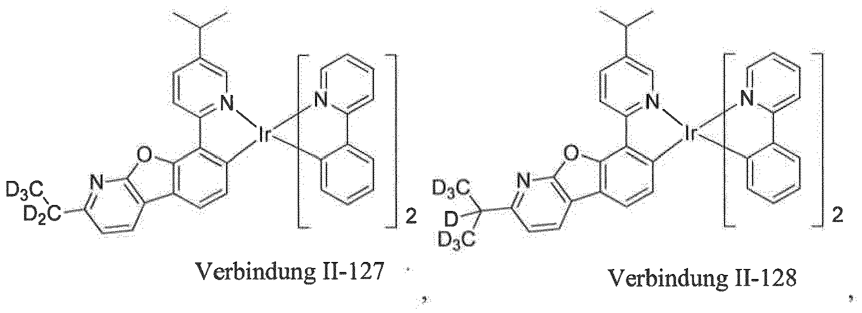 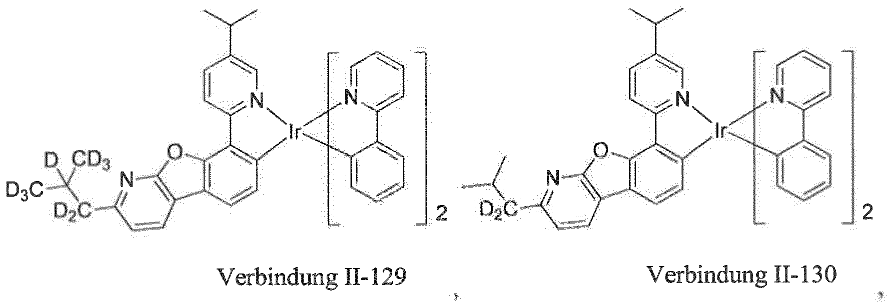 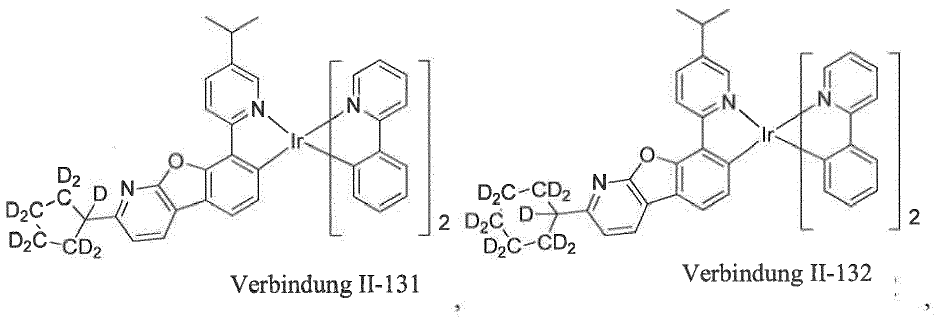 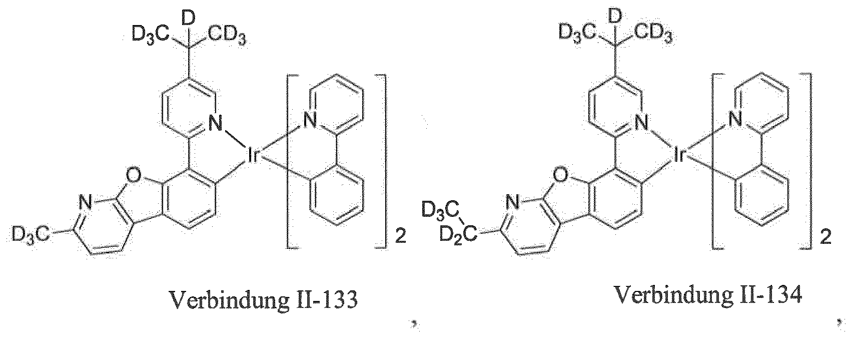 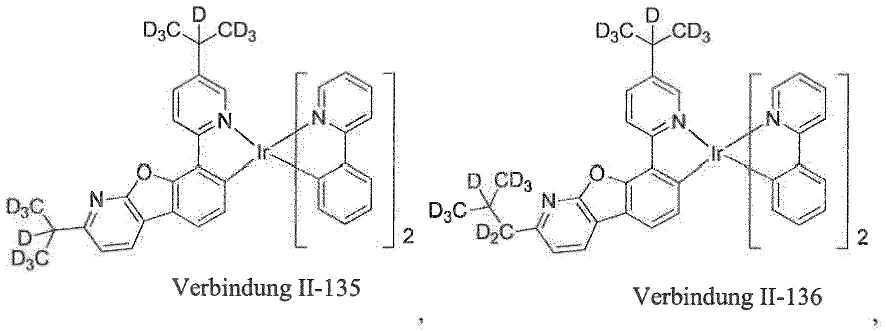 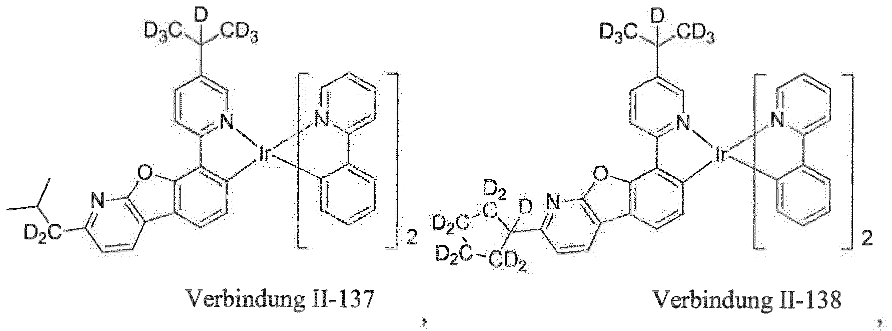 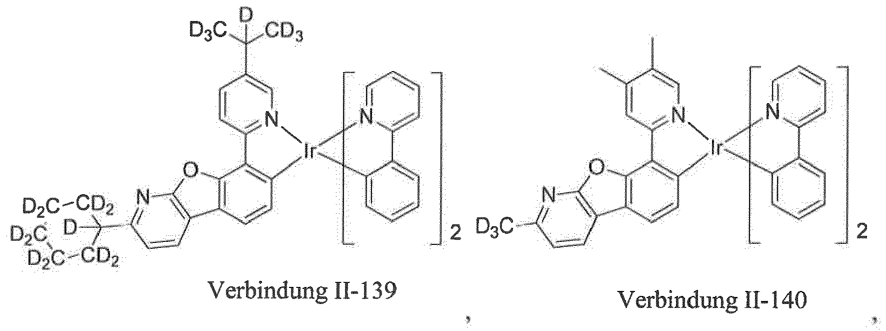 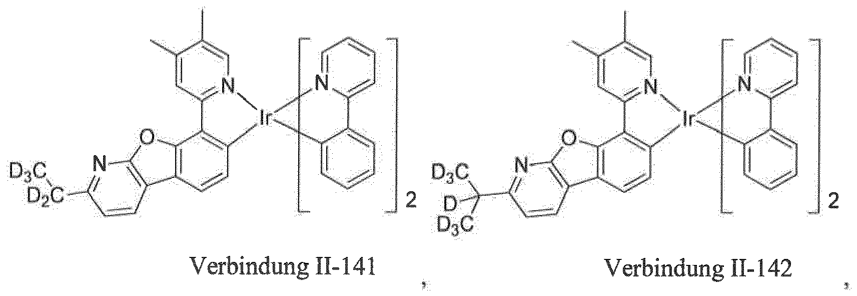 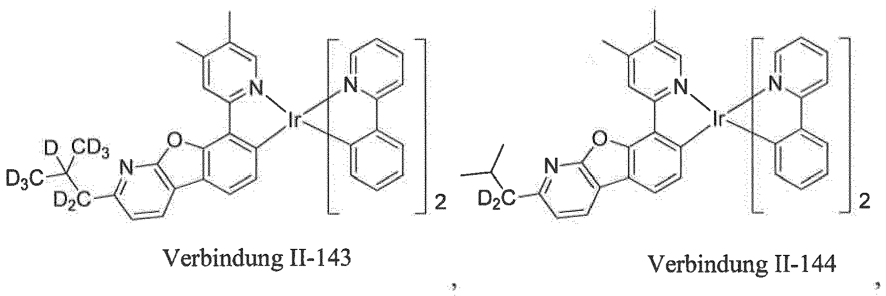 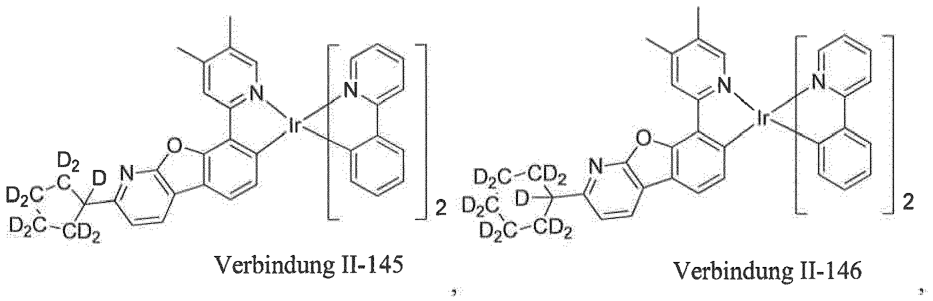 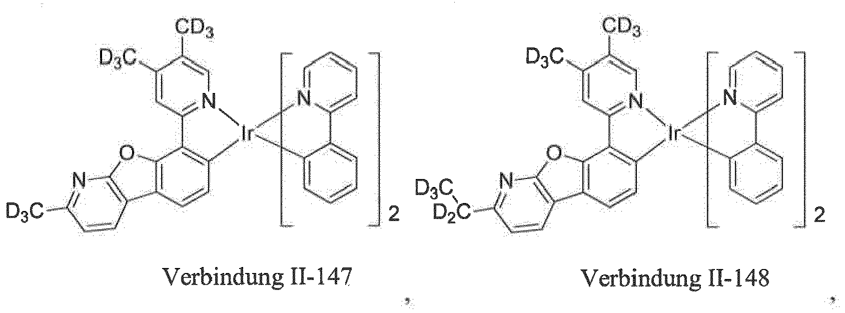 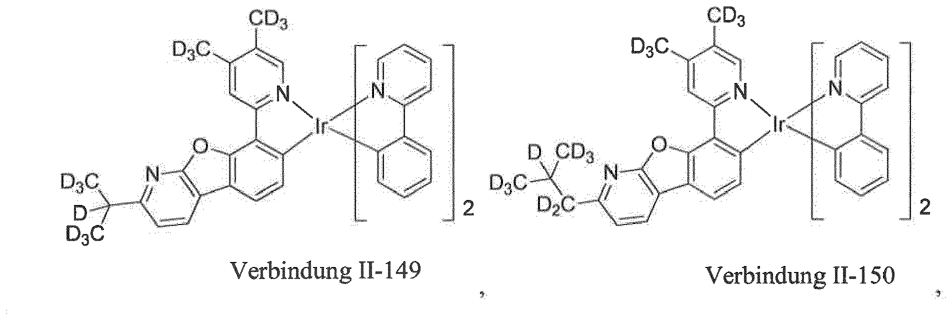 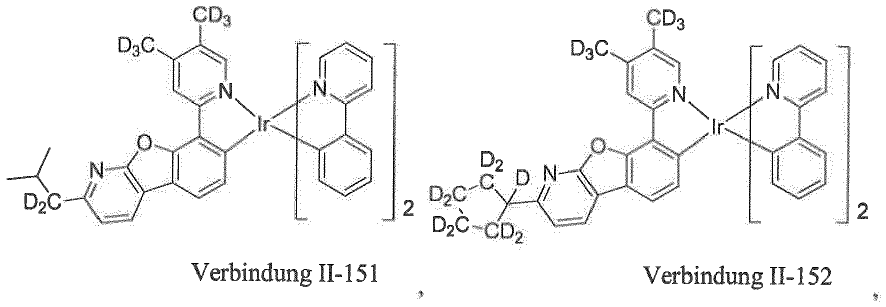 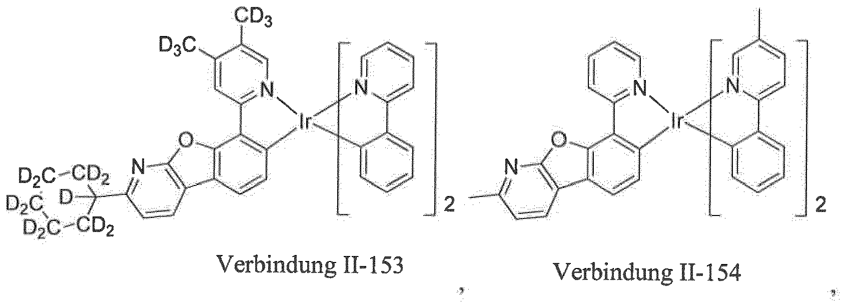 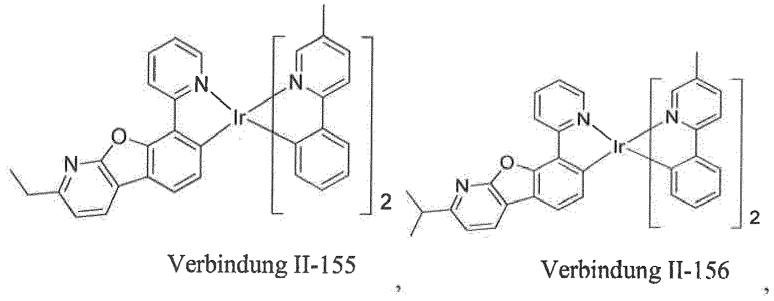 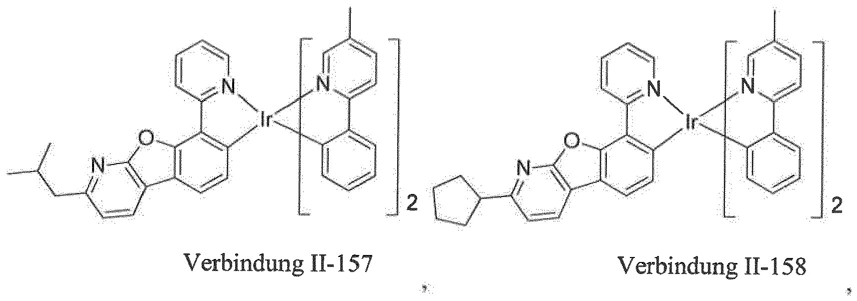 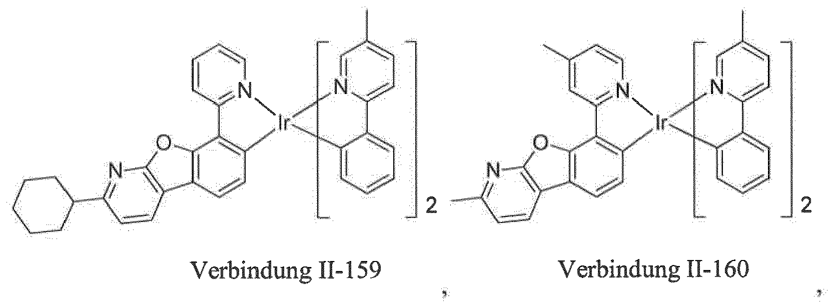 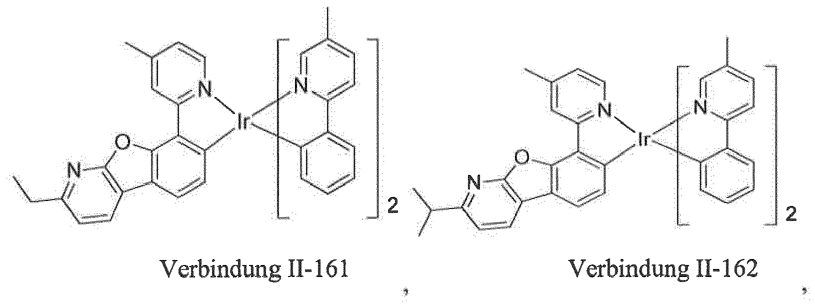 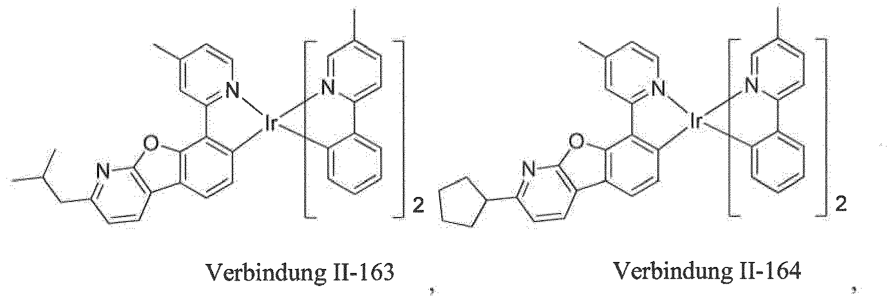 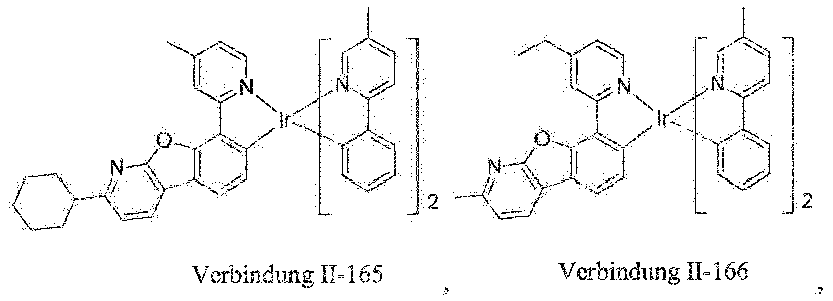 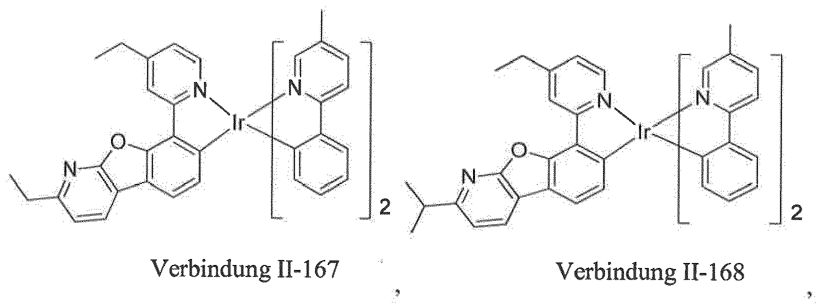 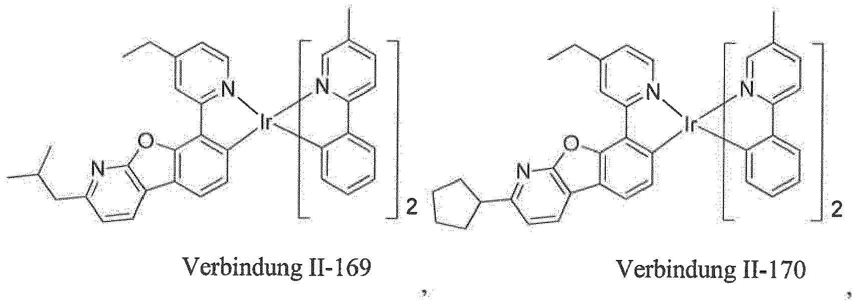 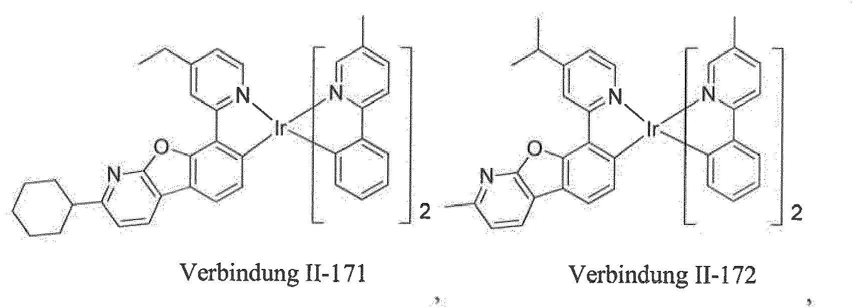 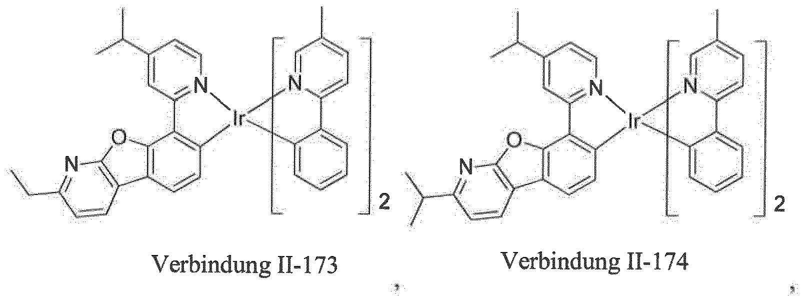 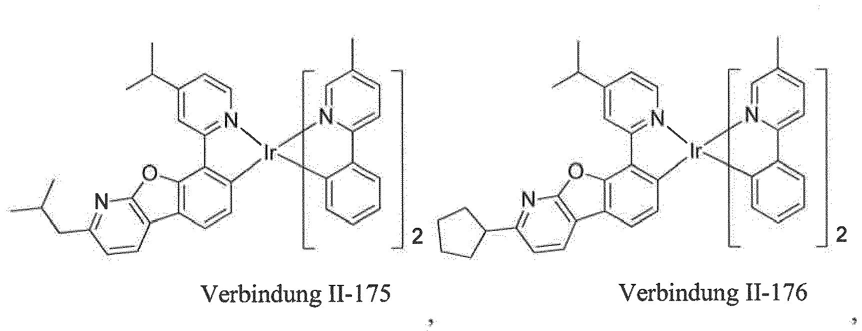 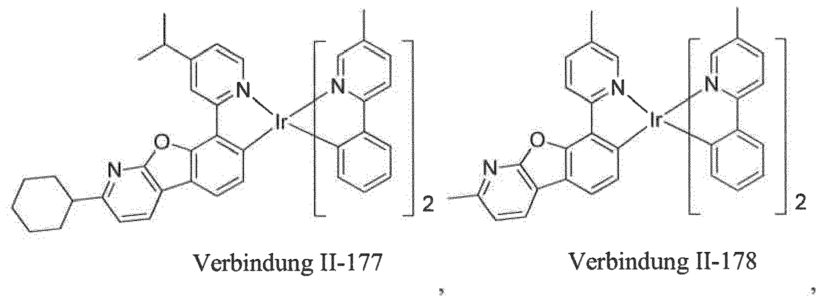 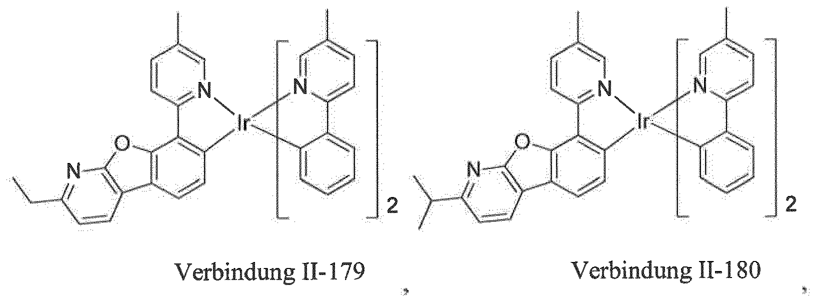 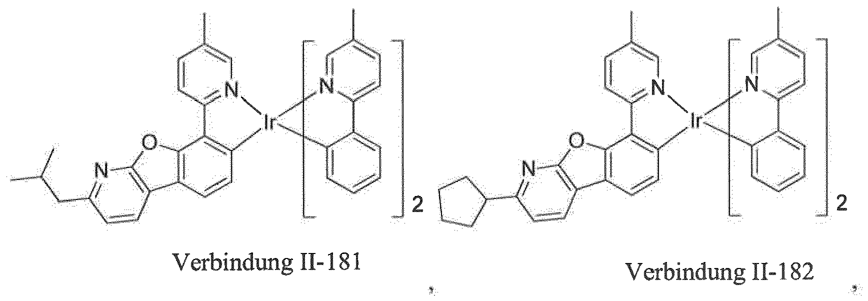 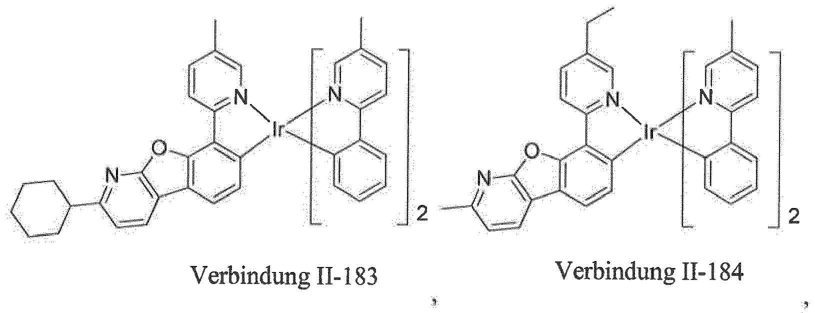 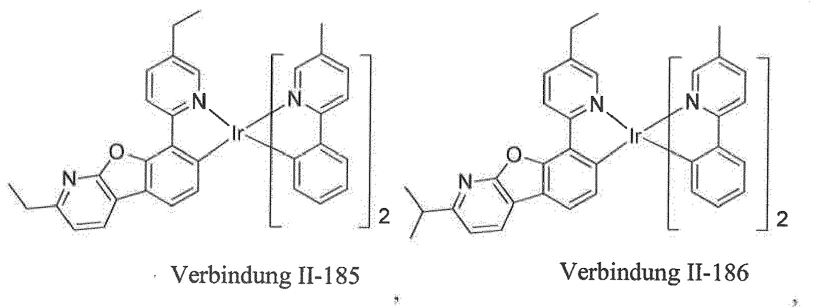 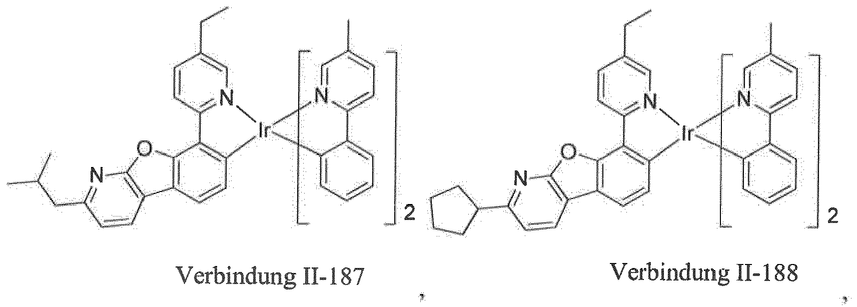 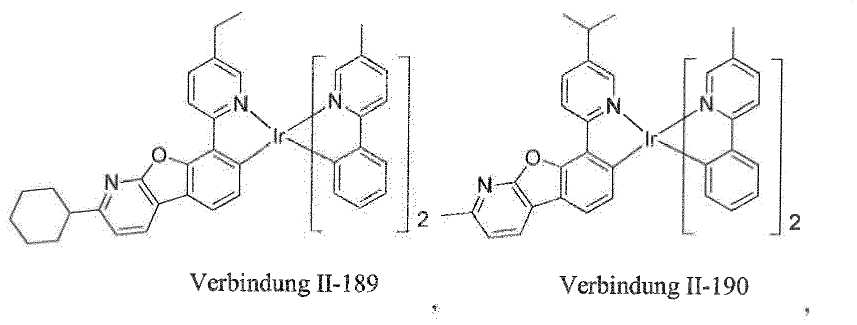 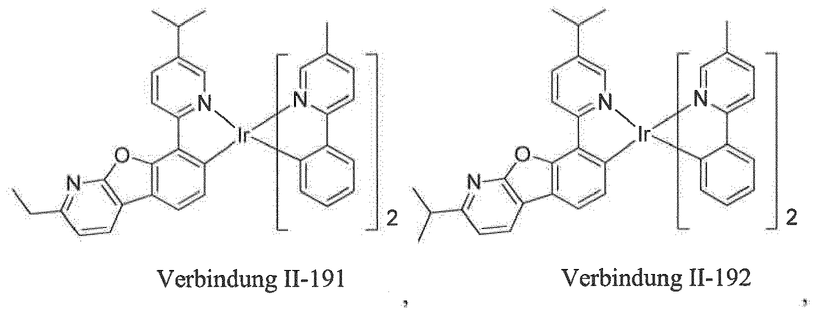 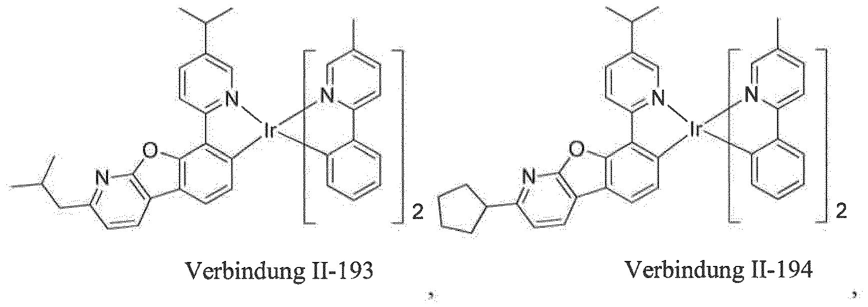 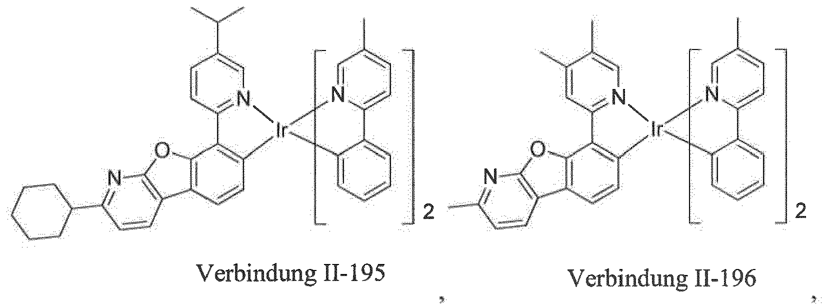 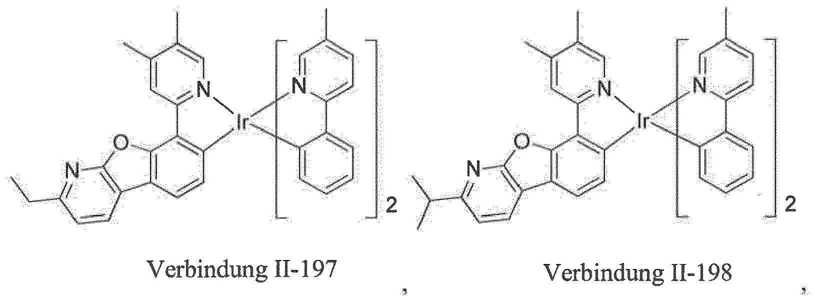 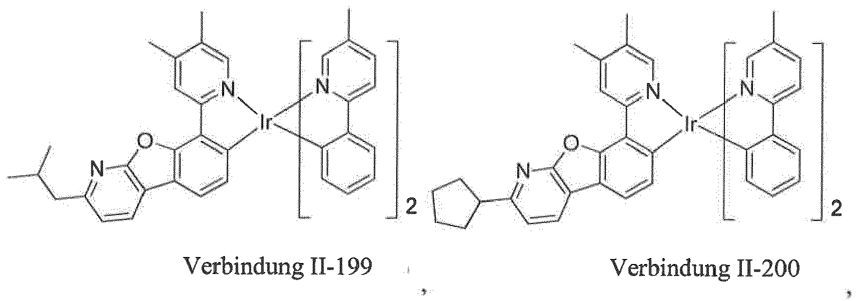 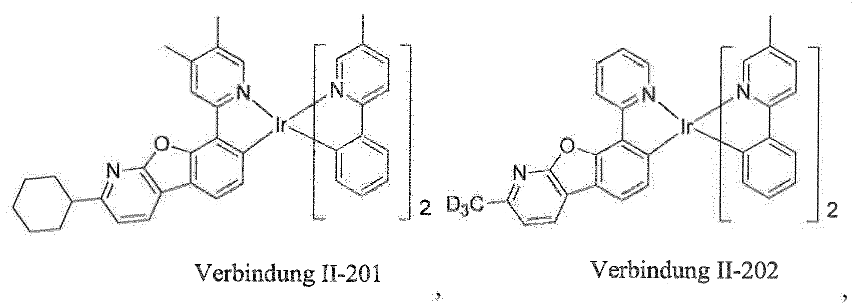 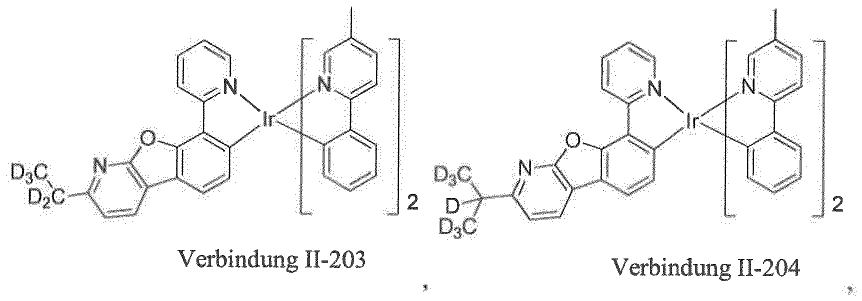 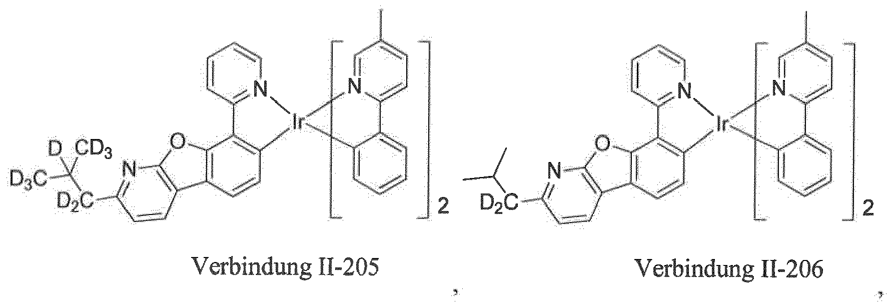 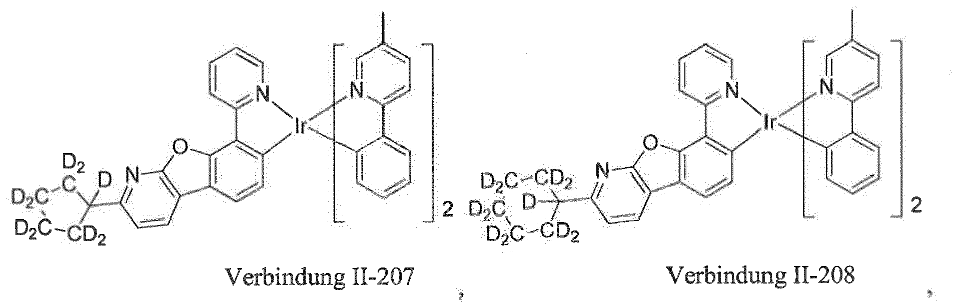 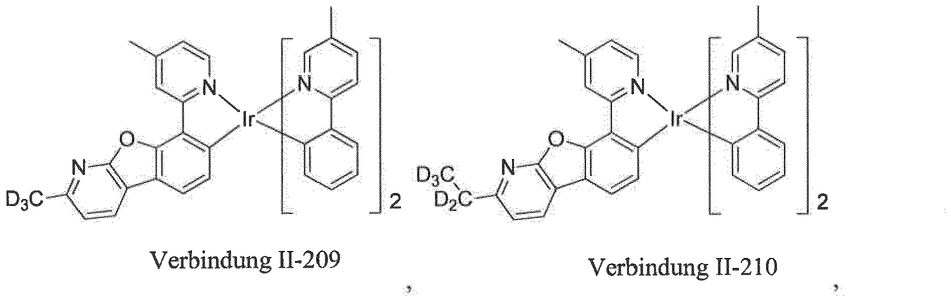 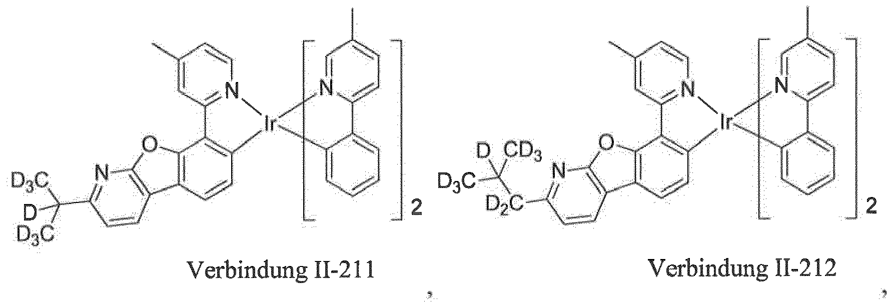 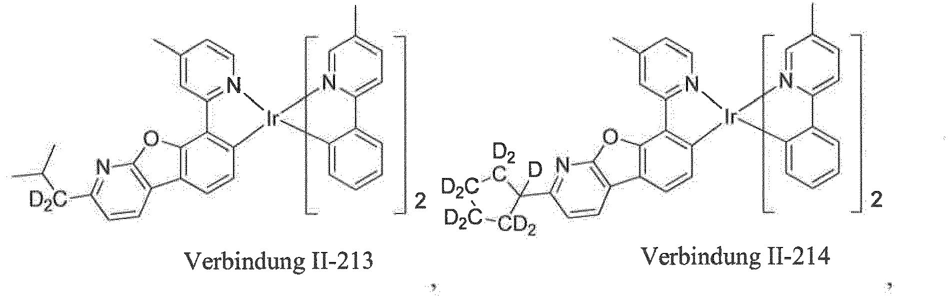 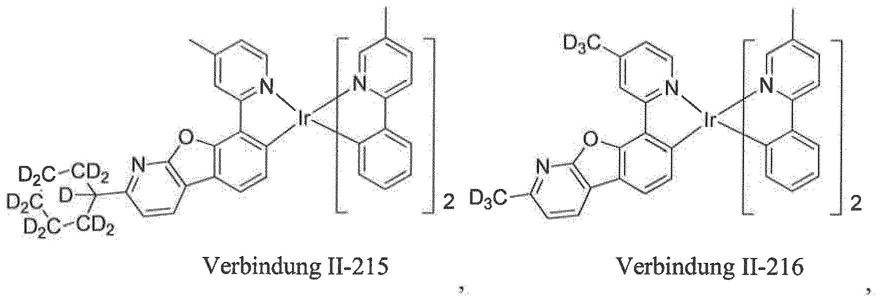 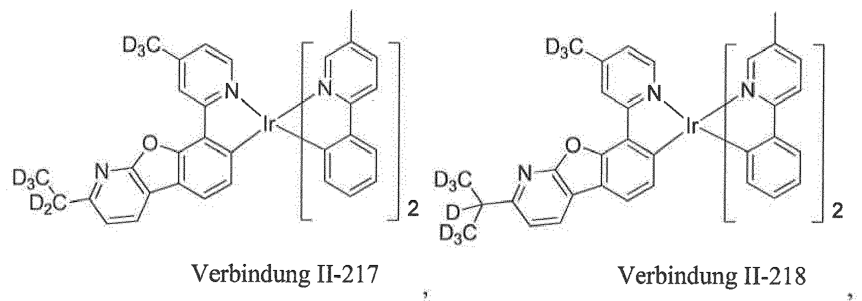 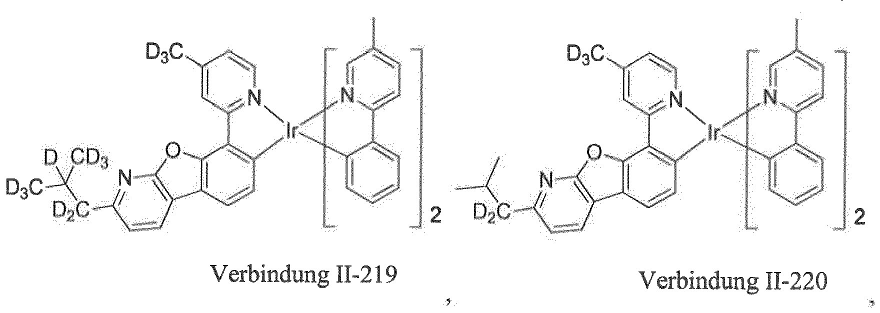 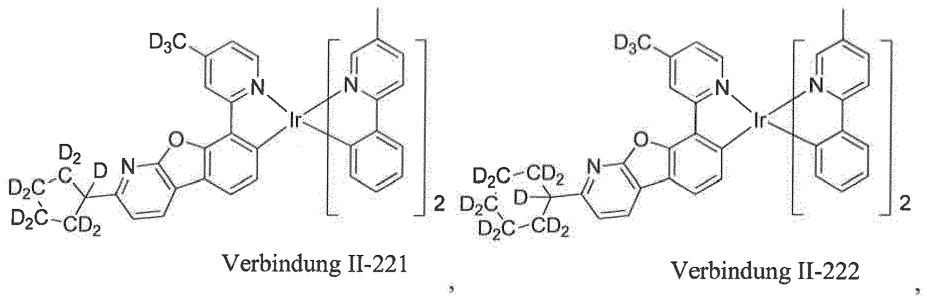 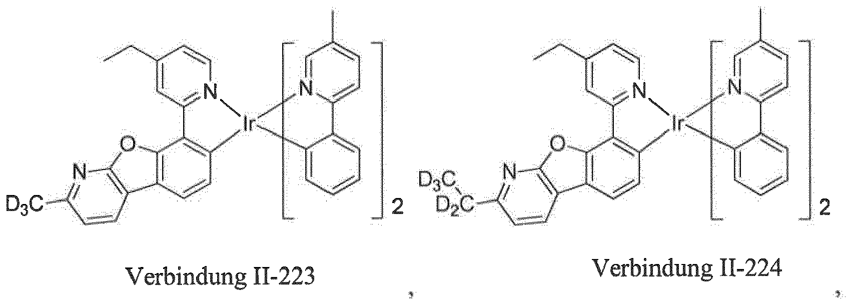 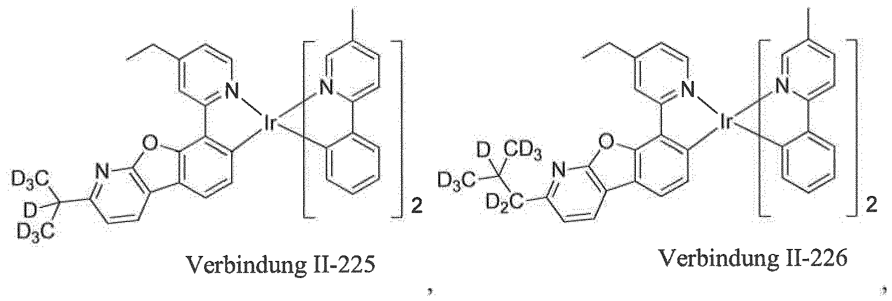 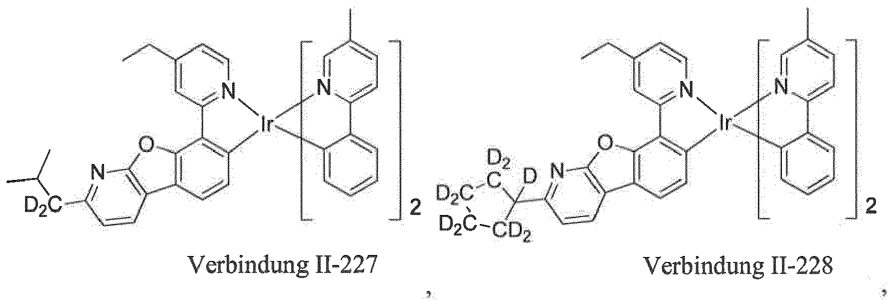 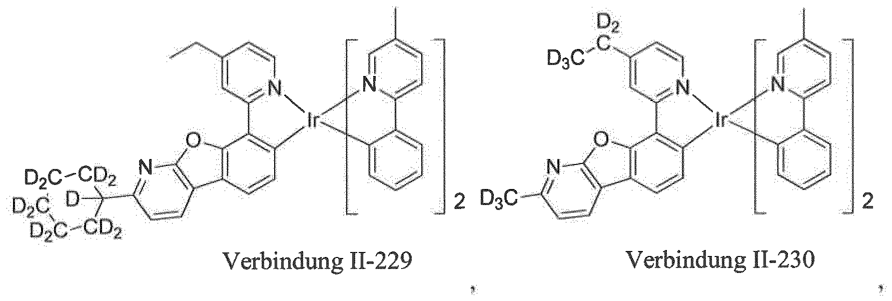 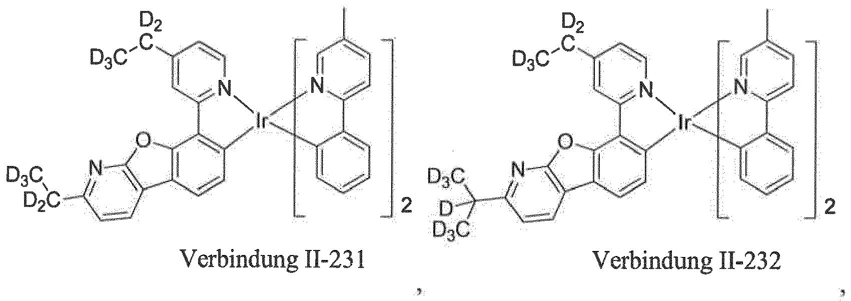 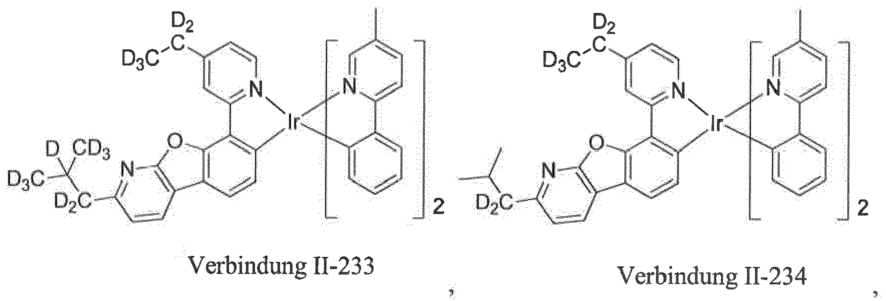 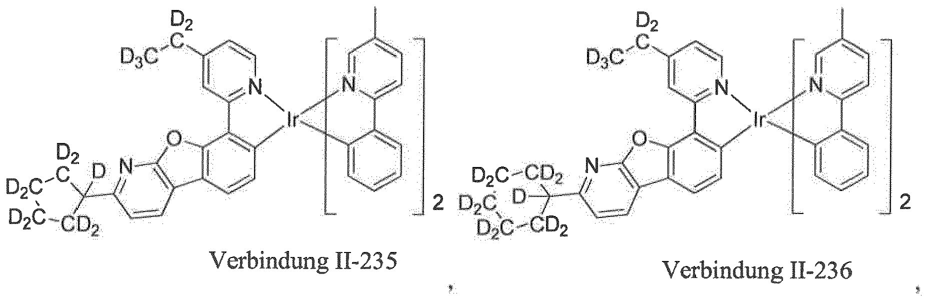 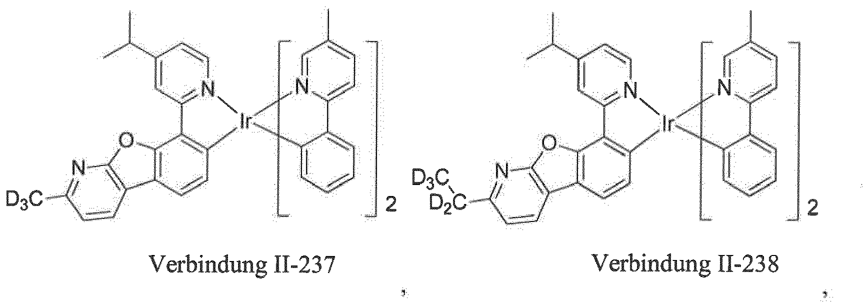 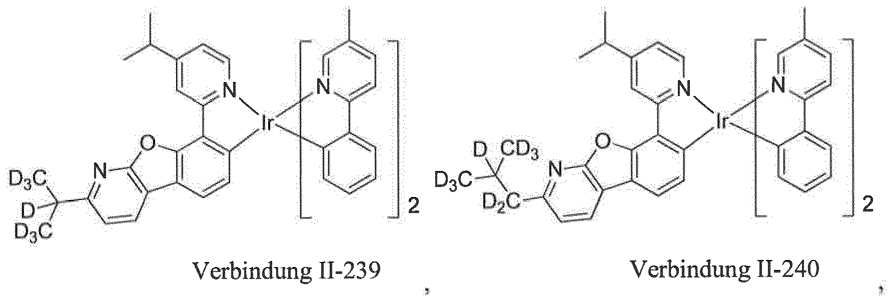 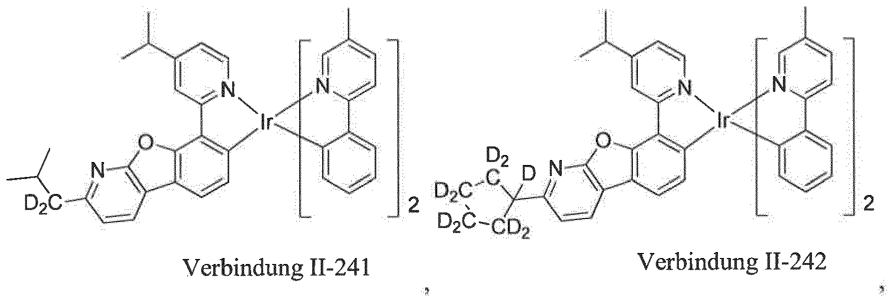 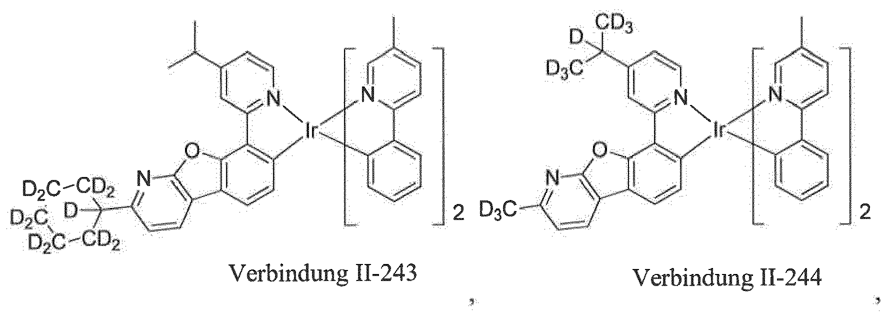 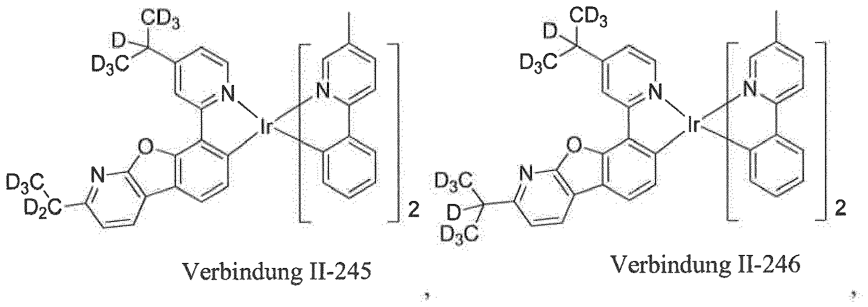 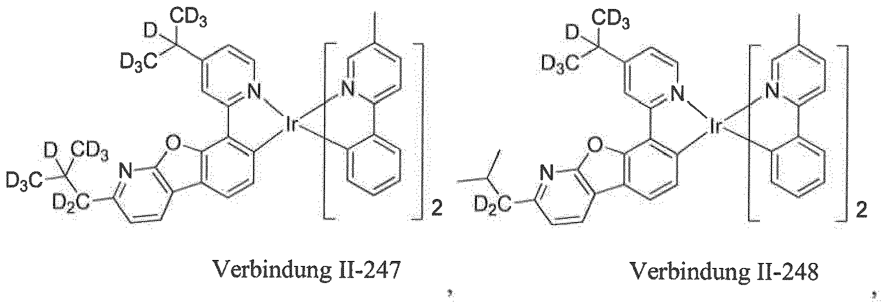 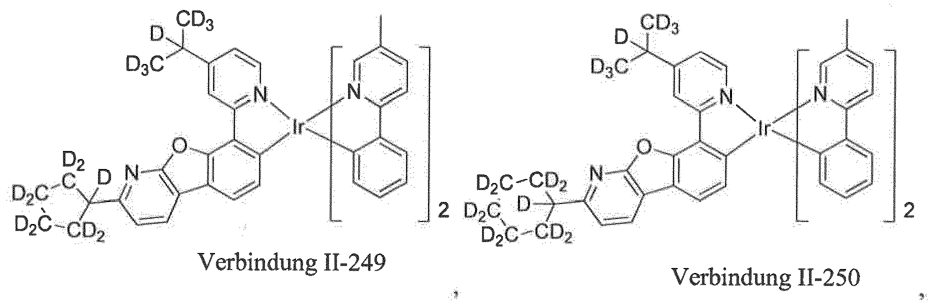 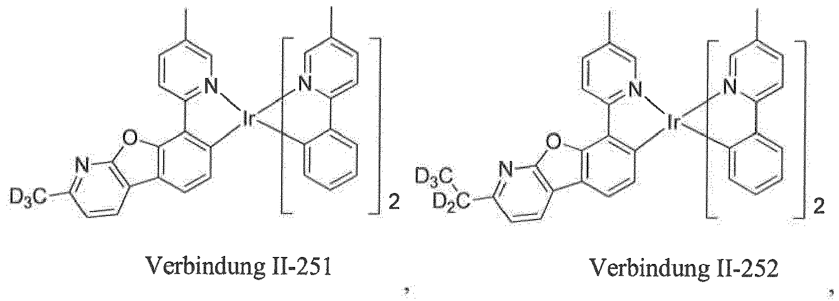 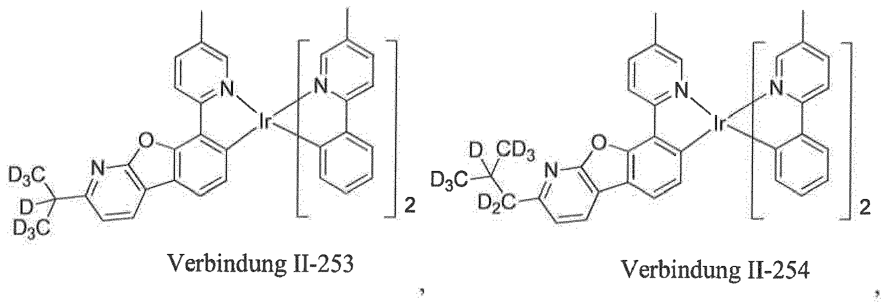 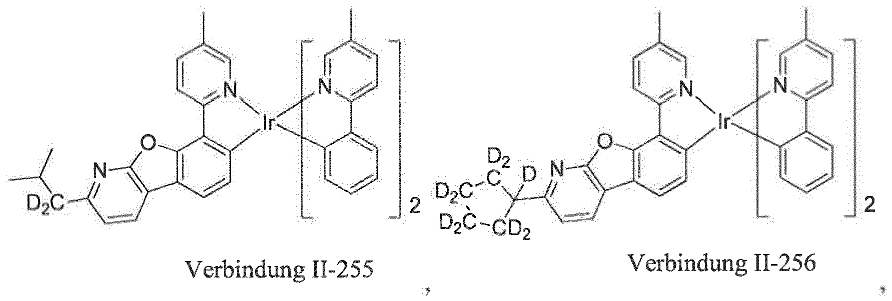 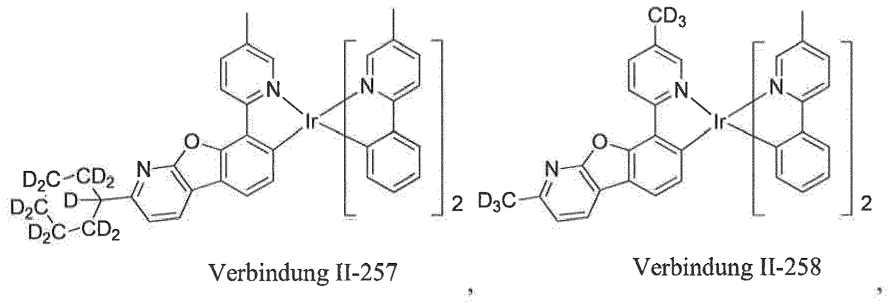 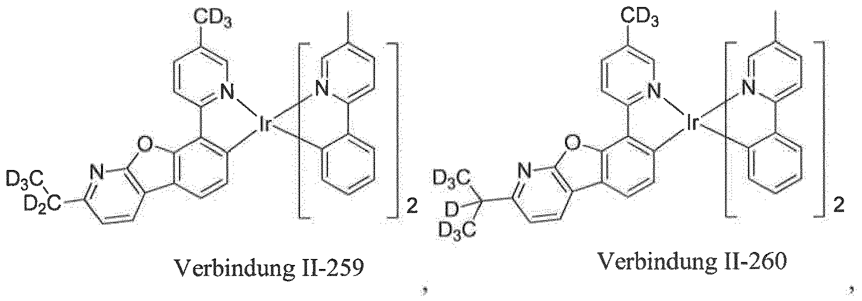 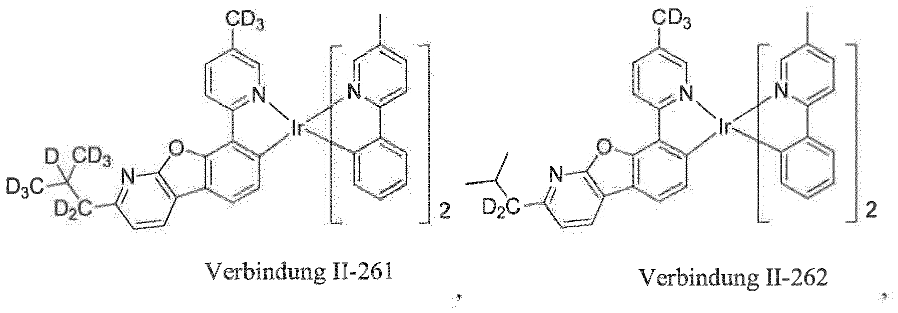 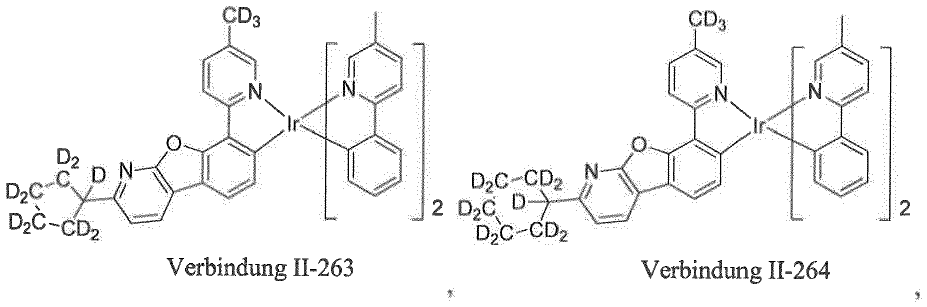 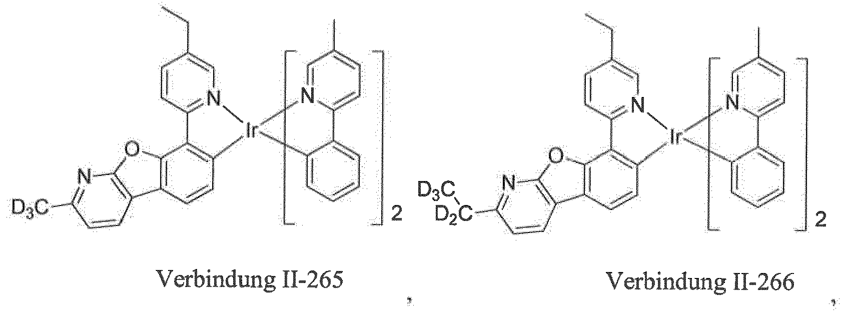 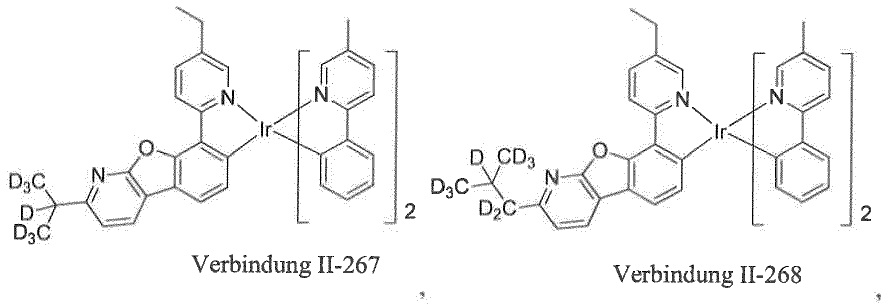 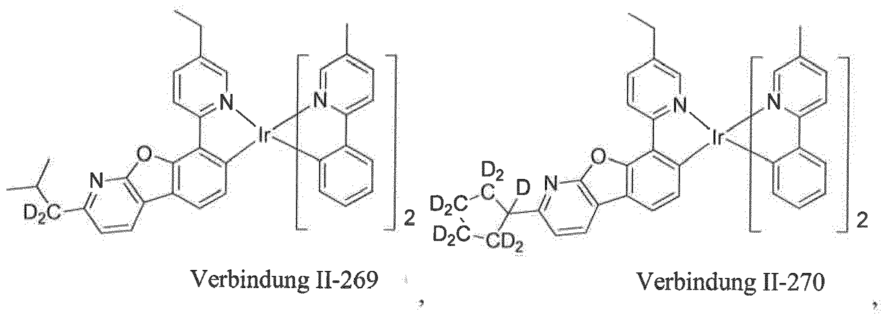 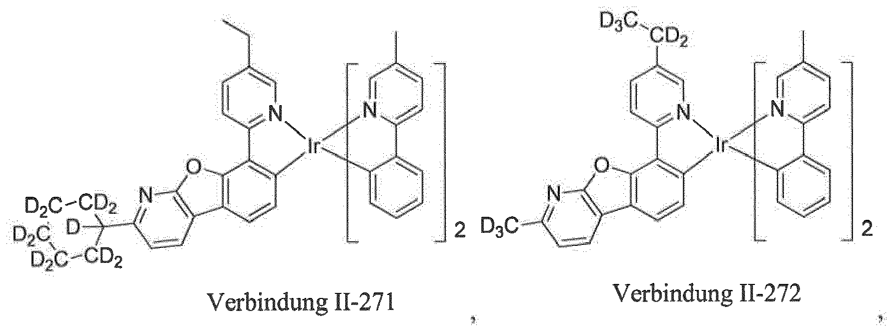 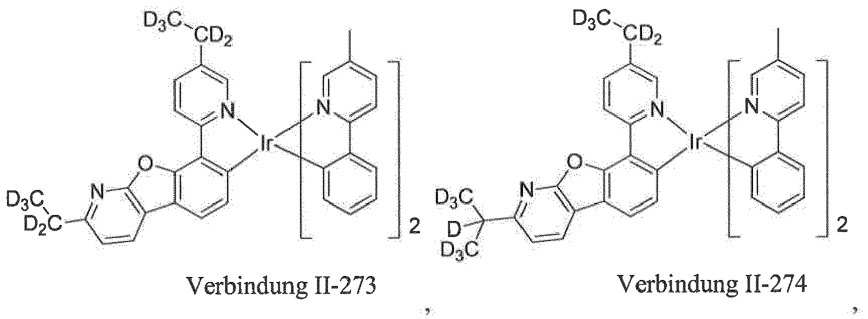 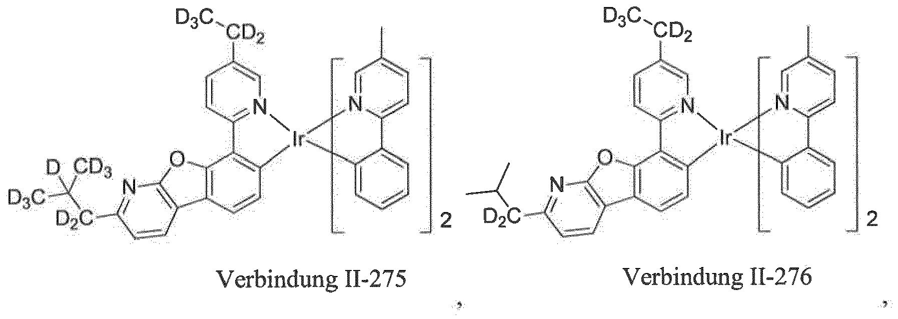 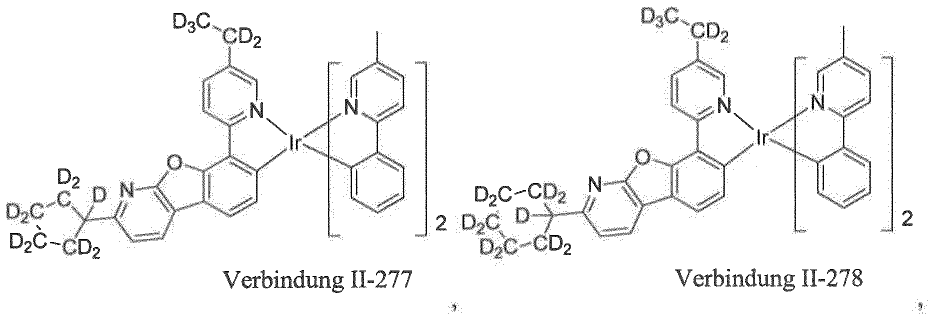 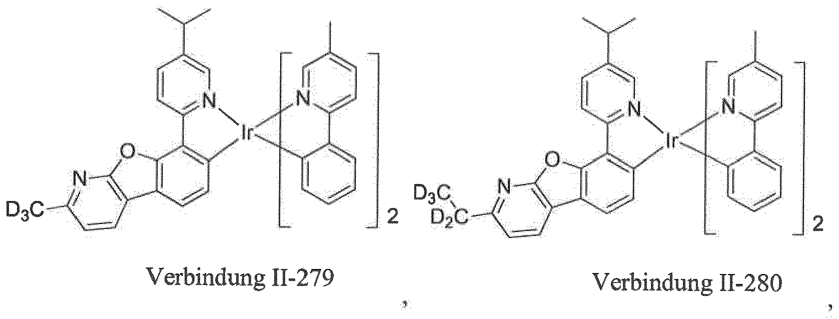 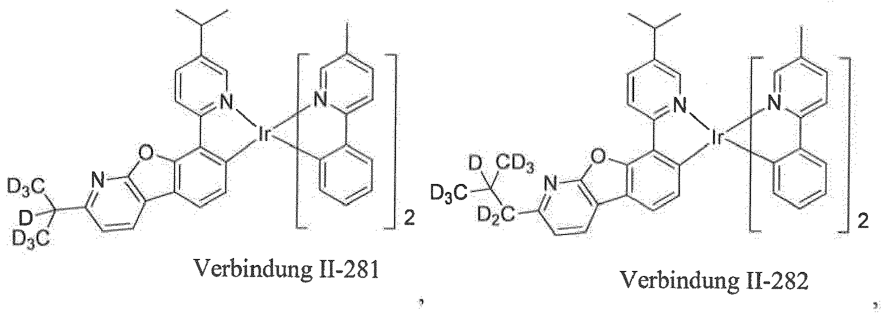 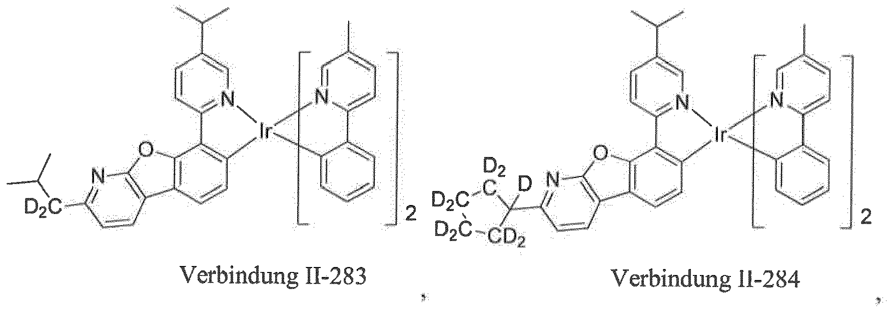 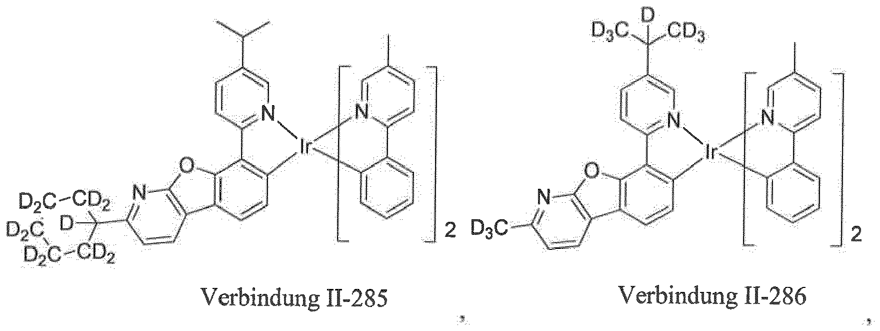 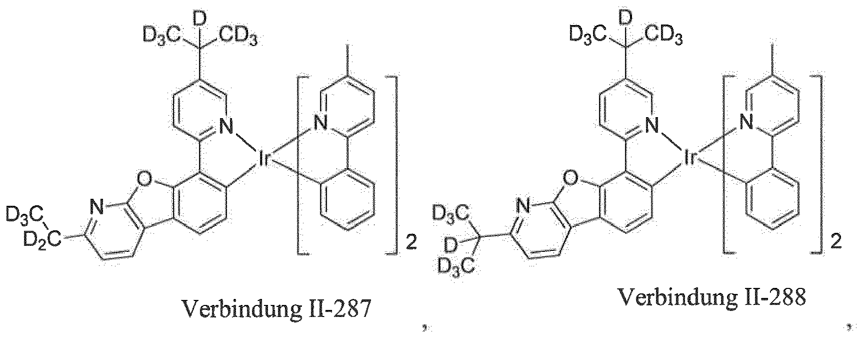 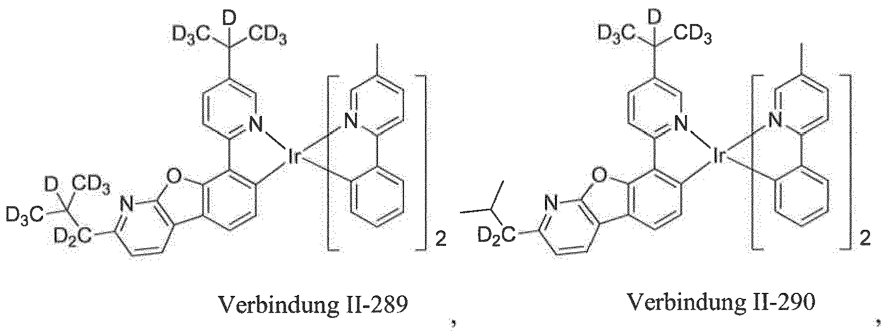 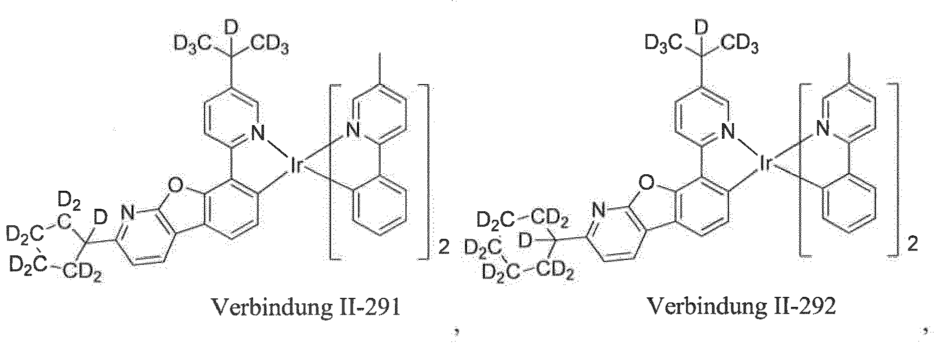 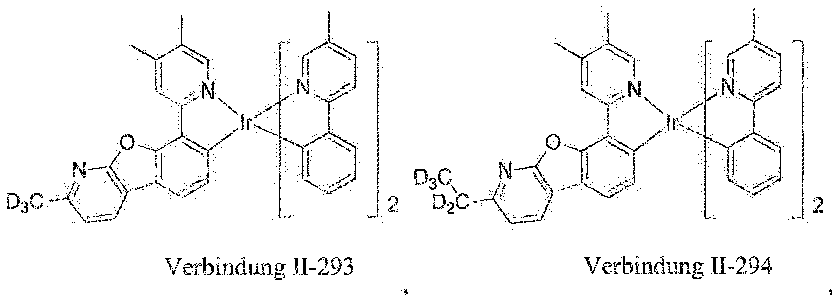 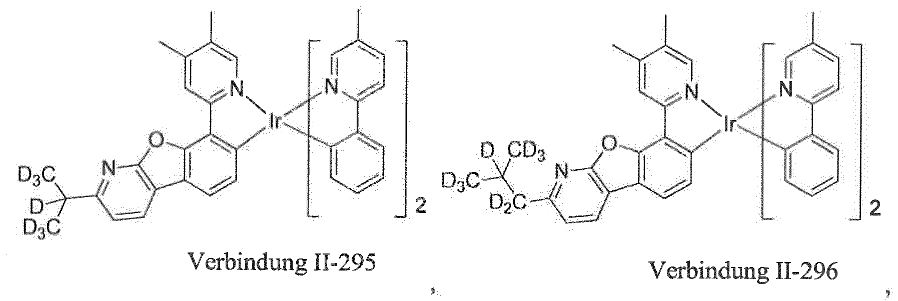 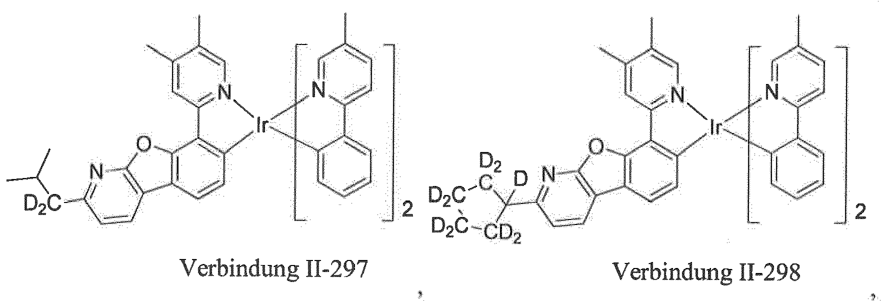 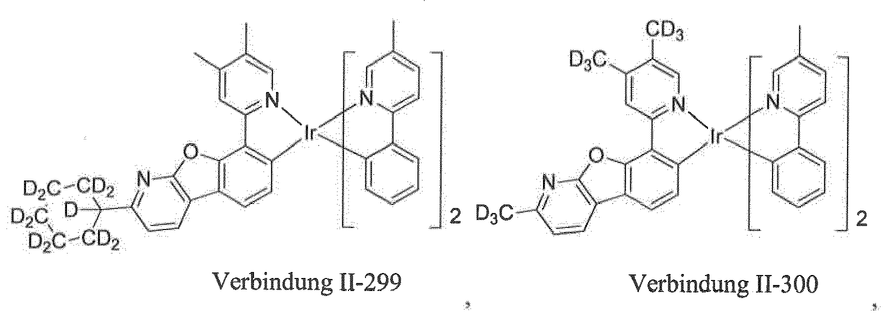 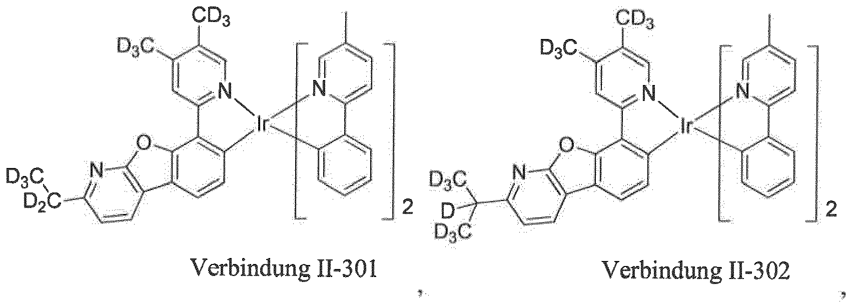 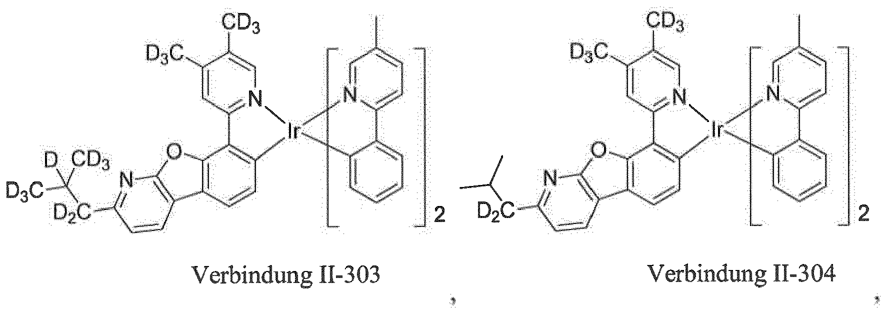 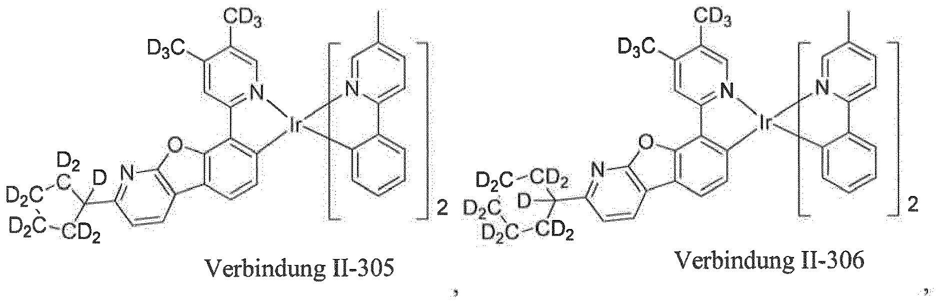 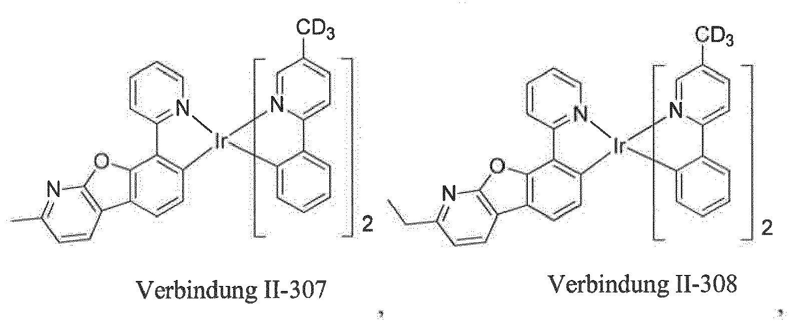 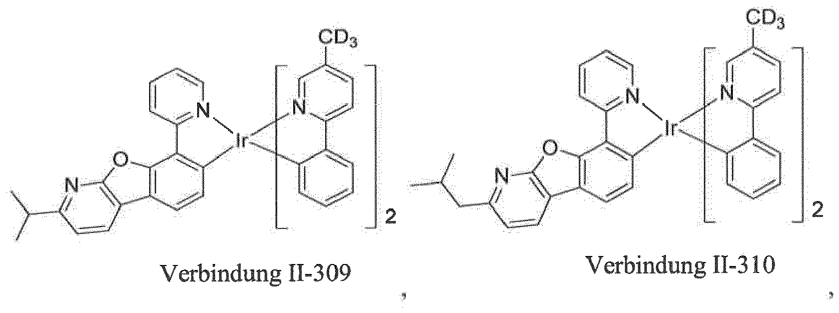 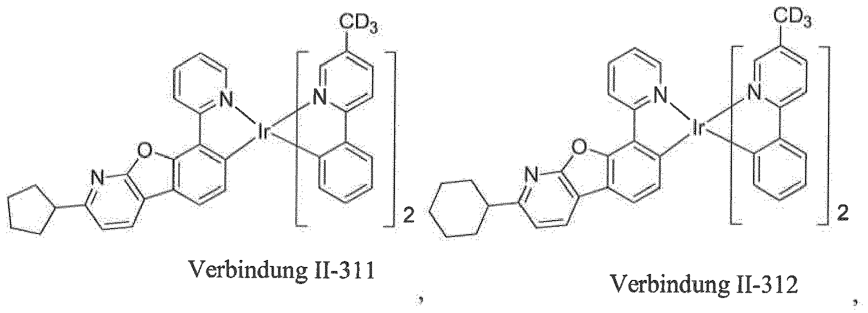 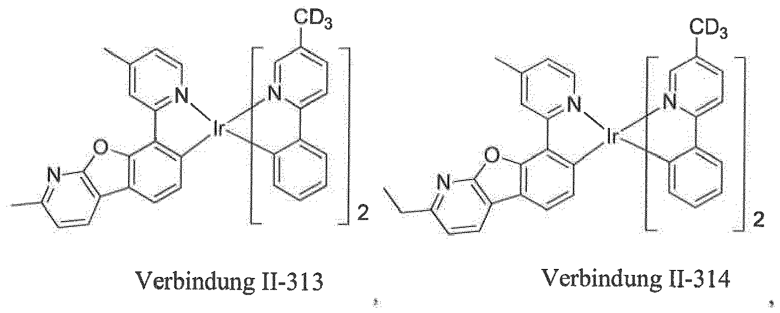 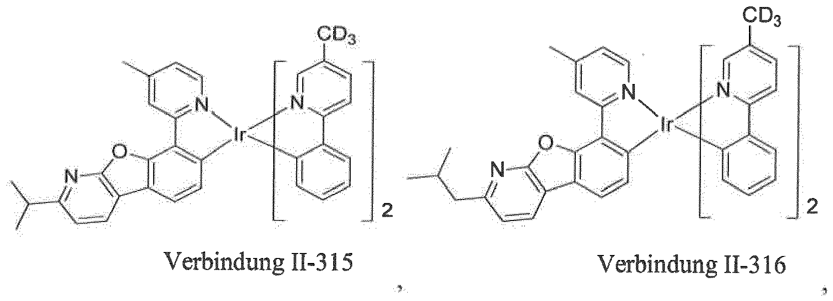 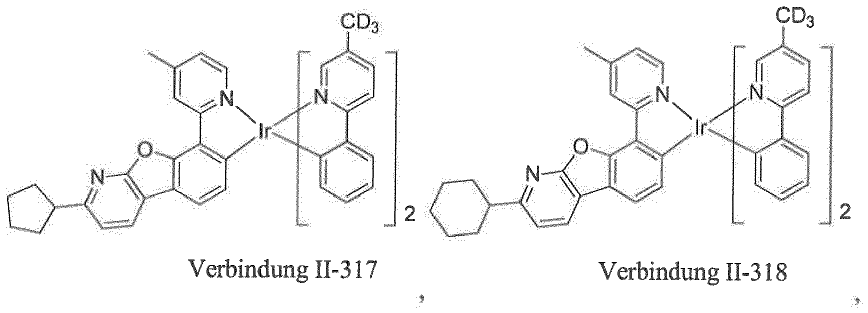 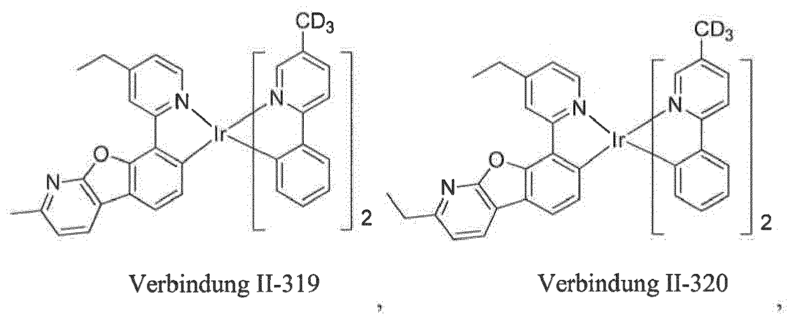 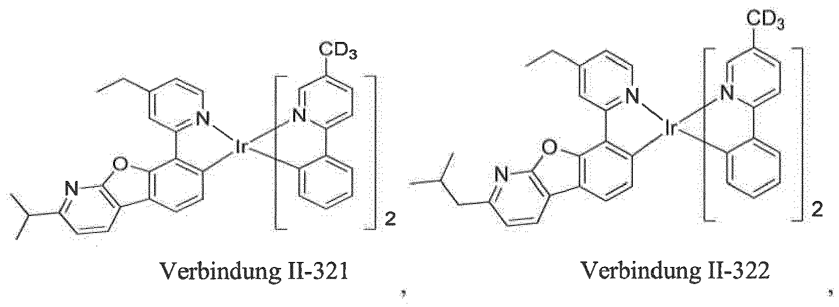 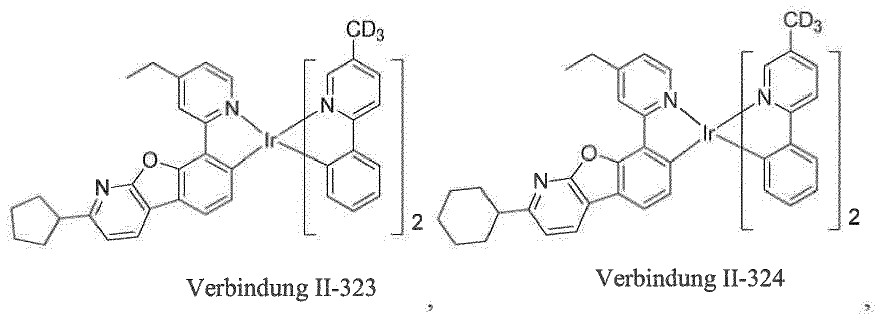 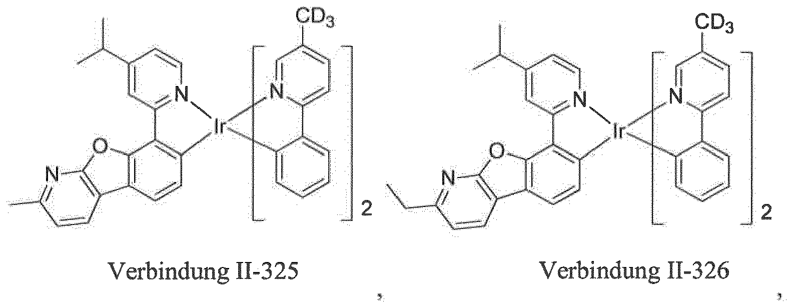 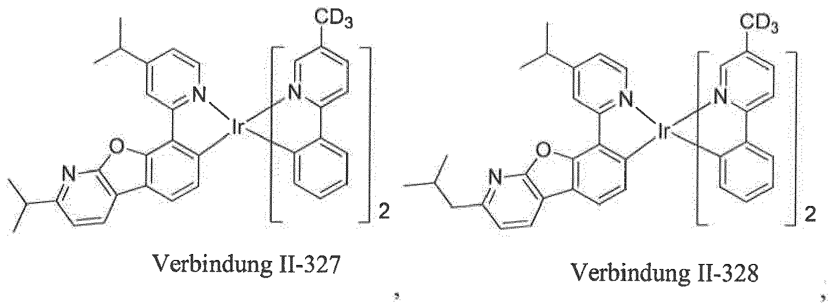 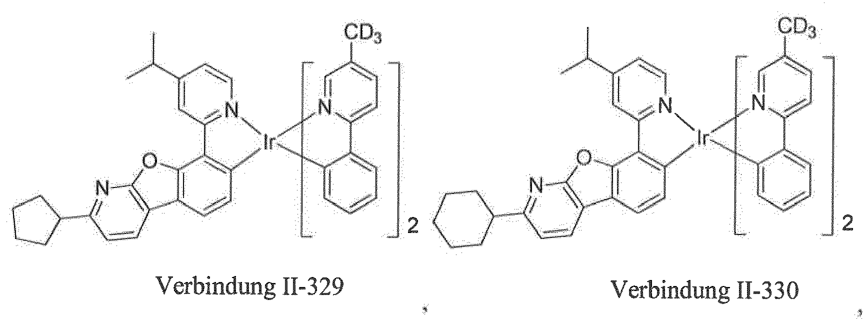 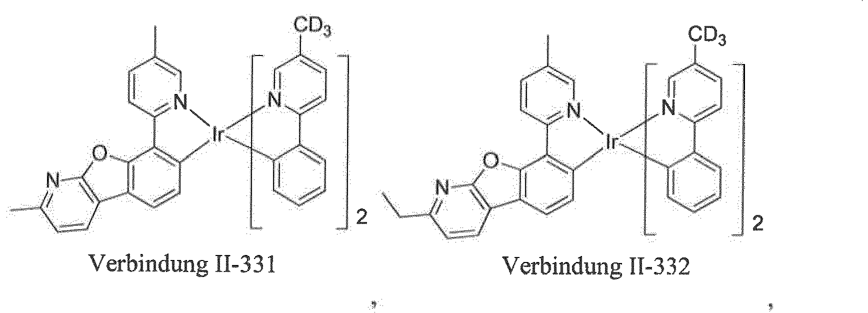 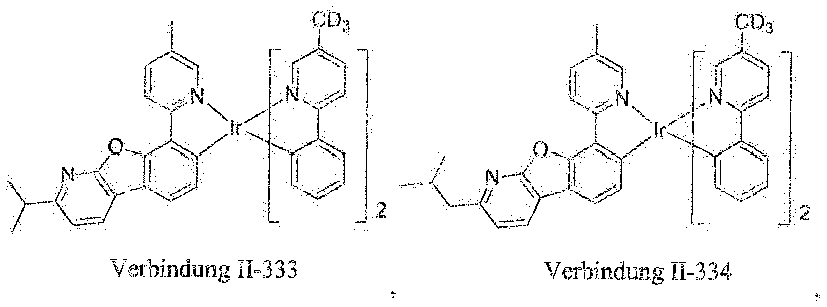 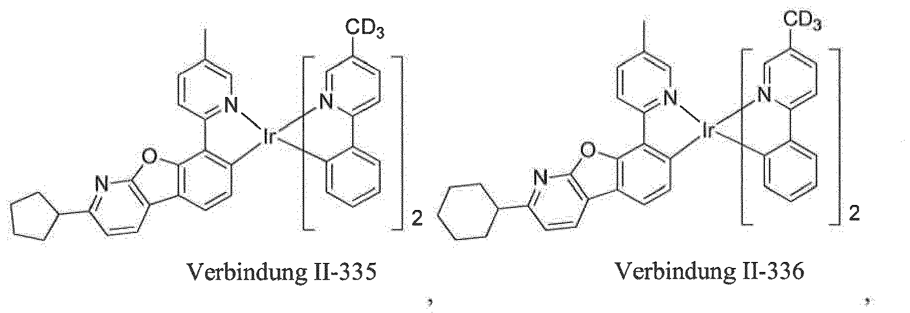 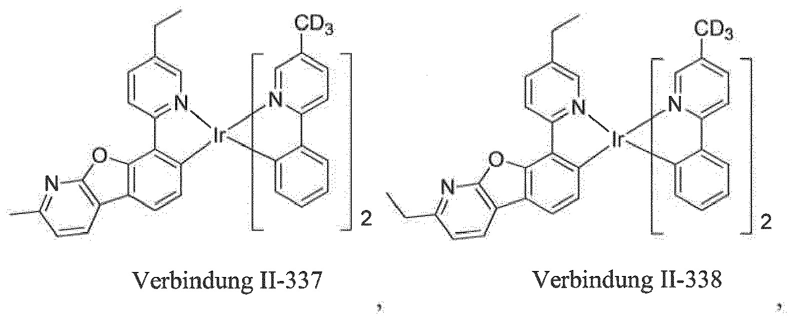 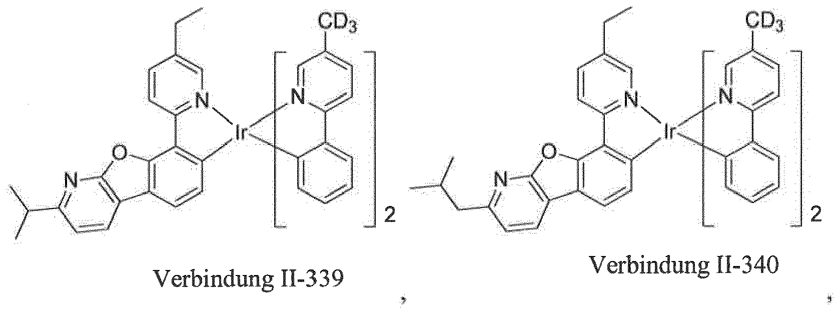 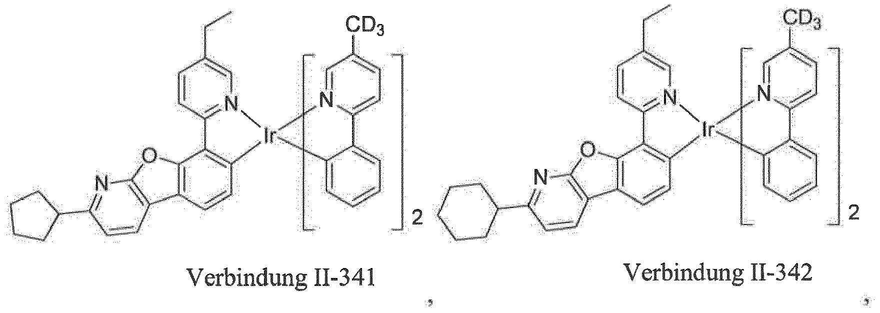 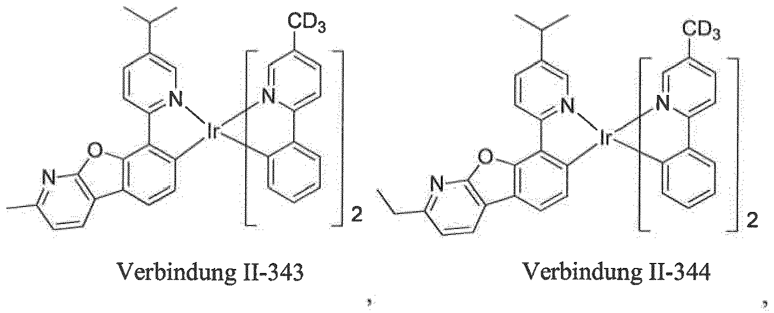 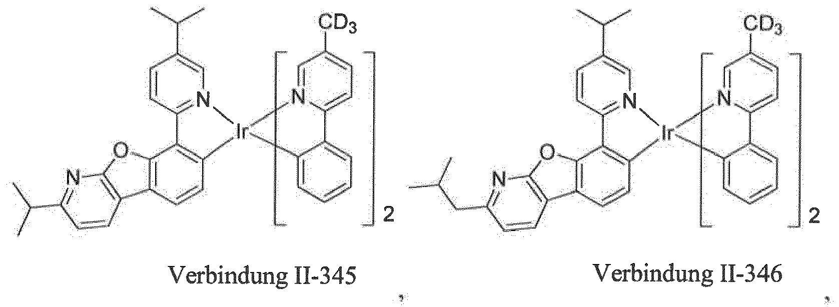 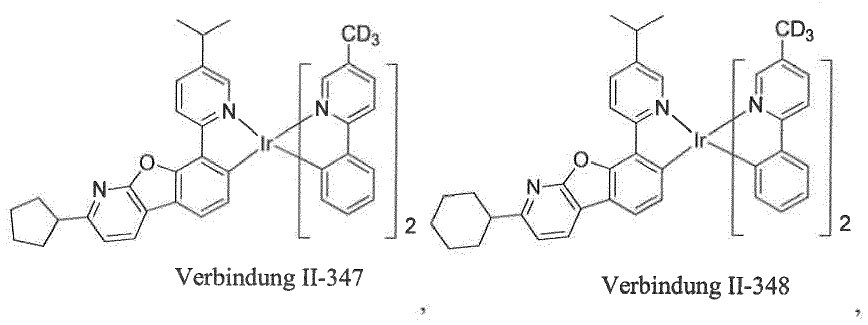 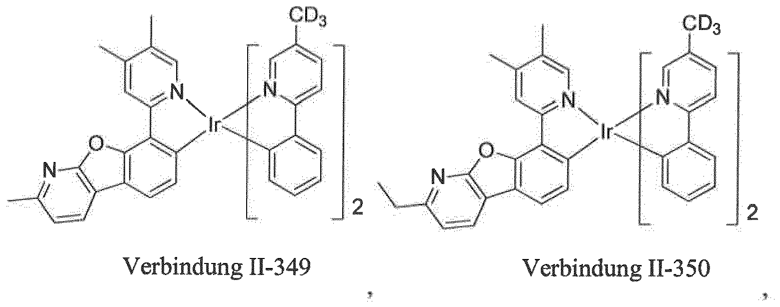 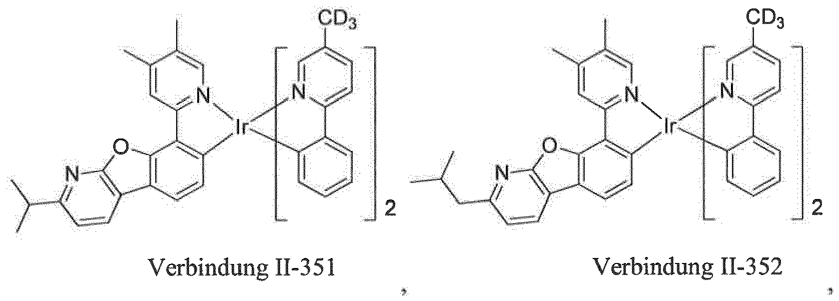 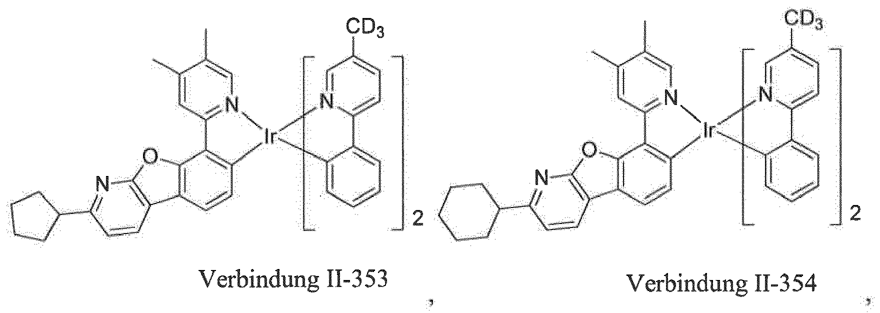 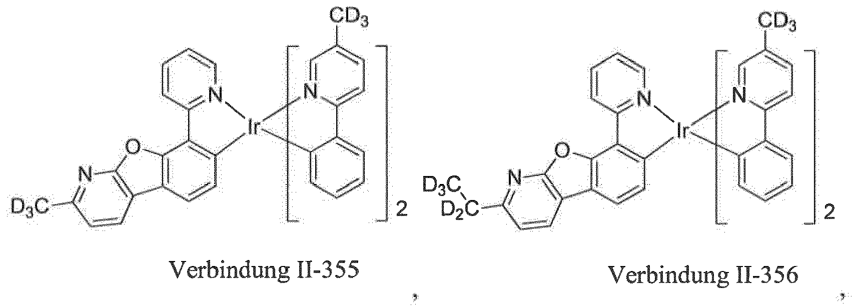 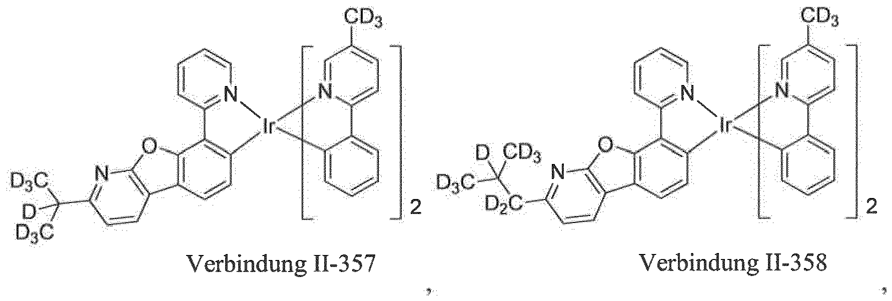 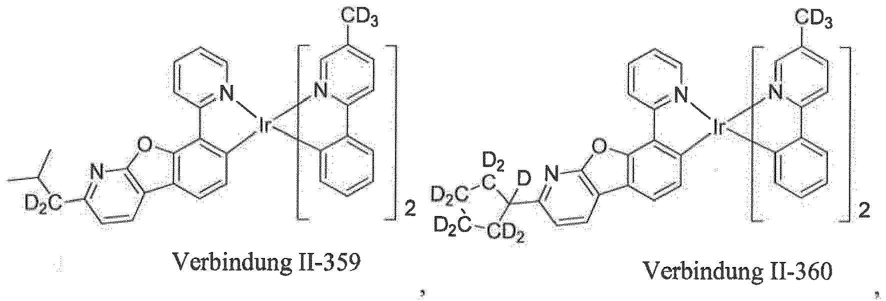 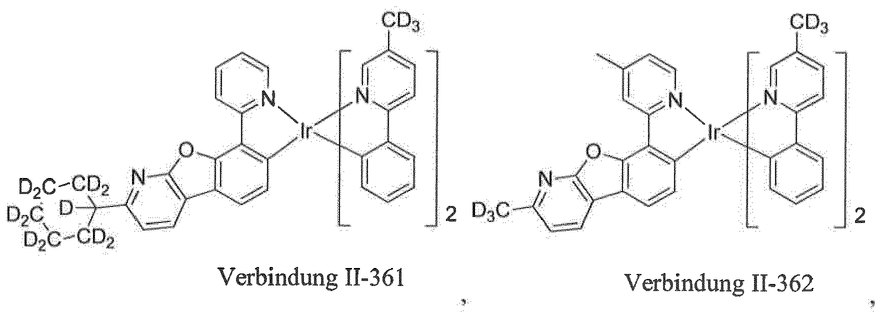 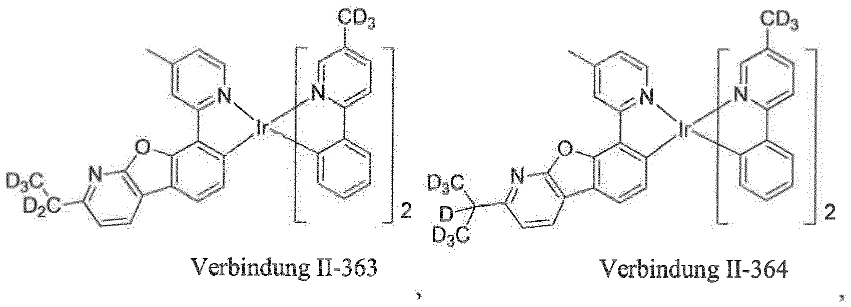 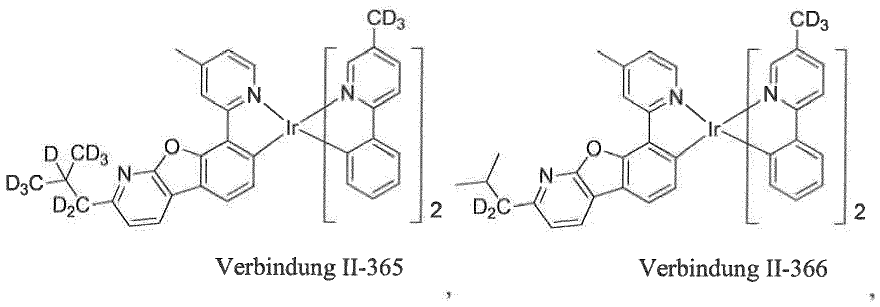 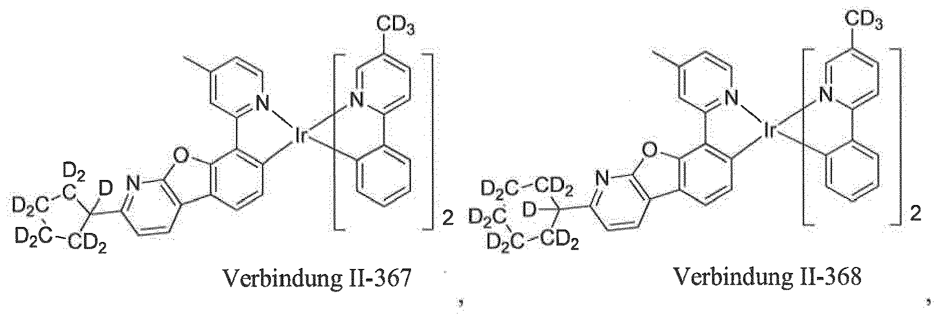 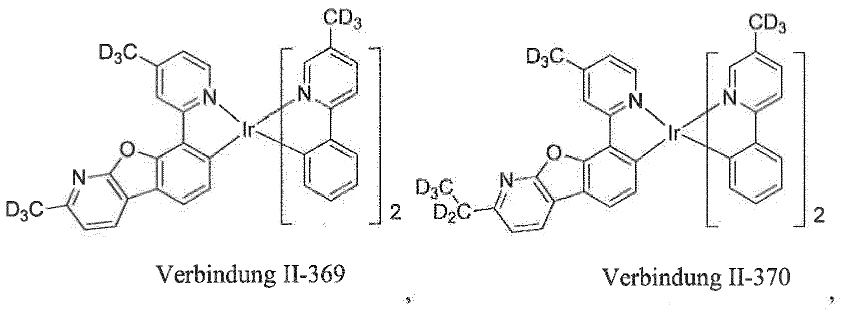 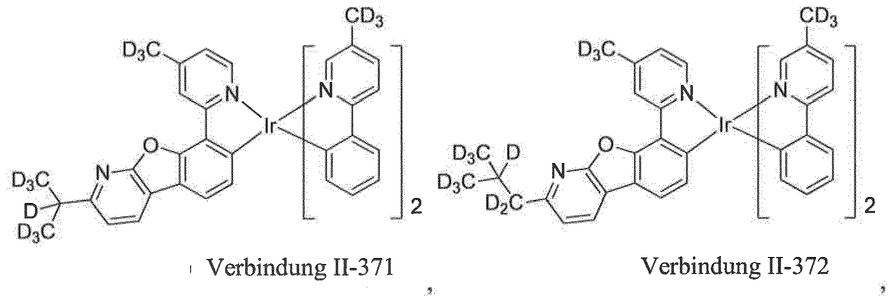 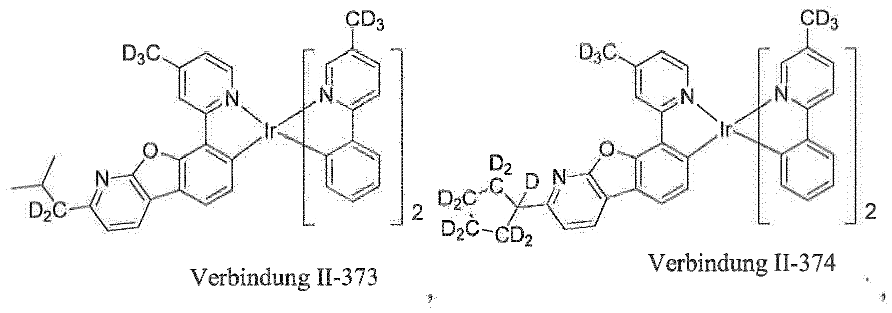 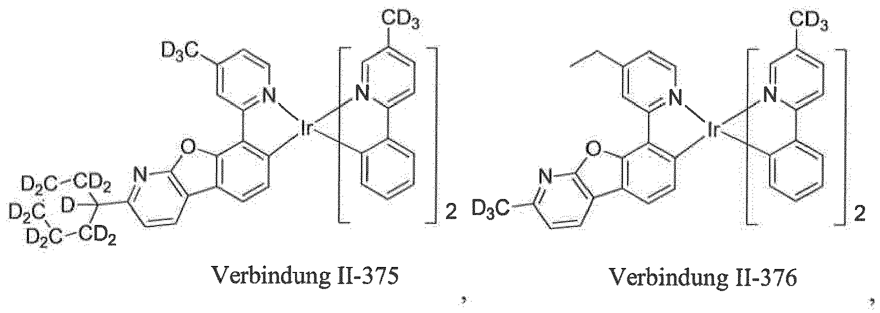 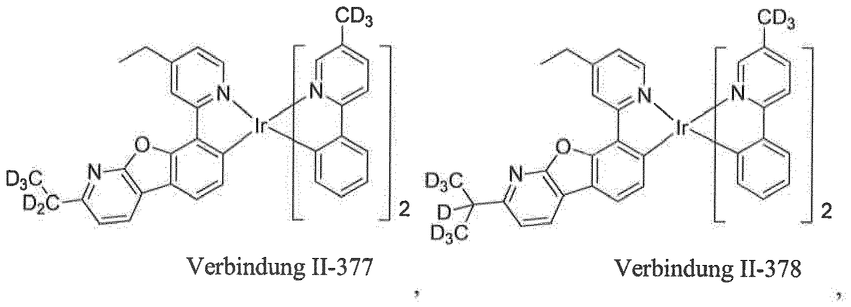 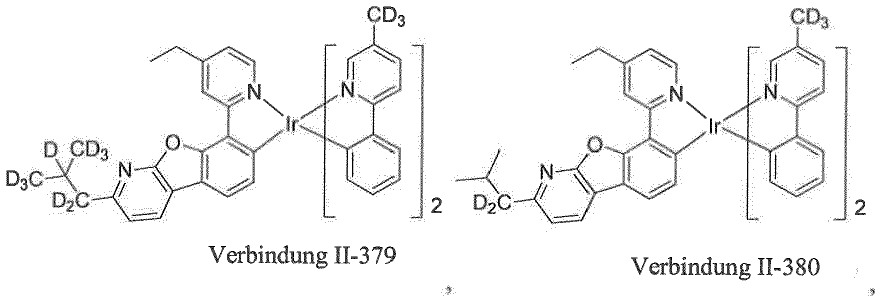 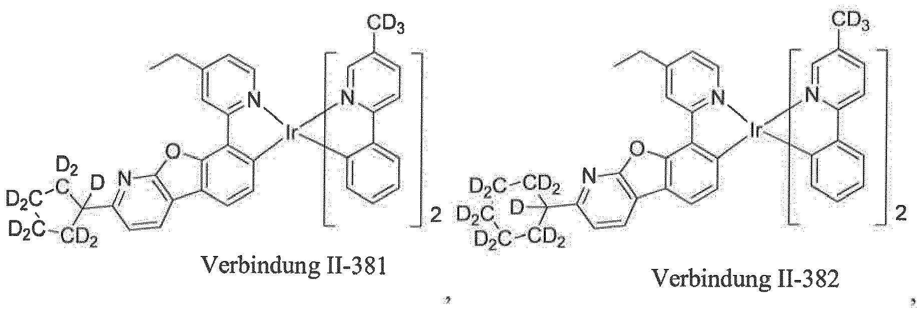 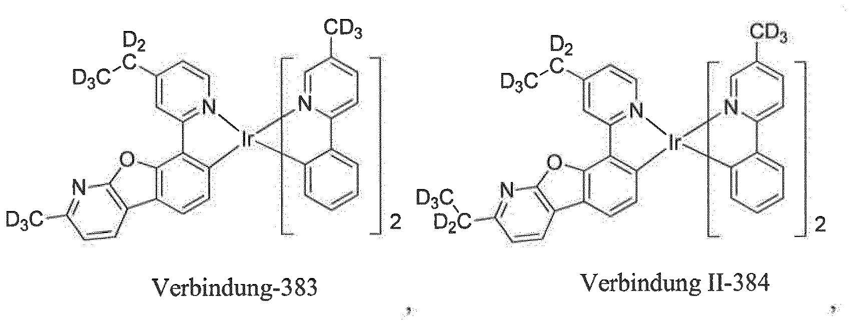 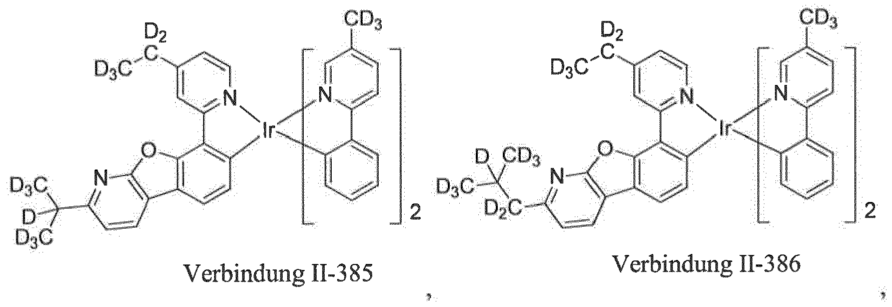 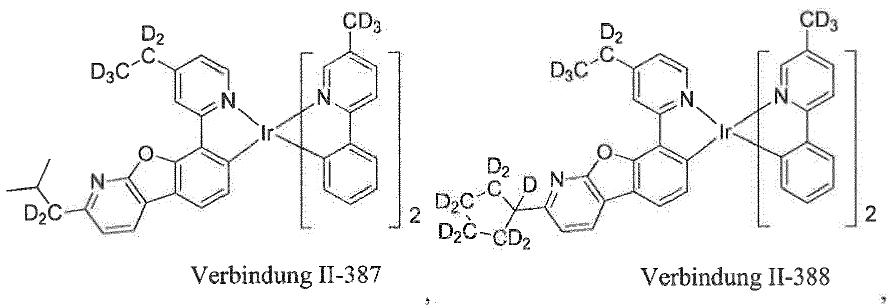 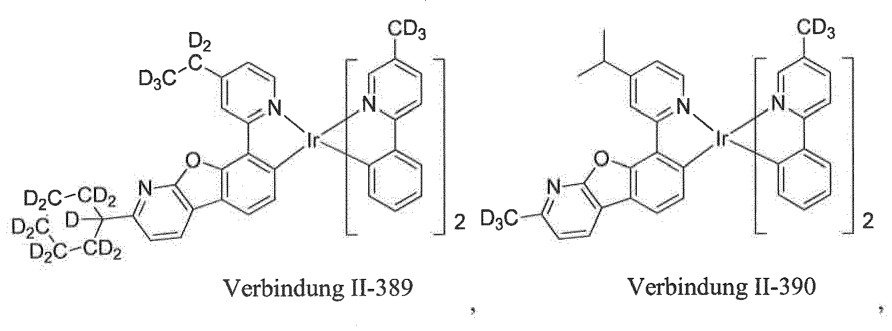 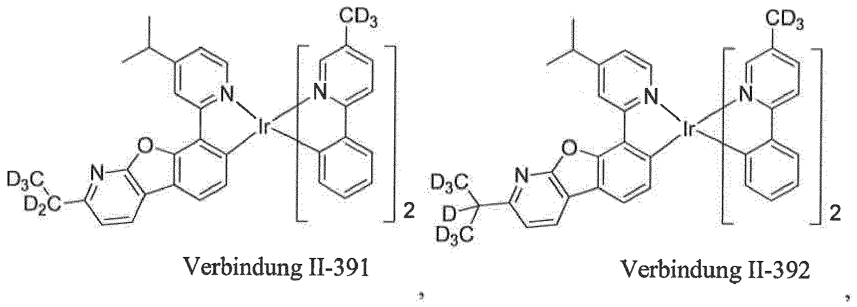 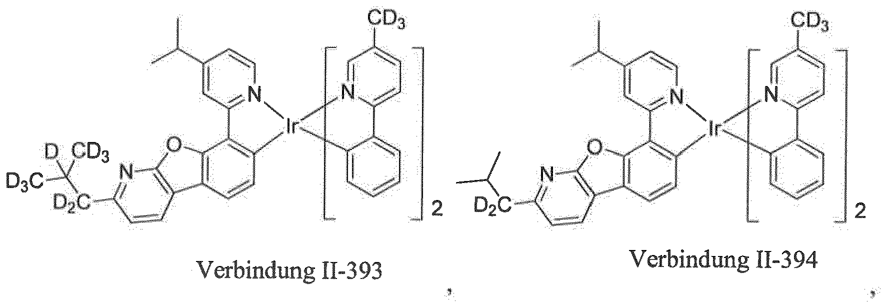 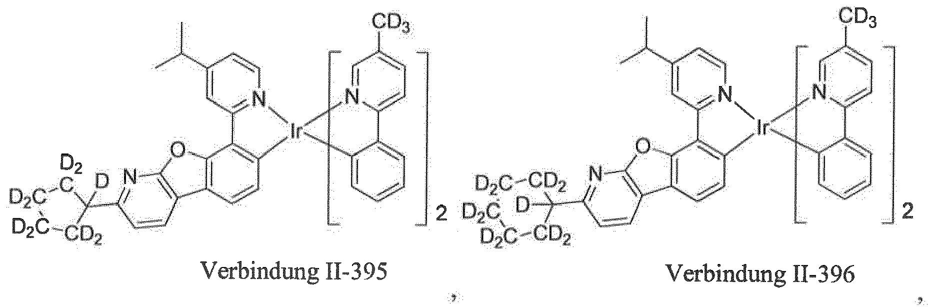 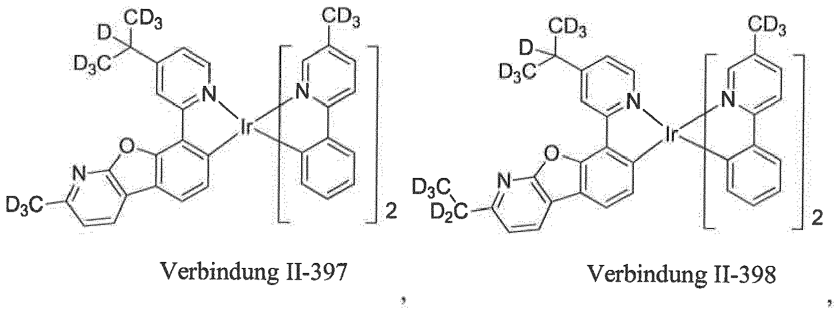 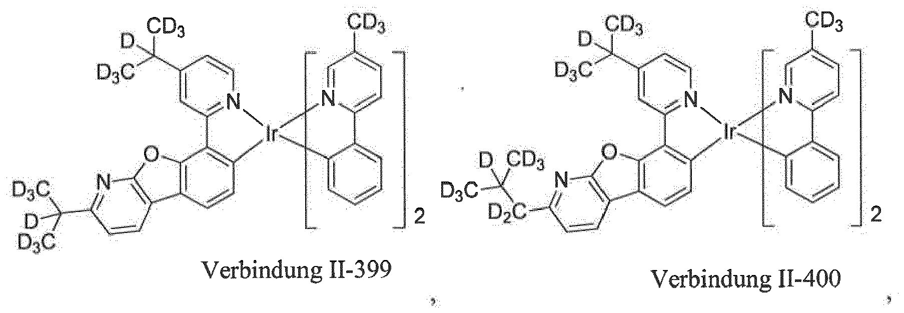 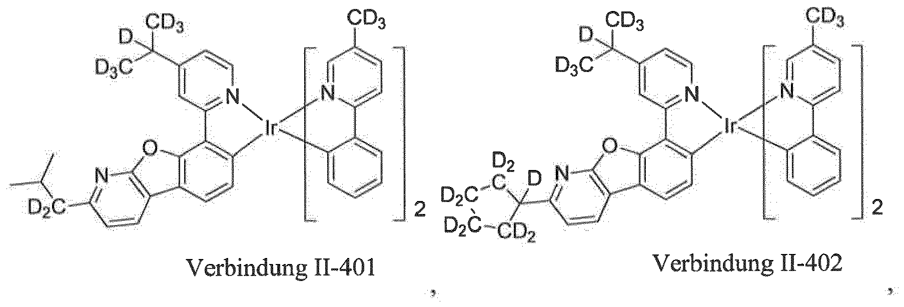 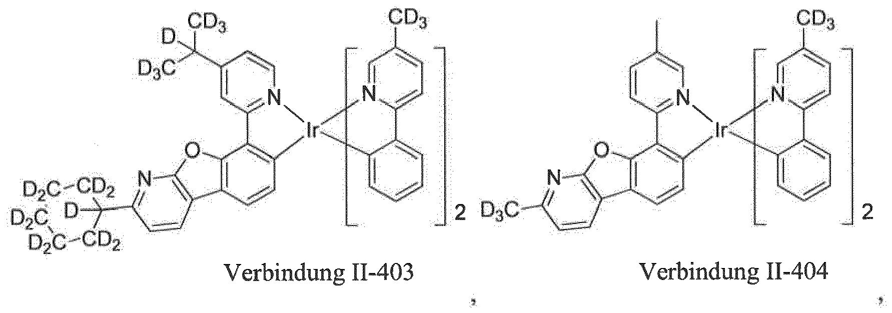 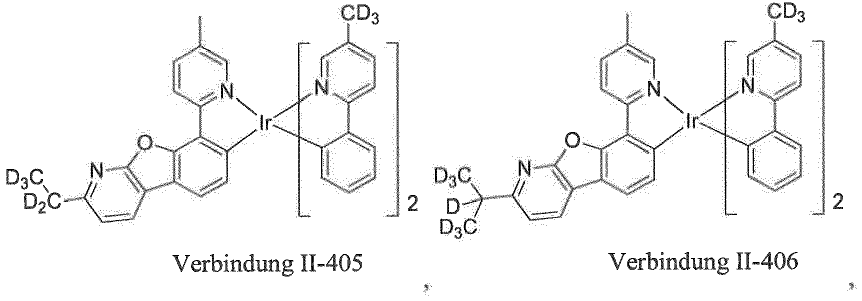 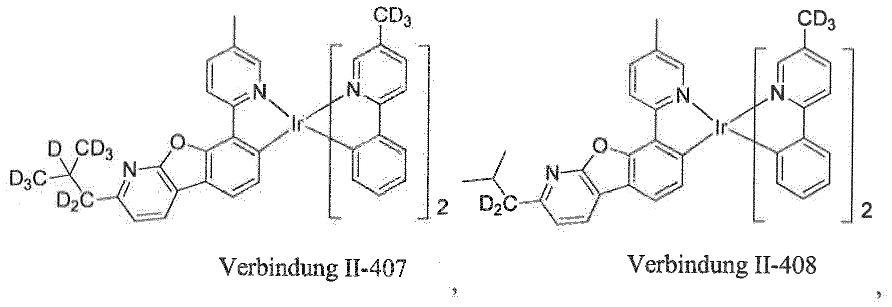 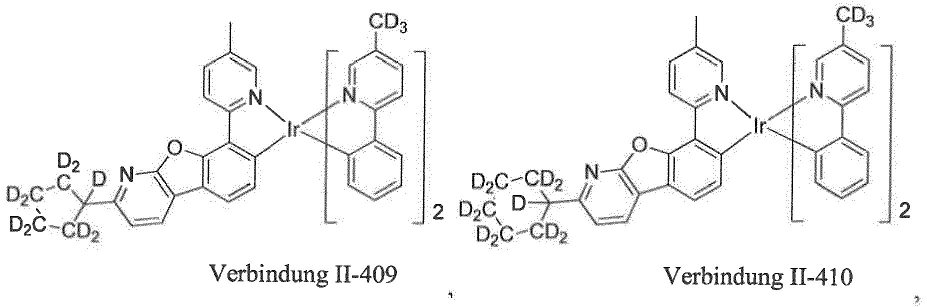 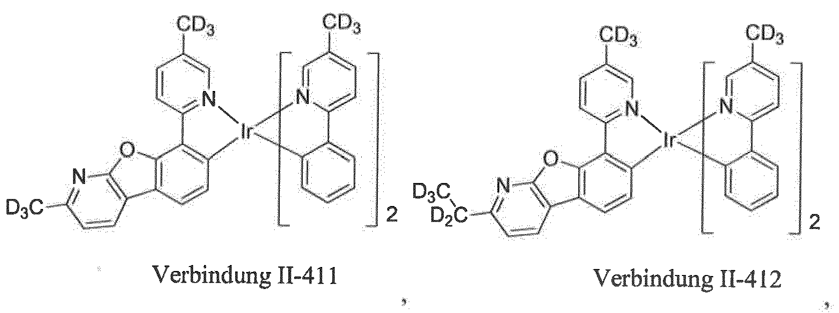 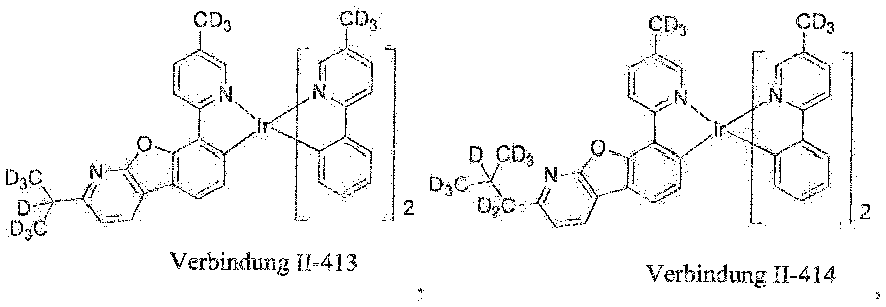 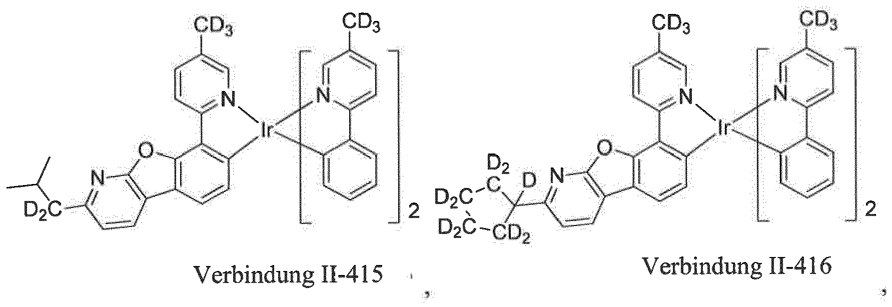 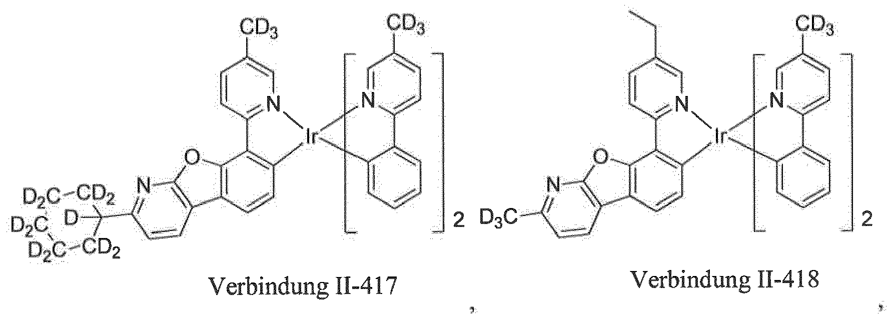 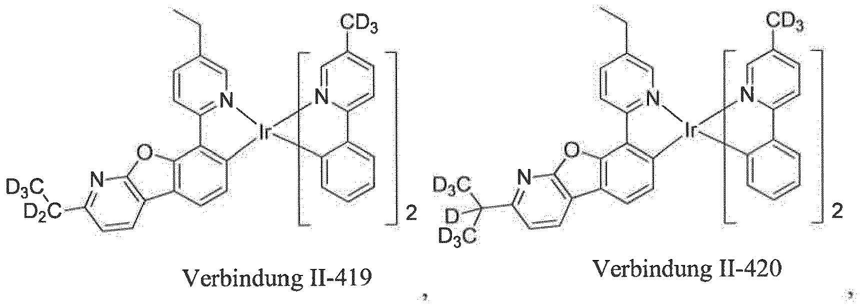 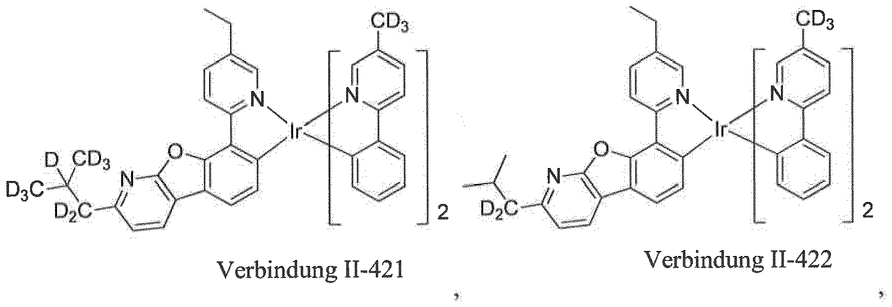 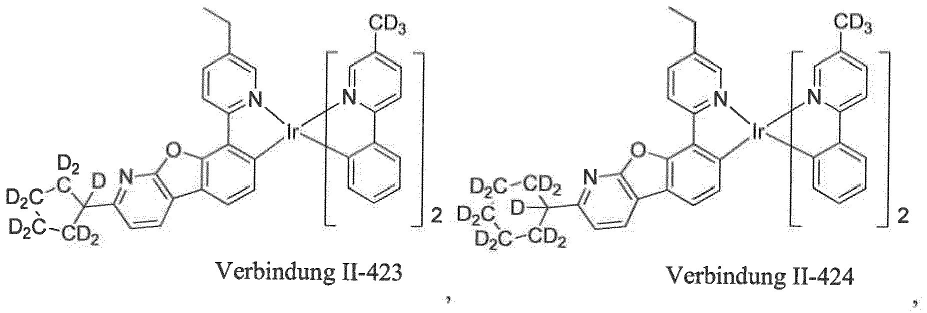 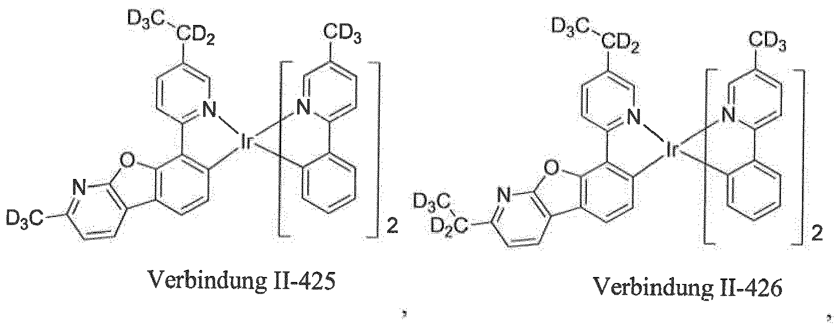 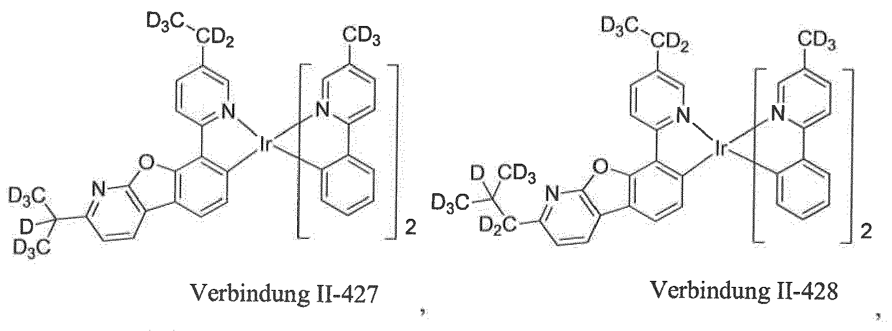 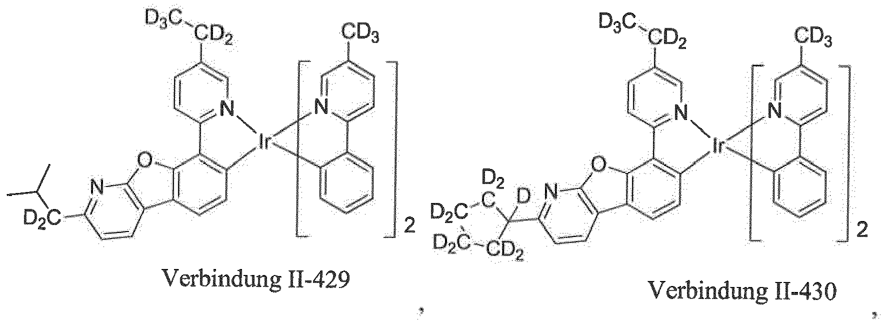 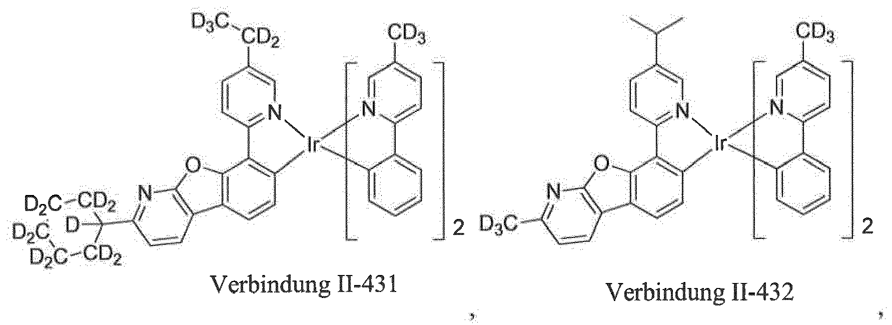 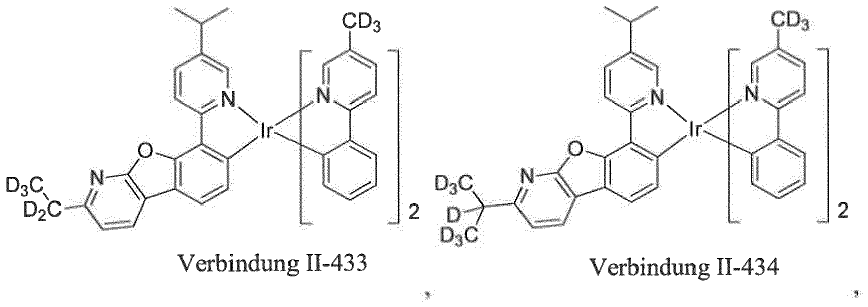 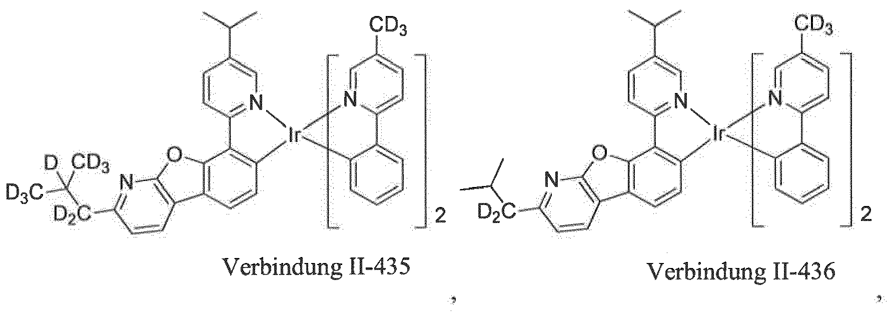 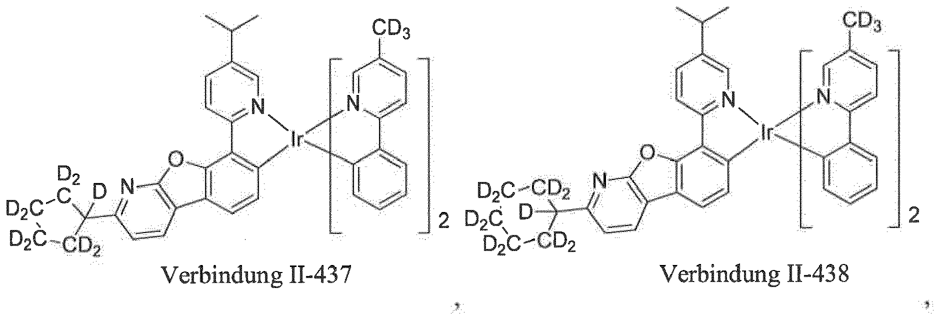 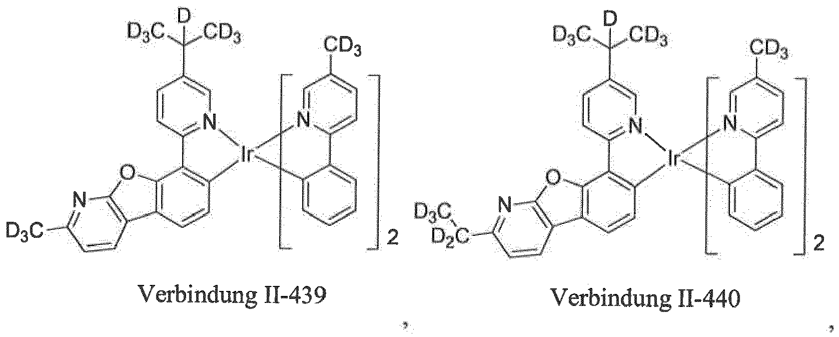 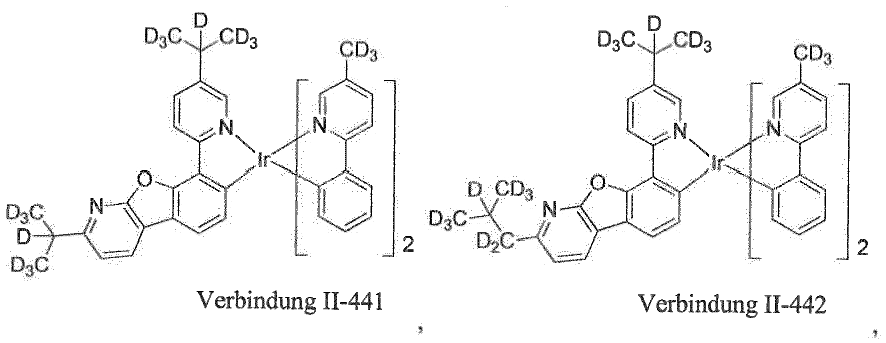 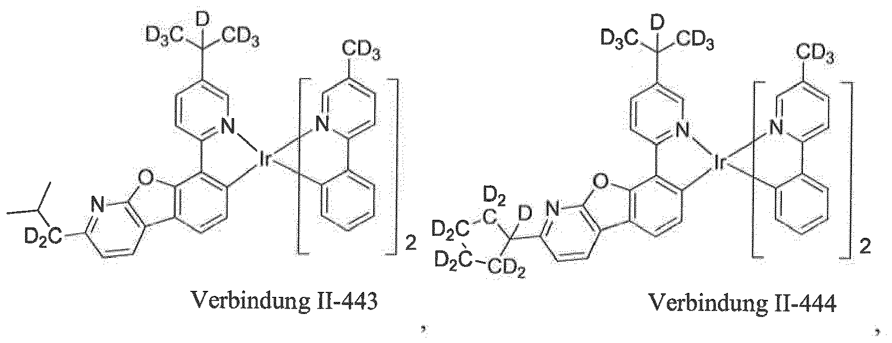 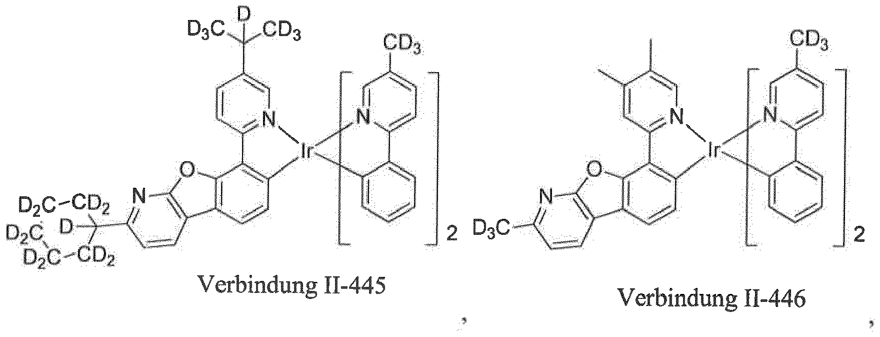 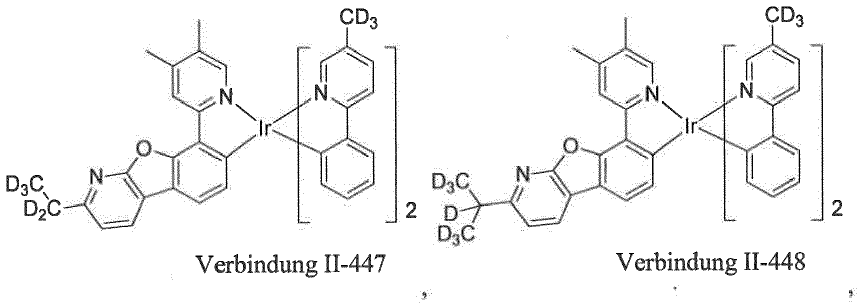 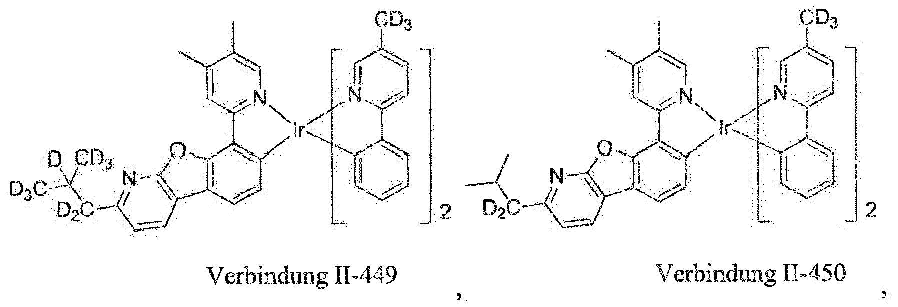 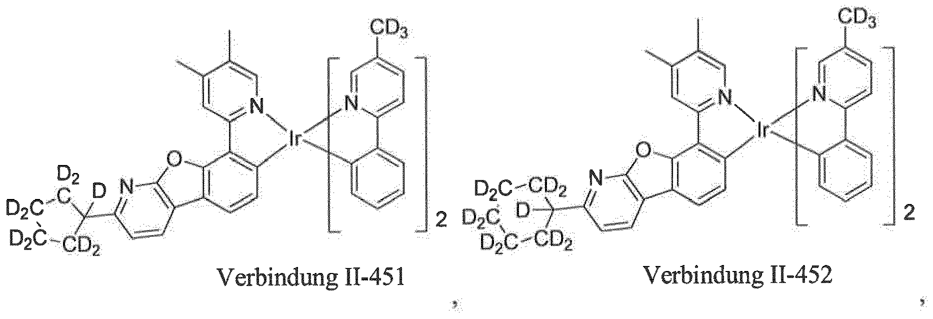 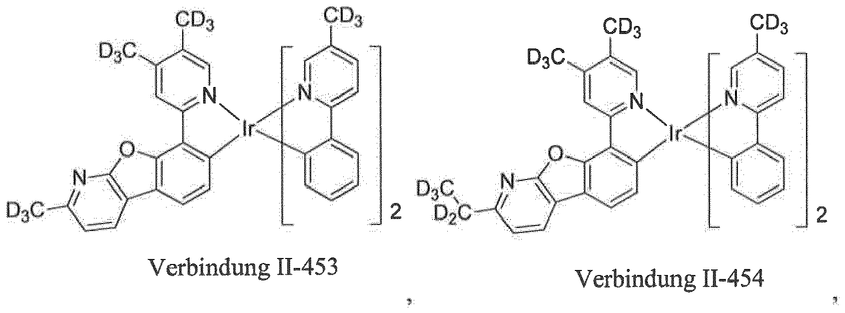 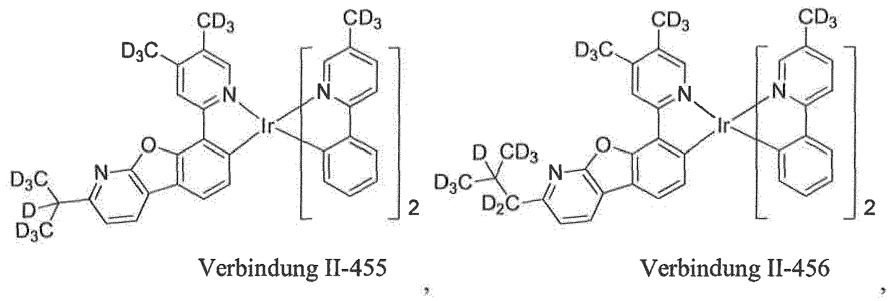 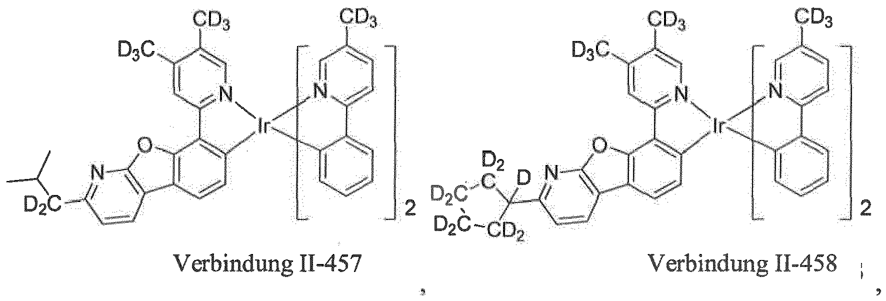 und

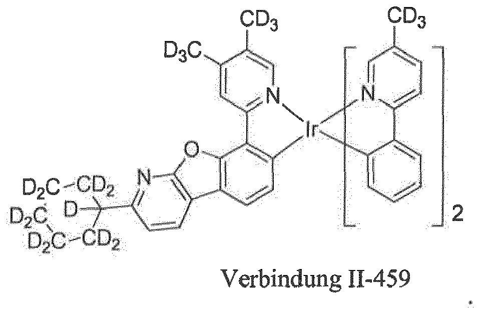

19. Verbindung nach Anspruch 8, wobei L_{A} ausgewählt ist aus der Gruppe bestehend aus:

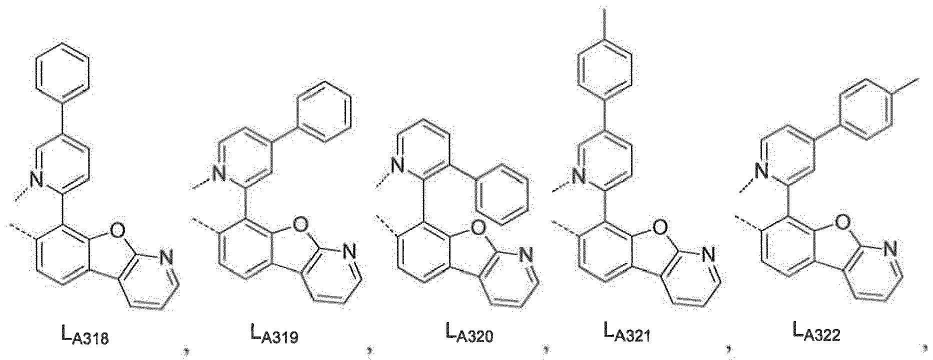

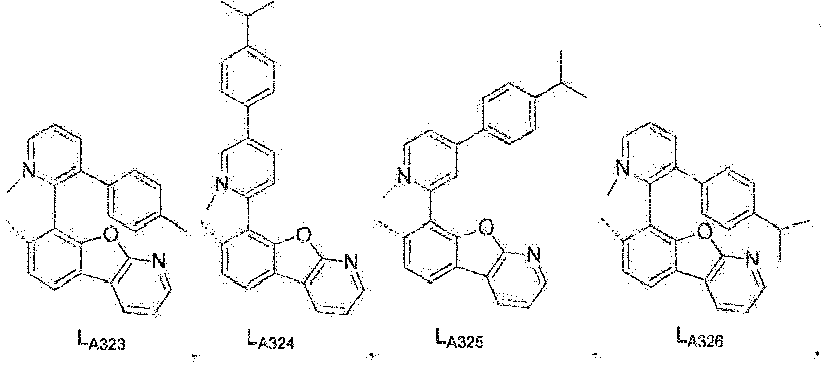

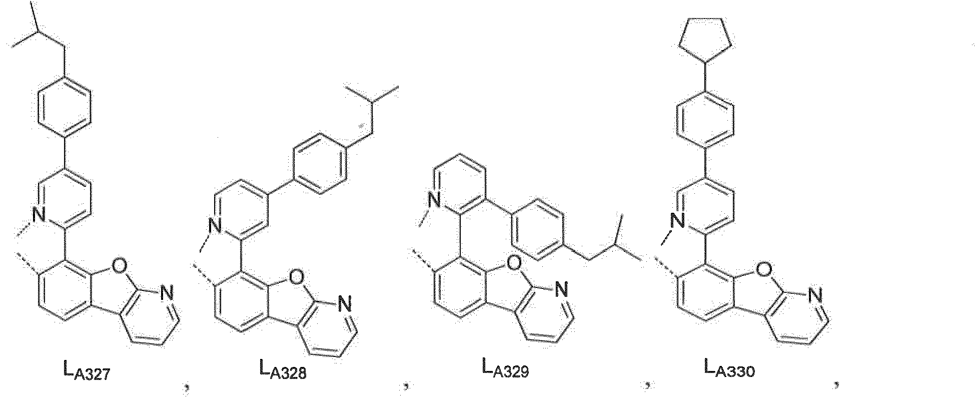

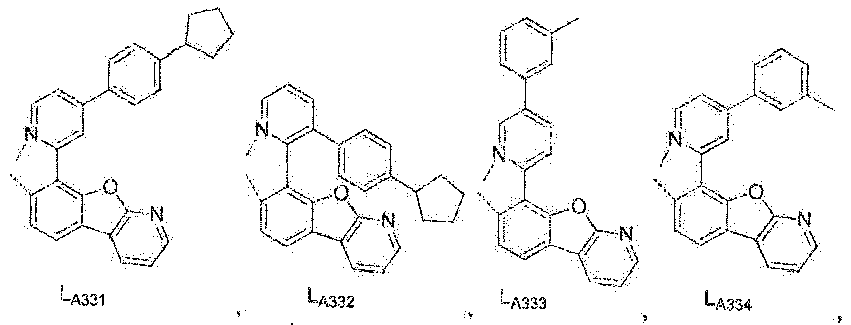

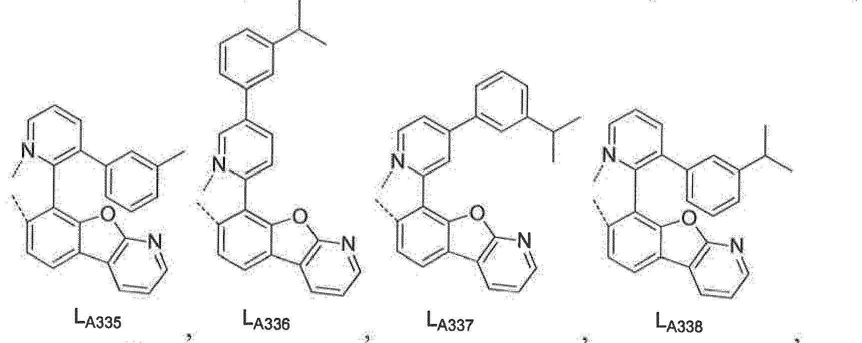

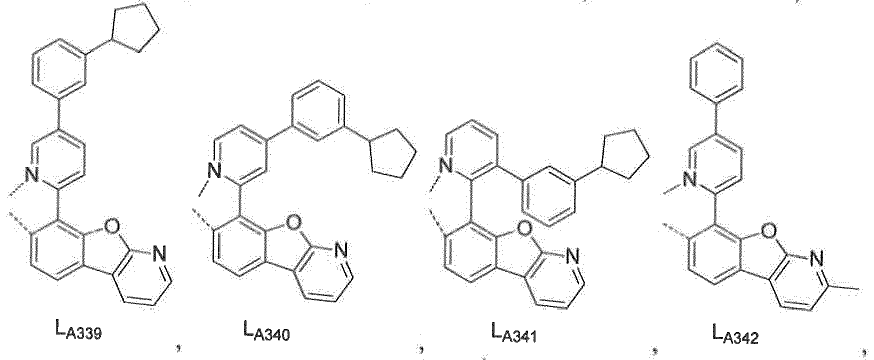

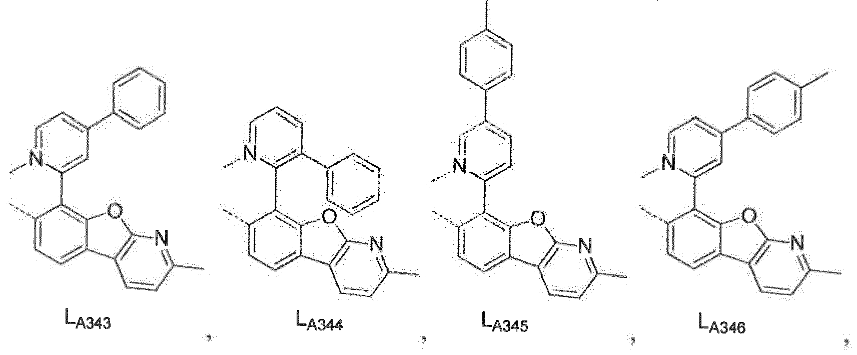

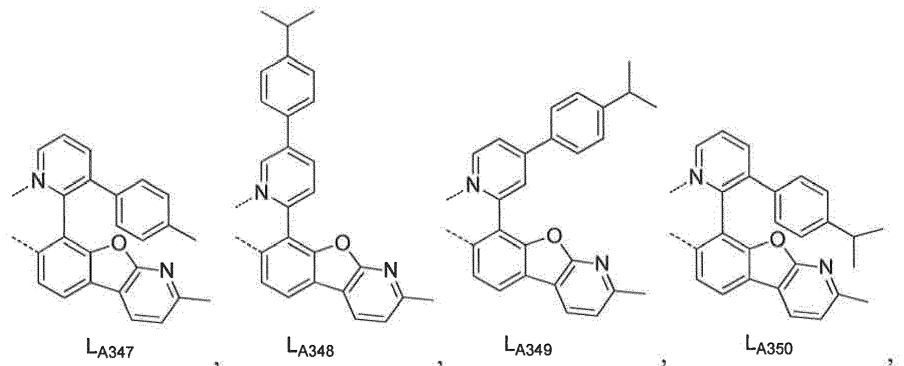

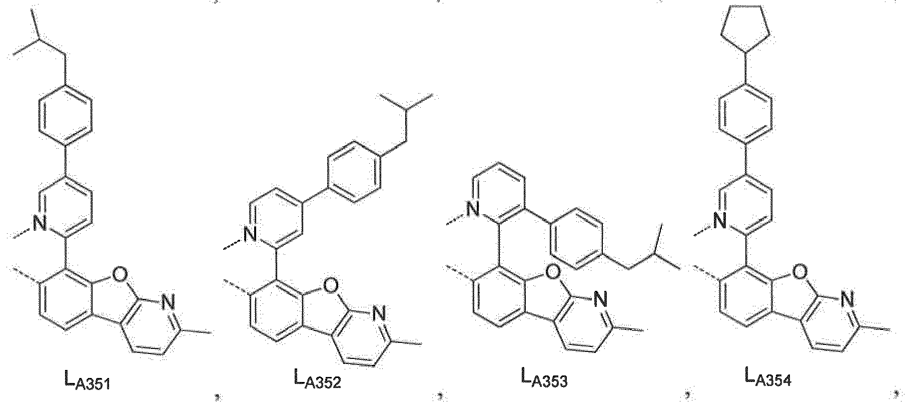

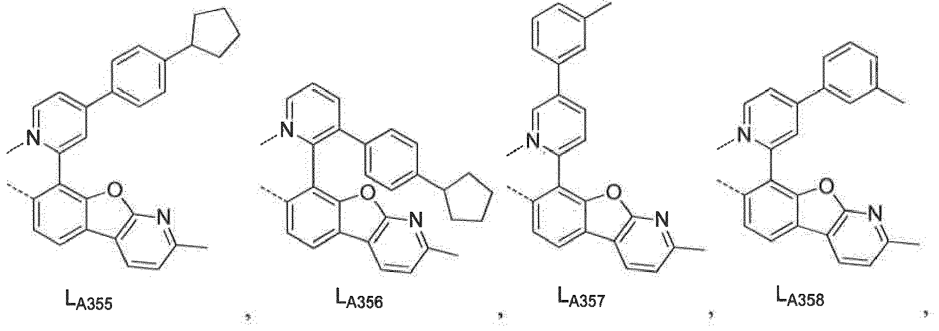

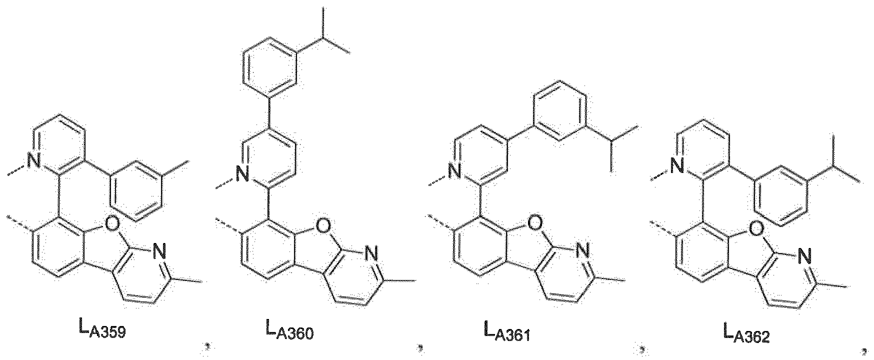

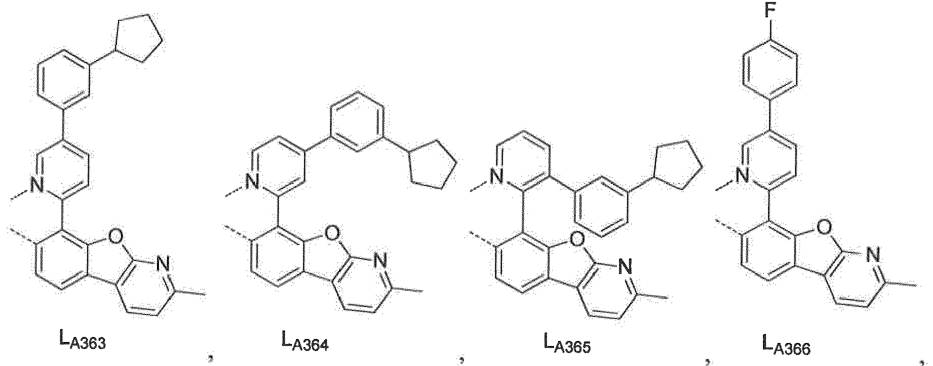

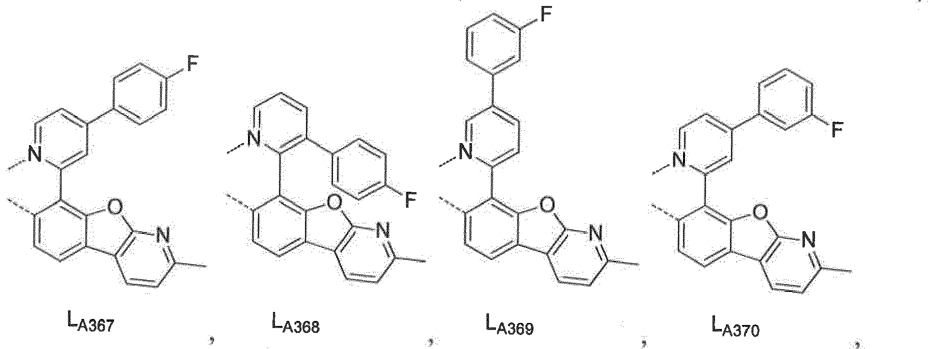

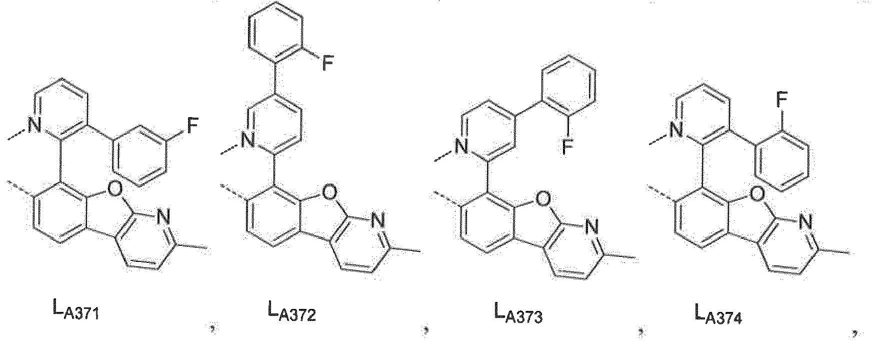

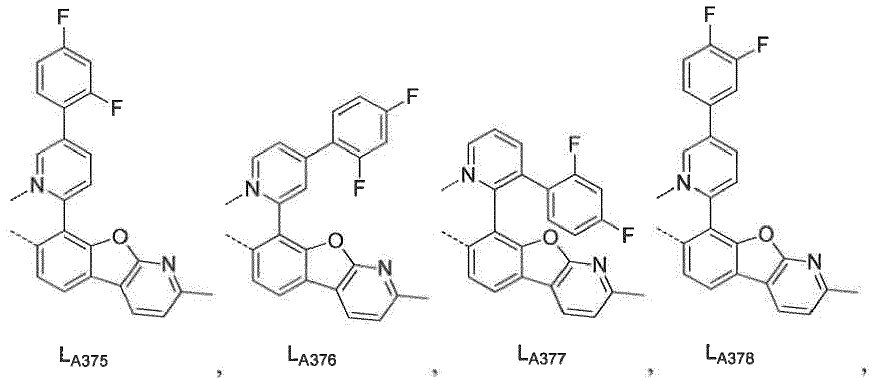

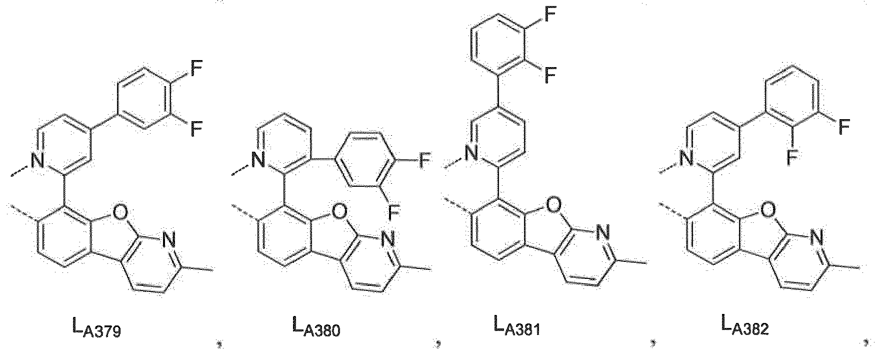

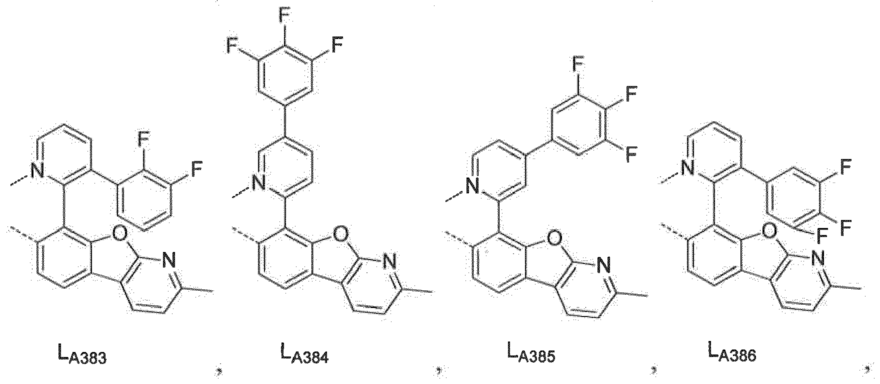

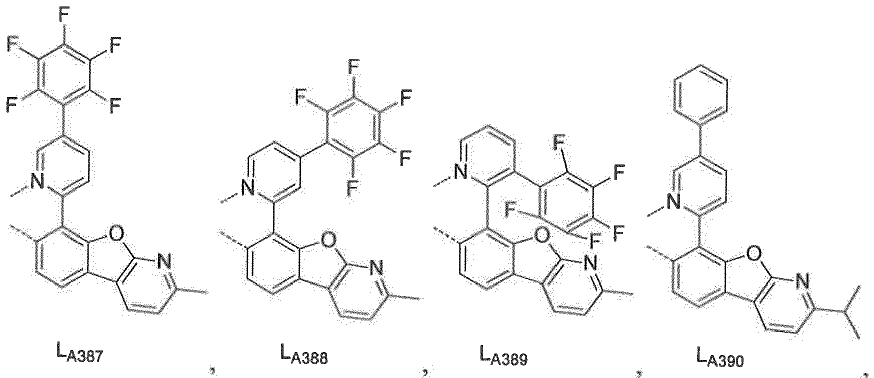

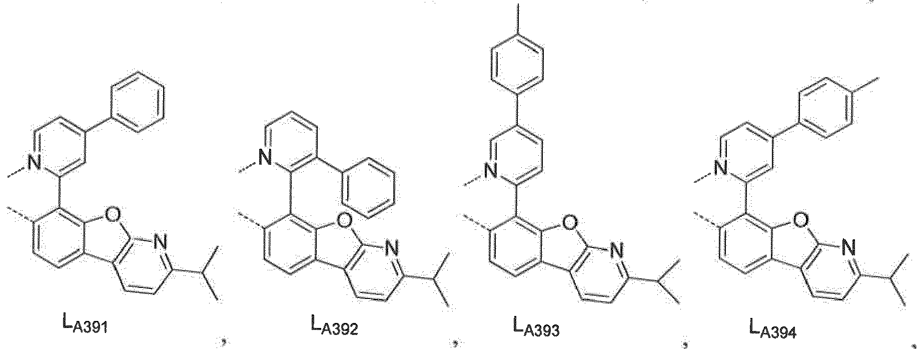

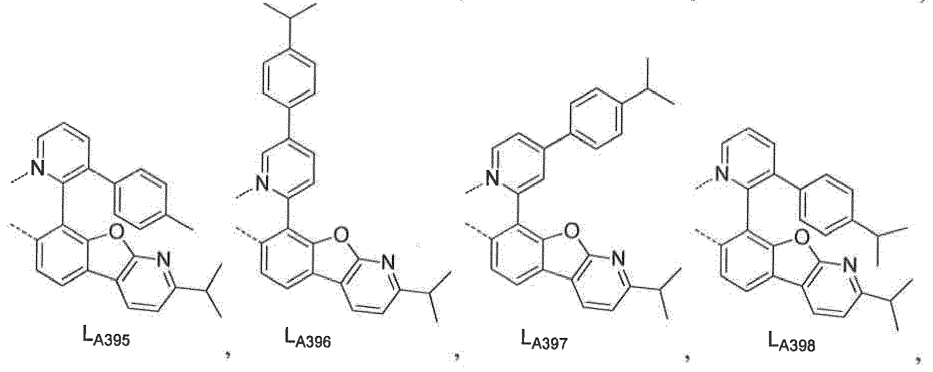

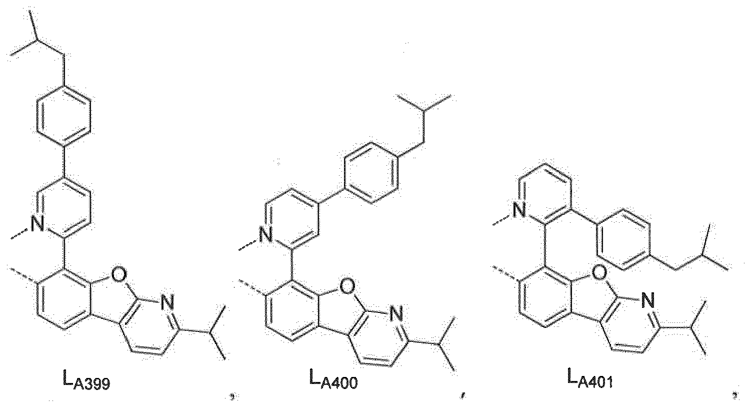

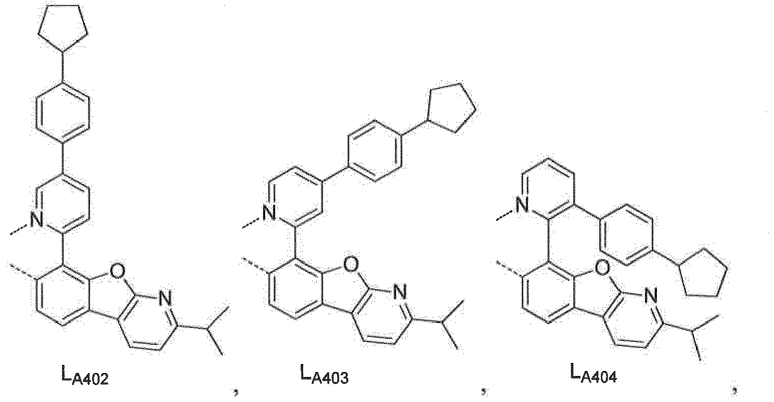

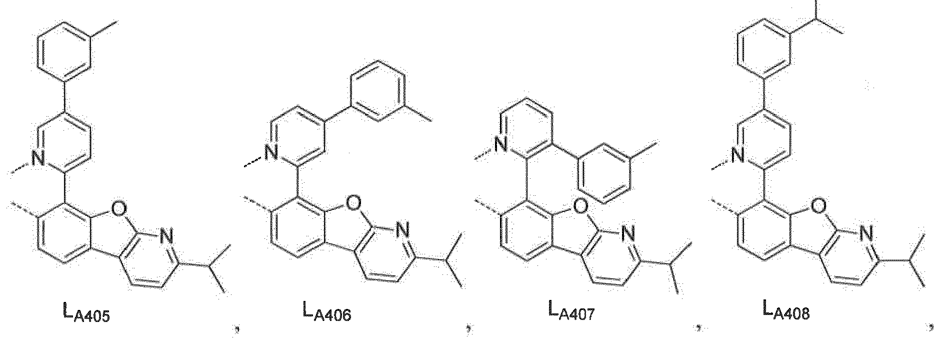

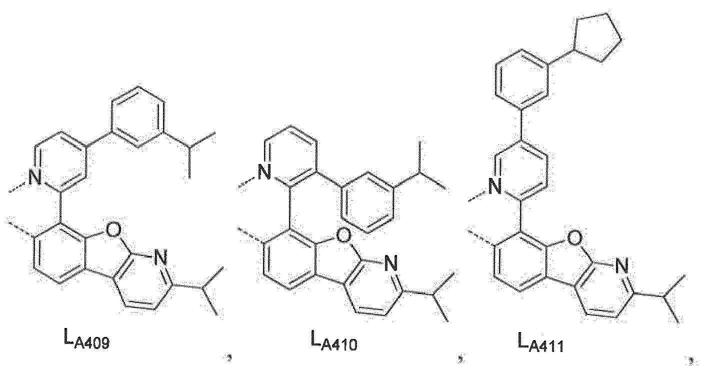

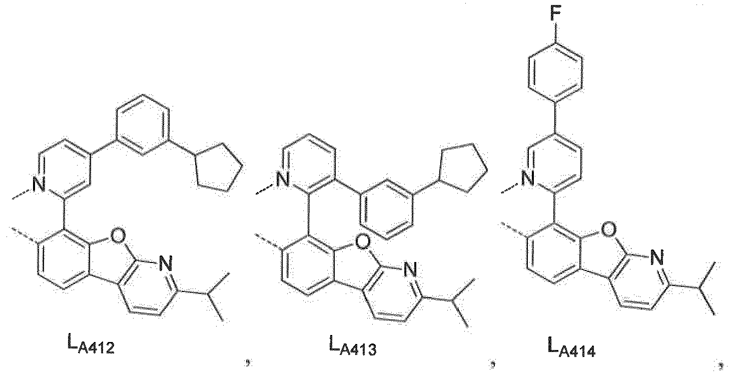

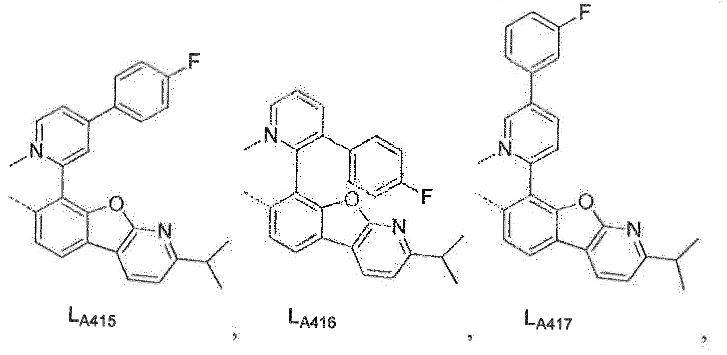

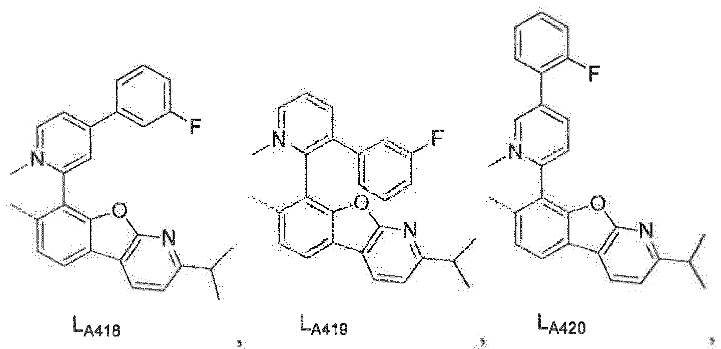

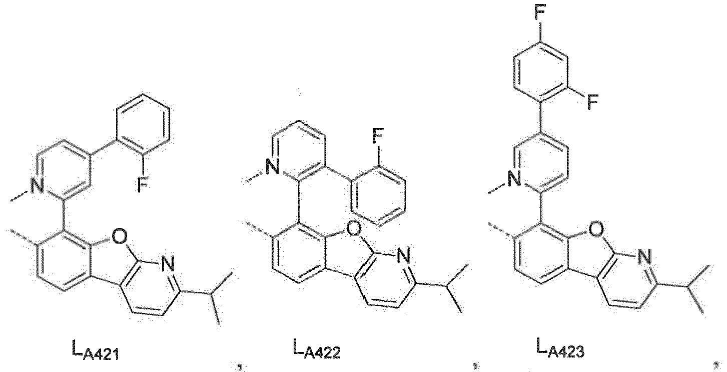

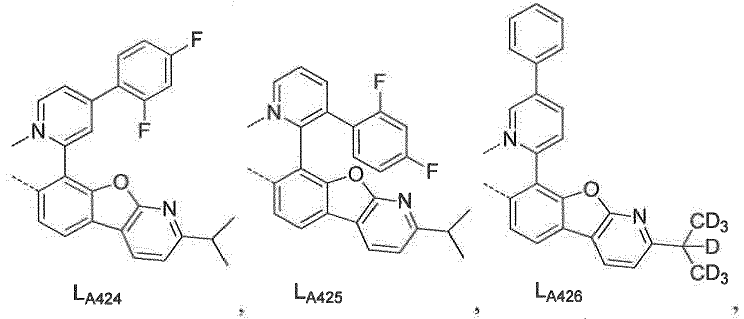

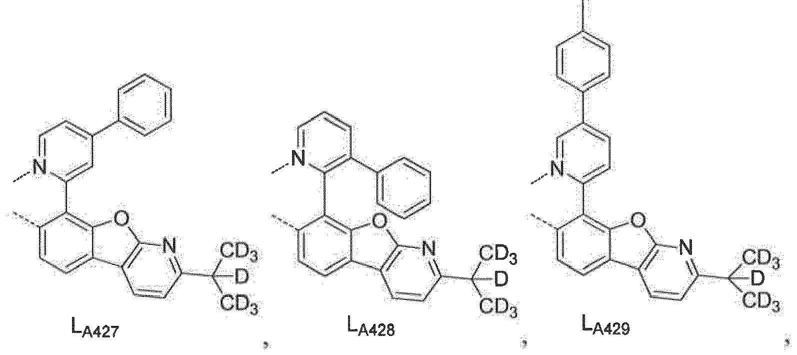

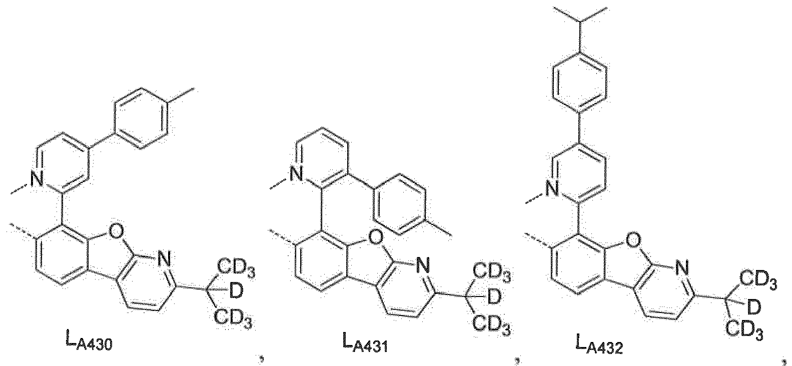

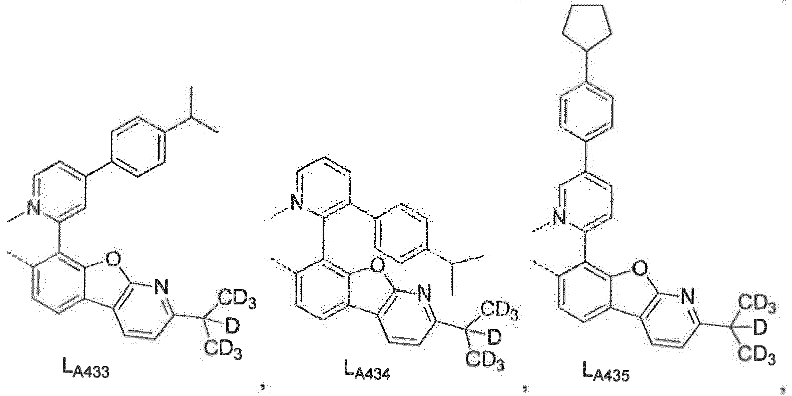

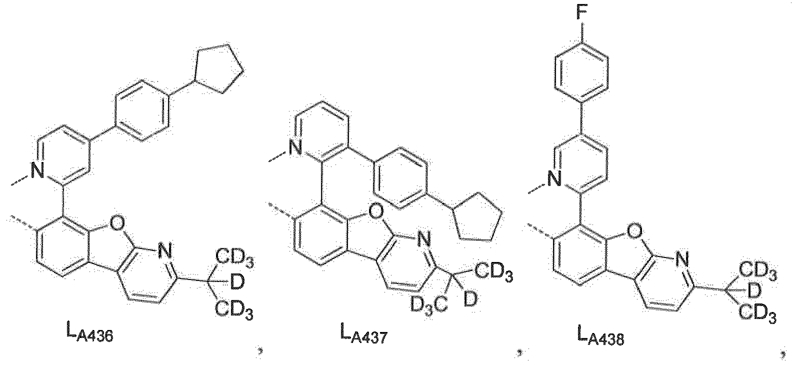

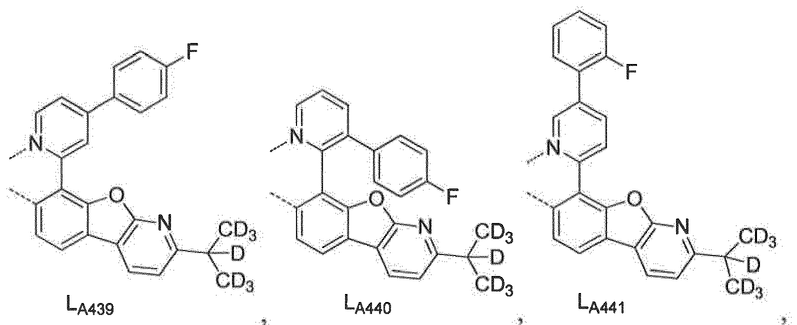

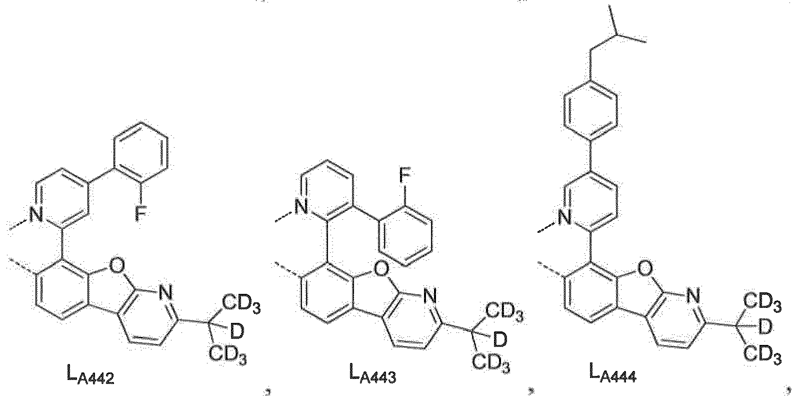

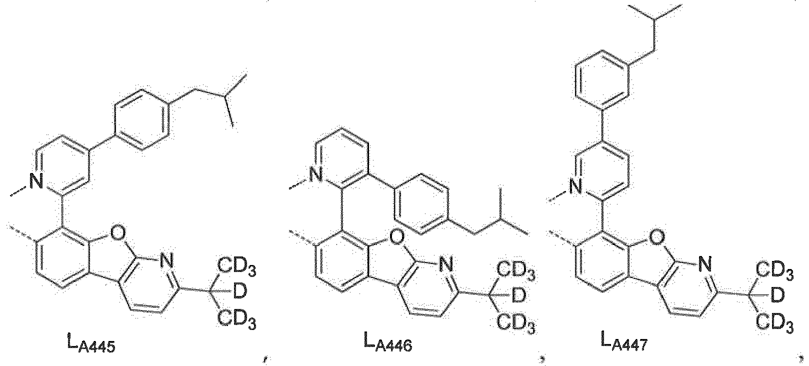

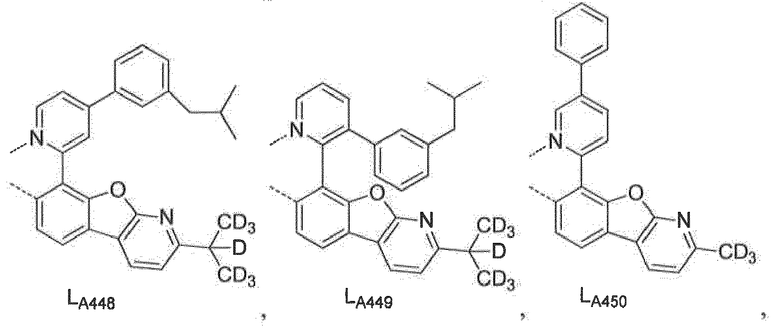

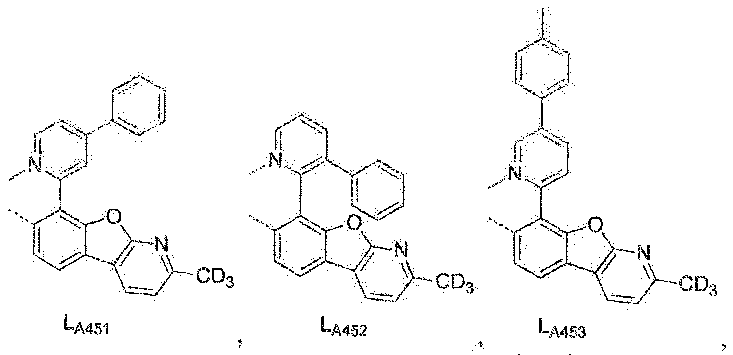

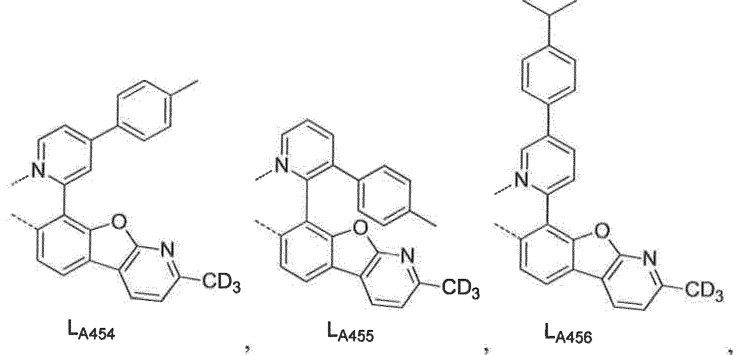

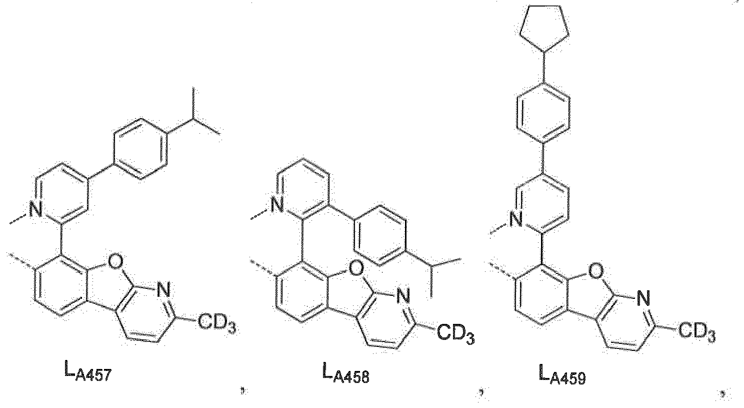

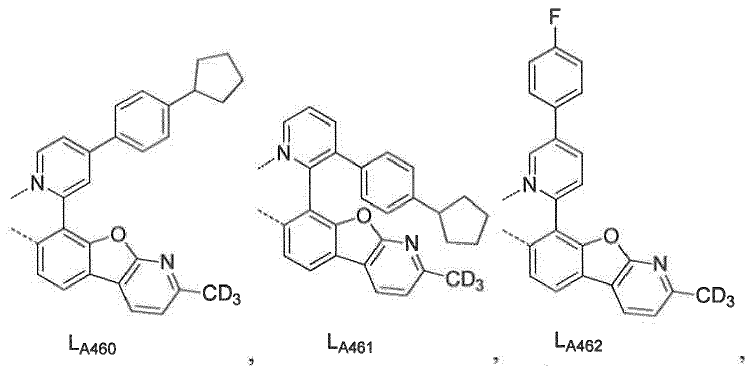

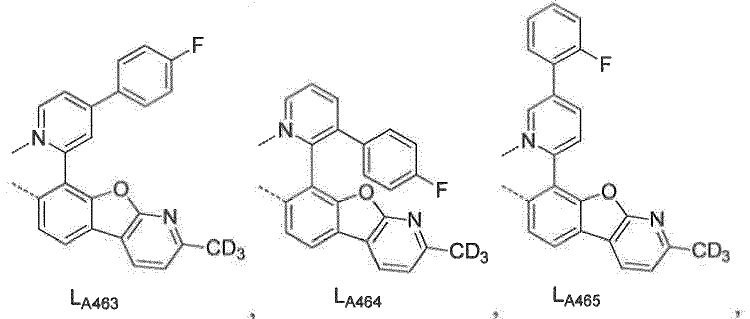

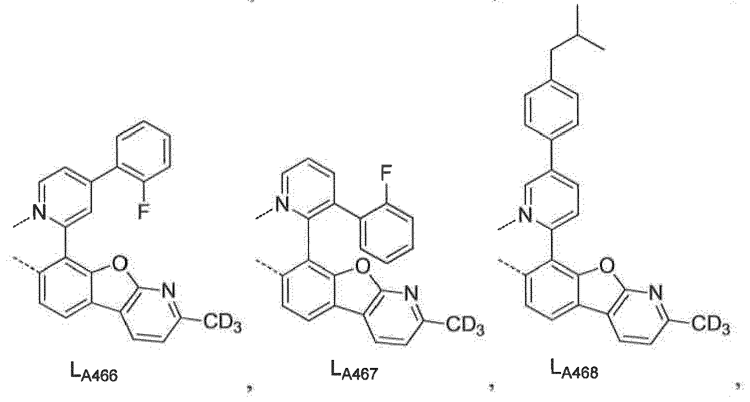

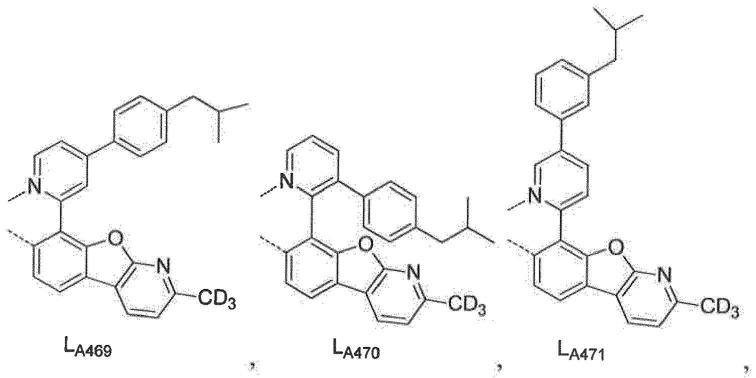

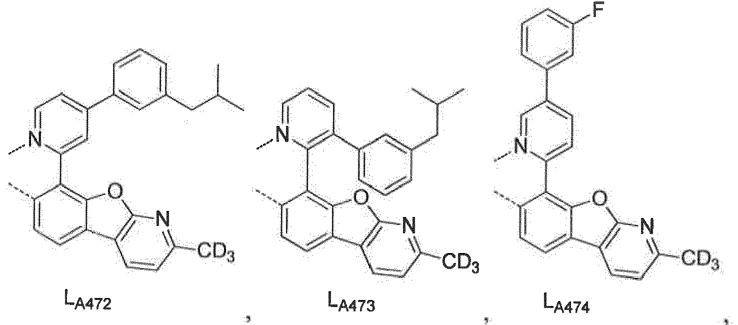

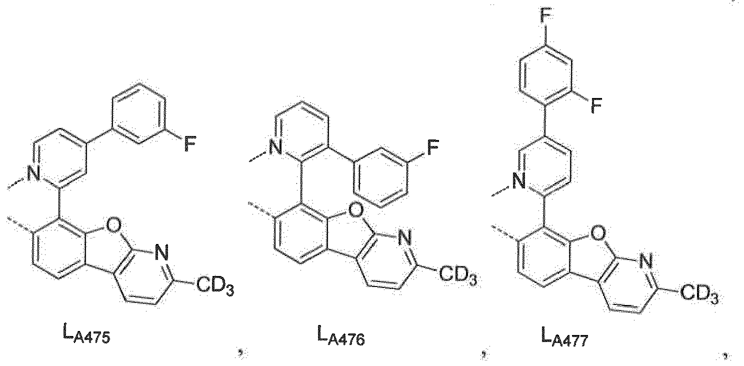

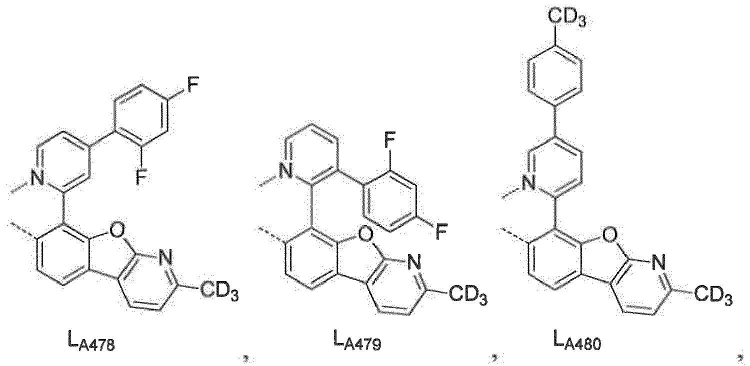

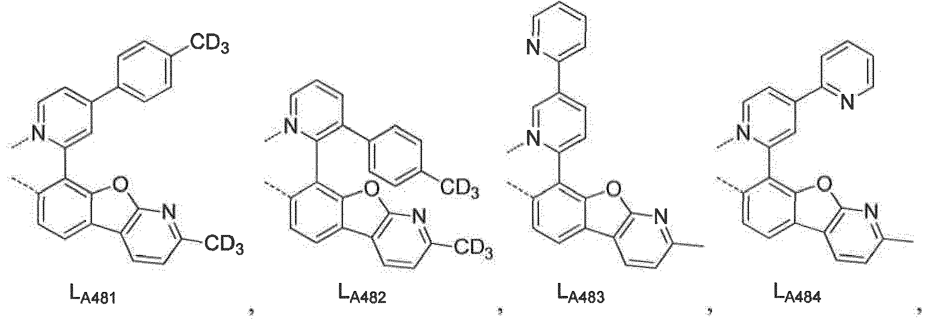

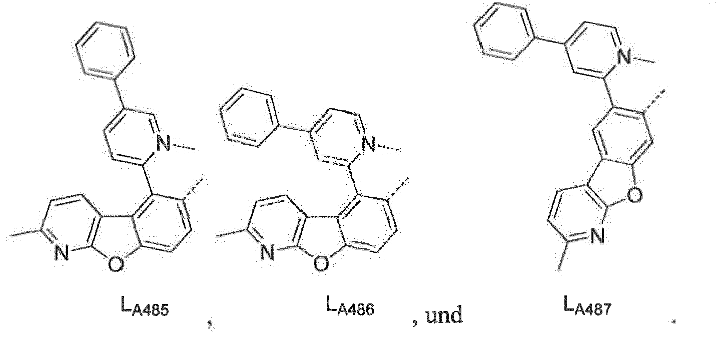

20. Verbindung nach Anspruch 19, wobei L_{B} ausgewählt ist aus der Gruppe bestehend aus:

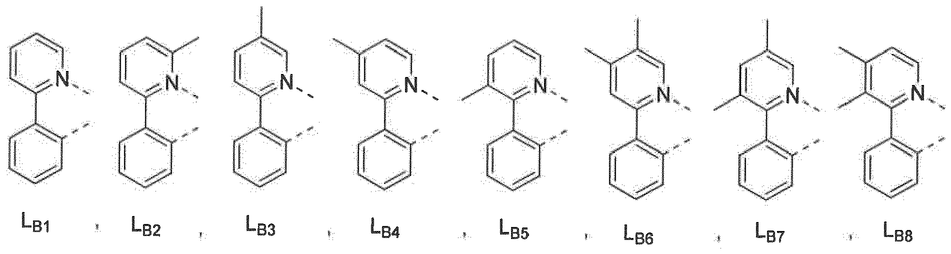

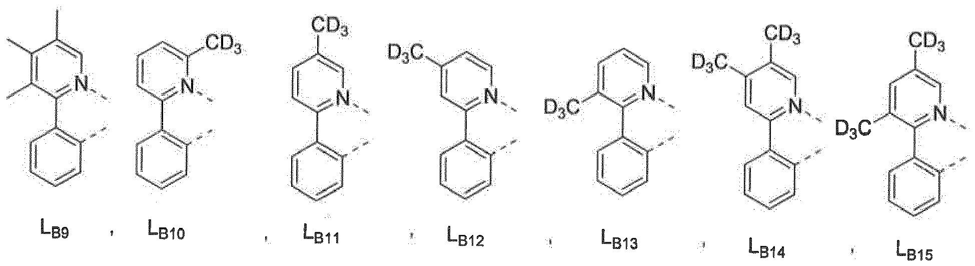

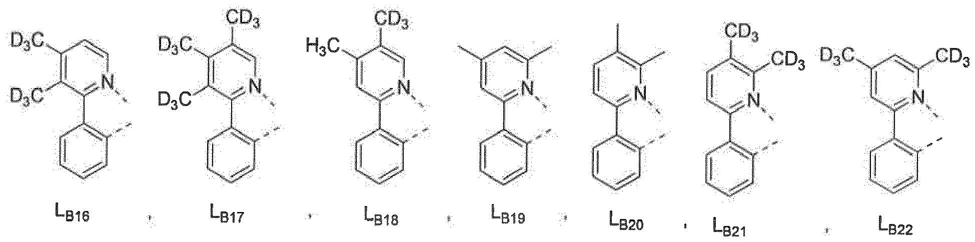

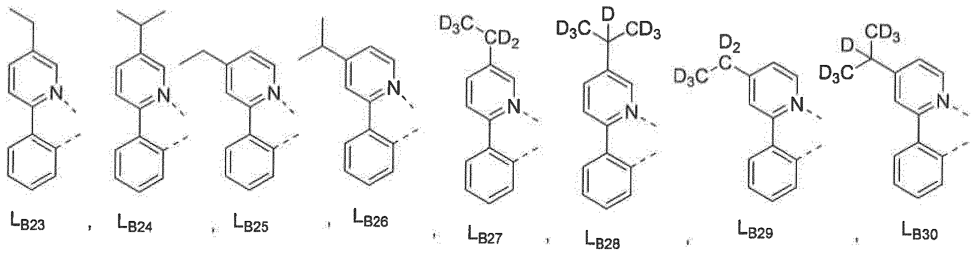

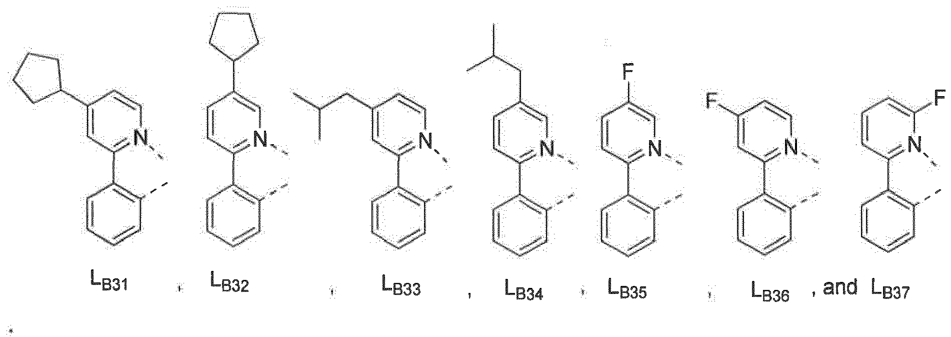

21. Verbindung nach Anspruch 20, wobei die Verbindung ausgewählt ist aus der Gruppe bestehend aus:
Ir(L_{A318})(L_{B1})₂ (Verbindung III-1), Ir(L_{A319})(L_{B1})₂ (Verbindung III-2), Ir(L_{A320})(L_{B1})₂ (Verbindung III-3), Ir(L_{A322})(L_{B1})₂ (Verbindung III-5), Ir(L_{A325})(L_{B1})₂ (Verbindung III-8), Ir(L_{A328})(L_{B1})₂ (Verbindung III-11), Ir(L_{A331})(L_{B1})₂ (Verbindung III-14), Ir(L_{A342})(L_{B1})₂ (Verbindung 111-25), Ir(L_{A343})(L_{B1})₂ (Verbindung 111-26), Ir(L_{A344})(L_{B1})₂ (Verbindung III-27), Ir(L_{A346})(L_{B1})₂ (Verbindung 111-29), Ir(L_{A349})(L_{B1})₂ (Verbindung 111-32), Ir(L_{A351})(L_{B1})₂ (Verbindung 111-34), Ir(L_{A352})(L_{B1})₂ (Verbindung 111-35), Ir(L_{A354})(L_{B1})₂ (Verbindung 111-37), Ir(L_{A355})(L_{B1})₂ (Verbindung 111-38), Ir(L_{A361})(L_{B1})₂ (Verbindung III-44), Ir(L_{A363})(L_{B1})₂ (Verbindung 111-46), Ir(L_{A364})(L_{B1})₂ (Verbindung 111-47), Ir(L_{A366})(L_{B1})₂ (Verbindung 111-49), Ir(L_{A367})(L_{B1})₂ (Verbindung 111-50), Ir(L_{A370})(L_{B1})₂ (Verbindung 111-53), Ir(L_{A373})(L_{B1})₂ (Verbindung 111-56), Ir(L_{A376})(L_{B1})₂ (Verbindung III-59), Ir(L_{A379})(L_{B1})₂ (Verbindung 111-62), Ir(L_{A382})(L_{B1})₂ (Verbindung 111-65), Ir(L_{A385})(L_{B1})₂ (Verbindung 111-68), Ir(L_{A388})(L_{B1})₂ (Verbindung 111-71), Ir(L_{A390})(L_{B1})₂ (Verbindung 111-73), Ir(L_{A391})(L_{B1})₂ (Verbindung 111-74), Ir(L_{A399})(L_{B1})₂ (Verbindung III-82), Ir(L_{A415})(L_{B1})₂ (Verbindung III-98), Ir(L_{A414})(L_{B1})₂ (Verbindung 111-97), Ir(L_{A427})(L_{B1})₂ (Verbindung III-110), Ir(L_{A439})(L_{B1})₂ (Verbindung III-122), Ir(L_{A450})(L_{B1})₂ (Verbindung III-133), Ir(L_{A451})(L_{B1})₂ (Verbindung III-134), Ir(L_{A454})(L_{B1})₂ (Verbindung III-137), Ir(L_{A460})(L_{B1})₂ (Verbindung III-143), Ir(L_{A462})(L_{B1})₂ (Verbindung III-145), Ir(L_{A463})(L_{B1})₂ (Verbindung III-146), Ir(L_{A468})(L_{B1})₂ (Verbindung III-151), Ir(L_{A469})(L_{B1})₂ (Verbindung III-152), Ir(L_{A480})(L_{B1})₂ (Verbindung III-163), Ir(L_{A481})(L_{B1})₂ (Verbindung III-164), Ir(L_{A343})(L_{B1})₂ (Verbindung III-196), Ir(L_{A367})(L_{B1})₂ (Verbindung III-220), Ir(L_{A346})(L_{B10})₂ (Verbindung III-1559), Ir(L_{A391})(L_{B10})₂ (Verbindung III-1604), Ir(L_{A355})(L_{B11})₂ (Verbindung III-1738), Ir(L_{A367})(L_{B11})₂ (Verbindung III-1750), Ir(L_{A352})(L_{B26})₂ (Verbindung III-4285), Ir(L_{A367})(L_{B26})₂ (Verbindung III-4300), Ir(L_{A367})(L_{B27})₂ (Verbindung III-4470), Ir(L_{A349})(L_{B28})₂ (Verbindung III-4622), Ir(L_{A367})(L_{B28})₂ (Verbindung III-4640), Ir(L_{A418})(L_{B27})₂ (Verbindung III-4690), Ir(L_{A463})(L_{B28})₂ (Verbindung III-4736), Ir(L_{A464})(_{B29})₂ (Verbindung III-4907), Ir(L_{A463})(L_{B30})₂ (Verbindung III-5076), Ir(L_{A346})(L_{B36})₂ (Verbindung III-5979), Ir(L_{A336})(L_{B37})₂ (Verbindung III-6139), Ir(L_{A367})(L_{B29})₂ (Verbindung III-4810), Ir(L_{A367})(L_{B30})₂ (Verbindung III-4980), Ir(L_{A367})(L_{B31})₂ (Verbindung III-5150), Ir(L_{A367})(L_{B32})₂ (Verbindung III-5320), Ir(L_{A352})(L_{B33})₂ (Verbindung III-5475), Ir(L_{A367})(I-_{B33})₂ (Verbindung III-5490), und Ir(L_{A367})(L_{B34})₂ (Verbindung III-5660).

22. Eine erste Vorrichtung umfassend eine erste organische Licht emittierende Vorrichtung, ferner umfassend:
eine Anode;
eine Kathode; und
eine organische Schicht angeordnet zwischen der Anode und der Kathode, umfassend eine Verbindung mit der Formuel Ir(L_{A})ₙ(L_{B})₃₋ₙ, mit der folgenden Struktur: 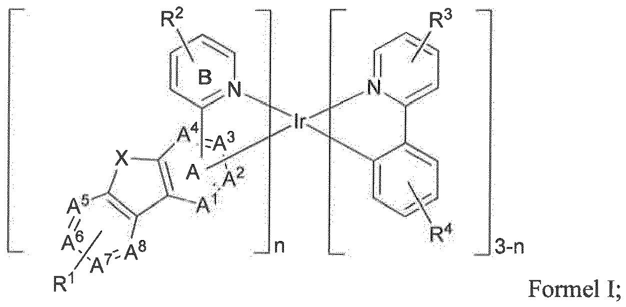 wobei A¹, A², A³, A⁴, A⁵, A⁶, A⁷, und A⁸ Kohlenstoff oder Stickstoff umfassen;
wobei mindestens einer von A¹, A², A³, A⁴, A⁵, A⁶, A⁷, und A⁸ Stickstoff ist;
wobei Ring B mittels einer C-C Bindung an Ring A gebunden ist;
wobei das Iridium mittels einer Ir-C Bindung an Ring A gebunden ist;
wobei X für O, S, oder Se steht;
wobei R¹, R², R³, und R⁴ unabhängig voneinander für mono-, di-, tri-, tetra-Substitutionen, oder keine Substitution stehen;
wobei beliebige benachbarte Substitutionen von R¹, R², R³, und R⁴ gegebenenfalls miteinander verknüpft sind um einen Ring zu bilden;
wobei R¹, R², R³, und R⁴ unabhängig voneinander ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitrile, Isonitrile, Sulfanyl, Sulfinyl, Sulfonyl, Phosphino, und deren Kombinationen; und
wobei n eine ganze Zahl von 1 to 3 ist.

23. Eine Formulierung umfassend eine Verbindung mit der Formel Ir(L_{A})ₙ(L_{B})₃₋ₙ, mit der folgenden Struktur: 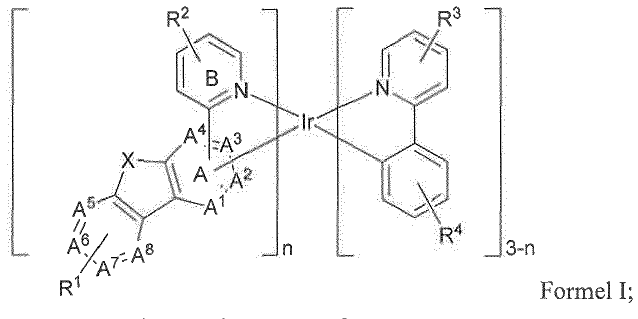 wobei A¹, A², A³, A⁴, A⁵, A⁶, A⁷, und A⁸ Kohlenstoff oder Stickstoff umfassen;
wobei mindestens einer von A¹, A², A³, A⁴, A⁵, A⁶, A⁷, und A⁸ Stickstoff ist;
wobei Ring B mittels einer C-C Bindung an Ring A gebunden ist;
wobei das Iridium mittels einer Ir-C Bindung an Ring A gebunden ist;
wobei X für O, S, oder Se steht;
wobei R¹, R², R³, und R⁴ unabhängig voneinander für mono-, di-, tri-, tetra-Substitutionen, oder keine Substitution stehen;
wobei beliebige benachbarte Substitutionen von R¹, R², R³, und R⁴ gegebenenfalls miteinander verknüpft sind um einen Ring zu bilden;
wobei R¹, R², R³, und R⁴ unabhängig voneinander ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitrile, Isonitrile, Sulfanyl, Sulfinyl, Sulfonyl, Phosphino, und deren Kombinationen; und
wobei n eine ganze Zahl von 1 to 3 ist.

## Revendications

1. Composé étant représenté par la formule Ir(L_{A})ₙ(L_{B})₃₋ₙ, ayant la structure : 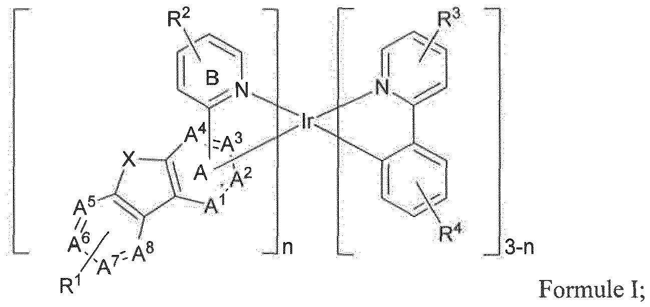 dans lequel A¹, A², A³, A⁴, A⁵, A⁶, A⁷, et A⁸ comprennent du carbone ou de l'azote ;
dans lequel au moins un parmi A¹, A², A³, A⁴, A⁵, A⁶, A⁷, et A⁸ est un azote ;
dans lequel le cycle B est lié au cycle A via une liaison C-C ;
dans lequel l'iridium est lié au cycle A via une liaison Ir-C ;
dans lequel X est O, S, ou Se ;
dans lequel R¹, R², R³, et R⁴ représentent indépendamment une mono, di, tri ou tétra substitution, ou aucune substitution ;
dans lequel tous groupements adjacents en R¹, R², R³, et R⁴ sont optionnellement liés ensemble pour former un cycle ;
dans lequel R¹, R², R³, et R⁴ sont indépendamment sélectionnés dans le groupe constitué d'hydrogène, de deutérium, d'halogénure, d'alkyle, de cycloalkyle, d'hétéroalkyle, d'arylalkyle, d'alcoxy, d'aryloxy, d'amino, de silyl, d'alkényle, de cycloalkényle, d'hétéroalkényle, d'alkynyle, d'aryle, d'hétéroaryle, d'acyle, de carbonyle, d'acides carboxyliques, d'ester, de nitrile, d'isonitrile, de sulfanyle, de sulfinyle, de sulfonyle, de phosphino, et de combinaisons de ceux-ci ;
dans lequel n est un entier de 1 à 3.

2. Composé selon la revendication 1, dans lequel le composé est représenté par la formule :

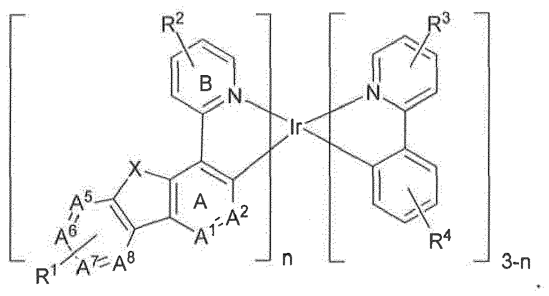

3. Composé selon la revendication 1 ou 2, dans lequel n est égal à 1.

4. Composé selon l'une quelconque des revendications 1 à 3, dans lequel seulement un parmi A¹ à A⁸ est un azote.

5. Composé selon l'une quelconque des revendications 1 à 4, dans lequel X est O.

6. Composé selon l'une quelconque des revendications 1 à 5, dans lequel R¹, R², R³ et R⁴ sont indépendamment sélectionnés dans le groupe constitué d'hydrogène, de deutérium, d'alkyle, et de combinaisons de ceux-ci.

7. Composé selon l'une quelconque des revendications 1 à 6, dans lequel R² est un alkyle.

8. Composé selon l'une quelconque des revendications 1 à 6, dans lequel R² est sélectionné dans le groupe constitué d'aryle, d'aryle substitué, d'hétéroaryle et d'hétéroaryle substitué.

9. Composé selon l'une quelconque des revendications 1 à 8, dans lequel R³ est un alkyle.

10. Composé selon la revendication 1, dans lequel L_{A} est sélectionné dans le groupe constitué de :

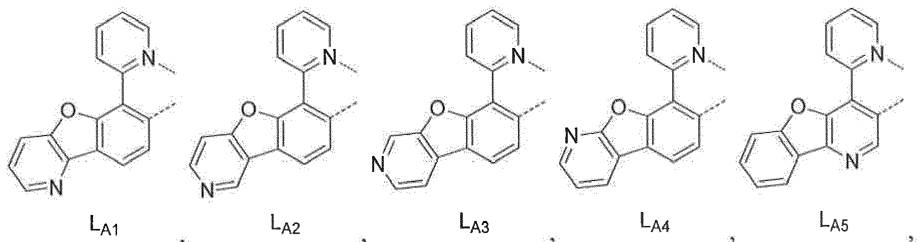

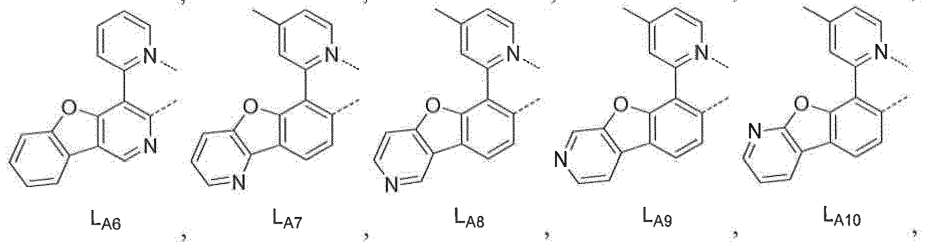

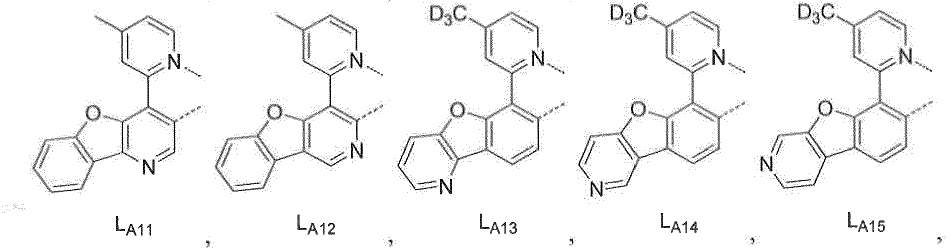

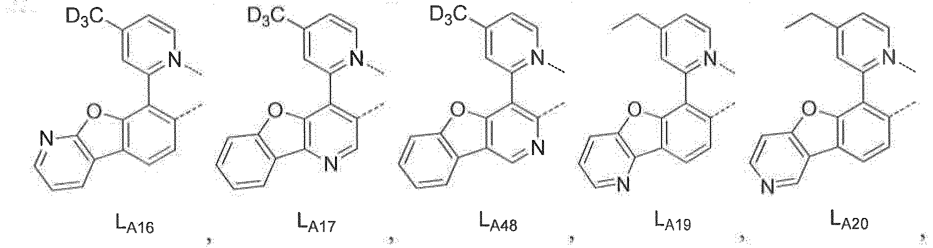

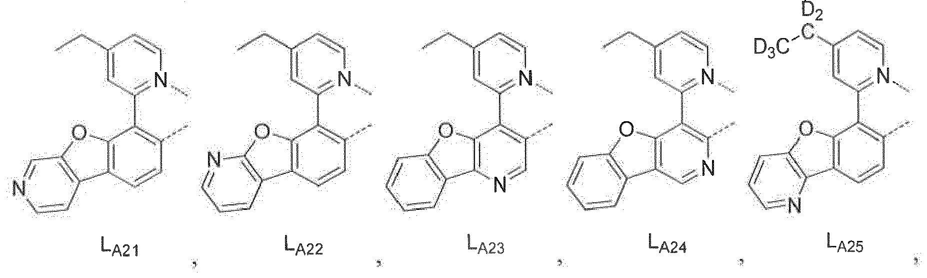

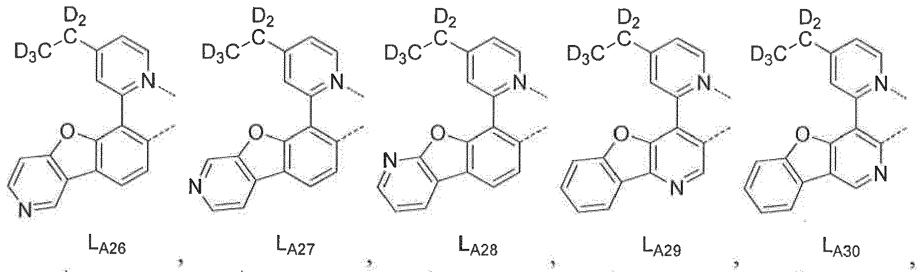

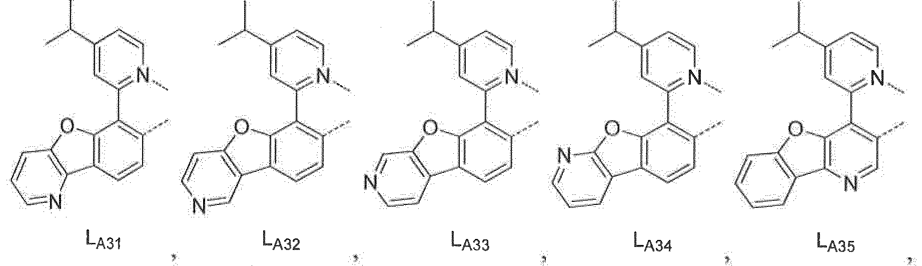

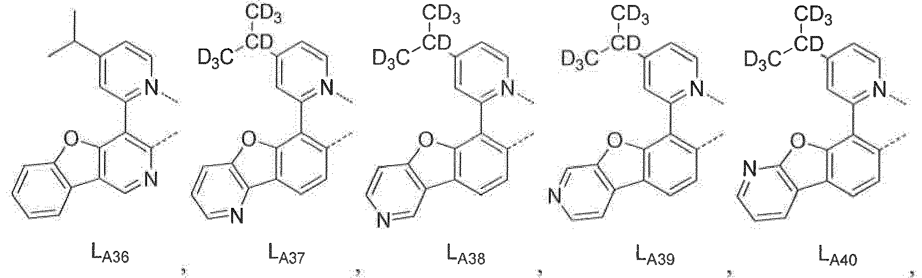

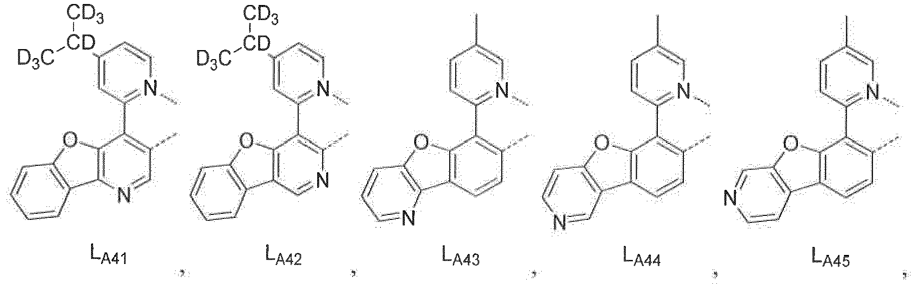

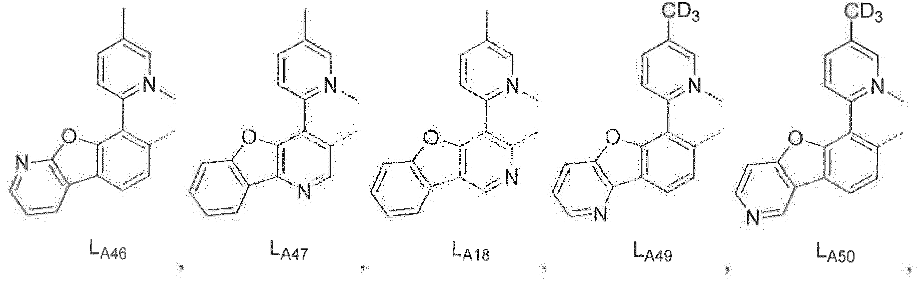

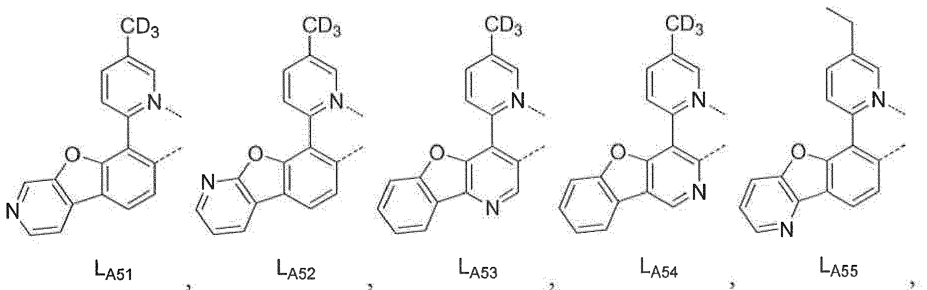

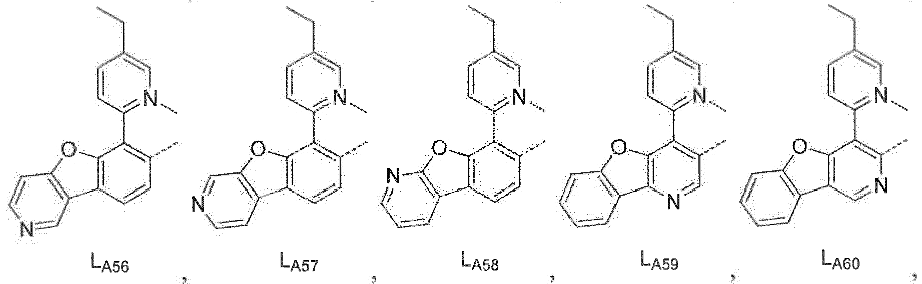

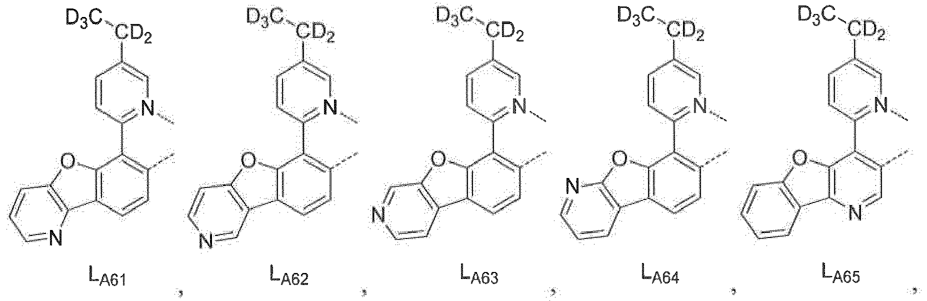

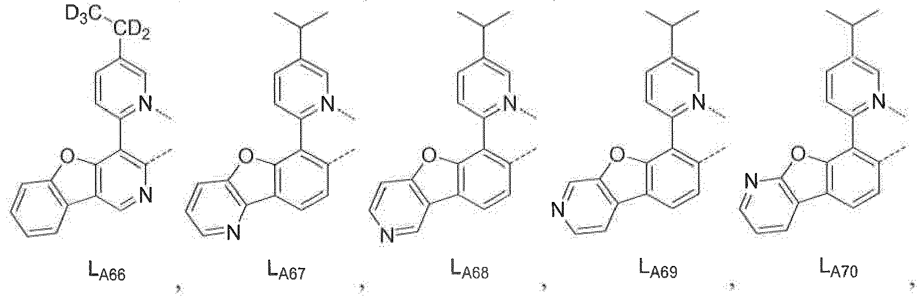

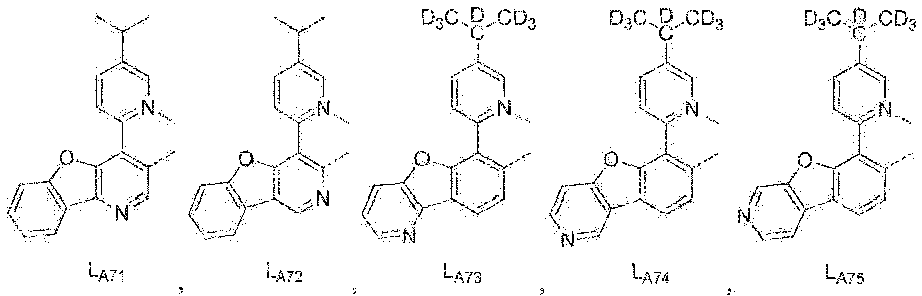

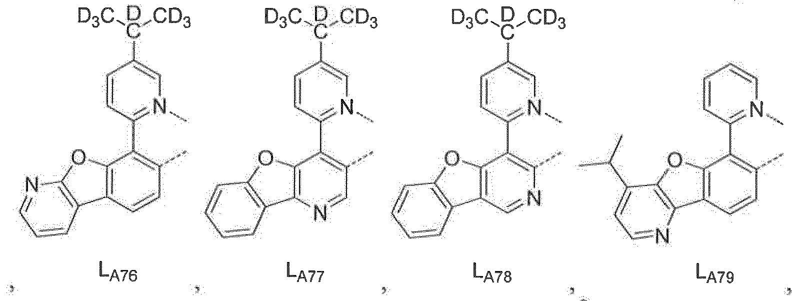

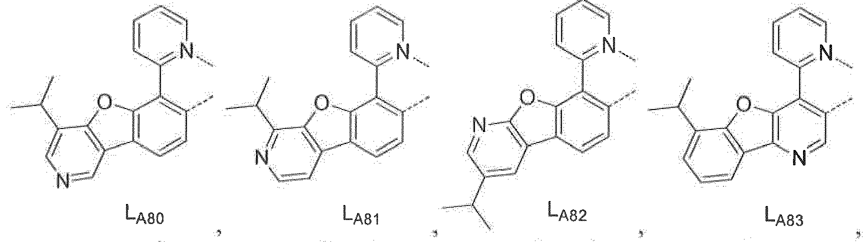

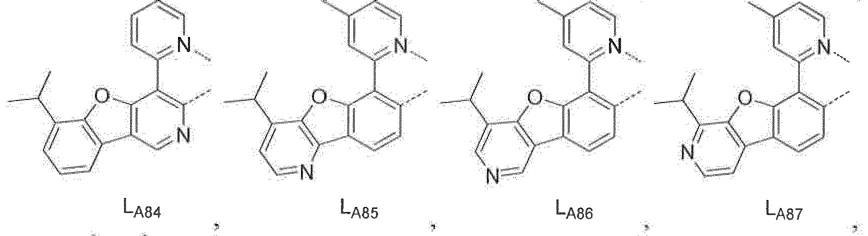

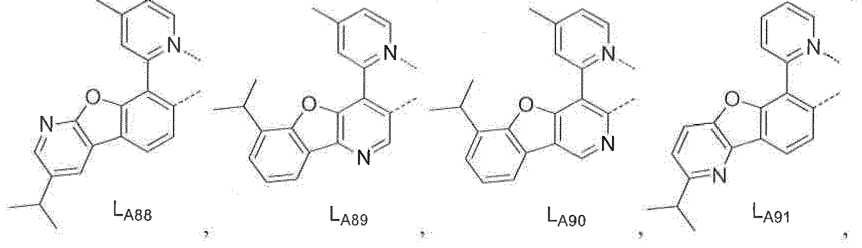

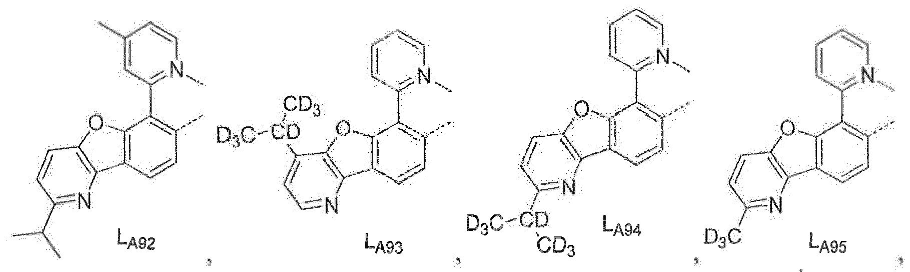

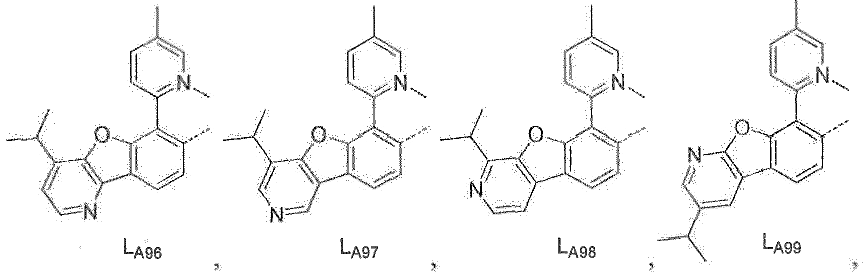

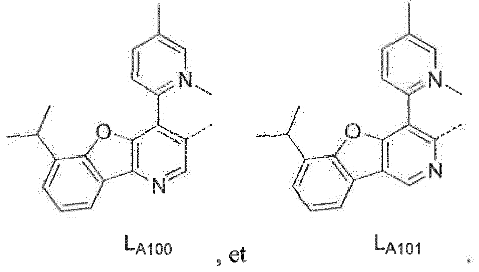

11. Composé selon la revendication 1, dans lequel L_{A} est sélectionné dans le groupe constitué de :

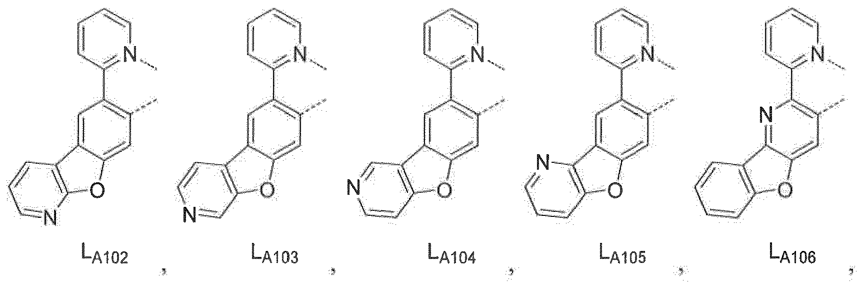

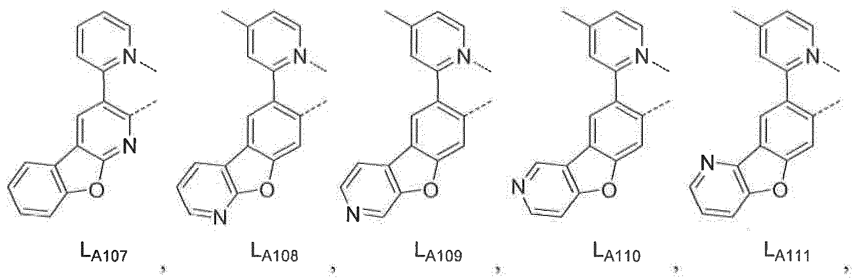

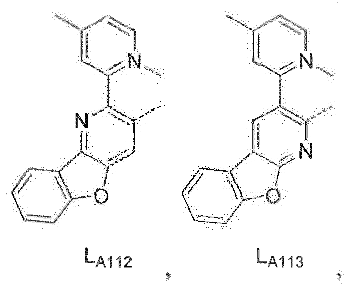

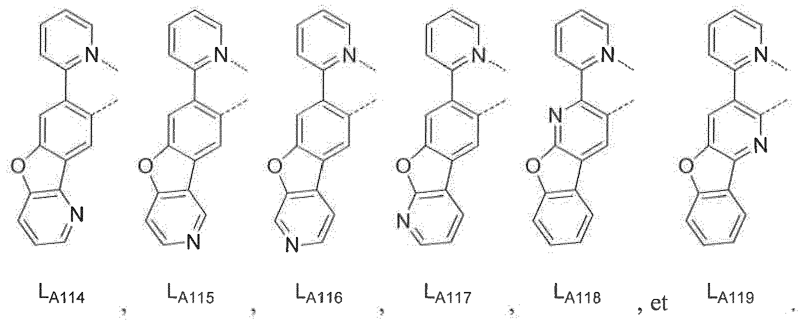

12. Composé selon la revendication 1, dans lequel L_{B} est sélectionné dans le groupe constitué de ;

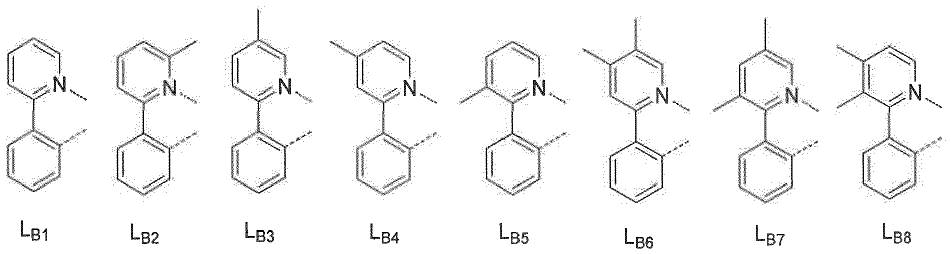

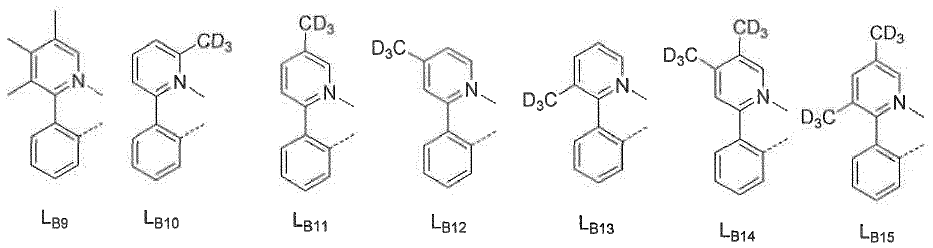

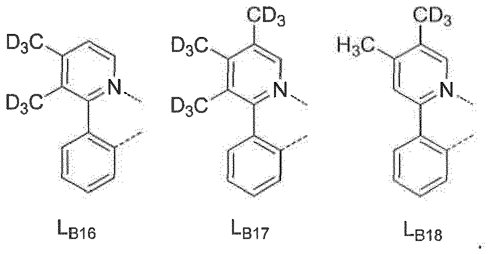

13. Composé selon la revendication 1, dans lequel le composé est sélectionné dans le groupe constitué de :

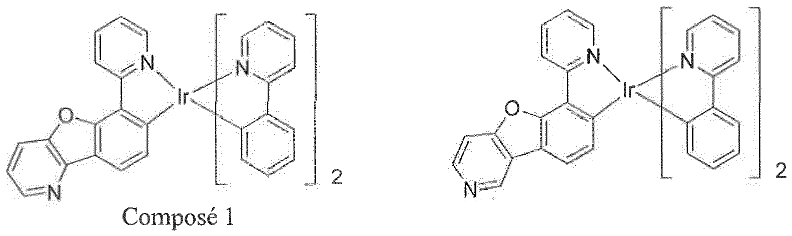

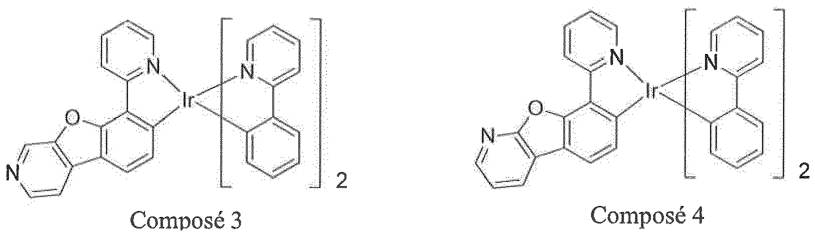

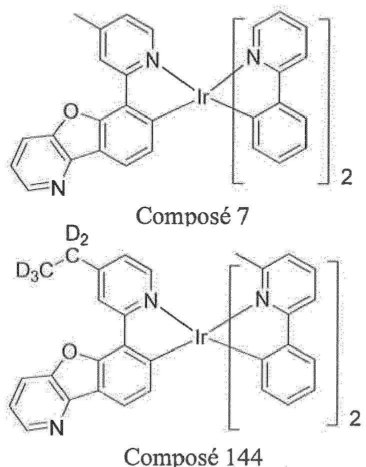

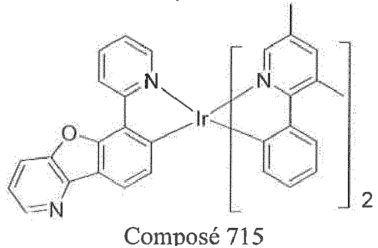

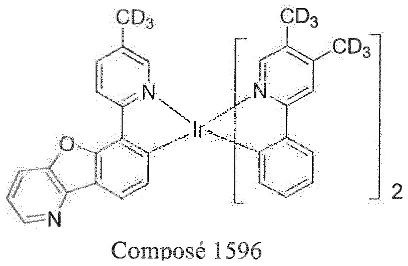

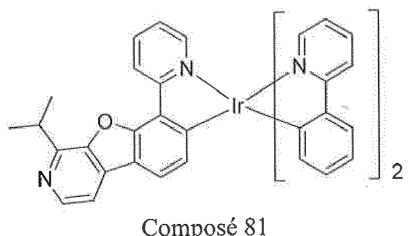

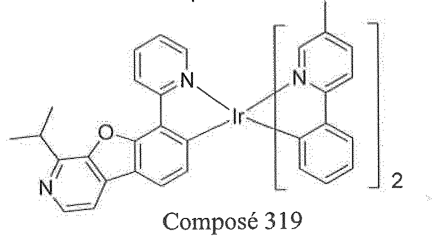

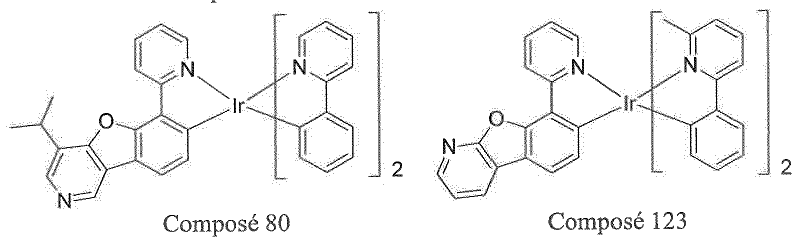

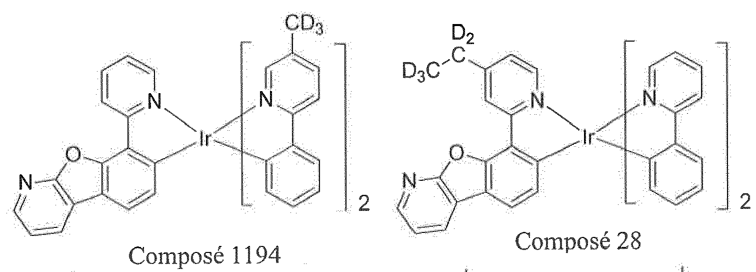

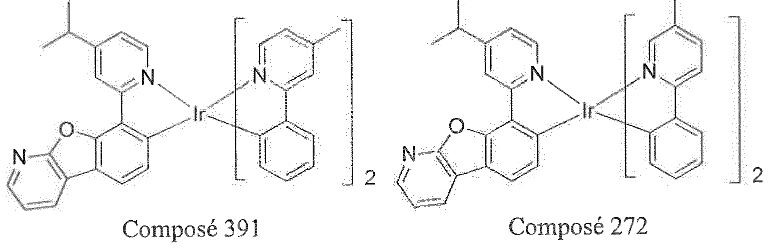

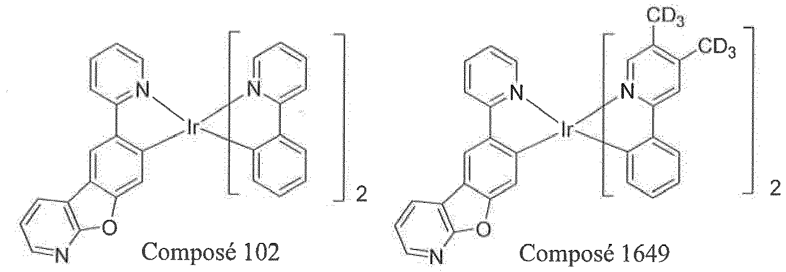

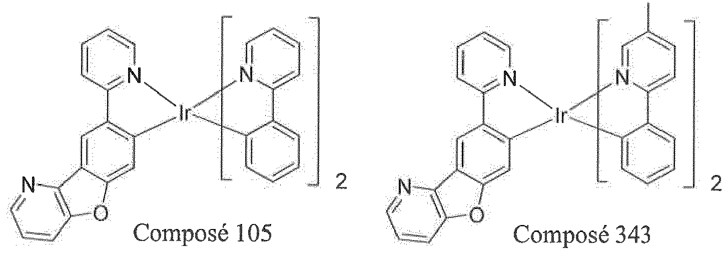

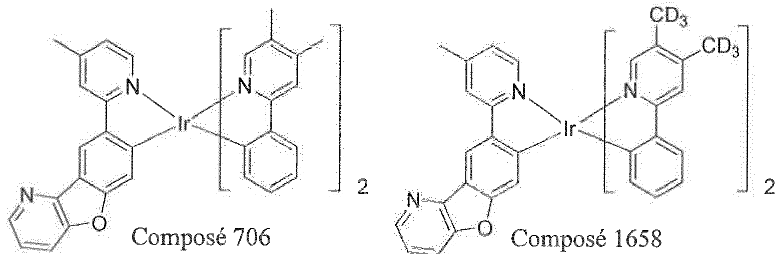

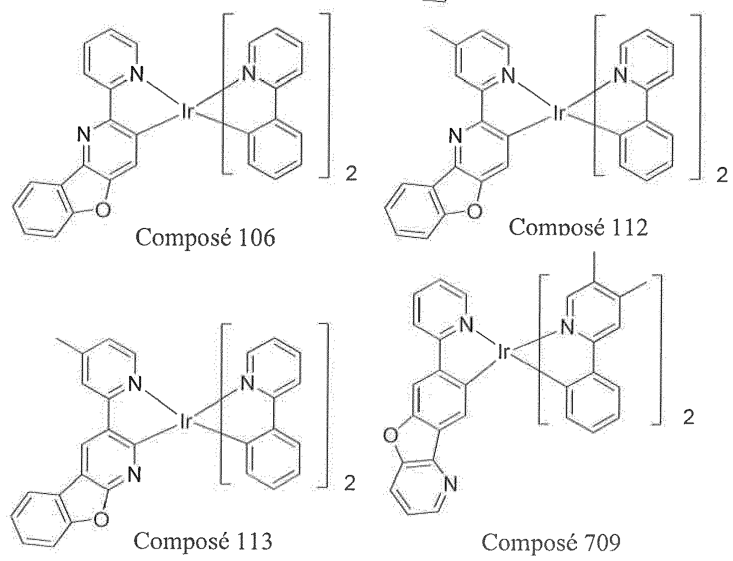

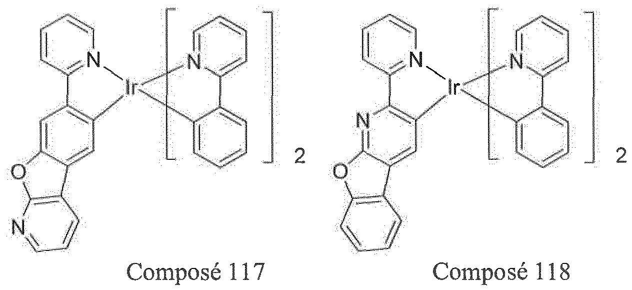

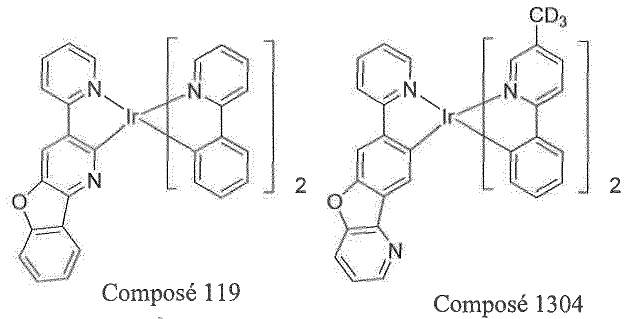

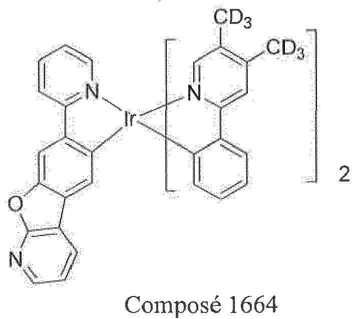

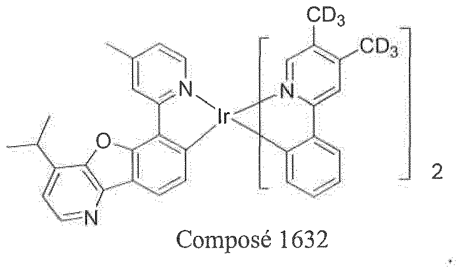

14. Composé selon la revendication 1, dans lequel A¹-A⁴ et A⁶-A⁸ sont C ; A⁵ est N ; et
ledit composé ayant une structure selon la Formule II 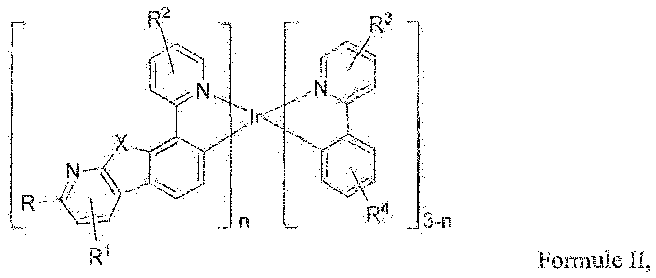 dans lequel R est sélectionné dans le groupe constitué d'alkyle, de cycloalkyle, et des combinaisons de ceux-ci.

15. Composé selon la revendication 14, dans lequel R² est sélectionné dans le groupe constitué d'aryle, d'aryle substitué, d'hétéroaryle et d'hétéroaryle substitué.

16. Composé selon la revendication 14, dans lequel L_{A} est sélectionné dans le groupe constitué de :

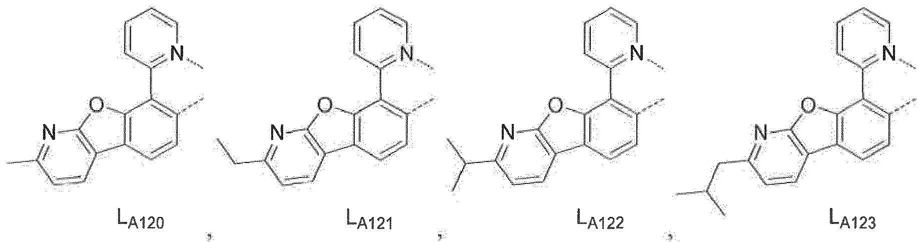

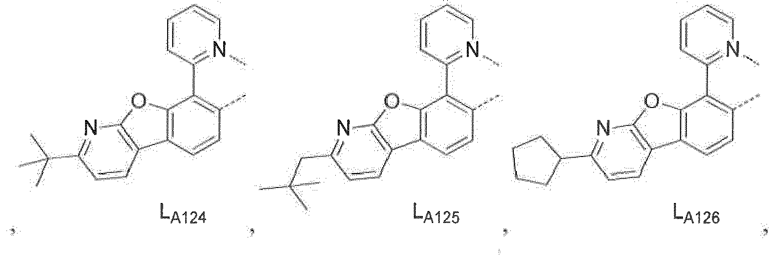

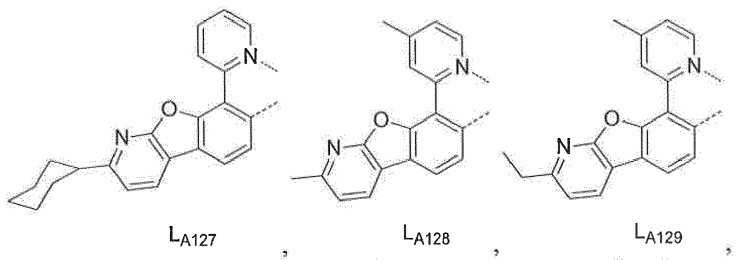

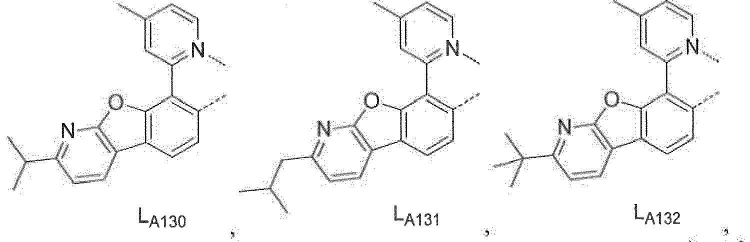

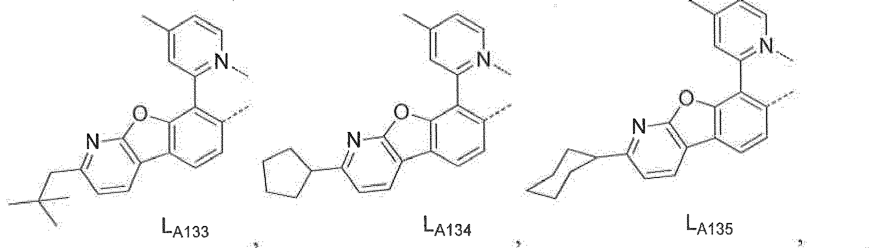

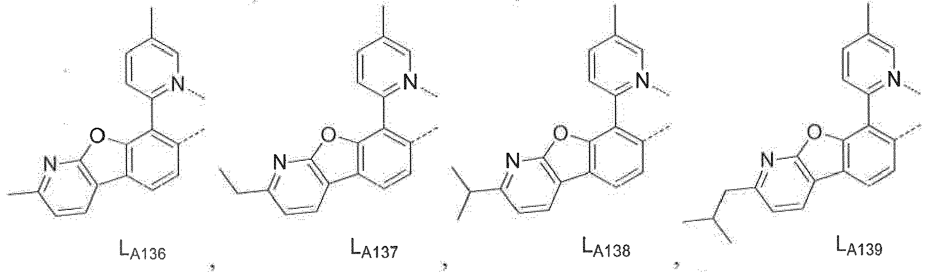

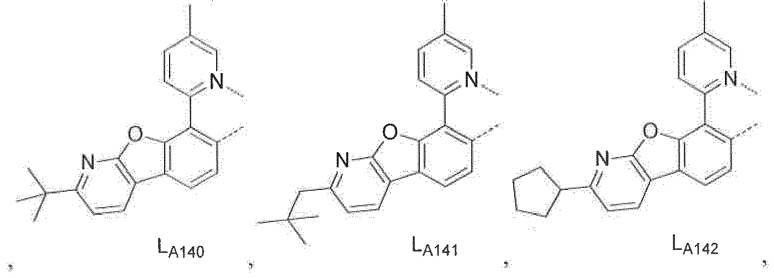

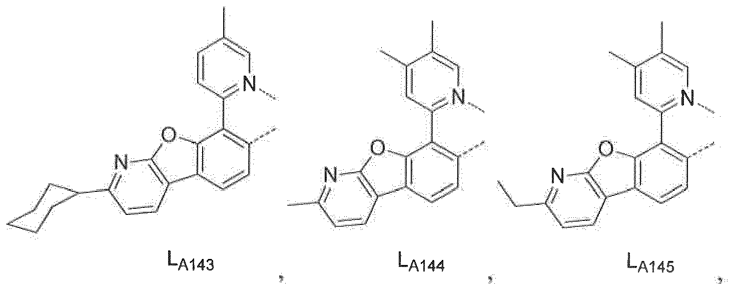

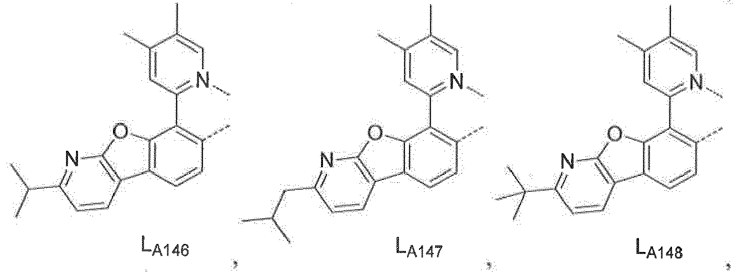

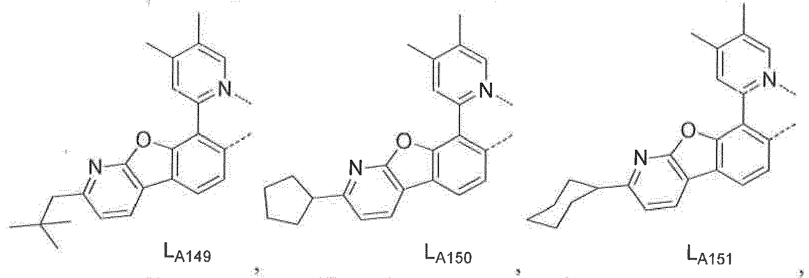

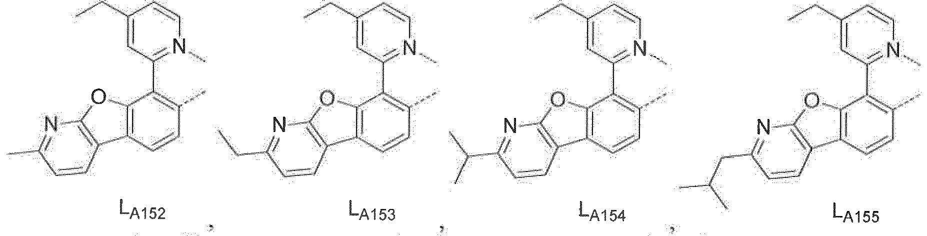

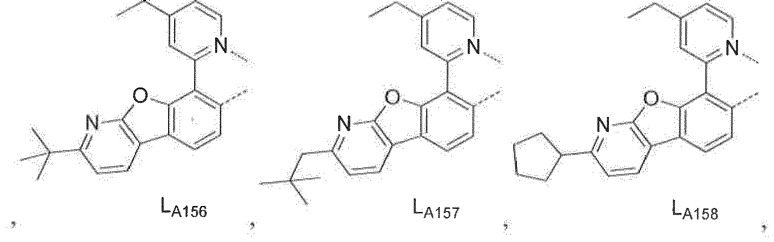

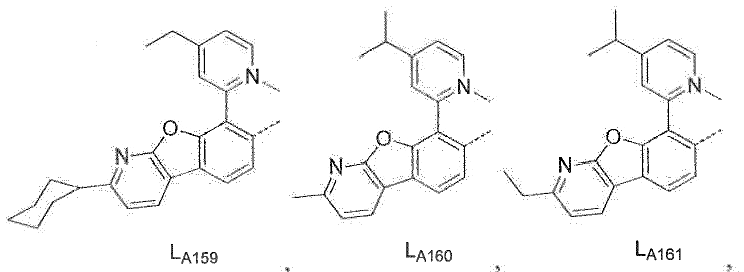

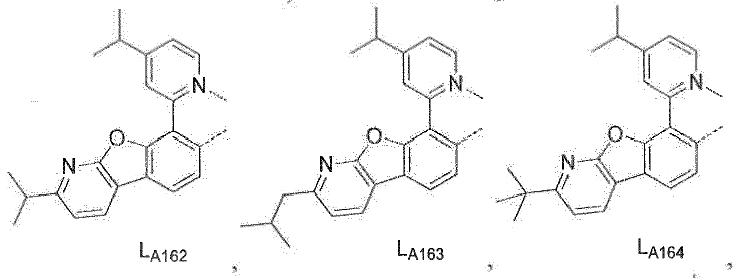

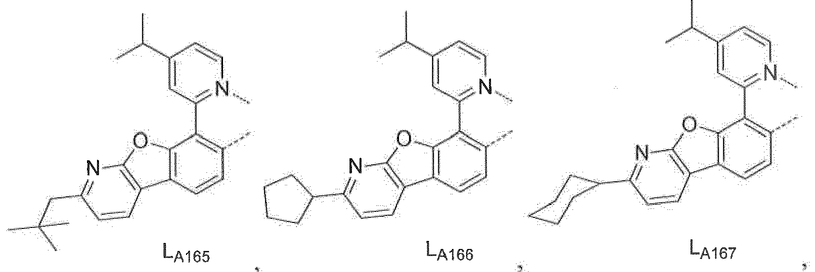

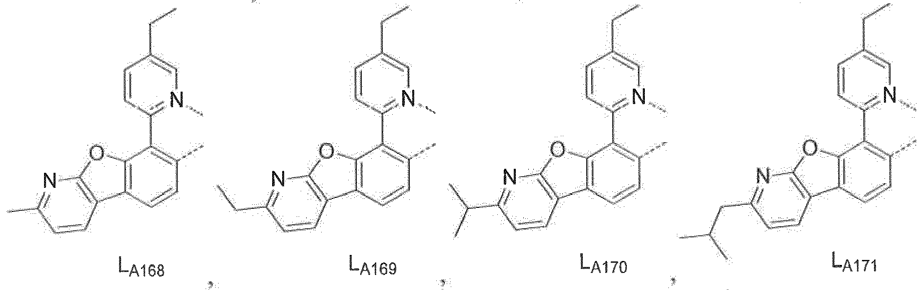

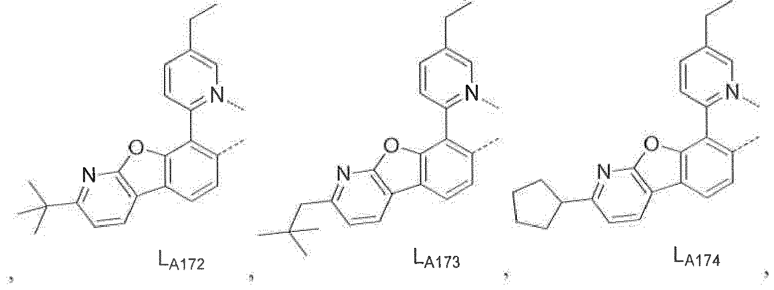

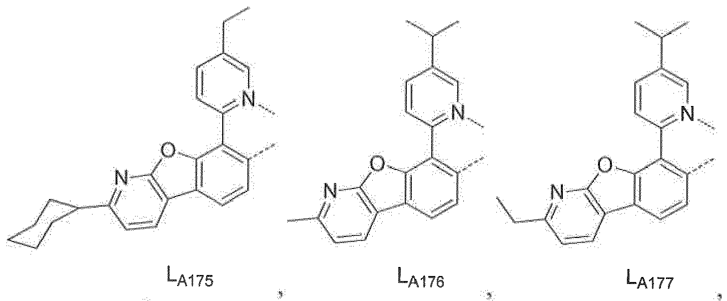

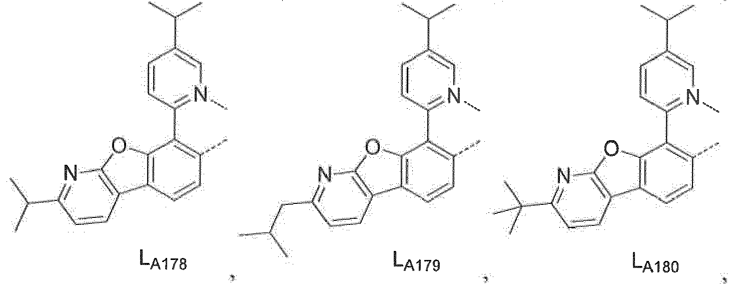

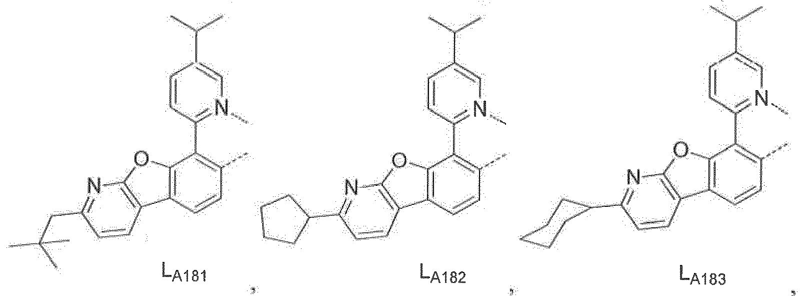

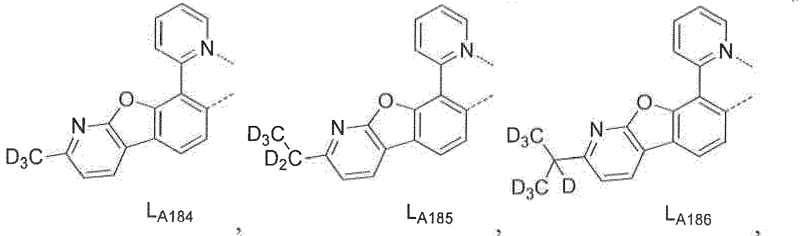

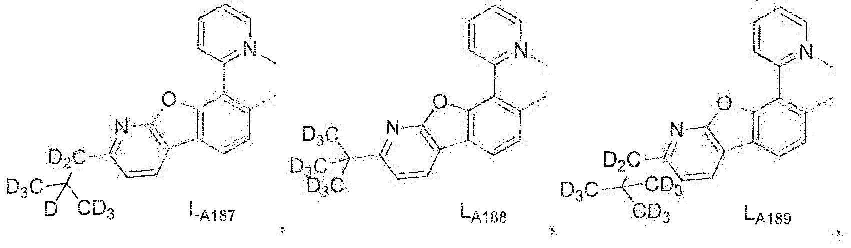

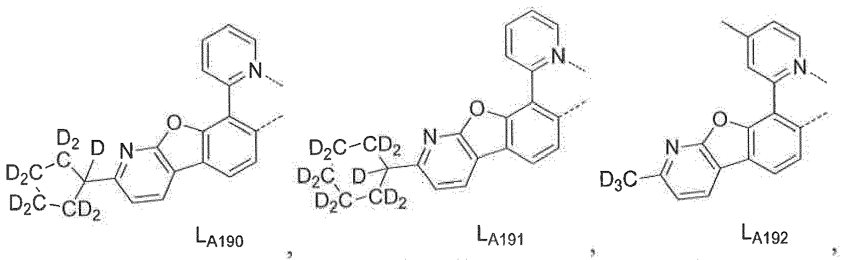

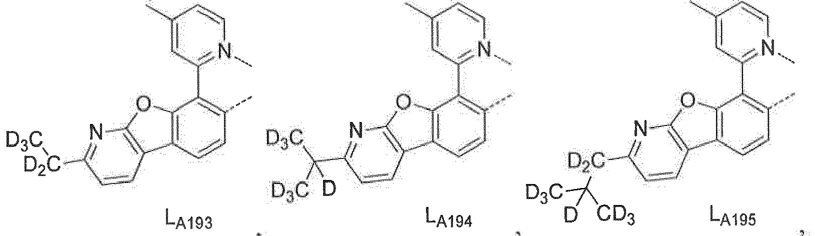

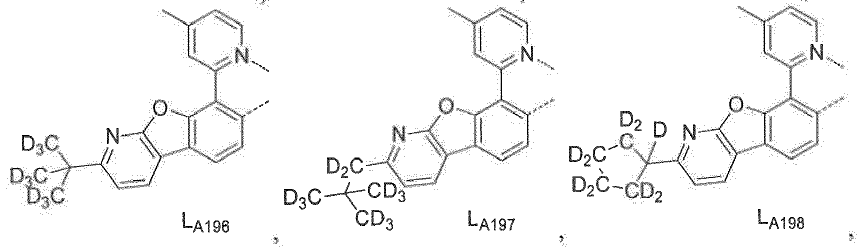

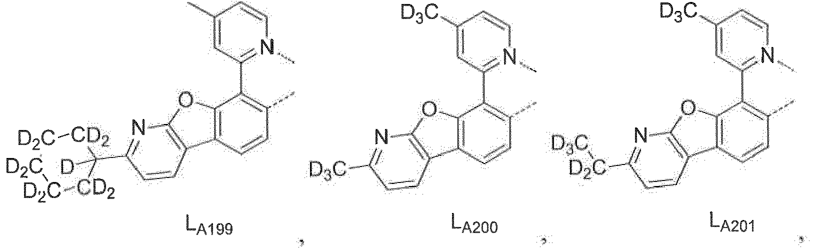

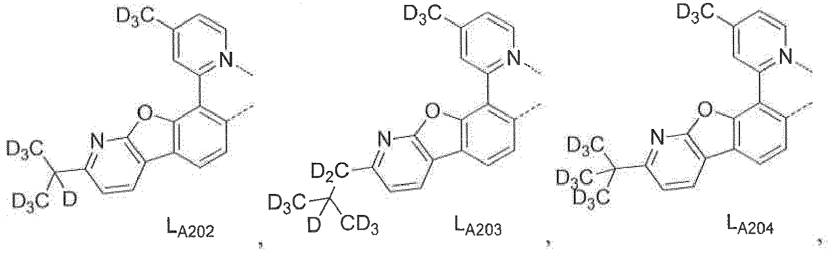

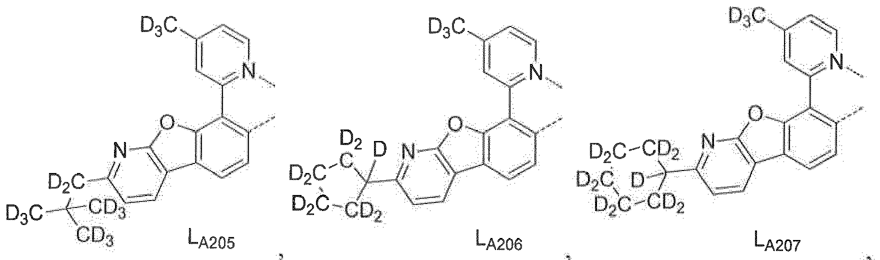

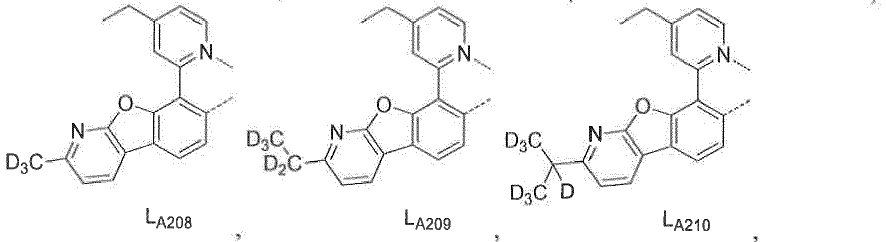

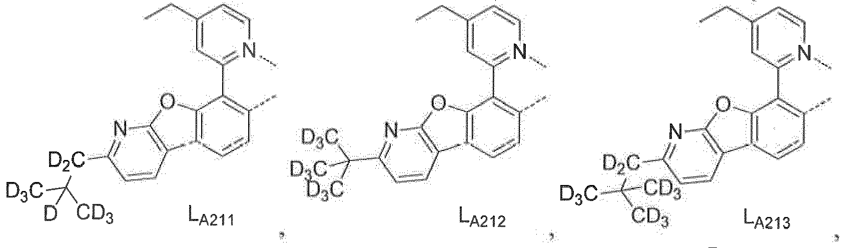

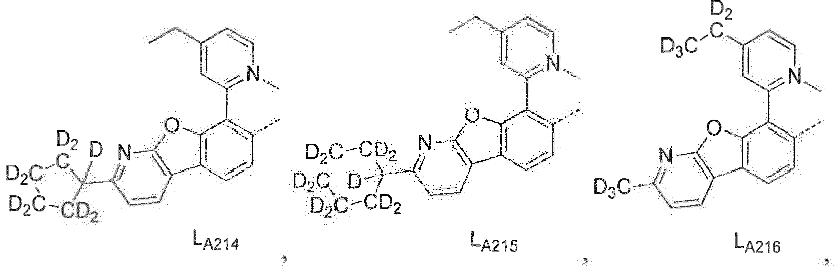

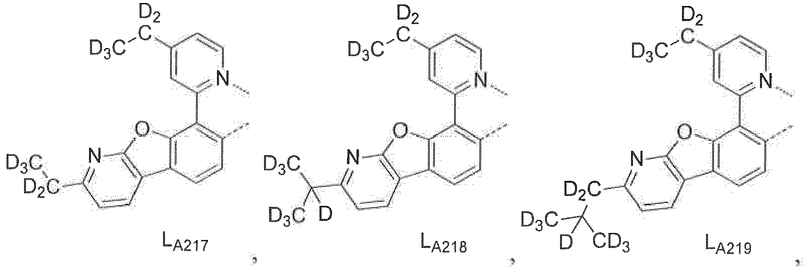

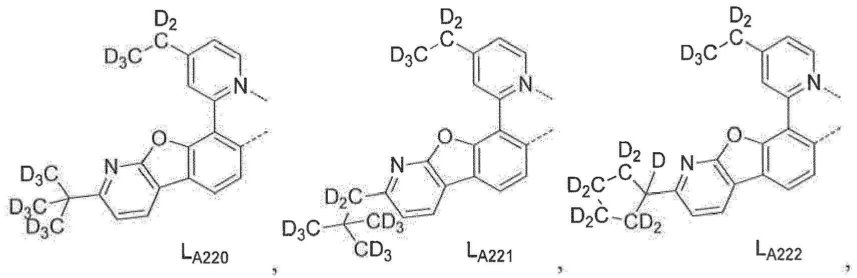

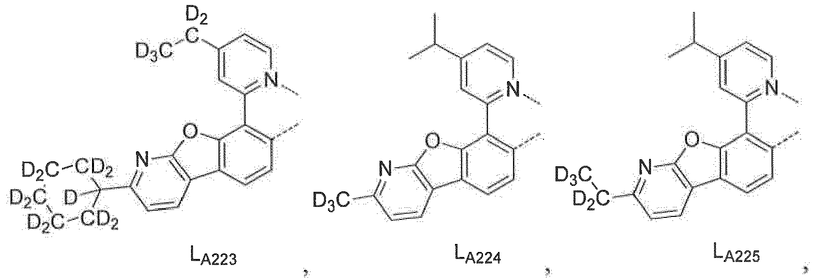

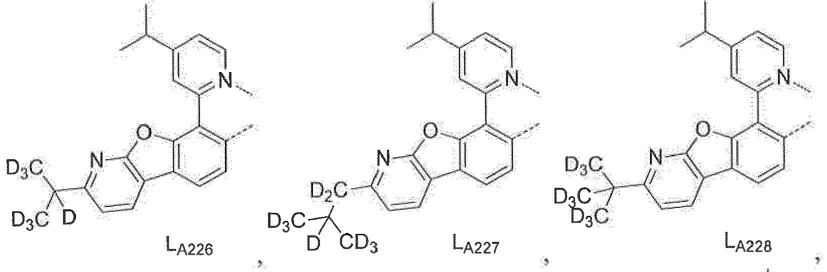

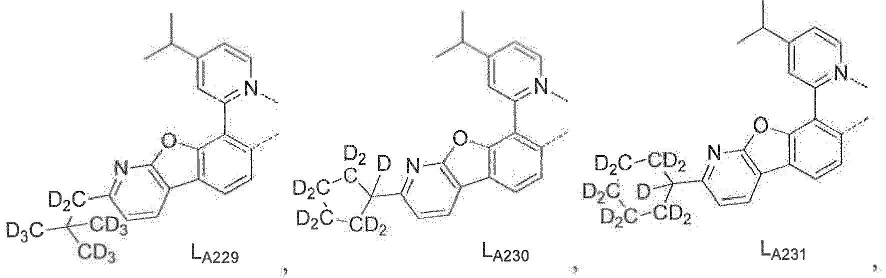

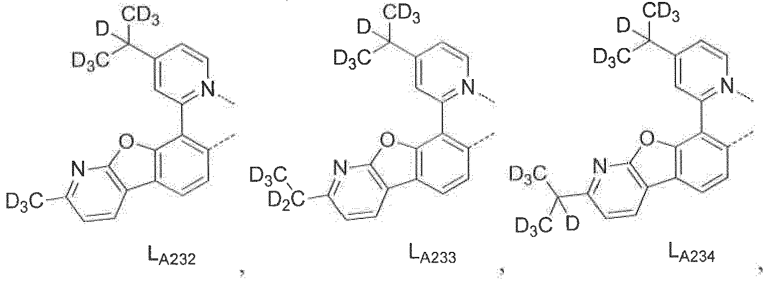

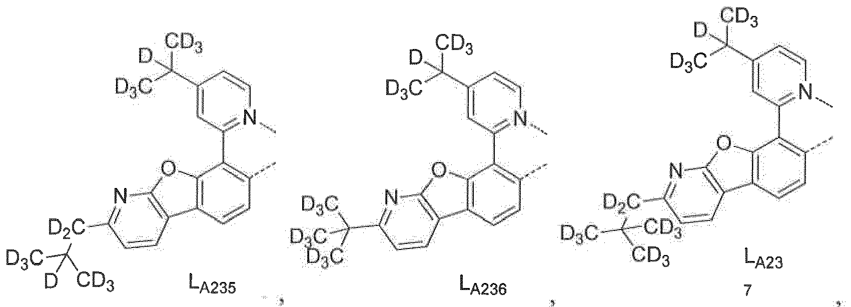

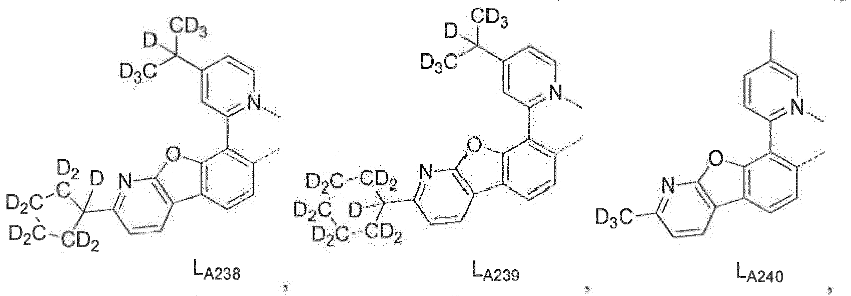

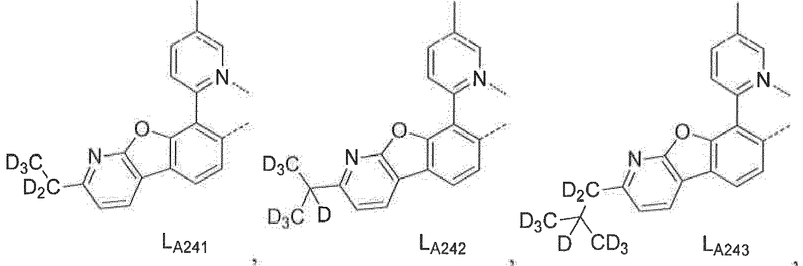

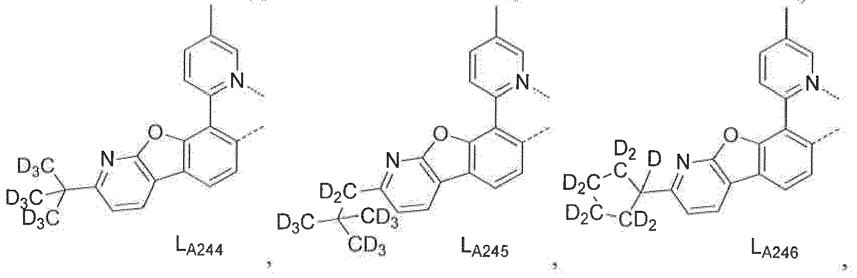

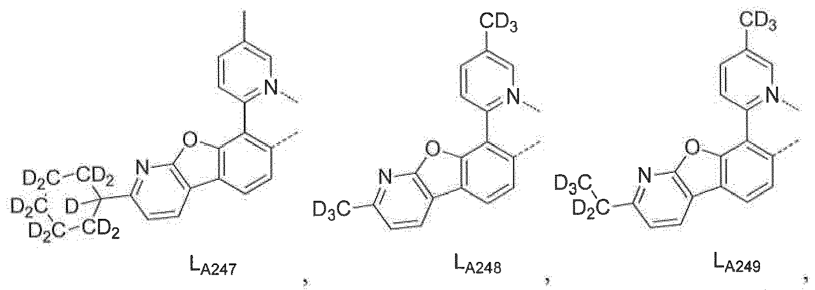

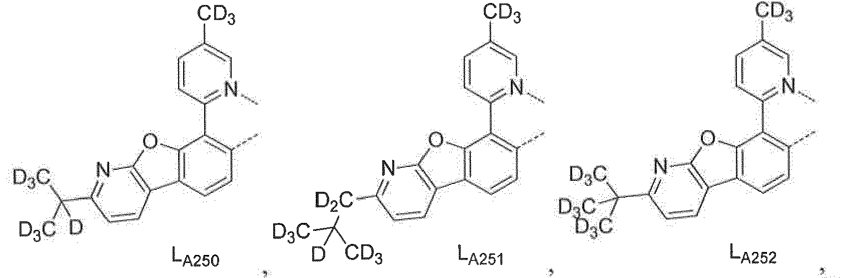

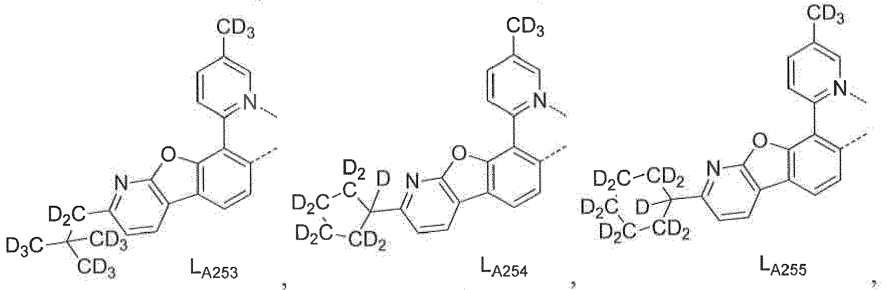

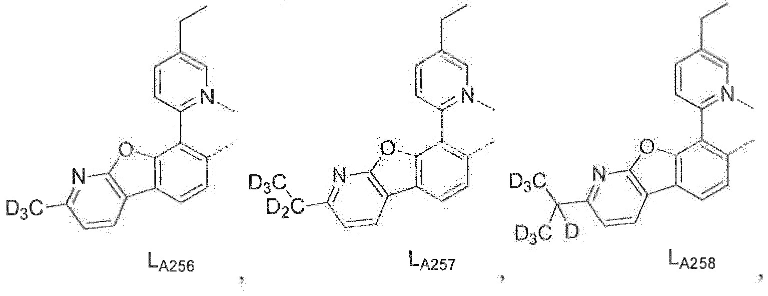

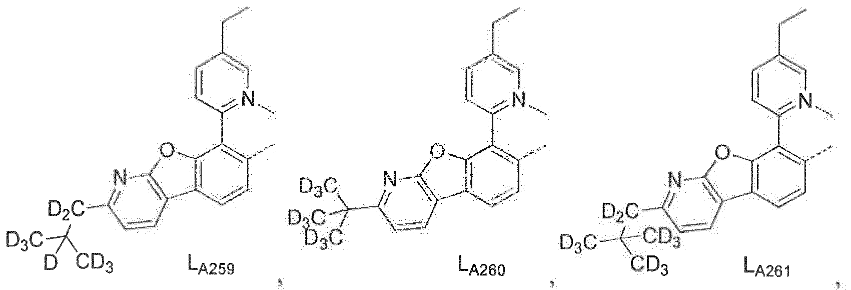

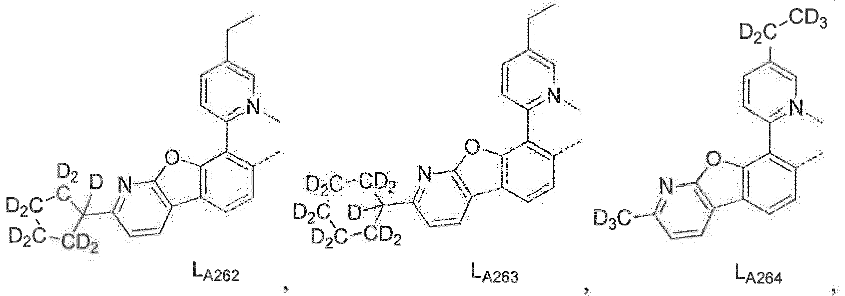

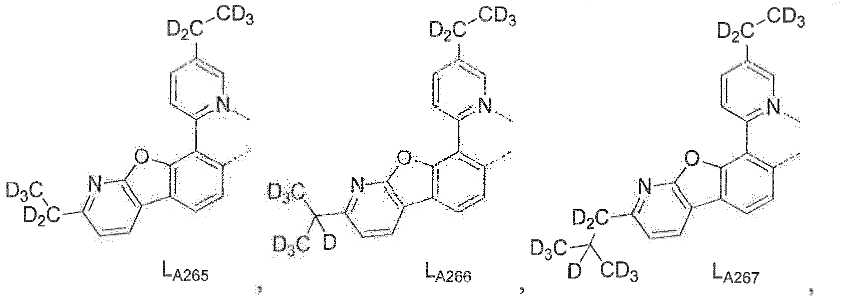

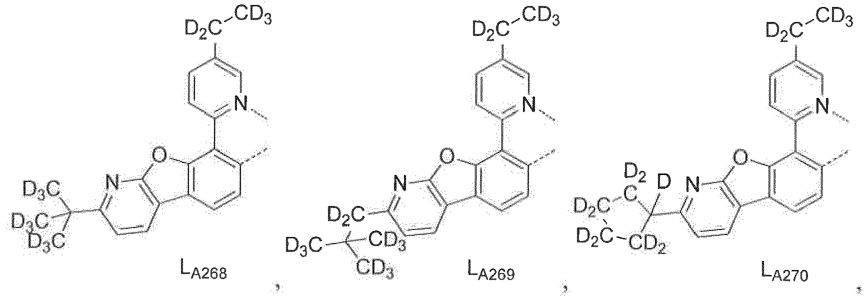

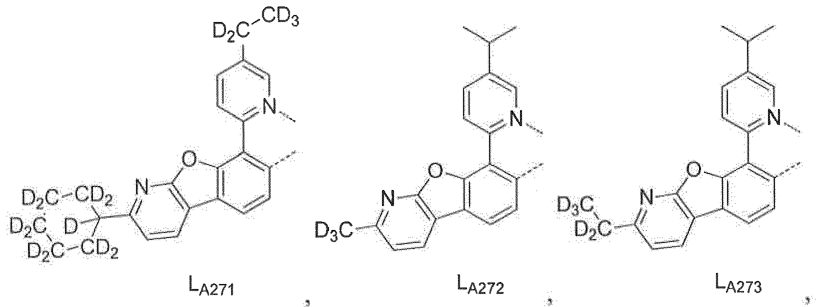

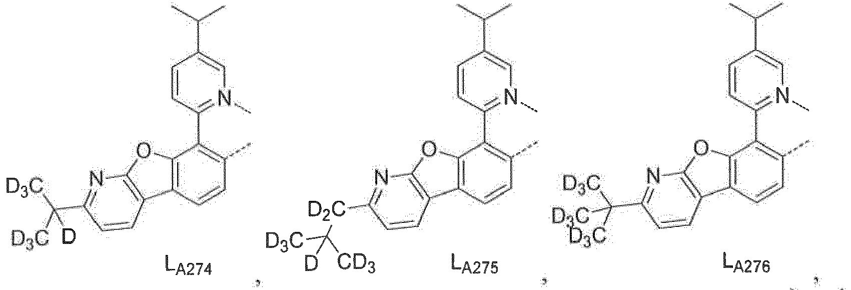

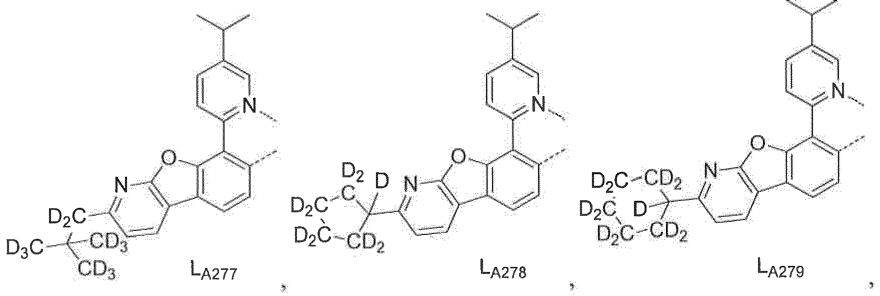

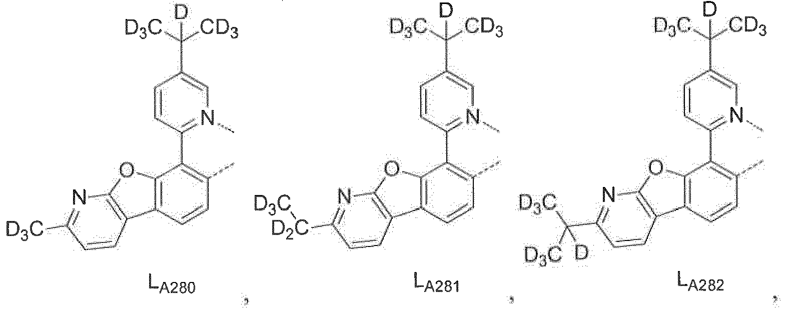

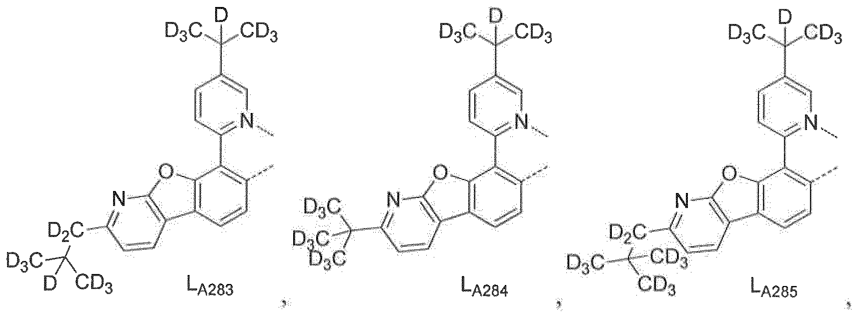

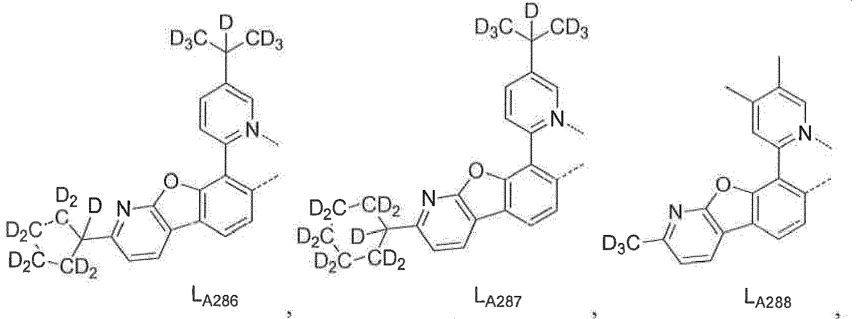

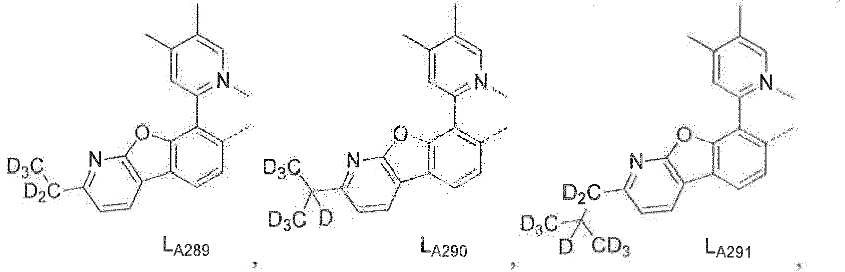

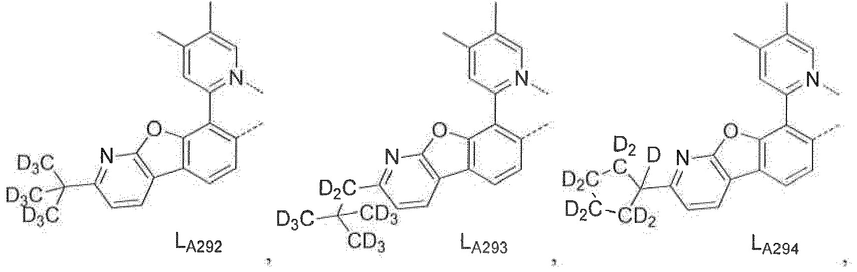

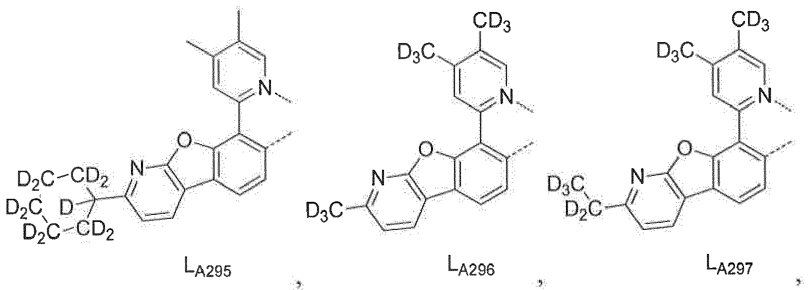

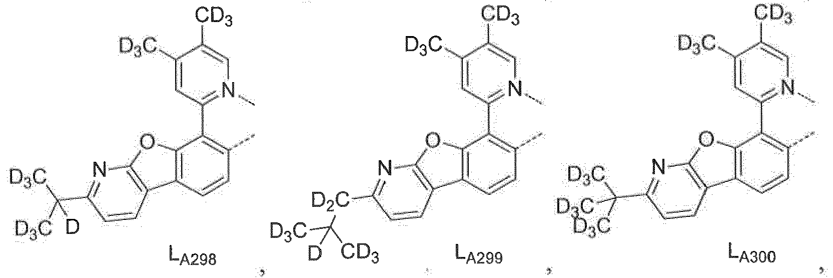

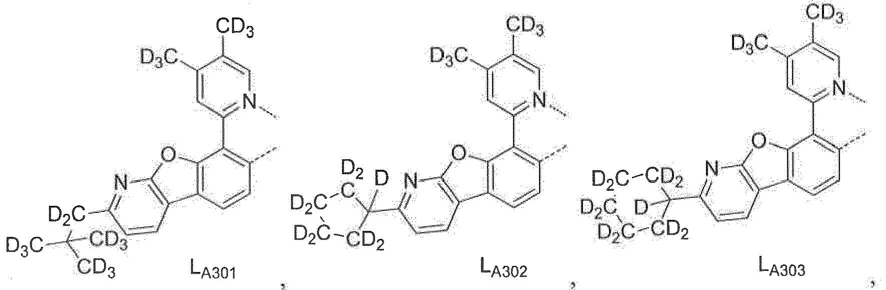

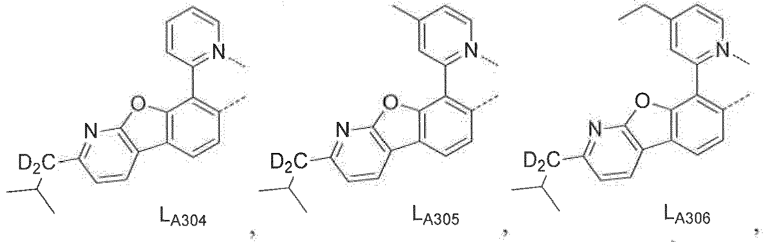

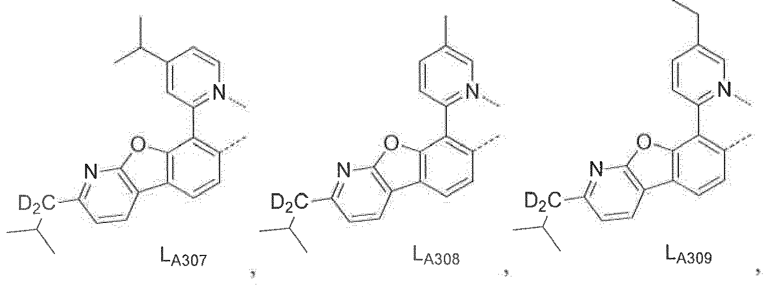

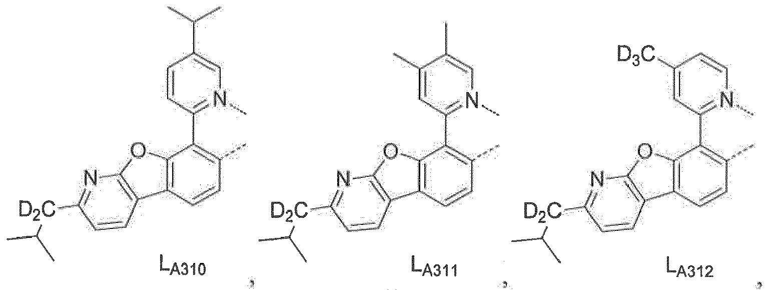

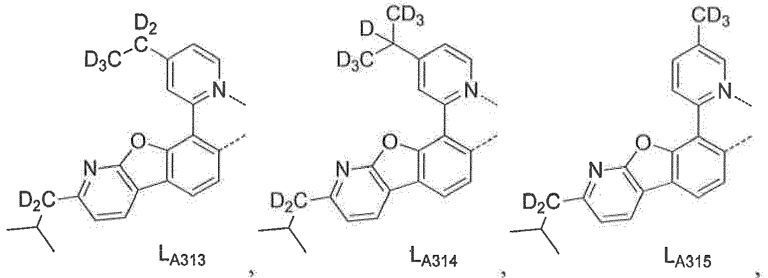

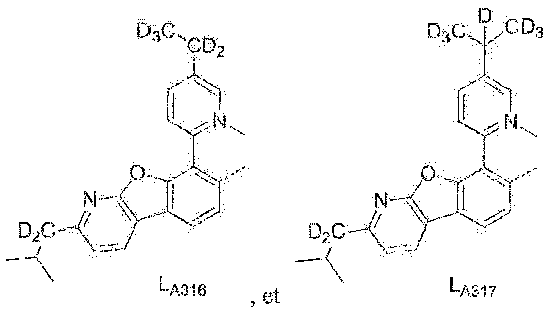

17. Composé selon la revendication 14, dans lequel L_{B} est sélectionné dans le groupe constitué de :

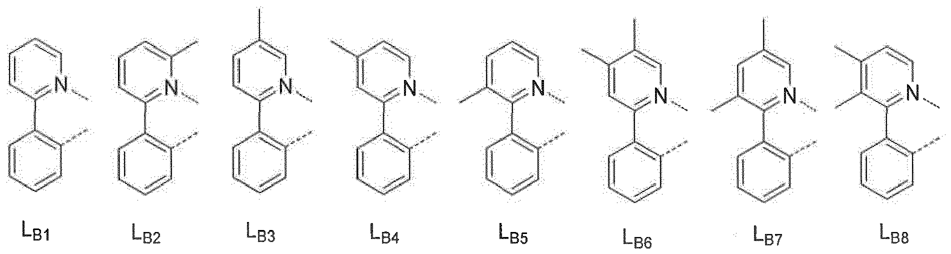

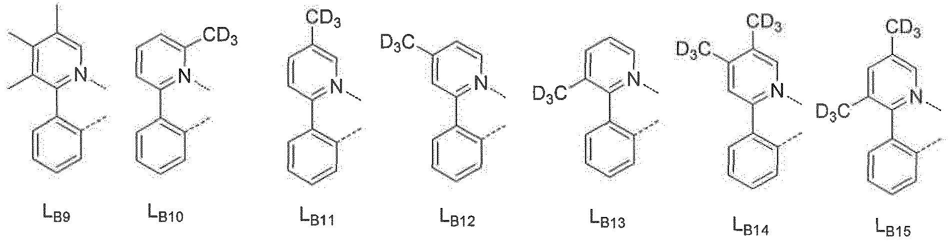

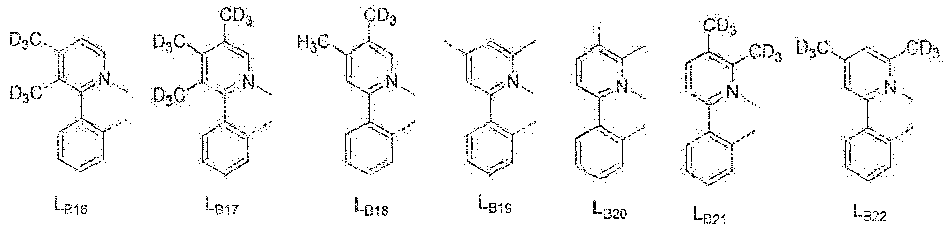

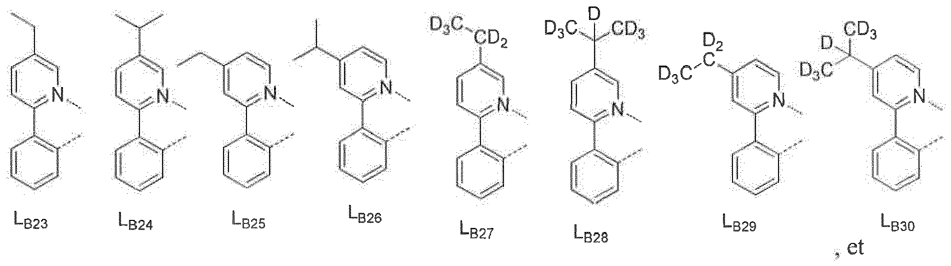

18. Composé selon la revendication 14, dans lequel le composé est sélectionné dans le groupe constitué de : 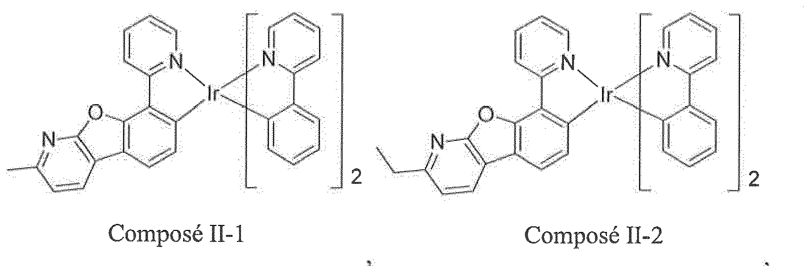 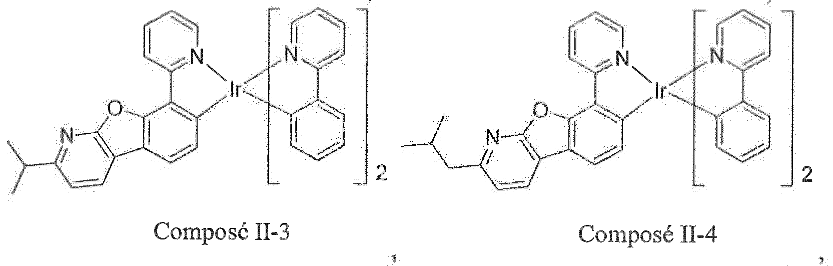 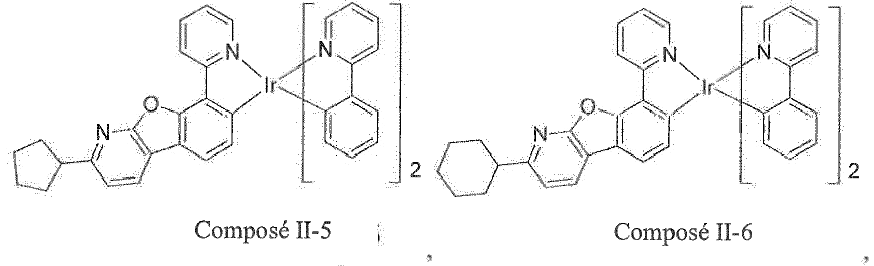 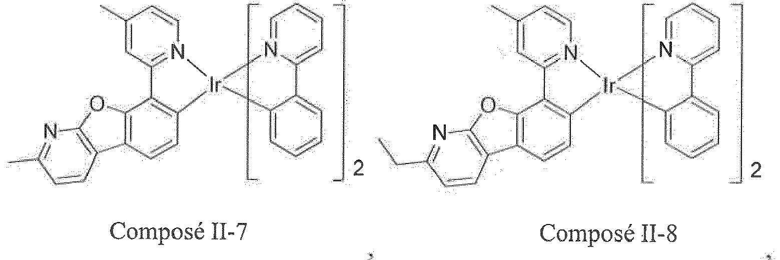 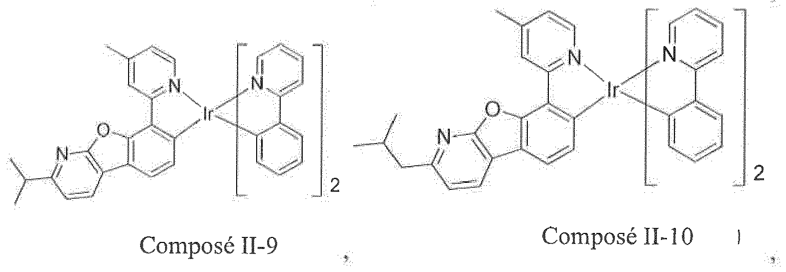 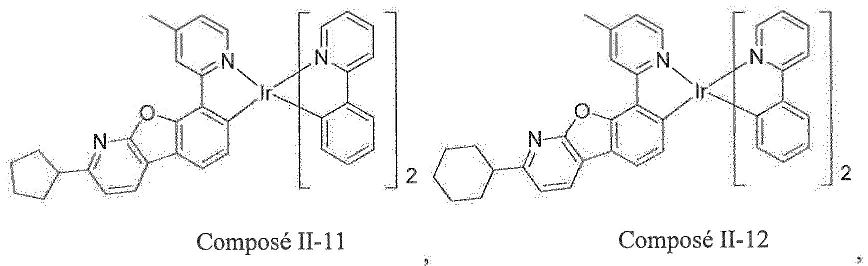 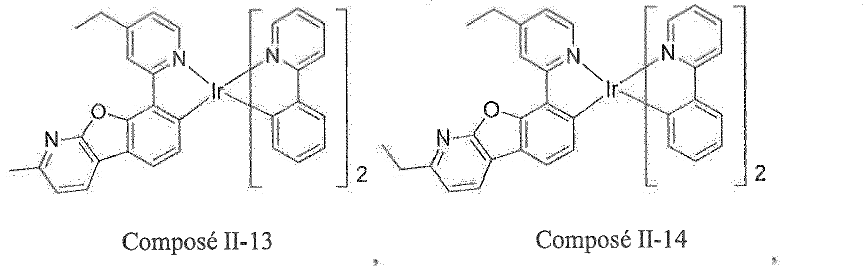 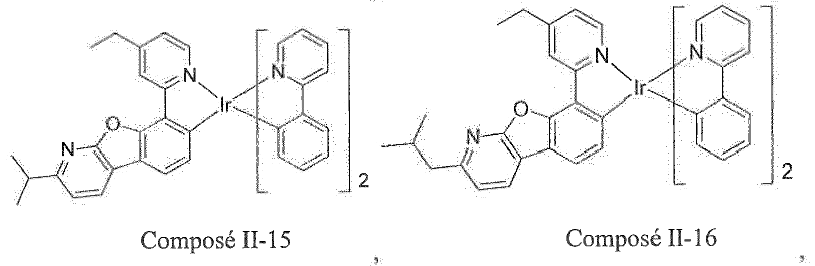 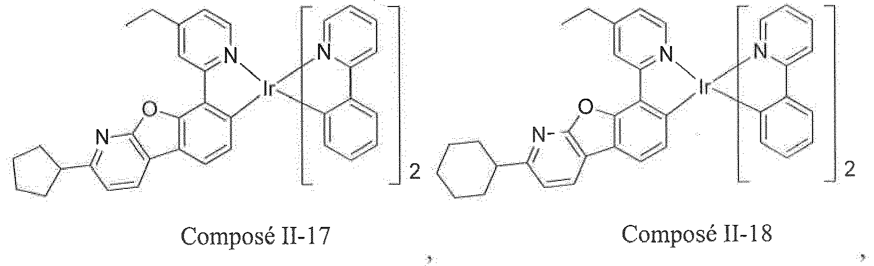 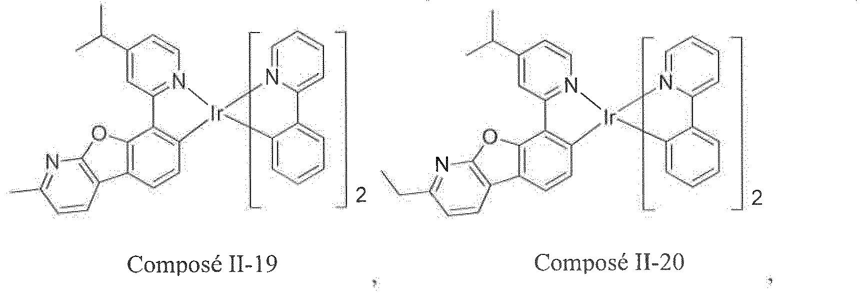 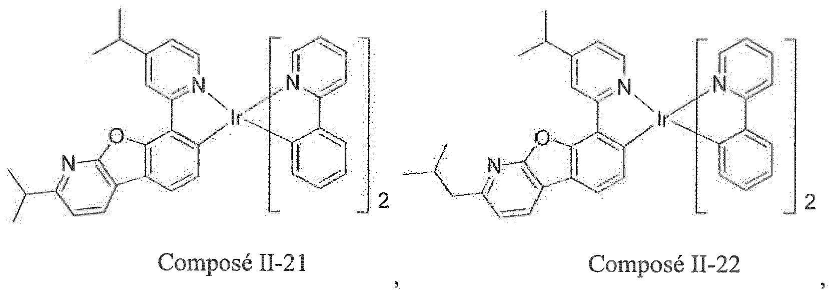 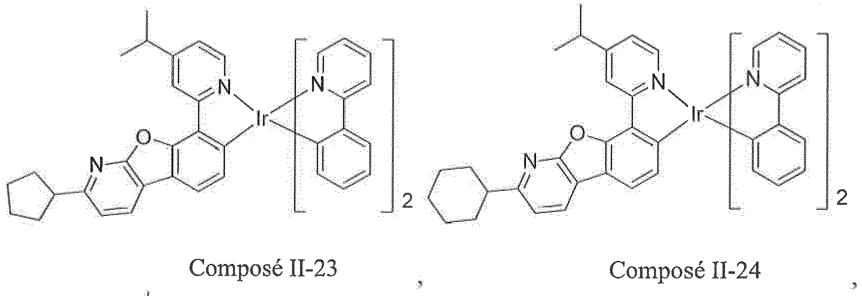 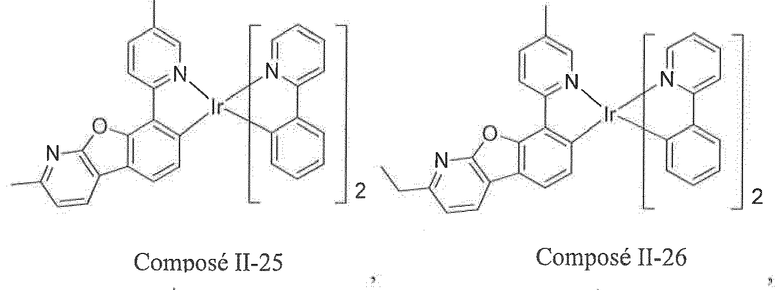 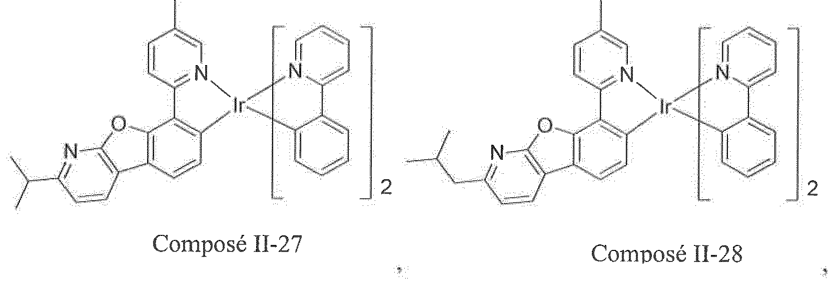 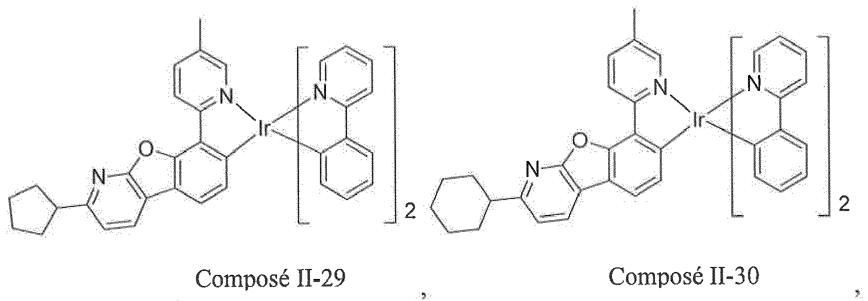 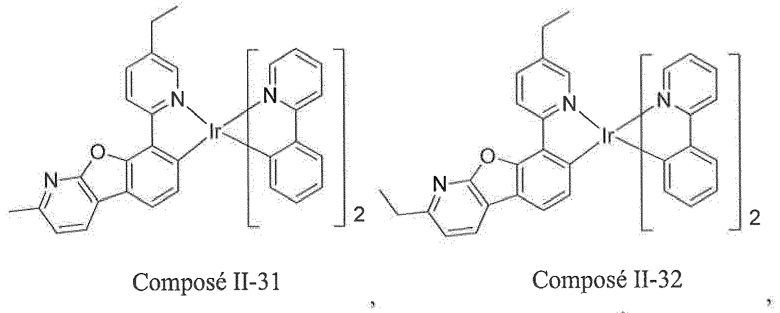 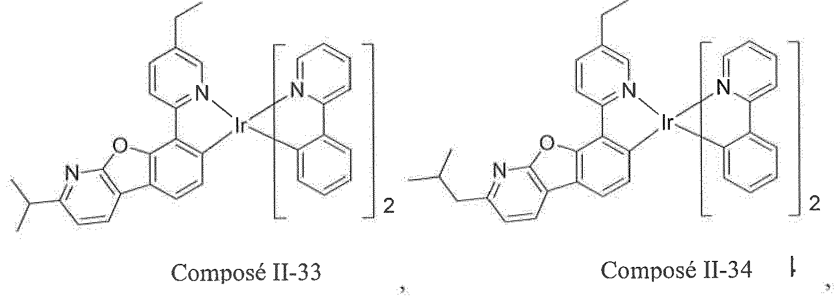 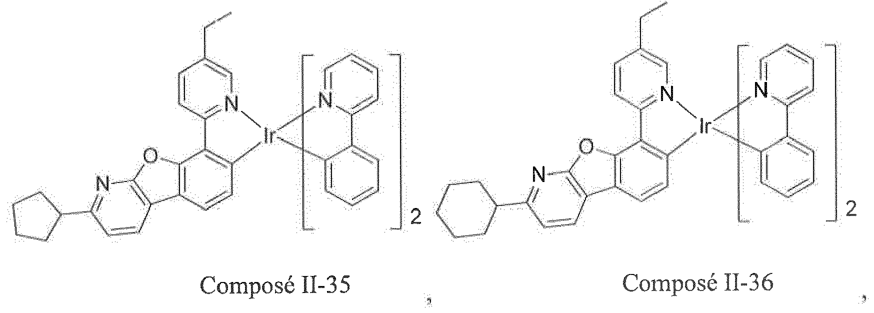 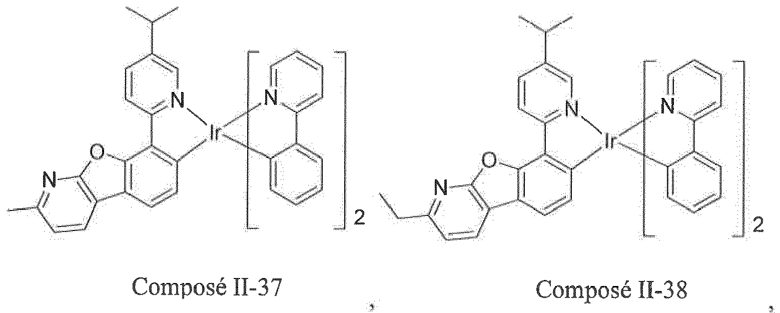 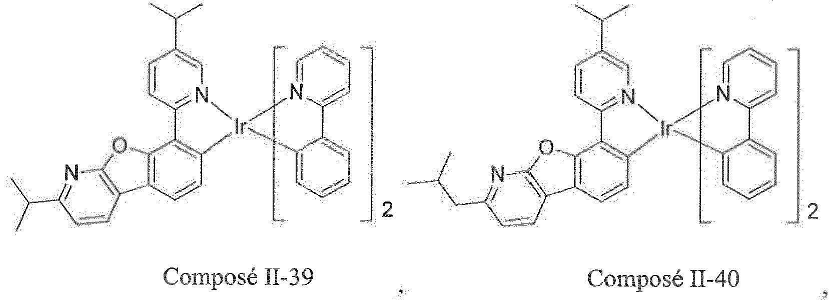 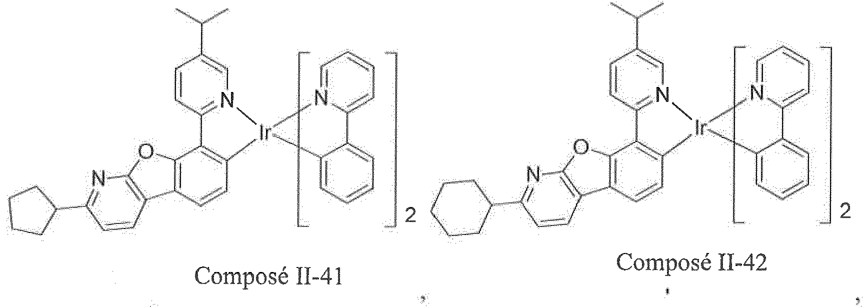 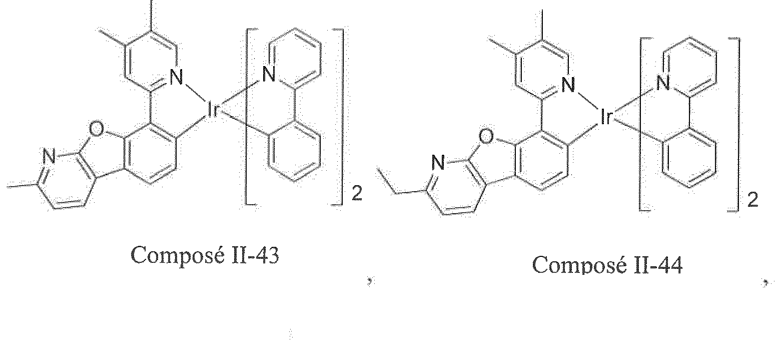 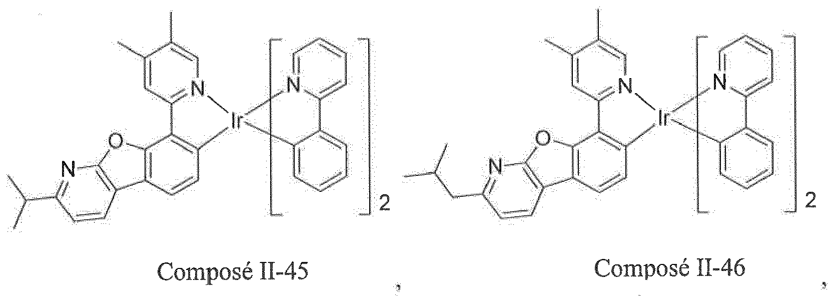 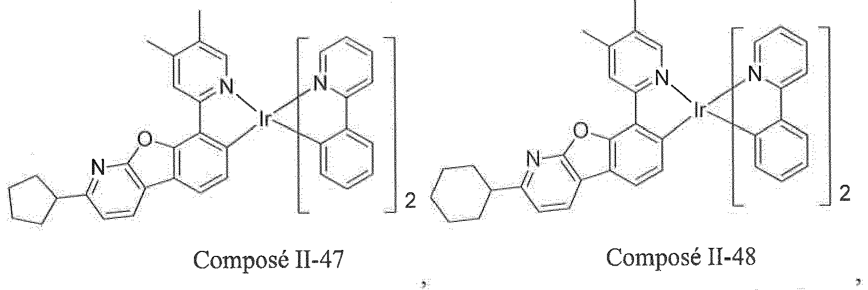 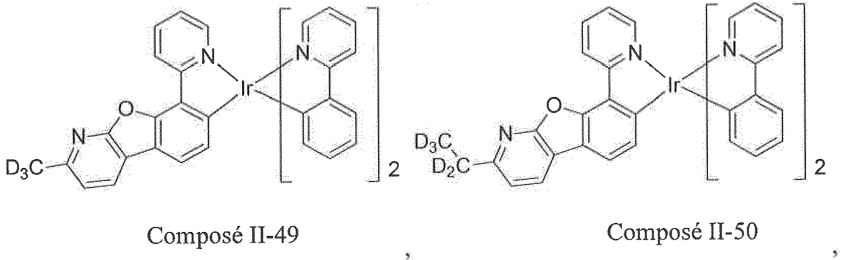 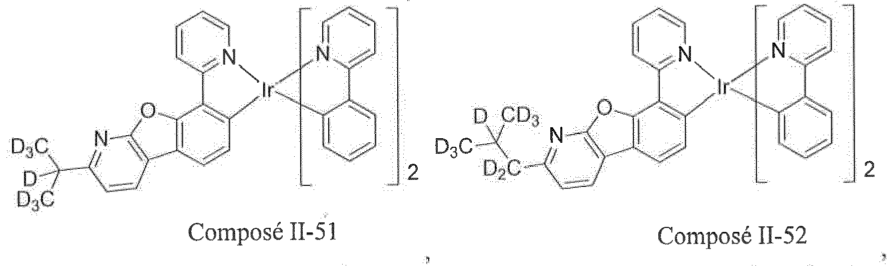 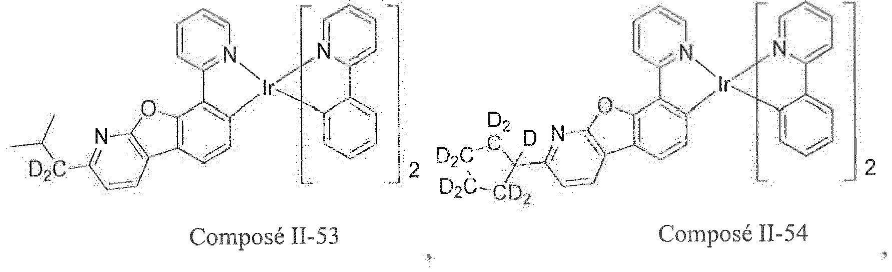 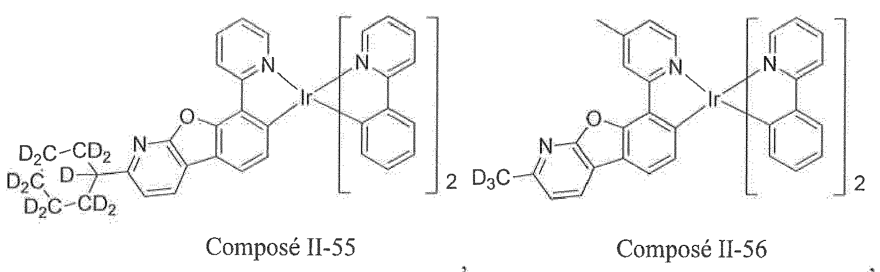 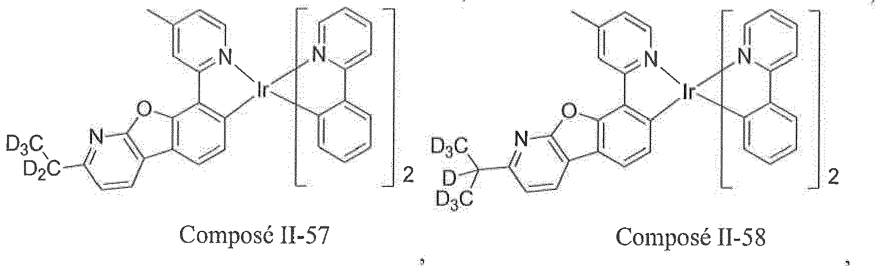 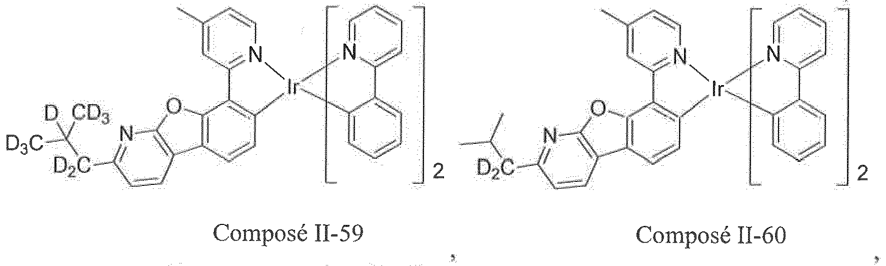 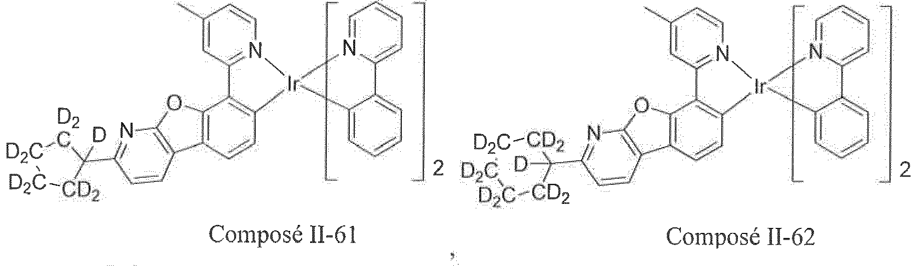 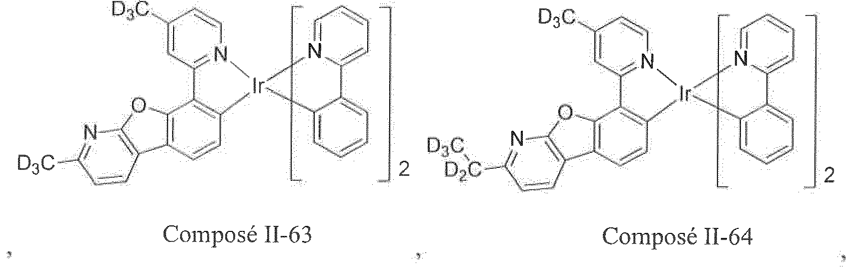 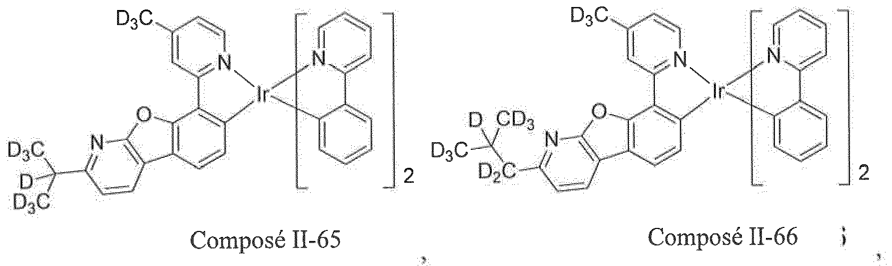 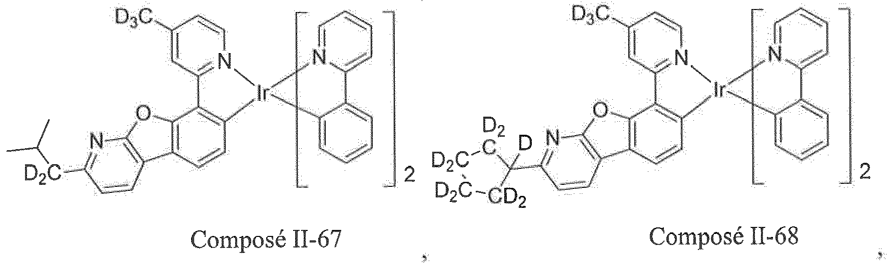 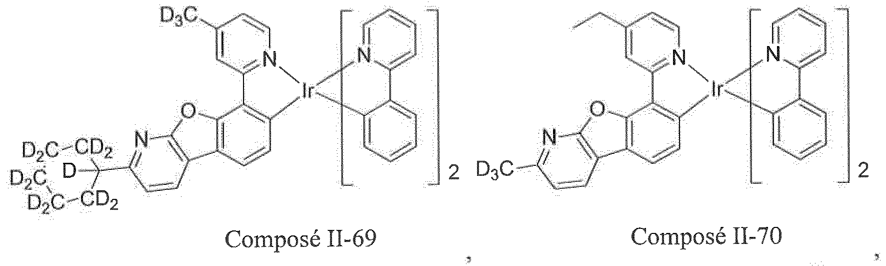 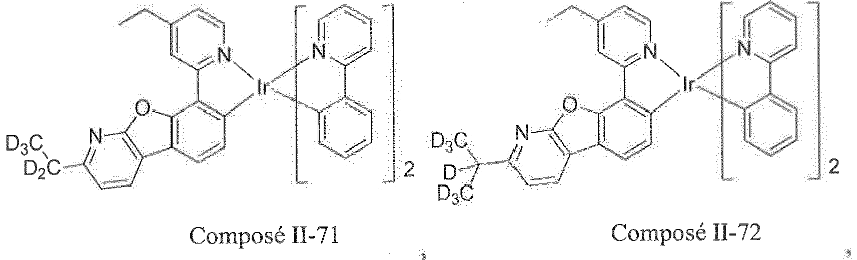 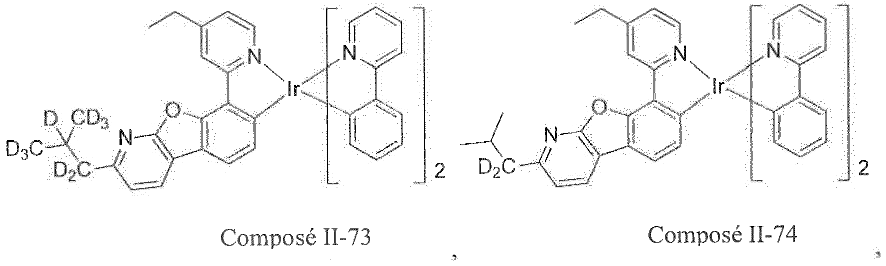 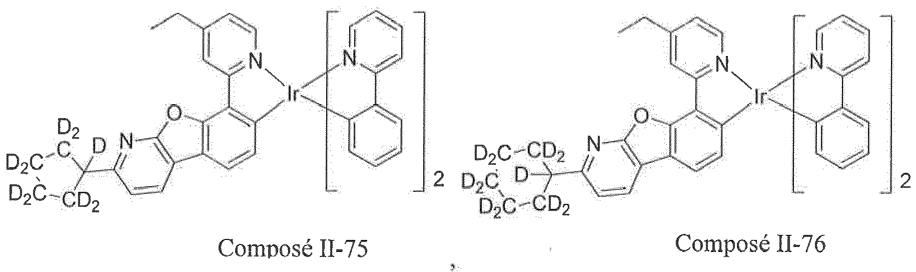 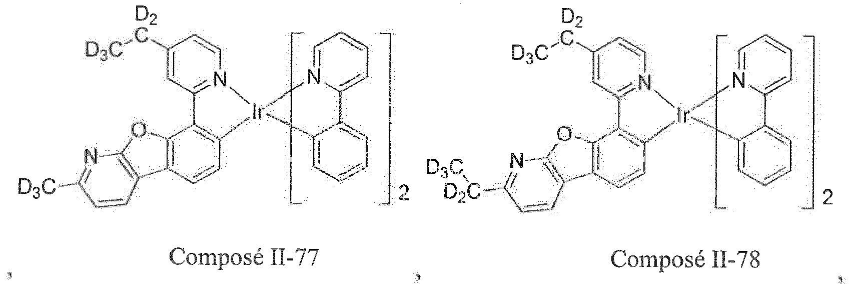 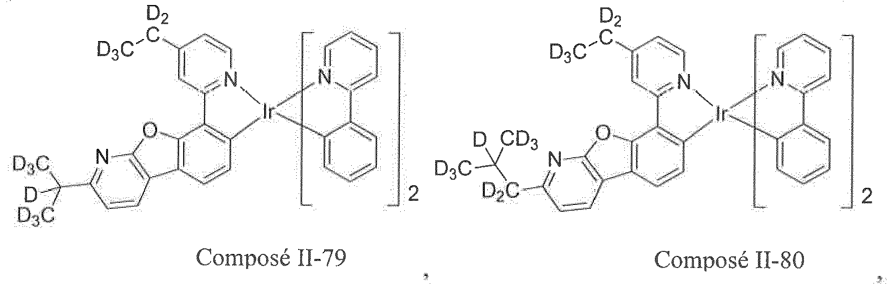 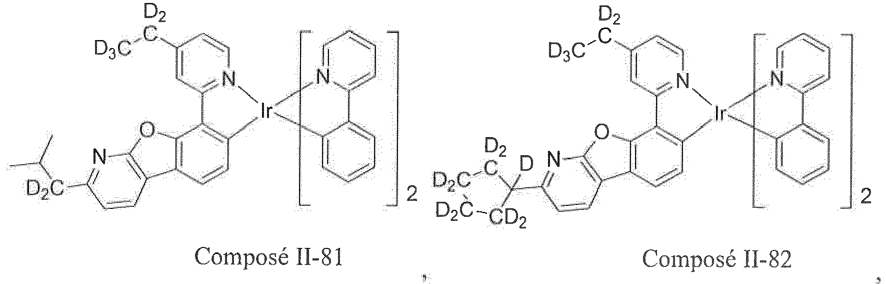 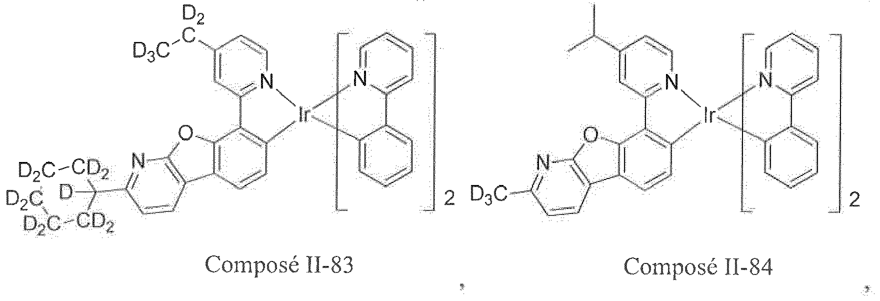 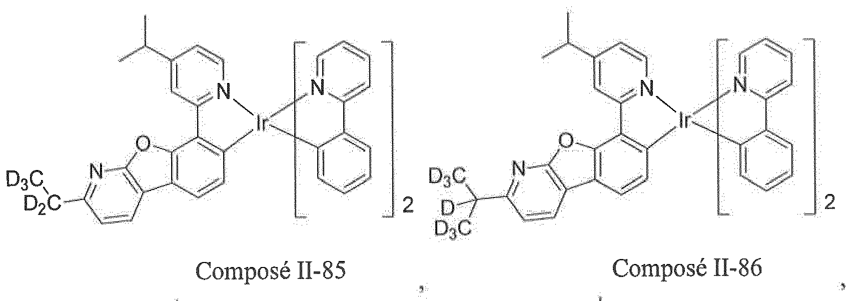 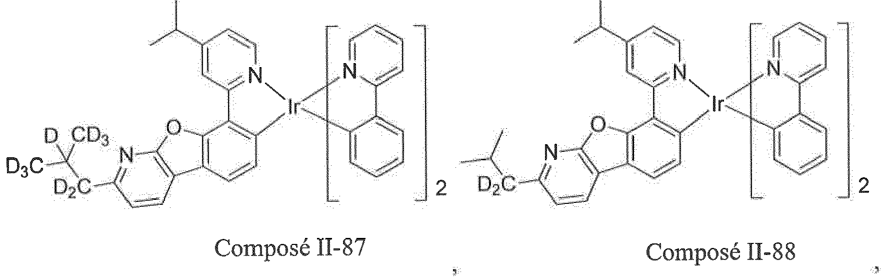 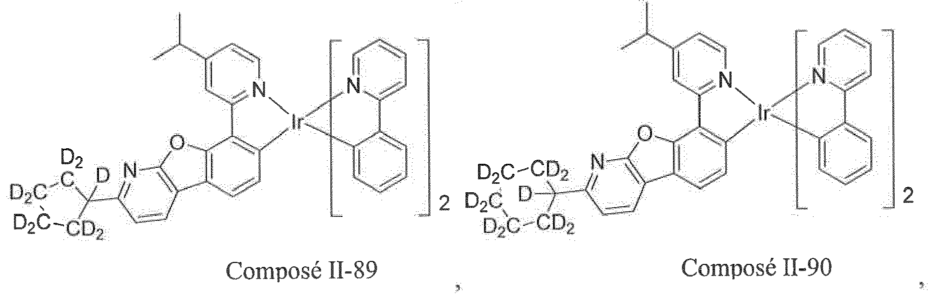 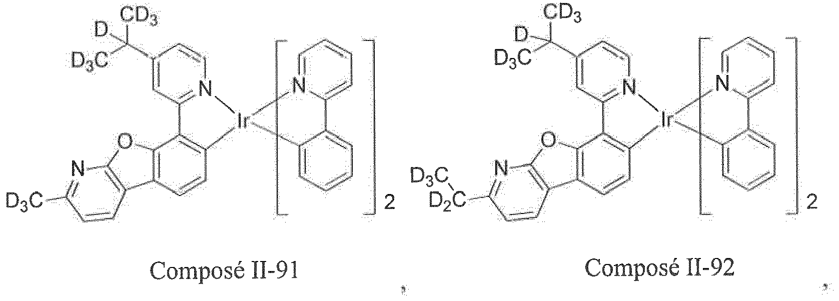 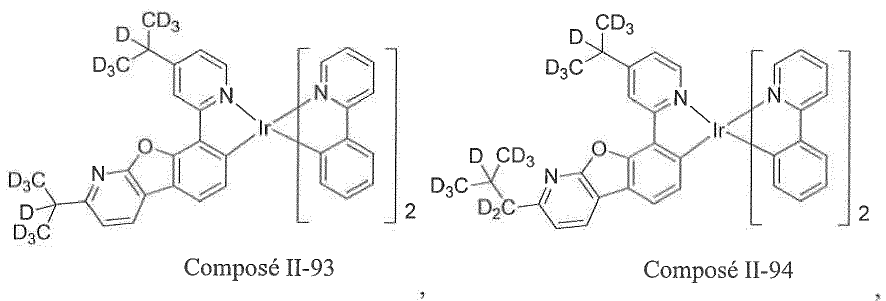 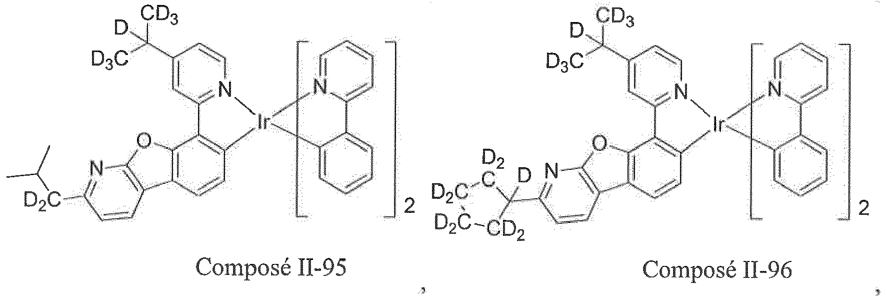 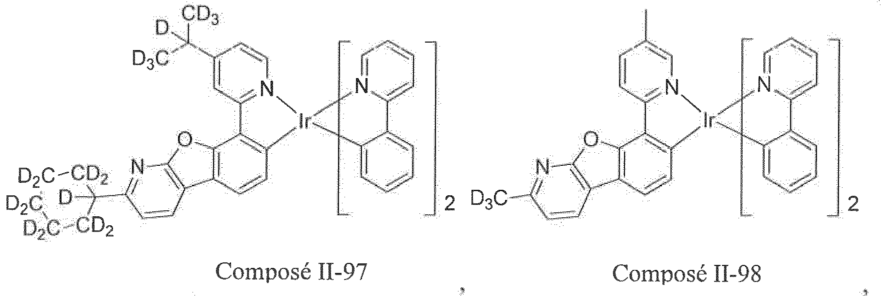 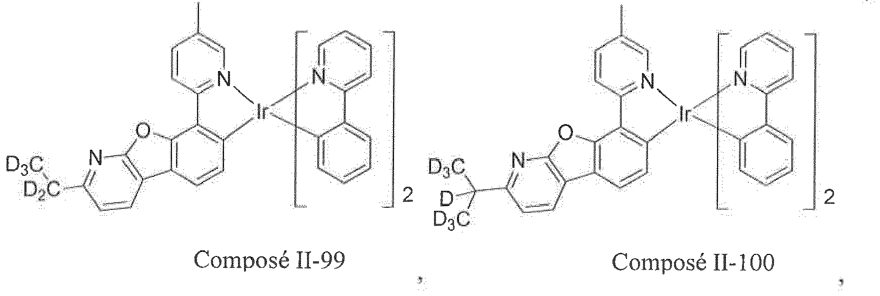 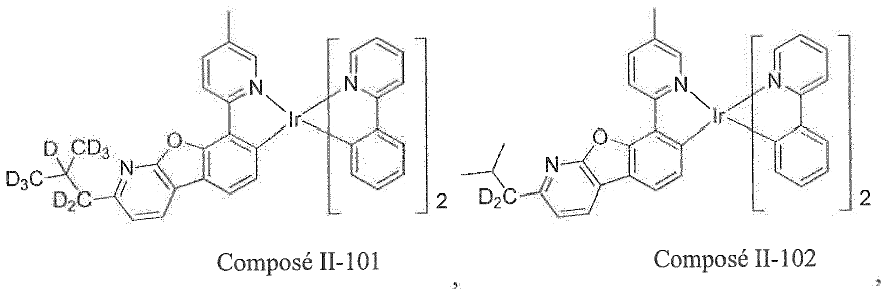 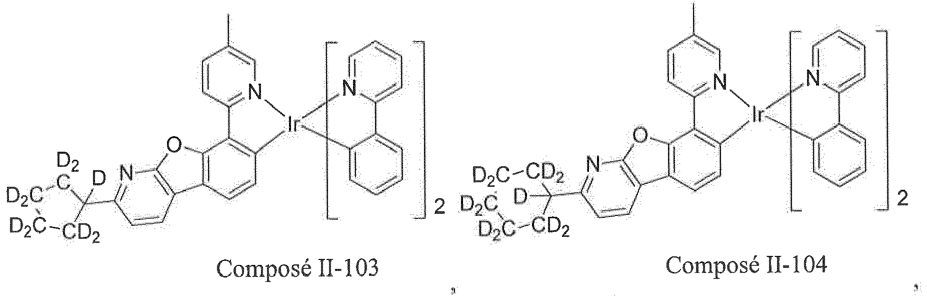 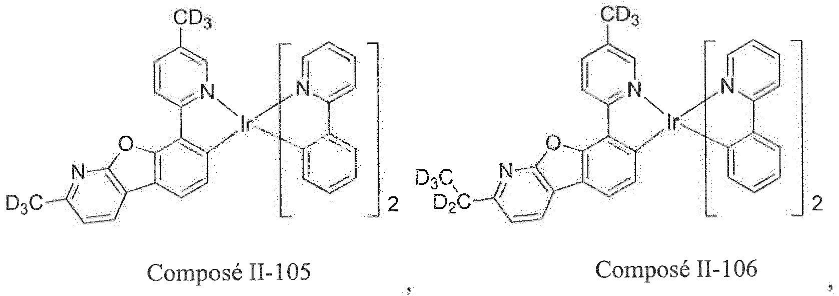 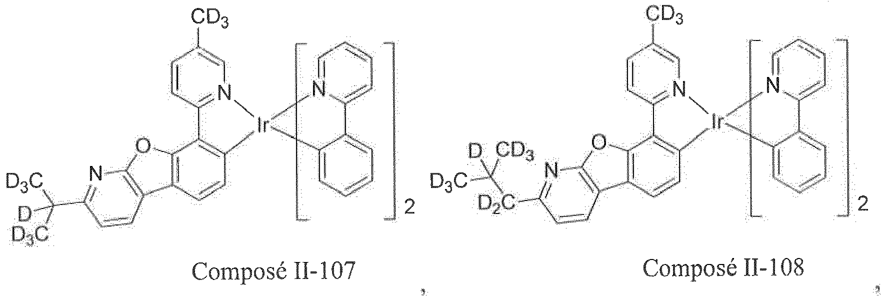 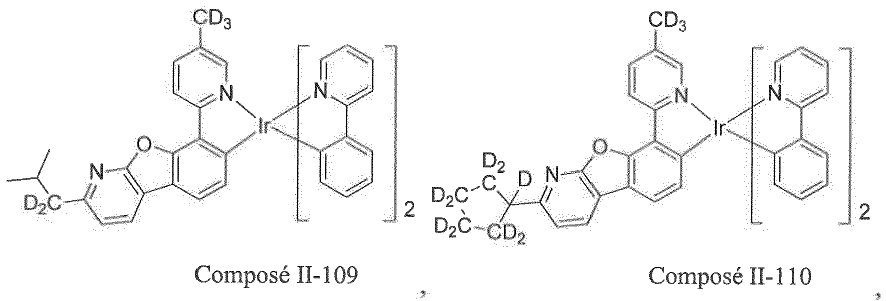 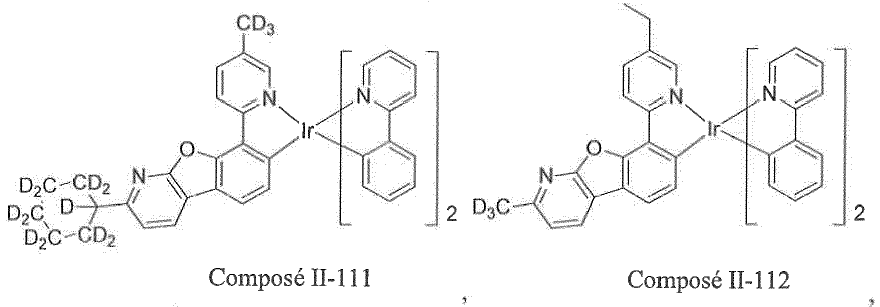 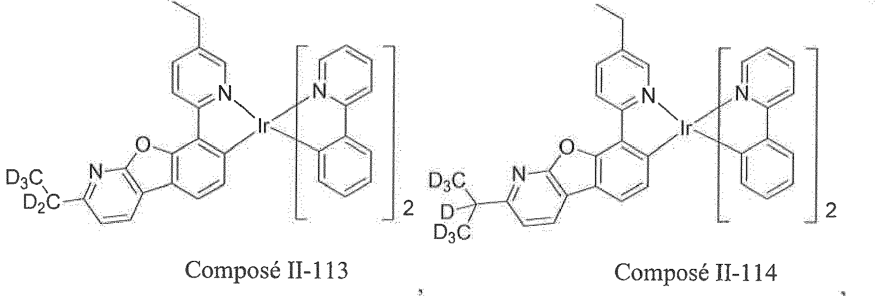 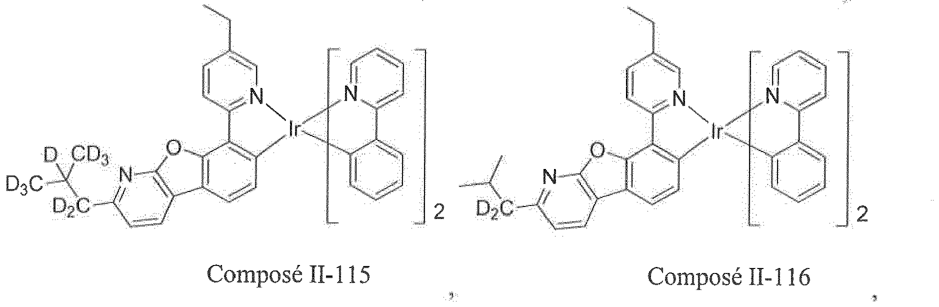 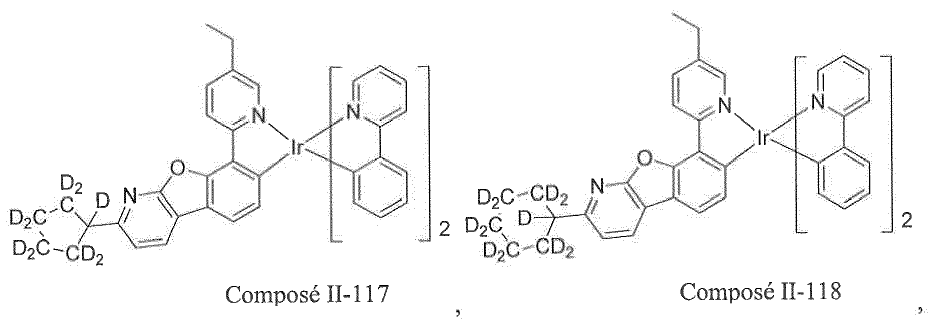 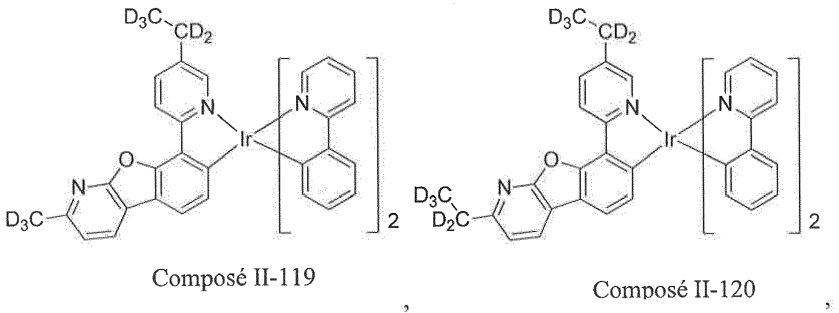 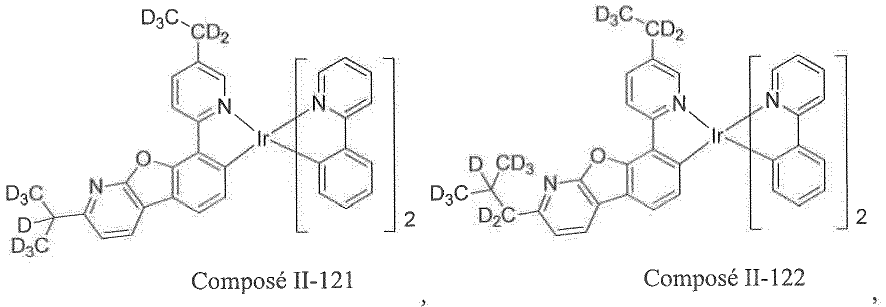 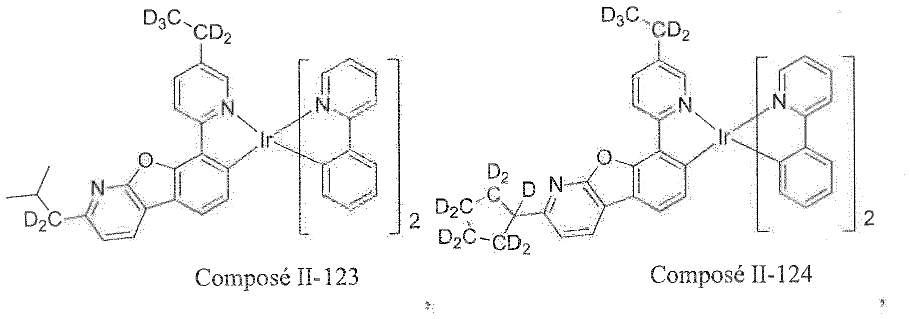 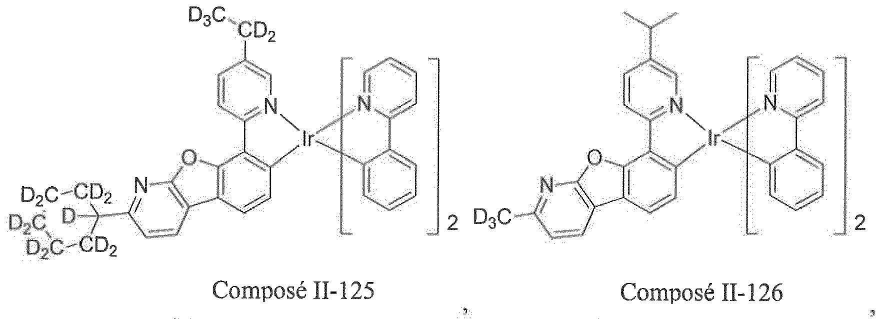 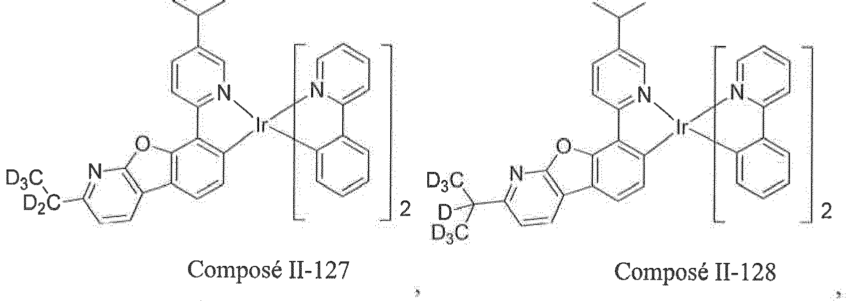 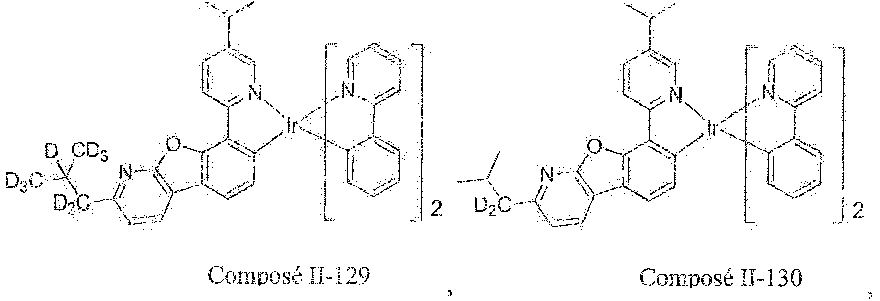 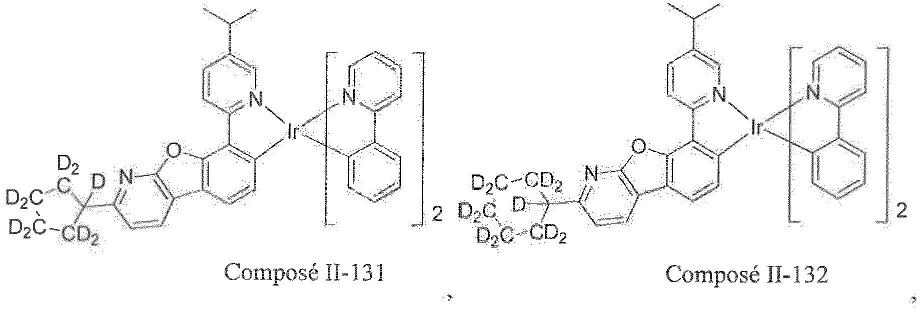 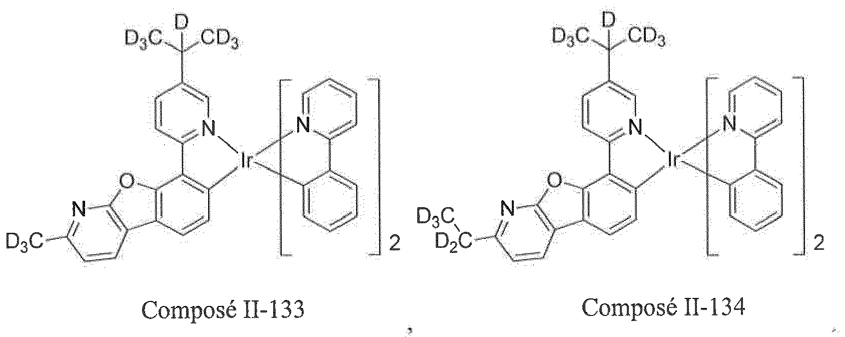 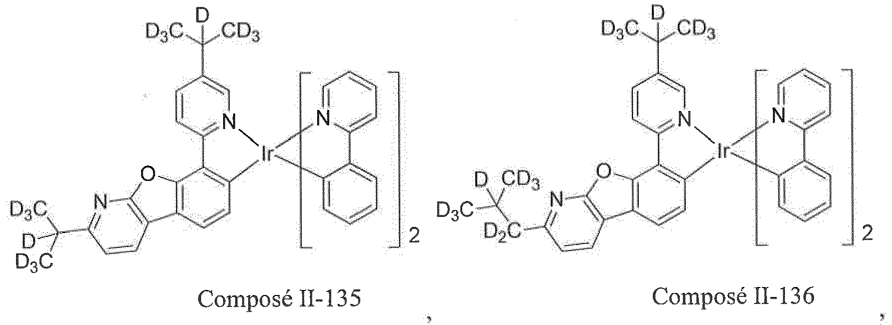 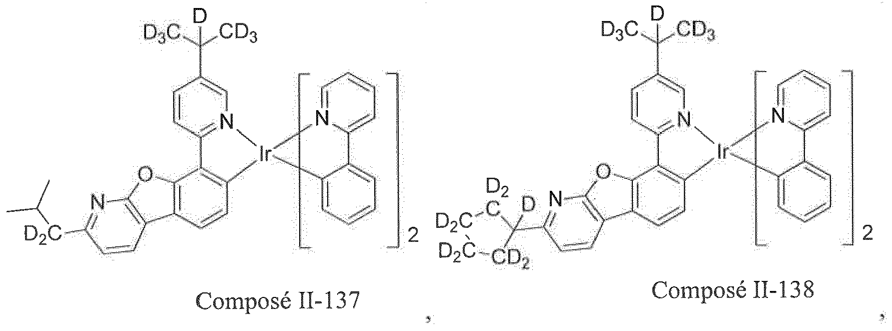 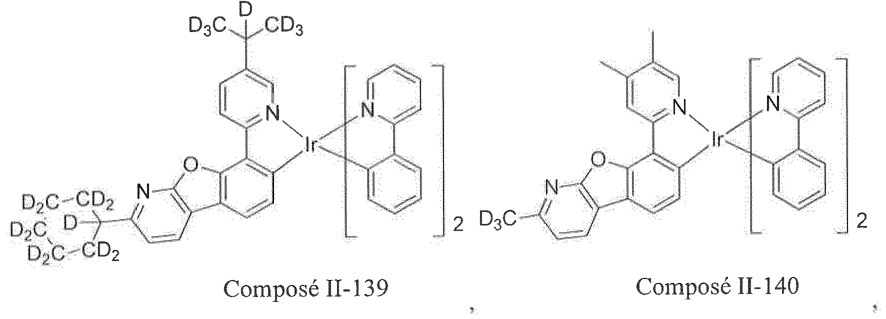 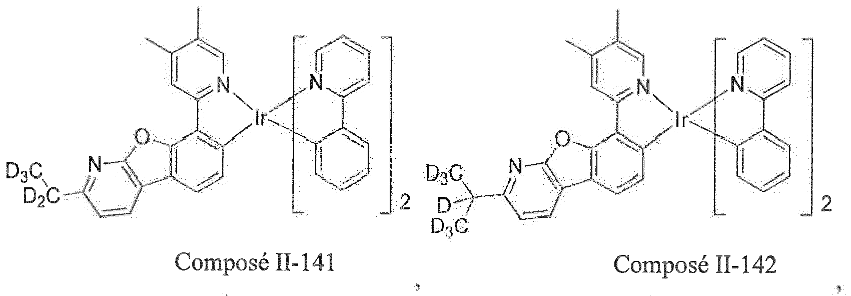 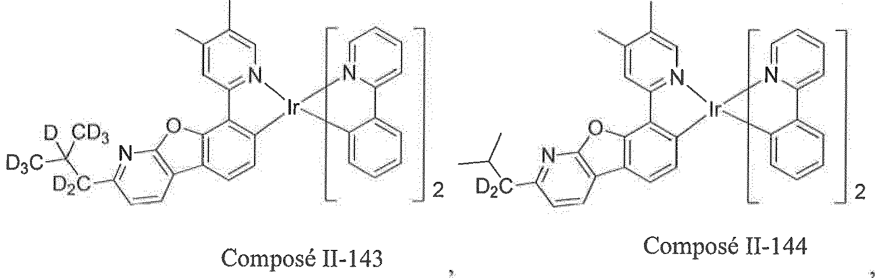 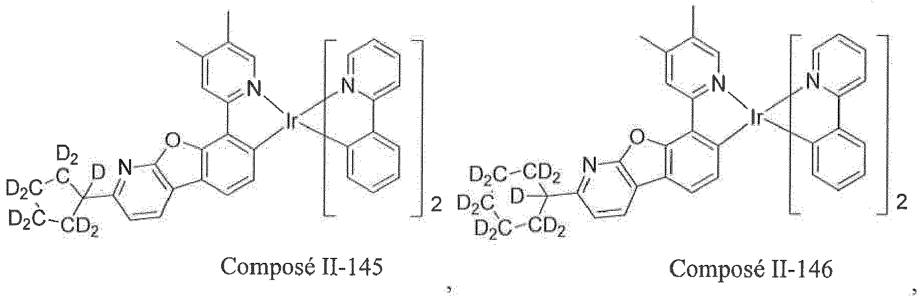 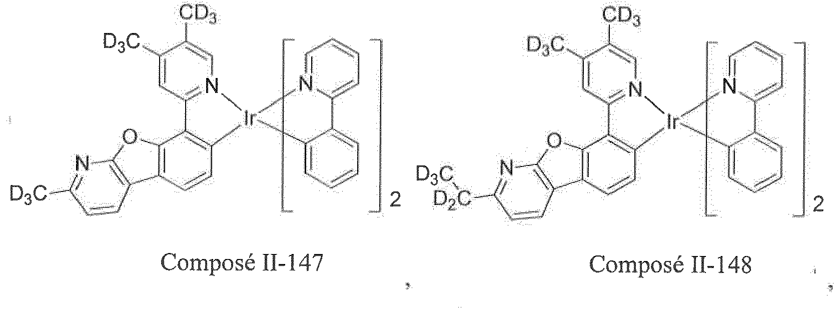 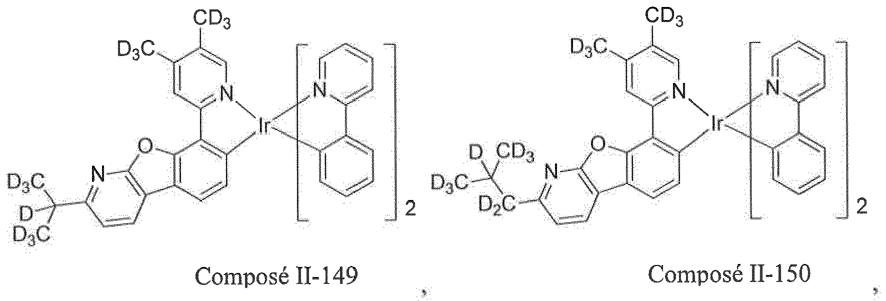 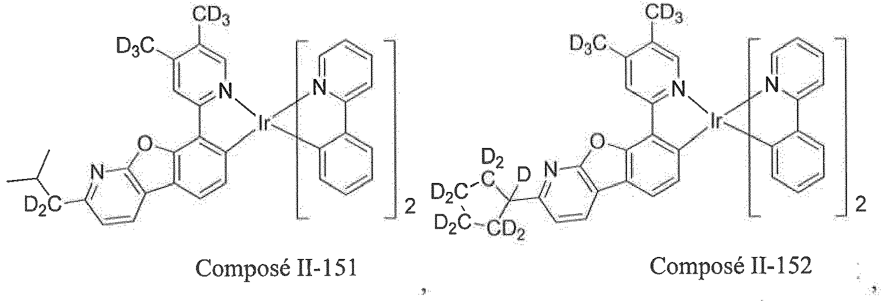 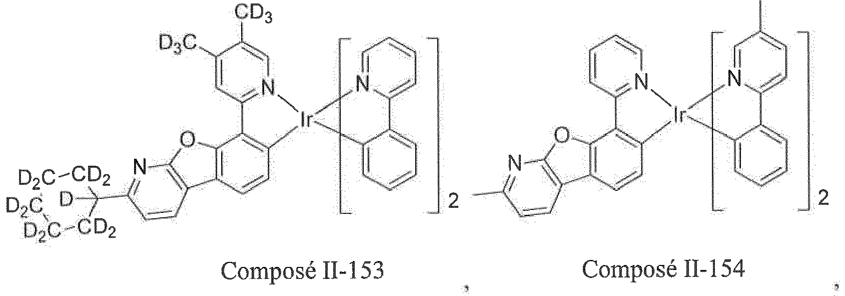 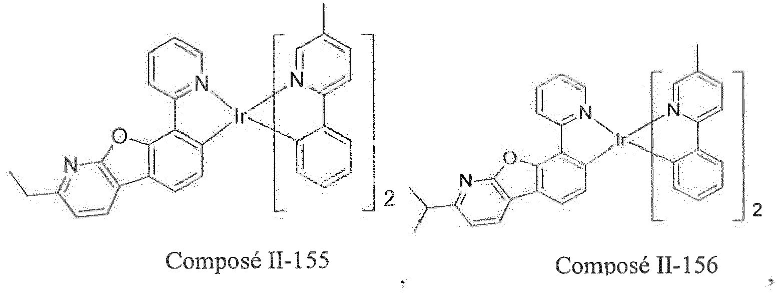 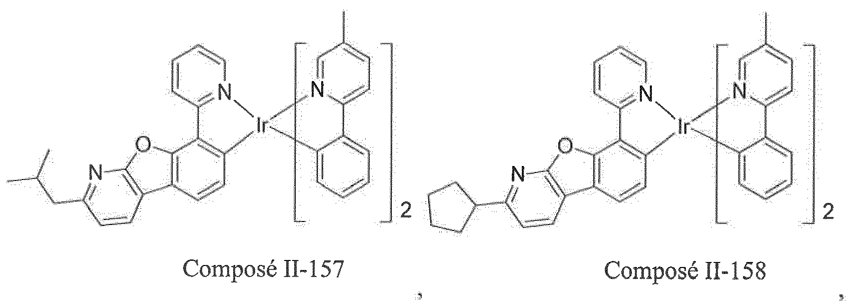 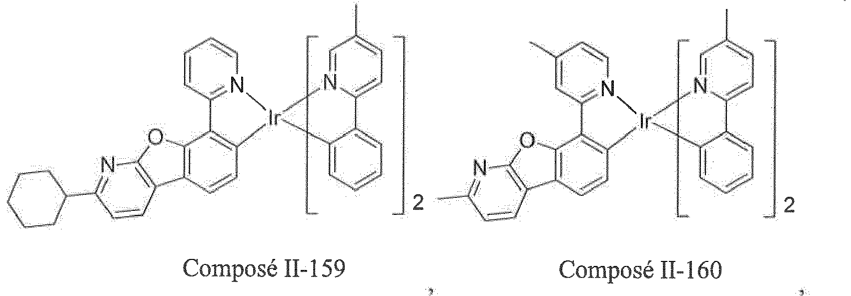 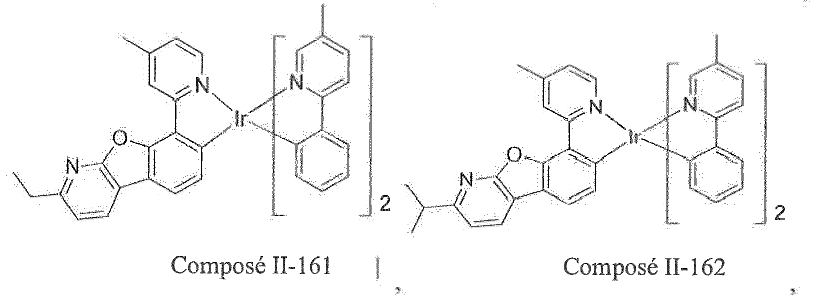 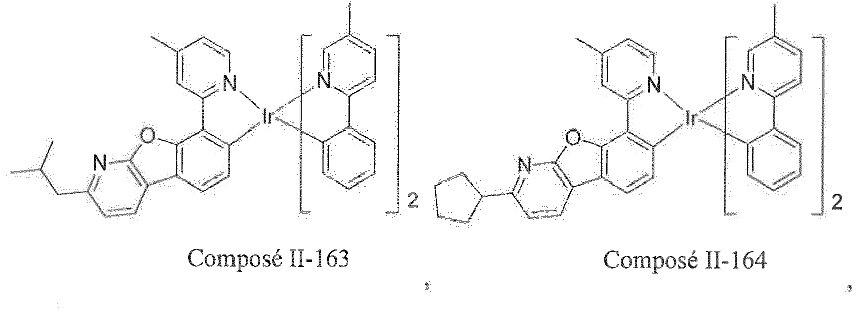 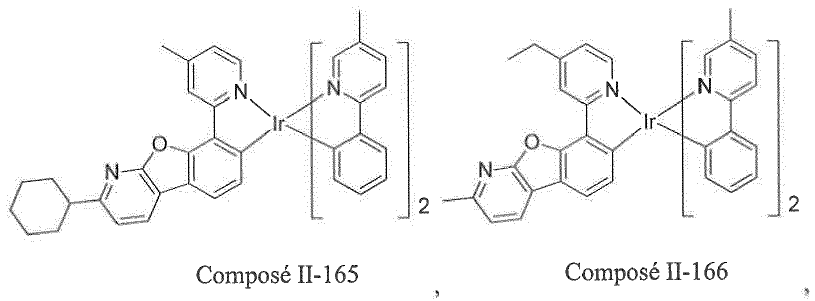 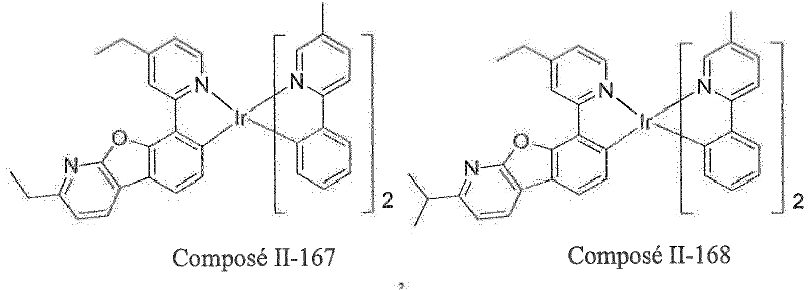 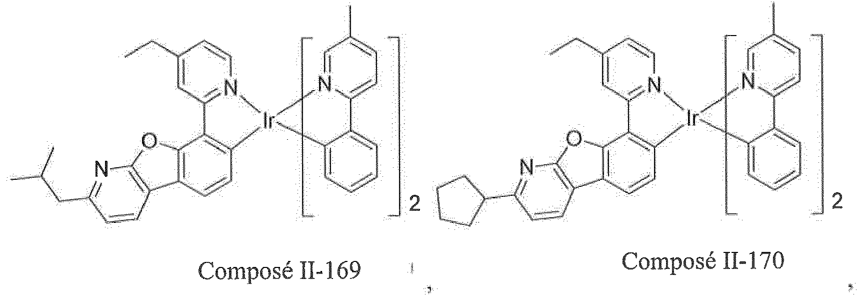 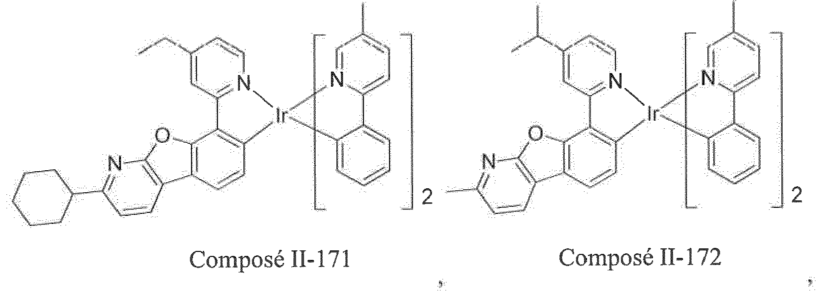 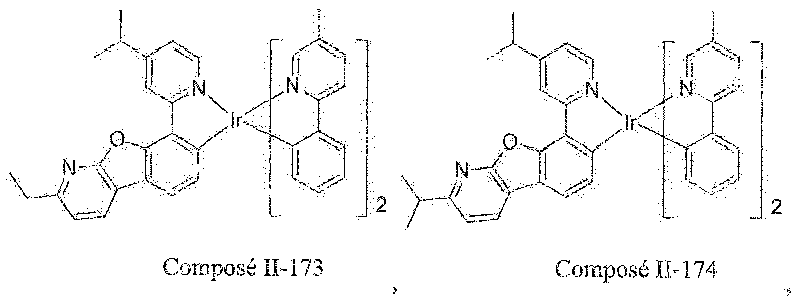 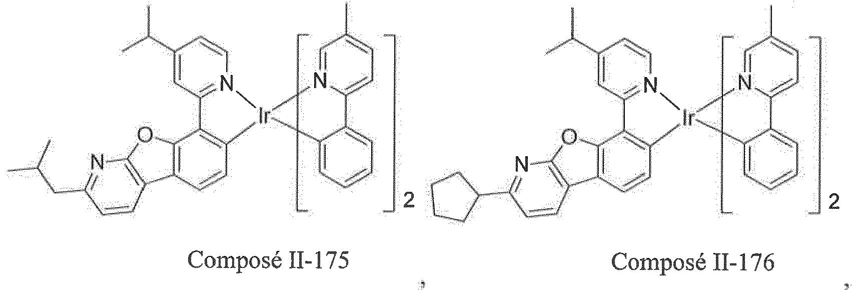 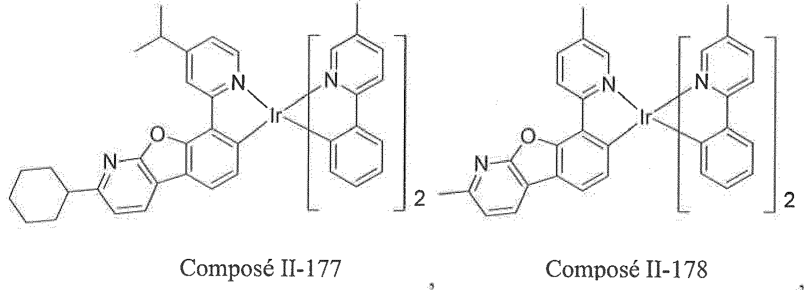 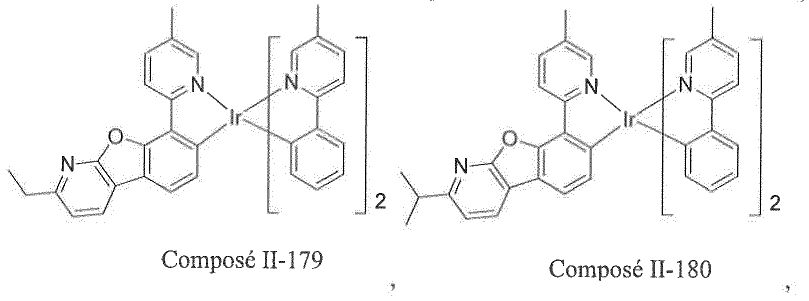 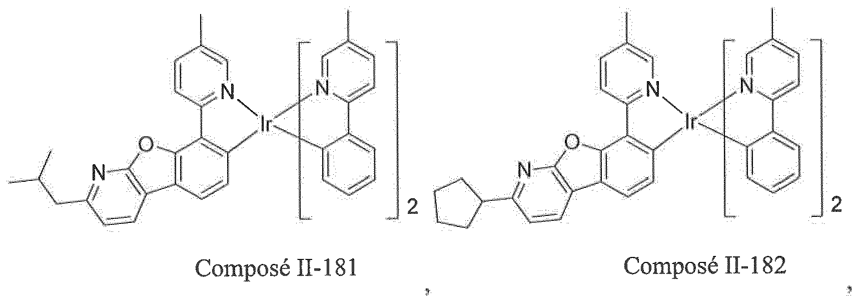 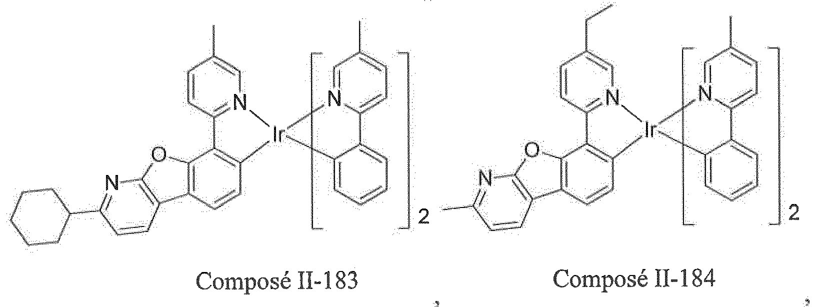 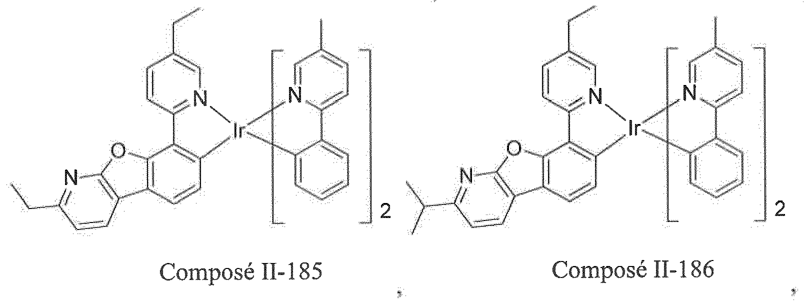 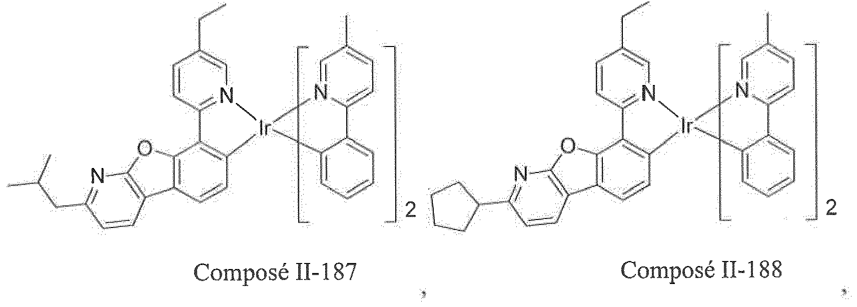 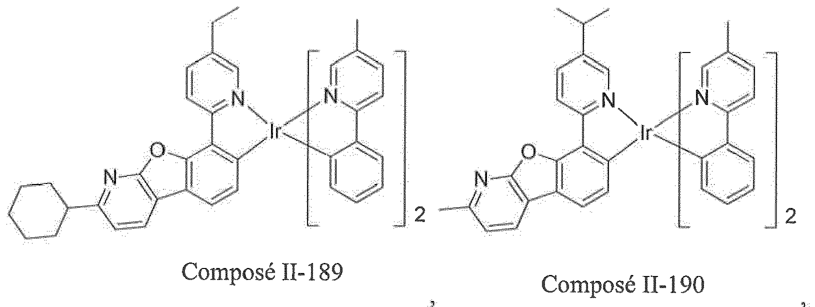 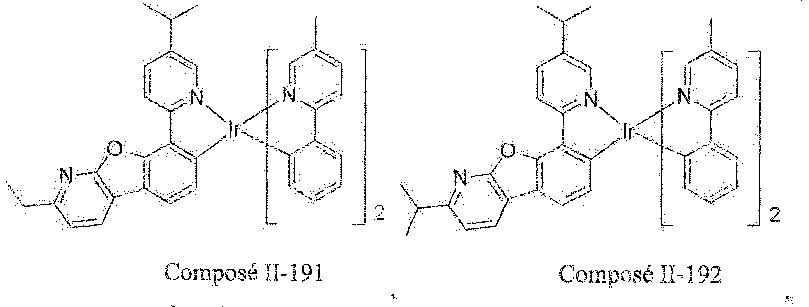 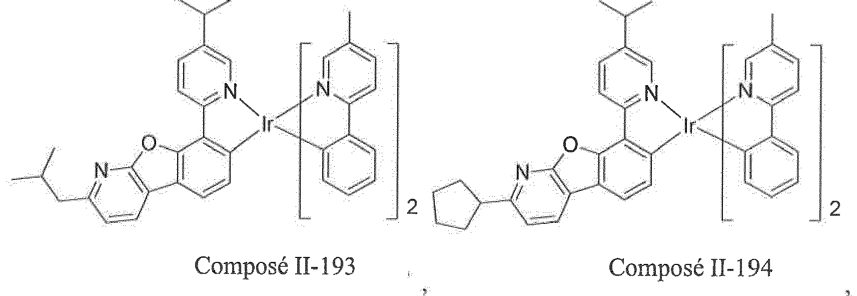 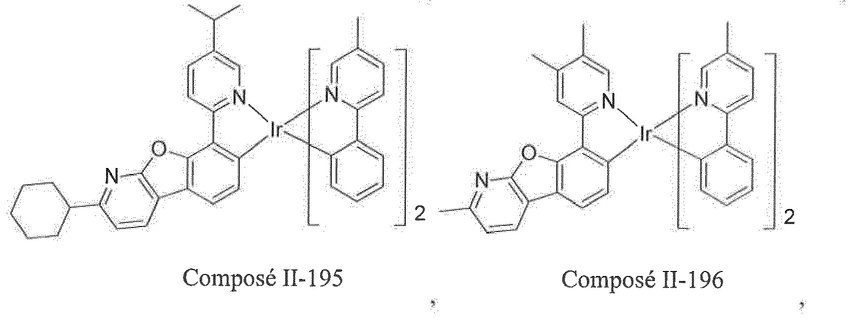 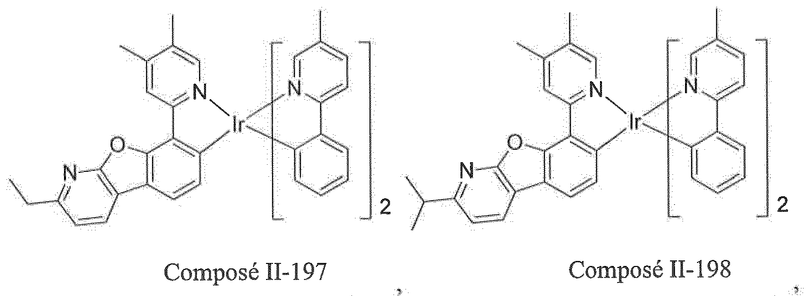 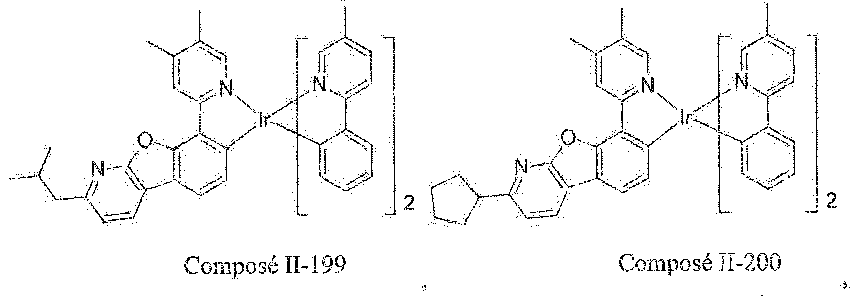 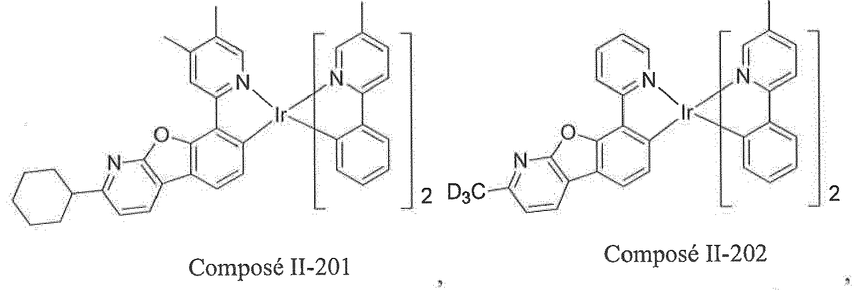 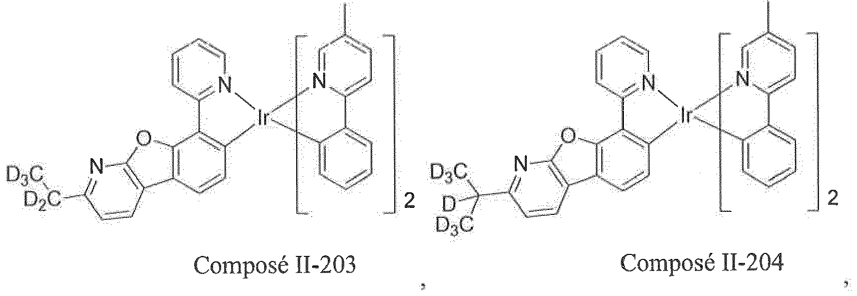 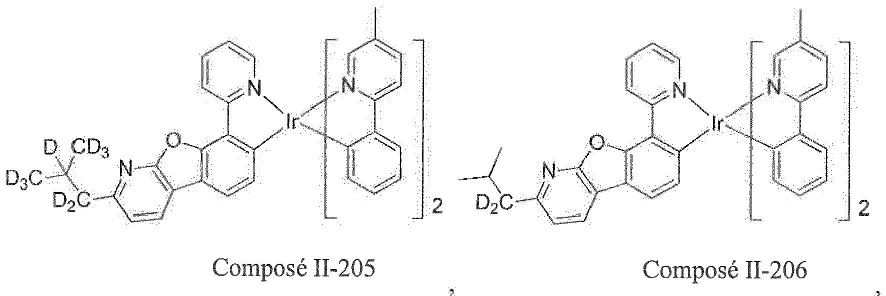 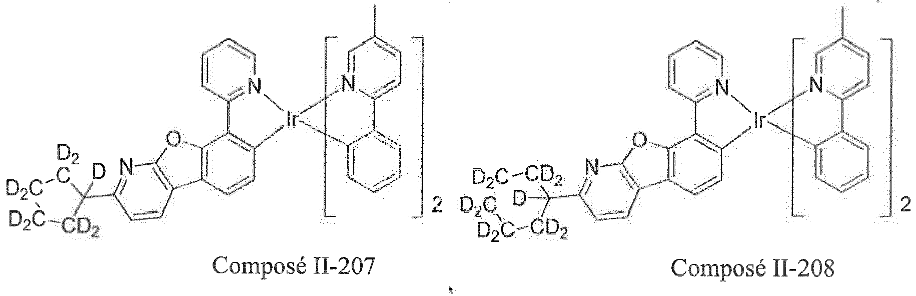 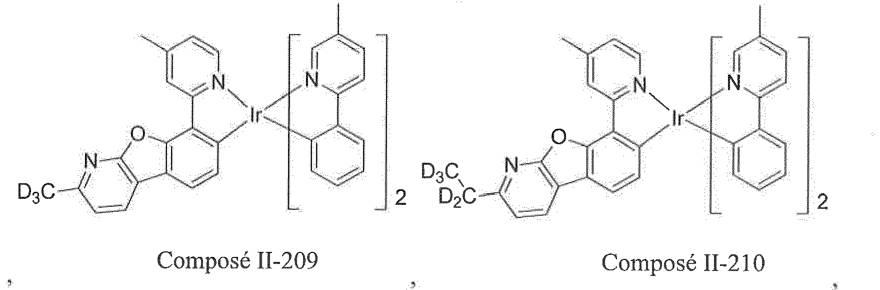 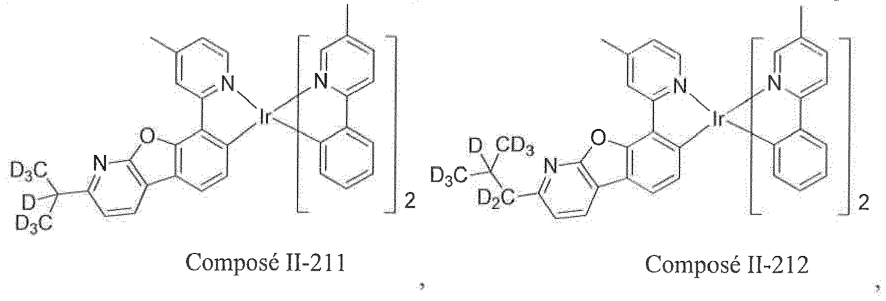 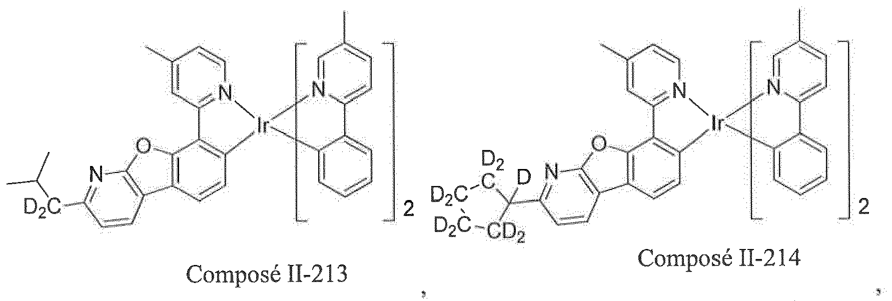 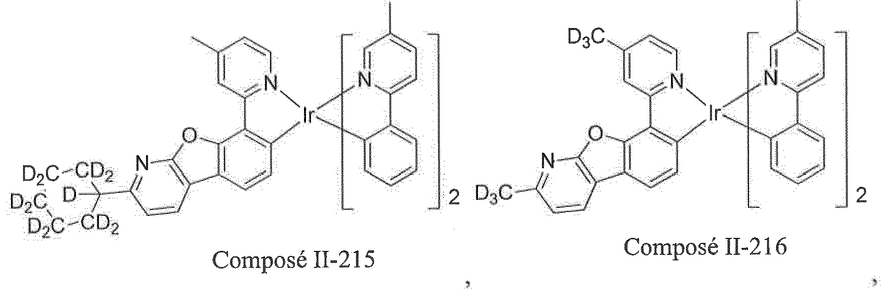 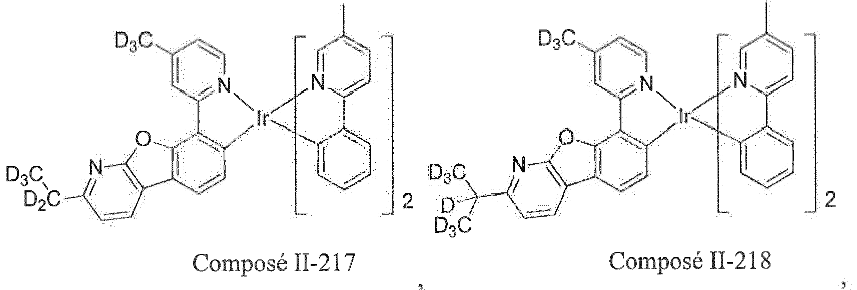 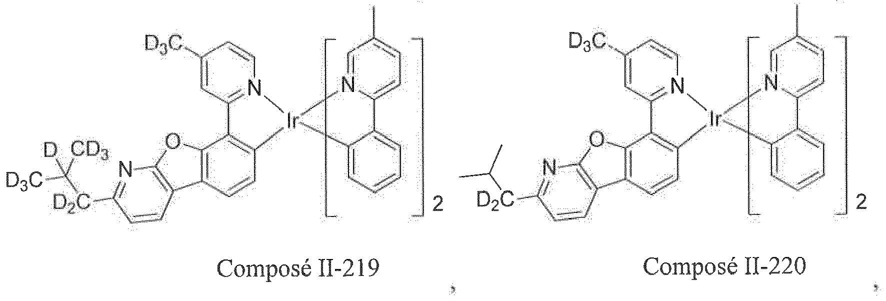 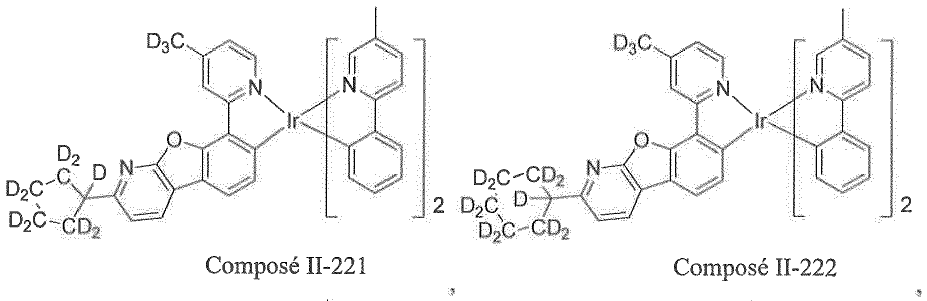 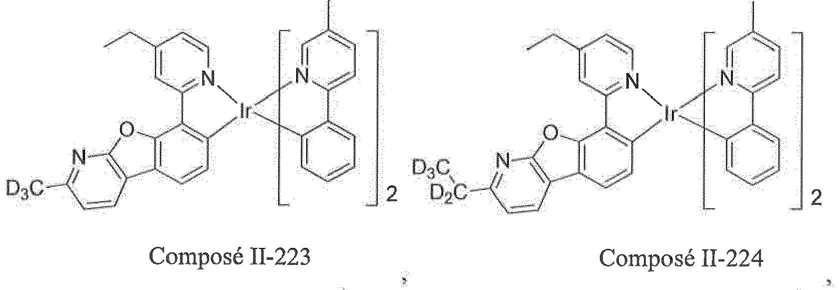 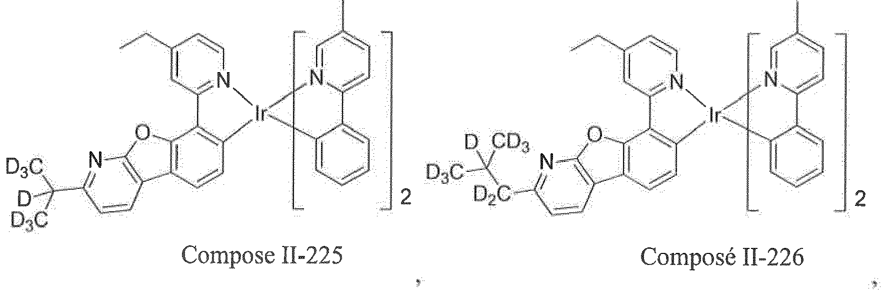 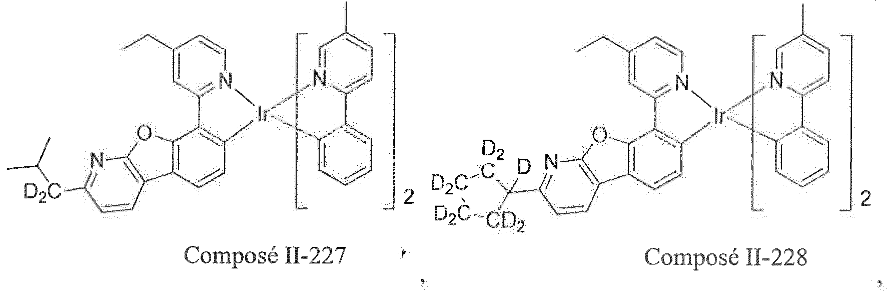 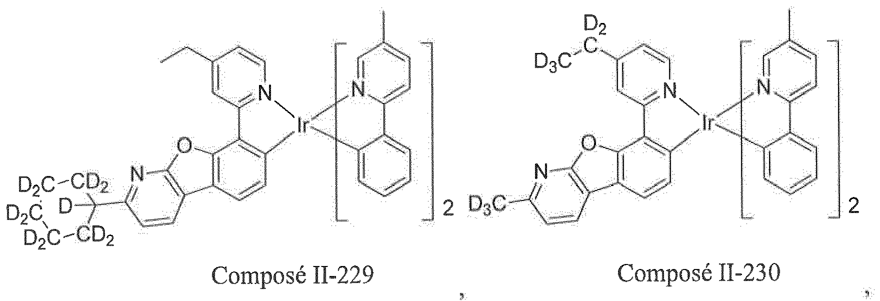 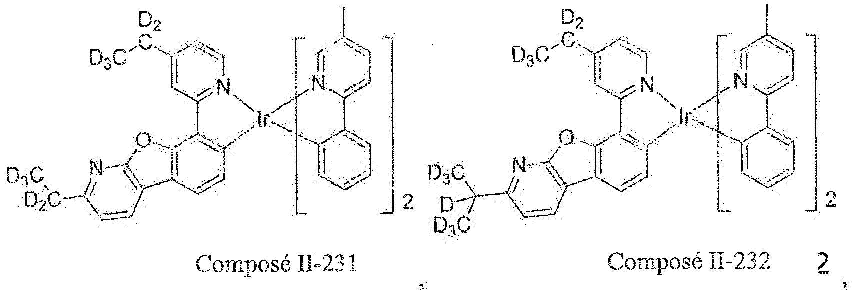 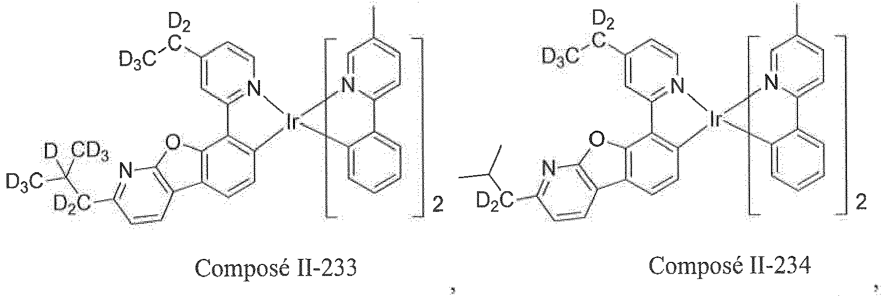 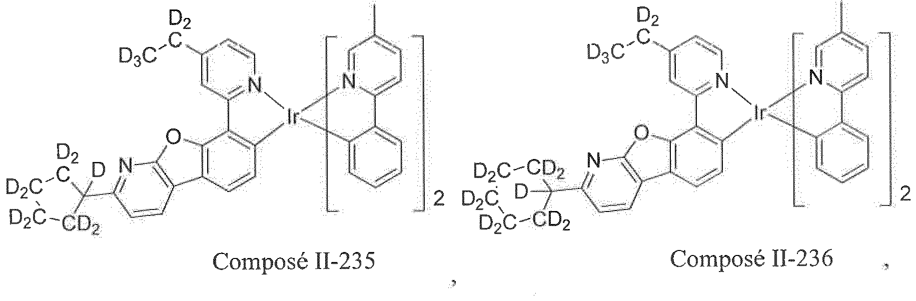 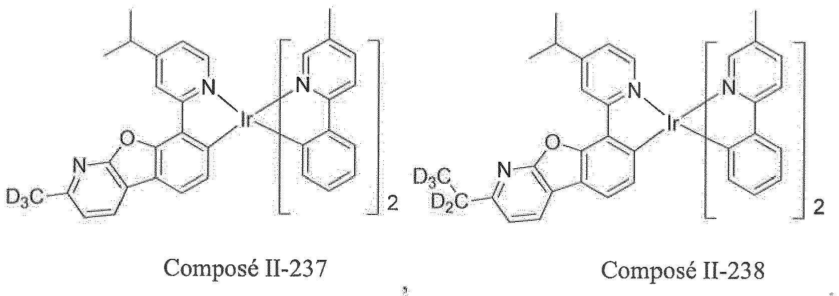 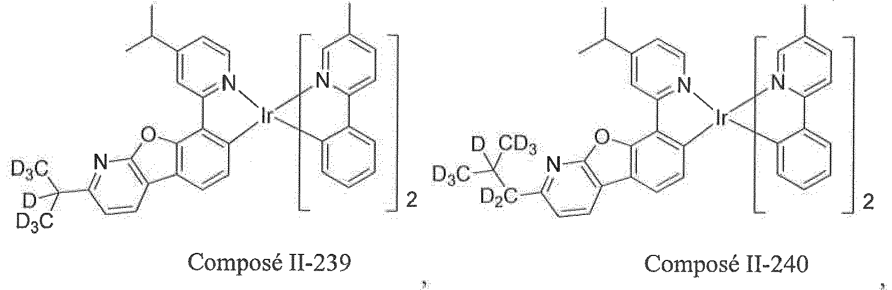 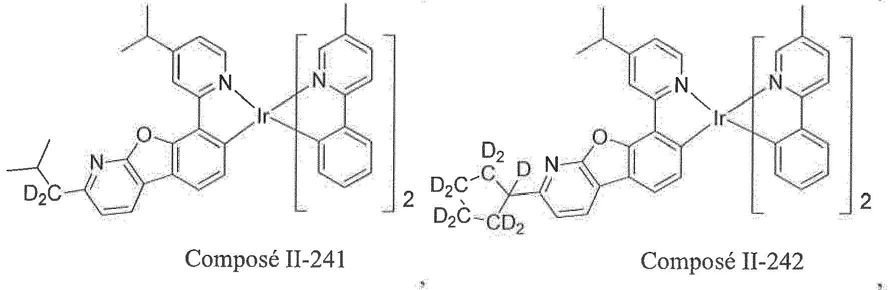 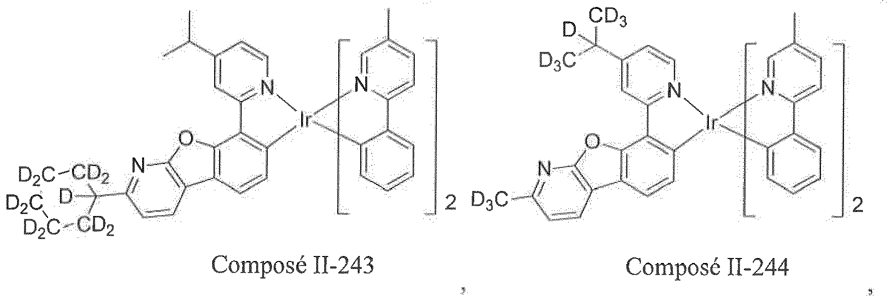 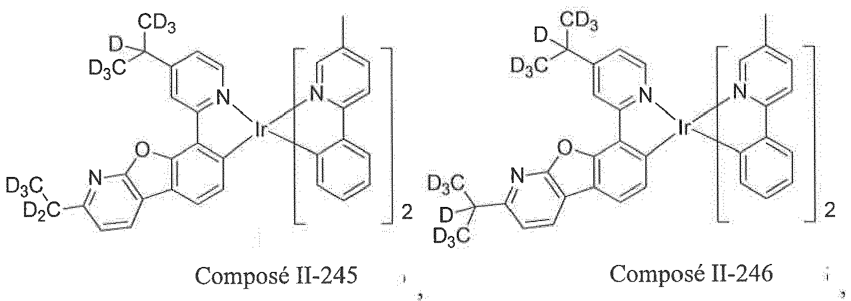 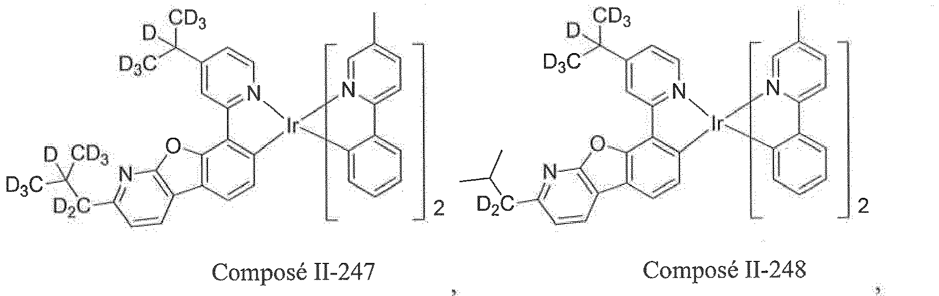 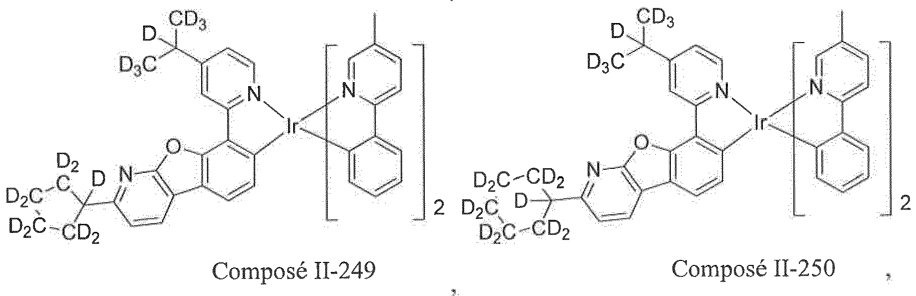 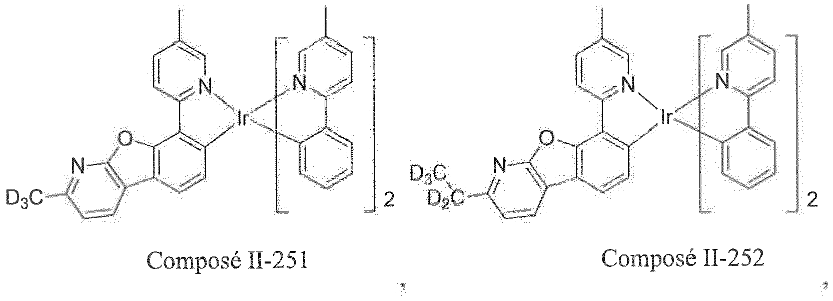 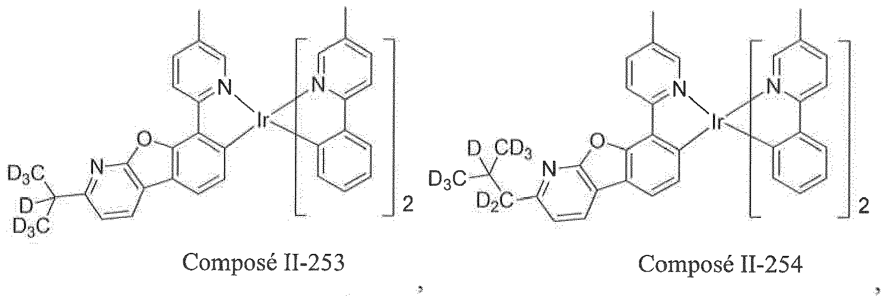 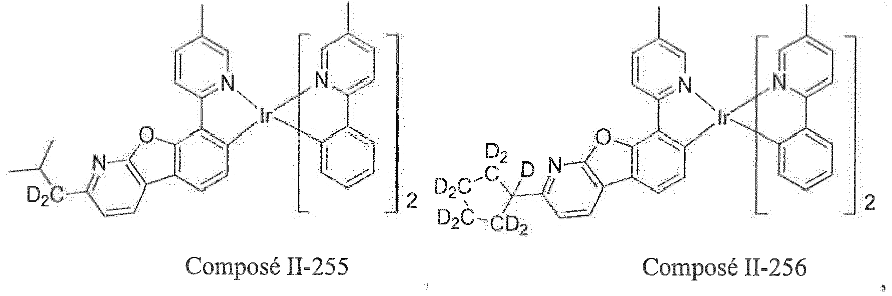 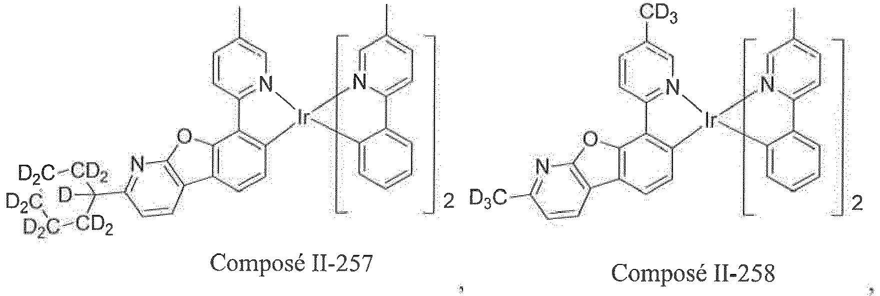 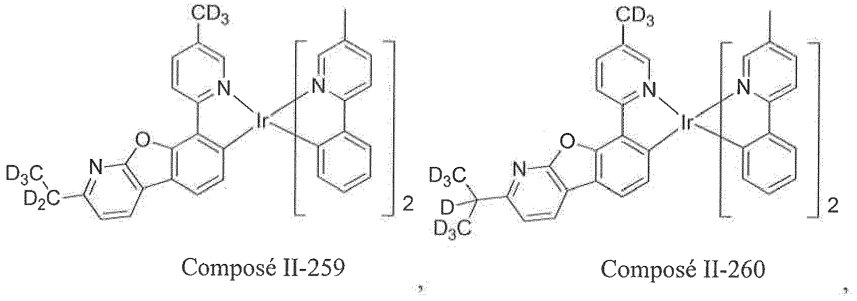 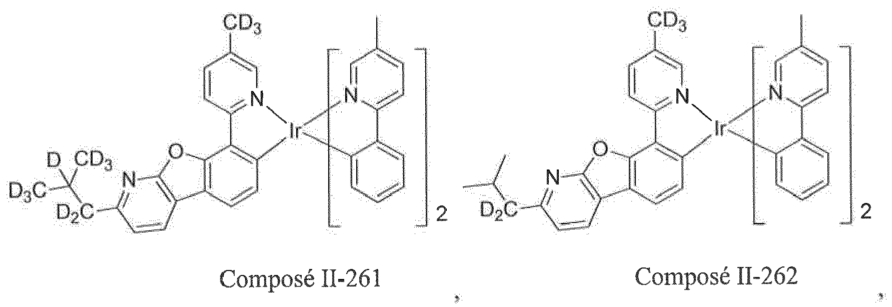 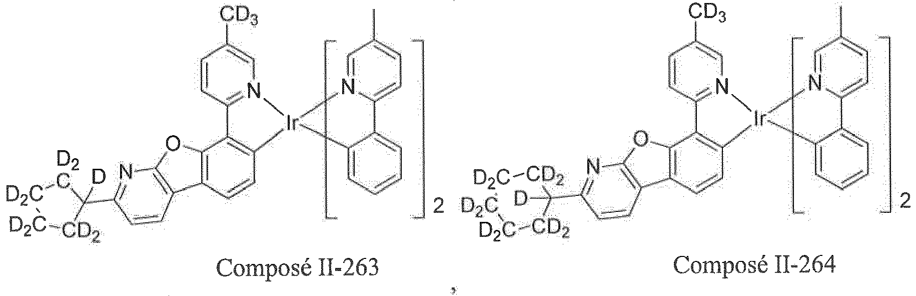 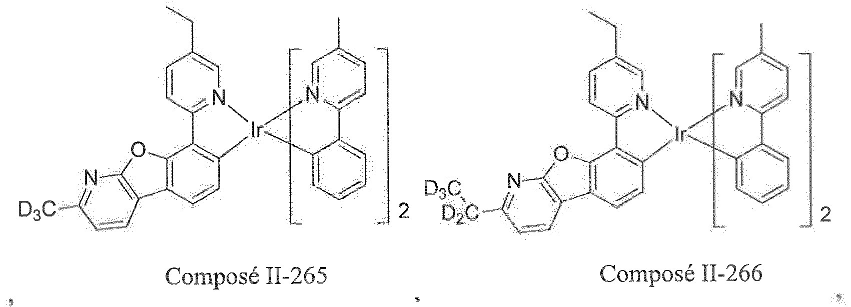 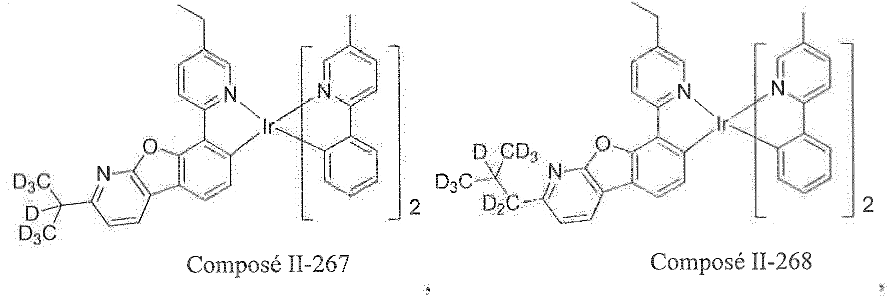 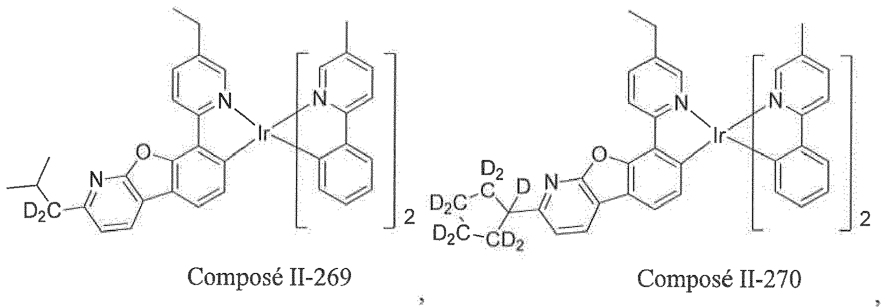 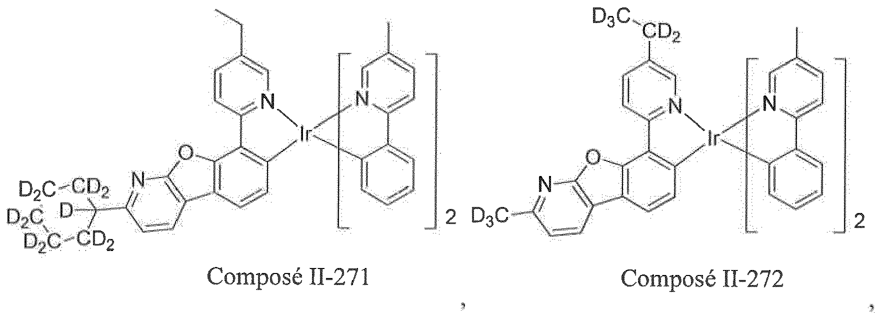 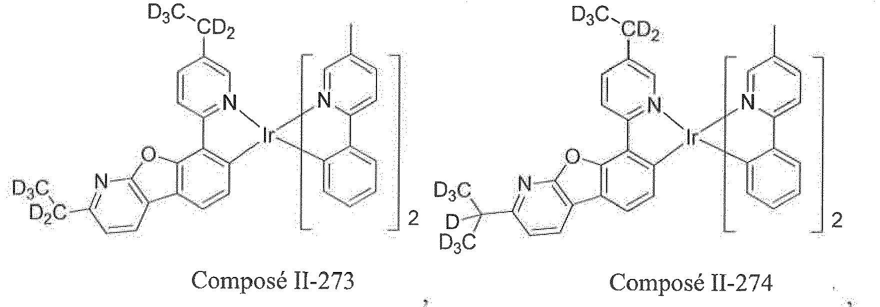 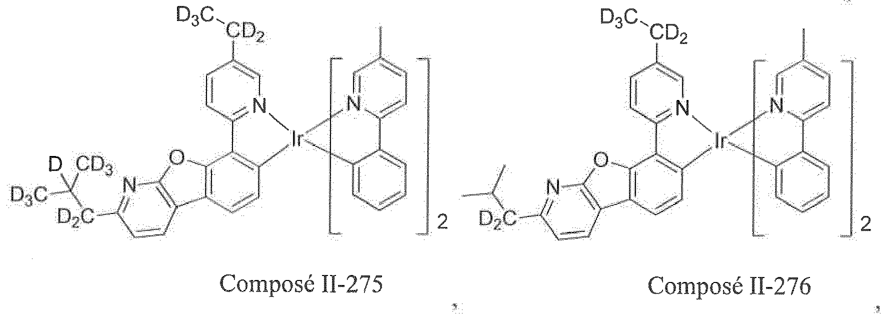 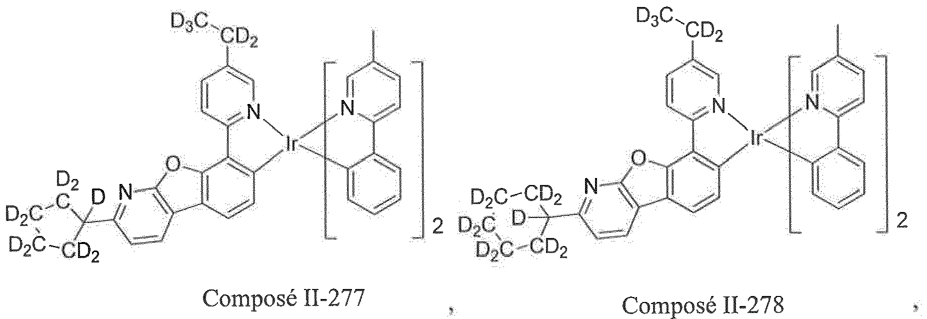 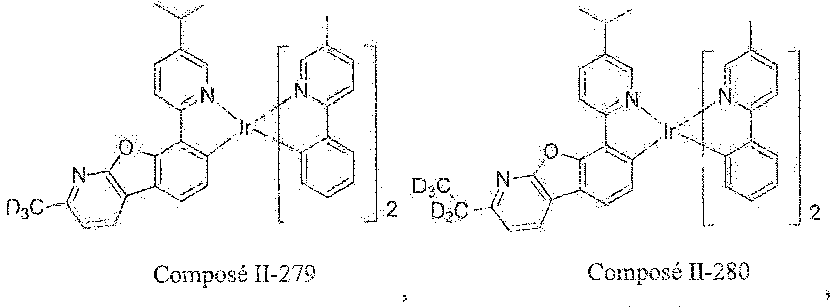 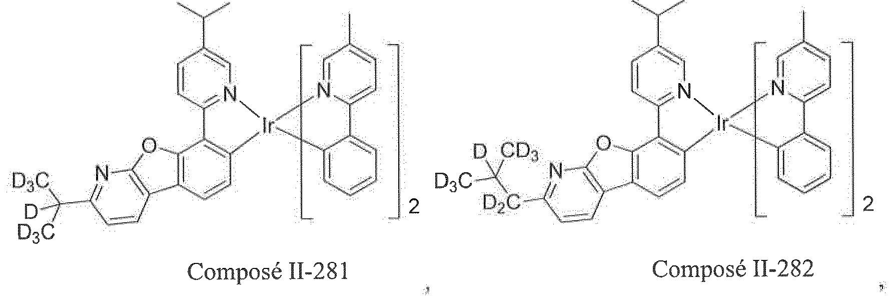 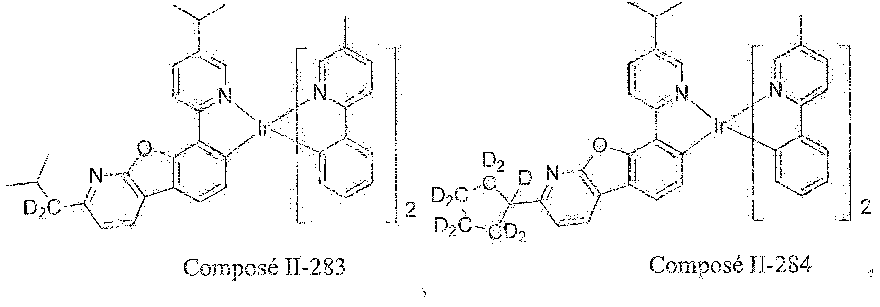 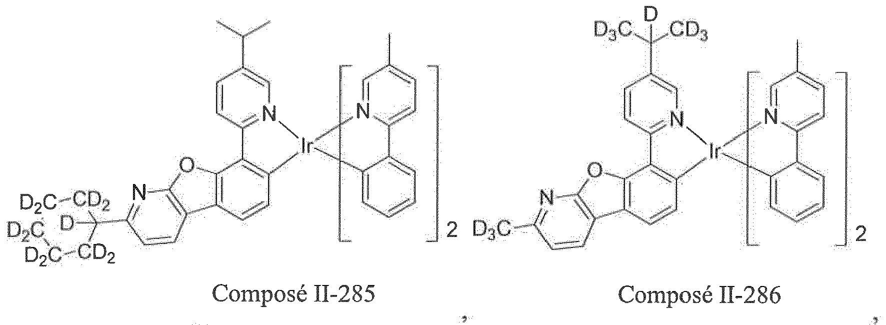 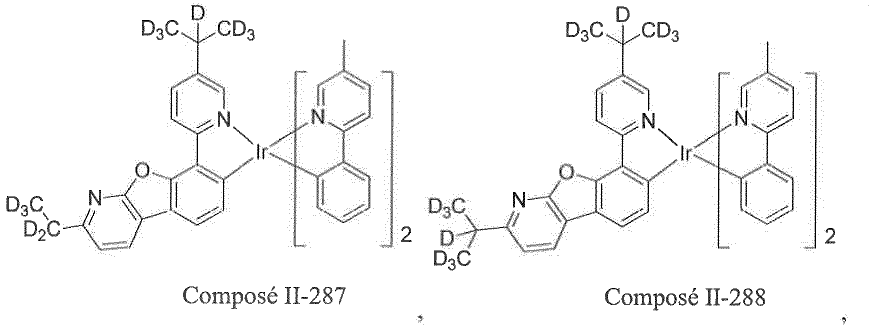 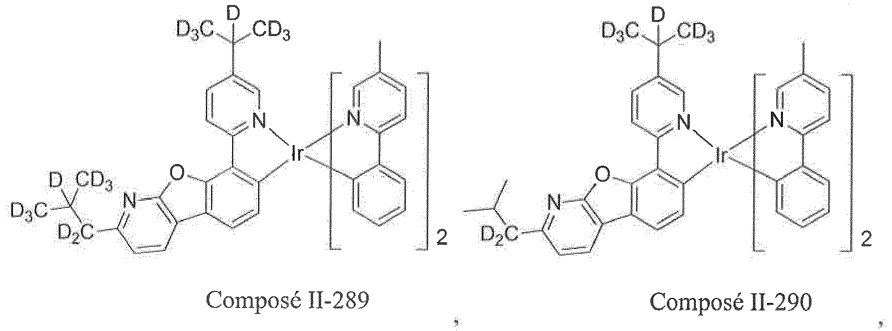 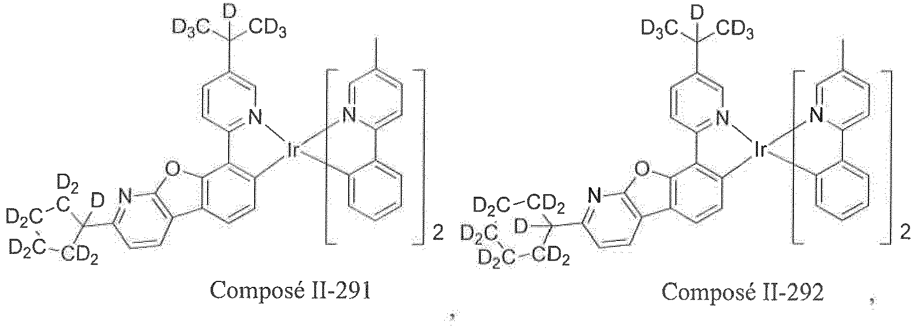 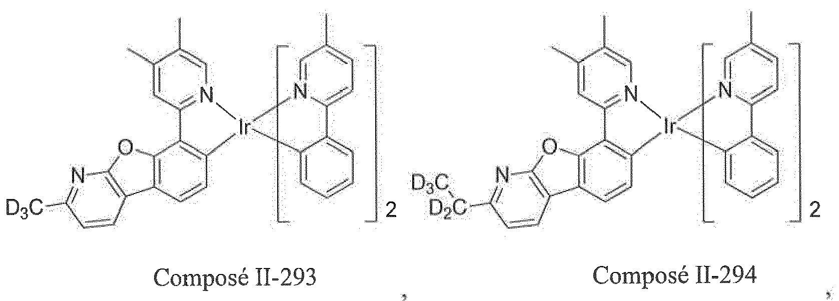 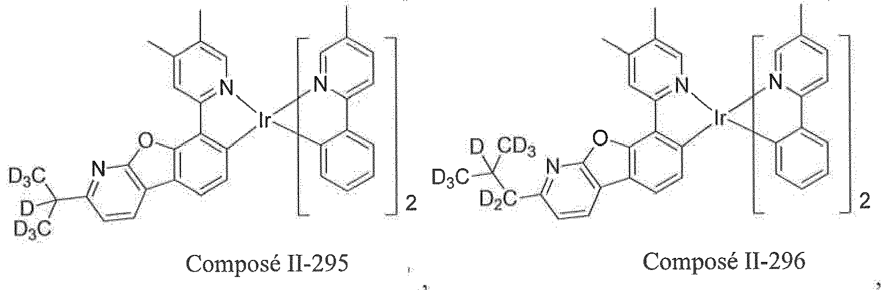 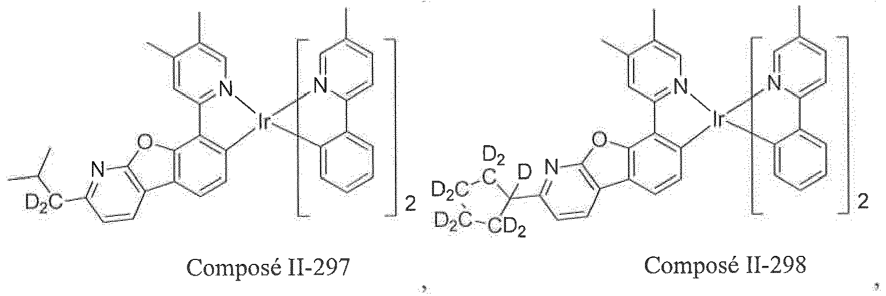 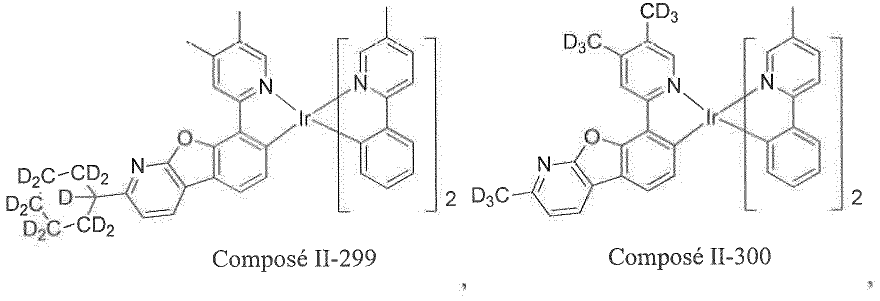 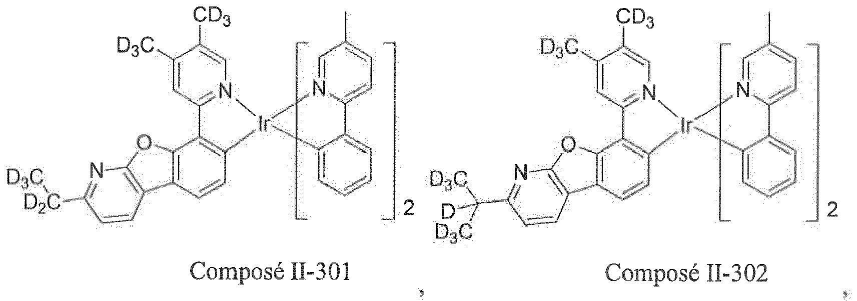 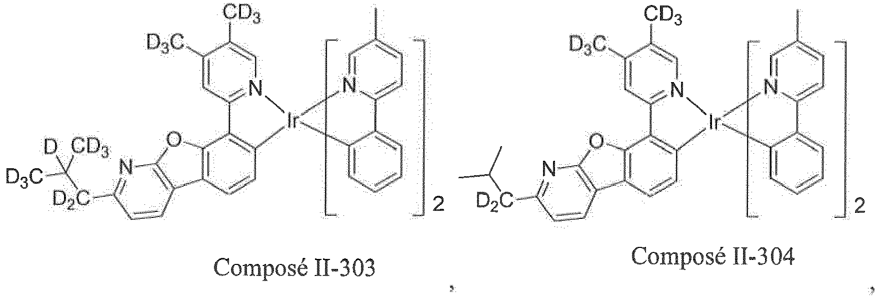 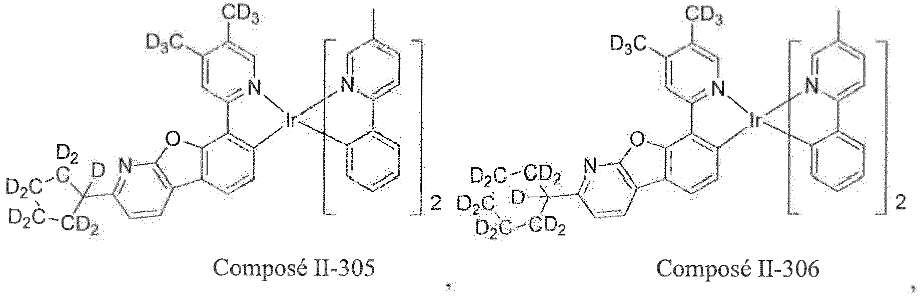 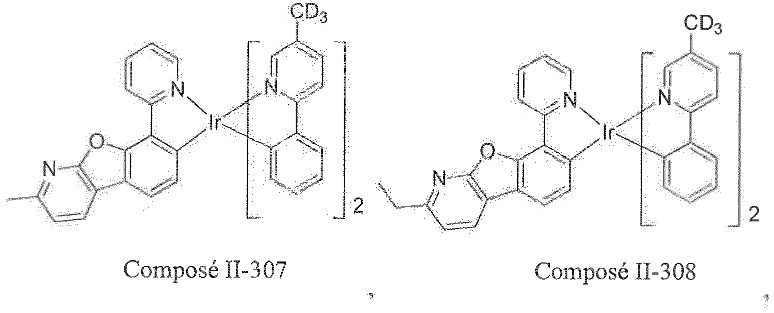 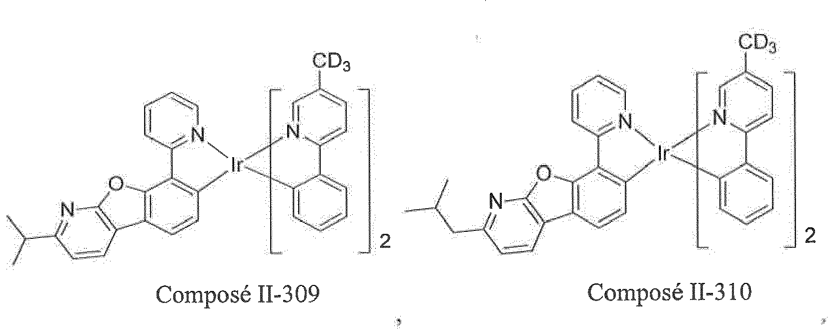 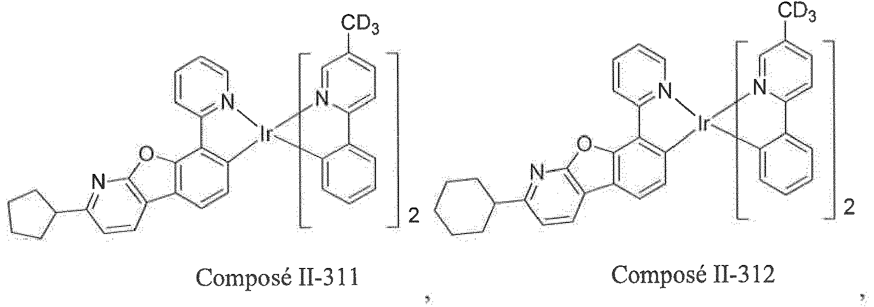 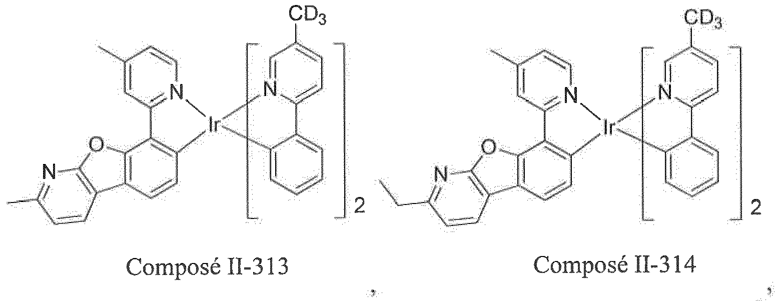 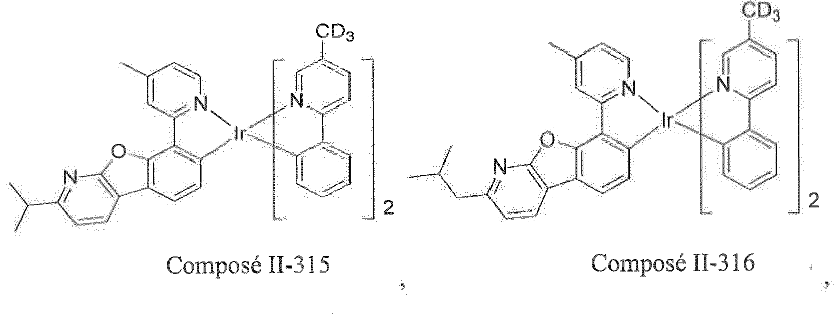 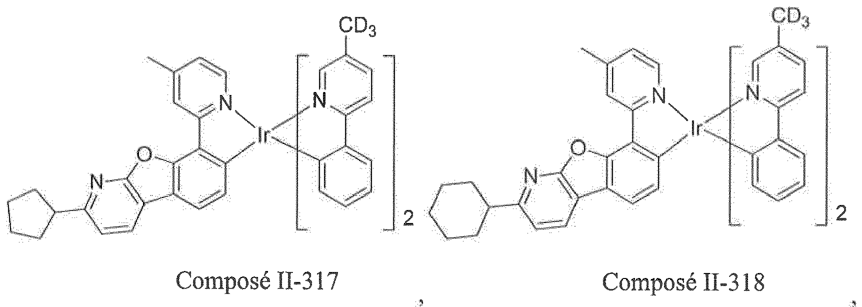 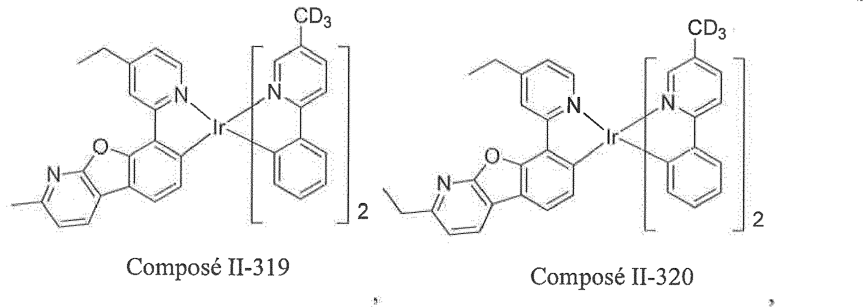 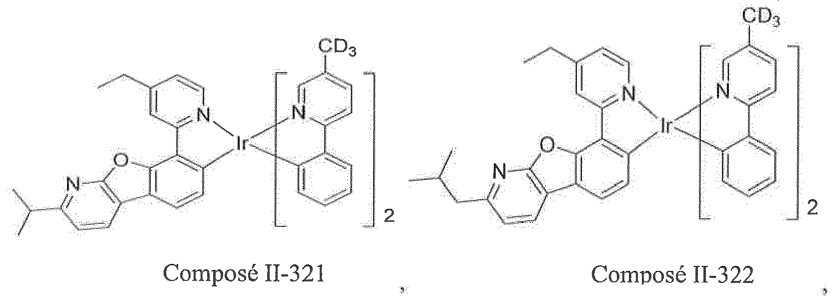 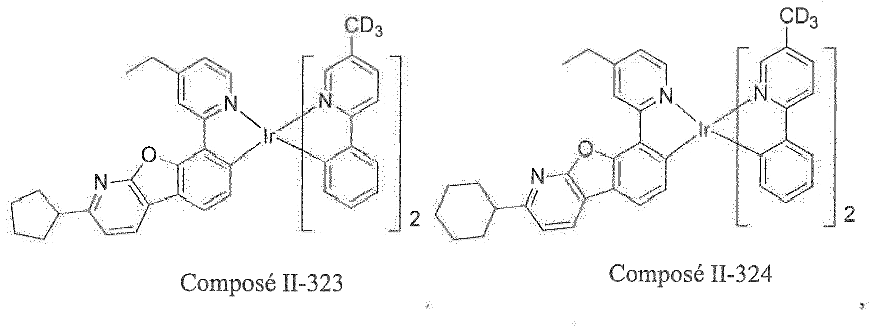 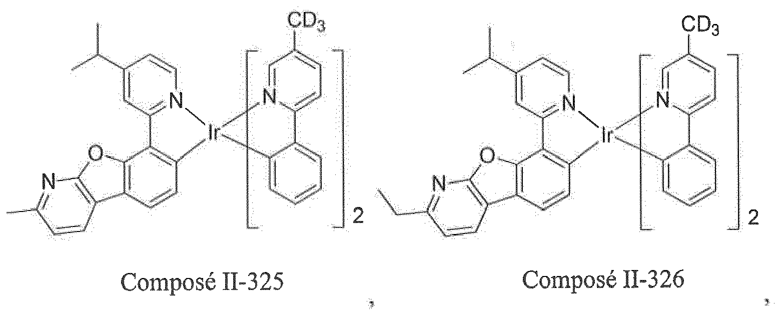 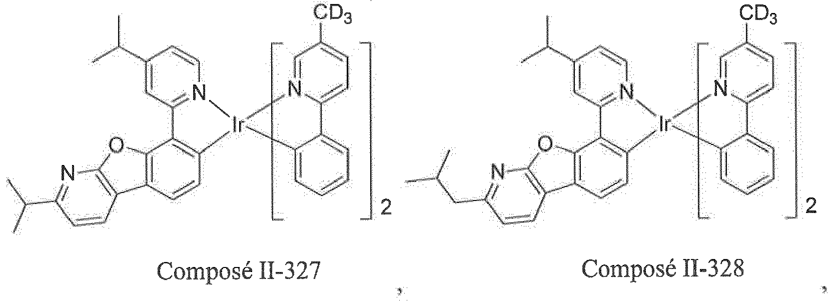 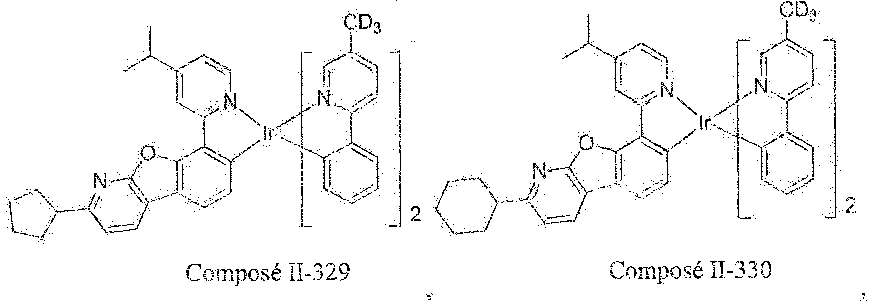 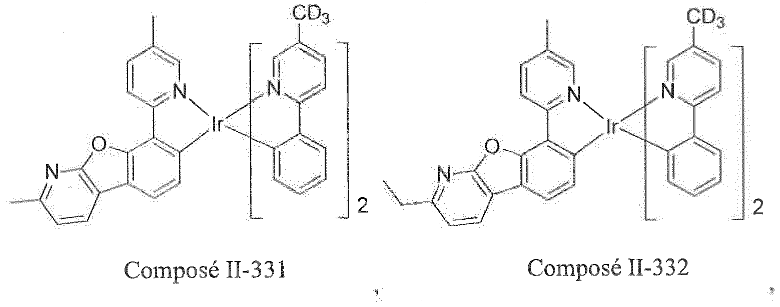 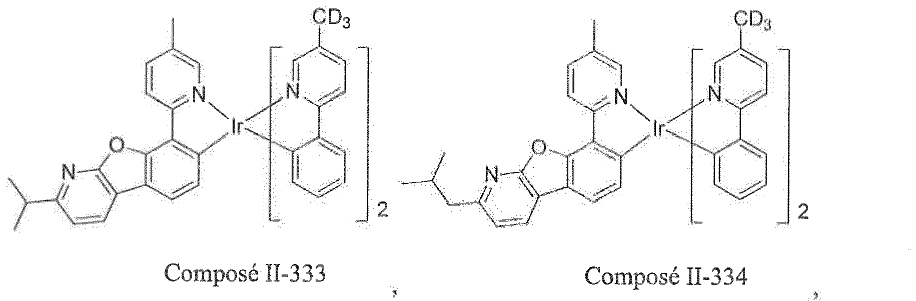 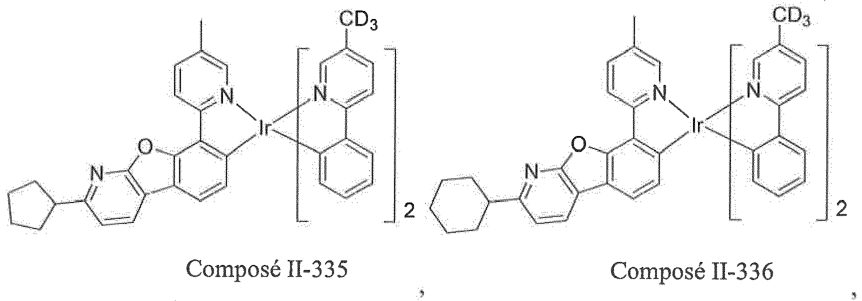 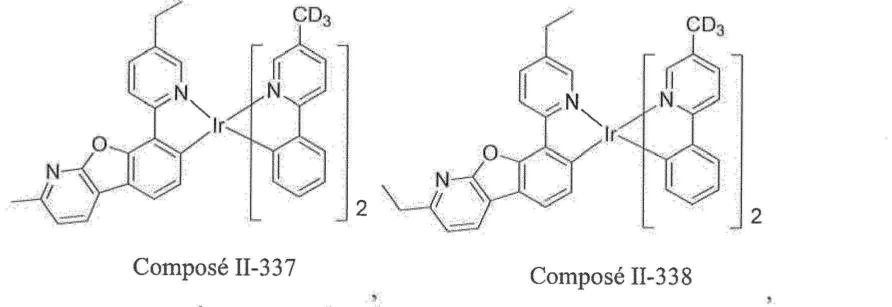 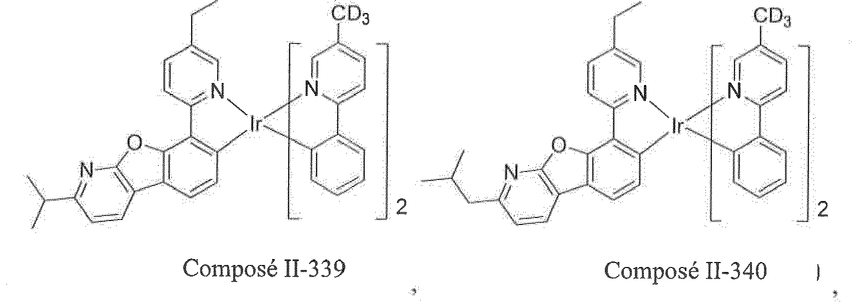 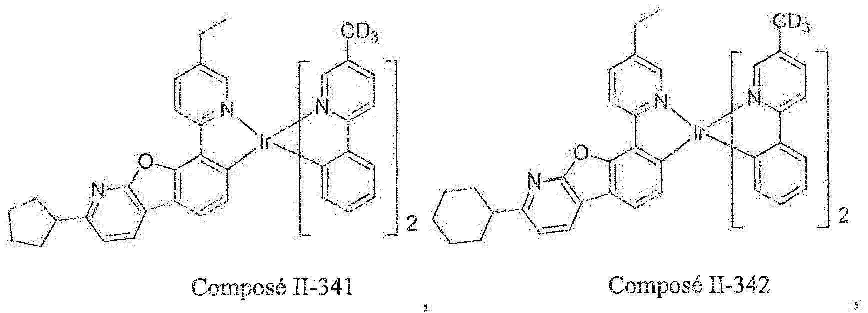 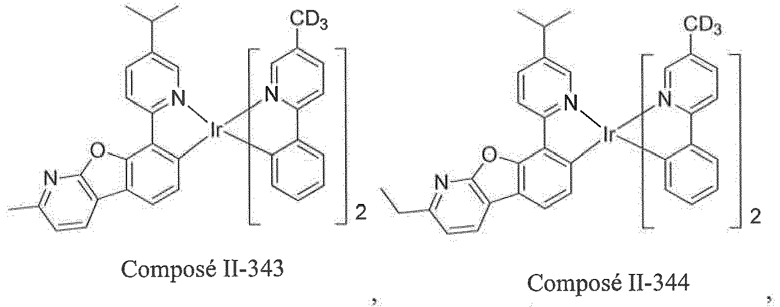 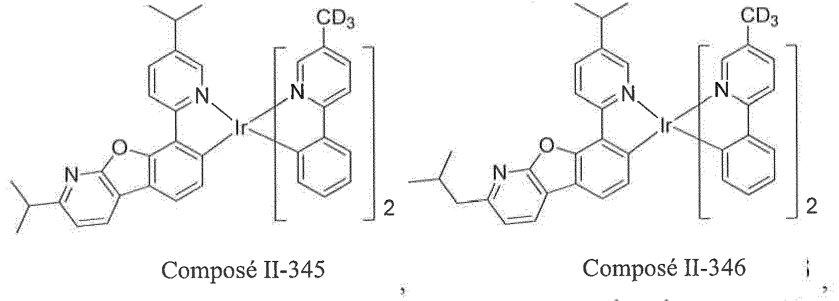 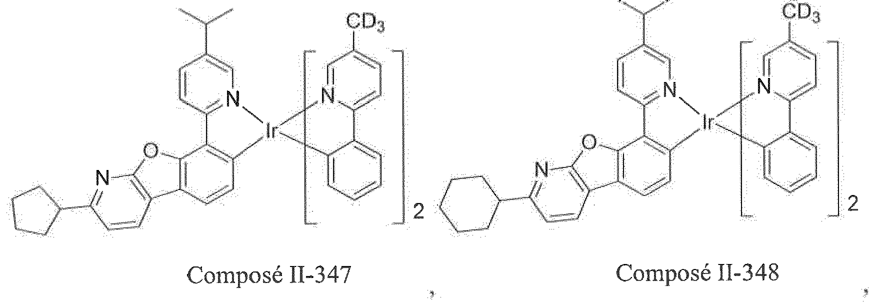 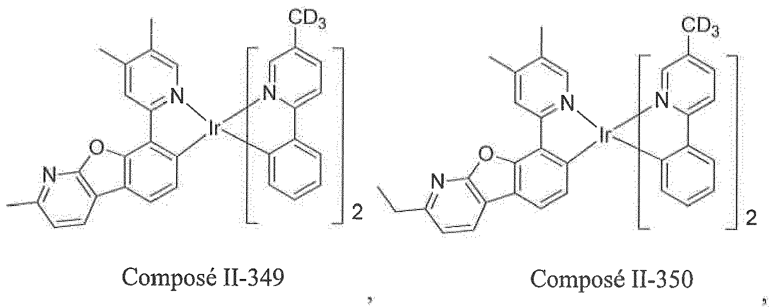 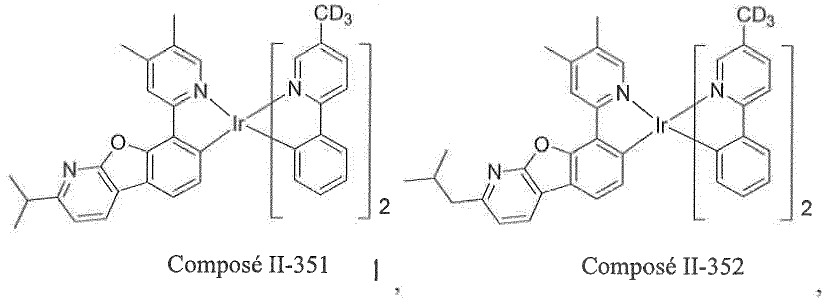 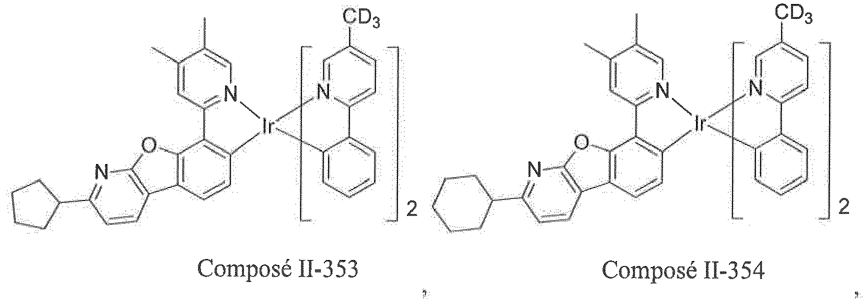 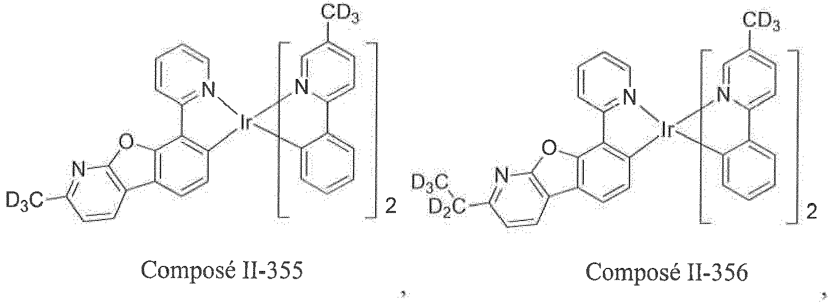 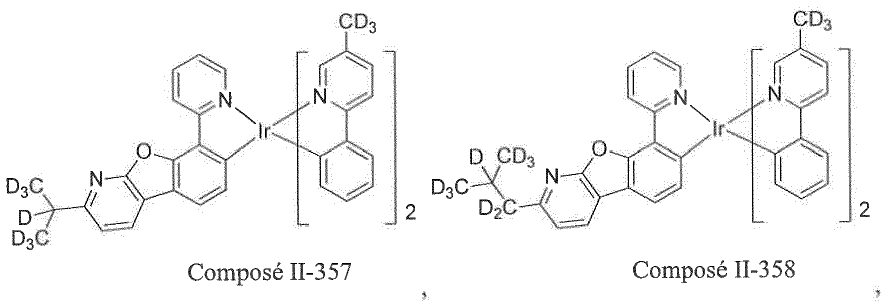 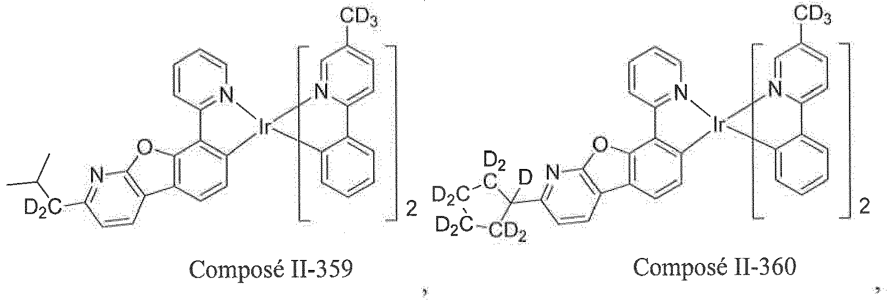 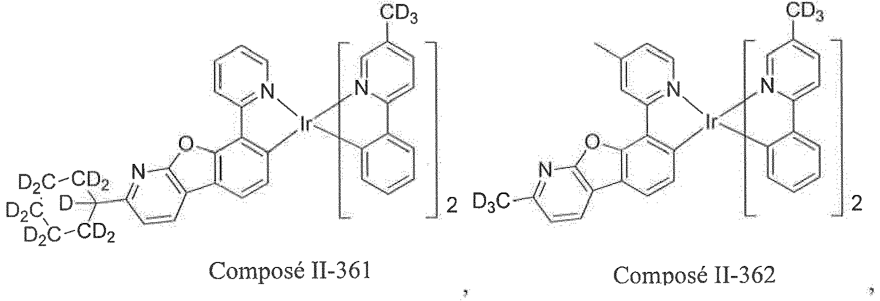 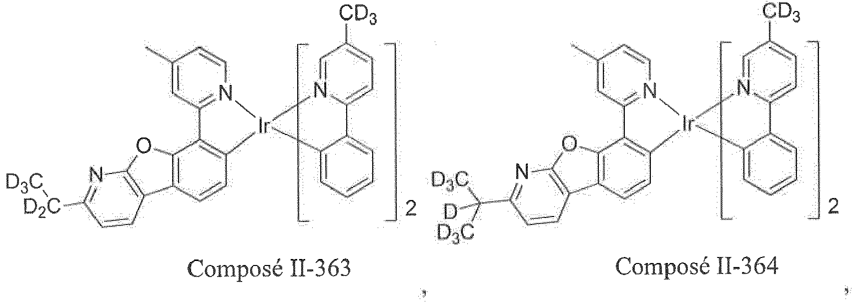 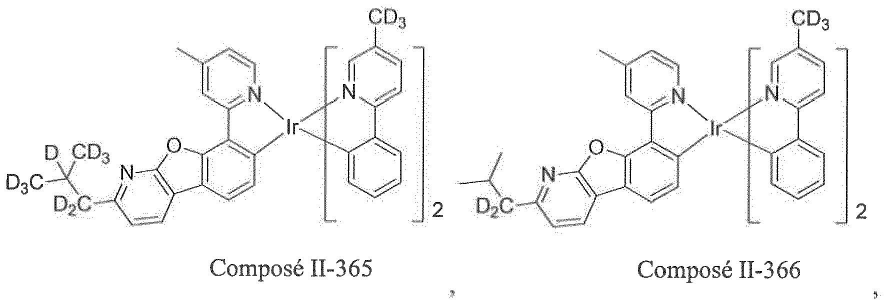 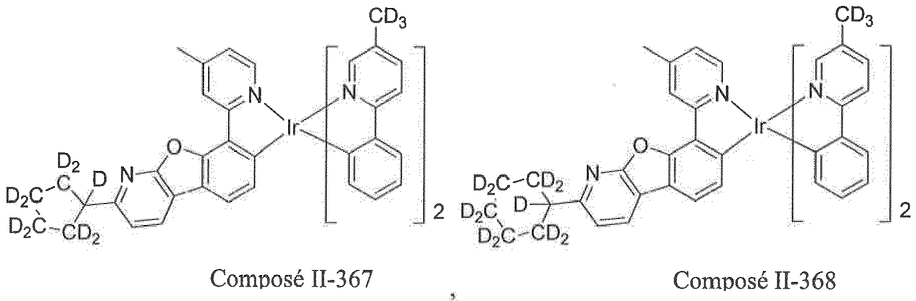 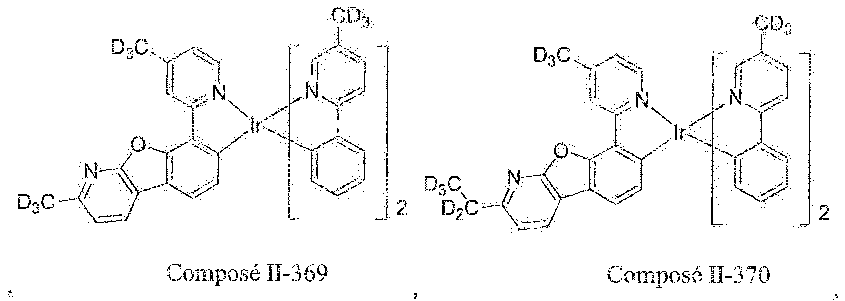 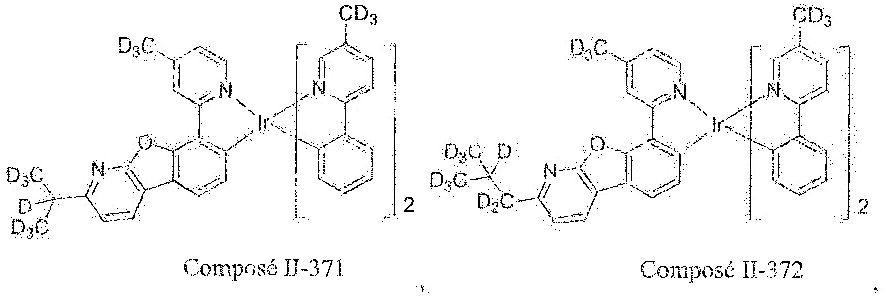 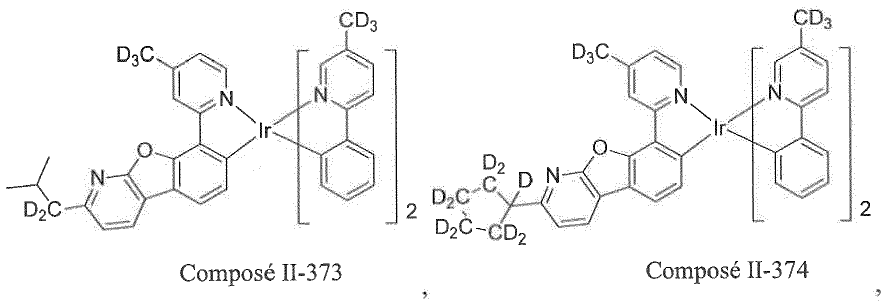 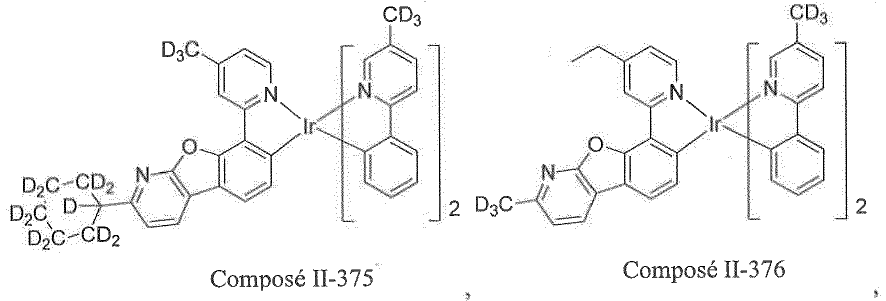 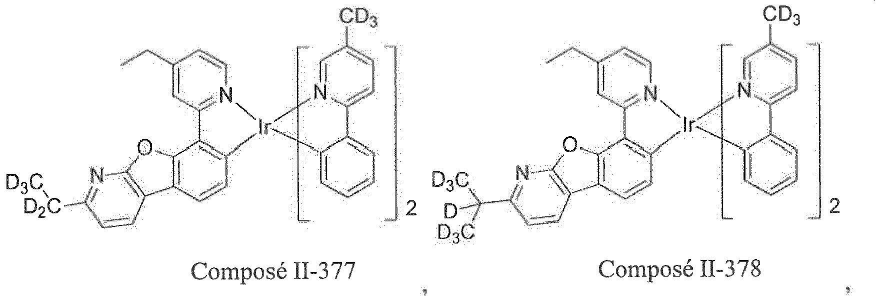 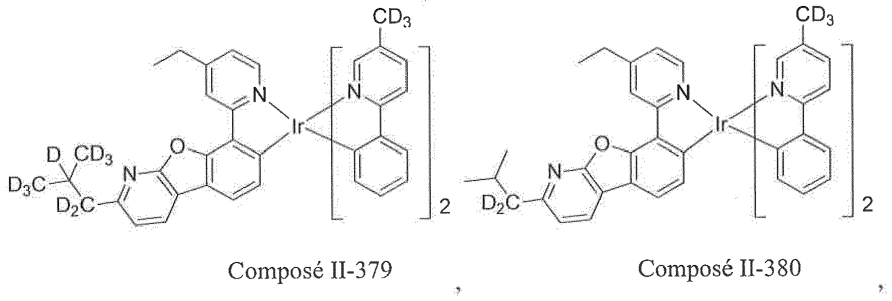 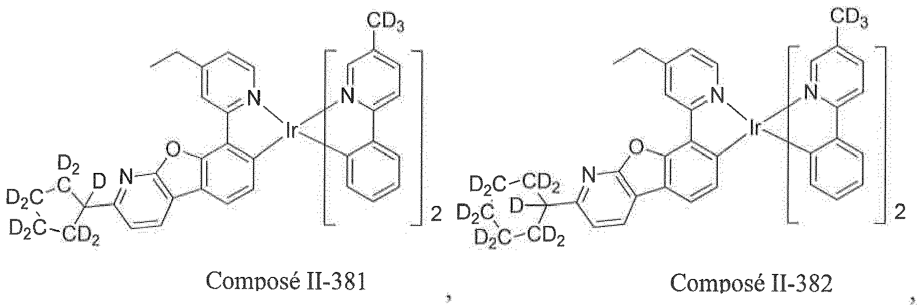 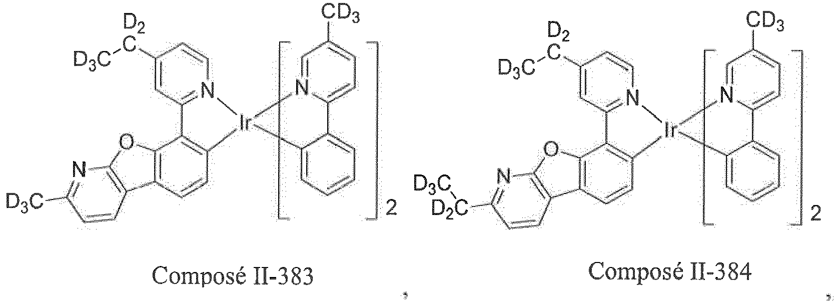 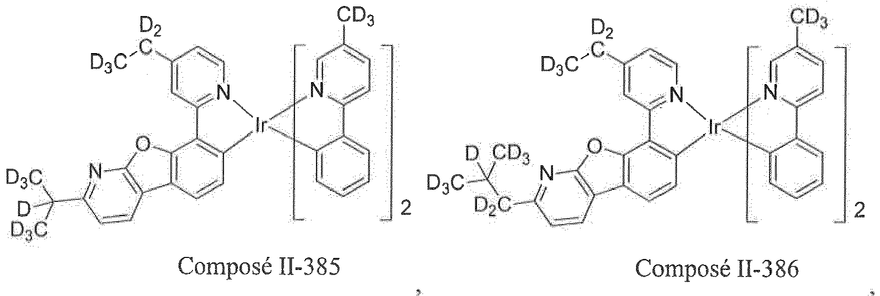 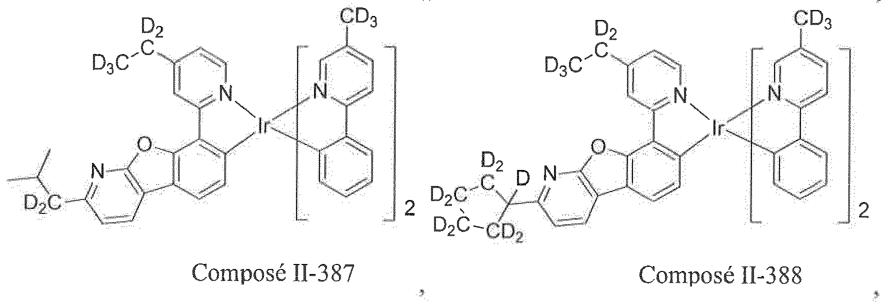 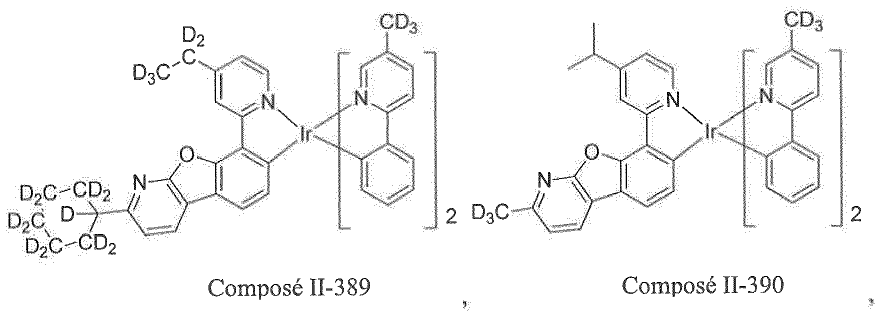 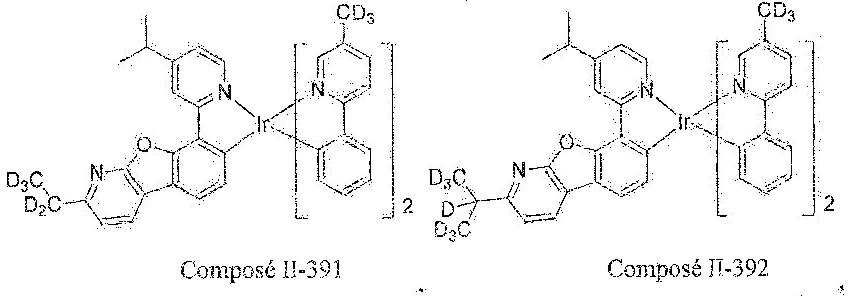 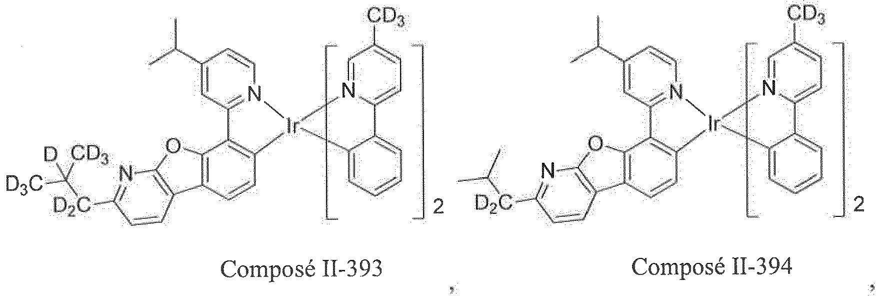 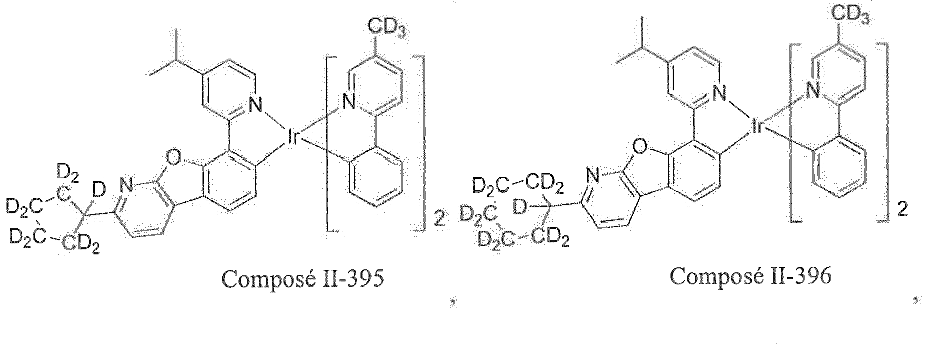 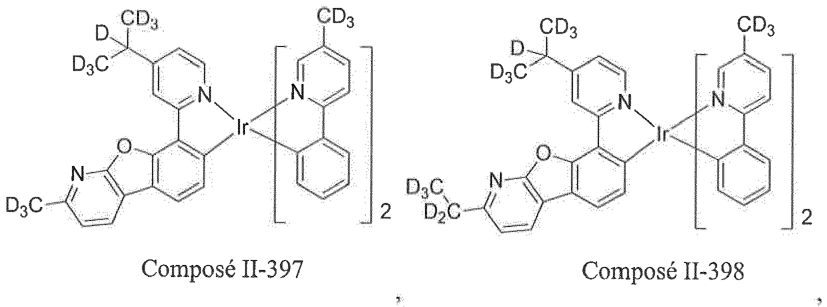 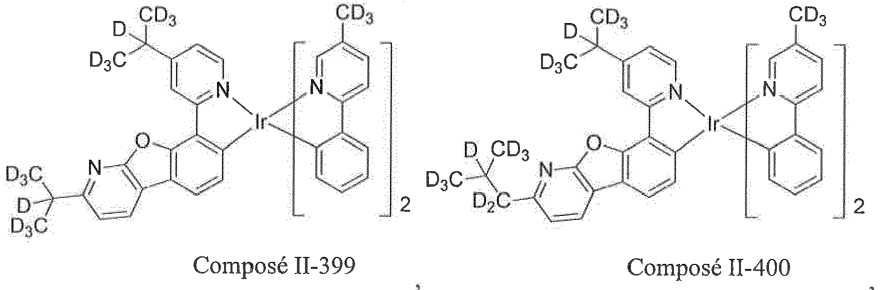 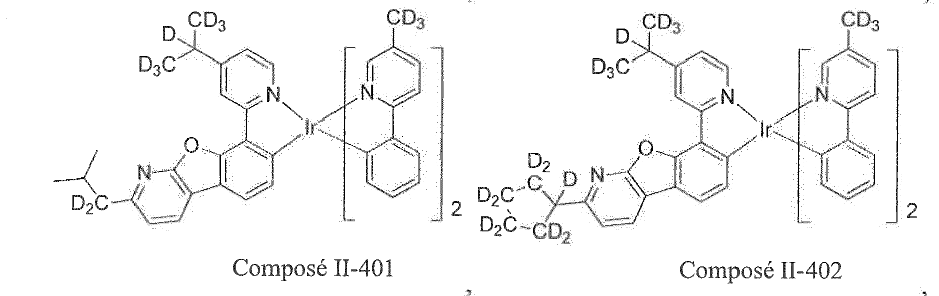 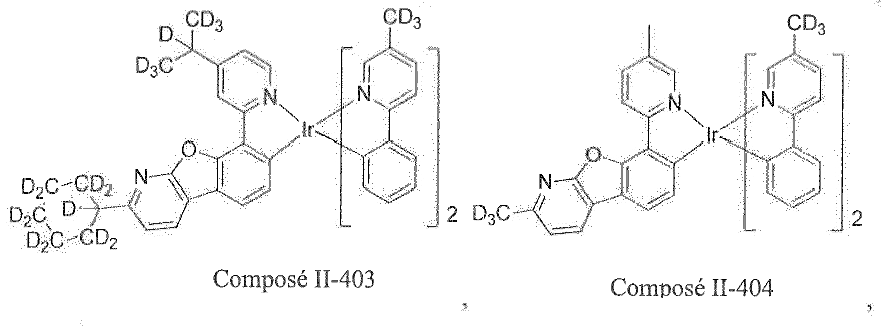 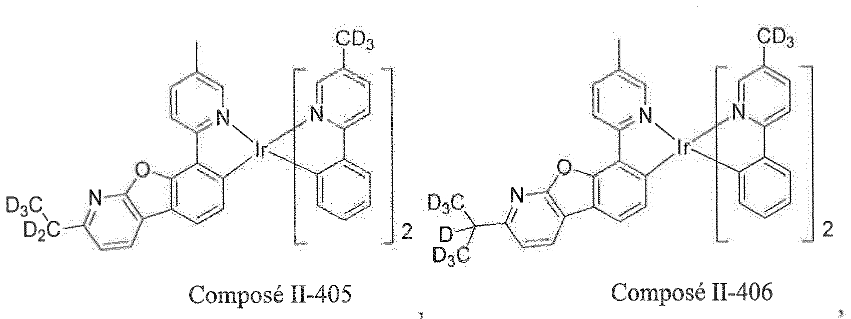 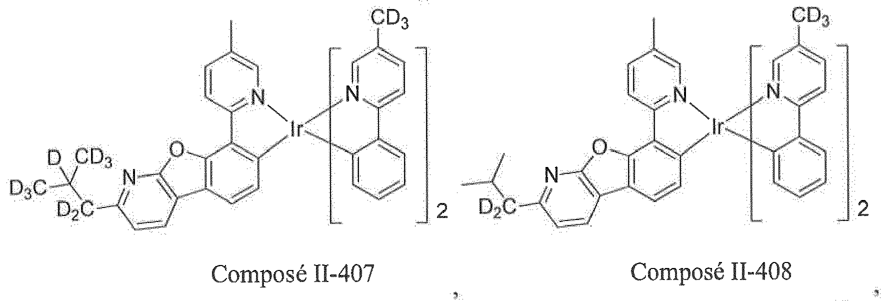 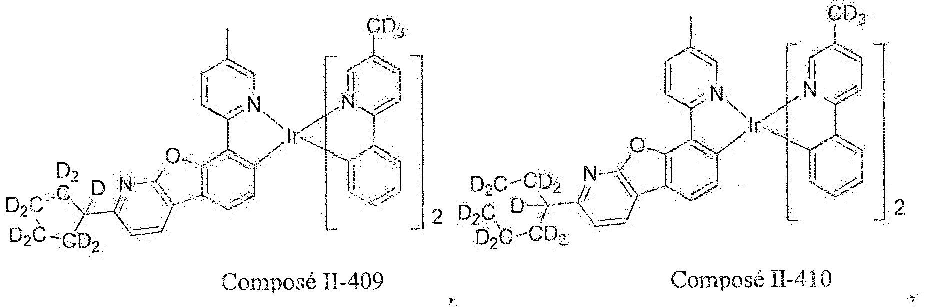 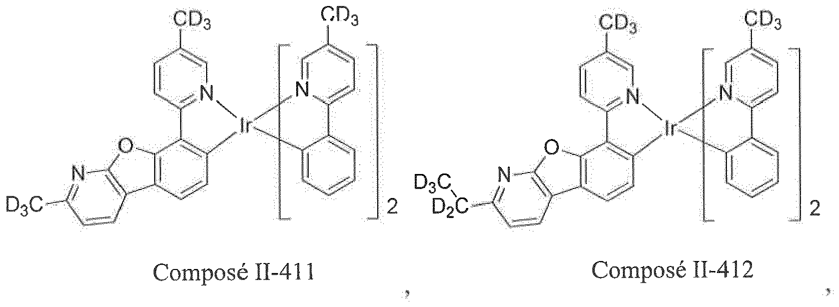 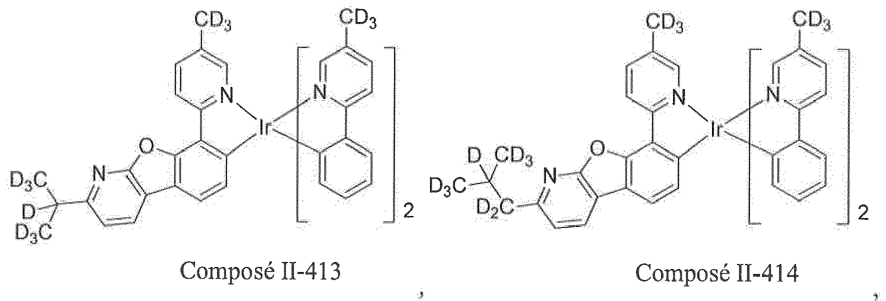 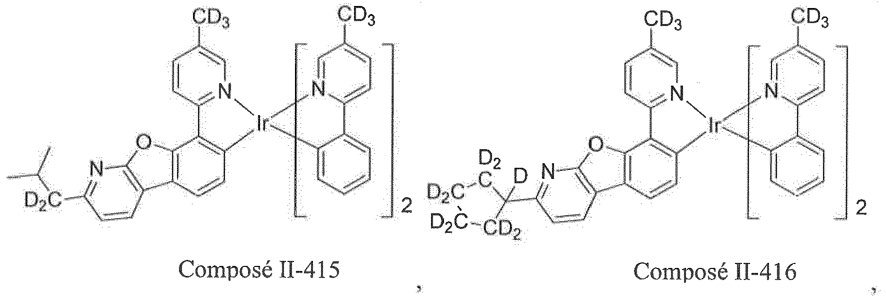 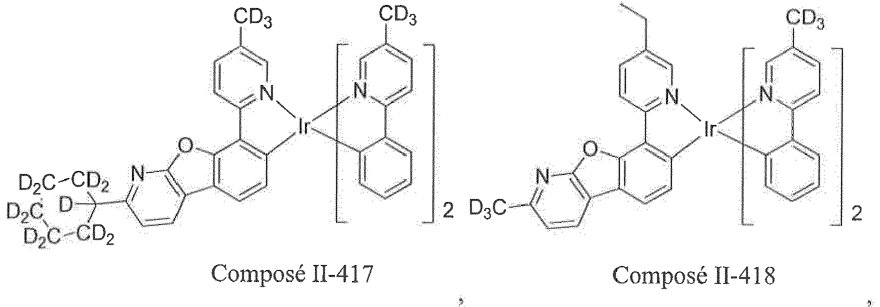 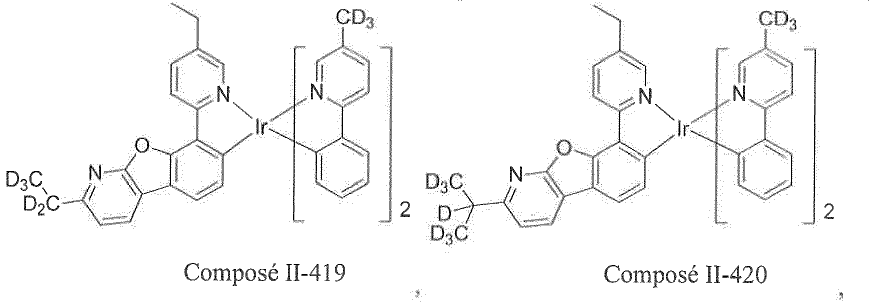 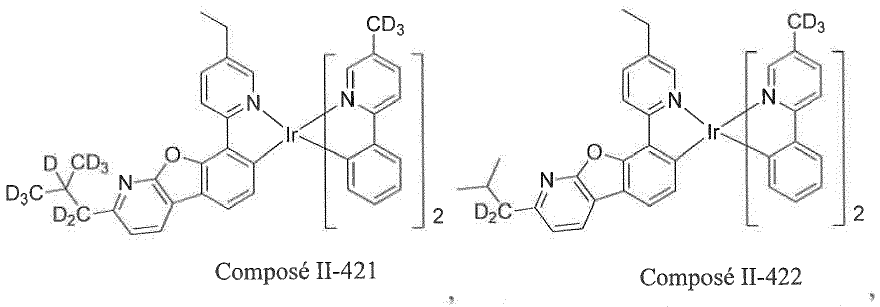 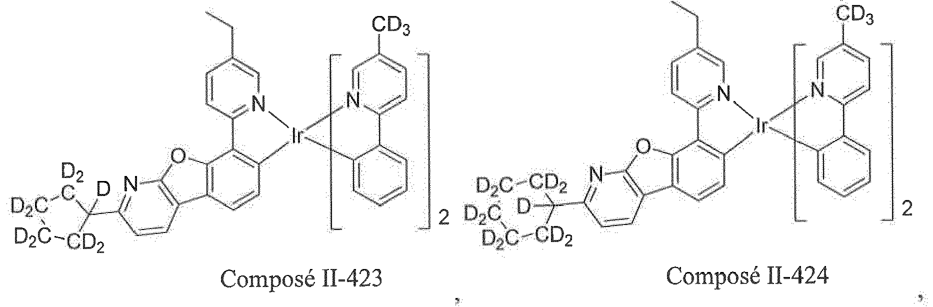 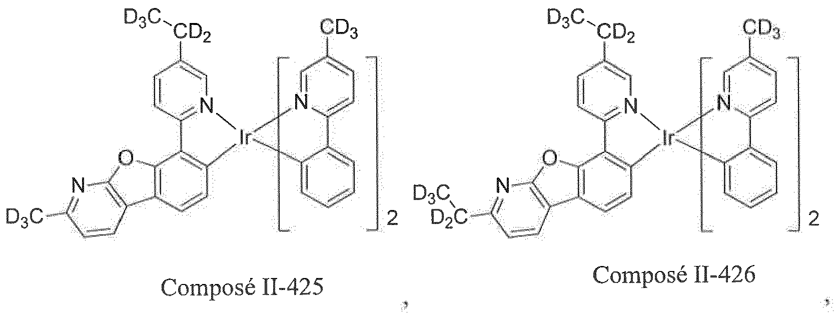 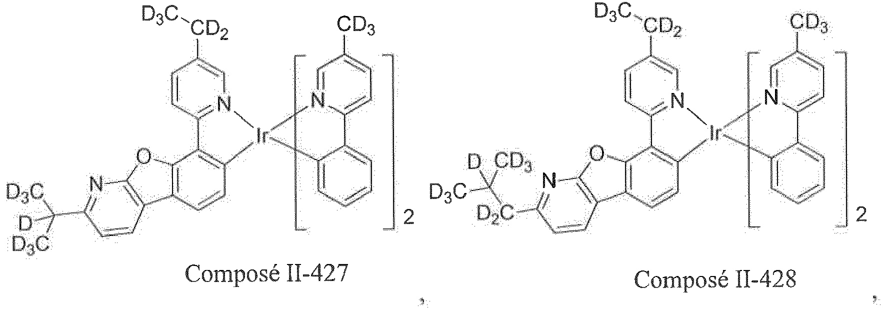 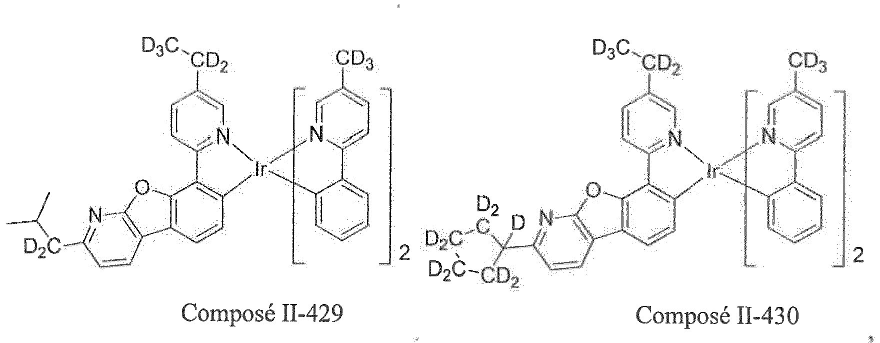 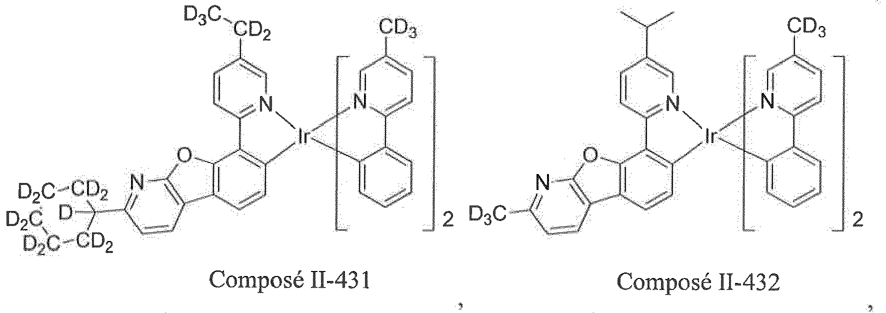 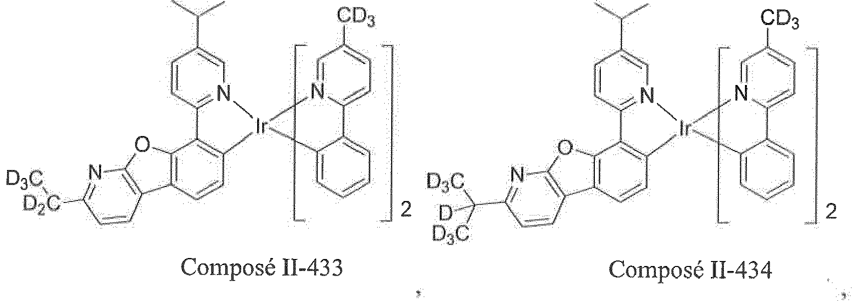 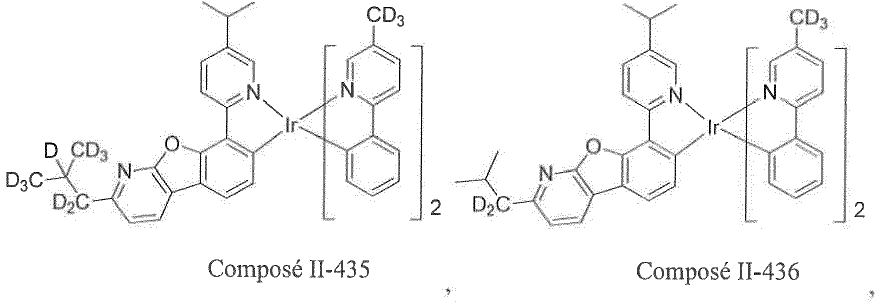 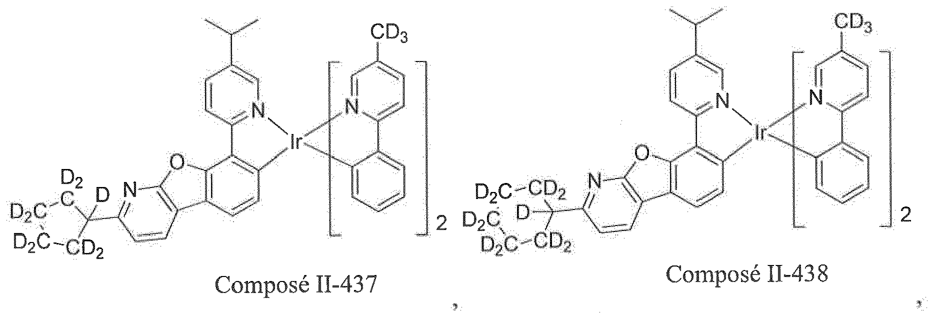 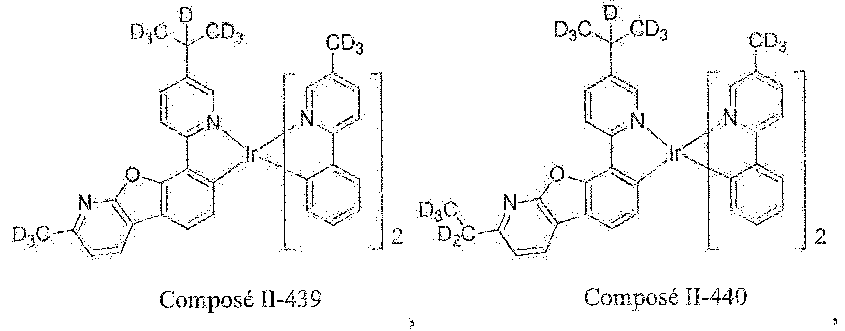 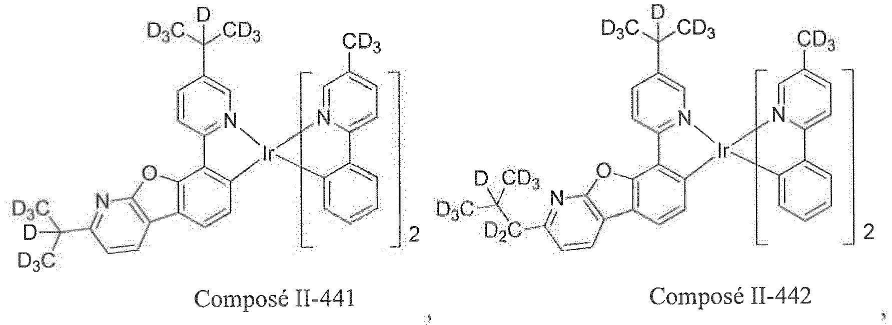 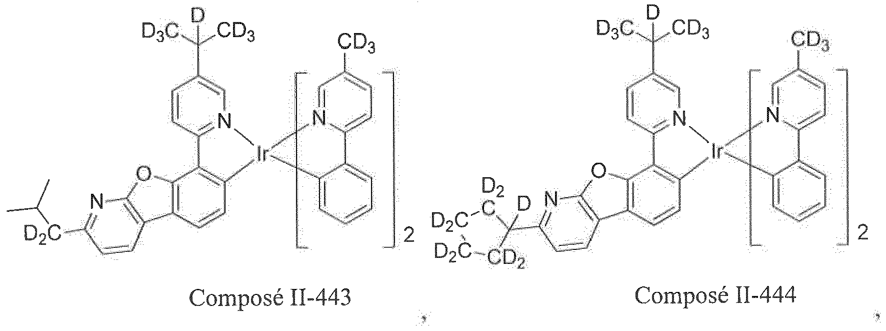 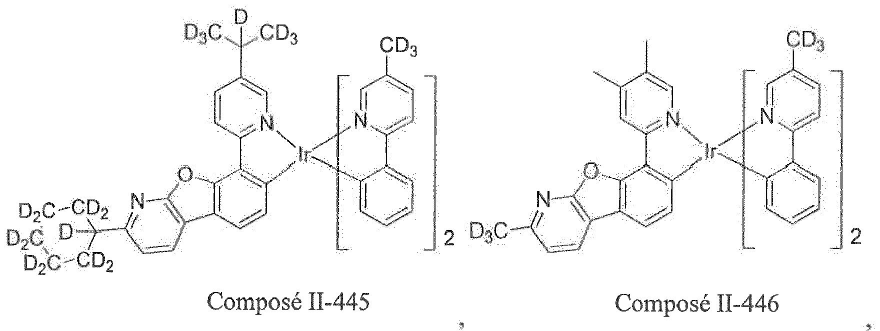 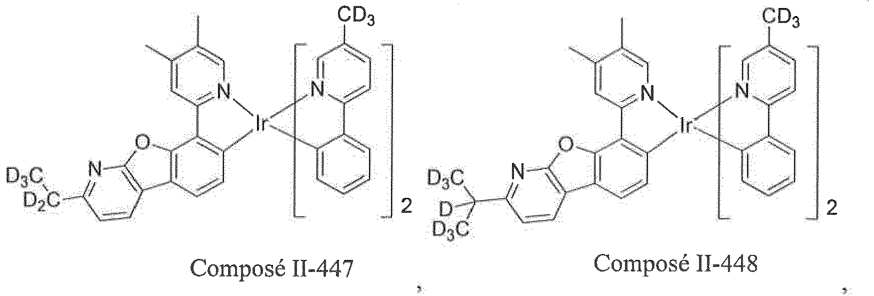 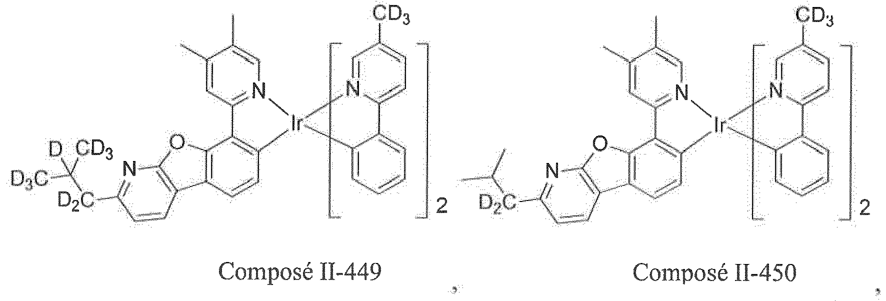 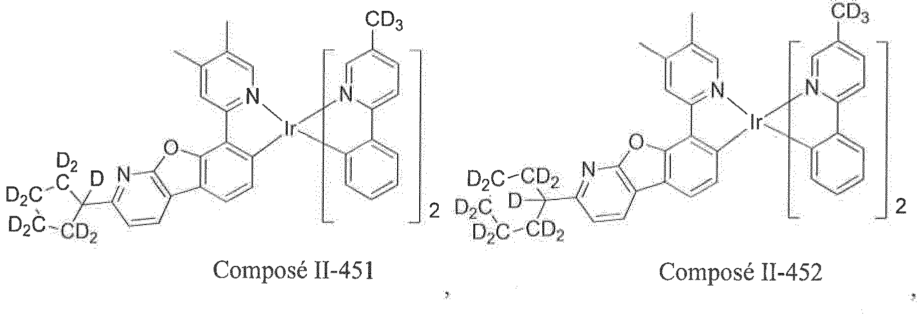 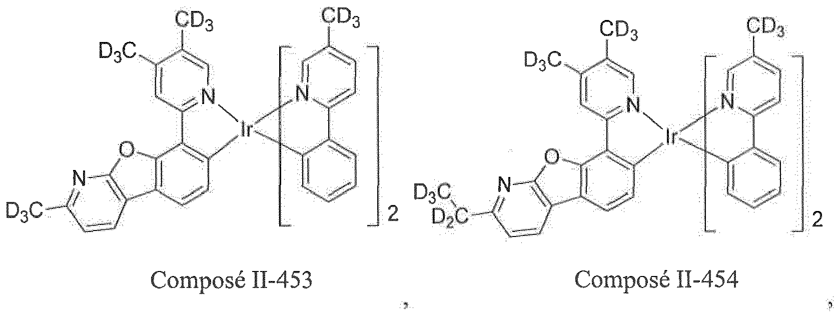 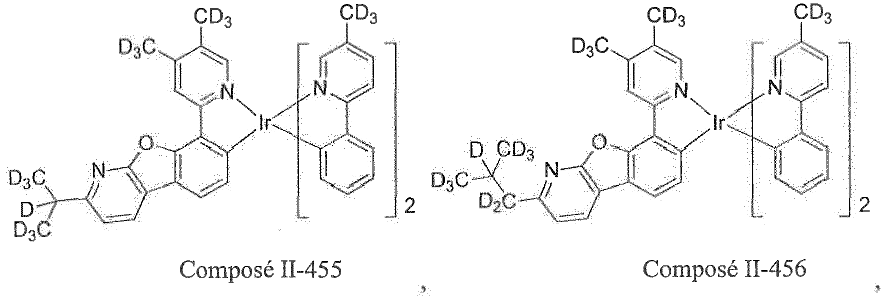 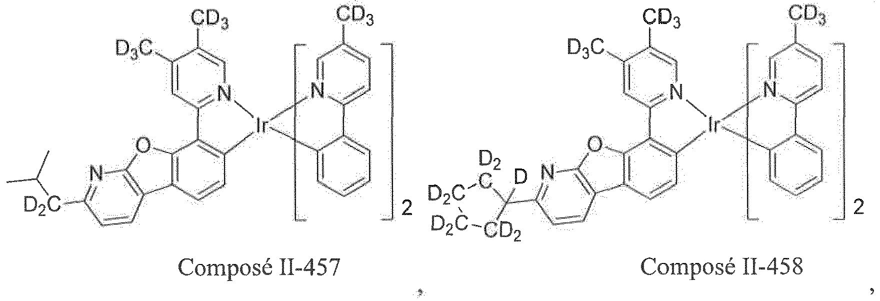 et

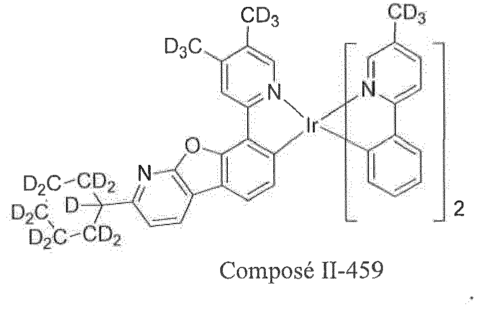

19. Composé selon la revendication 8, dans lequel LA est sélectionné dans le groupe constitué de :

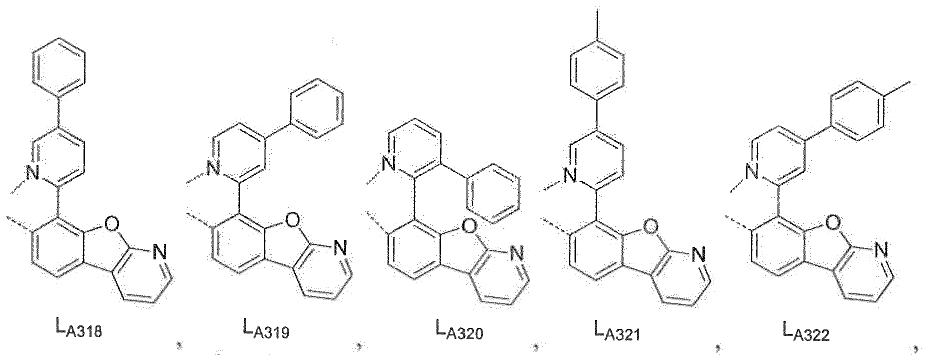

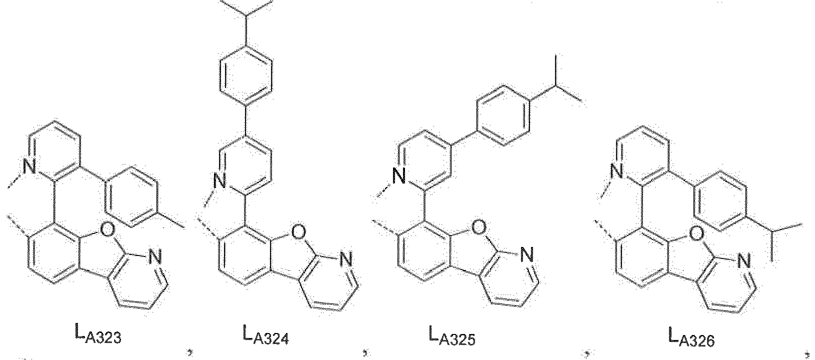

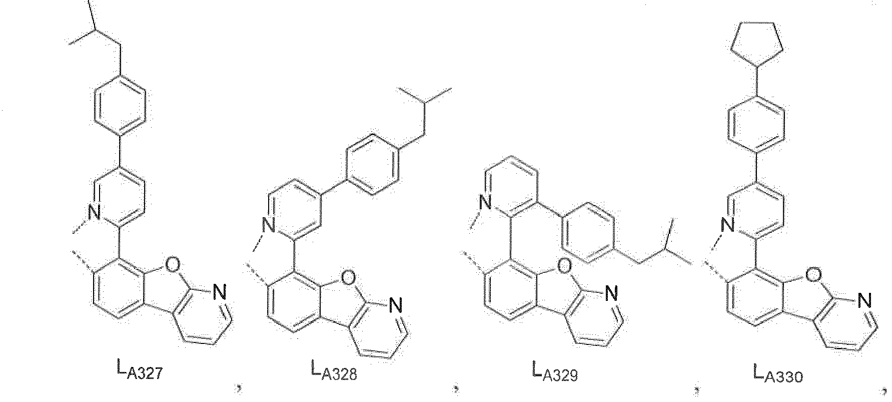

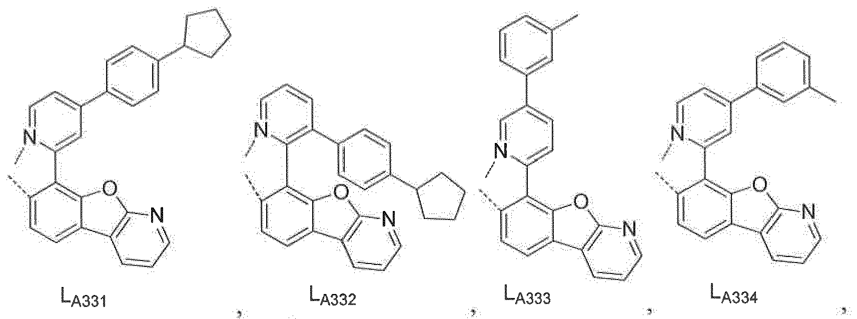

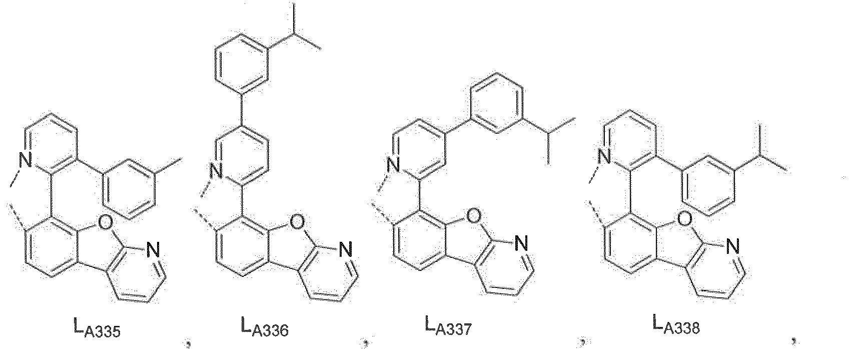

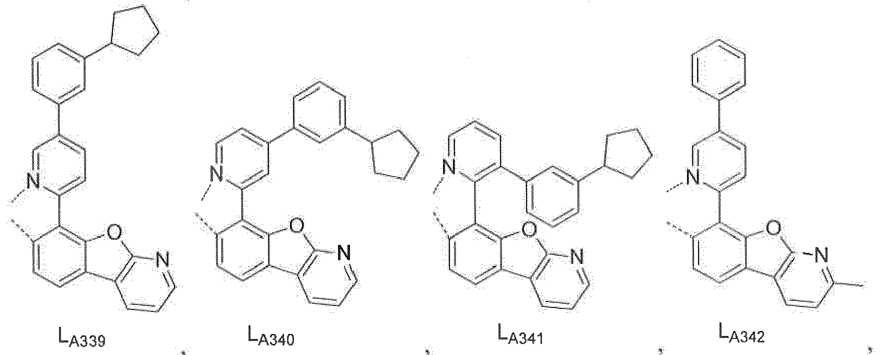

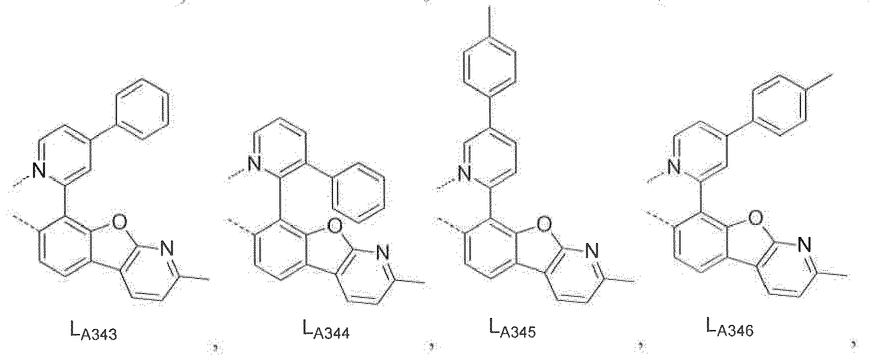

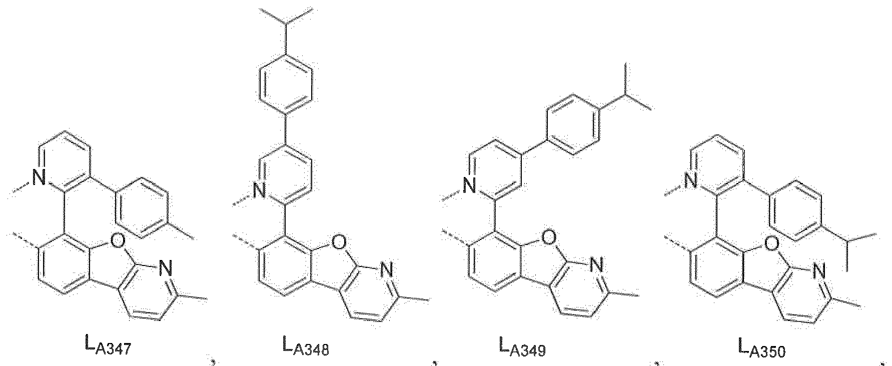

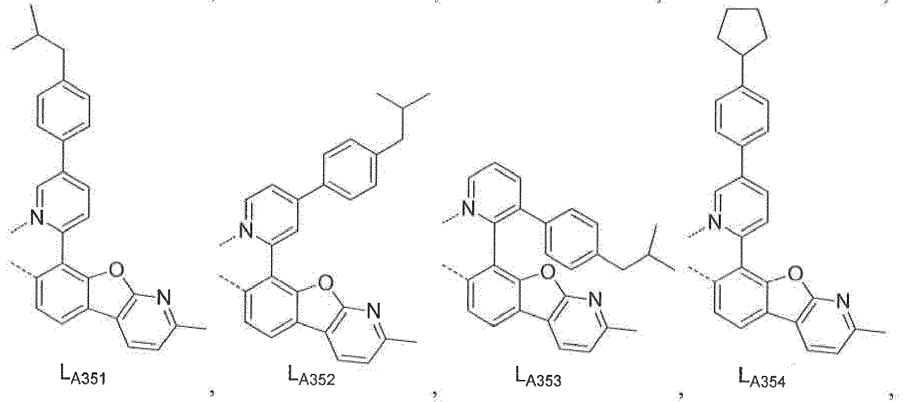

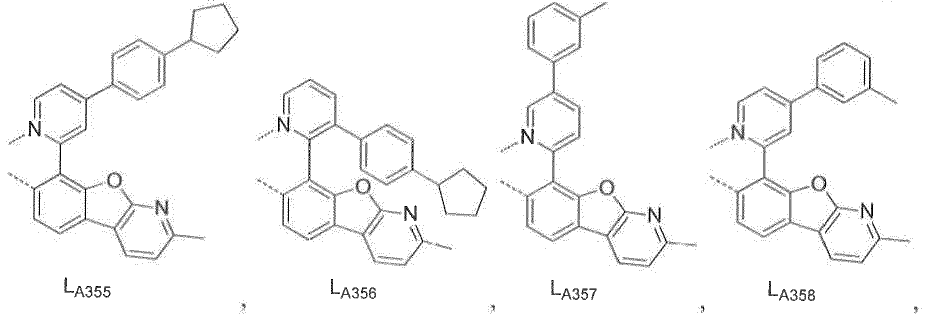

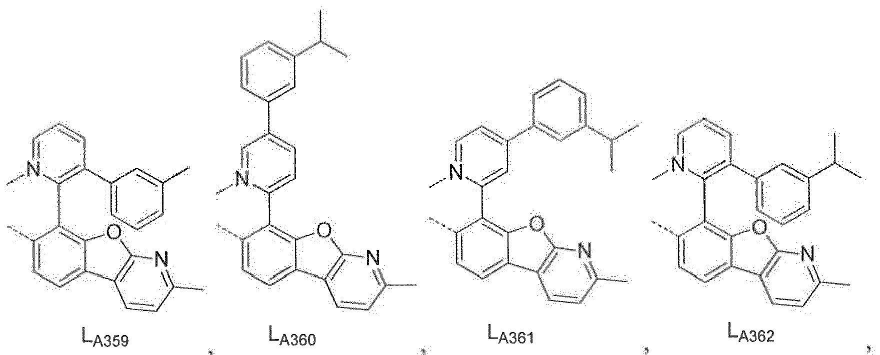

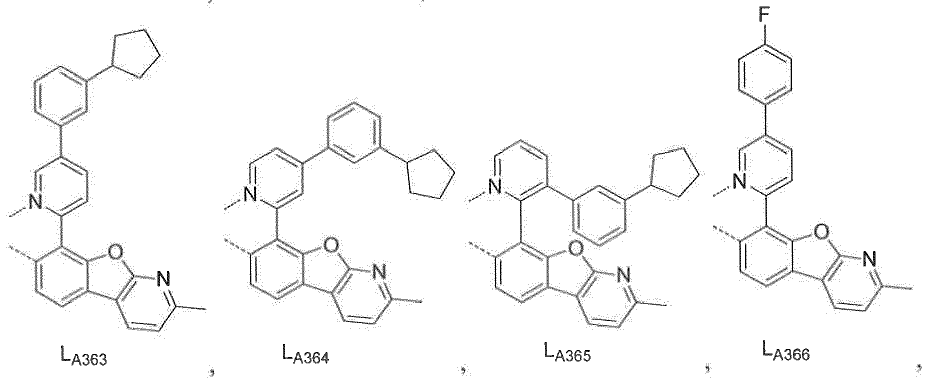

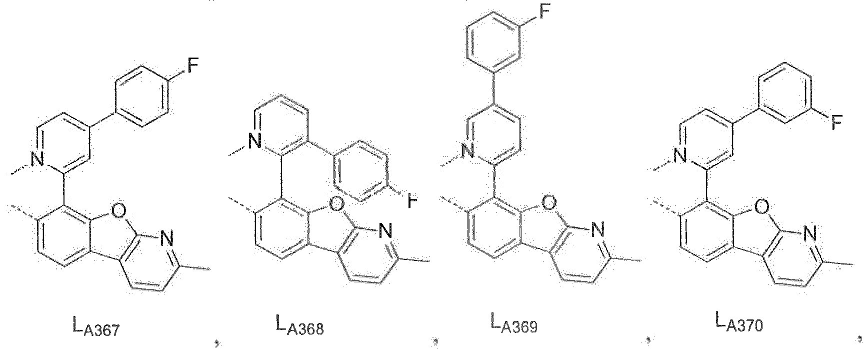

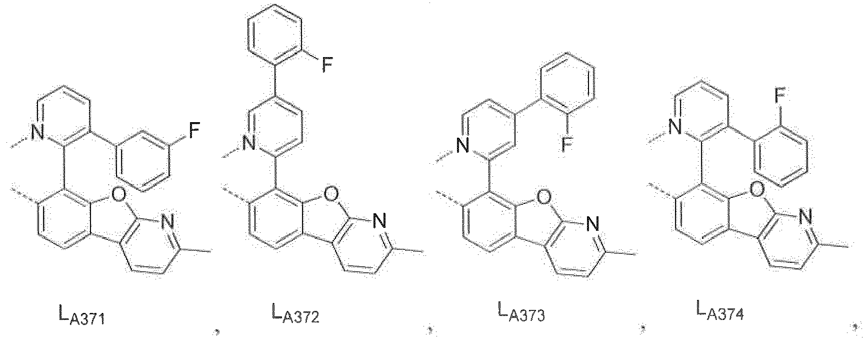

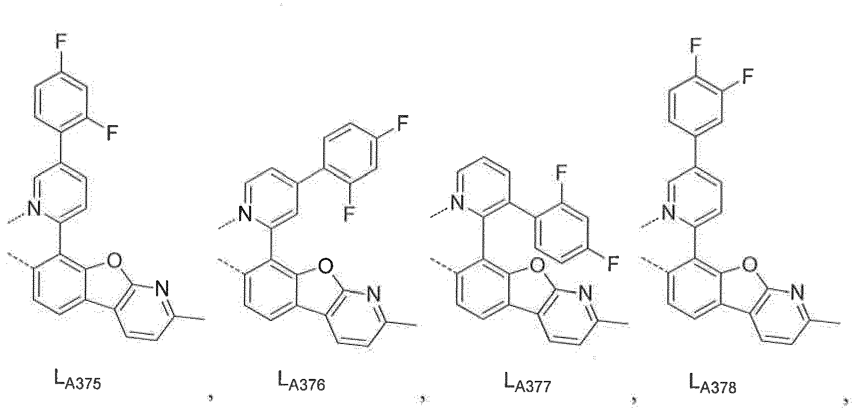

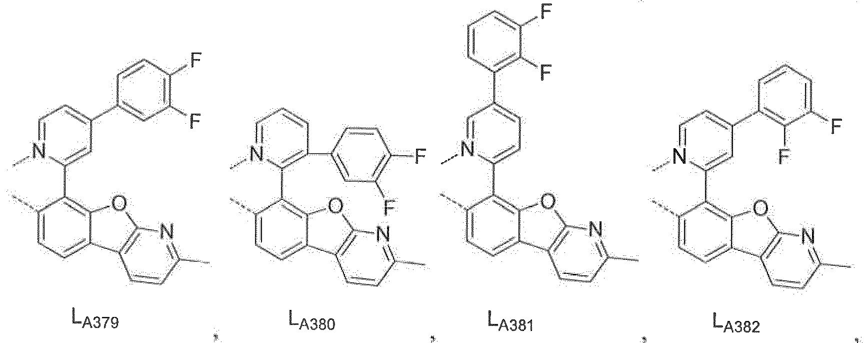

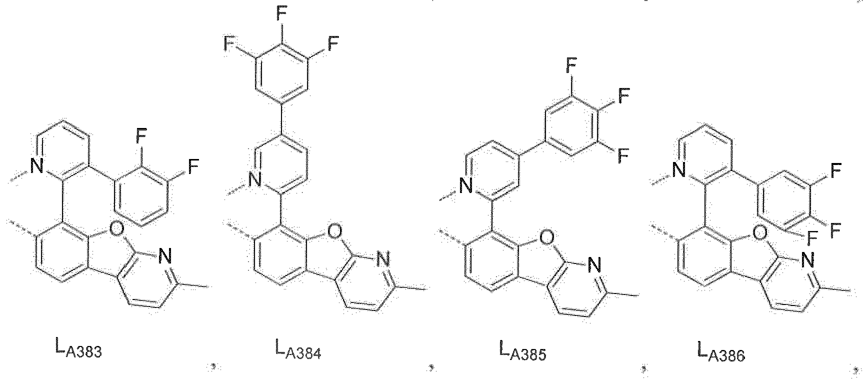

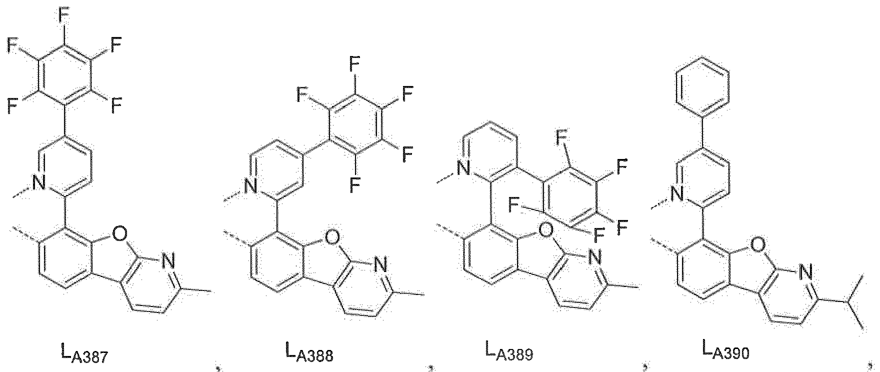

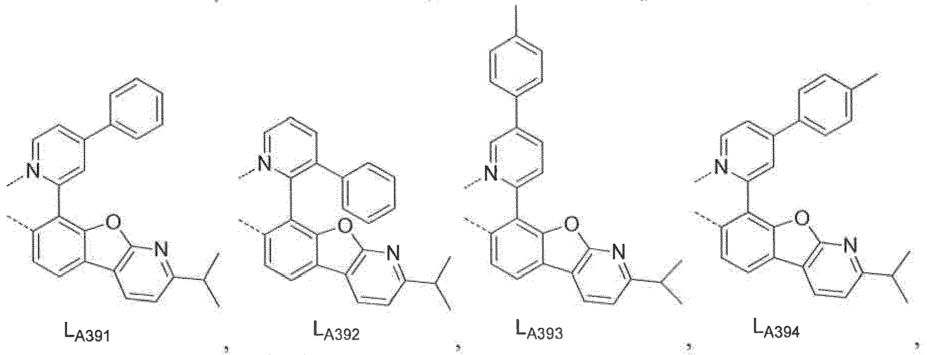

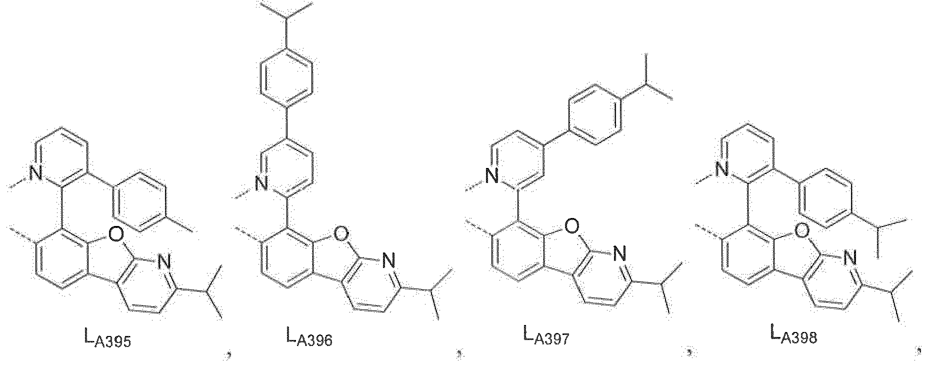

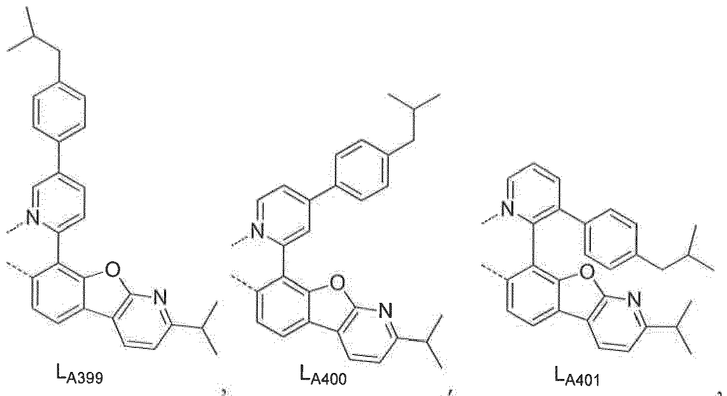

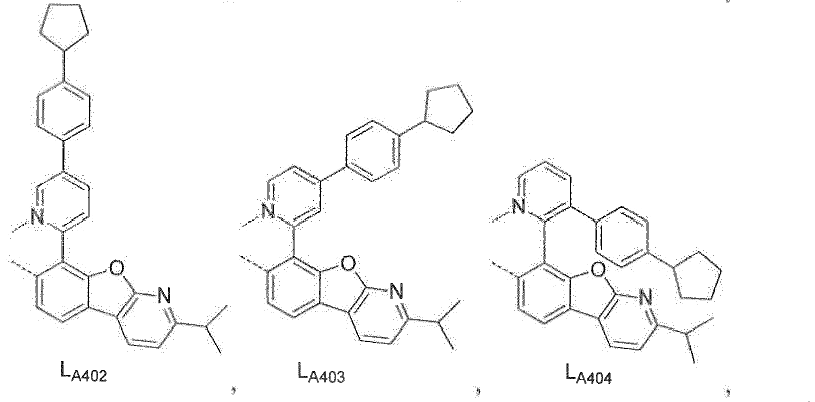

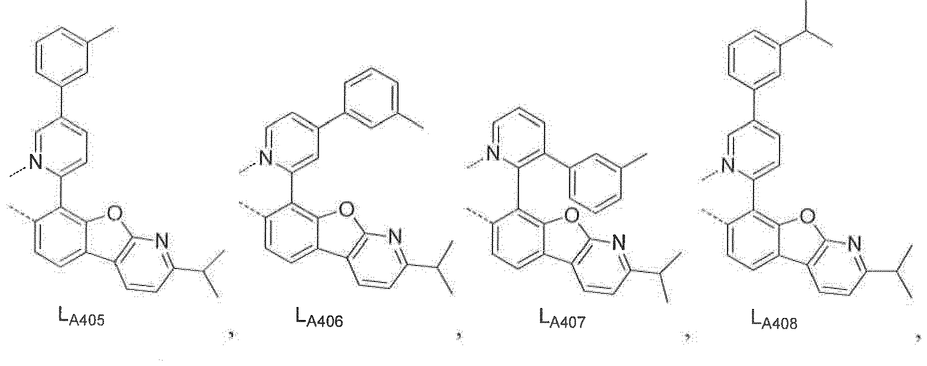

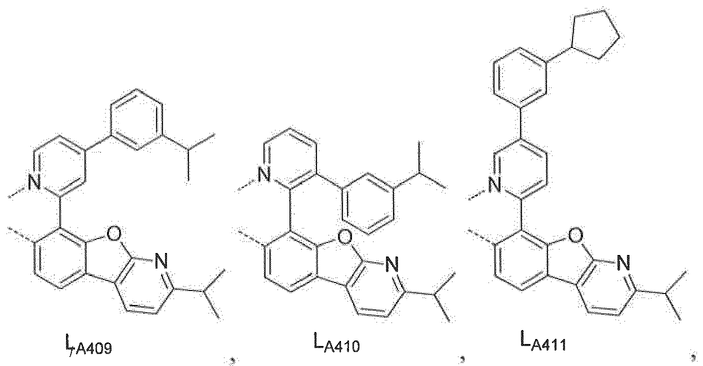

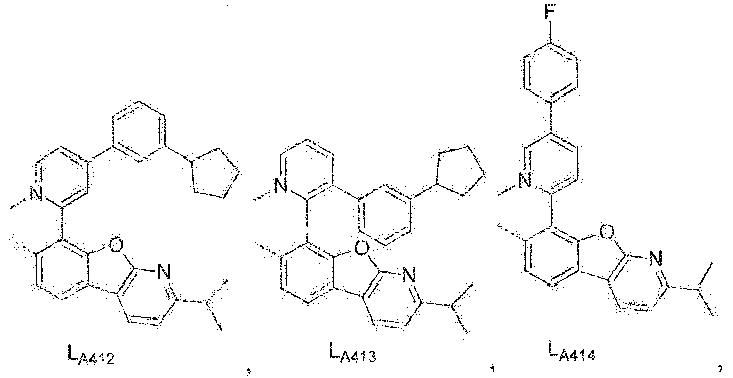

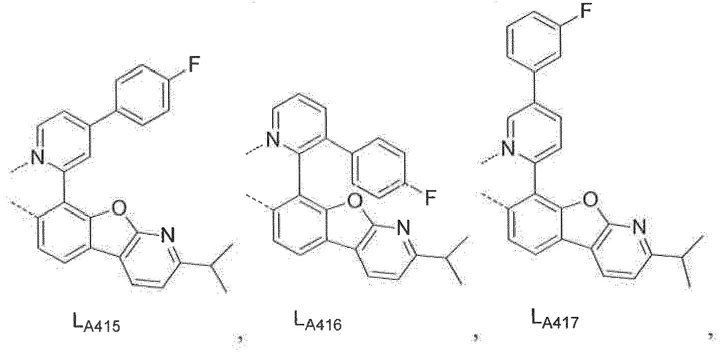

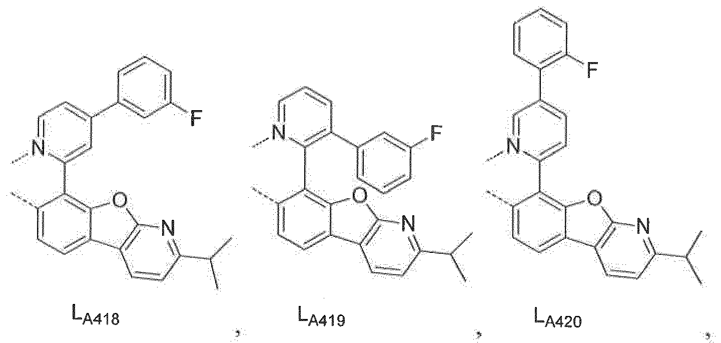

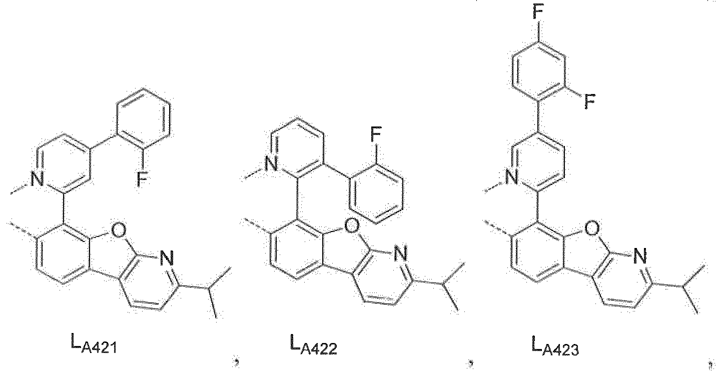

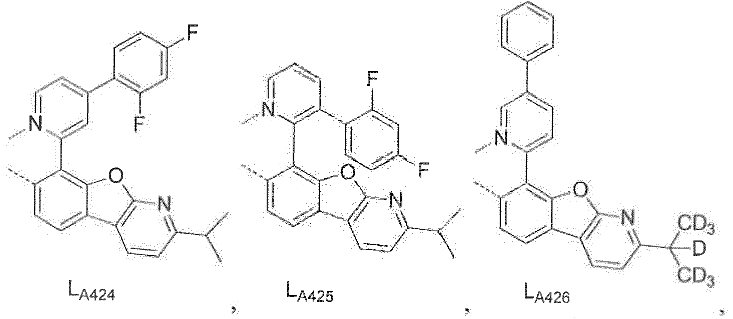

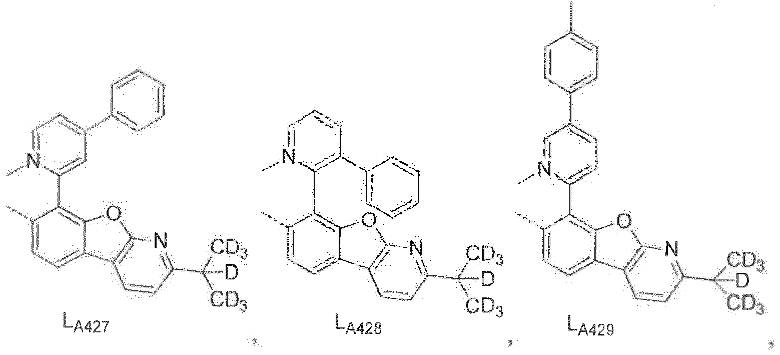

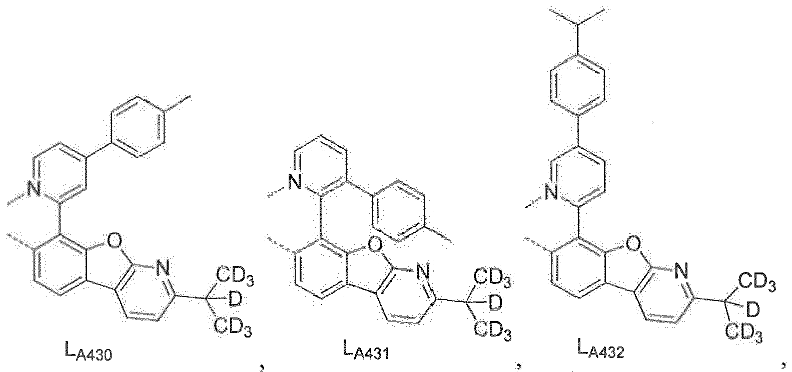

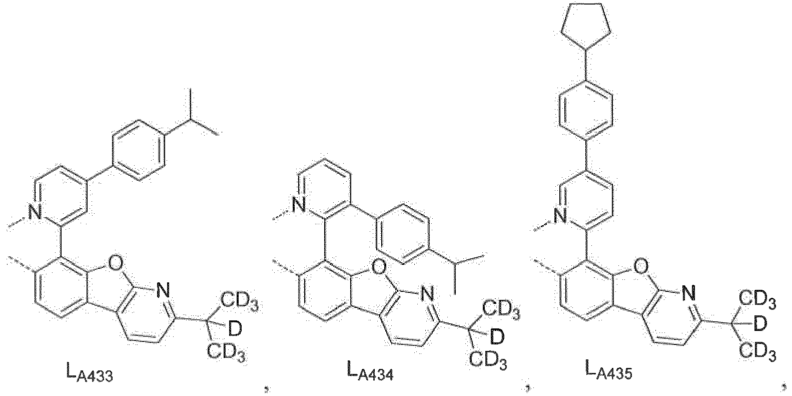

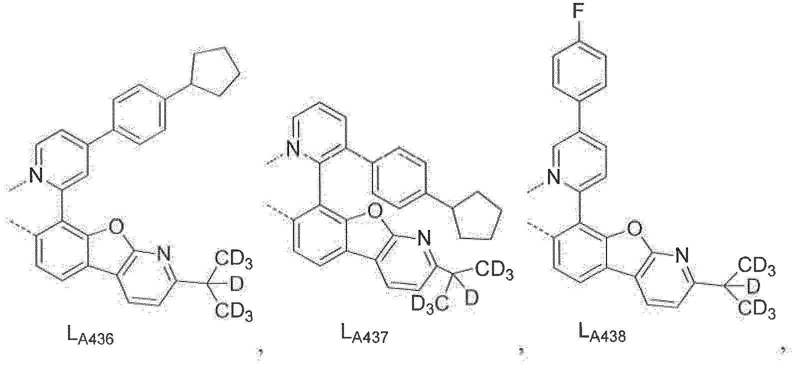

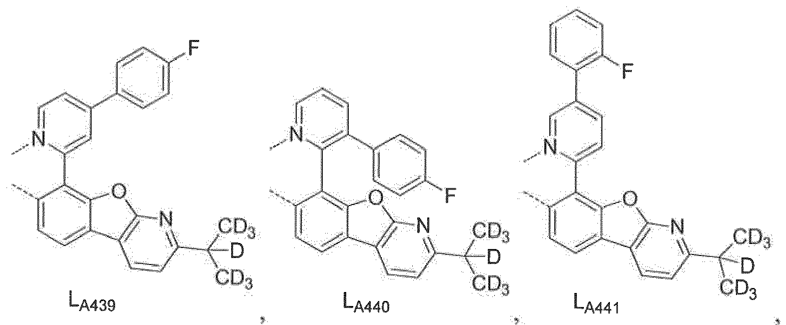

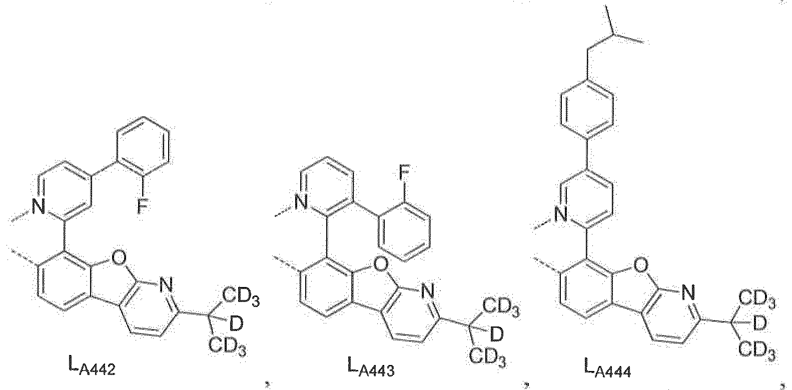

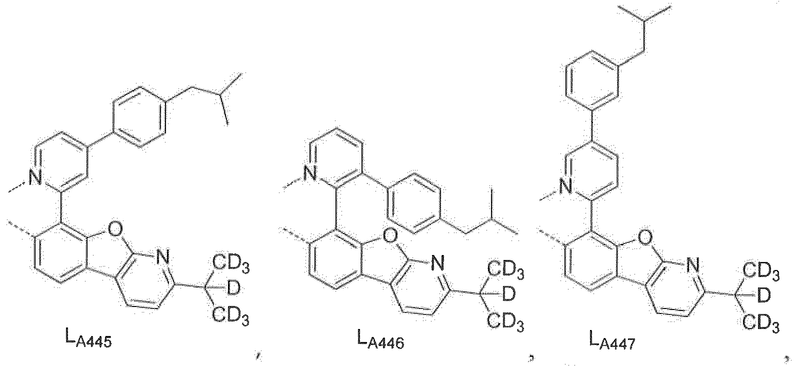

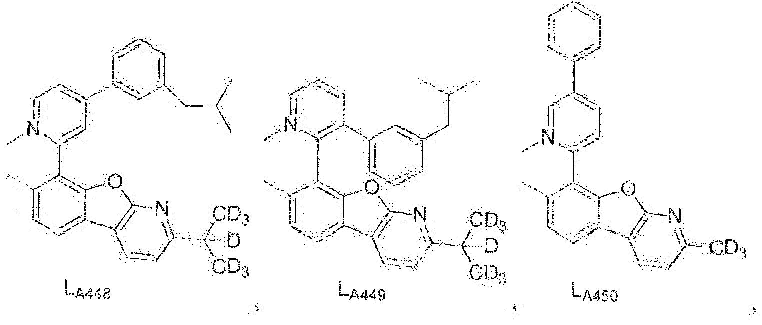

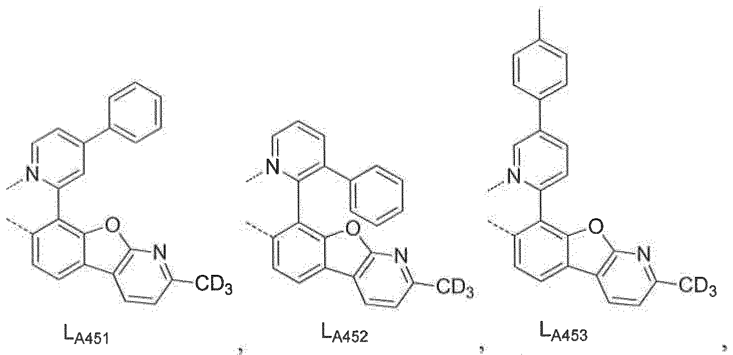

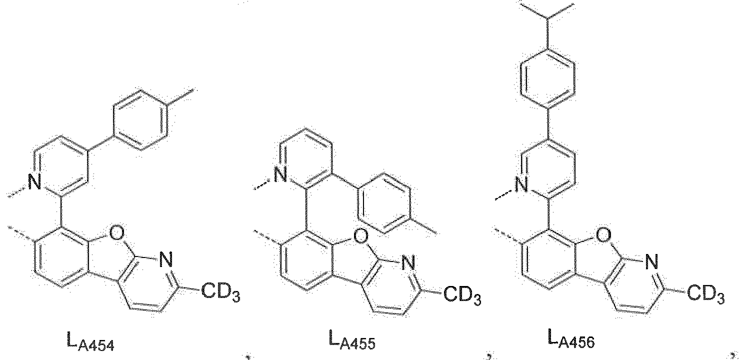

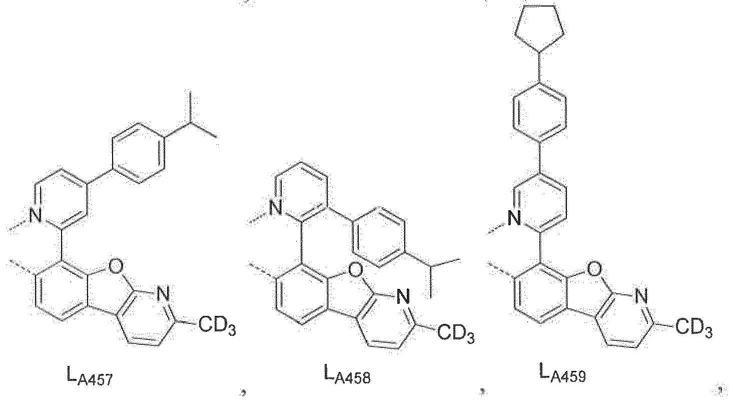

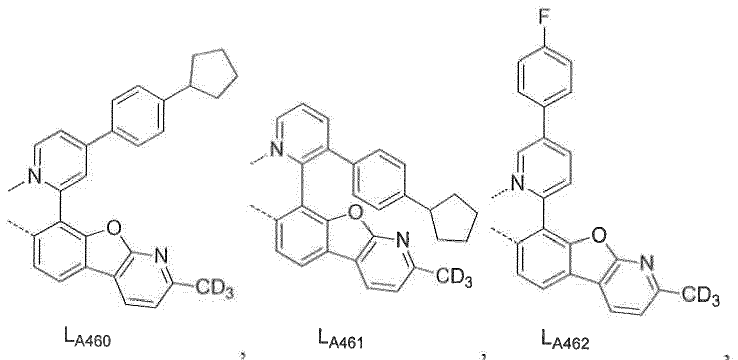

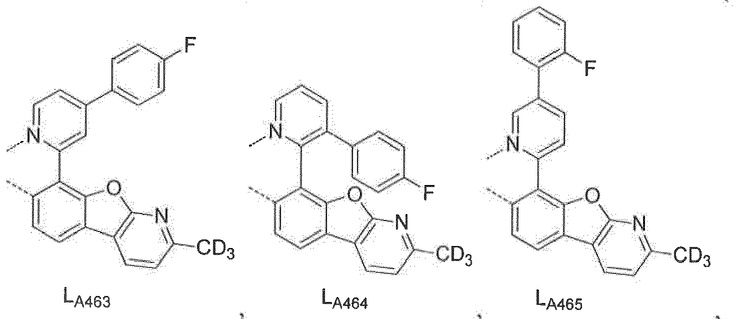

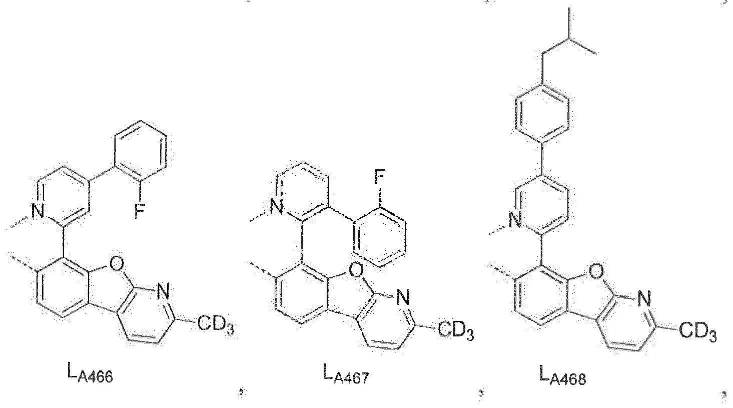

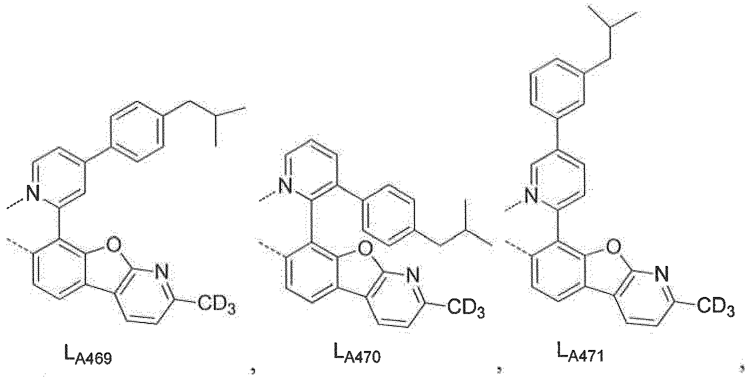

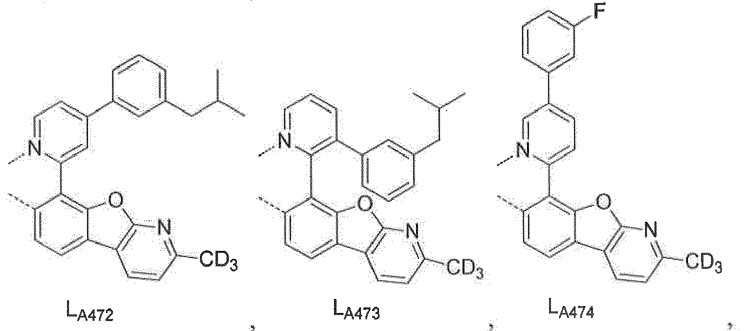

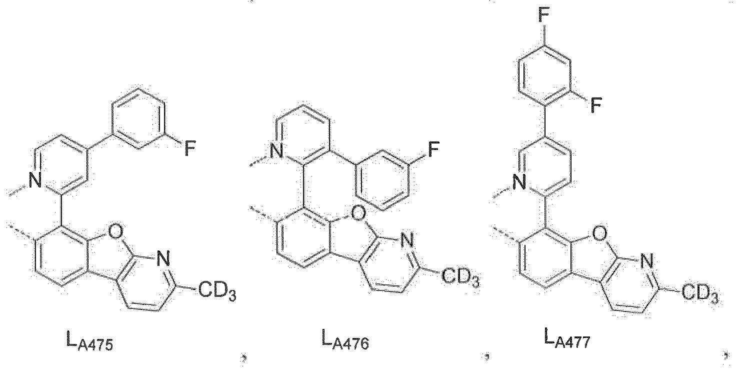

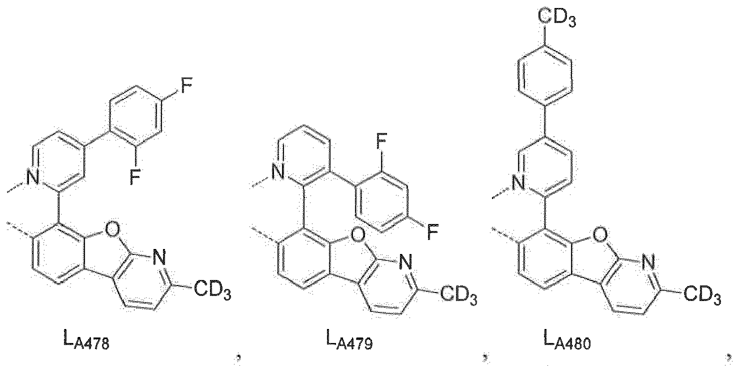

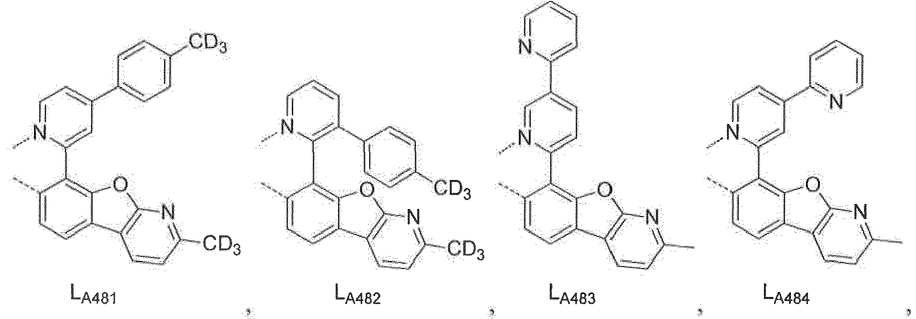

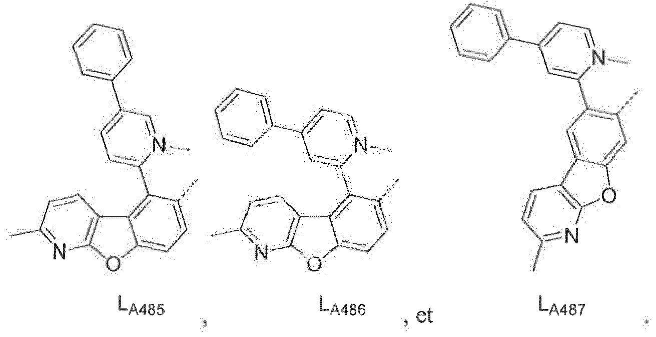

20. Composé selon la revendication 19, dans lequel L_{B} est sélectionné dans le groupe constitué de :

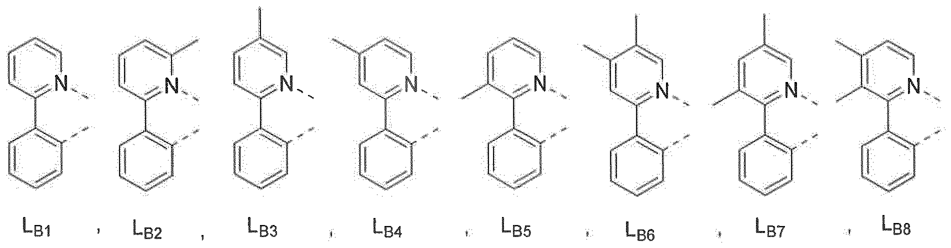

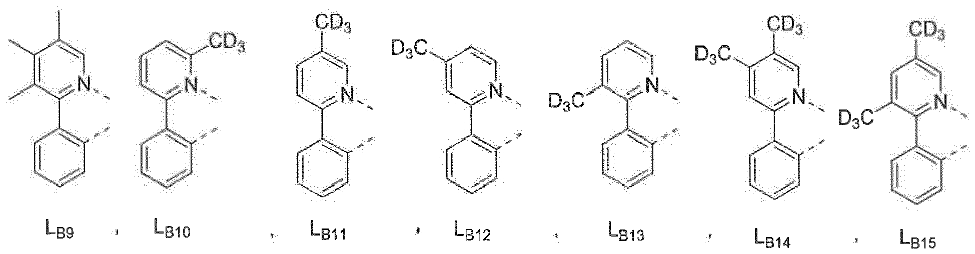

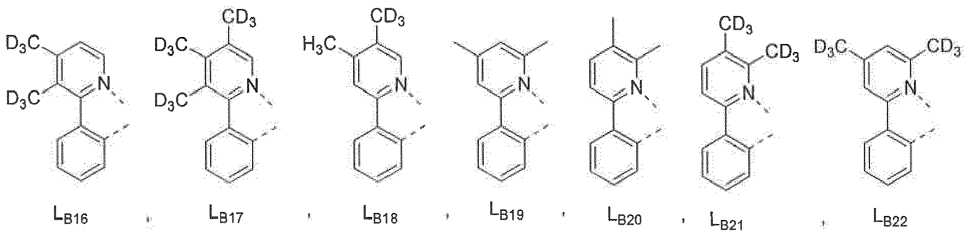

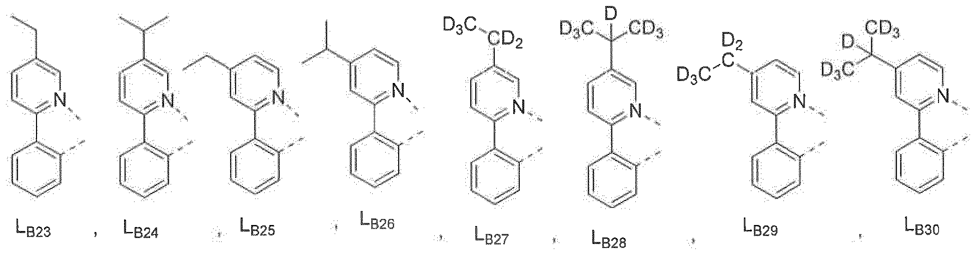

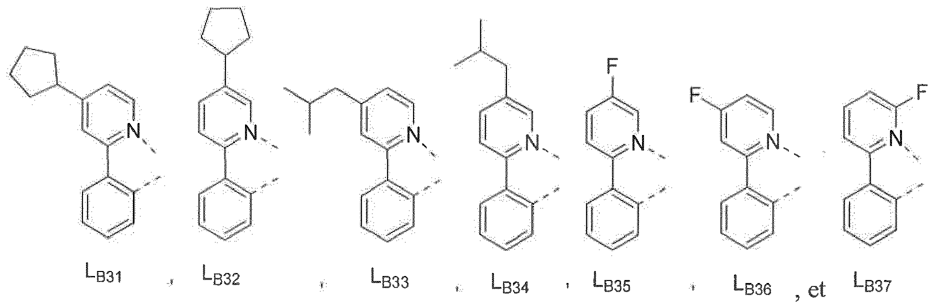

21. Composé selon la revendication 20, dans lequel le composé est sélectionné parmi le groupe constitué de : Ir(L_{A318})(L_{B1})₂ (Composé III-1), Ir(L_{A319})(L_{B1})₂ (Composé III-2), Ir(L_{A320})(L_{B1})₂ (Composé III-3), Ir(L_{A322})(L_{B1})₂ (Composé III-5), Ir(L_{A325})(L_{B1})₂ (Composé III-8), Ir(L_{A328})(L_{B1})₂ (Composé III-11), Ir(L_{A331})(L_{B1})₂ (Composé III-14), Ir(L_{A342})(L_{B1})₂ (Composé III-25), Ir(L_{A343})(L_{B1})₂ (Composé III-26), Ir(L_{A344})(L_{B1})₂ (Composé III-27), Ir(L_{A346})(L_{B1})₂ (Composé III-29), Ir(L_{A349})(L_{B1})₂ (Composé III-32), Ir(L_{A351})(L_{B1})₂ (Composé III-34), Ir(L_{A352})(L_{B1})₂ (Composé III-35), Ir(L_{A354})(L_{B1})₂ (Composé III-37), Ir(L_{A355})(L_{B1})₂ (Composé III-38), Ir(L_{A36}))(L_{B1})₂ (Composé III-44), Ir(L_{A363})(L_{B1})₂ (Composé III-46), Ir(L_{A364})(L_{B1})₂ (Composé III-47), Ir(L_{A366})(L_{B1})₂ (Composé III-49), Ir(L_{A367})(L_{B1})₂ (Composé III-50), Ir(L_{A370})(L_{B1})₂ (Composé III-53), Ir(L_{A373})(L_{B1})₂ (Composé III-56), Ir(L_{A376})(L_{B1})₂ (Composé III-59), Ir(L_{A379})(L_{B1})₂ (Composé III-62), Ir(L_{A382})(L_{B1})₂ (Composé III-65), Ir(L_{A385})(L_{B1})₂ (Composé III-68), Ir(L_{A388})(L_{B1})₂ (Composé III-71), Ir(L_{A390})(L_{B1})₂ (Composé III-73), Ir(L_{A391})(L_{B1})₂ (Composé III-74), Ir(L_{A399})(L_{B1})₂ (Composé III-82), Ir(L_{A415})(L_{B1})₂ (Composé III-98), Ir(L_{A414})(L_{B1})₂ (Composé III-97),Ir(L_{A427})(L_{B1})₂ (Composé III-110), Ir(L_{A439})(L_{B1})₂ (Composé III-122), Ir(L_{A450})(L_{B1})₂ (Composé III-133), Ir(L_{A451})(L_{B1})₂ (Composé III-134), Ir(L_{A454})(L_{B1})₂ (Composé III-137), Ir(L_{A460})(L_{B1})₂ (Composé III-143), Ir(L_{A462})(L_{B1})₂ (Composé III-145), Ir(L_{A463})(L_{B1})₂ (Composé III-146), Ir(L_{A468})(L_{B1})₂ (Composé III-151), Ir(L_{A469})(L_{B1})₂ (Composé III-152), Ir(L_{A480})(L_{B1})₂ (Composé III-163), Ir(L_{A481})(L_{B1})₂ (Composé III-164), Ir(L_{A343})(L_{B1})₂ (Composé III-196), Ir(L_{A367})(L_{B1})₂ (Composé III-220), Ir(L_{A346})(L_{B10})₂ (Composé III-1559), Ir(L_{A391})(L_{B10})₂ (Composé III-1604), Ir(L_{A355})(L_{B11})₂ (Composé III-1738), Ir(L_{A367})(L_{B11})₂ (Composé III-1750), Ir(L_{A52})(L_{B26})₂ (Composé III-4285), Ir(L_{A367})(L_{B26})₂ (Composé III-4300), Ir(L_{A367})(L_{B27})₂ (Composé III-4470), Ir(L_{A349})(L_{B28})₂ (Composé III-4622), Ir(L_{A367})(L_{B28})₂ (Composé III-4640), Ir(L_{A418})(L_{B27})₂ (Composé III-4690), Ir(L_{A463})(L_{B28})₂ (Composé III-4736), Ir(L_{A464})(L_{B29})₂ (Composé III-4907), Ir(L_{A463})(L_{B30})₂ (Composé III-5076), Ir(L_{A346})(L_{B36})₂ (Composé III-5979), Ir(L_{A336})(L_{B37})₂ (Composé III-6139), Ir(L_{A367})(L_{B29})₂ (Composé III-4810), Ir(L_{A367})(L_{B30})₂ (Composé III-4980), Ir(L_{A367})(L_{B31})₂ (Composé III-5150), Ir(L_{A367})(L_{B37})₂ (Composé III-5320), Ir(L_{A352})(L_{B33})₂ (Composé III-5475, Ir(L_{A367})(L_{B33})₂ (Composé III-5490), et Ir(L_{A367})(L_{B34})₂ (Composé III-5660).

22. Premier dispositif comprenant un premier dispositif organique émetteur de lumière, comportant en outre :
une anode ;
une cathode ; et
une couche organique, située entre l'anode et la cathode, comprenant un composé étant représenté par la formule Ir(L_{A})ₙ(L_{B})₃₋ₙ, ayant la structure: 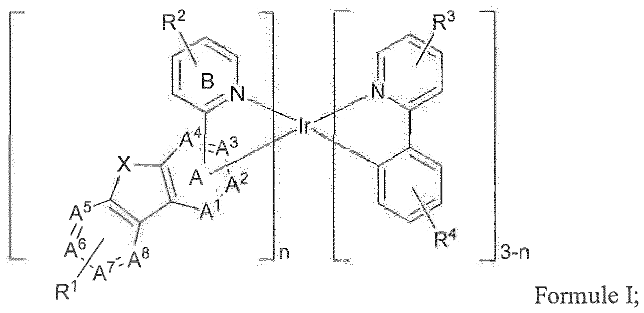 dans lequel A¹, A², A³, A⁴, A⁵, A⁶, A⁷, et A⁸ comprennent du carbone ou de l'azote ;
dans lequel au moins un parmi A¹, A², A³, A⁴, A⁵, A⁶, A⁷, et A⁸ est un azote ;
dans lequel le cycle B est lié au cycle A via une liaison C-C ;
dans lequel l'iridium est lié au cycle A via une liaison Ir-C ;
dans lequel X est O, S, ou Se ;
dans lequel R¹, R², R³, et R⁴ représentent indépendamment une mono, di, tri ou tétra substitution, ou aucune substitution ;
dans lequel tous groupements adjacents en R¹, R², R³, et R⁴ sont optionnellement liés ensemble pour former un cycle ;
dans lequel R¹, R², R³, et R⁴ sont indépendamment sélectionnés dans le groupe constitué d'hydrogène, de deutérium, d'halogénure, d'alkyle, de cycloalkyle, d'hétéroalkyle, d'arylalkyle, d'alcoxy, d'aryloxy, d'amino, de silyl, d'alkényle, de cycloalkényle, d'hétéroalkényle, d'alkynyle, d'aryle, d'hétéroaryle, d'acyle, de carbonyle, d'acides carboxyliques, d'ester, de nitrile, d'isonitrile, de sulfanyle, de sulfinyle, de sulfonyle, de phosphino, et de combinaisons de ceux-ci ; et
dans lequel n est un entier de 1 à 3.

23. Formulation comprenant un composé étant représenté par la formule Ir(L_{A})ₙ(L_{B})₃₋ₙ, ayant la structure : 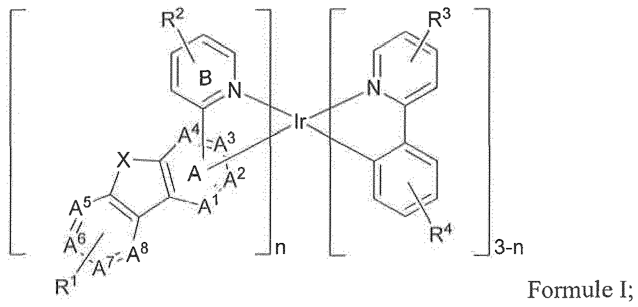 dans lequel A¹, A² , A³, A⁴, A⁵, A⁶, A⁷, et A⁸ comprennent du carbone ou de l'azote ;
dans lequel au moins un parmi A¹, A², A³, A⁴, A⁵, A⁶, A⁷, et A⁸ est un azote ;
dans lequel le cycle B est lié au cycle A via une liaison C-C ;
dans lequel l'iridium est lié au cycle A via une liaison Ir-C ;
dans lequel X est O, S, ou Se ;
dans lequel R¹, R², R³, et R⁴ représentent indépendamment une mono, di, tri ou tétra substitution, ou aucune substitution ;
dans lequel tous groupements adjacents en R¹, R², R³, et R⁴ sont optionnellement liés ensemble pour former un cycle ;
dans lequel R¹, R², R³, et R⁴ sont indépendamment sélectionnés dans le groupe constitué d'hydrogène, de deutérium, d'halogénure, d'alkyle, de cycloalkyle, d'hétéroalkyle, d'arylalkyle, d'alcoxy, d'aryloxy, d'amino, de silyl, d'alkényle, de cycloalkényle, d'hétéroalkényle, d'alkynyle, d'aryle, d'hétéroaryle, d'acyle, de carbonyle, d'acides carboxyliques, d'ester, de nitrile, d'isonitrile, de sulfanyle, de sulfinyle, de sulfonyle, de phosphino, et de combinaisons de ceux-ci ; et
dans lequel n est un entier de 1 à 3.
